(19) Europäisches Patentamt
European Patent Office
Office européen des brevets

(11) EP 4 102 590 B1

(12) **EUROPEAN PATENT SPECIFICATION**

(45) Date of publication and mention of the grant of the patent:
**19.11.2025 Bulletin 2025/47**

(21) Application number: **22178153.7**

(22) Date of filing: **09.06.2022**

(51) International Patent Classification (IPC):
***H10K 85/30*** *(2023.01)* *H10K 50/11* *(2023.01)*
*H10K 101/10* *(2023.01)* *H10K 101/30* *(2023.01)*

(52) Cooperative Patent Classification (CPC):
**H10K 85/342;** H10K 50/11; H10K 2101/10; H10K 2101/30

(54) **COMPOSITION, LAYER INCLUDING THE COMPOSITION, LIGHT-EMITTING DEVICE INCLUDING THE COMPOSITION, AND ELECTRONIC APPARATUS INCLUDING THE LIGHT-EMITTING DEVICE**

ZUSAMMENSETZUNG, SCHICHT MIT DIESER ZUSAMMENSETZUNG, LICHTEMITTIERENDE VORRICHTUNG MIT DIESER ZUSAMMENSETZUNG UND ELEKTRONISCHES GERÄT MIT DIESER LICHTEMITTIERENDEN VORRICHTUNG

COMPOSITION, COUCHE COMPRENANT LA COMPOSITION, DISPOSITIF ÉLECTROLUMINESCENT COMPRENANT LA COMPOSITION, ET APPAREIL ÉLECTRONIQUE COMPRENANT LE DISPOSITIF ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.06.2021 KR 20210076311**

(43) Date of publication of application:
**14.12.2022 Bulletin 2022/50**

(73) Proprietor: **Samsung Display Co., Ltd.**
**Yongin-si, Gyeonggi-do 17113 (KR)**

(72) Inventors:
- **SIM, Myungsun**
**16678 Suwon-si (KR)**
- **KWAK, Seungyeon**
**16678 Suwon-si (KR)**
- **KIM, Sungmin**
**16678 Suwon-si (KR)**
- **KIM, Hyungjun**
**16678 Suwon-si (KR)**
- **LEE, Banglin**
**16678 Suwon-si (KR)**
- **LEE, Sunghun**
**16678 Suwon-si (KR)**
- **LEE, Yong Joo**
**16678 Suwon-si (KR)**
- **CHOI, Byoungki**
**16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**JP-A- 2003 068 465** **JP-A- 2013 243 236**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 102 590 B1

## Description

FIELD OF THE INVENTION

One or more embodiments relate to a composition, a layer including the composition, a light-emitting device including the composition, and an electronic apparatus including the light-emitting device.

BACKGROUND OF THE INVENTION

From among light-emitting devices, organic light-emitting devices (OLEDs) are self-emissive devices, which have improved characteristics in terms of viewing angles, response time, luminance, driving voltage, and response speed, and produce full-color images.

In an example, an OLED may include an anode, a cathode, and an organic layer located between the anode and the cathode, wherein the organic layer includes an emission layer. A hole transport region may be located between the anode and the emission layer, and an electron transport region may be located between the emission layer and the cathode. Holes injected from the anode may move toward the emission layer through the hole transport region, and electrons injected from the cathode may move toward the emission layer through the electron transport region. The holes and the electrons recombine in the emission layer to produce excitons. These excitons transition from an excited state to a ground state, thereby generating light. JP2003068465 discloses an OLED comprising two Iridium complexes in the light emitting layer.

SUMMARY OF THE INVENTION

Provided are a composition capable of providing excellent luminescence efficiency and the like, a layer including the composition, a light-emitting device including the composition, and an electronic apparatus including the light-emitting device.

Additional aspects will be set forth in part in the description, which follows and, in part, will be apparent from the description, or may be learned by practice of the presented embodiments of the disclosure.

According to an aspect, provided is a composition including

a first compound and a second compound, wherein
the first compound is an organometallic compound represented by Formula 1,
the second compound is an organometallic compound represented by Formula 2,
the first compound and the second compound are different from each other,
the first compound and the second compound are each not tris[2-phenylpyridine]iridium,
$|\lambda P(Ir1) - \lambda P(Ir2)|$ is in a range of 0 nanometers (nm) to about 30 nm, and
at least one of Expressions 1 to 4 is satisfied, and
wherein the first compound and the second compound are each a heteroleptic compound,

Expression 1

$$\lambda P(Ir1) > \lambda P(Ir2)$$

Expression 2

$$PLQY(Ir1) > PLQY(Ir2)$$

Expression 3

$$k_r(Ir1) > k_r(Ir2)$$

Expression 4

$$HOR(Ir1) > HOR(Ir2)$$

wherein, in $|\lambda P(Ir1) - \lambda P(Ir2)|$ and Expressions 1 to 4,
$\lambda P(Ir1)$ indicates an emission peak wavelength of the first compound,

λP(Ir2) indicates an emission peak wavelength of the second compound,
λP(Ir1) and AP(Ir2) are evaluated from photoluminescence spectra measured for each of a first film and a second film,
PLQY(Ir1) indicates a photoluminescence quantum yield of the first compound,
PLQY(Ir2) indicates a photoluminescence quantum yield of the second compound,
PLQY(Ir1) and PLQY(Ir2) are measured for each of the first film and the second film,
$k_r$(Ir1) indicates a radiative decay rate of the first compound,
$k_r$(Ir2) indicates a radiative decay rate of the second compound,
$k_r$(Ir1) and $k_r$(Ir2) are evaluated from photoluminescence spectra and time-resolved photoluminescence spectra measured for each of the first film and the second film,
HOR(Ir1) indicates a horizontal orientation ratio of the first compound,
HOR(Ir2) indicates a horizontal orientation ratio of the second compound, and
HOR(Ir1) and HOR(Ir2) are evaluated from emission intensity measured for each of the first film and the second film,
wherein the first film is a film including the first compound, and
the second film is a film including the second compound,

Formula 1 $Ir(L_{11})_{n11} (L_{12})_{n12}(L_{13})_{n13}$

Formula 2 $Ir(L_{21})_{n21}(L_{22})_{n22}(L_{23})_{n23}$

wherein, in Formulae 1 and 2,
$L_{11}$ and $L_{21}$ are each independently:

a bidentate ligand bonded to iridium (Ir) of Formula 1 or Formula 2 via two nitrogen atoms;
a bidentate ligand bonded to Ir of Formula 1 or Formula 2 via a nitrogen atom and a carbon atom; or
a bidentate ligand bonded to Ir of Formula 1 or Formula 2 via two carbon atoms,

$L_{12}$, $L_{13}$, $L_{22}$, and $L_{23}$ are each independently:

a bidentate ligand bonded to Ir of Formula 1 or Formula 2 via two nitrogen atoms,
a bidentate ligand bonded to Ir of Formula 1 or Formula 2 via a nitrogen atom and a carbon atom;
a bidentate ligand bonded to Ir of Formula 1 or Fomula 2 via two carbon atoms; or
a bidentate ligand bonded to Ir of Formula 1 or Formula 2 via two oxygen atoms,
n11 and n12 may each independently be 1 or 2,
n13 may be 0 or 1,
the sum of n11, n12, and n13 may be 3,
n21 and n22 are each independently 1 or 2,
n23 is 0 or 1, and
the sum of n21, n22, and n23 is 3,
wherein Condition 1 is satisfied:

Condition 1
When a) $L_{11}$ is a bidentate ligand bonded to Ir of Formula 1 via a nitrogen atom and a carbon atom; b) $L_{11}$ includes ring $A_1$ bonded to Ir of Formula 1 via a nitrogen atom, and ring $A_2$ bonded to Ir of Formula 1 via a carbon atom; c) $L_{21}$ is a bidentate ligand bonded to Ir of Formula 2 via a nitrogen atom and a carbon atom; d) $L_{21}$ includes ring $A_5$ bonded to Ir of Formula 2 via a nitrogen atom, and ring $A_6$ bonded to Ir of Formula 2 via a carbon atom; e) $L_{12}$ and $L_{22}$ are each a bidentate ligand bonded to Ir of Formula 1 or Formula 2 via two oxygen atoms; f) n11 and n21 are each 2; and g) n12 and n22 are each 1, ring $A_1$ and ring $A_5$ are different from each other.

According to another aspect, provided is a layer including the composition.

According to another aspect, provided is a light-emitting device including: a first electrode; a second electrode; and an organic layer located between the first electrode and the second electrode and including an emission layer, wherein the organic layer includes the composition.

For example, the emission layer in the organic layer of the light-emitting device may include the composition.

According to another aspect, provided is an electronic apparatus including the light-emitting device.

BRIEF DESCRIPTION OF THE DRAWING

The above and other aspects, features, and advantages of certain embodiments of the disclosure will be more apparent from the following description taken in conjunction with

FIGURE which shows a schematic cross-sectional view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

According to an aspect, provided is a composition including a first compound and a second compound.

The first compound is an organometallic compound represented by Formula 1, and the second compound is an organometallic compound represented by Formula 2:

Formula 1 $\quad Ir(L_{11})_{n11}(L_{12})_{n12}(L_{13})_{n13}$

Formula 2 $\quad Ir(L_{21})_{n21}(L_{22})_{n22}(L_{23})_{n23}$

wherein, Formulae 1 and 2 each include one iridium (Ir).

The detailed descriptions of the Formulae 1 and 2 are described herein in further detail.

The first compound and the second compound are different from each other.

The first compound and the second compound are not each tris[2-phenylpyridine]iridium (see the first compound of Group B). In other words, neither the first compound nor the second compound is tris[2-phenylpyridine]iridium.

In an embodiment, the first compound and the second compound may not each be a compound of Group B, wherein R' and R" are each independently a $C_1$ to $C_{20}$ alkyl group, and R is hydrogen, F or Cl:

Group B

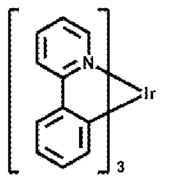
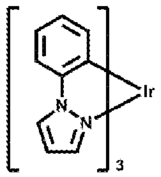
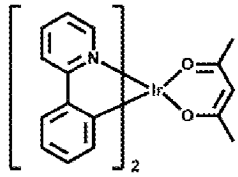
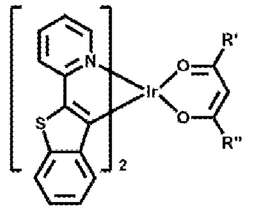
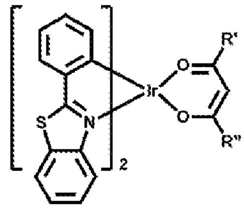
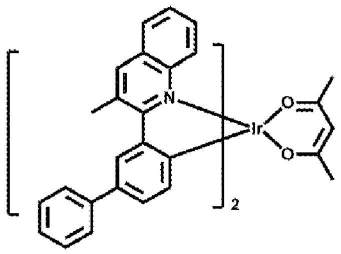
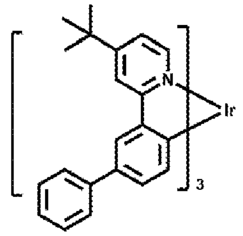
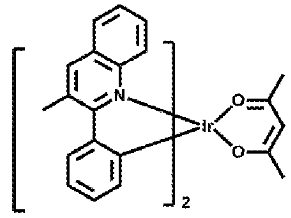
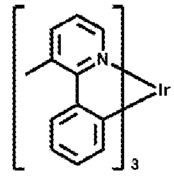
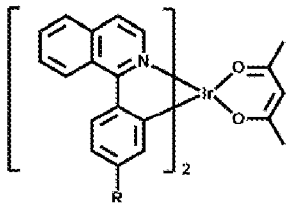
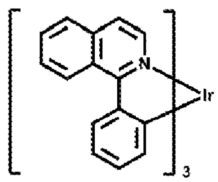
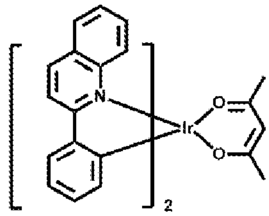
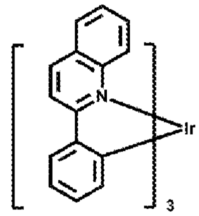

In an embodiment, the first compound and the second compound may each be electrically neutral.

According to the invention, the first compound and the second compound are each a heteroleptic compound.

The first film is a film including the first compound. For example, the first film including the first compound may have an emission peak wavelength evaluated from photoluminescence spectra, a photoluminescence quantum yield, a radiative decay rate evaluated from photoluminescence spectra and time-resolved photoluminescence spectra, and a horizontal orientation ratio evaluated from the emission intensity (for example, at each angle). For example, the first film may be a 40-nanometer-thick film obtained by vacuum depositing the first compound on a quartz substrate. As used herein, the term "emission peak wavelength" refer to a wavelength in the emission peak at which the emission intensity is maximum.

The second film is a film including the second compound. For example, the second film including the second compound may have an emission peak wavelength evaluated from photoluminescence spectra, a photoluminescence quantum yield, a radiative decay rate evaluated from photoluminescence spectra and time-resolved photoluminescence spectra, and a horizontal orientation ratio evaluated from the emission intensity (for example, at each angle). For example, the second film may be a 40-nanometer-thick film obtained by vacuum depositing the second compound on a quartz substrate.

$|\lambda P(Ir1) - \lambda P(Ir2)|$ of the composition is in a range of 0 nm to about 30 nm, wherein $|\lambda P(Ir1) - \lambda P(Ir2)|$ indicates an absolute value of $\lambda P(Ir1) - \lambda P(Ir2)$, and the composition satisfies at least one of Expressions 1 to 4:

Expression 1

$$\lambda P(Ir1) > \lambda P(Ir2)$$

Expression 2

$$PLQY(Ir1) > PLQY(Ir2)$$

Expression 3

$$k_r(Ir1) > k_r(Ir2)$$

Expression 4

$$HOR(Ir1) > HOR(Ir2)$$

In $|\lambda P(Ir1) - \lambda P(Ir2)|$ and Expression 1, $\lambda P(Ir1)$ indicates the emission peak wavelength of the first compound, and $\lambda P(Ir2)$ indicates the emission peak wavelength of the second compound.

$\lambda P(Ir1)$ and $\lambda P(Ir2)$ are evaluated from photoluminescence spectra measured for each of a first film corresponding to $\lambda P(Ir1)$ and a second film corresponding to $\lambda P(Ir2)$. For example, evaluation methods of $\lambda P(Ir1)$ and $\lambda P(Ir2)$ may be as described in Evaluation Example 1 below.

In Expression 2, PLQY(Ir1) indicates the photoluminescence quantum yield of the first compound, and PLQY(Ir2) indicates the photoluminescence quantum yield of the second compound.

PLQY(Ir1) and PLQY(Ir2) are measured for each of the first film and the second film. For example, evaluation methods of PLQY(Ir1) and PLQY(Ir2) may be as described in Evaluation Example 1 hereinbelow.

In Expression 3, $k_r(Ir1)$ indicates the radiative decay rate of the first compound, and $k_r(Ir2)$ indicates the radiative decay rate of the second compound.

$k_r(Ir1)$ and $k_r(Ir2)$ are evaluated from photoluminescence spectra and time-resolved photoluminescence spectra measured for each of the first film corresponding to $k_r(Ir1)$ and the second film corresponding to $k_r(Ir2)$. For example, evaluation methods of $k_r(Ir1)$ and $k_r(Ir2)$ may be as described in Evaluation Example 2 below.

In Expression 4, HOR(Ir1) indicates the horizontal orientation ratio of the first compound, and HOR(Ir2) indicates a horizontal orientation ratio of the second compound.

HOR(Ir1) and HOR(Ir2) are evaluated from emission intensity at each angle measured for each of the first film corresponding to HOR(Ir1) and the second film corresponding to HOR(Ir2). For example, evaluation methods of HOR(Ir1) and HOR(Ir2) may be as described in Evaluation Example 3 below.

The term "first film" as used herein refers to a film including the first compound, and the term "second film" as used herein refers to a film including the second compound. The first film and the second film may be manufactured using any suitable method, for example, various methods such as a vacuum deposition method, a coating and heating method, or the like. The first film and the second film may each further include a compound, for example, a host as described herein, other than the first compound and the second compound. In other words, each of the first and/or the second film independently may include an additional compound.

$L_{11}$ and $L_{21}$ in Formulae 1 and 2 are each independently:

a bidentate ligand bonded to Ir of Formula 1 or Formula 2 via two nitrogen atoms;
a bidentate ligand bonded to Ir of Formula 1 or Formula 2 via a nitrogen atom and a carbon atom; or
a bidentate ligand bonded to Ir of Formula 1 or Formula 2 via two carbon atoms.

In an embodiment, $L_{11}$ and $L_{21}$ may each be a bidentate ligand bonded to Ir of Formula 1 or Formula 2 via a nitrogen atom and a carbon atom.

$L_{12}$, $L_{13}$, $L_{22}$, and $L_{23}$ in Formulae 1 and Formula 2 are each independently:

a bidentate ligand bonded to Ir of Formula 1 or Formula 2 via two nitrogen atoms;
a bidentate ligand bonded to Ir of Formula 1 or Formula 2 via a nitrogen atom and a carbon atom;
a bidentate ligand bonded to Ir of Formula 1 or Formula 2 via two carbon atoms; or
a bidentate ligand bonded to Ir of Formula 1 or Formula 2 via two oxygen atoms.

In an embodiment, $L_{12}$, $L_{13}$, $L_{22}$, and $L_{23}$ may each independently be:

a bidentate ligand bonded to Ir of Formula 1 or Formula 2 via a nitrogen atom and a carbon atom; or
a bidentate ligand bonded to Ir of Formula 1 or Formula 2 via two oxygen atoms.

In Formula 1, n11 and n12 are each independently 1 or 2, n13 is 0 or 1, and the sum of n11, n12, and n13 is 3.

In an embodiment, in Formula 1, i) n11 may be 1, n12 may be 2, and n13 may be 0; or ii) n11 may be 2, n12 may be 1, and n13 may be 0.

In one or more embodiments, in Formula 1,

$L_{11}$ and $L_{12}$ may be different from each other,
i) n11 may be 1, n12 may be 2, and n13 may be 0; or ii) n11 may be 2, n12 may be 1, and n13 may be 0.

In Formula 2, n21 and n22 may each independently be 1 or 2, n23 may be 0 or 1, and the sum of n21, n22, and n23 may be 3.

In an embodiment, in Formula 2, i) n21 may be 1, n22 may be 2, and n23 may be 0; or ii) n21 may be 2, n22 may be 1, and n23 may be 0.

In one or more embodiments, in Formula 2,

$L_{21}$ and $L_{22}$ may be different from each other,
i) n21 may be 1, n22 may be 2, and n23 may be 0; or ii) n21 may be 2, n22 may be 1, and n23 may be 0.

Formulae 1 and Formula 2 satisfy Condition 1:

Condition 1

When a) $L_{11}$ is a bidentate ligand bonded to Ir of Formula 1 via a nitrogen atom and a carbon atom; b) $L_{11}$ includes ring $A_1$ bonded to Ir of Formula 1 via a nitrogen atom, and ring $A_2$ bonded to Ir of Formula 1 via a carbon atom; c) $L_{21}$ is a bidentate ligand bonded to Ir of Formula 2 via a nitrogen atom and a carbon atom; d) $L_{21}$ includes ring $A_5$ bonded to Ir of Formula 2 via a nitrogen atom, and ring $A_6$ bonded to Ir of Formula 2 via a carbon atom; e) $L_{12}$ and $L_{22}$ are each a bidentate ligand bonded to Ir of Formula 1 or Formula 2 via two oxygen atoms; f) n11 and n21 are each 2; and g) n12 and n22 are each 1, ring $A_1$ and ring $A_5$ are different from each other. That is, when all of "a)" to "f)" described above are true, ring $A_1$ and ring $A_5$ are different from each other.

An electronic device, for example, a light-emitting device, using the composition as described above, wherein i) $|\lambda P(Ir1) - \lambda P(Ir2)|$ is in a range of 0 nm to about 30 nm, ii) at least one of Expressions 1 to 4 is satisfied, and iii) Condition 1 is satisfied, may emit red light, yellowish-green light, green light, or blue light, or other colors than white light, and may have an excellent driving voltage, excellent external quantum efficiency, and excellent lifespan characteristics.

In an embodiment, $|\lambda P(Ir1) - \lambda P(Ir2)|$ of the composition may be in a range of 0 nm to about 25 nm, 0 nm to about 20 nm, about 2 nm to about 25 nm, about 2 nm to about 20 nm, about 4 nm to about 25 nm, or about 4 nm to about 20 nm.

In one or more embodiments, the composition may not emit white light.

In one or more embodiments, the composition may emit red light (for example, light having an emission peak wavelength in a range of about 570 nm to about 650 nm), yellowish-green light (for example, light having an emission peak wavelength in a range of about 540 nm to about 570 nm), green light (for example, light having an emission peak wavelength in a range of about 500 nm to about 540 nm), or blue light (for example, light having an emission peak wavelength in a range of about 400 nm to about 500 nm).

In one or more embodiments, the composition may emit green light (for example, light having an emission peak wavelength in a range of about 500 nm to about 540 nm) or yellowish-green light (for example, light having an emission peak wavelength in a range of about 540 nm to about 570 nm), and $|\lambda P(Ir1) - \lambda P(Ir2)|$ of the composition may be in a range of 0 nm to about 20 nm, 0 nm to about 10 nm, about 2 nm to about 20 nm, about 2 nm to about 10 nm, about 4 nm to about 20 nm, or about 4 nm to about 10 nm.

In one or more embodiments, the composition may emit red light (for example, light having an emission peak wavelength in a range of about 570 nm to about 650 nm), and $|\lambda P(Ir1) - \lambda P(Ir2)|$ of the composition may be in a range of about 5 nm to about 25 nm, about 5 nm to about 20 nm, or about 7 nm to about 20 nm.

In one or more embodiments, the composition may emit blue light (for example, light having an emission peak wavelength in a range of about 400 nm to about 500 nm), and $|\lambda P(Ir1) - AP(Ir2)|$ of the composition may be in a range of about 2 nm to about 25 nm, or about 5 nm to about 20 nm.

In one or more embodiments, the composition may satisfy Expression 1.

In one or more embodiments, the composition may satisfy at least one of Expressions 2 to 4.

In one or more embodiments, the composition may satisfy 1) Expression 1; and 2) at least one of Expressions 2 to 4.

In one or more embodiments, the composition may satisfy all of Expressions 1 to 4.

In one or more embodiments, the composition may satisfy at least one of Expressions 1 to 4, and the composition may further satisfy Expression 5:

Expression 5

$$HOMO(Ir1) < HOMO(Ir2)$$

wherein, in Expression 5,

HOMO(Ir1) indicates a highest occupied molecular orbital (HOMO) energy level of the first compound,
HOMO(Ir2) indicates a HOMO energy level of the second compound, and
HOMO(Ir1) and HOMO(Ir2) may each be a negative value (in electron volts, eV) measured by using a photoelectron spectrometer under atmospheric pressure.

For example, HOMO(Ir1) and HOMO(Ir2) may each be a negative value measured by using a photoelectron spectrometer, e.g., AC3 manufactured by RIKEN KEIKI Co., Ltd. (see Evaluation Example 4 below), under atmospheric pressure.
Since the composition further satisfies Expression 5, the second compound in the composition may have a shallower HOMO energy level than the HOMO energy level of the first compound, and thus, a relatively larger quantity of holes may be trapped in the second compound. Thus, in an electronic device, for example, a light-emitting device, using the composition, holes and electrons may effectively recombine in the first compound and/or the second compound without the first compound and the second compound changing into an anionic state due to electrons being injected into the composition, and without an increase in driving voltage, and thus, excellent luminescence efficiency and excellent lifespan characteristics may be obtained.
In one or more embodiments, |HOMO(Ir1) - HOMO(Ir2)| of the composition may be in a range of about 0.02 eV to about 0.30 eV, about 0.03 eV to about 0.20 eV, or about 0.03 eV to about 0.10 eV.
|HOMO(Ir1) - HOMO(Ir2)| indicates an absolute value of HOMO(Ir1) - HOMO(Ir2).
In one or more embodiments, $\lambda$P(Ir1) and $\lambda$P(Ir2) may each be in a range of about 500 nm to about 570 nm.
In one or more embodiments, the composition may satisfy Expression 1, and

i) $\lambda$P(Ir1) may be in a range of about 520 nm to about 540 nm, and $\lambda$P(Ir2) may be in a range of about 500 nm to about 530 nm, or
ii) $\lambda$P(Ir1) may be in a range of about 550 nm to about 570 nm, and $\lambda$P(Ir2) may be in a range of about 540 nm to about 560 nm.

In one or more embodiments, $\lambda$P(Ir1) and $\lambda$P(Ir2) may each be in a range of about 500 nm to about 570 nm, and $L_{11}$, $L_{12}$, $L_{13}$, $L_{21}$, $L_{22}$, and $L_{23}$ in Formulae 1 and 2 may each be a bidentate ligand bonded to Ir of Formula 1 or Formula 2 via a nitrogen atom and a carbon atom.
In one or more embodiments, $\lambda$P(Ir1) and $\lambda$P(Ir2) may each be in a range of about 570 nm to about 650 nm.
In one or more embodiments, the composition may satisfy Expression 1, $\lambda$P(Ir1) may be in a range of about 620 nm to about 650 nm, and $\lambda$P(Ir2) may be in a range of about 570 nm to about 630 nm.
In one or more embodiments, i) $\lambda$P(Ir1) and $\lambda$P(Ir2) may each be in a range of about 570 nm to about 650 nm, and ii) in Formulae 1 and Formula 2, $L_{11}$, $L_{13}$, $L_{21}$, and $L_{23}$ may each be a bidentate ligand bonded to Ir of Formula 1 or Formula 2 via a nitrogen atom and a carbon atom, $L_{12}$ and $L_{22}$ may each be a bidentate ligand bonded to Ir of Formula 1 or Formula 2 via two oxygen atoms, and n12 and n22 may each be 1.
In one or more embodiments, i) $\lambda$P(Ir1) and $\lambda$P(Ir2) may each be in a range of about 570 nm to about 650 nm, ii) in Formulae 1 and 2, $L_{11}$, $L_{13}$, $L_{21}$, and $L_{23}$ may each be a bidentate ligand bonded to Ir of Formula 1 or Formula 2 via a nitrogen atom and a carbon atom, $L_{12}$ and $L_{22}$ may each be a bidentate ligand bonded to Ir of Formula 1 or Formula 2 via two oxygen atoms, and n12 and n22 may each be 1, and iii) $L_{11}$ may include ring $A_1$ bonded to Ir of Formula 1 via a nitrogen atom, $L_{21}$ may include ring $A_5$ bonded to Ir of Formula 2 via a nitrogen atom, and at least one of ring $A_1$ and ring $A_5$ may not be pyridine.
In one or more embodiments, i) $\lambda$P(Ir1) and $\lambda$P(Ir2) may each be in a range of about 570 nm to about 650 nm, ii) in Formulae 1 and 2, $L_{11}$, $L_{13}$, $L_{21}$, and $L_{23}$ may each be a bidentate ligand bonded to Ir of Formula 1 or Formula 2 via a nitrogen atom and a carbon atom, $L_{12}$ and $L_{22}$ may each be a bidentate ligand bonded to Ir of Formula 1 or Formula 2 via two oxygen atoms, and n12 and n22 may each be 1, and iii) $L_{11}$ may include ring $A_1$ bonded to Ir of Formula 1 via a nitrogen atom, $L_{21}$ may include ring $A_5$ bonded to Ir of Formula 2 via a nitrogen atom, and ring $A_1$ and ring $A_5$ may each be a polycyclic group having 4 to 60 carbon atoms (for example, 4 to 30 carbon atoms) (for example, a quinoline group, an isoquinoline group, a quinoxaline group, a quinazoline group, a benzoquinoline group, a benzoisoquinoline group, a benzoquinoxaline group, a benzoquinazoline group, a phenanthroline group, or a phenanthridine group).
In one or more embodiments, $\lambda$P(Ir1) and $\lambda$P(Ir2) may each be in a range of about 400 nm to about 500 nm.
In one or more embodiments, the composition may satisfy Expression 1, $\lambda$P(Ir1) may be in a range of about 470 nm to about 500 nm, and $\lambda$P(Ir2) may be in a range of about 430 nm to about 480 nm.

In one or more embodiments, HOR(Ir1) and HOR(Ir2) may each be in a range of about 75% to about 100%, for example, about 77% to about 95%, or about 80% to about 100%.

In one or more embodiments, the composition may satisfy at least one of Conditions A to D:

Condition A
$L_{11}$ and $L_{12}$ of Formula 1 are different from each other
Condition B
$L_{21}$ and $L_{22}$ of Formula 2 are different from each other
Condition C
$L_{11}$ of Formula 1 and $L_{21}$ of Formula 2 are different from each other
Condition D
$L_{12}$ of Formula 1 and $L_{22}$ of Formula 2 are different from each other.

In one or more embodiments, in Formulae 1 and 2,

$L_{11}$ may be a ligand represented by Formula 1-1,
$L_{12}$ may be a ligand represented by Formula 1-2 or 1-3,
$L_{13}$ may be a ligand represented by Formula 1-1, 1-2, or 1-3,
$L_{21}$ may be a ligand represented by Formula 2-1,
$L_{22}$ may be a ligand represented by Formula 2-2 or 2-3, and
$L_{23}$ may be a ligand represented by Formula 2-1, 2-2, or 2-3:

Formula 1-1

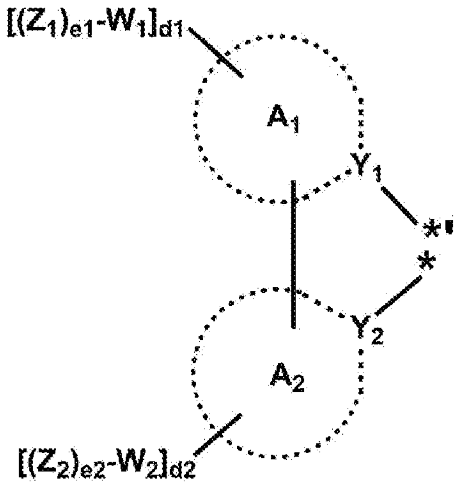

Formula 1-2

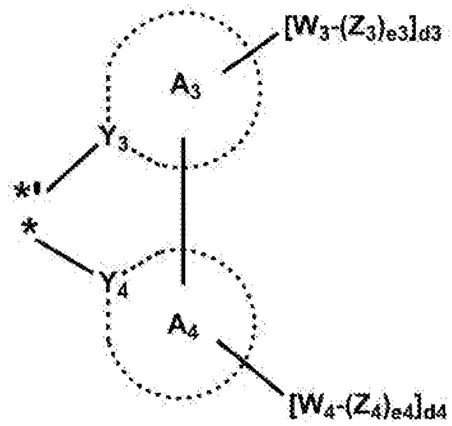

Formula 1-3

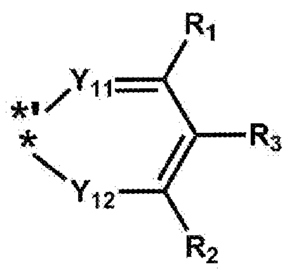

Formula 2-1

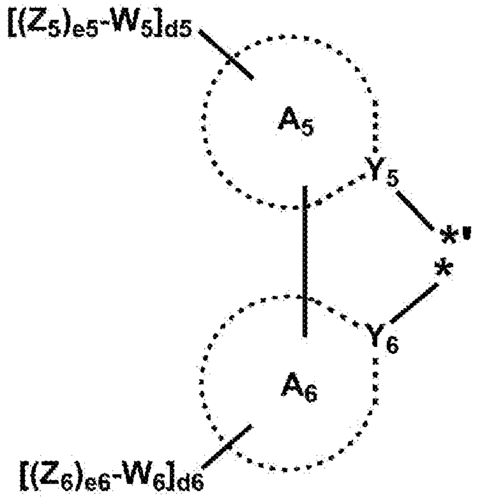

Formula 2-2

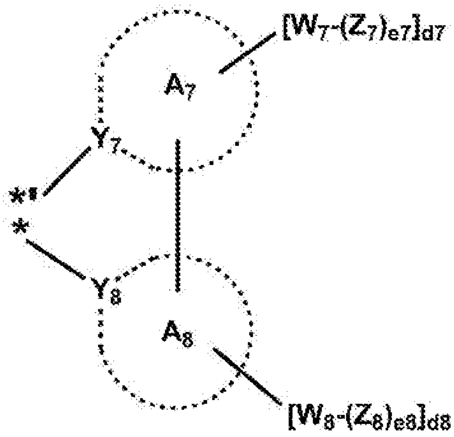

Formula 2-3

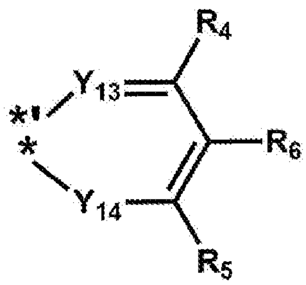

wherein, in Formulae 1-1 to 1-3 and 2-1 to 2-3, $Y_1$ to $Y_8$ may each independently be C or N, $Y_{11}$ to $Y_{14}$ may each be O, and * and *' each represent a binding site to Ir.

In an embodiment, $Y_1$, $Y_3$, $Y_5$, and $Y_7$ may each be N, and $Y_2$, $Y_4$, $Y_6$, and $Y_8$ may each be C.

In one or more embodiments, i) $Y_1$ and $Y_2$ may each be C, ii) $Y_3$ and $Y_4$ may each be C, iii) $Y_5$ and $Y_6$ may each be C, or iv) $Y_7$ and $Y_8$ may each be C.

In one or more embodiments, in Formulae 1, 2, 1-1, 1-2, 2-1, and 2-2, i) a bond between $Y_1$ and Ir, a bond between $Y_3$ and Ir, a bond between $Y_5$ and Ir, and a bond between $Y_7$ and Ir may each be a coordinate bond, and ii) a bond between $Y_2$ and Ir, a bond between $Y_4$ and Ir, a bond between $Y_6$ and Ir, and a bond between $Y_8$ and Ir may each be a covalent bond.

Ring $A_1$ to ring $A_8$ in Formulae 1-1, 1-2, 2-1, and 2-2 may each independently be a $C_5$-$C_{30}$ carbocyclic group or a $C_1$-$C_{30}$ heterocyclic group.

In an embodiment, i) ring $A_1$, ring $A_3$, ring $A_5$, and ring $A_7$ may each be a $C_1$-$C_{30}$ heterocyclic group, and ii) ring $A_2$, ring $A_4$, ring $A_6$, and ring $A_8$ may each independently be a $C_5$-$C_{30}$ carbocyclic group or a $C_1$-$C_{30}$ heterocyclic group.

In one or more embodiments, i) ring $A_1$, ring $A_3$, ring $A_5$, and ring $A_7$ may each be a $C_1$-$C_{30}$ heterocyclic group, ii) ring $A_2$, ring $A_4$, ring $A_6$, and ring $A_8$ may each independently be a $C_5$-$C_{30}$ carbocyclic group or a $C_1$-$C_{30}$ heterocyclic group, iii) $Y_1$, $Y_3$, $Y_5$, and $Y_7$ may each be N, and iv) $Y_2$, $Y_4$, $Y_6$, and $Y_8$ may each be C.

In one or more embodiments, ring $A_1$, ring $A_3$, ring $A_5$, and ring $A_7$ in Formulae 1-1, 1-2, 2-1, and 2-2 may each independently be i) ring T1, ii) a condensed ring in which two or more ring T1(s) are condensed with each other, or iii) a condensed ring in which at least one ring T1 and at least one ring T2 are condensed with each other,

ring T1 may be a pyridine group, a pyrimidine group, a pyrazine group, a pyridazine group, a triazine group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

ring T2 may be a cyclopentane group, a cyclopentene group, a furan group, a thiophene group, a pyrrole group, a silole group, a borole group, a phosphole group, a germole group, a selenophene group, an adamantane group, a norbornane group, a norbornene group, a cyclohexane group, a cyclohexene group, or a benzene group.

In one or more embodiments, in Formulae 1-1, 1-2, 2-1, and 2-2, ring $A_2$, ring $A_4$, ring $A_6$, and ring $A_8$ may each

independently be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,

the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In an embodiment, ring $A_1$, ring $A_3$, ring $A_5$, and ring $A_7$ in Formulae 1-1, 1-2, 2-1, and 2-2 may each independently be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, a pyridine group condensed with a cyclohexane group, or a pyridine group condensed with a norbornane group.

In one or more embodiments, ring $A_2$, ring $A_4$, ring $A_6$, and ring $A_8$ in Formulae 1-1, 1-2, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group,

an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

$W_1$ to $W_8$ in Formulae 1-1, 1-2, 2-1, and 2-2 may each independently be a single bond, a $C_1$-$C_{20}$ alkylene group unsubstituted or substituted with at least one $R_{10a}$, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

In an embodiment, $W_1$ to $W_8$ in Formulae 1-1, 1-2, 2-1, and 2-2 may each independently be:

a single bond; or

a $C_1$-$C_{20}$ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a

pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one $R_{10a}$.

In an embodiment, $W_1$ to $W_8$ in Formulae 1-1, 1-2, 2-1, and 2-2 may each independently be:

a single bond; or
a benzene group, a naphthalene group, a pyridine group, a fluorene group, a carbazole group, a dibenzofuran group, or a dibenzothiophene group, each unsubstituted or substituted with at least one $R_{10a}$.

In one or more embodiments, $W_1$ to $W_8$ in Formulae 1-1, 1-2, 2-1, and 2-2 may each independently be:

a single bond; or
a $C_1$-$C_{20}$ alkylene group, a benzene group, a naphthalene group, a dibenzofuran group, or a dibenzothiophene group, each unsubstituted or substituted with at least one of deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

$Z_1$ to $Z_8$ and $R_1$ to $R_6$ in Formulae 1-1, 1-2, 1-3, 2-1, 2-2, and 2-3 may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), - Ge($Q_3$)($Q_4$)($Q_5$), -B($Q_6$)($Q_7$), -P(=O)($Q_8$)($Q_9$), or -P($Q_8$)($Q_9$). $Q_1$ to $Q_9$ are as described herein.

In an embodiment, $Z_1$ to $Z_8$ and $R_1$ to $R_6$ in Formulae 1-1, 1-2, 1-3, 2-1, 2-2, and 2-3 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -$SF_5$, a $C_1$-$C_{20}$ alkyl group, a $C_2$-$C_{20}$ alkenyl group, a $C_1$-$C_{20}$ alkoxy group, or a $C_1$-$C_{20}$ alkylthio group;
a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with at least one of deuterium, -F, - Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group (also referred to as a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a

norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl) phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1] hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl) norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl) bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$,
wherein $Q_1$ to $Q_9$ may each independently be:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a phenyl group, or a combination thereof.

In one or more embodiments, $Z_1$ to $Z_8$ and $R_1$ to $R_6$ in Formulae 1-1, 1-2, 1-3, 2-1, 2-2, and 2-3 may each independently be:

hydrogen, deuterium, -F, or a cyano group;
a $C_1$-$C_{20}$ alkyl group unsubstituted or substituted with at least one of deuterium, -F, a cyano group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a

combination thereof;

a $C_3$-$C_{10}$ cycloalkyl group, a $C_1$-$C_{10}$ heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with at least one of deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_1$-$C_{20}$ alkoxy group, a deuterated $C_1$-$C_{20}$ alkoxy group, a fluorinated $C_1$-$C_{20}$ alkoxy group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof; or

$-Si(Q_3)(Q_4)(Q_5)$ or $-Ge(Q_3)(Q_4)(Q_5)$.

In one or more embodiments, $Z_1$ to $Z_8$ and $R_1$ to $R_6$ in Formulae 1-1, 1-2, 1-3, 2-1, 2-2, and 2-3 may each independently be hydrogen, deuterium, -F, $-CH_3$, $-CD_3$, - $CD_2H$, $-CDH_2$, $-CF_3$, $-CF_2H$, $-CFH_2$, a $C_2$-$C_{10}$ alkenyl group, a $C_1$-$C_{10}$ alkoxy group, a $C_1$-$C_{10}$ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, $-Si(Q_3)(Q_4)(Q_5)$, or $-Ge(Q_3)(Q_4)(Q_5)$ (wherein $Q_3$ to $Q_5$ are as described herein):

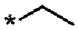
9-1
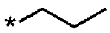
9-2
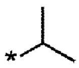
9-3
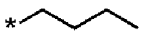
9-4
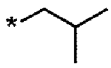
9-5
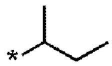
9-6
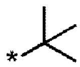
9-7
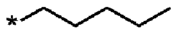
9-8

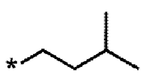
9-9
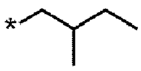
9-10
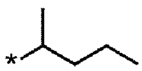
9-11
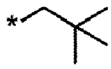
9-12
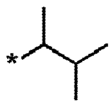
9-13
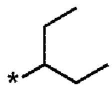
9-14
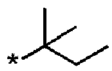
9-15

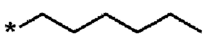
9-16
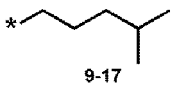
9-17
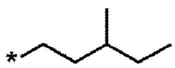
9-18
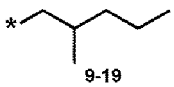
9-19
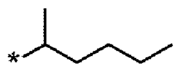
9-20
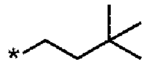
9-21

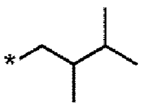
9-22
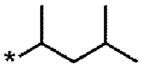
9-23
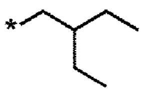
9-24
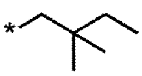
9-25
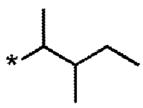
9-26
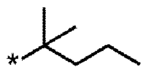
9-27
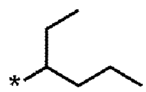
9-28

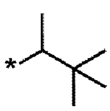
9-29
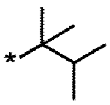
9-30
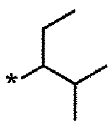
9-31
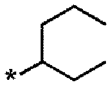
9-32
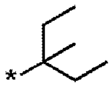
9-33
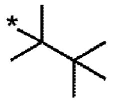
9-34
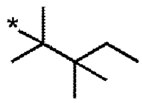
9-35
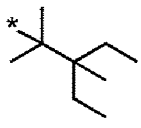
9-36

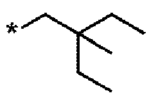 9-37
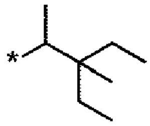 9-38
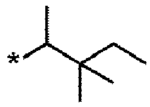 9-39

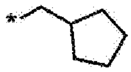 9-201
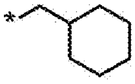 9-202
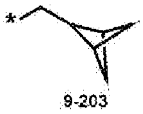 9-203
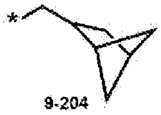 9-204
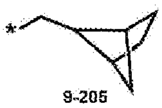 9-205
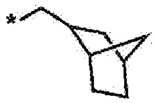 9-206
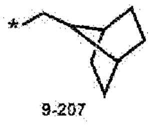 9-207

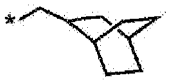 9-208
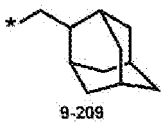 9-209
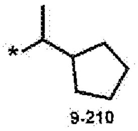 9-210
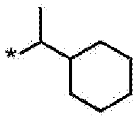 9-211
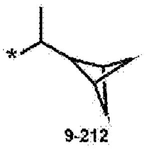 9-212
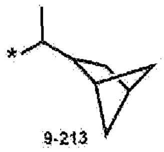 9-213
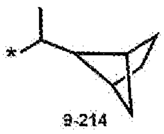 9-214

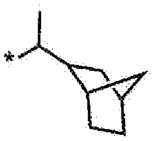 9-215
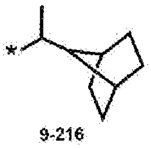 9-216
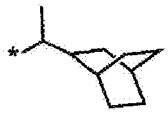 9-217
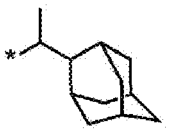 9-218
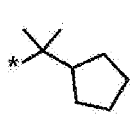 9-219
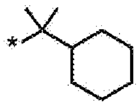 9-220
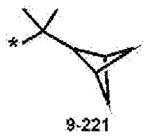 9-221

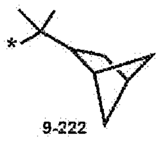 9-222
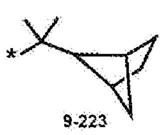 9-223
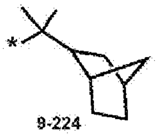 9-224
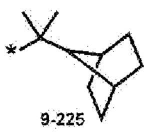 9-225
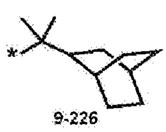 9-226
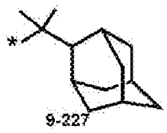 9-227

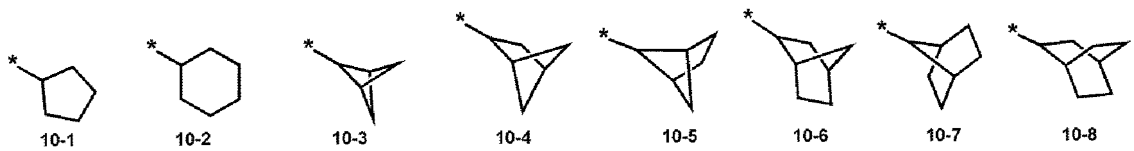
10-1 10-2 10-3 10-4 10-5 10-6 10-7 10-8

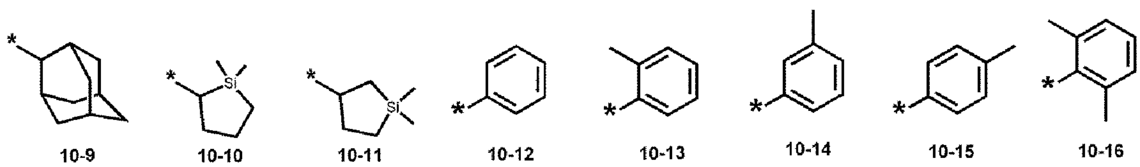
10-9 10-10 10-11 10-12 10-13 10-14 10-15 10-16

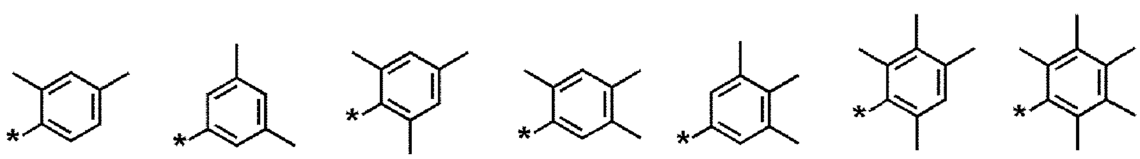
10-17 10-18 10-19 10-20 10-21 10-22 10-23

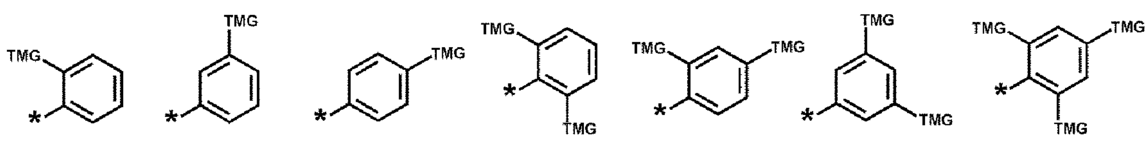
10-24 10-25 10-26 10-27 10-28 10-29 10-30

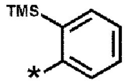 10-31 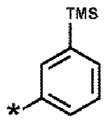 10-32 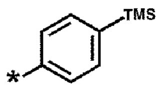 10-33 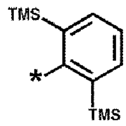 10-34 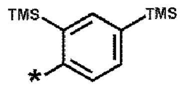 10-35 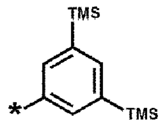 10-36 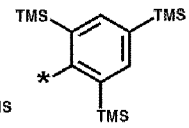 10-37

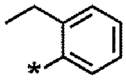 10-38 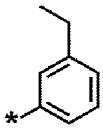 10-39 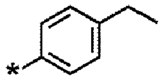 10-40 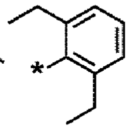 10-41 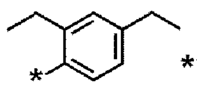 10-42 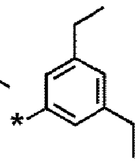 10-43 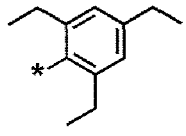 10-44

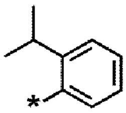 10-45 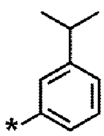 10-46 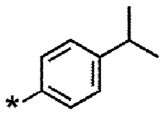 10-47 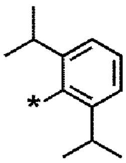 10-48 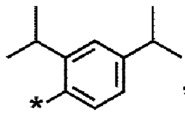 10-49 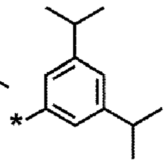 10-50 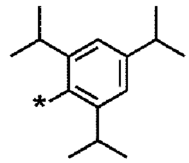 10-51

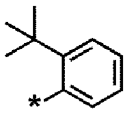 10-52 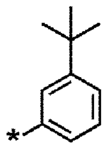 10-53 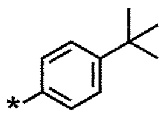 10-54 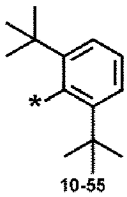 10-55 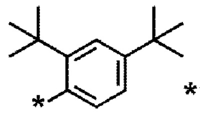 10-56 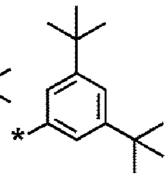 10-57 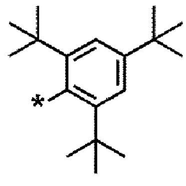 10-58

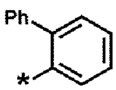 10-59 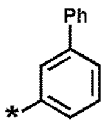 10-60 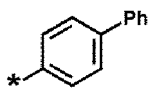 10-61 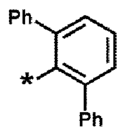 10-62 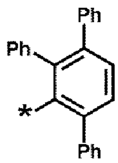 10-63 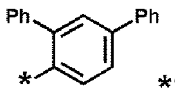 10-64 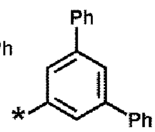 10-65 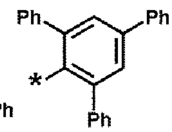 10-66

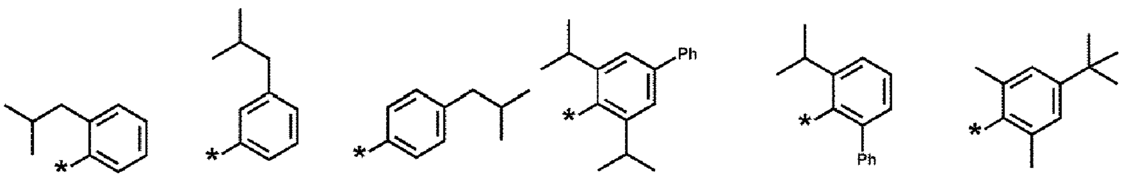

10-67 10-68 10-69 10-70 10-71 10-72

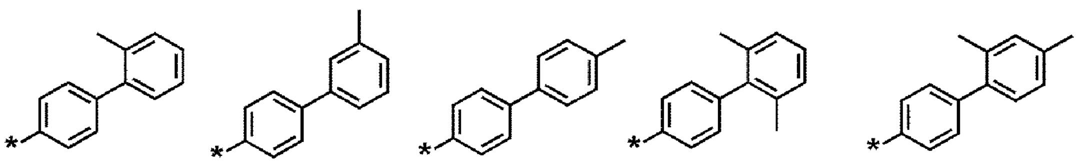

10-73 10-74 10-75 10-76 10-77

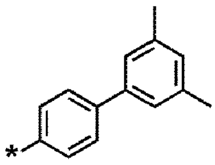
10-78

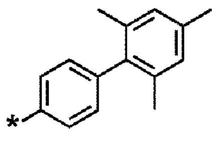
10-79

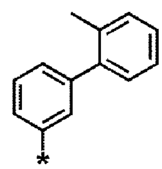
10-80

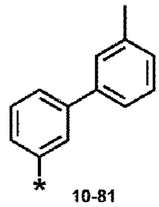
10-81

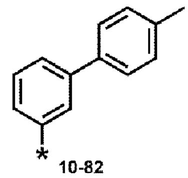
10-82

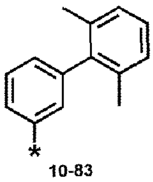
10-83

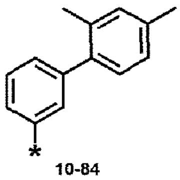
10-84

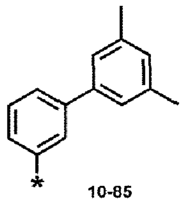
10-85

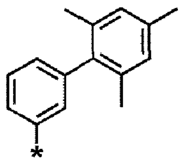
10-86

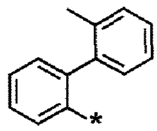
10-87

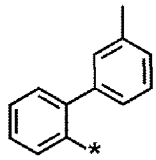
10-88

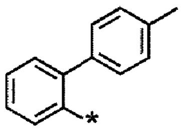
10-89

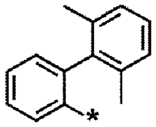
10-90

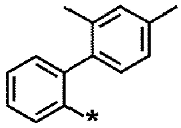
10-91

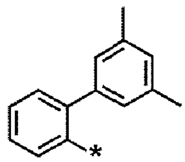
10-92

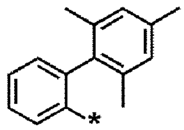
10-93

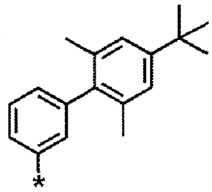
10-94

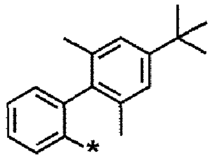
10-95

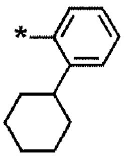
10-96

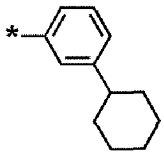
10-97

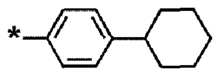
10-98

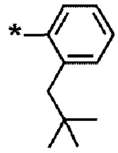
10-99

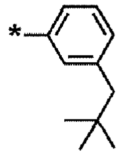
10-100

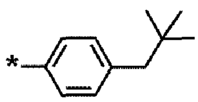
10-101

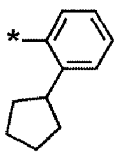
10-102

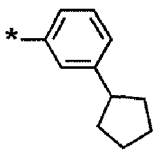
10-103

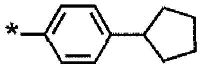
10-104

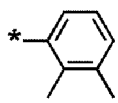
10-105

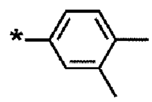
10-106

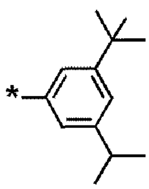
10-107

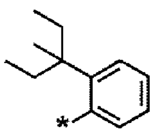
10-108

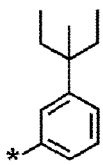
10-109

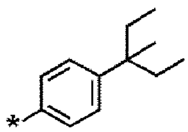
10-110

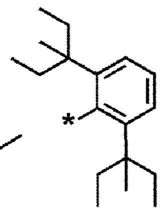
10-111

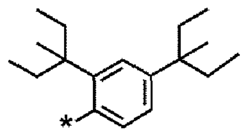
10-112

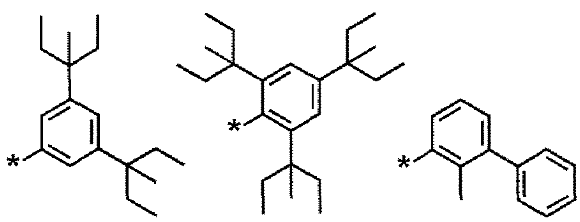
10-113 10-114 10-115

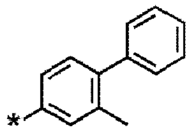
10-116

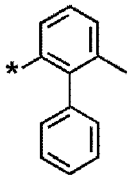
10-117

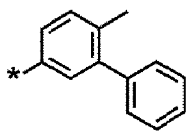
10-118

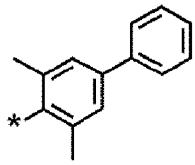
10-119

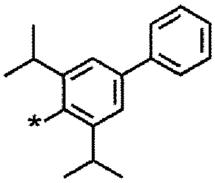
10-120

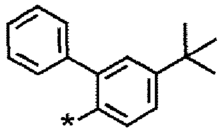
10-121

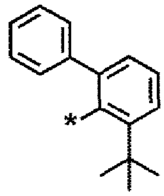
10-122

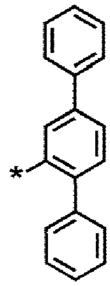
10-123

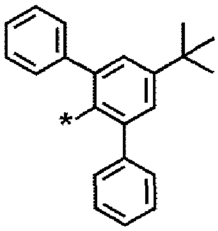
10-124

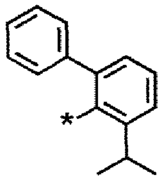
10-125

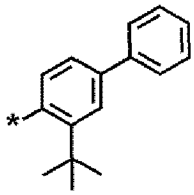
10-126

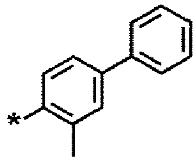
10-127

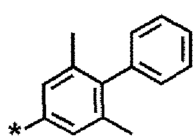
10-128

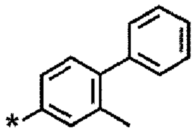
10-129

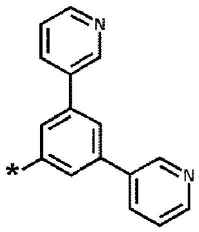
10-201

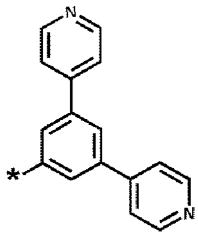
10-202

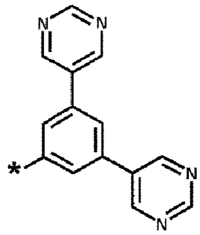
10-203

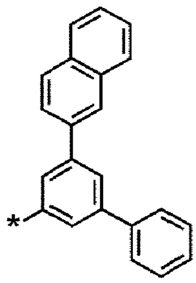
10-204

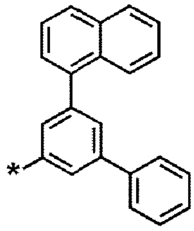
10-205

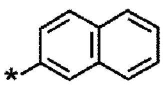
10-206

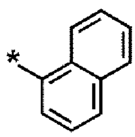
10-207

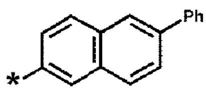
10-208

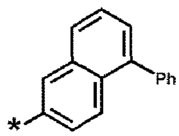
10-209

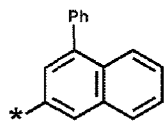
10-210

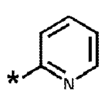
10-211

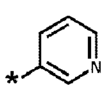
10-212

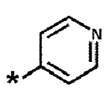
10-213

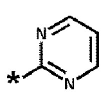
10-214

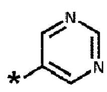
10-215

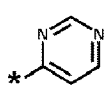
10-216

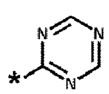
10-217

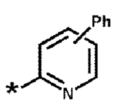
10-218

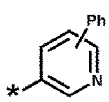
10-219

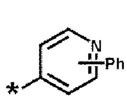
10-220

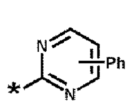
10-221

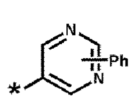
10-222

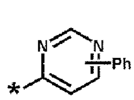
10-223

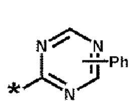
10-224

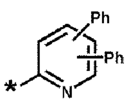 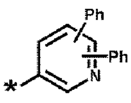 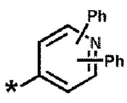 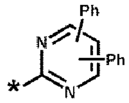 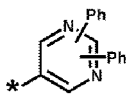 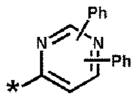 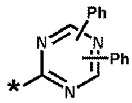

10-225 10-226 10-227 10-228 10-229 10-230 10-231

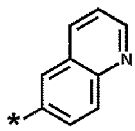 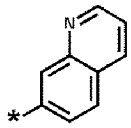 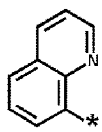 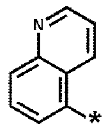 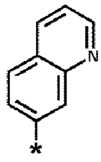 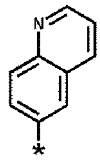

10-232 10-233 10-234 10-235 10-236 10-237

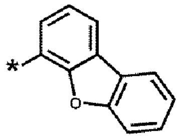 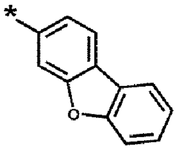 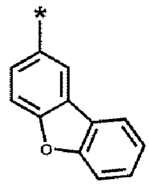 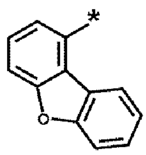 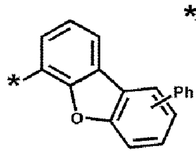 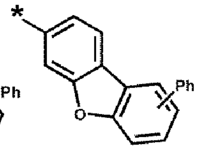

10-238 10-239 10-240 10-241 10-242 10-243

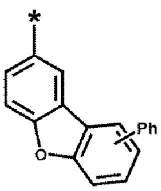 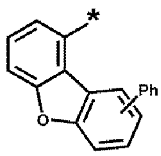 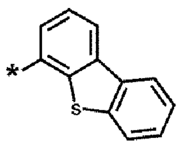 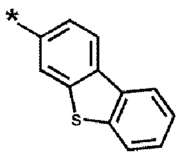 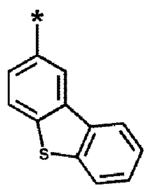 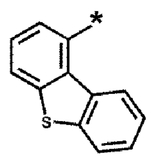

10-244 10-245 10-246 10-247 10-248 10-249

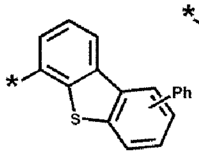 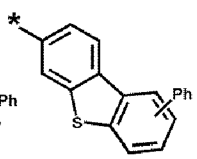 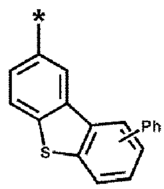 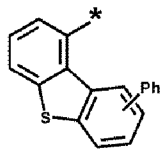 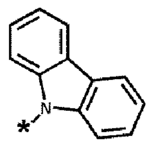 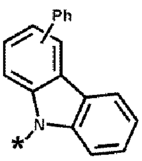

10-250 10-251 10-252 10-253 10-254 10-255

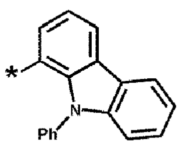 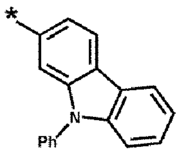 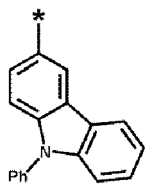 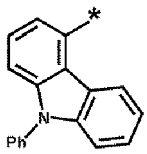 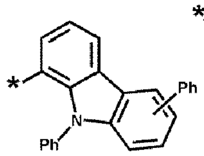 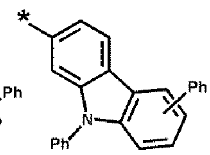

10-256 10-257 10-258 10-259 10-260 10-261

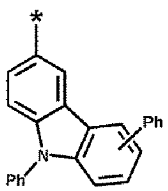 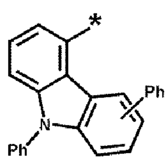 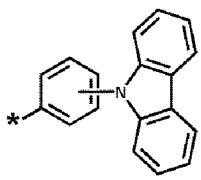

10-262 10-263 10-264 10-265 10-266 10-267

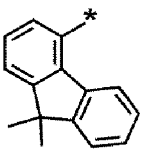 10-268 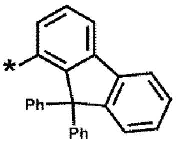 10-269 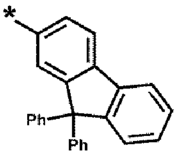 10-270 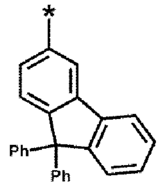 10-271 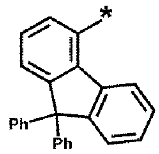 10-272

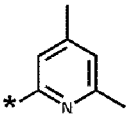 10-273 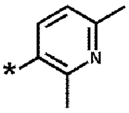 10-274 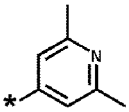 10-275 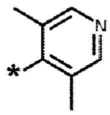 10-276 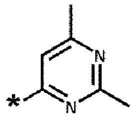 10-277 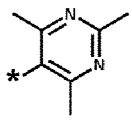 10-278 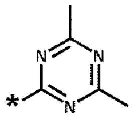 10-279

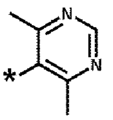 10-280 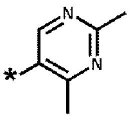 10-281 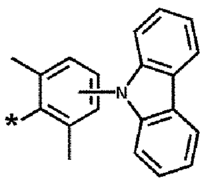 10-282 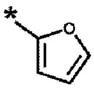 10-283 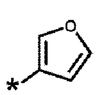 10-284 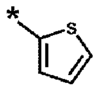 10-285 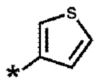 10-286

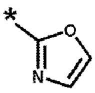 10-287 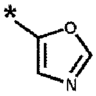 10-288 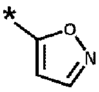 10-289 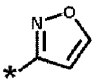 10-290 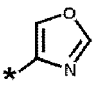 10-291 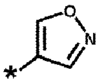 10-292 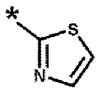 10-293 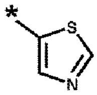 10-294 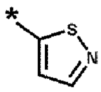 10-295

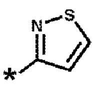 10-296 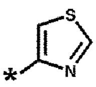 10-297 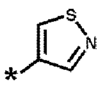 10-298 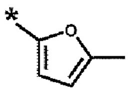 10-299 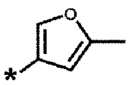 10-300 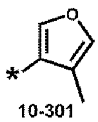 10-301 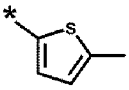 10-302 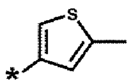 10-303 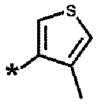 10-304

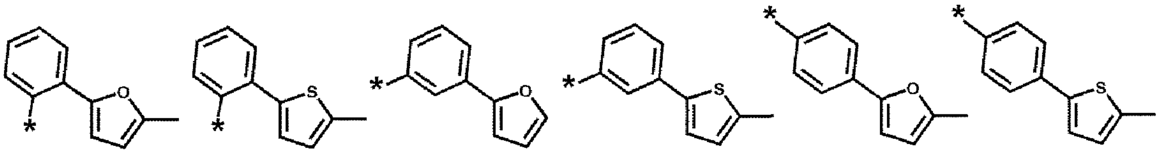

10-305 10-306 10-307 10-308 10-309 10-310

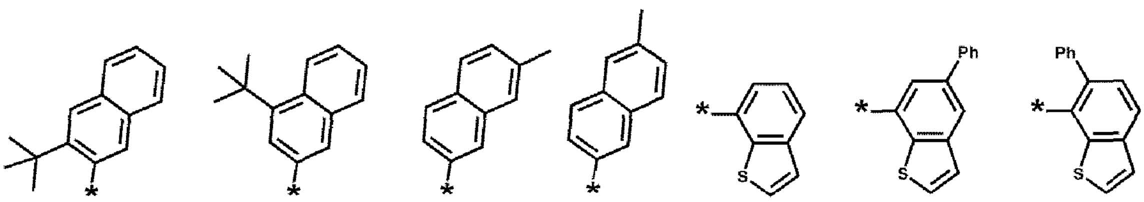

10-311 10-312 10-313 10-314 10-315 10-316 10-317

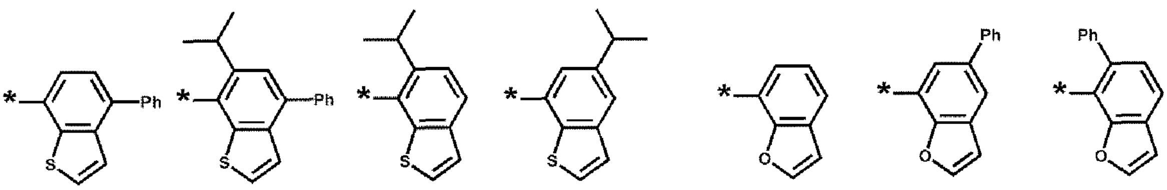

10-318 10-319 10-320 10-321 10-322 10-323 10-324

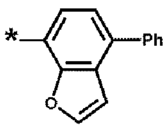 10-325
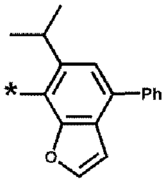 10-326
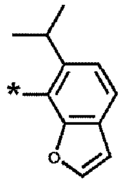 10-327
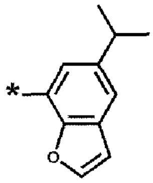 10-328
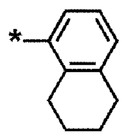 10-329
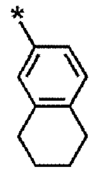 10-330
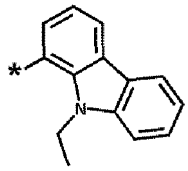 10-331

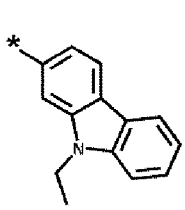 10-332
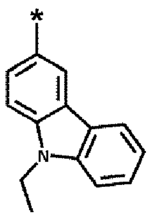 10-333
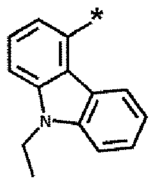 10-334
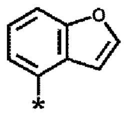 10-335
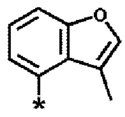 10-336
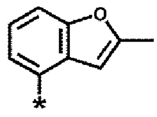 10-337

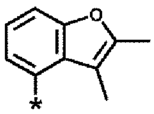 10-338
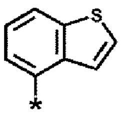 10-339
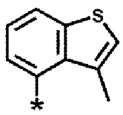 10-340
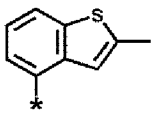 10-341
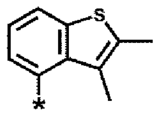 10-342
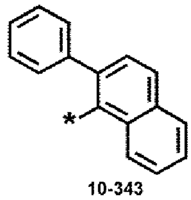 10-343

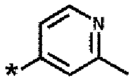 10-344
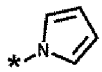 10-345
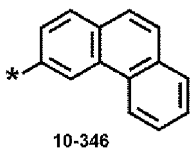 10-346
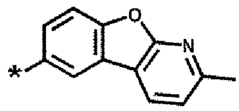 10-347
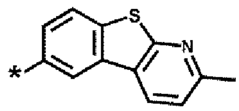 10-348

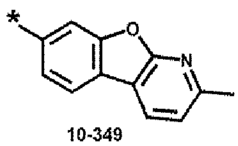 10-349
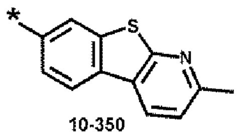 10-350

wherein, in Formulae 9-1 to 9-39, 9-201 to 9-227, 10-1 to 10-129, and 10-201 to 10-350, * indicates a binding site to a neighboring atom, Ph indicates a phenyl group, TMS indicates a trimethylsilyl group, and TMG indicates a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may be, for example, a group represented by one of Formulae 9-501 to 9-514 and 9-601 to 9-636:

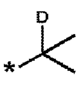 9-501
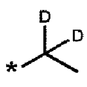 9-502
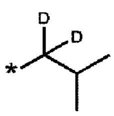 9-503
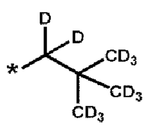 9-504
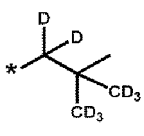 9-505
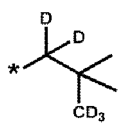 9-506
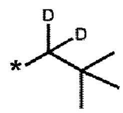 9-507

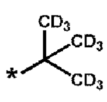 9-508
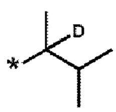 9-509
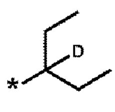 9-510
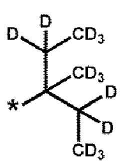 9-511
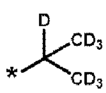 9-512
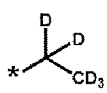 9-513
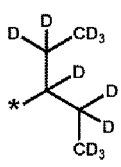 9-514

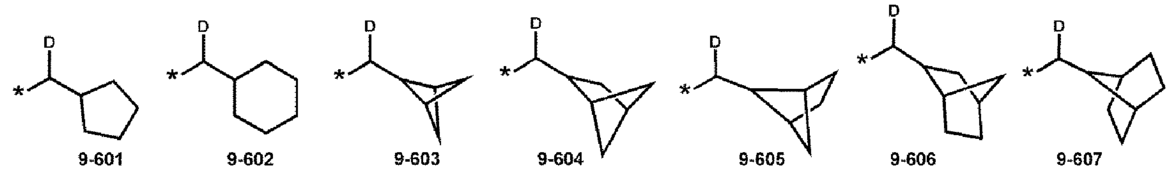

9-601 9-602 9-603 9-604 9-605 9-606 9-607

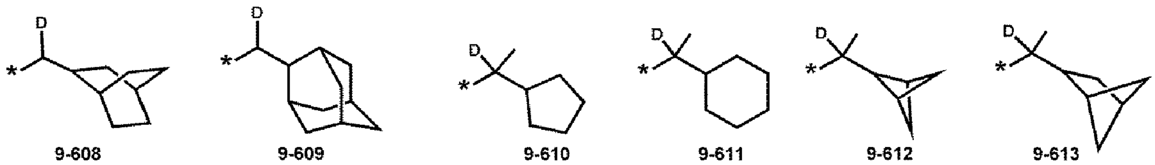

9-608 9-609 9-610 9-611 9-612 9-613

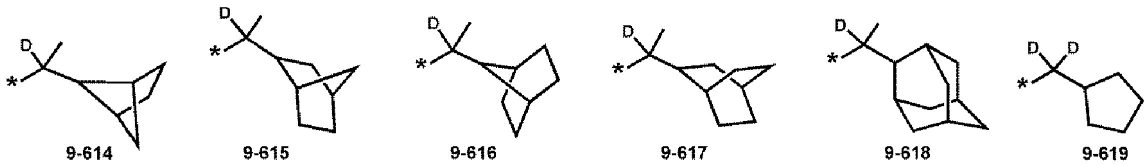

9-614 9-615 9-616 9-617 9-618 9-619

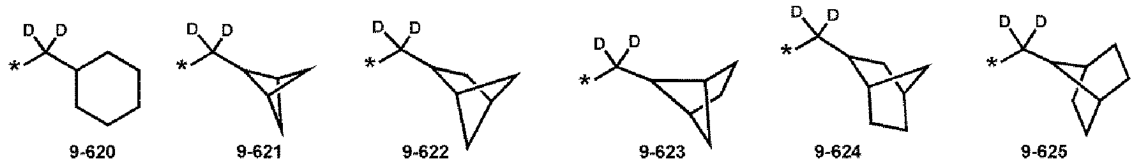

9-620 9-621 9-622 9-623 9-624 9-625

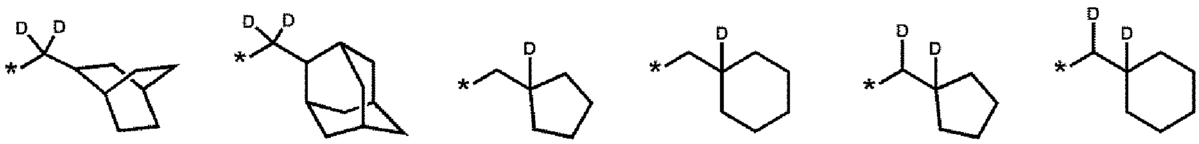

9-626 9-627 9-628 9-629 9-630 9-631

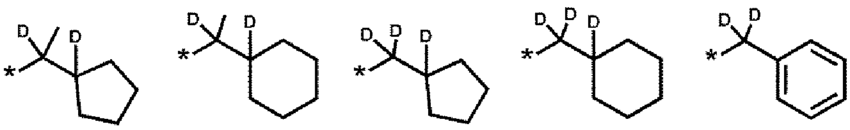

9-632 9-633 9-634 9-635 9-636

wherein * represents a binding site to a neighboring atom.

The "group represented by one of Formulae 9-1 to 9-39 in which at least one hydrogen is substituted with -F" and the "group represented by one of Formulae 9-201 to 9-227 in which at least one hydrogen is substituted with -F" may be, for example, a group represented by one of Formulae 9-701 to 9-710:

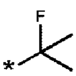
9-701

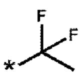
9-702

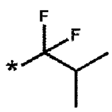
9-703

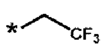
9-704

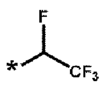
9-705

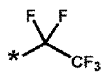
9-706

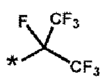
9-707

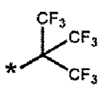
9-708

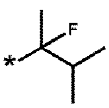
9-709

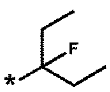
9-710

wherein * represents a binding site to a neighboring atom.

The "group represented by one of Formulae 10-1 to 10-129 in which at least one hydrogen is substituted with

deuterium" and the "group represented by one of Formulae 10-201 to 10-350 in which at least one hydrogen is substituted with deuterium" may be, for example, a group represented by one of Formulae 10-501 to 10-553:

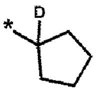
10-501
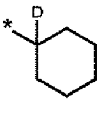
10-502
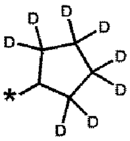
10-503
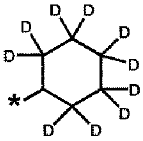
10-504
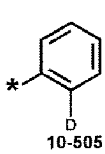
10-505
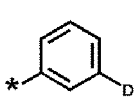
10-506
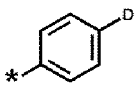
10-507
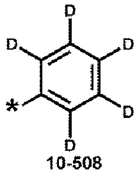
10-508

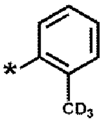
10-509
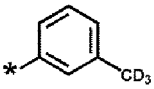
10-510
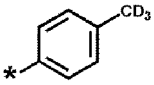
10-511
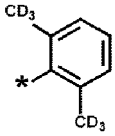
10-512
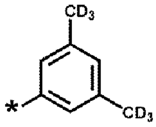
10-513
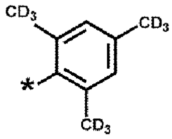
10-514
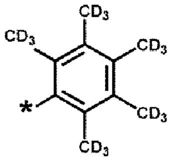
10-515

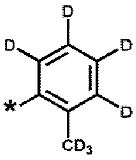
10-516
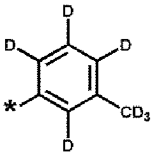
10-517
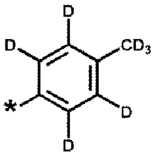
10-518
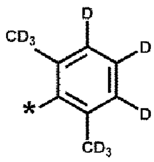
10-519
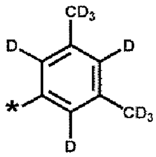
10-520
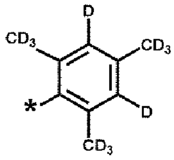
10-521

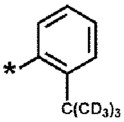
10-522
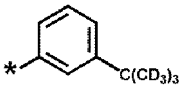
10-523
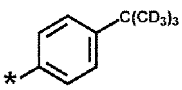
10-524
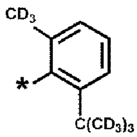
10-525
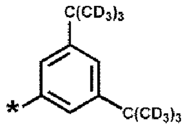
10-526
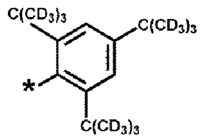
10-527

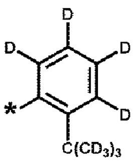
10-528
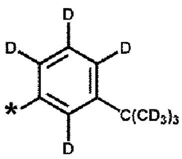
10-529
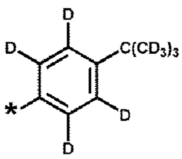
10-530
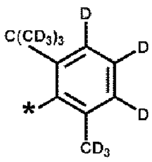
10-531
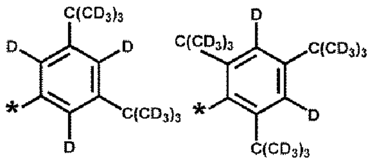
10-532
10-533

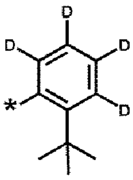
10-534
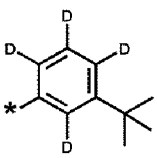
10-535
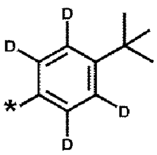
10-536
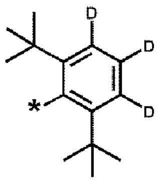
10-537
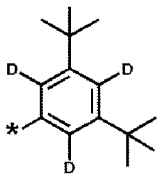
10-538
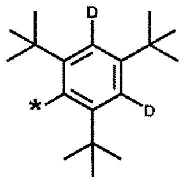
10-540

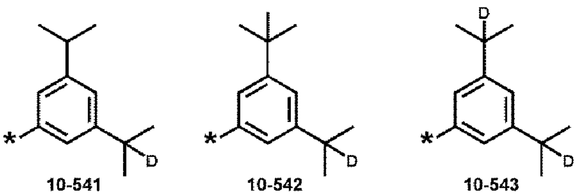
10-541
10-542
10-543
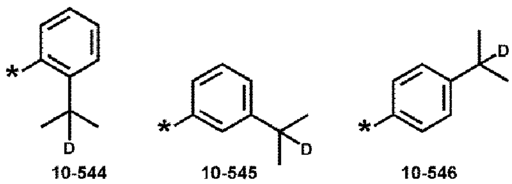
10-544
10-545
10-546

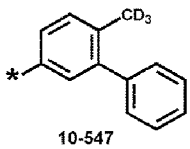
10-547
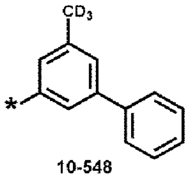
10-548
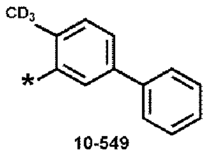
10-549
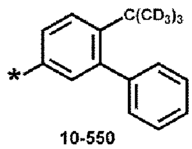
10-550
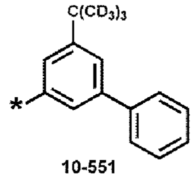
10-551

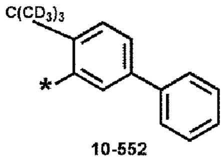
10-552
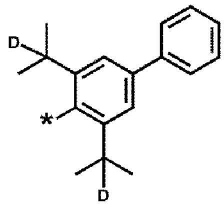
10-553

wherein * represents a binding site to a neighboring atom.

The "group represented by one of Formulae 10-1 to 10-129 in which at least one hydrogen is substituted with -F" and the "group represented by Formulae 10-201 to 10-350 in which at least one hydrogen is substituted with -F" may be, for example, a group represented by one of Formulae 10-601 to 10-617:

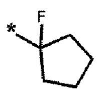
10-601
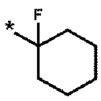
10-602
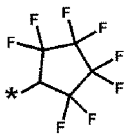
10-603
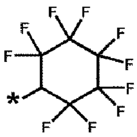
10-604
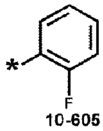
10-605
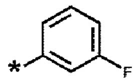
10-606
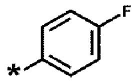
10-607
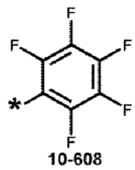
10-608

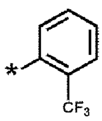
10-609
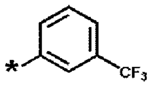
10-610
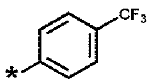
10-611
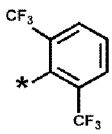
10-612
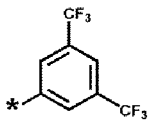
10-613
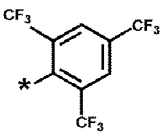
10-614
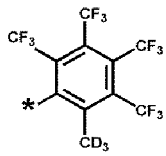
10-615

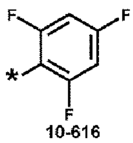
10-616
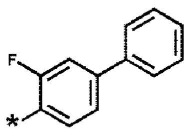
10-617

wherein * represents a binding site to a neighboring atom.

At least one of $R_1$ and $R_2$ in Formula 1-3 (for example, $R_1$ and $R_2$) may each independently have 4 or more, 5 or more, or 6 or more carbon atoms.

In an embodiment, $R_1$ in Formula 1-3 may not be a methyl group.

In one or more embodiments, $R_1$ and $R_2$ in Formula 1-3 may each not be a methyl group.

In one or more embodiments, $R_1$ in Formula 1-3 may not be a tert-butyl group.

In one or more embodiments, $R_1$ and $R_2$ in Formula 1-3 may each not be a tert-butyl group.

In one or more embodiments, Formula 1-3 may satisfy at least one of Conditions E1 to E3, or each of Conditions E1 and E2:

Condition E1

$R_1$ is a group represented by *-C($R_{11}$)($R_{12}$)($R_{13}$), and

$R_{11}$ to $R_{13}$ are each independently a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or

unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition E2

$R_1$ is a group represented by *-C($R_{11}$)($R_{12}$)($R_{13}$), and
at least one of $R_{11}$ to $R_{13}$ are each independently a substituted or unsubstituted $C_2$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition E3
$R_1$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group.

In one or more embodiments, Formula 1-3 may satisfy at least one of Conditions F1 to F3, or each of Conditions F1 and F2:

Condition F1

$R_2$ is a group represented by *-C($R_{21}$)($R_{22}$)($R_{23}$), and
$R_{21}$ to $R_{23}$ are each independently a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group

Condition F2

$R_2$ is a group represented by *-C($R_{21}$)($R_{22}$)($R_{23}$), and
at least one of $R_{21}$ to $R_{23}$ are each independently a substituted or unsubstituted $C_2$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition F3
$R_2$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group.

In one or more embodiments, $R_3$ in Formula 1-3 may be hydrogen or deuterium.
In one or more embodiments, $R_1$ and $R_2$ in Formula 1-3 may be identical to each other.
In one or more embodiments, $R_1$ and $R_2$ in Formula 1-3 may be different from each other.
In one or more embodiments, at least one of $R_4$ and $R_5$ in Formula 2-3 may be a methyl group.
In one or more embodiments, at least one of $R_4$ and $R_5$ in Formula 2-3 may be a tert-butyl group.
In one or more embodiments, Formula 2-3 may satisfy i) at least one of Conditions G1 to G3, or ii) both Conditions G1 and G2:

Condition G1

$R_4$ is a group represented by *-C($R_{41}$)($R_{42}$)($R_{43}$), and
$R_{41}$ to $R_{43}$ are each independently a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition G2

$R_4$ is a group represented by *-C($R_{41}$)($R_{42}$)($R_{43}$), and
at least one of $R_{41}$ to $R_{43}$ are each independently a substituted or unsubstituted $C_2$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition G3
$R_4$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group.

In one or more embodiments, Formula 2-3 may satisfy at least one of Conditions H1 to H3, or each of Conditions H1 and H2:

Condition H1

$R_5$ is a group represented by *-C($R_{51}$)($R_{52}$)($R_{53}$), and
$R_{51}$ to $R_{53}$ are each independently a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition H2

$R_5$ is a group represented by *-C($R_{51}$)($R_{52}$)($R_{53}$), and
at least one of $R_{51}$ to $R_{53}$ are each independently a substituted or unsubstituted $C_2$-$C_{60}$ alkyl group, a substituted or unsubstituted $C_3$-$C_{10}$ cycloalkyl group, a substituted or unsubstituted $C_1$-$C_{10}$ heterocycloalkyl group, a

substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group;

Condition H3
$R_5$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group.

In one or more embodiments, $R_6$ in Formula 2-3 may be hydrogen or deuterium.
In one or more embodiments, $R_4$ and $R_5$ in Formula 2-3 may be identical to each other.
In one or more embodiments, $R_4$ and $R_5$ in Formula 2-3 may be different from each other.
e1 to e8 and d1 to d8 in Formulae 1-1, 1-2, 2-1, and 2-2 indicate the numbers of $Z_1$ to $Z_8$, a group represented by *-[$W_1$-$(Z_1)_{e1}$], a group represented by *-[$W_2$-$(Z_2)_{e2}$], a group represented by *-[$W_3$-$(Z_3)_{e3}$], a group represented by *-[$W_4$-$(Z_4)_{e4}$], a group represented by *-[$W_5$-$(Z_5)_{e5}$], a group represented by *-[$W_6$-$(Z_6)_{e6}$], a group represented by *-[$W_7$-$(Z_7)_{e7}$], and a group represented by *-[$W_8$-$(Z_8)_{e8}$], respectively, and may each independently be an integer from 0 to 20. When e1 is 2 or more, two or more of $Z_1$(s) may be identical to or different from each other, when e2 is 2 or more, two or more of $Z_2$(s) may be identical to or different from each other, when e3 is 2 or more, two or more of $Z_3$(s) may be identical to or different from each other, when e4 is 2 or more, two or more of $Z_4$(s) may be identical to or different from each other, when e5 is 2 or more, two or more of $Z_5$(s) may be identical to or different from each other, when e6 is 2 or more, two or more of $Z_6$(s) may be identical to or different from each other, when e7 is 2 or more, two or more of $Z_7$(s) may be identical to or different from each other, when e8 is 2 or more, two or more of $Z_8$(s) may be identical to or different from each other, when d1 is 2 or more, two or more of groups represented by *-[$W_1$-$(Z_1)_{e1}$] may be identical to or different from each other, when d2 is 2 or more, two or more of groups represented by *-[$W_2$-$(Z_2)_{e2}$] may be identical to or different from each other, when d3 is 2 or more, two or more of groups represented by *-[$W_3$-$(Z_3)_{e3}$] may be identical to or different from each other, when d4 is 2 or more, two or more of groups represented by *-[$W_4$-$(Z_4)_{e1}$] may be identical to or different from each other, when d5 is 2 or more, two or more of groups represented by *-[$W_5$-$(Z_5)_{e5}$] may be identical to or different from each other, when d6 is 2 or more, two or more of groups represented by *-[$W_6$-$(Z_6)_{e6}$] may be identical to or different from each other, when d7 is 2 or more, two or more of groups represented by *-[$W_7$-$(Z_7)_{e7}$] may be identical to or different from each other, and when d8 is 2 or more, two or more of groups represented by *-[$W_8$-$(Z_8)_{e8}$] may be identical to or different from each other. In an embodiment, e1 to e8 and d1 to d8 in Formulae 1-1, 1-2, 2-1, and 2-2 may each independently be 0, 1, 2, or 3.
In Formulae 1-1, 1-2, 1-3, 2-1, 2-2, and 2-3, i) two or more of a plurality of $Z_1$(s), ii) two or more of a plurality of $Z_2$(s), iii) two or more of a plurality of $Z_3$(s), iv) two or more of a plurality of $Z_4$(s), v) two or more of a plurality of $Z_5$(s), vi) two or more of a plurality of $Z_6$(s), vii) two or more a plurality of $Z_7$(s), viii) two or more of a plurality of $Z_8$(s), ix) two or more of $R_1$ to $R_3$ , and x) at least one of $R_4$ to $R_6$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.
$R_{10a}$ may be as described herein in connection with $Z_1$.
**[0122]** * and *' in Formulae 1-1, 1-2, 1-3, 2-1, 2-2, and 2-3 each indicate a binding site to Ir in Formulae 1 and 2.
The expressions "*" and "*'" used herein each indicate a binding site to a neighboring atom, unless otherwise stated.
In an embodiment, in the composition, $L_{11}$ of Formula 1 may be a ligand represented by Formula 1-1, $L_{12}$ of Formula 1 may be a ligand represented by Formula 1-2, $L_{21}$ of Formula 2 may be a ligand represented by Formula 2-1, $L_{22}$ of Formula 2 may be a ligand represented by Formula 2-2, n13 of Formula 1 may be 0, n23 of Formula 2 may be 0, and the composition may satisfy at least one of Conditions G101 to G131:

Condition G101
Ring $A_1$ and ring $A_3$ in Formulae 1-1 and 1-2 are different from each other;

Condition G102
A $Y_1$-containing monocyclic group in ring $A_1$ of Formula 1-1, a $Y_2$-containing monocyclic group in ring $A_2$ of Formula 1-1, and a $Y_4$-containing monocyclic group in ring $A_4$ of Formula 1-2 are each a 6-membered ring;

Condition G103
A $Y_3$-containing monocyclic group in ring $A_3$ of Formula 1-2 is a 6-membered ring;

Condition G104
A $Y_3$-containing monocyclic group in ring $A_3$ of Formula 1-2 is a 5-membered ring;

Condition G105
A $Y_1$-containing monocyclic group in ring $A_1$ of Formula 1-1 is a 6-membered ring, and a $Y_3$-containing monocyclic group in ring $A_3$ of Formula 1-2 is a 5-membered ring;

Condition G106
Ring As and ring $A_7$ in Formulae 2-1 and 2-2 are identical to each other;

Condition G107
A $Y_5$-containing monocyclic group in ring $A_5$ of Formula 2-1, a $Y_6$-containing monocyclic group in ring $A_6$ of Formula 2-1, and a $Y_8$-containing monocyclic group in ring $A_8$ of Formula 2-2 are each a 6-membered ring;

Condition G108
A $Y_7$-containing monocyclic group in ring $A_7$ of Formula 2-2 is a 6-membered ring;

Condition G109
A $Y_7$-containing monocyclic group in ring $A_7$ of Formula 2-2 is a 5-membered ring;

Condition G110
A $Y_5$-containing monocyclic group in ring $A_5$ of Formula 2-1 and a $Y_7$-containing monocyclic group in ring $A_7$ of Formula 2-2 are each a 6-membered ring;

Condition G111

Ring $A_1$, ring $A_3$, ring $A_5$, and ring $A_7$ in Formulae 1-1, 1-2, 2-1, and 2-2 are each independently i) an A group, ii) a polycyclic group having 4 to 60 carbon atoms in which two or more A groups are condensed with each other, or iii) a polycyclic group having 4 to 60 carbon atoms in which at least one A group and at least one B group are condensed with each other,
the A group is a pyridine group, a pyrimidine group, a pyridazine group, a pyrazine group, or a triazine group, and
the B group is a cyclohexane group, a cyclohexene group, a norbornane group, a benzene group, a furan group, a thiophene group, a selenophene group, a pyrrole group, a cyclopentadiene group, or a silole group;

Condition G112

Ring $A_3$ and ring $A_7$ in Formulae 1-2 and 2-2 are each independently i) a C group, ii) a polycyclic group having 4 to 60 carbon atoms in which two or more C groups are condensed with each other, or iii) a polycyclic group having 4 to 60 carbon atoms in which at least one C group and at least one D group are condensed with each other,
the C group is a pyrrole group, a pyrazole group, an imidazole group, a triazole group, an oxazole group, an isoxazole group, a thiazole group, or an isothiazole group, and
the D group is a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group;

Condition G113
Ring $A_1$ and ring $A_5$ in Formulae 1-1 and 2-1 are each independently:

a pyridine group, a pyrimidine group, a pyridazine group, or a pyrazine group; or
a pyridine group, a pyrimidine group, a pyridazine group, or a pyrazine group, each condensed with a cyclohexane group, norbornane group, a benzene group, or a combination thereof;

Condition G114
Ring $A_3$ and ring $A_7$ in Formulae 1-2 and 2-2 are each independently:

a pyridine group, a pyrimidine group, a pyridazine group, or a pyrazine group;
a pyridine group, a pyrimidine group, a pyridazine group, or a pyrazine group, each condensed with a cyclohexane group, norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group;

Condition G115
Ring $A_2$ and ring $A_4$ in Formulae 1-1 and 1-2 are different from each other;

Condition G116
Ring $A_6$ and ring $A_8$ in Formulae 2-1 and 2-2 are different from each other;

Condition G117

Ring $A_2$, ring $A_4$, ring $A_6$, and ring $A_8$ in Formulae 1-1, 1-2, 2-1, and 2-2 are each independently i) an E group, ii) a polycyclic group having 4 to 60 carbon atoms in which two or more E groups are condensed with each other, or iii) a polycyclic group having 4 to 60 carbon atoms in which at least one E group and at least one F group are condensed with each other,
the E group is a benzene group, a pyridine group, a pyrimidine group, a pyridazine group, a pyrazine group, or a triazine group, and
the F group is a furan group, a thiophene group, a selenophene group, a pyrrole group, a cyclopentadiene group, a silole group, a pyrazole group, an imidazole group, an oxazole group, a thiazole group, an isoxazole group, or an isothiazole group;

Condition G118
Ring $A_2$ in Formula 1-1 is a polycyclic group having 4 to 60 carbon atoms in which two or more E groups and at least one F group are condensed with each other;

Condition G119
Ring $A_4$ in Formula 1-2 is a polycyclic group having 4 to 60 carbon atoms in which two or more E groups and at least one F group are condensed with each other

Condition G120
Ring $A_6$ in Formula 2-1 is a polycyclic group having 4 to 60 carbon atoms in which two or more E groups and one or more F groups are condensed with each other;

Condition G121
Ring $A_8$ in Formula 2-2 is a polycyclic group having 4 to 60 carbon atoms in which two or more E groups and at least one F group are condensed with each other;

Condition G122
Ring $A_2$ and ring $A_6$ in Formulae 1-1 and 2-1 are each independently:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or a combination thereof;

Condition G123
Ring $A_4$ and ring $A_8$ in Formulae 1-2 and 2-2 are each independently:

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof;

Condition G124
e1 and d1 in Formula 1-1 are each not 0, and at least one of $Z_1$(s) are each independently a deuterated $C_1$-$C_{20}$ alkyl group, -Si($Q_3$)($Q_4$)($Q_5$), or - Ge($Q_3$)($Q_4$)($Q_5$) (wherein $Q_3$ to $Q_5$ are as described in the present specification);

Condition G125
e5 and d5 in Formula 2-1 are each not 0, and at least one of $Z_5$(s) are each independently a deuterated $C_1$-$C_{20}$ alkyl group, -Si($Q_3$)($Q_4$)($Q_5$), or - Ge($Q_3$)($Q_4$)($Q_5$) (wherein $Q_3$ to $Q_5$ are as described in the present specification)

Condition G126

A group represented by

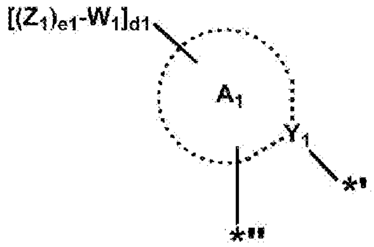

in Formula 1-1 is a group represented by one of Formulae A1-1 to A1-3;

a group represented by

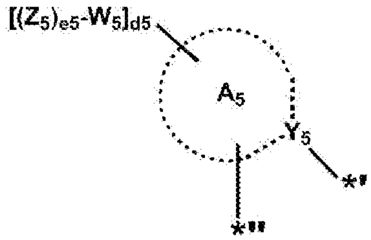

in Formula 2-1 is a group represented by one of Formulae A5-1 to A5-3; or

a group represented by

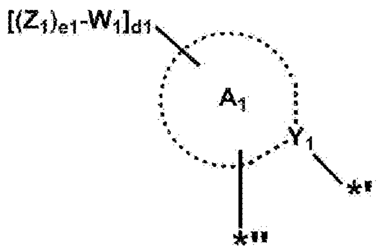

in Formula 1-1 is a group represented by one of Formulae A1-1 to A1-3, and a group represented by

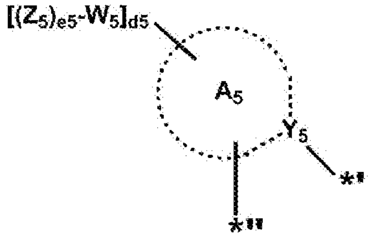

in Formula 2-1 is a group represented by one of Formulae A5-1 to A5-3:

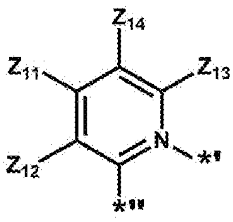

A1-1

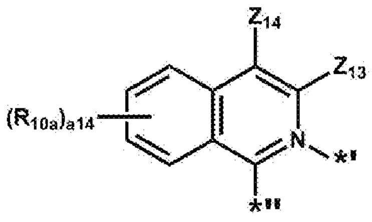

A1-2

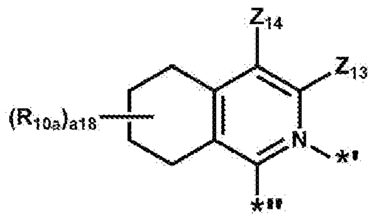

A1-3

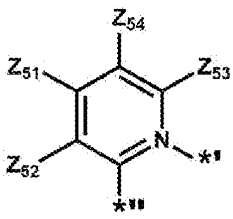

A5-1

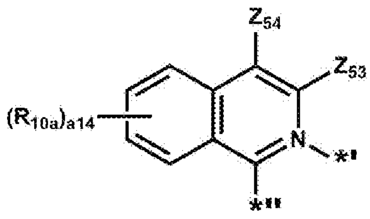

A5-2

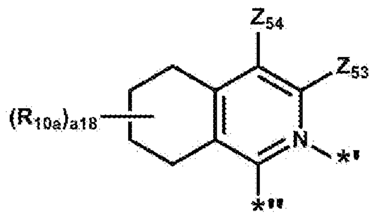

A5-3

wherein, in Formulae A1-1 to A1-3 and A5-1 to A5-3,

$Z_{11}$ to $Z_{14}$ are as described in connection with $Z_1$,
$Z_{51}$ to $Z_{54}$ are as described in connection with $Z_5$,
$R_{10a}$ is as described in the present specification,
a14 may be an integer from 0 to 4,
a18 may be an integer from 0 to 8,

*' indicates a binding site to Ir in Formulae 1 and 2, and
*" indicates a binding site to ring $A_2$ or ring $A_6$. In an embodiment, at least one of $Z_{11}$, $Z_{12}$, and $Z_{14}$ (for example, $Z_{14}$) in Formulae A1-1 to A1-3 may be:

a $C_1$-$C_{20}$ alkyl group unsubstituted or substituted with at least one of deuterium, -F, a phenyl group, or a combination thereof;
$-Si(Q_3)(Q_4)(Q_5)$; or
$-Ge(Q_3)(Q_4)(Q_5)$. In one or more embodiments, at least one of $Z_{51}$, $Z_{52}$, and $Z_{54}$ (for example, $Z_{54}$) in Formulae A5-1 to A5-3 may be:

a $C_1$-$C_{20}$ alkyl group unsubstituted or substituted with at least one of deuterium, -F, a phenyl group, or a combination thereof;
$-Si(Q_3)(Q_4)(Q_5)$; or
$-Ge(Q_3)(Q_4)(Q_5)$;

Condition G127
A group represented by

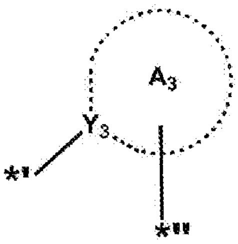

in Formula 1-2 and a group represented by

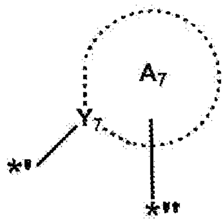

in Formula 2-2 are each independently a group represented by one of Formulae NR1 to NR48:

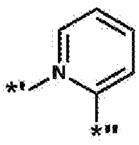
NR1

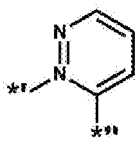
NR2

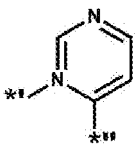
NR3

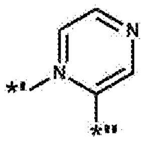
NR4

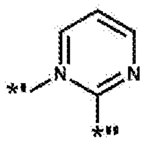
NR5

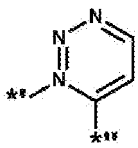
NR6

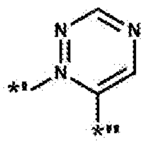
NR7

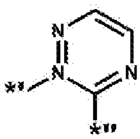
NR8

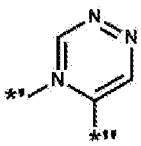
NR9

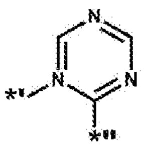
RN10

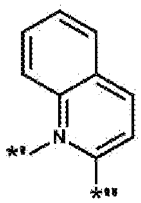
NR11

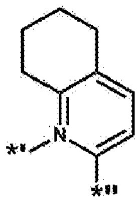
NR12

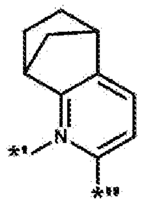
NR13

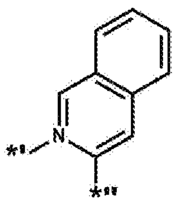
NR14

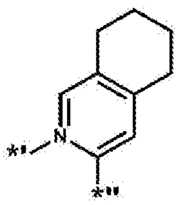
NR15

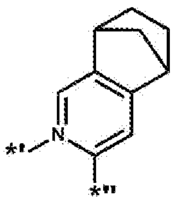
NR16

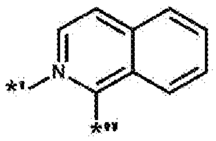
NR17

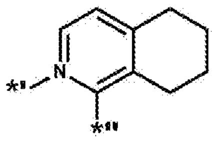
NR18

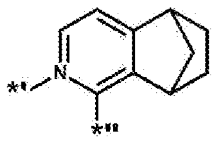
NR19

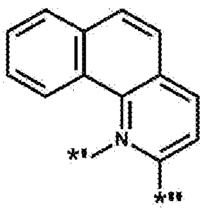
NR20

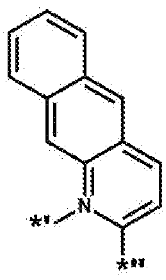
NR21

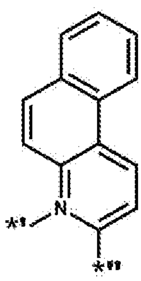
NR22

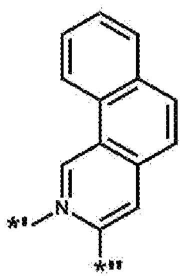
NR23

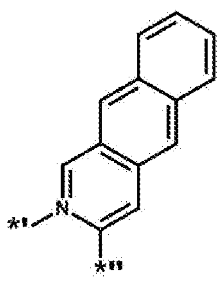
NR24

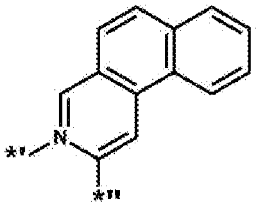
NR25

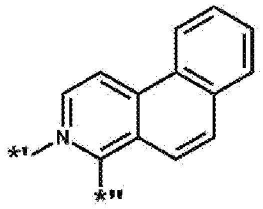
NR26

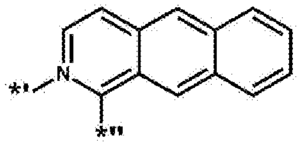
NR27

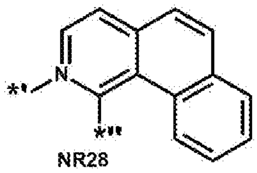
NR28

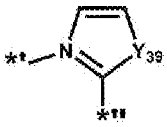
NR29

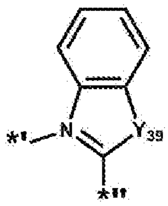
NR30

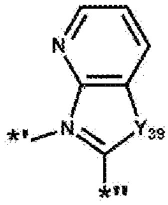
NR31

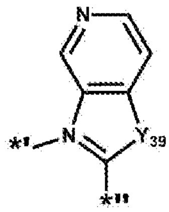
NR32

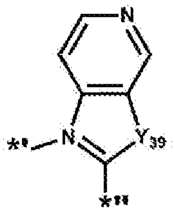
NR33

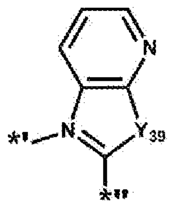
NR34

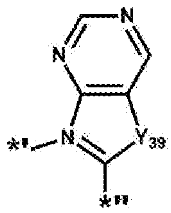
NR35

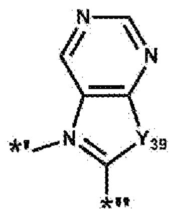
NR36

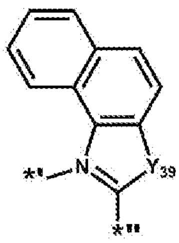
NR37

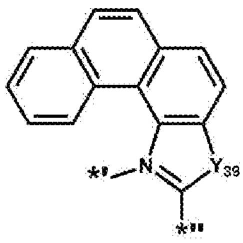
NR38

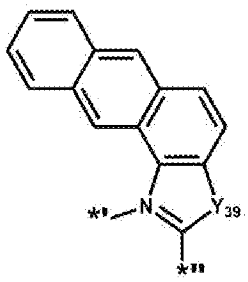
NR39

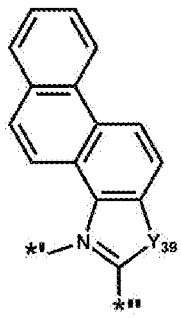
NR40

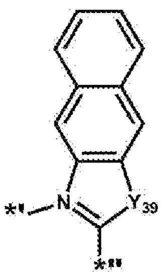
NR41

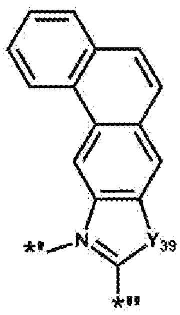
NR42

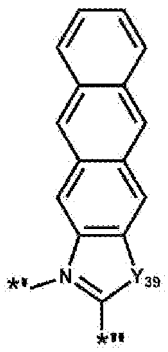
NR43

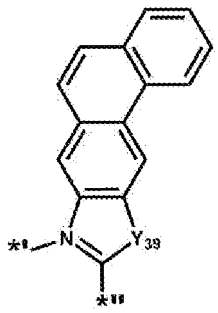
NR44

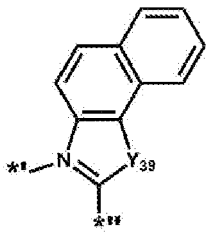
NR45

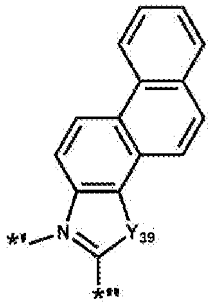
NR46

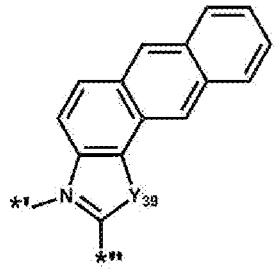
NR47

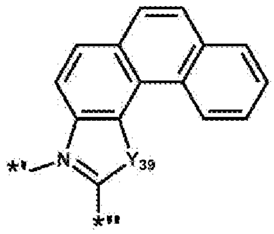
NR48

wherein, in Formulae NR1 to NR48,

$Y_{39}$ may be O, S, Se, N-[$W_3$-$(Z_3)_{e3}$], N-[$W_7$-$(Z_7)_{e7}$], C($Z_{39a}$)($Z_{39b}$), C($Z_{79a}$)($Z_{79b}$), Si($Z_{39a}$)($Z_{39b}$), or Si($Z_{79a}$)($Z_{79b}$),
$W_3$, $W_7$, $Z_3$, $Z_7$, e3, and e7 are as described in the present specification, $Z_{39a}$ and $Z_{39b}$ are as described in connection with $Z_3$, and $Z_{79a}$ and $Z_{79b}$ are as described in connection with $Z_7$,
*' indicates a binding site to Ir in Formula 1 or Formula 2, and
*" indicates a binding site to ring $A_4$ or ring $A_8$;

Condition G128
A group represented by

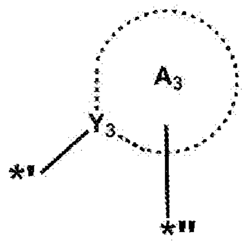

in Formula 1-2 is a group represented by one of Formulae NR30 to NR48;

Condition G129
A group represented by

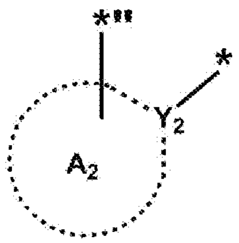

in Formula 1-1 , a group represented by

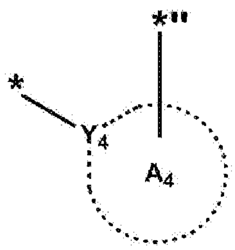

in Formula 1-2, a group represented by

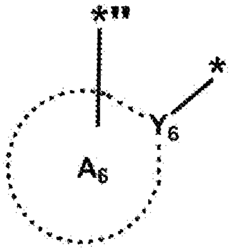

in Formula 2-1, and a group represented by

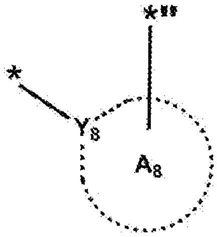

in Formula 2-2 are each independently a group represented by one of Formulae CR1 to CR29:

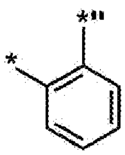
CR1

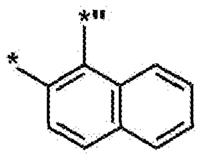
CR2

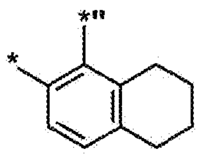
CR3

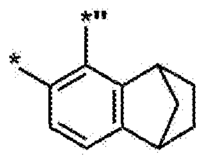
CR4

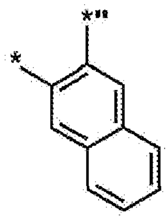
CR5

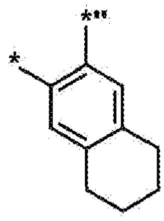
CR6

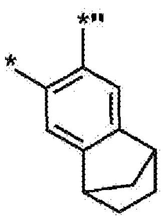
CR7

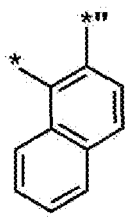
CR8

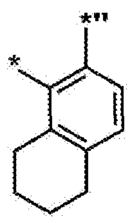
CR9

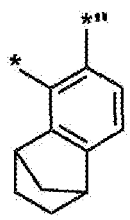
CR10

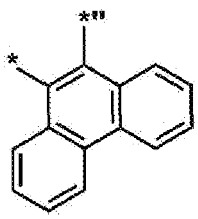
CR11

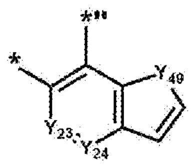
CR12

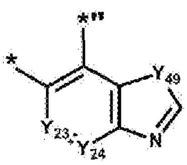
CR13

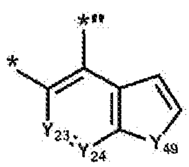
CR14

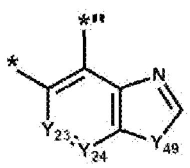
CR15

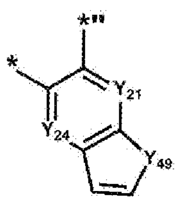
CR16

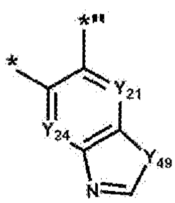
CR17

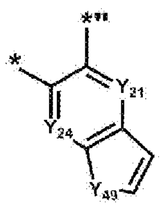
CR18

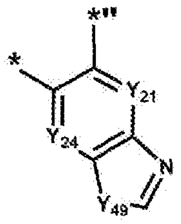
CR19

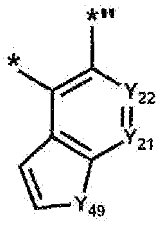
CR20

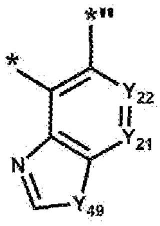
CR21

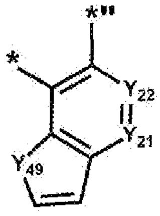
CR22

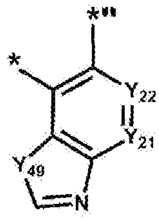
CR23

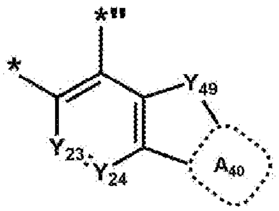
CR24

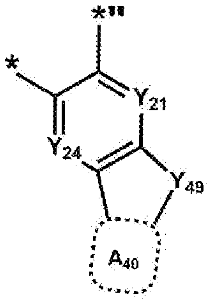
CR25

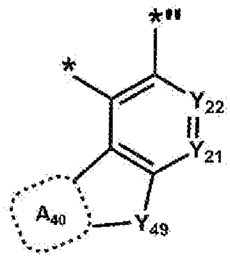
CR26

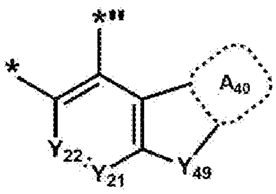
CR27

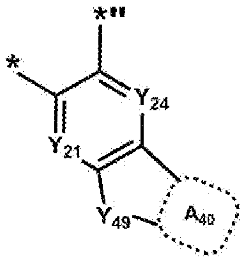
CR28

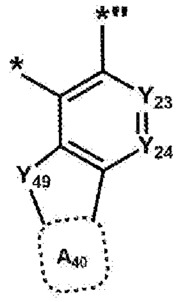
CR29

wherein, in Formulae CR1 to CR29,

$Y_{49}$ may be O, S, Se, N-[$W_2$-$(Z_2)_{e2}$], N-[$W_4$-$(Z_4)_{e4}$], N-[$W_6$-$(Z_6)_{e6}$], N-[$W_8$-(Z8)e8], C(Z29a)(Z29b), C(Z49a)(Z49b), C(Z69a)(Z69b), C($Z_{89a}$)($Z_{89b}$), Si($Z_{29a}$)($Z_{29b}$), Si($Z_{49a}$)($Z_{49b}$), Si($Z_{69a}$)($Z_{69b}$), or Si($Z_{89a}$)($Z_{89b}$),

$W_2$, $W_4$, $W_6$, $W_8$, $Z_2$, $Z_4$, $Z_6$, $Z_8$, e2, e4, e6, and e8 are as described in the present specification, $Z_{29a}$ and $Z_{29b}$ are described in connection with $Z_2$, $Z_{49a}$ and $Z_{49b}$ are as described in connection with $Z_4$, $Z_{69a}$ and $Z_{69b}$ are as described in connection with $Z_6$, and $Z_{89a}$ and $Z_{89b}$ are as described in connection with $Z_8$,

$Y_{21}$ to $Y_{24}$ may each independently be N or C,

ring $A_{40}$ may be a $C_5$-$C_{30}$ carbocyclic group or a $C_1$-$C_{30}$ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),

* indicates a binding site to Ir in Formulae 1 and 2, and

*" indicates a binding site to ring $A_1$, ring $A_3$, ring As, and ring $A_7$;

Condition G130

λP(Ir1) and AP(Ir2) are each in a range of about 500 nm to about 570 nm;

Condition G131

Expression 1 is satisfied, and

i) λP(Ir1) is in a range of about 520 nm to about 540 nm, and λP(Ir2) is in a range of about 500 nm to about 530 nm,

or

ii) λP(Ir1) is in a range of about 550 nm to about 570 nm, and λP(Ir2) is in a range of about 540 nm to about 560 nm;

In an embodiment, in the composition, $L_{11}$ of Formula 1 may be a ligand represented by Formula 1-1, $L_{12}$ of Formula 1 may be a ligand represented by Formula 1-3, $L_{21}$ of Formula 2 may be a ligand represented by Formula 2-1, $L_{22}$ of Formula 2 may be a ligand represented by Formula 2-3, n13 of Formula 1 may be 0, n23 of Formula 2 may be 0, and the composition may satisfy at least one of Conditions R101 to R123:

Condition R101
A $Y_1$-containing monocyclic group in ring $A_1$ and a $Y_2$-containing monocyclic group in ring $A_2$ of Formula 1-1 are each a 6-membered ring;

Condition R102
A Ys-containing monocyclic group in ring As and a $Y_6$-containing monocyclic group in ring $A_6$ of Formula 2-1 are each a 6-membered ring;

Condition R103
Ring $A_1$ of Formula 1-1 is a polycyclic group having 4 to 60 carbon atoms in which three or more rings are condensed;

Condition R104
Ring As of Formula 2-1 is a polycyclic group having 4 to 60 carbon atoms in which two or more rings are condensed;

Condition R105
Ring $A_1$ of Formula 1-1 and ring As of Formula 2-1 are each a polycyclic group having 4 to 6 carbon atoms in which two or more rings are condensed, and the number of rings condensed in ring $A_1$ is greater than the number of rings condensed in ring As;

Condition R106

Ring $A_1$ and ring $A_5$ in Formulae 1-1 and 2-1 are each independently: i) a polycyclic group having 4 to 60 carbon atoms in which at least one A group and at least one benzene group are condensed with each other; ii) a polycyclic group having 4 to 60 carbon atoms in which at least one A group and at least one G group are condensed with each other; or iii) a polycyclic group having 4 to 60 carbon atoms in which at least one A group, at least one benzene group, and at least one G group are condensed with each other,
the A group is a pyridine group, a pyrimidine group, a pyridazine group, a pyrazine group, or a triazine group, and the G group is a cyclohexane group, a cyclohexene group, norbornane group, a furan group, a thiophene group, a selenophene group, a pyrrole group, a cyclopentadiene group, or a silole group;

Condition R107
Ring $A_1$ and ring $A_5$ in Formulae 1-1 and 2-1 are each independently:

a quinoline group, an isoquinoline group, a quinoxaline group, a quinazoline group, a benzoquinoline group, a benzoisoquinoline group, a benzoquinoxaline group, a benzoquinazoline group, a phenanthroline group, or a phenanthridine group; or
a quinoline group, an isoquinoline group, a quinoxaline group, a quinazoline group, a benzoquinoline group, a benzoisoquinoline group, a benzoquinoxaline group, a benzoquinazoline group, a phenanthroline group, or a phenanthridine group, each condensed with a cyclohexane group, a norbornane group, a benzene group, a pyridine group, a pyrimidine group, or a combination thereof;

Condition R108
Ring $A_2$ and ring $A_6$ in Formulae 1-1 and 2-1 are each independently i) an E group, ii) a polycyclic group having 4 to 60 carbon atoms in which two or more E groups are condensed with each other, or iii) a polycyclic group having 4 to 60 carbon atoms in which at least one E group and at least one F group are condensed with each other, wherein the E group and the F group are as described in the present specification;

Condition R109
Ring $A_2$ and ring $A_6$ in Formulae 1-1 and 2-1 are each independently:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or a combination thereof;

Condition R110
In Formula 1-1, e1 and d1 are each not 0, and at least one of $Z_1$(s) are each independently deuterium, -F, a $C_1$-$C_{20}$ alkyl group, a $C_3$-$C_{10}$ cycloalkyl group, a phenyl group, a biphenyl group, a deuterated $C_1$-$C_{20}$ alkyl group, a deuterated $C_3$-$C_{10}$ cycloalkyl group, a deuterated phenyl group, a deuterated biphenyl group, a fluorinated $C_1$-$C_{20}$ alkyl group, a fluorinated $C_3$-$C_{10}$ cycloalkyl group, a fluorinated phenyl group, a fluorinated biphenyl group, -Si($Q_3$)($Q_4$)($Q_5$), or -Ge($Q_3$)($Q_4$)($Q_5$) (wherein $Q_3$ to $Q_5$ are as described in the present specification);

Condition R111
In Formula 2-1, e5 and d5 are each not 0, and at least one of $Z_5$(s) are each independently deuterium, -F, a $C_1$-$C_{20}$ alkyl group, a $C_3$-$C_{10}$ cycloalkyl group, a phenyl group, a biphenyl group, a deuterated $C_1$-$C_{20}$ alkyl group, a deuterated $C_3$-$C_{10}$ cycloalkyl group, a deuterated phenyl group, a deuterated biphenyl group, a fluorinated $C_1$-$C_{20}$ alkyl group, a fluorinated $C_3$-$C_{10}$ cycloalkyl group, a fluorinated phenyl group, a fluorinated biphenyl group, -Si($Q_3$)($Q_4$)($Q_5$), or -Ge($Q_3$)($Q_4$)($Q_5$) (wherein $Q_3$ to $Q_5$ are as described in the present specification);

Condition R112
A group represented by

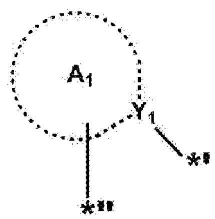

in Formula 1-1 and a group represented by

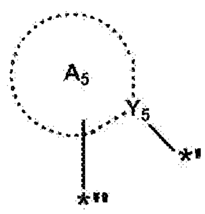

in Formula 2-1 are each independently a group represented by one of Formulae NR(1) to NR(16):

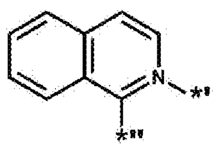
NR(1)

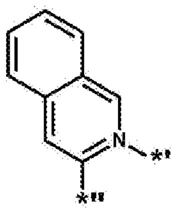
NR(2)

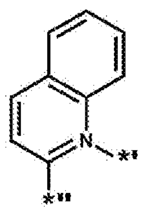
NR(3)

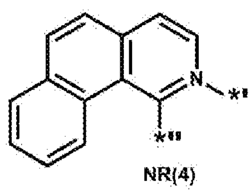
NR(4)

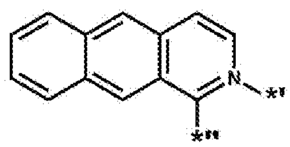
NR(5)

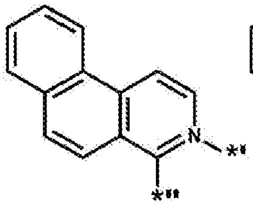
NR(6)

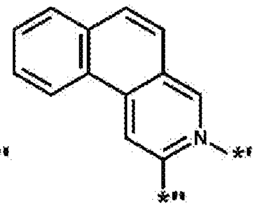
NR(7)

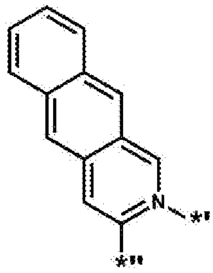
NR(8)

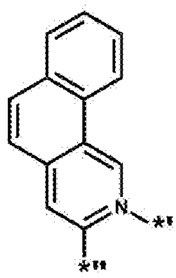
NR(9)

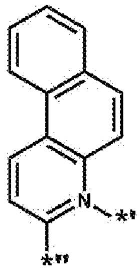
NR(10)

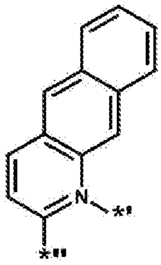
NR(11)

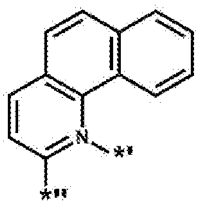
NR(12)

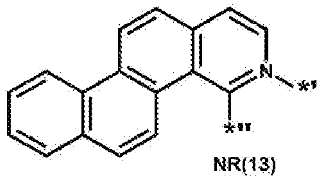
NR(13)

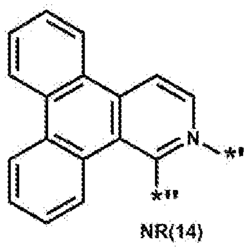
NR(14)

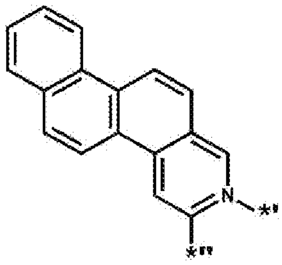
NR(15)

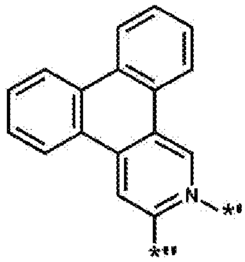
NR(16)

wherein, in Formulae NR(1) to NR(16),

*' indicates a binding site to Ir in Formulae 1 and 2, and
*" indicates a binding site to ring $A_2$ or ring $A_6$.

Condition R113
A group represented by

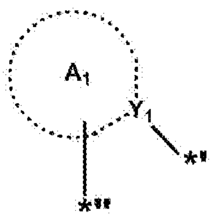

in Formula 1-1 is a group represented by one of Formulae NR(4) to NR(16);

Condition R114
A group represented by

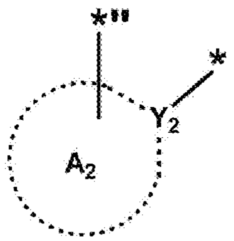

in Formula 1-1 and a group represented by

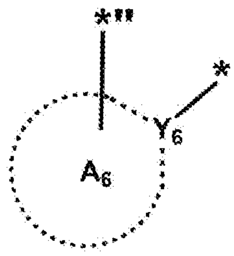

in Formula 2-1 are each independently a group represented by one of Formulae CR1 to CR29;

Condition R115
A group represented by

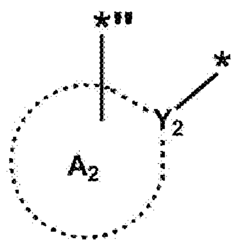

in Formula 1-1 and a group represented by

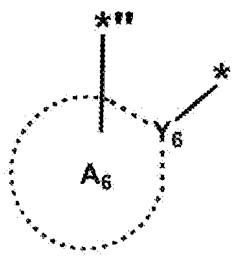

in Formula 2-1 are each independently a group represented by one of Formulae CR1 to CR11;

Condition R116

$R_1$ in Formula 1-3 is a group represented by *-C($R_{11}$)($R_{12}$)($R_{13}$), and
$R_{11}$ to $R_{13}$ are each independently a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R117

$R_1$ in Formula 1-3 is a group represented by *-C($R_{11}$)($R_{12}$)($R_{13}$), and
At least one of $R_{11}$ to $R_{13}$ are each independently a $C_2$-$C_{20}$ alkyl group, a deuterated $C_2$-$C_{20}$ alkyl group, a fluorinated $C_2$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R118
$R_1$ in Formula 1-3 is a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R119

$R_2$ in Formula 1-3 is a group represented by *-C($R_{21}$)($R_{22}$)($R_{23}$), and
$R_{21}$ to $R_{23}$ are each independently a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R120

$R_2$ in Formula 1-3 is a group represented by *-C($R_{21}$)($R_{22}$)($R_{23}$), and
at least one of $R_{21}$ to $R_{23}$ are each independently a $C_2$-$C_{20}$ alkyl group, a deuterated $C_2$-$C_{20}$ alkyl group, a fluorinated $C_2$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R121
$R_2$ in Formula 1-3 is a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group;

Condition R122
$\lambda$P(Ir1) and $\lambda$P(Ir2) are each in a range of about 570 nm to about 650 nm;

Condition R123
Expression 1 is satisfied, $\lambda$P(Ir1) is in a range of about 620 nm to about 650 nm, and AP(Ir2) is in a range of about 570 nm to about 630 nm.

In an embodiment, $Q_3$ to $Q_5$ in Conditions G124, G125, R110, and R111 may each independently be:

a $C_1$-$C_{60}$ alkyl group unsubstituted or substituted with at least one deuterium, a $C_1$-$C_{60}$ alkyl group, a $C_6$-$C_{60}$ aryl group, or a combination thereof; or
a $C_6$-$C_{60}$ aryl group unsubstituted or substituted with at least one of deuterium, a $C_1$-$C_{60}$ alkyl group, a $C_6$-$C_{60}$ aryl group, or a combination thereof.

In one or more embodiments, $Q_3$ to $Q_5$ in Conditions G124, G125, R110, and R111 may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least

one of deuterium, a $C_1$-$C_{10}$ alkyl group, a phenyl group, or a combination thereof.

In one or more embodiments, $Q_3$ to $Q_5$ in Conditions G124, G125, R110, and R111 may be identical to each other.

In one or more embodiments, two or more of $Q_3$ to $Q_5$ in Conditions G124, G125, R110, and R111 may be different from each other.

In one or more embodiments, a group represented by

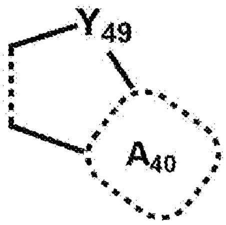

in Formulae CR24 to CR29 of Condition G129 may be a group represented by one of Formulae CR(1) to CR(13):

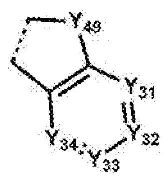

CR(1)

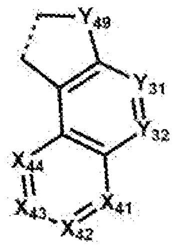

CY(2)

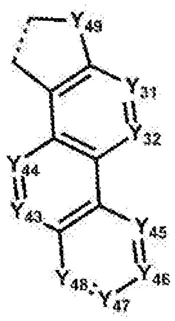

CR(3)

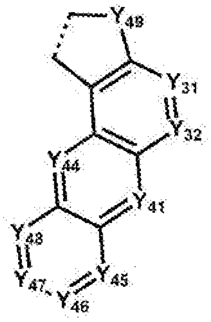

CR(4)

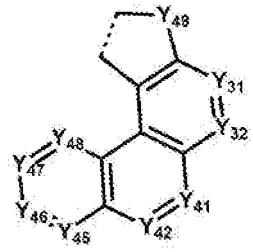

CR(5)

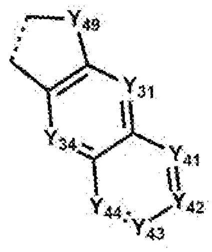

CR(6)

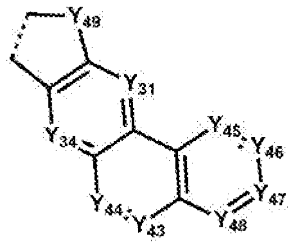

CR(7)

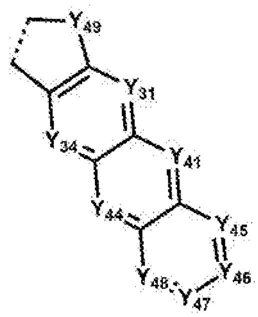

CR(8)

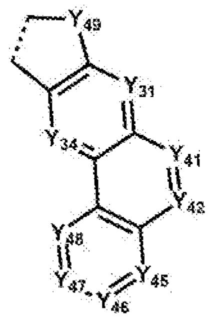

CR(9)

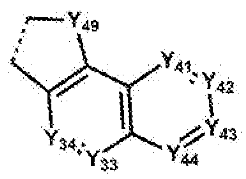

CR(10)

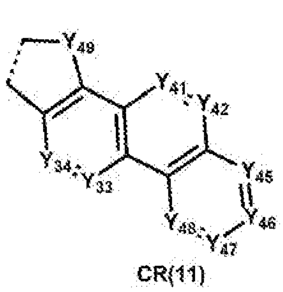

CR(11)

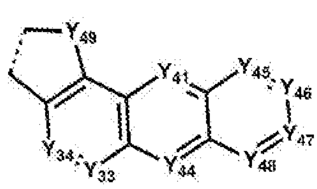

CR(12)

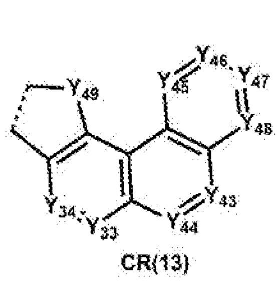

CR(13)

wherein, in Formulae CR(1) to CR(13),

$Y_{49}$ is as described in the present specification, and

$Y_{31}$ to $Y_{34}$ and $Y_{41}$ to $Y_{48}$ may each independently be C or N.

In the expressions "the composition may satisfy at least one of Conditions G101 to G131" and "the composition may satisfy at least one of Conditions R101 to R123" as used herein, a case in which two or more incompatible conditions are simultaneously satisfied is excluded, which may be easily understood by one of ordinary skill in the art. For example, since Conditions G103 and G104 correspond to incompatible conditions, a case in which Conditions G103 and G104 are simultaneously satisfied is excluded from the expression "the composition may satisfy at least one of Conditions G101 to G131" as used herein.

In one or more embodiments, the first compound may include at least one deuterium.

In one or more embodiments, the second compound may include at least one deuterium.

In one or more embodiments, a weight ratio of the first compound to the second compound in the composition may be in a range of about 90:10 to about 10:90, about 80:20 to about 20:80, about 70:30 to about 30:70, or about 60:40 to about 40:60.

In one or more embodiments, the weight ratio of the first compound to the second compound in the composition may be about 50:50, that is, 1:1.

In one or more embodiments, the first compound and the second compound may each independently be one of compounds of Groups G1-1 to G1-8:

## Group G1-1

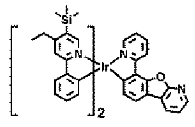
1

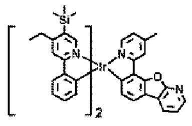
2

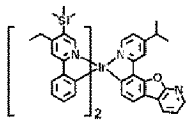
3

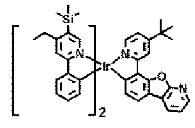
4

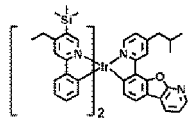
5

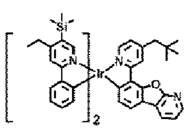
6

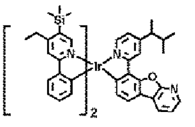
7

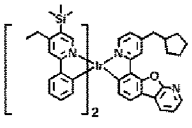
8

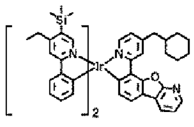
9

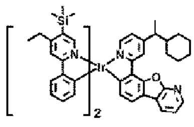
10

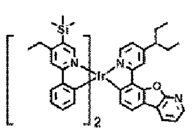
11

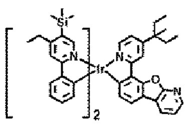
12

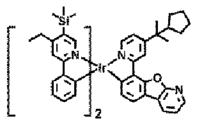
13

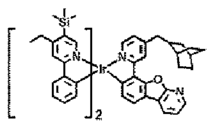
14

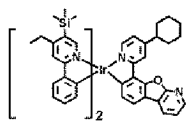
15

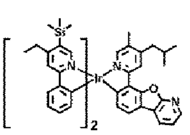
16

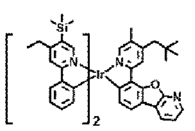
17

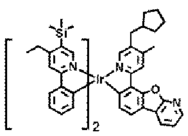
18

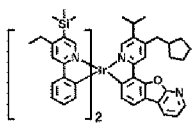
19

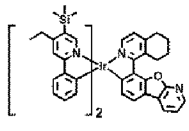
20

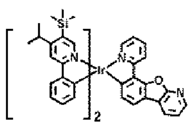
21

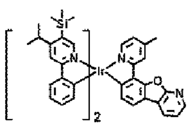
22

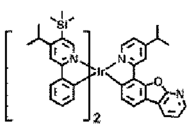
23

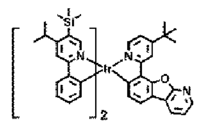
24

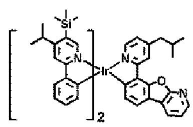
25

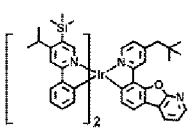
26

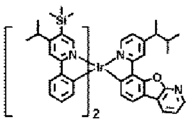
27

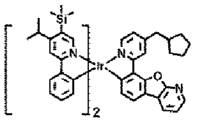
28

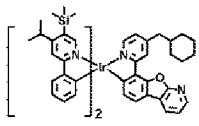
29

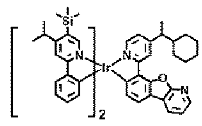
30

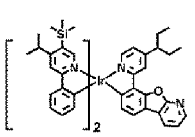
31

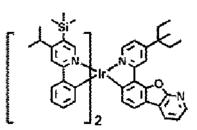
32

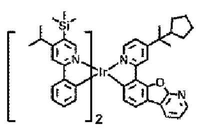
33

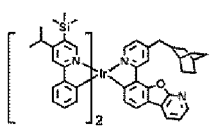
34

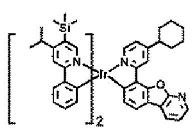
35

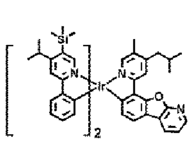
36

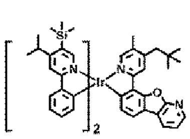
37

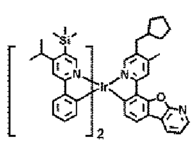
38

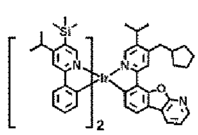
39

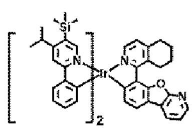
40

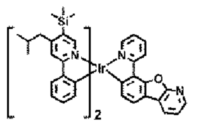
41

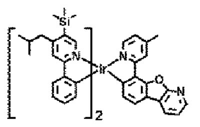
42

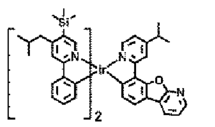
43

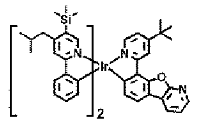
44

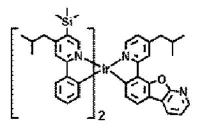
45

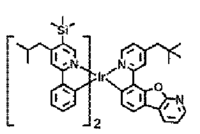
46

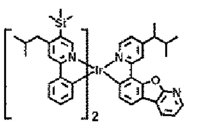
47

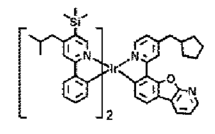
48

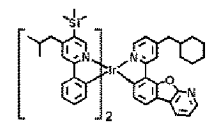
49

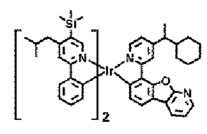
50

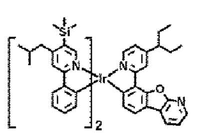
51

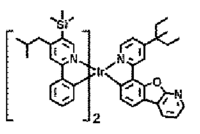
52

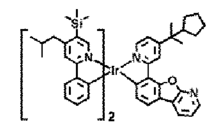
53

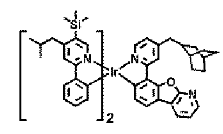
54

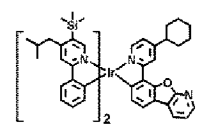
55

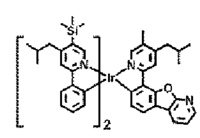
56

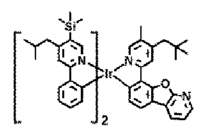
57

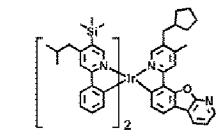
58

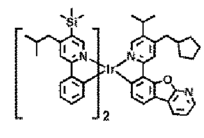
59

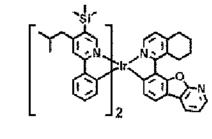
60

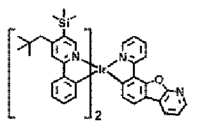
61

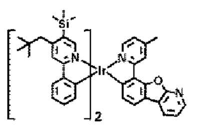
62

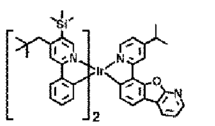
63

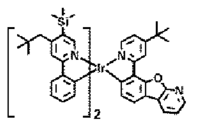
64

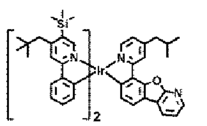
65

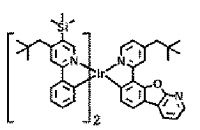
66

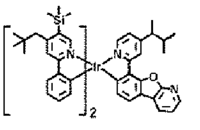
67

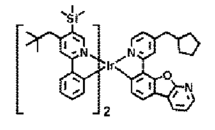
68

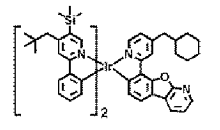
69

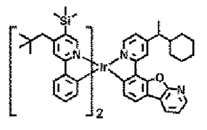
70

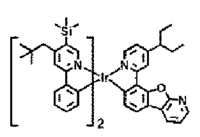
71

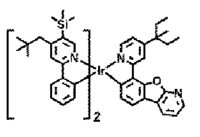
72

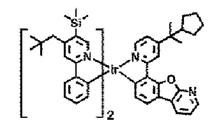
73

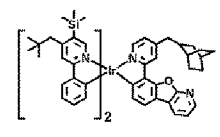
74

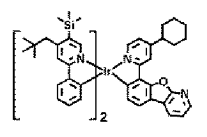
75

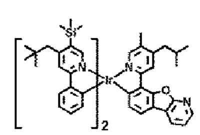
76

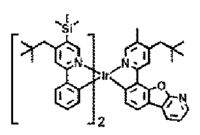
77

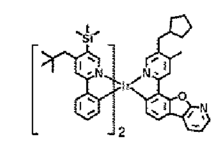
78

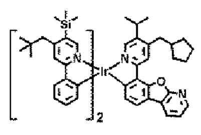
79

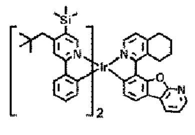
80

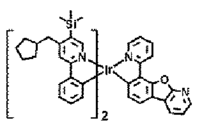
81

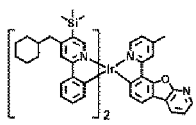
82

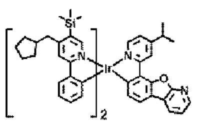
83

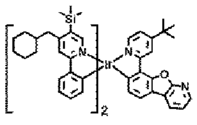
84

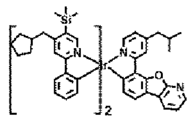
85

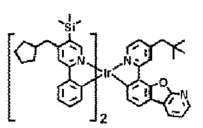
86

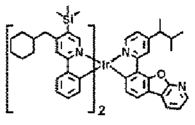
87

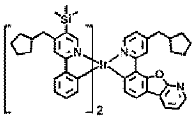
88

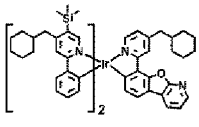
89

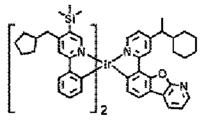
90

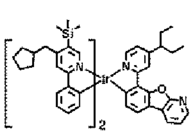
91

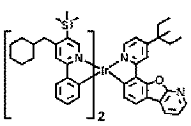
92

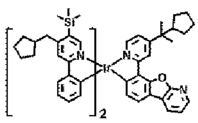
93

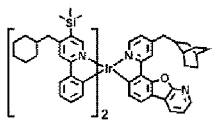
94

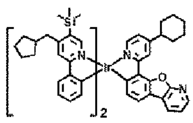
95

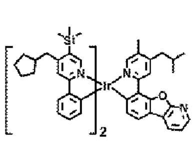
96

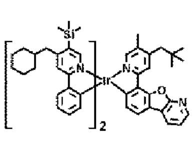
97

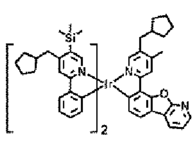
98

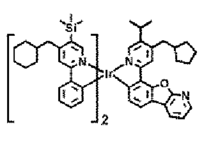
99

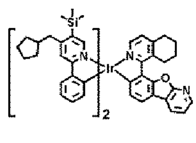
100

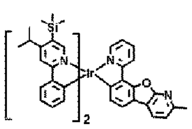
101

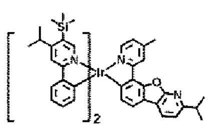
102

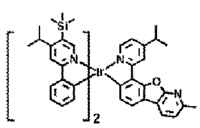
103

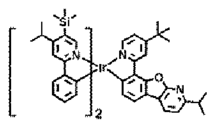
104

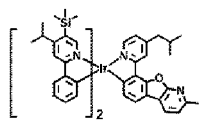
105

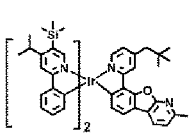
106

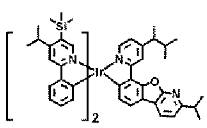
107

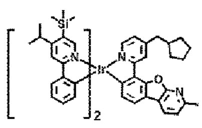
108

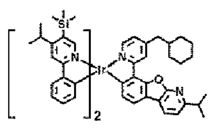
109

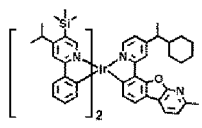
110

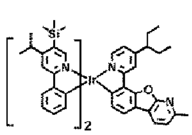
111

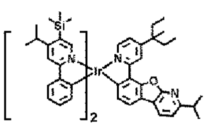
112

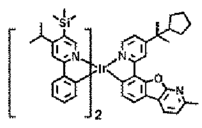
113

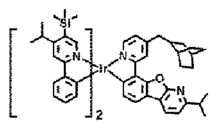
114

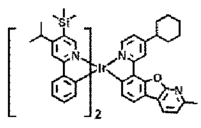
115

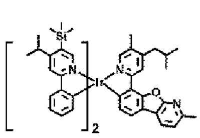
116

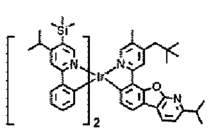
117

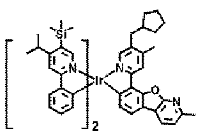
118

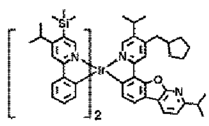
119

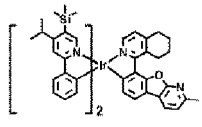
120

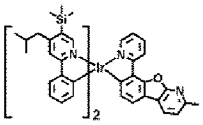
121

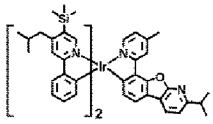
122

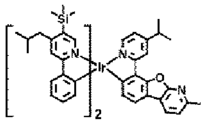
123

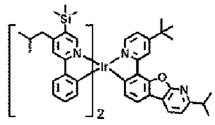
124

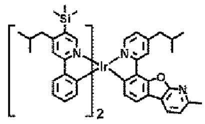
125

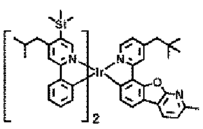
126

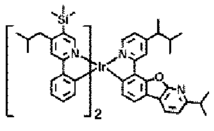
127

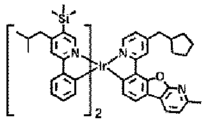
128

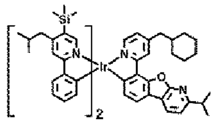
129

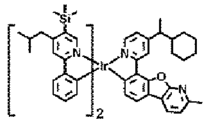
130

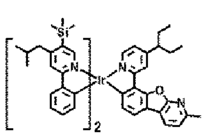
131

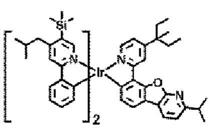
132

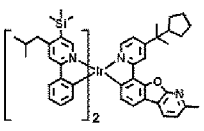
133

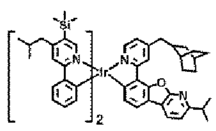
134

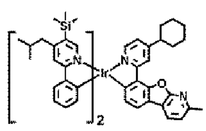
135

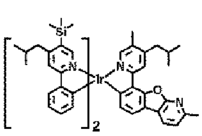
136

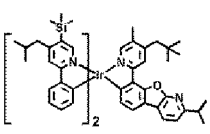
137

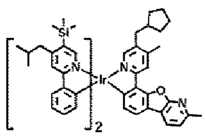
138

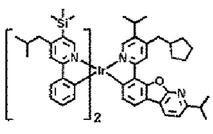
139

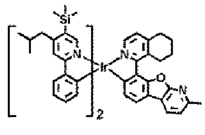
140

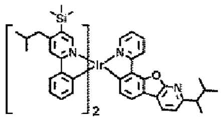
141

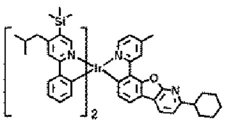
142

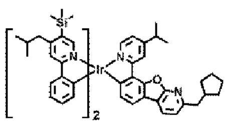
143

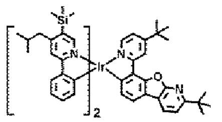
144

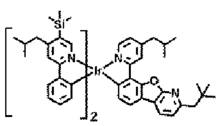
145

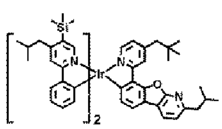
146

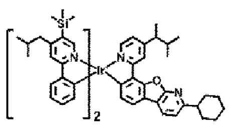
147

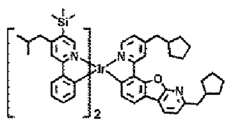
148

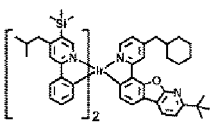
149

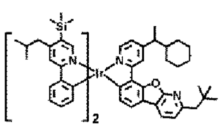
150

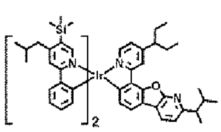
151

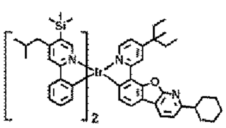
152

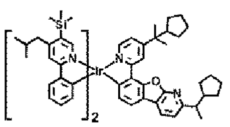
153

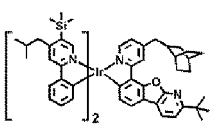
154

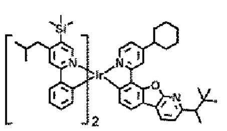
155

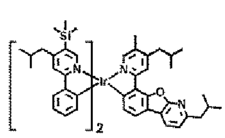
156

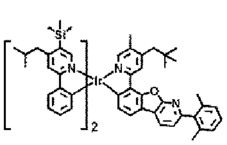
157

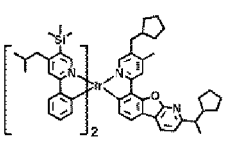
158

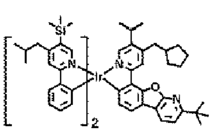
159

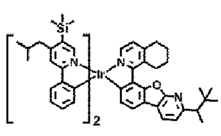
160

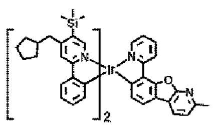
161
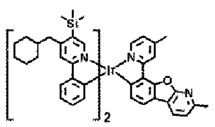
162
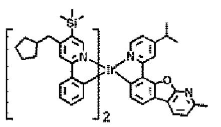
163
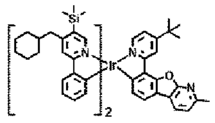
164
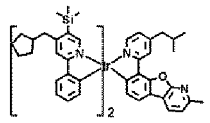
165

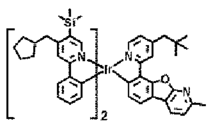
166
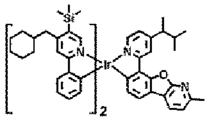
167
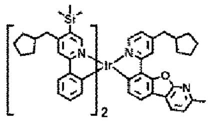
168
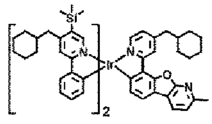
169
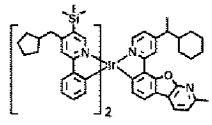
170

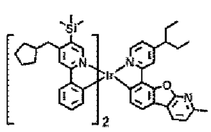
171
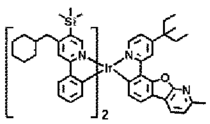
172
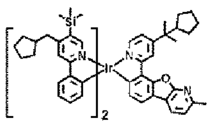
173
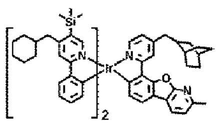
174
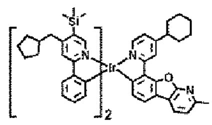
175

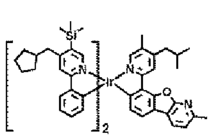
176
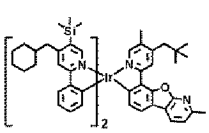
177
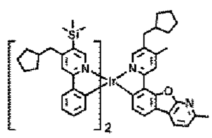
178
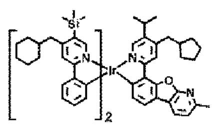
179
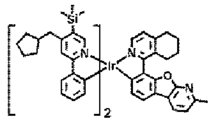
180

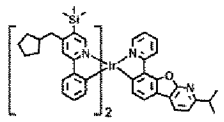
181
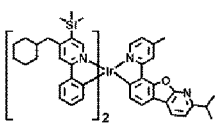
182
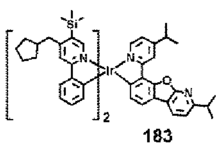
183
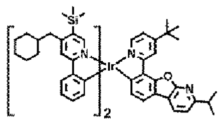
184
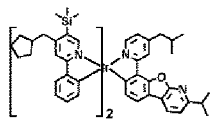
185

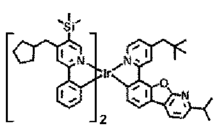
186
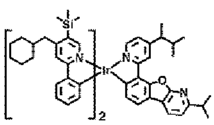
187
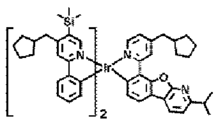
188
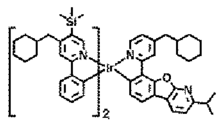
189
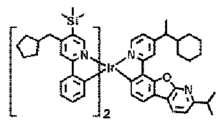
190

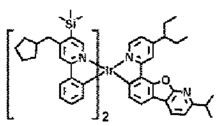
191
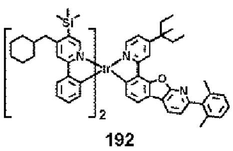
192
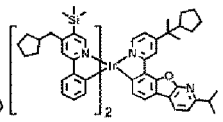
193
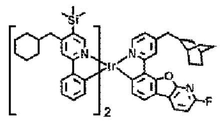
194
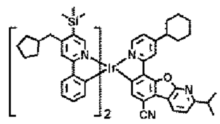
195

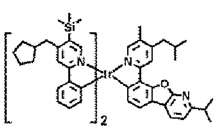
196
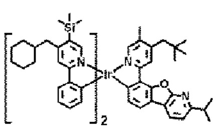
197
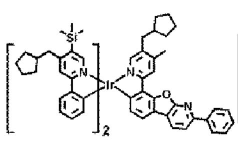
198
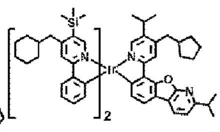
199
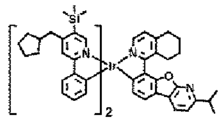
200

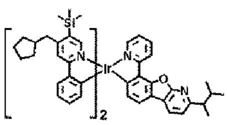
201
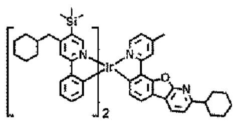
202
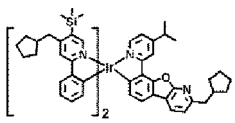
203
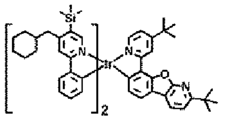
204
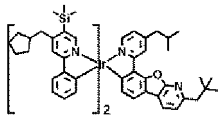
205

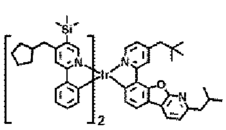
206
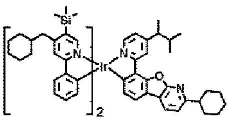
207
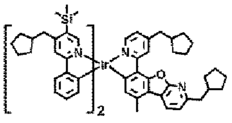
208
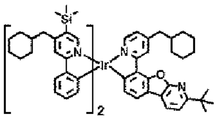
209
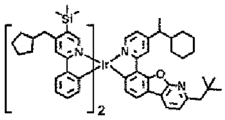
210

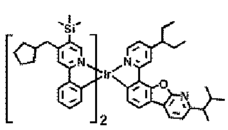
211
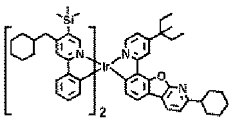
212
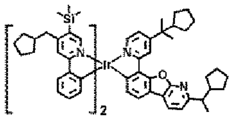
213
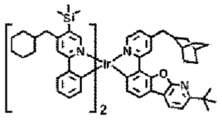
214
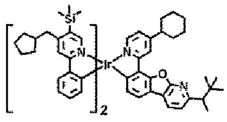
215

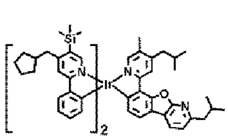
216
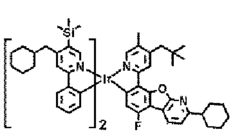
217
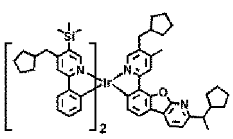
218
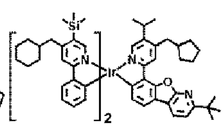
219
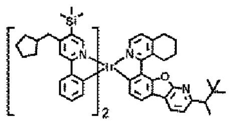
220

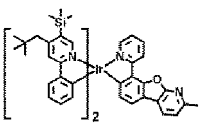
221
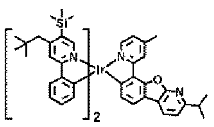
222
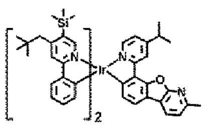
223
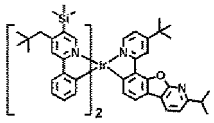
224
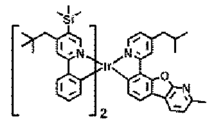
225

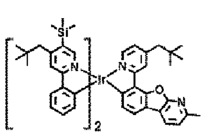
226
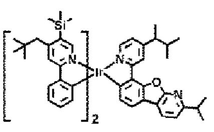
227
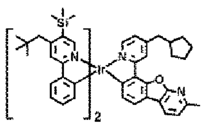
228
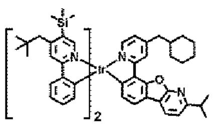
229
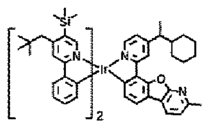
230

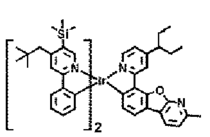
231
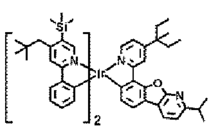
232
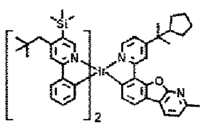
233
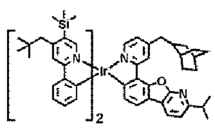
234
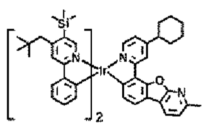
235

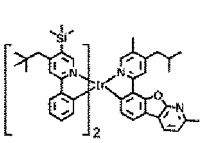
236
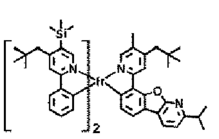
237
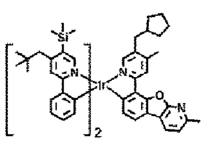
238
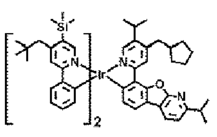
239
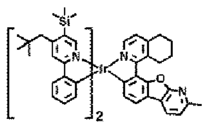
240

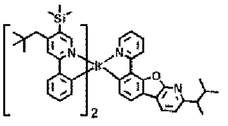
241
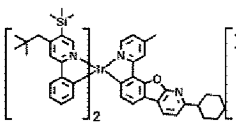
242
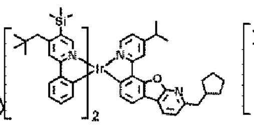
243
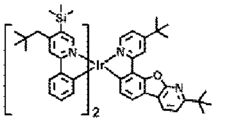
244
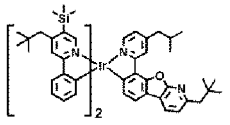
245

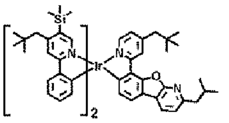
246
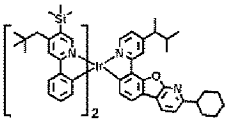
247
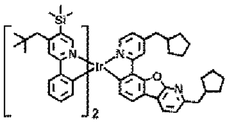
248
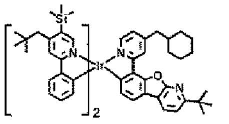
249
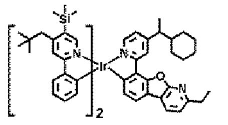
250

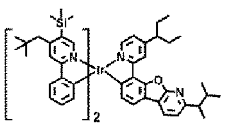
251
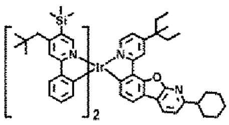
252
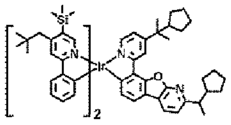
253
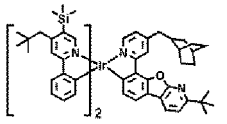
254
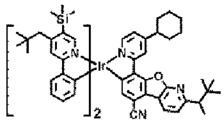
255

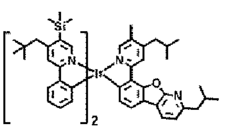
256
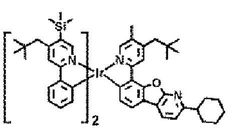
257
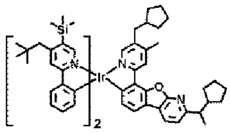
258
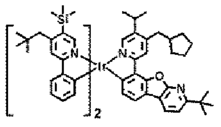
259
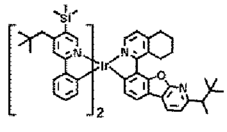
260

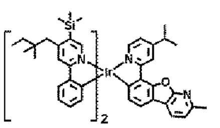
261
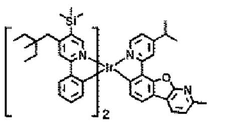
262
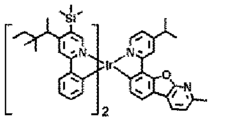
263
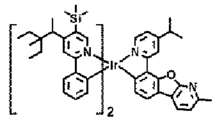
264
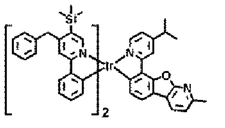
265

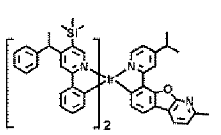
266
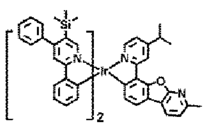
267
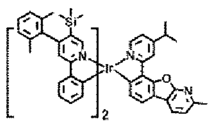
268
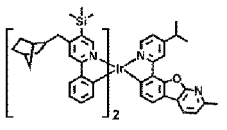
269
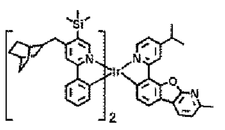
270

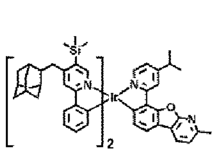
271
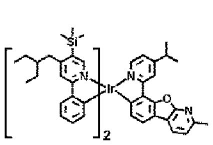
272
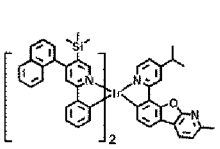
273
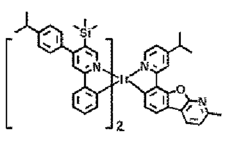
274
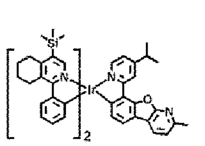
275

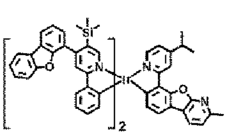
276
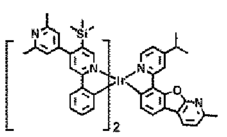
277
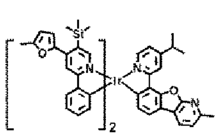
278
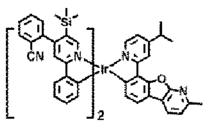
279
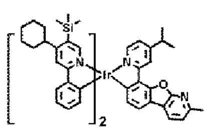
280

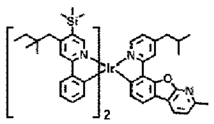
281
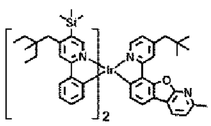
282
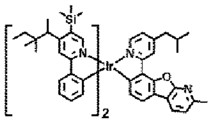
283
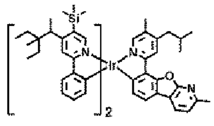
284
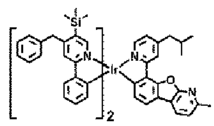
285

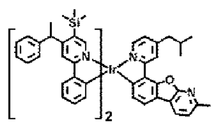
286
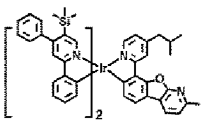
287
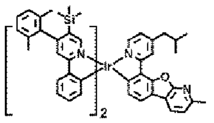
288
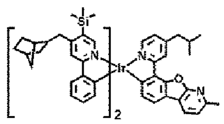
289
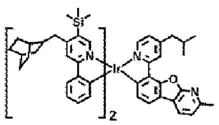
290

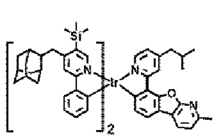
291
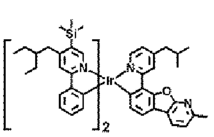
292
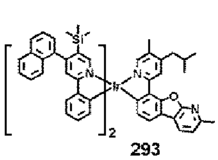
293
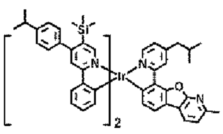
294
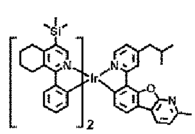
295

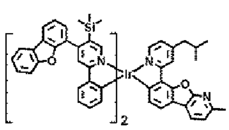
296
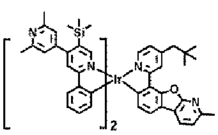
297
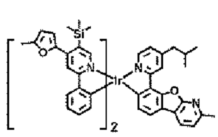
298
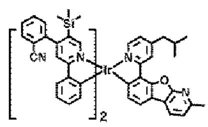
299
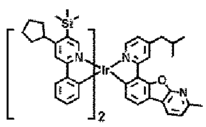
300

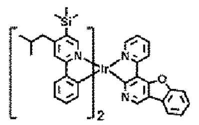
301
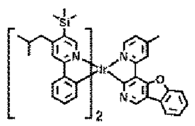
302
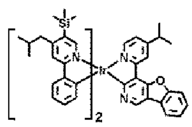
303
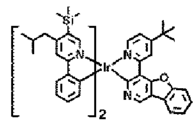
304
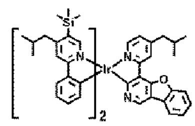
305

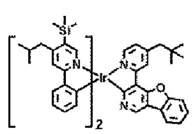
306
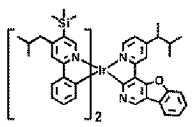
307
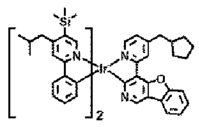
308
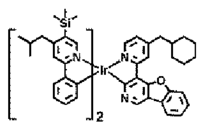
309
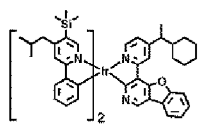
310

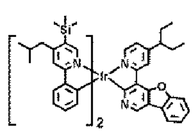
311
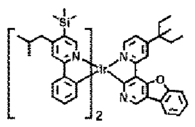
312
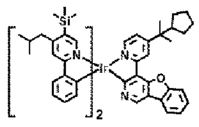
313
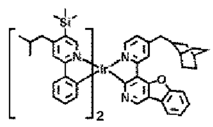
314
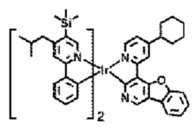
315

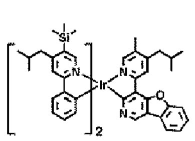
316
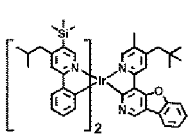
317
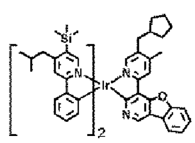
318
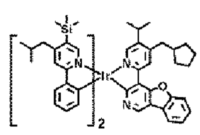
319
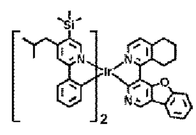
320

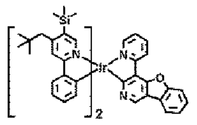
321
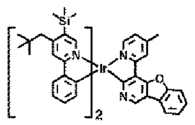
322
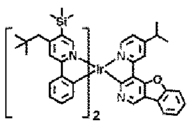
323
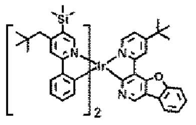
324
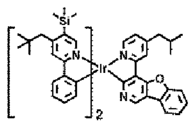
325
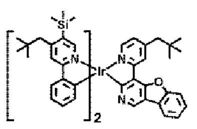
326
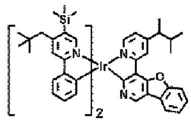
327
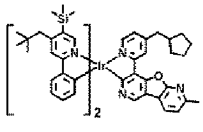
328
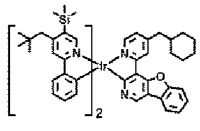
329
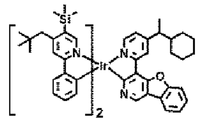
330
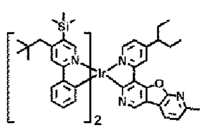
331
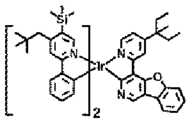
332
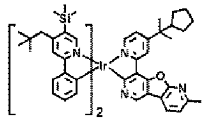
333
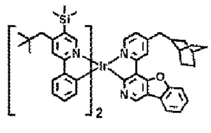
334
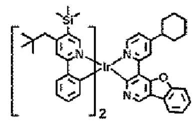
335
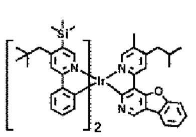
336
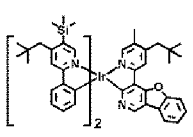
337
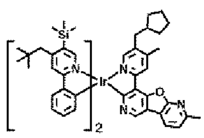
338
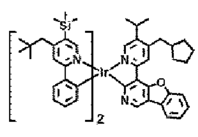
339
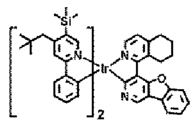
340
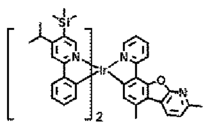
341
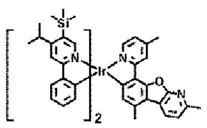
342
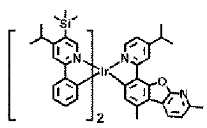
343
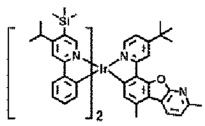
344
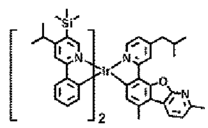
345
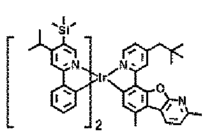
346
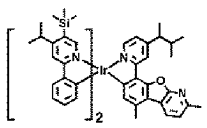
347
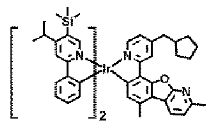
348
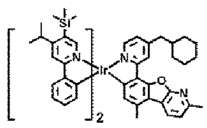
349
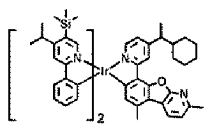
350
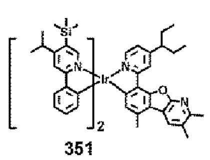
351
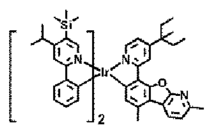
352
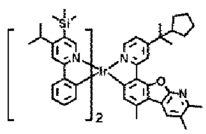
353
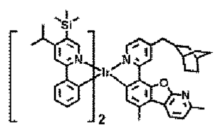
354
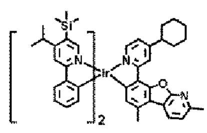
355
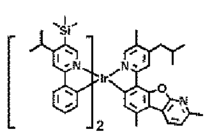
356
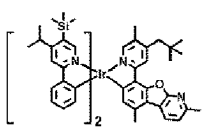
357
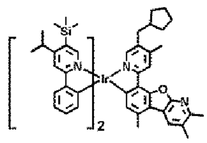
358
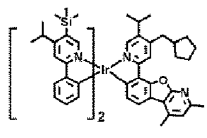
359
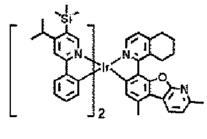
360

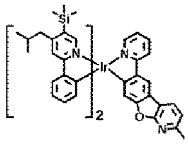
361

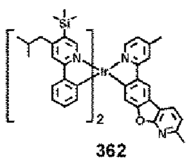
362

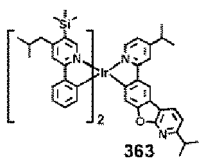
363

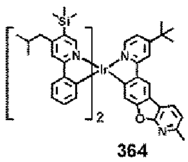
364

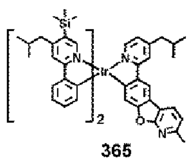
365

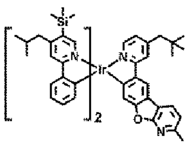
366

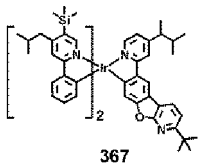
367

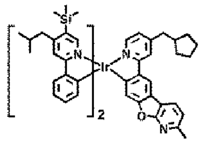
368

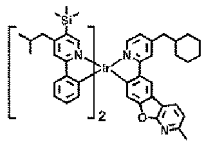
369

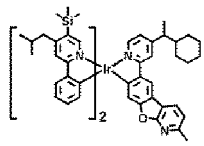
370

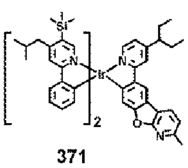
371

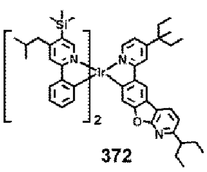
372

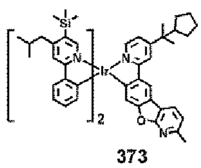
373

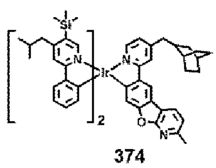
374

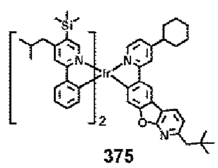
375

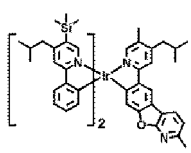
376

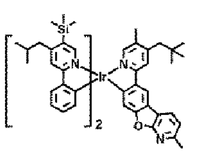
377

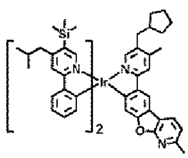
378

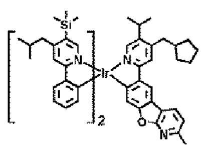
379

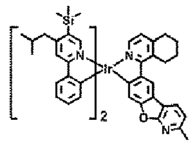
380

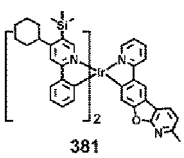
381

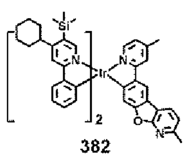
382

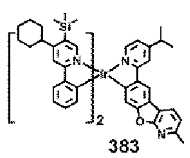
383

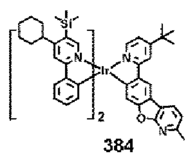
384

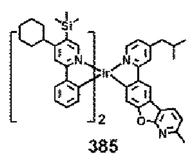
385

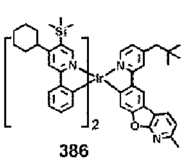
386

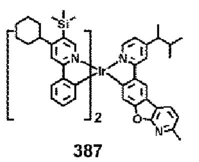
387

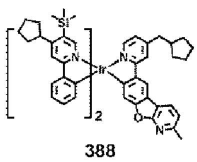
388

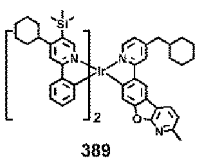
389

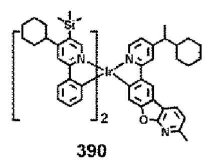
390

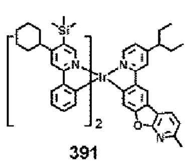
391

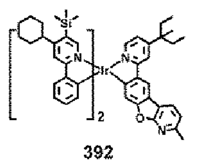
392

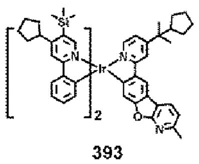
393

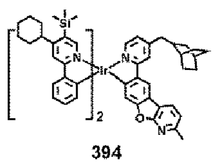
394

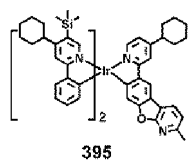
395

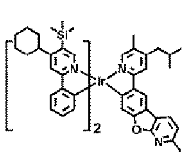
396

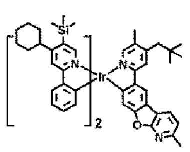
397

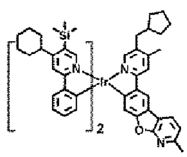
398

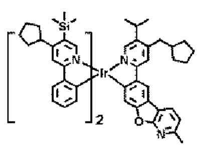
399

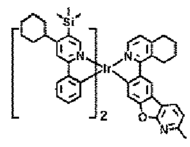
400

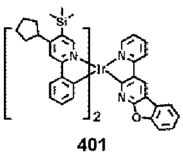
401
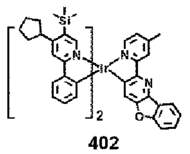
402
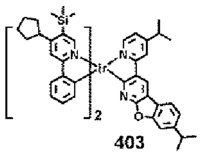
403
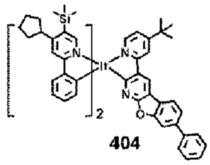
404
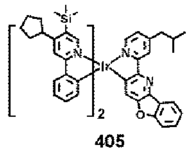
405
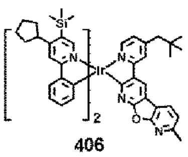
406
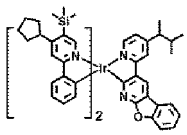
407
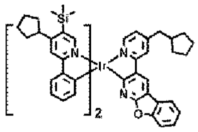
408
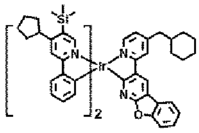
409
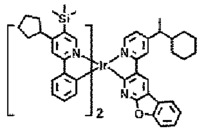
410
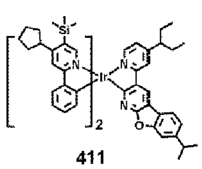
411
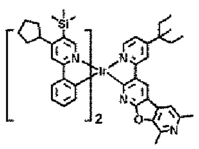
412
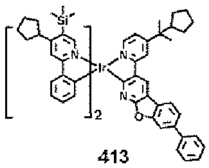
413
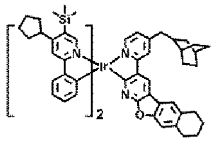
414
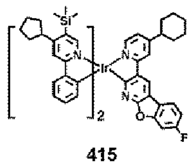
415
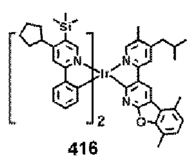
416
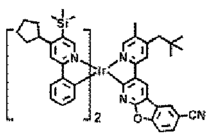
417
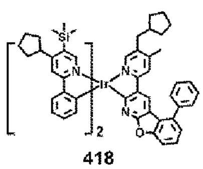
418
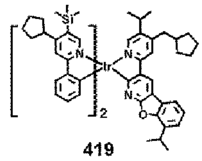
419
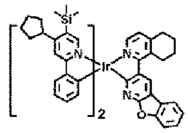
420
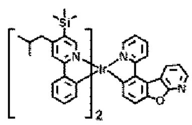
421
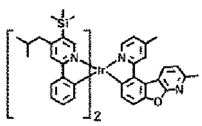
422
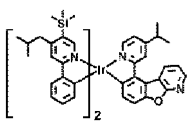
423
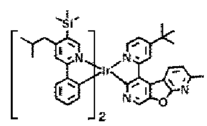
424
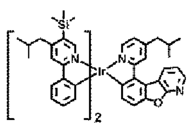
425
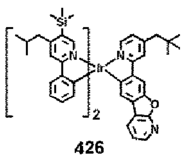
426
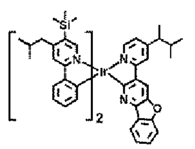
427
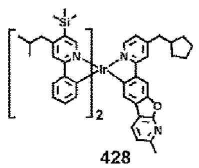
428
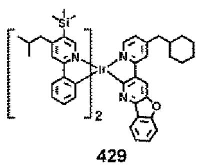
429
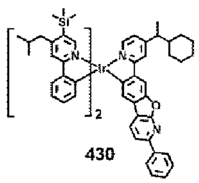
430
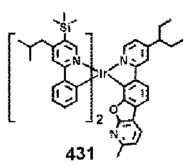
431
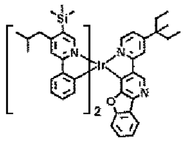
432
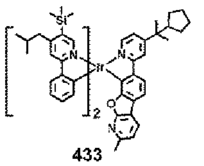
433
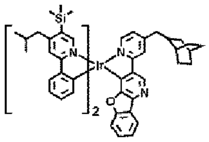
434
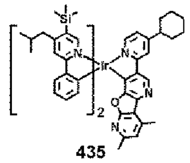
435
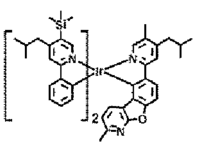
436
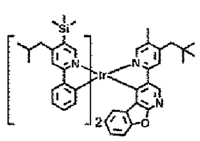
437
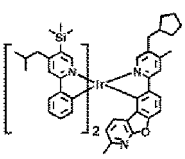
438
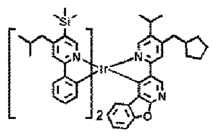
439
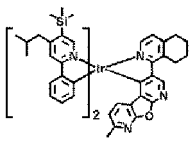
440

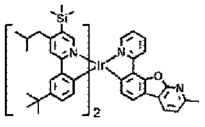
441
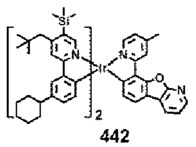
442
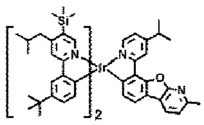
443
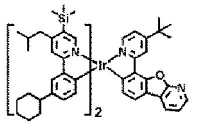
444
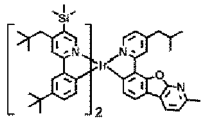
445

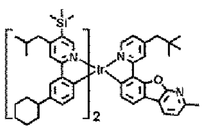
446
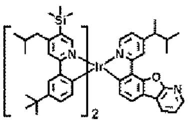
447
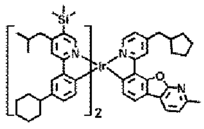
448
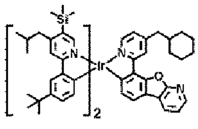
449
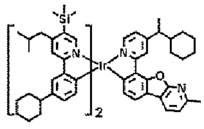
450

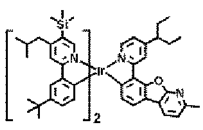
451
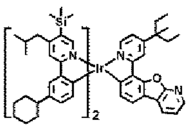
452
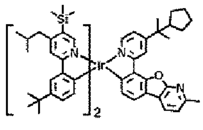
453
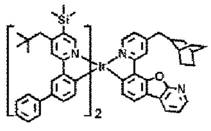
454
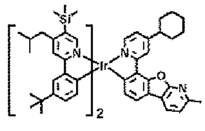
455

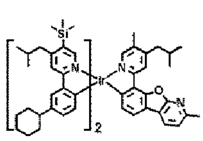
456
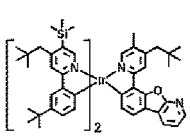
457
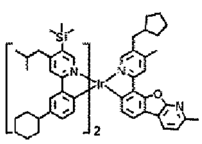
458
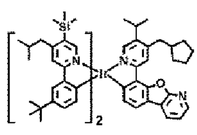
459
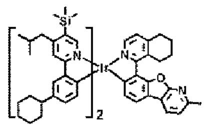
460

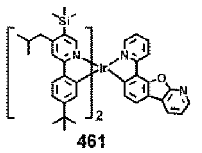
461
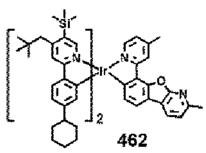
462
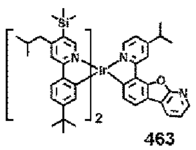
463
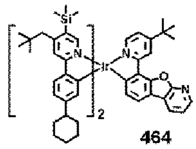
464
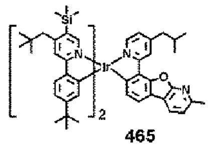
465

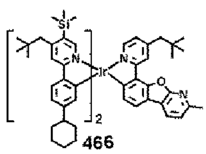
466
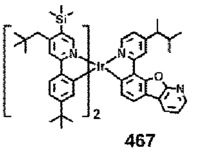
467
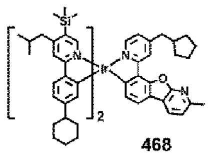
468
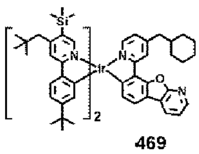
469
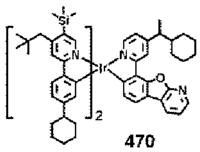
470

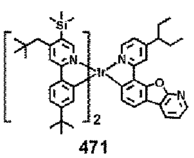
471
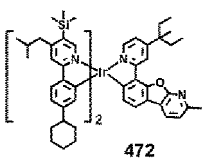
472
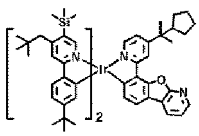
473
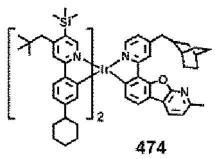
474
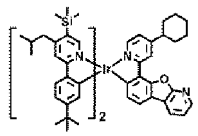
475

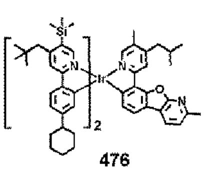
476
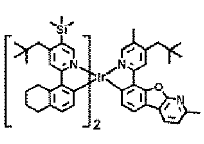
477
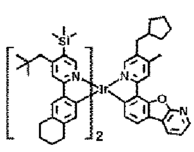
478
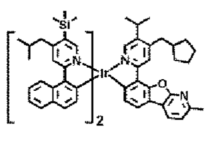
479
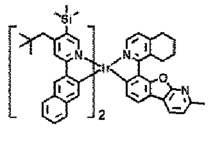
480

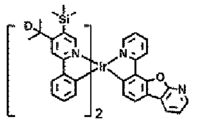
481
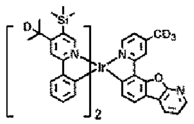
482
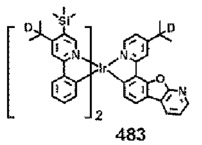
483
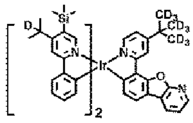
484
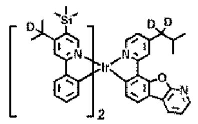
485
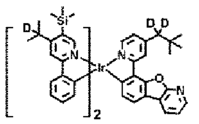
486
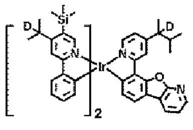
487
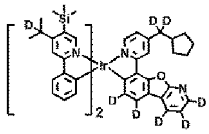
488
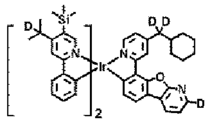
489
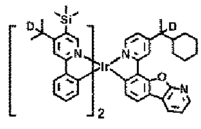
490
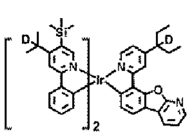
491
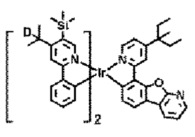
492
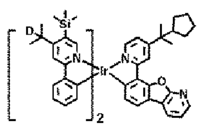
493
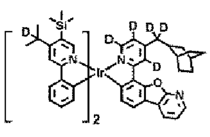
494
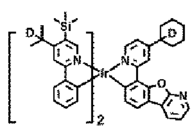
495
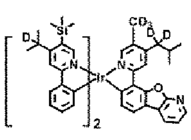
496
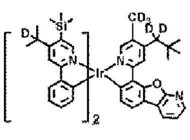
497
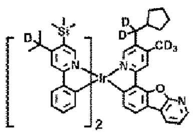
498
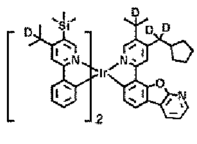
499
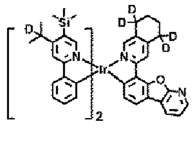
500
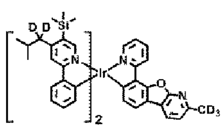
501
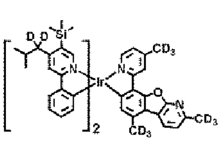
502
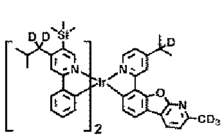
503
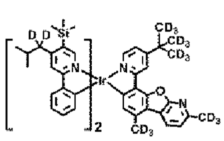
504
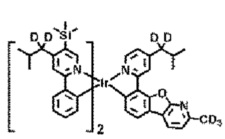
505
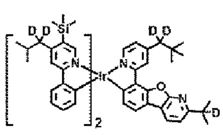
506
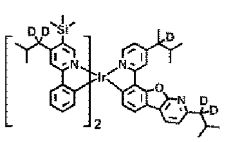
507
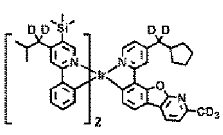
508
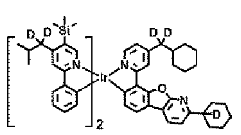
509
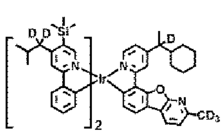
510
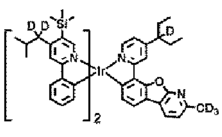
511
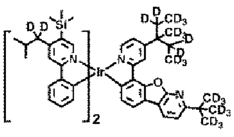
512
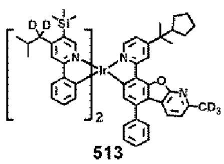
513
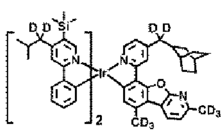
514
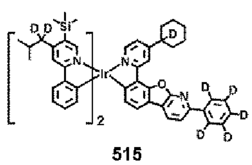
515
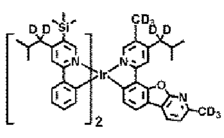
516
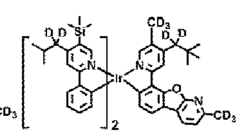
517
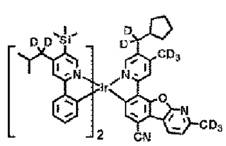
518
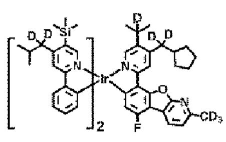
519
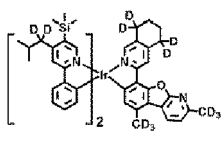
520

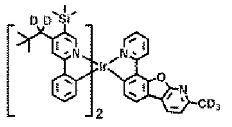
521
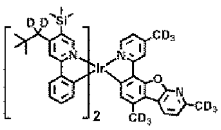
522
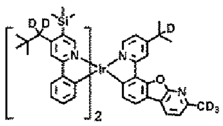
523
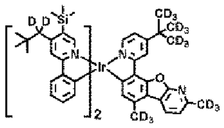
524
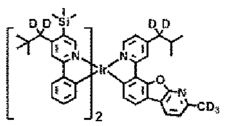
525

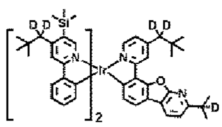
526
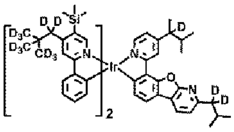
527
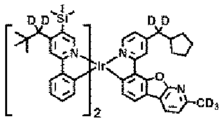
528
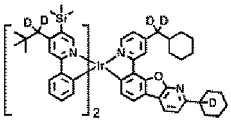
529
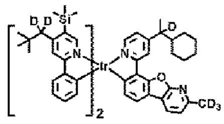
530

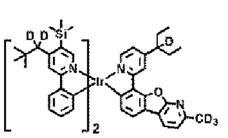
531
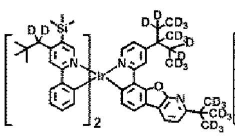
532
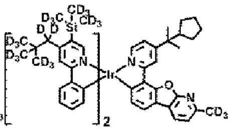
533
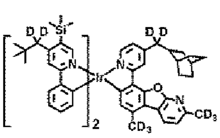
534
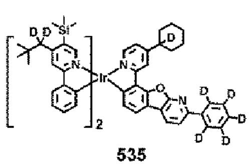
535

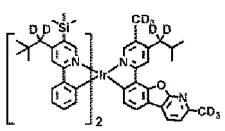
536
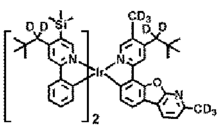
537
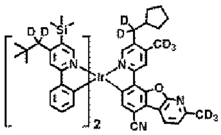
538
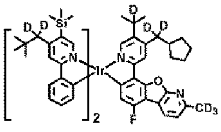
539
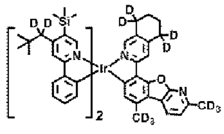
540

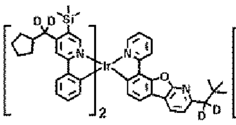
541
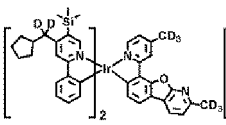
542
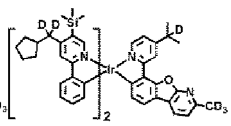
543
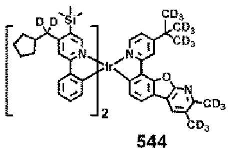
544
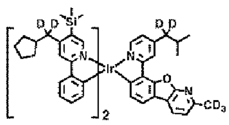
545

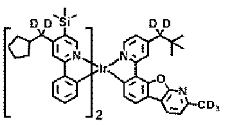
546
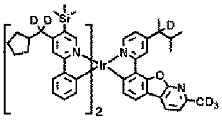
547
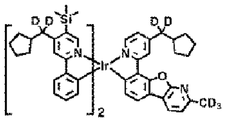
548
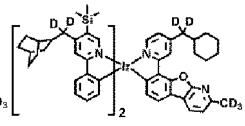
549
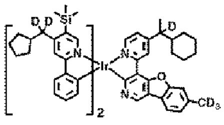
550

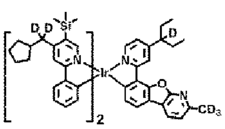
551
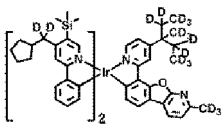
552
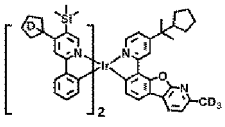
553
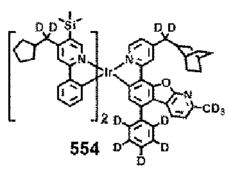
554
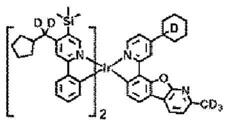
555

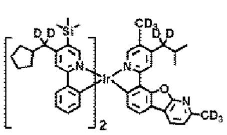
556
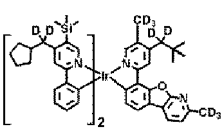
557
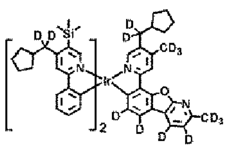
558
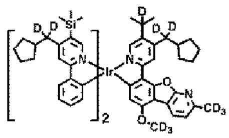
559
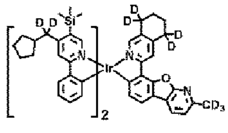
560

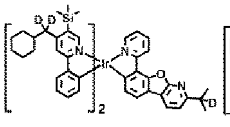
561
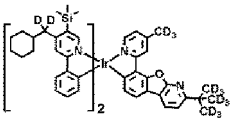
562
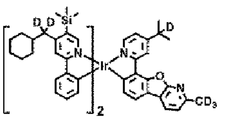
563
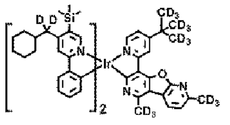
564
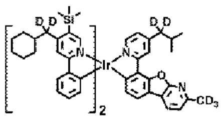
565

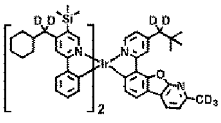
566
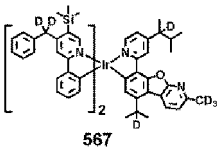
567
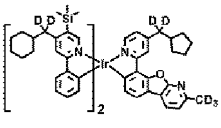
568
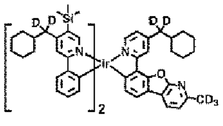
569
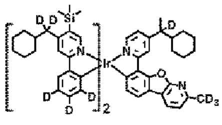
570

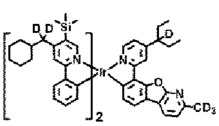
571
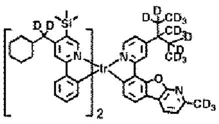
572
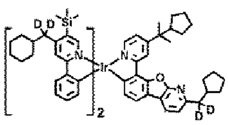
573
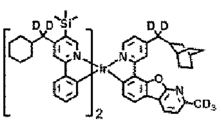
574
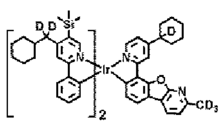
575

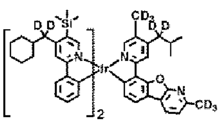
576
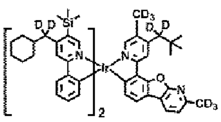
577
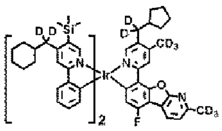
578
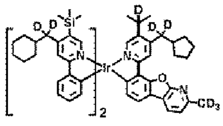
579
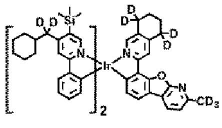
580

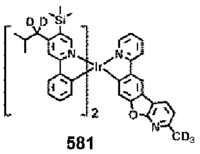
581
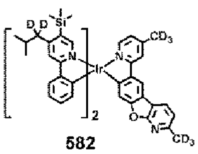
582
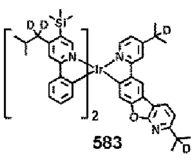
583
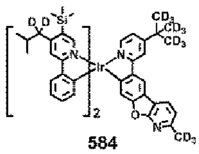
584
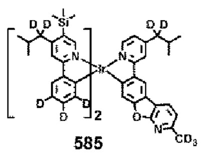
585

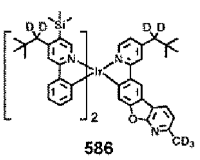
586
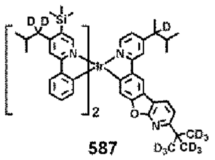
587
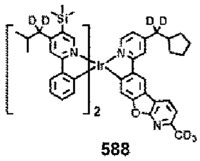
588
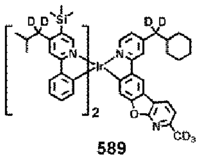
589
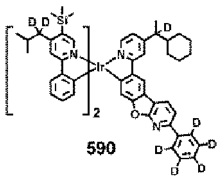
590

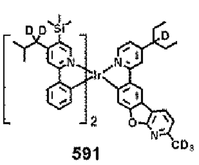
591
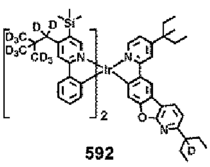
592
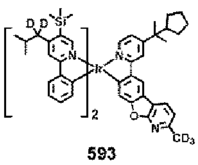
593
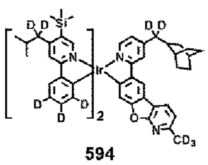
594
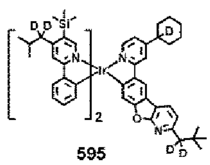
595

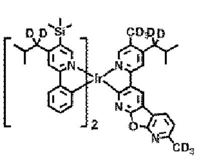
596
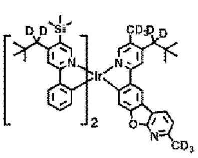
597
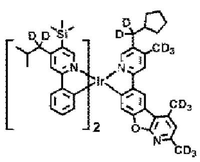
598
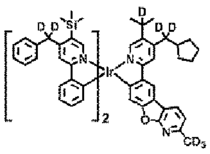
599
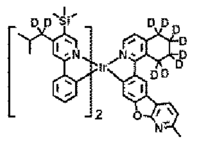
600

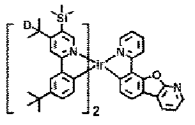
601

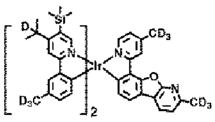
602

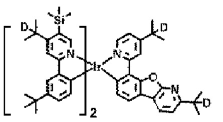
603

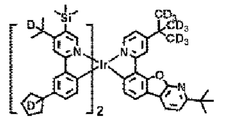
604

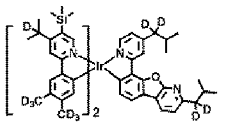
605

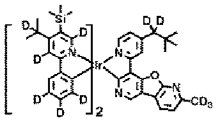
606

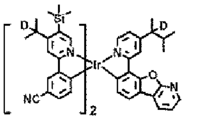
607

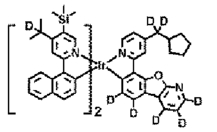
608

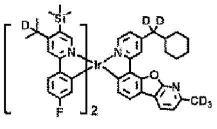
609

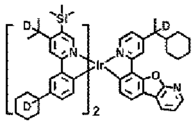
610

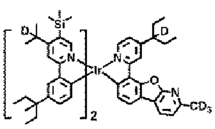
611

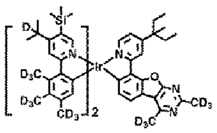
612

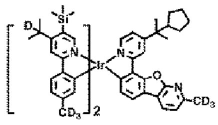
613

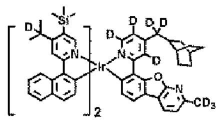
614

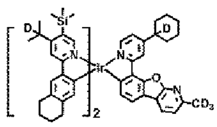
615

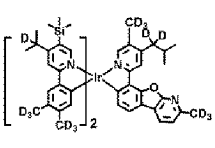
616

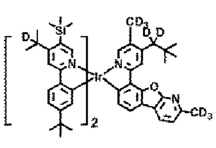
617

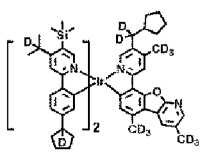
618

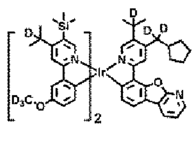
619

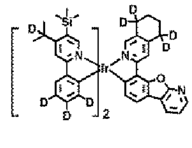
620

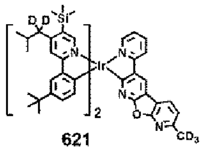
621

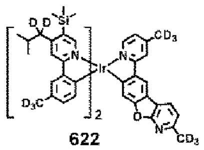
622

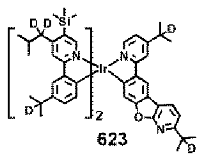
623

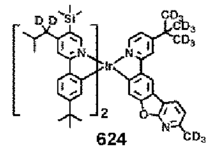
624

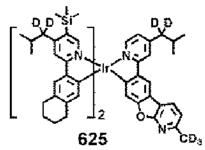
625

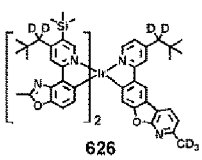
626

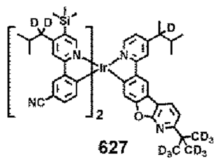
627

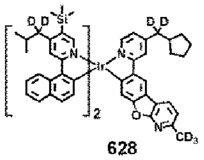
628

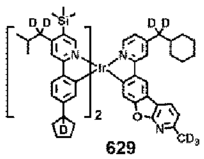
629

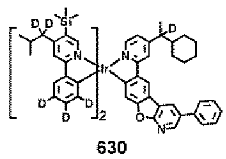
630

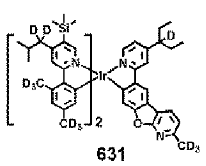
631

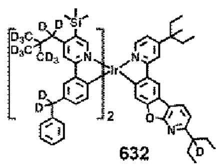
632

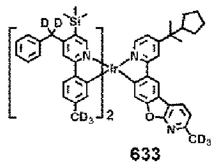
633

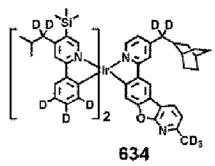
634

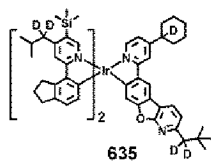
635

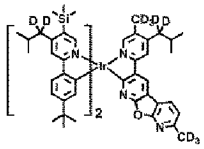
636

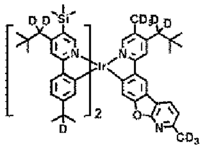
637

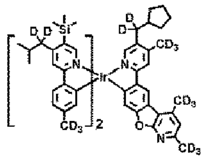
638

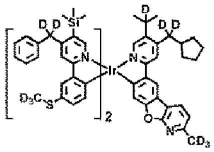
639

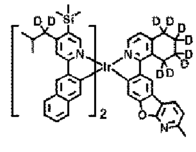
640

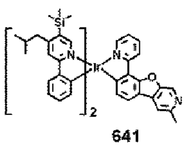
641

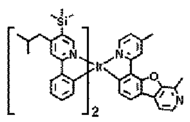
642

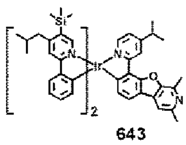
643

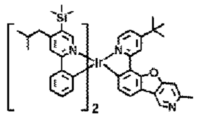
644

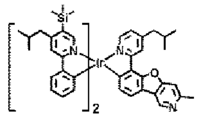
645

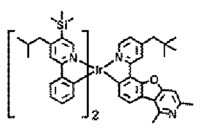
646

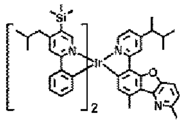
647

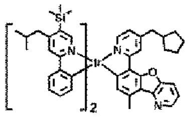
648

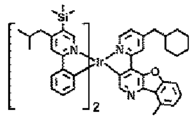
649

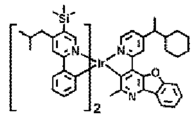
650

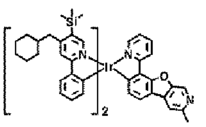
651

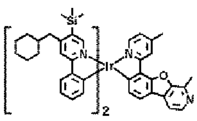
652

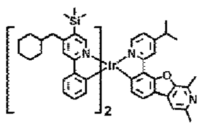
653

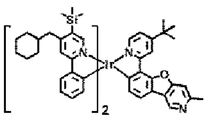
654

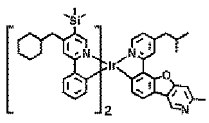
655

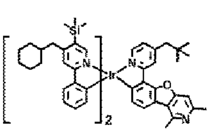
656

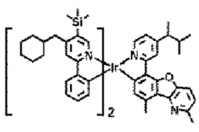
657

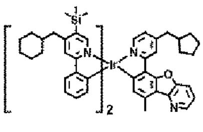
658

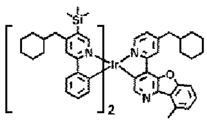
659

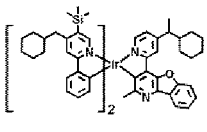
660

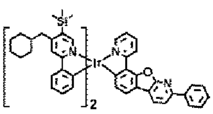
661

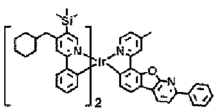
662

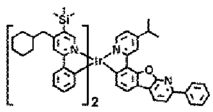
663

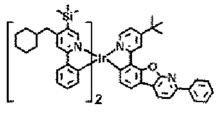
664

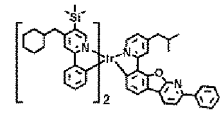
665

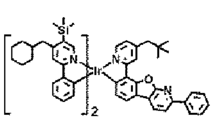
666

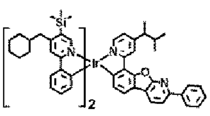
667

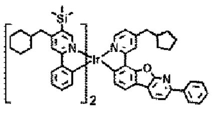
668

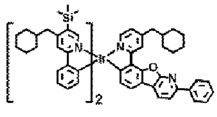
669

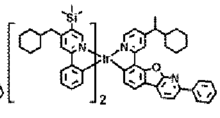
670

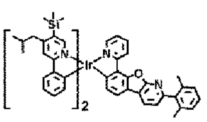
671

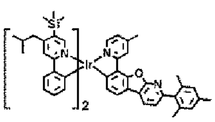
672

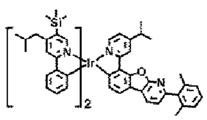
673

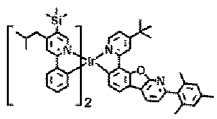
674

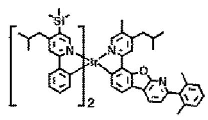
675

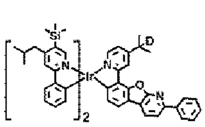
676

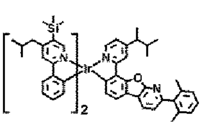
677

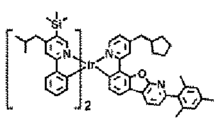
678

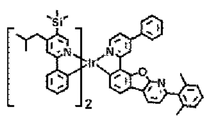
679

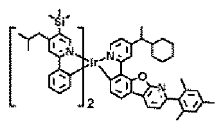
680

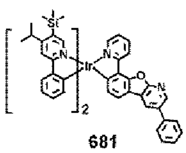
681
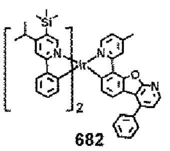
682
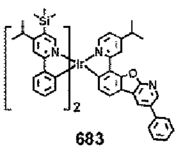
683
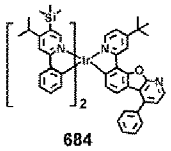
684
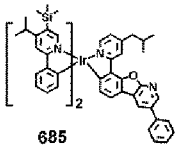
685

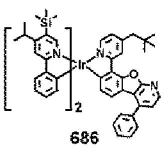
686
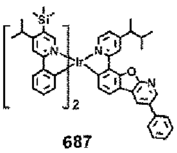
687
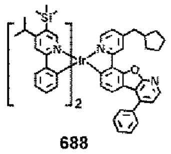
688
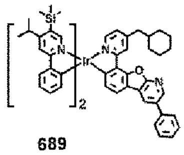
689
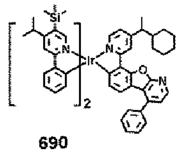
690

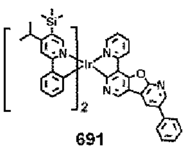
691
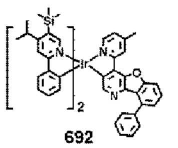
692
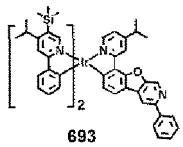
693
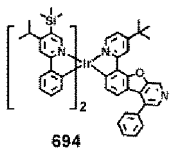
694
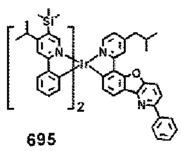
695

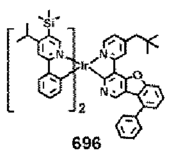
696
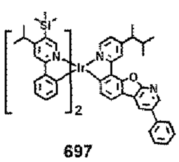
697
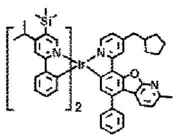
698
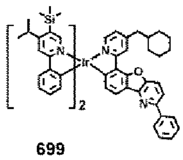
699
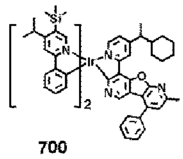
700

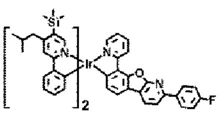
701
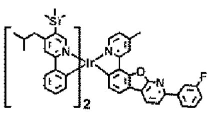
702
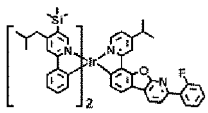
703
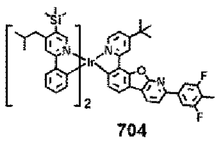
704
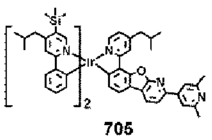
705

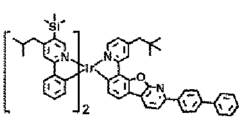
706
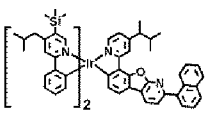
707
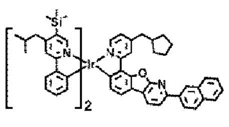
708
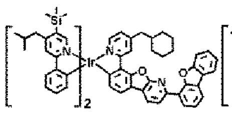
709
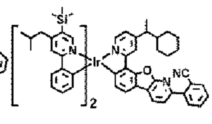
710

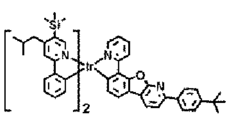
711
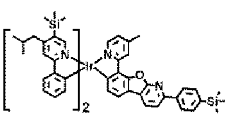
712
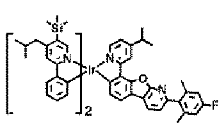
713
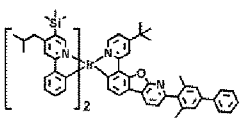
714
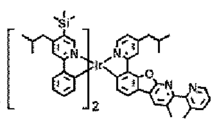
715

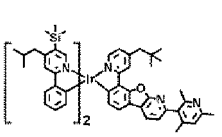
716
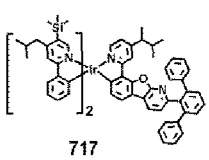
717
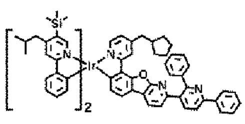
718
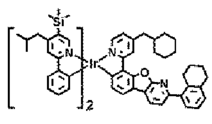
719
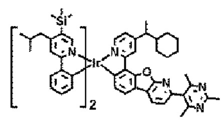
720

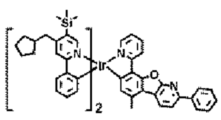
721
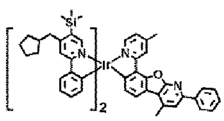
722
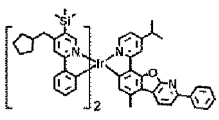
723
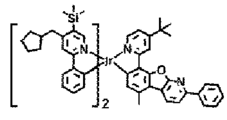
724
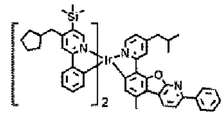
725

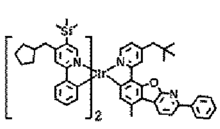
726
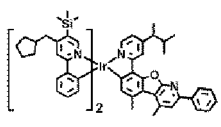
727
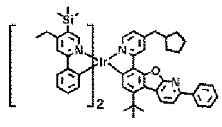
728
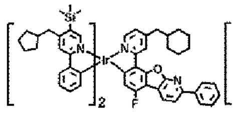
729
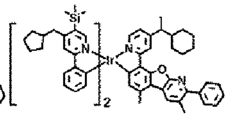
730

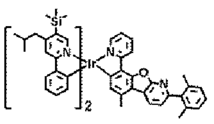
731
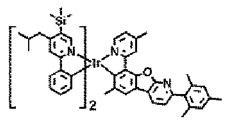
732
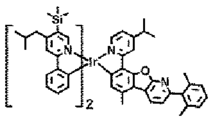
733
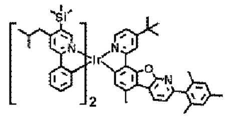
734
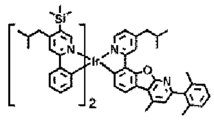
735

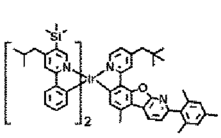
736
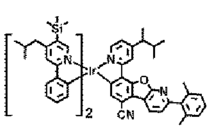
737
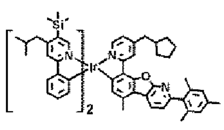
738
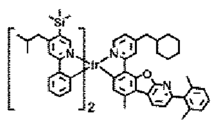
739
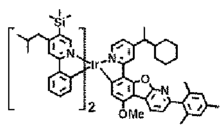
740

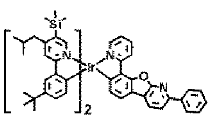
741
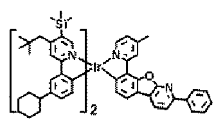
742
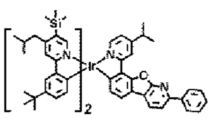
743
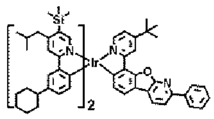
744
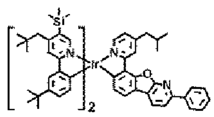
745

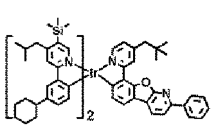
746
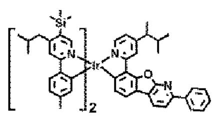
747
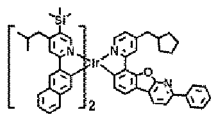
748
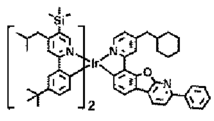
749
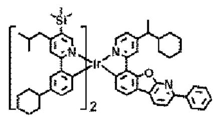
750

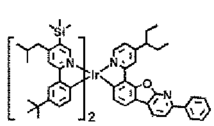
751
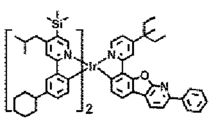
752
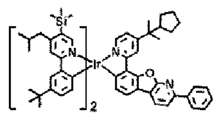
753
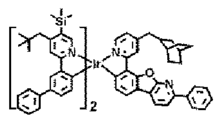
754
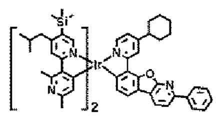
755

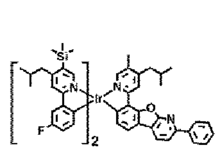
756
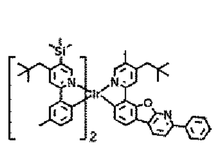
757
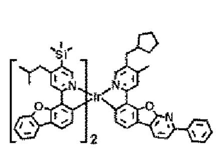
758
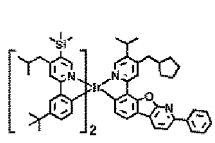
759
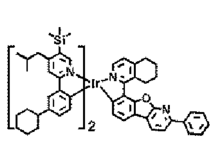
760

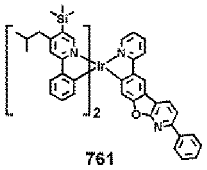
761
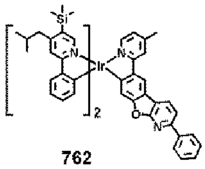
762
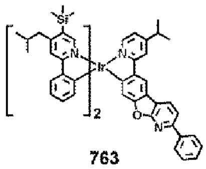
763
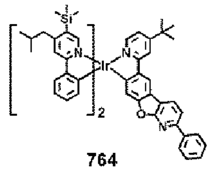
764
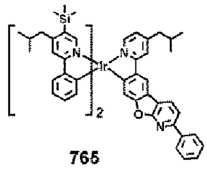
765

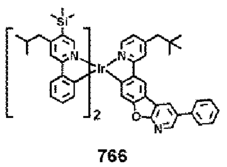
766
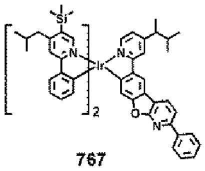
767
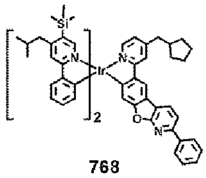
768
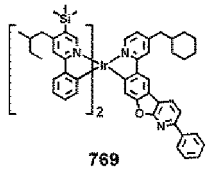
769
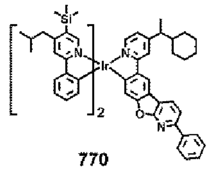
770

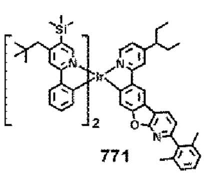
771
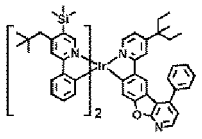
772
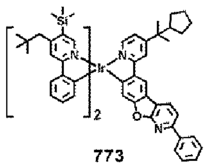
773
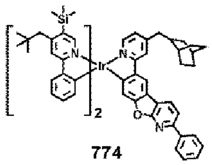
774
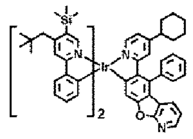
775

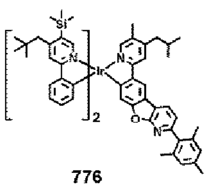
776
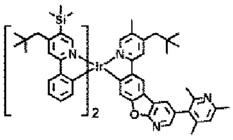
777
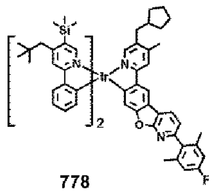
778
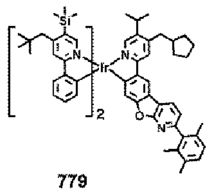
779
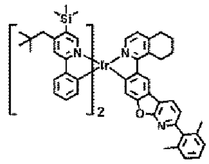
780

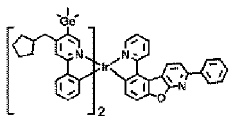
781
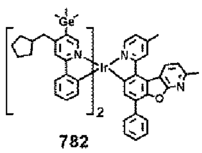
782
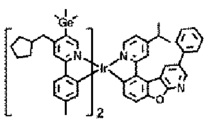
783
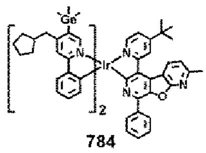
784
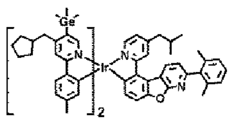
785

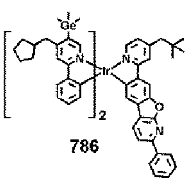
786
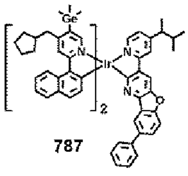
787
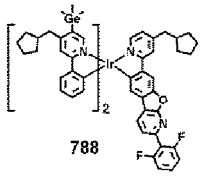
788
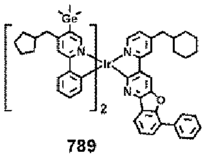
789
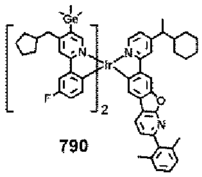
790

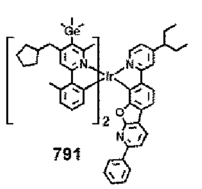
791
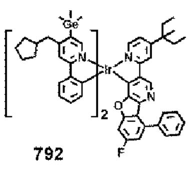
792
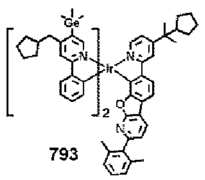
793
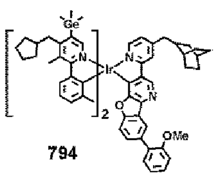
794
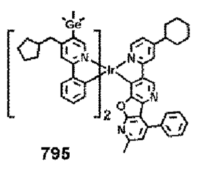
795

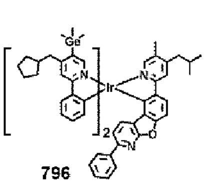
796
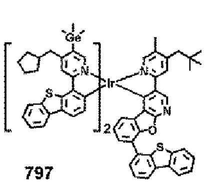
797
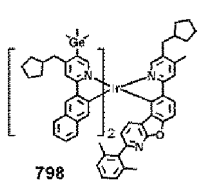
798
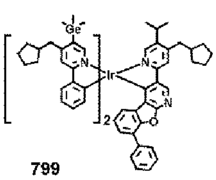
799
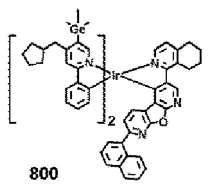
800

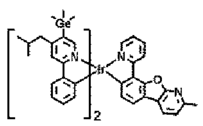
801
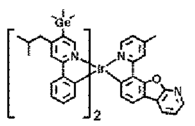
802
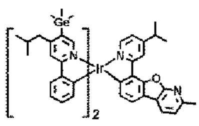
803
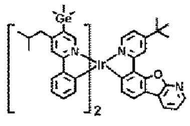
804
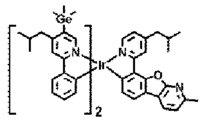
805

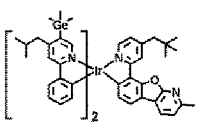
806
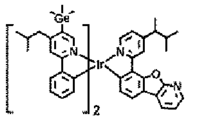
807
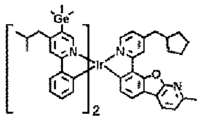
808
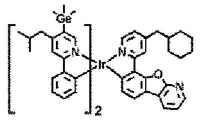
809
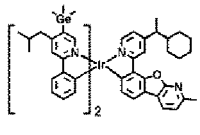
810

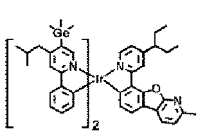
811
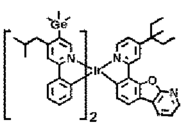
812
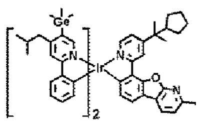
813
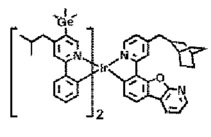
814
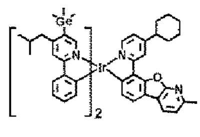
815

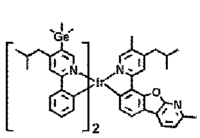
816
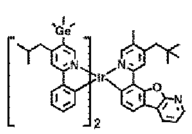
817
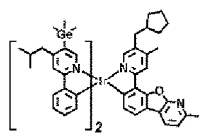
818
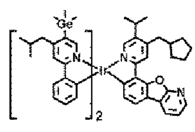
819
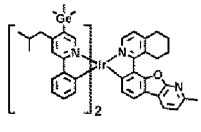
820

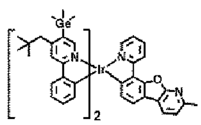
821
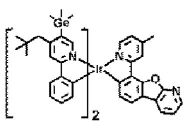
822
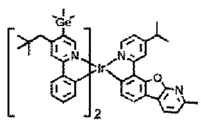
823
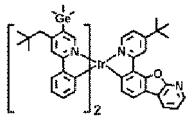
824
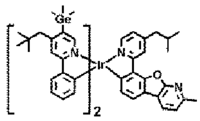
825

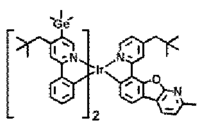
826
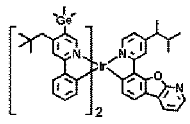
827
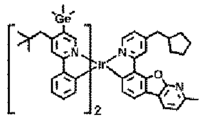
828
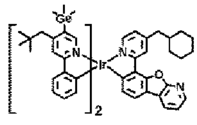
829
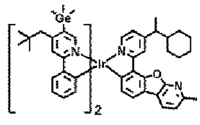
830

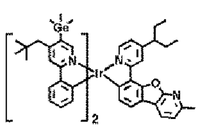
831
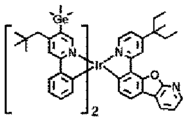
832
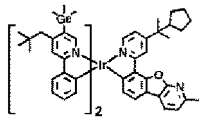
833
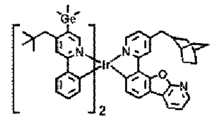
834
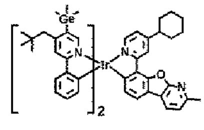
835

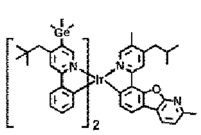
836
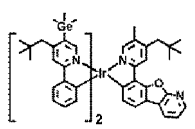
837
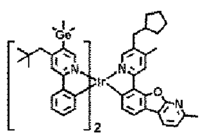
838
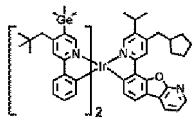
839
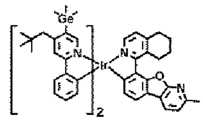
840

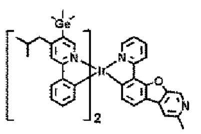
841
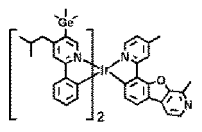
842
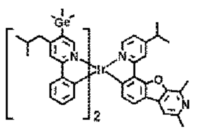
843
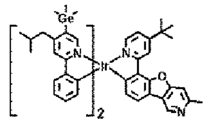
844
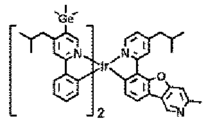
845

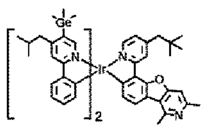
846
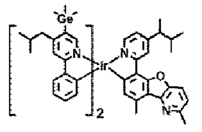
847
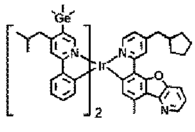
848
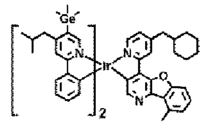
849
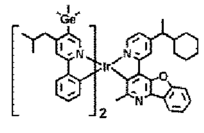
850

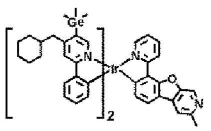
851
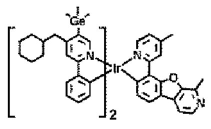
852
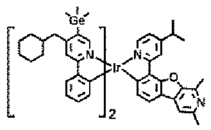
853
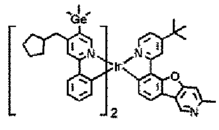
854
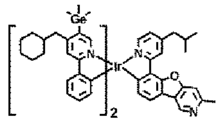
855

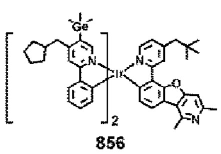
856
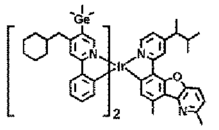
857
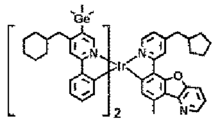
858
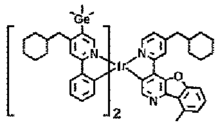
859
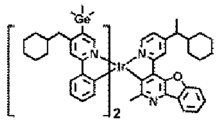
860

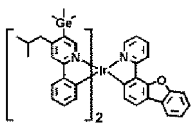
861
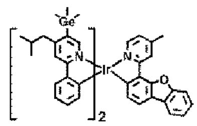
862
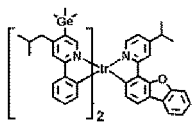
863
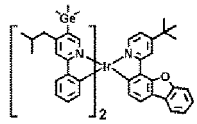
864
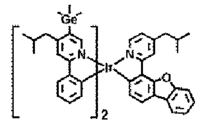
865

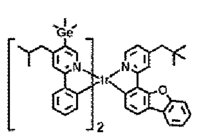
866
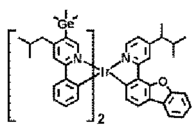
867
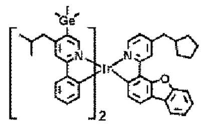
868
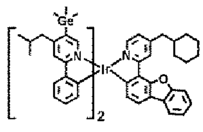
869
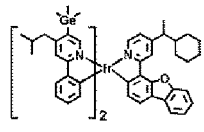
870

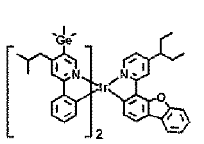
871
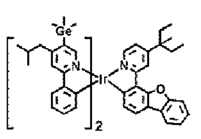
872
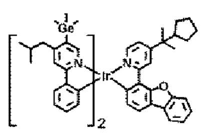
873
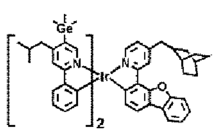
874
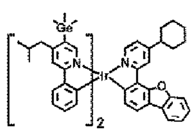
875

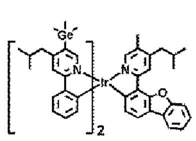
876
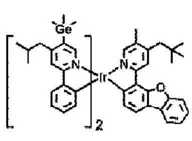
877
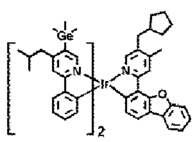
878
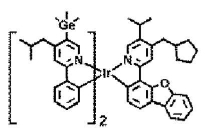
879
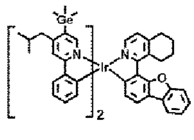
880

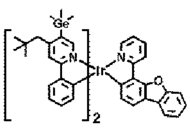
881

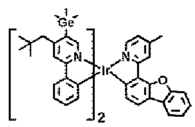
882

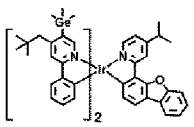
883

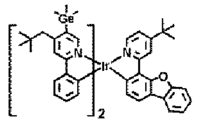
884

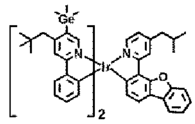
885

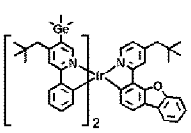
886

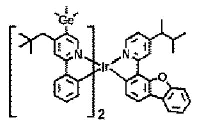
887

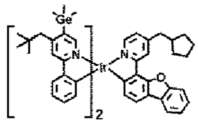
888

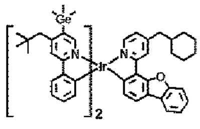
889

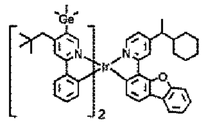
890

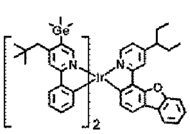
891

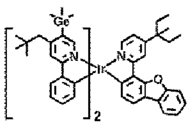
892

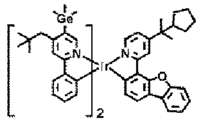
893

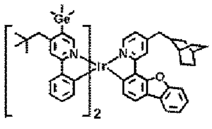
894

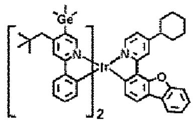
895

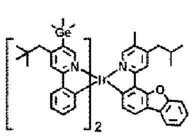
896

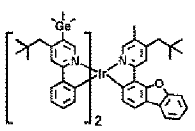
897

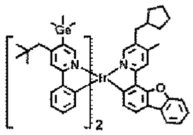
898

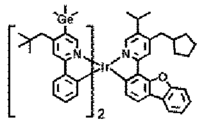
899

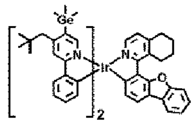
900

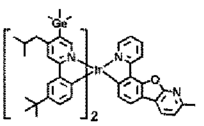
901

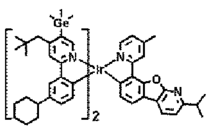
902

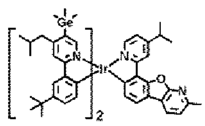
903

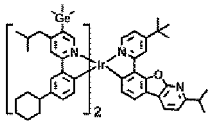
904

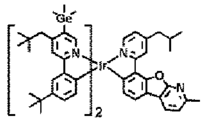
905

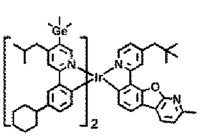
906

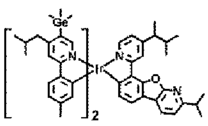
907

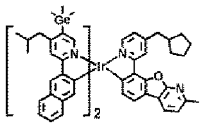
908

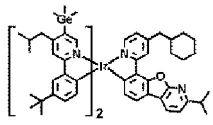
909

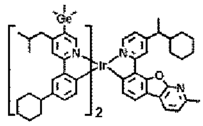
910

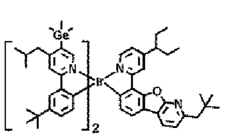
911

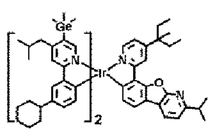
912

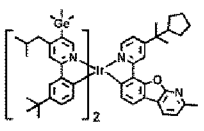
913

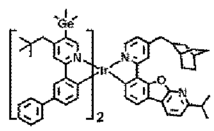
914

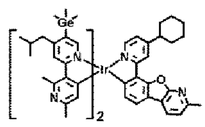
915

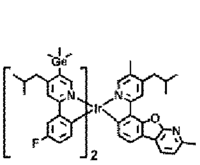
916

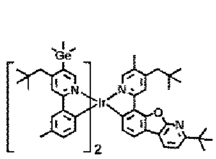
917

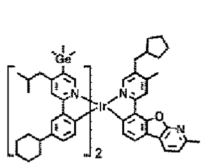
918

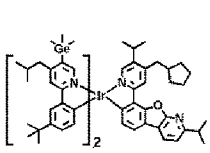
919

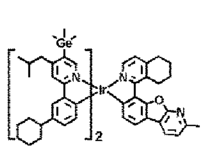
920

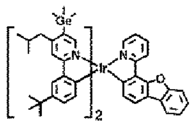
921

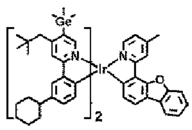
922

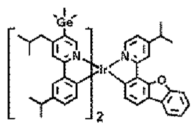
923

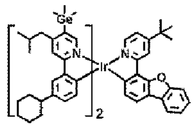
924

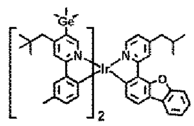
925

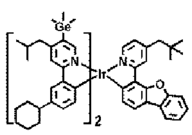
926

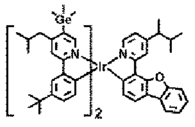
927

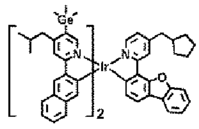
928

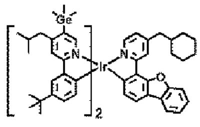
929

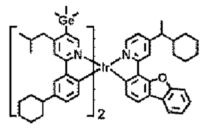
930

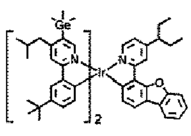
931

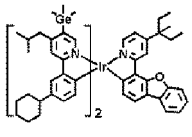
932

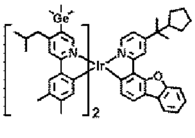
933

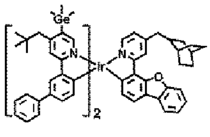
934

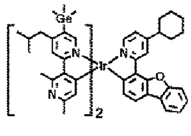
935

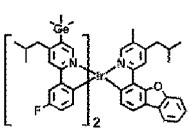
936

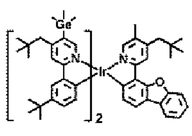
937

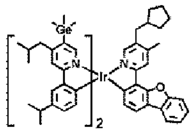
938

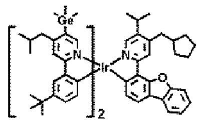
939

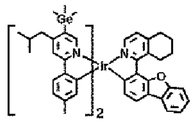
940

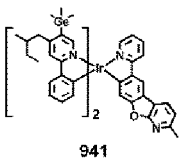
941

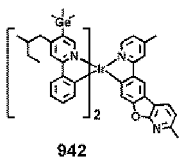
942

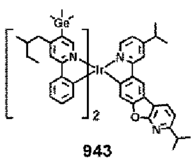
943

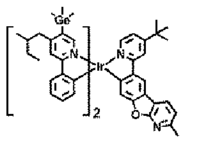
944

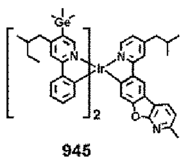
945

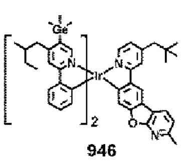
946

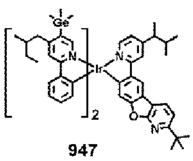
947

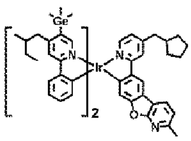
948

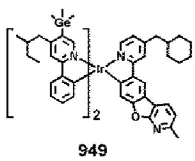
949

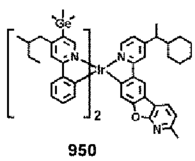
950

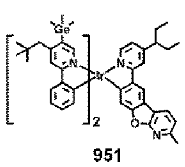
951

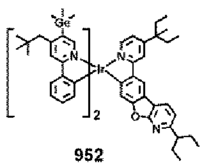
952

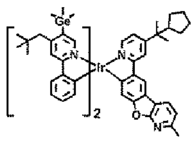
953

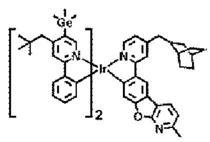
954

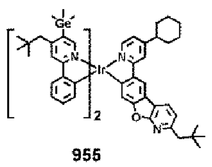
955

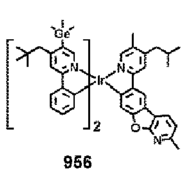
956

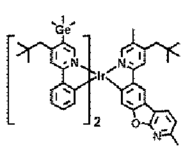
957

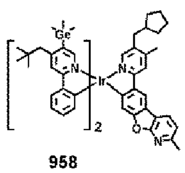
958

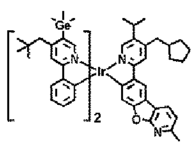
959

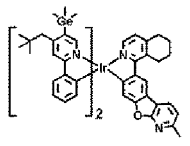
960

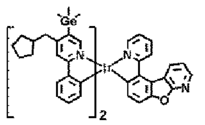
961

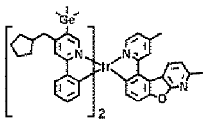
962

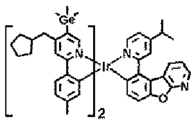
963

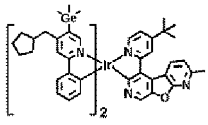
964

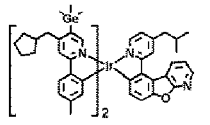
965

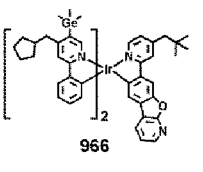
966

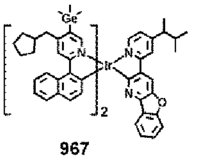
967

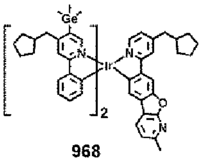
968

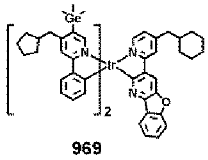
969

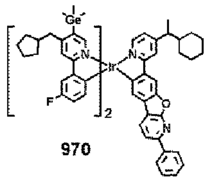
970

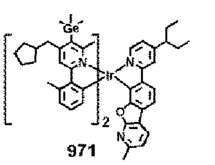
971

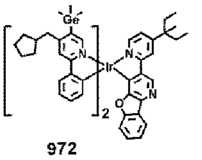
972

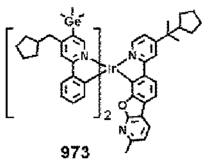
973

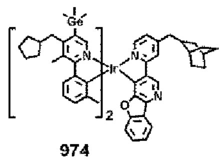
974

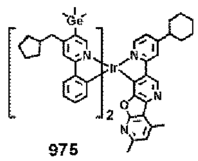
975

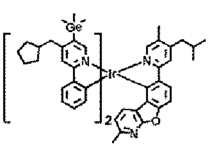
976

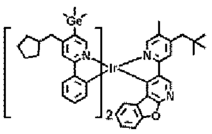
977

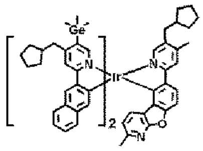
978

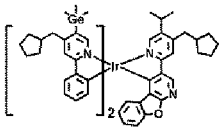
979

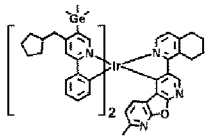
980

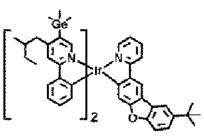
981

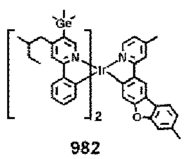
982

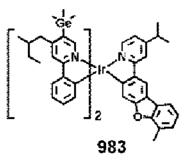
983

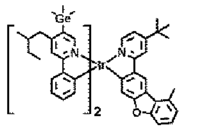
984

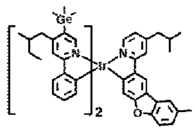
985

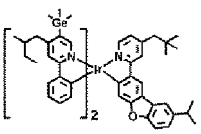
986

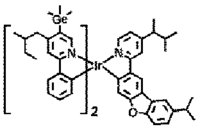
987

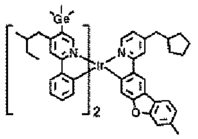
988

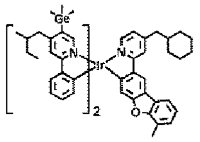
989

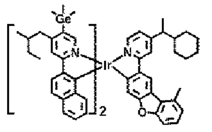
990

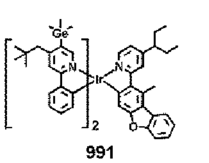
991

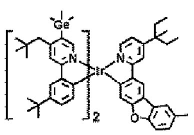
992

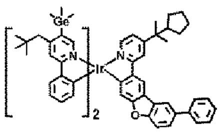
993

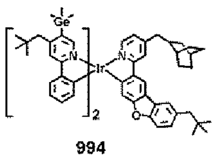
994

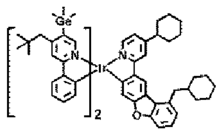
995

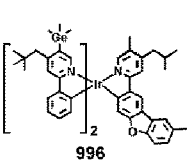
996

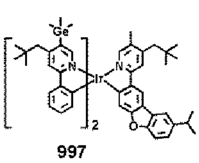
997

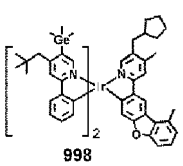
998

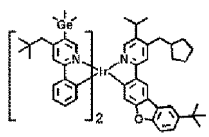
999

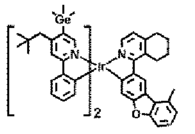
1000

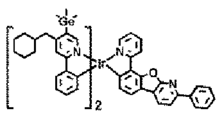
1001

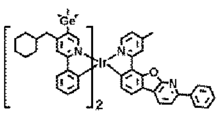
1002

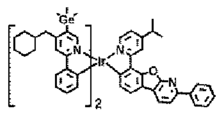
1003

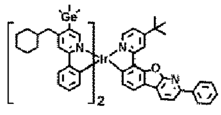
1004

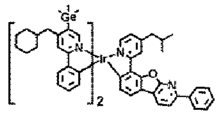
1005

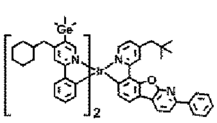
1006

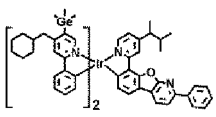
1007

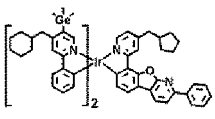
1008

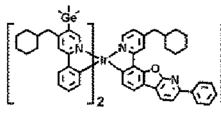
1009

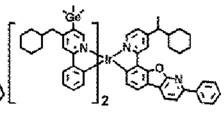
1010

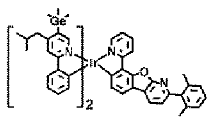
1011

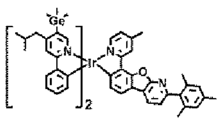
1012

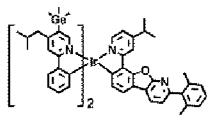
1013

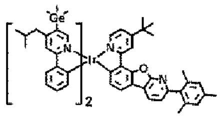
1014

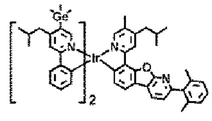
1015

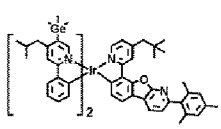
1016

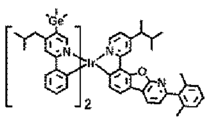
1017

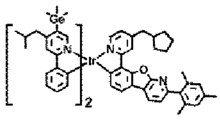
1018

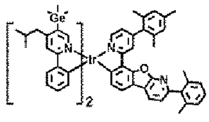
1019

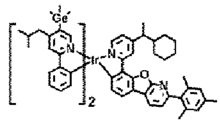
1020

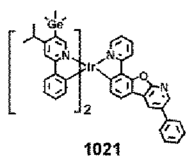
1021

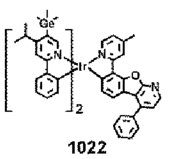
1022

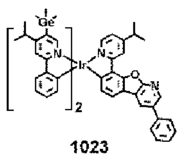
1023

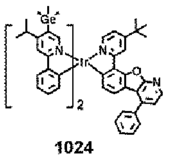
1024

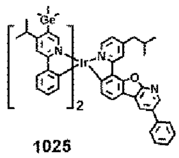
1025

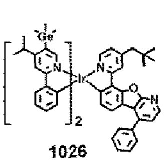
1026

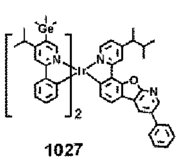
1027

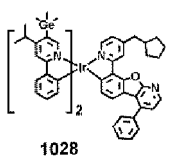
1028

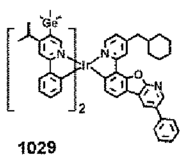
1029

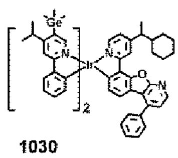
1030

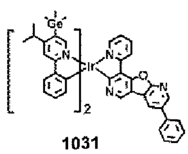
1031

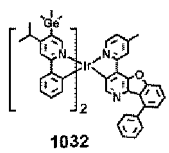
1032

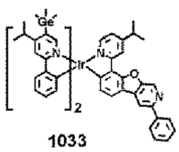
1033

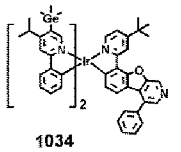
1034

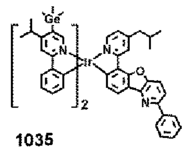
1035

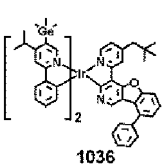
1036

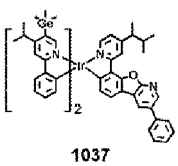
1037

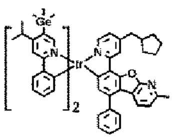
1038

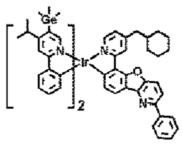
1039

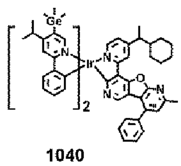
1040

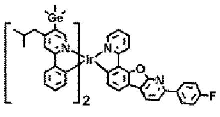 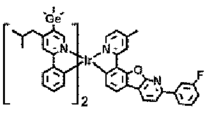 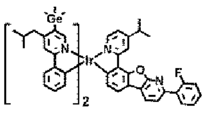 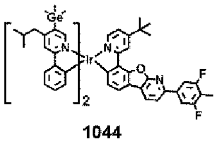 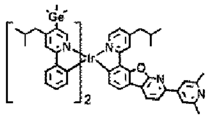

1041 1042 1043 1044 1045

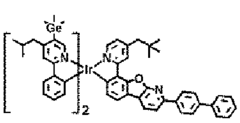 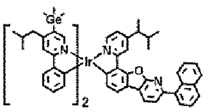 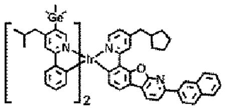 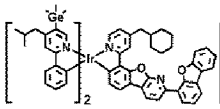 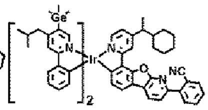

1046 1047 1048 1049 1050

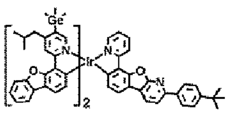 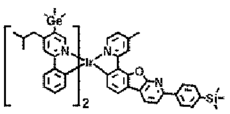 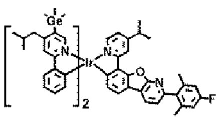 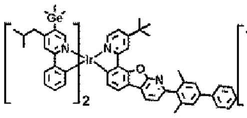 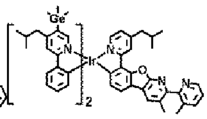

1051 1052 1053 1054 1055

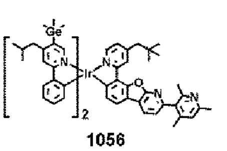 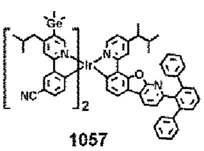 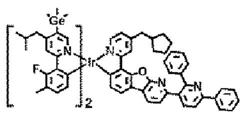 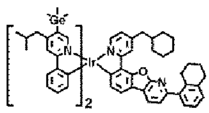 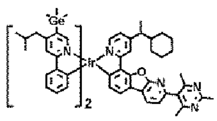

1056 1057 1058 1059 1060

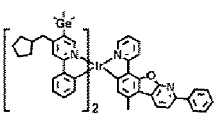 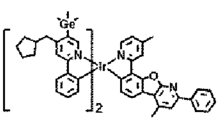 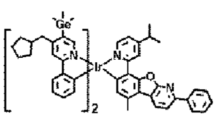 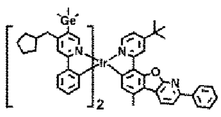 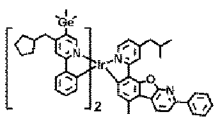

1061 1062 1063 1064 1065

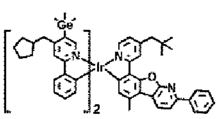 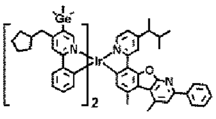 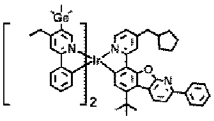 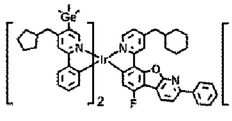 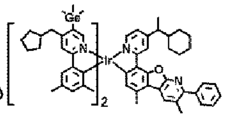

1066 1067 1068 1069 1070

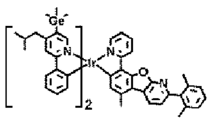 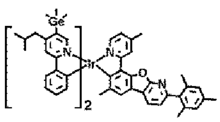 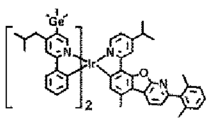 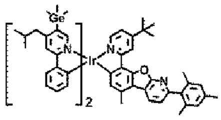 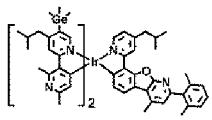

1071 1072 1073 1074 1075

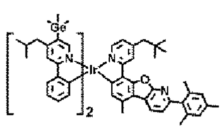 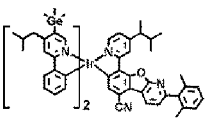 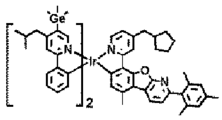 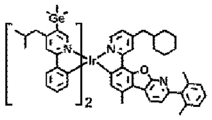 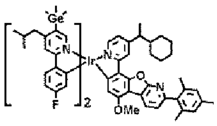

1076 1077 1078 1079 1080

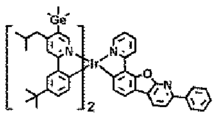
1081
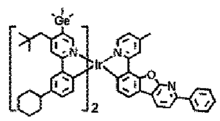
1082
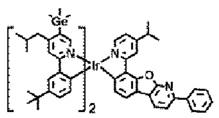
1083
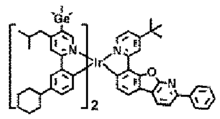
1084
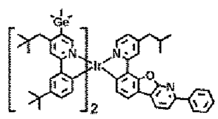
1085

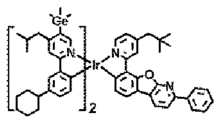
1086
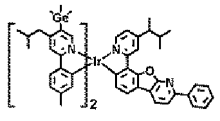
1087
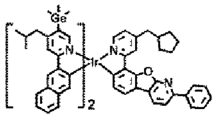
1088
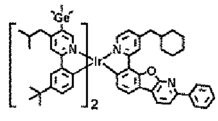
1089
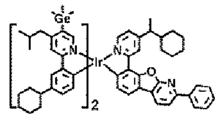
1090

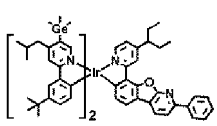
1091
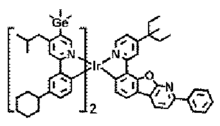
1092
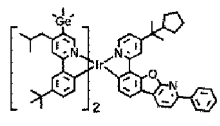
1093
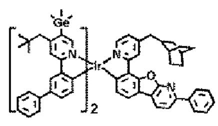
1094
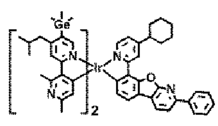
1095

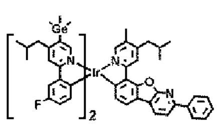
1096
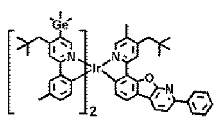
1097
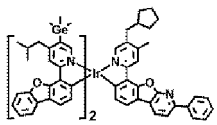
1098
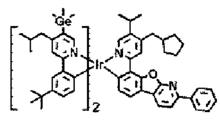
1099
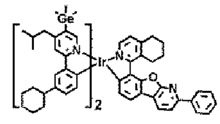
1100

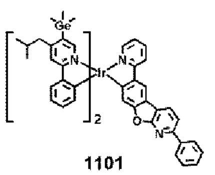
1101
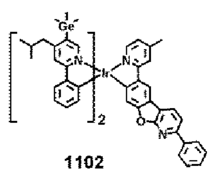
1102
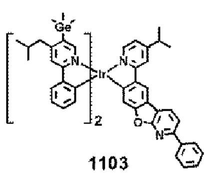
1103
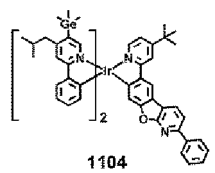
1104
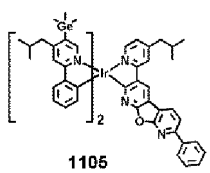
1105

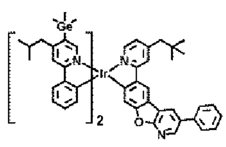
1106
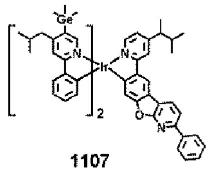
1107
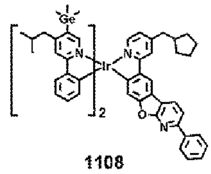
1108
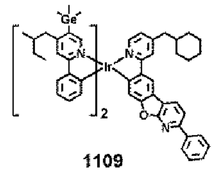
1109
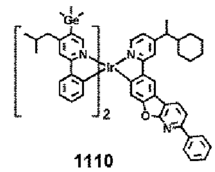
1110

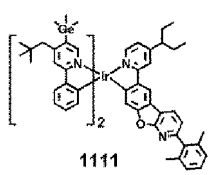
1111
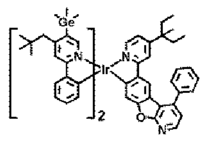
1112
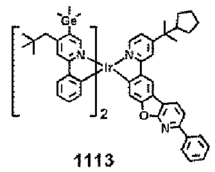
1113
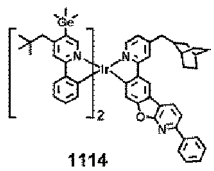
1114
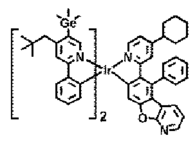
1115

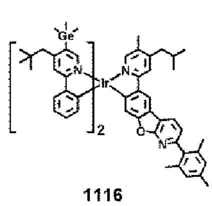
1116
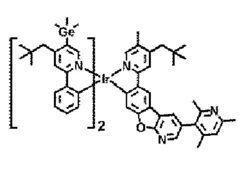
1117
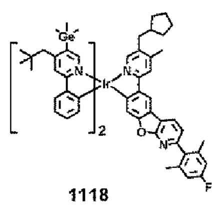
1118
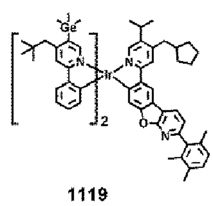
1119
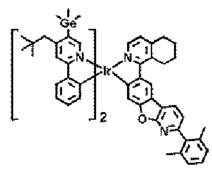
1120

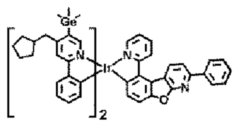
1121
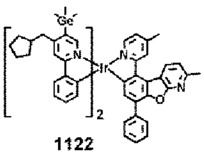
1122
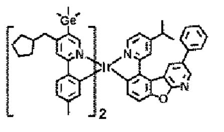
1123
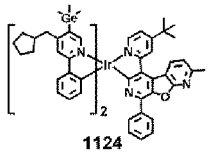
1124
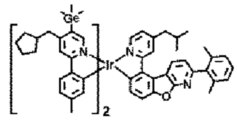
1125

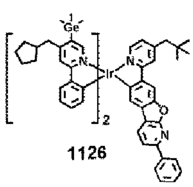
1126
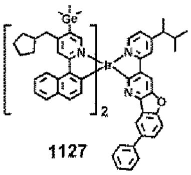
1127
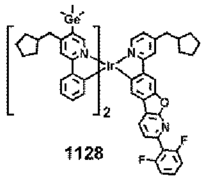
1128
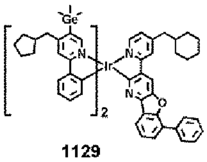
1129
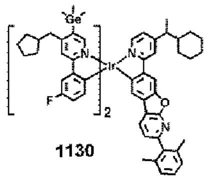
1130

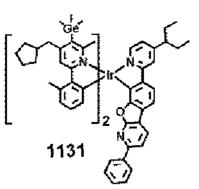
1131
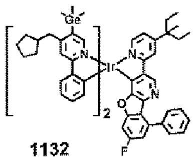
1132
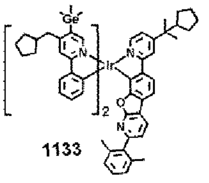
1133
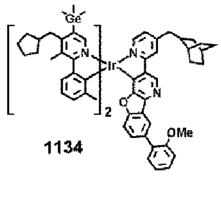
1134
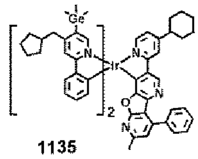
1135

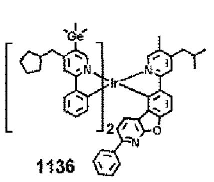
1136
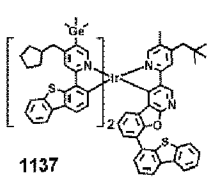
1137
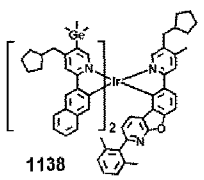
1138
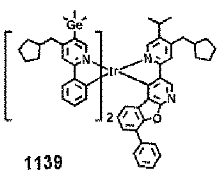
1139
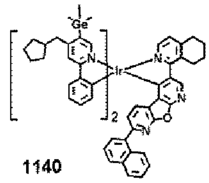
1140

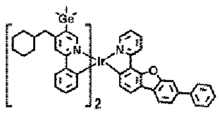
1141
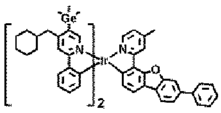
1142
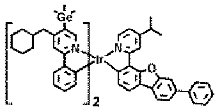
1143
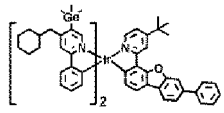
1144
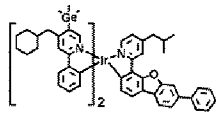
1145

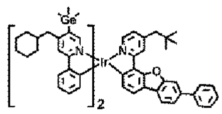
1146
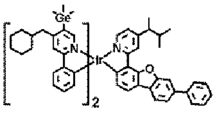
1147
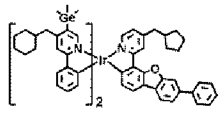
1148
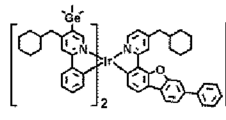
1149
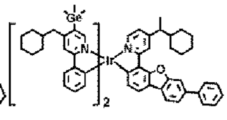
1150

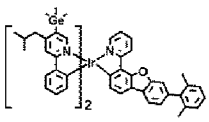
1151
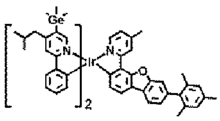
1152
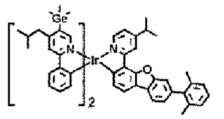
1153
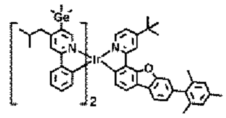
1154
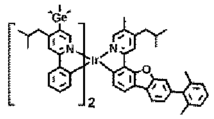
1155

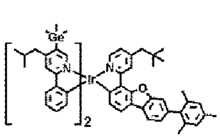
1156
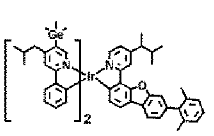
1157
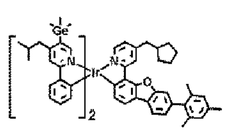
1158
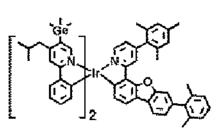
1159
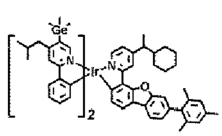
1160

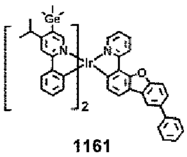
1161
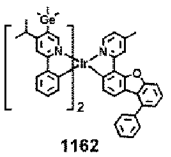
1162
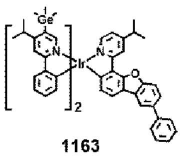
1163
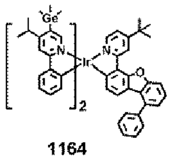
1164
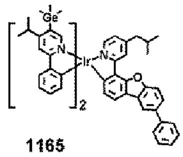
1165

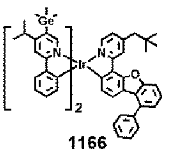
1166
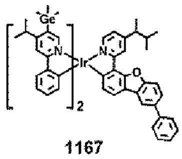
1167
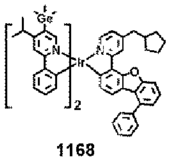
1168
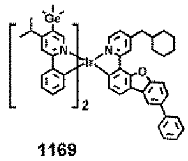
1169
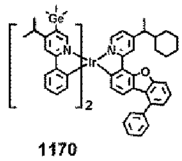
1170

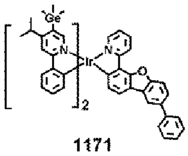
1171
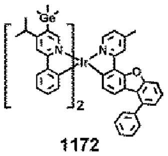
1172
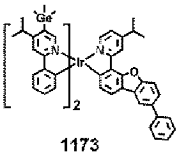
1173
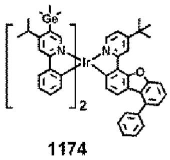
1174
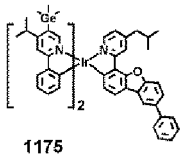
1175

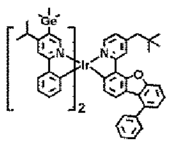
1176
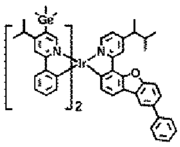
1177
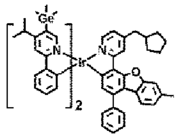
1178
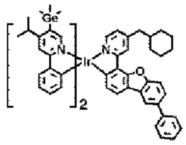
1179
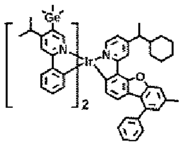
1180

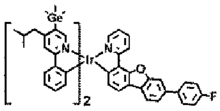
1181
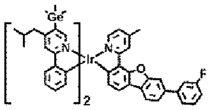
1182
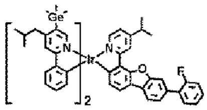
1183
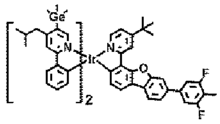
1184
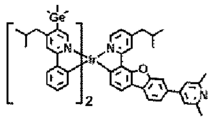
1185

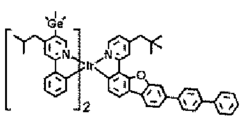
1186
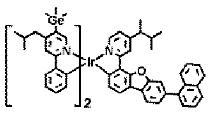
1187
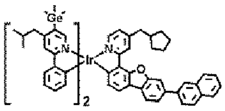
1188
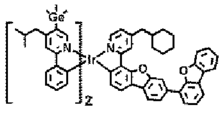
1189
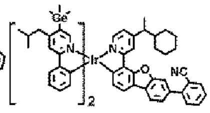
1190

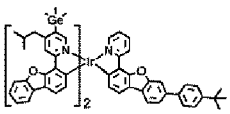
1191
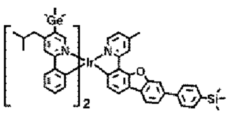
1192
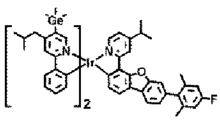
1193
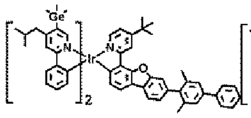
1194
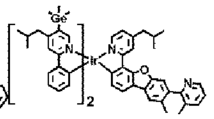
1195

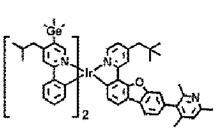
1196
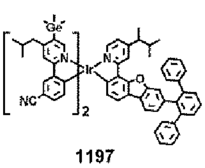
1197
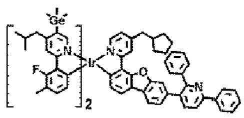
1198
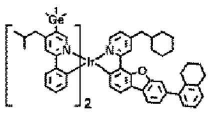
1199
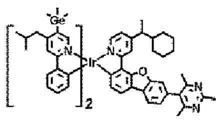
1200

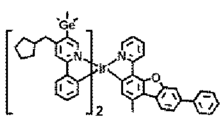
1201
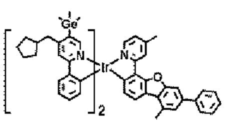
1202
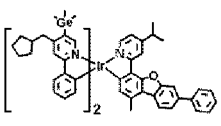
1203
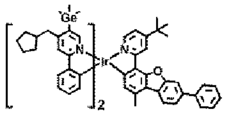
1204
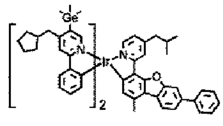
1205

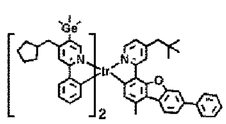
1206
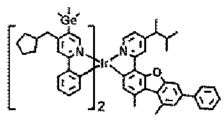
1207
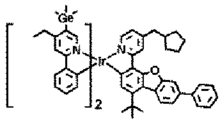
1208
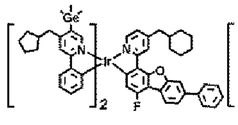
1209
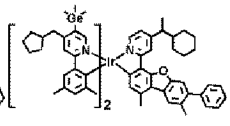
1210

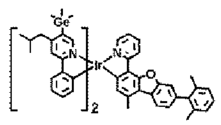
1211
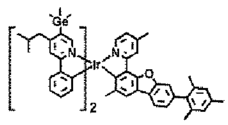
1212
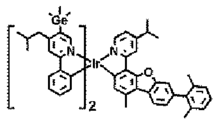
1213
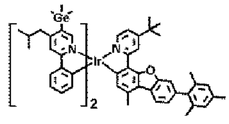
1214
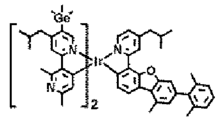
1215

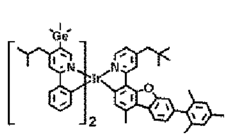
1216
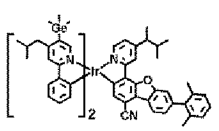
1217
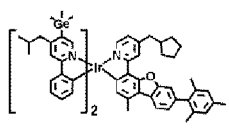
1218
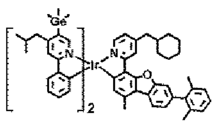
1219
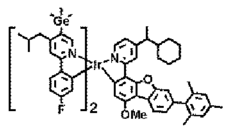
1220

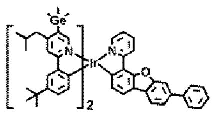
1221
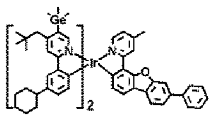
1222
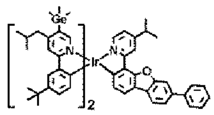
1223
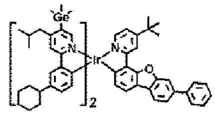
1224
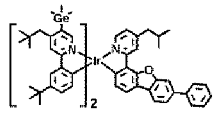
1225

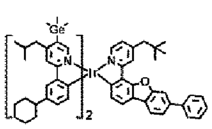
1226
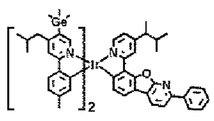
1227
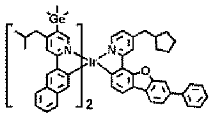
1228
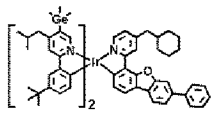
1229
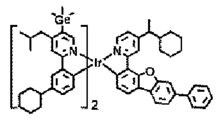
1230

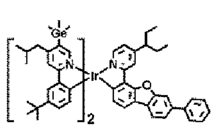
1231
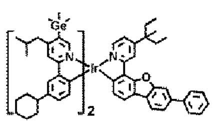
1232
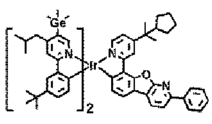
1233
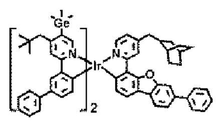
1234
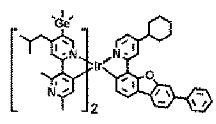
1235

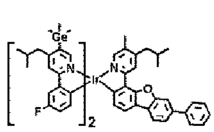
1236
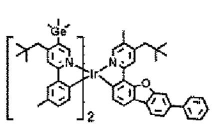
1237
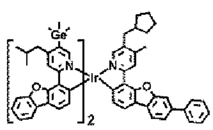
1238
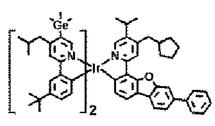
1239
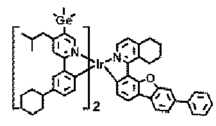
1240

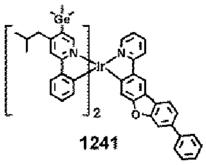
1241

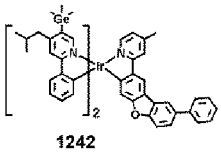
1242

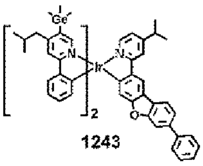
1243

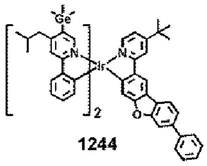
1244

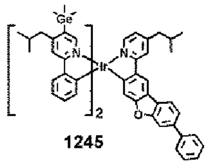
1245

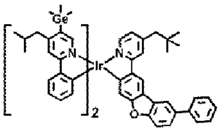
1246

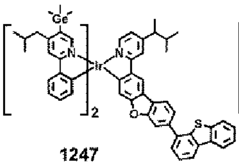
1247

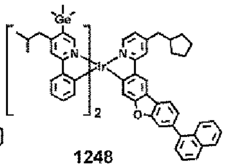
1248

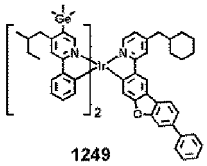
1249

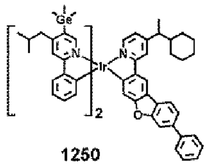
1250

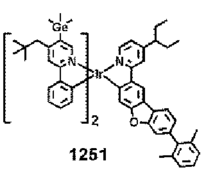
1251

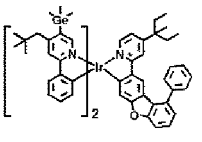
1252

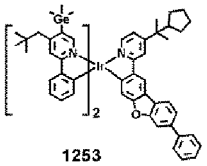
1253

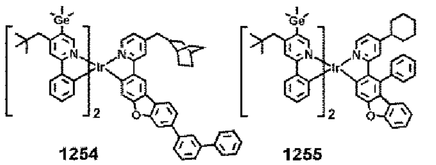
1254

1255

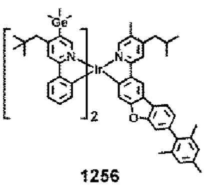
1256

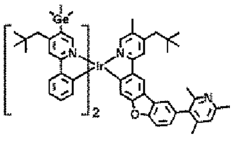
1257

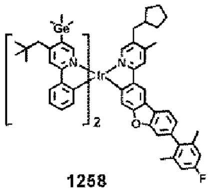
1258

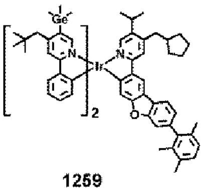
1259

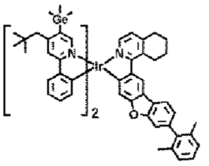
1260

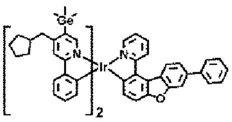
1261

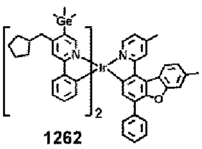
1262

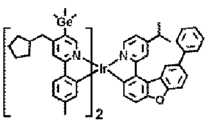
1263

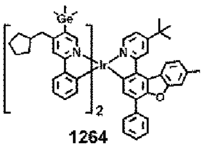
1264

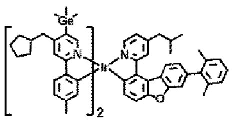
1265

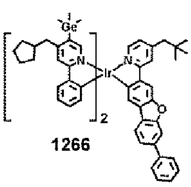
1266

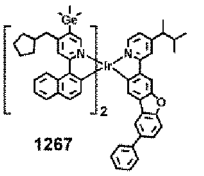
1267

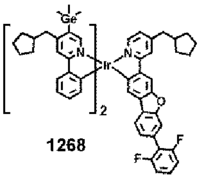
1268

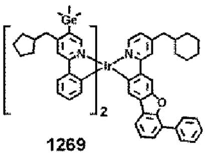
1269

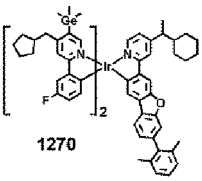
1270

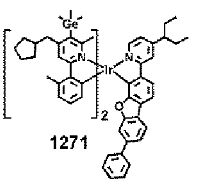
1271

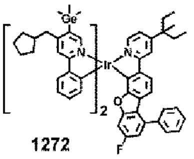
1272

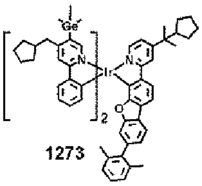
1273

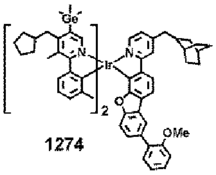
1274

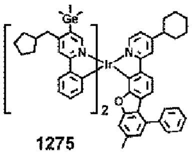
1275

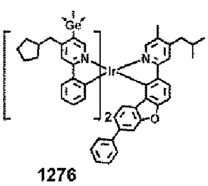
1276

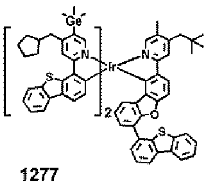
1277

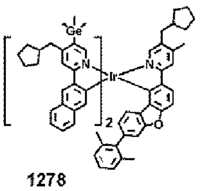
1278

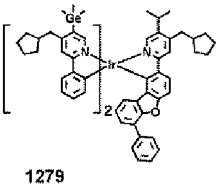
1279

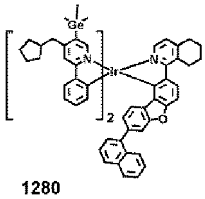
1280

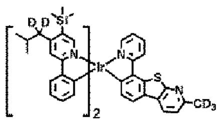
1281

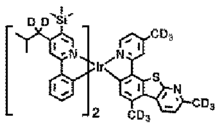
1282

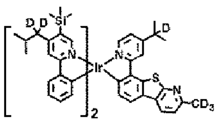
1283

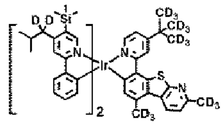
1284

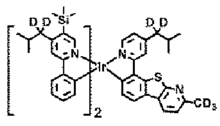
1285

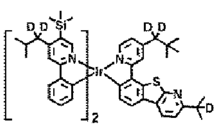
1286

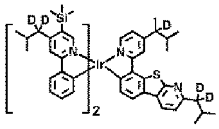
1287

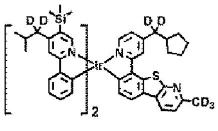
1288

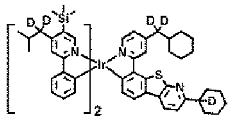
1289

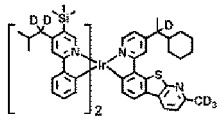
1290

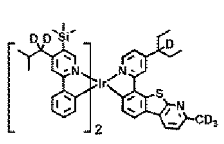
1291

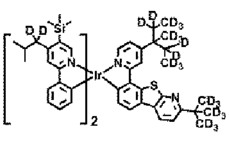
1292

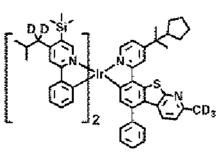
1293

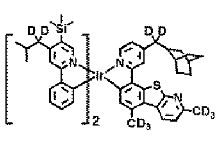
1294

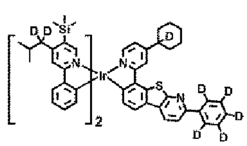
1295

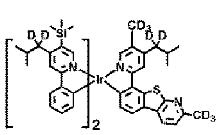
1296

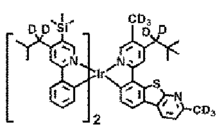
1297

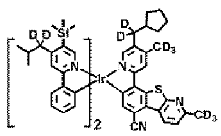
1298

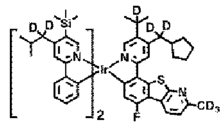
1299

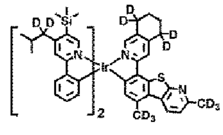
1300

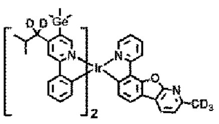
1301

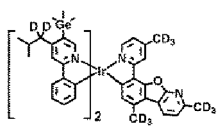
1302

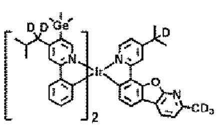
1303

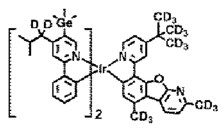
1304

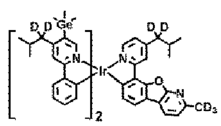
1305

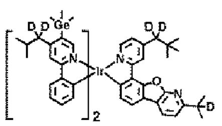
1306

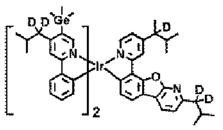
1307

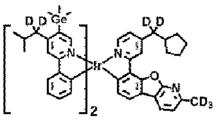
1308

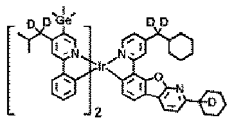
1309

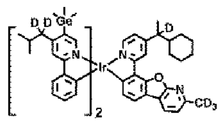
1310

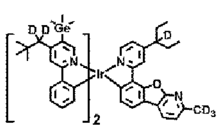
1311

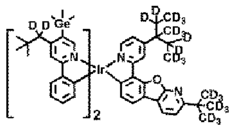
1312

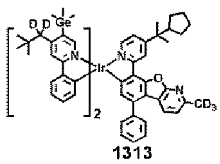
1313

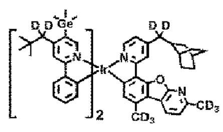
1314

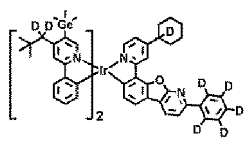
1315

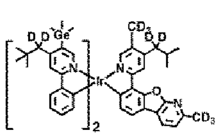
1316

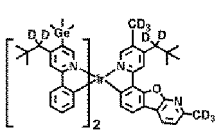
1317

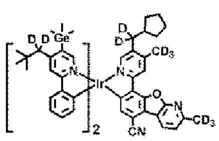
1318

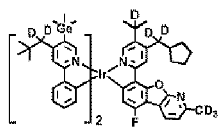
1319

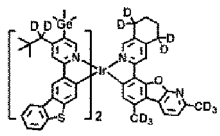
1320

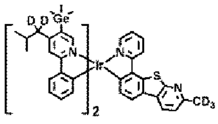
1321

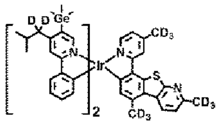
1322

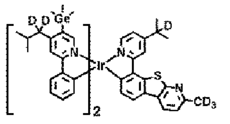
1323

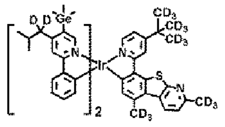
1324

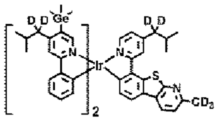
1325

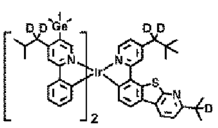
1326

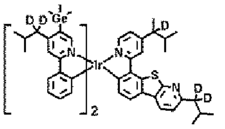
1327

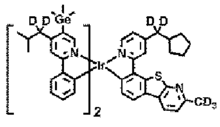
1328

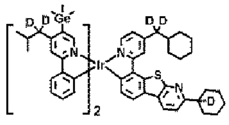
1329

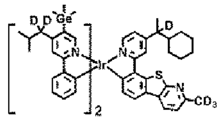
1330

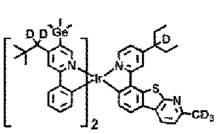
1331

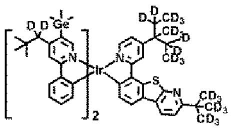
1332

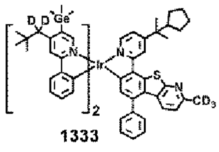
1333

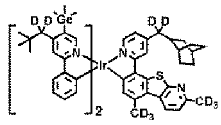
1334

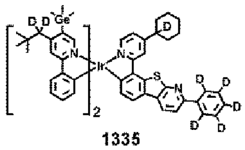
1335

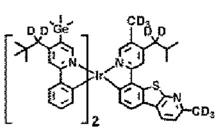
1336

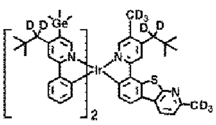
1337

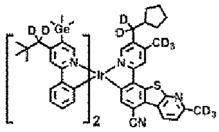
1338

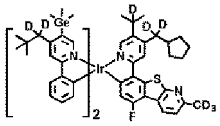
1339

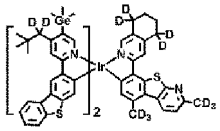
1340

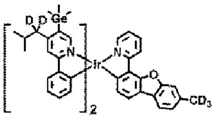
1341

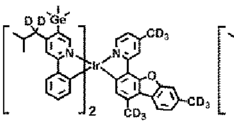
1342

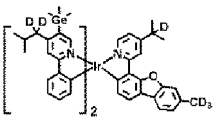
1343

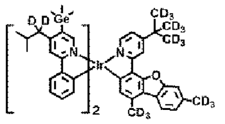
1344

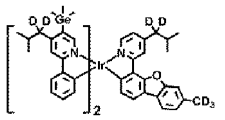
1345

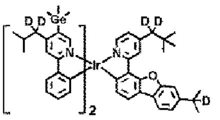
1346

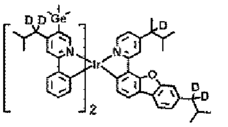
1347

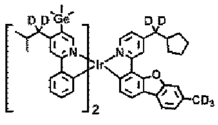
1348

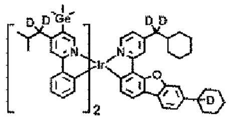
1349

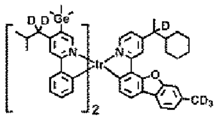
1350

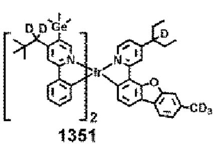
1351

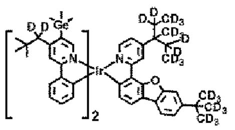
1352

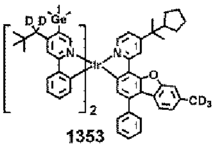
1353

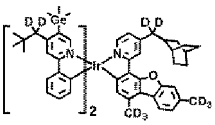
1354

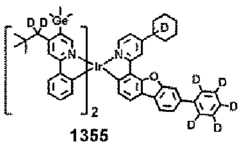
1355

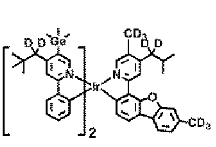
1356

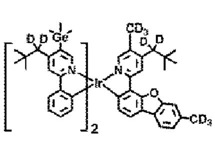
1357

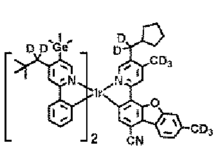
1358

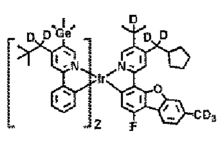
1359

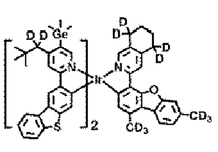
1360

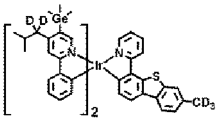 1361
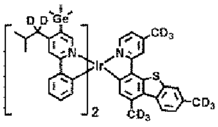 1362
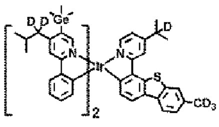 1363
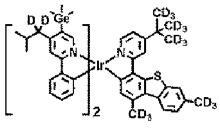 1364
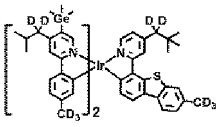 1365

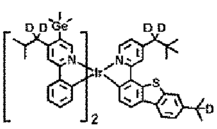 1366
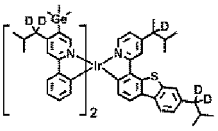 1367
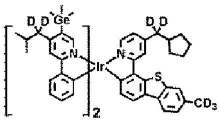 1368
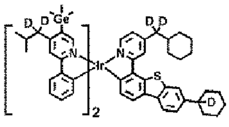 1369
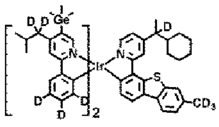 1370

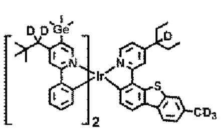 1371
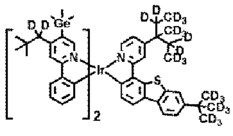 1372
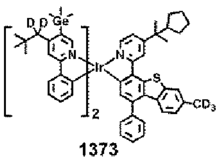 1373
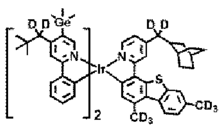 1374
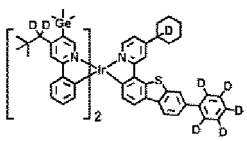 1375

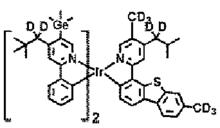 1376
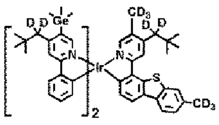 1377
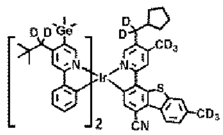 1378
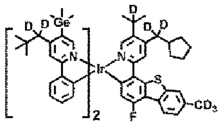 1379
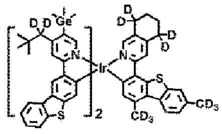 1380

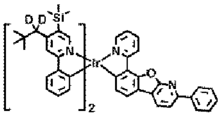 1381
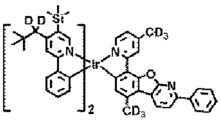 1382
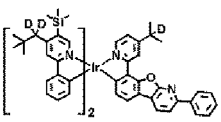 1383
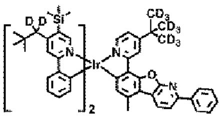 1384
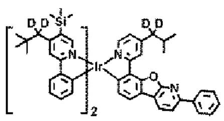 1385

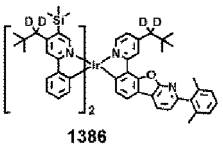 1386
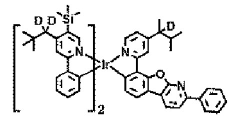 1387
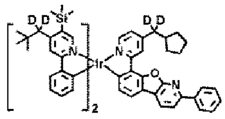 1388
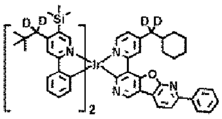 1389
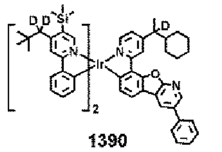 1390

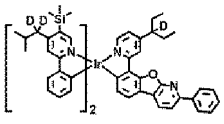 1391
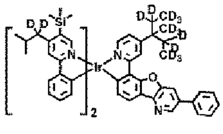 1392
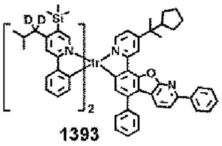 1393
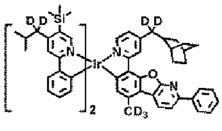 1394
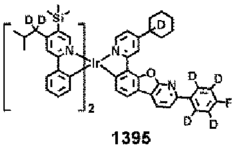 1395

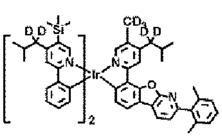 1396
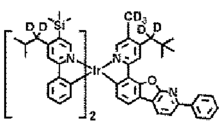 1397
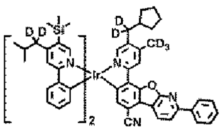 1398
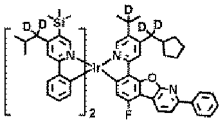 1399
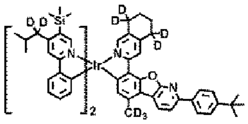 1400

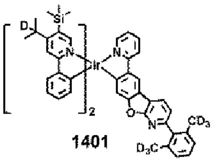
1401
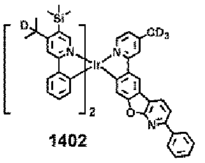
1402
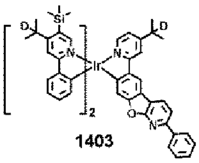
1403
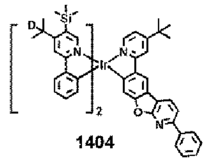
1404
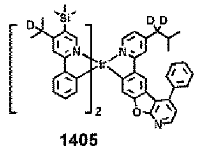
1405
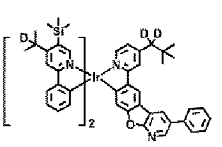
1406
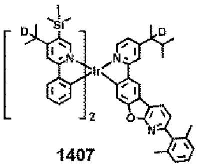
1407
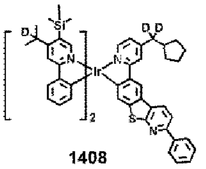
1408
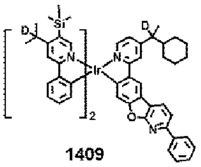
1409
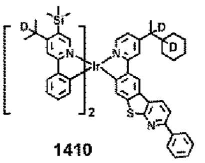
1410
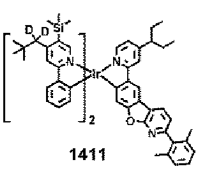
1411
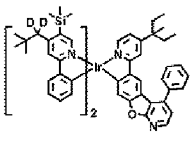
1412
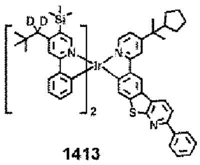
1413
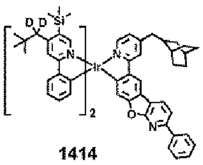
1414
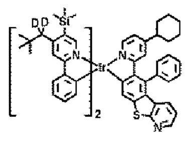
1415
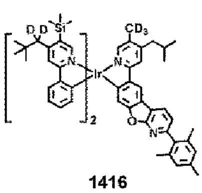
1416
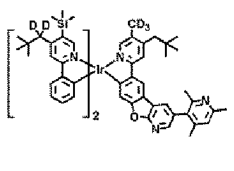
1417
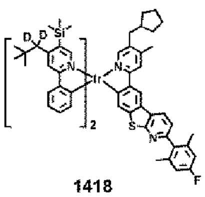
1418
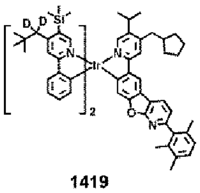
1419
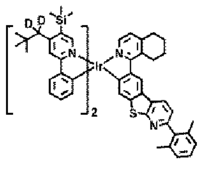
1420
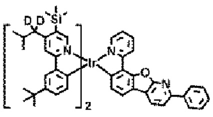
1421
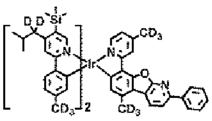
1422
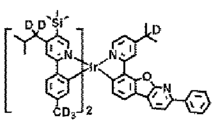
1423
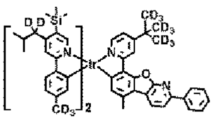
1424
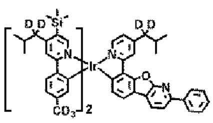
1425
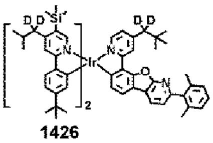
1426
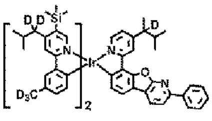
1427
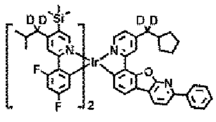
1428
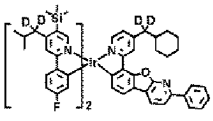
1429
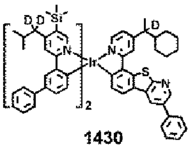
1430
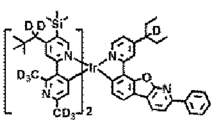
1431
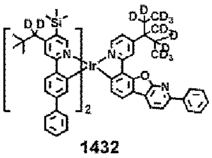
1432
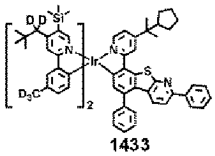
1433
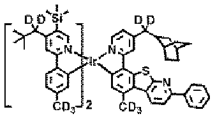
1434
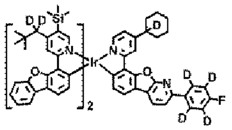
1435
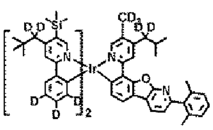
1436
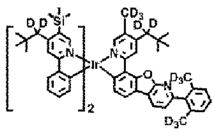
1437
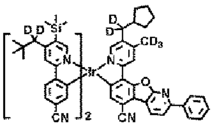
1438
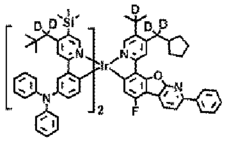
1439
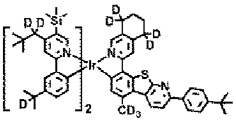
1440

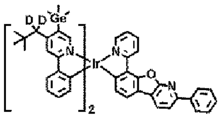
1441
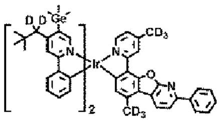
1442
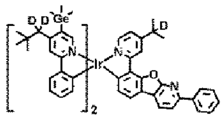
1443
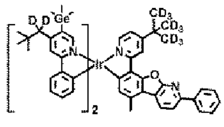
1444
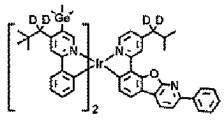
1445

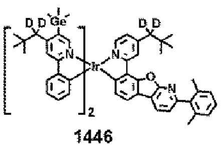
1446
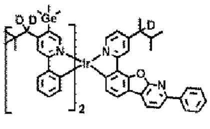
1447
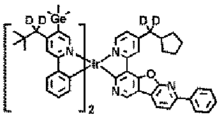
1448
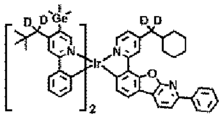
1449
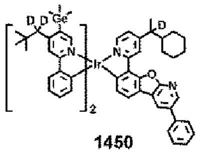
1450

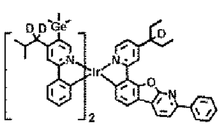
1451
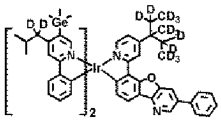
1452
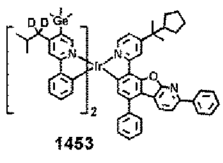
1453
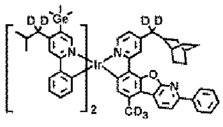
1454
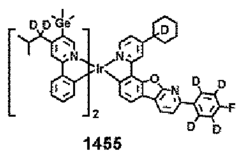
1455

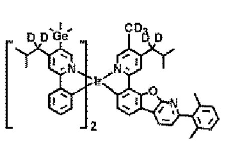
1456
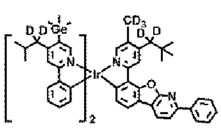
1457
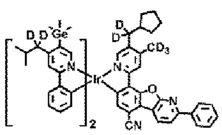
1458
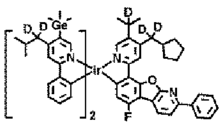
1459
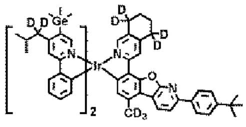
1460

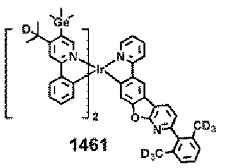
1461
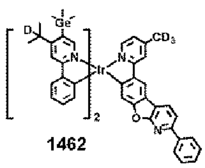
1462
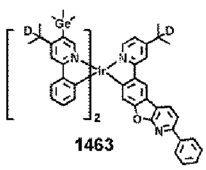
1463
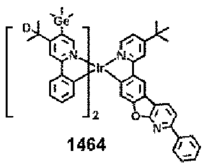
1464
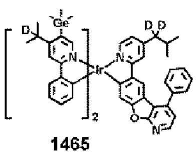
1465

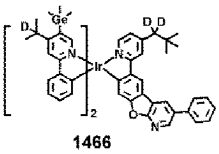
1466
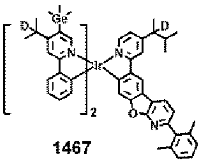
1467
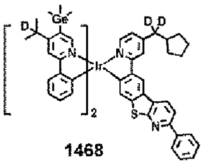
1468
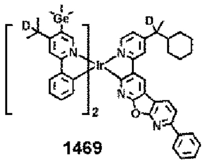
1469
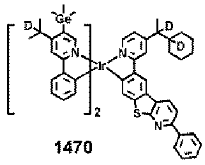
1470

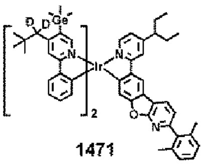
1471
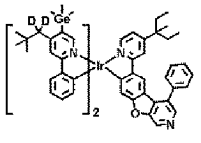
1472
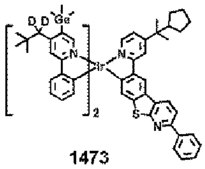
1473
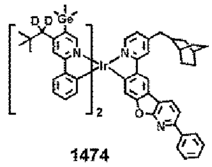
1474
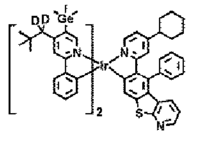
1475

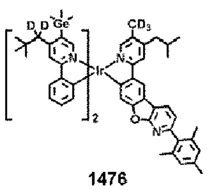
1476
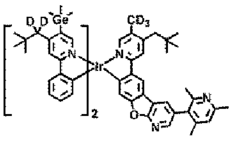
1477
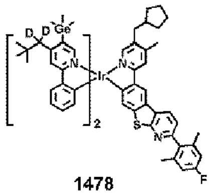
1478
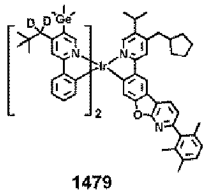
1479
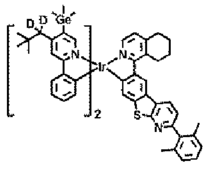
1480

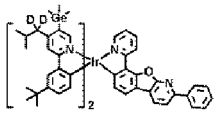
1481
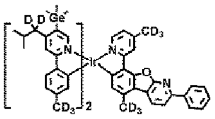
1482
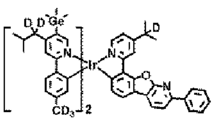
1483
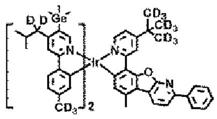
1484
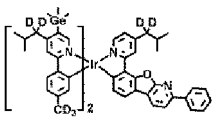
1485

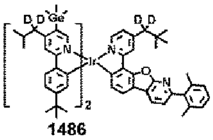
1486
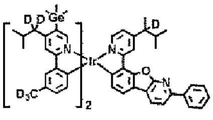
1487
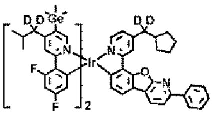
1488
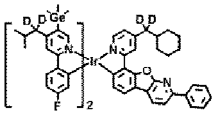
1489
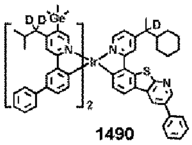
1490

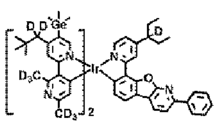
1491
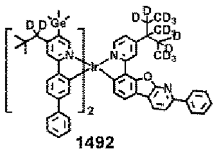
1492
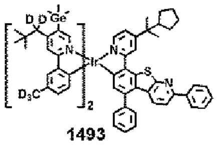
1493
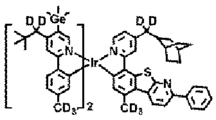
1494
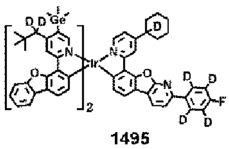
1495

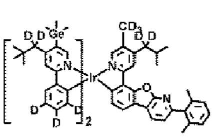
1496
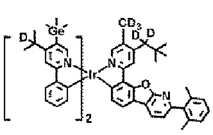
1497
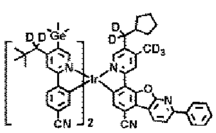
1498
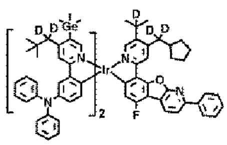
1499
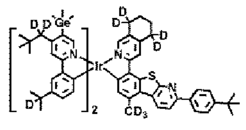
1500

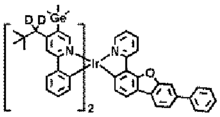
1501
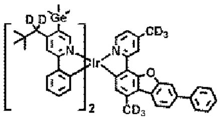
1502
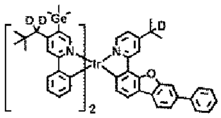
1503
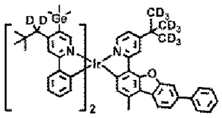
1504
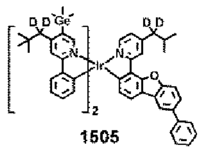
1505

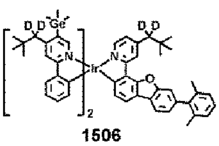
1506
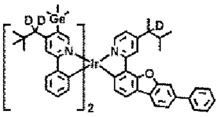
1507
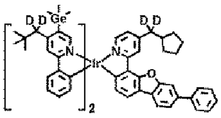
1508
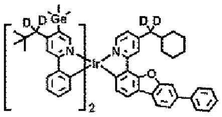
1509
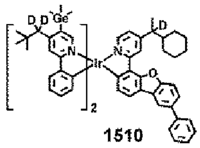
1510

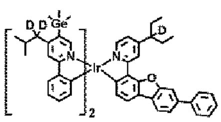
1511
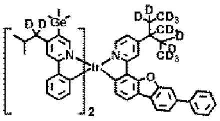
1512
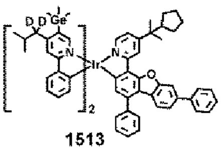
1513
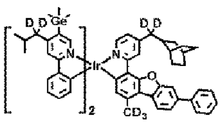
1514
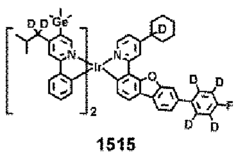
1515

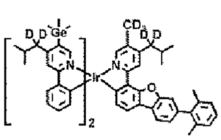
1516
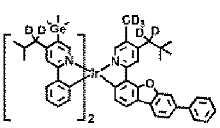
1517
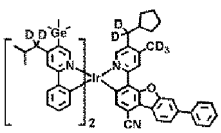
1518
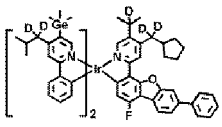
1519
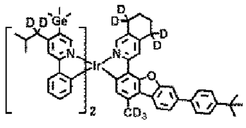
1520

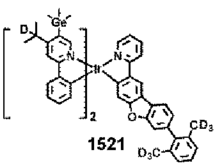
1521
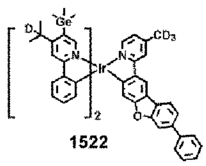
1522
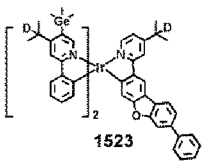
1523
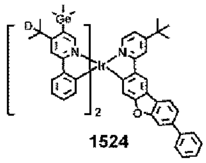
1524
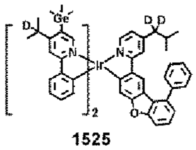
1525

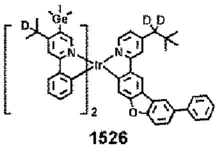
1526
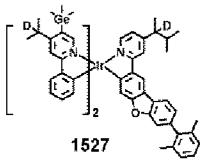
1527
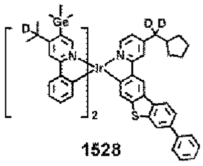
1528
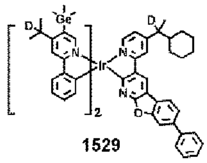
1529
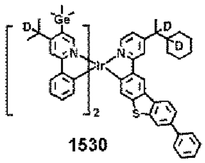
1530

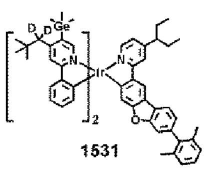
1531
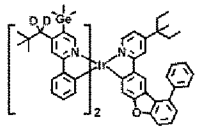
1532
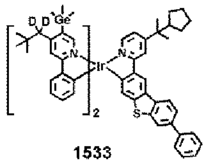
1533
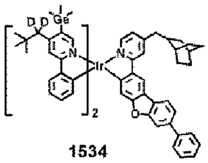
1534
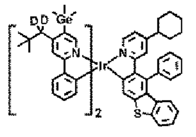
1535

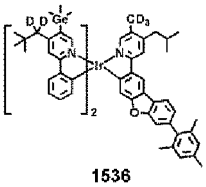
1536
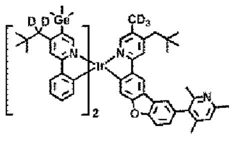
1537
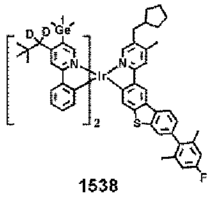
1538
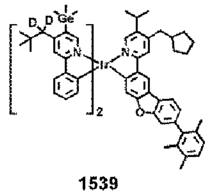
1539
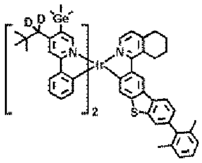
1540

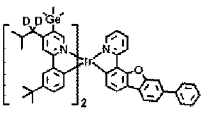
1541
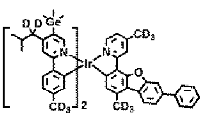
1542
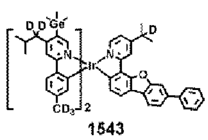
1543
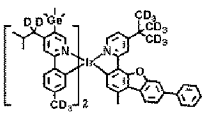
1544
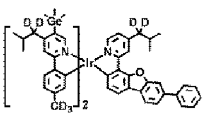
1545

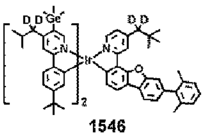
1546
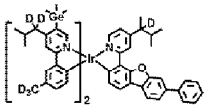
1547
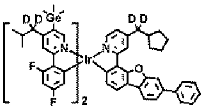
1548
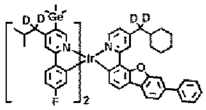
1549
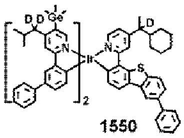
1550

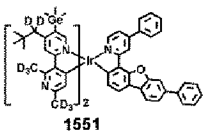
1551
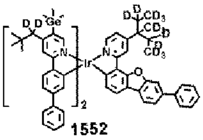
1552
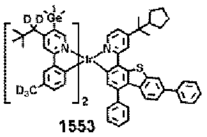
1553
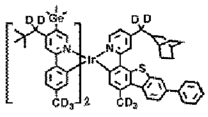
1554
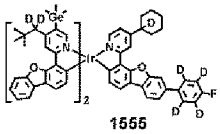
1555

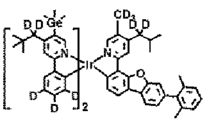
1556
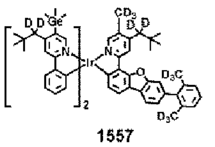
1557
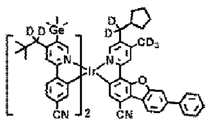
1558
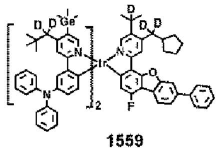
1559
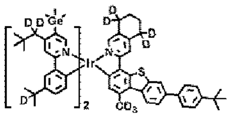
1560

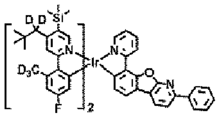
1561

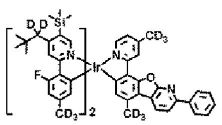
1562

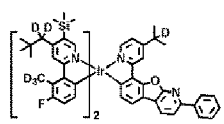
1563

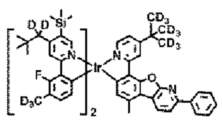
1564

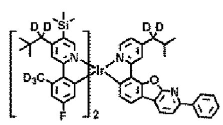
1565

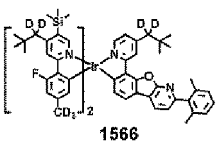
1566

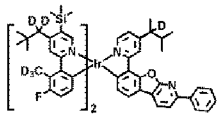
1567

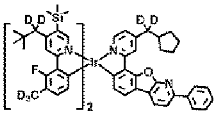
1568

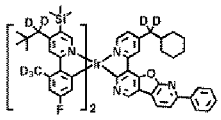
1569

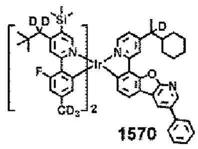
1570

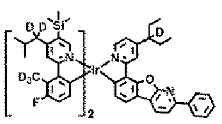
1571

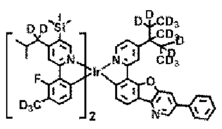
1572

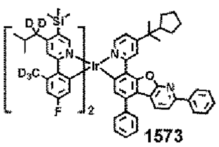
1573

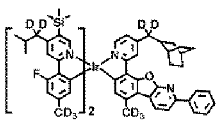
1574

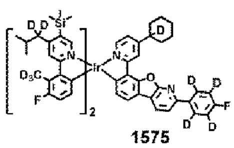
1575

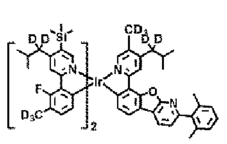
1576

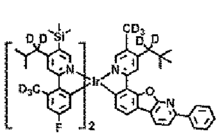
1577

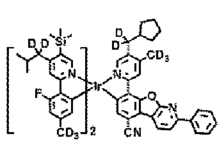
1578

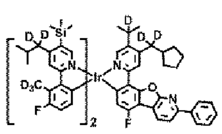
1579

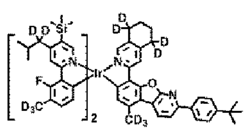
1580

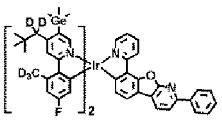
1581

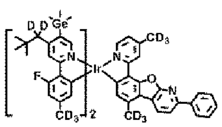
1582

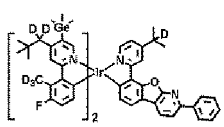
1583

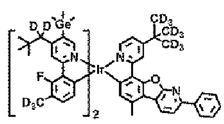
1584

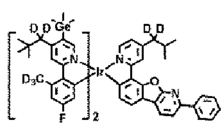
1585

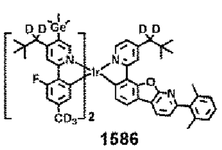
1586

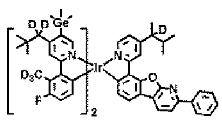
1587

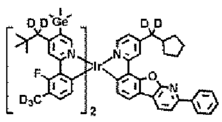
1588

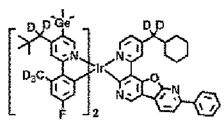
1589

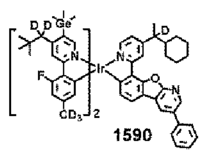
1590

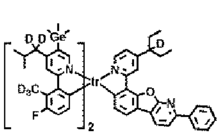
1591

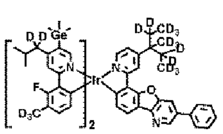
1592

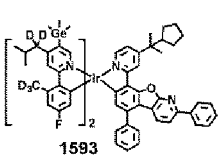
1593

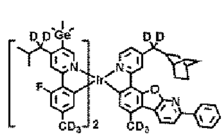
1594

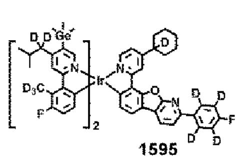
1595

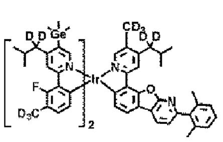
1596

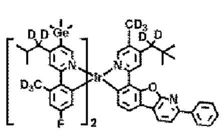
1597

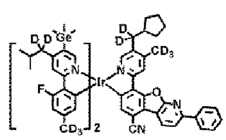
1598

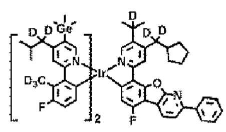
1599

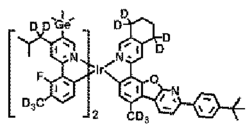
1600

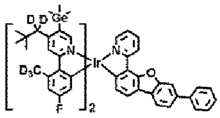
1601

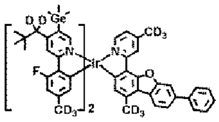
1602

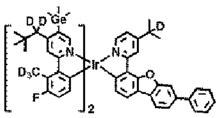
1603

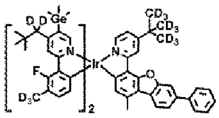
1604

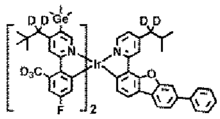
1605

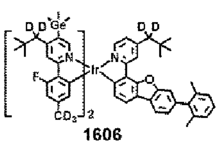
1606

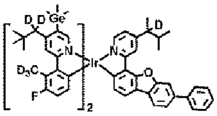
1607

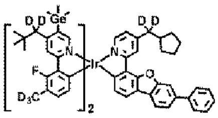
1608

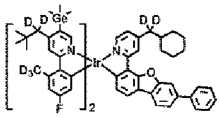
1609

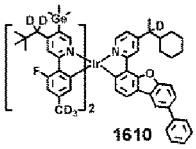
1610

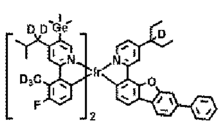
1611

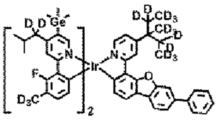
1612

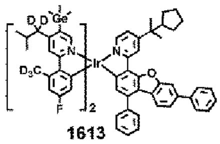
1613

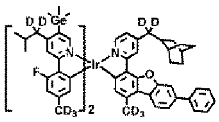
1614

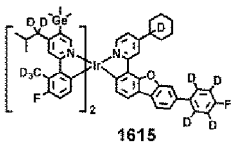
1615

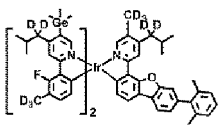
1616

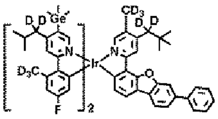
1617

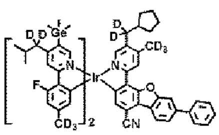
1618

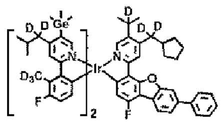
1619

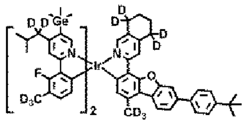
1620

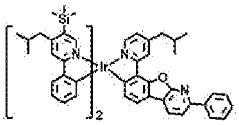
1621

wherein, in Compounds 1 to 1621 of Group G1-1, OMe indicates a methoxy group.

## Group G1-2

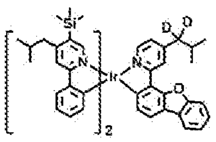
1

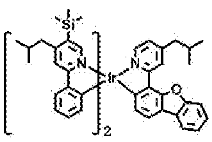
2

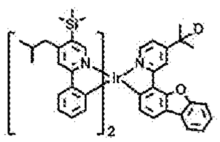
3

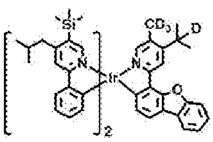
4

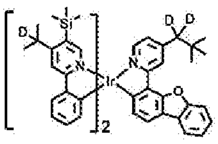
5

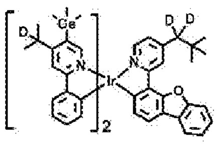
6

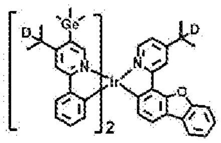
7

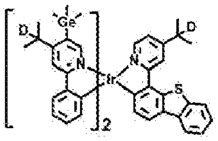
8

## Group G1-3

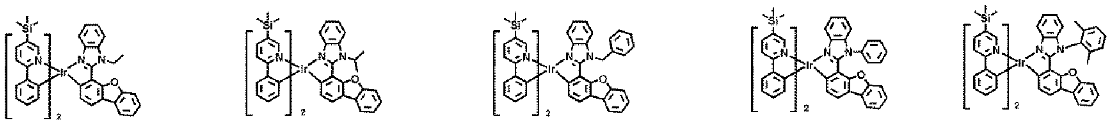
1 2 3 4 5

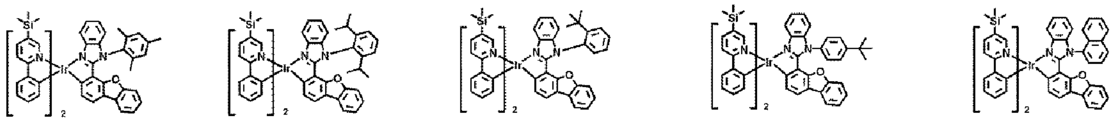
6 7 8 9 10

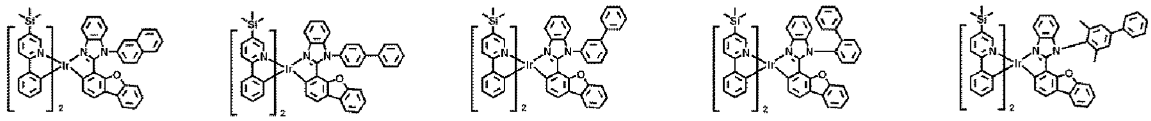
11 12 13 14 15

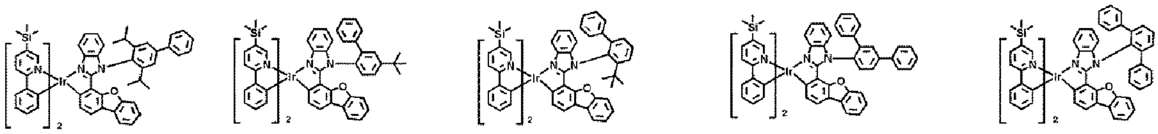
16 17 18 19 20

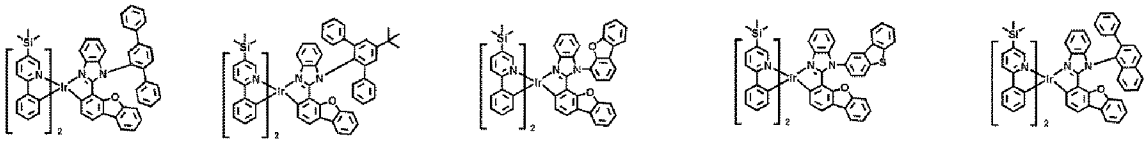
21 22 23 24 25

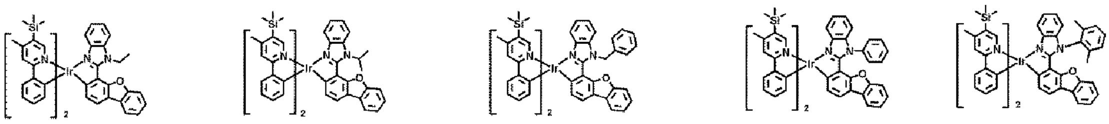
26 27 28 29 30

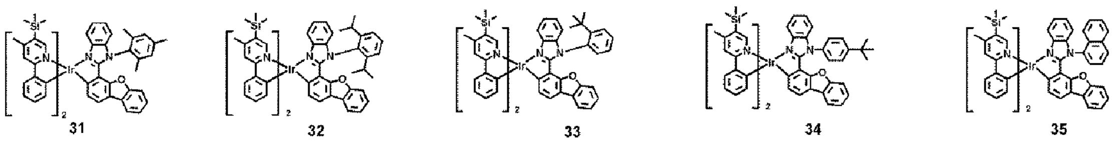
31 32 33 34 35

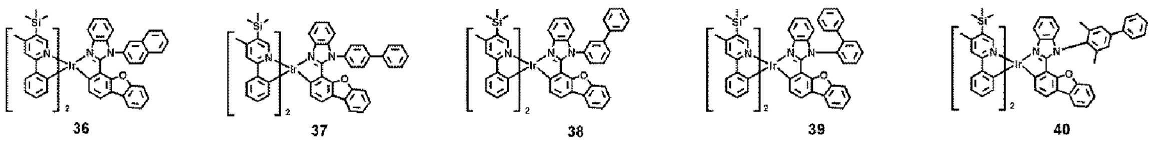
36 37 38 39 40

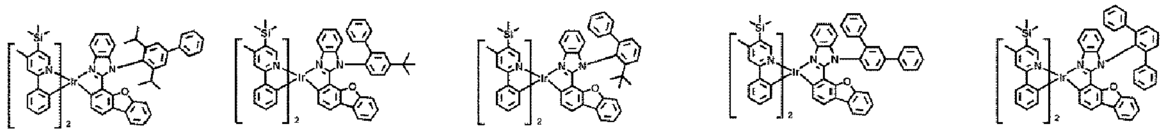
41 42 43 44 45

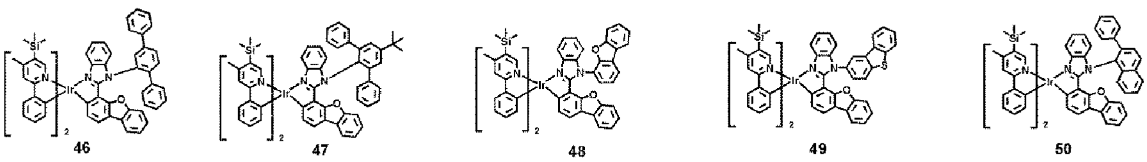
46 47 48 49 50

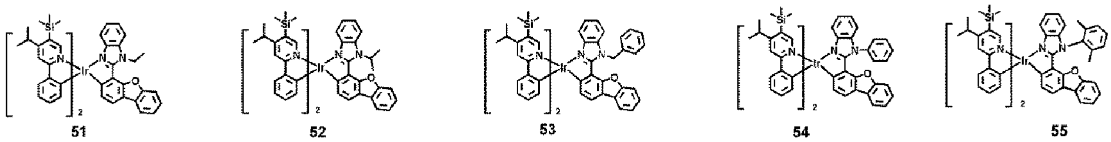
51 52 53 54 55

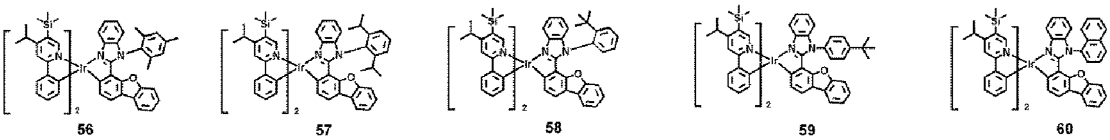
56 57 58 59 60

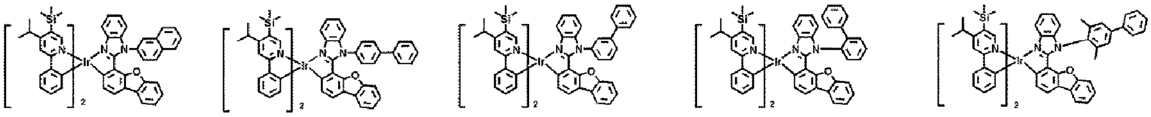
61 62 63 64 65

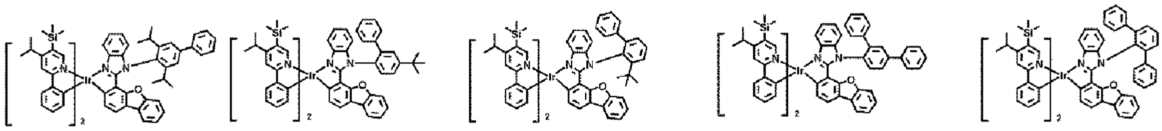
66 67 68 69 70

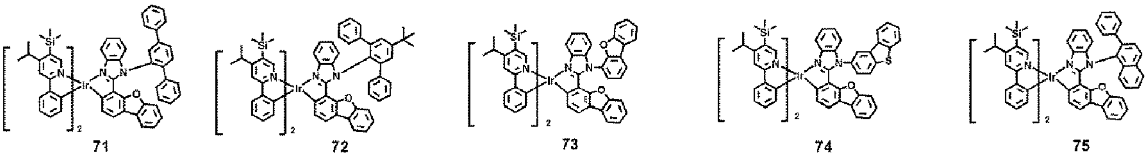
71 72 73 74 75

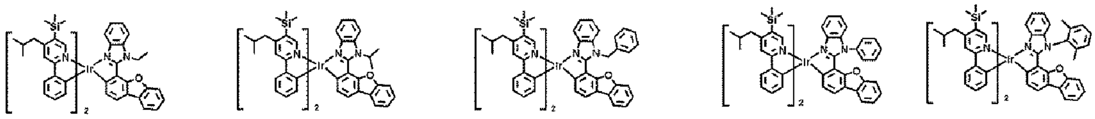
76 77 78 79 80

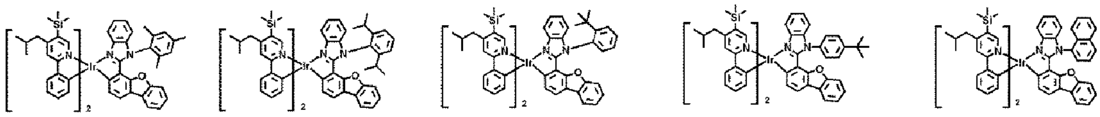
81 82 83 84 85

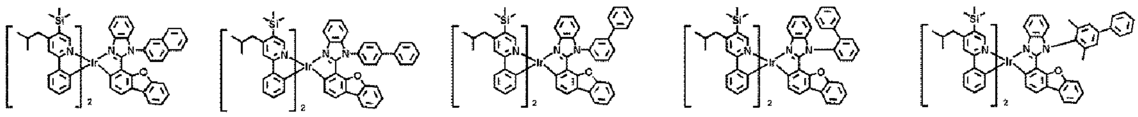
86 87 88 89 90

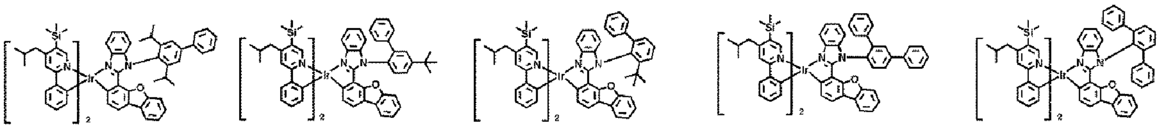
91 92 93 94 95

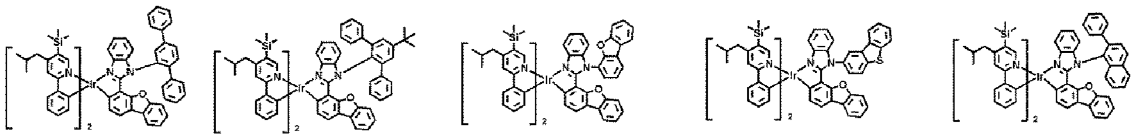
96 97 98 99 100

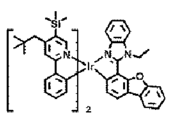
101
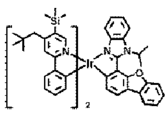
102
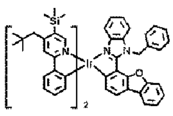
103
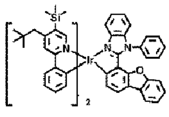
104
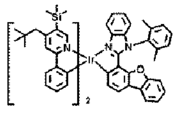
105

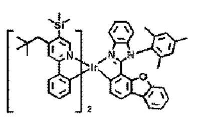
106
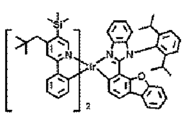
107
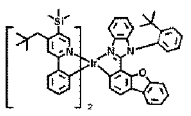
108
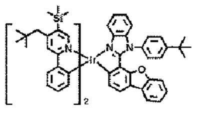
109
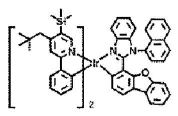
110

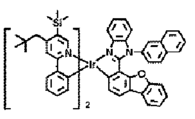
111
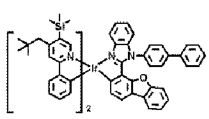
112
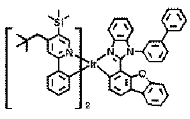
113
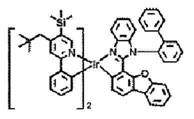
114
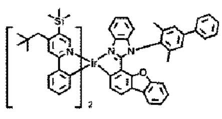
115

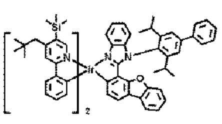
116
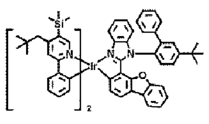
117
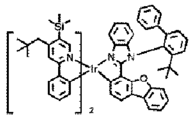
118
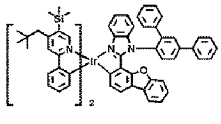
119
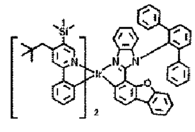
120

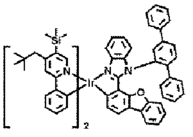
121
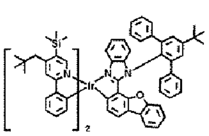
122
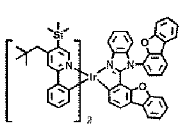
123
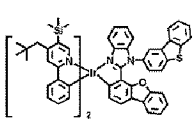
124
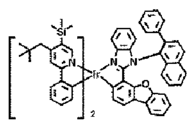
125

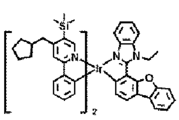
126
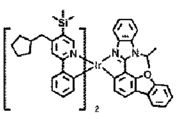
127
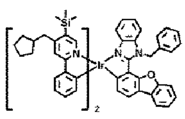
128
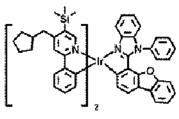
129
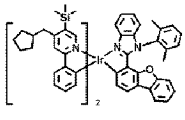
130

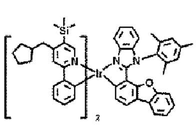
131
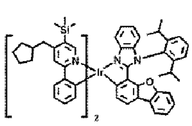
132
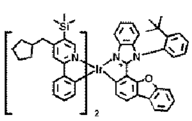
133
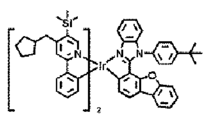
134
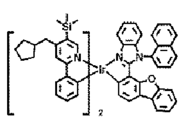
135

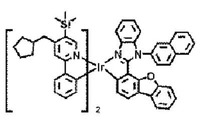
136
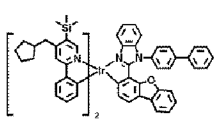
137
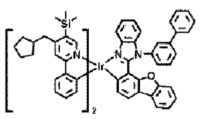
138
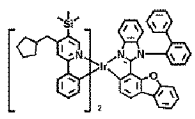
139
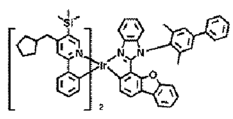
140

141
142
143
144
145

146
147
148
149
150

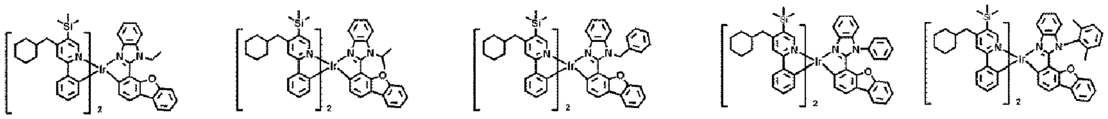
151 152 153 154 155

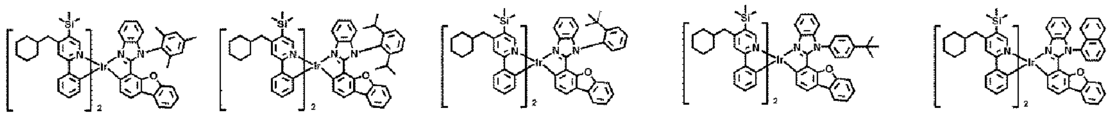
156 157 158 159 160

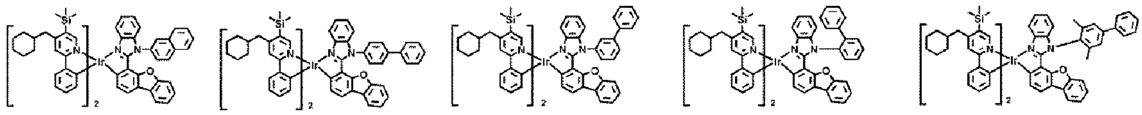
161 162 163 164 165

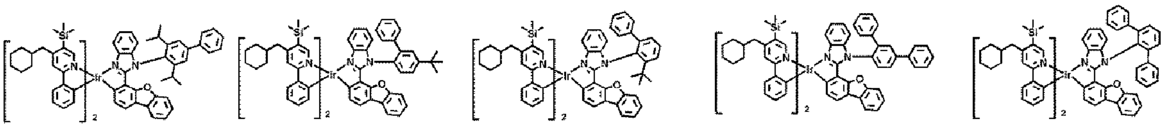
166 167 168 169 170

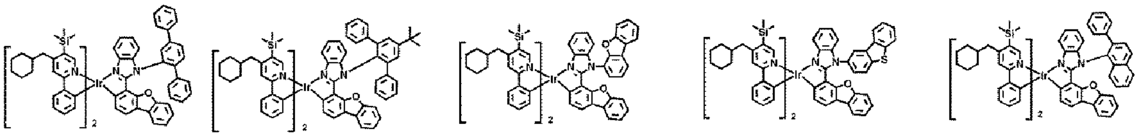
171 172 173 174 175

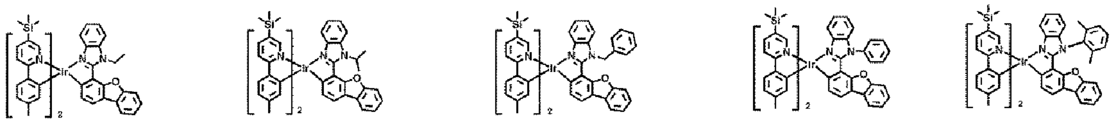
176 177 178 179 180

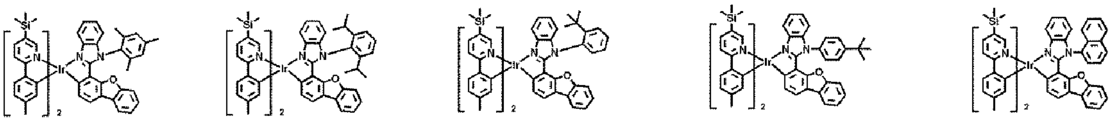
181 182 183 184 185

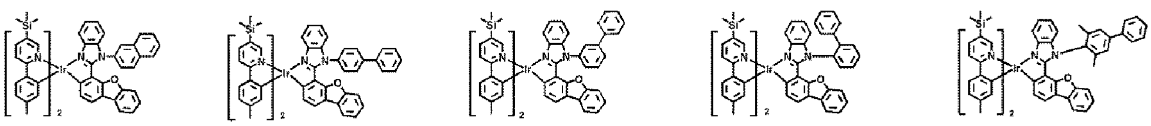
186 187 188 189 190

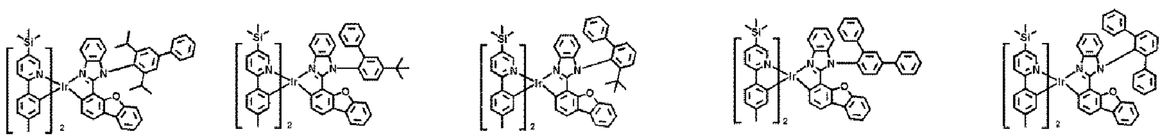
191 192 193 194 195

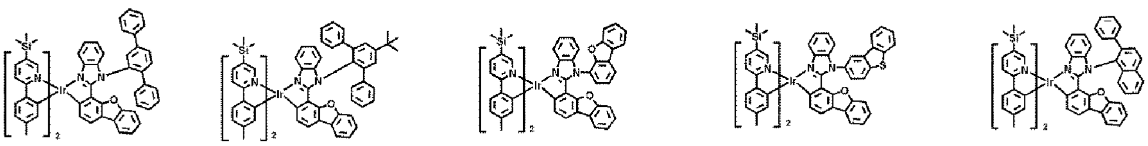
196 197 198 199 200

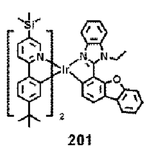
201
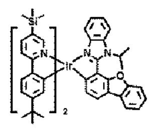
202
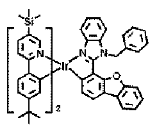
203
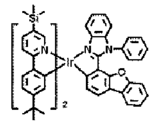
204
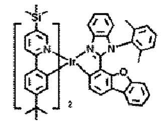
205
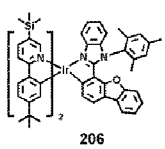
206
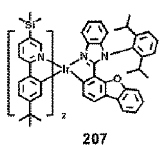
207
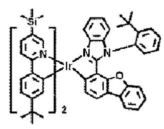
208
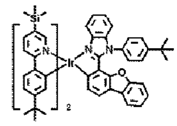
209
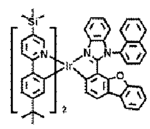
210
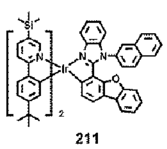
211
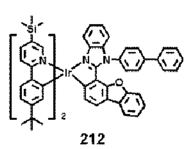
212
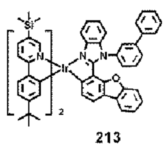
213
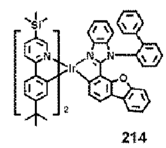
214
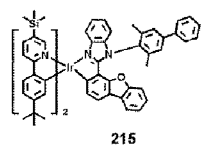
215
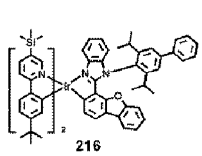
216
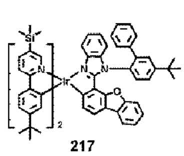
217
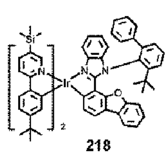
218
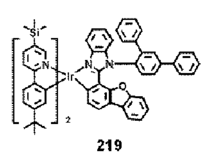
219
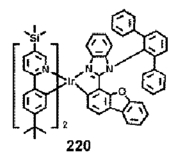
220
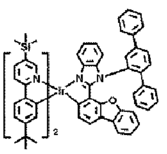
221
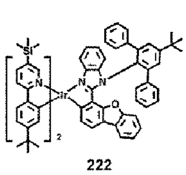
222
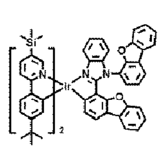
223
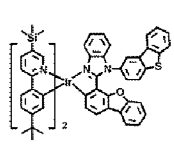
224
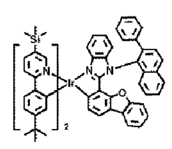
225
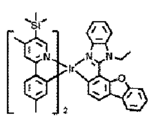
226
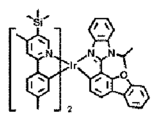
227
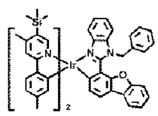
228
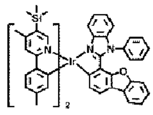
229
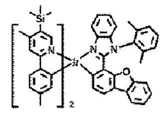
230
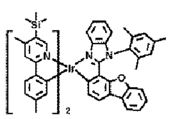
231
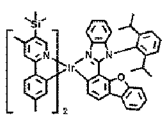
232
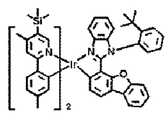
233
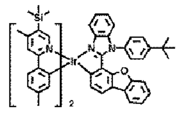
234
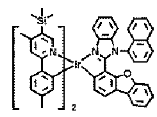
235
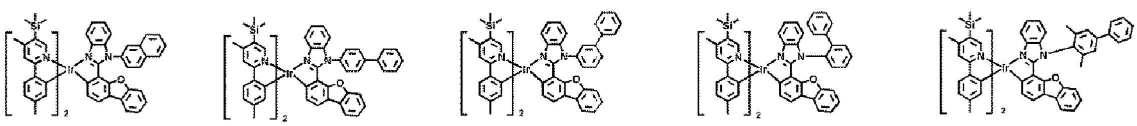
236 237 238 239 240
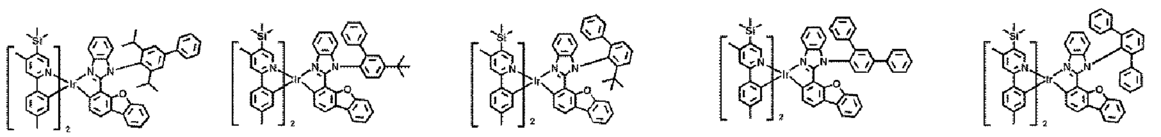
241 242 243 244 245
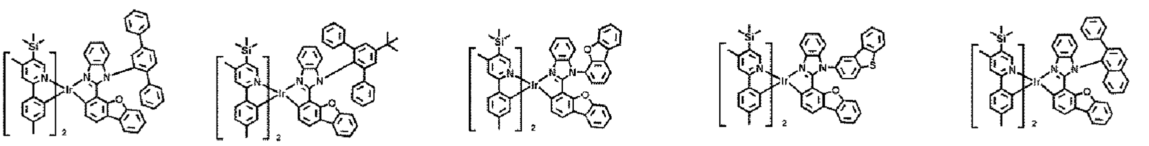
246 247 248 249 250

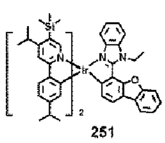
251

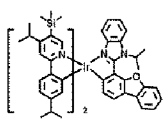
252

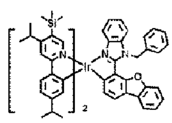
253

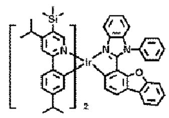
254

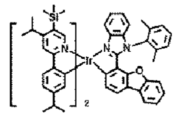
255

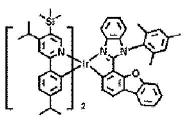
256

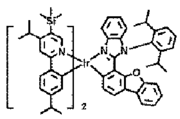
257

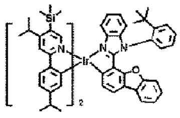
258

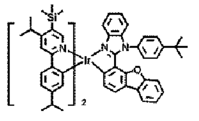
259

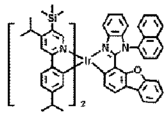
260

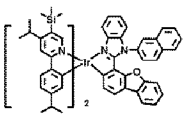
261

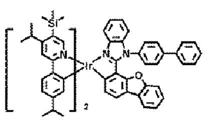
262

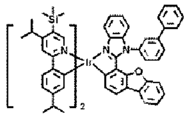
263

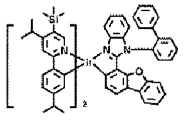
264

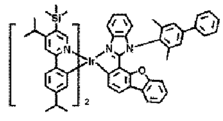
265

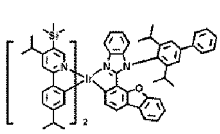
266

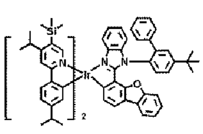
267

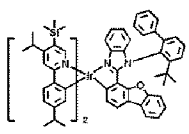
268

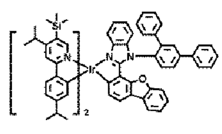
269

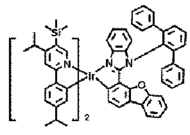
270

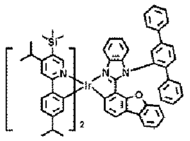
271

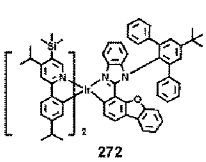
272

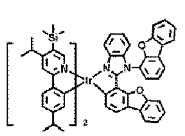
273

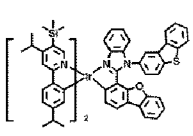
274

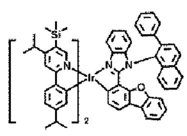
275

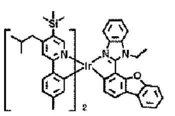
276

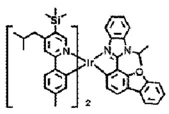
277

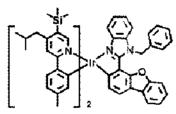
278

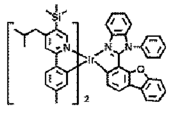
279

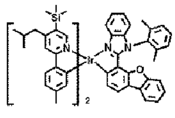
280

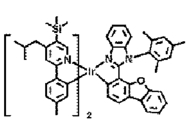
281

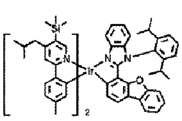
282

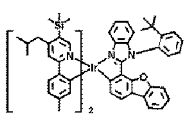
283

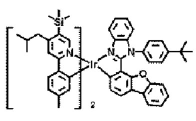
284

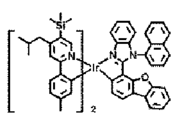
285

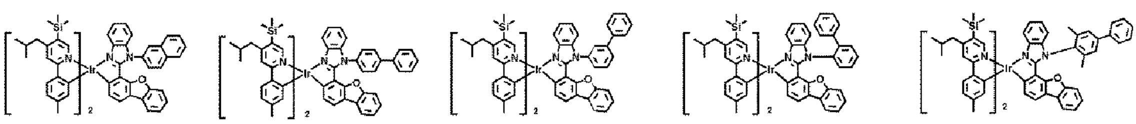
286 287 288 289 290

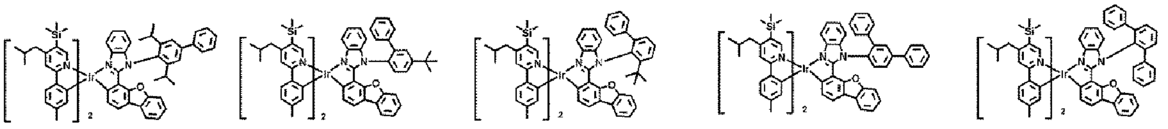
291 292 293 294 295

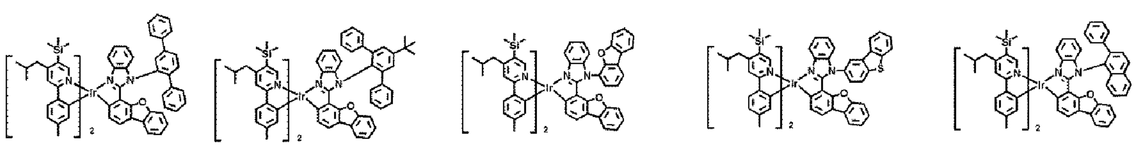
296 297 298 299 300

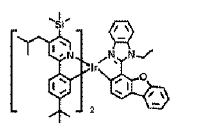
301

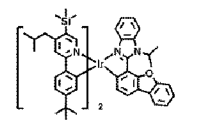
302

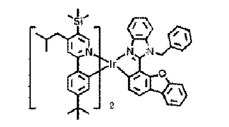
303

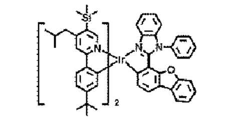
304

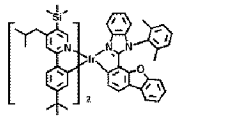
305

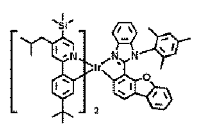
306

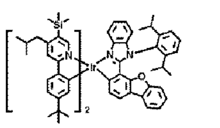
307

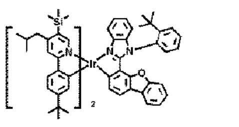
308

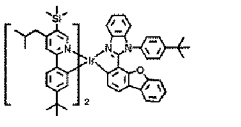
309

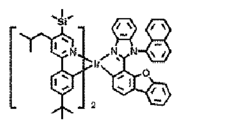
310

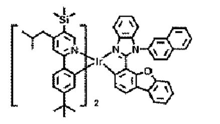
311

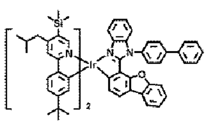
312

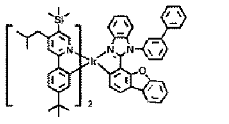
313

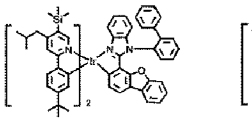
314

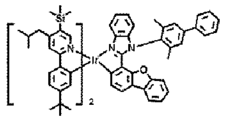
315

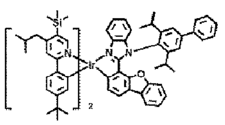
316

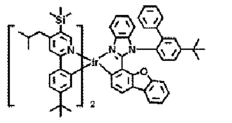
317

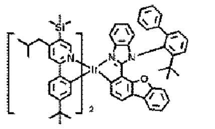
318

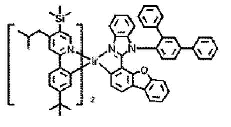
319

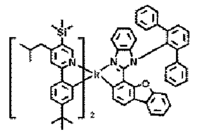
320

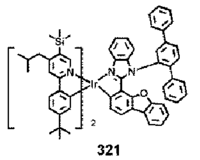
321

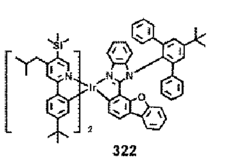
322

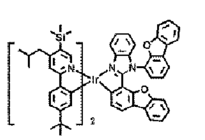
323

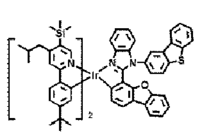
324

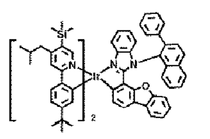
325

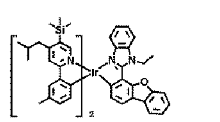
326

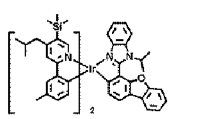
327

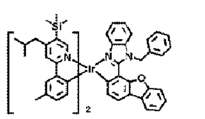
328

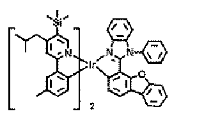
329

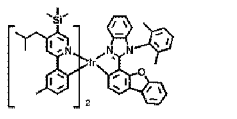
330

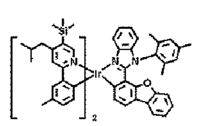
331

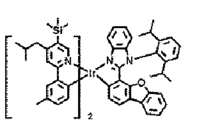
332

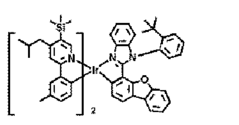
333

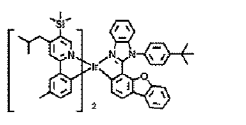
334

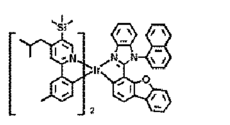
335

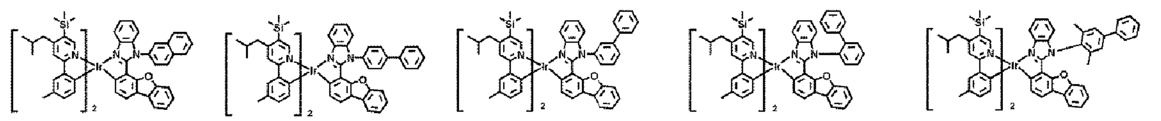
336 337 338 339 340

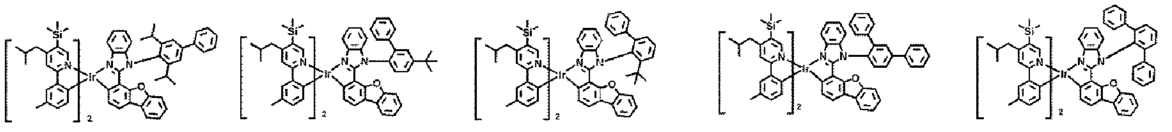
341 342 343 343 345

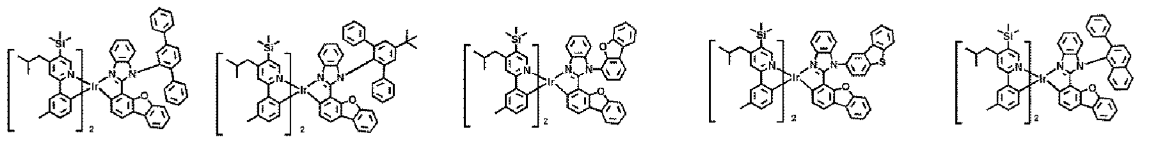
346 347 348 349 350

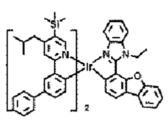
351
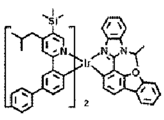
352
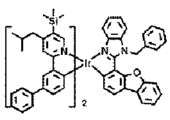
353
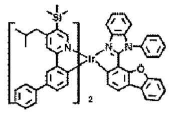
354
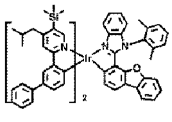
355

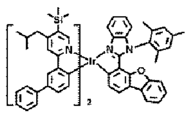
356
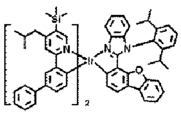
357
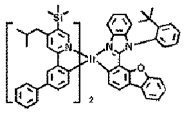
358
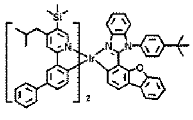
359
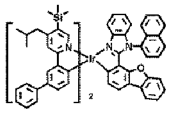
360

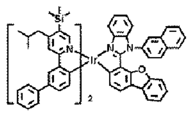
361
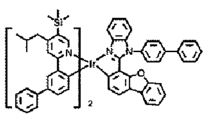
362
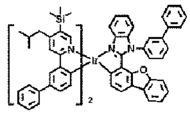
363
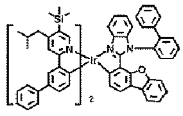
364
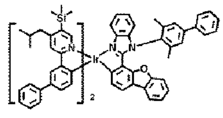
365

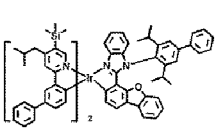
366
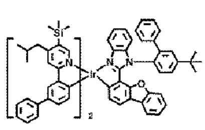
367
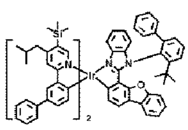
368
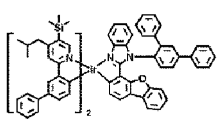
369
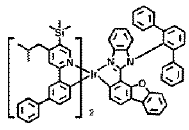
370

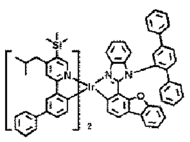
371
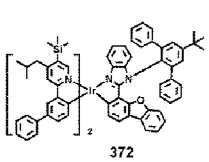
372
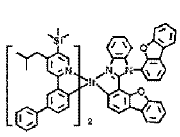
373
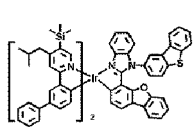
374
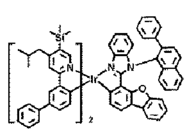
375

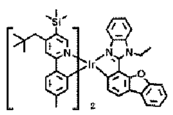
376
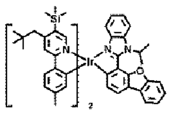
377
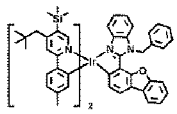
378
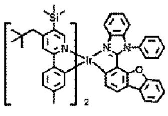
379
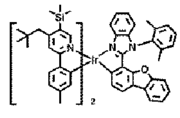
380

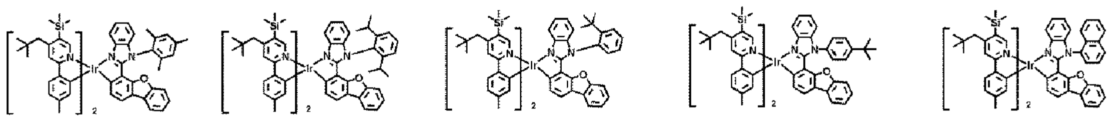
381 382 383 384 385

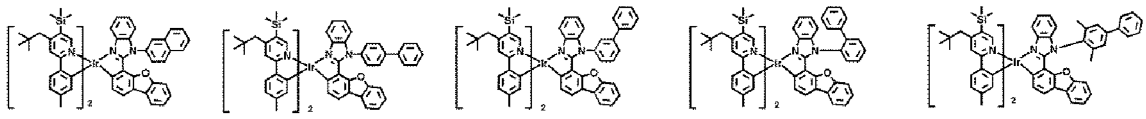
386 387 388 389 390

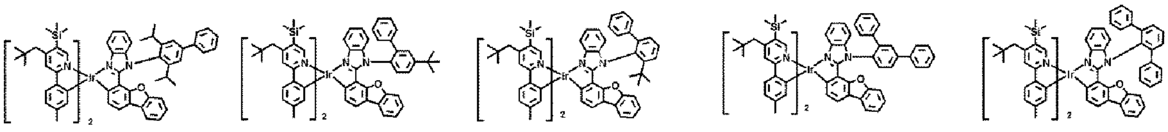
391 392 393 394 395

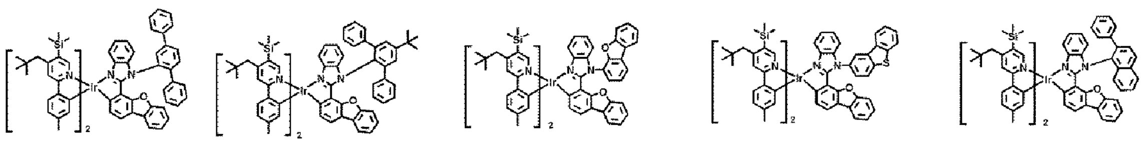
396 397 398 399 400

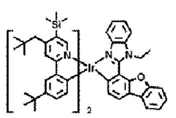
401
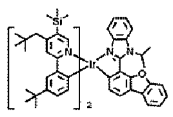
402
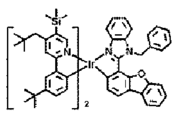
403
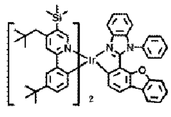
404
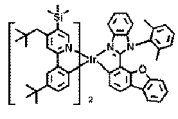
405
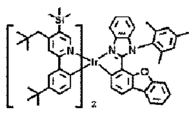
406
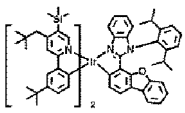
407
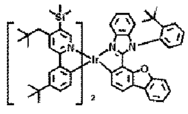
408
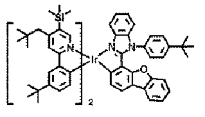
409
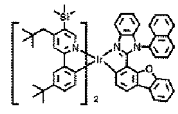
410
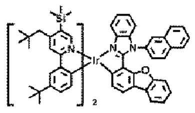
411
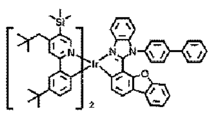
412
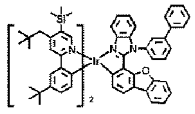
413
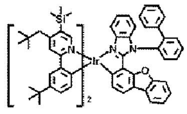
414
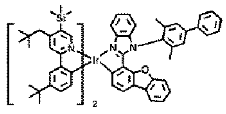
415
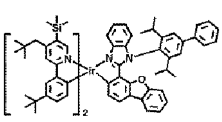
416
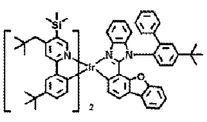
417
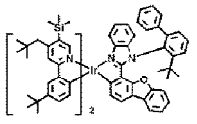
418
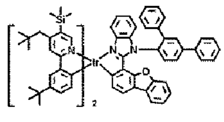
419
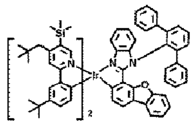
420
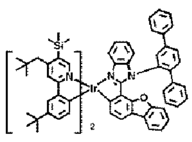
421
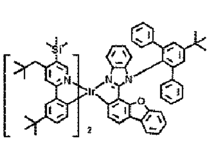
422
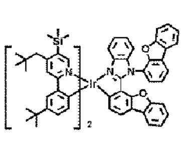
423
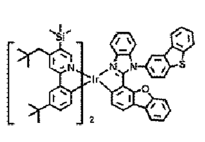
424
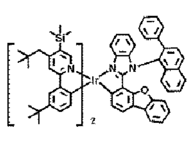
425
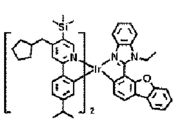
426
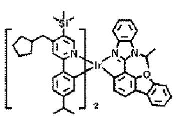
427
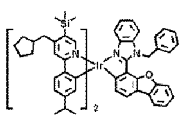
428
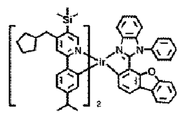
429
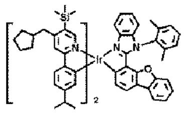
430
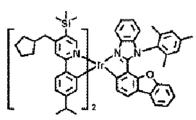
431
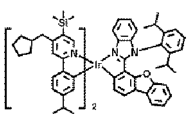
432
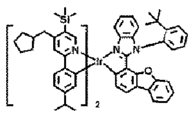
433
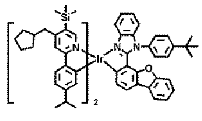
434
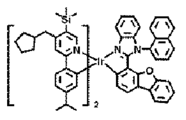
435
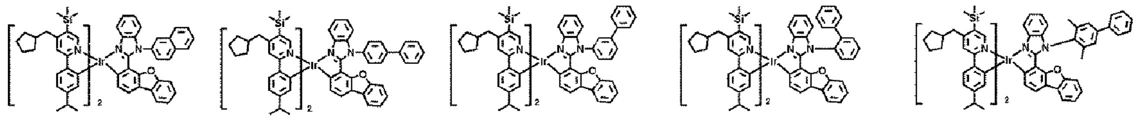
436
437
438
439
440
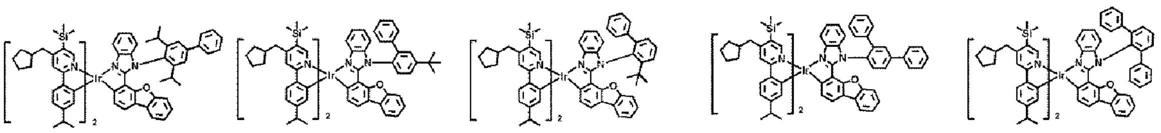
441
442
443
444
445
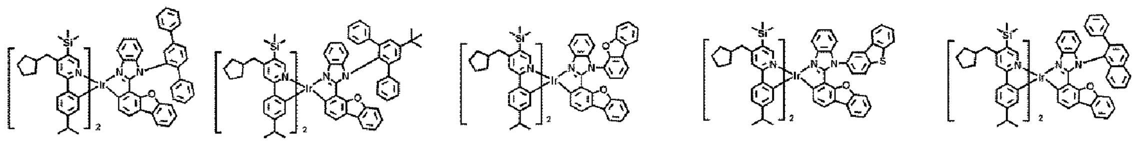
446
447
448
449
450

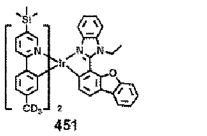
451
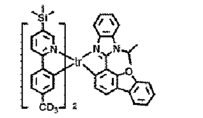
452
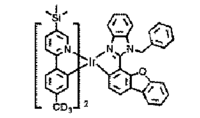
453
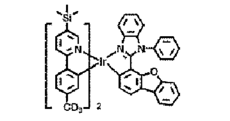
454
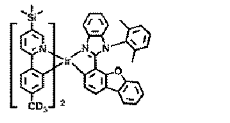
455
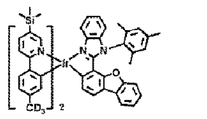
456
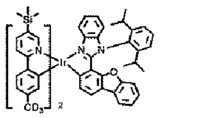
457
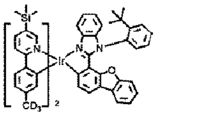
458
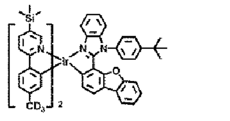
459
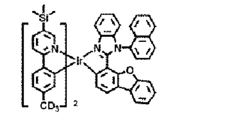
460
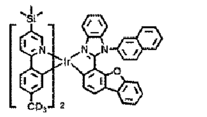
461
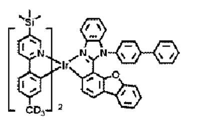
462
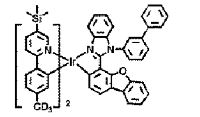
463
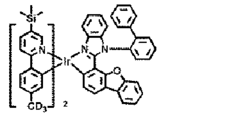
464
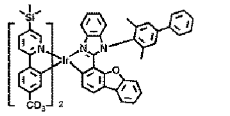
465
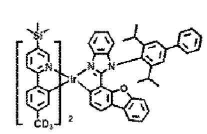
466
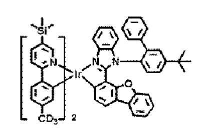
467
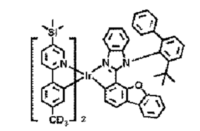
468
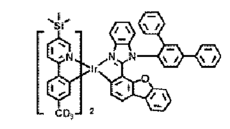
469
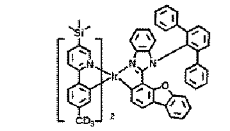
470
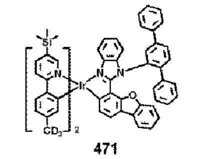
471
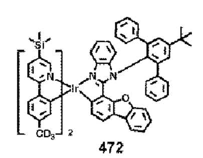
472
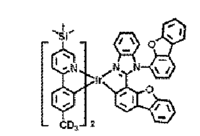
473
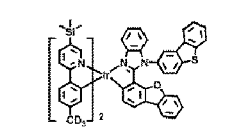
474
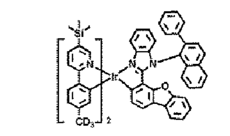
475
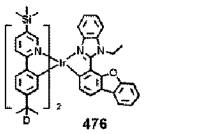
476
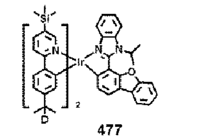
477
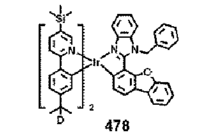
478
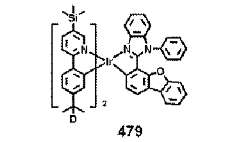
479
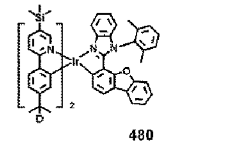
480
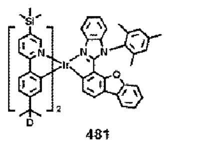
481
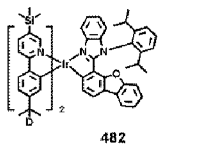
482
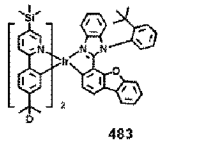
483
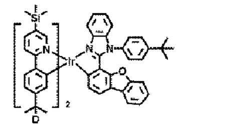
484
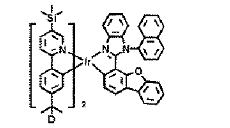
485
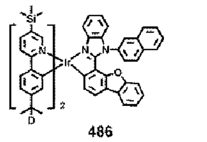
486
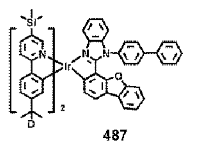
487
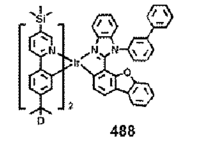
488
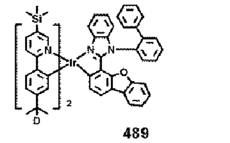
489
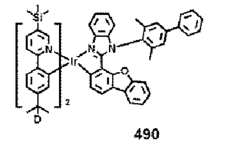
490
491
492
493
494
495
496
497
498
499
500

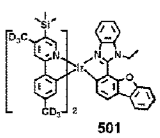
501

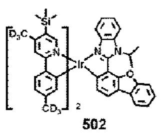
502

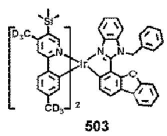
503

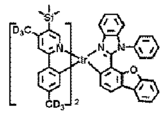
504

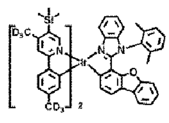
505

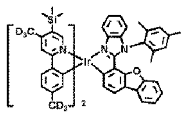
506

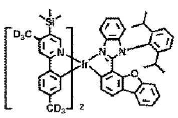
507

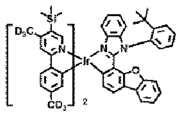
508

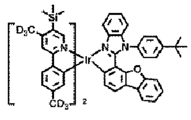
509

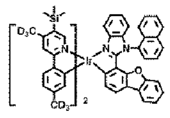
510

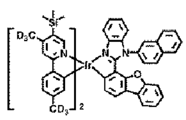
511

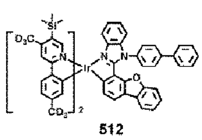
512

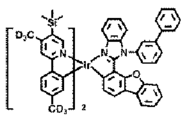
513

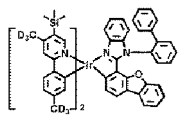
514

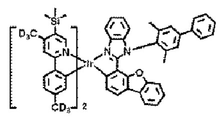
515

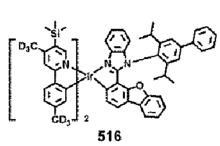
516

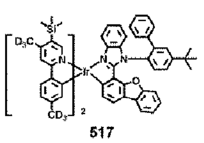
517

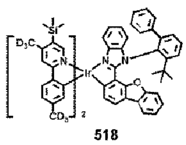
518

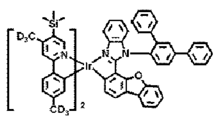
519

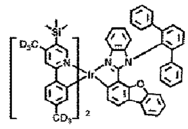
520

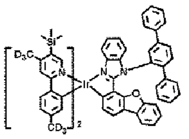
521

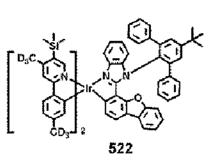
522

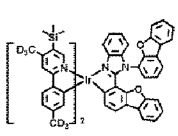
523

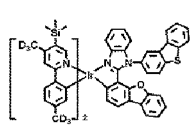
524

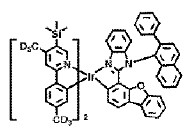
525

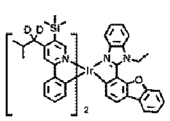
526

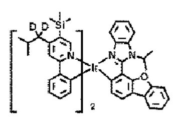
527

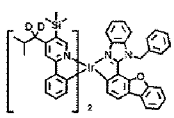
528

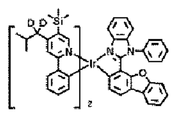
529

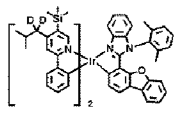
530

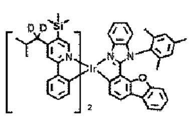
531

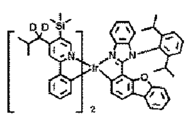
532

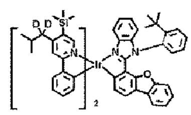
533

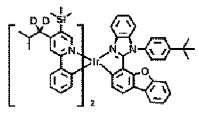
534

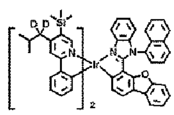
535

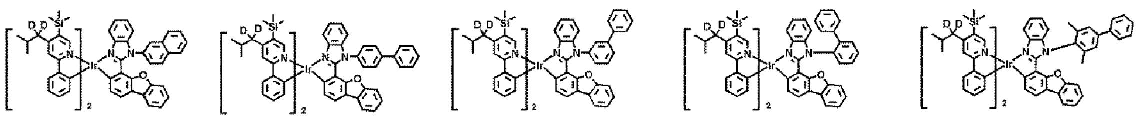
536 537 538 539 540

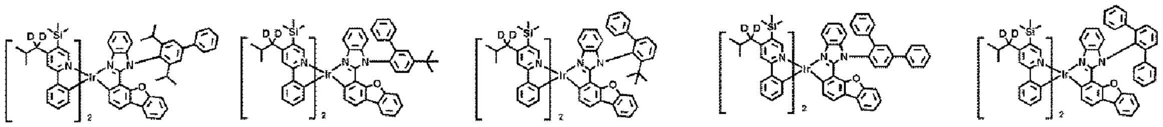
541 542 543 544 545

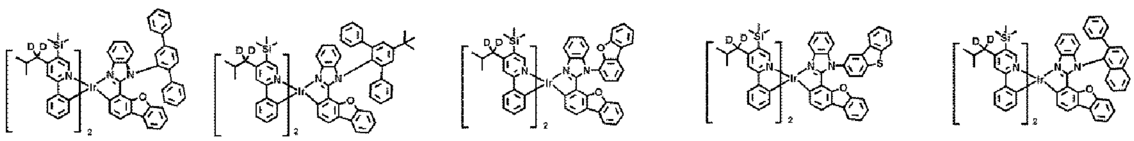
546 547 548 549 550

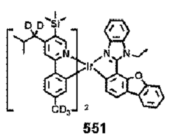
551
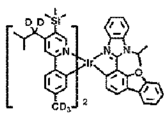
552
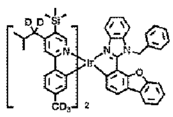
553
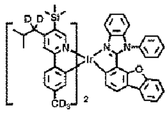
554
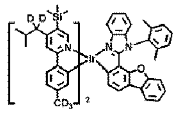
555
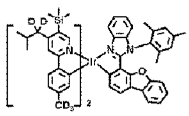
556
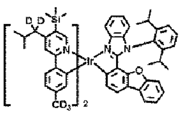
557
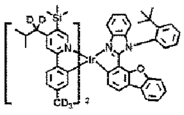
558
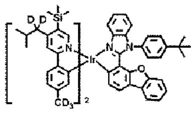
559
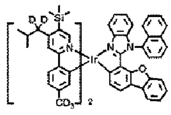
560
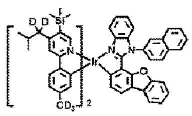
561
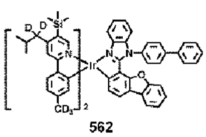
562
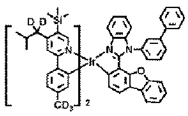
563
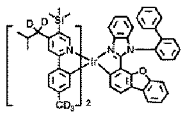
564
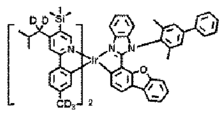
565
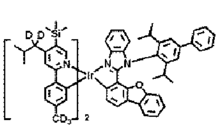
566
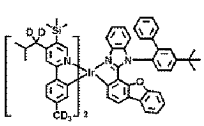
567
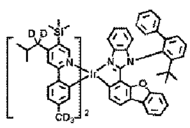
568
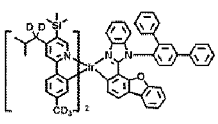
569
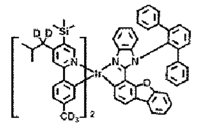
570
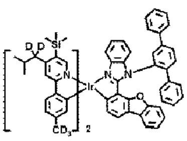
571
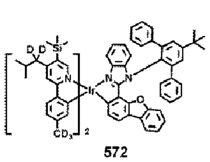
572
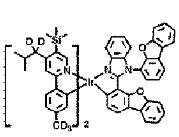
573
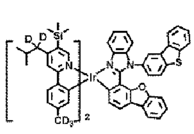
574
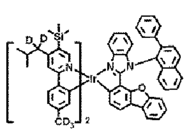
575
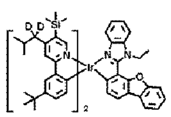
576
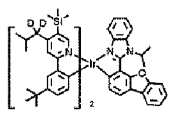
577
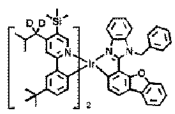
578
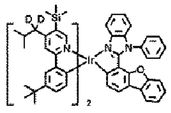
579
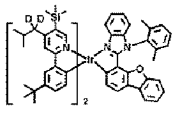
580
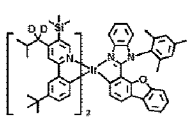
581
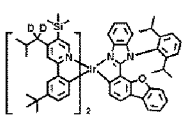
582
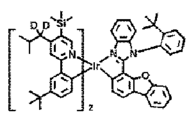
583
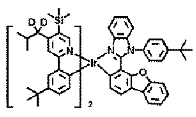
584
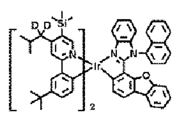
585
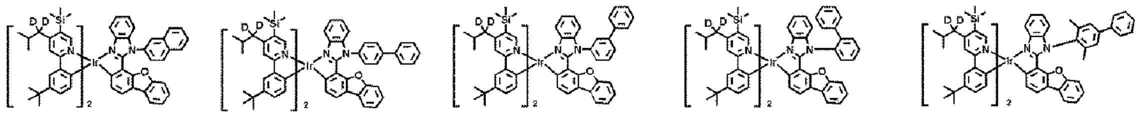
586 587 588 589 590
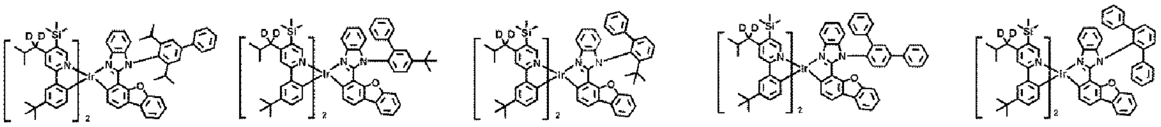
591 592 593 594 595
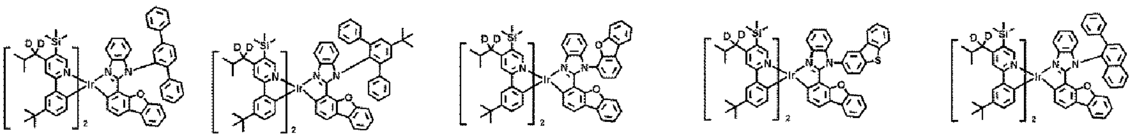
596 597 598 599 600

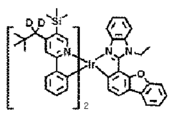
601
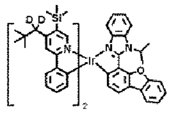
602
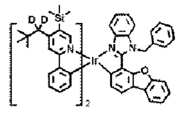
603
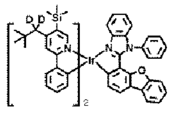
604
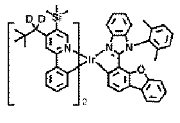
605
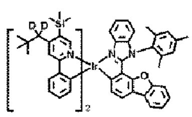
606
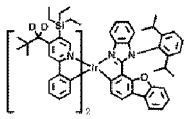
607
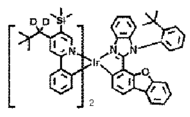
608
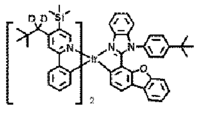
609
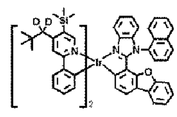
610
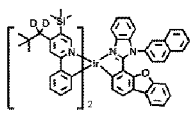
611
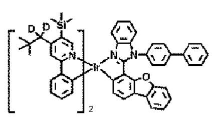
612
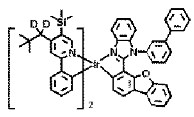
613
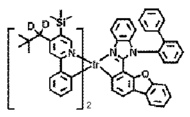
614
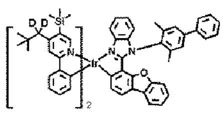
615
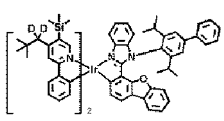
616
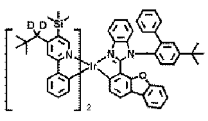
617
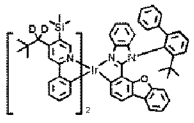
618
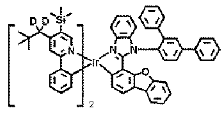
619
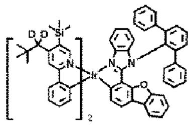
620
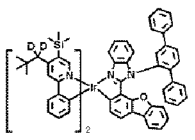
621
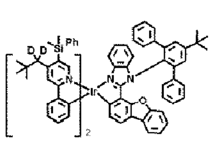
622
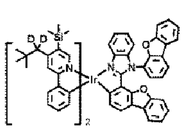
623
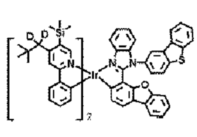
624
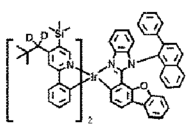
625
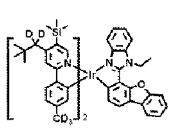
626
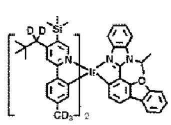
627
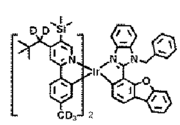
628
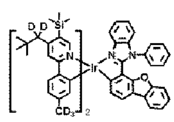
629
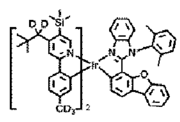
630
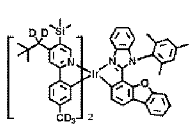
631
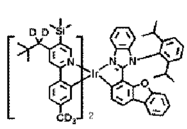
632
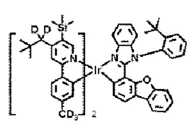
633
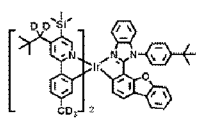
634
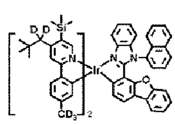
635
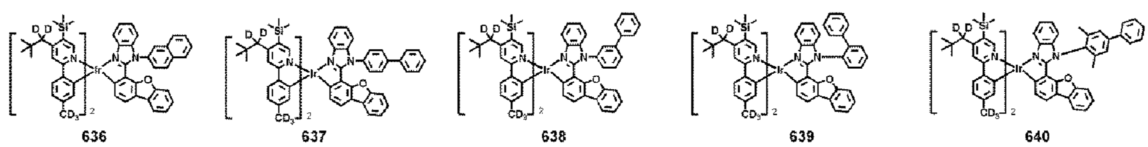
636 637 638 639 640
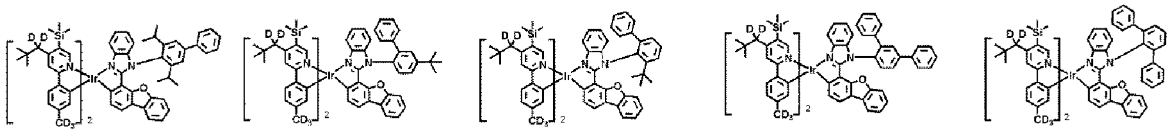
641 642 643 644 645
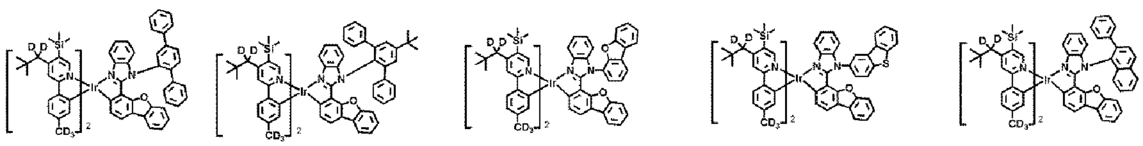
646 647 648 649 650

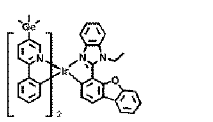
651
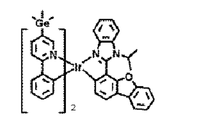
652
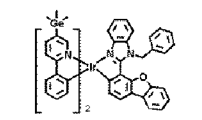
653
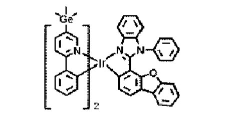
654
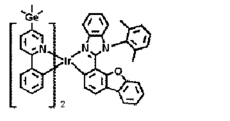
655
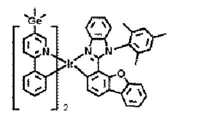
656
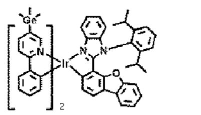
657
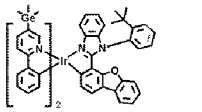
658
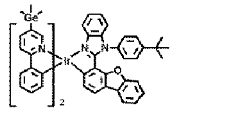
659
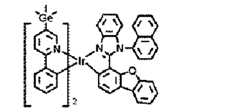
660
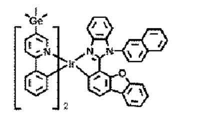
661
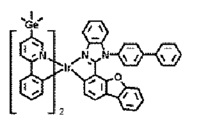
662
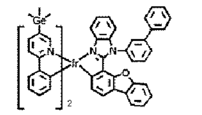
663
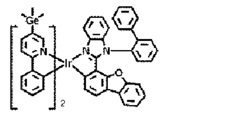
664
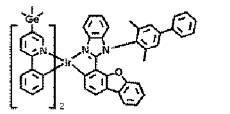
665
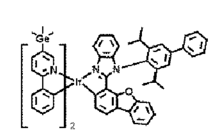
666
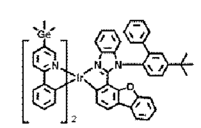
667
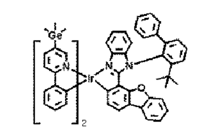
668
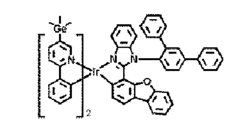
669
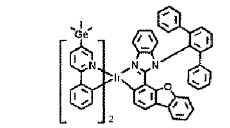
670
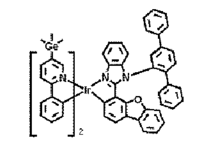
671
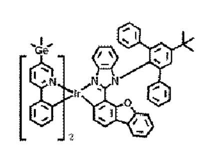
672
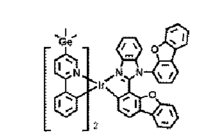
673
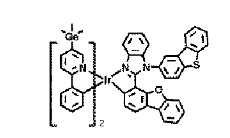
674
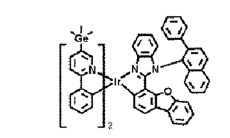
675
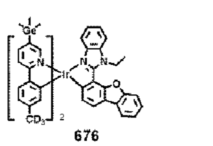
676
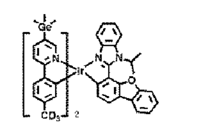
677
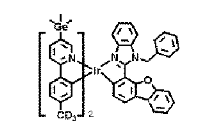
678
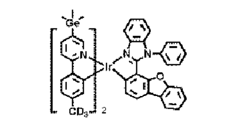
679
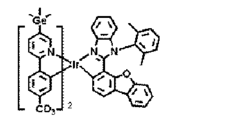
680
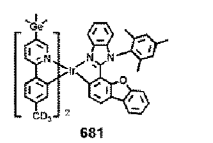
681
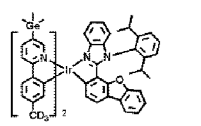
682
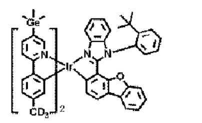
683
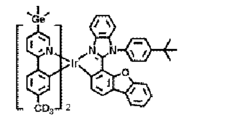
684
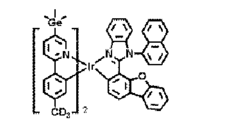
685
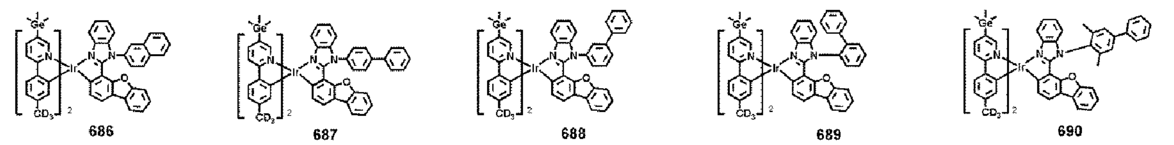
686 687 688 689 690
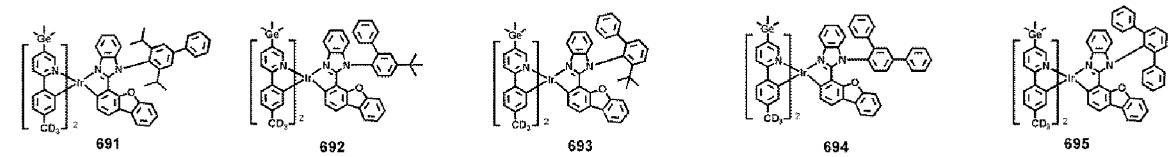
691 692 693 694 695
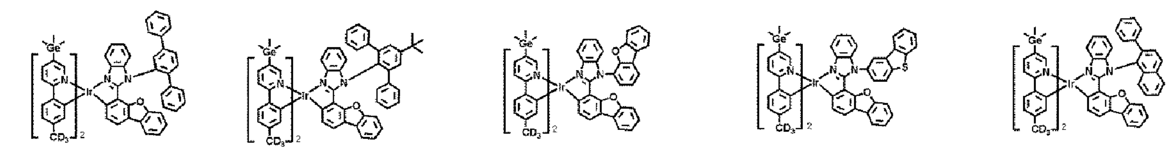
696 697 698 699 700

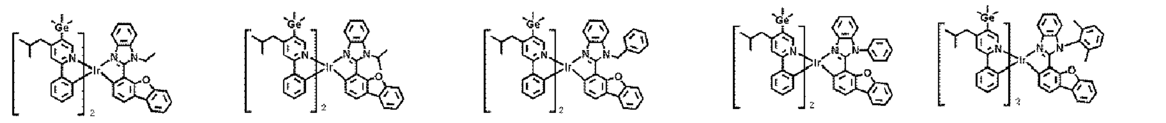

701 702 703 704 705

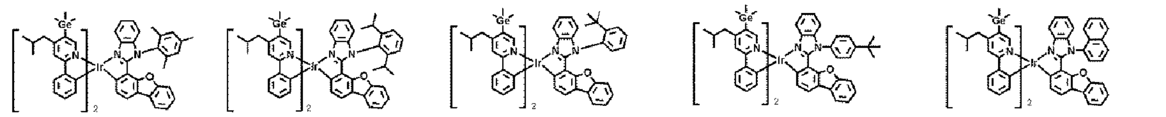

706 707 708 709 710

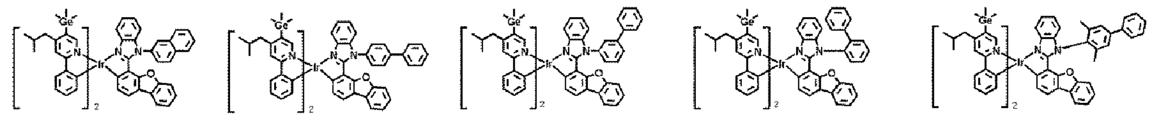

711 712 713 714 715

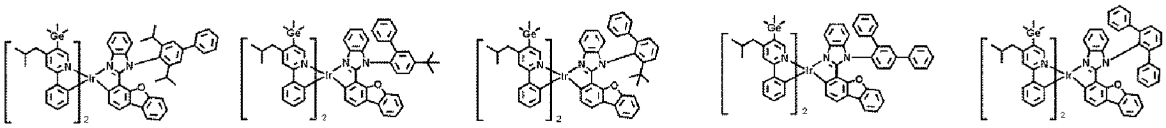

716 717 718 719 720

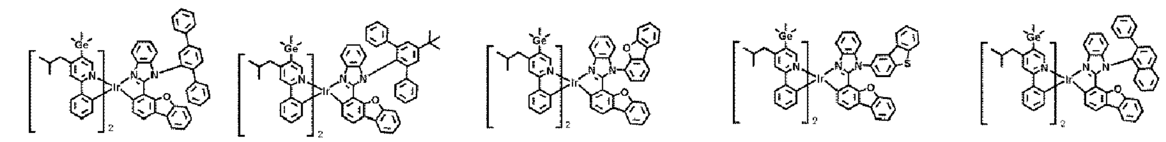

721 722 723 724 725

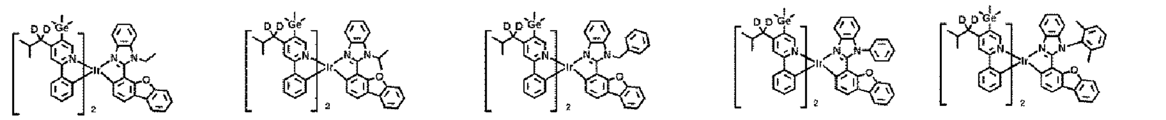

726 727 728 729 730

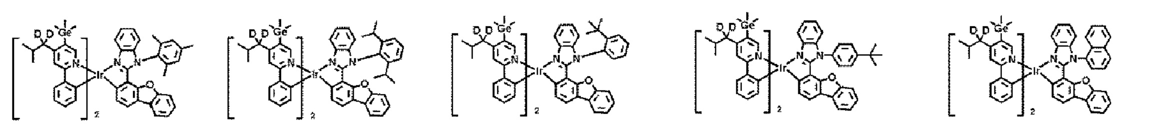

731 732 733 734 735

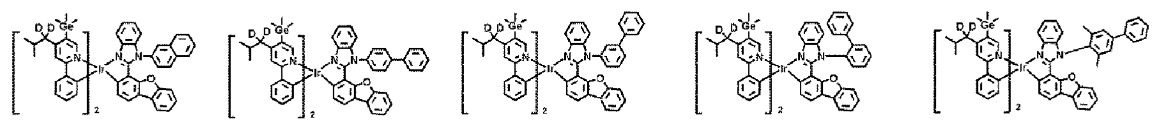

736 737 738 739 740

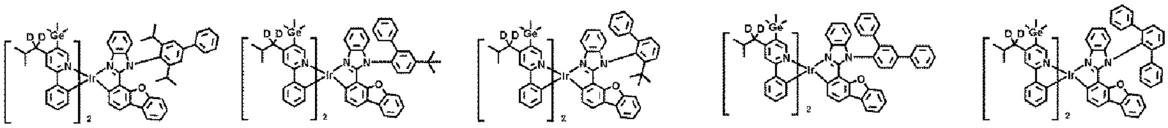

741 742 743 744 745

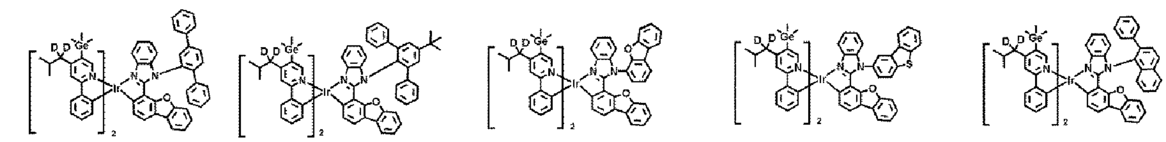

746 747 748 749 750

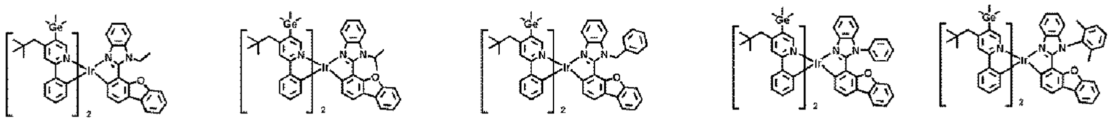
751 752 753 754 755

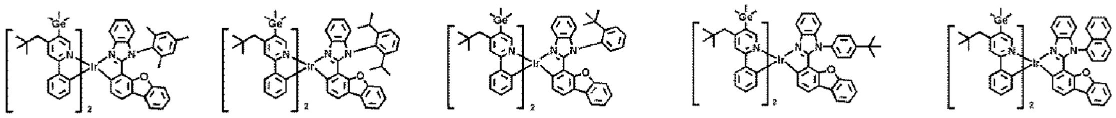
756 757 758 759 760

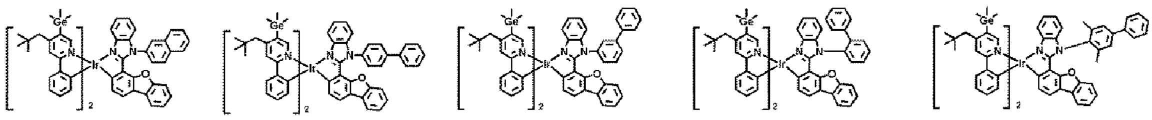
761 762 763 764 765

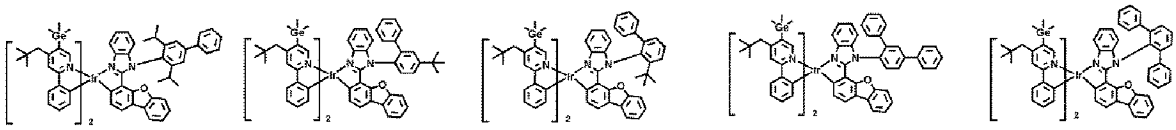
766 767 768 769 770

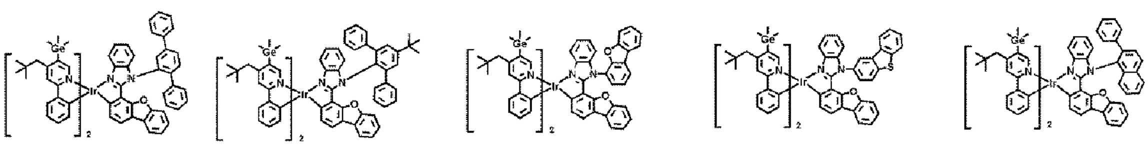
771 772 773 774 775

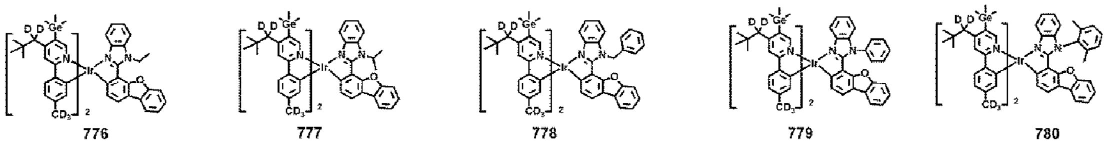
776 777 778 779 780

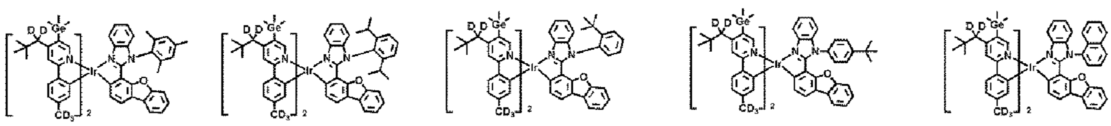
781 782 783 784 785

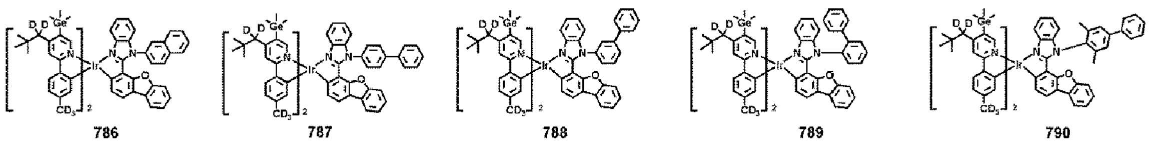
786 787 788 789 790

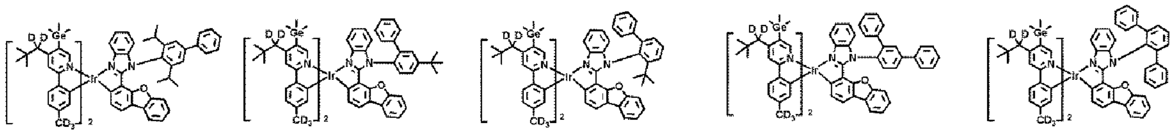
791 792 793 794 795

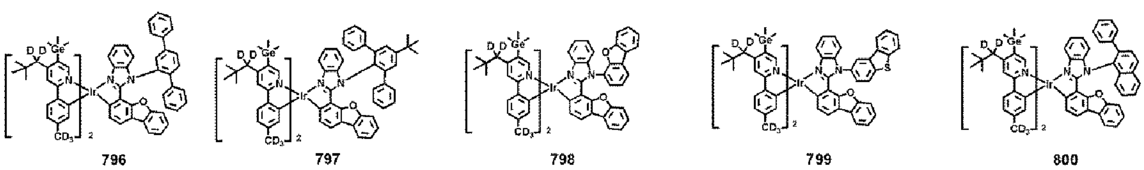
796 797 798 799 800

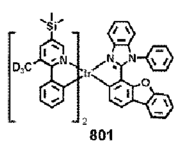
801
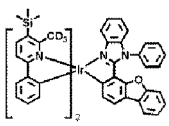
802
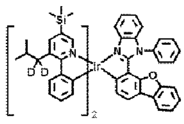
803
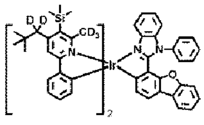
804
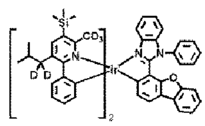
805
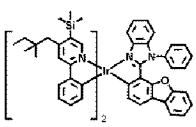
806
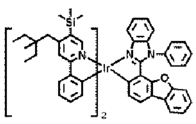
807
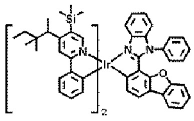
808
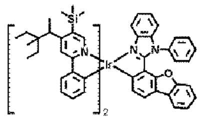
809
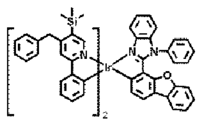
810
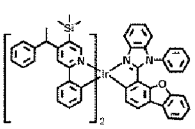
811
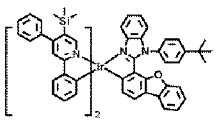
812
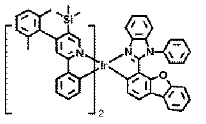
813
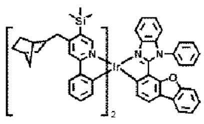
814
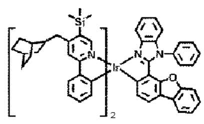
815
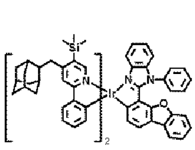
816
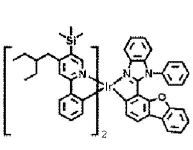
817
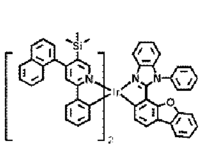
818
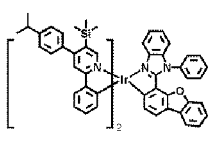
819
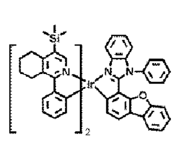
820
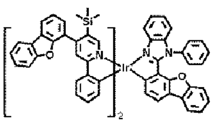
821
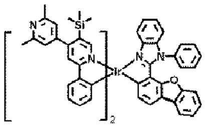
822
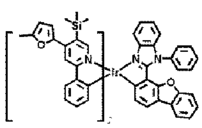
823
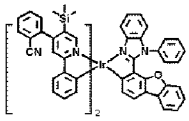
824
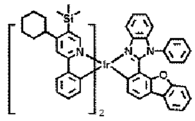
825
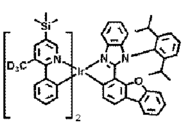
826
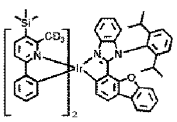
827
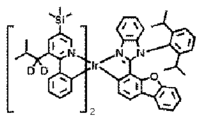
828
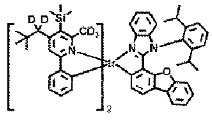
829
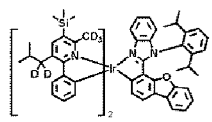
830
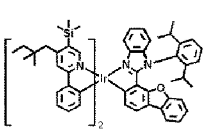
831
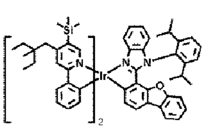
832
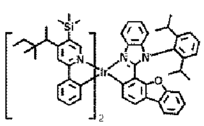
833
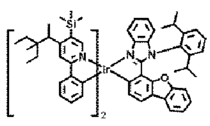
834
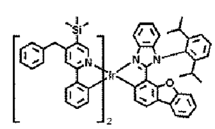
835
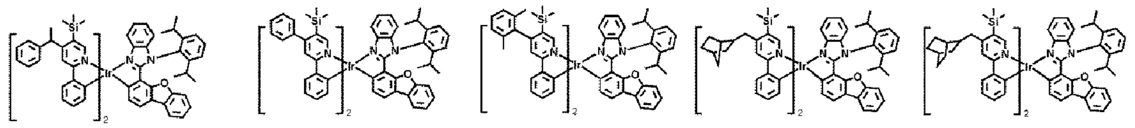
836 837 838 839 840
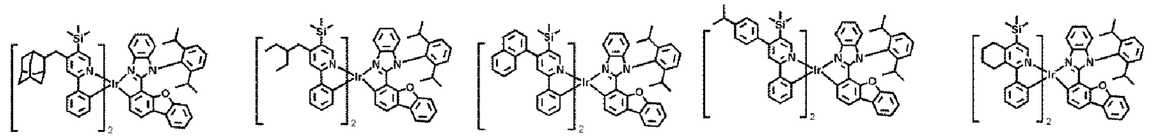
841 842 843 844 845
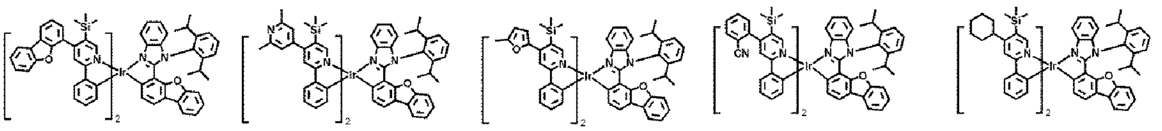
846 847 848 849 850

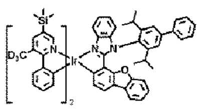
851
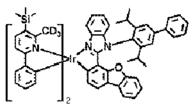
852
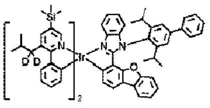
853
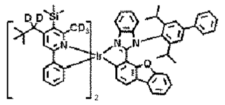
854
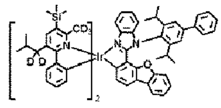
855
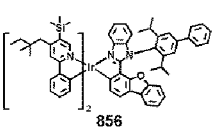
856
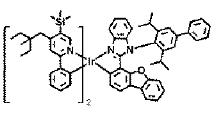
857
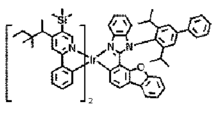
858
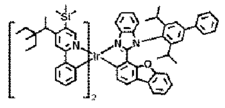
859
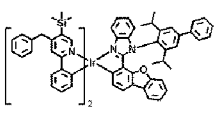
860
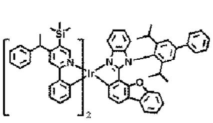
861
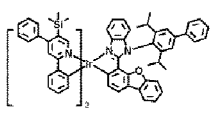
862
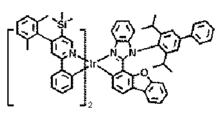
863
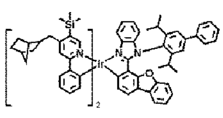
864
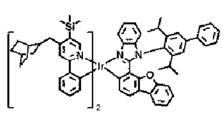
865
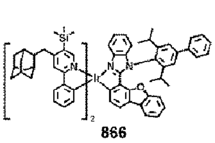
866
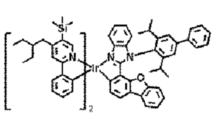
867
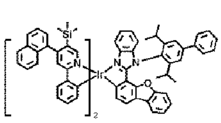
868
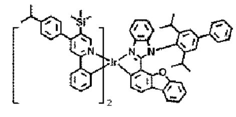
869
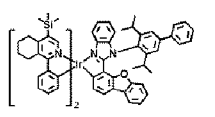
870
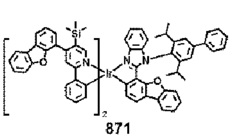
871
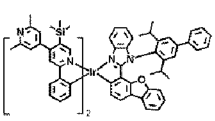
872
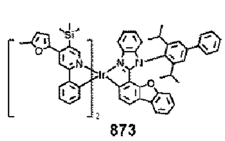
873
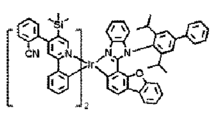
874
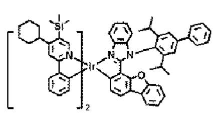
875
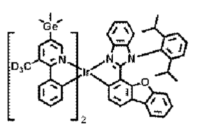
876
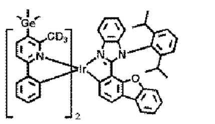
877
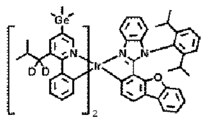
878
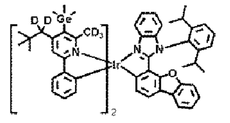
879
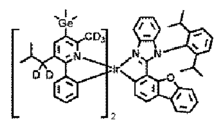
880
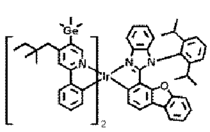
881
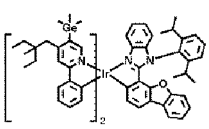
882
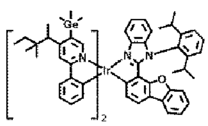
883
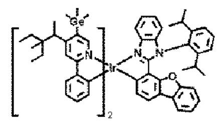
884
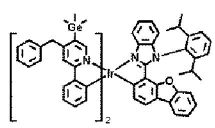
885
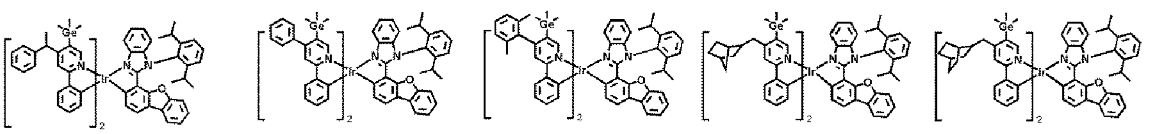
886
887
888
889
890
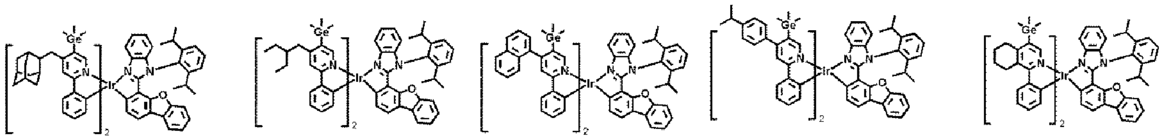
891
892
893
894
895
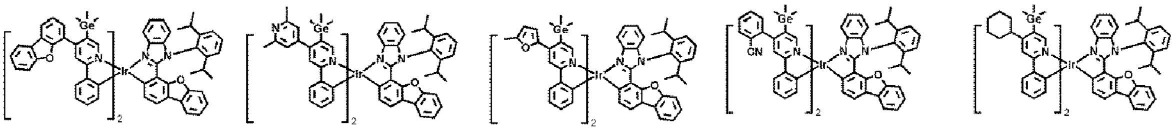
896
897
898
899
900

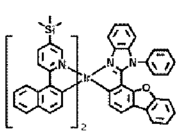
901
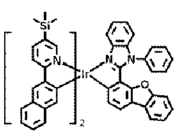
902
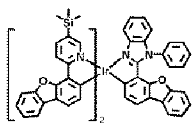
903
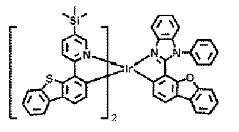
904
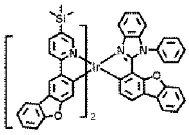
905
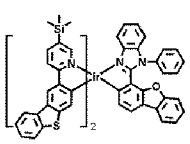
906
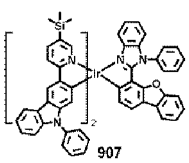
907
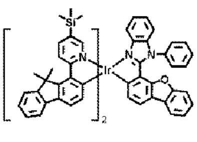
908
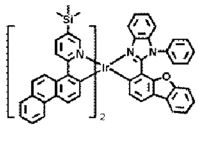
909
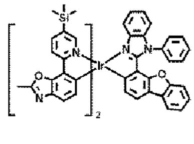
910
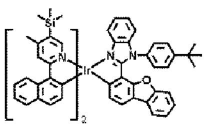
911
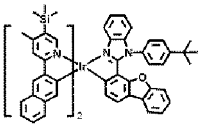
912
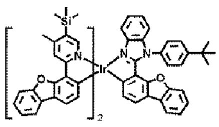
913
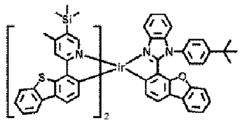
914
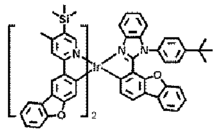
915
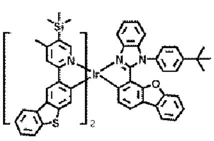
916
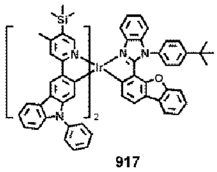
917
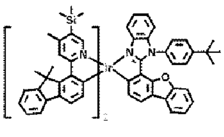
918
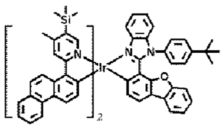
919
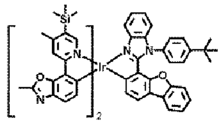
920
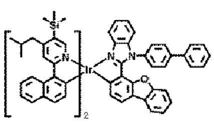
921
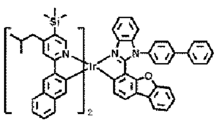
922
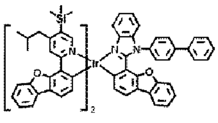
923
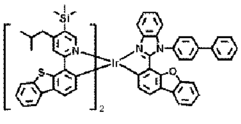
924
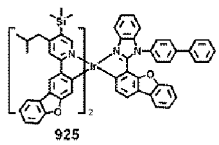
925
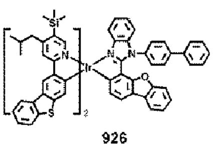
926
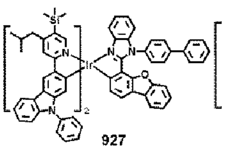
927
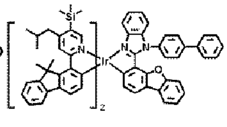
928
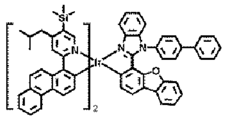
929
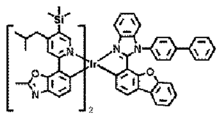
930
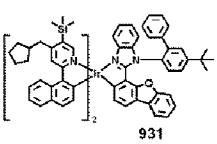
931
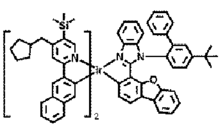
932
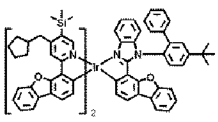
933
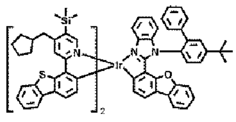
934
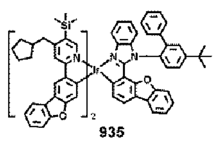
935
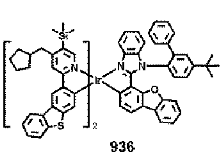
936
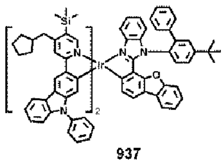
937
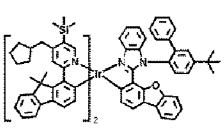
938
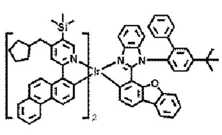
939
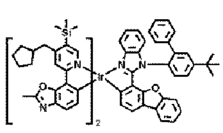
940

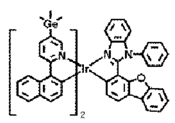
941
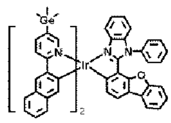
942
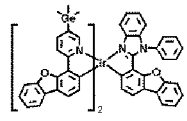
943
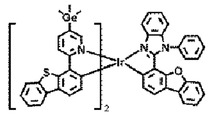
944
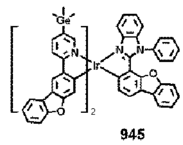
945

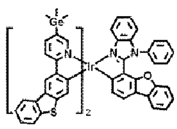
946
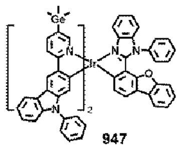
947
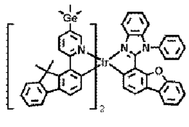
948
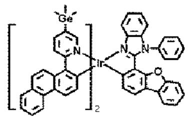
949
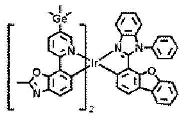
950

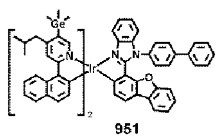
951
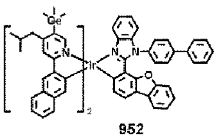
952
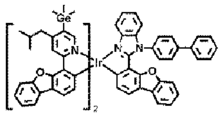
953
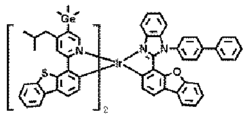
954
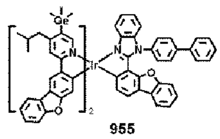
955

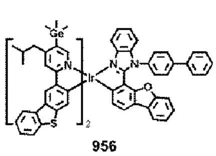
956
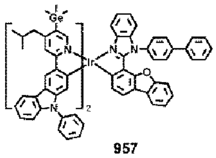
957
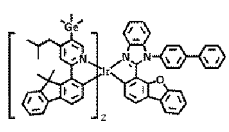
958
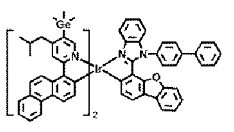
959
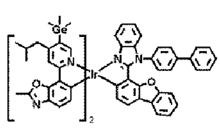
960

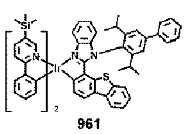
961
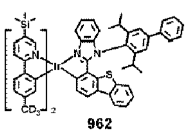
962
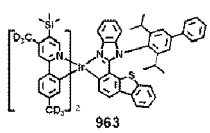
963
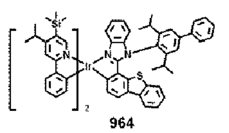
964
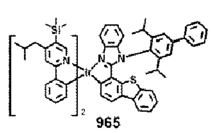
965

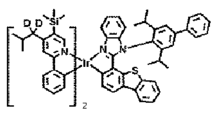
966
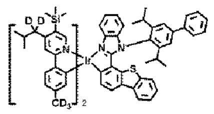
967
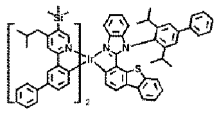
968
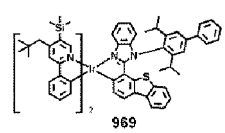
969
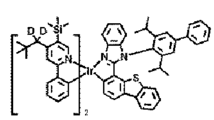
970

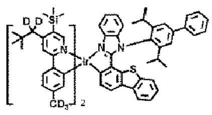
971
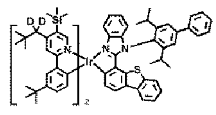
972
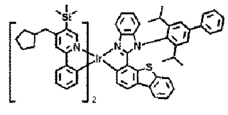
973
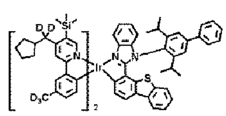
974
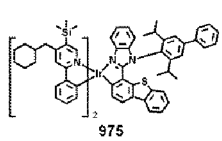
975

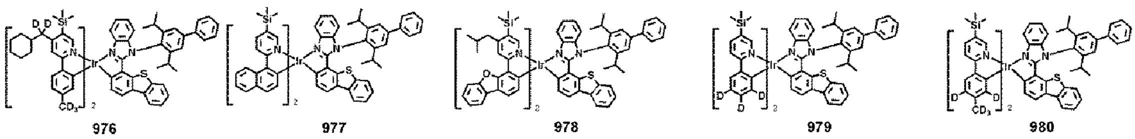
976
977
978
979
980

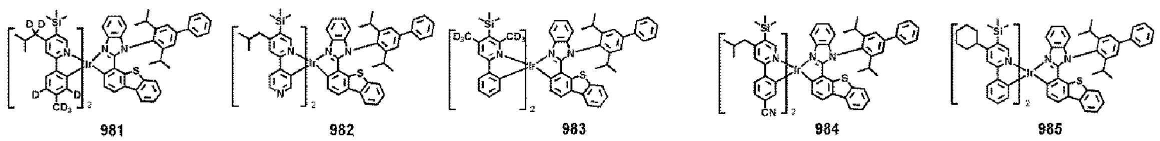
981
982
983
984
985

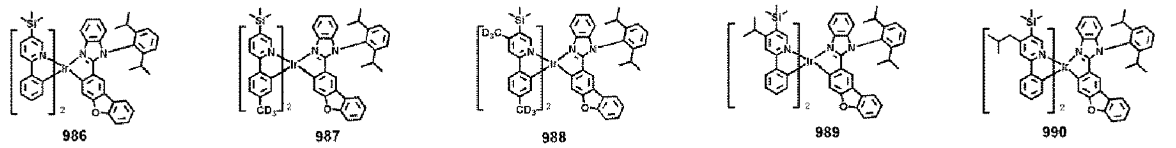
986 987 988 989 990

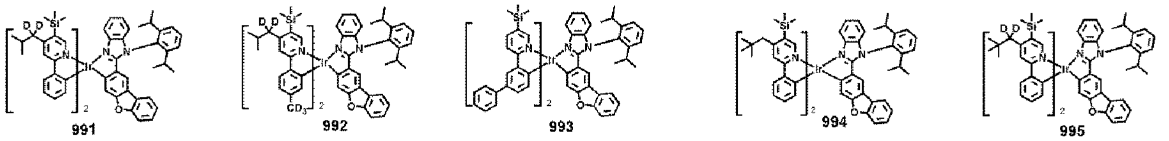
991 992 993 994 995

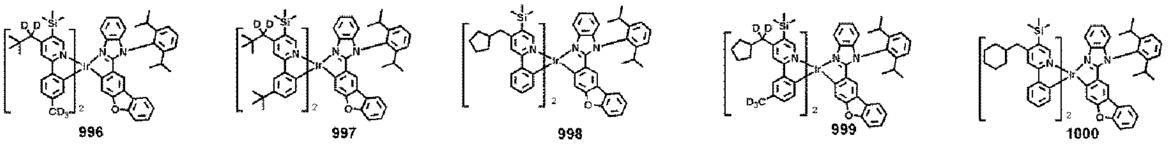
996 997 998 999 1000

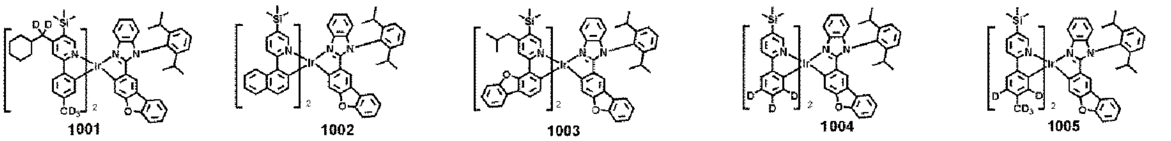
1001 1002 1003 1004 1005

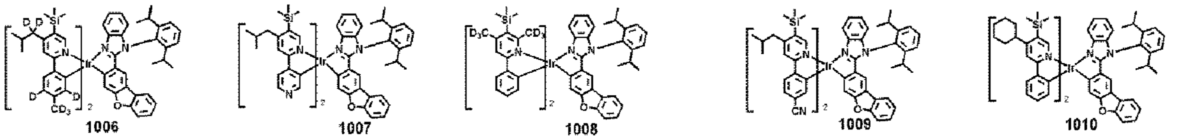
1006 1007 1008 1009 1010

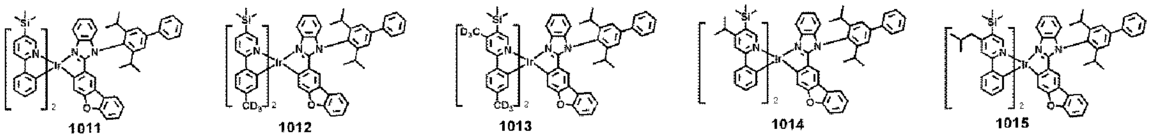
1011 1012 1013 1014 1015

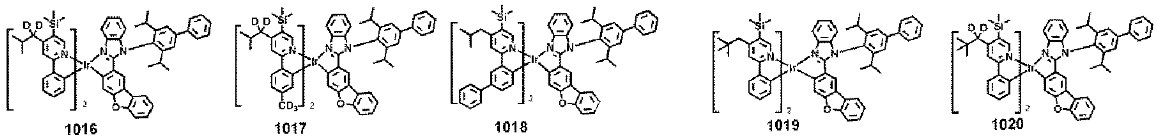
1016 1017 1018 1019 1020

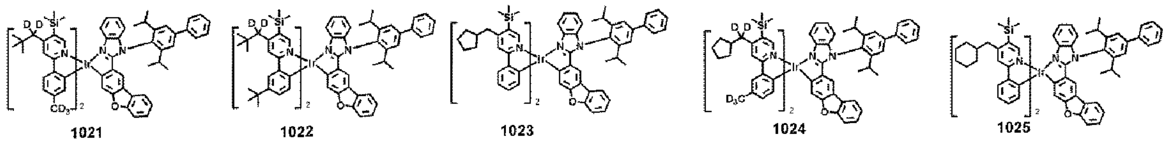
1021 1022 1023 1024 1025

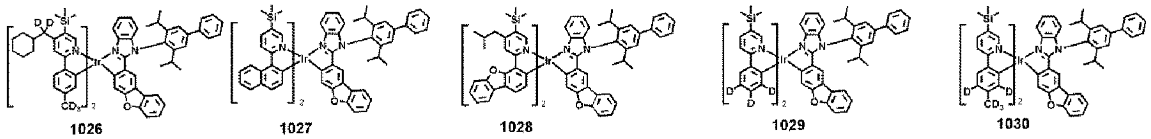
1026 1027 1028 1029 1030

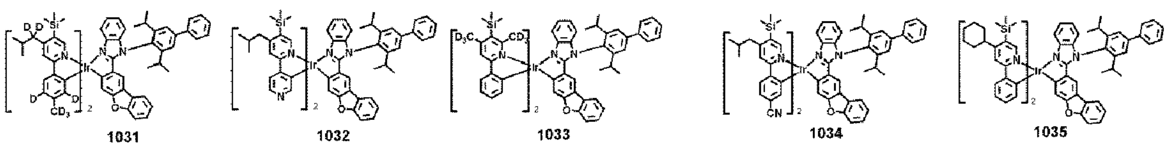
1031 1032 1033 1034 1035

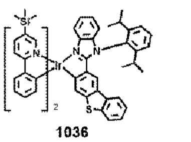
1036
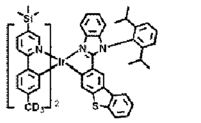
1037
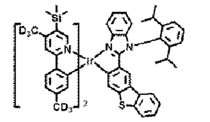
1038
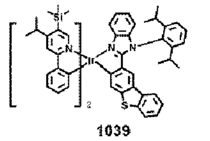
1039
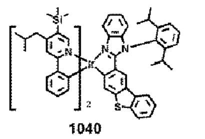
1040

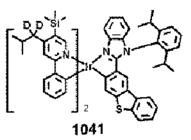
1041
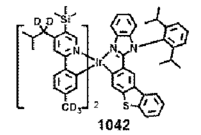
1042
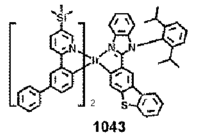
1043
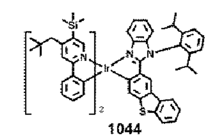
1044
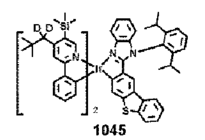
1045

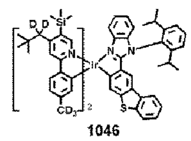
1046
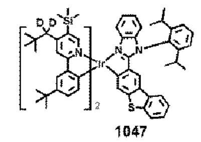
1047
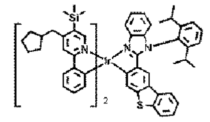
1048
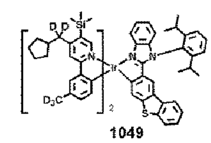
1049
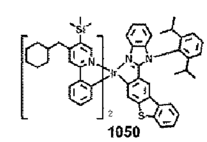
1050

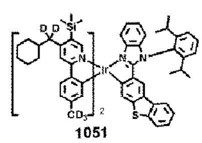
1051
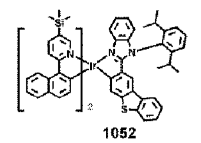
1052
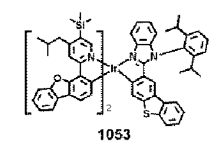
1053
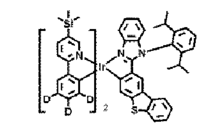
1054
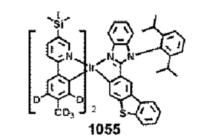
1055

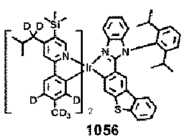
1056
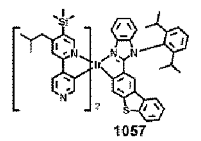
1057
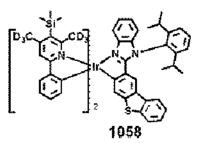
1058
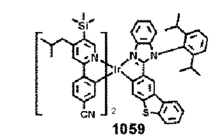
1059
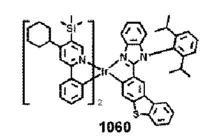
1060

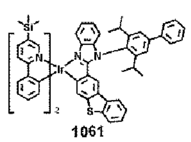
1061
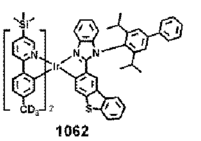
1062
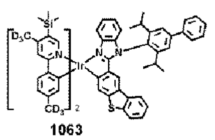
1063
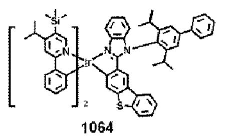
1064
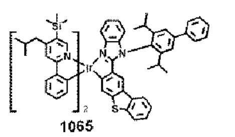
1065

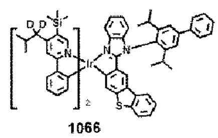
1066
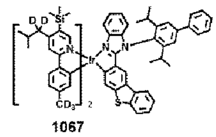
1067
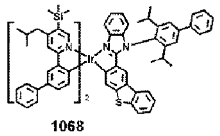
1068
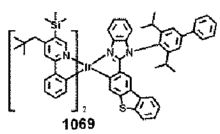
1069
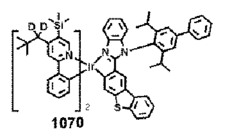
1070

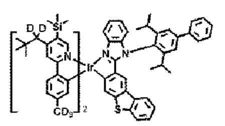
1071
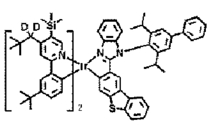
1072
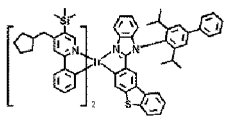
1073
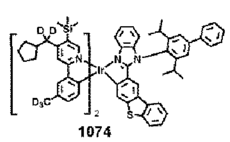
1074
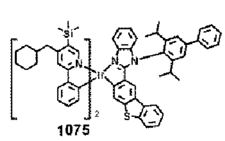
1075

1076
1077
1078
1079
1080

1081
1082
1083
1084
1085

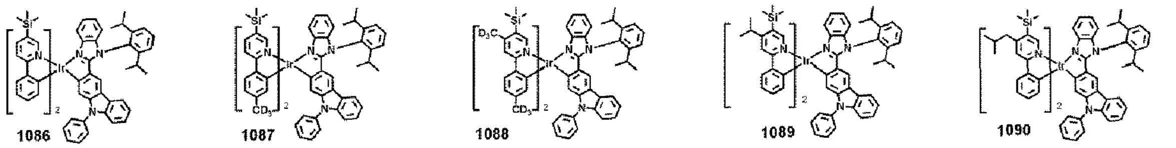
1086 1087 1088 1089 1090

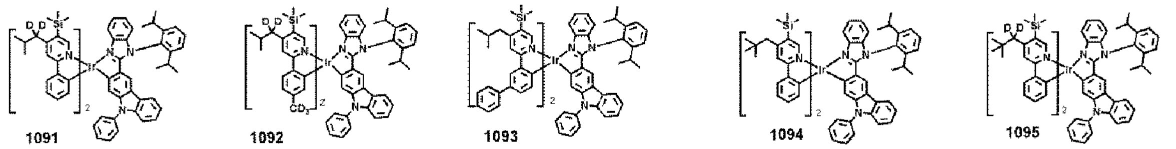
1091 1092 1093 1094 1095

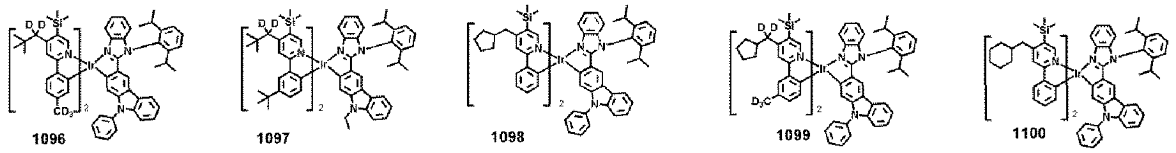
1096 1097 1098 1099 1100

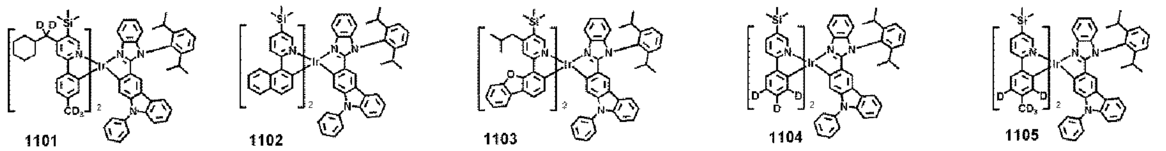
1101 1102 1103 1104 1105

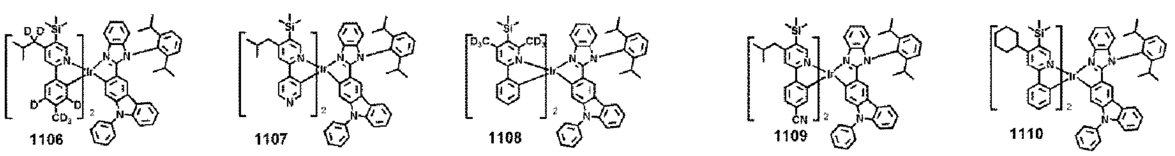
1106 1107 1108 1109 1110

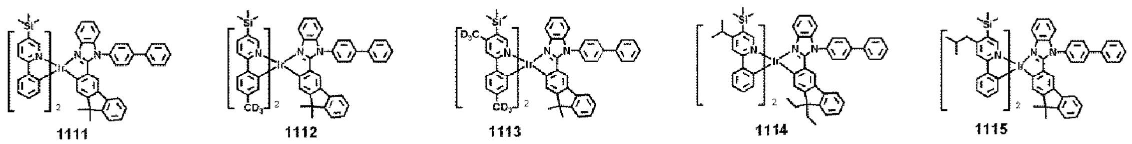
1111 1112 1113 1114 1115

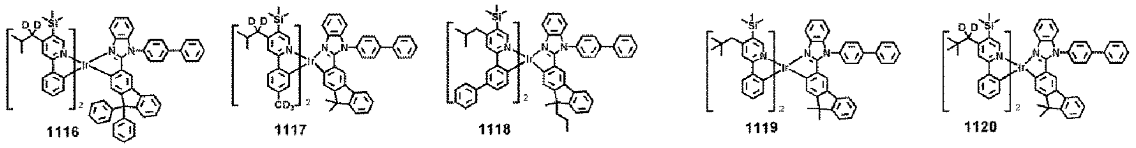
1116 1117 1118 1119 1120

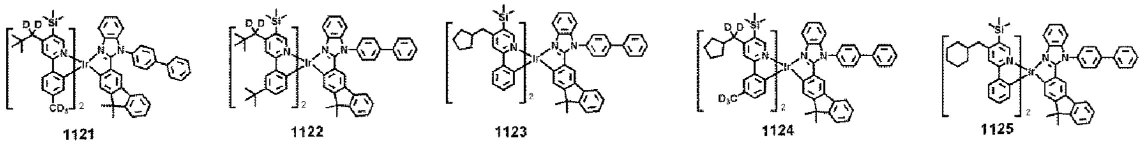
1121 1122 1123 1124 1125

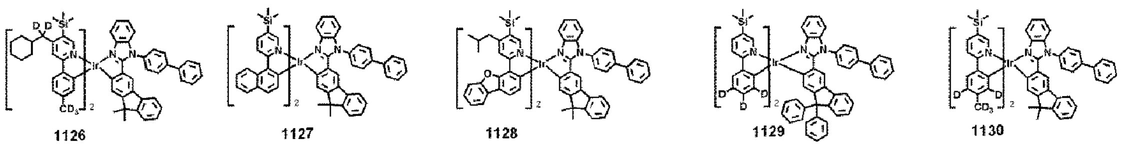
1126 1127 1128 1129 1130

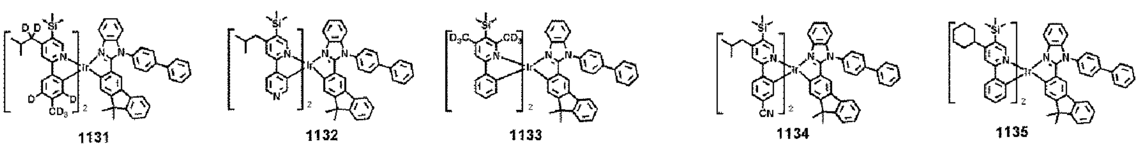
1131 1132 1133 1134 1135

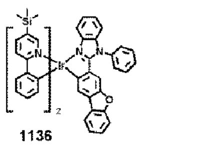
1136
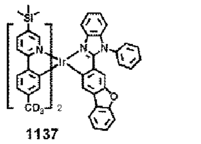
1137
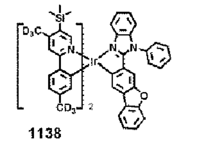
1138
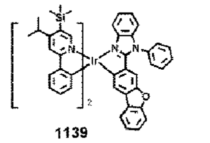
1139
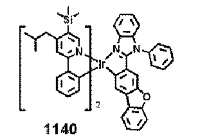
1140
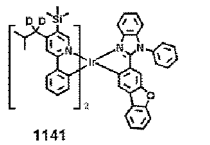
1141
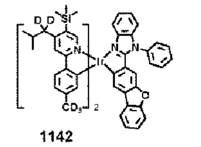
1142
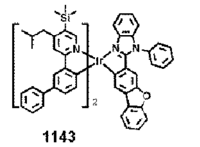
1143
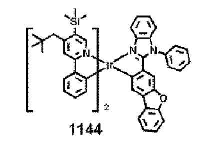
1144
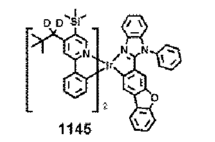
1145
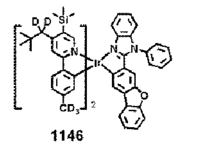
1146
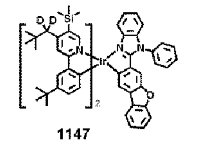
1147
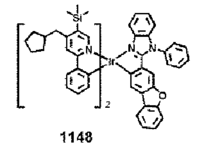
1148
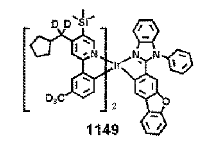
1149
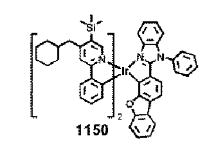
1150
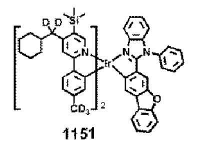
1151
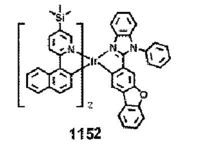
1152
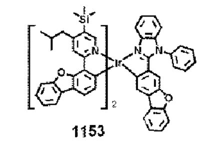
1153
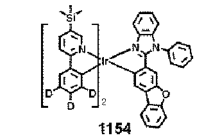
1154
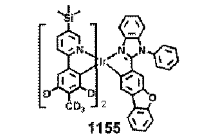
1155
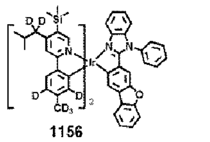
1156
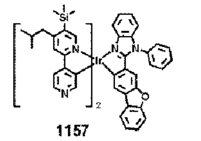
1157
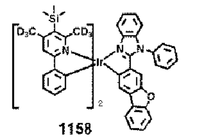
1158
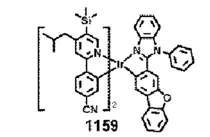
1159
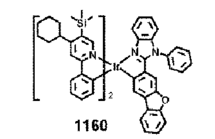
1160
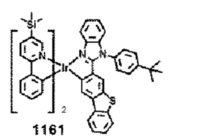
1161
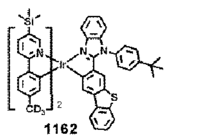
1162
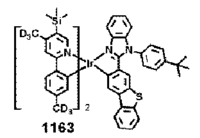
1163
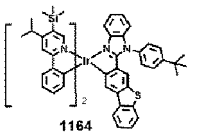
1164
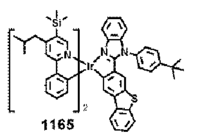
1165
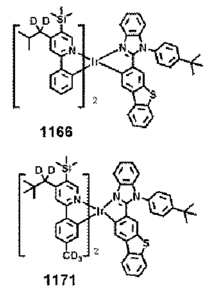
1166
1171
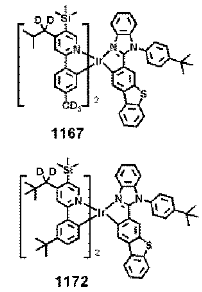
1167
1172
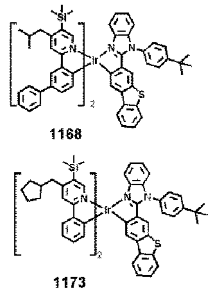
1168
1173
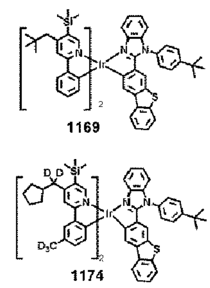
1169
1174
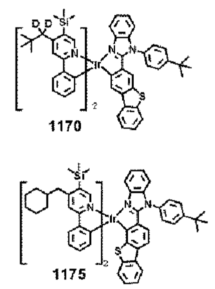
1170
1175
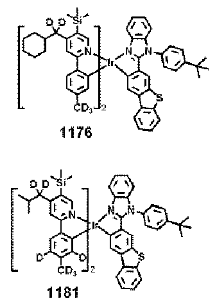
1176
1181
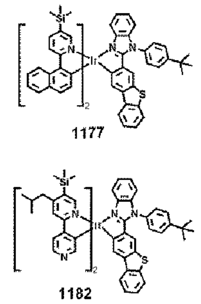
1177
1182
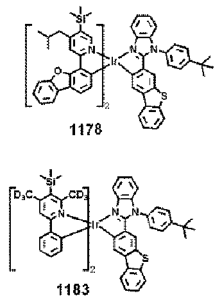
1178
1183
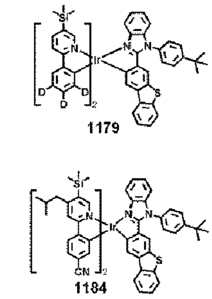
1179
1184
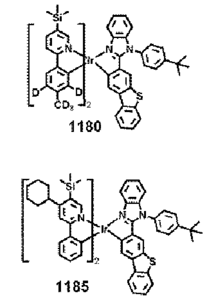
1180
1185

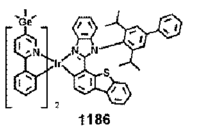
1186
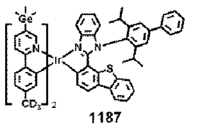
1187
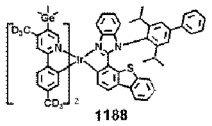
1188
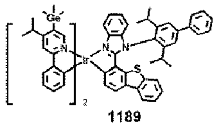
1189
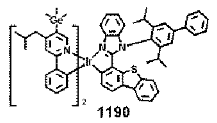
1190

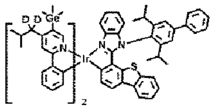
1191
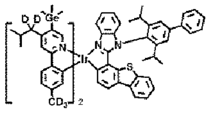
1192
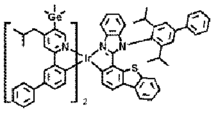
1193
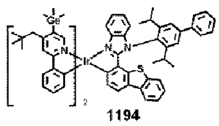
1194
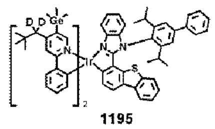
1195

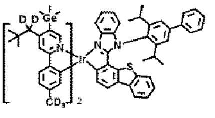
1196
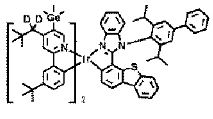
1197
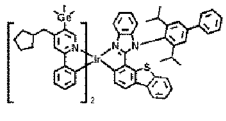
1198
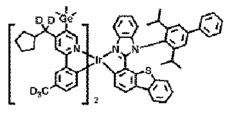
1199
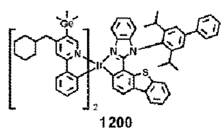
1200

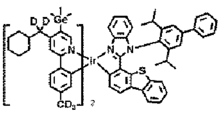
1201
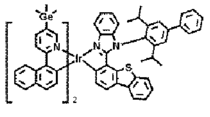
1202
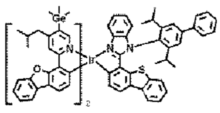
1203
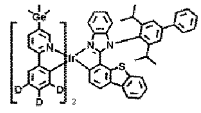
1204
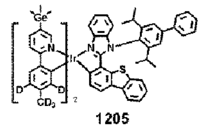
1205

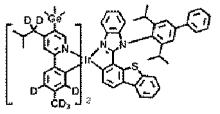
1206
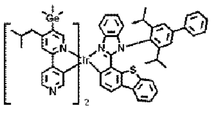
1207
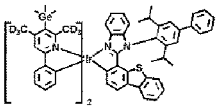
1208
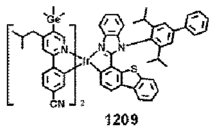
1209
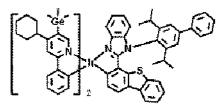
1210

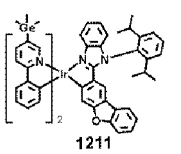
1211
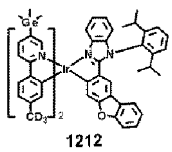
1212
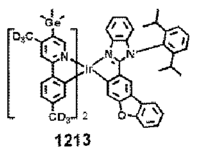
1213
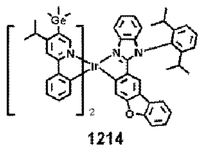
1214
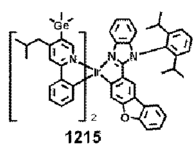
1215

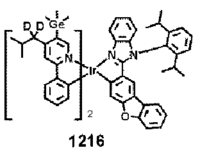
1216
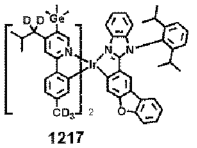
1217
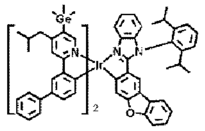
1218
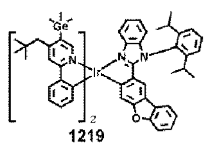
1219
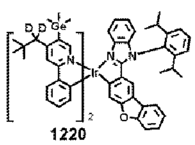
1220

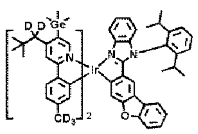
1221
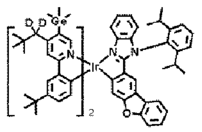
1222
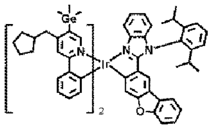
1223
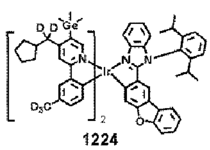
1224
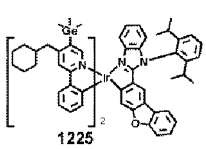
1225

1226
1227
1228
1229
1230

1231
1232
1233
1234
1235

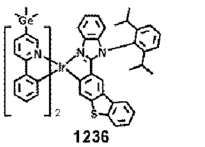
1236
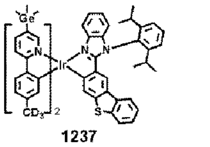
1237
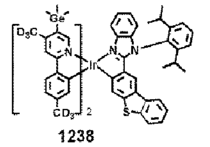
1238
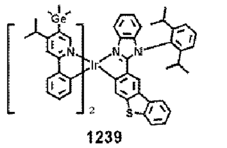
1239
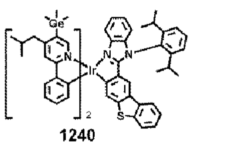
1240

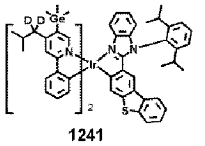
1241
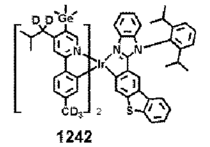
1242
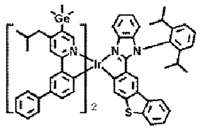
1243
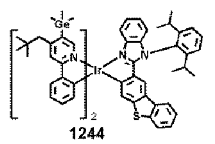
1244
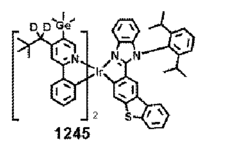
1245

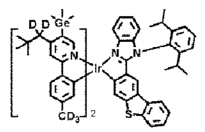
1246
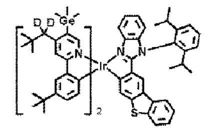
1247
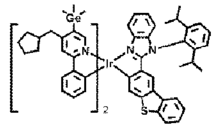
1248
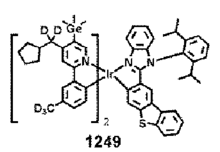
1249
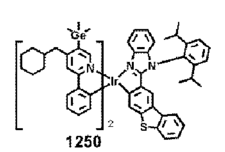
1250

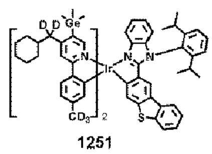
1251
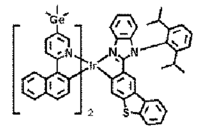
1252
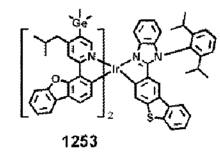
1253
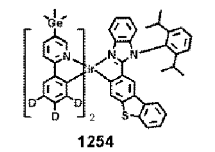
1254
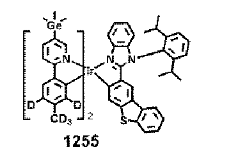
1255

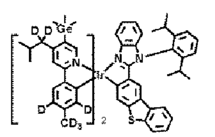
1256
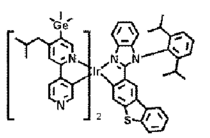
1257
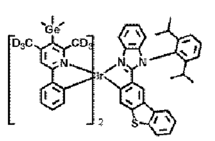
1258
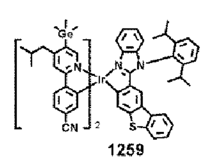
1259
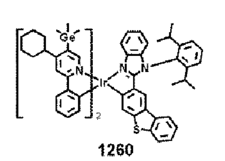
1260

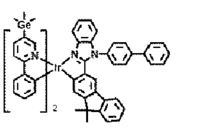
1261
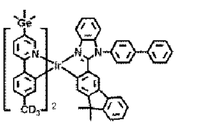
1262
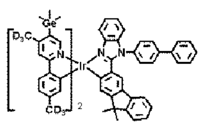
1263
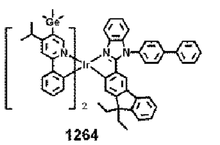
1264
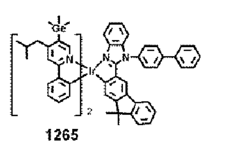
1265

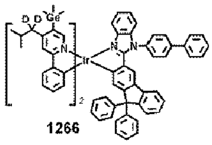
1266
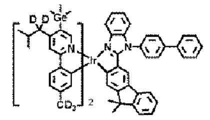
1267
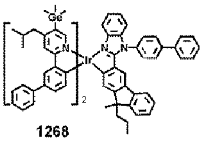
1268
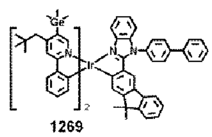
1269
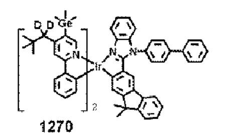
1270

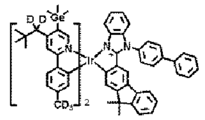
1271
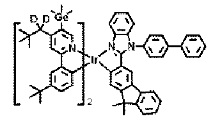
1272
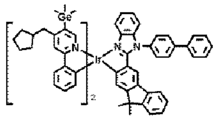
1273
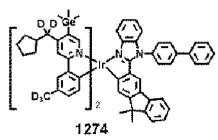
1274
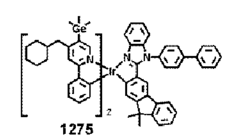
1275

1276
1277
1278
1279
1280

1281
1282
1283
1284
1285

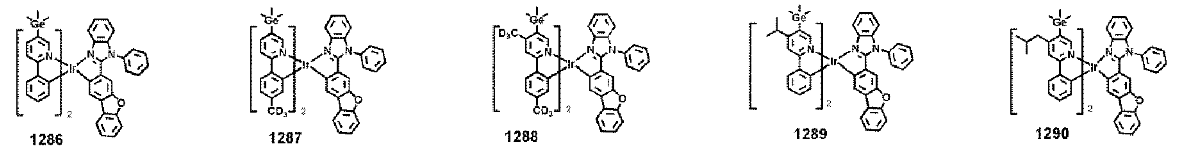

1286 1287 1288 1289 1290

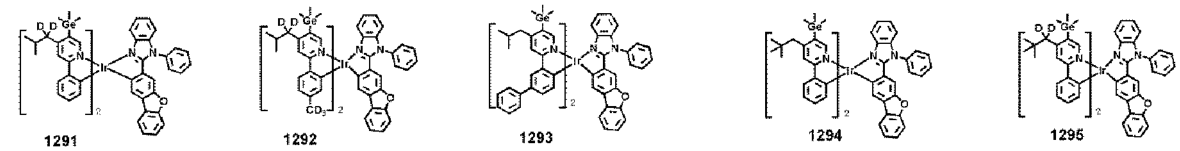

1291 1292 1293 1294 1295

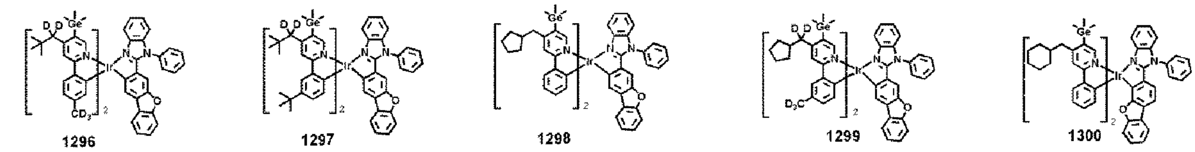

1296 1297 1298 1299 1300

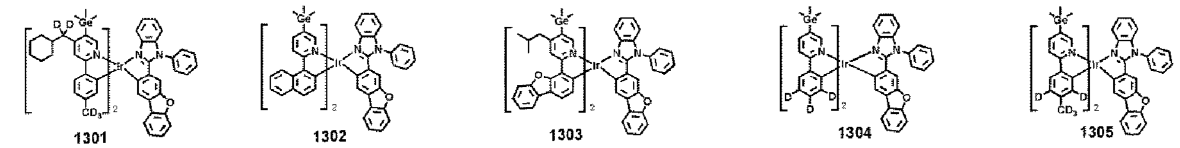

1301 1302 1303 1304 1305

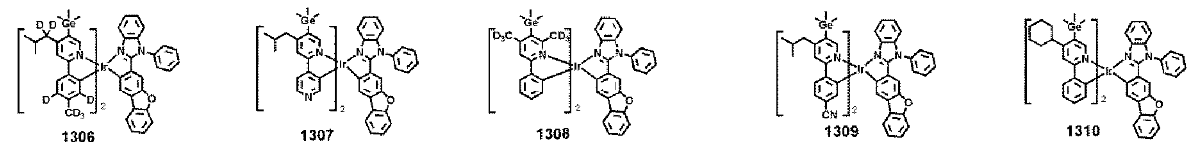

1306 1307 1308 1309 1310

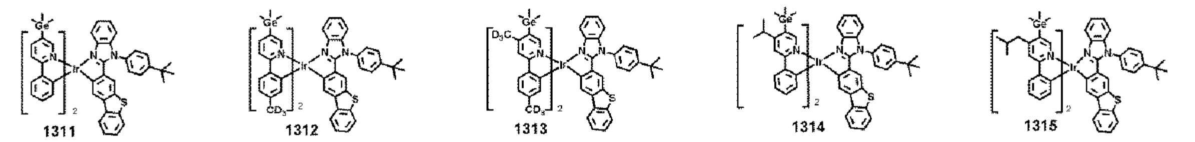

1311 1312 1313 1314 1315

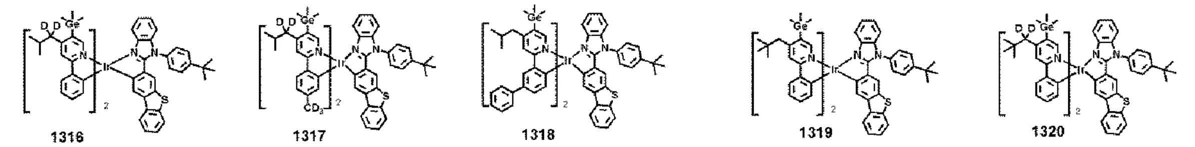

1316 1317 1318 1319 1320

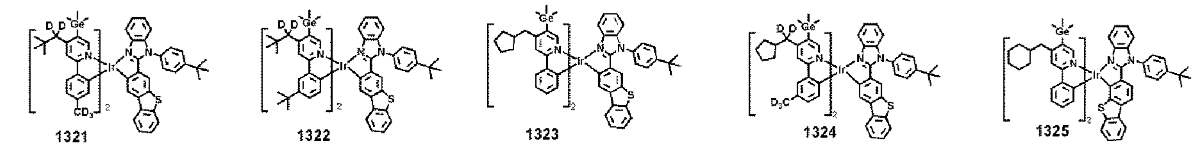

1321 1322 1323 1324 1325

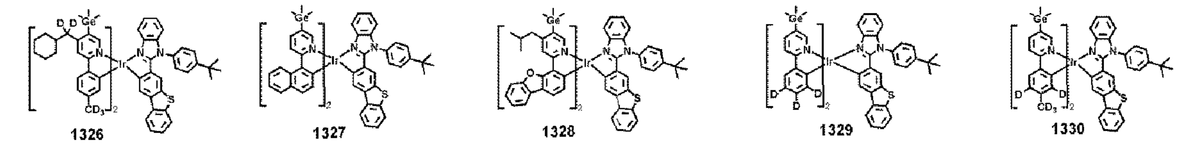

1326 1327 1328 1329 1330

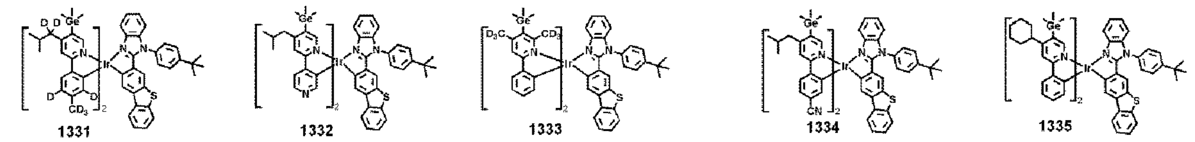

1331 1332 1333 1334 1335

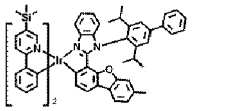
1336

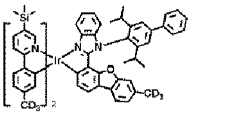
1337

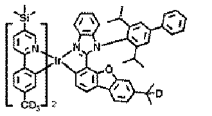
1338

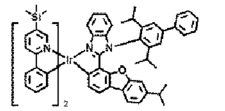
1339

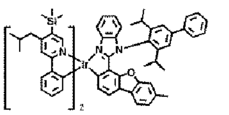
1340

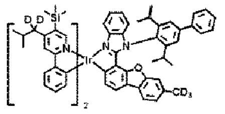
1341

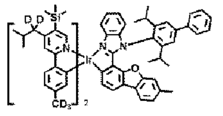
1342

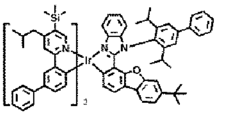
1343

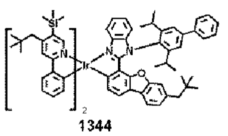
1344

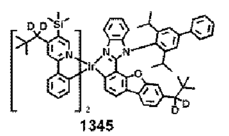
1345

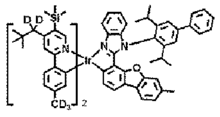
1346

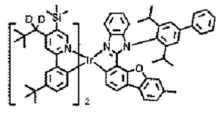
1347

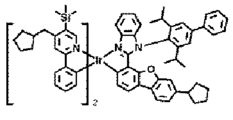
1348

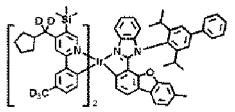
1349

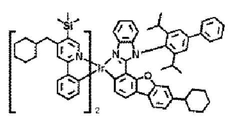
1350

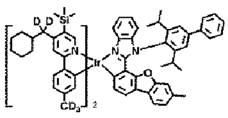
1351

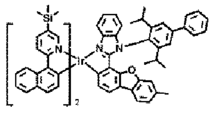
1352

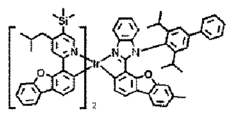
1353

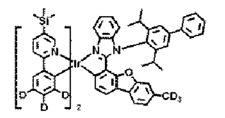
1354

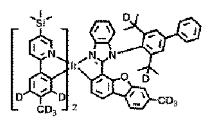
1355

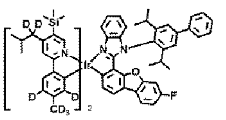
1356

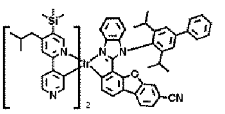
1357

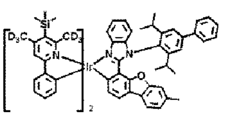
1358

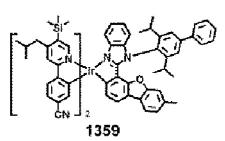
1359

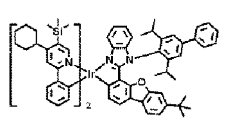
1360

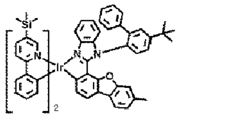
1361

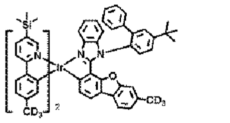
1362

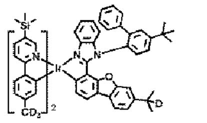
1363

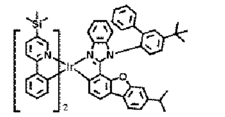
1364

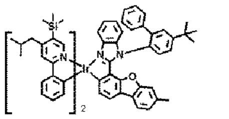
1365

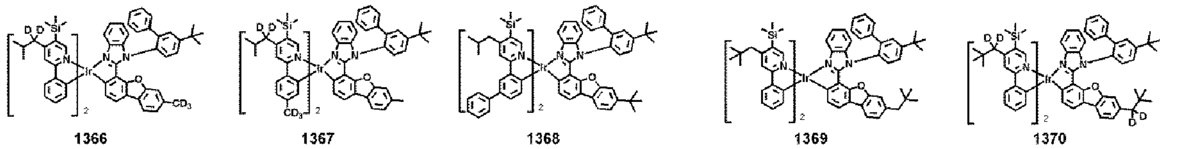
1366 1367 1368 1369 1370

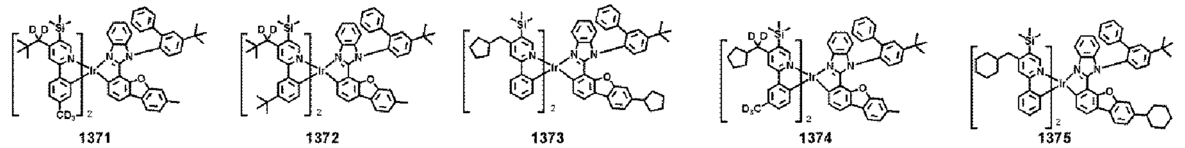
1371 1372 1373 1374 1375

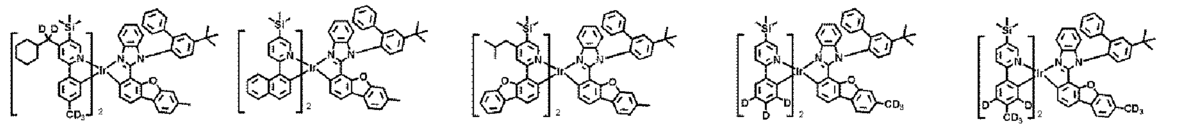
1376 1377 1378 1379 1380

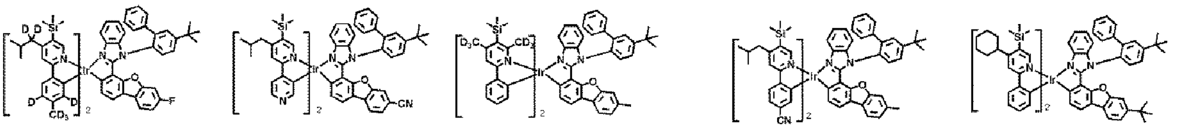
1381 1382 1383 1384 1385

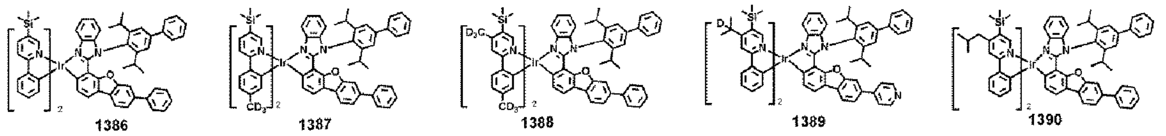

1386 1387 1388 1389 1390

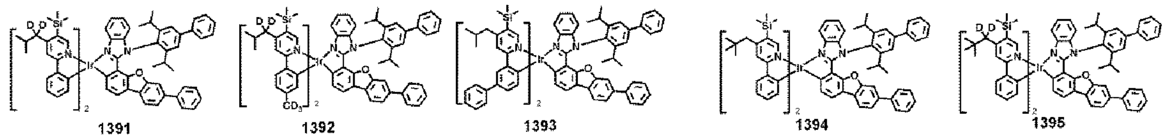

1391 1392 1393 1394 1395

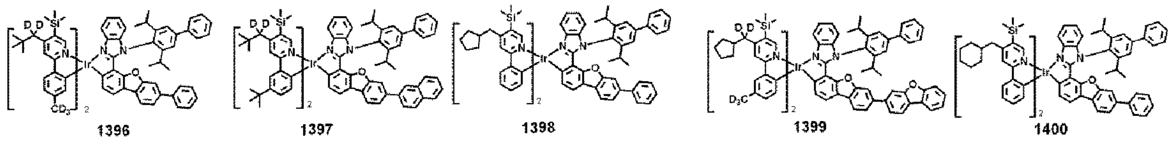

1396 1397 1398 1399 1400

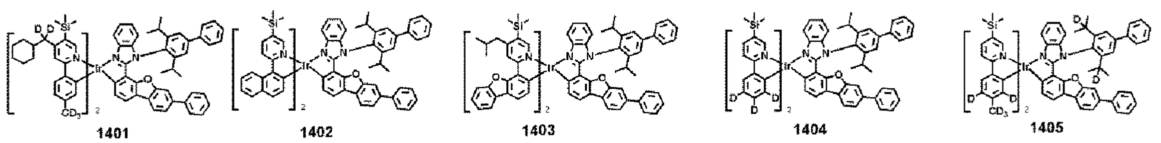

1401 1402 1403 1404 1405

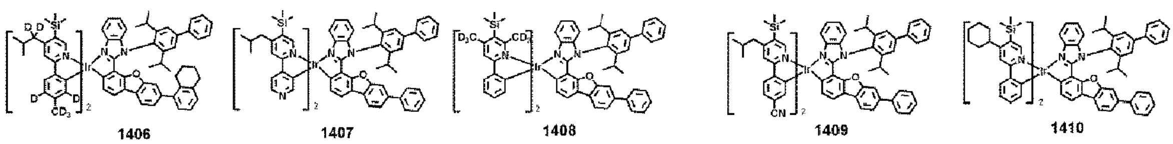

1406 1407 1408 1409 1410

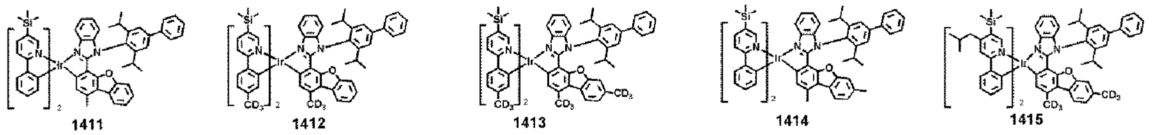

1411 1412 1413 1414 1415

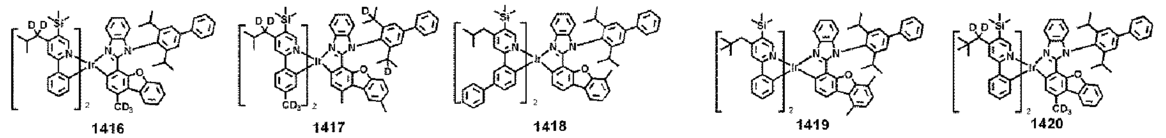

1416 1417 1418 1419 1420

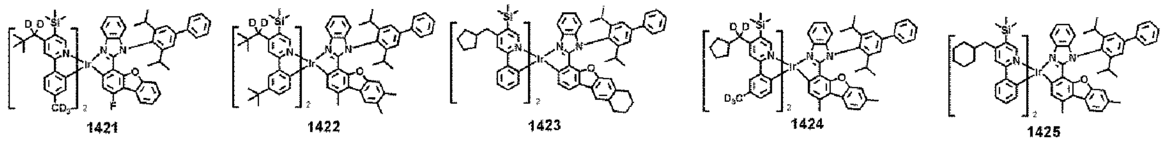

1421 1422 1423 1424 1425

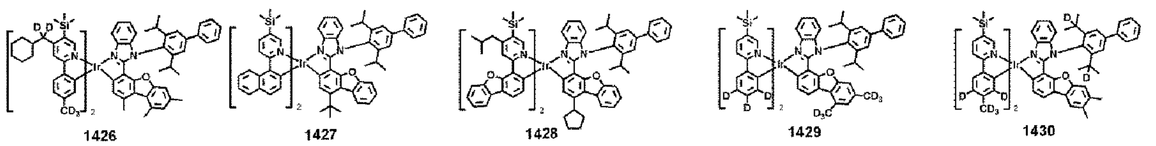

1426 1427 1428 1429 1430

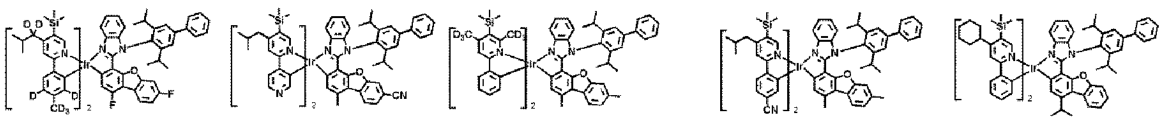

1431 1432 1433 1434 1435

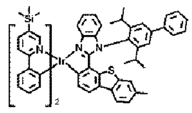 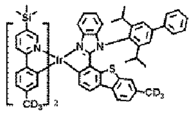 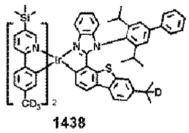 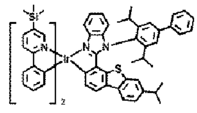 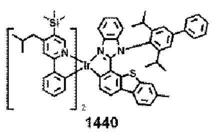

1436 1437 1438 1439 1440

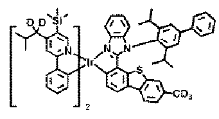 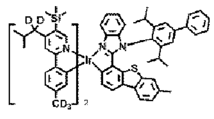 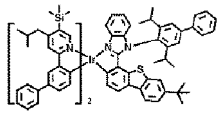 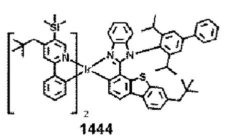 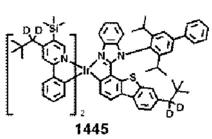

1441 1442 1443 1444 1445

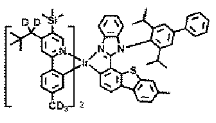 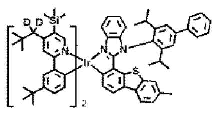 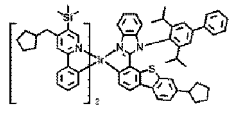 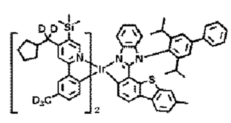 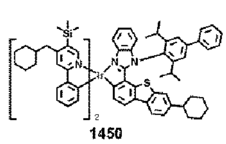

1446 1447 1448 1449 1450

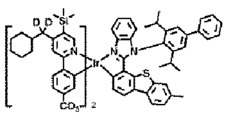 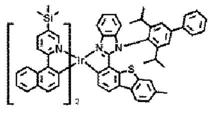 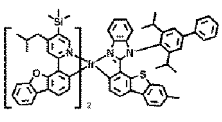 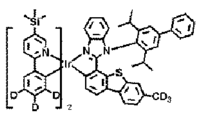 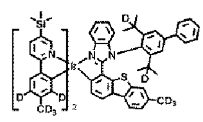

1451 1452 1453 1454 1455

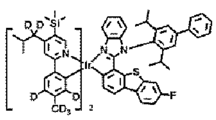 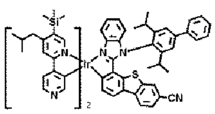 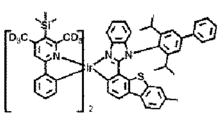 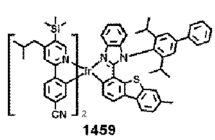 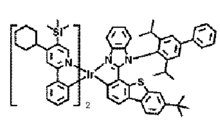

1456 1457 1458 1459 1460

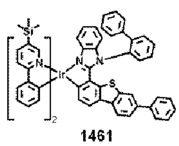 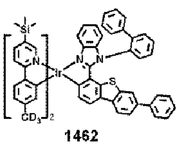 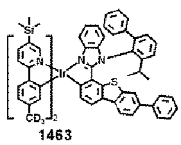 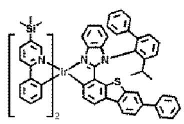 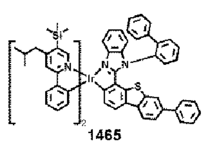

1461 1462 1463 1464 1465

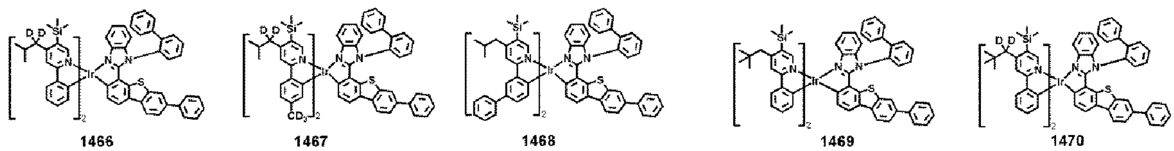

1466 1467 1468 1469 1470

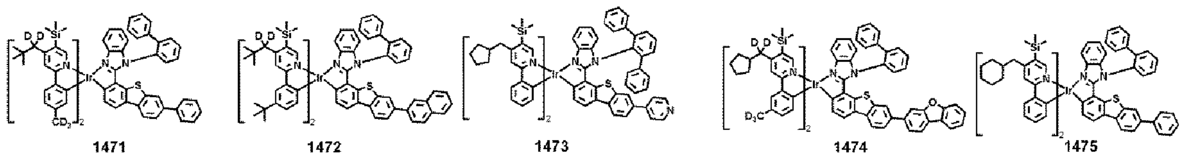

1471 1472 1473 1474 1475

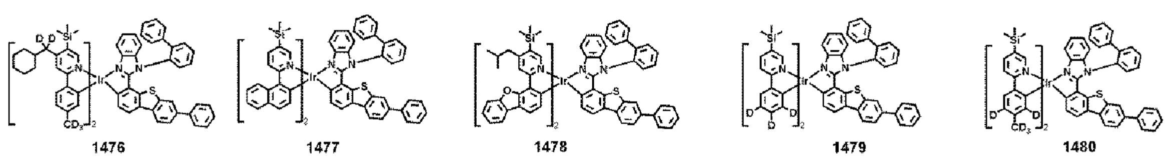

1476 1477 1478 1479 1480

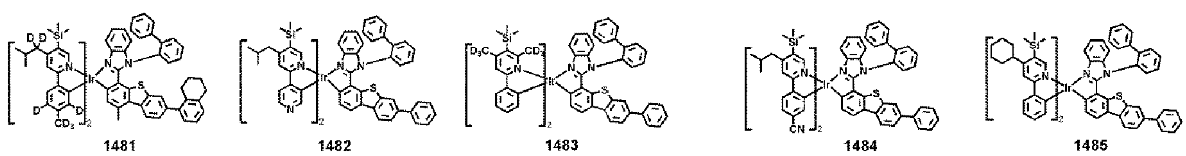

1481 1482 1483 1484 1485

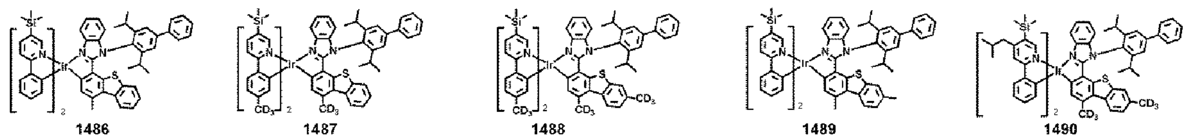
1486 1487 1488 1489 1490

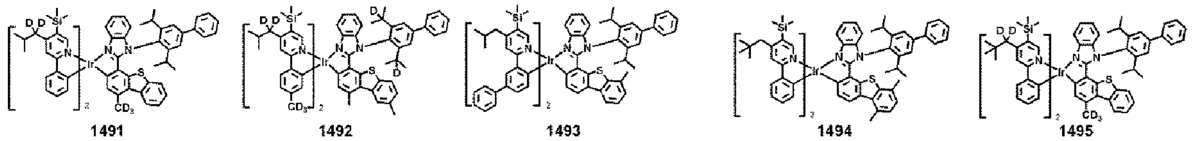
1491 1492 1493 1494 1495

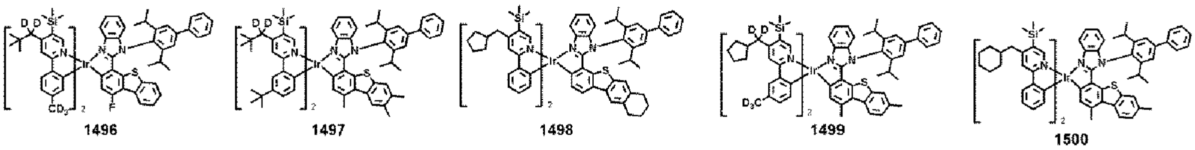
1496 1497 1498 1499 1500

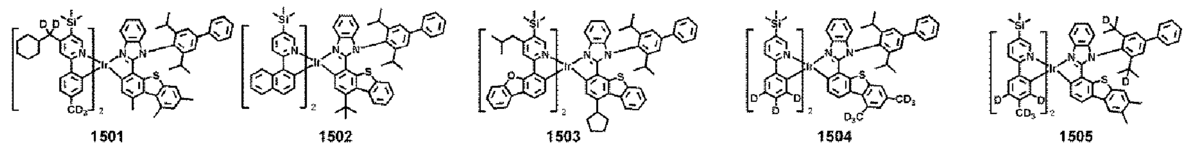
1501 1502 1503 1504 1505

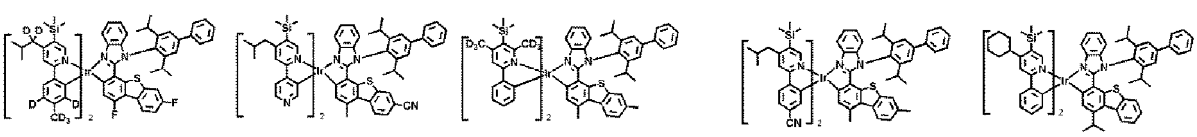
1506 1507 1508 1509 1510

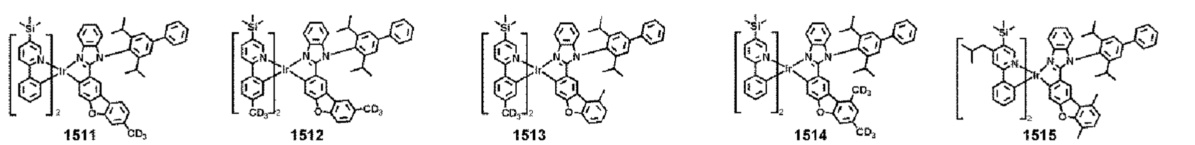
1511 1512 1513 1514 1515

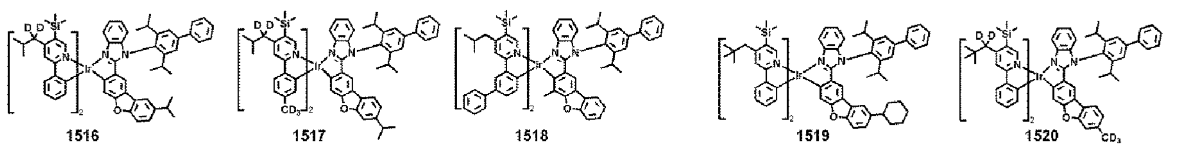
1516 1517 1518 1519 1520

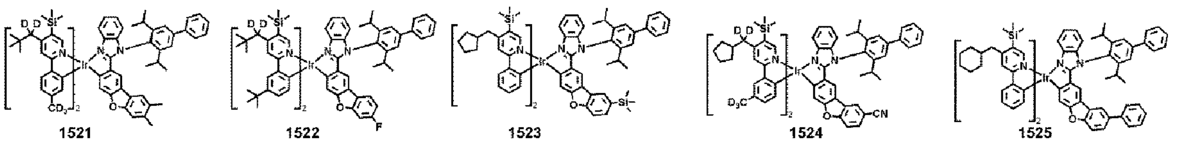
1521 1522 1523 1524 1525

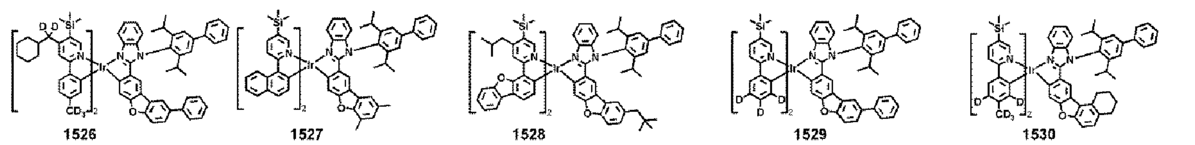
1526 1527 1528 1529 1530

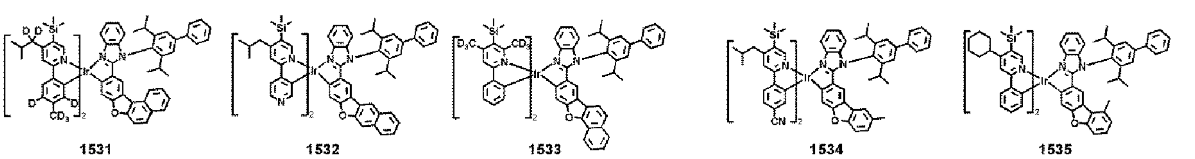
1531 1532 1533 1534 1535

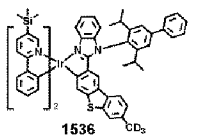
1536
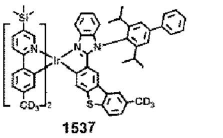
1537
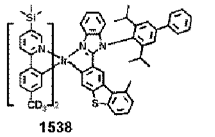
1538
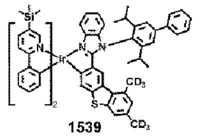
1539
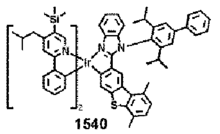
1540
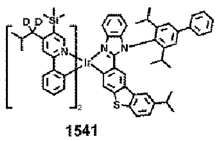
1541
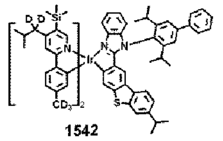
1542
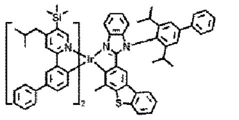
1543
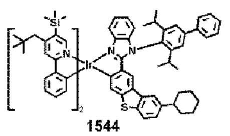
1544
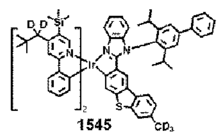
1545
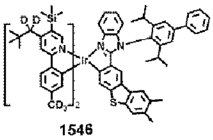
1546
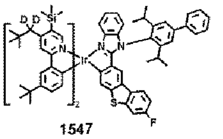
1547
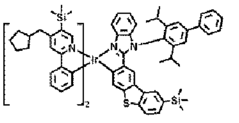
1548
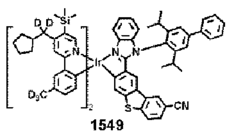
1549
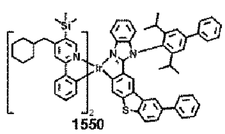
1550
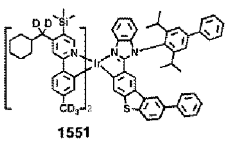
1551
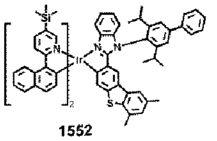
1552
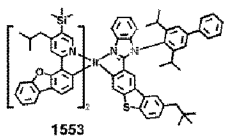
1553
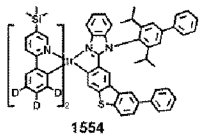
1554
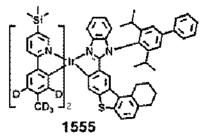
1555
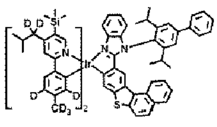
1556
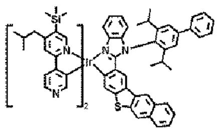
1557
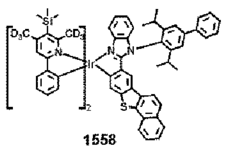
1558
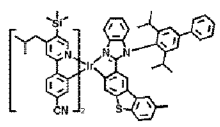
1559
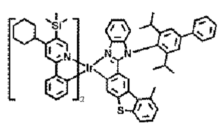
1560
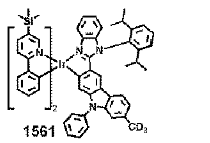
1561
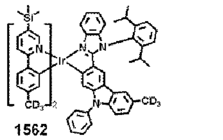
1562
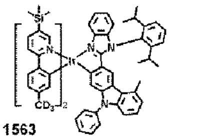
1563
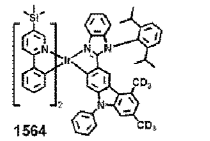
1564
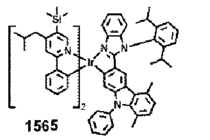
1565
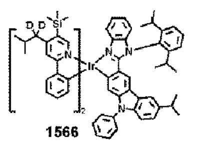
1566
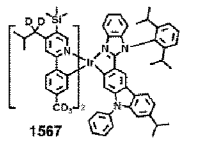
1567
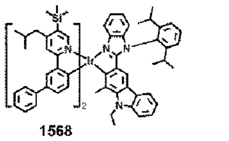
1568
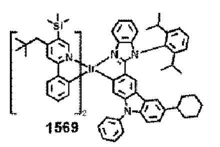
1569
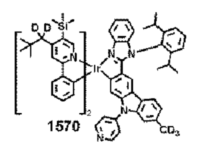
1570
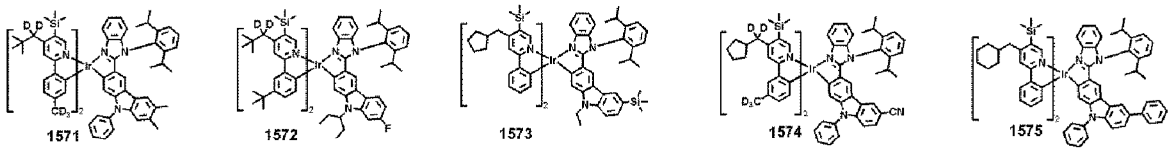
1571
1572
1573
1574
1575
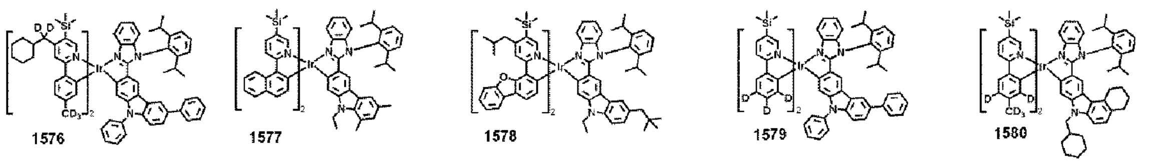
1576
1577
1578
1579
1580
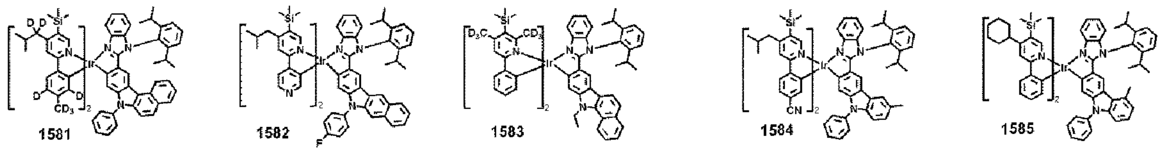
1581
1582
1583
1584
1585

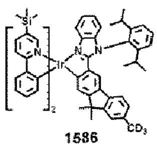
1586
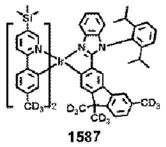
1587
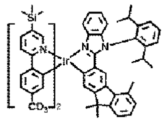
1588
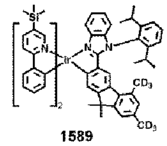
1589
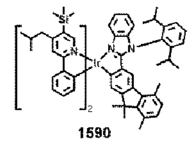
1590
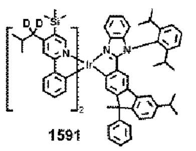
1591
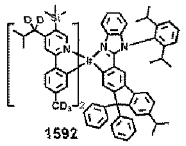
1592
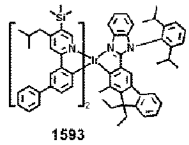
1593
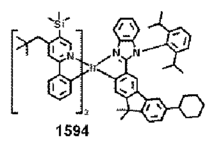
1594
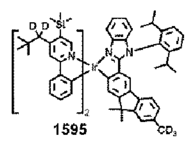
1595
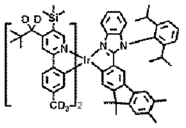
1596
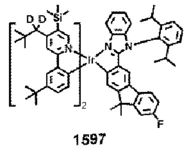
1597
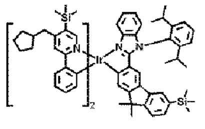
1598
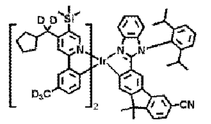
1599
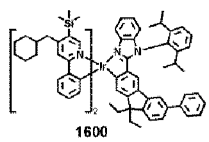
1600
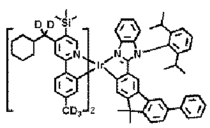
1601
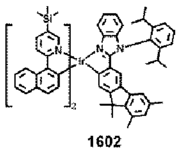
1602
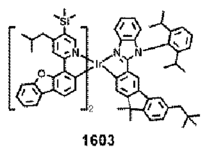
1603
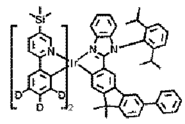
1604
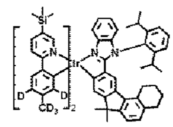
1605
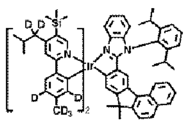
1606
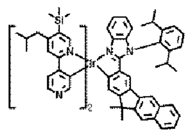
1607
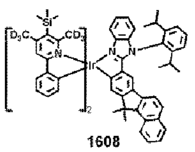
1608
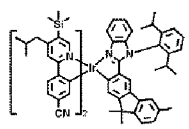
1609
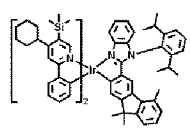
1610
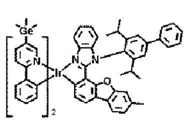
1611
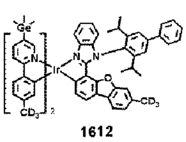
1612
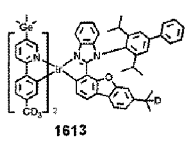
1613
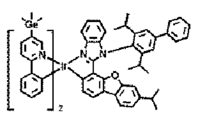
1614
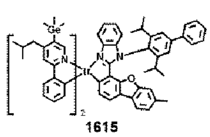
1615
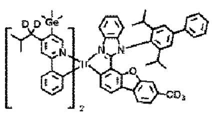
1616
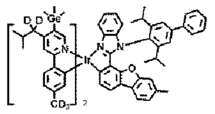
1617
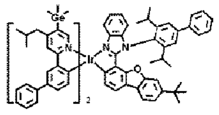
1618
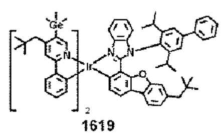
1619
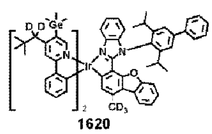
1620
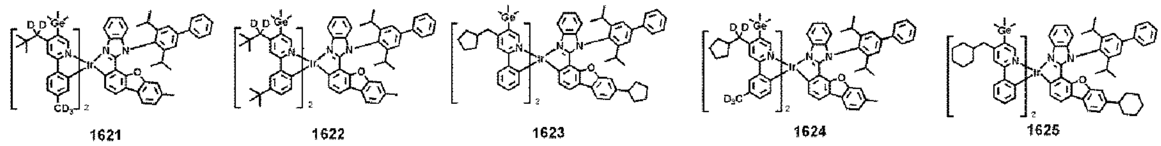
1621 1622 1623 1624 1625
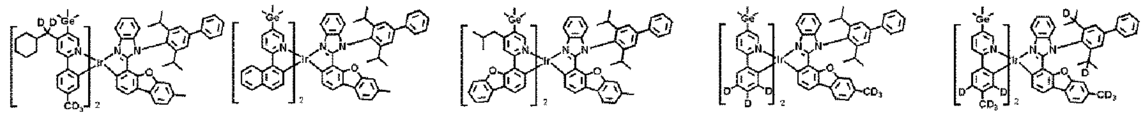
1626 1627 1628 1629 1630
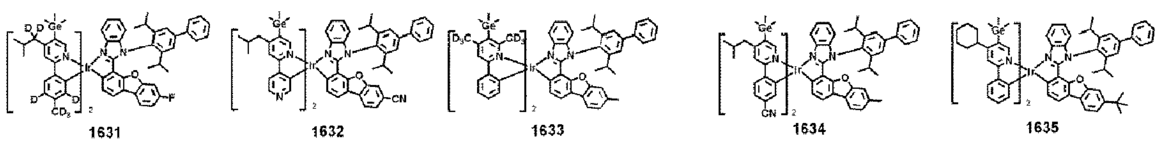
1631 1632 1633 1634 1635

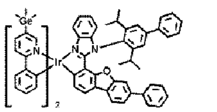
1636
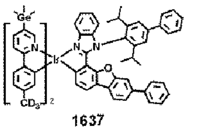
1637
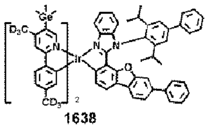
1638
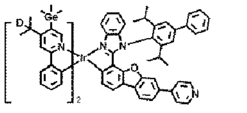
1639
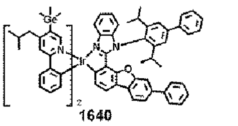
1640

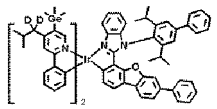
1641
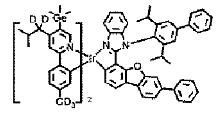
1642
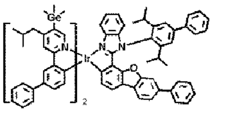
1643
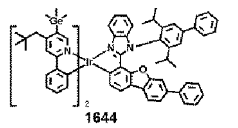
1644
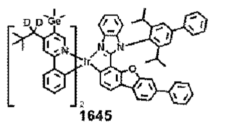
1645

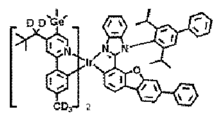
1646
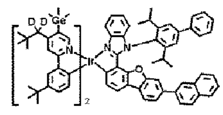
1647
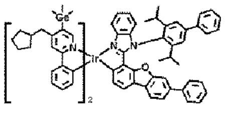
1648
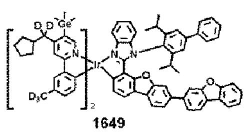
1649
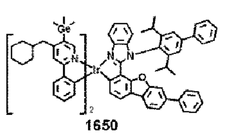
1650

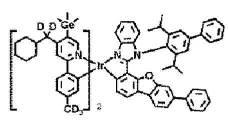
1651
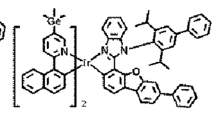
1652
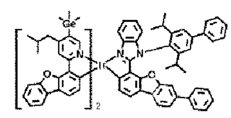
1653
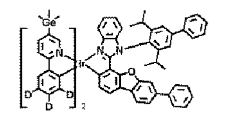
1654
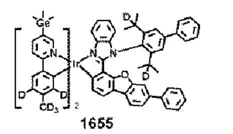
1655

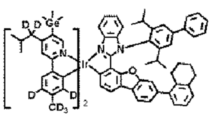
1656
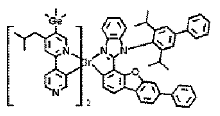
1657
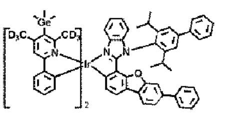
1658
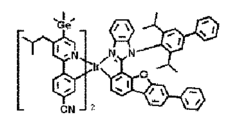
1659
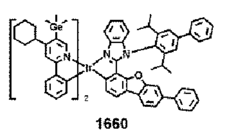
1660

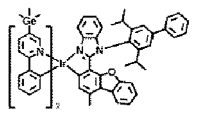
1661
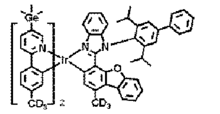
1662
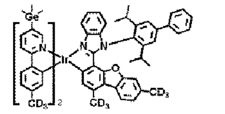
1663
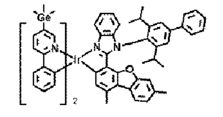
1664
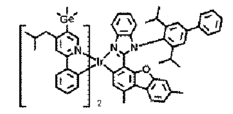
1665

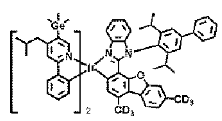
1666
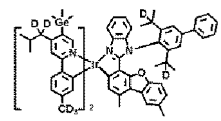
1667
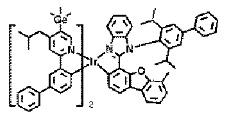
1668
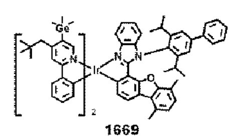
1669
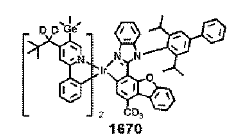
1670

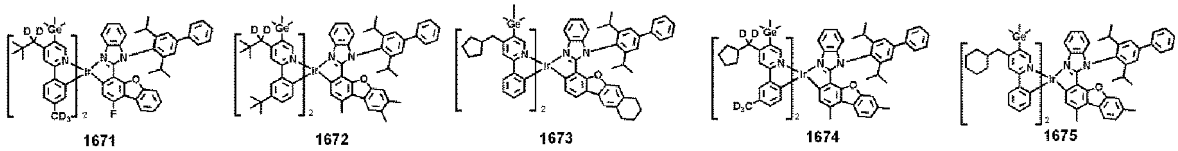
1671 1672 1673 1674 1675

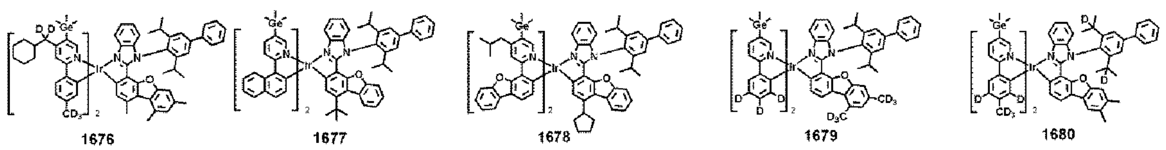
1676 1677 1678 1679 1680

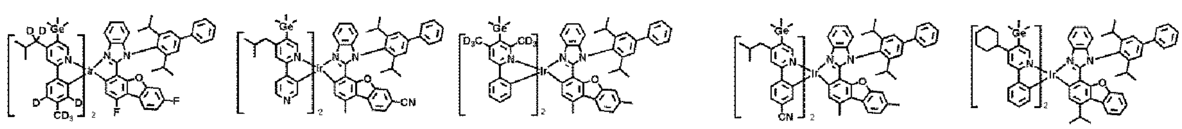
1681 1682 1683 1684 1685

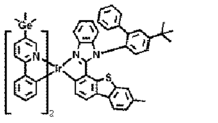
1686
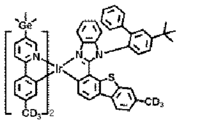
1687
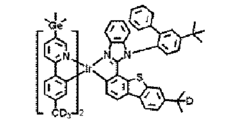
1688
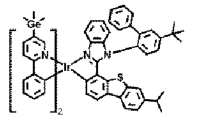
1689
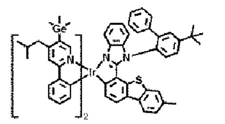
1690

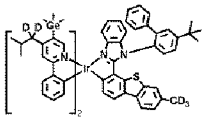
1691
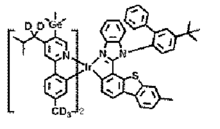
1692
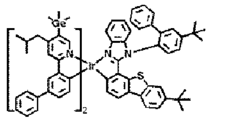
1693
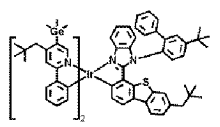
1694
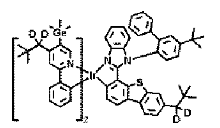
1695

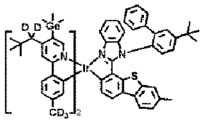
1696
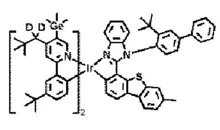
1697
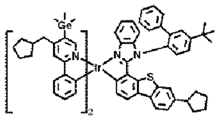
1698
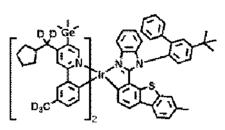
1699
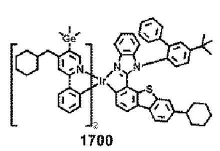
1700

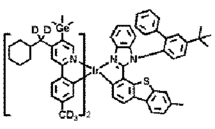
1701
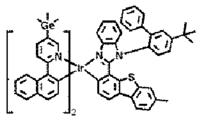
1702
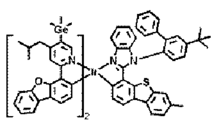
1703
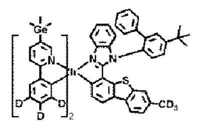
1704
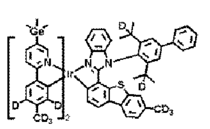
1705

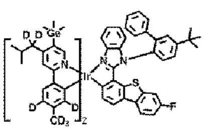
1706
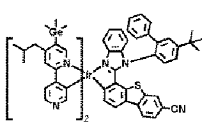
1707
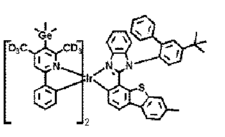
1708
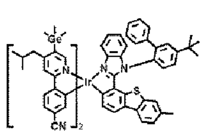
1709
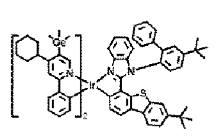
1710

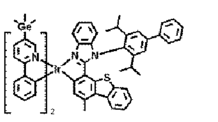
1711
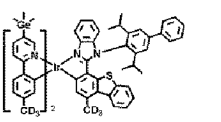
1712
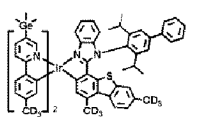
1713
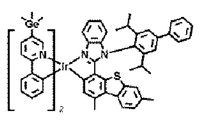
1714
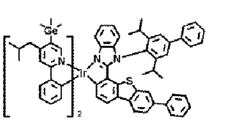
1715

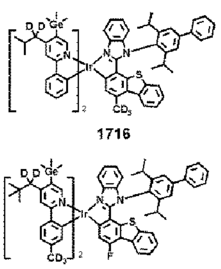
1716
1721
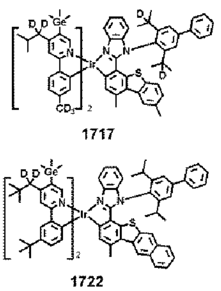
1717
1722
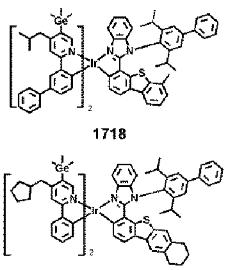
1718
1723
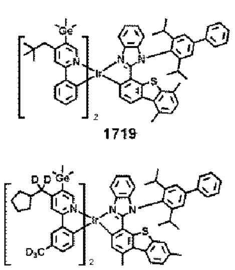
1719
1724
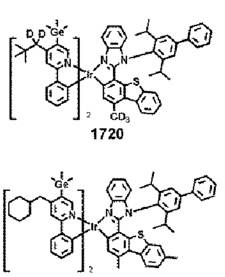
1720
1725

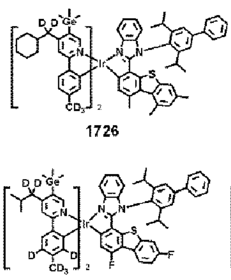
1726
1731
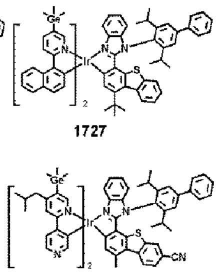
1727
1732
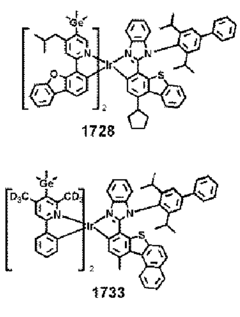
1728
1733
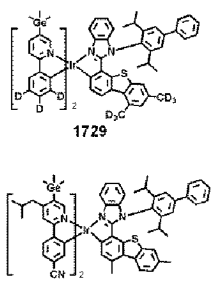
1729
1734
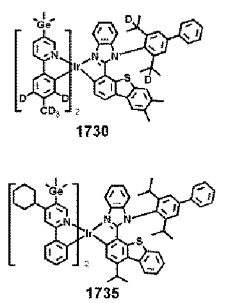
1730
1735

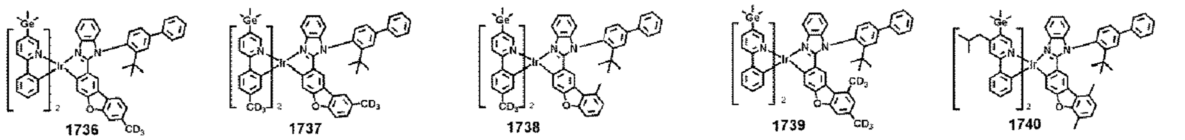
1736 1737 1738 1739 1740

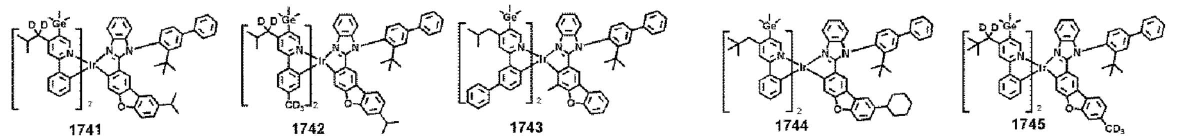
1741 1742 1743 1744 1745

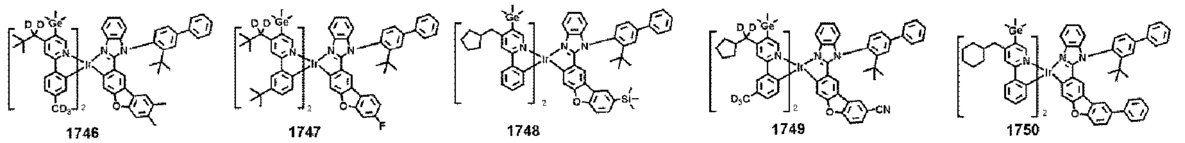
1746 1747 1748 1749 1750

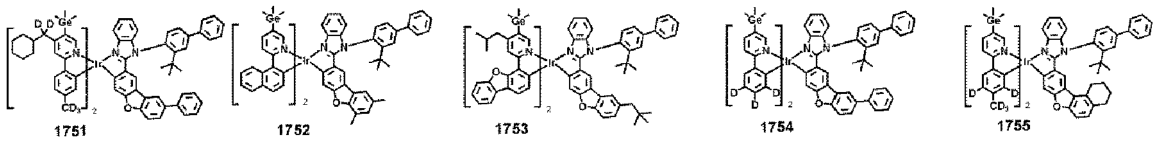
1751 1752 1753 1754 1755

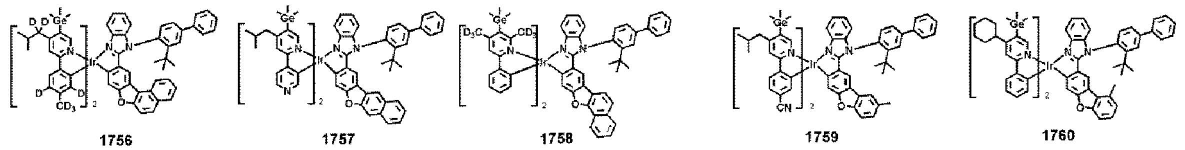
1756 1757 1758 1759 1760

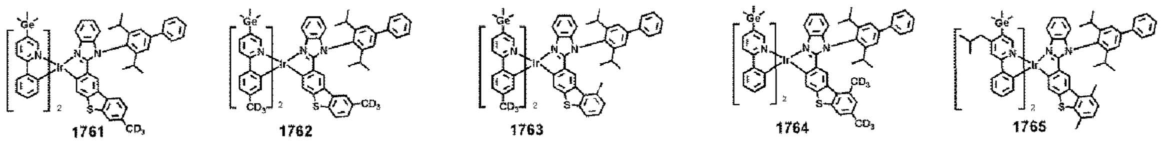
1761 1762 1763 1764 1765

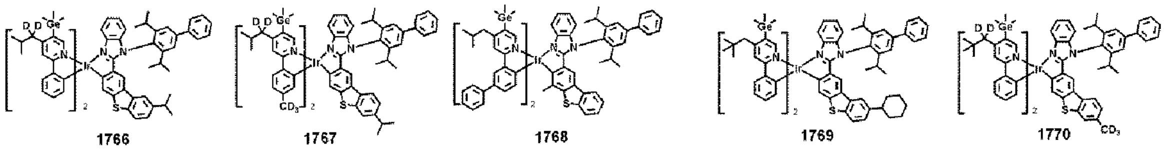
1766 1767 1768 1769 1770

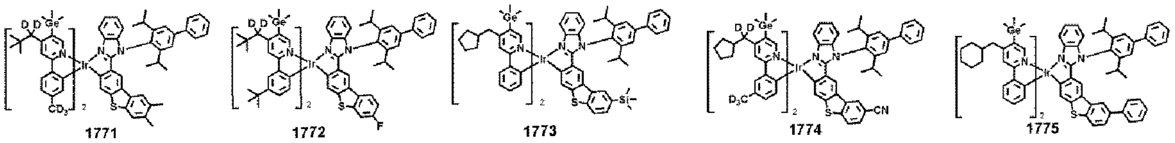
1771 1772 1773 1774 1775

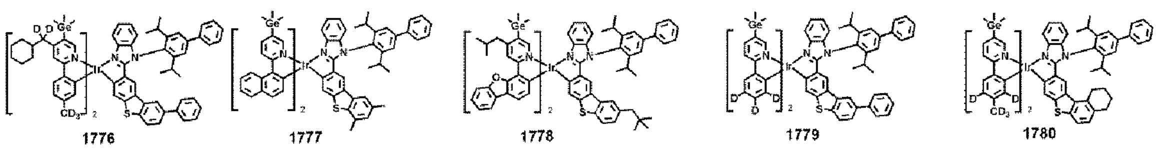
1776 1777 1778 1779 1780

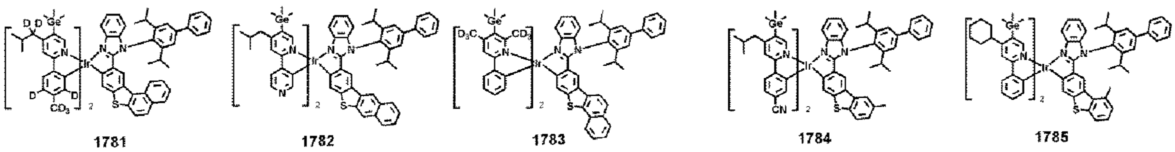
1781 1782 1783 1784 1785

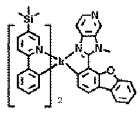
1786

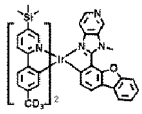
1787

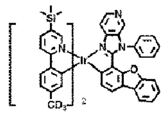
1788

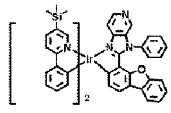
1789

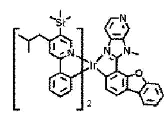
1790

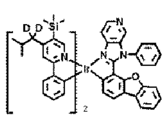
1791

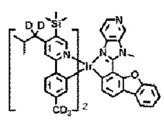
1792

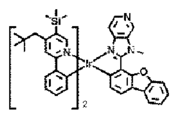
1793

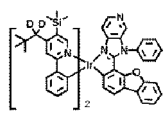
1794

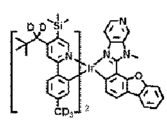
1795

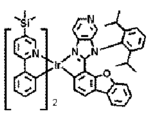
1796

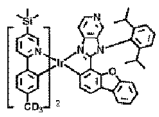
1797

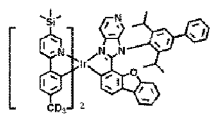
1798

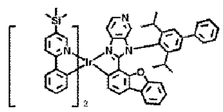
1799

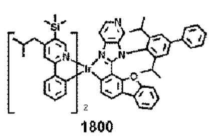
1800

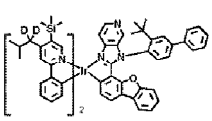
1801

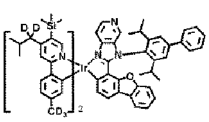
1802

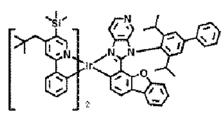
1803

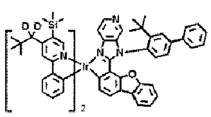
1804

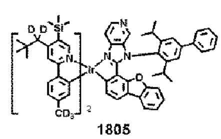
1805

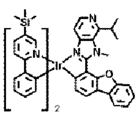
1806

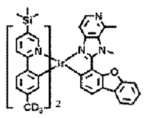
1807

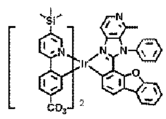
1808

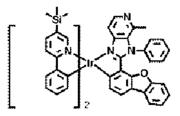
1809

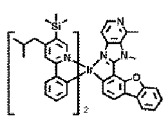
1810

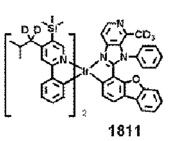
1811

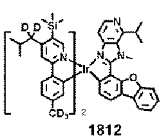
1812

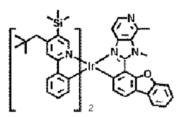
1813

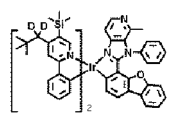
1814

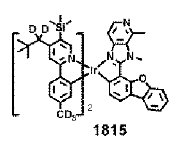
1815

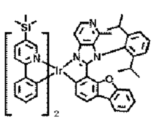
1816

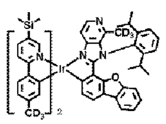
1817

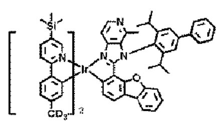
1818

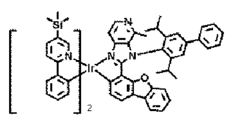
1819

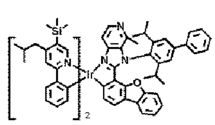
1820

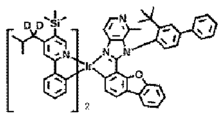
1821

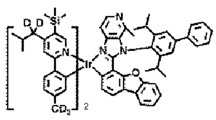
1822

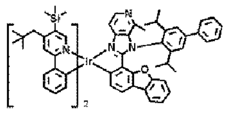
1823

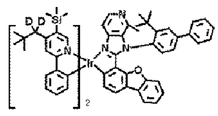
1824

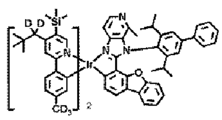
1825

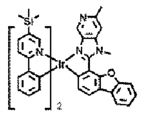
1826

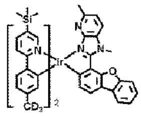
1827

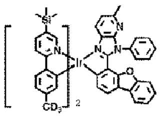
1828

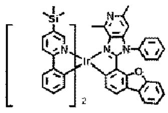
1829

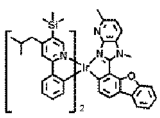
1830

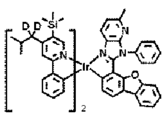
1831

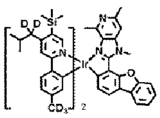
1832

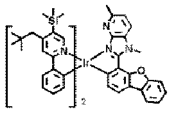
1833

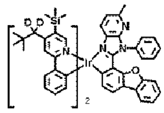
1834

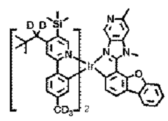
1835

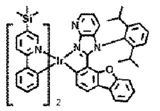
1836

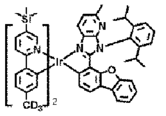
1837

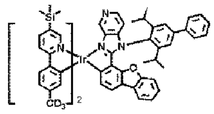
1838

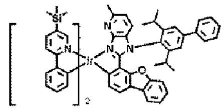
1839

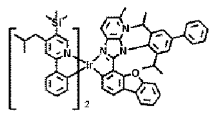
1840

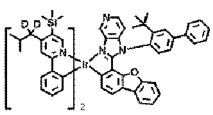
1841

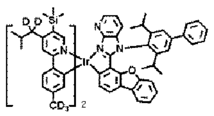
1842

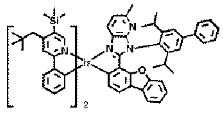
1843

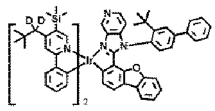
1844

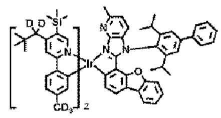
1845

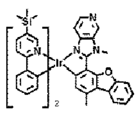
1846

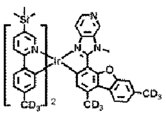
1847

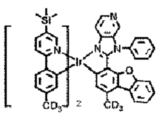
1848

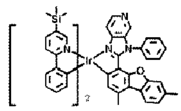
1849

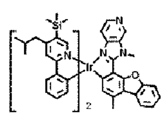
1850

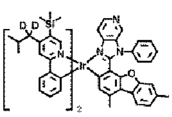
1851

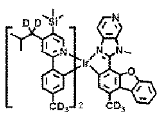
1852

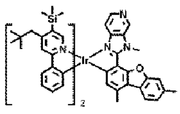
1853

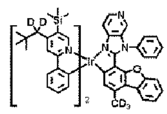
1854

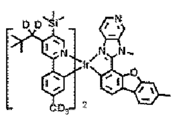
1855

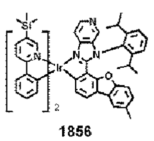
1856

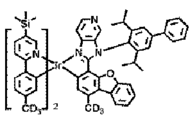
1857

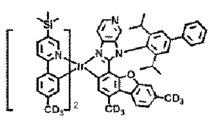
1858

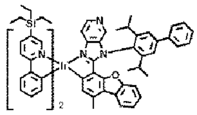
1859

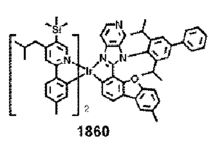
1860

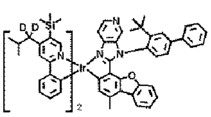
1861

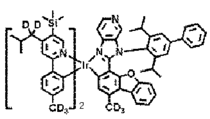
1862

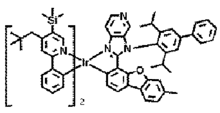
1863

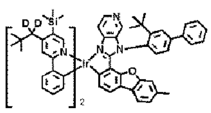
1864

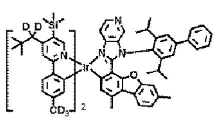
1865

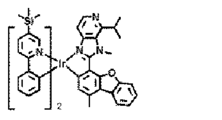
1866

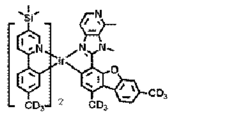
1867

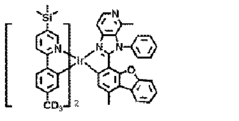
1868

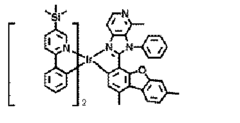
1869

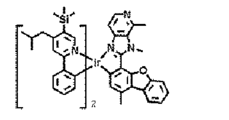
1870

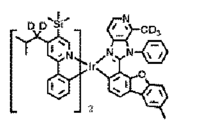
1871

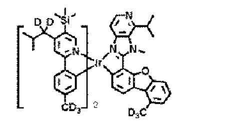
1872

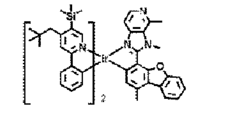
1873

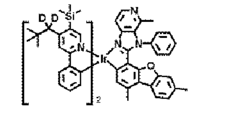
1874

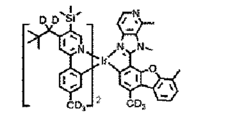
1875

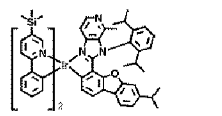
1876

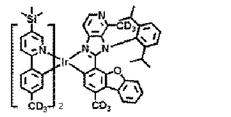
1877

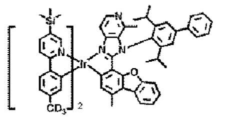
1878

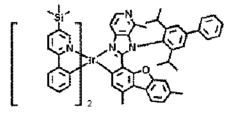
1879

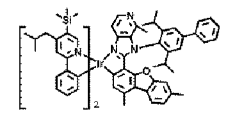
1880

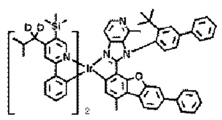
1881

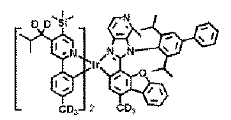
1882

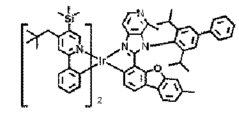
1883

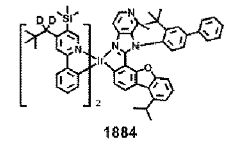
1884

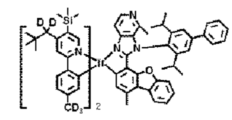
1885

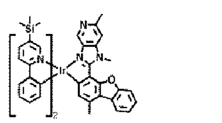
1886

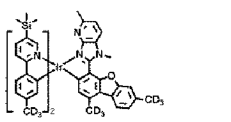
1887

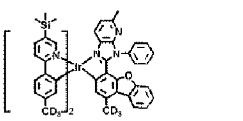
1888

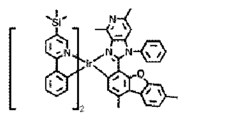
1889

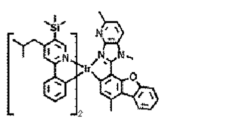
1890

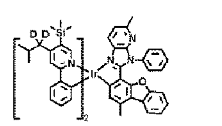
1891

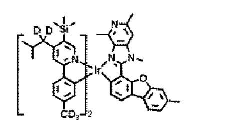
1892

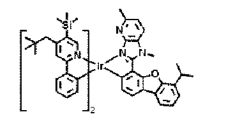
1893

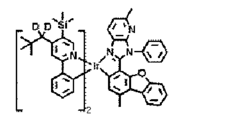
1894

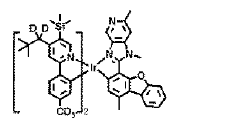
1895

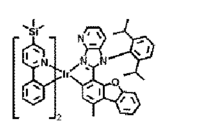
1896

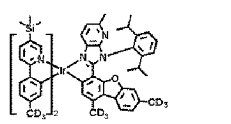
1897

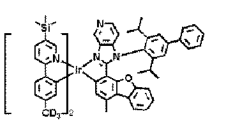
1898

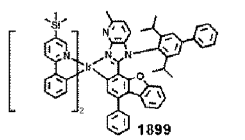
1899

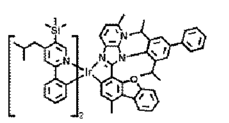
1900

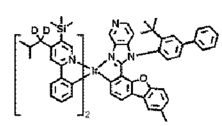
1901

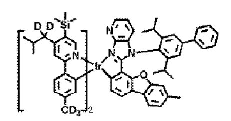
1902

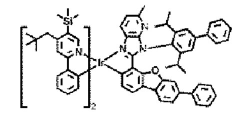
1903

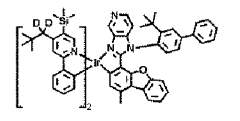
1904

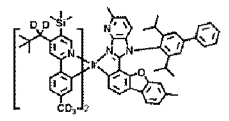
1905

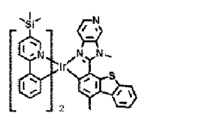
1906
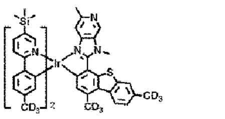
1907
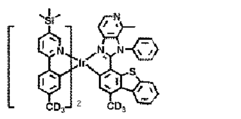
1908
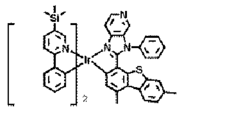
1909
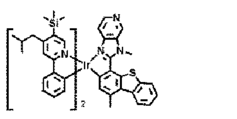
1910

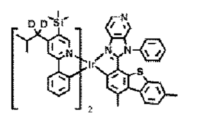
1911
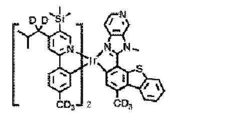
1912
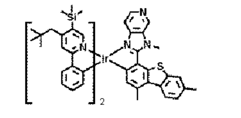
1913
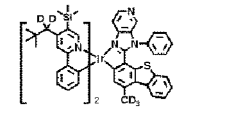
1914
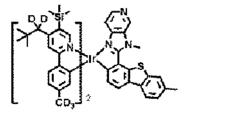
1915

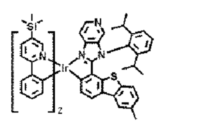
1916
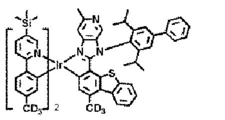
1917
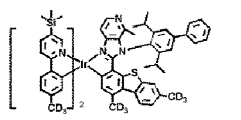
1918
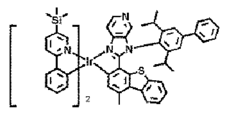
1919
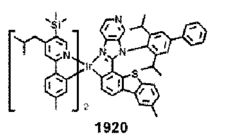
1920

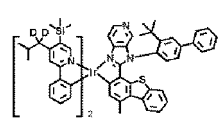
1921
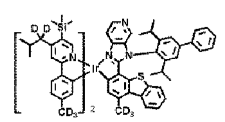
1922
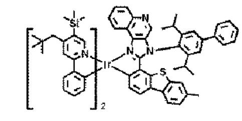
1923
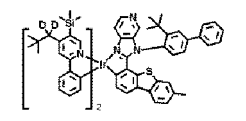
1924
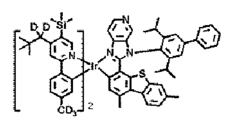
1925

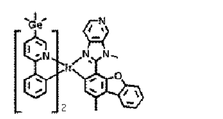
1926
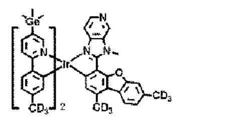
1927
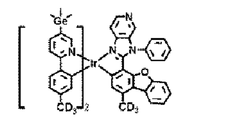
1928
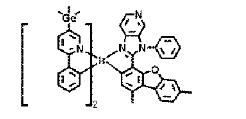
1929
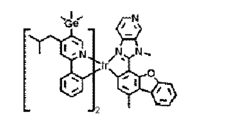
1930

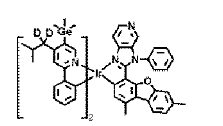
1931
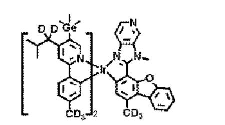
1932
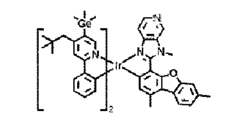
1933
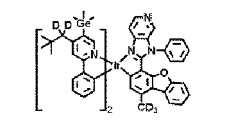
1934
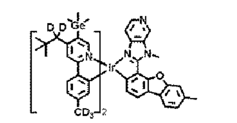
1935

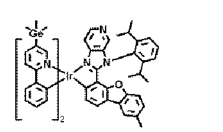
1936
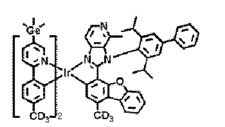
1937
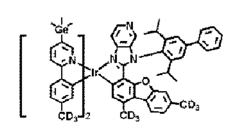
1938
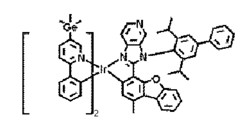
1939
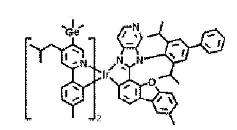
1940

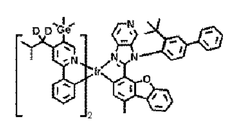
1941
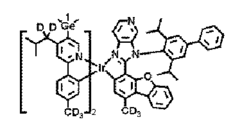
1942
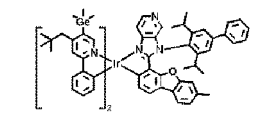
1943
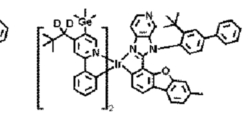
1944
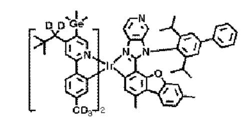
1945

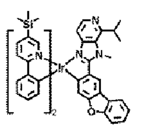
1946
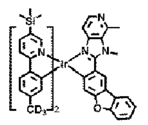
1947
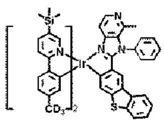
1948
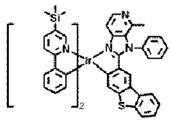
1949
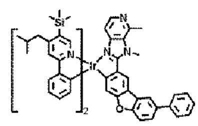
1950
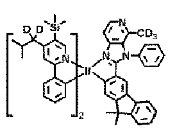
1951
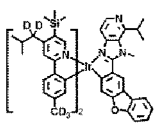
1952
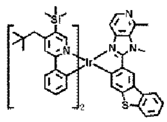
1953
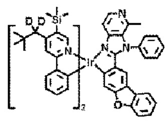
1954
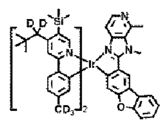
1955
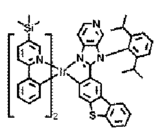
1956
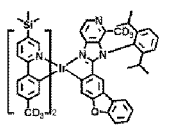
1957
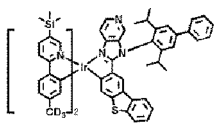
1958
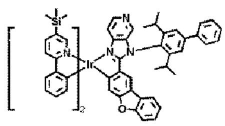
1959
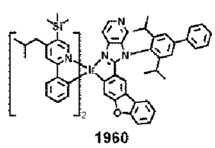
1960
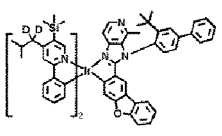
1961
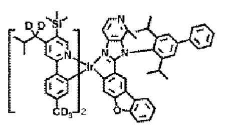
1962
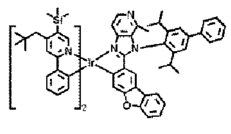
1963
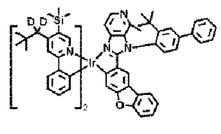
1964
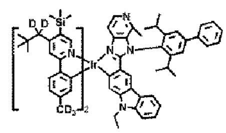
1965
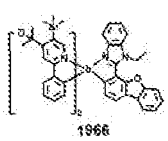
1966
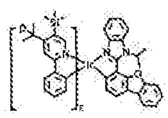
1967
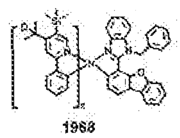
1968
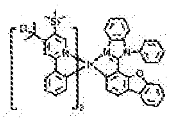
1969
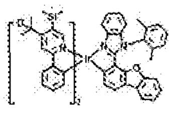
1970
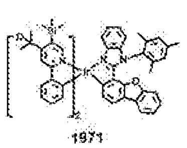
1971
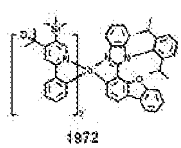
1972
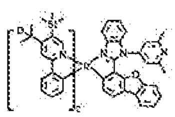
1973
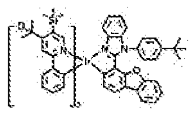
1974
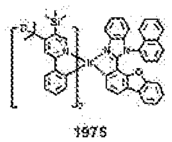
1975
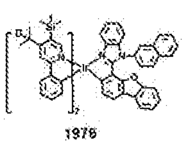
1976
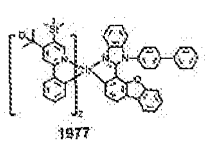
1977
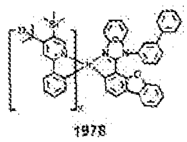
1978
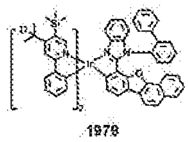
1979
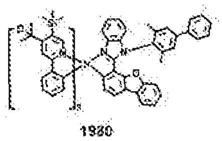
1980
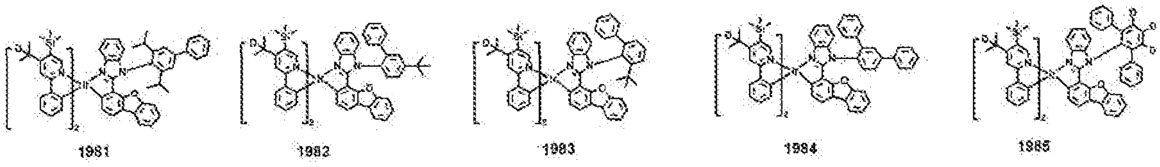
1981 1982 1983 1984 1985
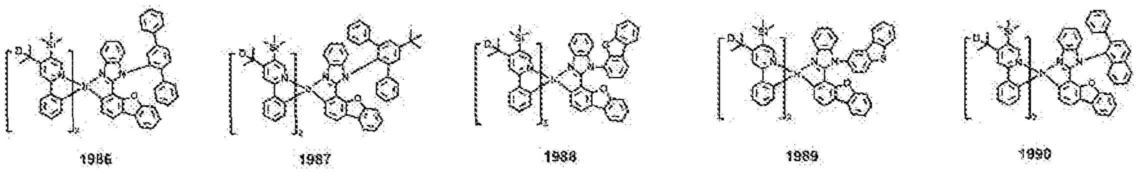
1986 1987 1988 1989 1990

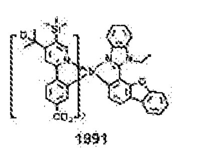
1991
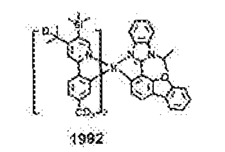
1992
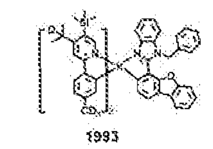
1993
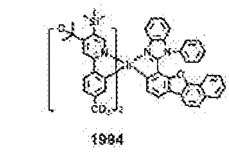
1994
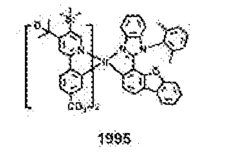
1995
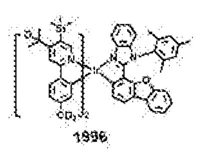
1996
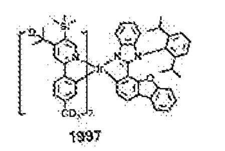
1997
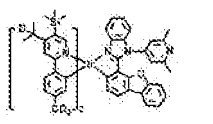
1998
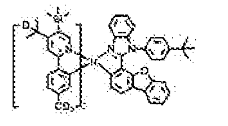
1999
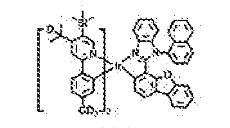
2000
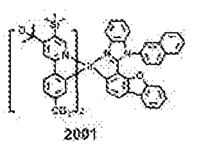
2001
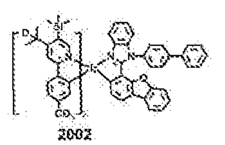
2002
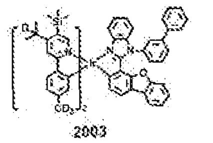
2003
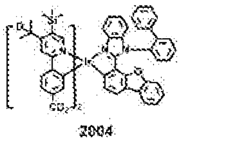
2004
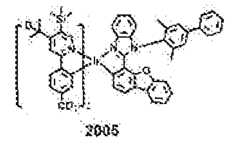
2005
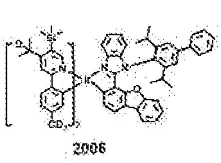
2006
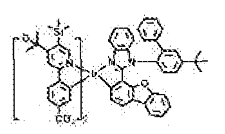
2007
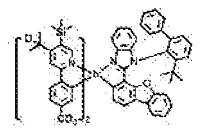
2008
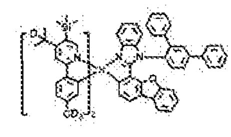
2009
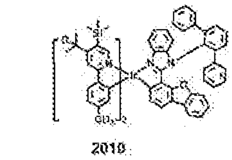
2010
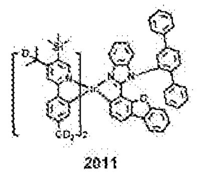
2011
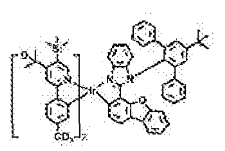
2012
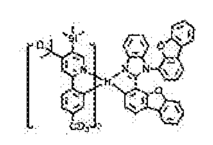
2013
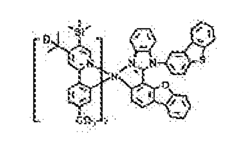
2014
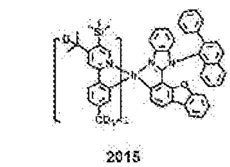
2015
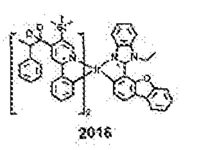
2016
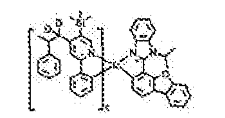
2017
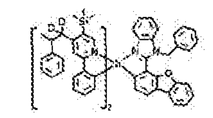
2018
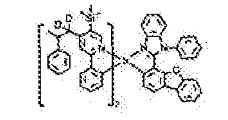
2019
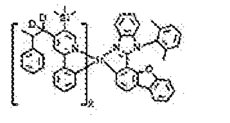
2020
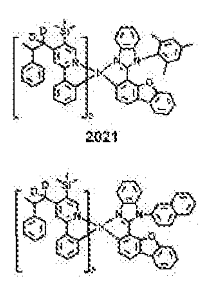
2021
2026
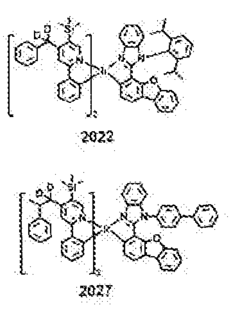
2022
2027
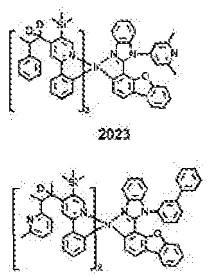
2023
2028
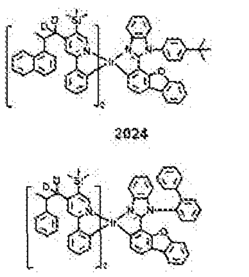
2024
2029
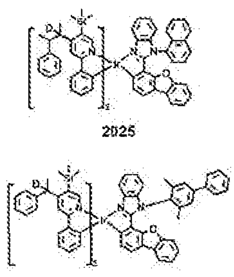
2025
2030
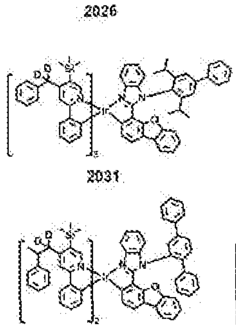
2031
2036
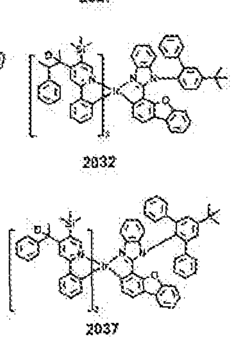
2032
2037
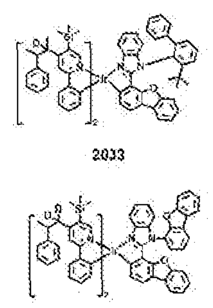
2033
2038
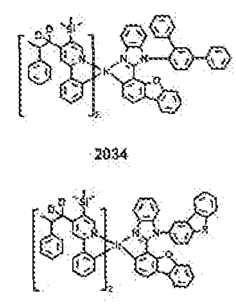
2034
2039
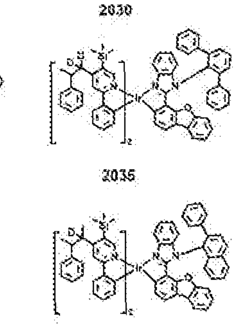
2035
2040

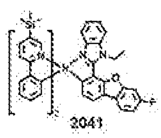
2041
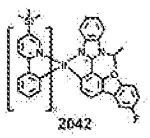
2042
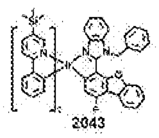
2043
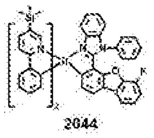
2044
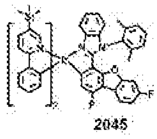
2045

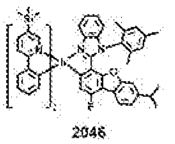
2046
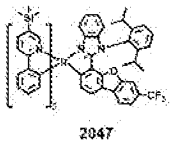
2047
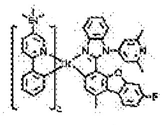
2048
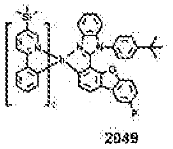
2049
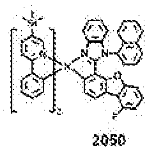
2050

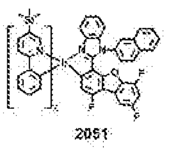
2051
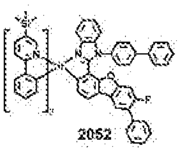
2052
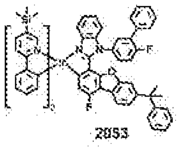
2053
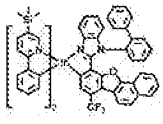
2054
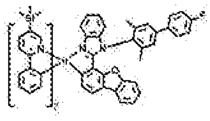
2055

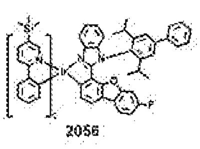
2056
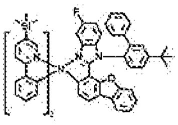
2057
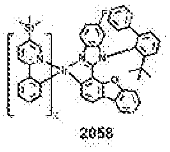
2058
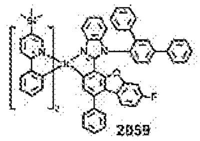
2059
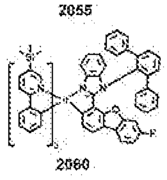
2060

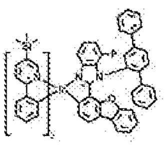
2061
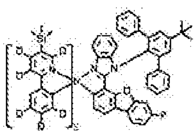
2062
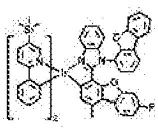
2063
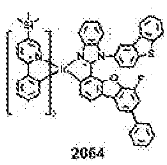
2064
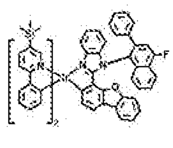
2065

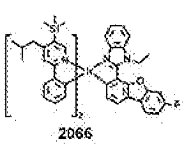
2066
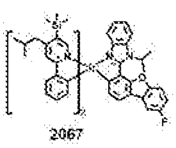
2067
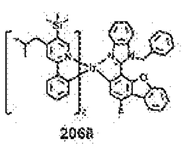
2068
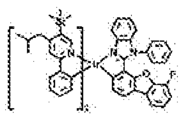
2069
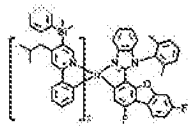
2070

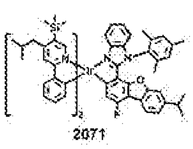
2071
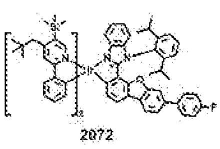
2072
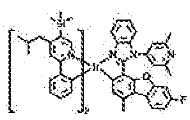
2073
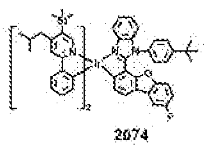
2074
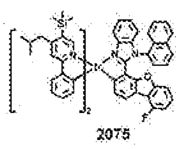
2075

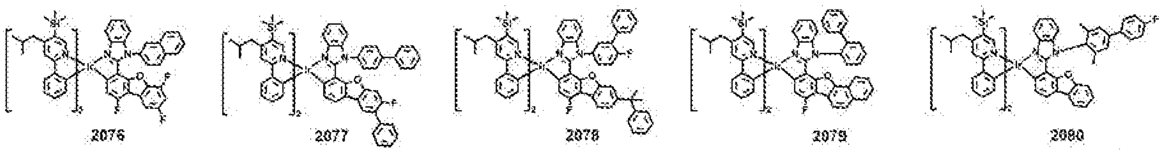
2076
2077
2078
2079
2080

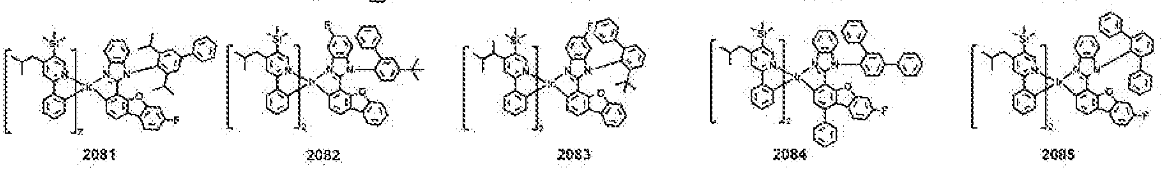
2081
2082
2083
2084
2085

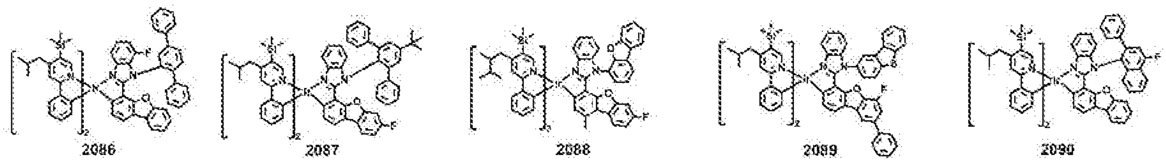
2086
2087
2088
2089
2090

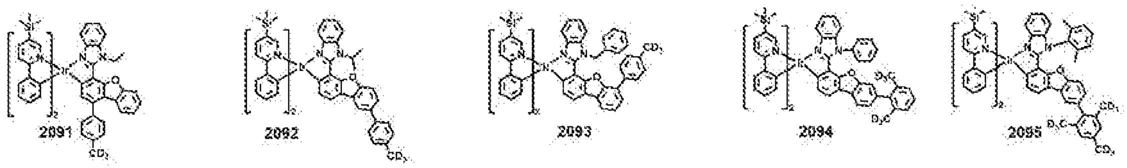

2091 2092 2093 2094 2095

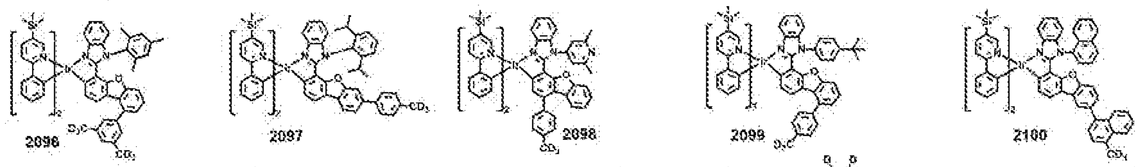

2096 2097 2098 2099 2100

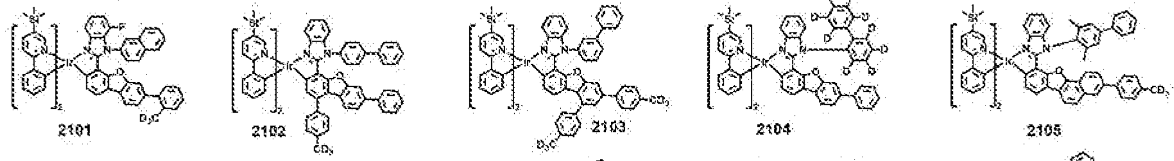

2101 2102 2103 2104 2105

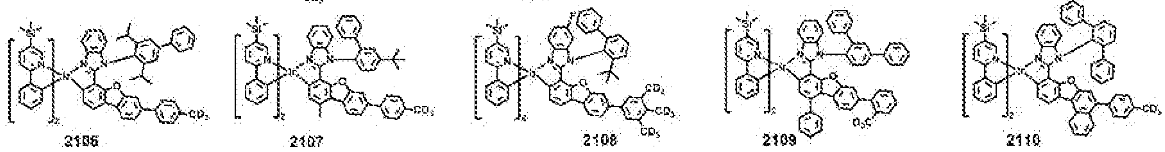

2106 2107 2108 2109 2110

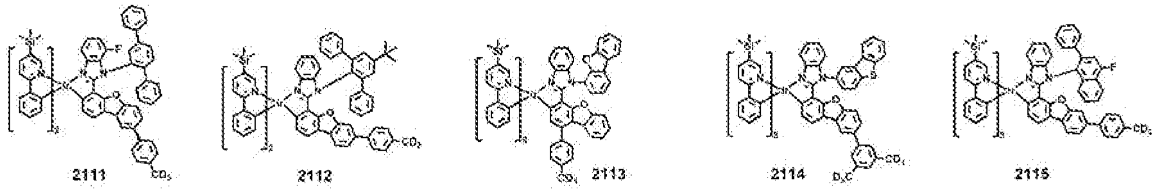

2111 2112 2113 2114 2115

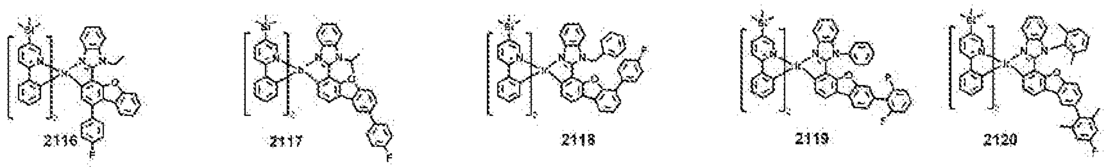

2116 2117 2118 2119 2120

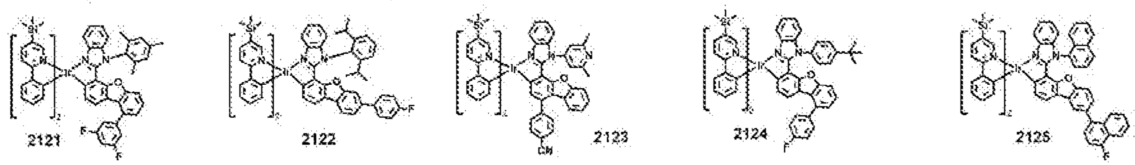

2121 2122 2123 2124 2125

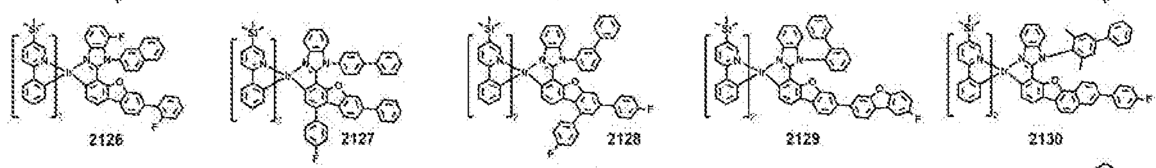

2126 2127 2128 2129 2130

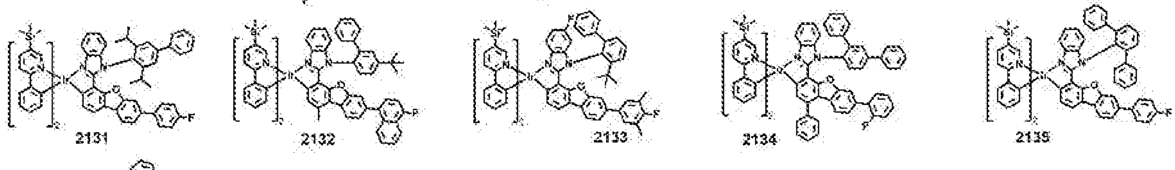

2131 2132 2133 2134 2135

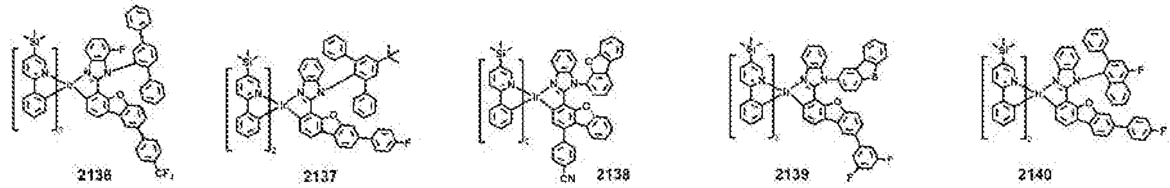

2136 2137 2138 2139 2140

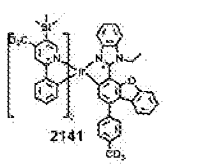
2141
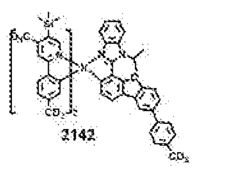
2142
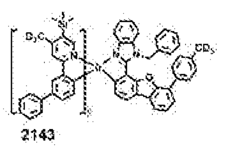
2143
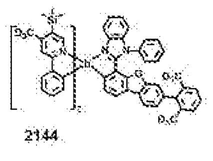
2144
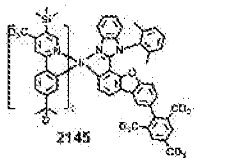
2145

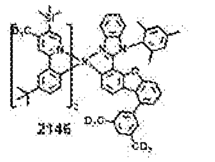
2146
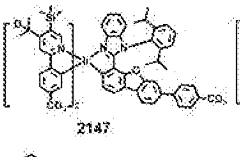
2147
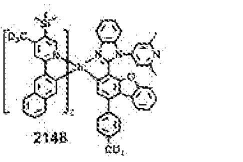
2148
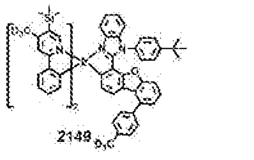
2149
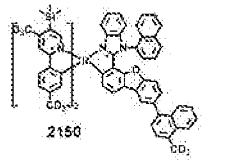
2150

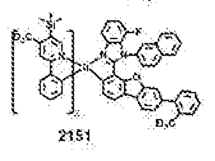
2151
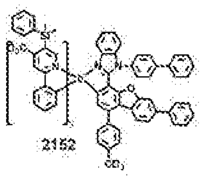
2152
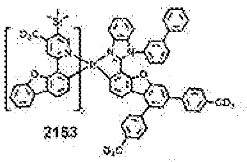
2153
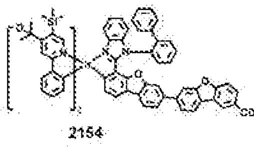
2154
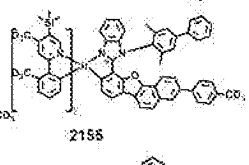
2155

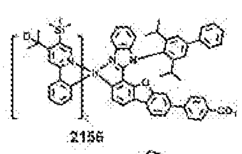
2156
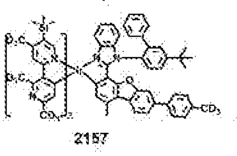
2157
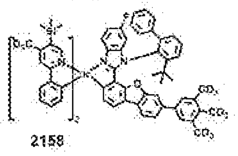
2158
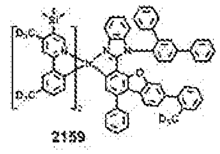
2159
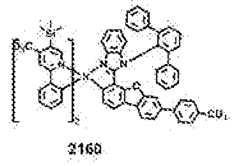
2160

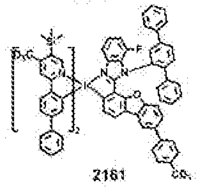
2161
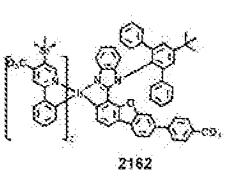
2162
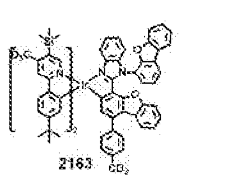
2163
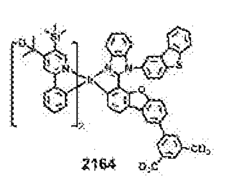
2164
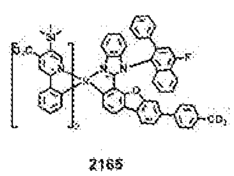
2165

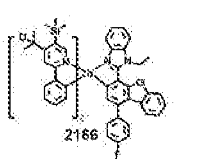
2166
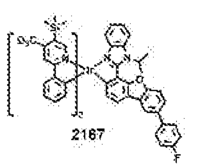
2167
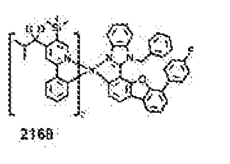
2168
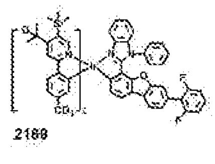
2169
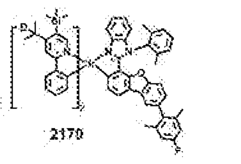
2170

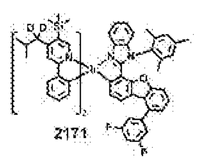
2171
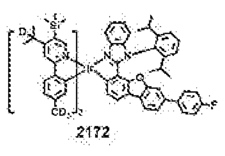
2172
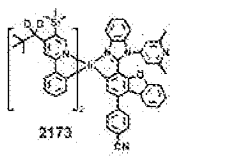
2173
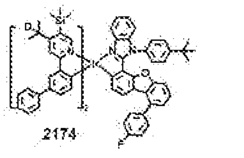
2174
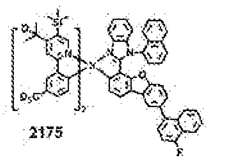
2175

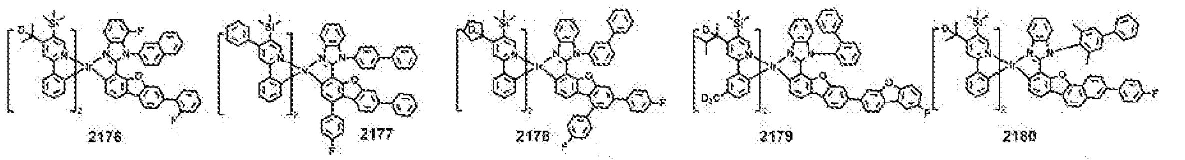
2176 2177 2178 2179 2180

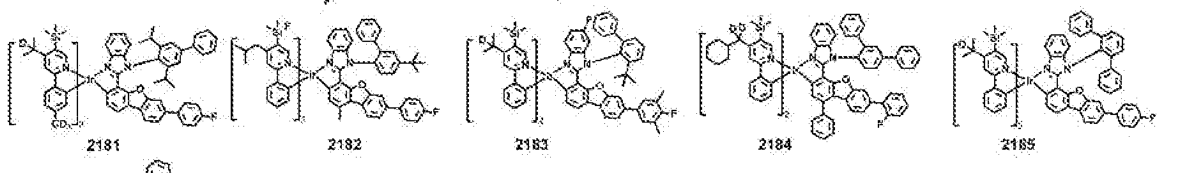
2181 2182 2183 2184 2185

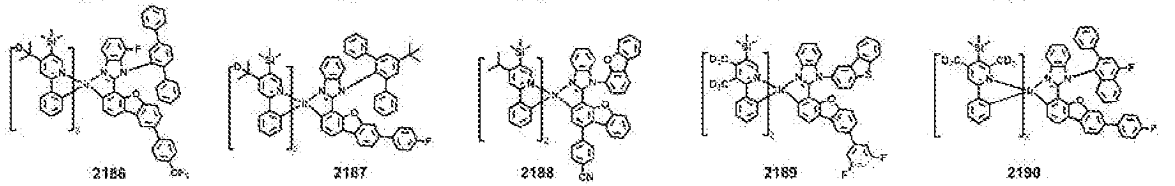
2186 2187 2188 2189 2190

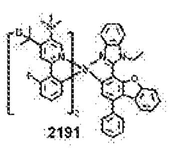
2191
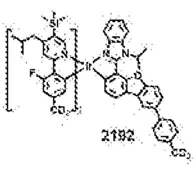
2192
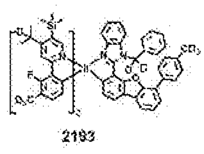
2193
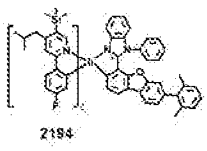
2194
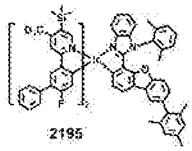
2195
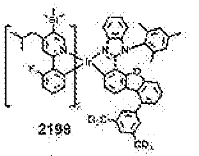
2196
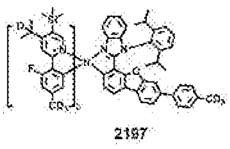
2197
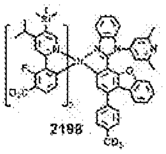
2198
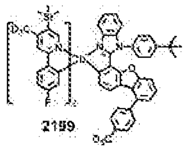
2199
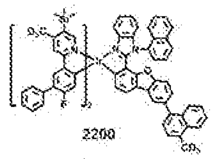
2200
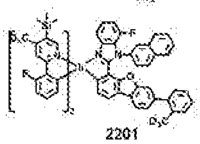
2201
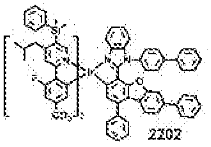
2202
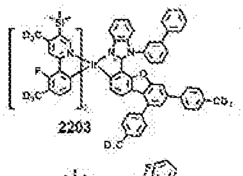
2203
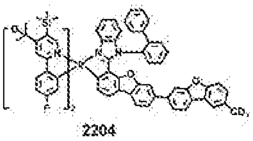
2204
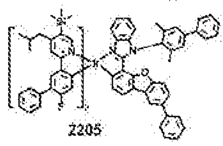
2205
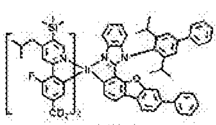
2206
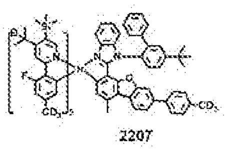
2207
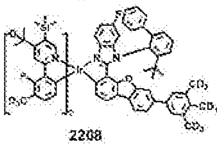
2208
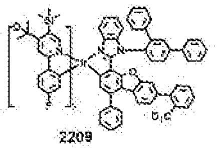
2209
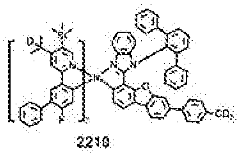
2210
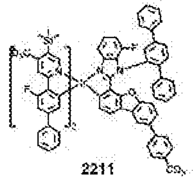
2211
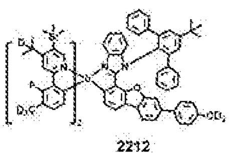
2212
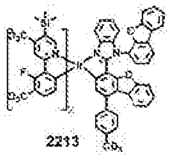
2213
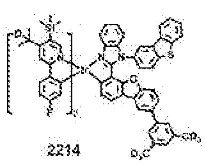
2214
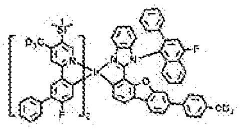
2215
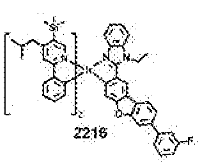
2216
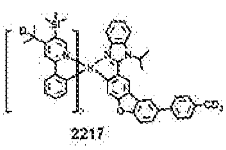
2217
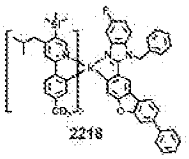
2218
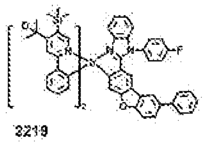
2219
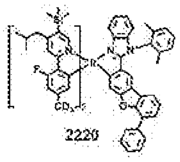
2220
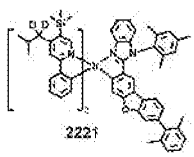
2221
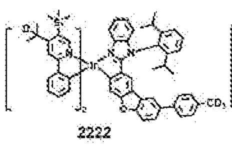
2222
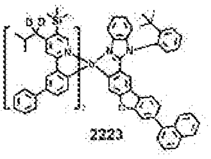
2223
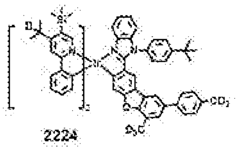
2224
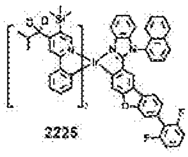
2225
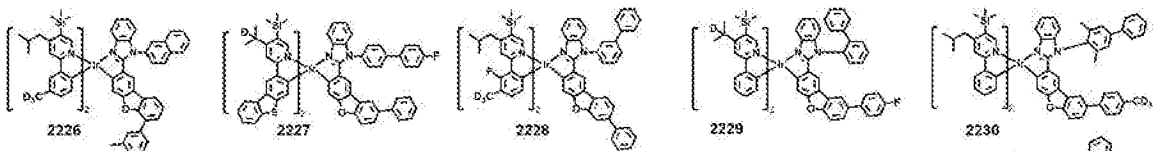
2226 2227 2228 2229 2230
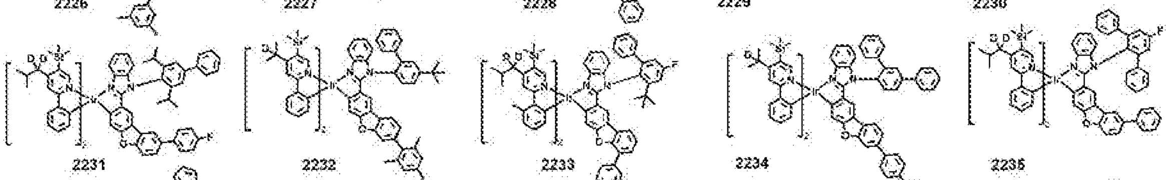
2231 2232 2233 2234 2235
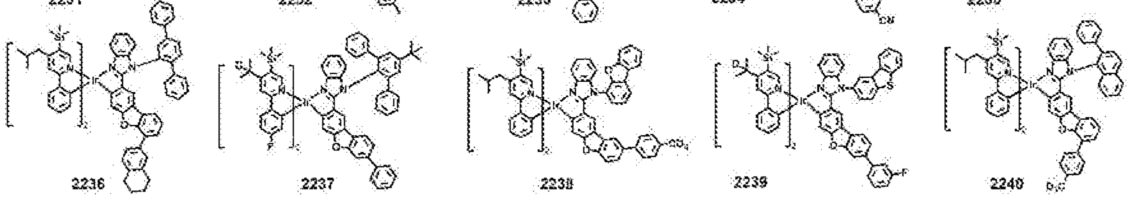
2236 2237 2238 2239 2240

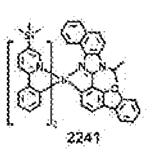
2241
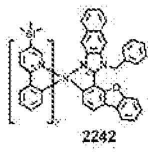
2242
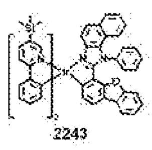
2243
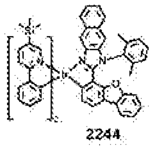
2244
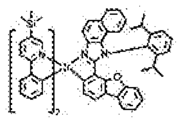
2245
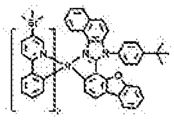
2246
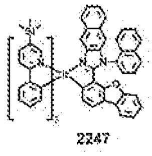
2247
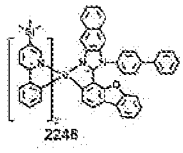
2248
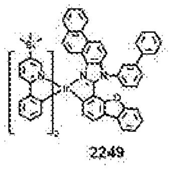
2249
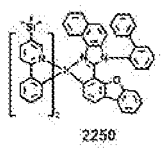
2250
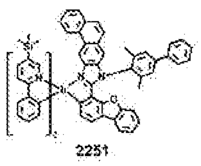
2251
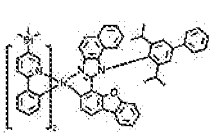
2252
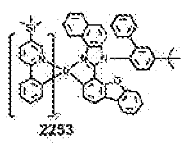
2253
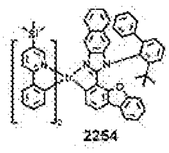
2254
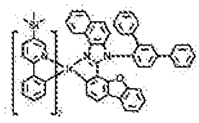
2255
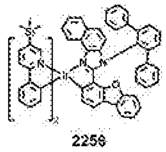
2256
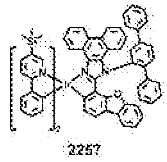
2257
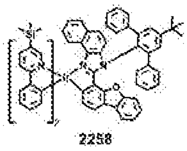
2258
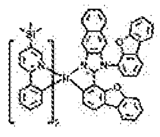
2259
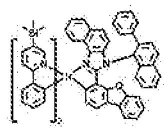
2260
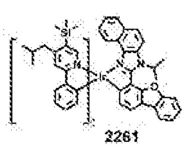
2261
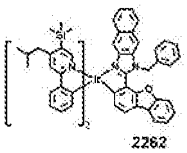
2262
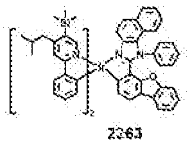
2263
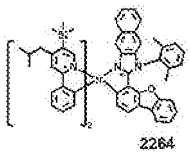
2264
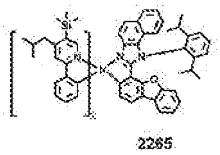
2265
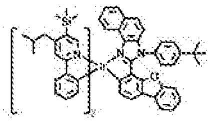
2266
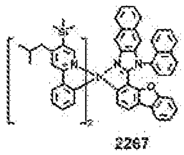
2267
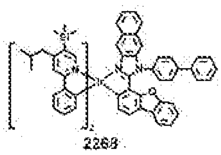
2268
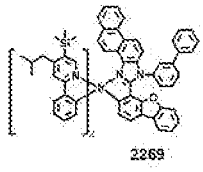
2269
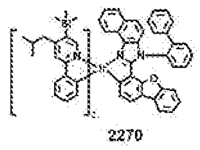
2270
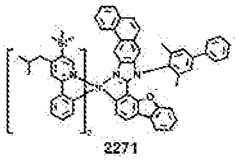
2271
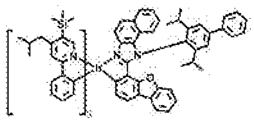
2272
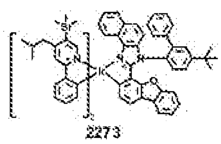
2273
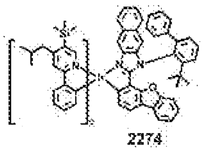
2274
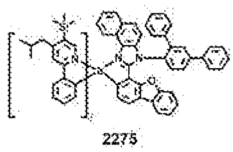
2275
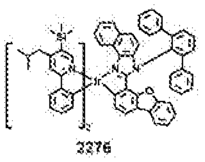
2276
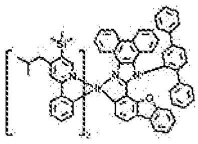
2277
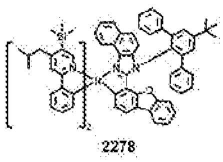
2278
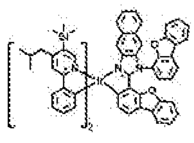
2279
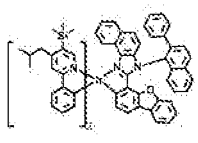
2280

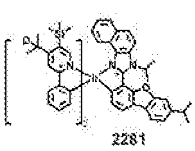
2281
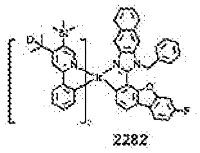
2282
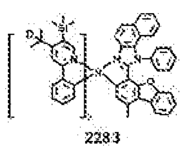
2283
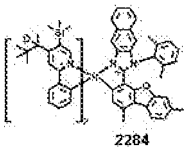
2284
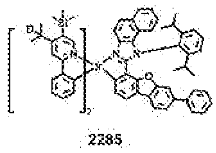
2285
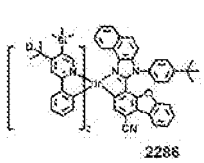
2286
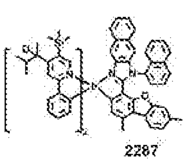
2287
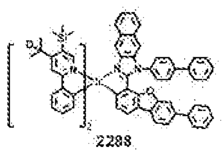
2288
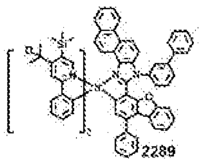
2289
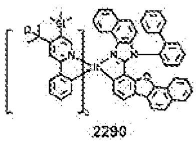
2290
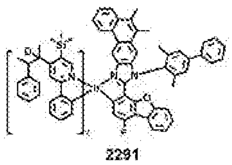
2291
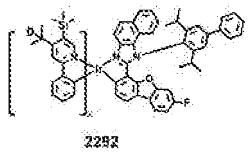
2292
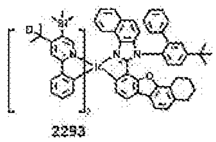
2293
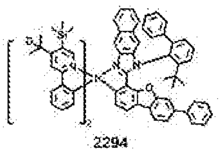
2294
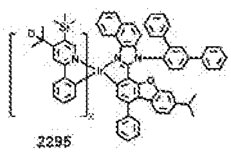
2295
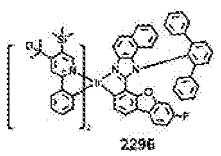
2296
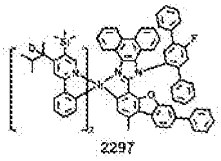
2297
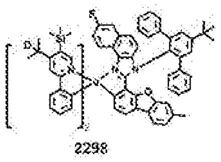
2298
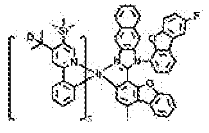
2299
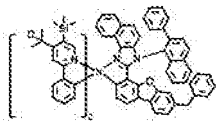
2300
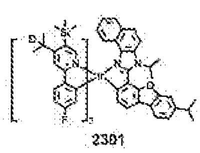
2301
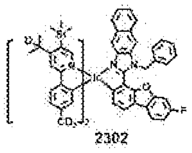
2302
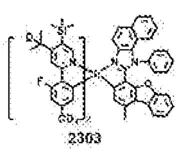
2303
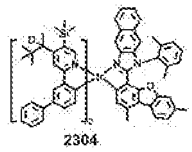
2304
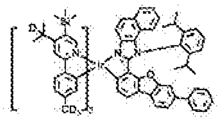
2305
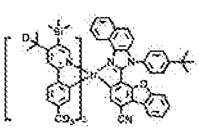
2306
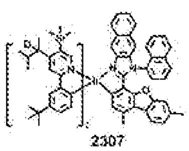
2307
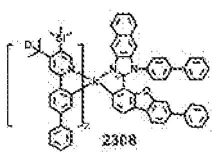
2308
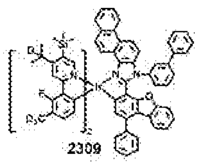
2309
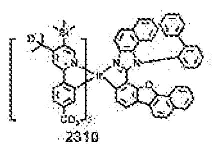
2310
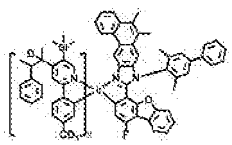
2311
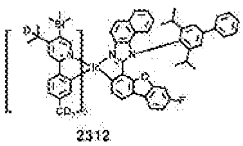
2312
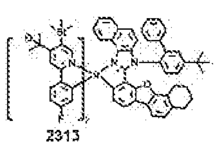
2313
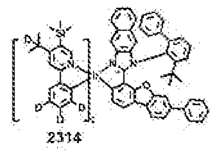
2314
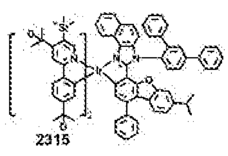
2315
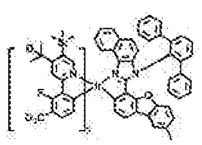
2316
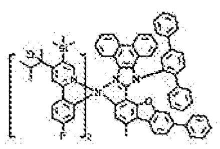
2317
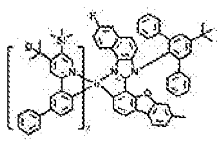
2318
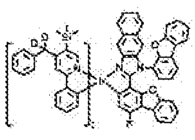
2319
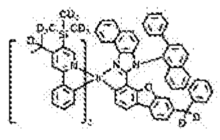
2320

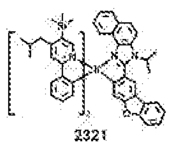
2321
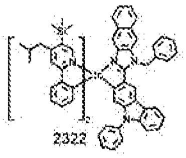
2322
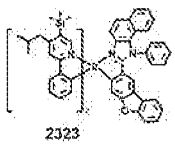
2323
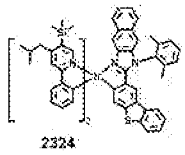
2324
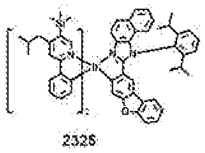
2325

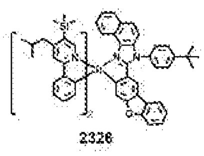
2326
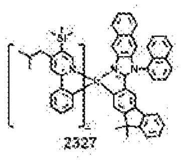
2327
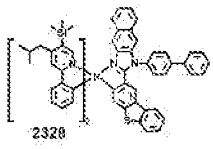
2328
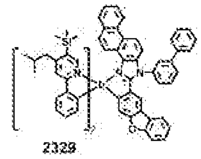
2329
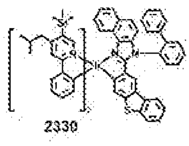
2330

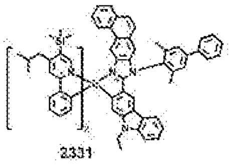
2331
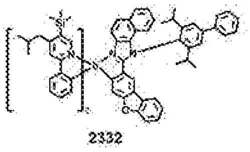
2332
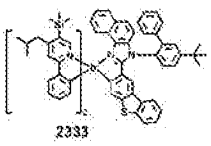
2333
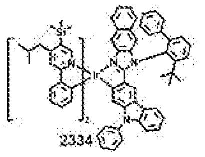
2334
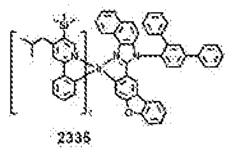
2335

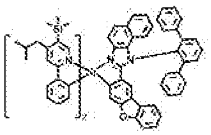
2336
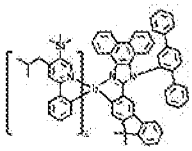
2337
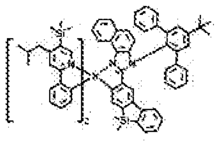
2338
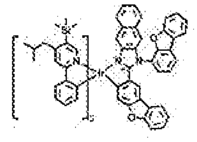
2339
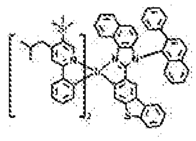
2340

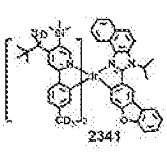
2341
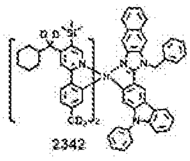
2342
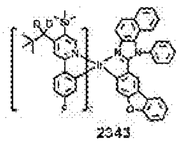
2343
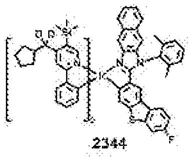
2344
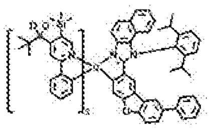
2345

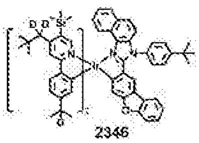
2346
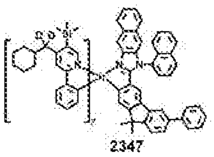
2347
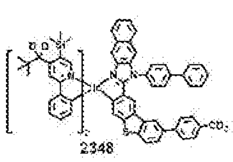
2348
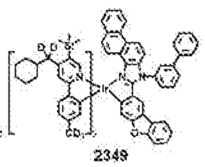
2349
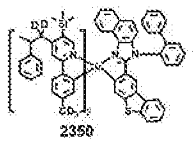
2350

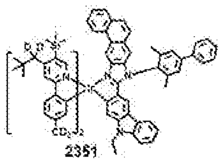
2351
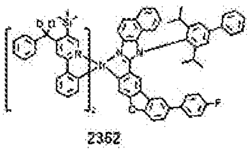
2352
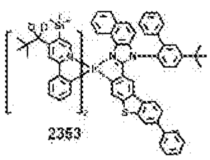
2353
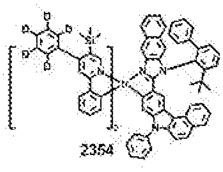
2354
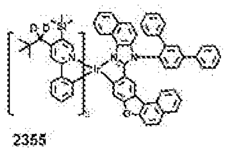
2355

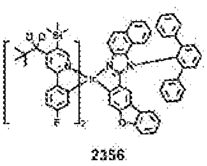
2356
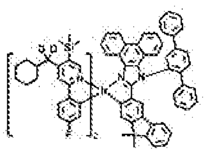
2357
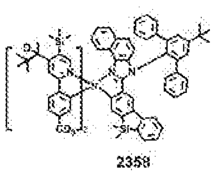
2358
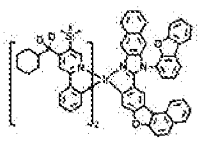
2359
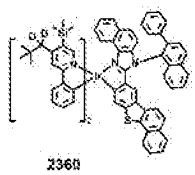
2360

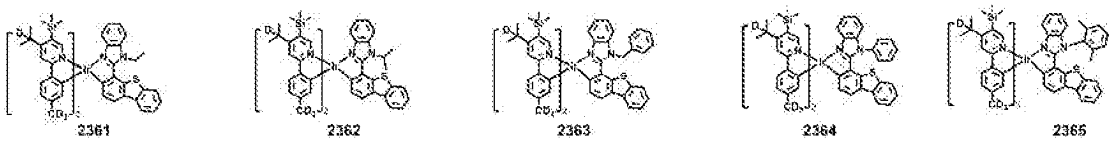
2361 2362 2363 2364 2365

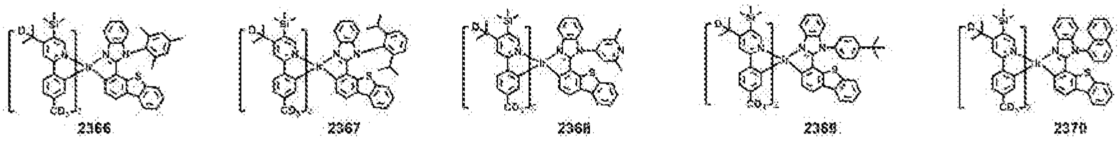
2366 2367 2368 2369 2370

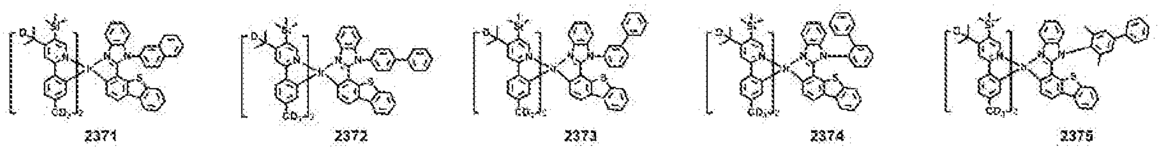
2371 2372 2373 2374 2375

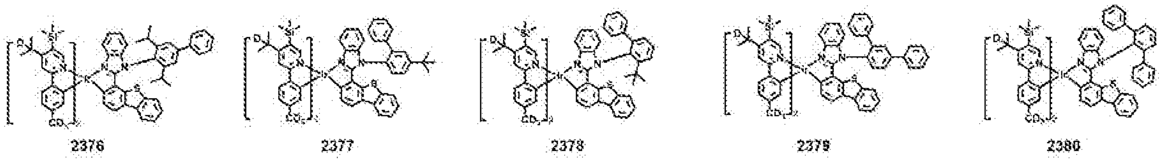
2376 2377 2378 2379 2380

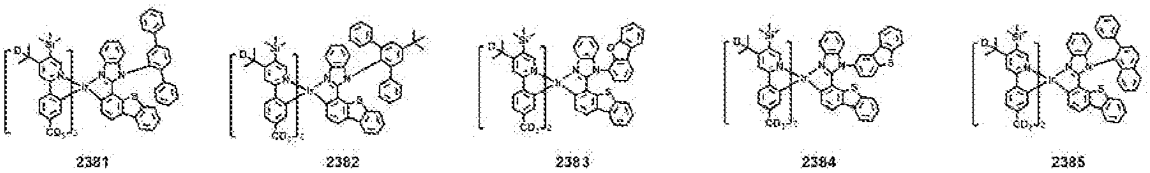
2381 2382 2383 2384 2385

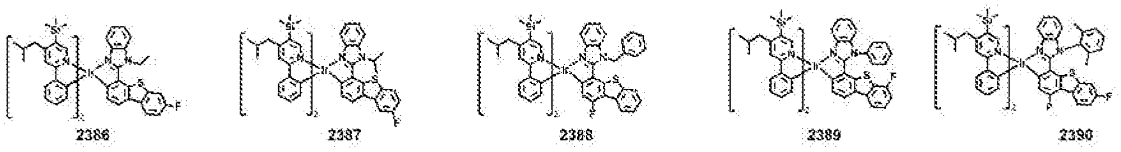
2386 2387 2388 2389 2390

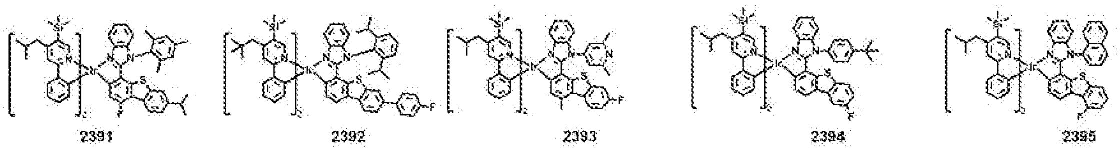
2391 2392 2393 2394 2395

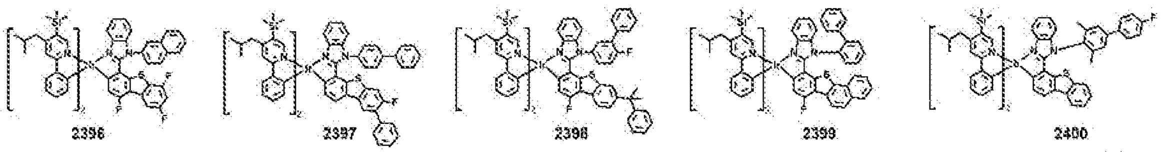
2396 2397 2398 2399 2400

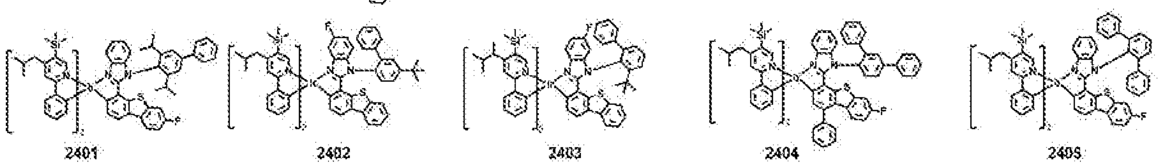
2401 2402 2403 2404 2405

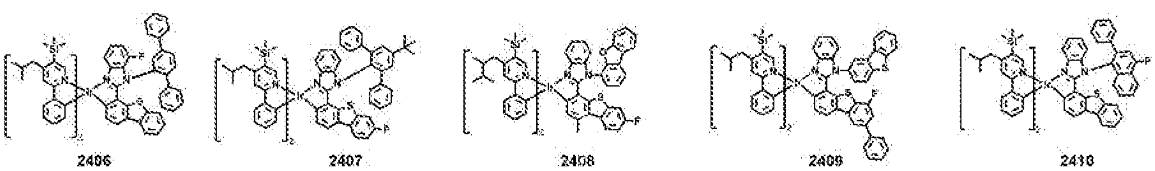
2406 2407 2408 2409 2410

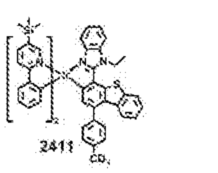
2411
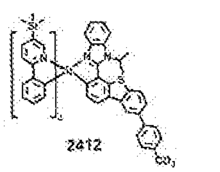
2412
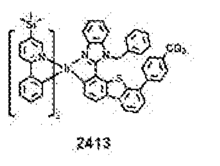
2413
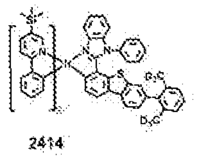
2414
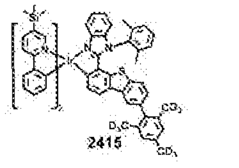
2415
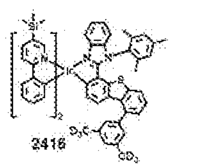
2416
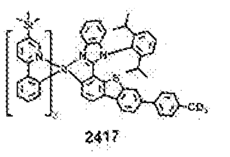
2417
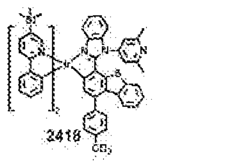
2418
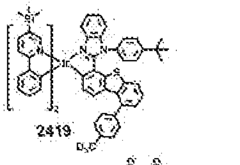
2419
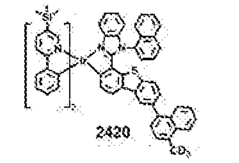
2420
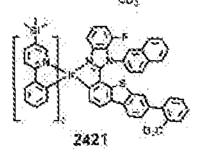
2421
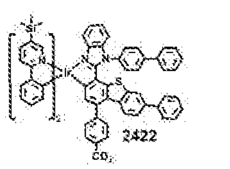
2422
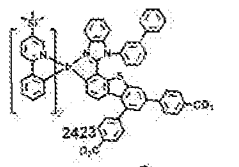
2423
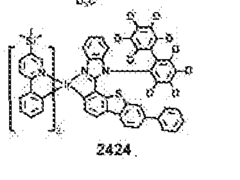
2424
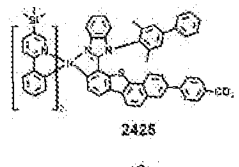
2425
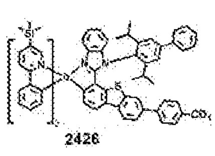
2426
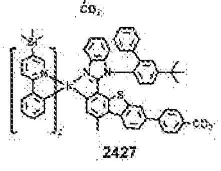
2427
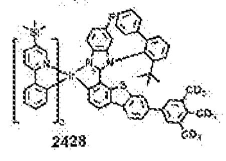
2428
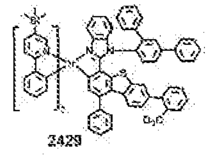
2429
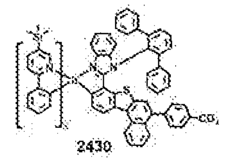
2430
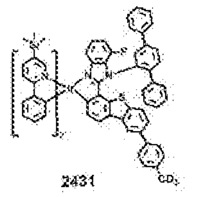
2431
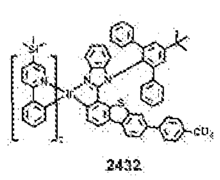
2432
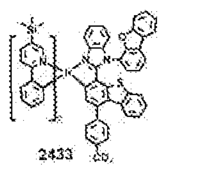
2433
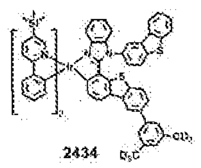
2434
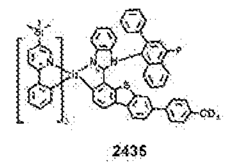
2435
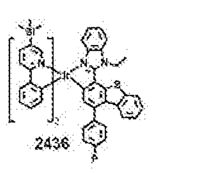
2436
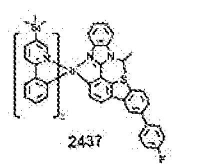
2437
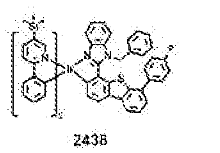
2438
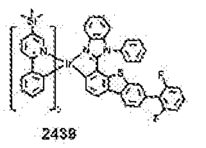
2439
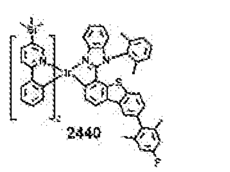
2440
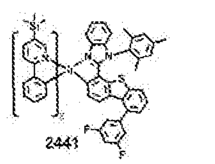
2441
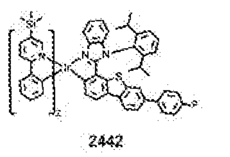
2442
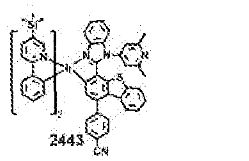
2443
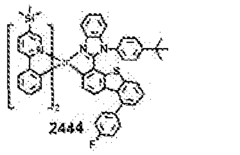
2444
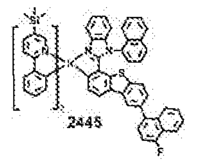
2445
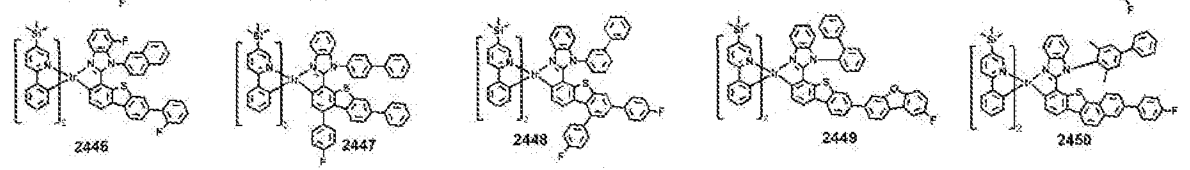
2446 2447 2448 2449 2450
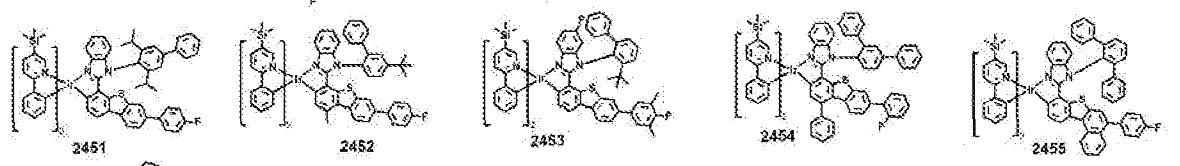
2451 2452 2453 2454 2455
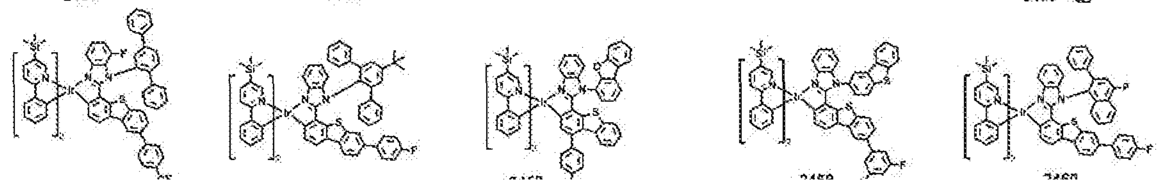

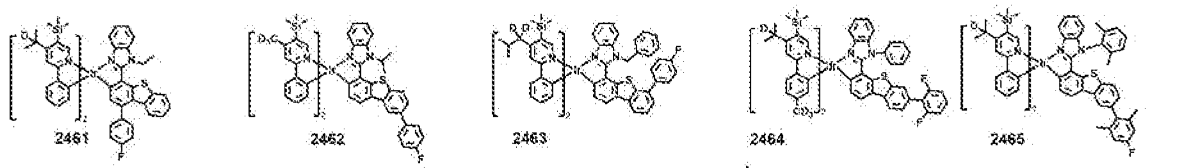

2461 2462 2463 2464 2465

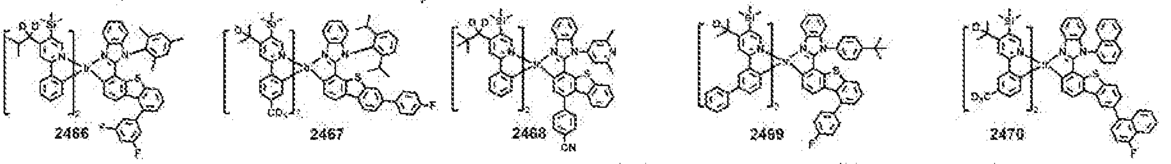

2466 2467 2468 2469 2470

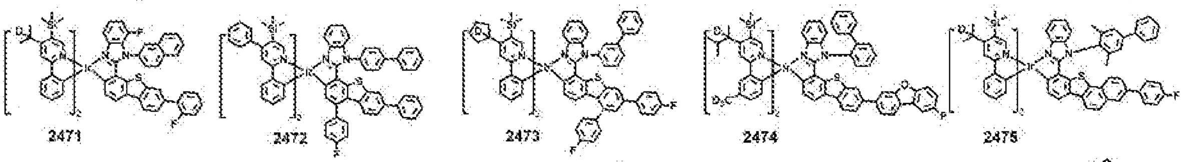

2471 2472 2473 2474 2475

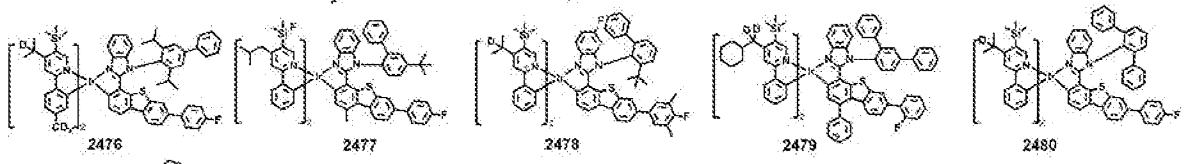

2476 2477 2478 2479 2480

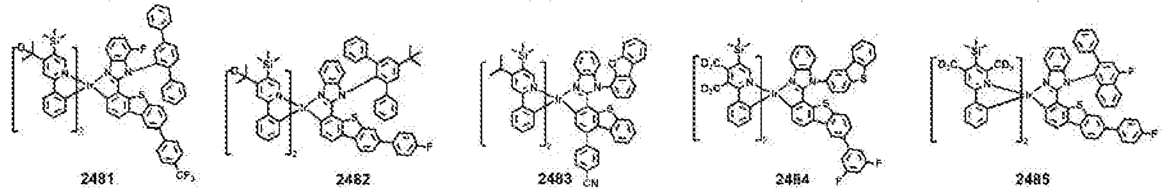

2481 2482 2483 2484 2485

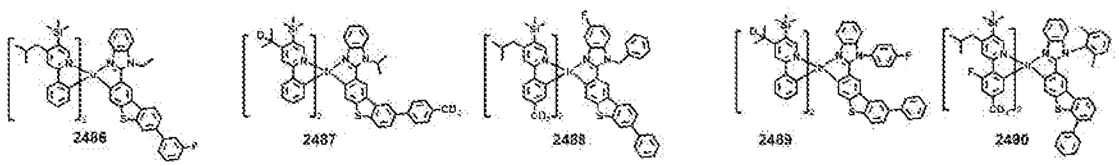

2486 2487 2488 2489 2490

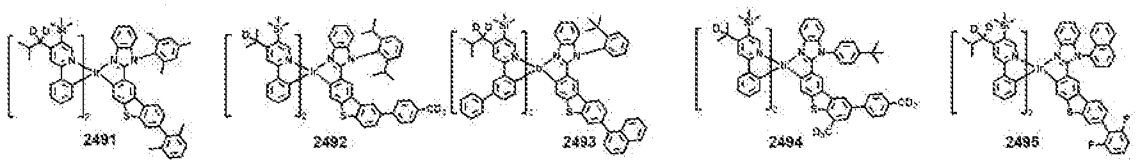

2491 2492 2493 2494 2495

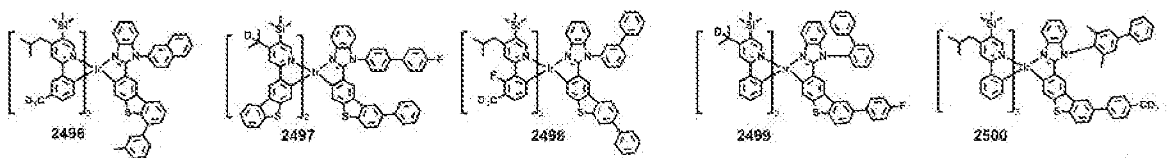

2496 2497 2498 2499 2500

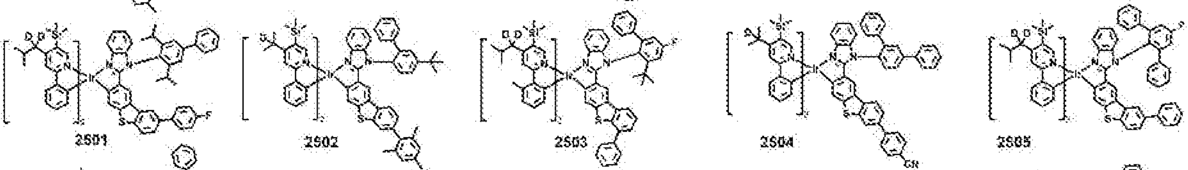

2501 2502 2503 2504 2505

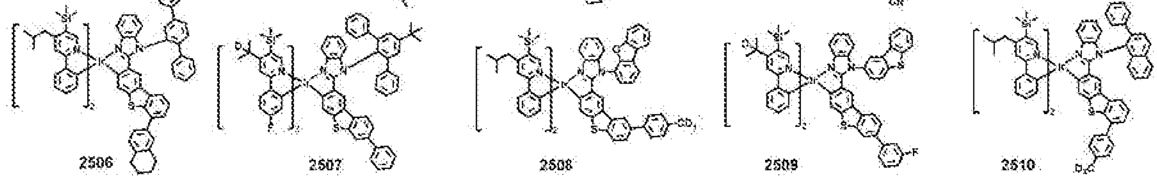

2506 2507 2508 2509 2510

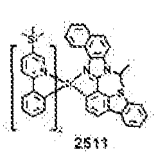
2511
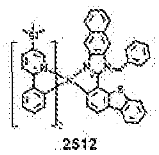
2512
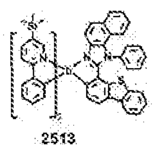
2513
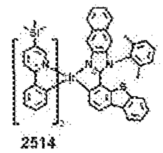
2514
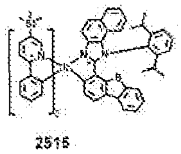
2515

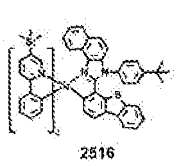
2516
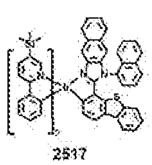
2517
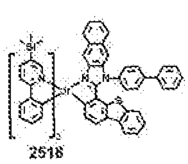
2518
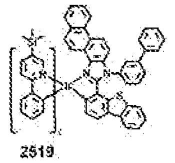
2519
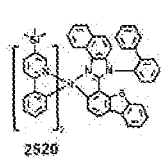
2520

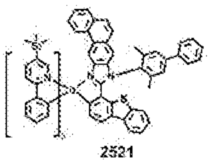
2521
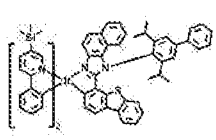
2522
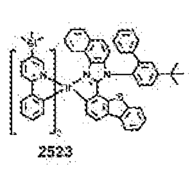
2523
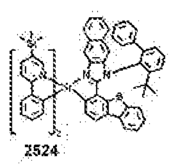
2524
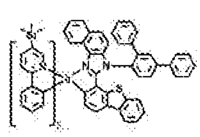
2525

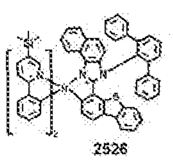
2526
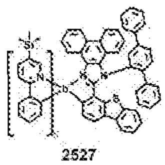
2527
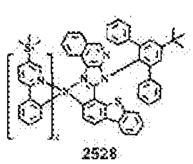
2528
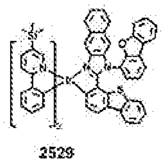
2529
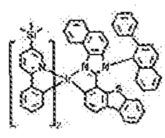
2530

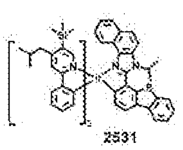
2531
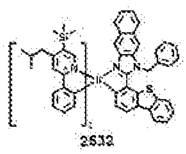
2532
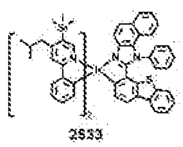
2533
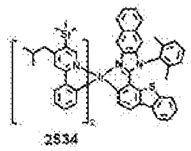
2534
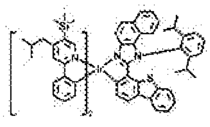
2535

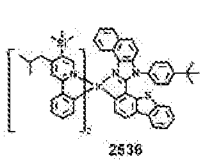
2536
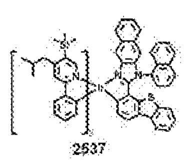
2537
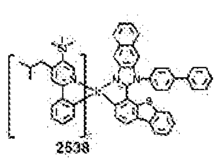
2538
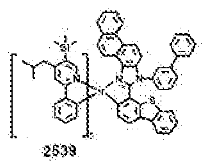
2539
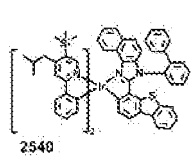
2540

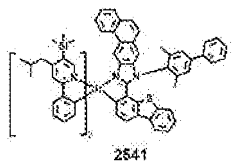
2541
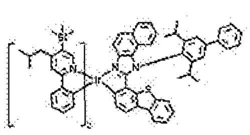
2542
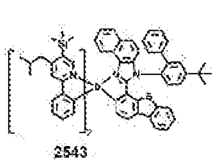
2543
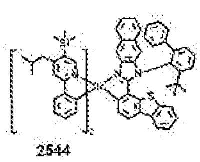
2544
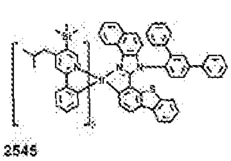
2545

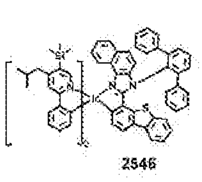
2546
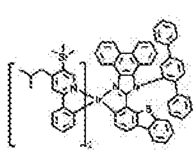
2547
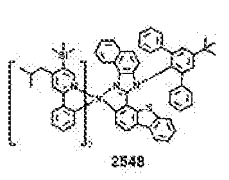
2548
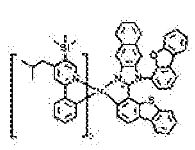
2549
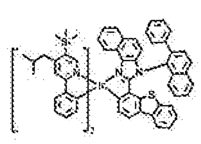
2550

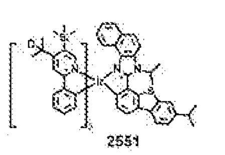
2551
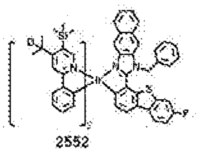
2552
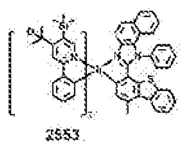
2553
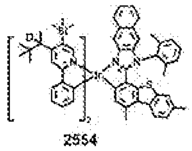
2554
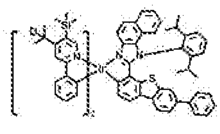
2555

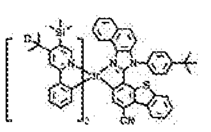
2556
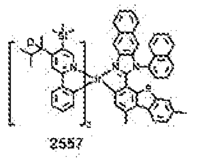
2557
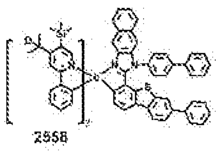
2558
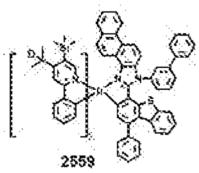
2559
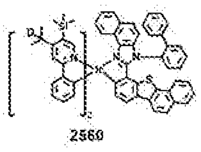
2560

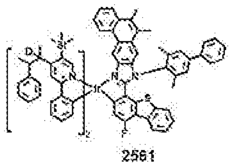
2561
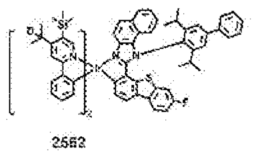
2562
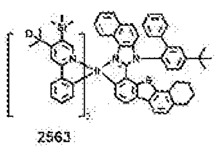
2563
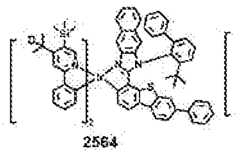
2564
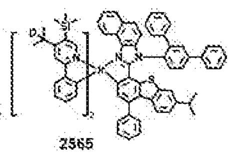
2565

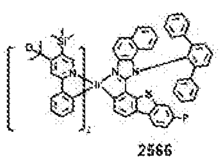
2566
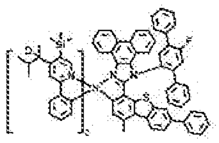
2567
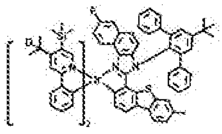
2568
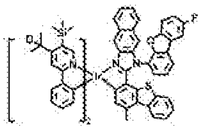
2569
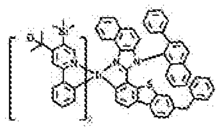
2570

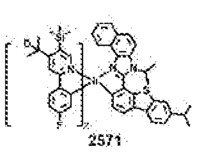
2571
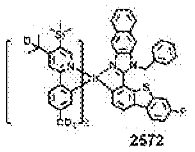
2572
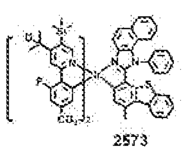
2573
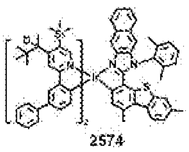
2574
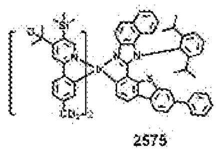
2575

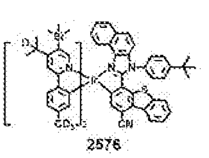
2576
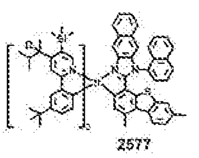
2577
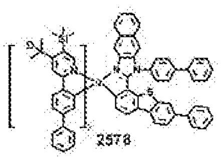
2578
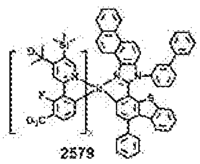
2579
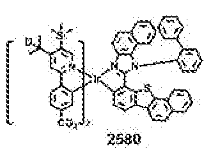
2580

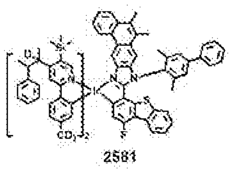
2581
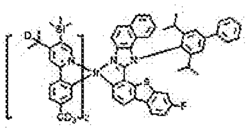
2582
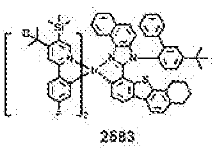
2583
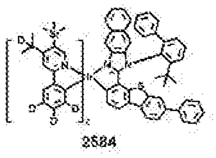
2584
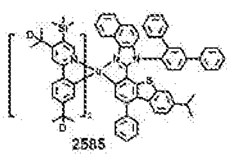
2585

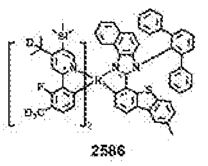
2586
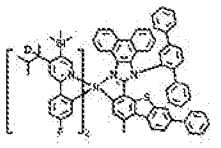
2587
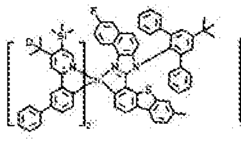
2588
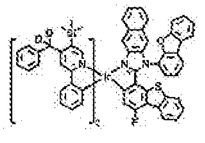
2589
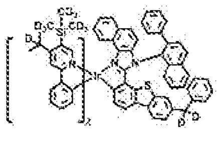
2590

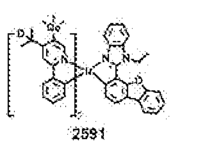
2591
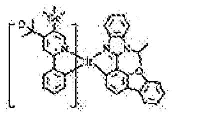
2592
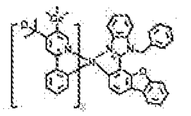
2593
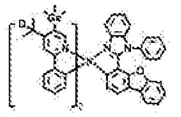
2594
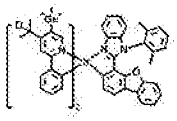
2595

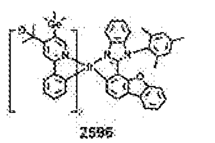
2596
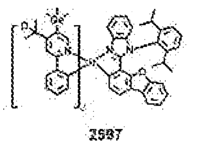
2597
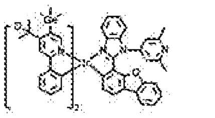
2598
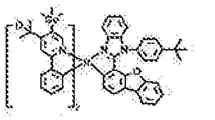
2599
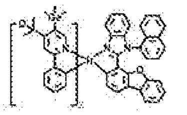
2600

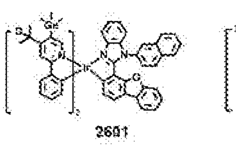
2601
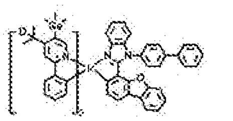
2602
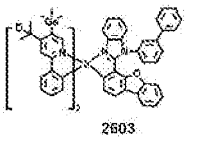
2603
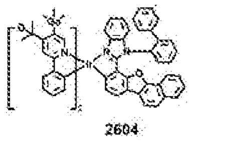
2604
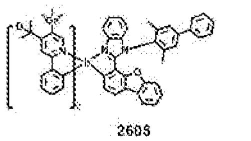
2605

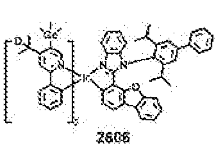
2606
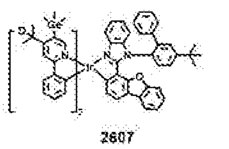
2607
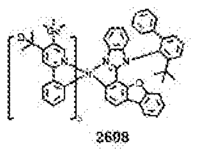
2608
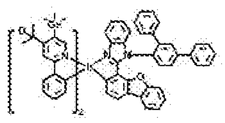
2609
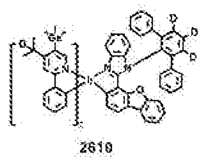
2610

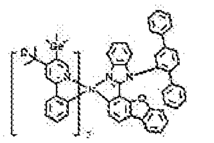
2611
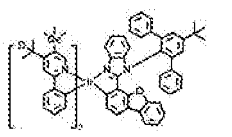
2612
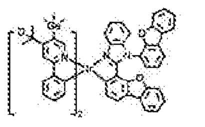
2613
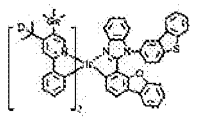
2614
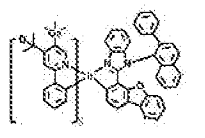
2615

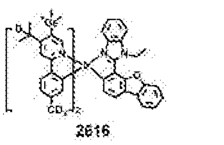
2616
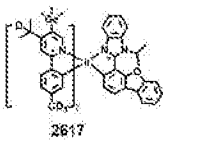
2617
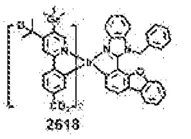
2618
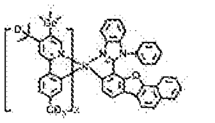
2619
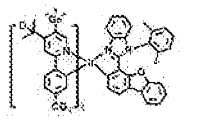
2620

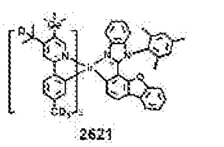
2621
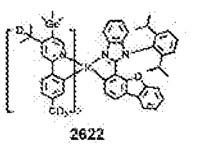
2622
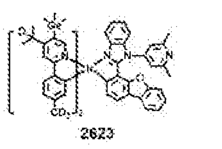
2623
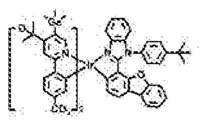
2624
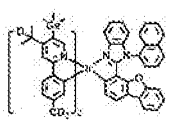
2625

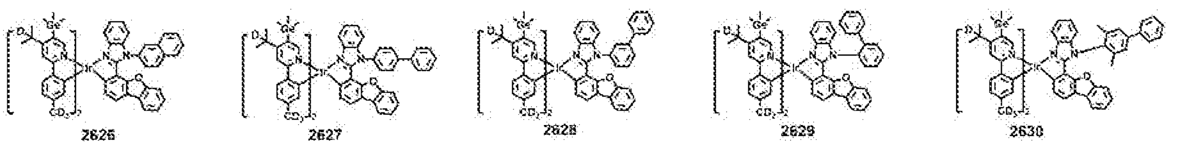
2626 2627 2628 2629 2630

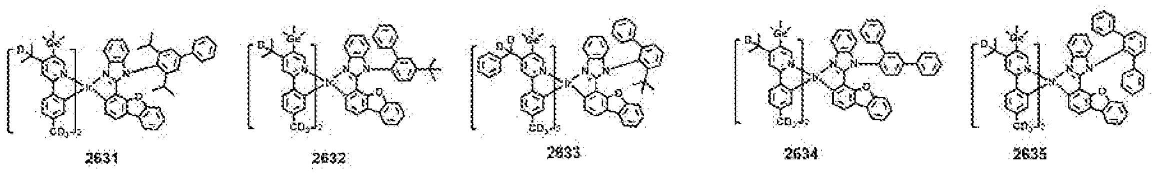
2631 2632 2633 2634 2635

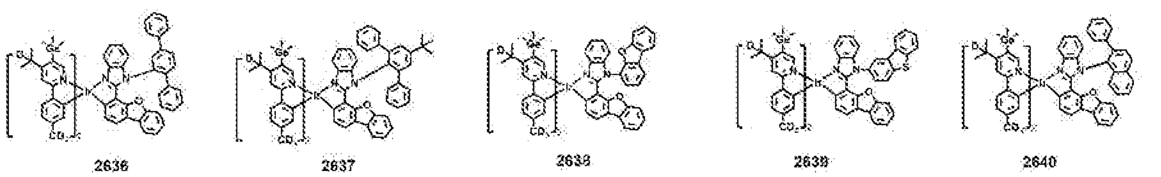
2636 2637 2638 2639 2640

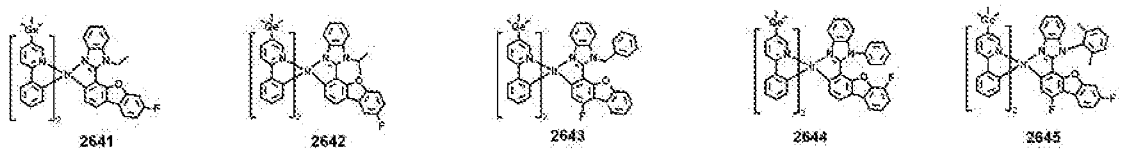

2641 2642 2643 2644 2645

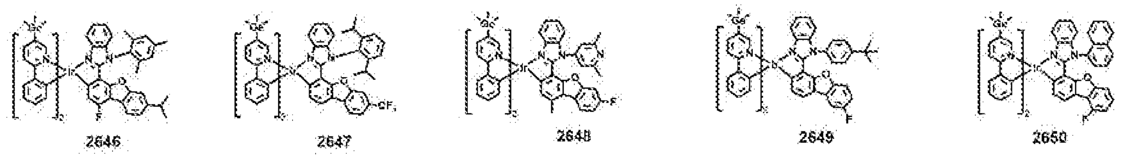

2646 2647 2648 2649 2650

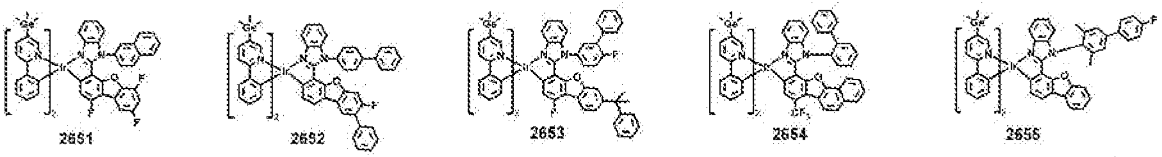

2651 2652 2653 2654 2655

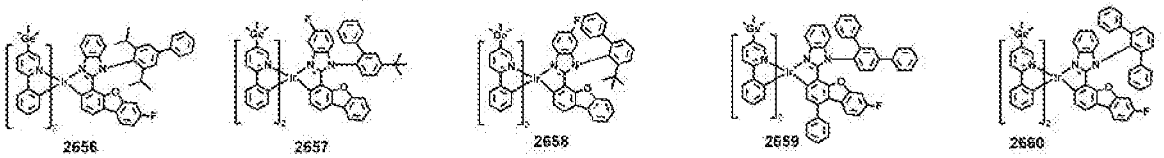

2656 2657 2658 2659 2660

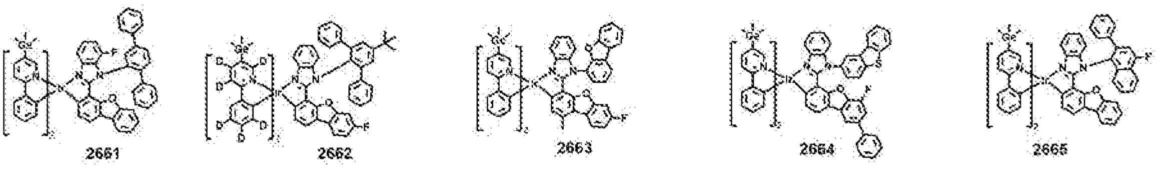

2661 2662 2663 2664 2665

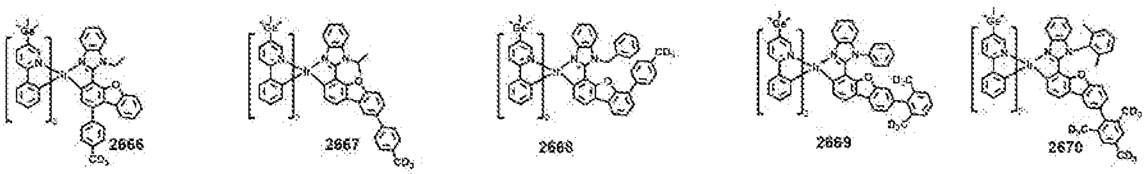

2666 2667 2668 2669 2670

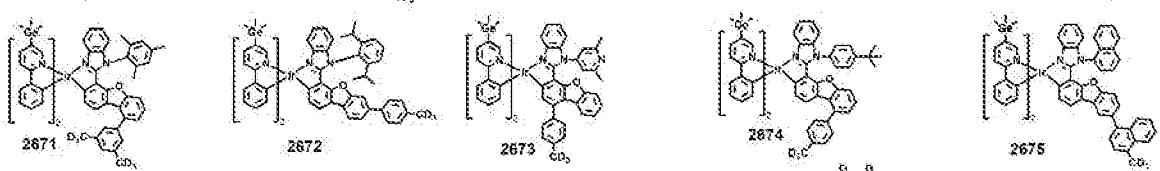

2671 2672 2673 2674 2675

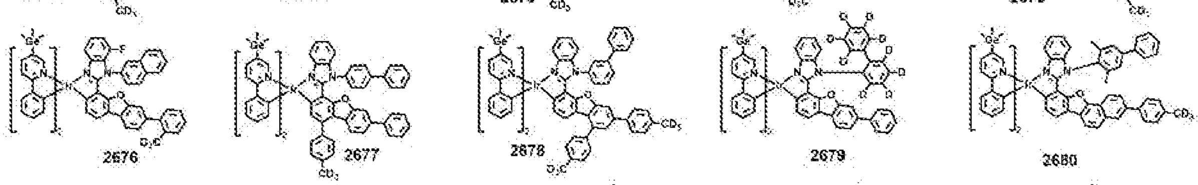

2676 2677 2678 2679 2680

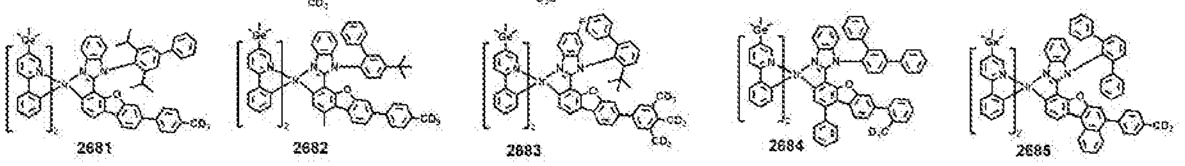

2681 2682 2683 2684 2685

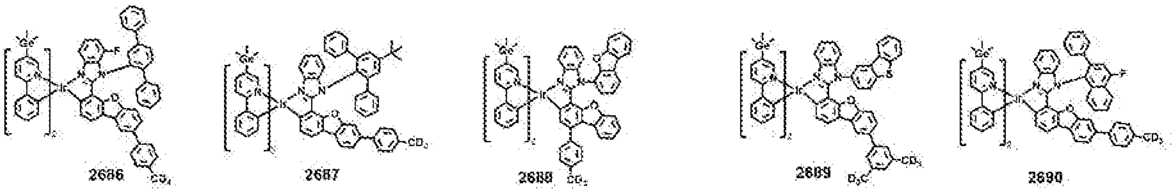

2686 2687 2688 2689 2690

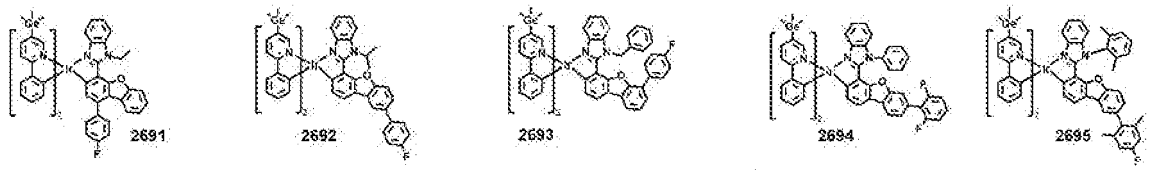

2691 2692 2693 2694 2695

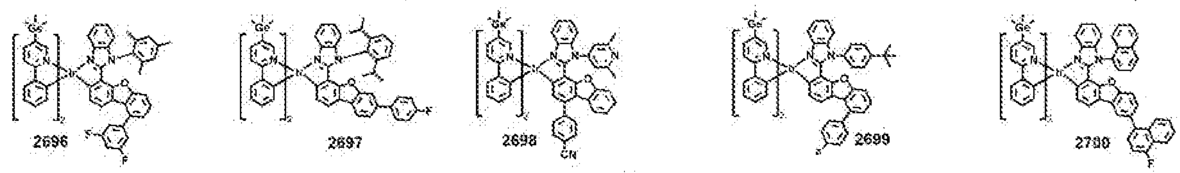

2696 2697 2698 2699 2700

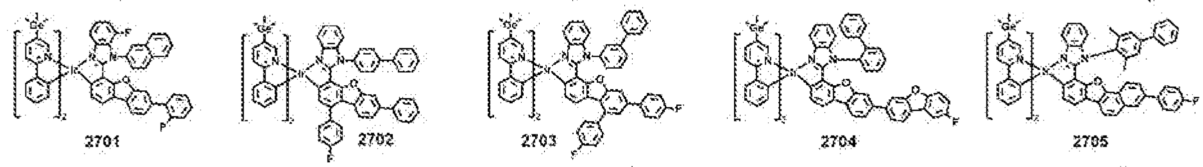

2701 2702 2703 2704 2705

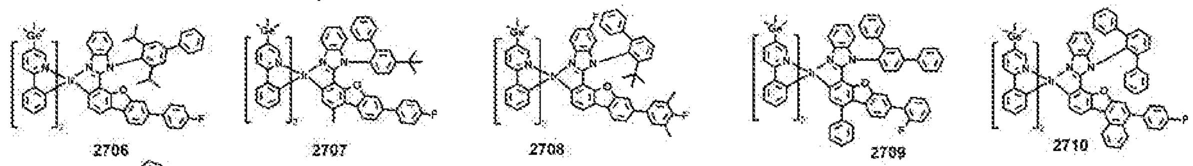

2706 2707 2708 2709 2710

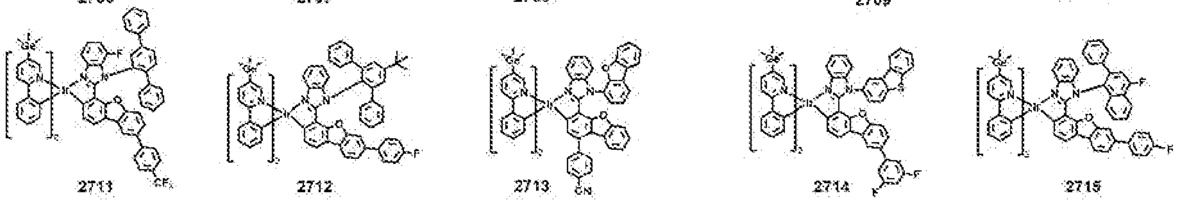

2711 2712 2713 2714 2715

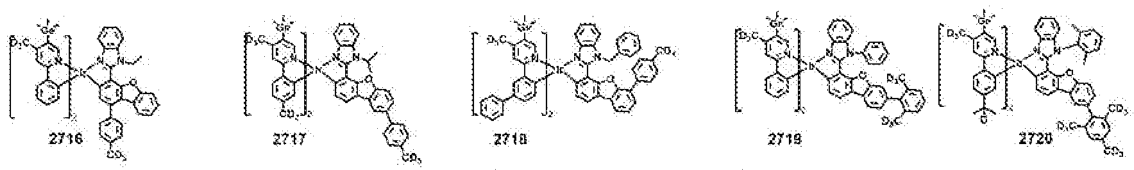

2716 2717 2718 2719 2720

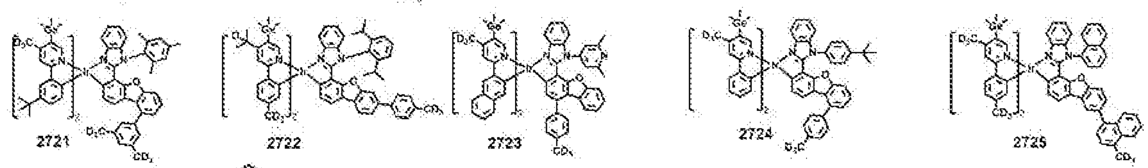

2721 2722 2723 2724 2725

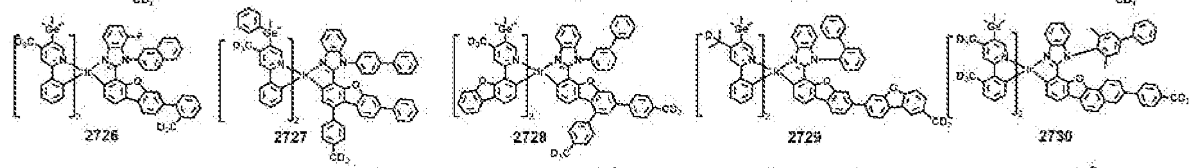

2726 2727 2728 2729 2730

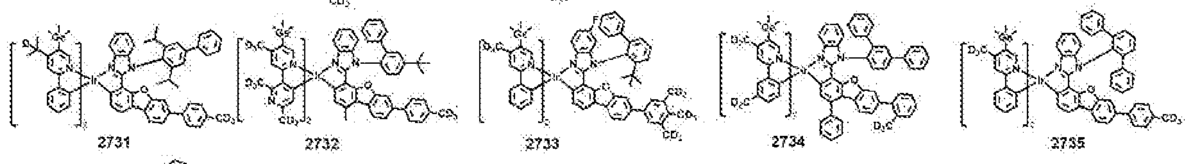

2731 2732 2733 2734 2735

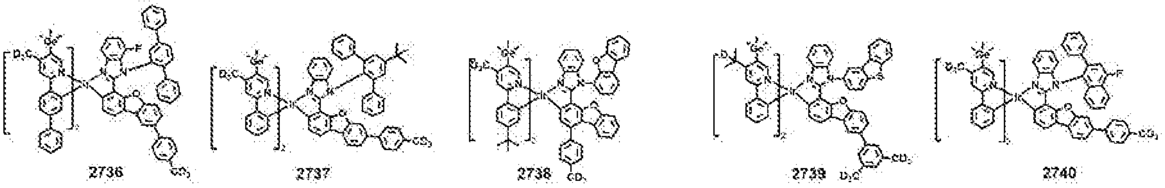

2736 2737 2738 2739 2740

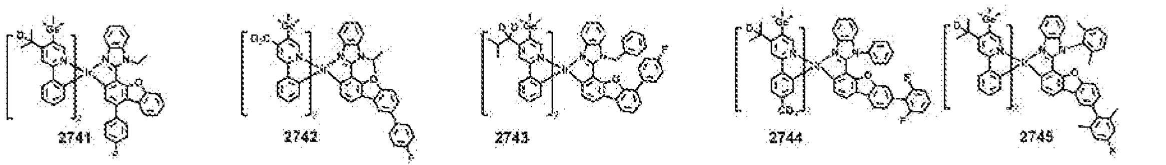

2741 2742 2743 2744 2745

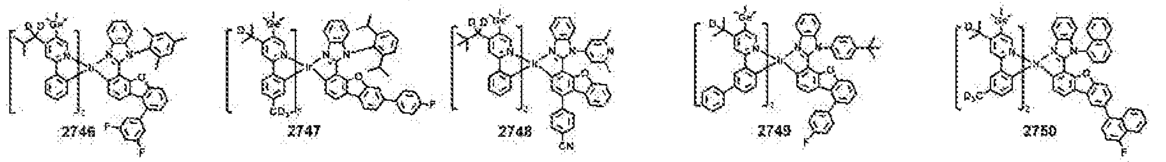

2746 2747 2748 2749 2750

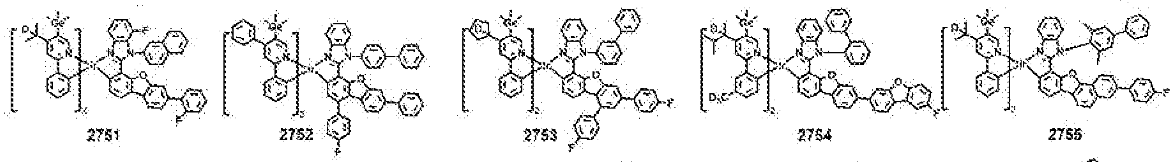

2751 2752 2753 2754 2755

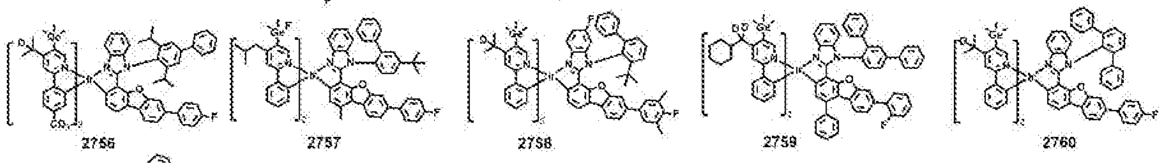

2756 2757 2758 2759 2760

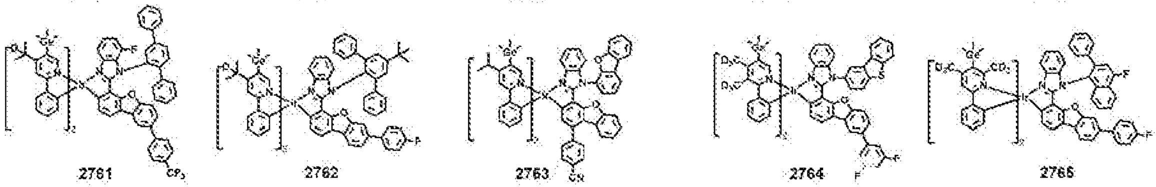

2761 2762 2763 2764 2765

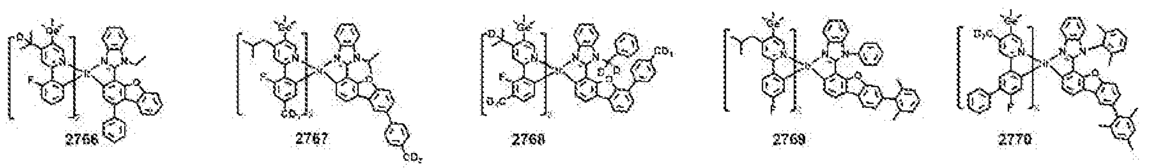

2766 2767 2768 2769 2770

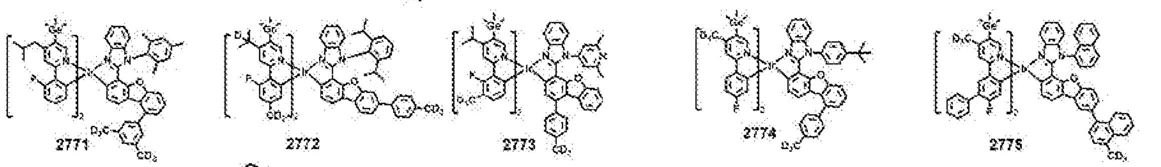

2771 2772 2773 2774 2775

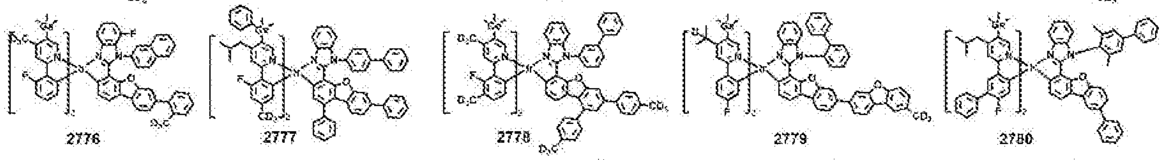

2776 2777 2778 2779 2780

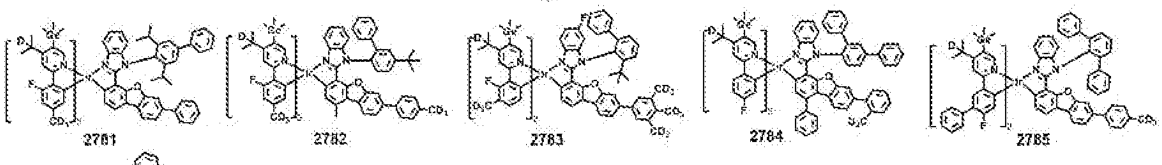

2781 2782 2783 2784 2785

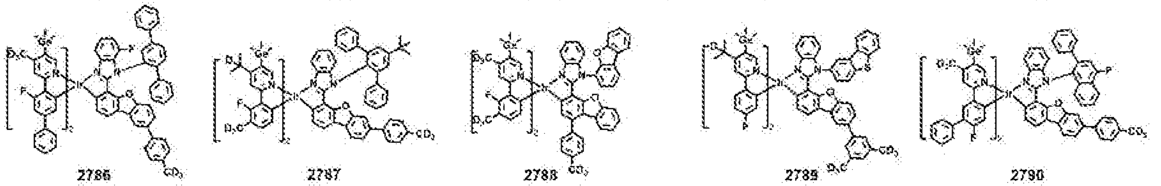

2786 2787 2788 2789 2790

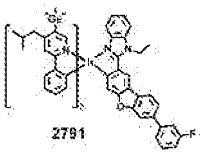
2791
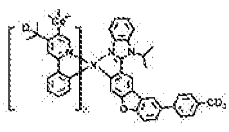
2792
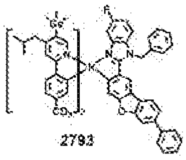
2793
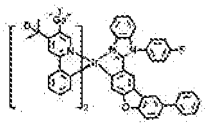
2794
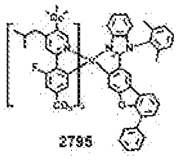
2795

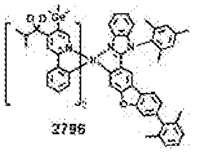
2796
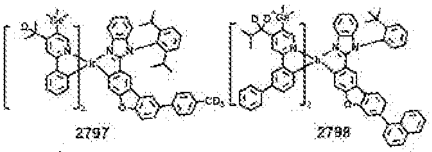
2797
2798
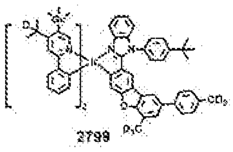
2799
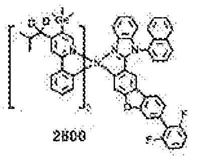
2800

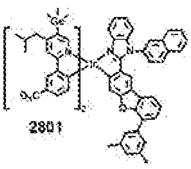
2801
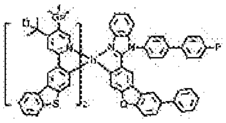
2802
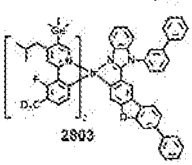
2803
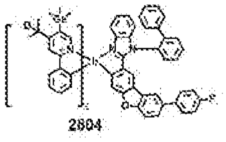
2804
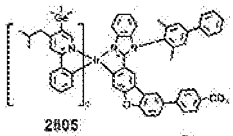
2805

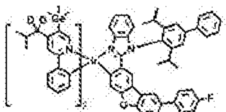
2806
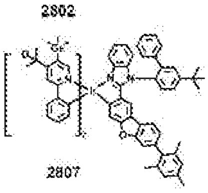
2807
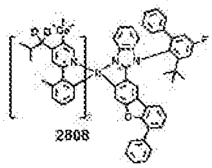
2808
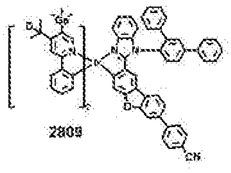
2809
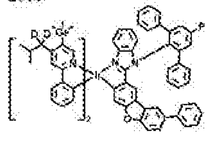
2810

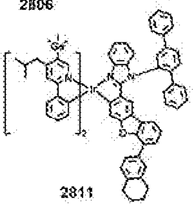
2811
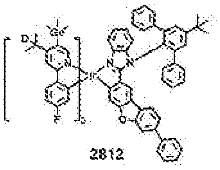
2812
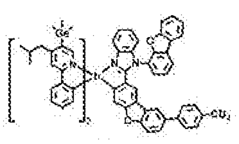
2813
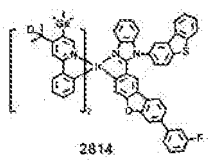
2814
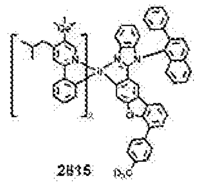
2815

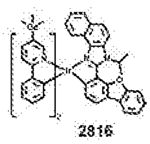
2816
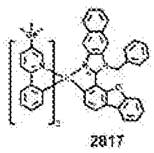
2817
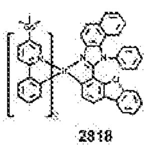
2818
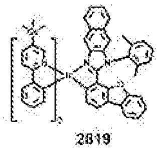
2819
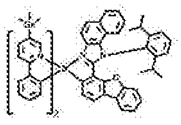
2820

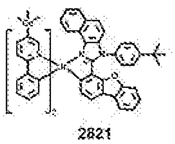
2821
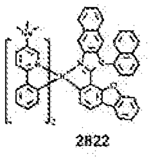
2822
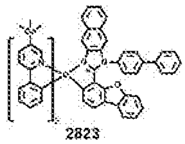
2823
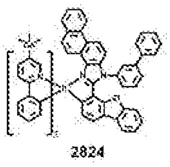
2824
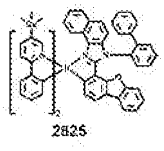
2825

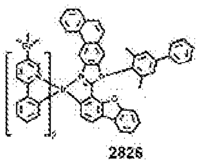
2826
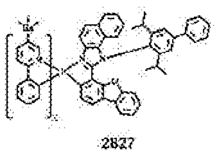
2827
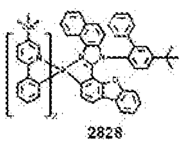
2828
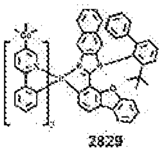
2829
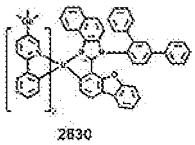
2830

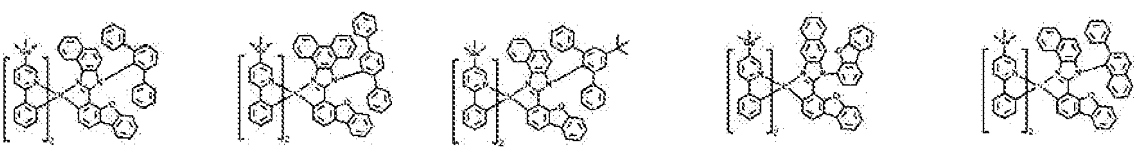
2831
2832
2833
2834
2835

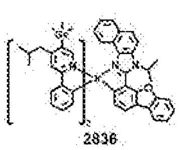
2836
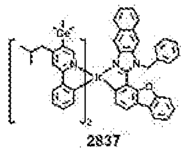
2837
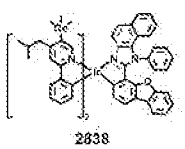
2838
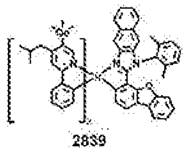
2839
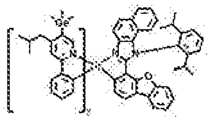
2840

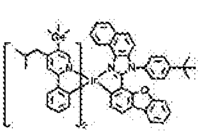
2841
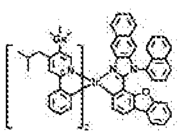
2842
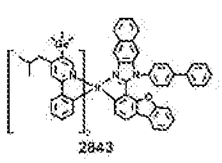
2843
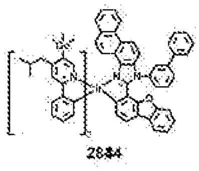
2844
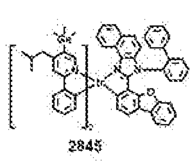
2845

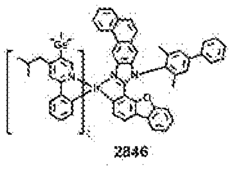
2846
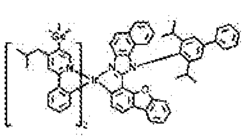
2847
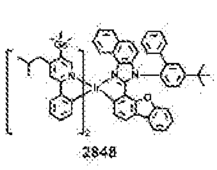
2848
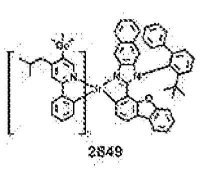
2849
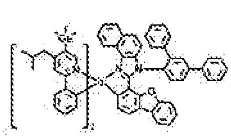
2850

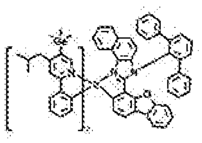
2851
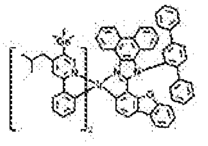
2852
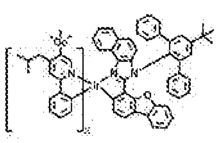
2853
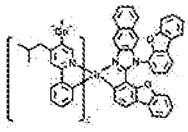
2854
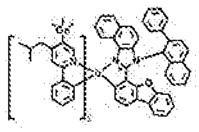
2855

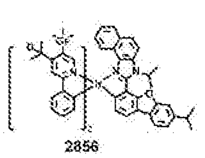
2856
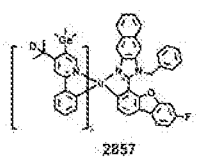
2857
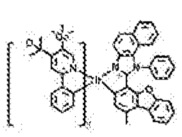
2858
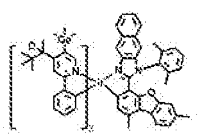
2859
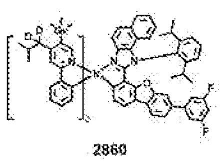
2860

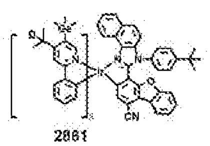
2861
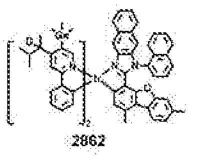
2862
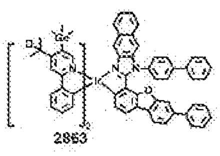
2863
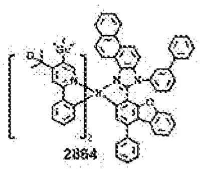
2864
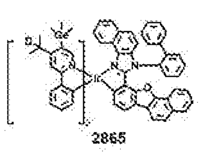
2865

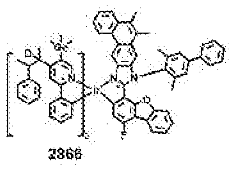
2866
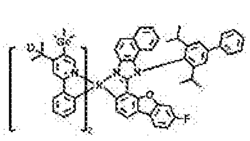
2867
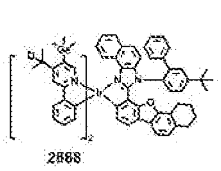
2868
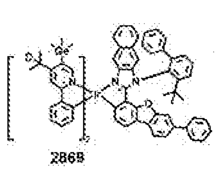
2869
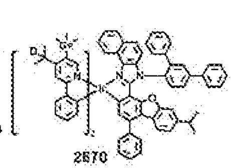
2870

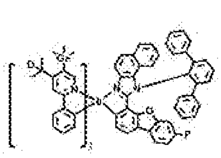
2871
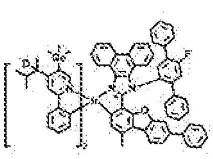
2872
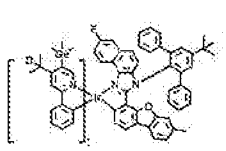
2873
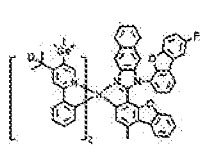
2874
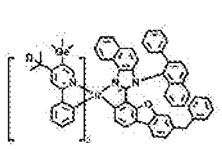
2875

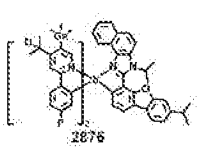
2876

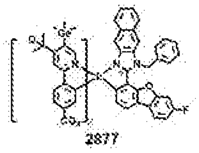
2877

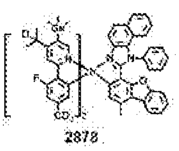
2878

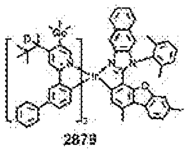
2879

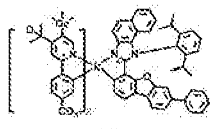
2880

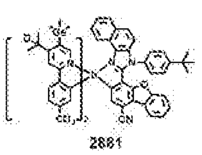
2881

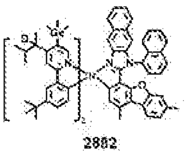
2882

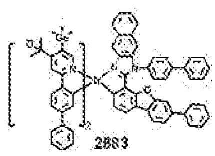
2883

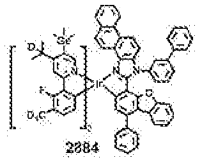
2884

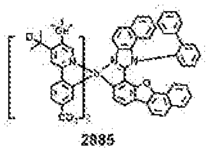
2885

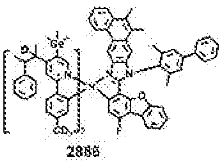
2886

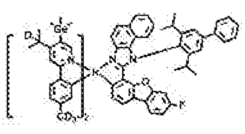
2887

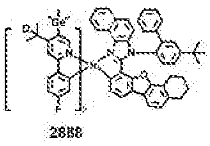
2888

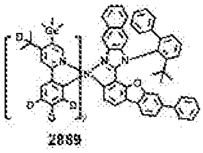
2889

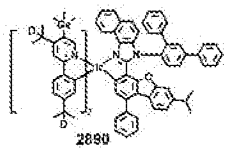
2890

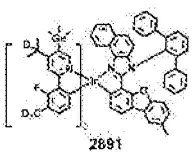
2891

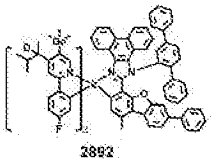
2892

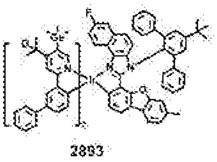
2893

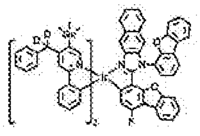
2894

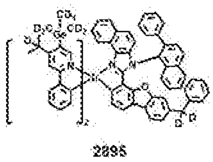
2895

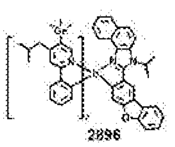
2896

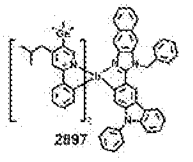
2897

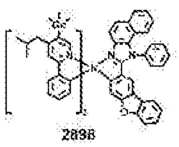
2898

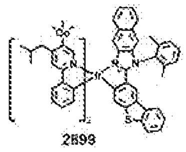
2899

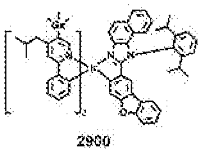
2900

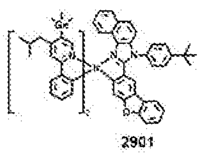
2901

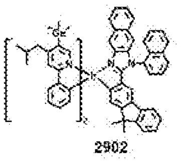
2902

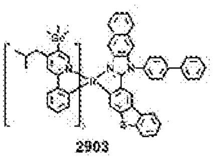
2903

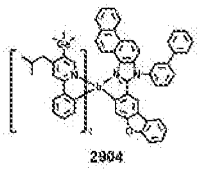
2904

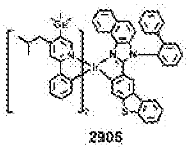
2905

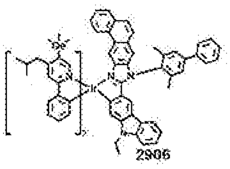
2906

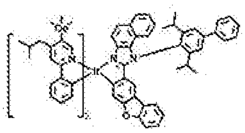
2907

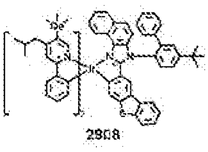
2908

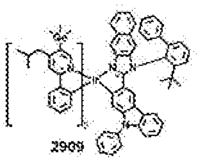
2909

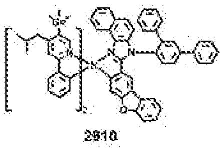
2910

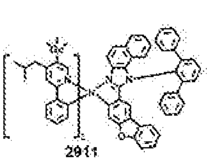
2911

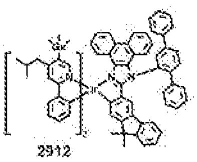
2912

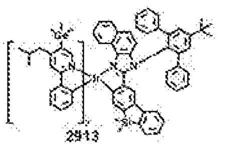
2913

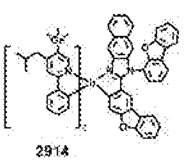
2914

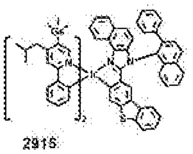
2915

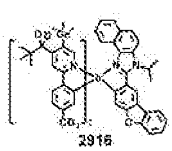
2916
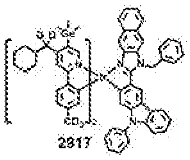
2917
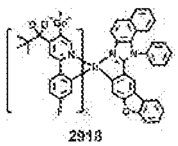
2918
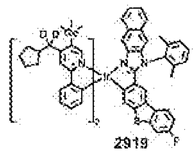
2919
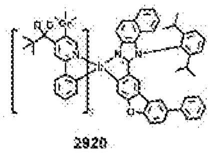
2920
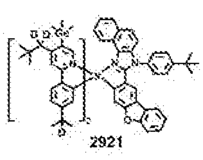
2921
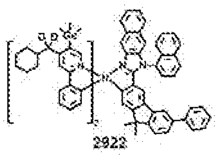
2922
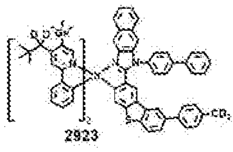
2923
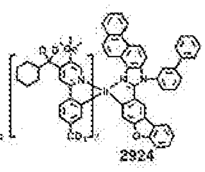
2924
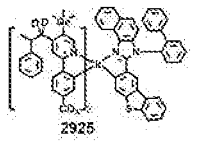
2925
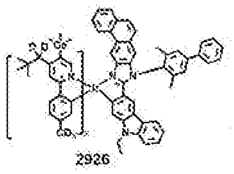
2926
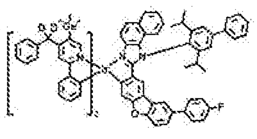
2927
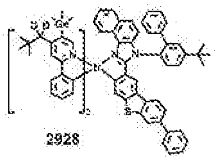
2928
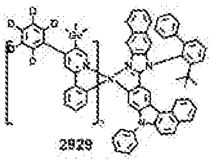
2929
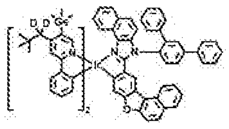
2930
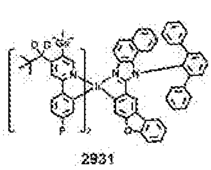
2931
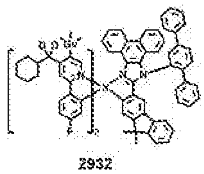
2932
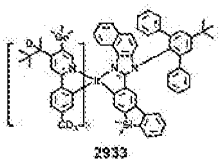
2933
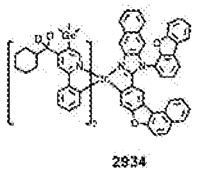
2934
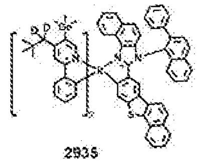
2935
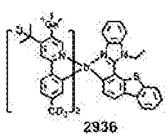
2936
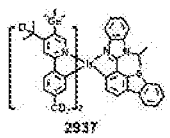
2937
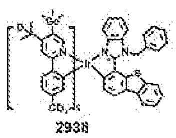
2938
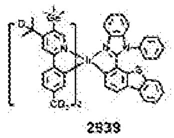
2939
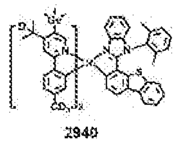
2940
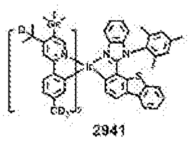
2941
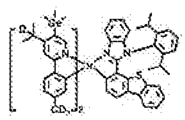
2942
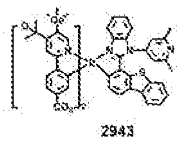
2943
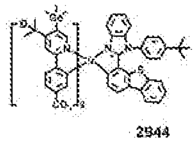
2944
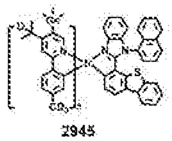
2945
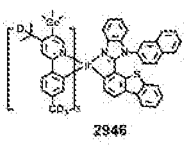
2946
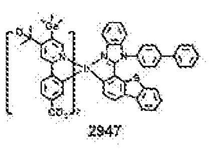
2947
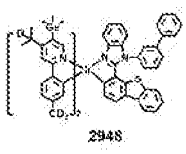
2948
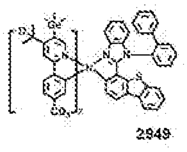
2949
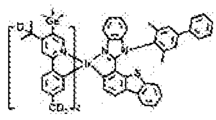
2950
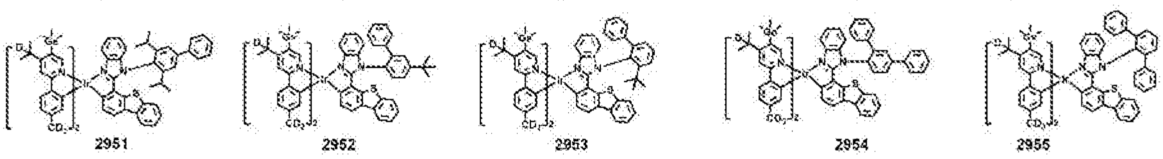
2951 2952 2953 2954 2955
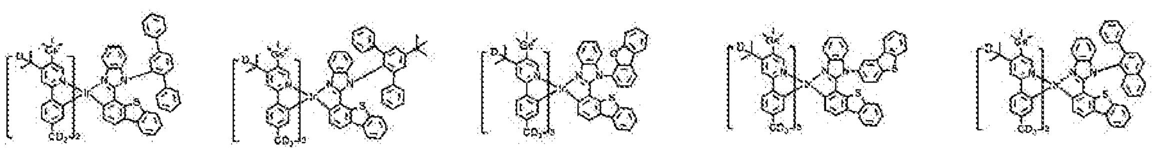
2956 2957 2958 2959 2960

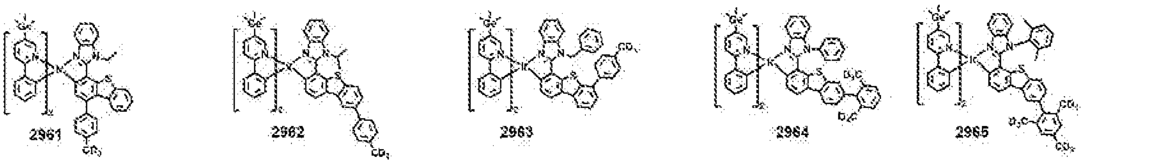
2961 2962 2963 2964 2965

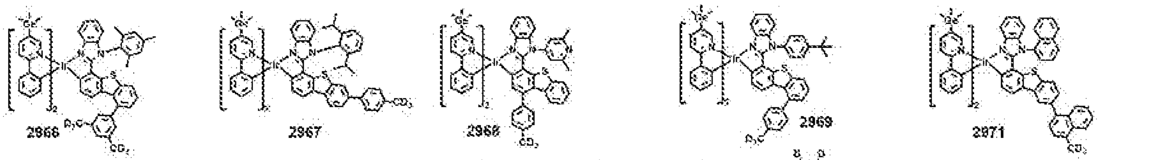
2966 2967 2968 2969 2971

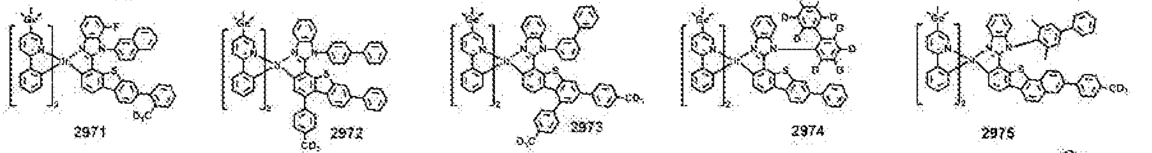
2971 2972 2973 2974 2975

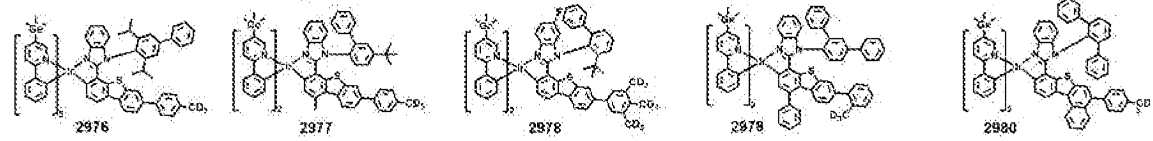
2976 2977 2978 2978 2980

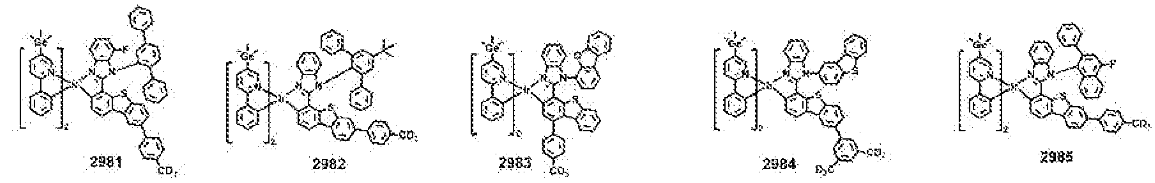
2981 2982 2983 2984 2985

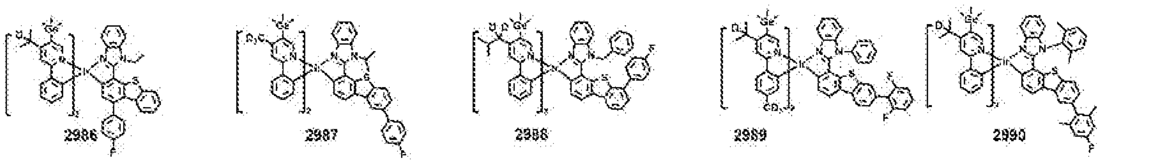
2986 2987 2988 2989 2990

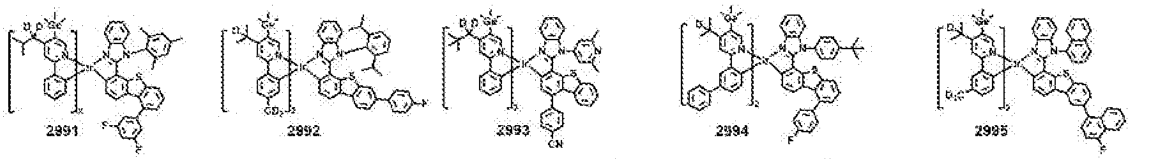
2991 2992 2993 2994 2995

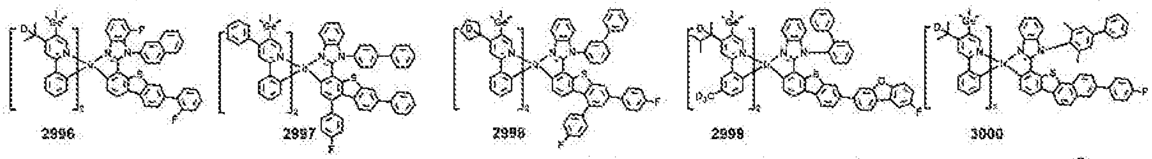
2996 2997 2998 2999 3000

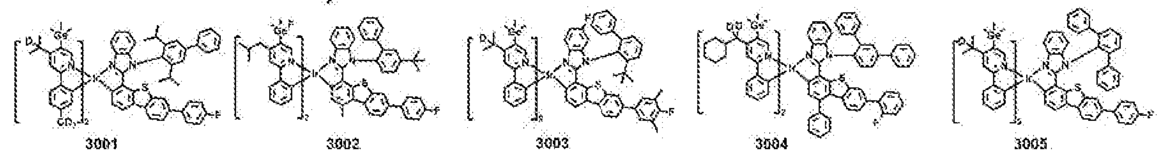
3001 3002 3003 3004 3005

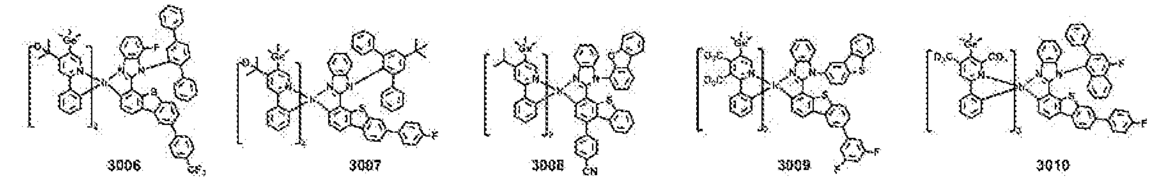
3006 3007 3008 3009 3010

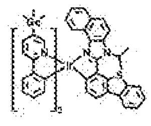 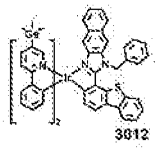 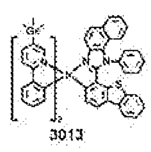 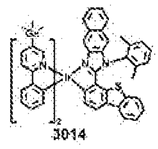 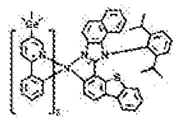

3011 3012 3013 3014 3015

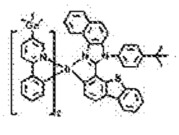 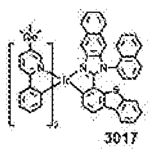 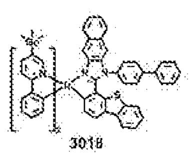 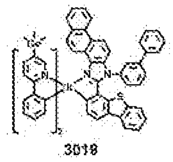 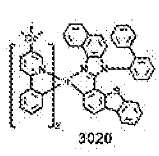

3016 3017 3018 3019 3020

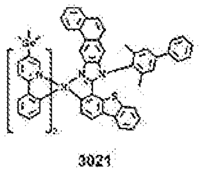 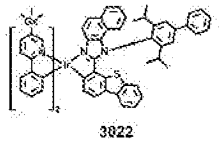 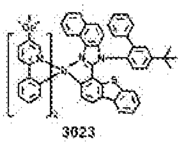 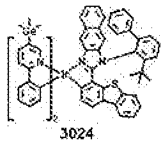 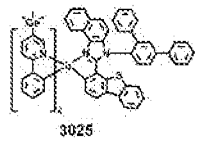

3021 3022 3023 3024 3025

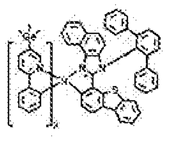 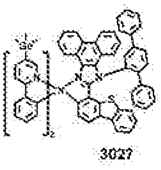 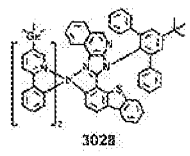 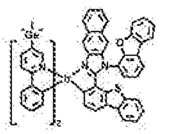 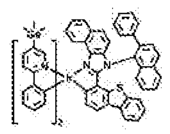

3026 3027 3028 3029 3030

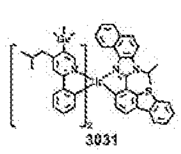 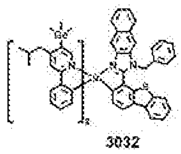 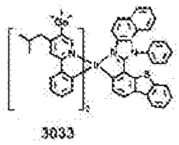 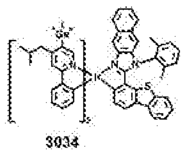 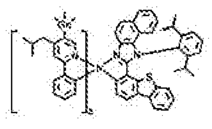

3031 3032 3033 3034 3035

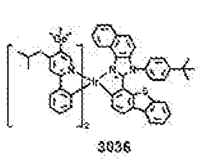 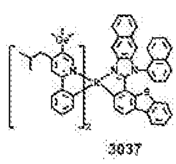 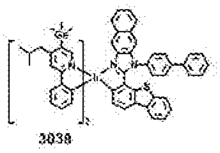 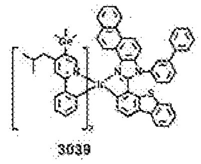 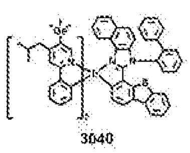

3036 3037 3038 3039 3040

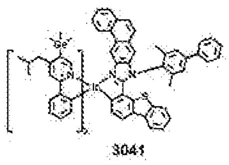 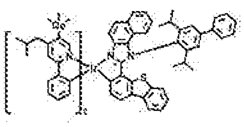 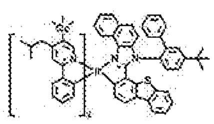 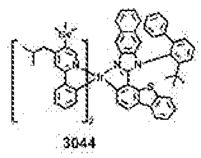 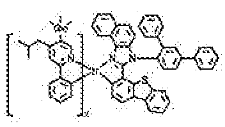

3041 3042 3043 3044 3045

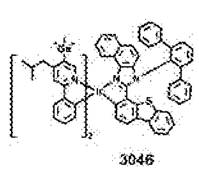 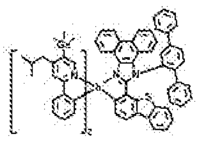 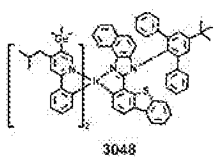 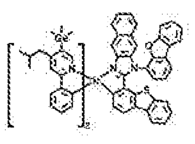 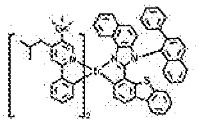

3046 3047 3048 3049 3050

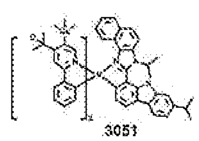
3051

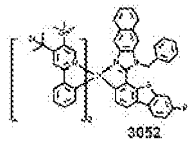
3052

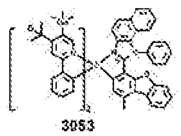
3053

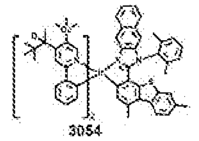
3054

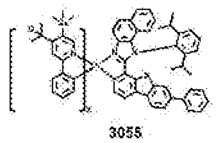
3055

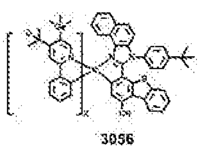
3056

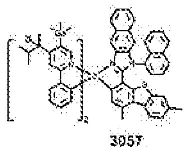
3057

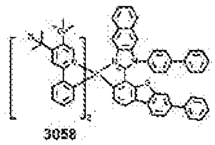
3058

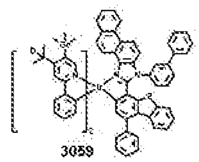
3059

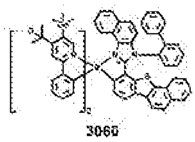
3060

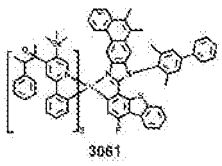
3061

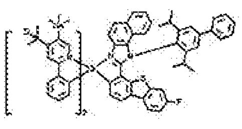
3062

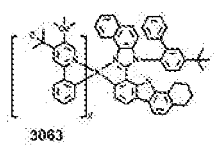
3063

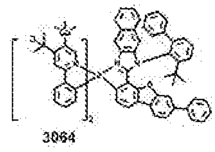
3064

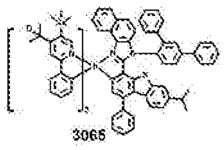
3065

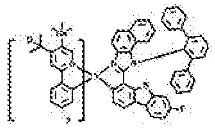
3066

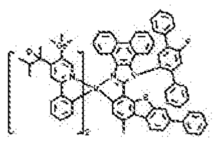
3067

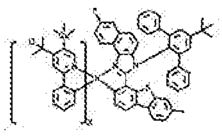
3068

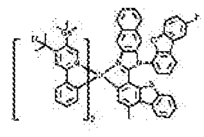
3069

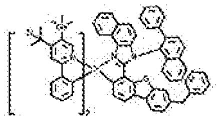
3070

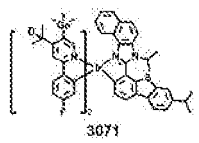
3071

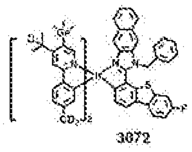
3072

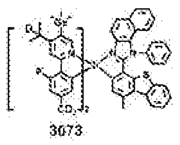
3073

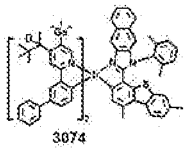
3074

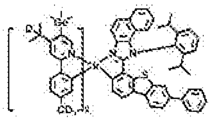
3075

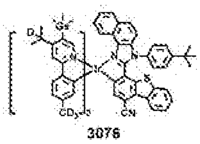
3076

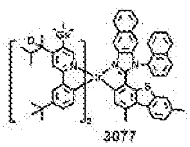
3077

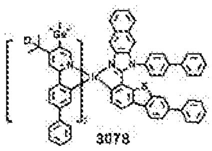
3078

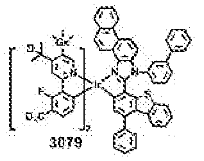
3079

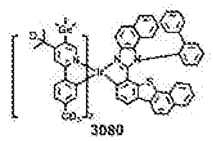
3080

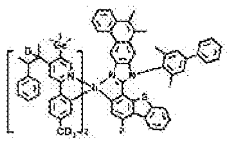
3081

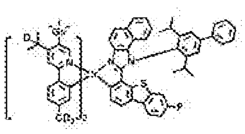
3082

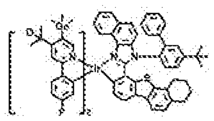
3083

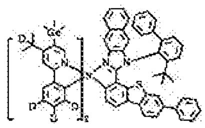
3084

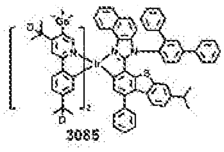
3085

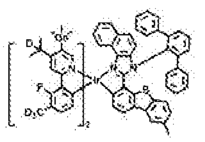
3086

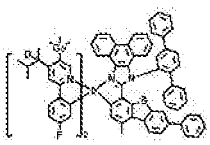
3087

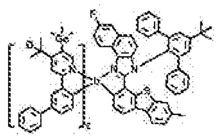
3088

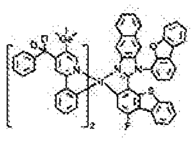
3089

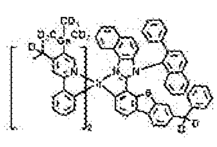
3090

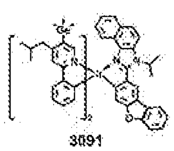
3091
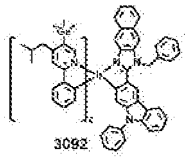
3092
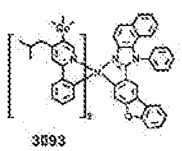
3093
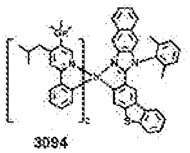
3094
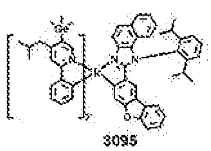
3095

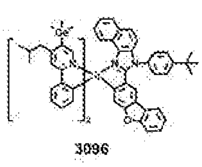
3096
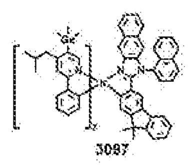
3097
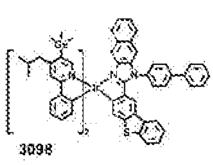
3098
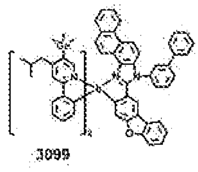
3099
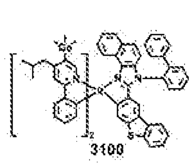
3100

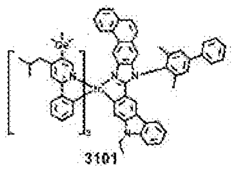
3101
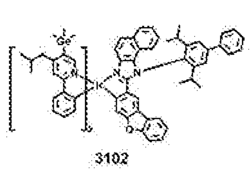
3102
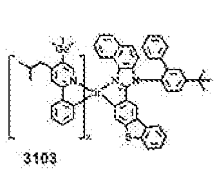
3103
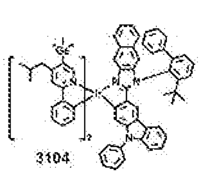
3104
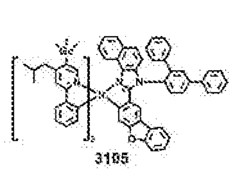
3105

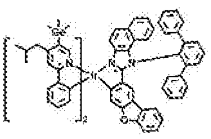
3106
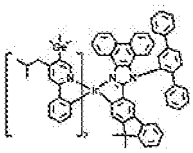
3107
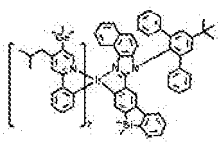
3108
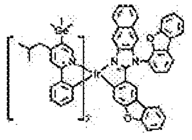
3109
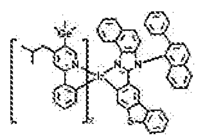
3110

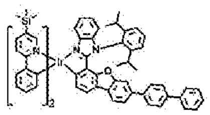
3111
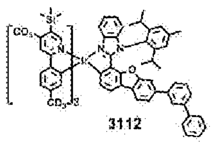
3112
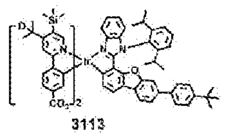
3113
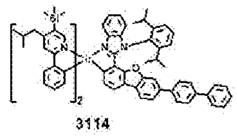
3114
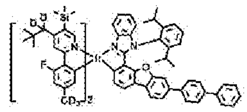
3115

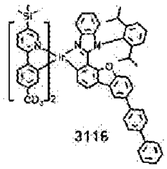
3116
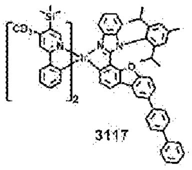
3117
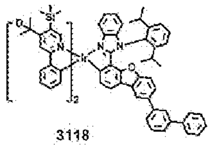
3118
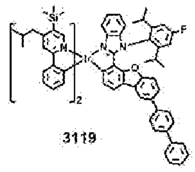
3119
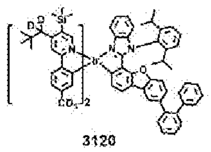
3120

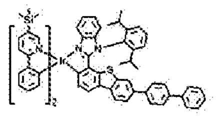
3121
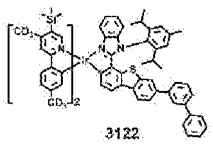
3122
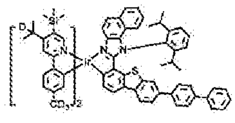
3123
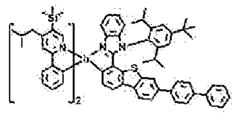
3124
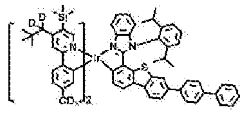
3125

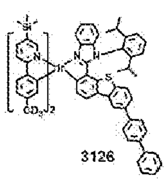
3126
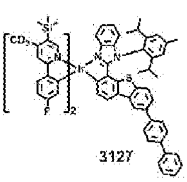
3127
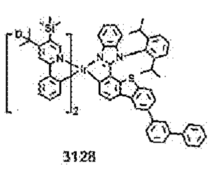
3128
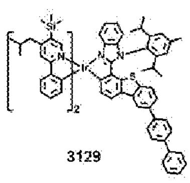
3129
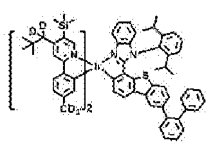
3130

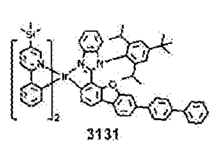
3131
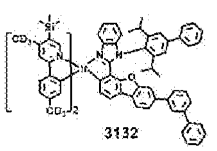
3132
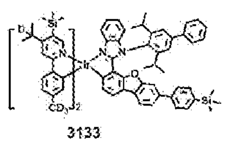
3133
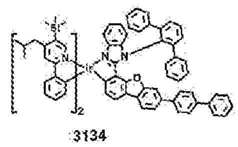
3134
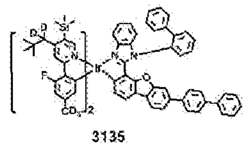
3135
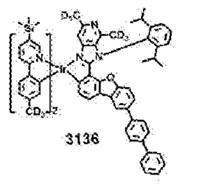
3136
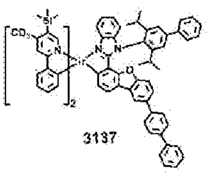
3137
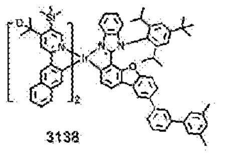
3138
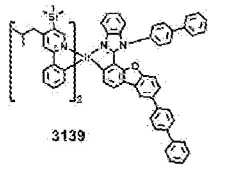
3139
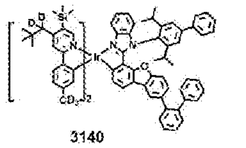
3140
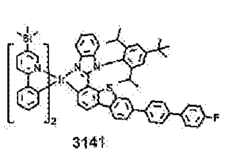
3141
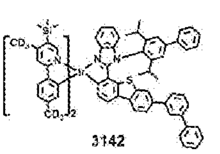
3142
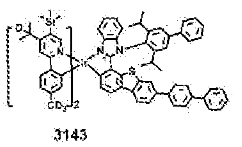
3143
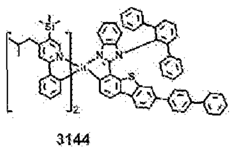
3144
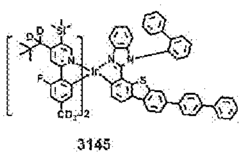
3145
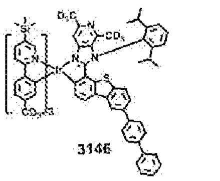
3146
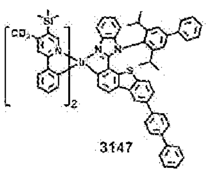
3147
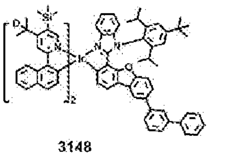
3148
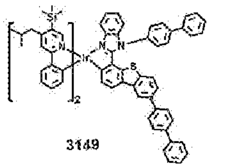
3149
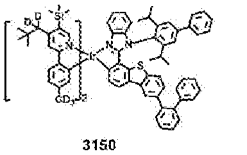
3150
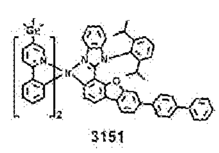
3151
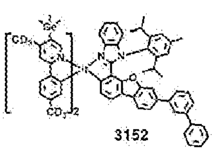
3152
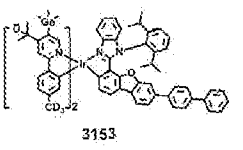
3153
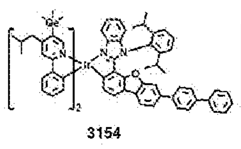
3154
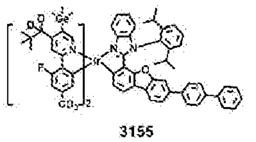
3155
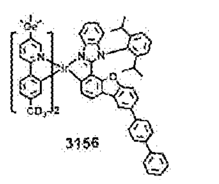
3156
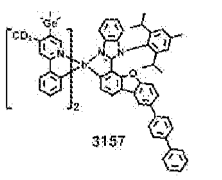
3157
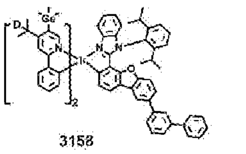
3158
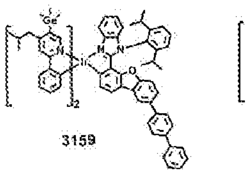
3159
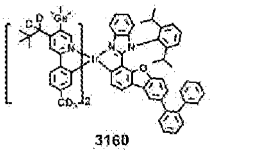
3160
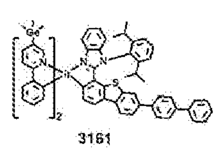
3161
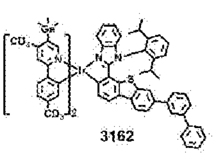
3162
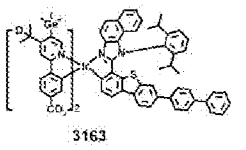
3163
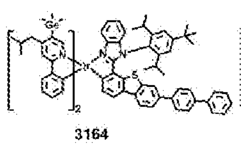
3164
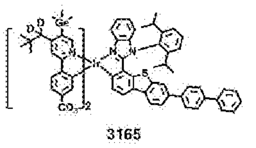
3165
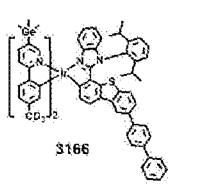
3166
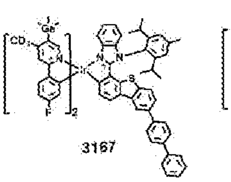
3167
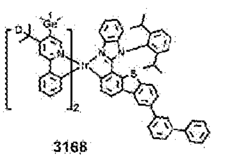
3168
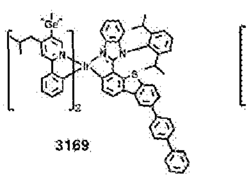
3169
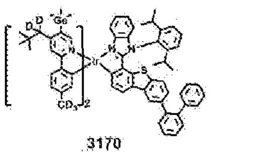
3170

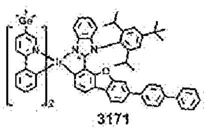
3171
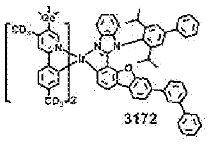
3172
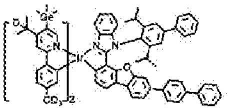
3173
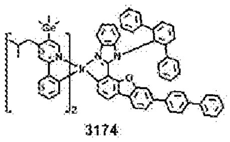
3174
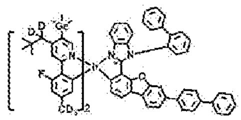
3175

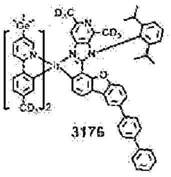
3176
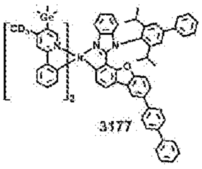
3177
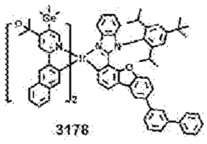
3178
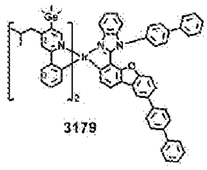
3179
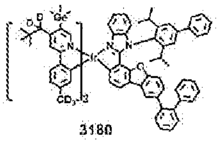
3180

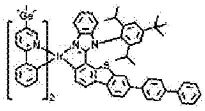
3181
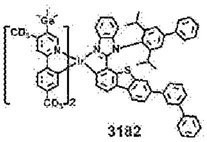
3182
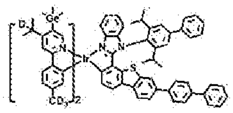
3183
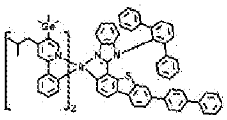
3184
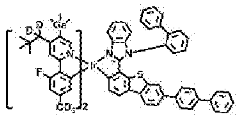
3185

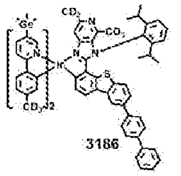
3186
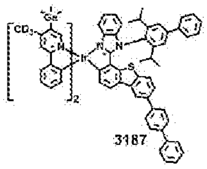
3187
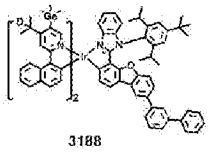
3188
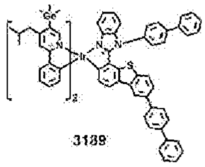
3189
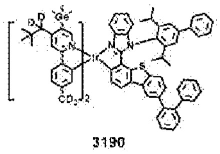
3190

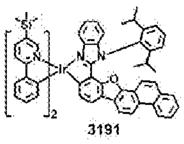
3191
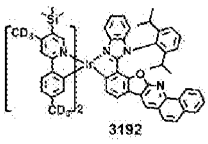
3192
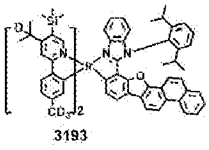
3193
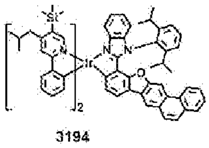
3194
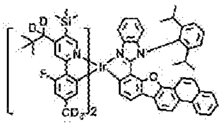
3195

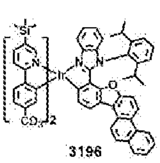
3196
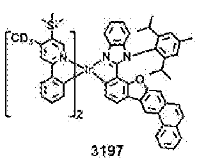
3197
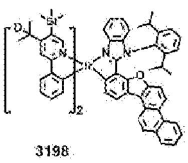
3198
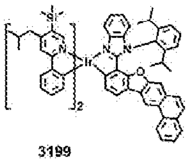
3199
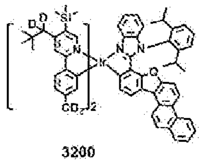
3200

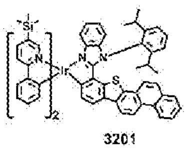
3201
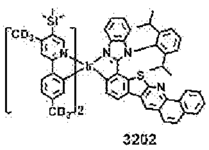
3202
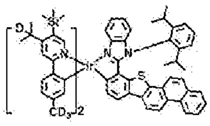
3203
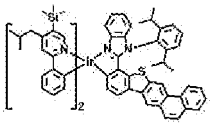
3204
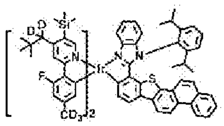
3205

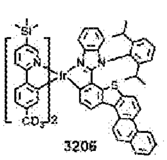
3206
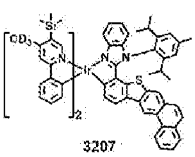
3207
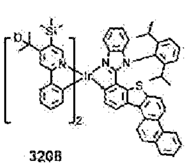
3208
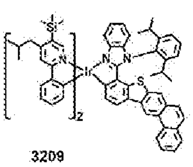
3209
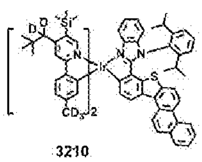
3210

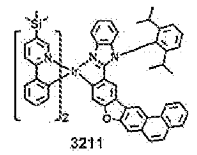
3211
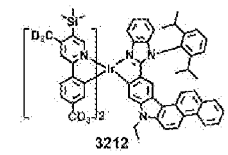
3212
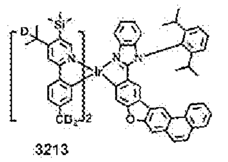
3213
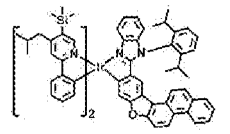
3214
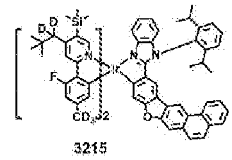
3215

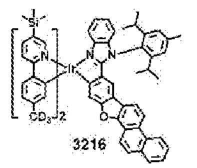
3216
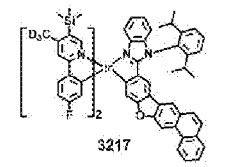
3217
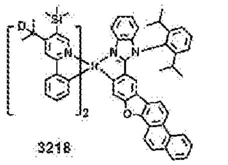
3218
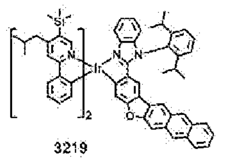
3219
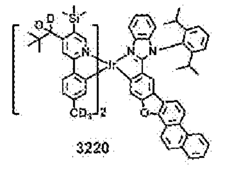
3220

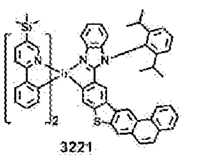
3221
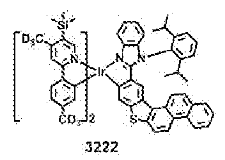
3222
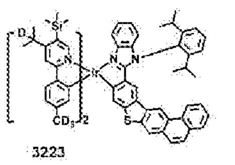
3223
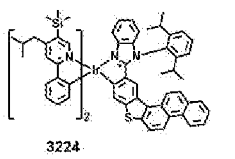
3224
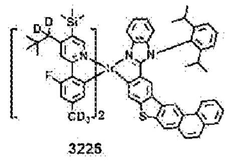
3225

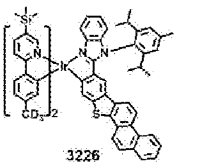
3226
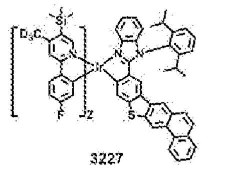
3227
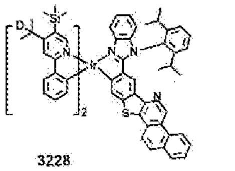
3228
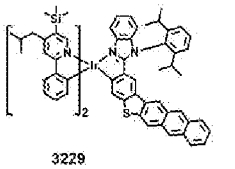
3229
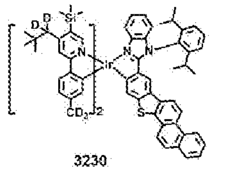
3230

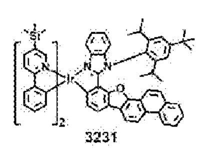
3231
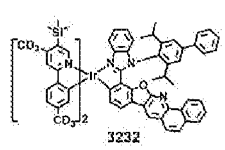
3232
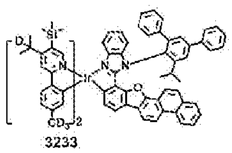
3233
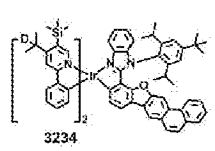
3234
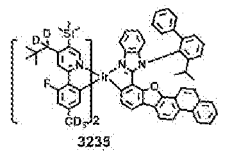
3235

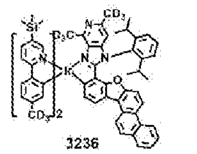
3236
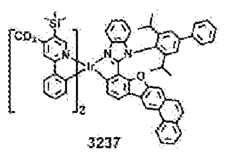
3237
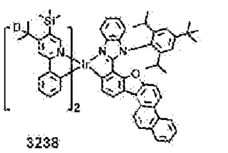
3238
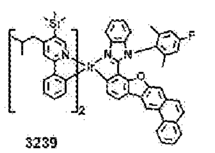
3239
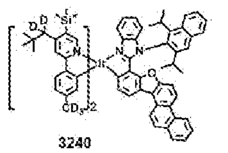
3240

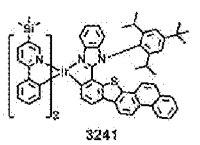
3241
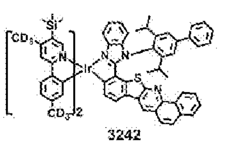
3242
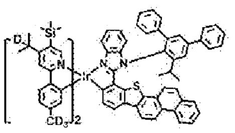
3243
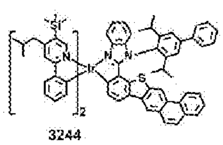
3244
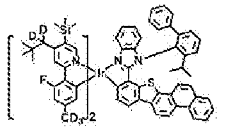
3245

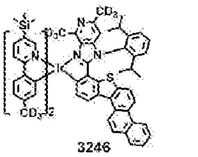
3246
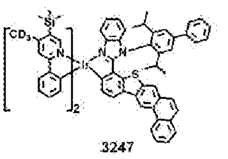
3247
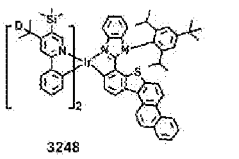
3248
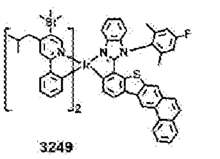
3249
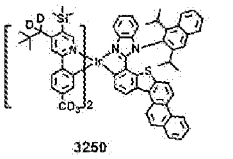
3250

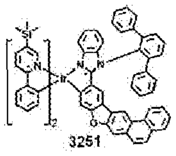
3251

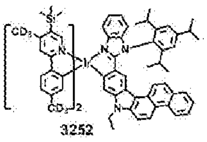
3252

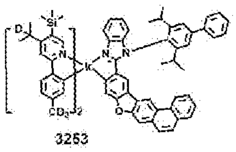
3253

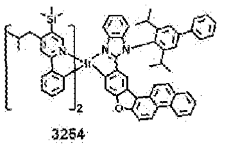
3254

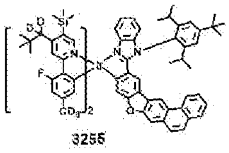
3255

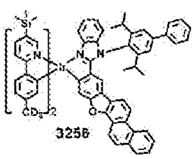
3256

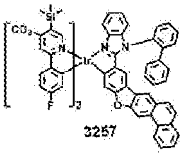
3257

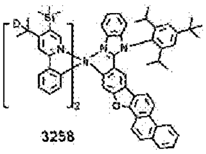
3258

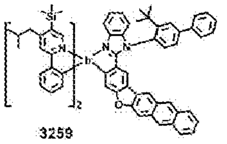
3259

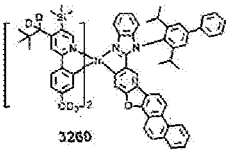
3260

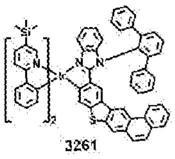
3261

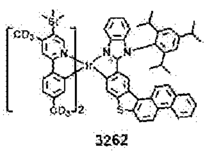
3262

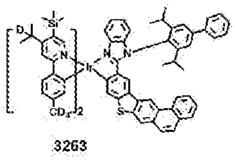
3263

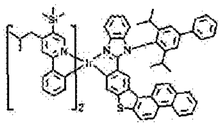
3264

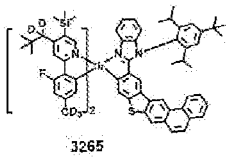
3265

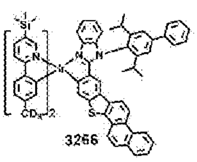
3266

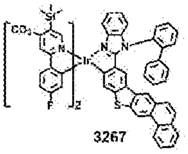
3267

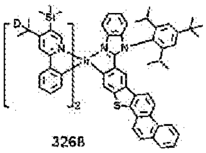
3268

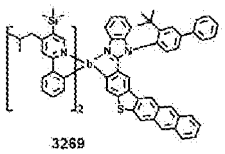
3269

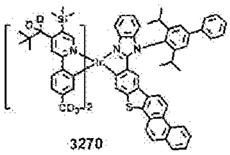
3270

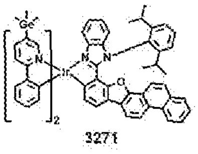
3271

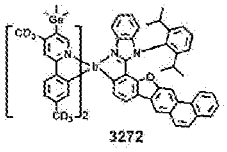
3272

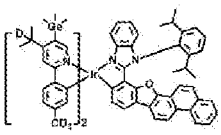
3273

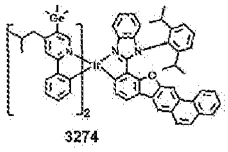
3274

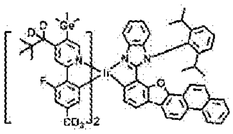
3275

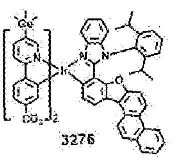
3276

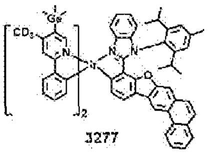
3277

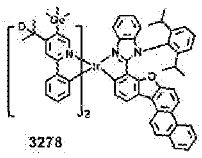
3278

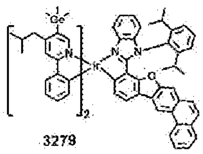
3279

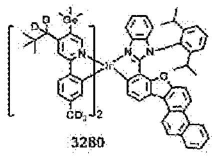
3280

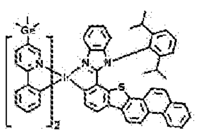
3281

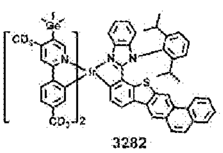
3282

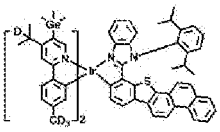
3283

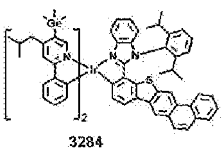
3284

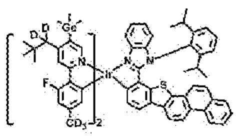
3285

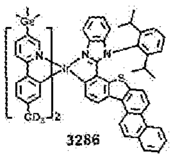
3286

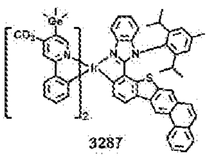
3287

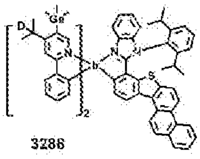
3288

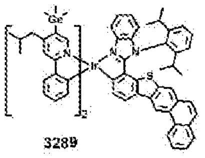
3289

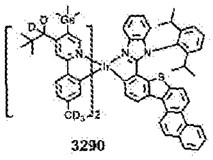
3290

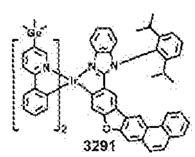
3291
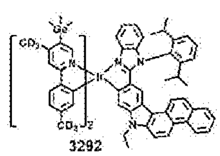
3292
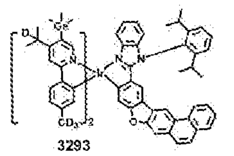
3293
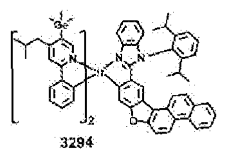
3294
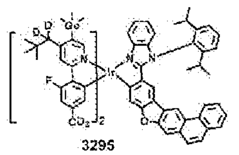
3295

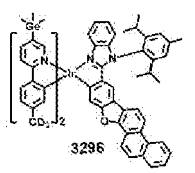
3296
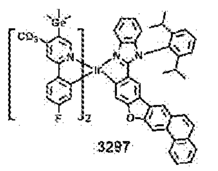
3297
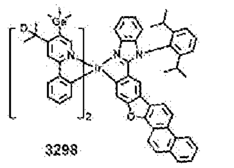
3298
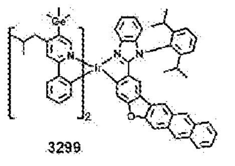
3299
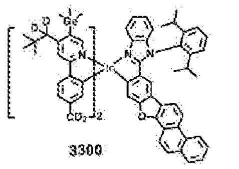
3300

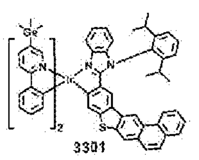
3301
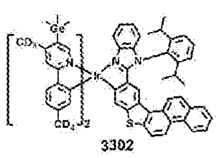
3302
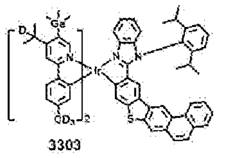
3303
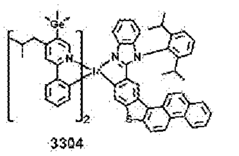
3304
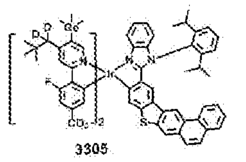
3305

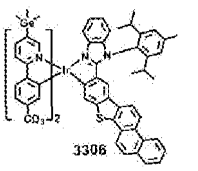
3306
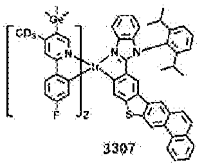
3307
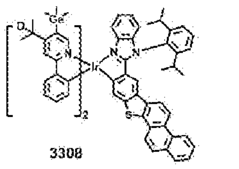
3308
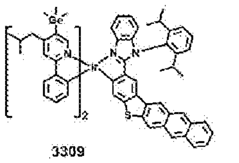
3309
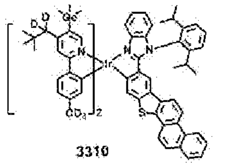
3310

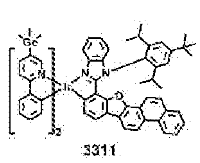
3311
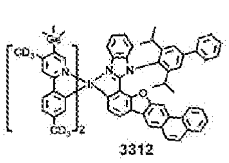
3312
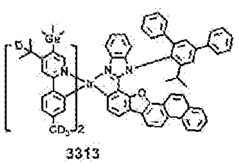
3313
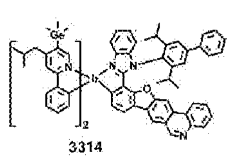
3314
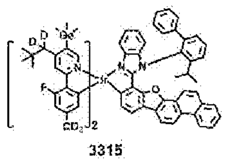
3315

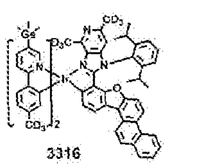
3316
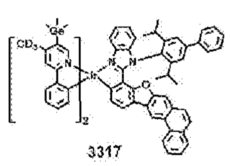
3317
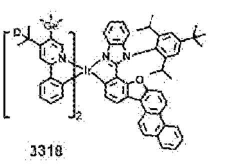
3318
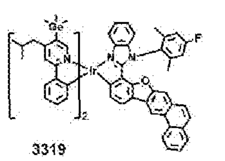
3319
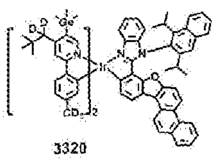
3320

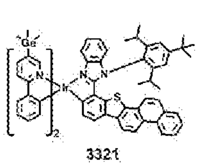
3321
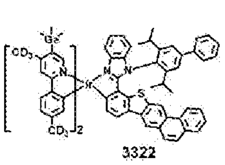
3322
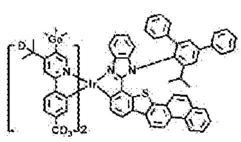
3323
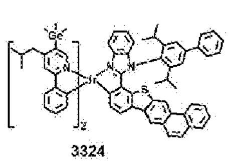
3324
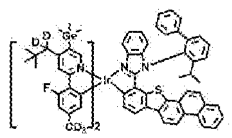
3325

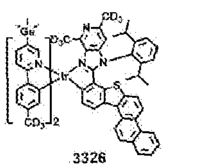
3326
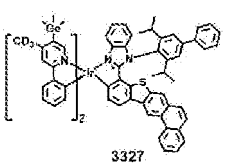
3327
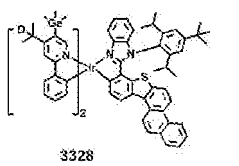
3328
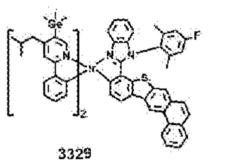
3329
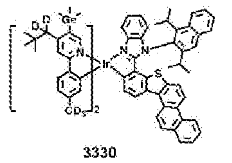
3330

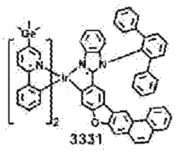
3331
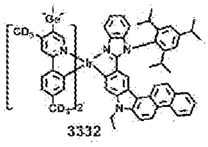
3332
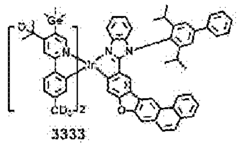
3333
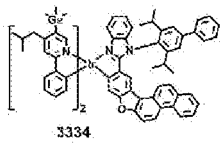
3334
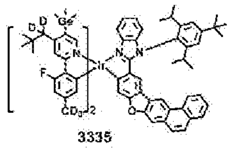
3335

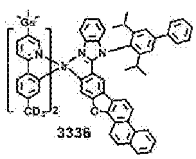
3336
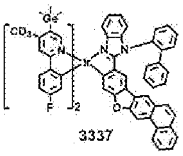
3337
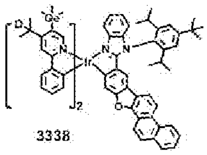
3338
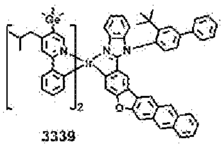
3339
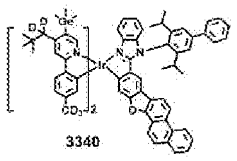
3340

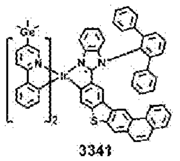
3341
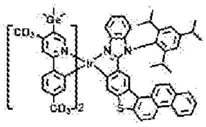
3342
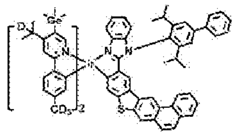
3343
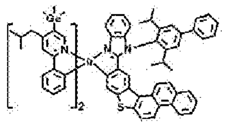
3344
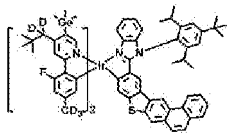
3345

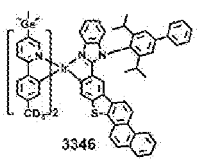
3346
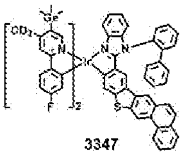
3347
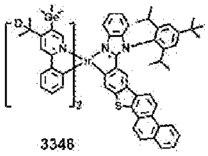
3348
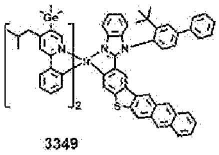
3349
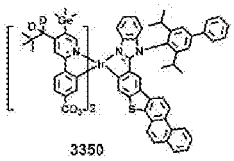
3350

## Group G1-4

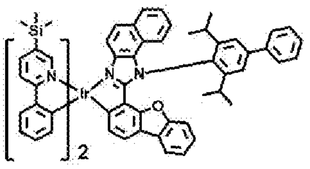
1
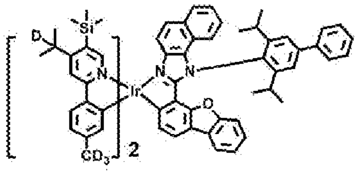
2
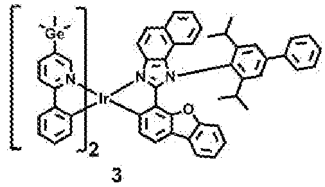
3

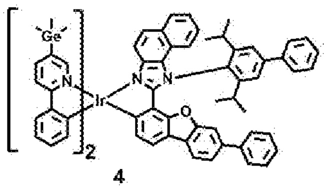
4
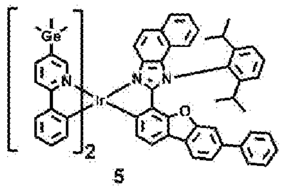
5
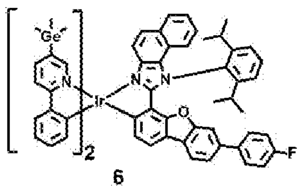
6

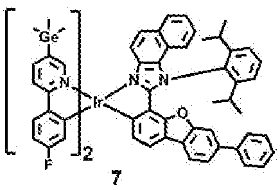
7
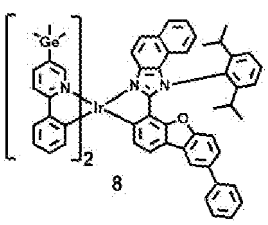
8
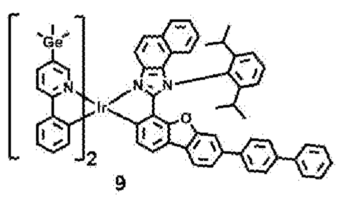
9

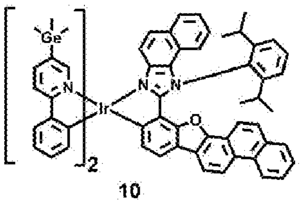
10

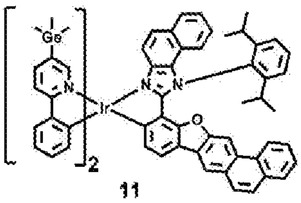
11

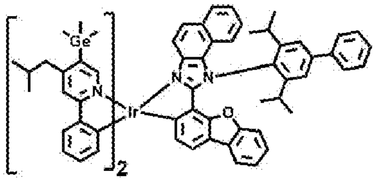
12

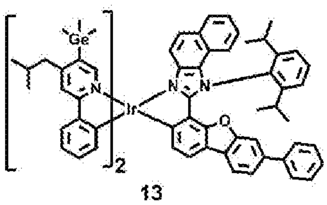
13

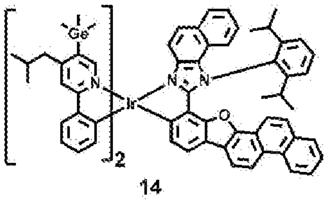
14

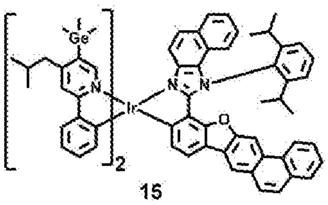
15

## Group G1-5

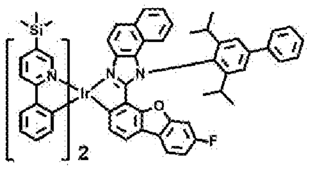
1

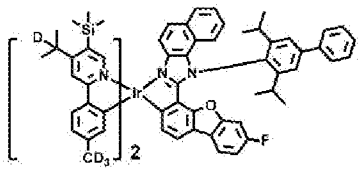
2

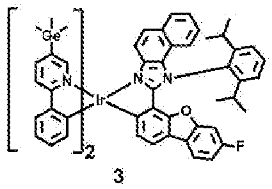
3

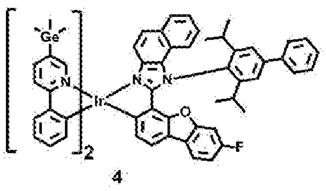
4

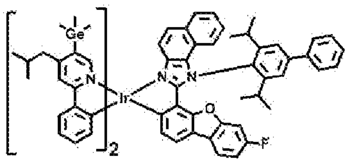
5

## Group G1-6

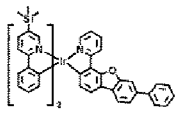
1
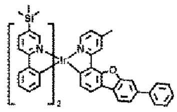
2
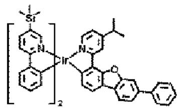
3
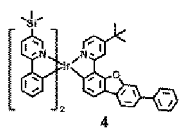
4
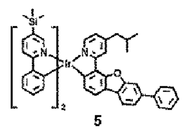
5
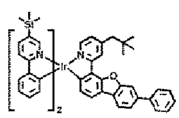
6
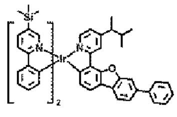
7
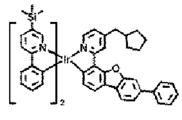
8
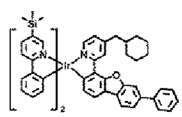
9
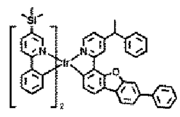
10
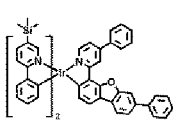
11
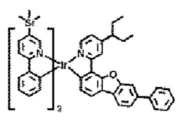
12
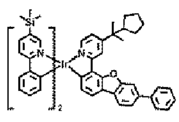
13
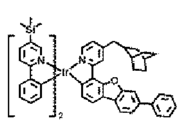
14
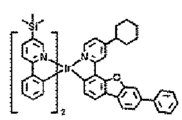
15
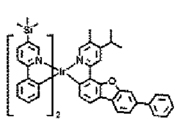
16
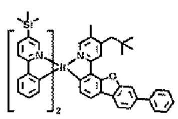
17
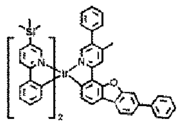
18
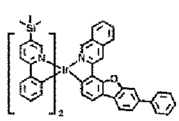
19
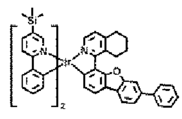
20
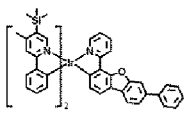
21
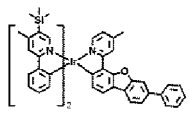
22
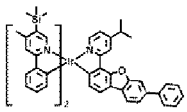
23
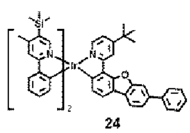
24
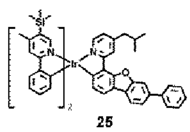
25
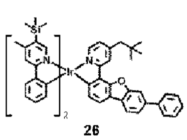
26
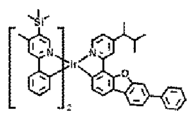
27
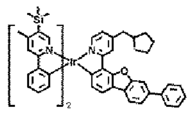
28
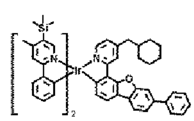
29
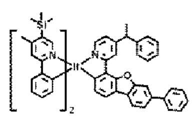
30
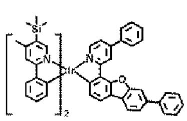
31
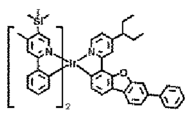
32
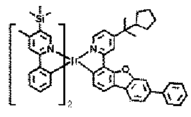
33
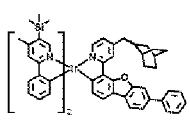
34
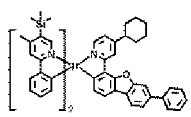
35
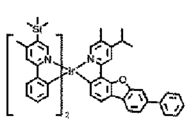
36
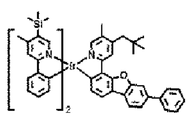
37
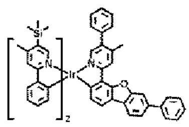
38
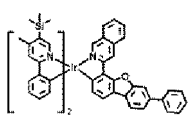
39
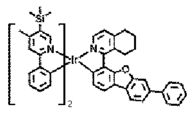
40

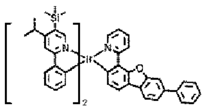
41
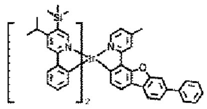
42
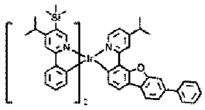
43
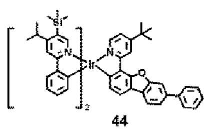
44
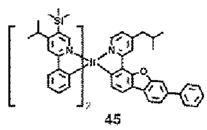
45
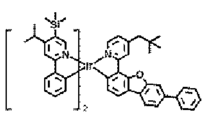
46
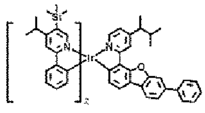
47
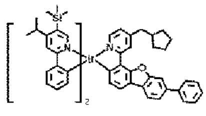
48
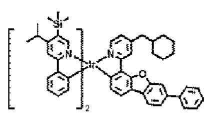
49
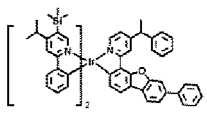
50
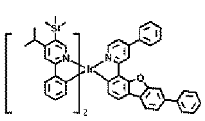
51
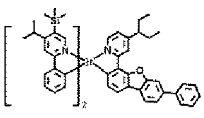
52
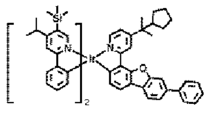
53
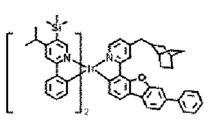
54
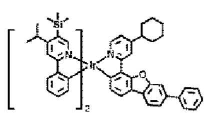
55
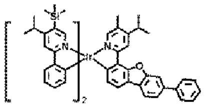
56
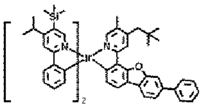
57
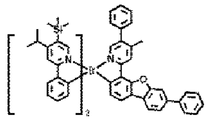
58
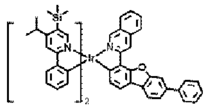
59
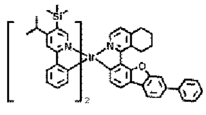
60
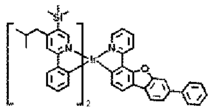
61
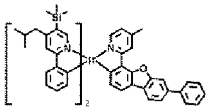
62
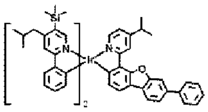
63
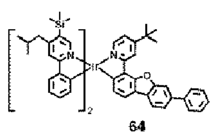
64
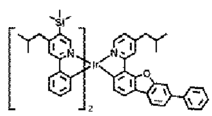
65
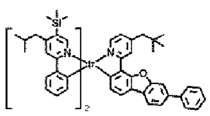
66
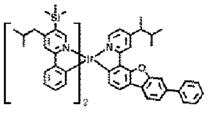
67
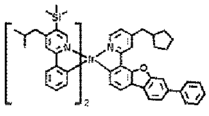
68
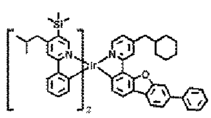
69
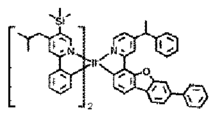
70
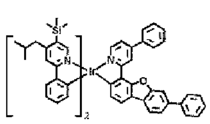
71
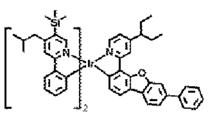
72
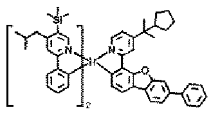
73
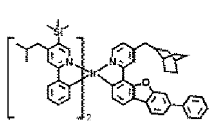
74
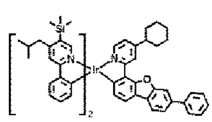
75
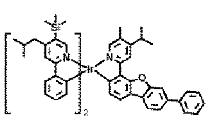
76
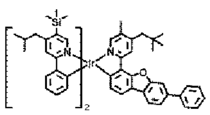
77
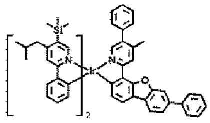
78
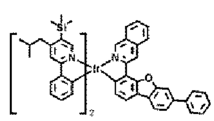
79
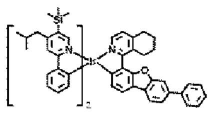
80

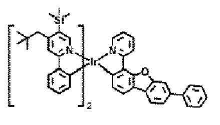
81
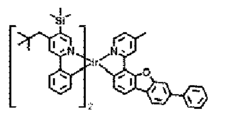
82
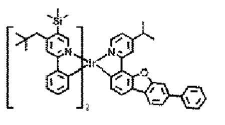
83
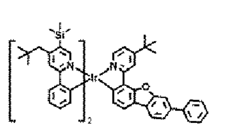
84
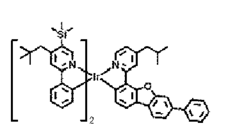
85

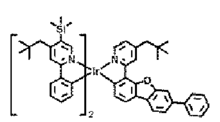
86
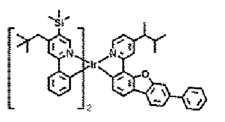
87
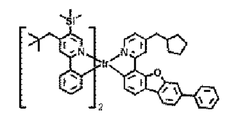
88
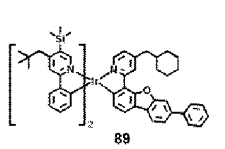
89
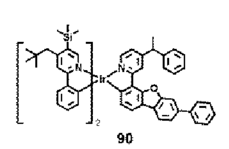
90

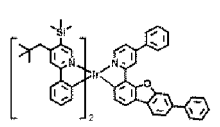
91
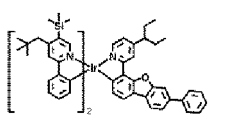
92
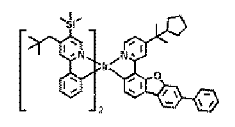
93
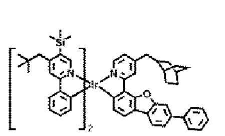
94
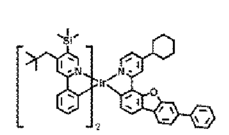
95

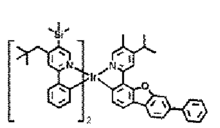
96
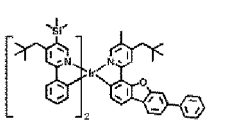
97
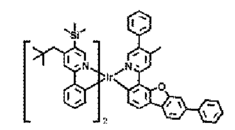
98
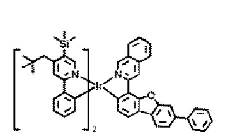
99
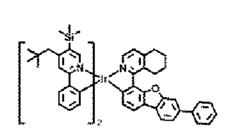
100

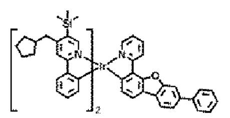
101
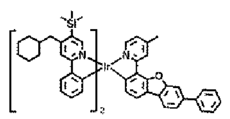
102
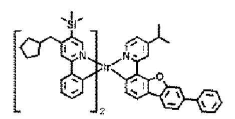
103
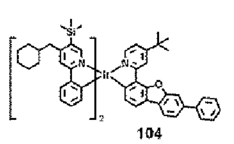
104
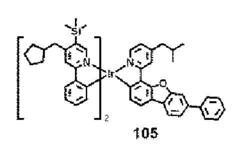
105

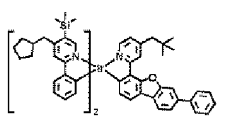
106
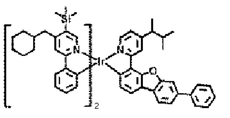
107
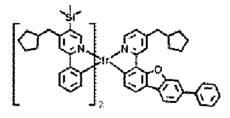
108
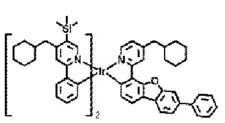
109
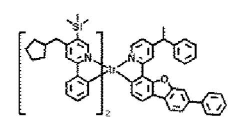
110

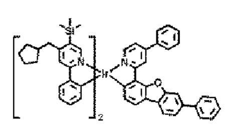
111
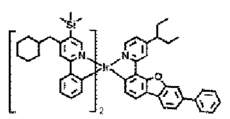
112
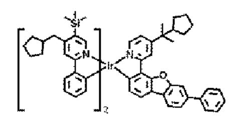
113
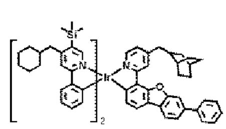
114
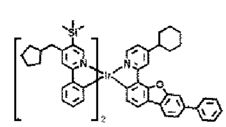
115

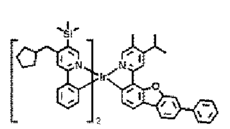
116
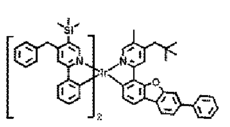
117
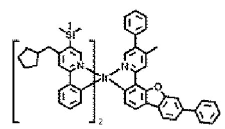
118
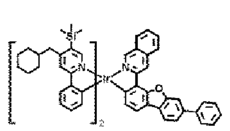
119
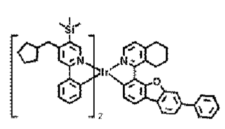
120

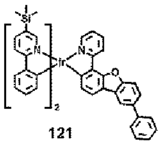
121
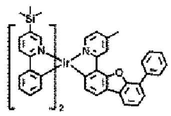
122
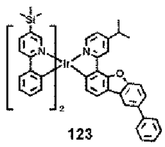
123
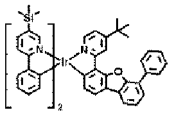
124
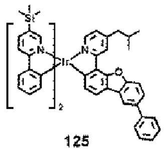
125

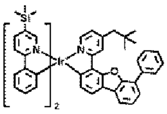
126
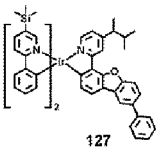
127
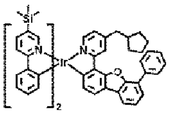
128
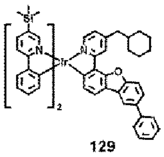
129
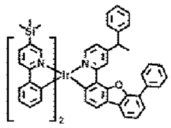
130

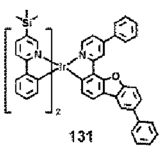
131
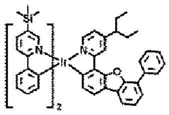
132
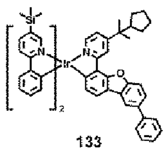
133
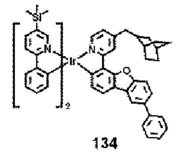
134
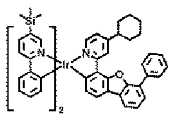
135

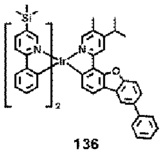
136
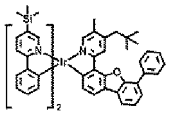
137
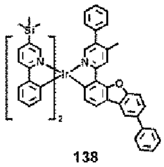
138
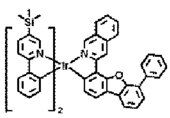
139
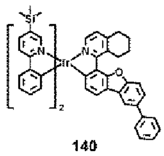
140

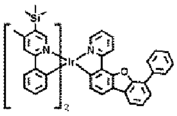
141
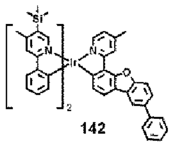
142
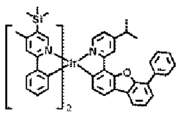
143
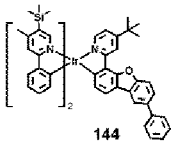
144
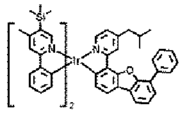
145

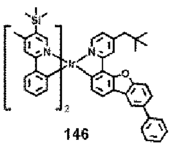
146
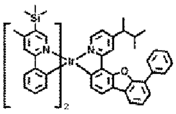
147
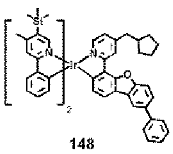
148
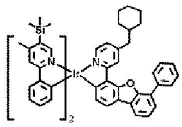
148
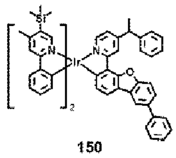
150

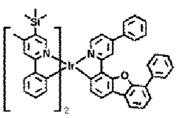
151
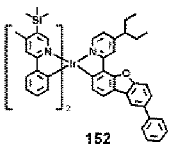
152
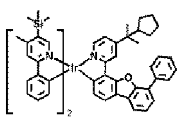
153
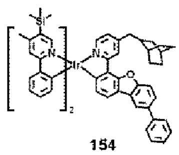
154
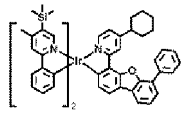
155

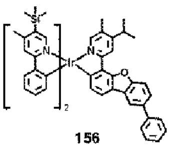
156
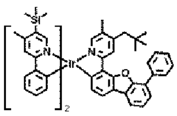
157
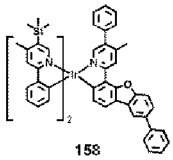
158
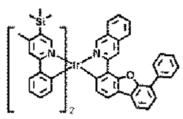
159
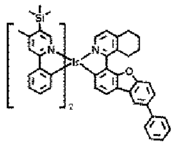
160

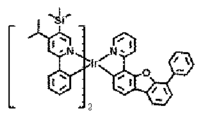
161
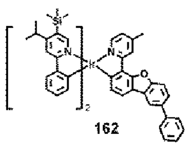
162
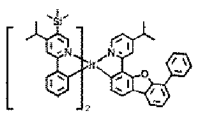
163
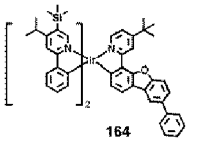
164
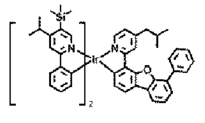
165

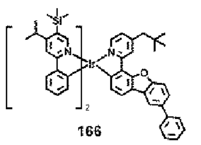
166
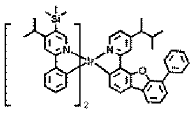
167
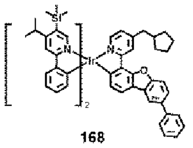
168
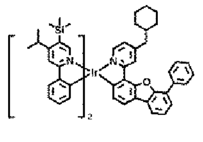
169
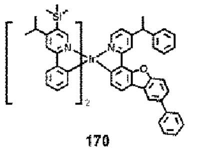
170

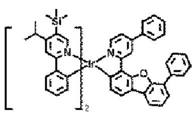
171
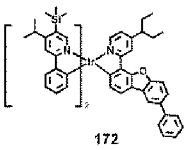
172
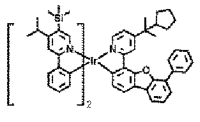
173
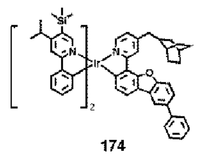
174
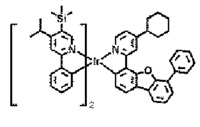
175

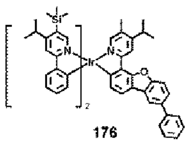
176
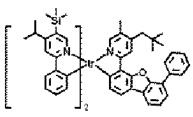
177
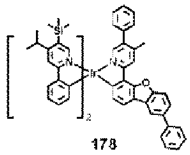
178
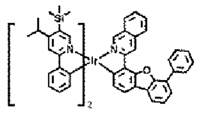
179
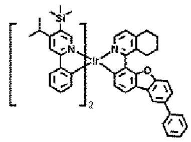
180

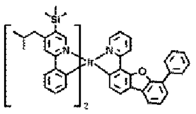
181
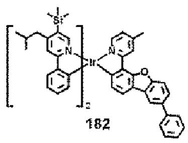
182
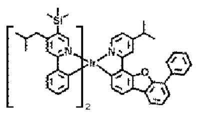
183
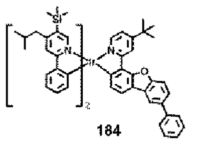
184
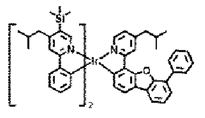
185

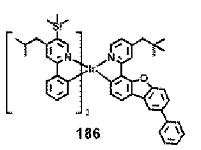
186
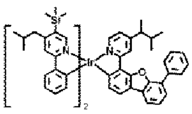
187
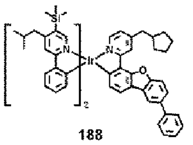
188
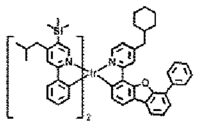
189
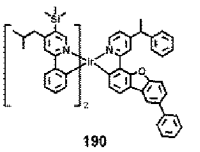
190

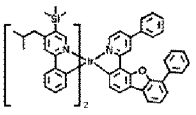
191
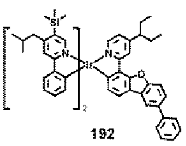
192
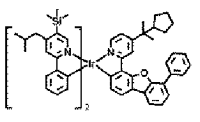
193
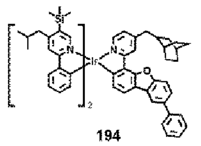
194
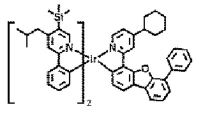
195

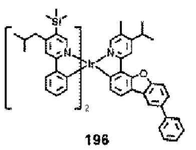
196
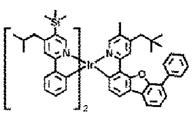
197
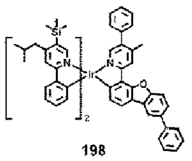
198
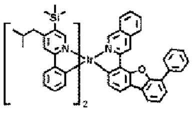
199
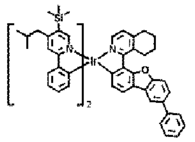
200

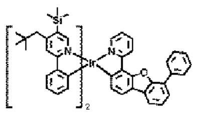
201
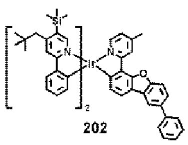
202
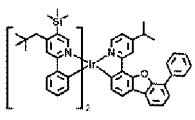
203
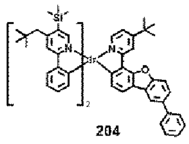
204
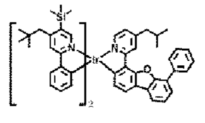
205

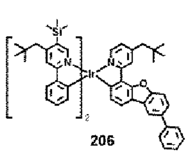
206
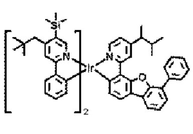
207
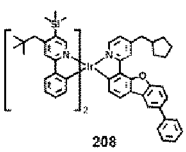
208
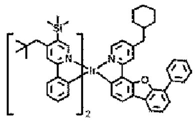
209
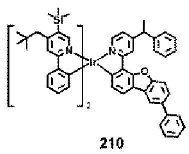
210

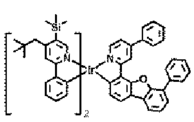
211
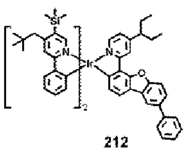
212
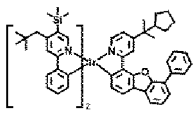
213
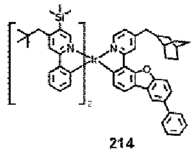
214
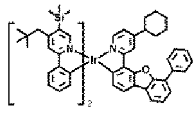
215

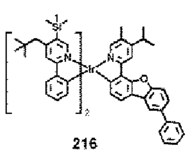
216
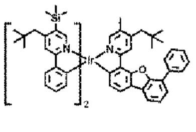
217
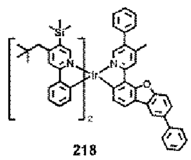
218
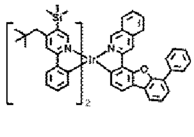
219
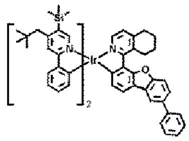
220

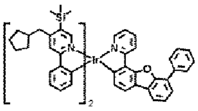
221
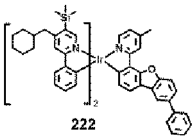
222
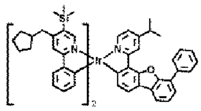
223
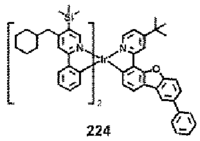
224
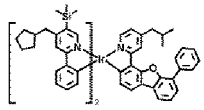
225

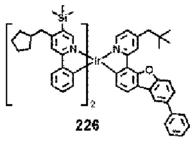
226
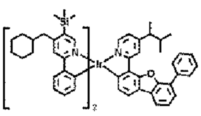
227
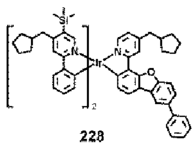
228
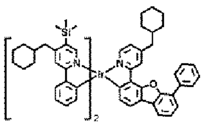
229
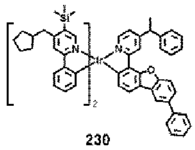
230

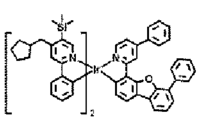
231
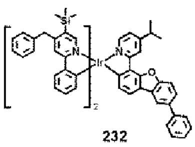
232
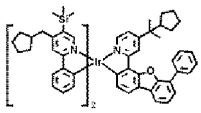
233
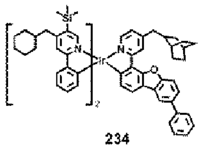
234
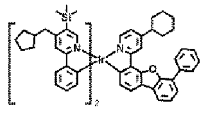
235

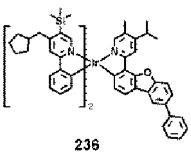
236
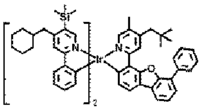
237
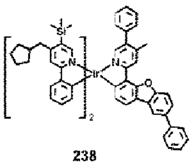
238
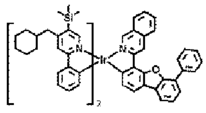
239
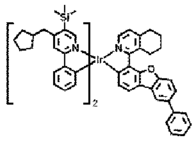
240

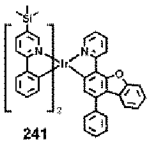
241

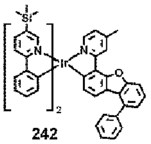
242

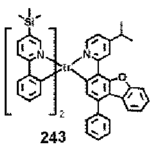
243

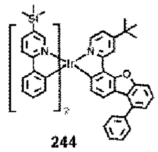
244

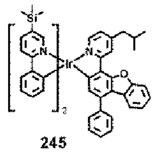
245

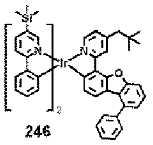
246

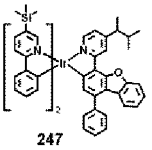
247

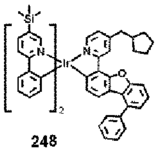
248

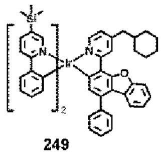
249

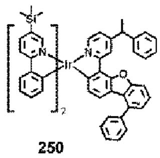
250

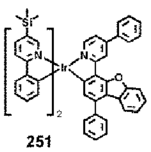
251

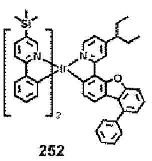
252

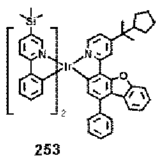
253

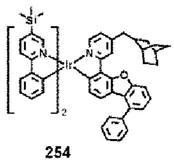
254

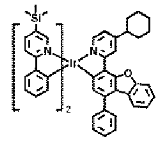
255

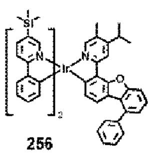
256

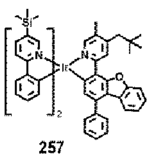
257

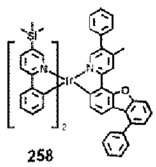
258

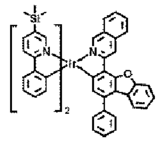
259

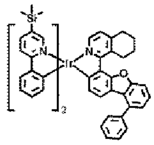
260

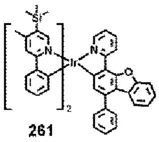
261

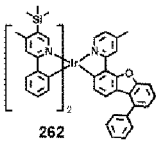
262

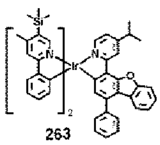
263

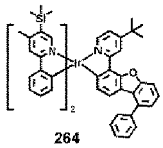
264

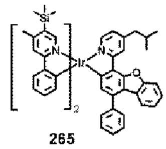
265

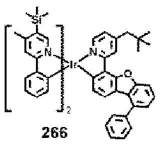
266

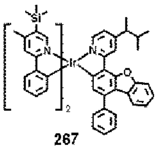
267

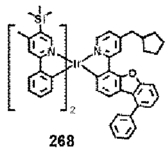
268

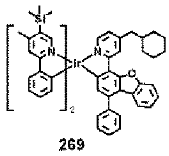
269

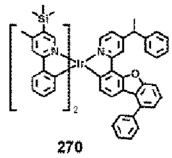
270

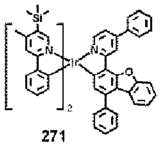
271

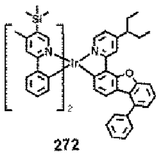
272

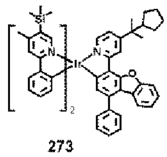
273

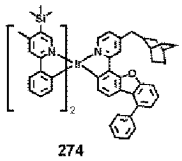
274

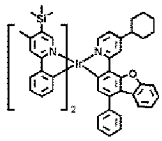
275

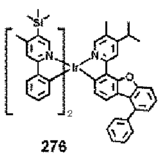
276

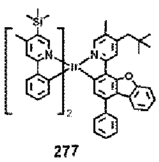
277

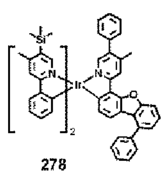
278

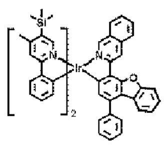
279

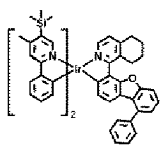
280

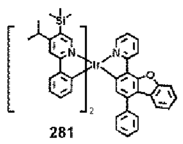
281

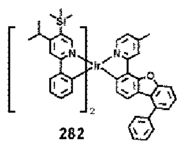
282

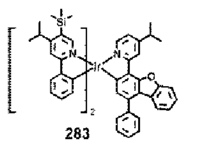
283

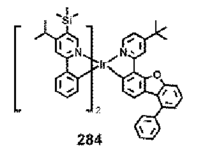
284

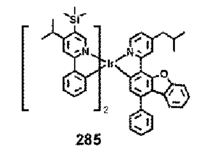
285

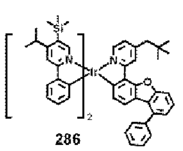
286

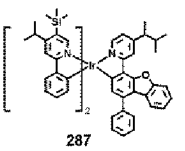
287

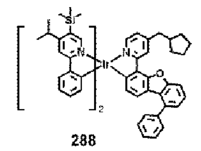
288

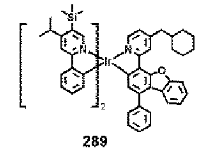
289

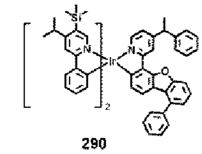
290

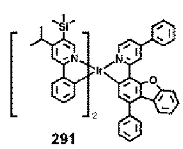
291

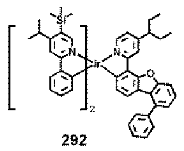
292

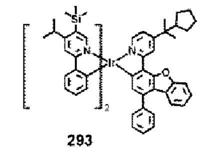
293

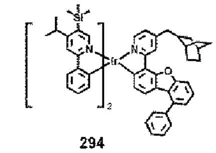
294

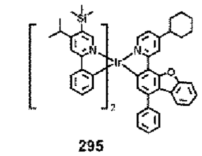
295

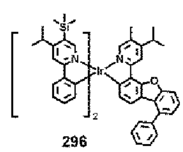
296

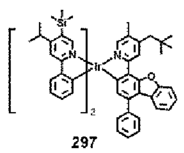
297

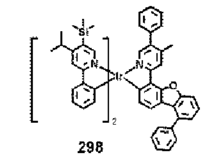
298

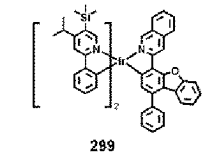
299

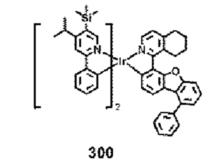
300

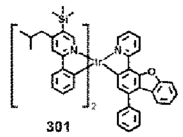
301

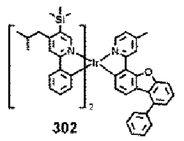
302

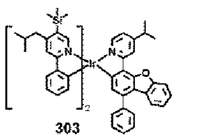
303

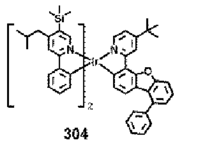
304

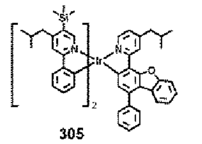
305

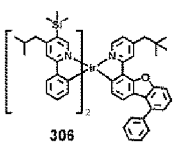
306

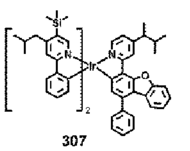
307

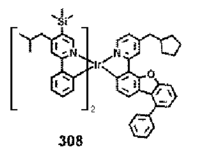
308

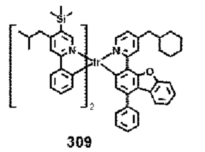
309

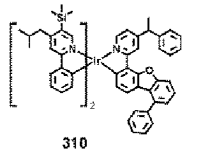
310

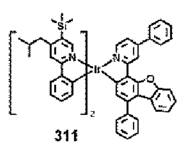
311

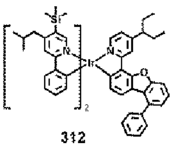
312

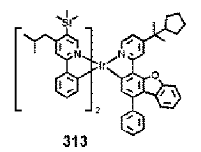
313

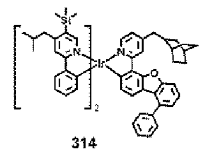
314

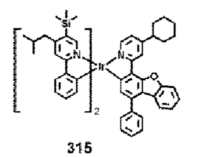
315

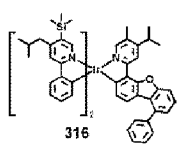
316

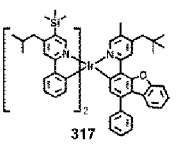
317

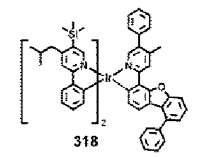
318

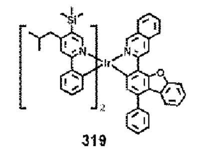
319

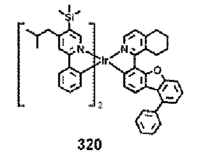
320

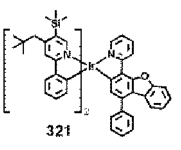
321
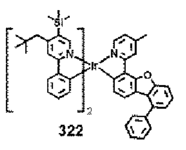
322
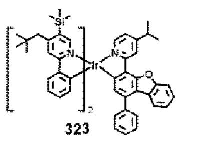
323
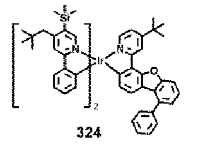
324
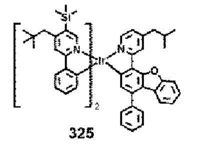
325
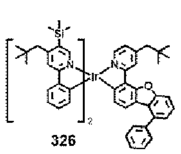
326
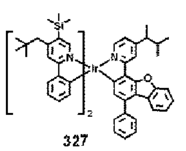
327
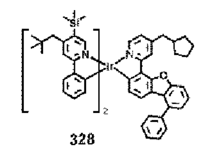
328
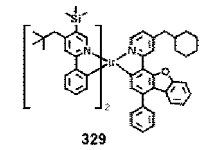
329
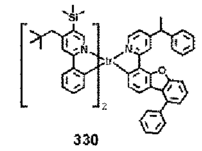
330
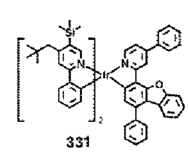
331
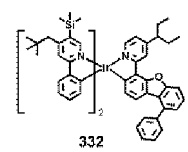
332
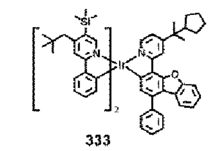
333
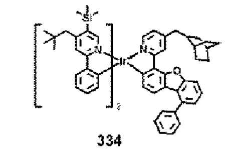
334
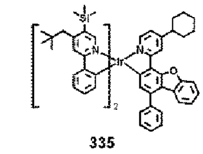
335
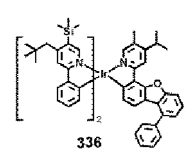
336
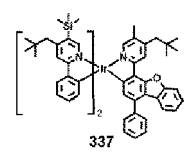
337
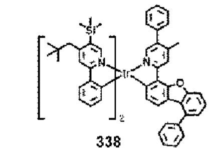
338
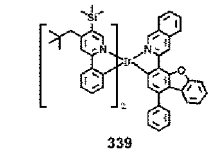
339
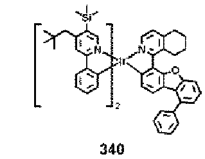
340
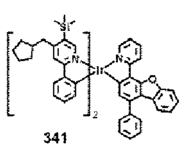
341
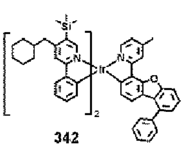
342
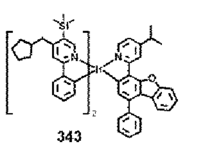
343
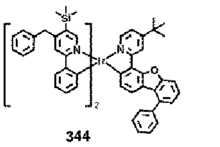
344
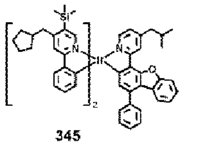
345
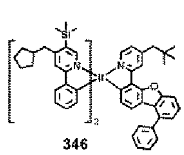
346
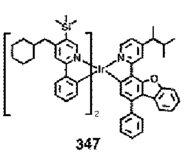
347
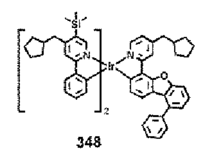
348
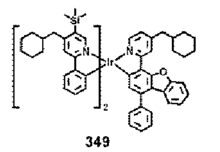
349
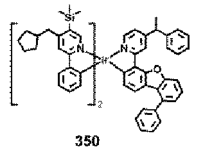
350
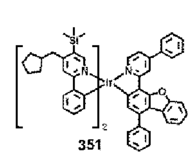
351
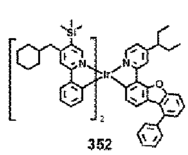
352
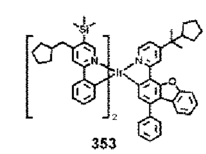
353
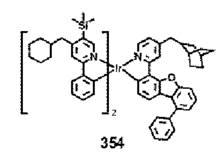
354
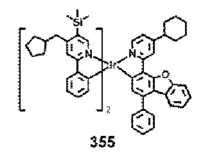
355
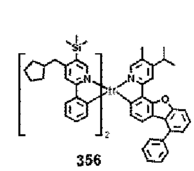
356
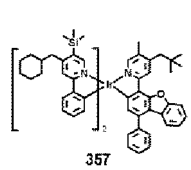
357
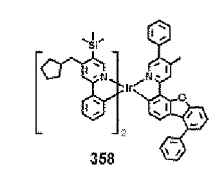
358
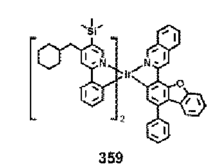
359
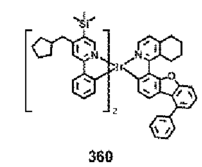
360

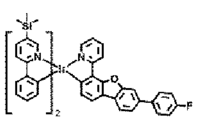
361
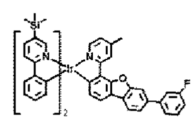
362
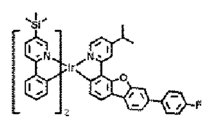
363
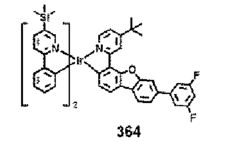
364
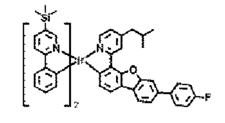
365

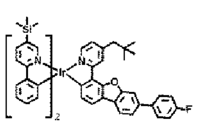
366
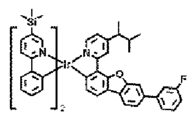
367
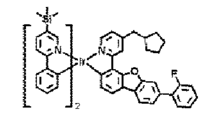
368
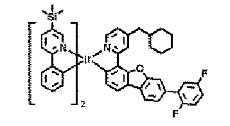
369
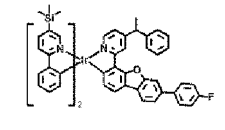
370

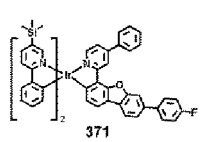
371
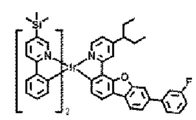
372
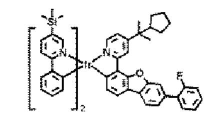
373
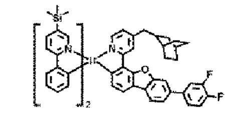
374
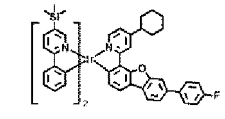
375

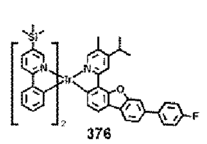
376
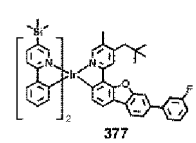
377
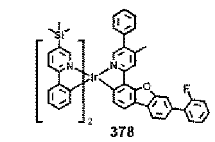
378
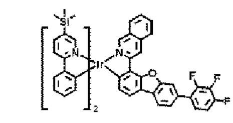
379
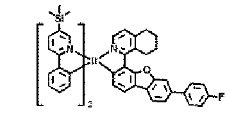
380

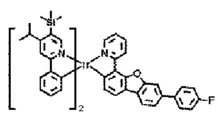
381
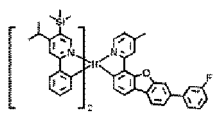
382
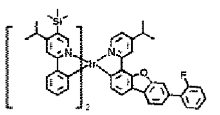
383
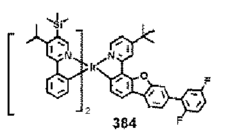
384
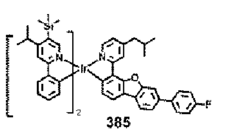
385

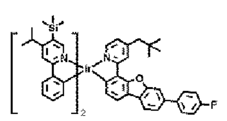
386
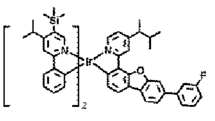
387
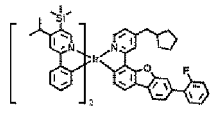
388
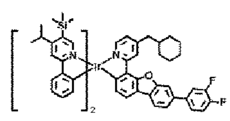
389
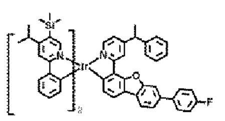
390

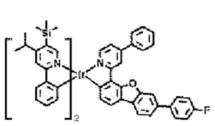
391
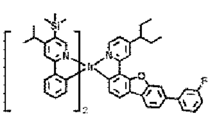
392
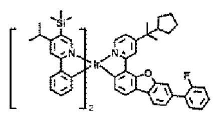
393
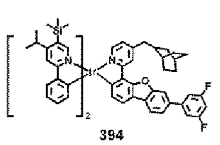
394
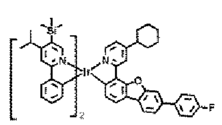
395

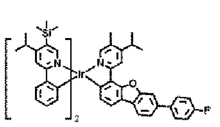
396
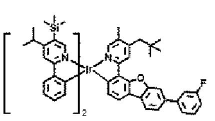
397
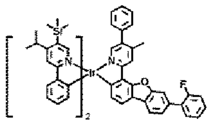
398
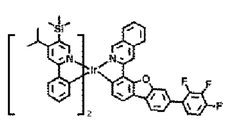
399
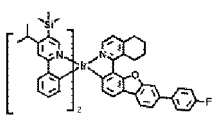
400

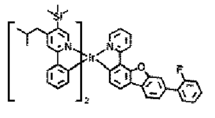
401

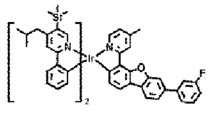
402

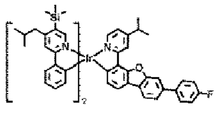
403

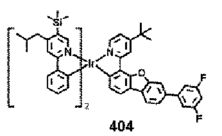
404

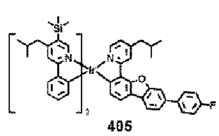
405

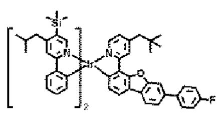
406

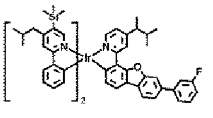
407

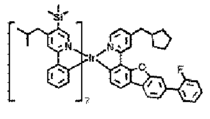
408

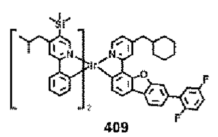
409

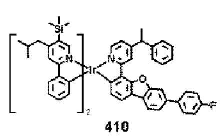
410

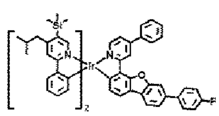
411

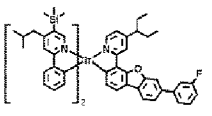
412

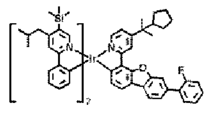
413

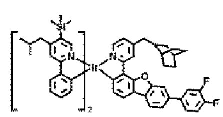
414

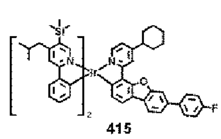
415

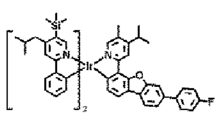
416

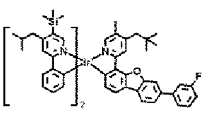
417

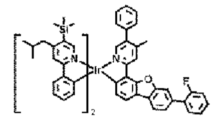
418

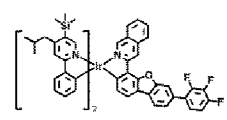
419

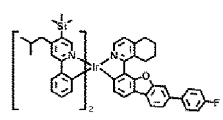
420

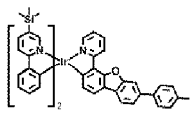
421

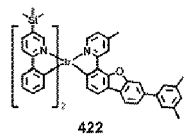
422

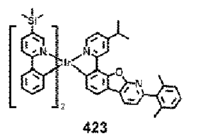
423

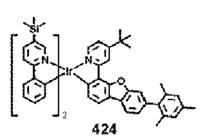
424

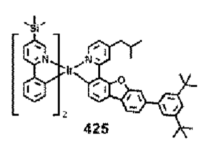
425

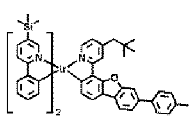
426

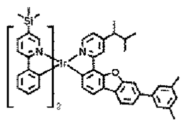
427

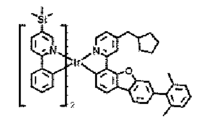
428

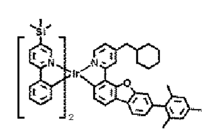
429

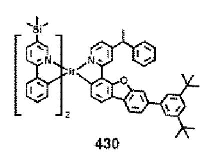
430

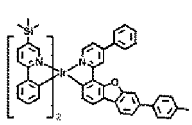
431

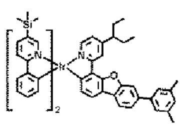
432

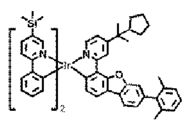
433

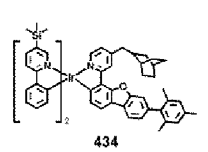
434

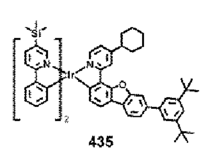
435

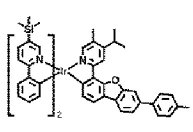
436

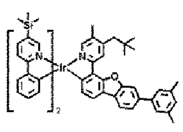
437

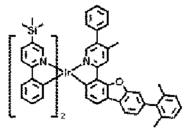
438

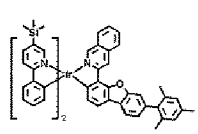
439

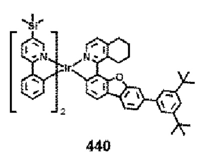
440

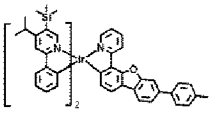
441
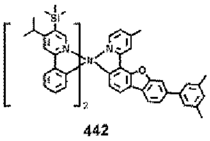
442
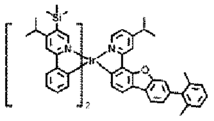
443
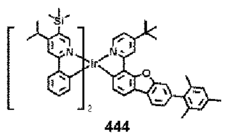
444
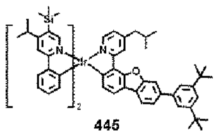
445
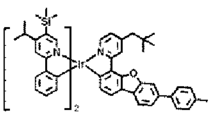
446
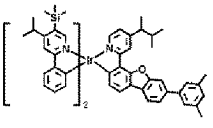
447
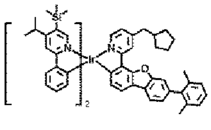
448
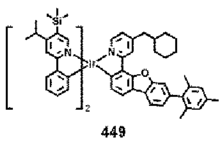
449
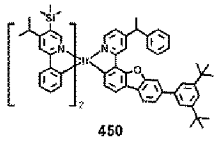
450
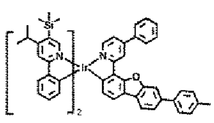
451
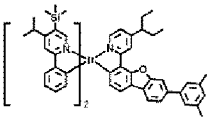
452
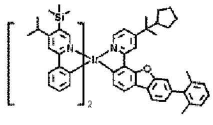
453
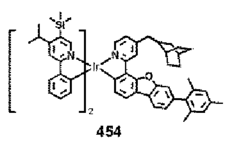
454
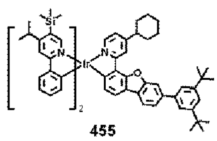
455
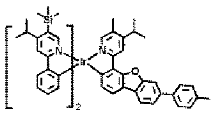
456
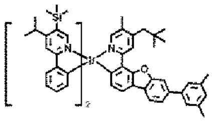
457
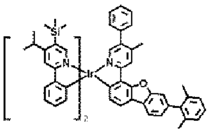
458
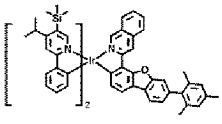
459
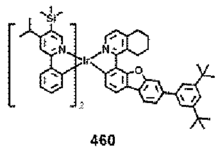
460
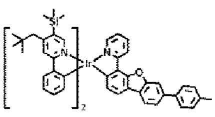
461
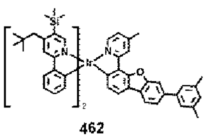
462
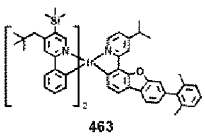
463
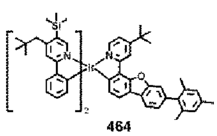
464
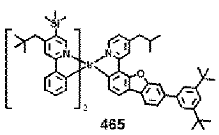
465
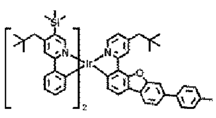
466
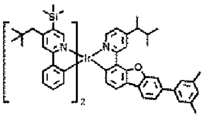
467
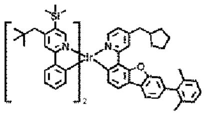
468
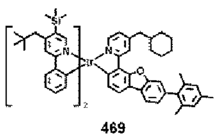
469
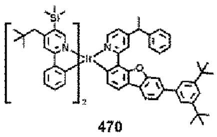
470
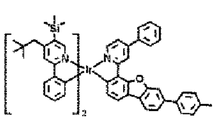
471
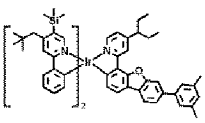
472
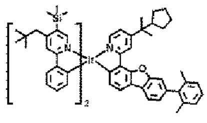
473
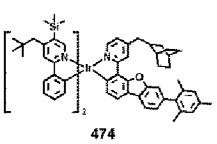
474
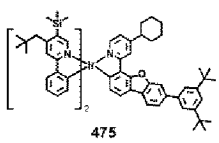
475
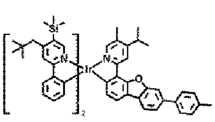
476
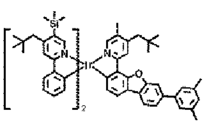
477
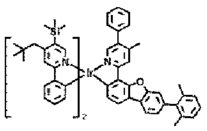
478
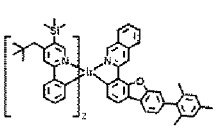
479
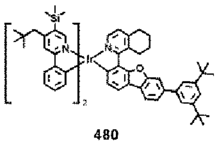
480

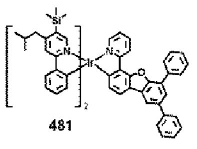
481

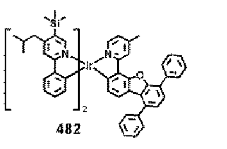
482

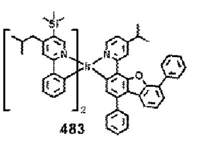
483

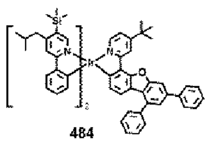
484

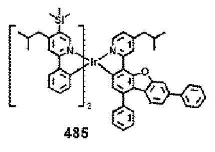
485

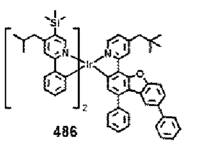
486

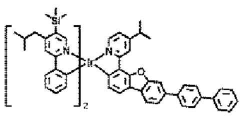
487

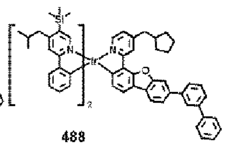
488

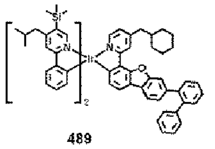
489

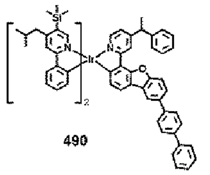
490

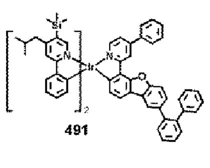
491

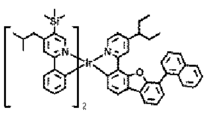
492

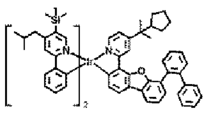
493

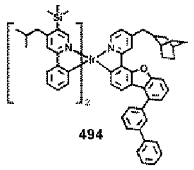
494

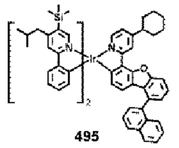
495

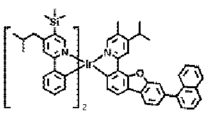
496

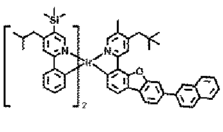
497

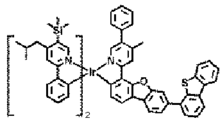
498

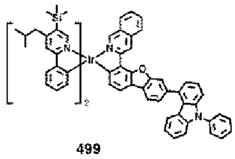
499

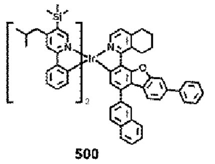
500

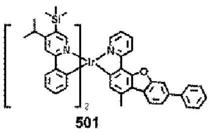
501

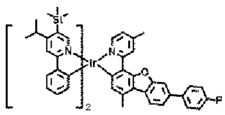
502

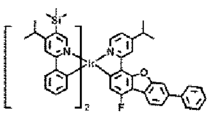
503

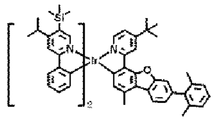
504

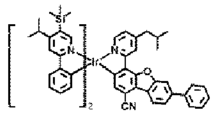
505

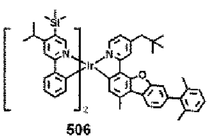
506

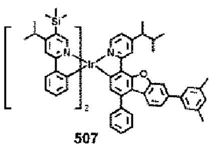
507

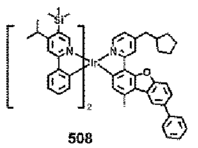
508

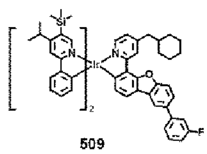
509

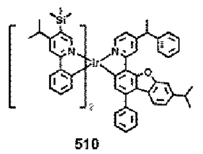
510

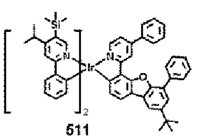
511

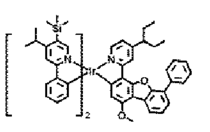
512

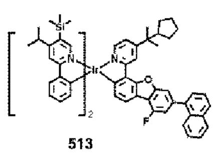
513

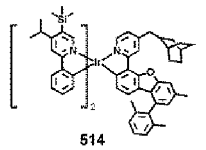
514

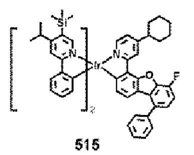
515

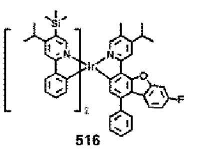
516

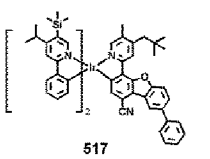
517

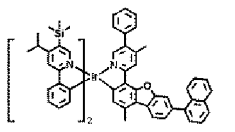
518

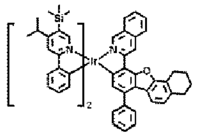
519

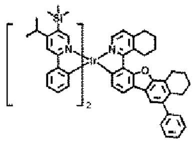
520

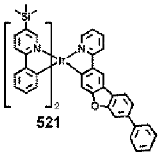
521
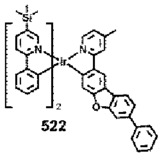
522
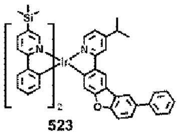
523
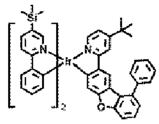
524
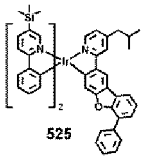
525

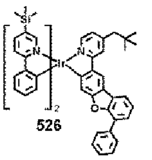
526
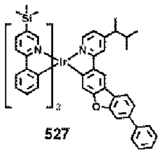
527
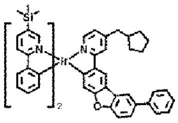
528
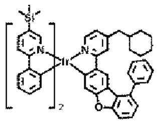
529
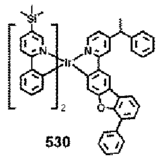
530

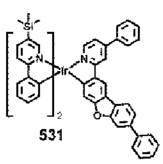
531
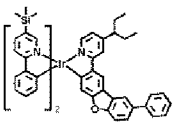
532
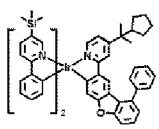
533
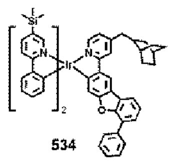
534
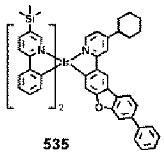
535

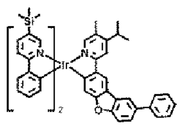
536
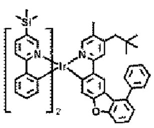
537
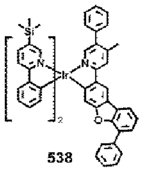
538
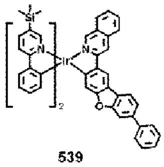
539
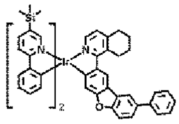
540

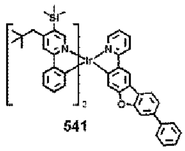
541
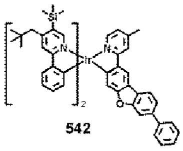
542
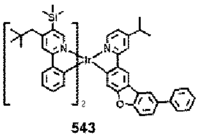
543
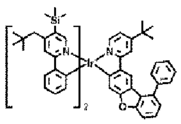
544
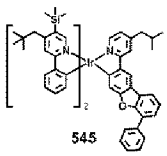
545

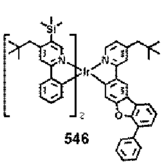
546
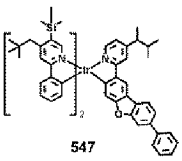
547
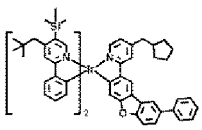
548
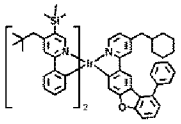
549
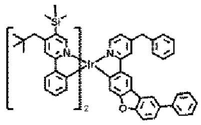
550

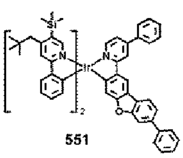
551
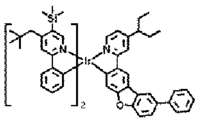
552
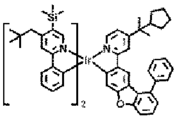
553
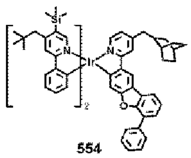
554
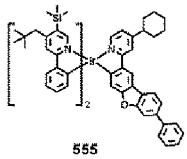
555

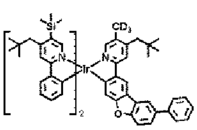
556
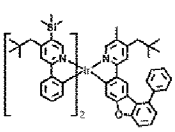
557
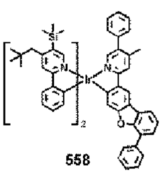
558
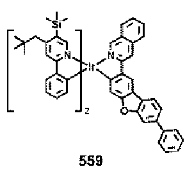
559
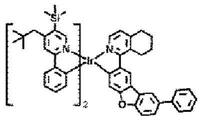
560

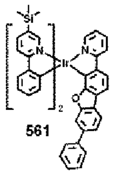
561

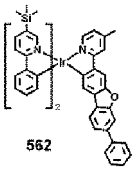
562

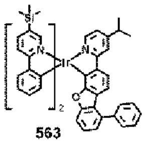
563

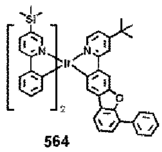
564

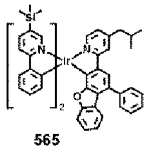
565

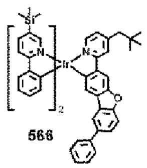
566

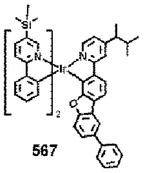
567

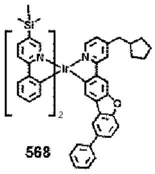
568

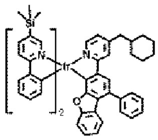
569

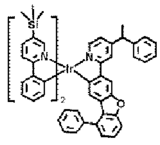
570

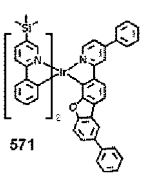
571

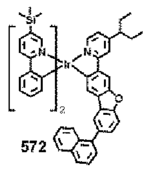
572

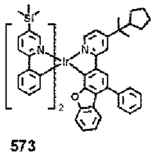
573

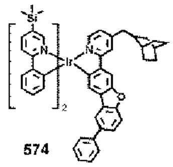
574

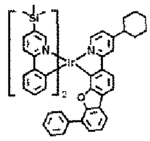
575

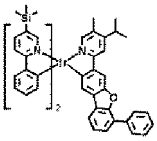
576

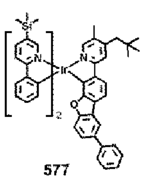
577

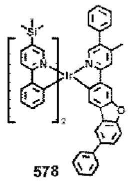
578

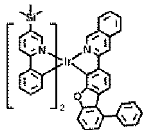
579

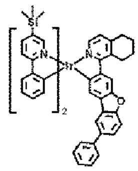
580

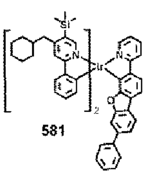
581

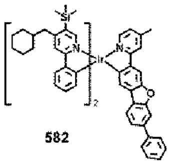
582

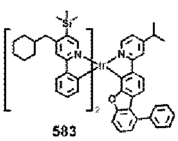
583

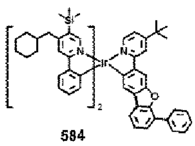
584

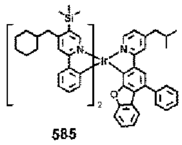
585

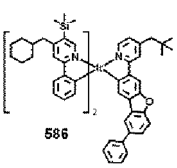
586

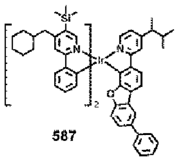
587

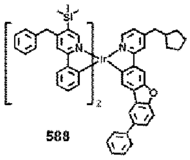
588

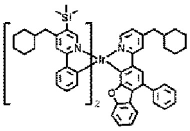
589

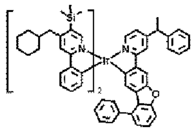
590

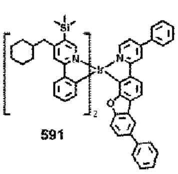
591

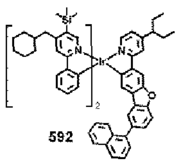
592

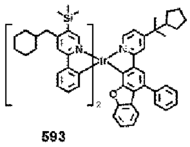
593

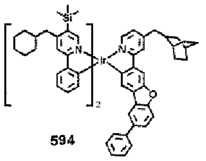
594

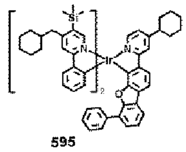
595

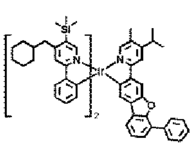
596

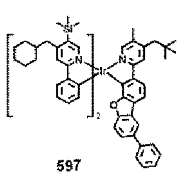
597

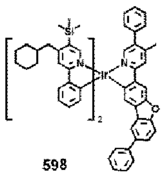
598

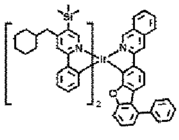
599

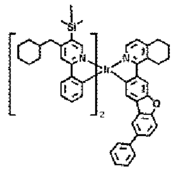
600

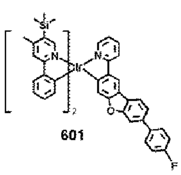
601

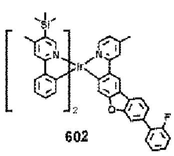
602

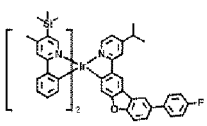
603

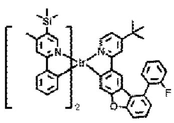
604

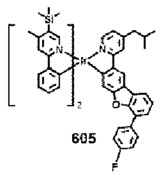
605

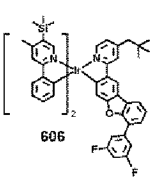
606

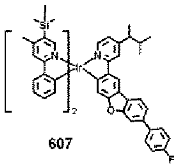
607

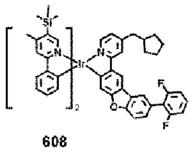
608

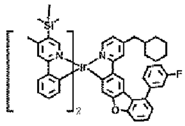
609

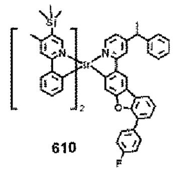
610

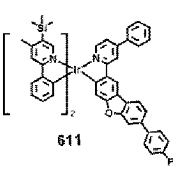
611

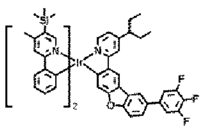
612

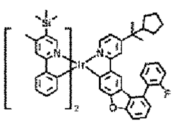
613

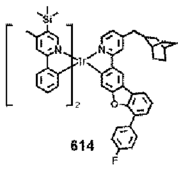
614

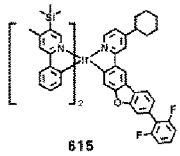
615

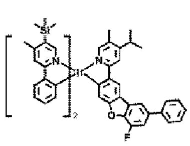
616

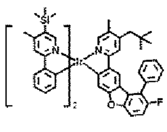
617

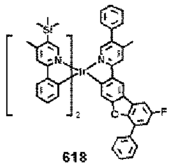
618

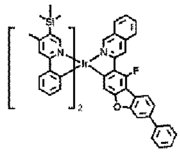
619

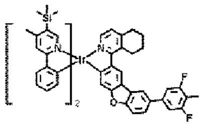
620

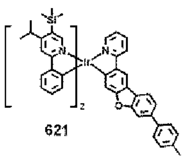
621

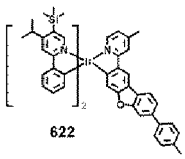
622

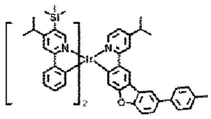
623

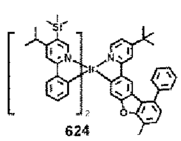
624

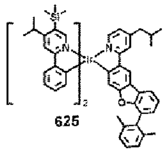
625

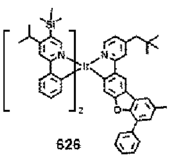
626

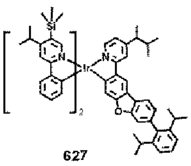
627

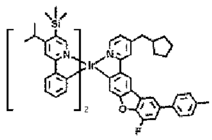
628

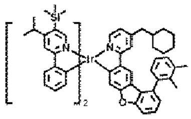
629

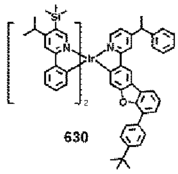
630

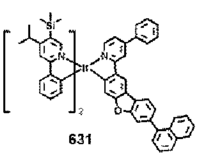
631

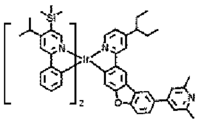
632

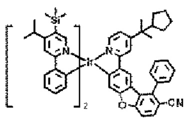
633

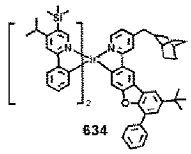
634

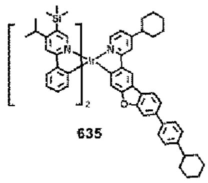
635

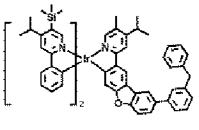
636

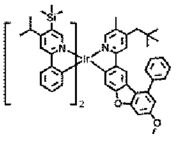
637

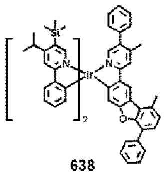
638

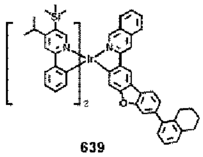
639

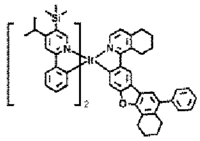
640

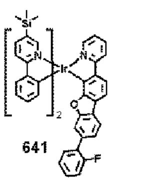
641
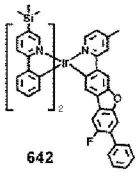
642
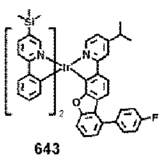
643
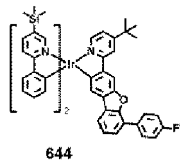
644
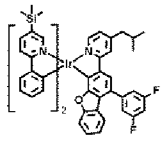
645
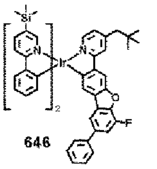
646
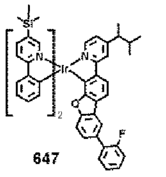
647
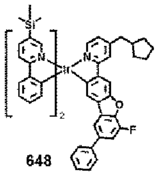
648
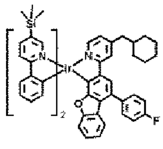
649
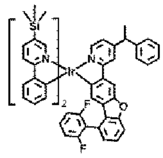
650
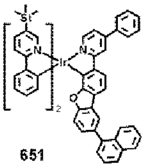
651
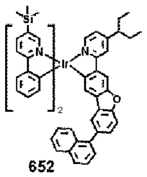
652
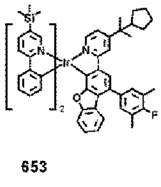
653
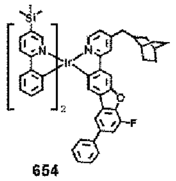
654
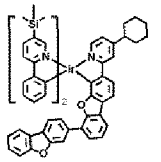
655
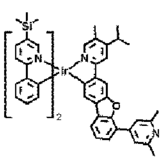
656
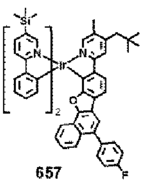
657
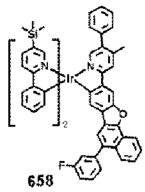
658
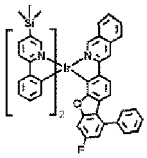
659
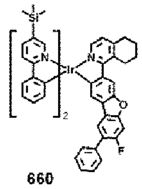
660
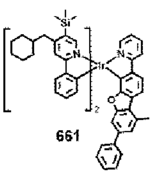
661
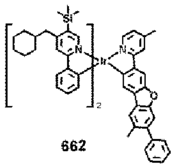
662
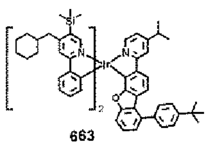
663
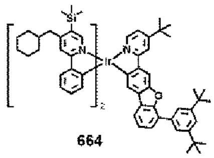
664
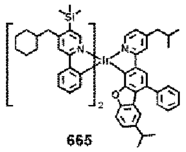
665
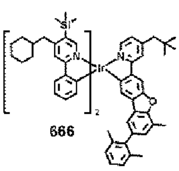
666
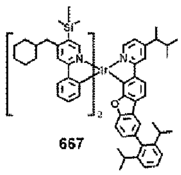
667
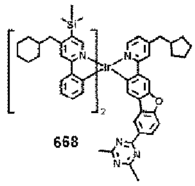
668
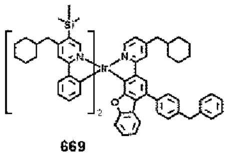
669
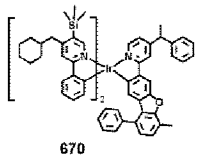
670
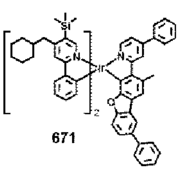
671
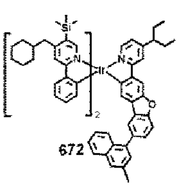
672
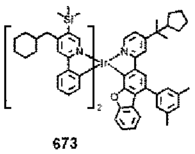
673
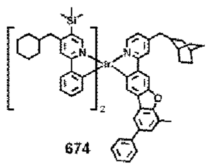
674
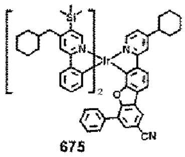
675
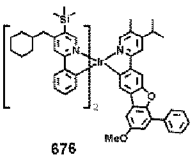
676
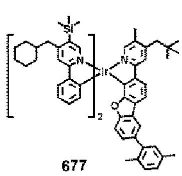
677
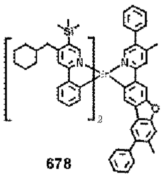
678
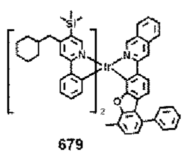
679
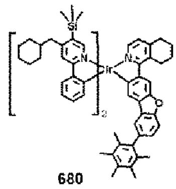
680

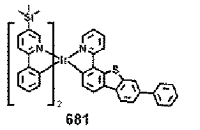
681
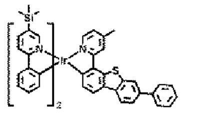
682
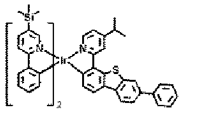
683
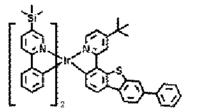
684
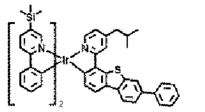
685

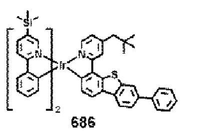
686
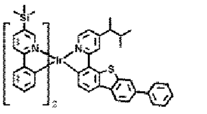
687
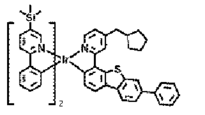
688
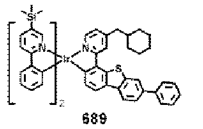
689
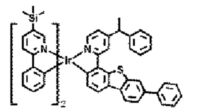
690

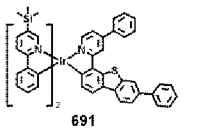
691
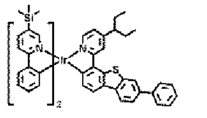
692
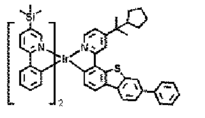
693
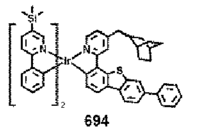
694
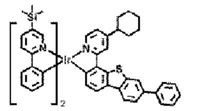
695

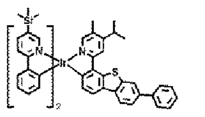
696
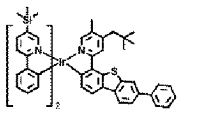
697
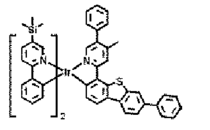
698
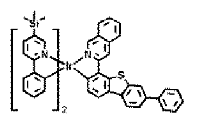
699
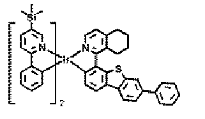
700

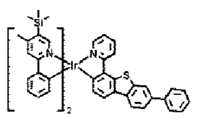
701
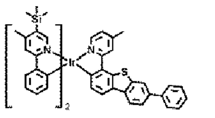
702
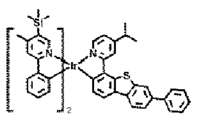
703
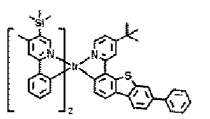
704
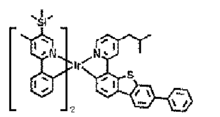
705

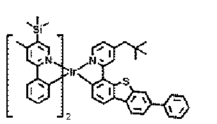
706
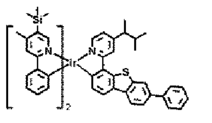
707
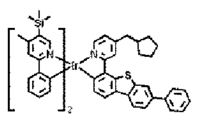
708
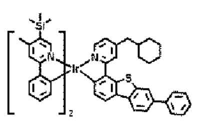
709
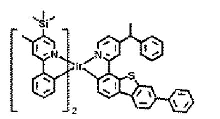
710

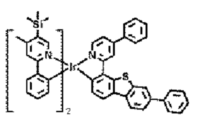
711
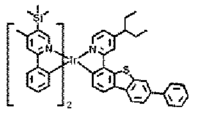
712
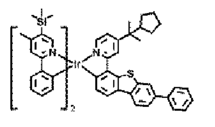
713
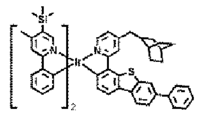
714
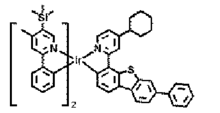
715

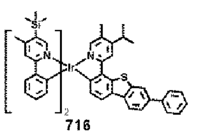
716
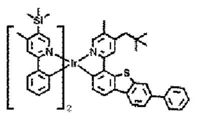
717
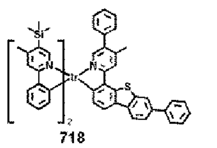
718
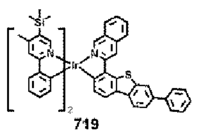
719
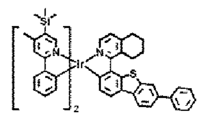
720

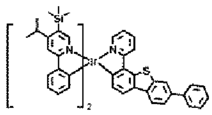
721
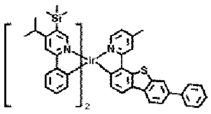
722
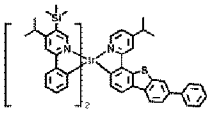
723
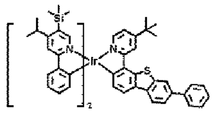
724
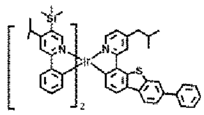
725

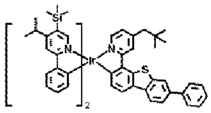
726
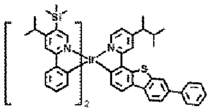
727
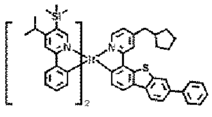
728
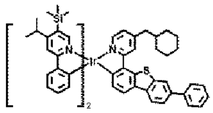
729
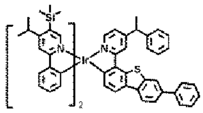
730

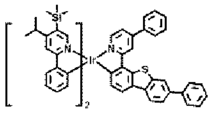
731
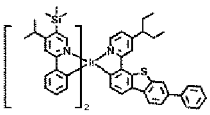
732
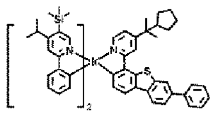
733
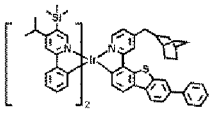
734
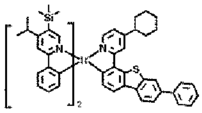
735

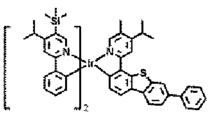
736
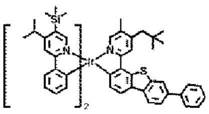
737
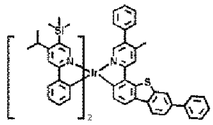
738
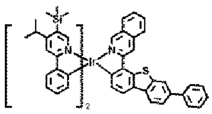
739
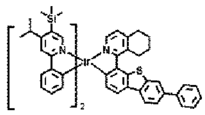
740

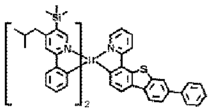
741
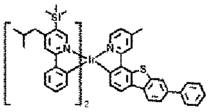
742
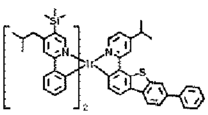
743
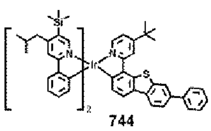
744
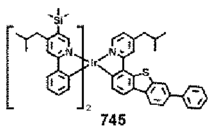
745

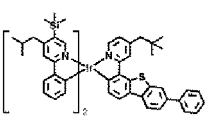
746
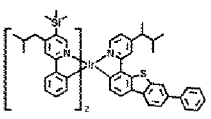
747
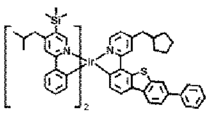
748
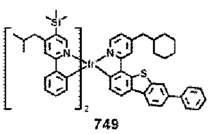
749
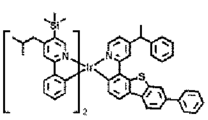
750

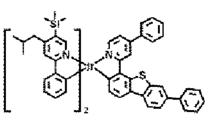
751
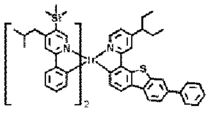
752
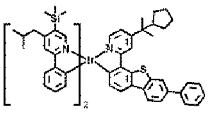
753
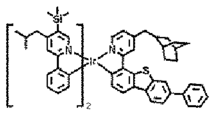
754
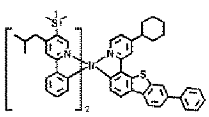
755

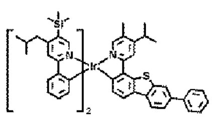
756
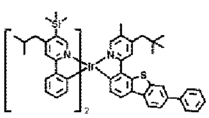
757
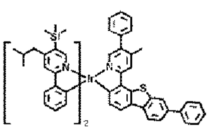
758
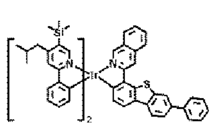
759
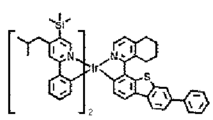
760

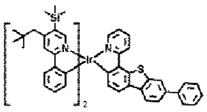
761
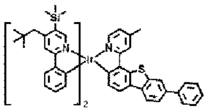
762
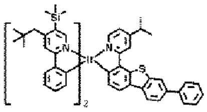
763
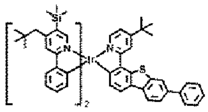
764
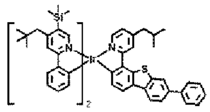
765
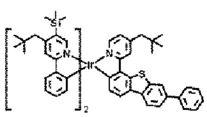
766
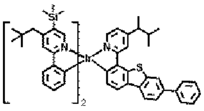
767
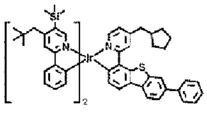
768
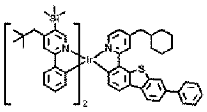
769
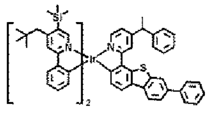
770
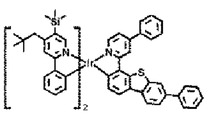
771
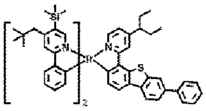
772
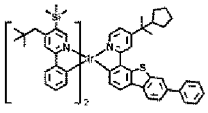
773
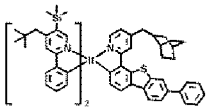
774
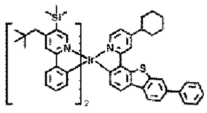
775
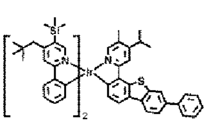
776
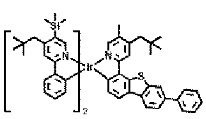
777
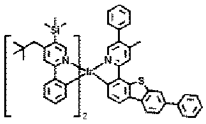
778
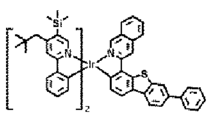
779
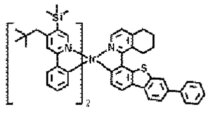
780
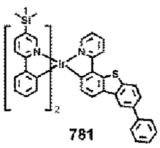
781
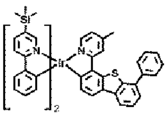
782
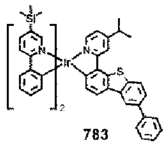
783
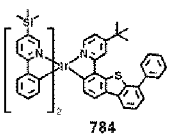
784
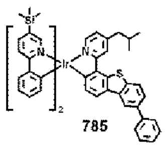
785
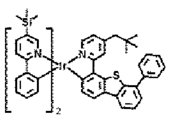
786
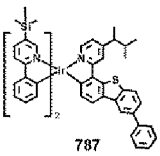
787
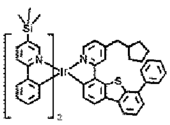
788
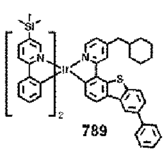
789
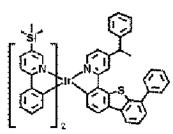
790
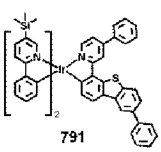
791
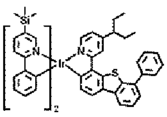
792
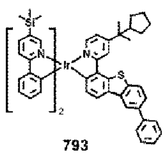
793
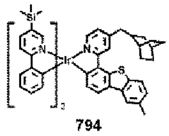
794
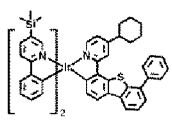
795
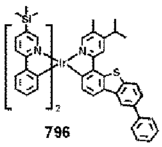
796
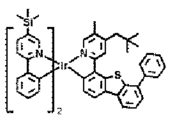
797
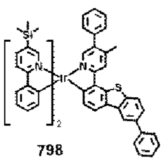
798
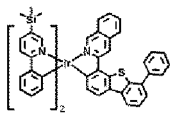
799
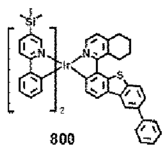
800

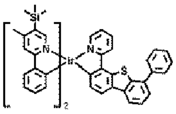
801
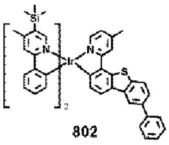
802
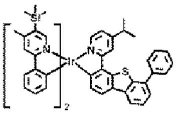
803
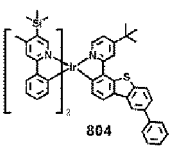
804
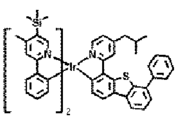
805

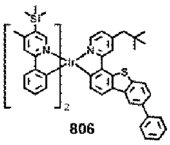
806
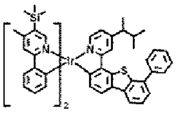
807
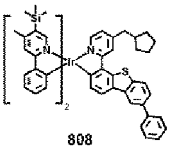
808
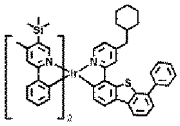
809
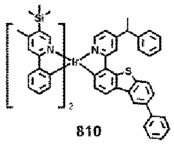
810

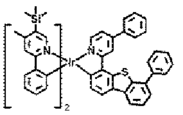
811
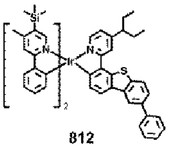
812
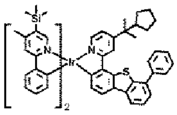
813
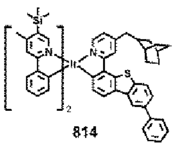
814
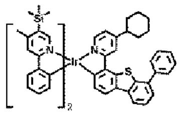
815

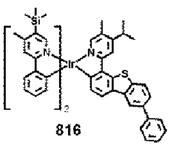
816
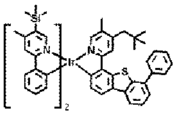
817
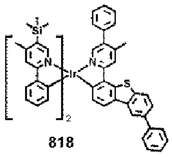
818
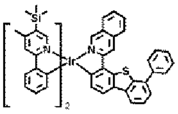
819
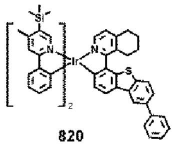
820

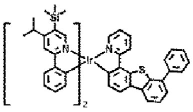
821
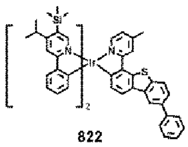
822
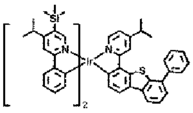
823
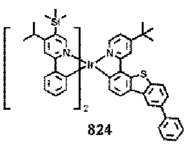
824
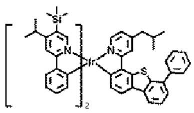
825

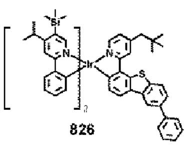
826
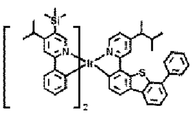
827
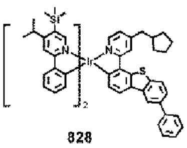
828
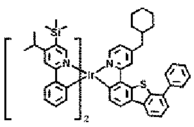
829
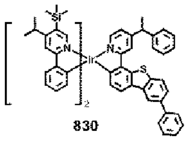
830

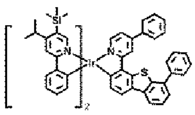
831
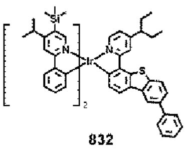
832
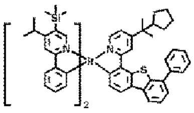
833
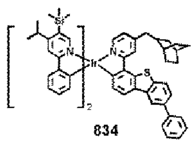
834
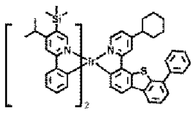
835

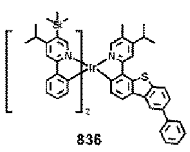
836
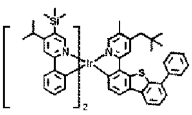
837
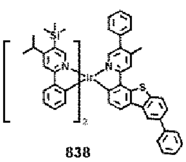
838
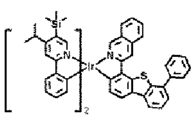
839
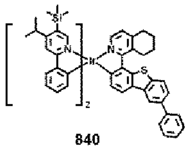
840

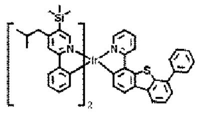
841
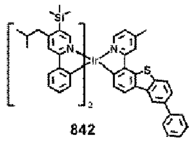
842
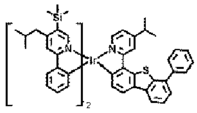
843
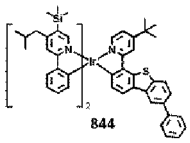
844
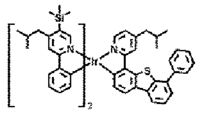
845
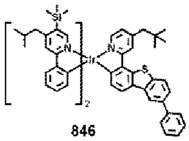
846
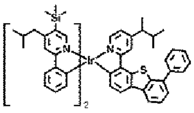
847
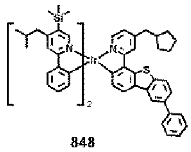
848
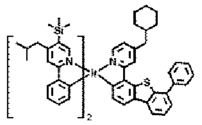
849
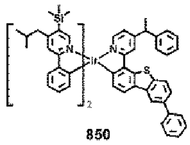
850
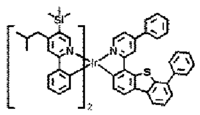
851
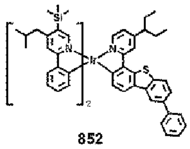
852
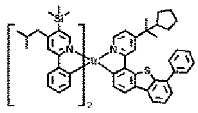
853
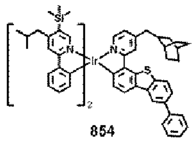
854
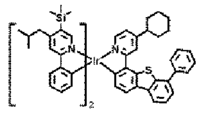
855
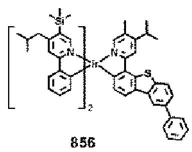
856
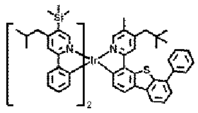
857
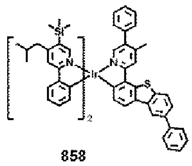
858
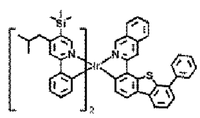
859
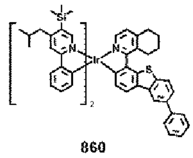
860
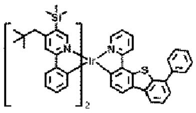
861
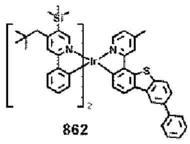
862
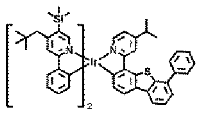
863
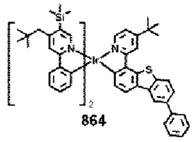
864
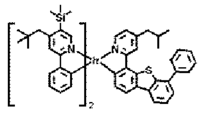
865
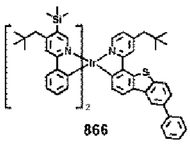
866
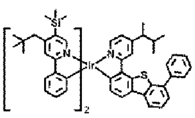
867
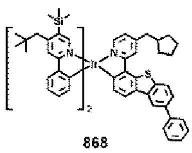
868
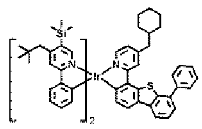
869
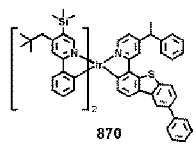
870
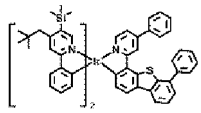
871
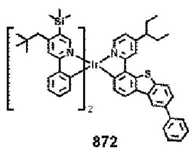
872
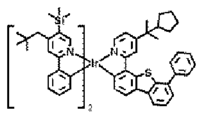
873
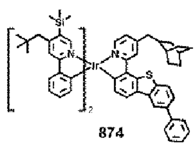
874
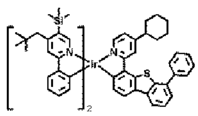
875
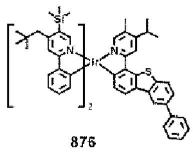
876
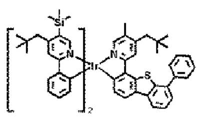
877
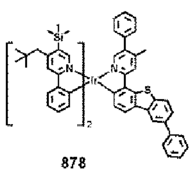
878
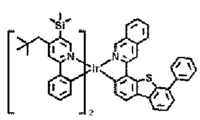
879
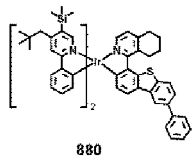
880

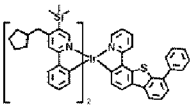
881
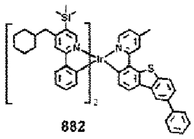
882
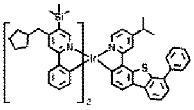
883
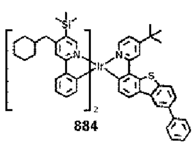
884
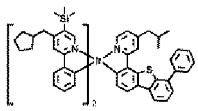
885

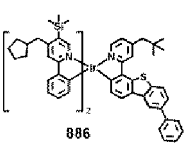
886
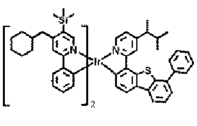
887
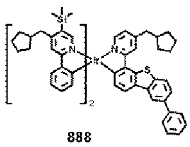
888
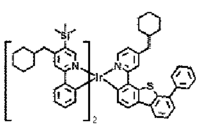
889
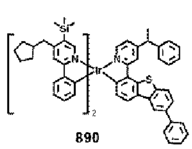
890

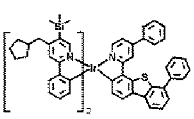
891
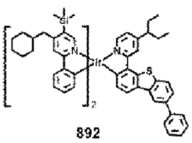
892
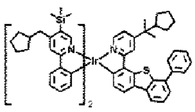
893
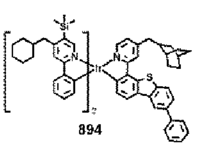
894
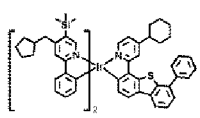
895

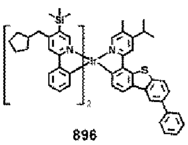
896
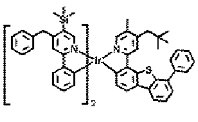
897
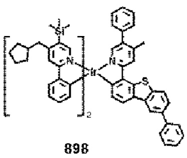
898
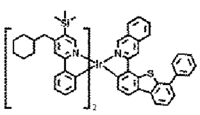
899
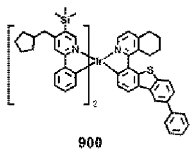
900

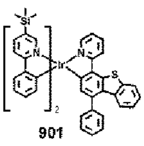
901
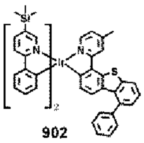
902
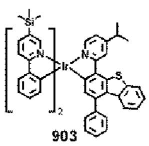
903
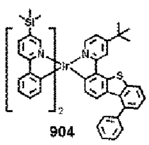
904
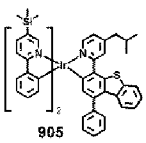
905

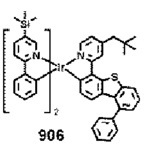
906
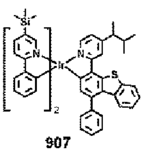
907
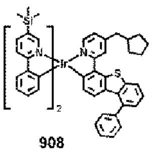
908
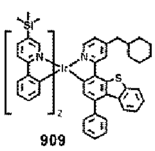
909
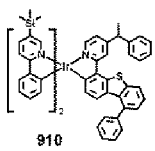
910

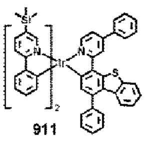
911
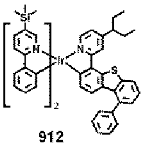
912
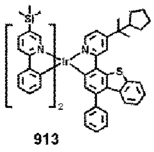
913
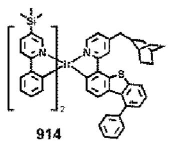
914
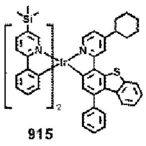
915

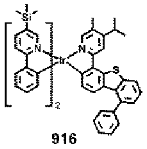
916
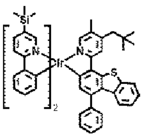
917
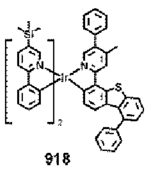
918
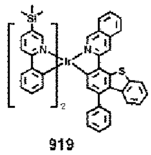
919
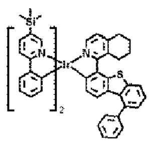
920

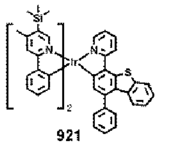
921
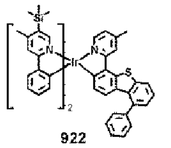
922
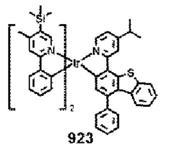
923
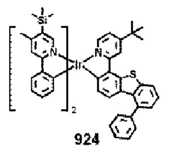
924
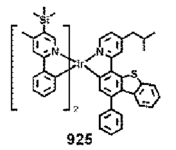
925
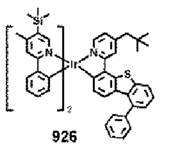
926
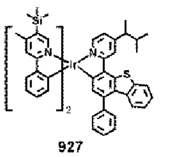
927
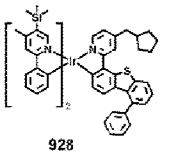
928
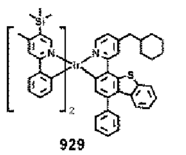
929
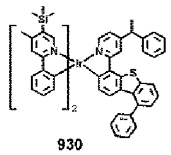
930
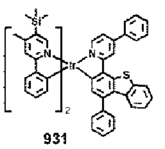
931
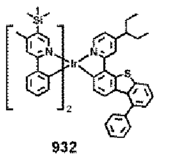
932
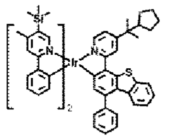
933
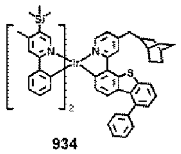
934
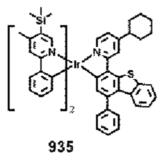
935
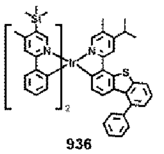
936
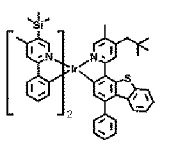
937
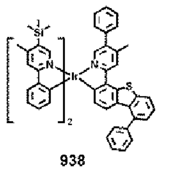
938
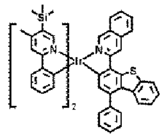
939
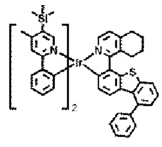
940
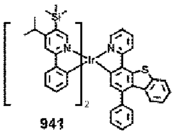
941
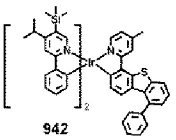
942
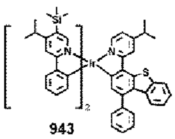
943
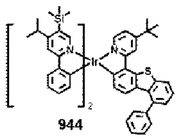
944
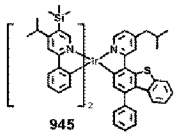
945
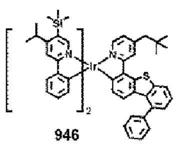
946
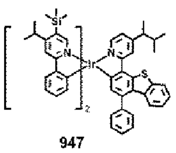
947
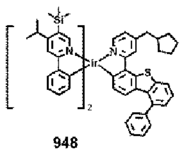
948
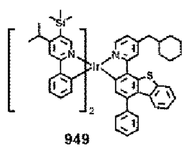
949
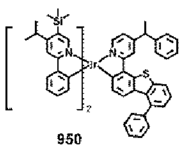
950
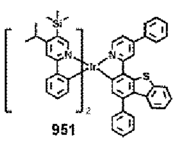
951
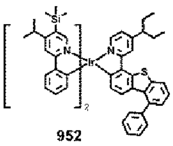
952
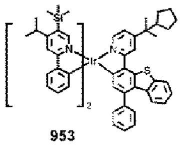
953
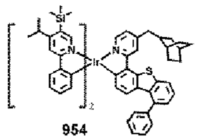
954
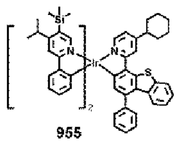
955
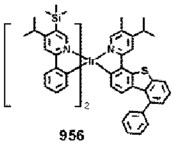
956
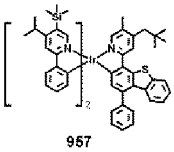
957
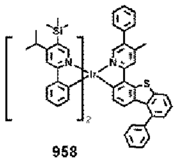
958
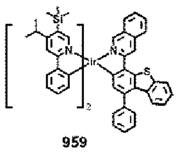
959
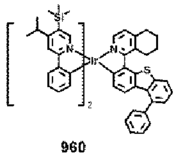
960

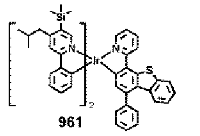
961
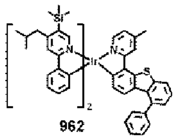
962
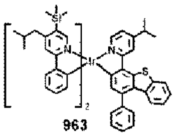
963
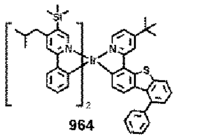
964
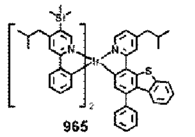
965
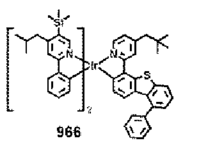
966
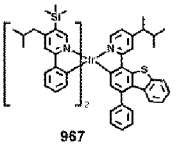
967
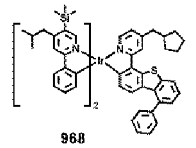
968
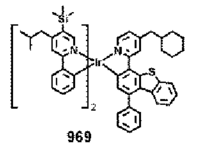
969
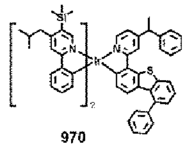
970
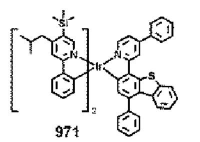
971
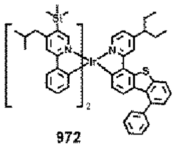
972
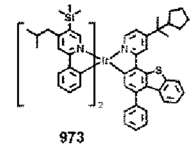
973
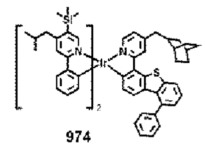
974
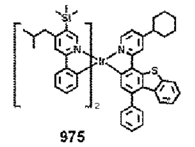
975
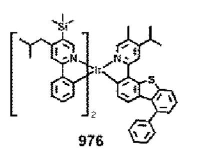
976
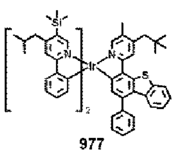
977
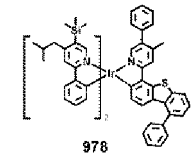
978
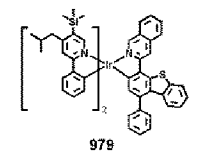
979
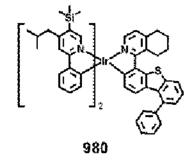
980
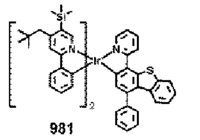
981
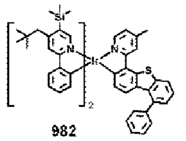
982
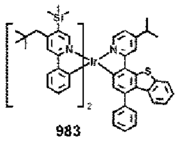
983
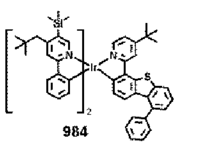
984
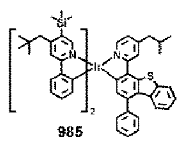
985
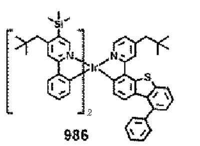
986
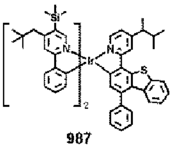
987
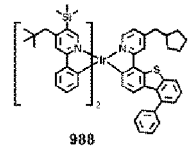
988
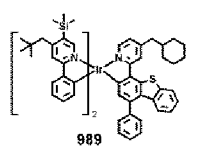
989
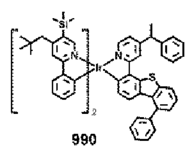
990
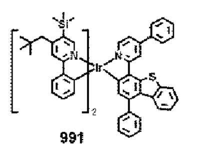
991
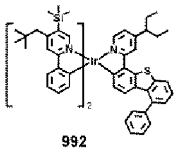
992
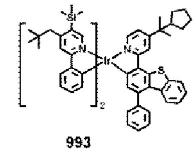
993
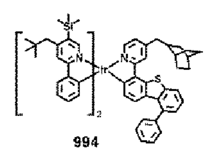
994
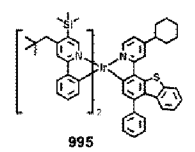
995
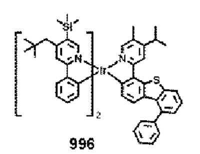
996
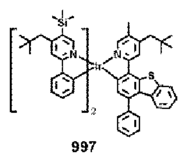
997
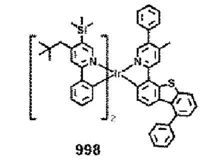
998
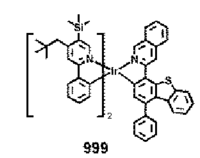
999
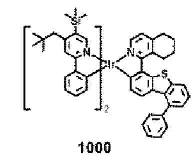
1000

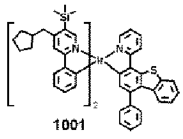
1001

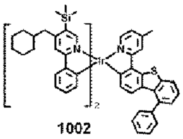
1002

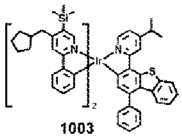
1003

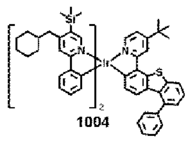
1004

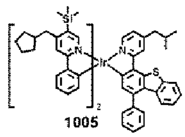
1005

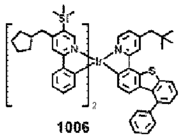
1006

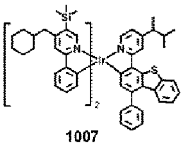
1007

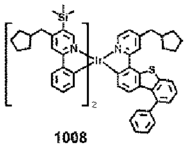
1008

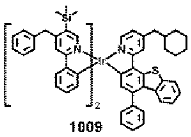
1009

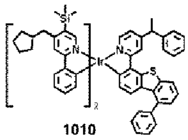
1010

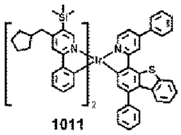
1011

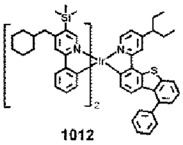
1012

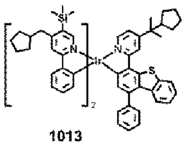
1013

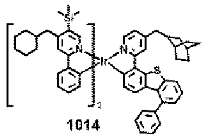
1014

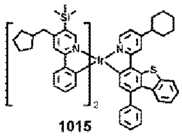
1015

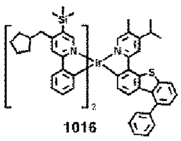
1016

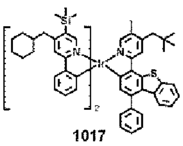
1017

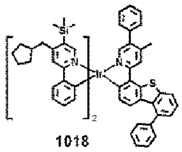
1018

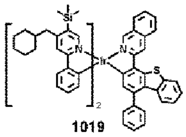
1019

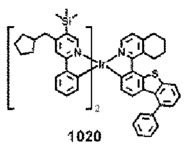
1020

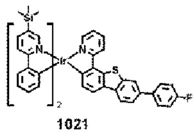
1021

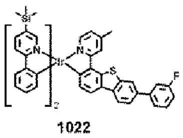
1022

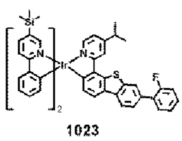
1023

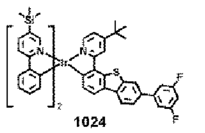
1024

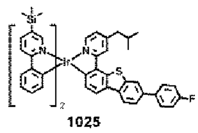
1025

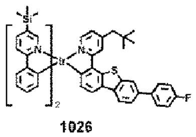
1026

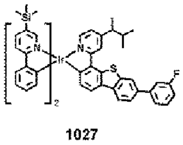
1027

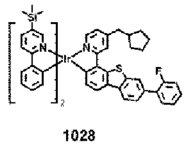
1028

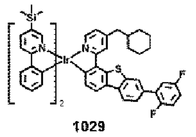
1029

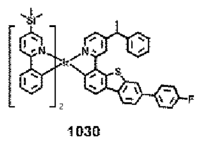
1030

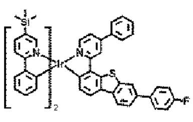
1031

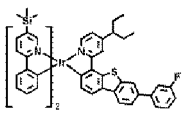
1032

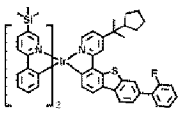
1033

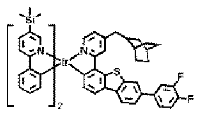
1034

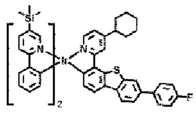
1035

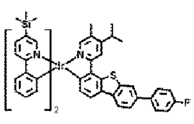
1036

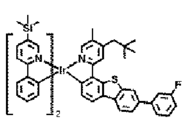
1037

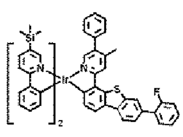
1038

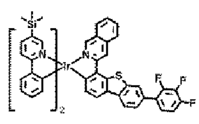
1039

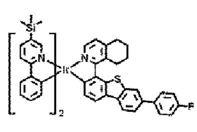
1040

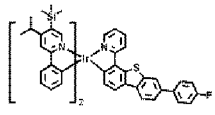
1041
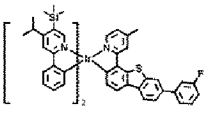
1042
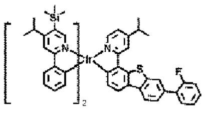
1043
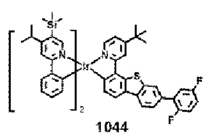
1044
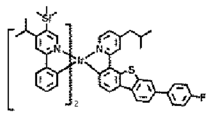
1045

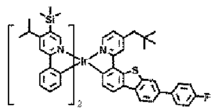
1046
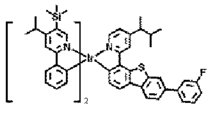
1047
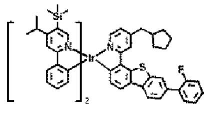
1048
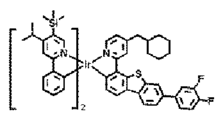
1049
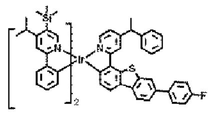
1050

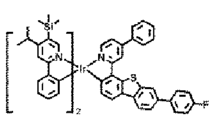
1051
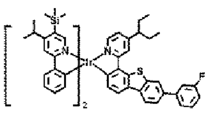
1052
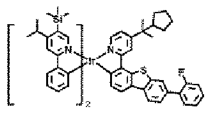
1053
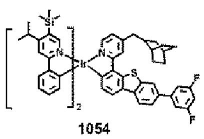
1054
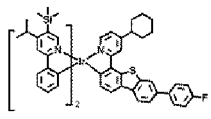
1055

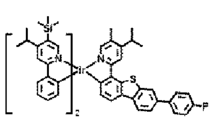
1056
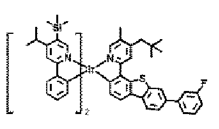
1057
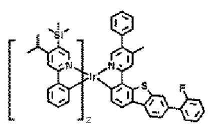
1058
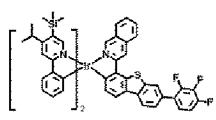
1059
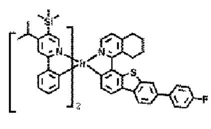
1060

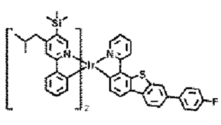
1061
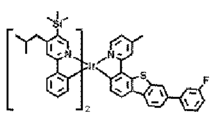
1062
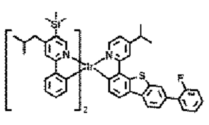
1063
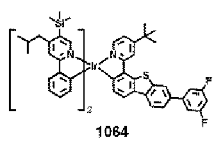
1064
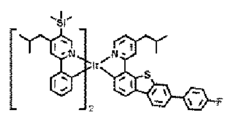
1065

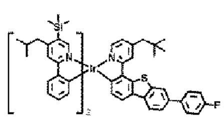
1066
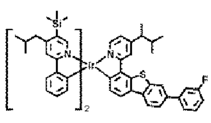
1067
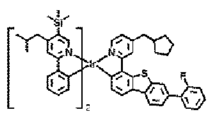
1068
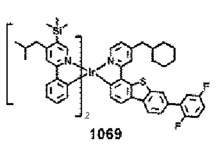
1069
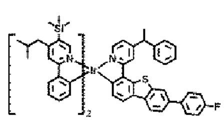
1070

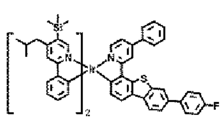
1071
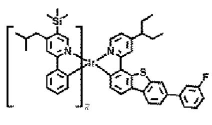
1072
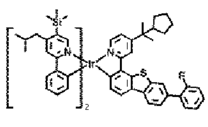
1073
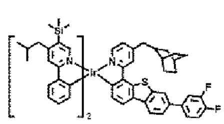
1074
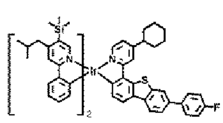
1075

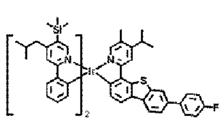
1076
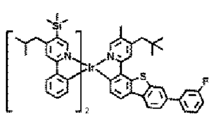
1077
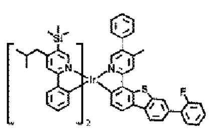
1078
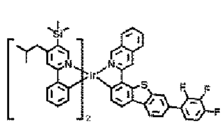
1079
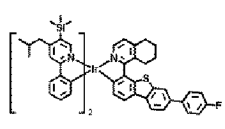
1080

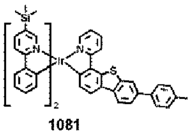
1081
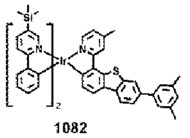
1082
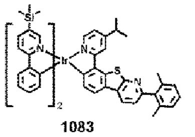
1083
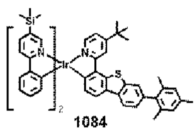
1084
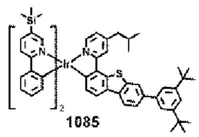
1085

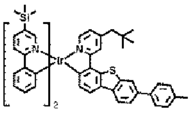
1086
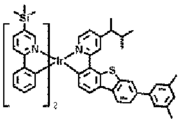
1087
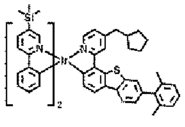
1088
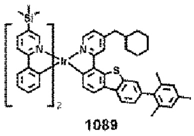
1089
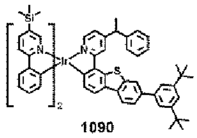
1090

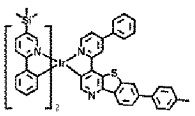
1091
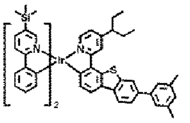
1092
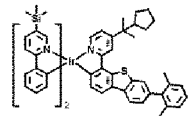
1093
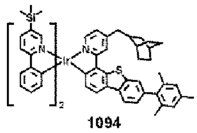
1094
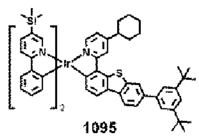
1095

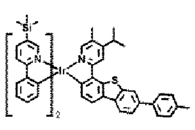
1096
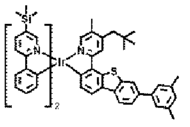
1097
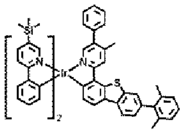
1098
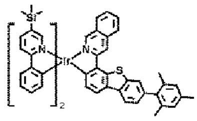
1099
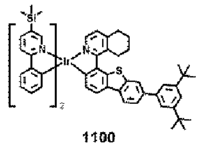
1100

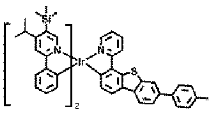
1101
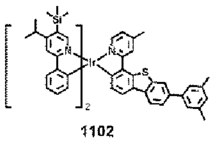
1102
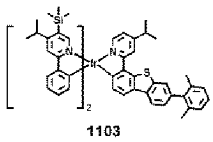
1103
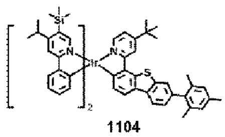
1104
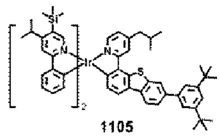
1105

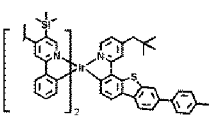
1106
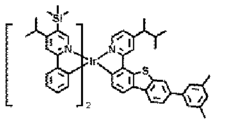
1107
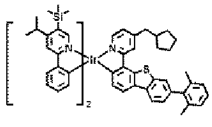
1108
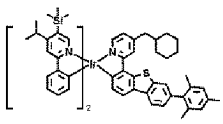
1109
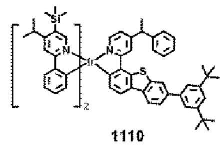
1110

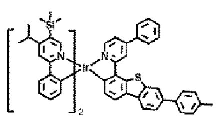
1111
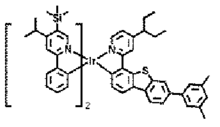
1112
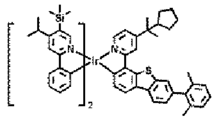
1113
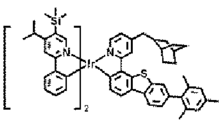
1114
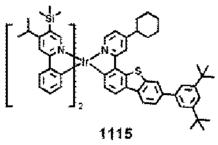
1115

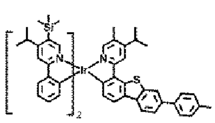
1116
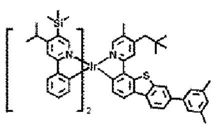
1117
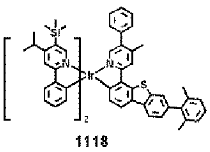
1118
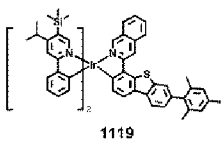
1119
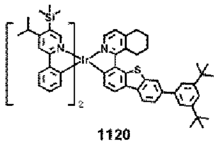
1120

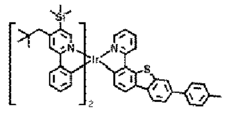
1121
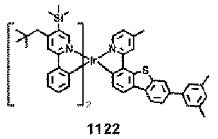
1122
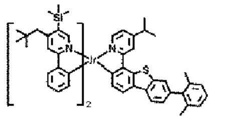
1123
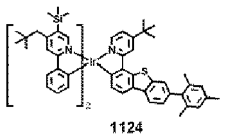
1124
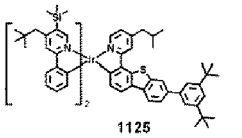
1125

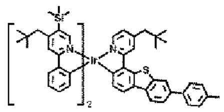
1126
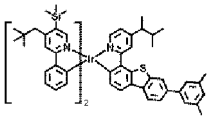
1127
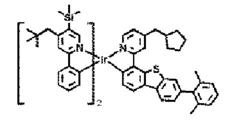
1128
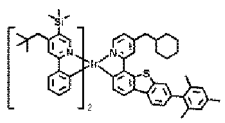
1129
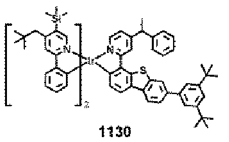
1130

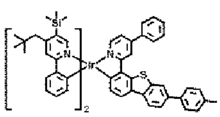
1131
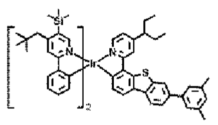
1132
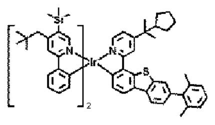
1133
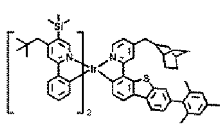
1134
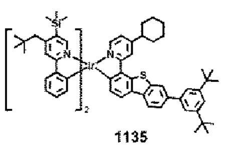
1135

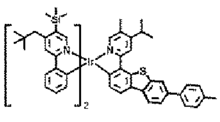
1136
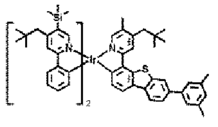
1137
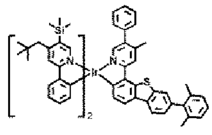
1138
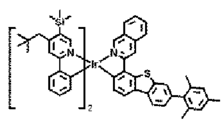
1139
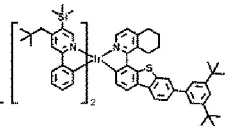
1140

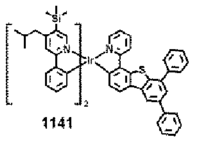
1141
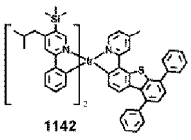
1142
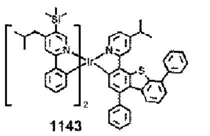
1143
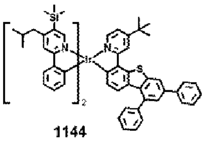
1144
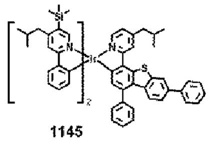
1145

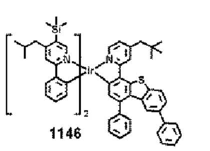
1146
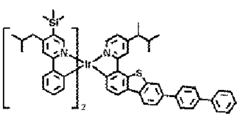
1147
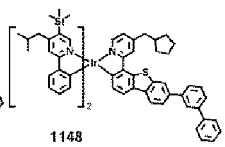
1148
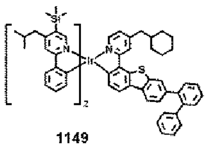
1149
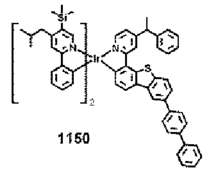
1150

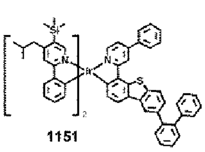
1151
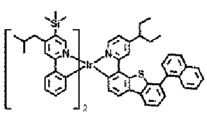
1152
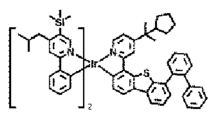
1153
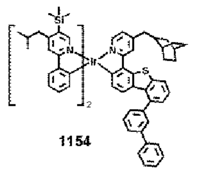
1154
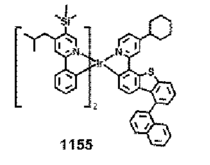
1155

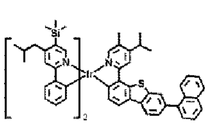
1156
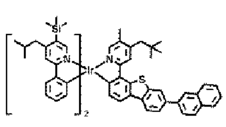
1157
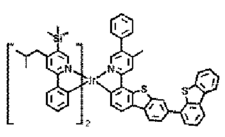
1158
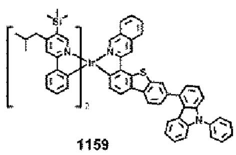
1159
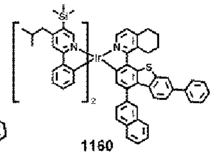
1160

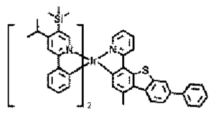
1161

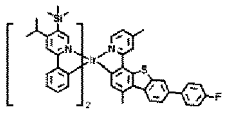
1162

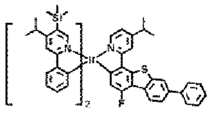
1163

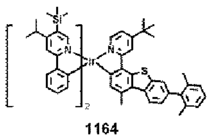
1164

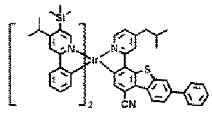
1165

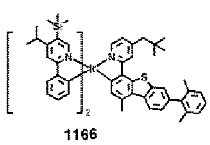
1166

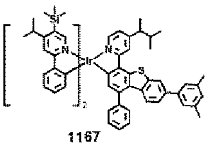
1167

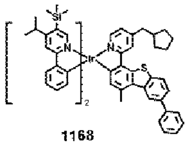
1168

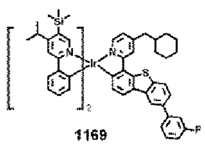
1169

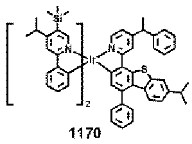
1170

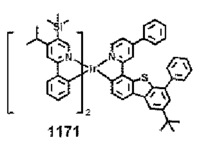
1171

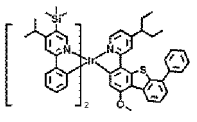
1172

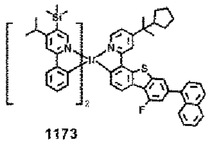
1173

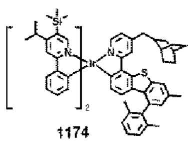
1174

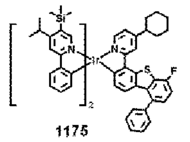
1175

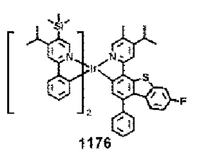
1176

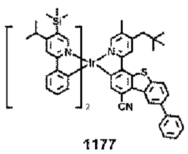
1177

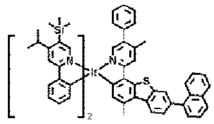
1178

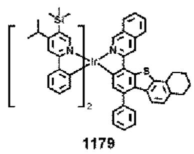
1179

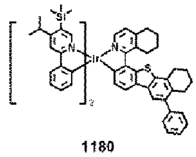
1180

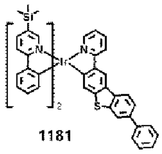
1181

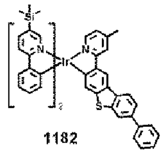
1182

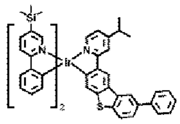
1183

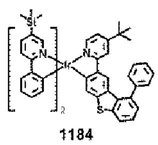
1184

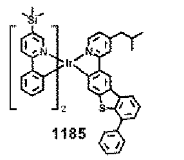
1185

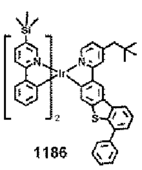
1186

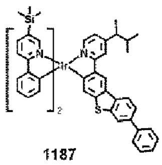
1187

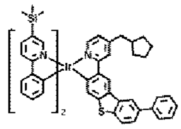
1188

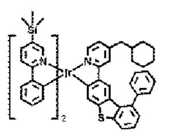
1189

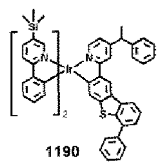
1190

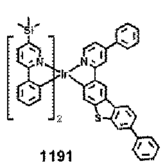
1191

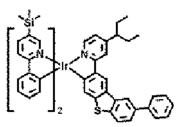
1192

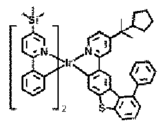
1193

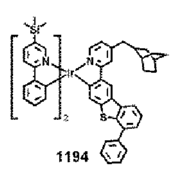
1194

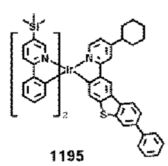
1195

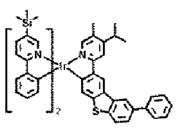
1196

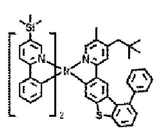
1197

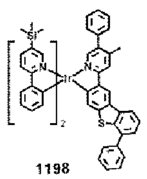
1198

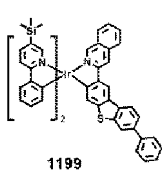
1199

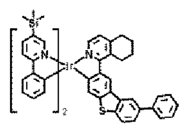
1200

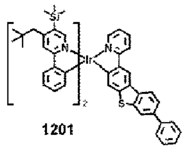
1201
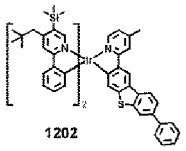
1202
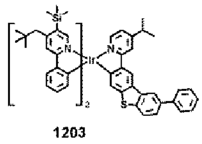
1203
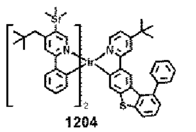
1204
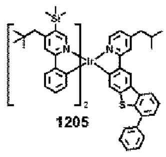
1205
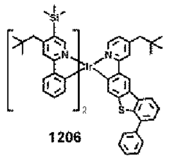
1206
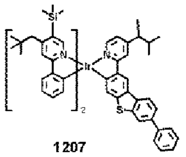
1207
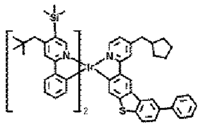
1208
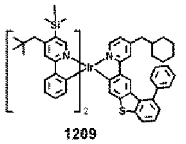
1209
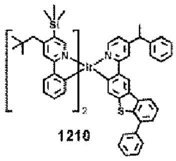
1210
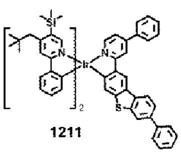
1211
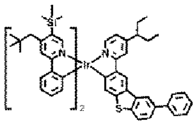
1212
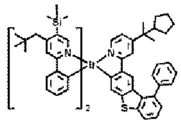
1213
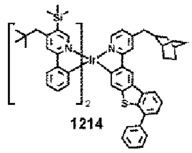
1214
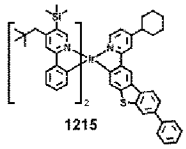
1215
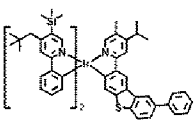
1216
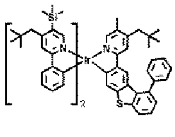
1217
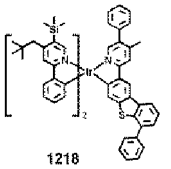
1218
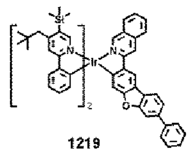
1219
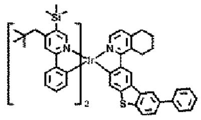
1220
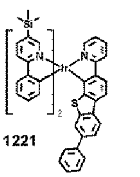
1221
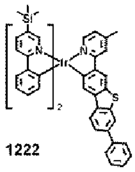
1222
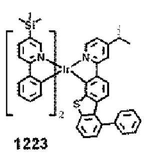
1223
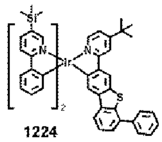
1224
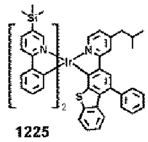
1225
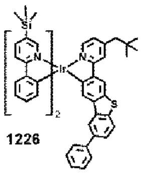
1226
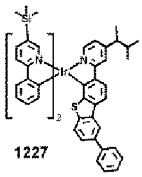
1227
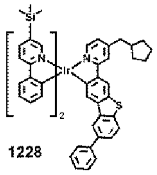
1228
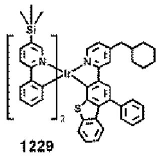
1229
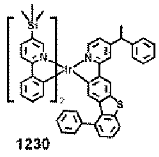
1230
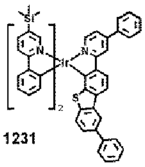
1231
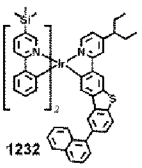
1232
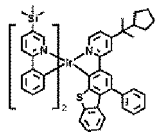
1233
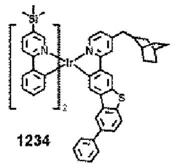
1234
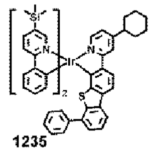
1235
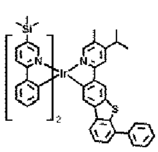
1236
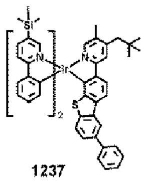
1237
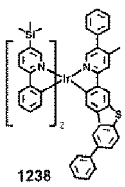
1238
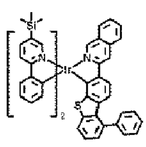
1239
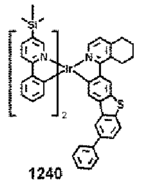
1240

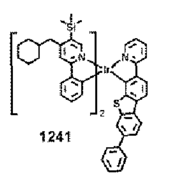
1241

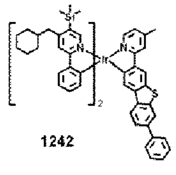
1242

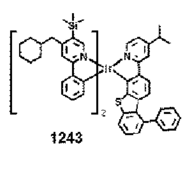
1243

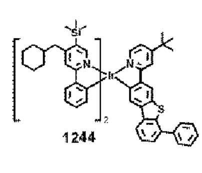
1244

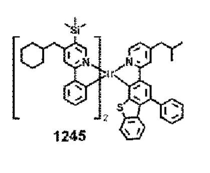
1245

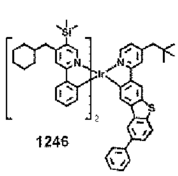
1246

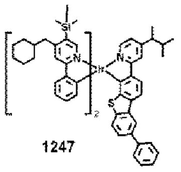
1247

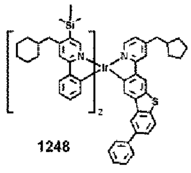
1248

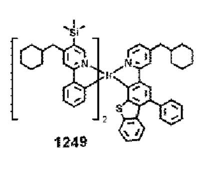
1249

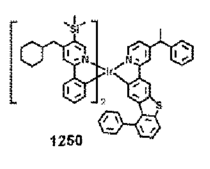
1250

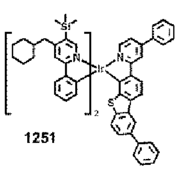
1251

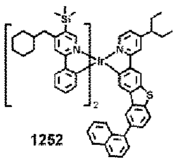
1252

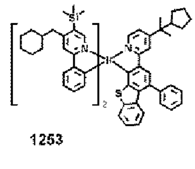
1253

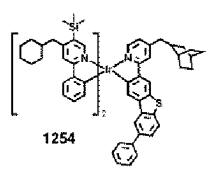
1254

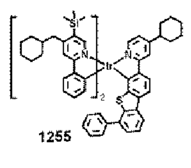
1255

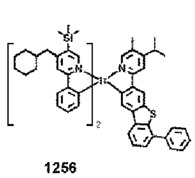
1256

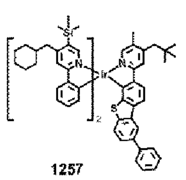
1257

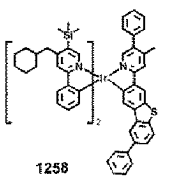
1258

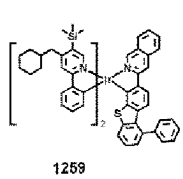
1259

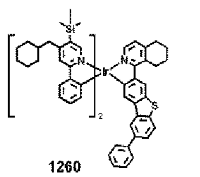
1260

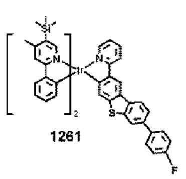
1261

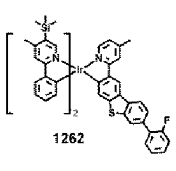
1262

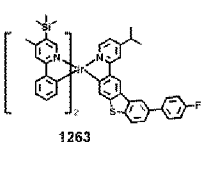
1263

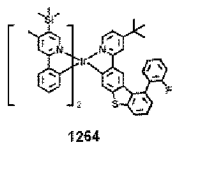
1264

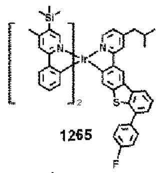
1265

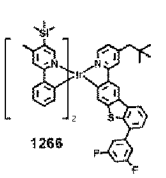
1266

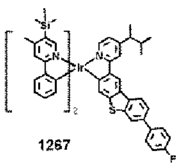
1267

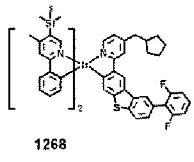
1268

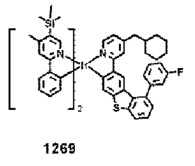
1269

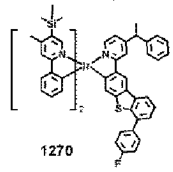
1270

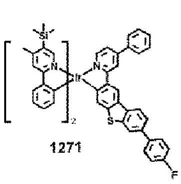
1271

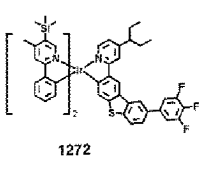
1272

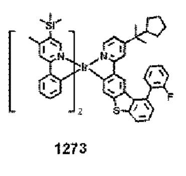
1273

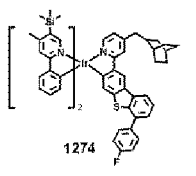
1274

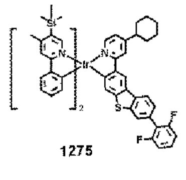
1275

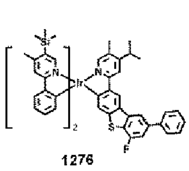
1276

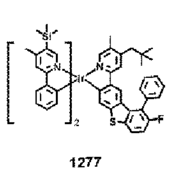
1277

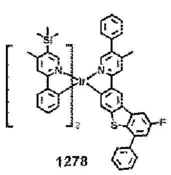
1278

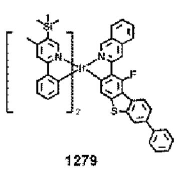
1279

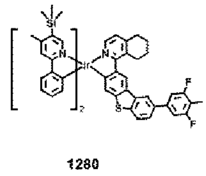
1280

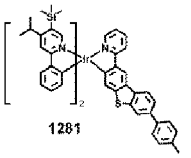
1281

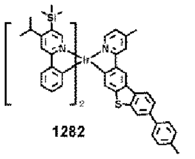
1282

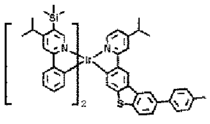
1283

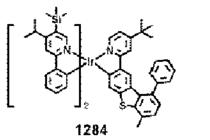
1284

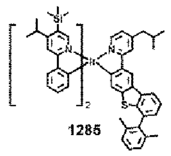
1285

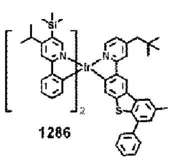
1286

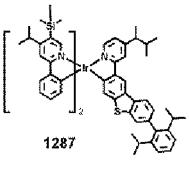
1287

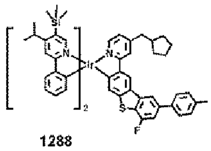
1288

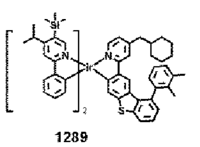
1289

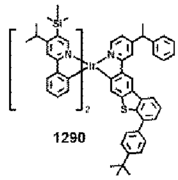
1290

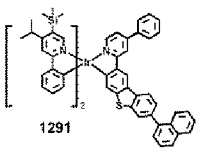
1291

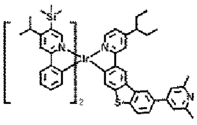
1292

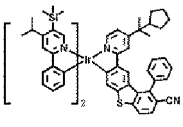
1293

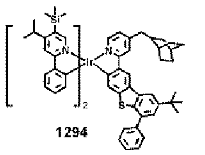
1294

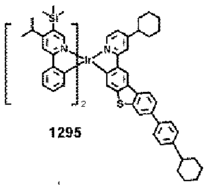
1295

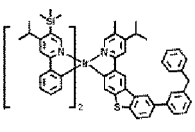
1296

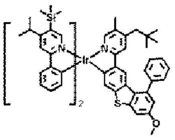
1297

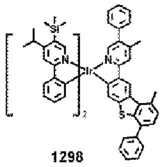
1298

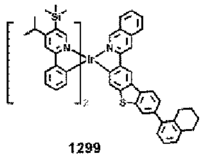
1299

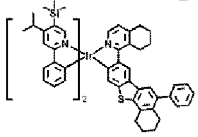
1300

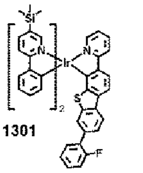
1301

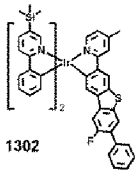
1302

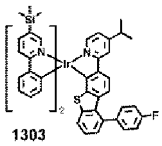
1303

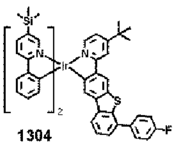
1304

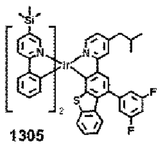
1305

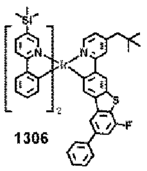
1306

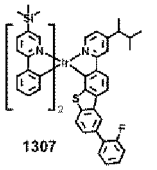
1307

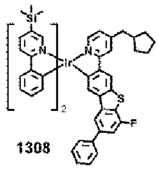
1308

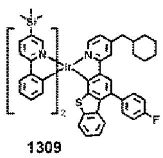
1309

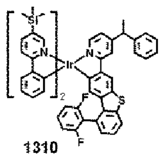
1310

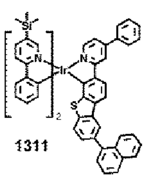
1311

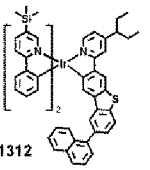
1312

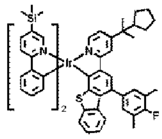
1313

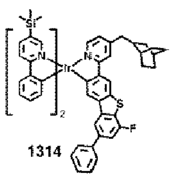
1314

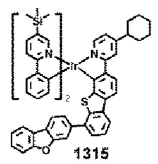
1315

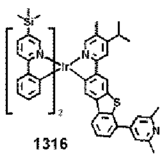
1316

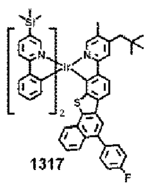
1317

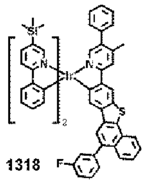
1318

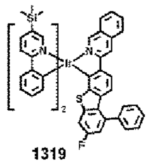
1319

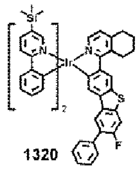
1320

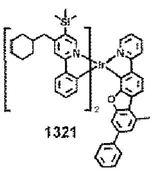
1321

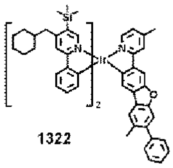
1322

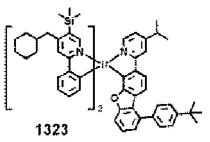
1323

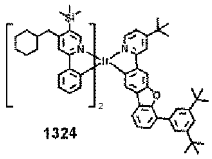
1324

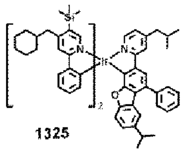
1325

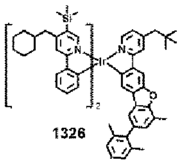
1326

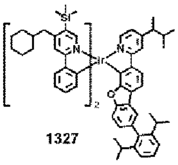
1327

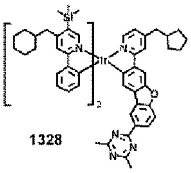
1328

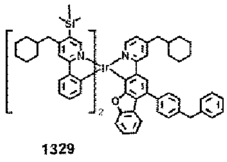
1329

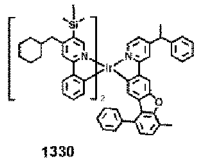
1330

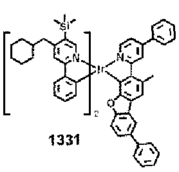
1331

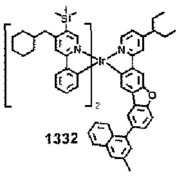
1332

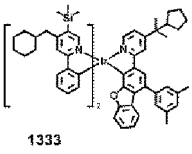
1333

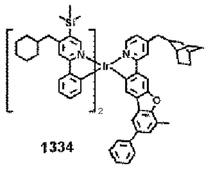
1334

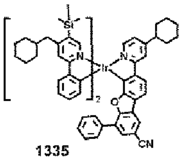
1335

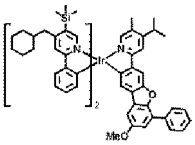
1336

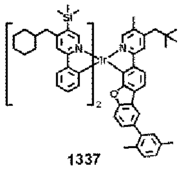
1337

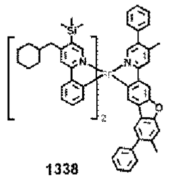
1338

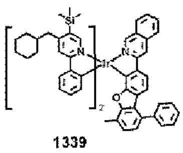
1339

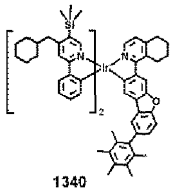
1340

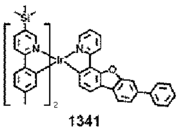
1341

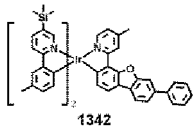
1342

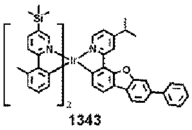
1343

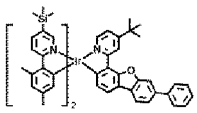
1344

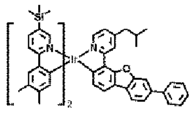
1345

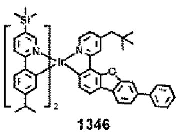
1346

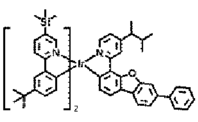
1347

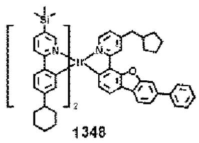
1348

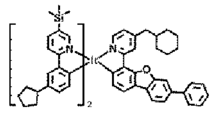
1349

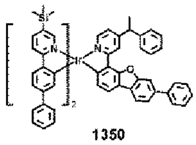
1350

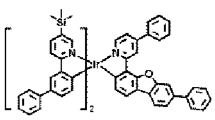
1351

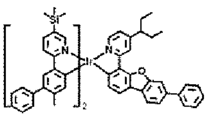
1352

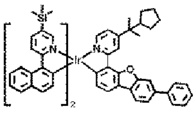
1353

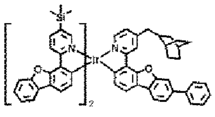
1354

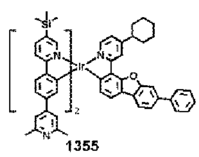
1355

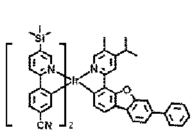
1356

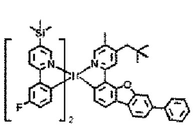
1357

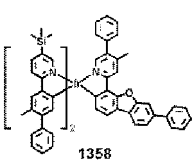
1358

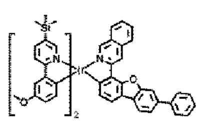
1359

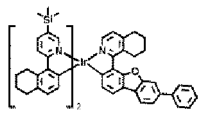
1360

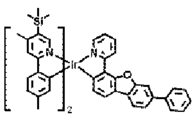
1361

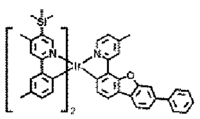
1362

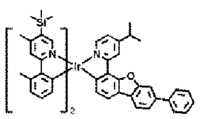
1363

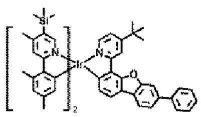
1364

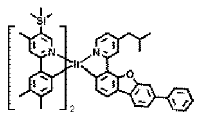
1365

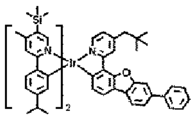
1366

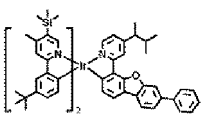
1367

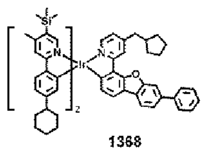
1368

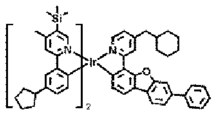
1369

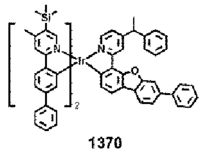
1370

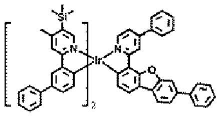
1371

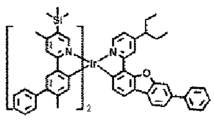
1372

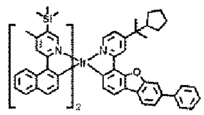
1373

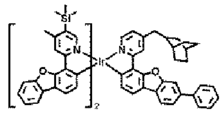
1374

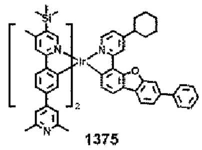
1375

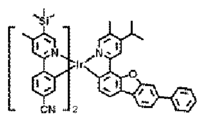
1376

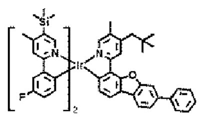
1377

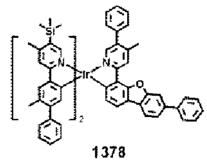
1378

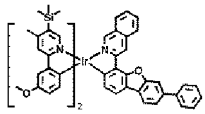
1379

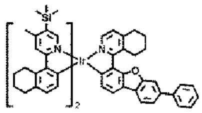
1380

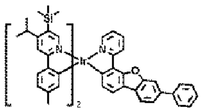
1381

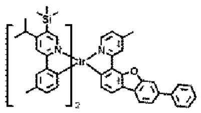
1382

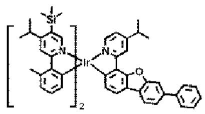
1383

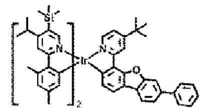
1384

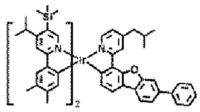
1385

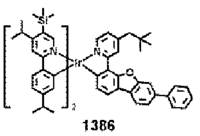
1386

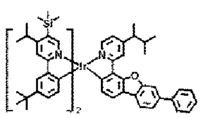
1387

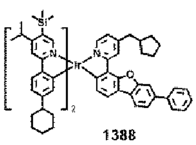
1388

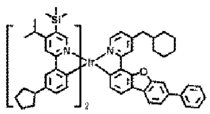
1389

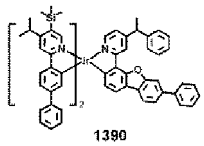
1390

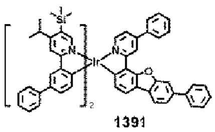
1391

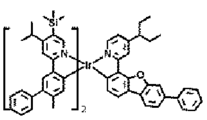
1392

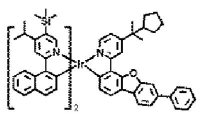
1393

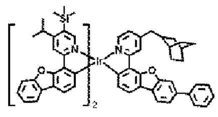
1394

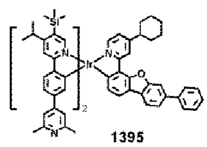
1395

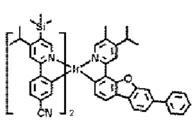
1396

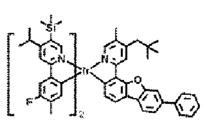
1397

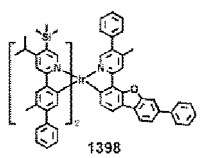
1398

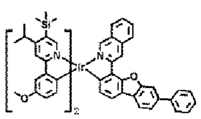
1399

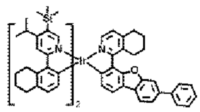
1400

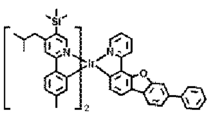
1401
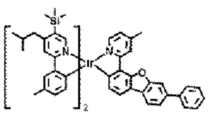
1402
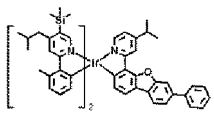
1403
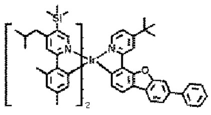
1404
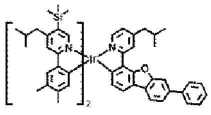
1405
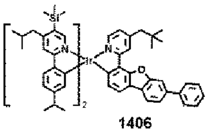
1406
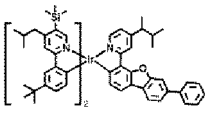
1407
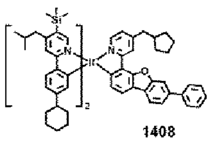
1408
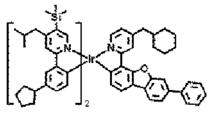
1409
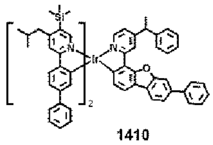
1410
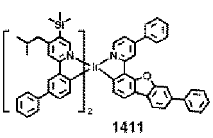
1411
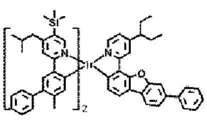
1412
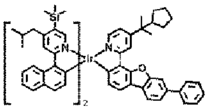
1413
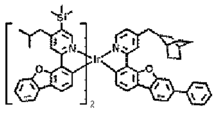
1414
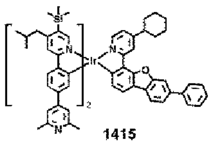
1415
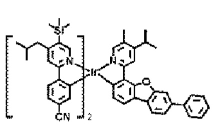
1416
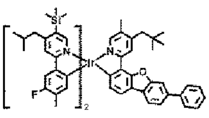
1417
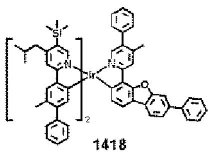
1418
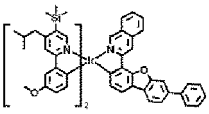
1419
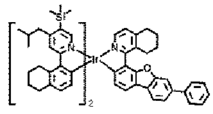
1420
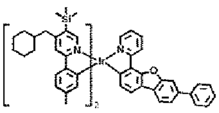
1421
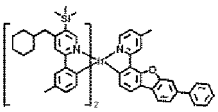
1422
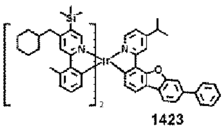
1423
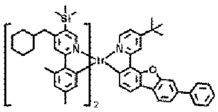
1424
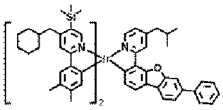
1425
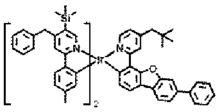
1426
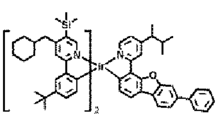
1427
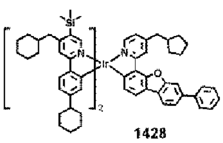
1428
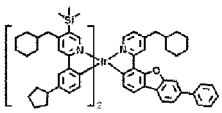
1429
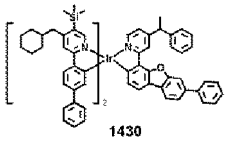
1430
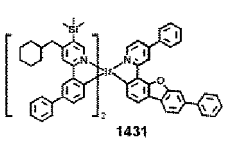
1431
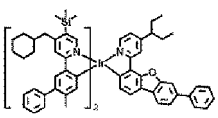
1432
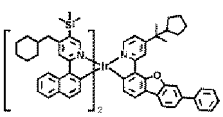
1433
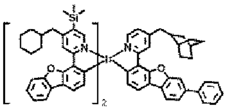
1434
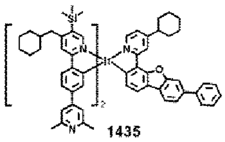
1435
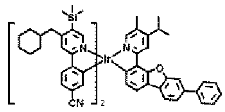
1436
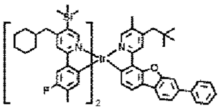
1437
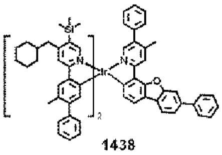
1438
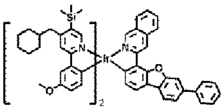
1439
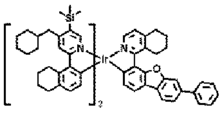
1440

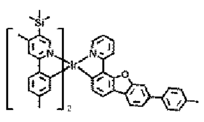
1441

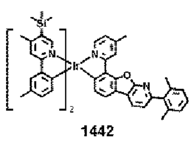
1442

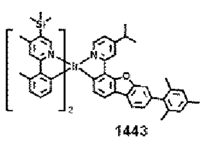
1443

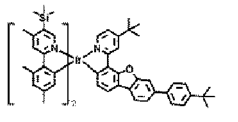
1444

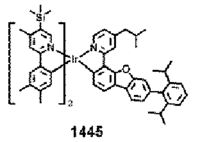
1445

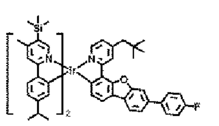
1446

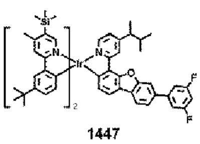
1447

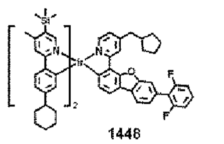
1448

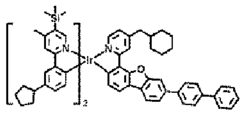
1449

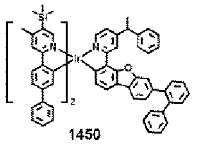
1450

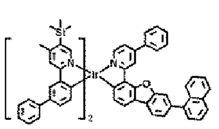
1451

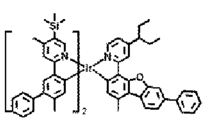
1452

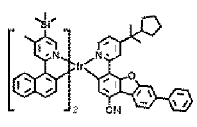
1453

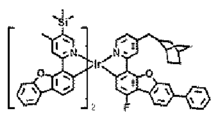
1454

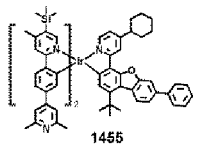
1455

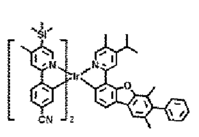
1456

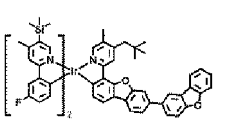
1457

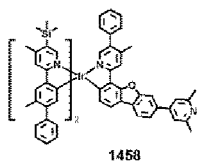
1458

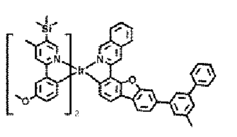
1459

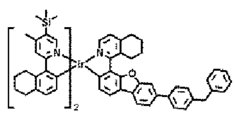
1460

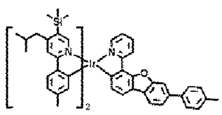
1461

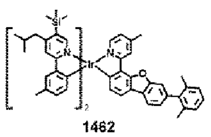
1462

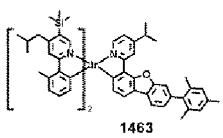
1463

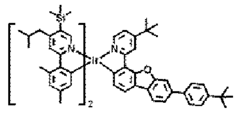
1464

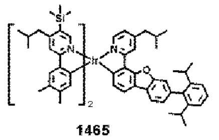
1465

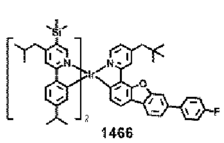
1466

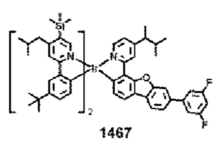
1467

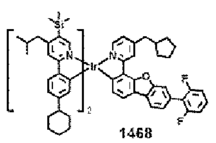
1468

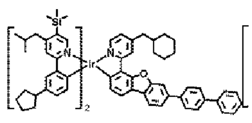
1469

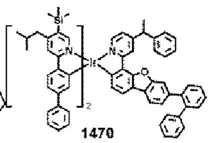
1470

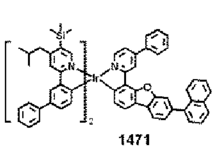
1471

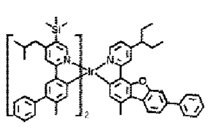
1472

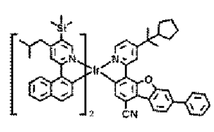
1473

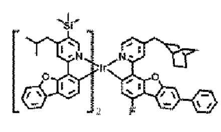
1474

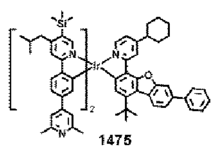
1475

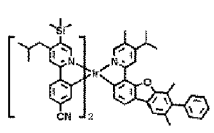
1476

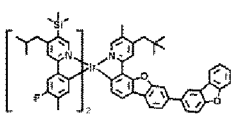
1477

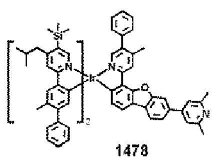
1478

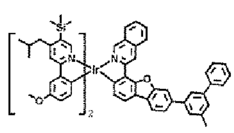
1479

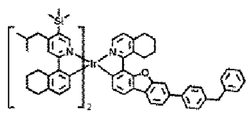
1480

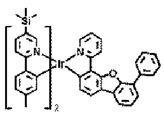
1481
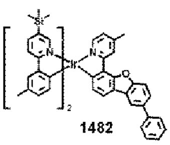
1482
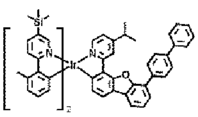
1483
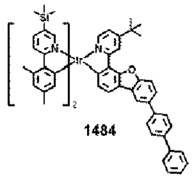
1484
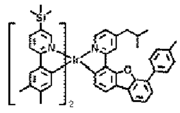
1485

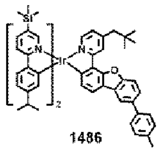
1486
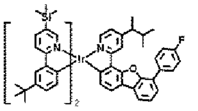
1487
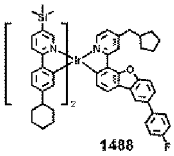
1488
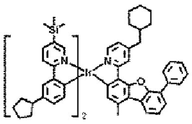
1489
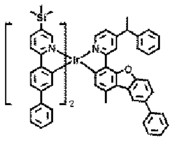
1490

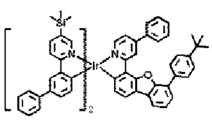
1491
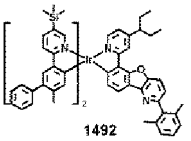
1492
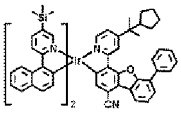
1493
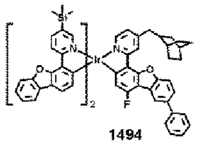
1494
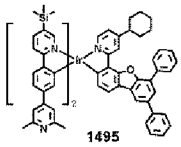
1495

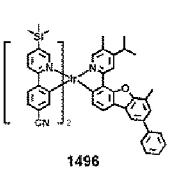
1496
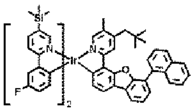
1497
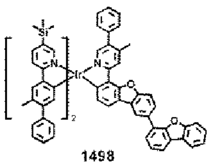
1498
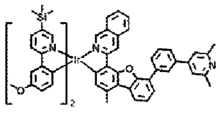
1499
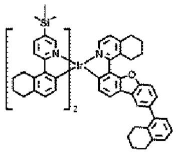
1500

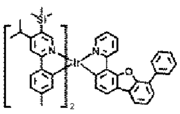
1501
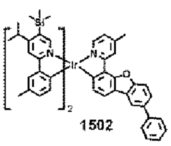
1502
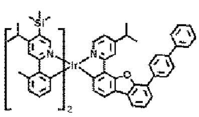
1503
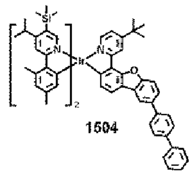
1504
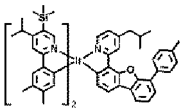
1505

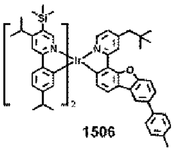
1506
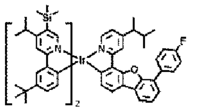
1507
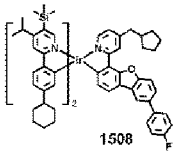
1508
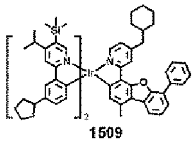
1509
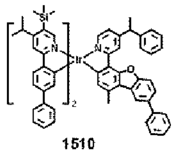
1510

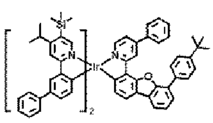
1511
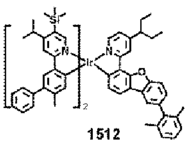
1512
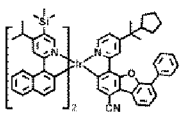
1513
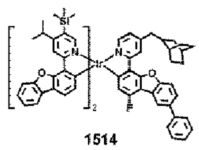
1514
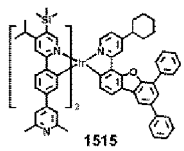
1515

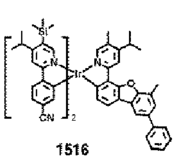
1516
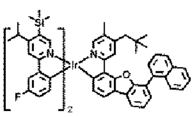
1517
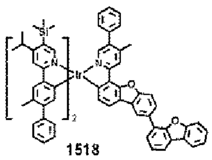
1518
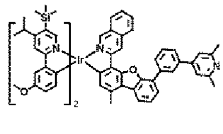
1519
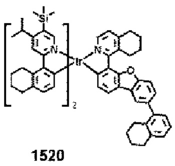
1520

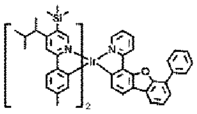
1521

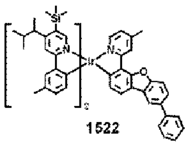
1522

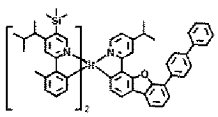
1523

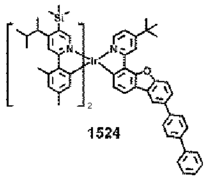
1524

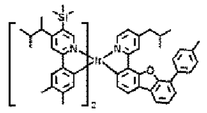
1525

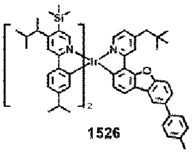
1526

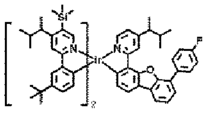
1527

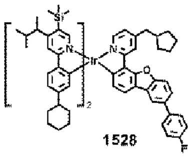
1528

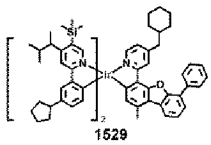
1529

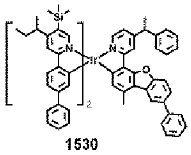
1530

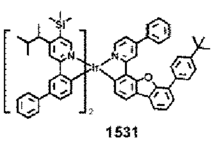
1531

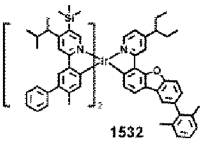
1532

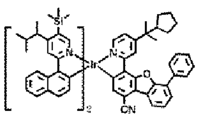
1533

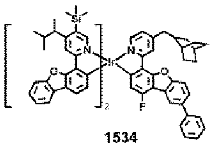
1534

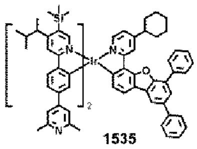
1535

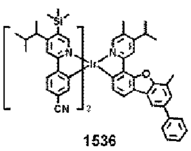
1536

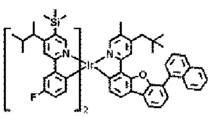
1537

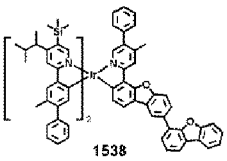
1538

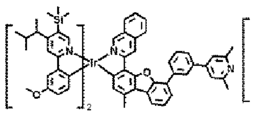
1539

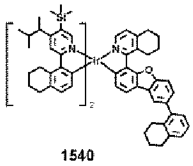
1540

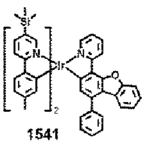
1541

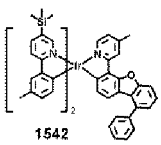
1542

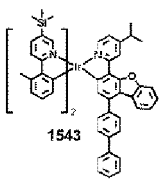
1543

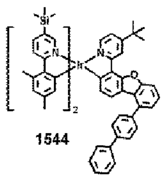
1544

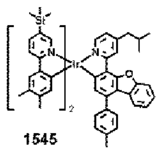
1545

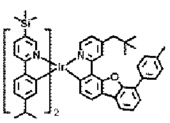
1546

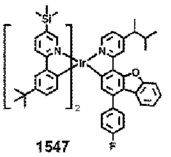
1547

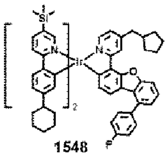
1548

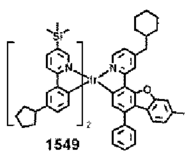
1549

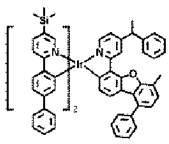
1550

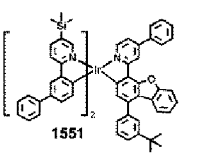
1551

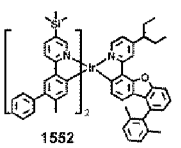
1552

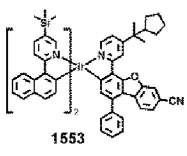
1553

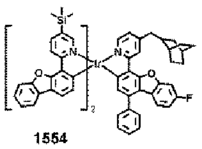
1554

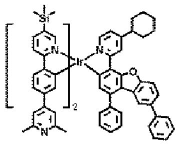
1555

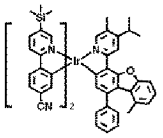
1556

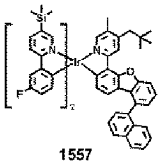
1557

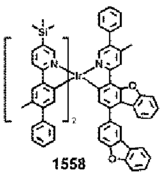
1558

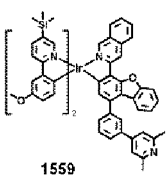
1559

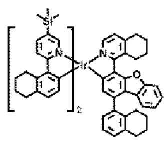
1560

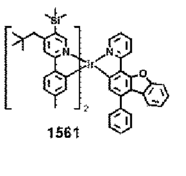
1561
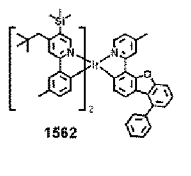
1562
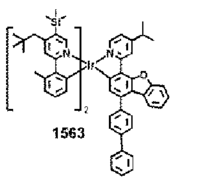
1563
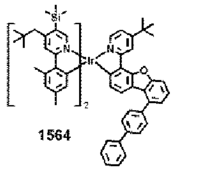
1564
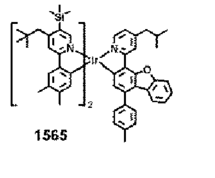
1565
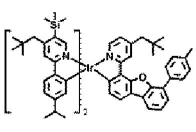
1566
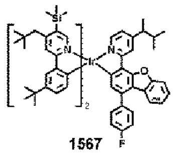
1567
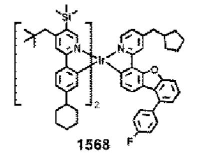
1568
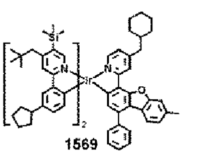
1569
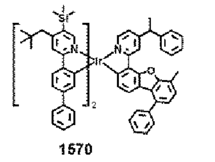
1570
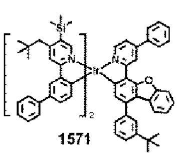
1571
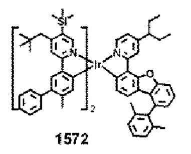
1572
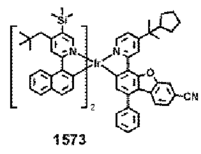
1573
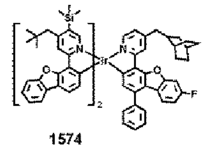
1574
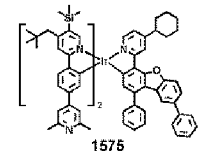
1575
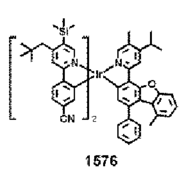
1576
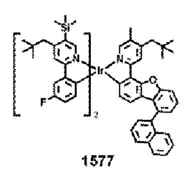
1577
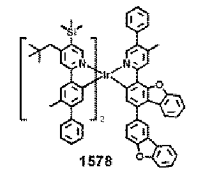
1578
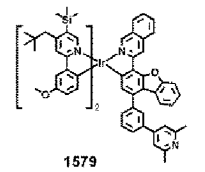
1579
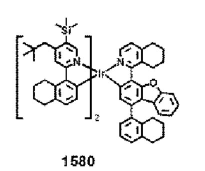
1580
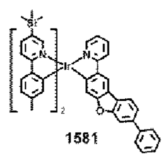
1581
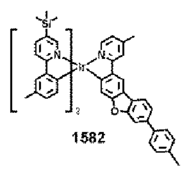
1582
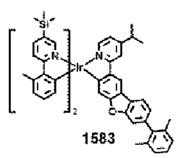
1583
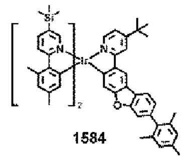
1584
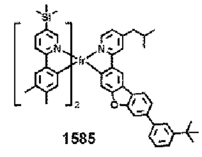
1585
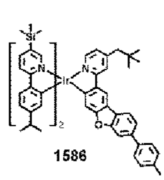
1586
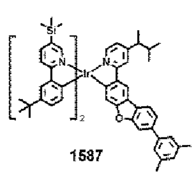
1587
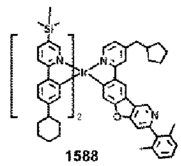
1588
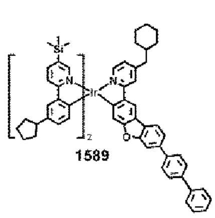
1589
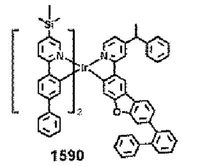
1590
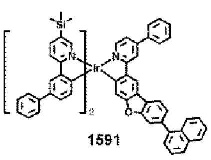
1591
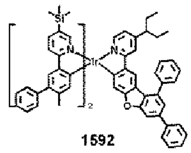
1592
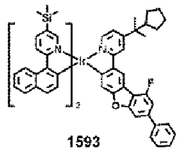
1593
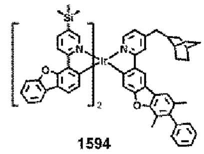
1594
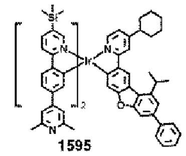
1595
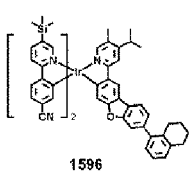
1596
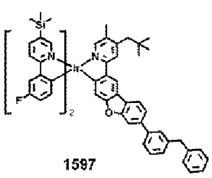
1597
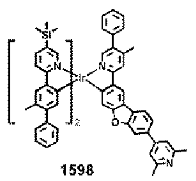
1598
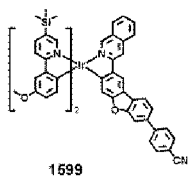
1599
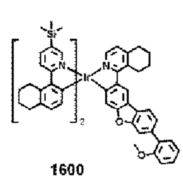
1600

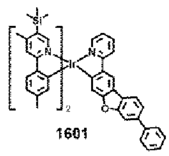
1601
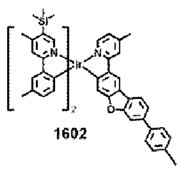
1602
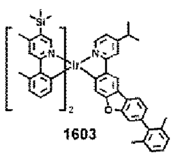
1603
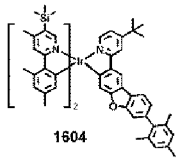
1604
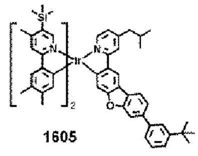
1605
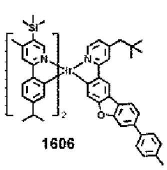
1606
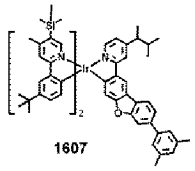
1607
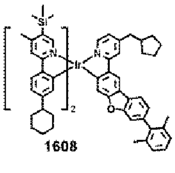
1608
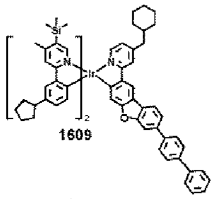
1609
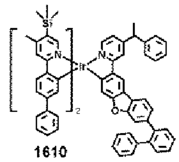
1610
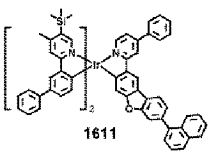
1611
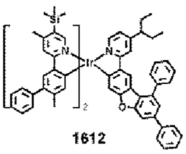
1612
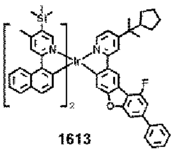
1613
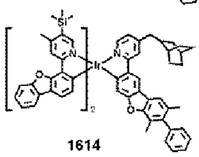
1614
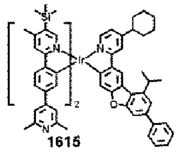
1615
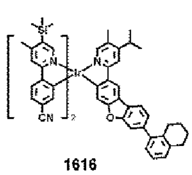
1616
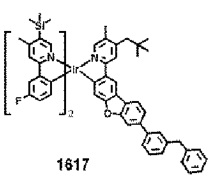
1617
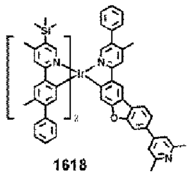
1618
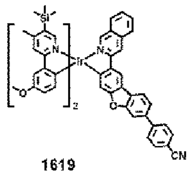
1619
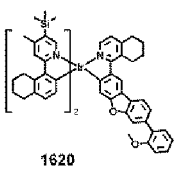
1620
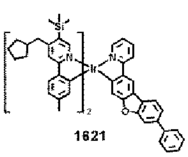
1621
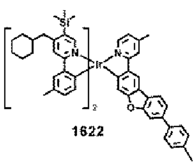
1622
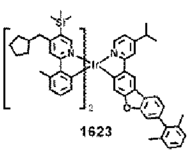
1623
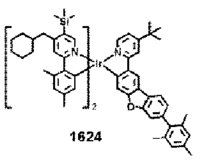
1624
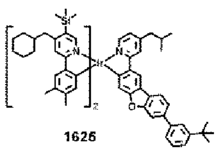
1625
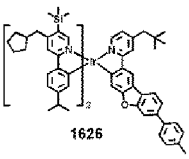
1626
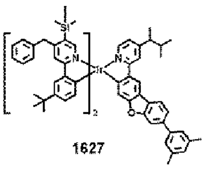
1627
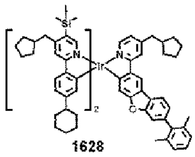
1628
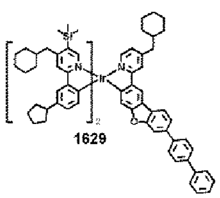
1629
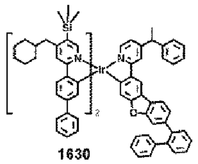
1630
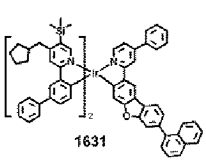
1631
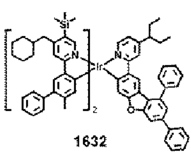
1632
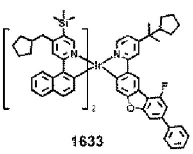
1633
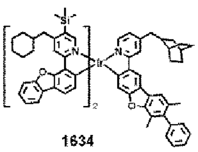
1634
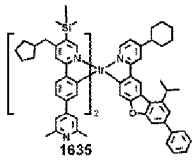
1635
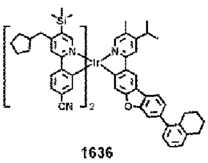
1636
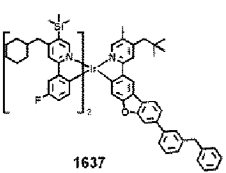
1637
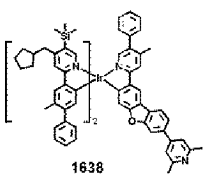
1638
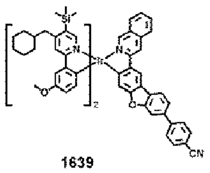
1639
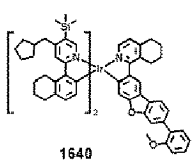
1640

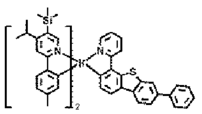
1641
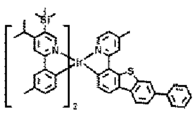
1642
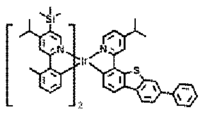
1643
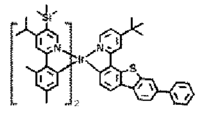
1644
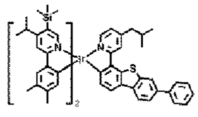
1645

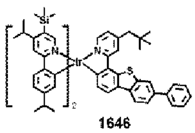
1646
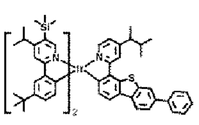
1647
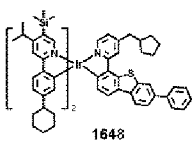
1648
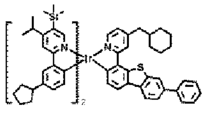
1649
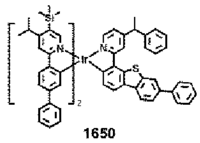
1650

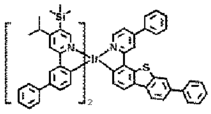
1651
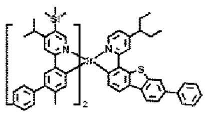
1652
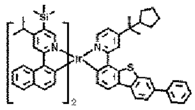
1653
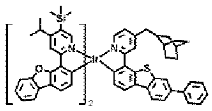
1654
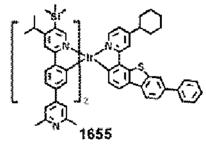
1655

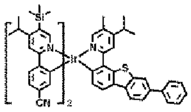
1656
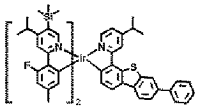
1657
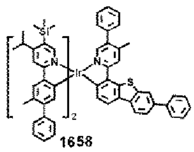
1658
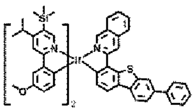
1659
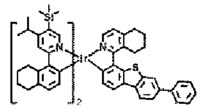
1660

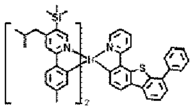
1661
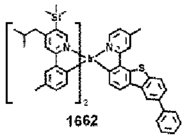
1662
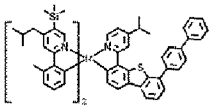
1663
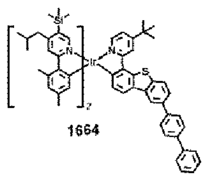
1664
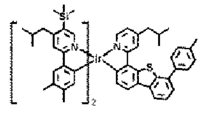
1665

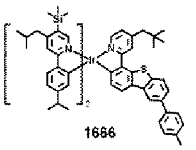
1666
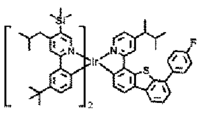
1667
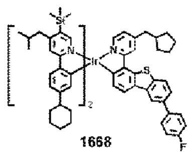
1668
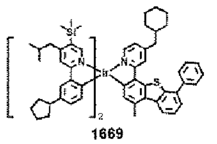
1669
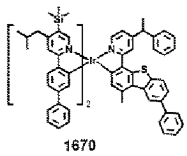
1670

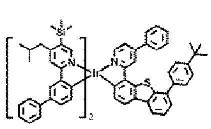
1671
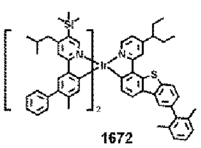
1672
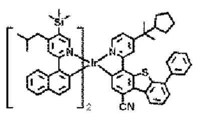
1673
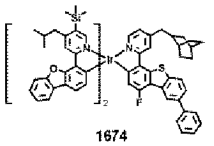
1674
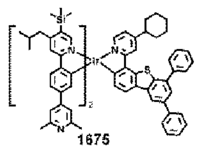
1675

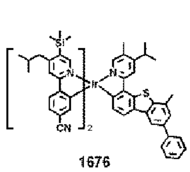
1676
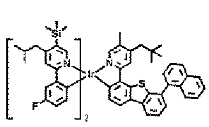
1677
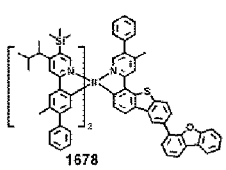
1678
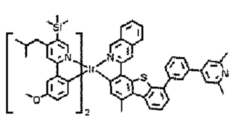
1679
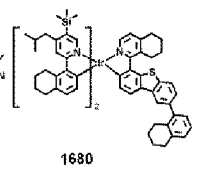
1680

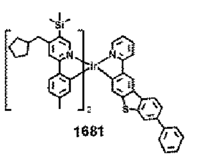
1681

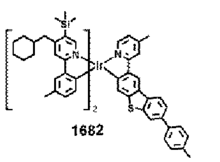
1682

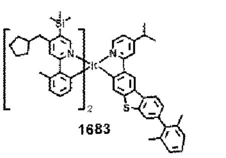
1683

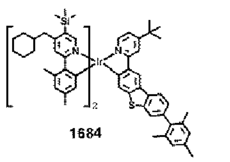
1684

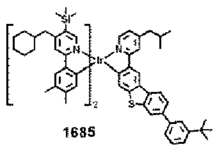
1685

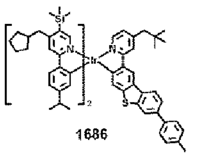
1686

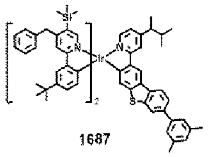
1687

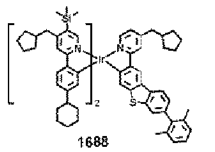
1688

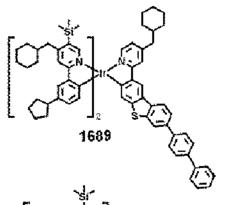
1689

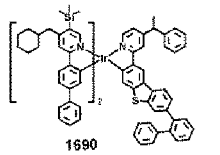
1690

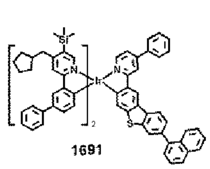
1691

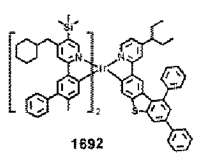
1692

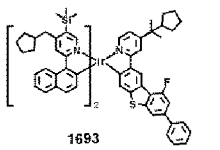
1693

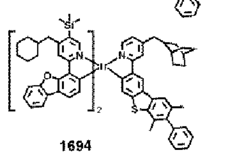
1694

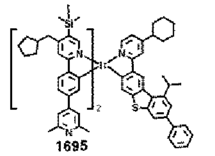
1695

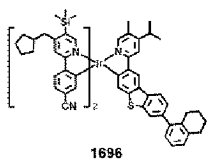
1696

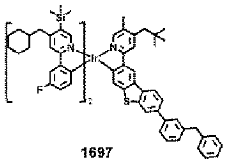
1697

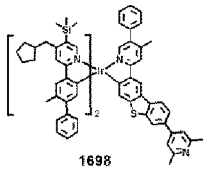
1698

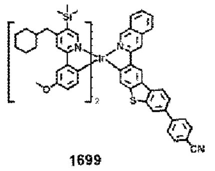
1699

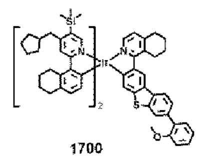
1700

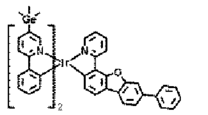
1701

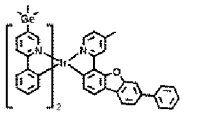
1702

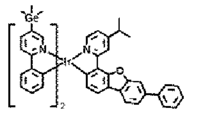
1703

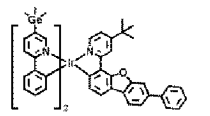
1704

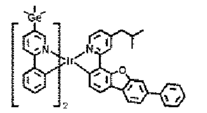
1705

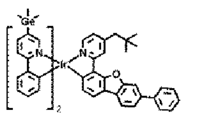
1706

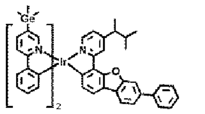
1707

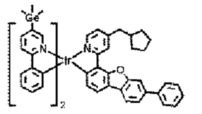
1708

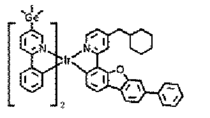
1709

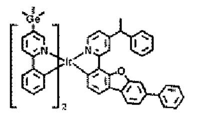
1710

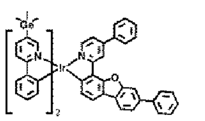
1711

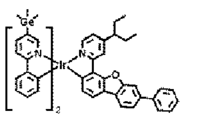
1712

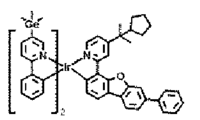
1713

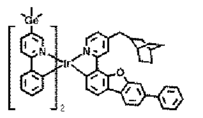
1714

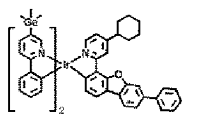
1715

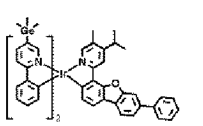
1716

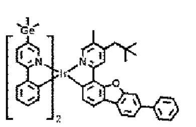
1717

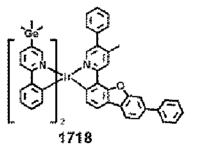
1718

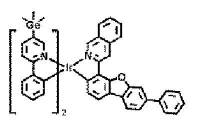
1719

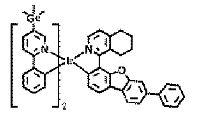
1720

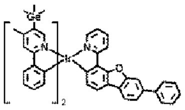
1721
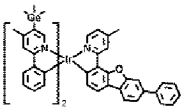
1722
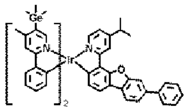
1723
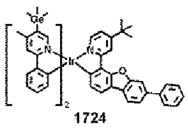
1724
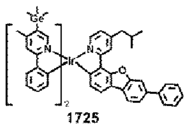
1725

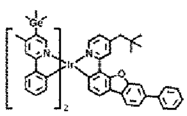
1726
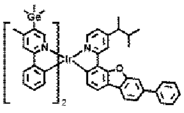
1727
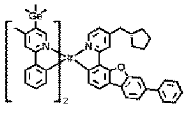
1728
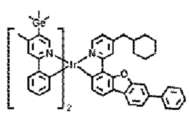
1729
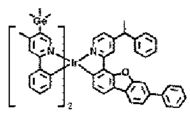
1730

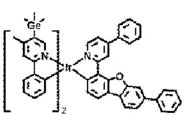
1731
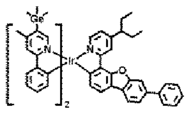
1732
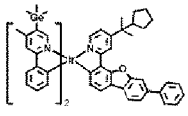
1733
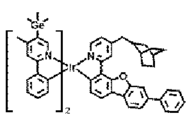
1734
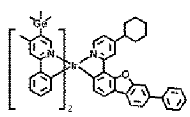
1735

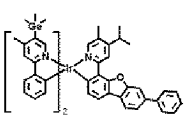
1736
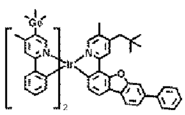
1737
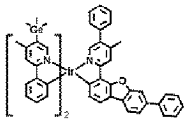
1738
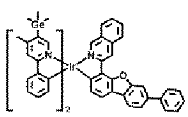
1739
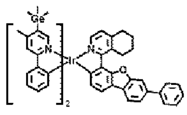
1740

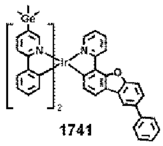
1741
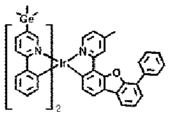
1742
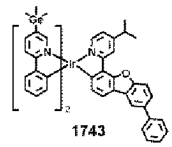
1743
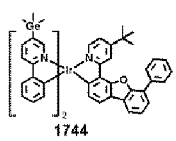
1744
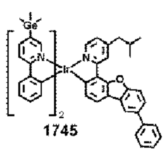
1745

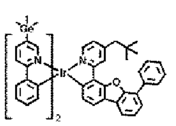
1746
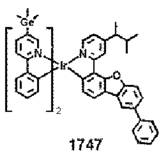
1747
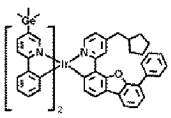
1748
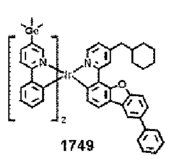
1749
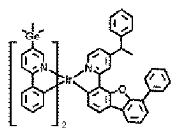
1750

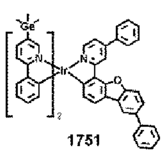
1751
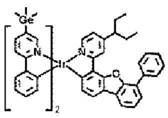
1752
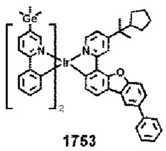
1753
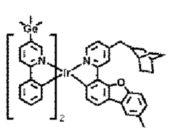
1754
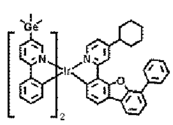
1755

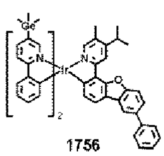
1756
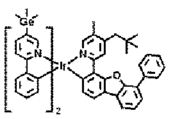
1757
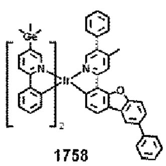
1758
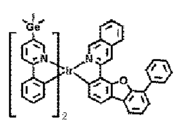
1759
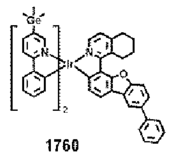
1760

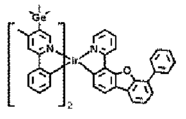
1761
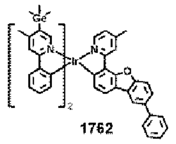
1762
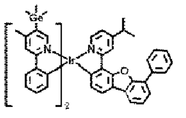
1763
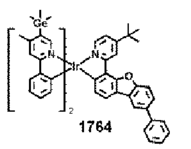
1764
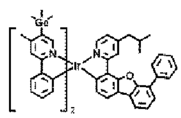
1765
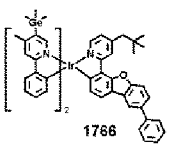
1766
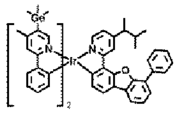
1767
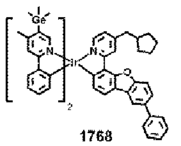
1768
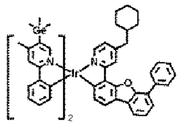
1769
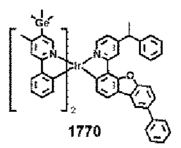
1770
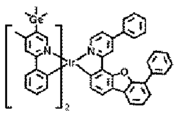
1771
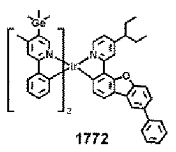
1772
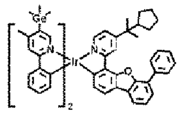
1773
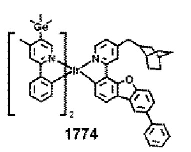
1774
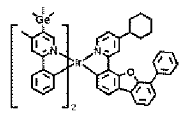
1775
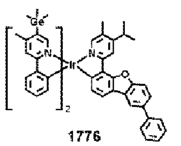
1776
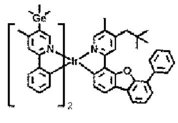
1777
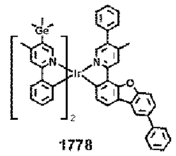
1778
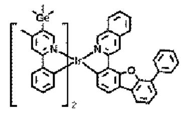
1779
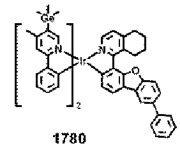
1780
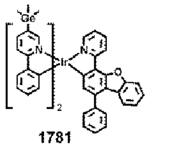
1781
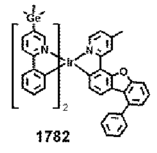
1782
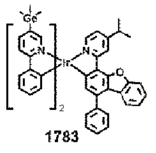
1783
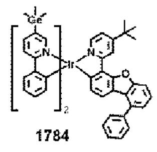
1784
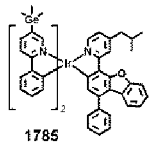
1785
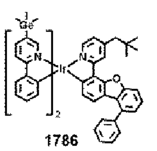
1786
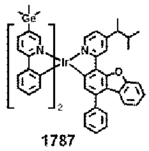
1787
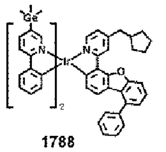
1788
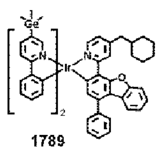
1789
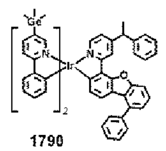
1790
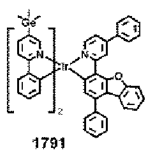
1791
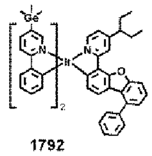
1792
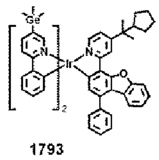
1793
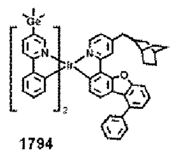
1794
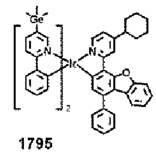
1795
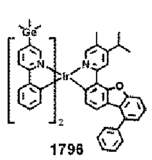
1796
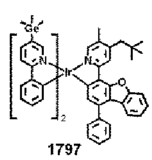
1797
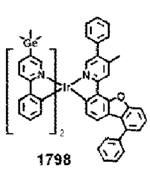
1798
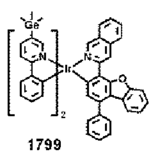
1799
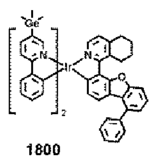
1800

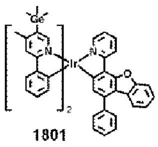
1801

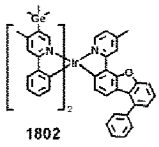
1802

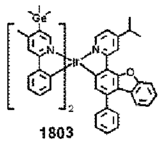
1803

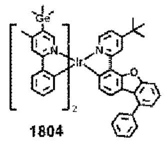
1804

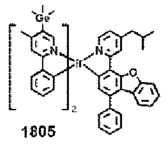
1805

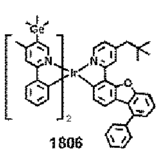
1806

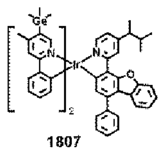
1807

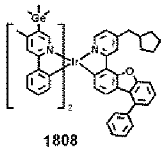
1808

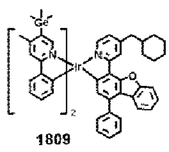
1809

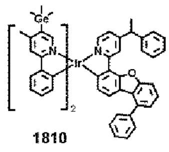
1810

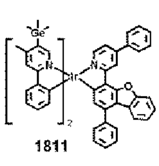
1811

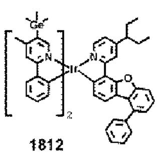
1812

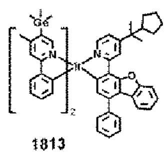
1813

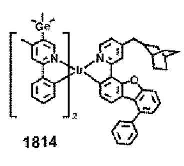
1814

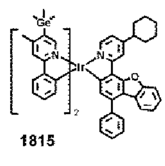
1815

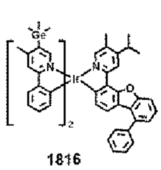
1816

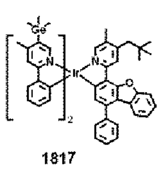
1817

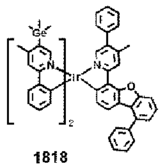
1818

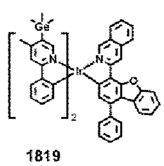
1819

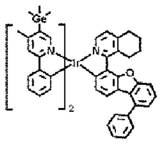
1820

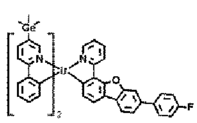
1821

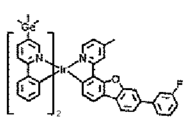
1822

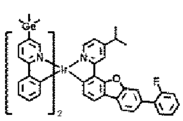
1823

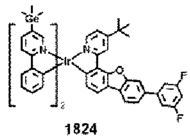
1824

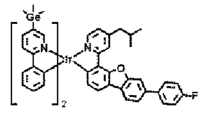
1825

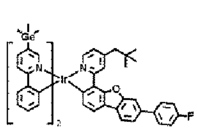
1826

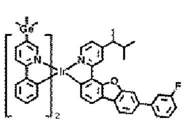
1827

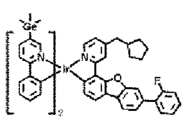
1828

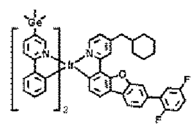
1829

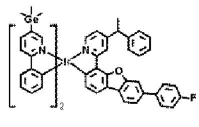
1830

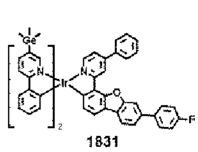
1831

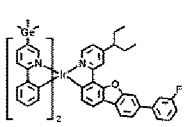
1832

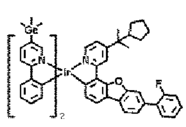
1833

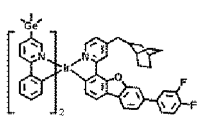
1834

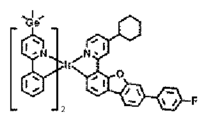
1835

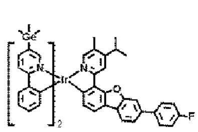
1836

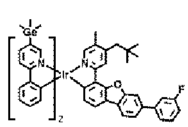
1837

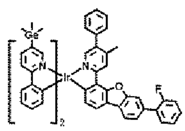
1838

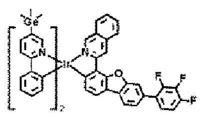
1839

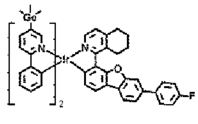
1840

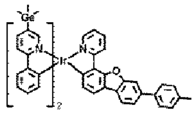
1841

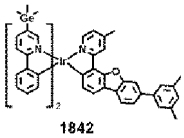
1842

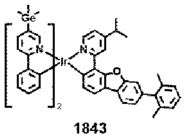
1843

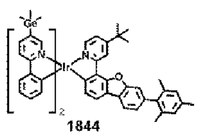
1844

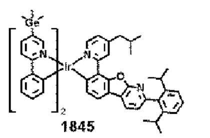
1845

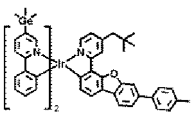
1846

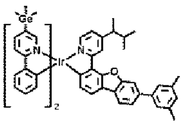
1847

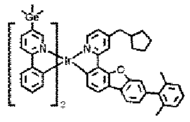
1848

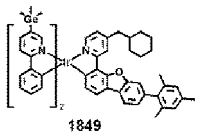
1849

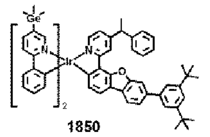
1850

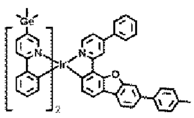
1851

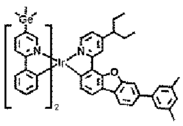
1852

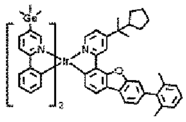
1853

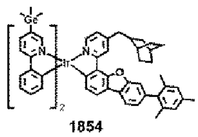
1854

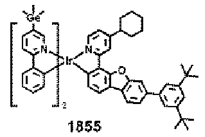
1855

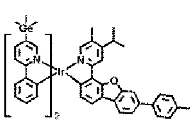
1856

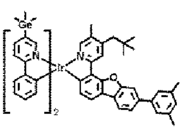
1857

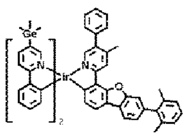
1858

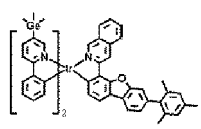
1859

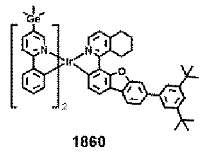
1860

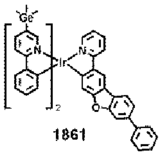
1861

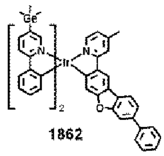
1862

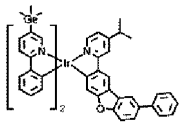
1863

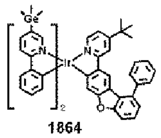
1864

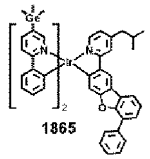
1865

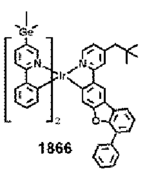
1866

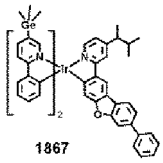
1867

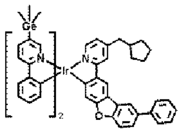
1868

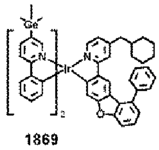
1869

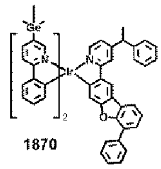
1870

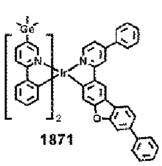
1871

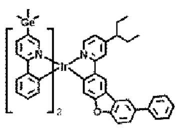
1872

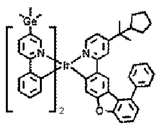
1873

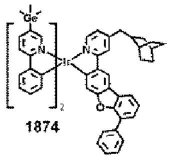
1874

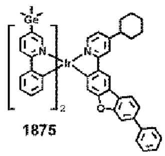
1875

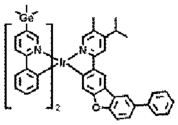
1876

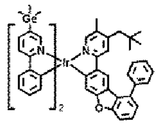
1877

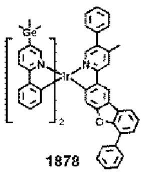
1878

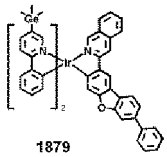
1879

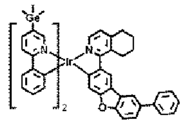
1880

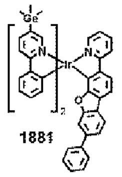
1881

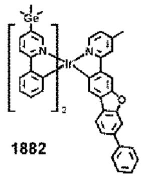
1882

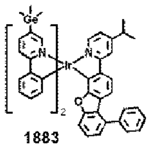
1883

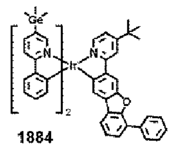
1884

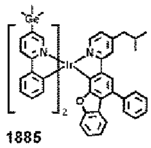
1885

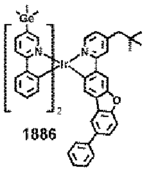
1886

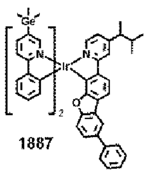
1887

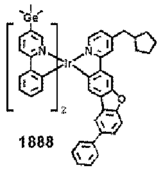
1888

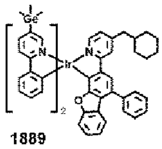
1889

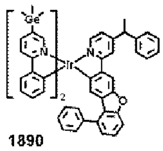
1890

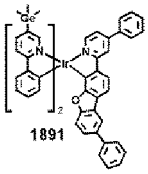
1891

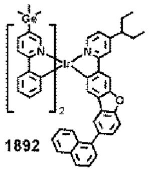
1892

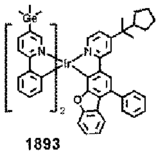
1893

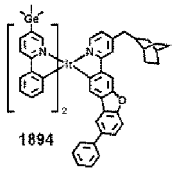
1894

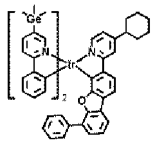
1895

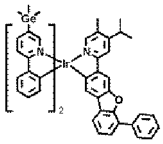
1896

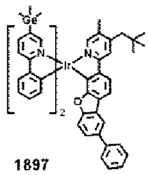
1897

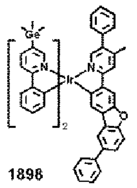
1898

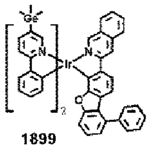
1899

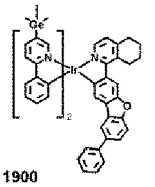
1900

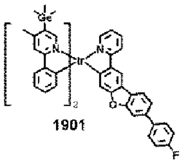
1901

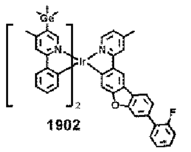
1902

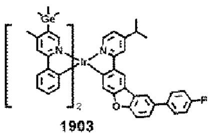
1903

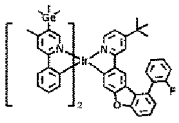
1904

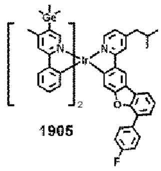
1905

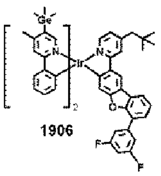
1906

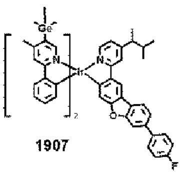
1907

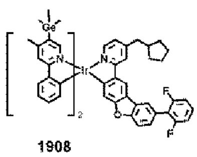
1908

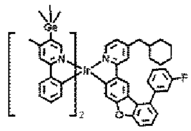
1909

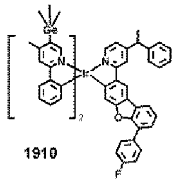
1910

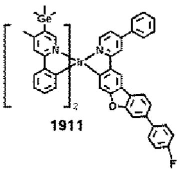
1911

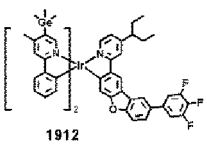
1912

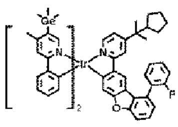
1913

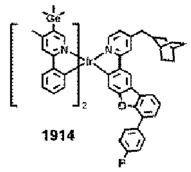
1914

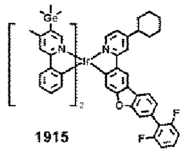
1915

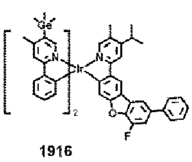
1916

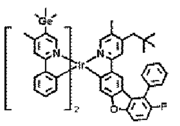
1917

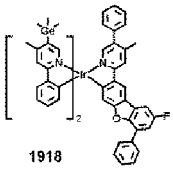
1918

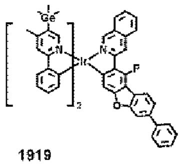
1919

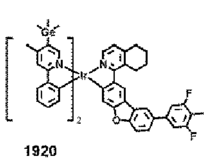
1920

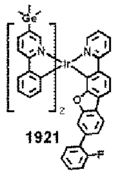
1921

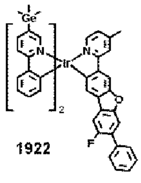
1922

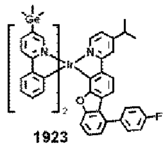
1923

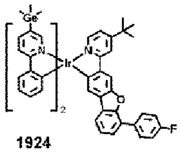
1924

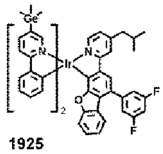
1925

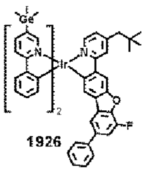
1926

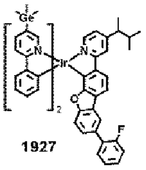
1927

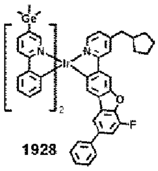
1928

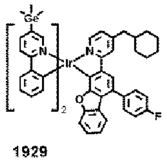
1929

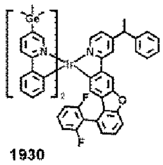
1930

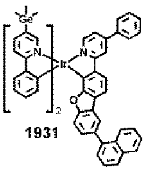
1931

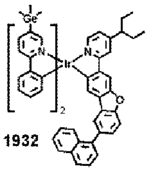
1932

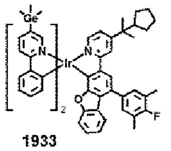
1933

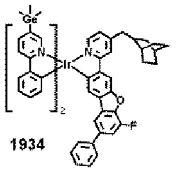
1934

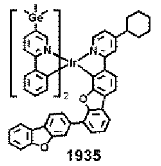
1935

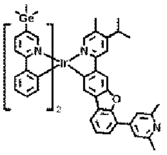
1936

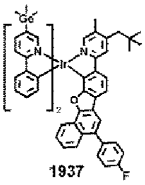
1937

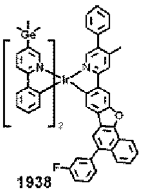
1938

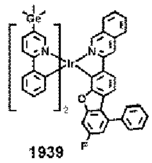
1939

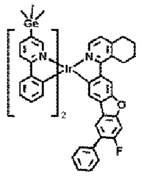
1940

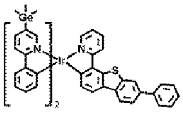
1941

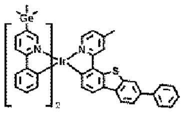
1942

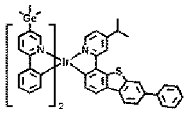
1943

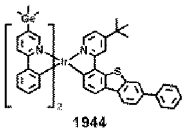
1944

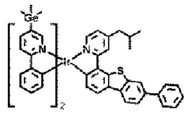
1945

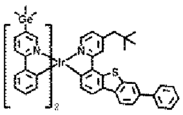
1946

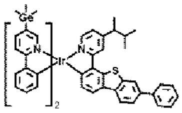
1947

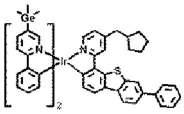
1948

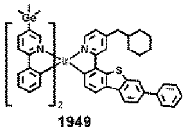
1949

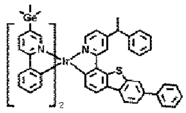
1950

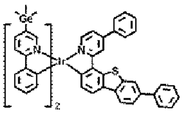
1951

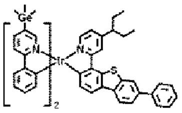
1952

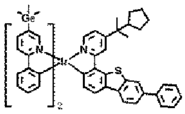
1953

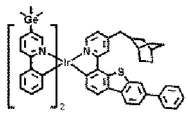
1954

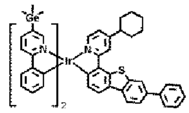
1955

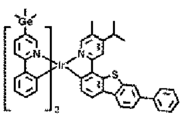
1956

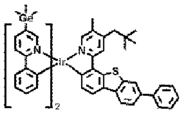
1957

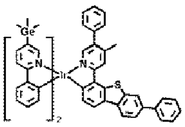
1958

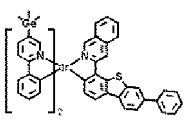
1959

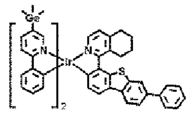
1960

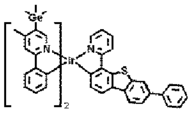
1961

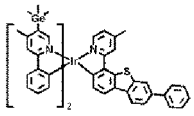
1962

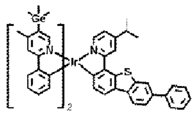
1963

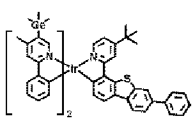
1964

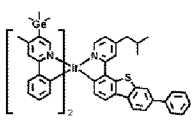
1965

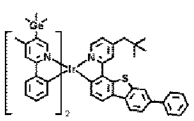
1966

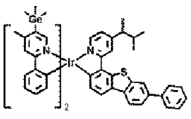
1967

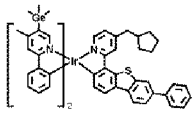
1968

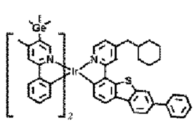
1969

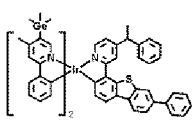
1970

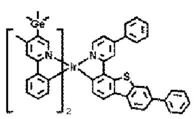
1971

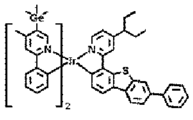
1972

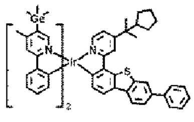
1973

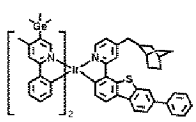
1974

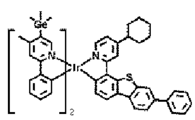
1975

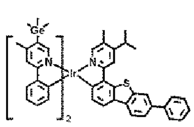
1976

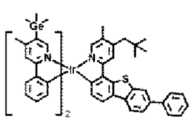
1977

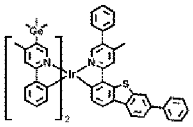
1978

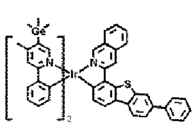
1979

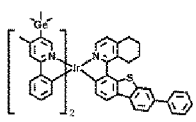
1980

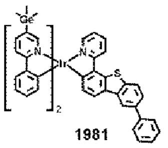
1981

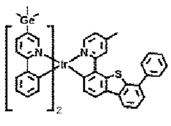
1982

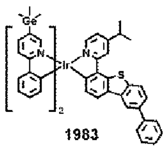
1983

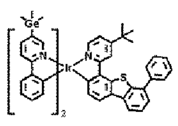
1984

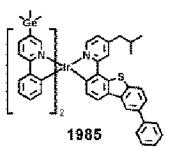
1985

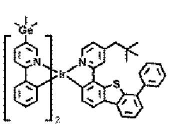
1986

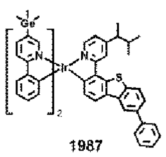
1987

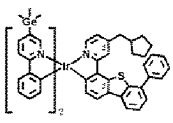
1988

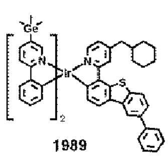
1989

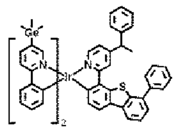
1990

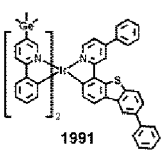
1991

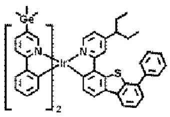
1992

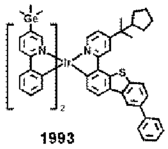
1993

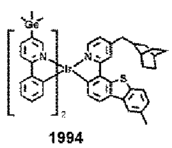
1994

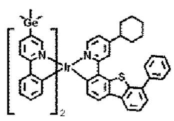
1995

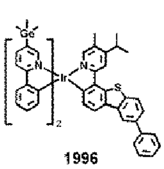
1996

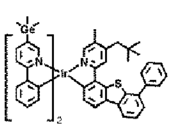
1997

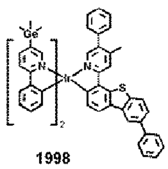
1998

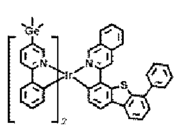
1999

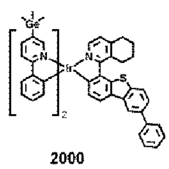
2000

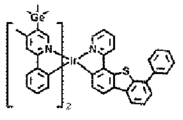
2001

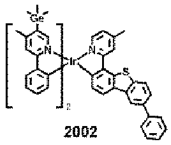
2002

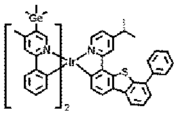
2003

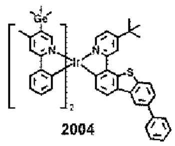
2004

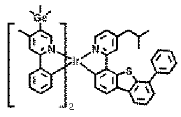
2005

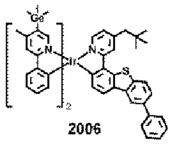
2006

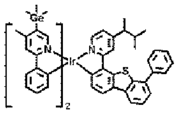
2007

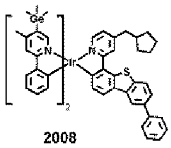
2008

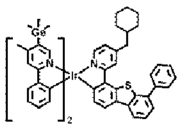
2009

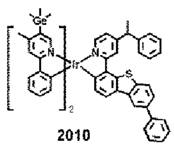
2010

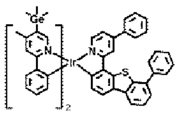
2011

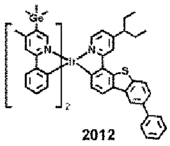
2012

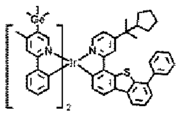
2013

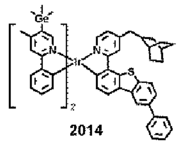
2014

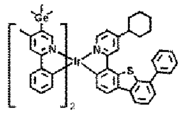
2015

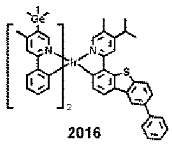
2016

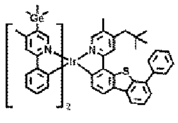
2017

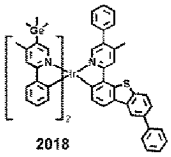
2018

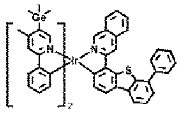
2019

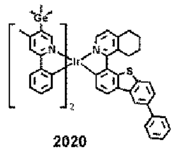
2020

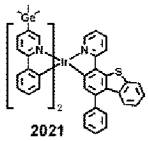
2021

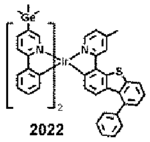
2022

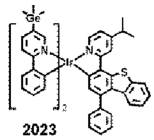
2023

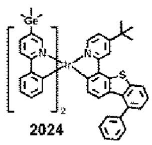
2024

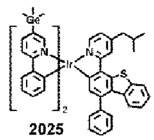
2025

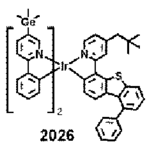
2026

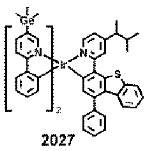
2027

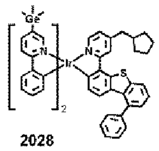
2028

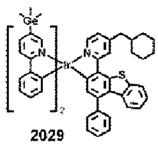
2029

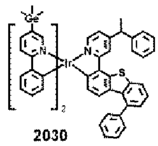
2030

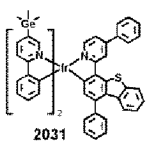
2031

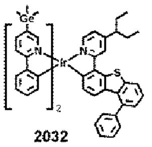
2032

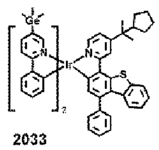
2033

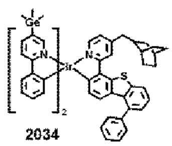
2034

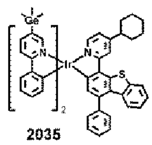
2035

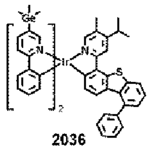
2036

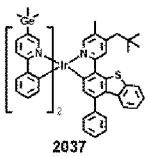
2037

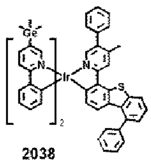
2038

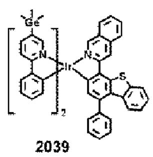
2039

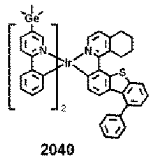
2040

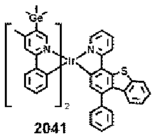
2041
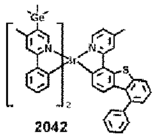
2042
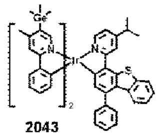
2043
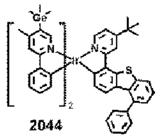
2044
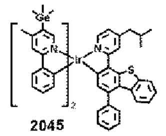
2045

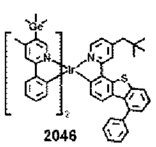
2046
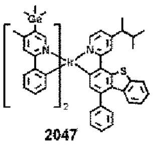
2047
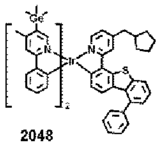
2048
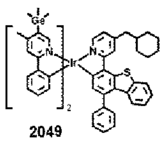
2049
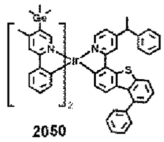
2050

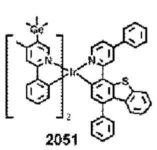
2051
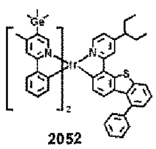
2052
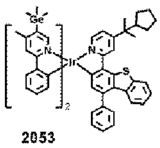
2053
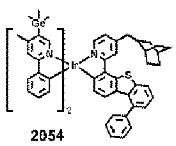
2054
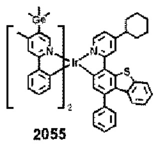
2055

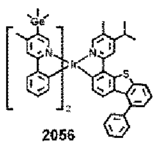
2056
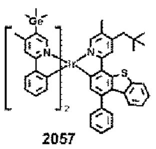
2057
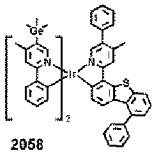
2058
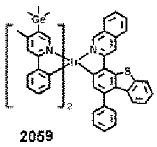
2059
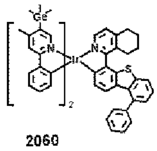
2060

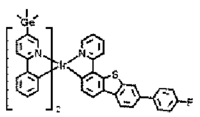
2061
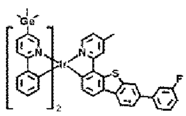
2062
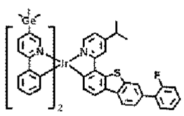
2063
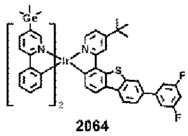
2064
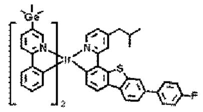
2065

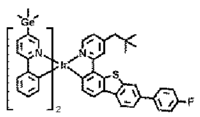
2066
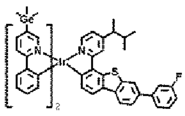
2067
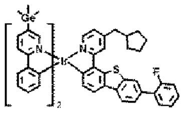
2068
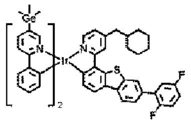
2069
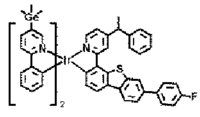
2070

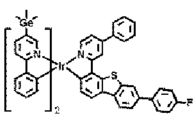
2071
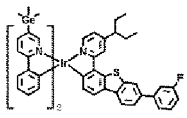
2072
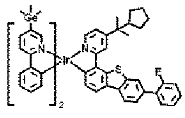
2073
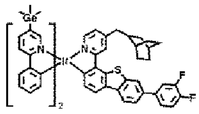
2074
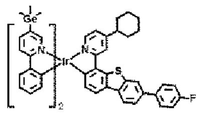
2075

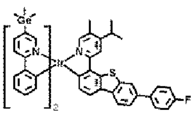
2076
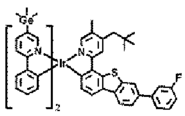
2077
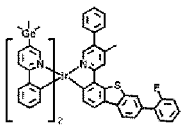
2078
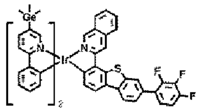
2079
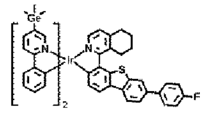
2080

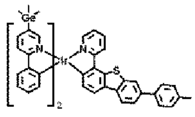
2081

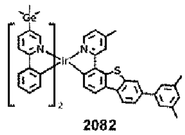
2082

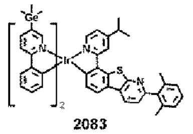
2083

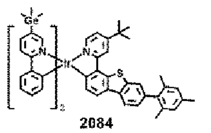
2084

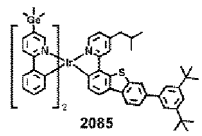
2085

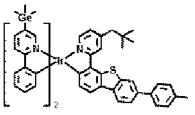
2086

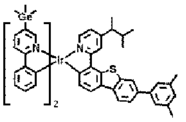
2087

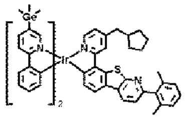
2088

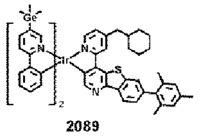
2089

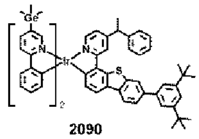
2090

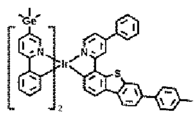
2091

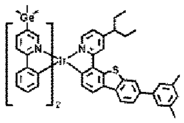
2092

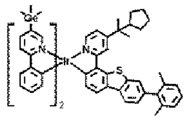
2093

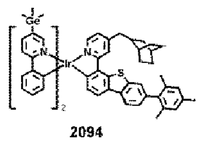
2094

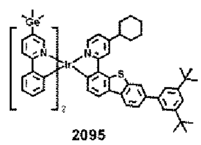
2095

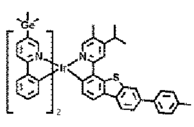
2096

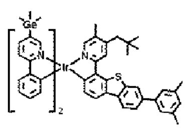
2097

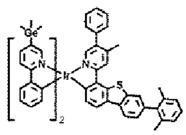
2098

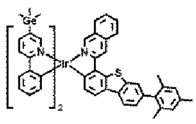
2099

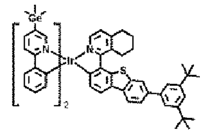
2100

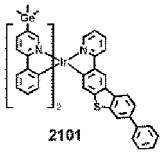
2101

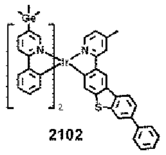
2102

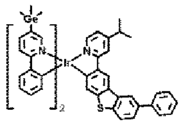
2103

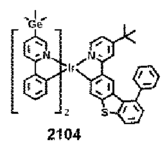
2104

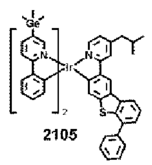
2105

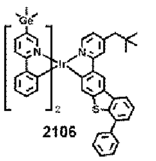
2106

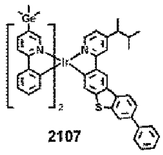
2107

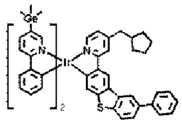
2108

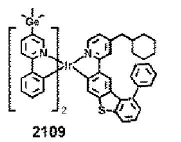
2109

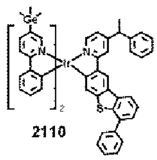
2110

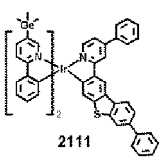
2111

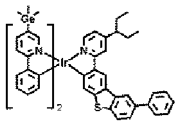
2112

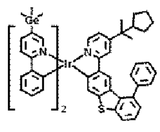
2113

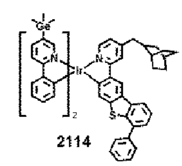
2114

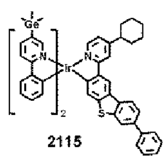
2115

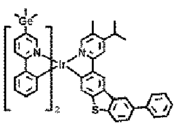
2116

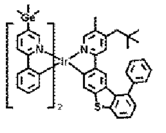
2117

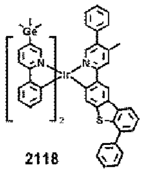
2118

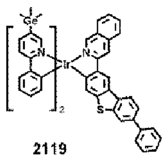
2119

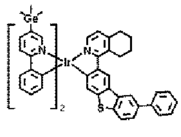
2120

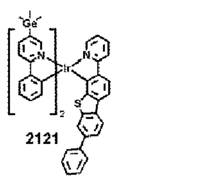
2121

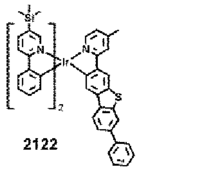
2122

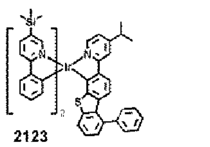
2123

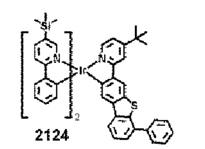
2124

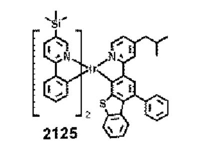
2125

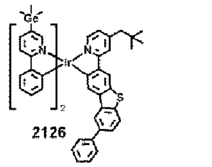
2126

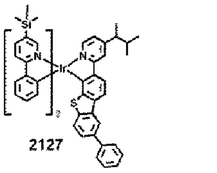
2127

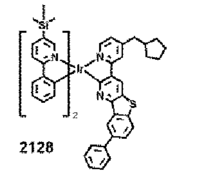
2128

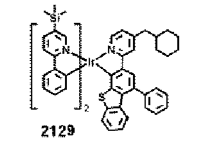
2129

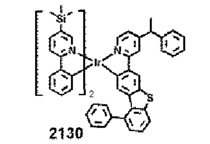
2130

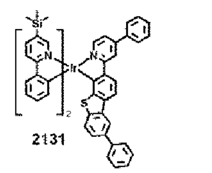
2131

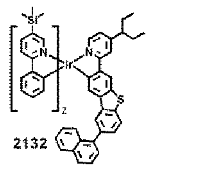
2132

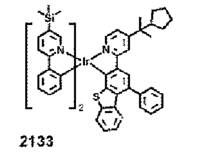
2133

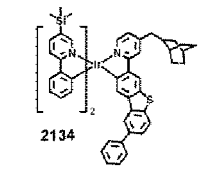
2134

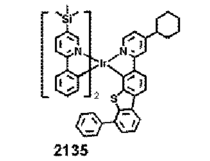
2135

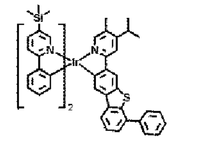
2136

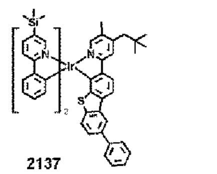
2137

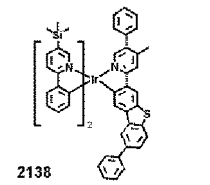
2138

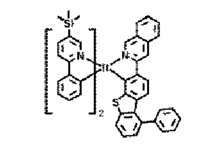
2139

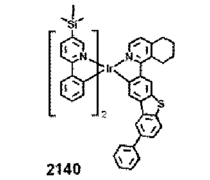
2140

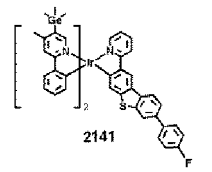
2141

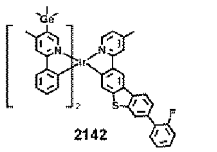
2142

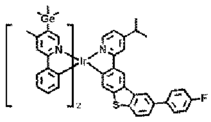
2143

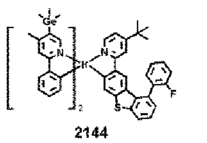
2144

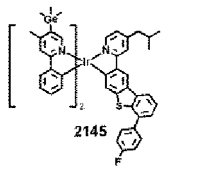
2145

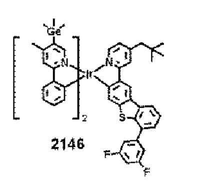
2146

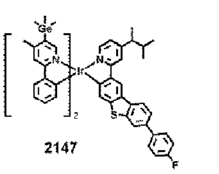
2147

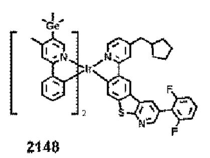
2148

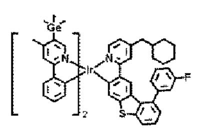
2149

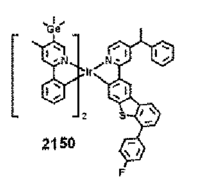
2150

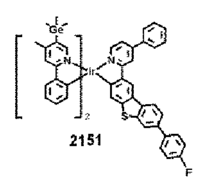
2151

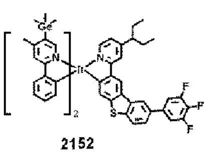
2152

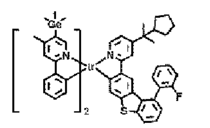
2153

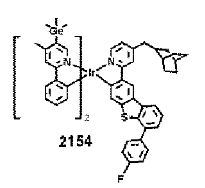
2154

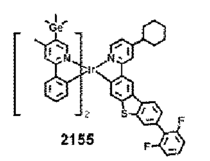
2155

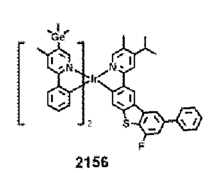
2156

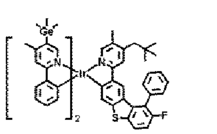
2157

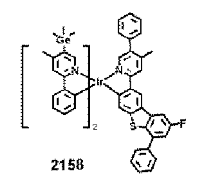
2158

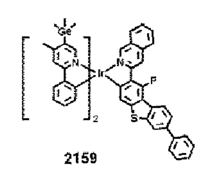
2159

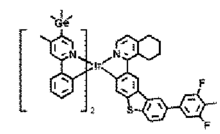
2160

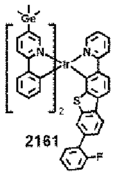
2161

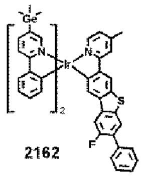
2162

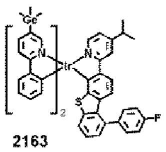
2163

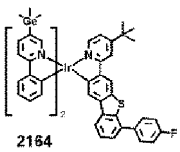
2164

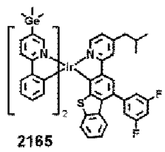
2165

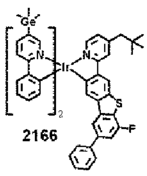
2166

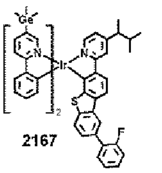
2167

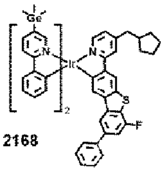
2168

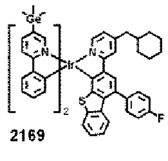
2169

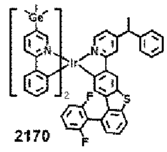
2170

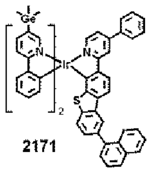
2171

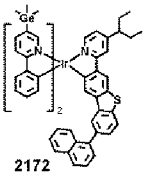
2172

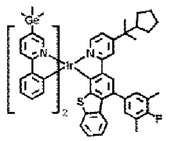
2173

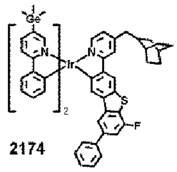
2174

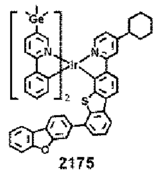
2175

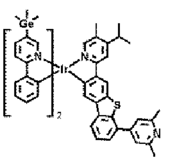
2176

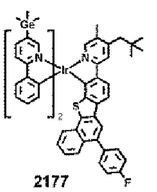
2177

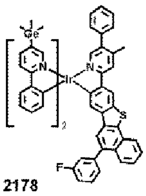
2178

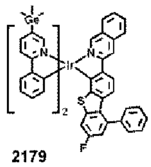
2179

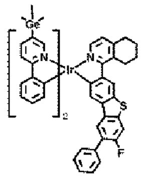
2180

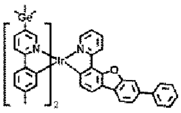
2181

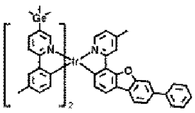
2182

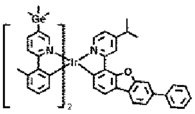
2183

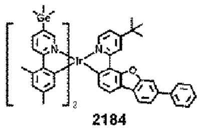
2184

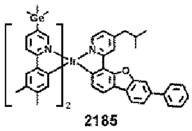
2185

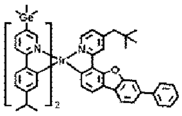
2186

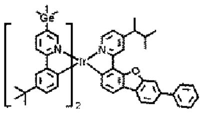
2187

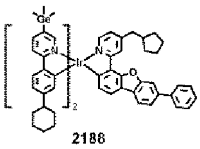
2188

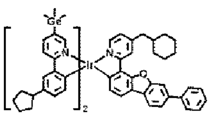
2189

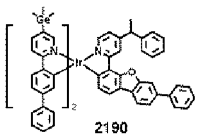
2190

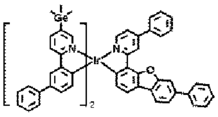
2191

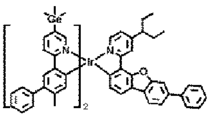
2192

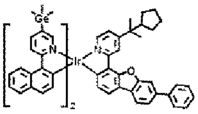
2193

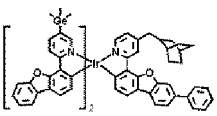
2194

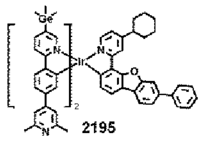
2195

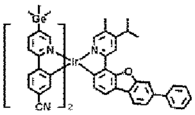
2196

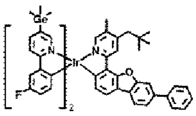
2197

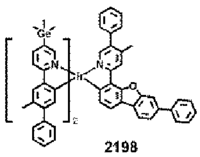
2198

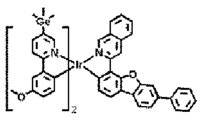
2199

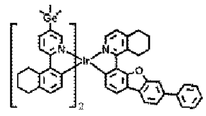
2200

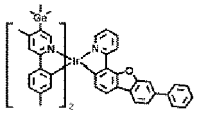
2201

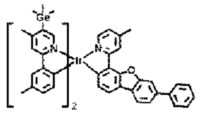
2202

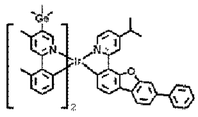
2203

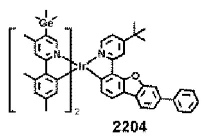
2204

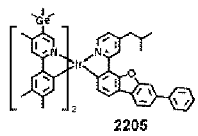
2205

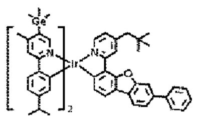
2206

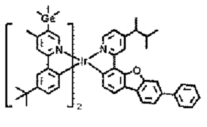
2207

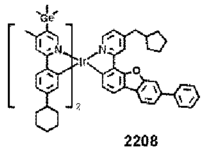
2208

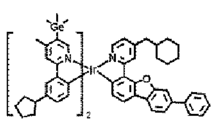
2209

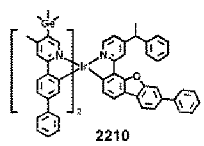
2210

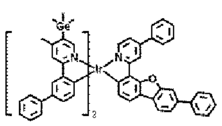
2211

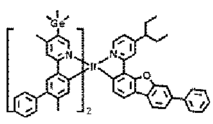
2212

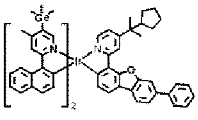
2213

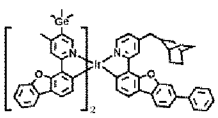
2214

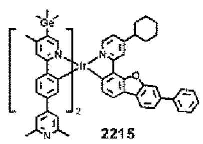
2215

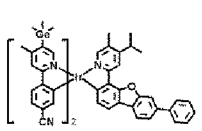
2216

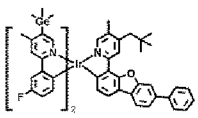
2217

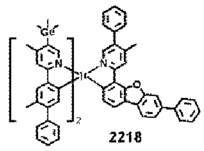
2218

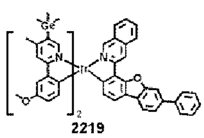
2219

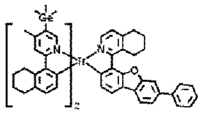
2220

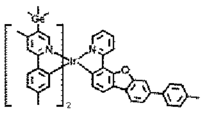
2221

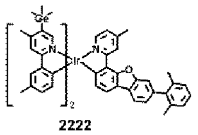
2222

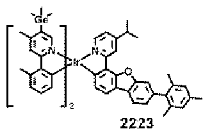
2223

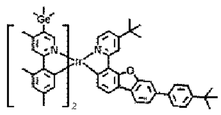
2224

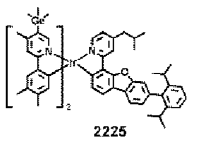
2225

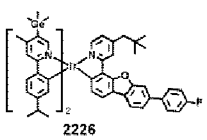
2226

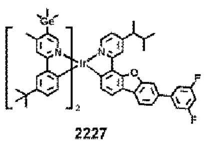
2227

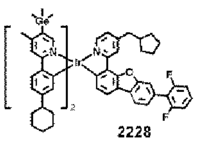
2228

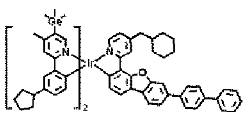
2229

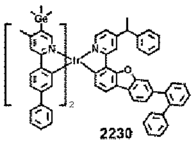
2230

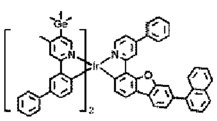
2231

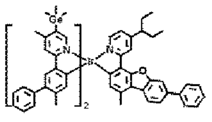
2232

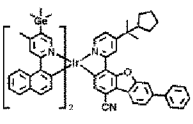
2233

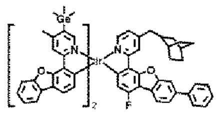
2234

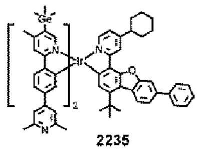
2235

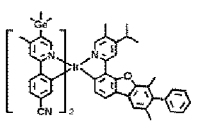
2236

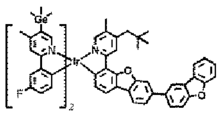
2237

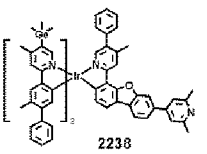
2238

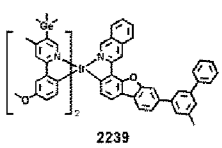
2239

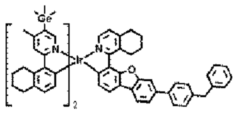
2240

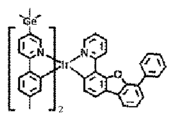
2241

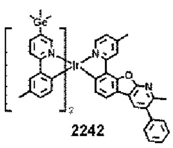
2242

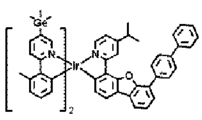
2243

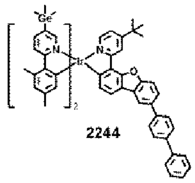
2244

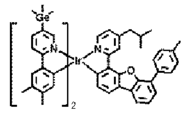
2245

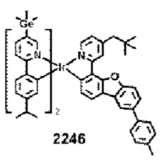
2246

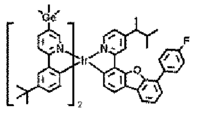
2247

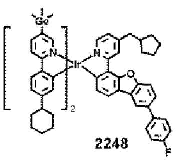
2248

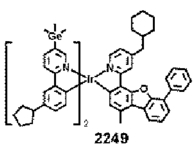
2249

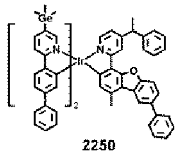
2250

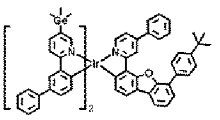
2251

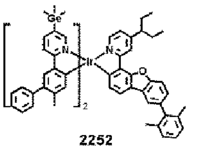
2252

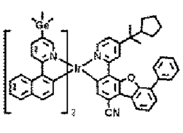
2253

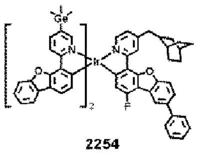
2254

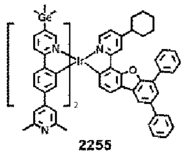
2255

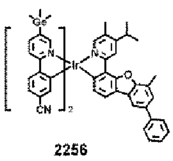
2256

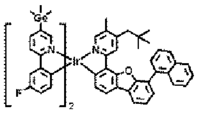
2257

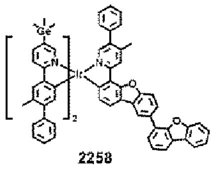
2258

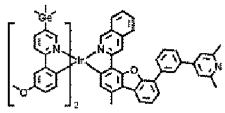
2259

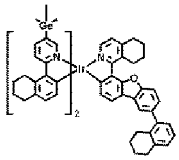
2260

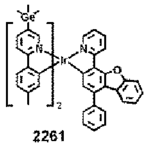
2261

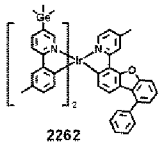
2262

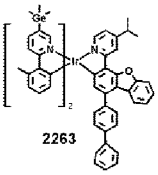
2263

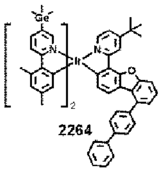
2264

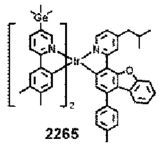
2265

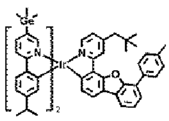
2266

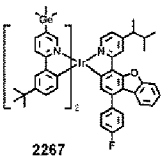
2267

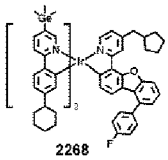
2268

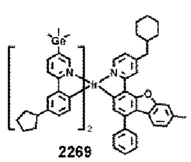
2269

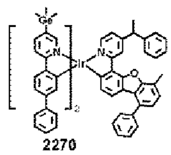
2270

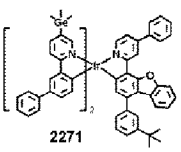
2271

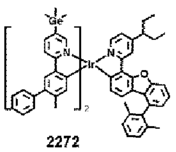
2272

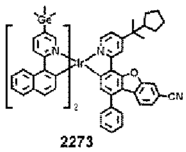
2273

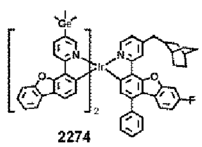
2274

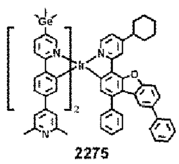
2275

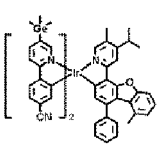
2276

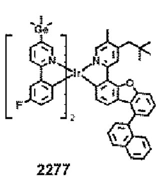
2277

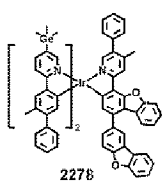
2278

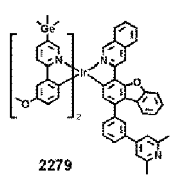
2279

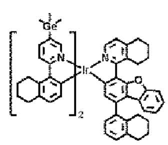
2280

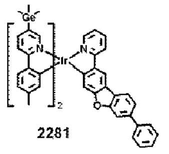
2281

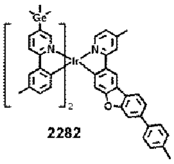
2282

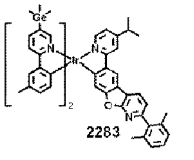
2283

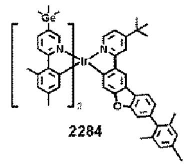
2284

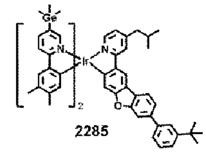
2285

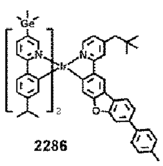
2286

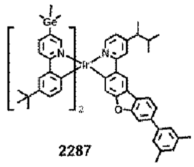
2287

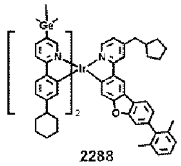
2288

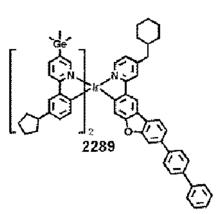
2289

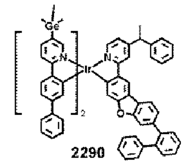
2290

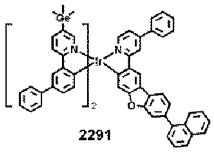
2291

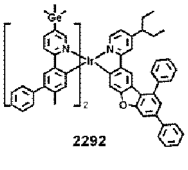
2292

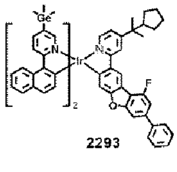
2293

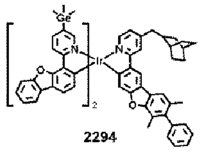
2294

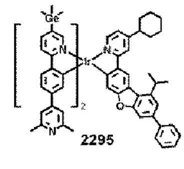
2295

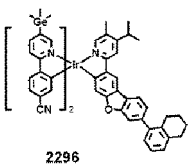
2296

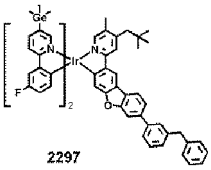
2297

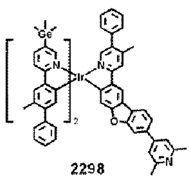
2298

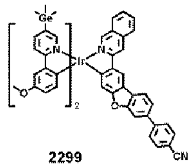
2299

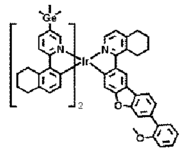
2300

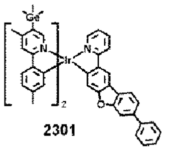
2301

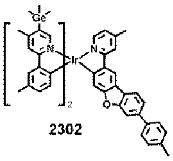
2302

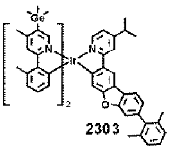
2303

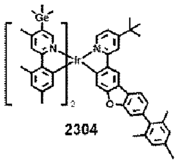
2304

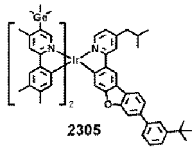
2305

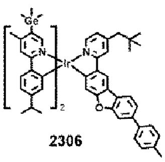
2306

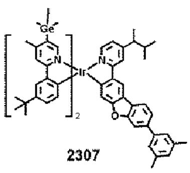
2307

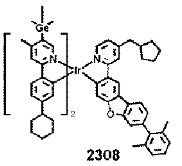
2308

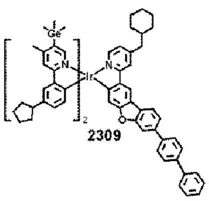
2309

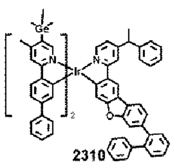
2310

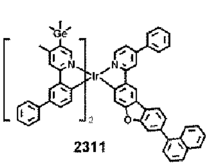
2311

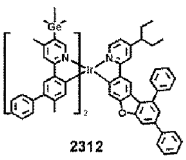
2312

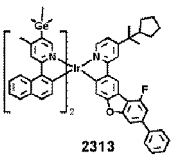
2313

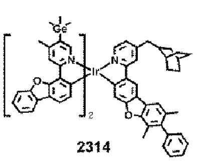
2314

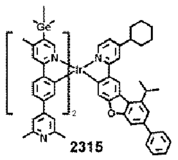
2315

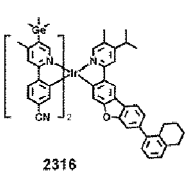
2316

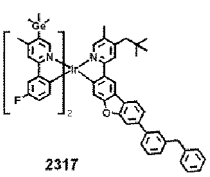
2317

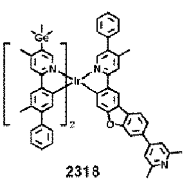
2318

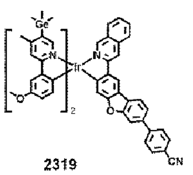
2319

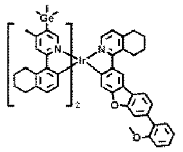
2320

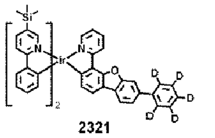
2321

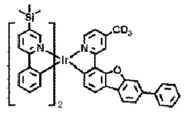
2322

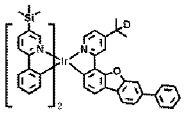
2323

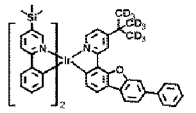
2324

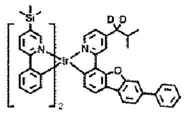
2325

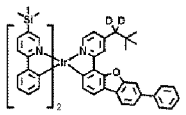
2326

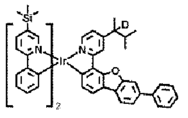
2327

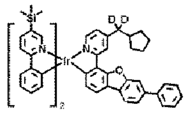
2328

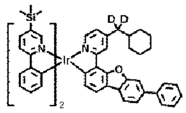
2329

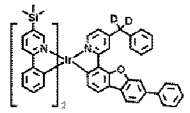
2330

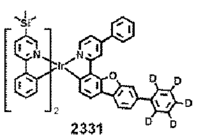
2331

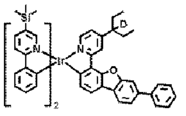
2332

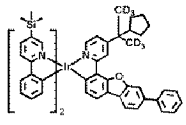
2333

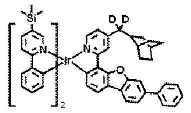
2334

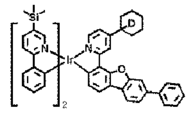
2335

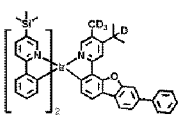
2336

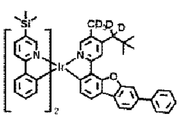
2337

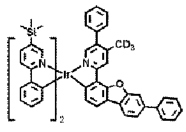
2338

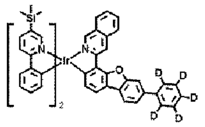
2339

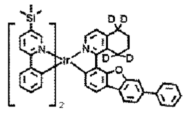
2340

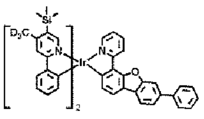
2341

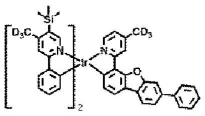
2342

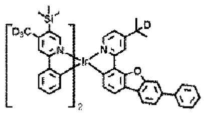
2343

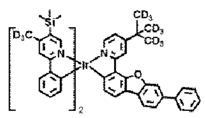
2344

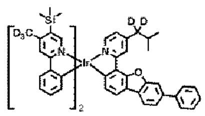
2345

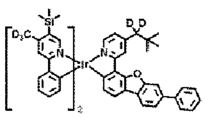
2346

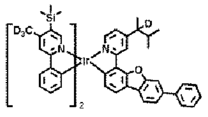
2347

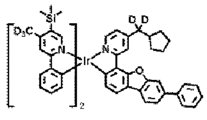
2348

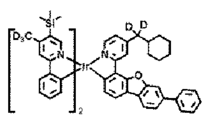
2349

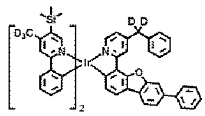
2350

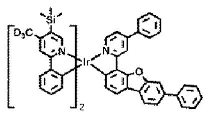
2351

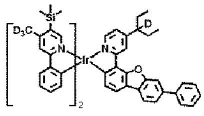
2352

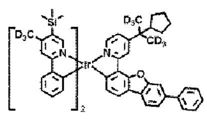
2353

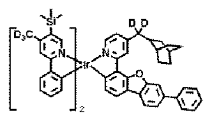
2354

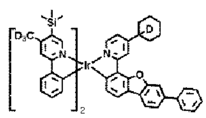
2355

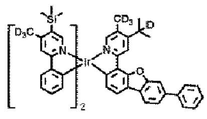
2356

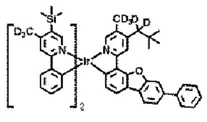
2357

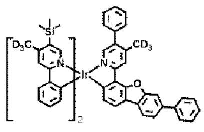
2358

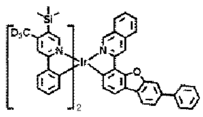
2359

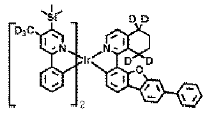
2360

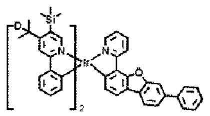
2361

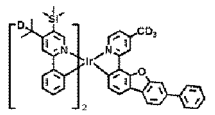
2362

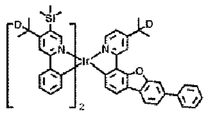
2363

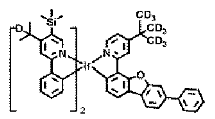
2364

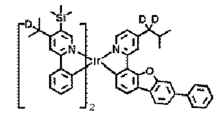
2365

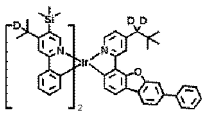
2366

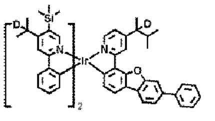
2367

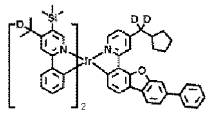
2368

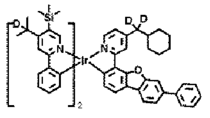
2369

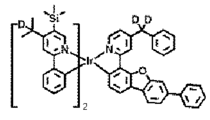
2370

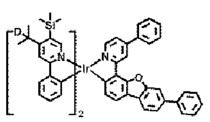
2371

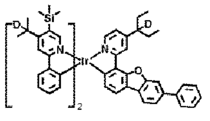
2372

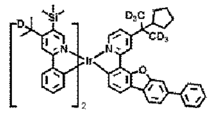
2373

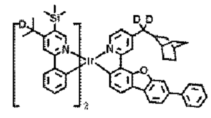
2374

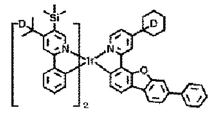
2375

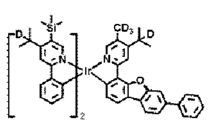
2376

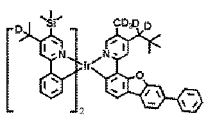
2377

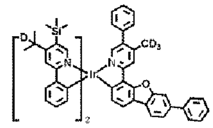
2378

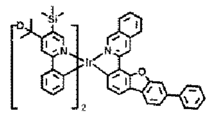
2379

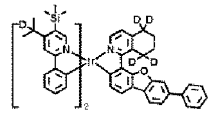
2380

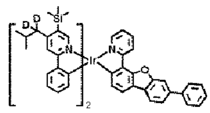
2381

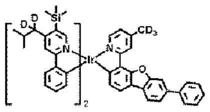
2382

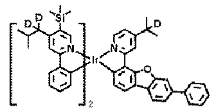
2383

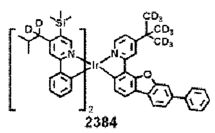
2384

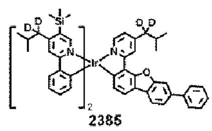
2385

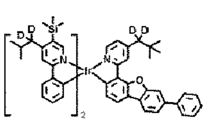
2386

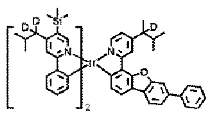
2387

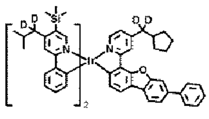
2388

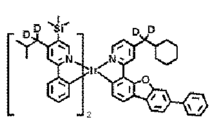
2389

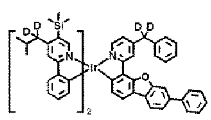
2390

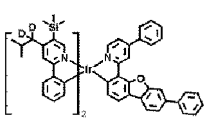
2391

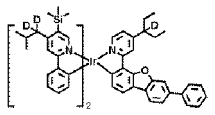
2392

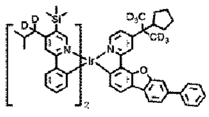
2393

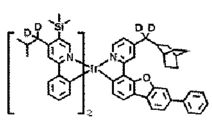
2394

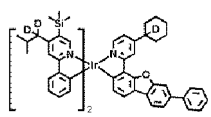
2395

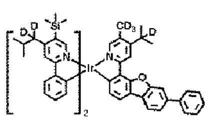
2396

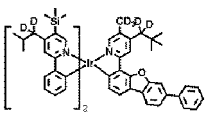
2397

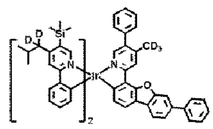
2398

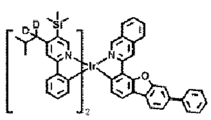
2399

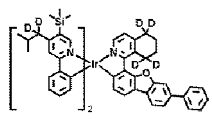
2400

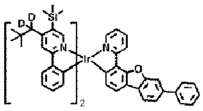
2401
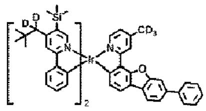
2402
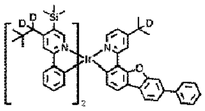
2403
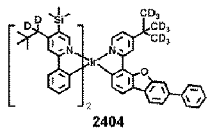
2404
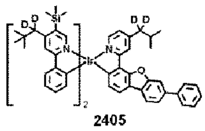
2405

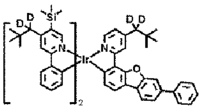
2406
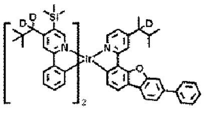
2407
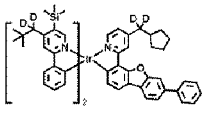
2408
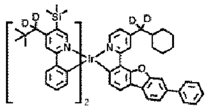
2409
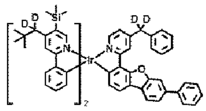
2410

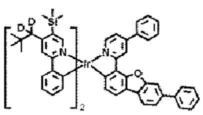
2411
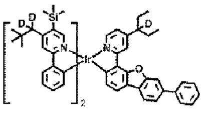
2412
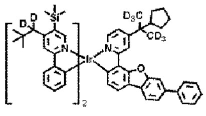
2413
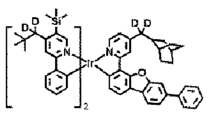
2414
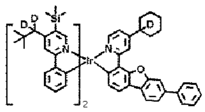
2415

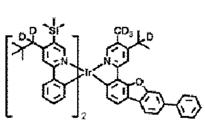
2416
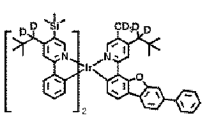
2417
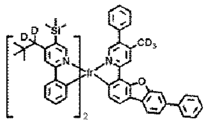
2418
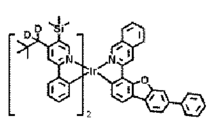
2419
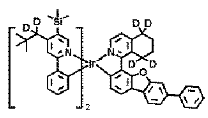
2420

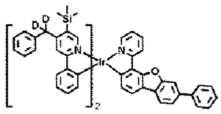
2421
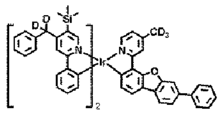
2422
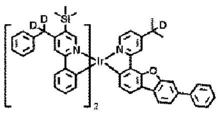
2423
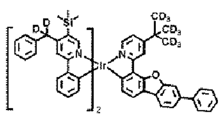
2424
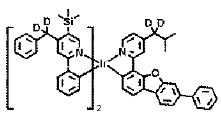
2425

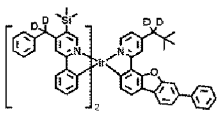
2426
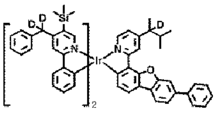
2427
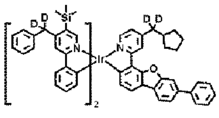
2428
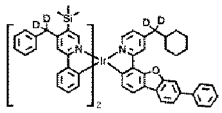
2429
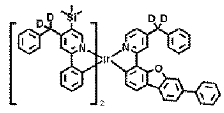
2430

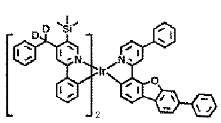
2431
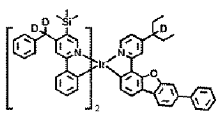
2432
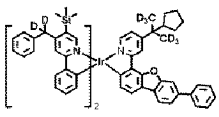
2433
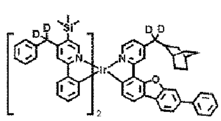
2434
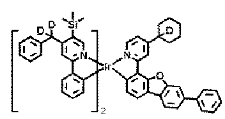
2435

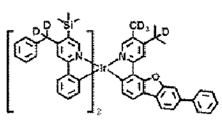
2436
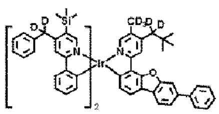
2437
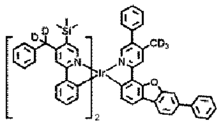
2438
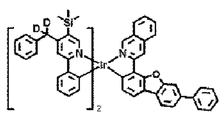
2439
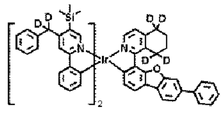
2440

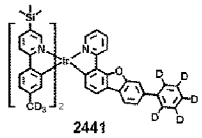
2441
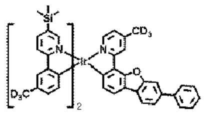
2442
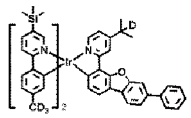
2443
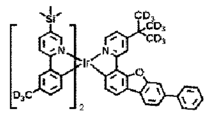
2444
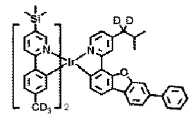
2445

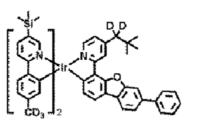
2446
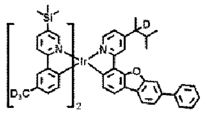
2447
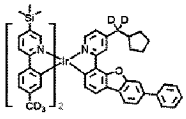
2448
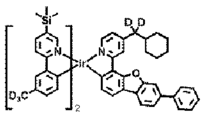
2449
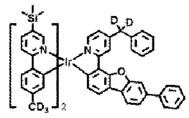
2450

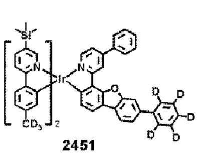
2451
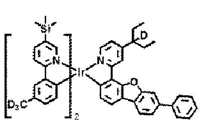
2452
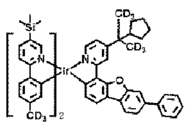
2453
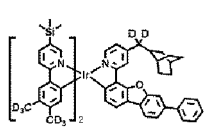
2454
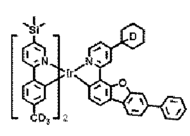
2455

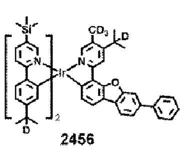
2456
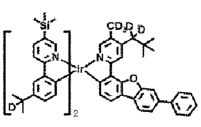
2457
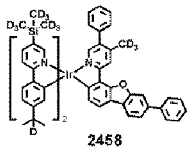
2458
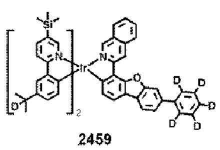
2459
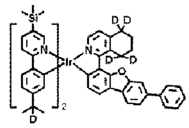
2460

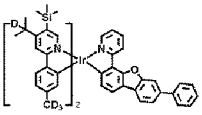
2461
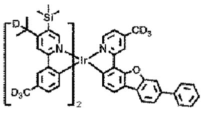
2462
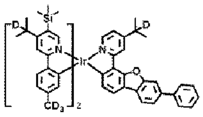
2463
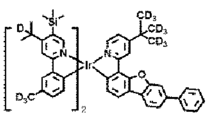
2464
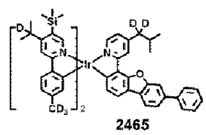
2465

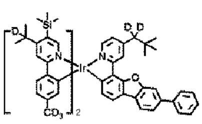
2466
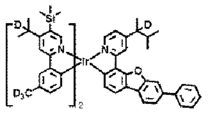
2467
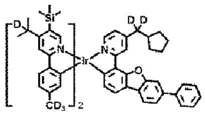
2468
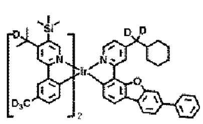
2469
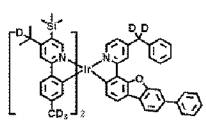
2470

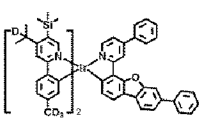
2471
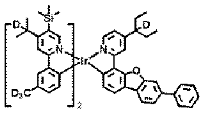
2472
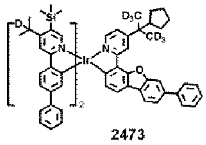
2473
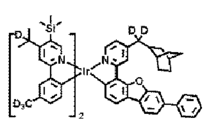
2474
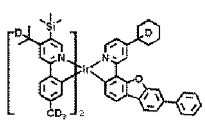
2475

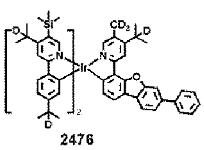
2476
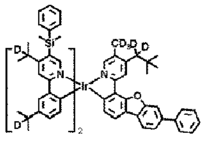
2477
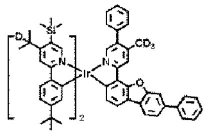
2478
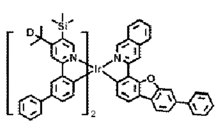
2479
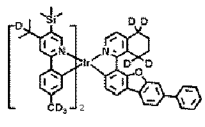
2480

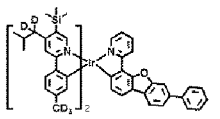
2481
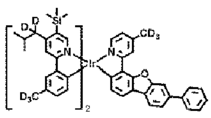
2482
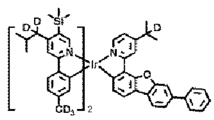
2483
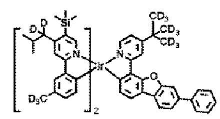
2484
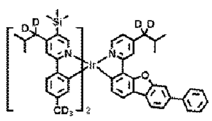
2485
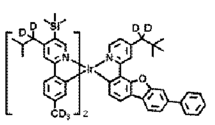
2486
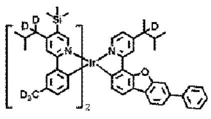
2487
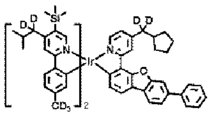
2488
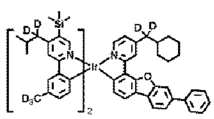
2489
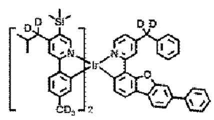
2490
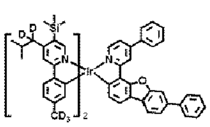
2491
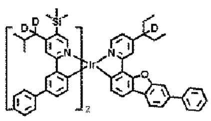
2492
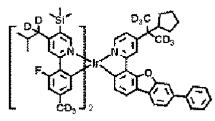
2493
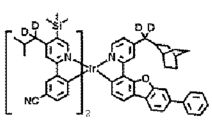
2494
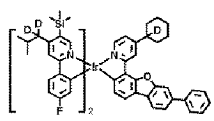
2495
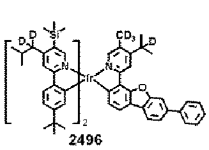
2496
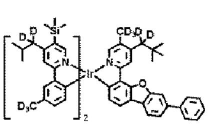
2497
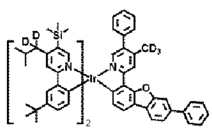
2498
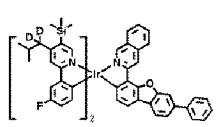
2499
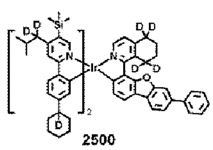
2500
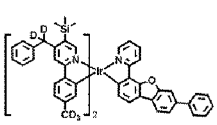
2501
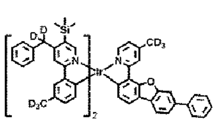
2502
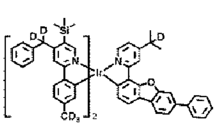
2503
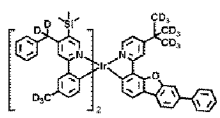
2504
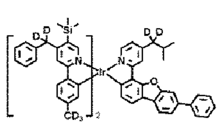
2505
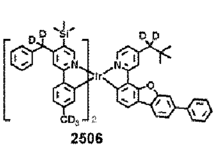
2506
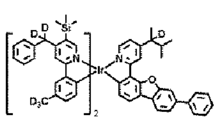
2507
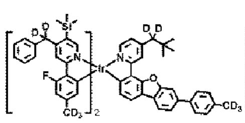
2508
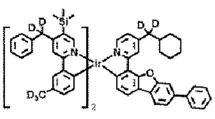
2509
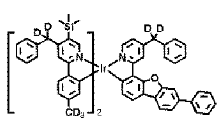
2510
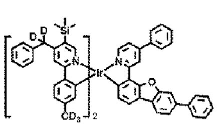
2511
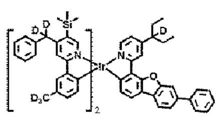
2512
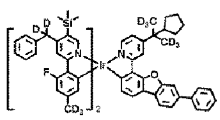
2513
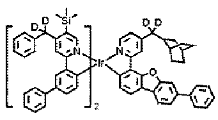
2514
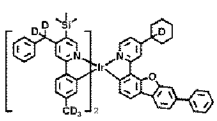
2515
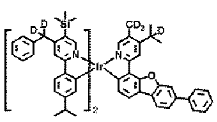
2516
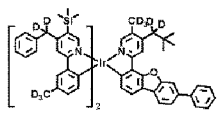
2517
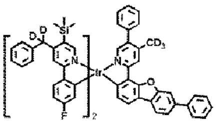
2518
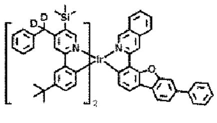
2519
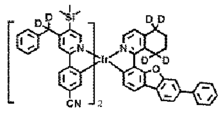
2520

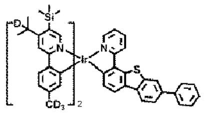
2521
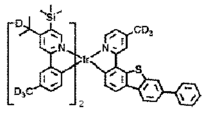
2522
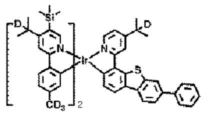
2523
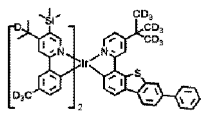
2524
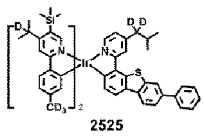
2525

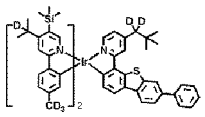
2526
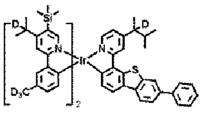
2527
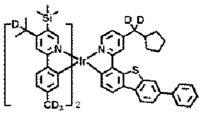
2528
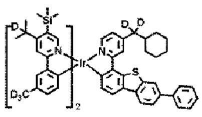
2529
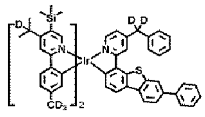
2530

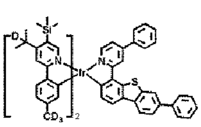
2531
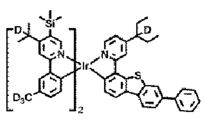
2532
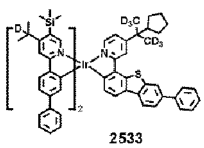
2533
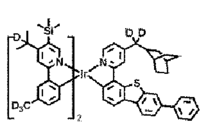
2534
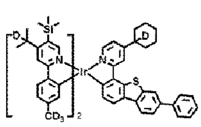
2535

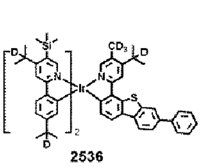
2536
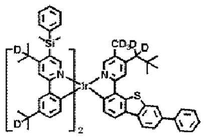
2537
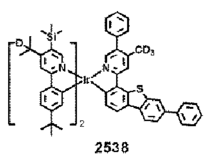
2538
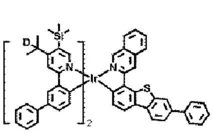
2539
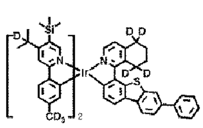
2540

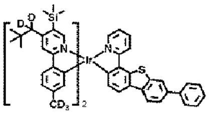
2541
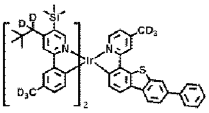
2542
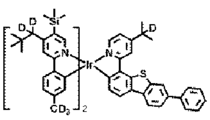
2543
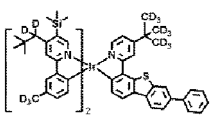
2544
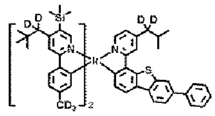
2545

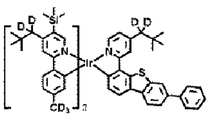
2546
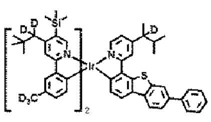
2547
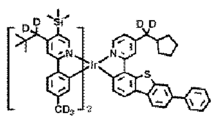
2548
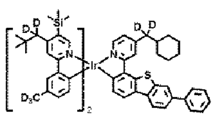
2549
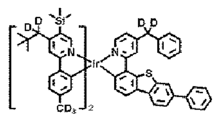
2550

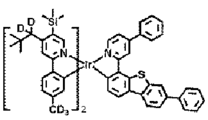
2551
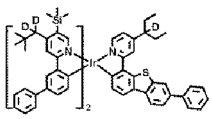
2552
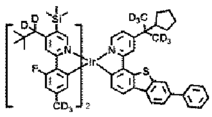
2553
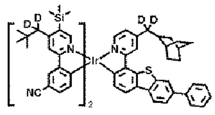
2554
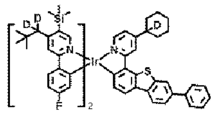
2555

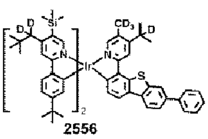
2556
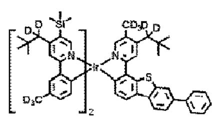
2557
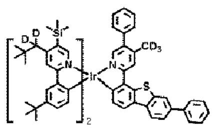
2558
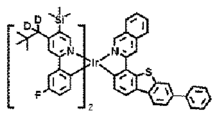
2559
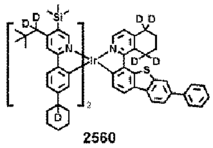
2560

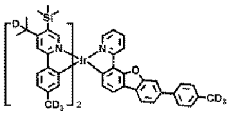
2561

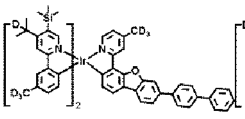
2562

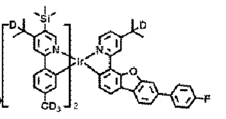
2563

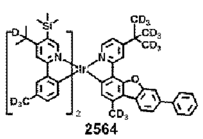
2564

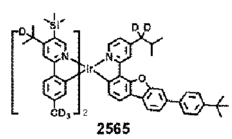
2565

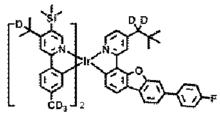
2566

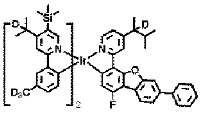
2567

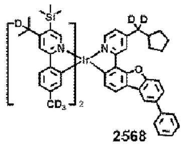
2568

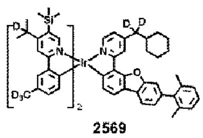
2569

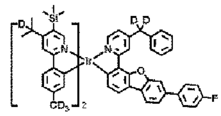
2570

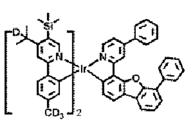
2571

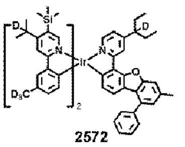
2572

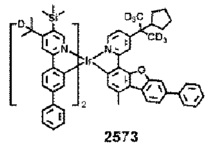
2573

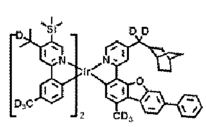
2574

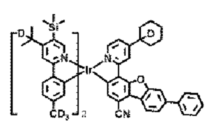
2575

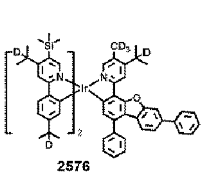
2576

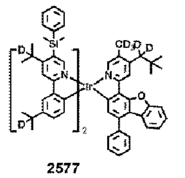
2577

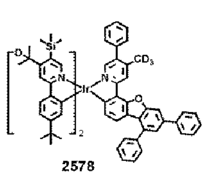
2578

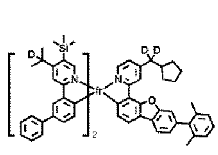
2579

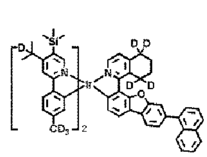
2580

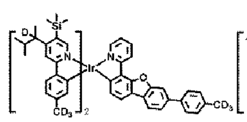
2581

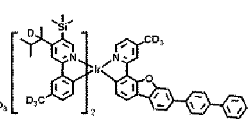
2582

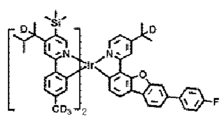
2583

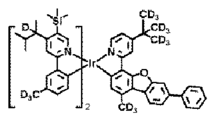
2584

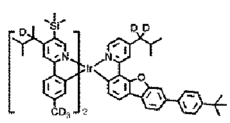
2585

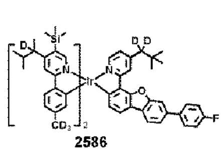
2586

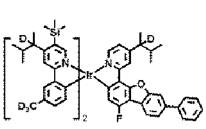
2587

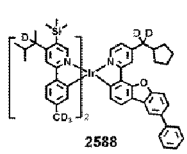
2588

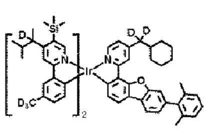
2589

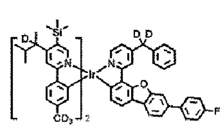
2590

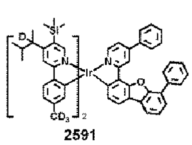
2591

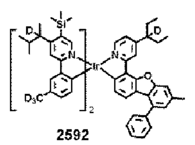
2592

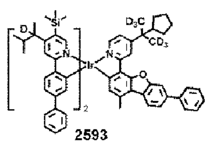
2593

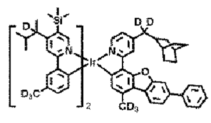
2594

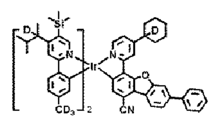
2595

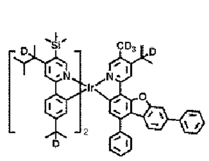
2596

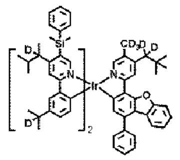
2597

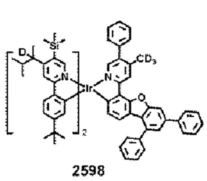
2598

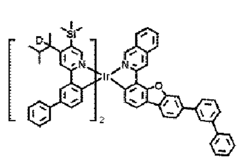
2599

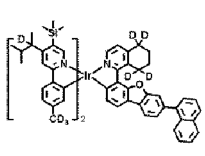
2600

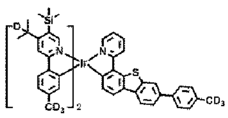
2601
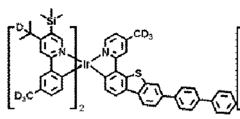
2602
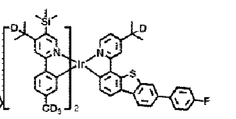
2603
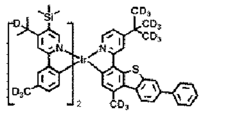
2604
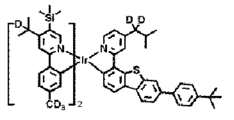
2605

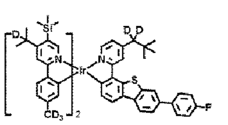
2606
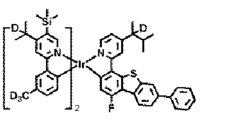
2607
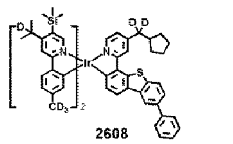
2608
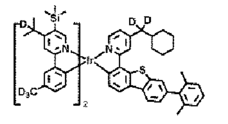
2609
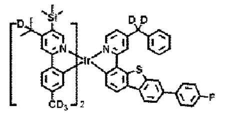
2610

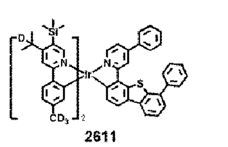
2611
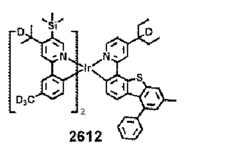
2612
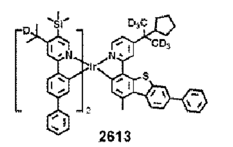
2613
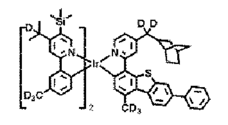
2614
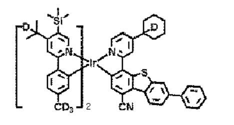
2615

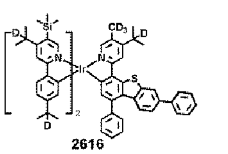
2616
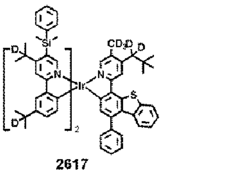
2617
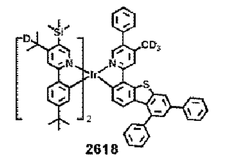
2618
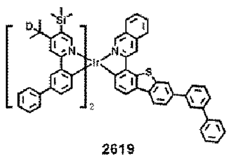
2619
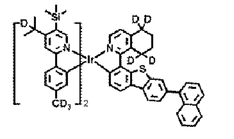
2620

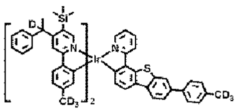
2621
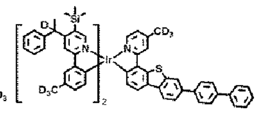
2622
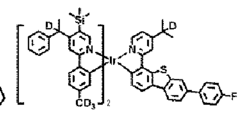
2623
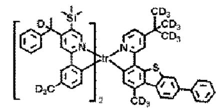
2624
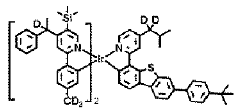
2625

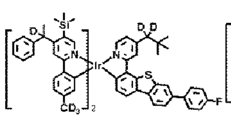
2626
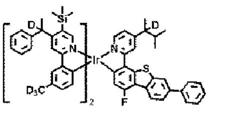
2627
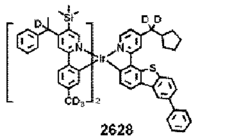
2628
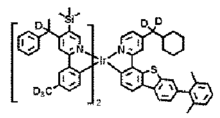
2629
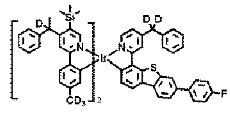
2630

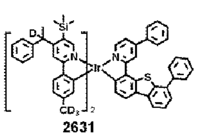
2631
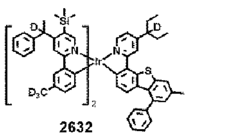
2632
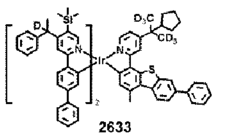
2633
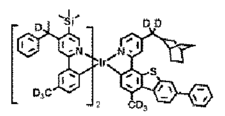
2634
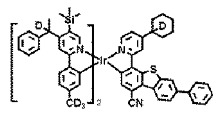
2635

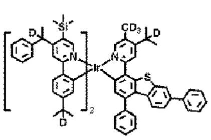
2636
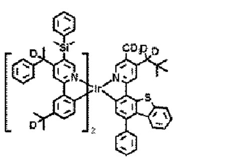
2637
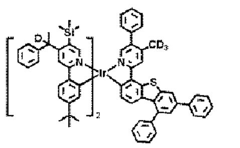
2638
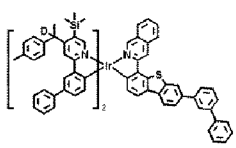
2639
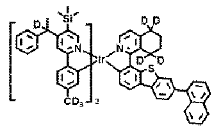
2640

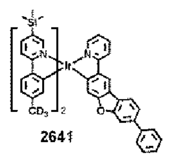
2641
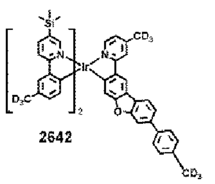
2642
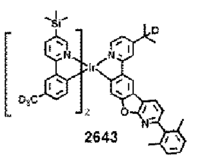
2643
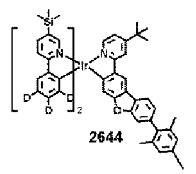
2644
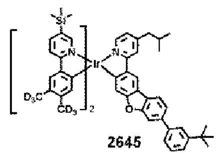
2645
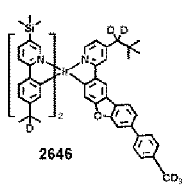
2646
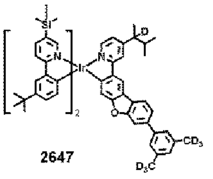
2647
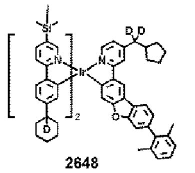
2648
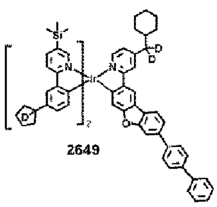
2649
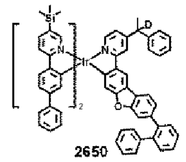
2650
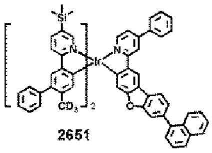
2651
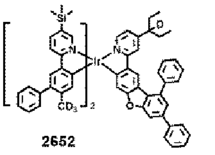
2652
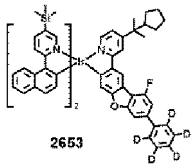
2653
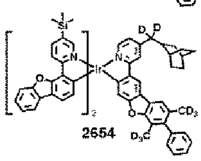
2654
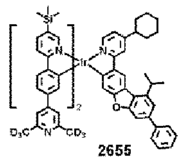
2655
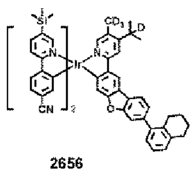
2656
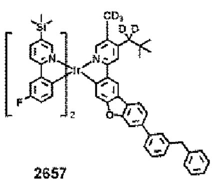
2657
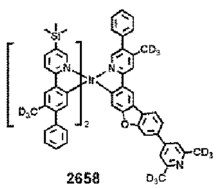
2658
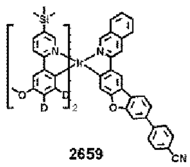
2659
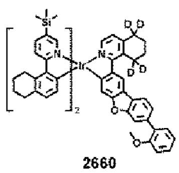
2660
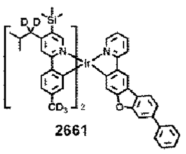
2661
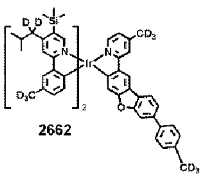
2662
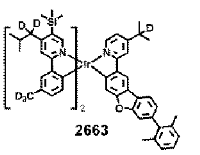
2663
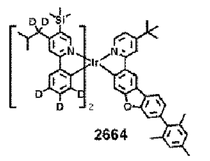
2664
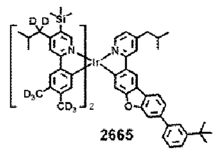
2665
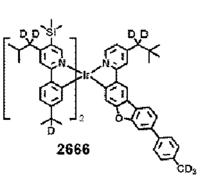
2666
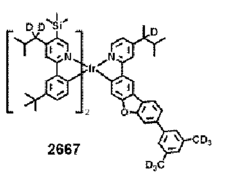
2667
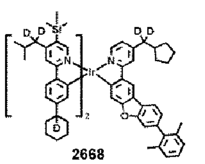
2668
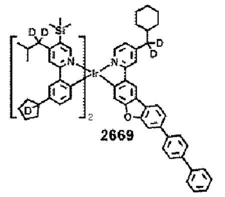
2669
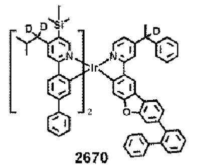
2670
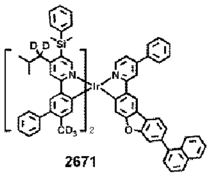
2671
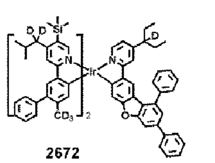
2672
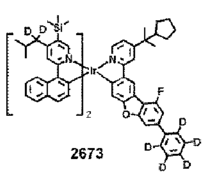
2673
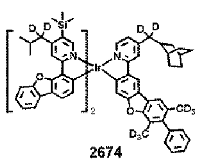
2674
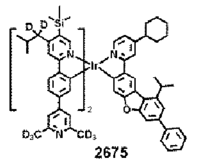
2675
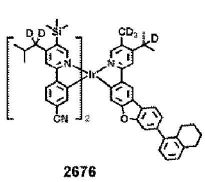
2676
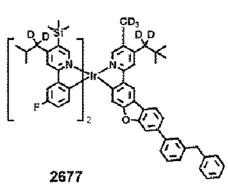
2677
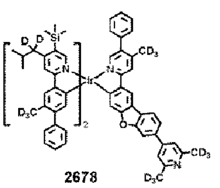
2678
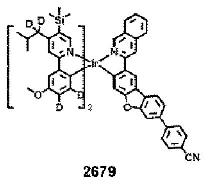
2679
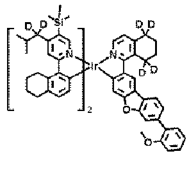
2680

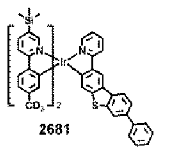
2681

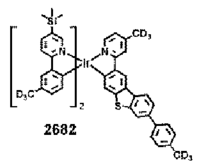
2682

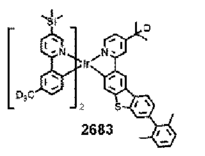
2683

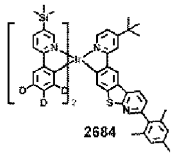
2684

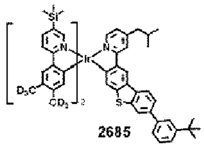
2685

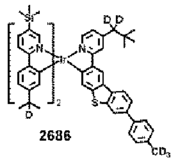
2686

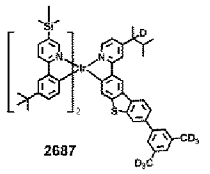
2687

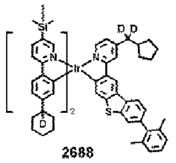
2688

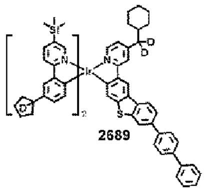
2689

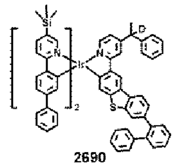
2690

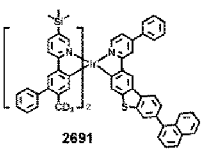
2691

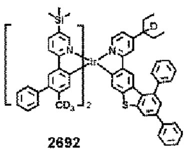
2692

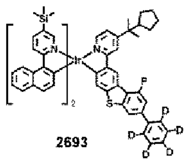
2693

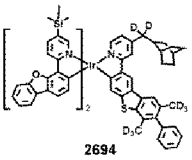
2694

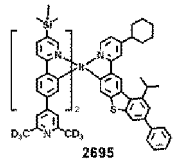
2695

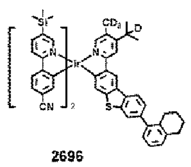
2696

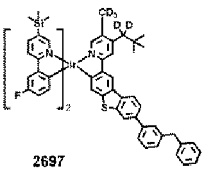
2697

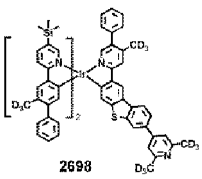
2698

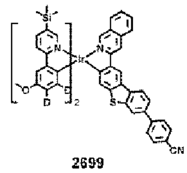
2699

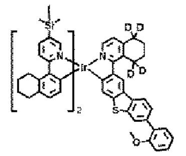
2700

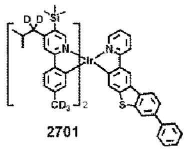
2701

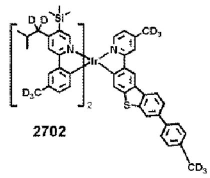
2702

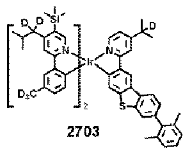
2703

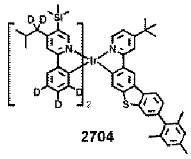
2704

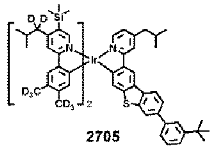
2705

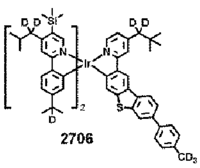
2706

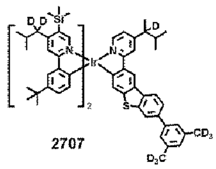
2707

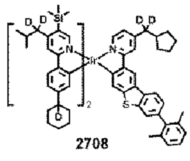
2708

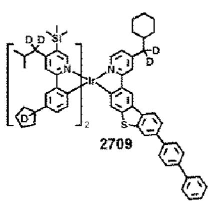
2709

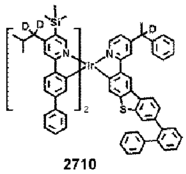
2710

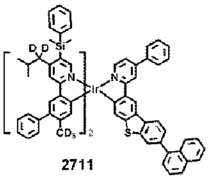
2711

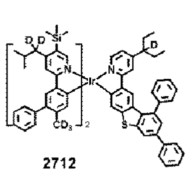
2712

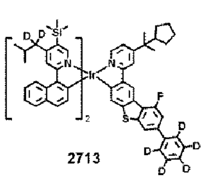
2713

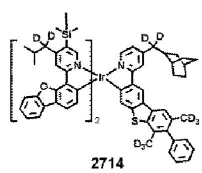
2714

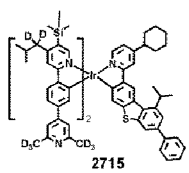
2715

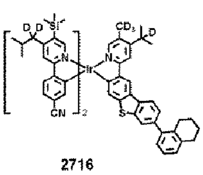
2716

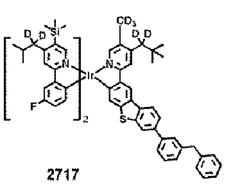
2717

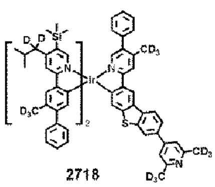
2718

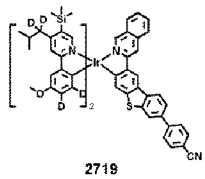
2719

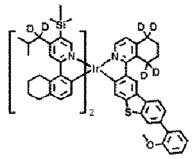
2720

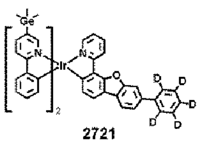
2721
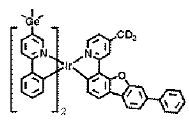
2722
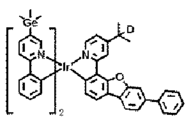
2723
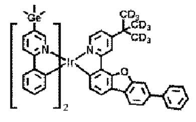
2724
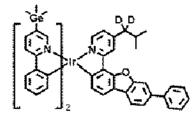
2725

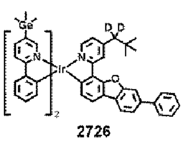
2726
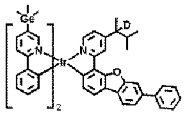
2727
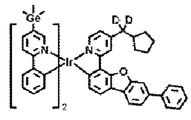
2728
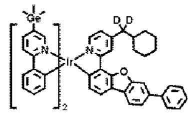
2729
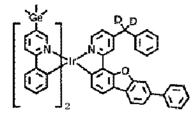
2730

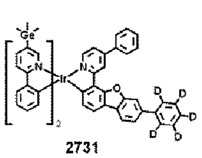
2731
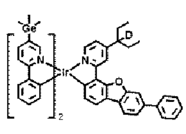
2732
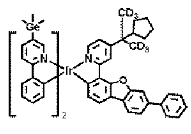
2733
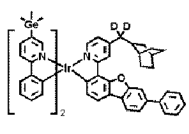
2734
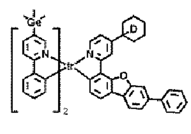
2735

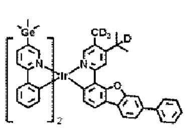
2736
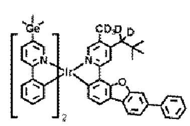
2737
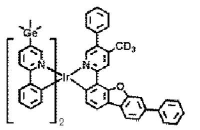
2738
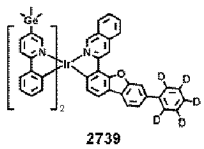
2739
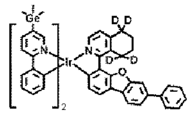
2740

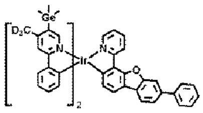
2741
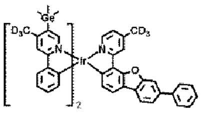
2742
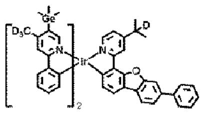
2743
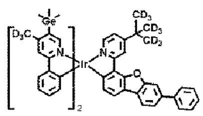
2744
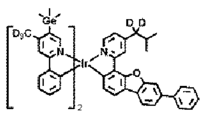
2745

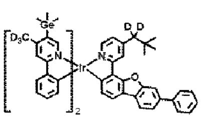
2746
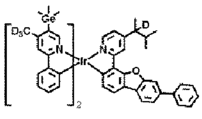
2747
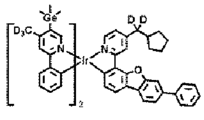
2748
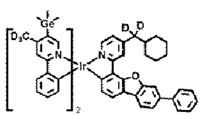
2749
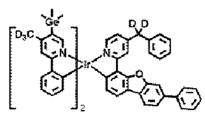
2750

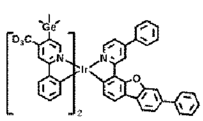
2751
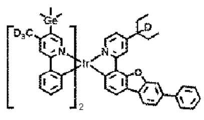
2752
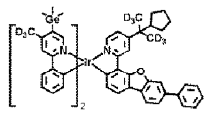
2753
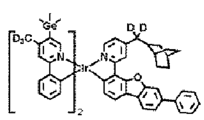
2754
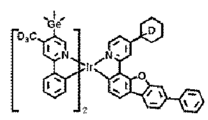
2755

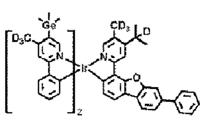
2756
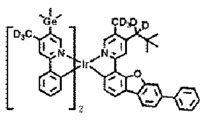
2757
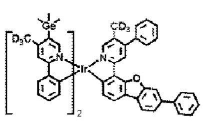
2758
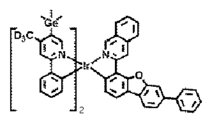
2759
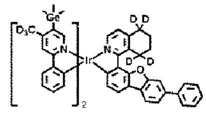
2760

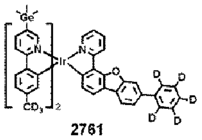
2761
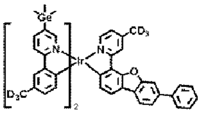
2762
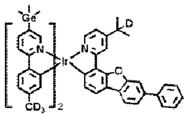
2763
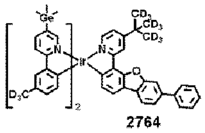
2764
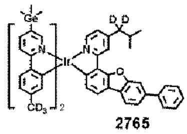
2765

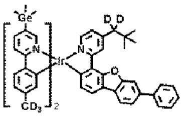
2766
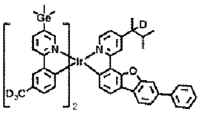
2767
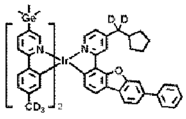
2768
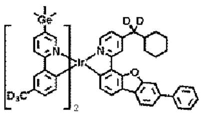
2769
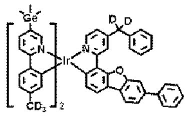
2770

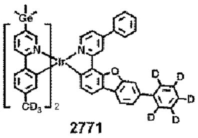
2771
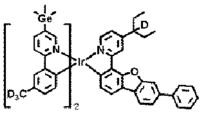
2772
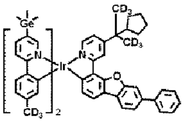
2773
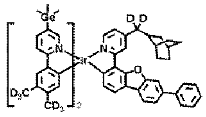
2774
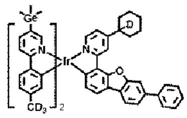
2775

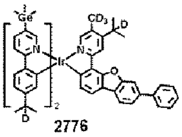
2776
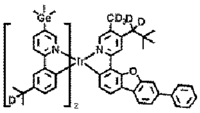
2777
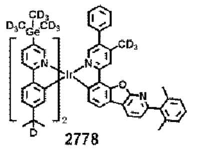
2778
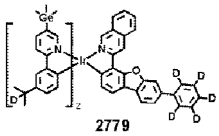
2779
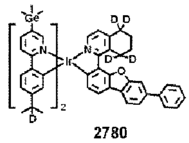
2780

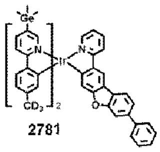
2781
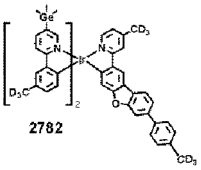
2782
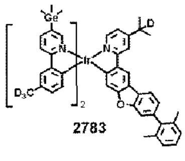
2783
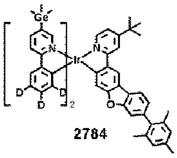
2784
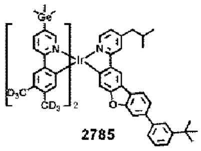
2785

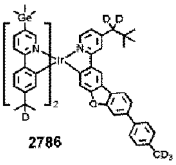
2786
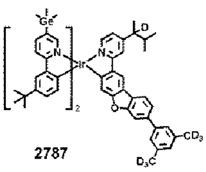
2787
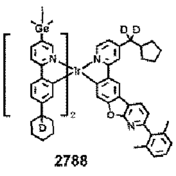
2788
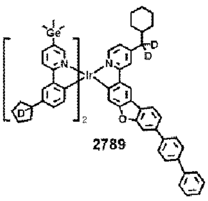
2789
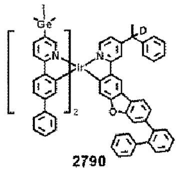
2790

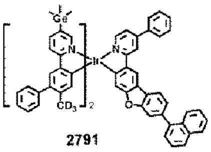
2791
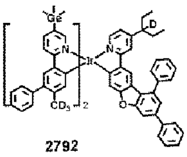
2792
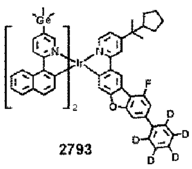
2793
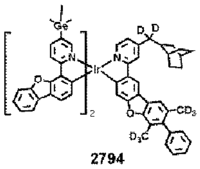
2794
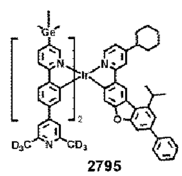
2795

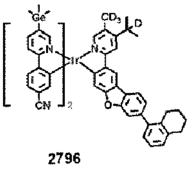
2796
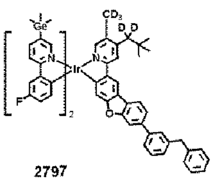
2797
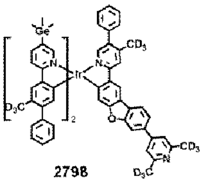
2798
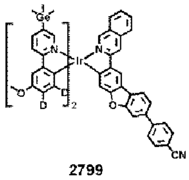
2799
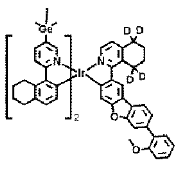
2800

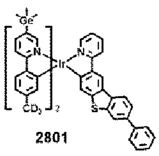
2801
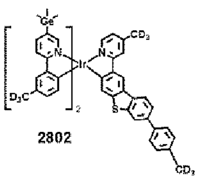
2802
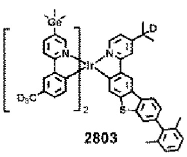
2803
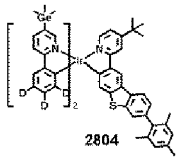
2804
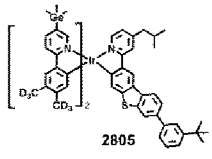
2805

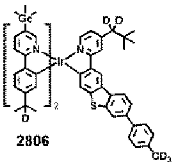
2806
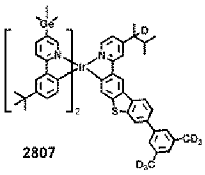
2807
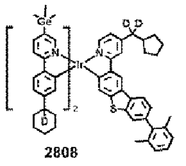
2808
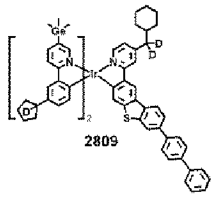
2809
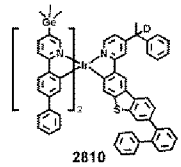
2810

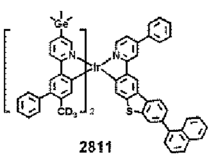
2811
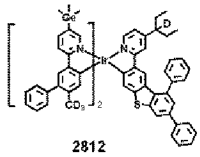
2812
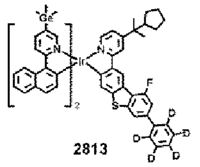
2813
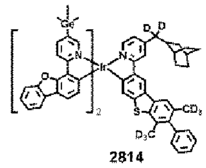
2814
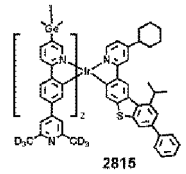
2815

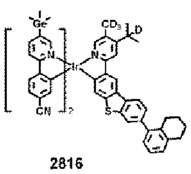
2816
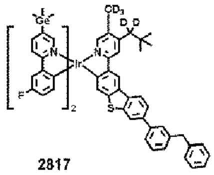
2817
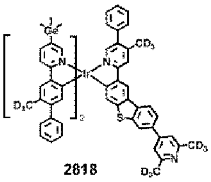
2818
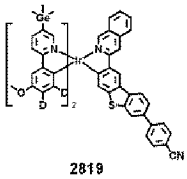
2819
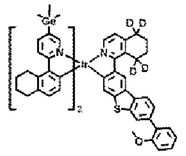
2820

## Group G1-7

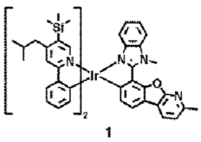
1
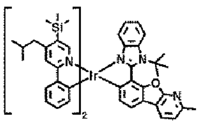
2
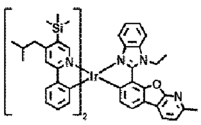
3
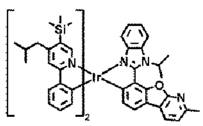
4
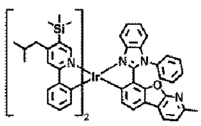
5

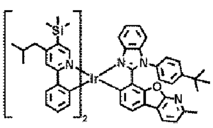
6
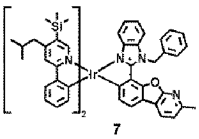
7
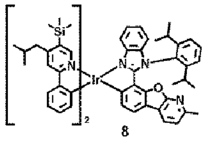
8
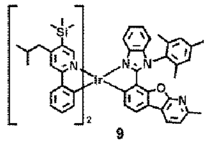
9
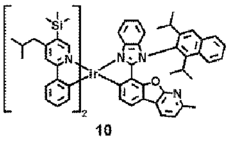
10

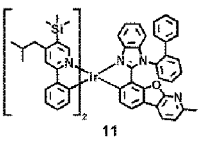
11
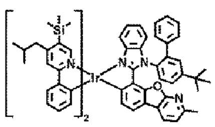
12
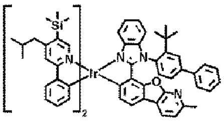
13
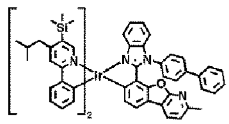
14
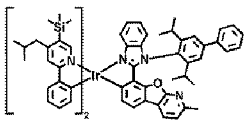
15

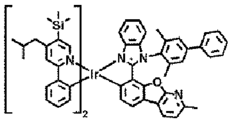
16
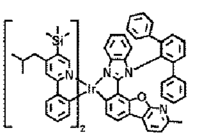
17
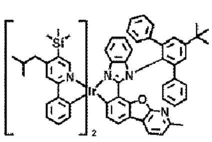
18
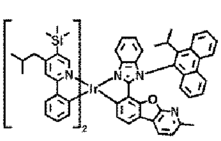
19
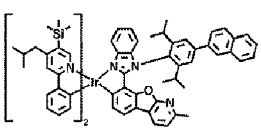
20

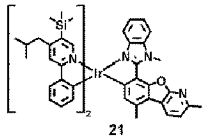
21
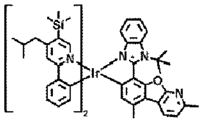
22
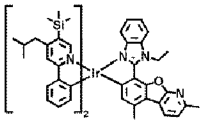
23
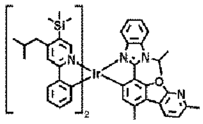
24
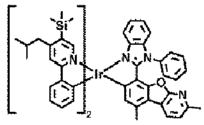
25

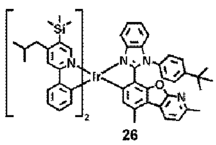
26
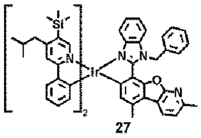
27
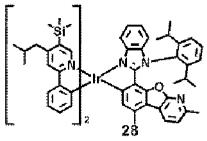
28
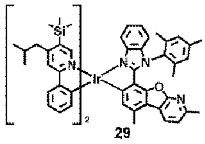
29
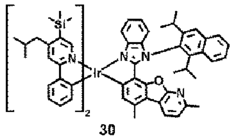
30

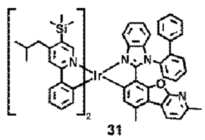
31
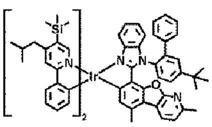
32
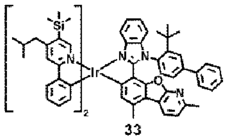
33
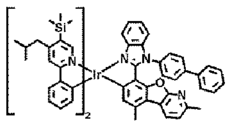
34
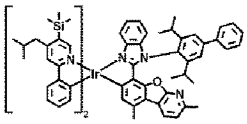
35

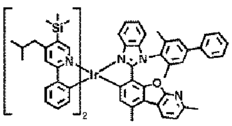
36
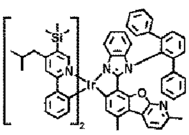
37
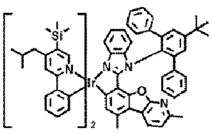
38
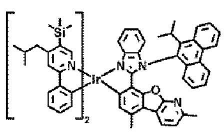
39
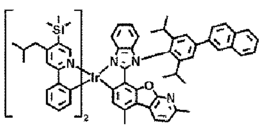
40

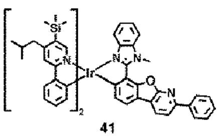
41
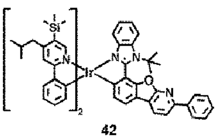
42
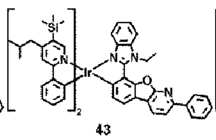
43
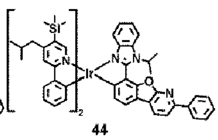
44
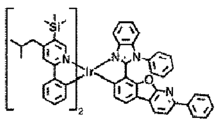
45

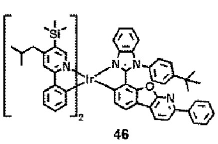
46
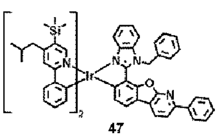
47
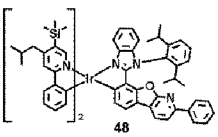
48
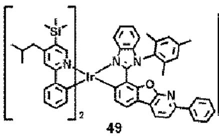
49
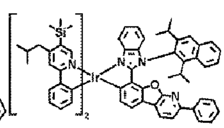
50

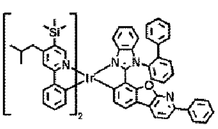
51
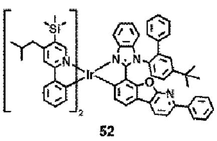
52
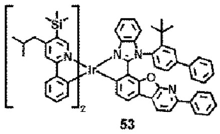
53
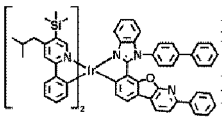
54
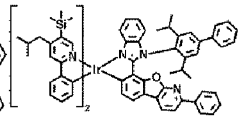
55

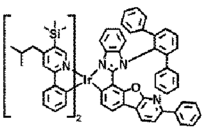
56
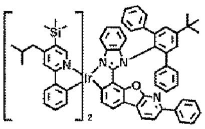
57
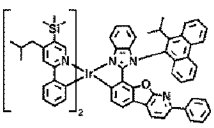
58
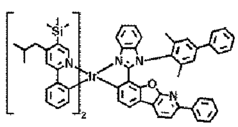
59
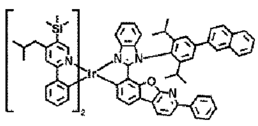
60

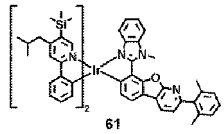
61

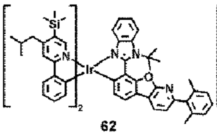
62

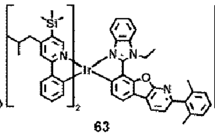
63

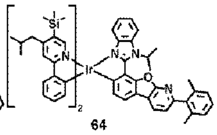
64

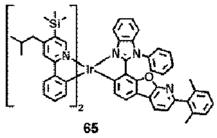
65

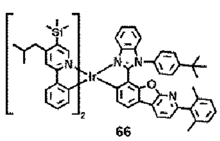
66

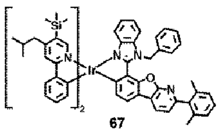
67

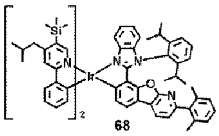
68

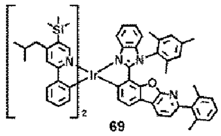
69

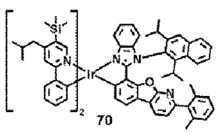
70

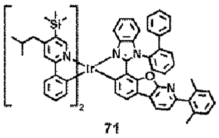
71

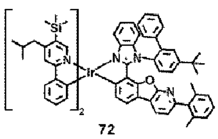
72

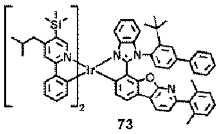
73

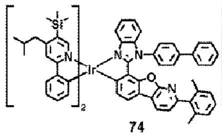
74

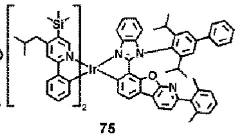
75

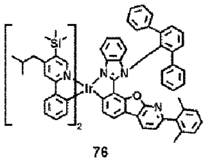
76

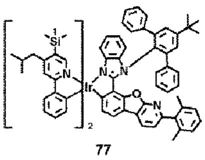
77

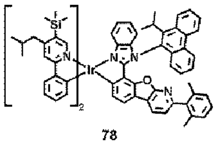
78

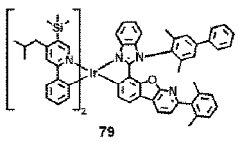
79

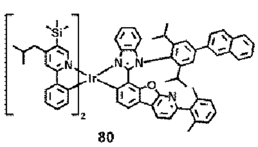
80

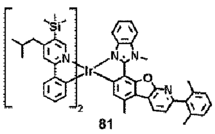
81

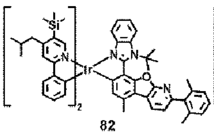
82

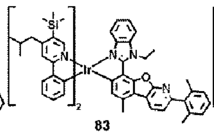
83

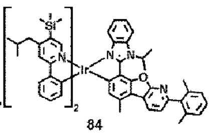
84

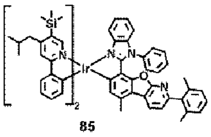
85

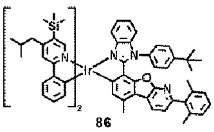
86

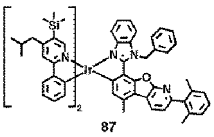
87

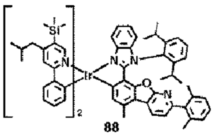
88

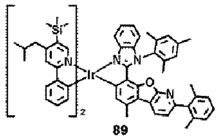
89

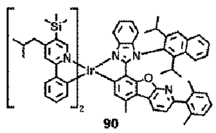
90

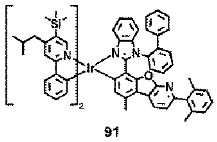
91

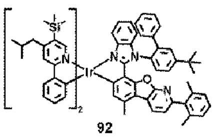
92

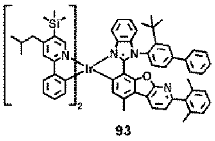
93

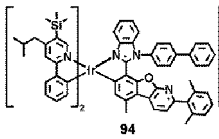
94

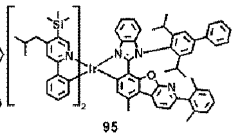
95

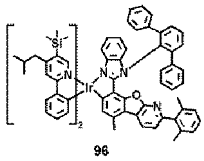
96

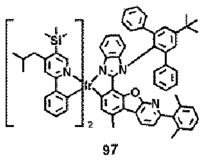
97

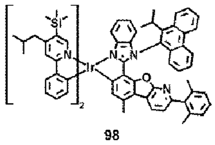
98

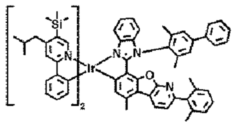
99

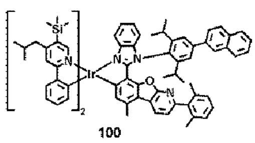
100

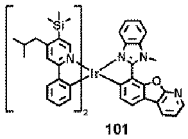
101
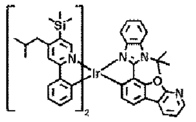
102
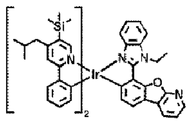
103
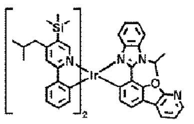
104
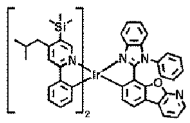
105
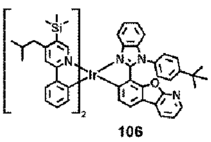
106
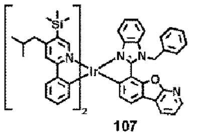
107
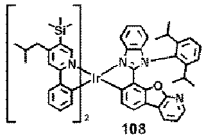
108
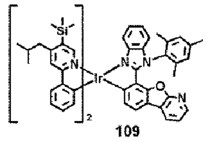
109
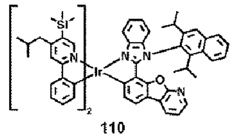
110
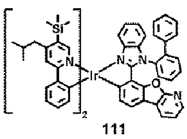
111
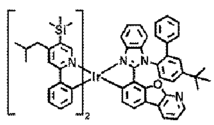
112
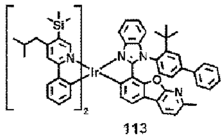
113
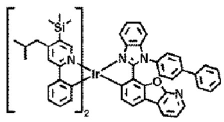
114
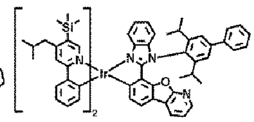
115
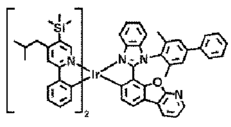
116
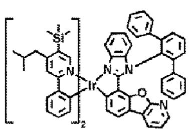
117
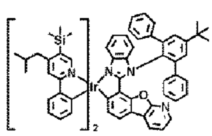
118
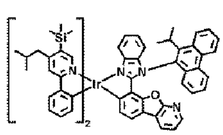
119
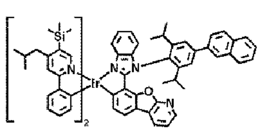
120
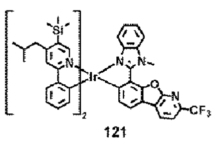
121
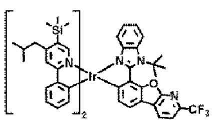
122
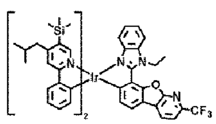
123
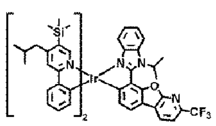
124
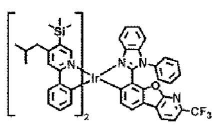
125
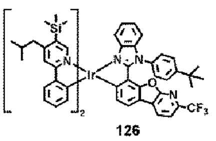
126
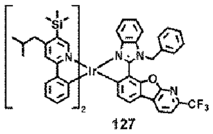
127
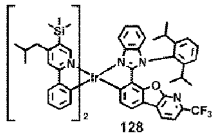
128
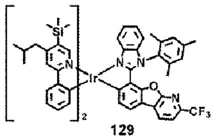
129
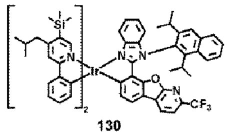
130
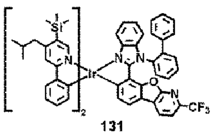
131
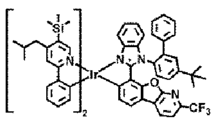
132
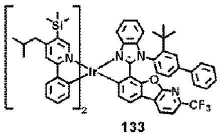
133
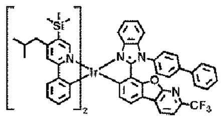
134
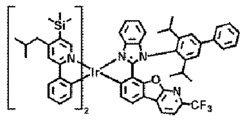
135
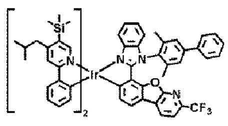
136
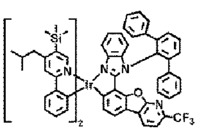
137
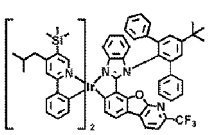
138
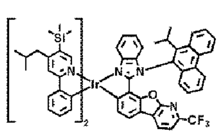
139
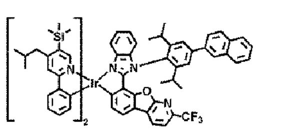
140

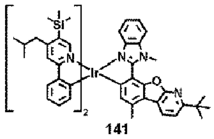
141
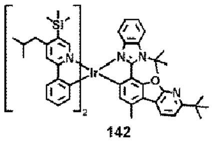
142
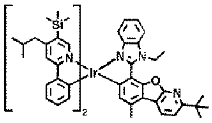
143
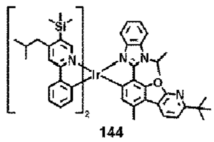
144
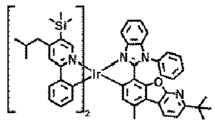
145

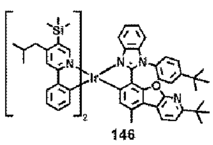
146
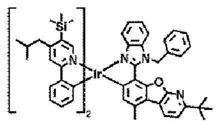
147
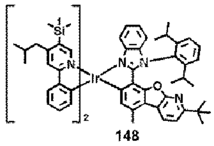
148
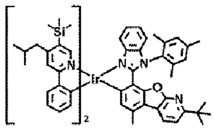
149
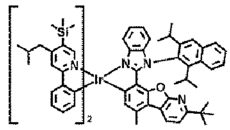
150

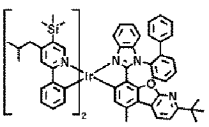
151
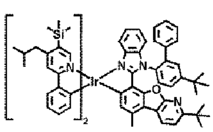
152
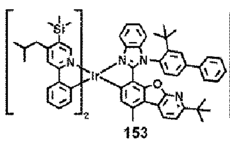
153
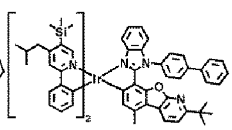
154
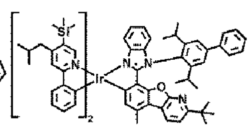
155

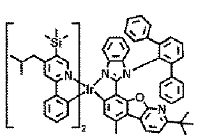
156
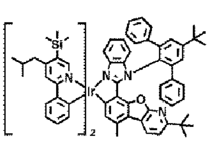
157
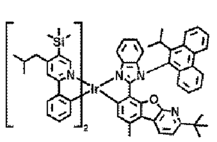
158
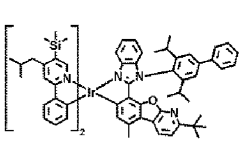
159
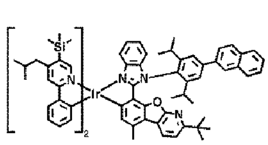
160

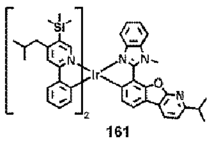
161
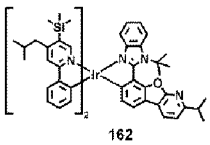
162
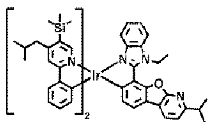
163
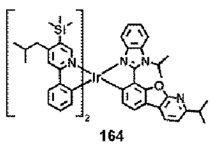
164
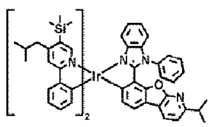
165

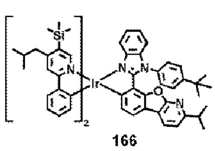
166
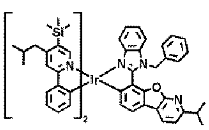
167
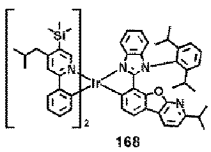
168
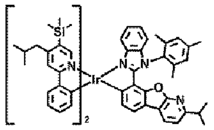
169
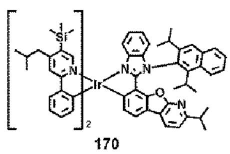
170

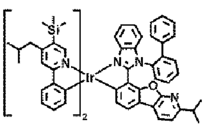
171
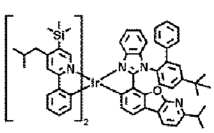
172
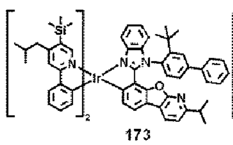
173
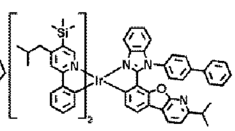
174
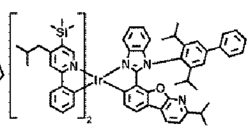
175

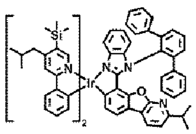
176
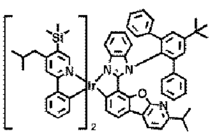
177
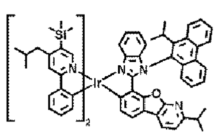
178
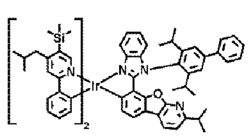
179
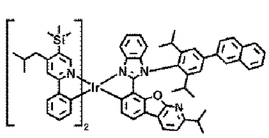
180

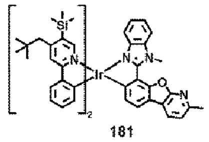
181

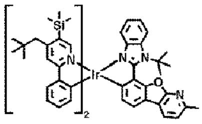
182

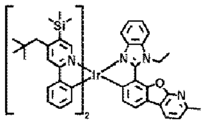
183

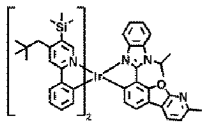
184

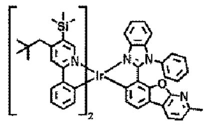
185

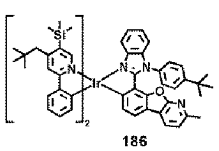
186

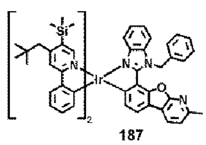
187

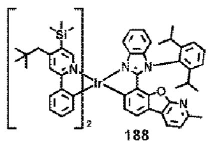
188

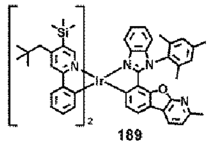
189

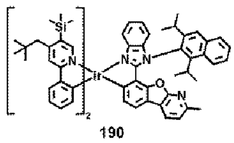
190

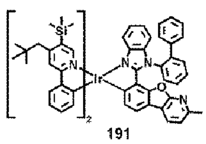
191

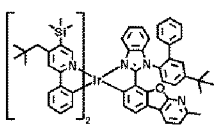
192

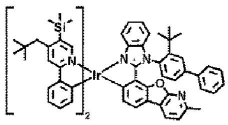
193

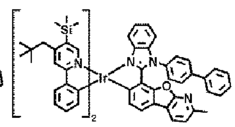
194

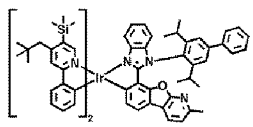
195

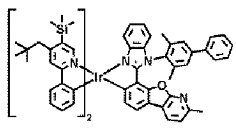
196

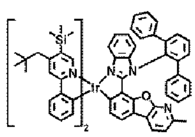
197

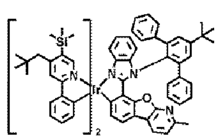
198

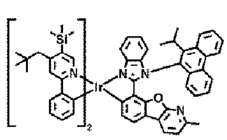
199

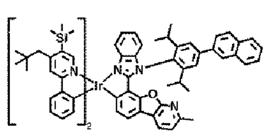
200

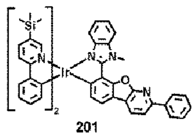
201

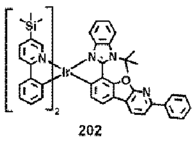
202

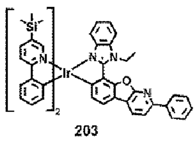
203

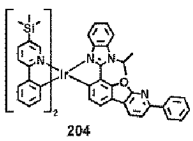
204

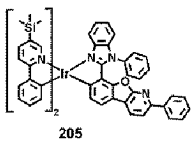
205

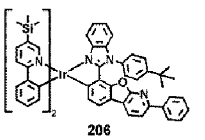
206

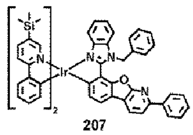
207

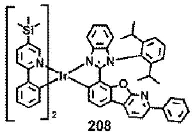
208

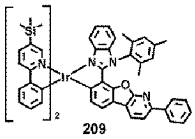
209

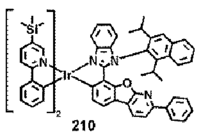
210

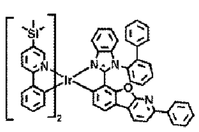
211

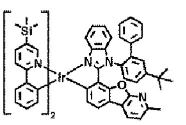
212

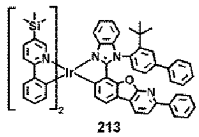
213

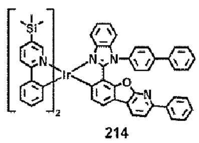
214

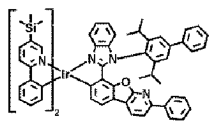
215

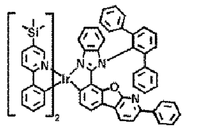
216

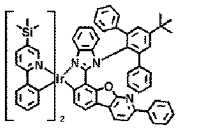
217

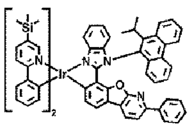
218

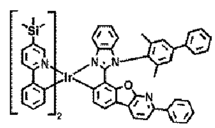
219

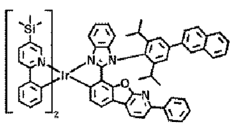
220

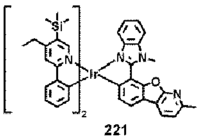
221
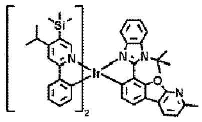
222
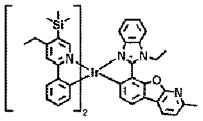
223
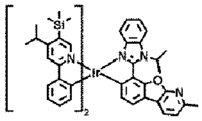
224
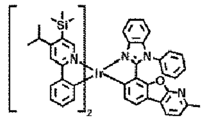
225
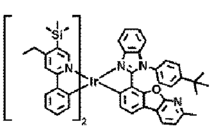
226
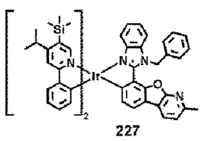
227
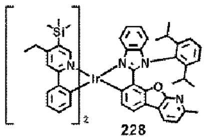
228
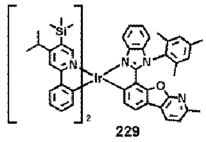
229
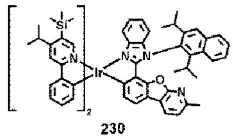
230
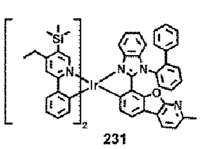
231
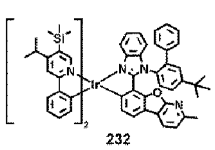
232
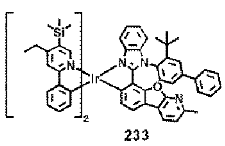
233
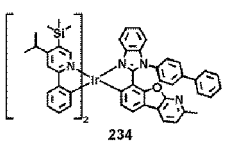
234
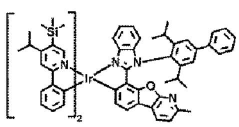
235
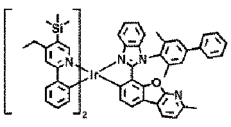
236
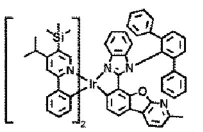
237
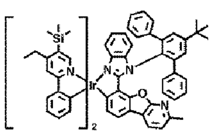
238
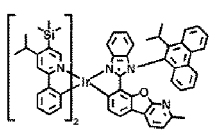
239
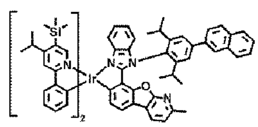
240
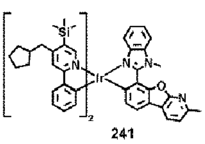
241
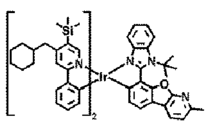
242
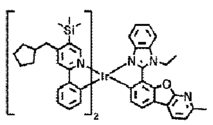
243
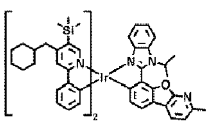
244
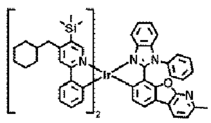
245
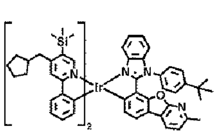
246
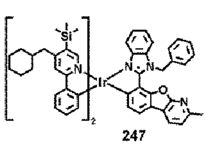
247
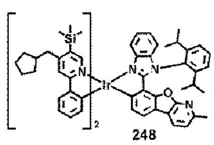
248
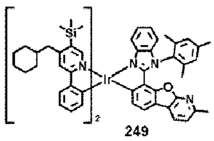
249
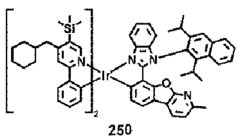
250
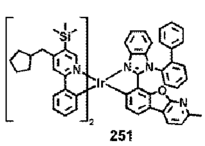
251
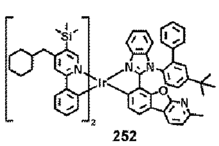
252
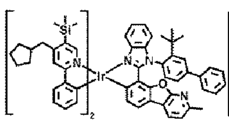
253
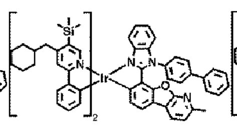
254
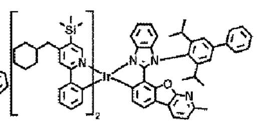
255
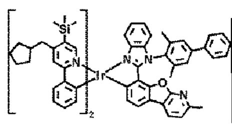
256
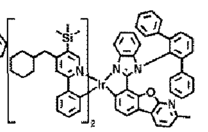
257
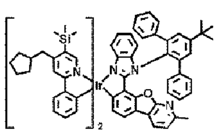
258
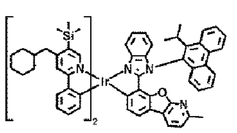
259
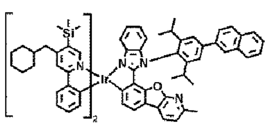
260

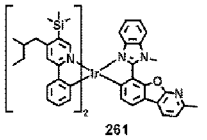
261
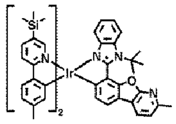
262
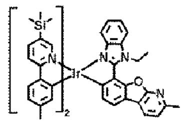
263
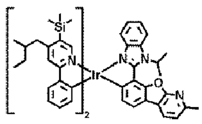
264
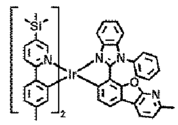
265
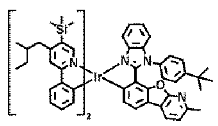
266
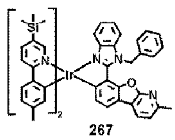
267
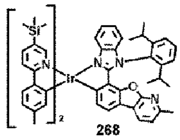
268
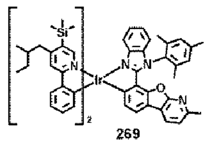
269
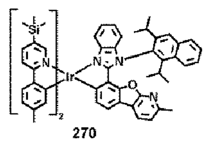
270
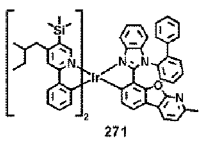
271
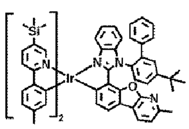
272
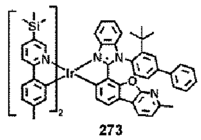
273
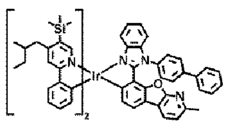
274
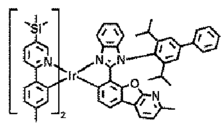
275
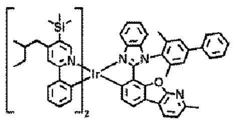
276
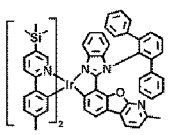
277
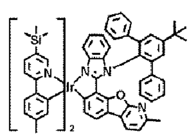
278
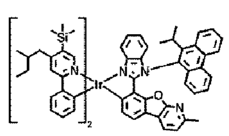
279
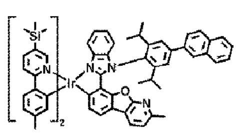
280
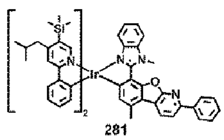
281
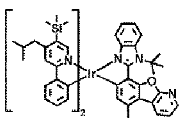
282
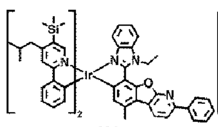
283
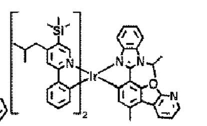
284
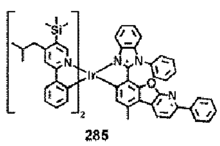
285
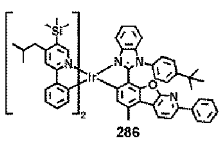
286
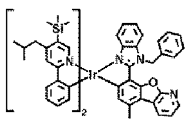
287
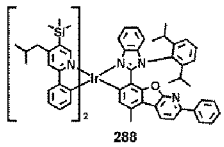
288
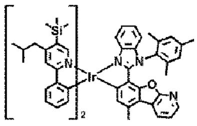
289
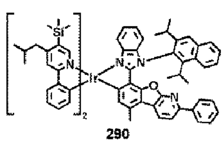
290
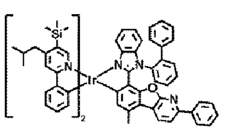
291
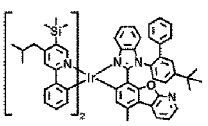
292
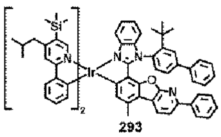
293
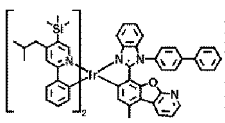
294
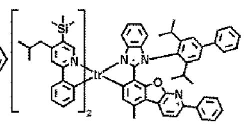
295
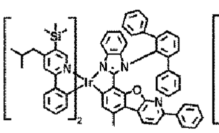
296
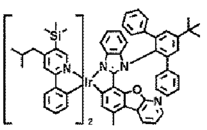
297
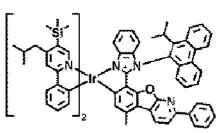
298
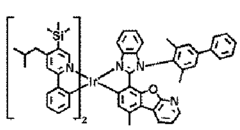
299
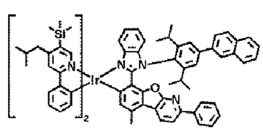
300

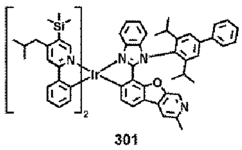
301

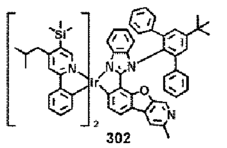
302

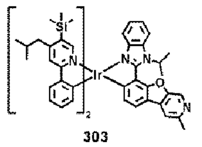
303

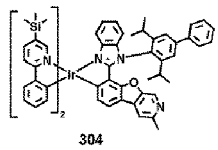
304

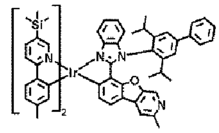
305

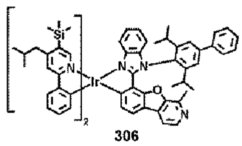
306

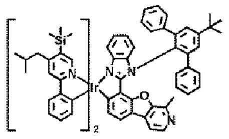
307

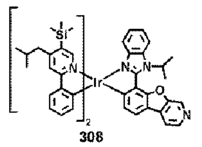
308

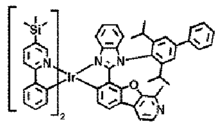
309

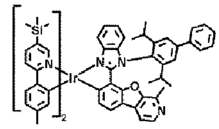
310

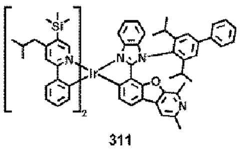
311

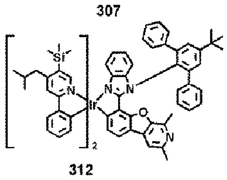
312

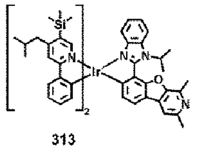
313

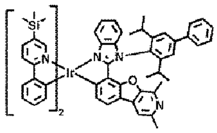
314

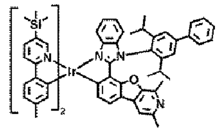
315

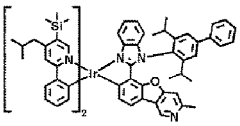
316

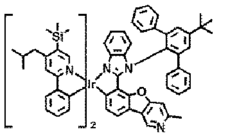
317

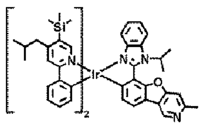
318

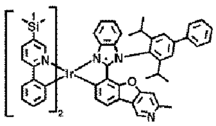
319

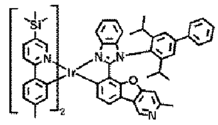
320

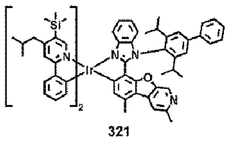
321

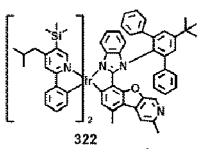
322

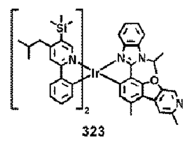
323

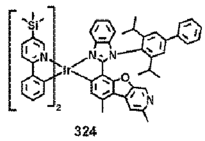
324

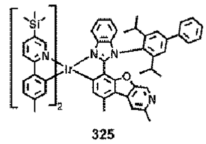
325

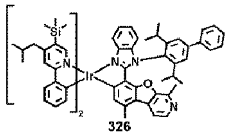
326

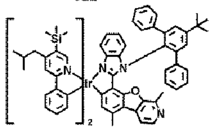
327

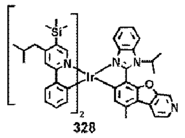
328

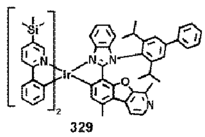
329

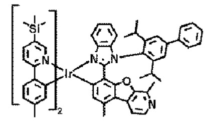
330

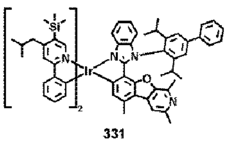
331

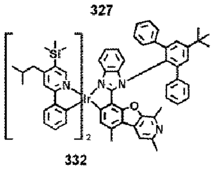
332

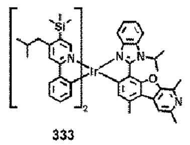
333

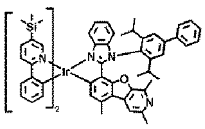
334

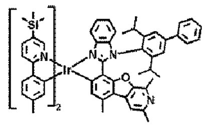
335

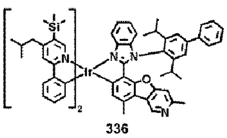
336

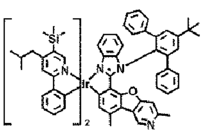
337

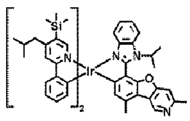
338

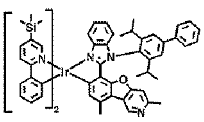
339

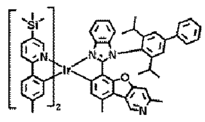
340

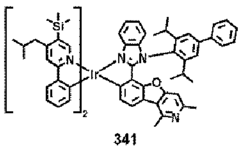
341
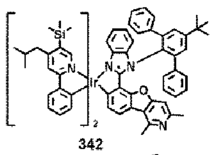
342
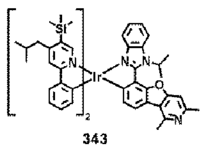
343
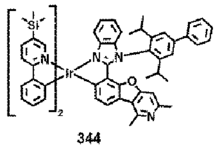
344
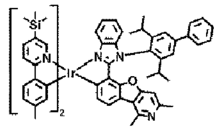
345

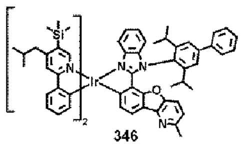
346
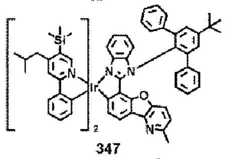
347
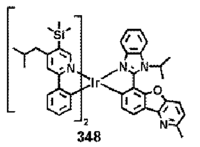
348
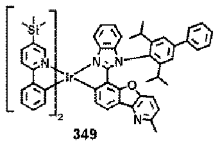
349
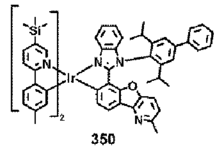
350

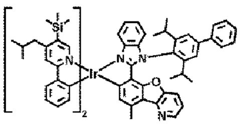
351
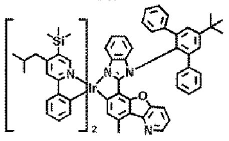
352
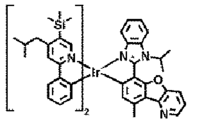
353
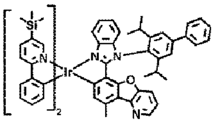
354
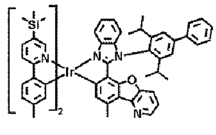
355

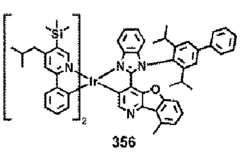
356
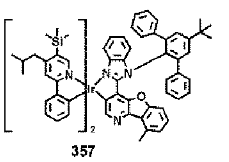
357
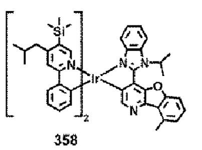
358
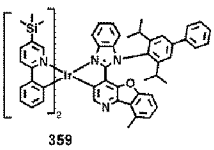
359
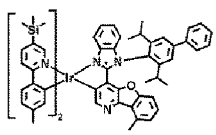
360

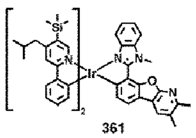
361
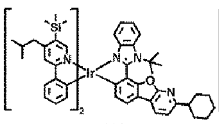
362
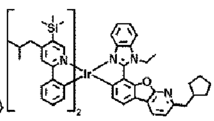
363
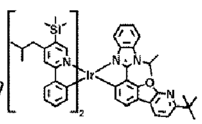
364
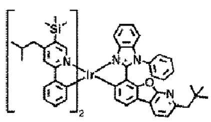
365

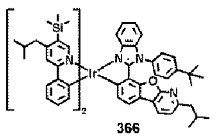
366
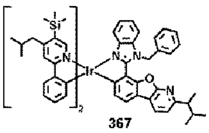
367
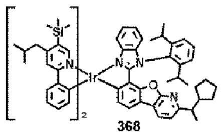
368
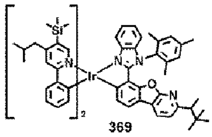
369
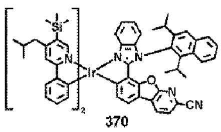
370

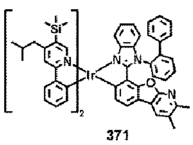
371
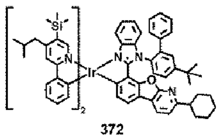
372
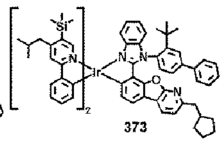
373
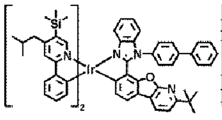
374
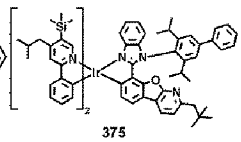
375

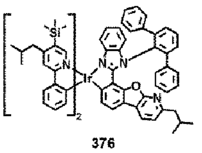
376
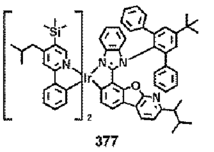
377
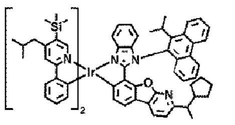
378
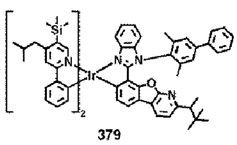
379
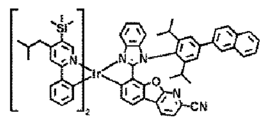
380

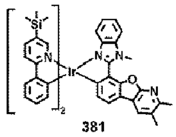
381
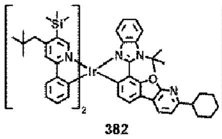
382
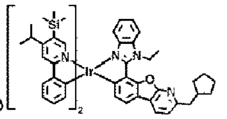
383
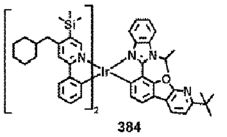
384
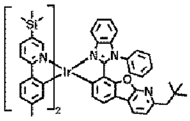
385
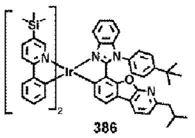
386
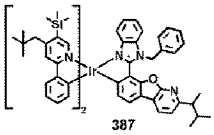
387
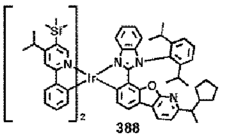
388
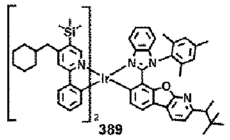
389
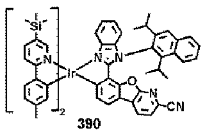
390
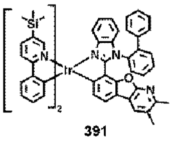
391
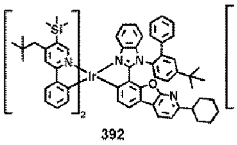
392
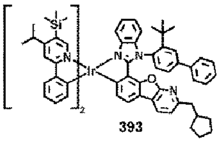
393
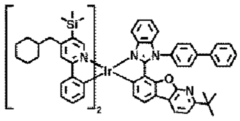
394
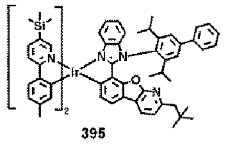
395
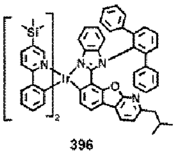
396
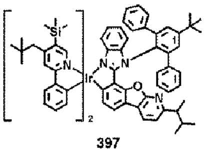
397
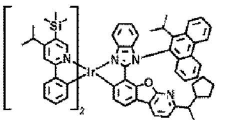
398
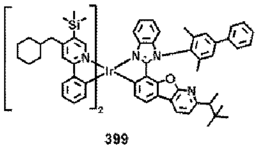
399
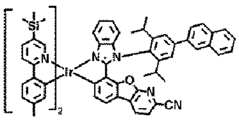
400
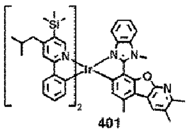
401
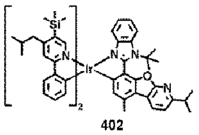
402
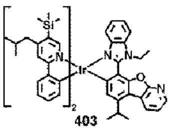
403
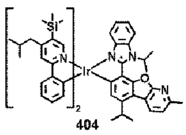
404
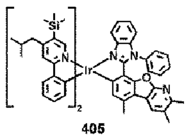
405
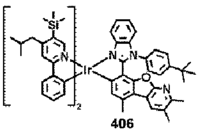
406
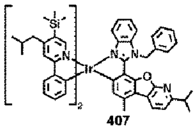
407
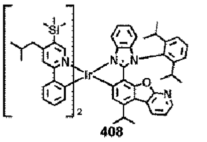
408
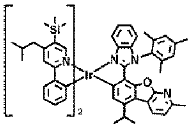
409
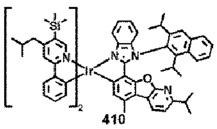
410
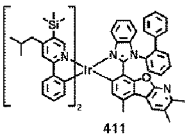
411
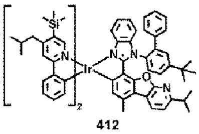
412
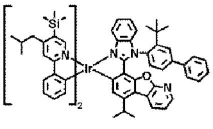
413
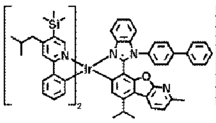
414
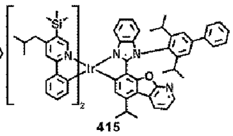
415
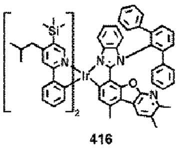
416
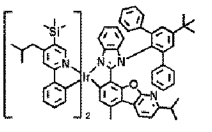
417
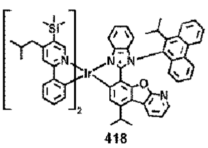
418
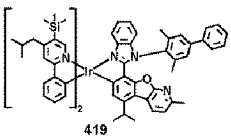
419
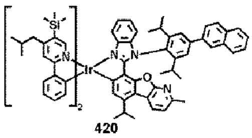
420

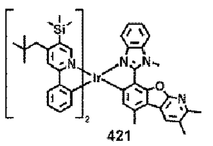
421
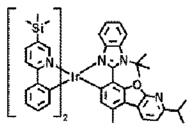
422
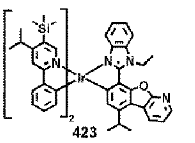
423
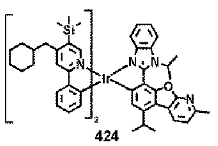
424
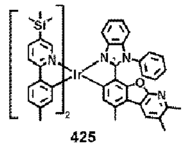
425

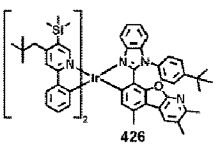
426
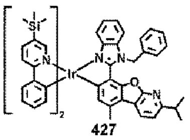
427
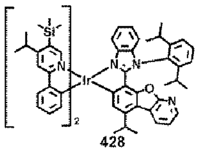
428
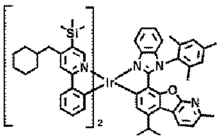
429
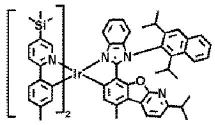
430

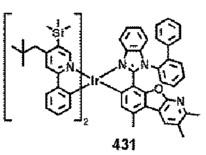
431
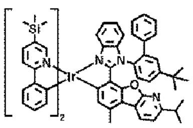
432
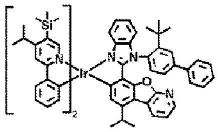
433
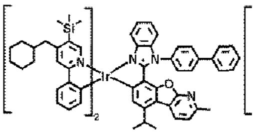
434
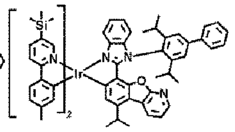
435

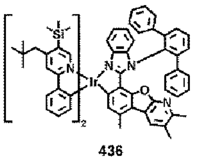
436
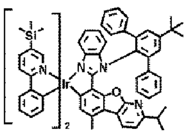
437
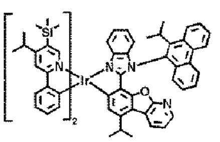
438
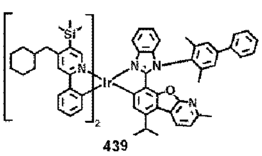
439
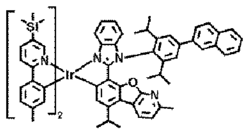
440

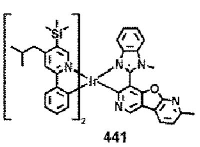
441
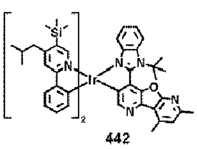
442
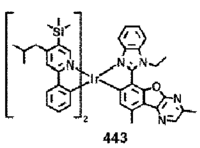
443
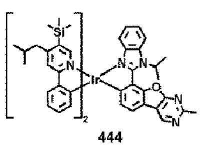
444
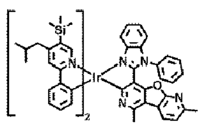
445

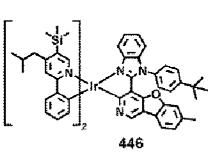
446
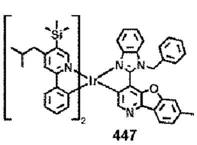
447
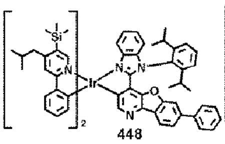
448
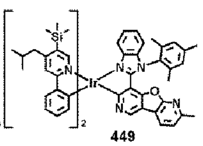
449
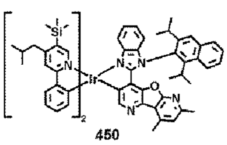
450

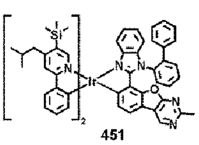
451
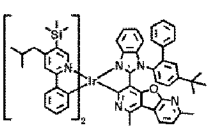
452
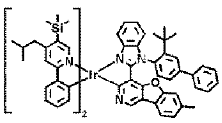
453
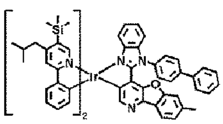
454
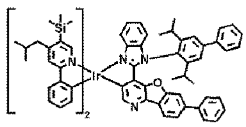
455

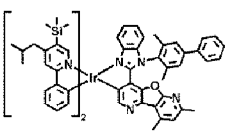
456
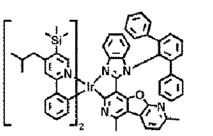
457
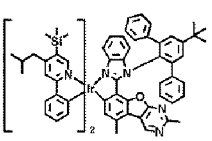
458
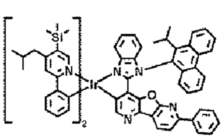
459
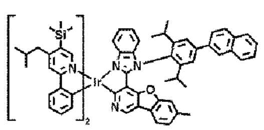
460

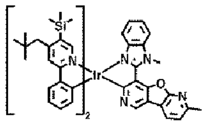
461
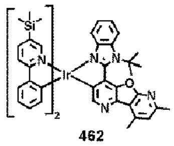
462
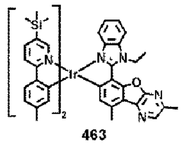
463
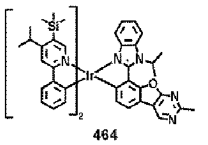
464
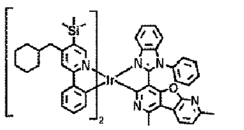
465
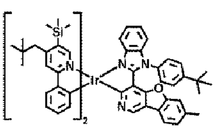
466
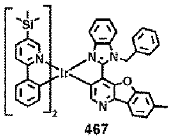
467
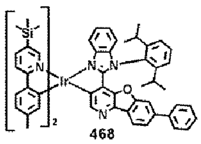
468
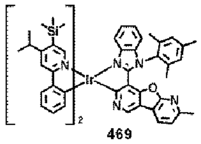
469
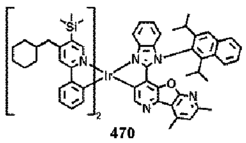
470
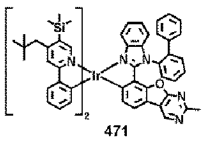
471
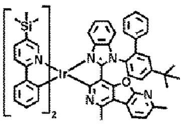
472
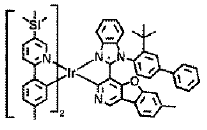
473
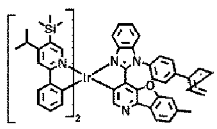
474
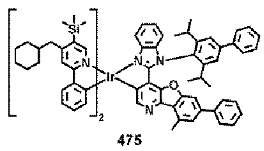
475
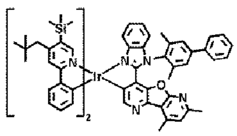
476
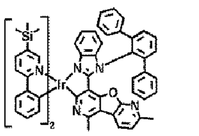
477
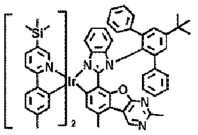
478
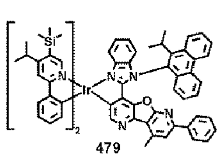
479
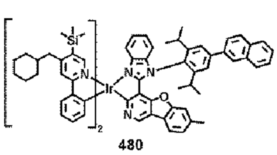
480
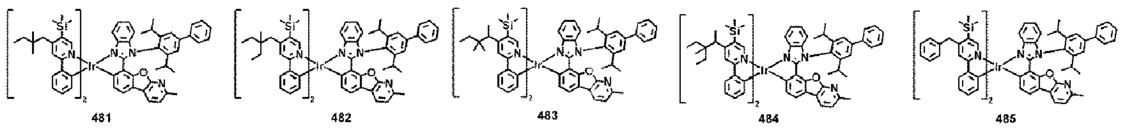
481 482 483 484 485
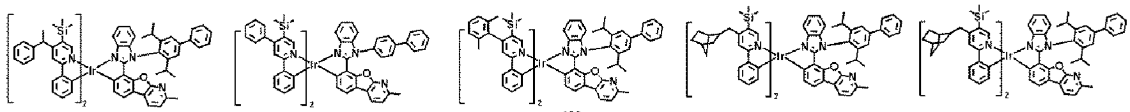
486 487 488 489 490
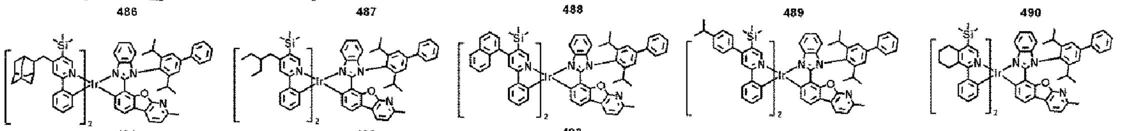
491 492 493 494 495
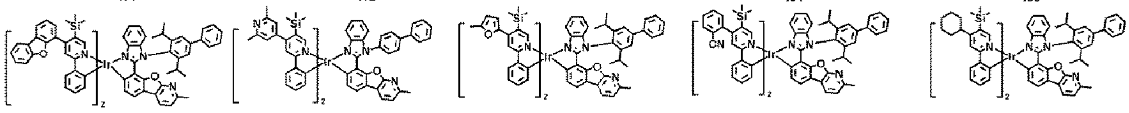
496 497 498 499 500
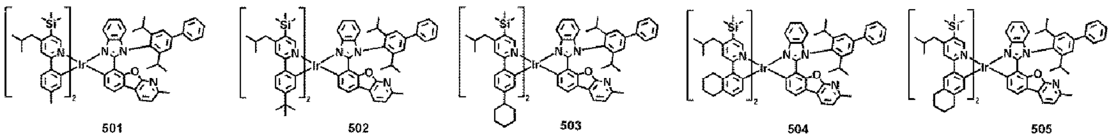
501 502 503 504 505
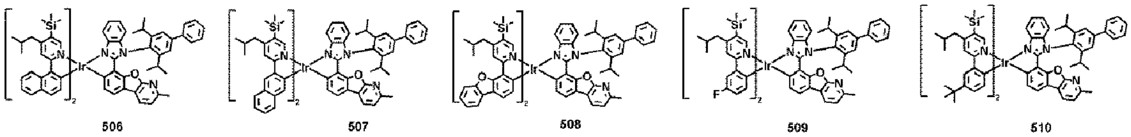
506 507 508 509 510
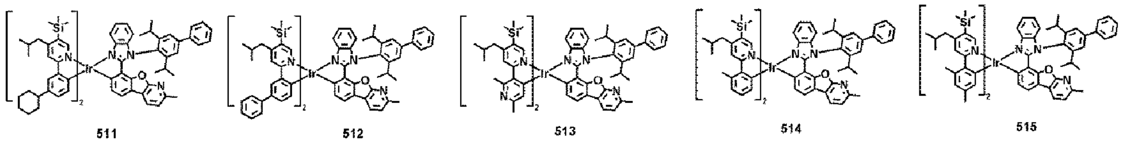
511 512 513 514 515
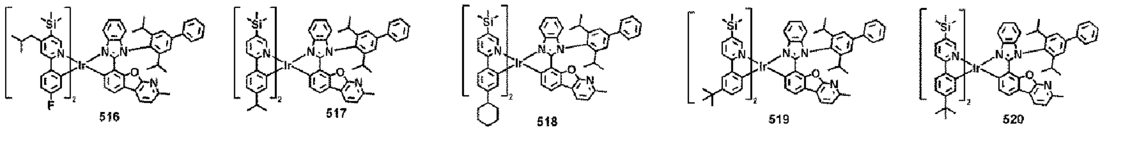
516 517 518 519 520

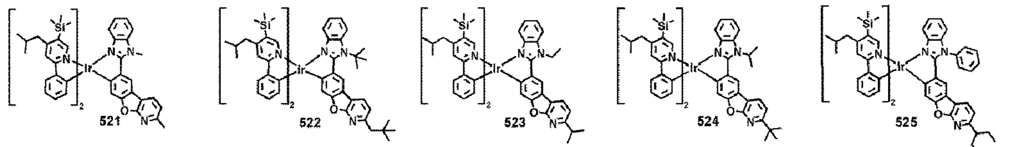

521 522 523 524 525

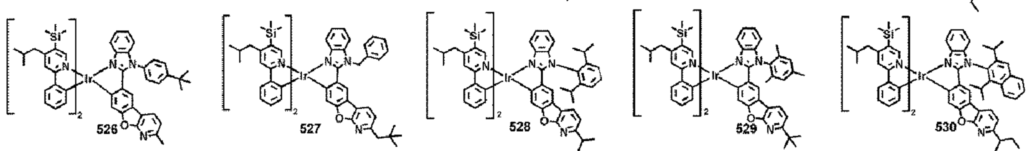

526 527 528 529 530

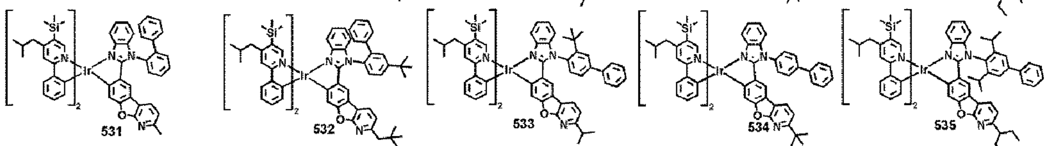

531 532 533 534 535

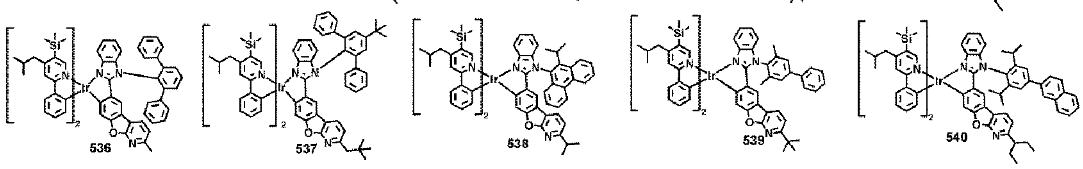

536 537 538 539 540

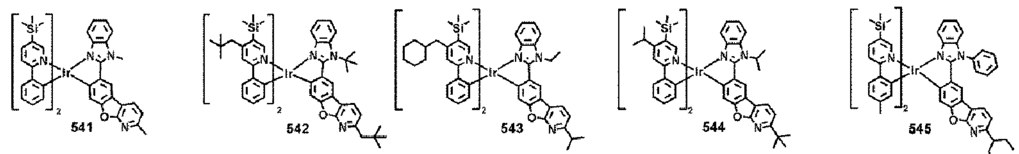

541 542 543 544 545

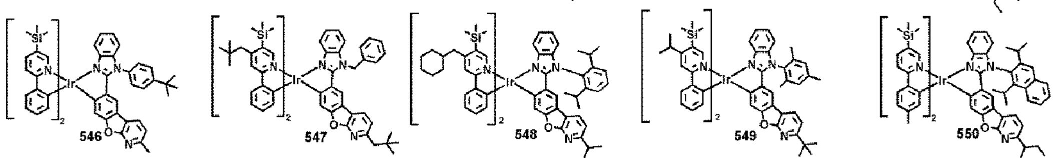

546 547 548 549 550

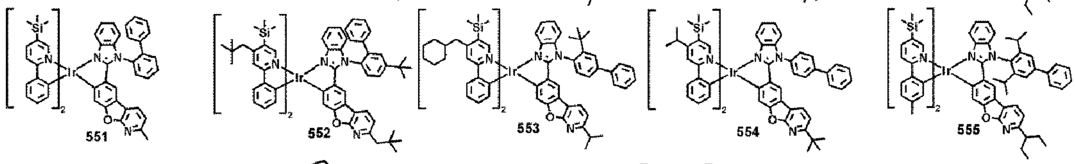

551 552 553 554 555

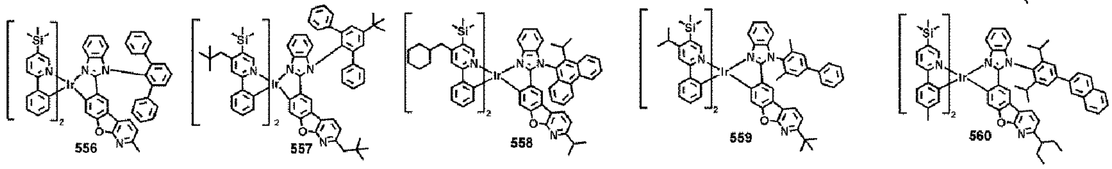

556 557 558 559 560

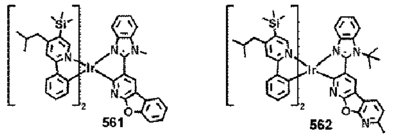
561
562
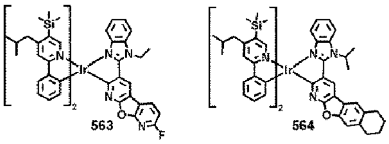
563
564
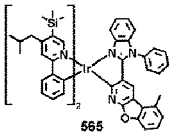
565
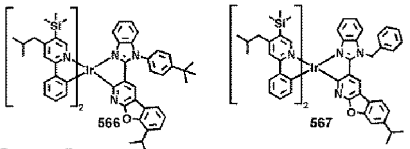
566
567
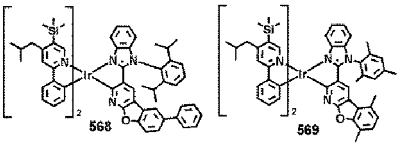
568
569
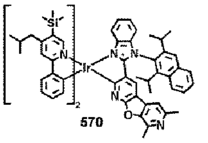
570
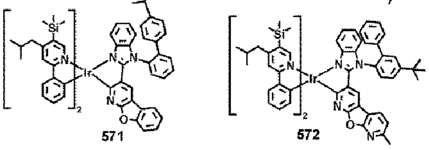
571
572
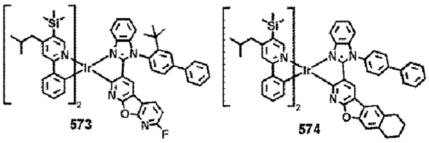
573
574
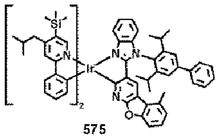
575
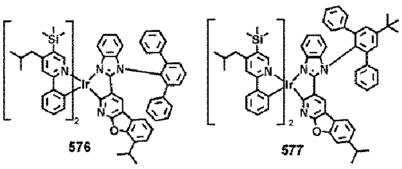
576
577
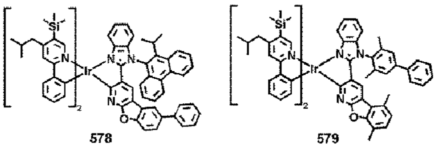
578
579
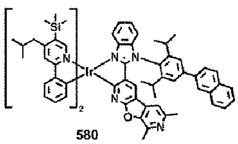
580
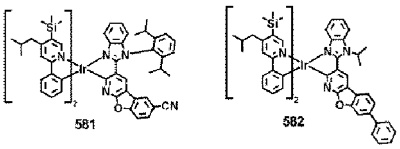
581
582
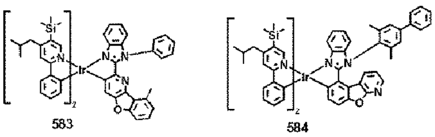
583
584
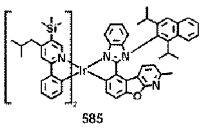
585
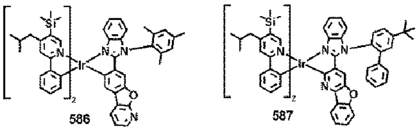
586
587
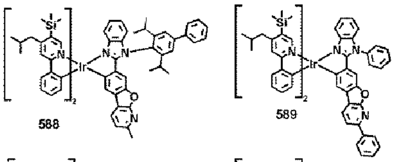
588
589
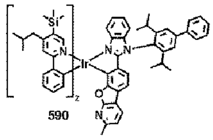
590
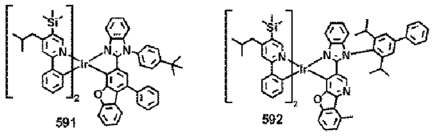
591
592
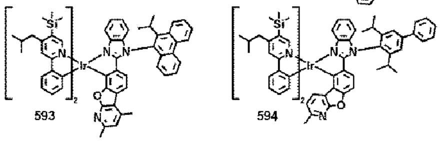
593
594
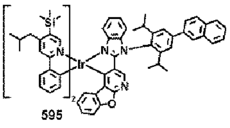
595
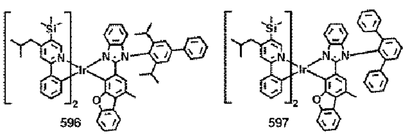
596
597
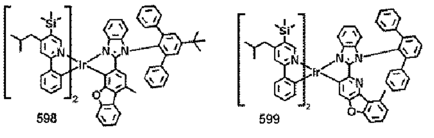
598
599
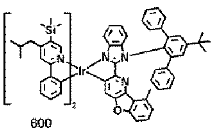
600
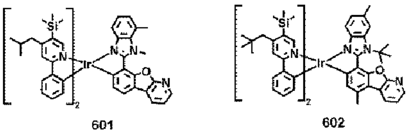
601
602
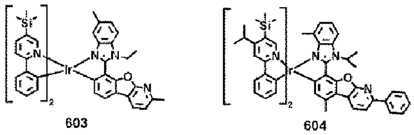
603
604
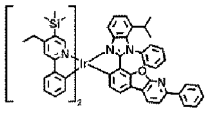
605
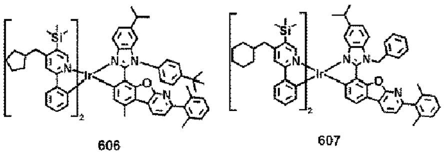
606
607
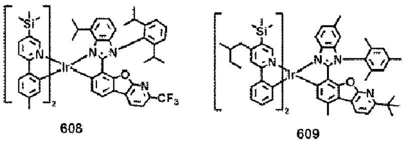
608
609
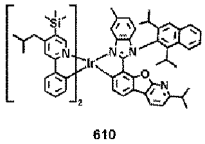
610
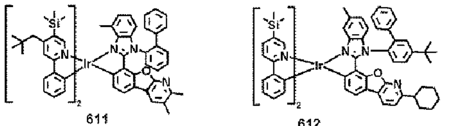
611
612
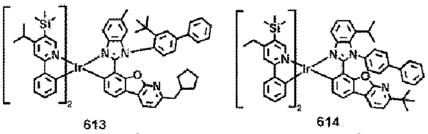
613
614
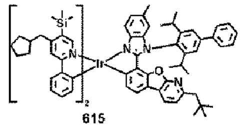
615
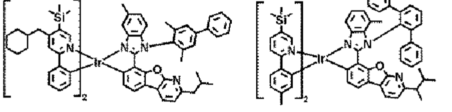
616
617
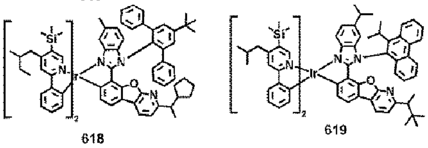
618
619
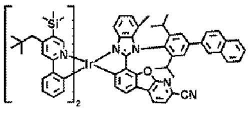
620

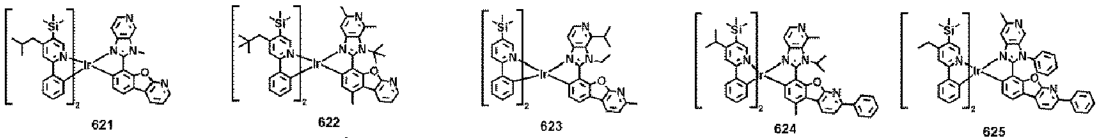

621 622 623 624 625

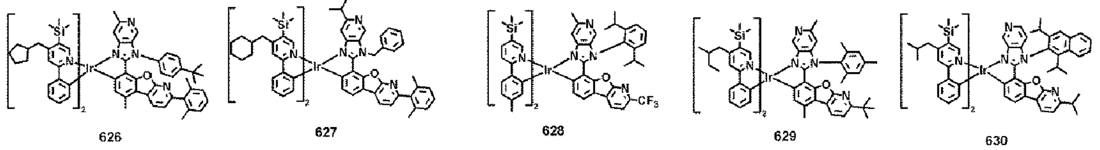

626 627 628 629 630

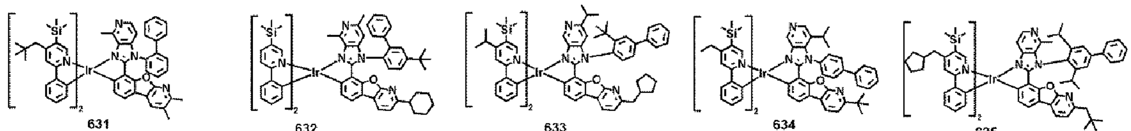

631 632 633 634 635

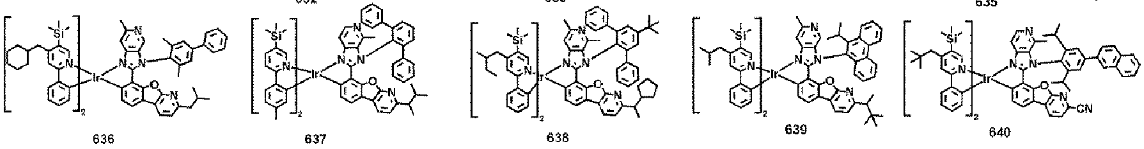

636 637 638 639 640

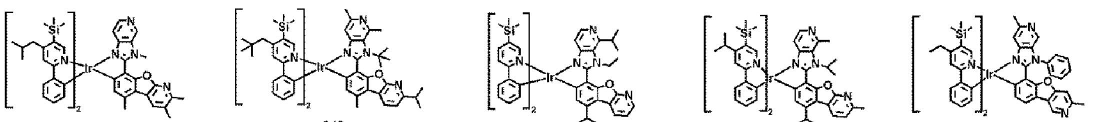

641 642 643 644 645

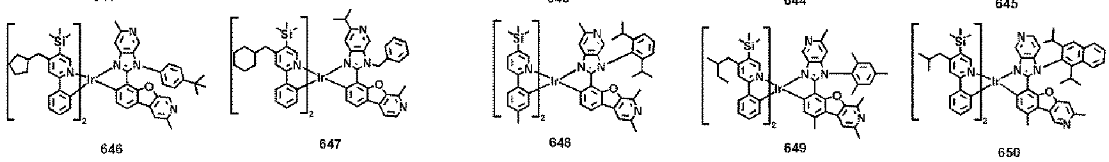

646 647 648 649 650

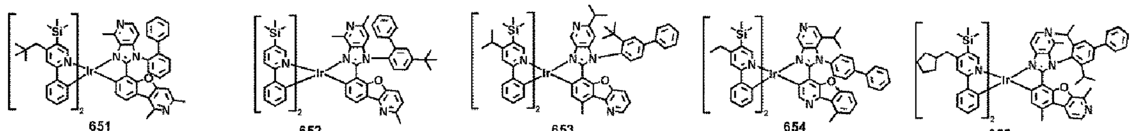

651 652 653 654 655

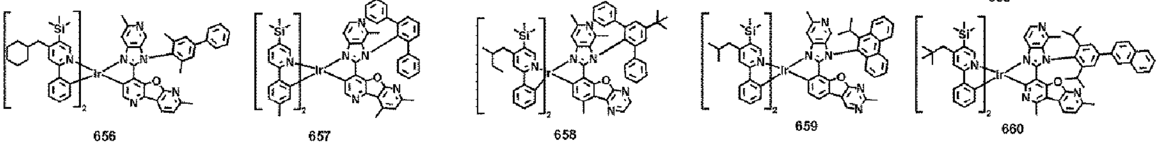

656 657 658 659 660

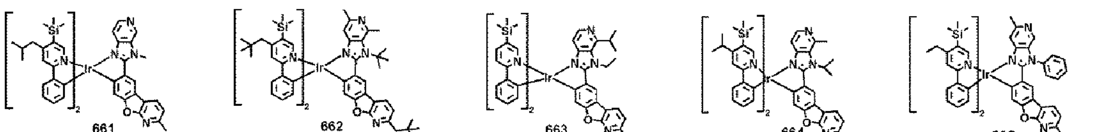

661 662 663 664 665

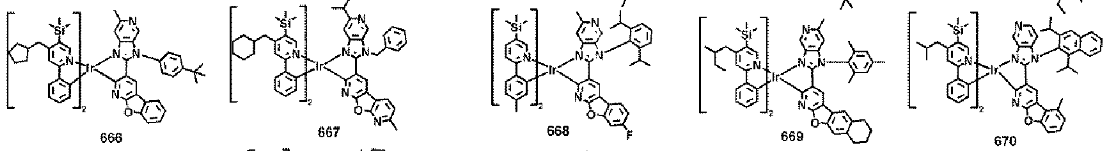

666 667 668 669 670

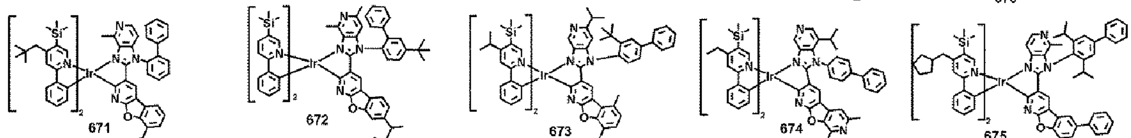

671 672 673 674 675

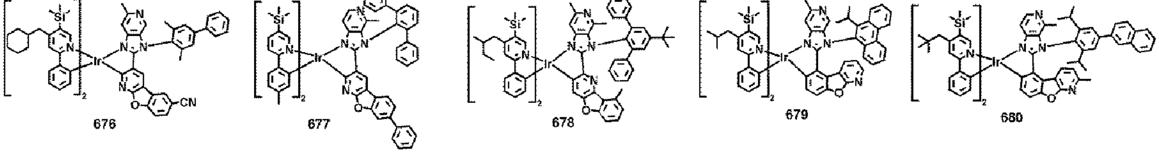

676 677 678 679 680

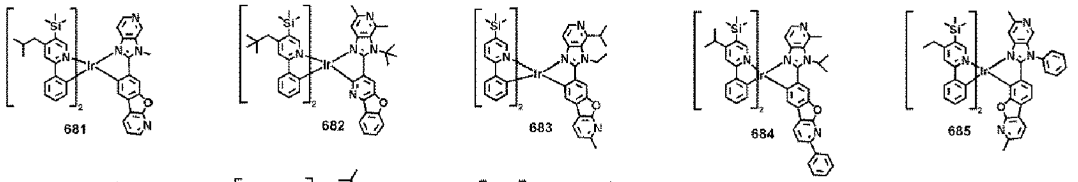
681 682 683 684 685

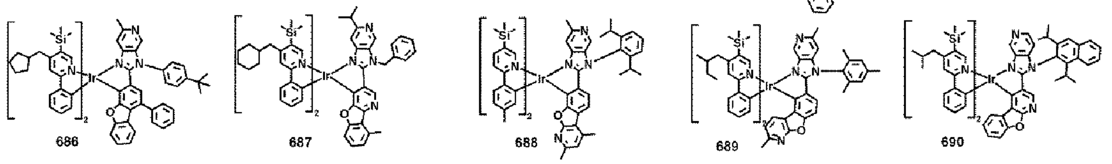
686 687 688 689 690

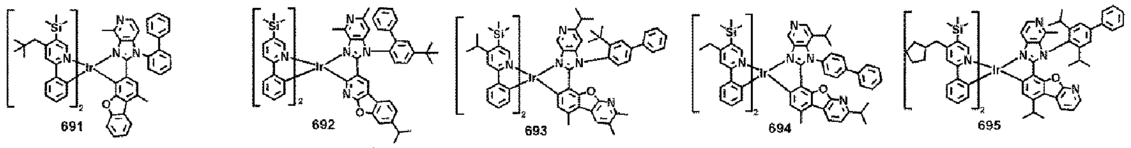
691 692 693 694 695

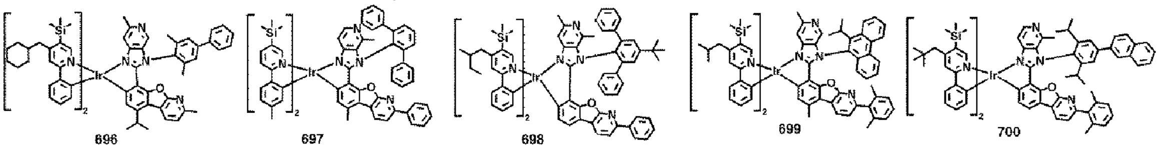
696 697 698 699 700

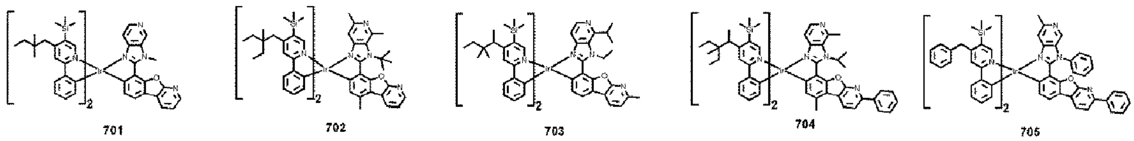
701 702 703 704 705

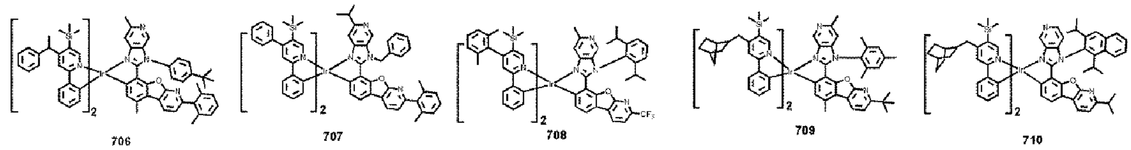
706 707 708 709 710

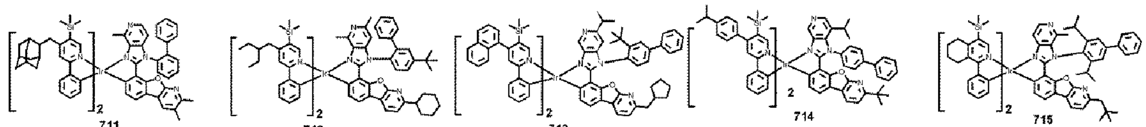
711 712 713 714 715

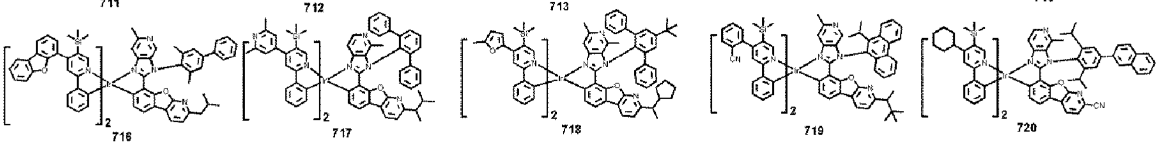
716 717 718 719 720

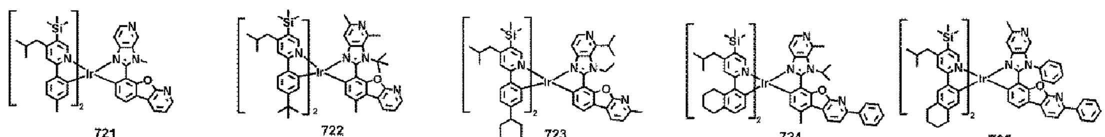
721 722 723 724 725

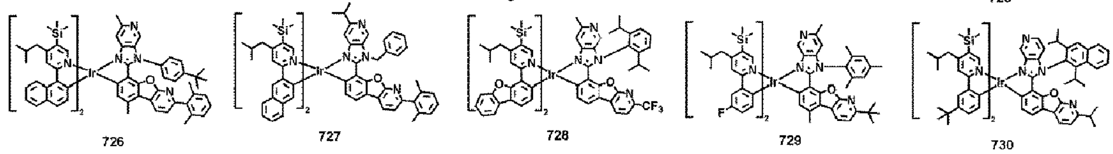
726 727 728 729 730

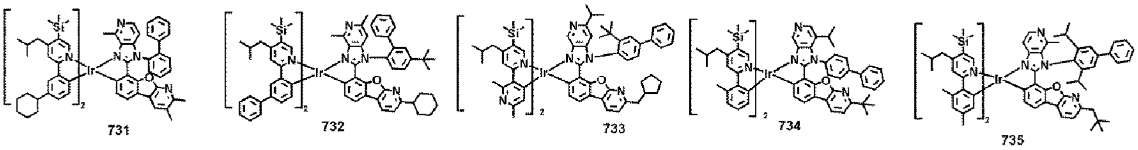
731 732 733 734 735

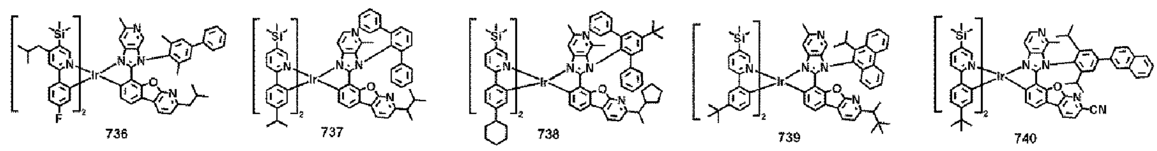
736 737 738 739 740

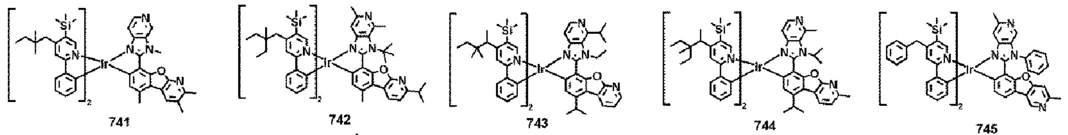
741 742 743 744 745

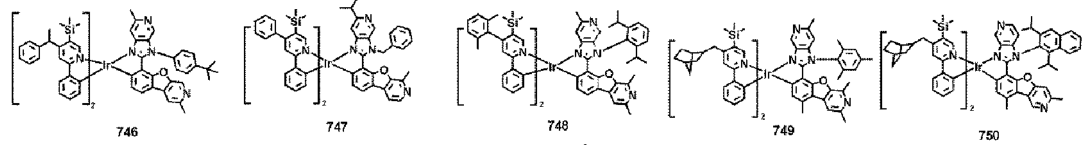
746 747 748 749 750

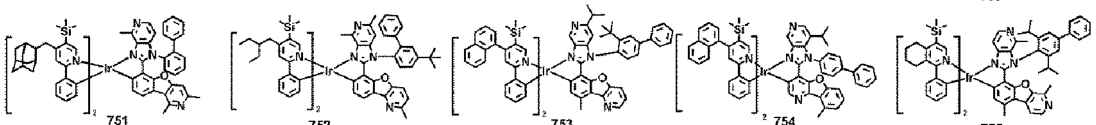
751 752 753 754 755

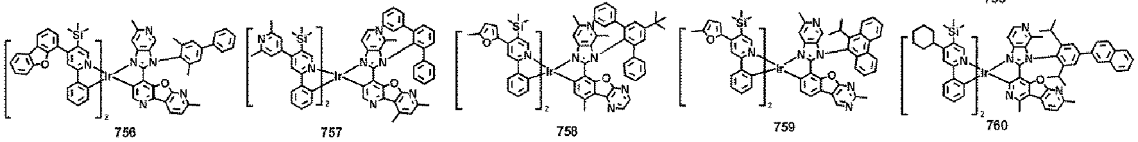
756 757 758 759 760

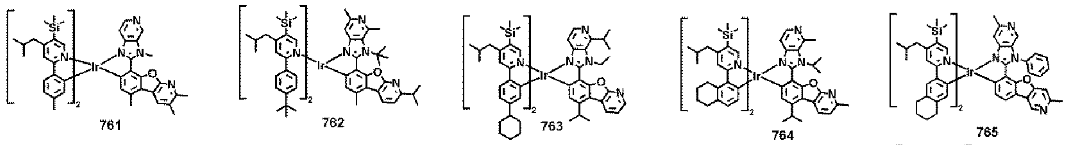
761 762 763 764 765

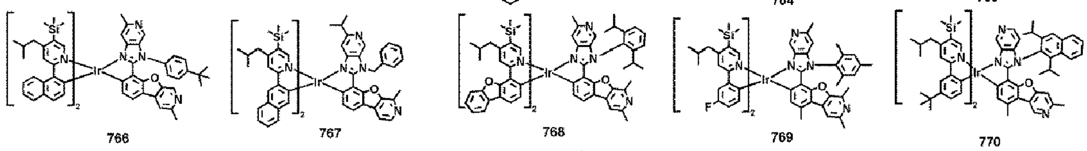
766 767 768 769 770

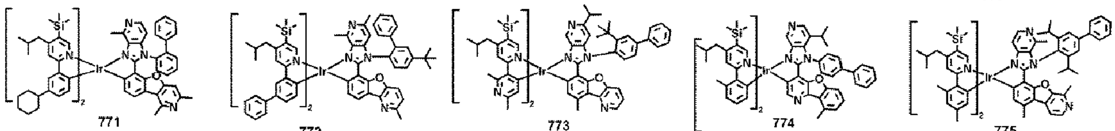
771 772 773 774 775

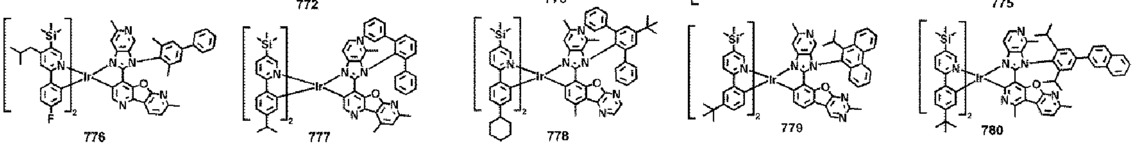
776 777 778 779 780

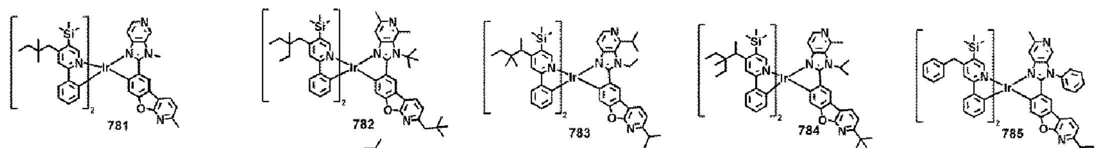
781 782 783 784 785

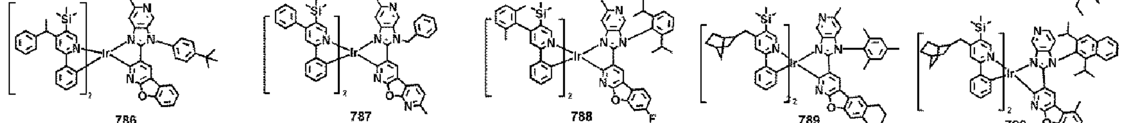
786 787 788 789 790

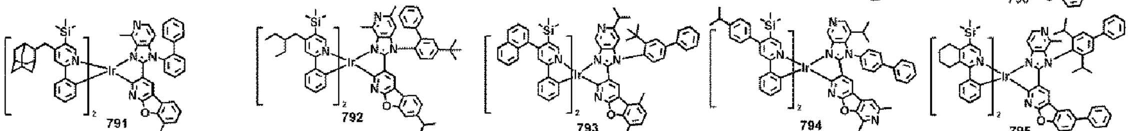
791 792 793 794 795

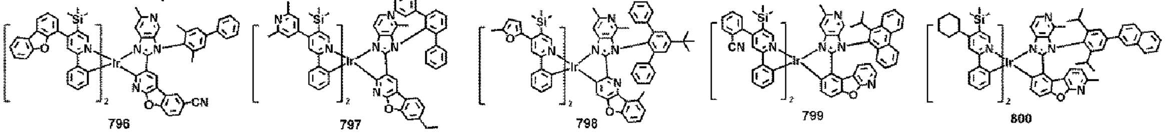
796 797 798 799 800

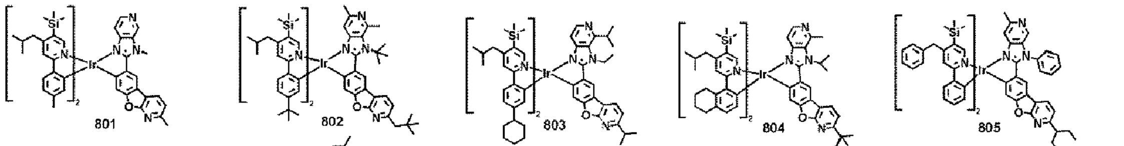
801 802 803 804 805

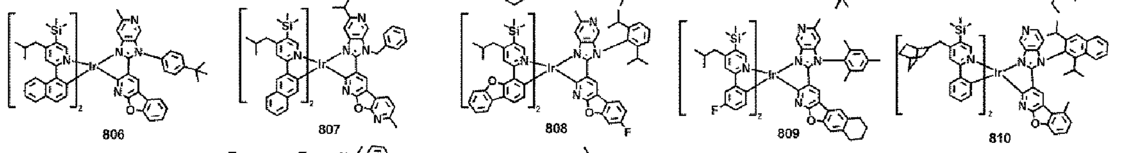
806 807 808 809 810

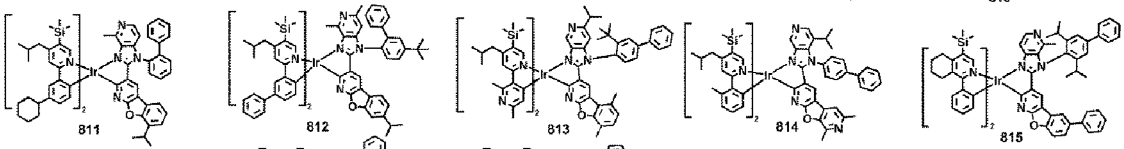
811 812 813 814 815

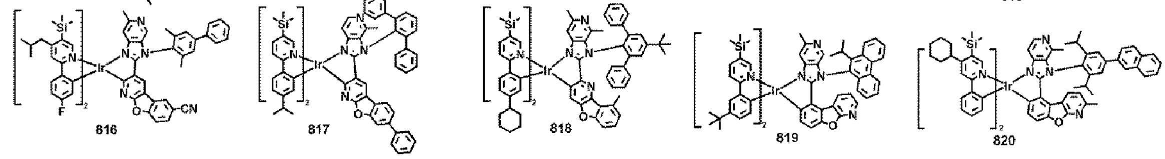
816 817 818 819 820

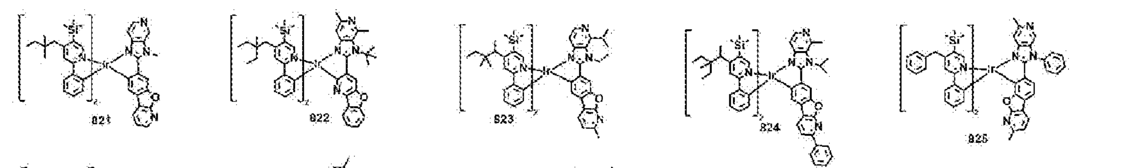
821 822 823 824 825

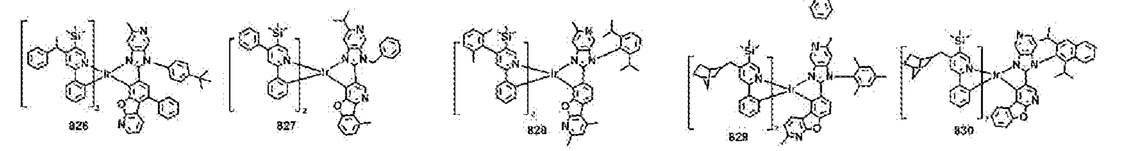
826 827 828 829 830

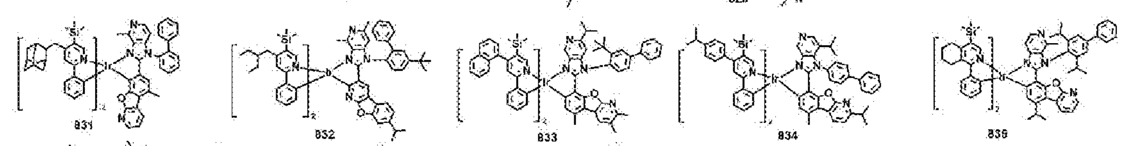
831 832 833 834 835

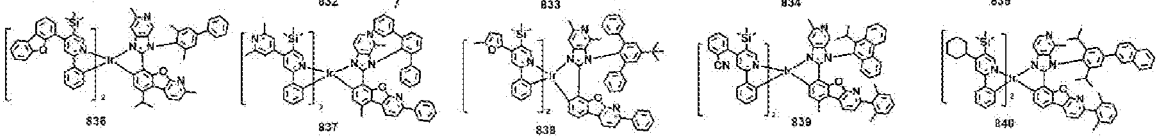
836 837 838 839 840

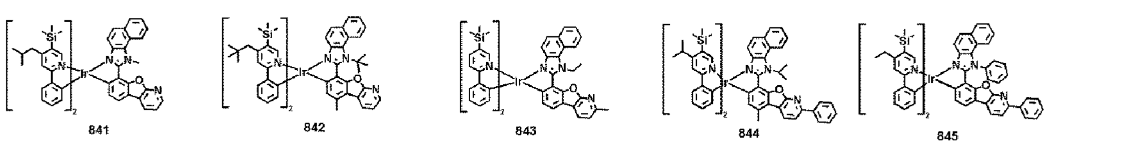
841 842 843 844 845

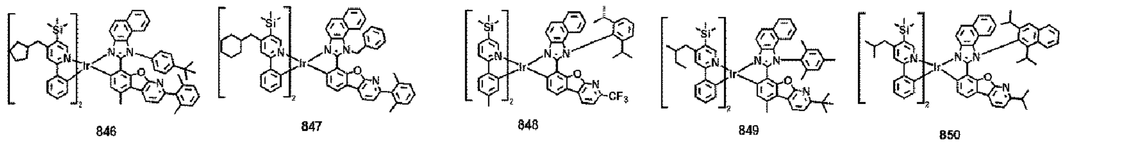
846 847 848 849 850

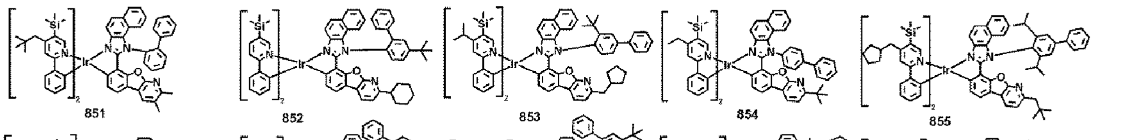
851 852 853 854 855

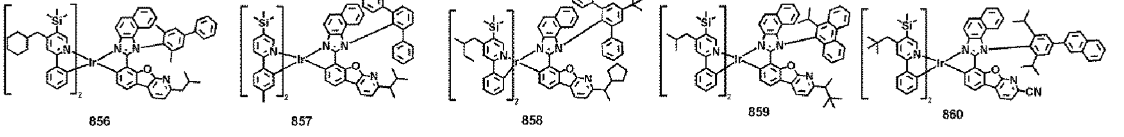
856 857 858 859 860

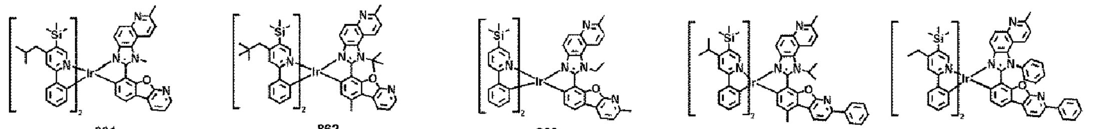

861 862 863 864 865

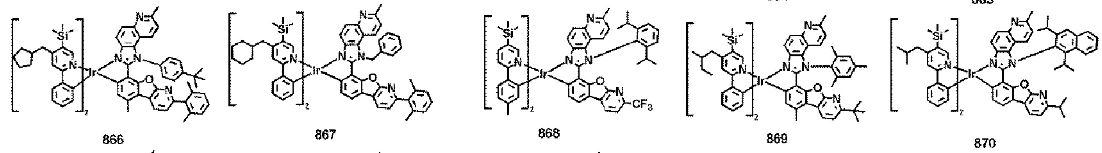

866 867 868 869 870

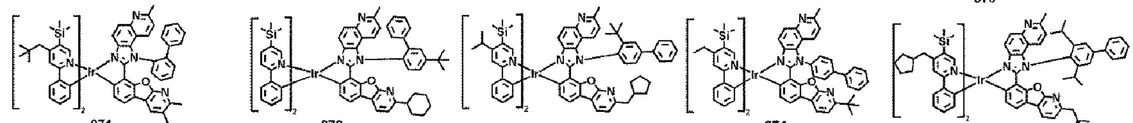

871 872 873 874 875

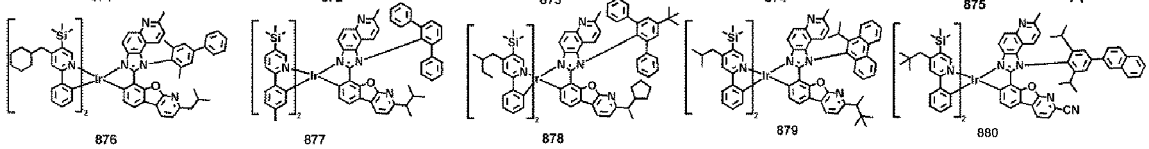

876 877 878 879 880

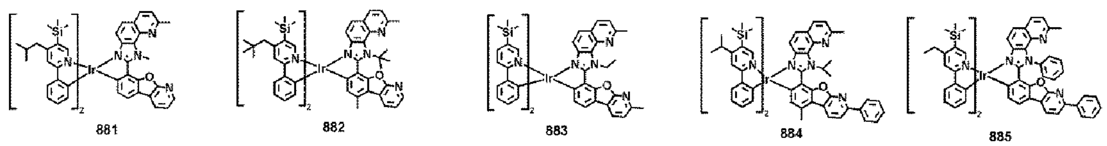

881 882 883 884 885

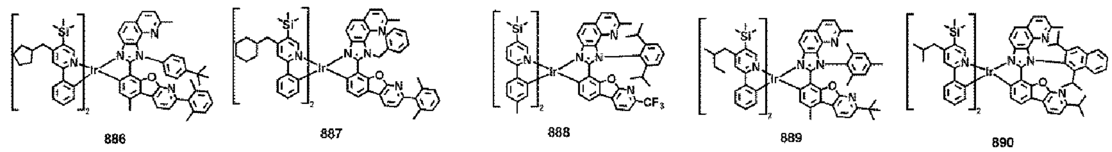

886 887 888 889 890

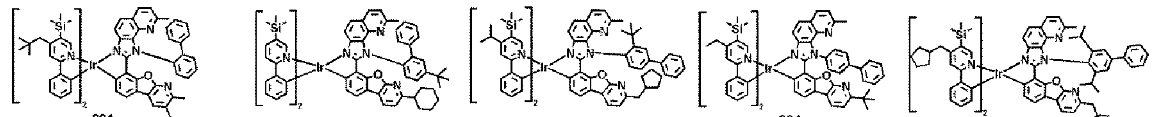

891 892 893 894 895

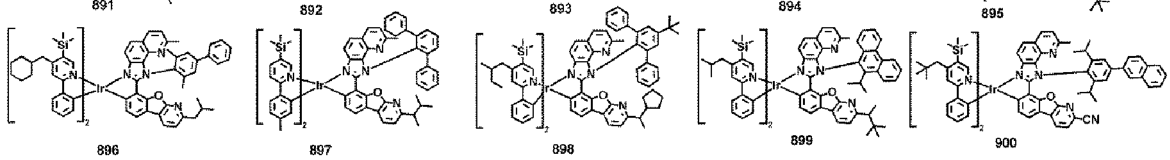

896 897 898 899 900

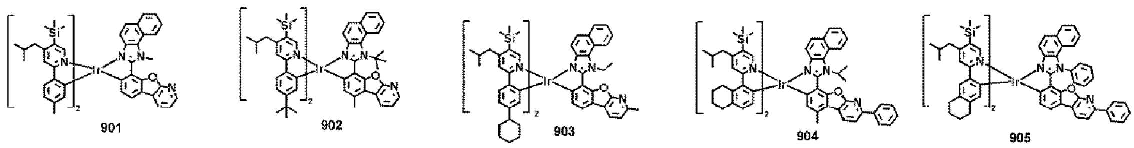

901 902 903 904 905

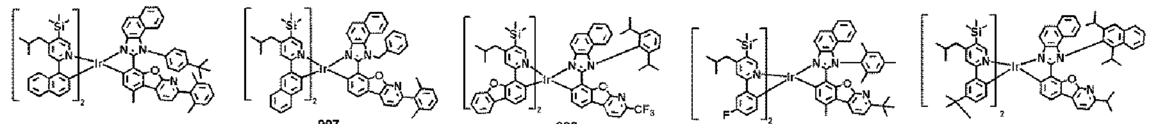

906 907 908 909 910

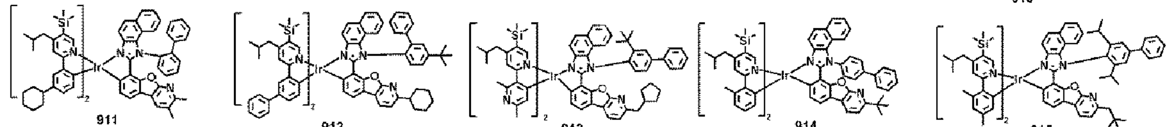

911 912 913 914 915

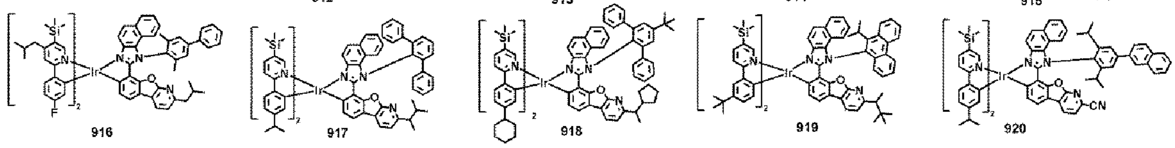

916 917 918 919 920

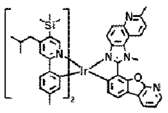
921
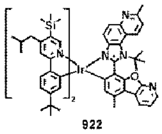
922
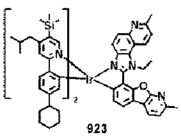
923
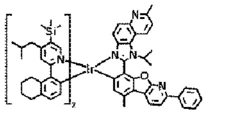
924
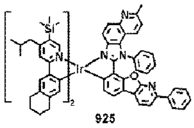
925
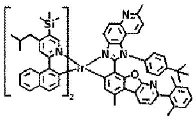
926
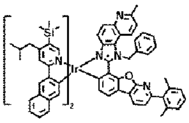
927
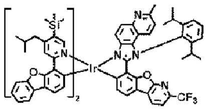
928
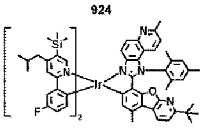
929
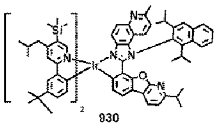
930
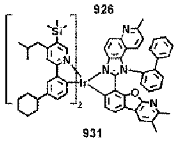
931
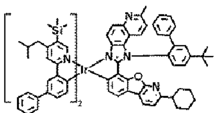
932
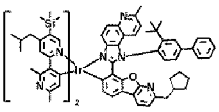
933
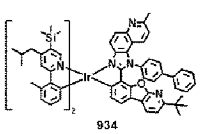
934
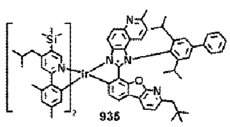
935
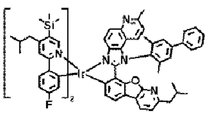
936
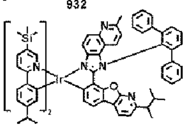
937
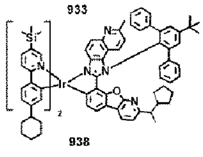
938
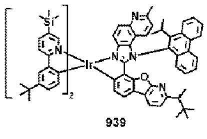
939
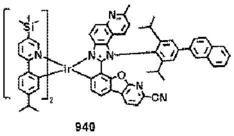
940
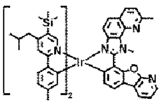
941
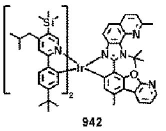
942
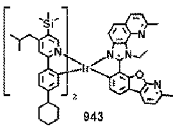
943
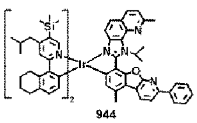
944
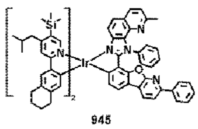
945
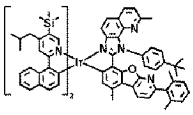
946
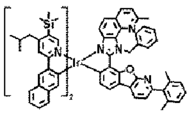
947
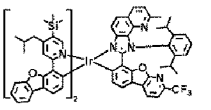
948
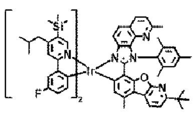
949
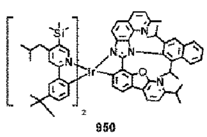
950
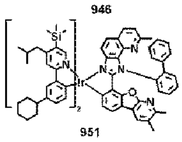
951
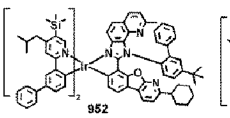
952
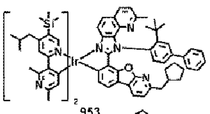
953
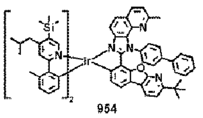
954
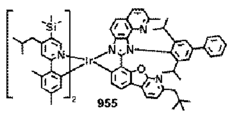
955
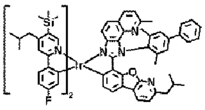
956
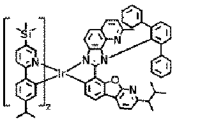
957
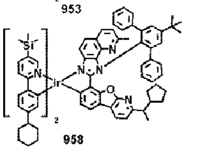
958
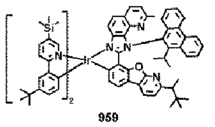
959
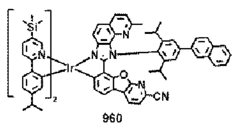
960

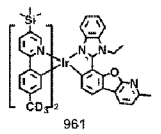
961

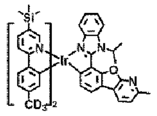
962

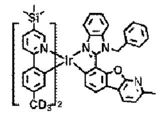
963

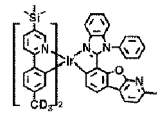
964

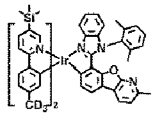
965

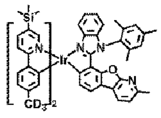
966

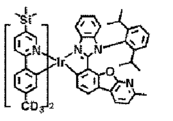
967

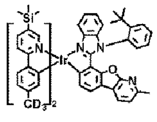
968

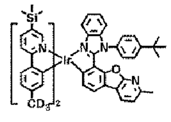
969

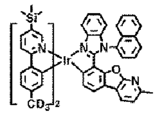
970

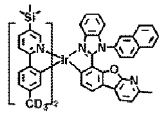
971

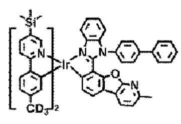
972

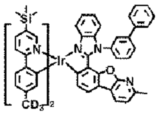
973

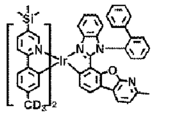
974

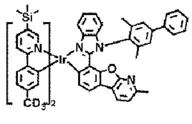
975

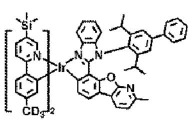
976

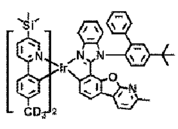
977

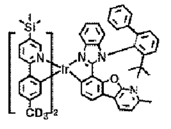
978

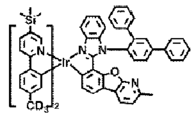
979

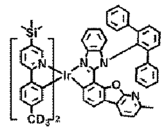
980

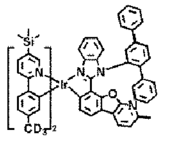
981

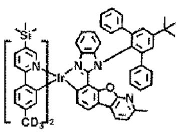
982

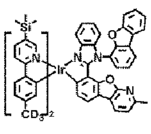
983

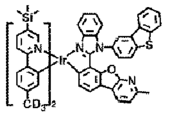
984

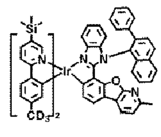
985

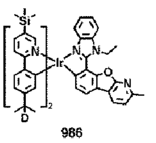
986

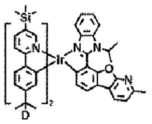
987

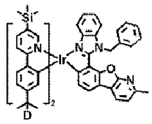
988

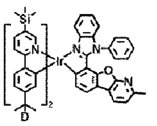
989

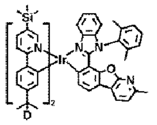
990

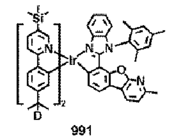
991

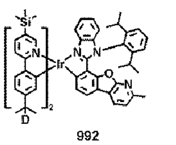
992

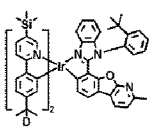
993

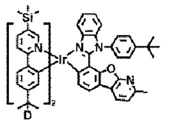
994

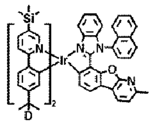
995

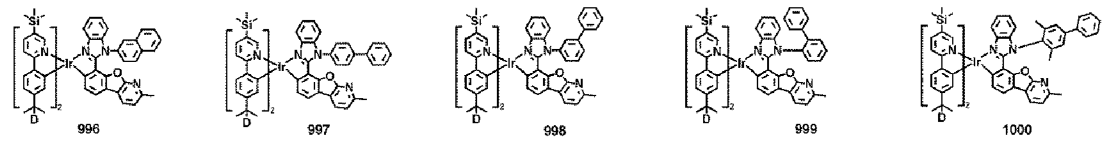
996 997 998 999 1000

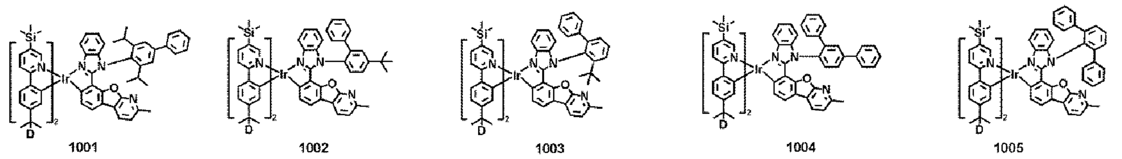
1001 1002 1003 1004 1005

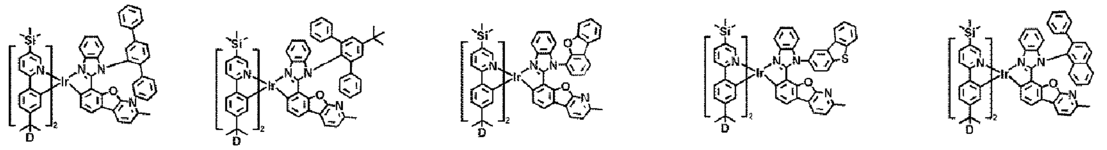
1006 1007 1008 1009 1010

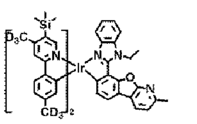
1011
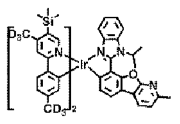
1012
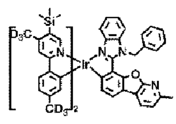
1013
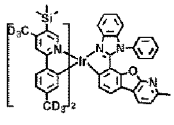
1014
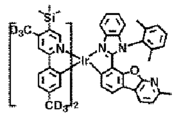
1015

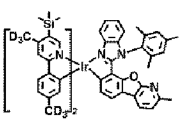
1016
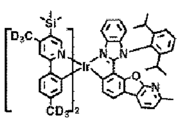
1017
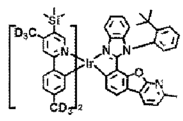
1018
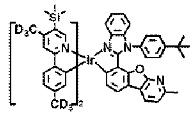
1019
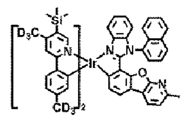
1020

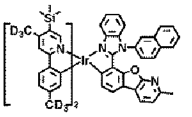
1021
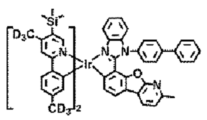
1022
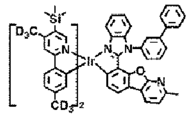
1023
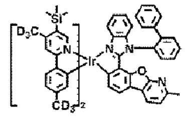
1024
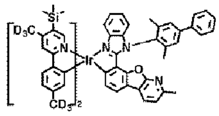
1025

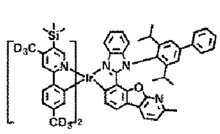
1026
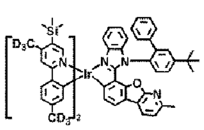
1027
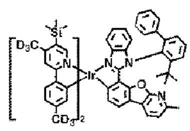
1028
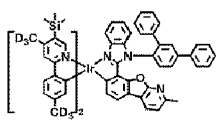
1029
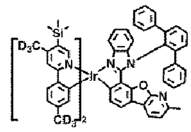
1030

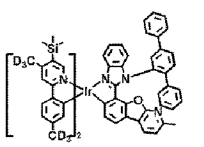
1031
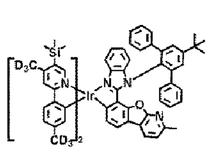
1032
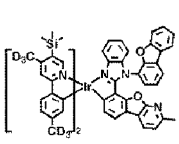
1033
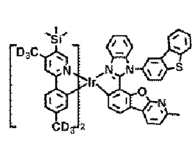
1034
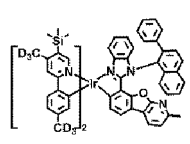
1035

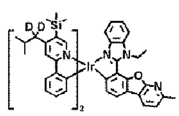
1036
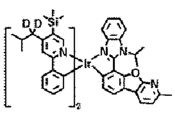
1037
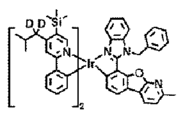
1038
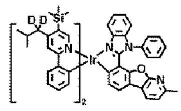
1039
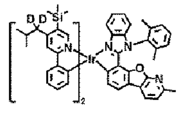
1040

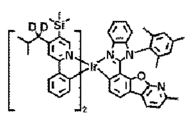
1041
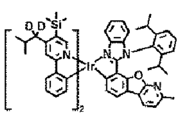
1042
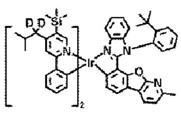
1043
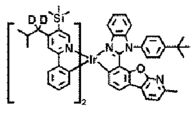
1044
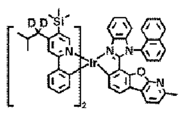
1045

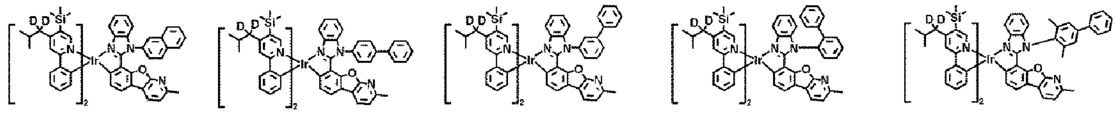
1046
1047
1048
1049
1050

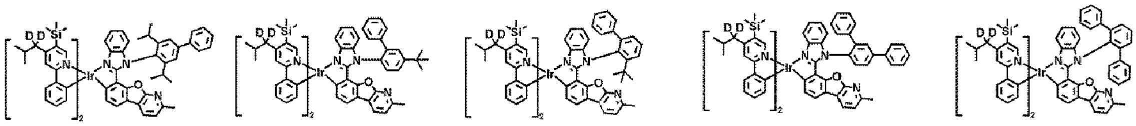
1051
1052
1053
1054
1055

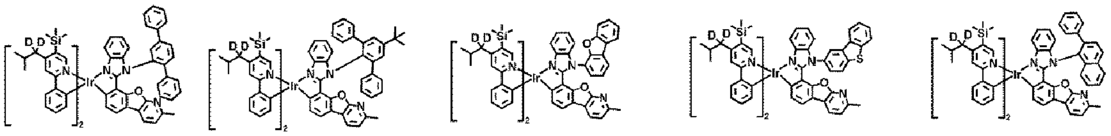
1056
1057
1058
1059
1060

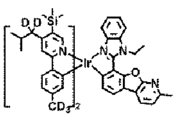
1061
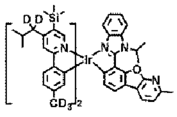
1062
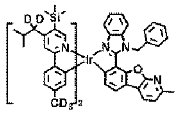
1063
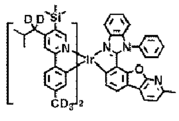
1064
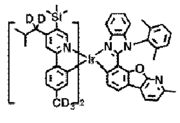
1065

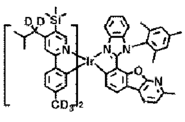
1066
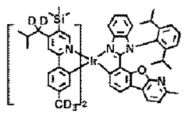
1067
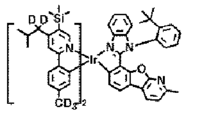
1068
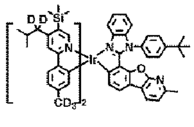
1069
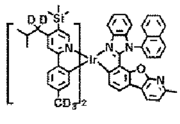
1070

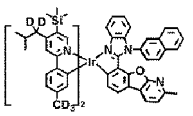
1071
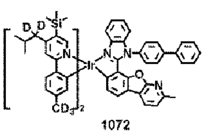
1072
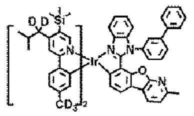
1073
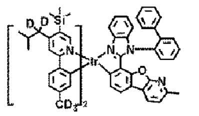
1074
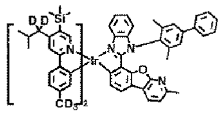
1075

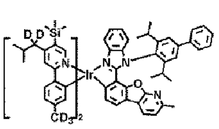
1076
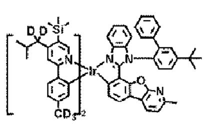
1077
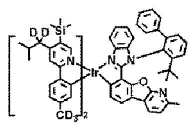
1078
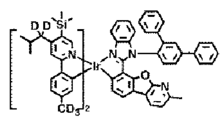
1079
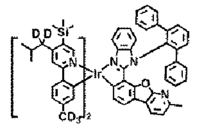
1080

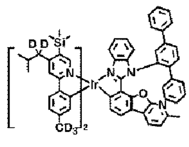
1081
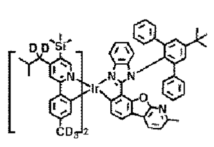
1082
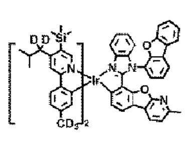
1083
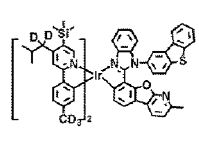
1084
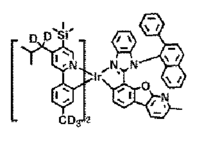
1085

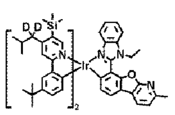
1086
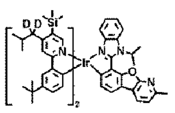
1087
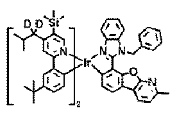
1088
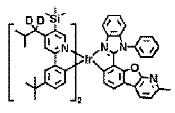
1089
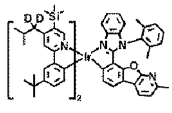
1090

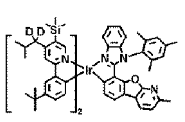
1091
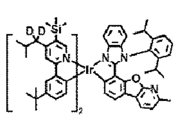
1092
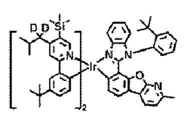
1093
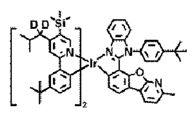
1094
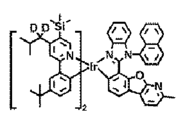
1095

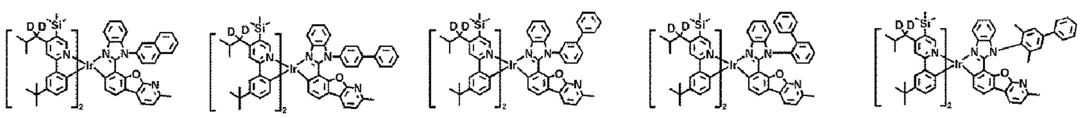
1096
1097
1098
1099
1100

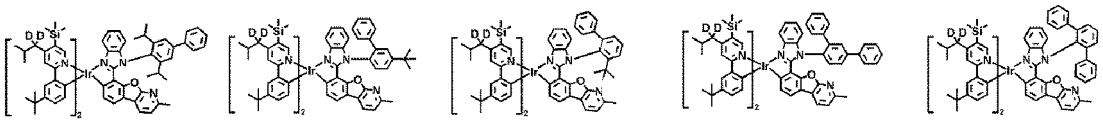
1101
1102
1103
1104
1105

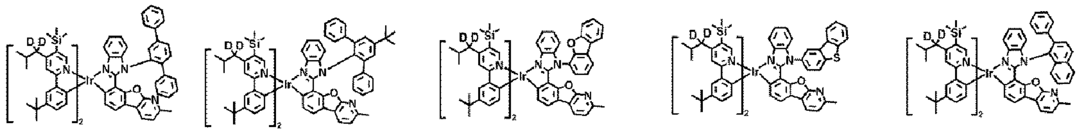
1106
1107
1108
1109
1110

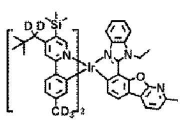
1111
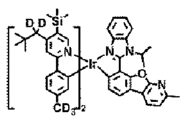
1112
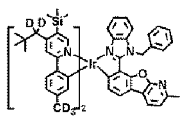
1113
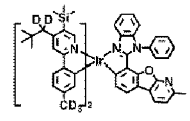
1114
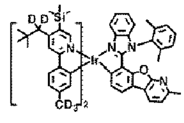
1115
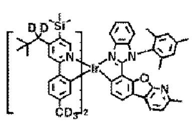
1116
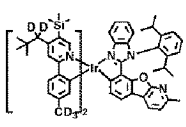
1117
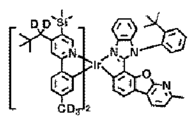
1118
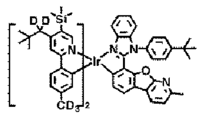
1119
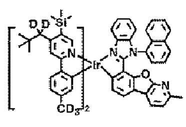
1120
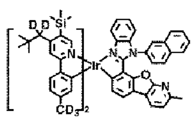
1121
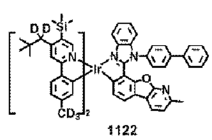
1122
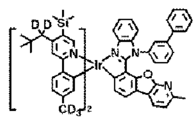
1123
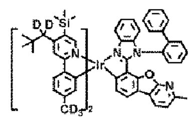
1124
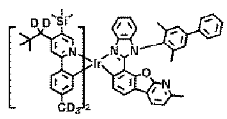
1125
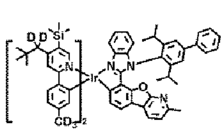
1126
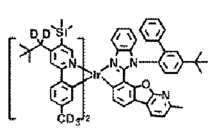
1127
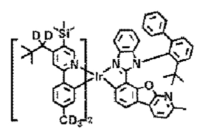
1128
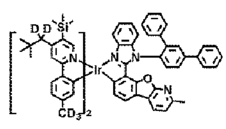
1129
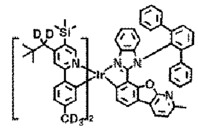
1130
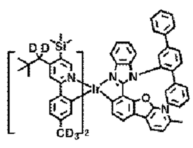
1131
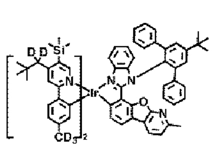
1132
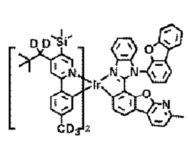
1133
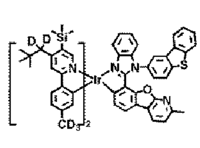
1134
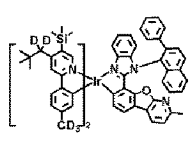
1135
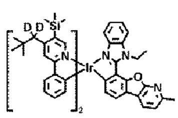
1136
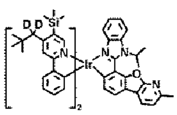
1137
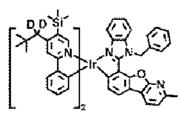
1138
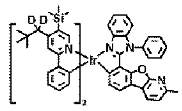
1139
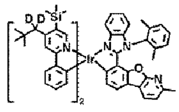
1140
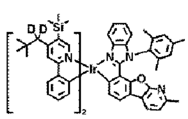
1141
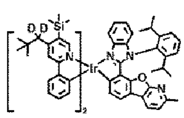
1142
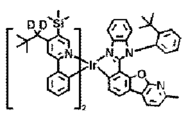
1143
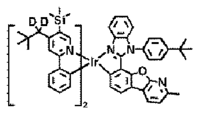
1144
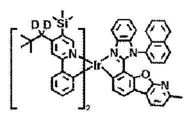
1145
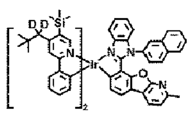
1146
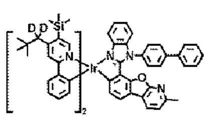
1147
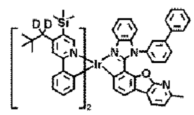
1148
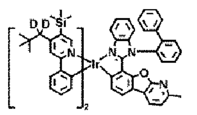
1149
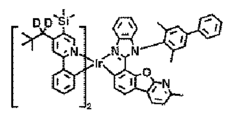
1150
1151
1152
1153
1154
1155
1156
1157
1158
1159
1160

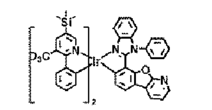
1161
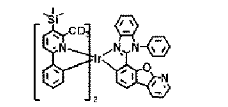
1162
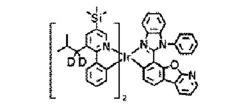
1163
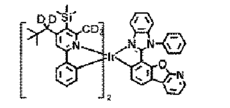
1164
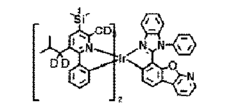
1165
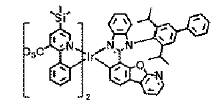
1166
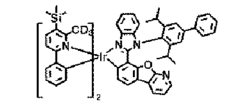
1167
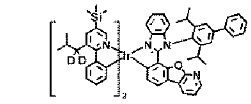
1168
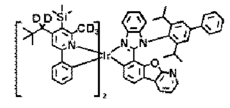
1169
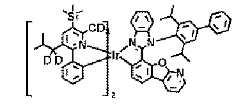
1170
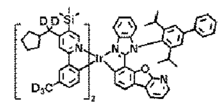
1171
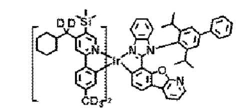
1172
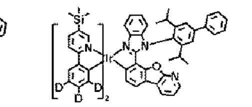
1173
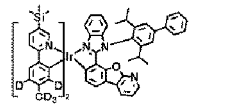
1174
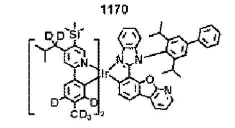
1175
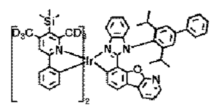
1176
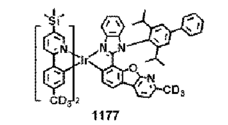
1177
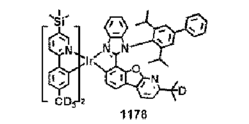
1178
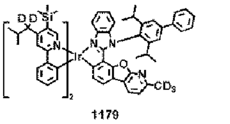
1179
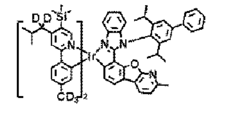
1180
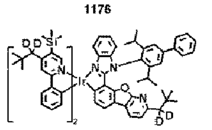
1181
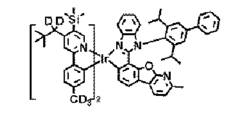
1182
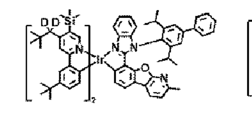
1183
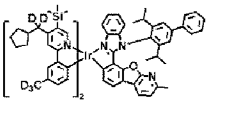
1184
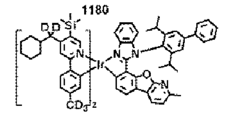
1185
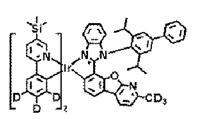
1186
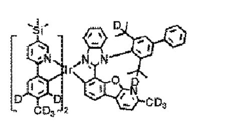
1187
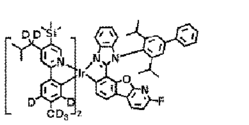
1188
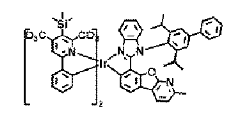
1189
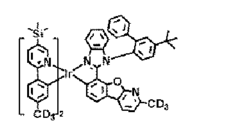
1190
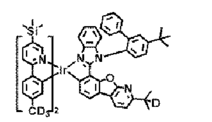
1191
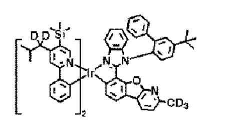
1192
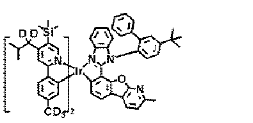
1193
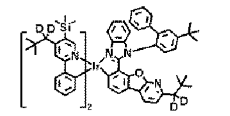
1194
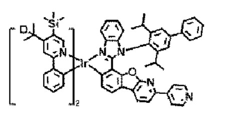
1195
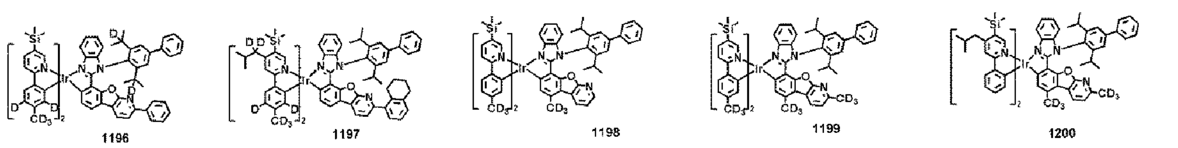
1196 1197 1198 1199 1200
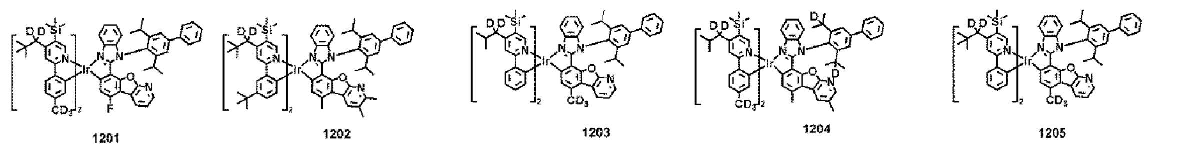
1201 1202 1203 1204 1205
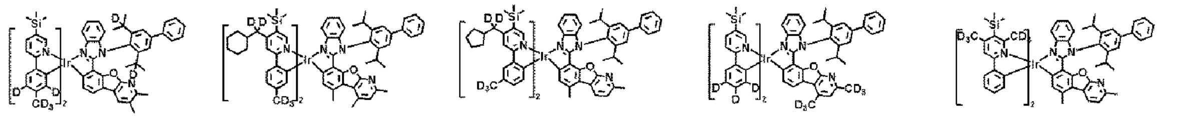
1206 1207 1208 1209 1210

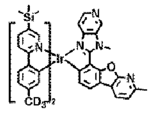
1211
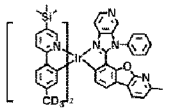
1212
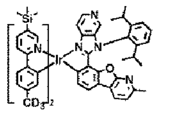
1213
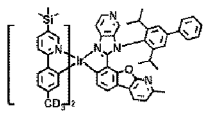
1214
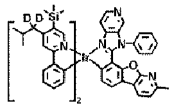
1215
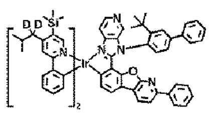
1216
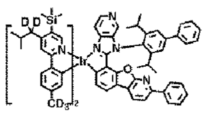
1217
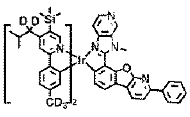
1218
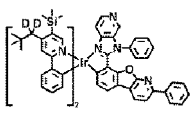
1219
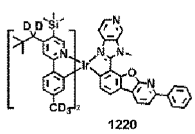
1220
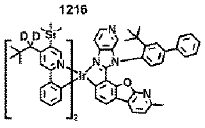
1221
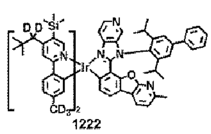
1222
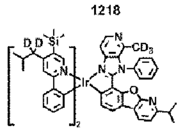
1223
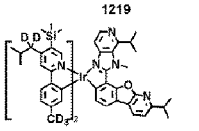
1224
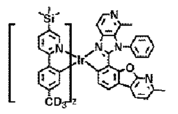
1225
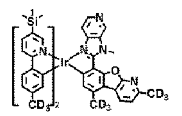
1226
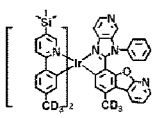
1227
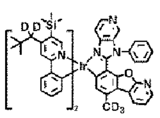
1228
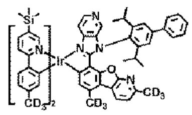
1229
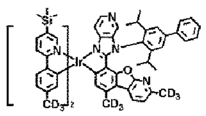
1230
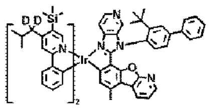
1231
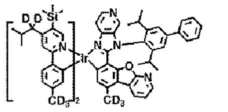
1232
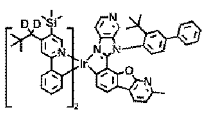
1233
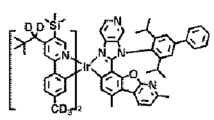
1234
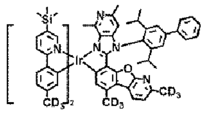
1235
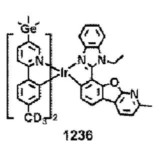
1236
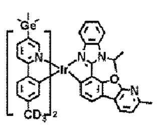
1237
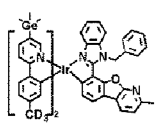
1238
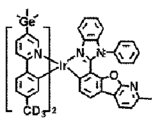
1239
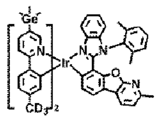
1240
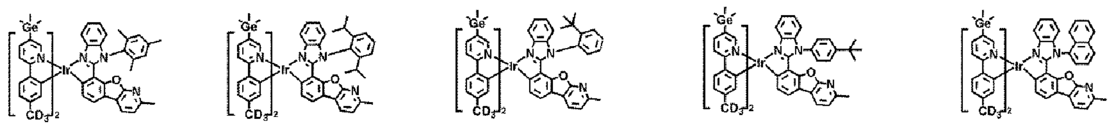
1241 1242 1243 1244 1245
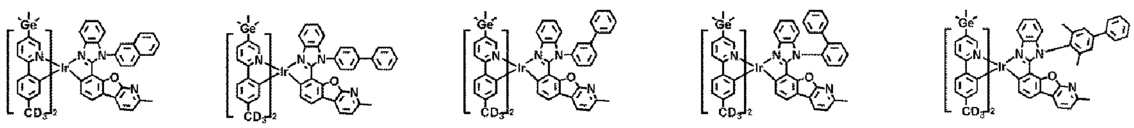
1246 1247 1248 1249 1250
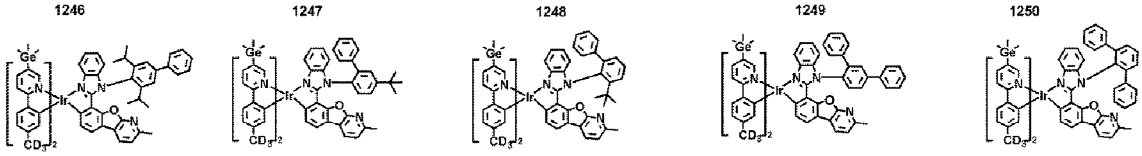
1251 1252 1253 1254 1255
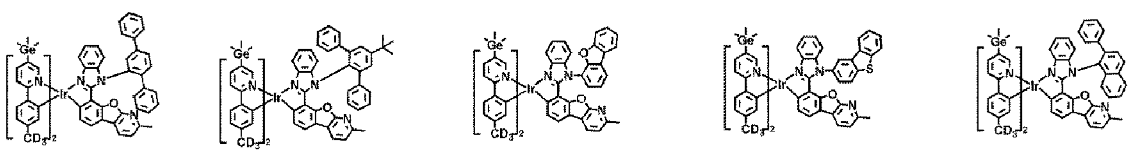
1256 1257 1258 1259 1260

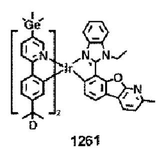
1261

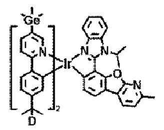
1262

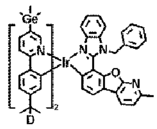
1263

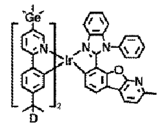
1264

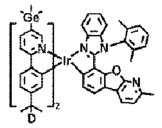
1265

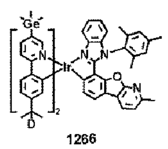
1266

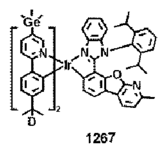
1267

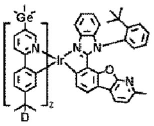
1268

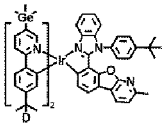
1269

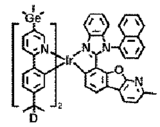
1270

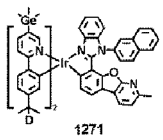
1271

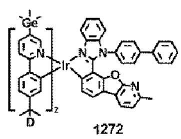
1272

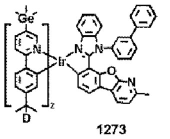
1273

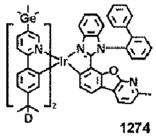
1274

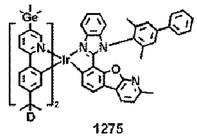
1275

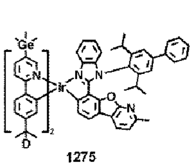
1275

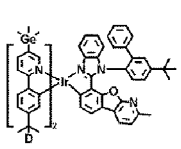
1277

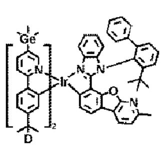
1278

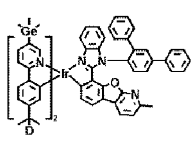
1279

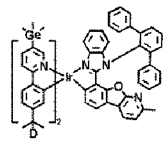
1280

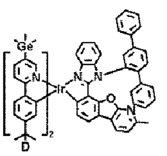
1281

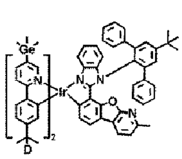
1282

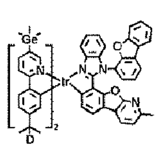
1283

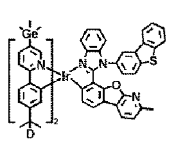
1284

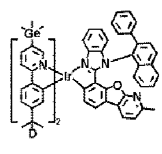
1285

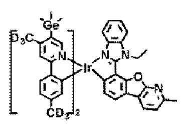
1286

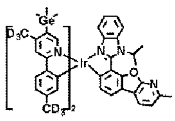
1287

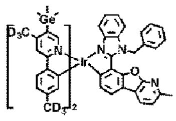
1288

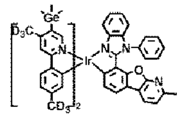
1289

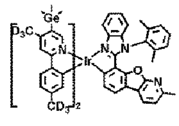
1290

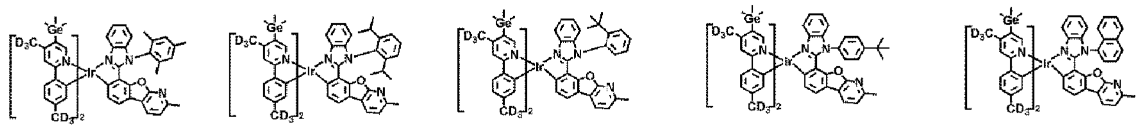
1291 1292 1293 1294 1295

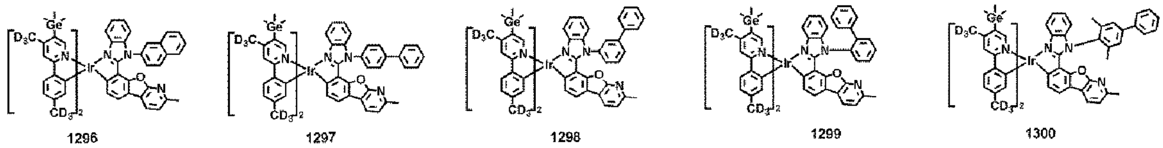
1296 1297 1298 1299 1300

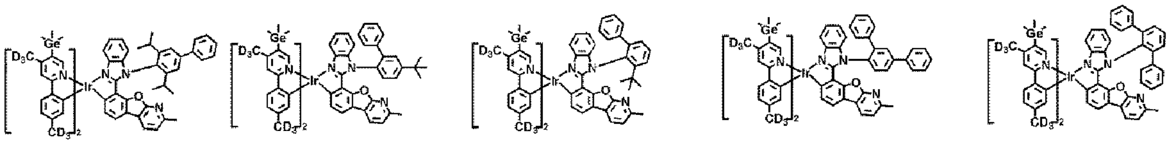
1301 1302 1303 1304 1305

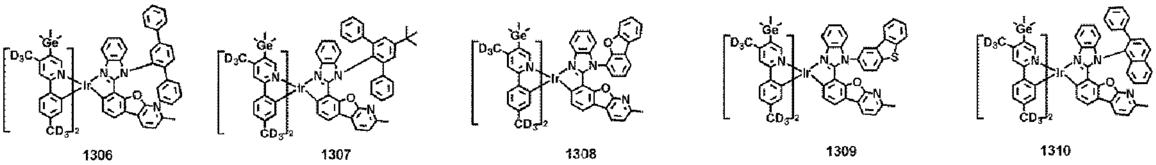
1306 1307 1308 1309 1310

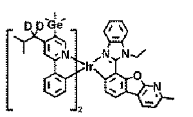
1311

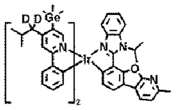
1312

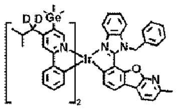
1313

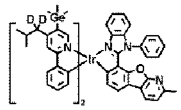
1314

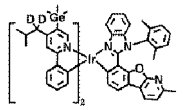
1315

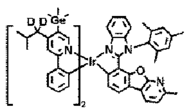
1316

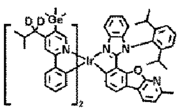
1317

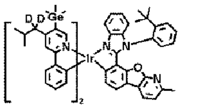
1318

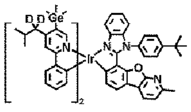
1319

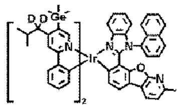
1320

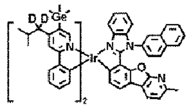
1321

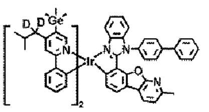
1322

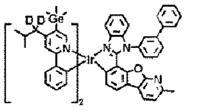
1323

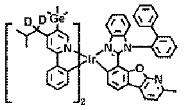
1324

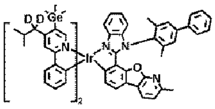
1325

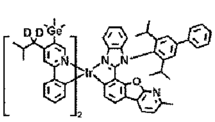
1326

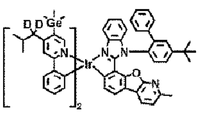
1327

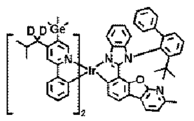
1328

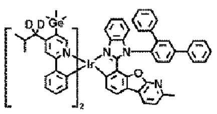
1329

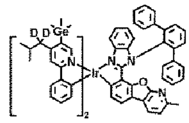
1330

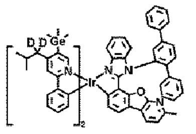
1331

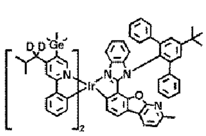
1332

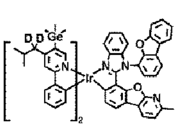
1333

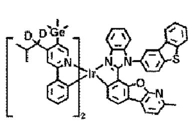
1334

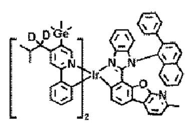
1335

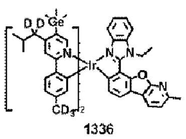
1336

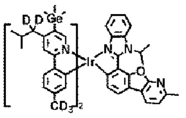
1337

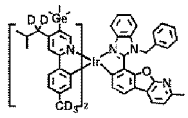
1338

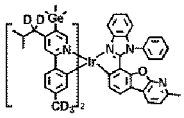
1339

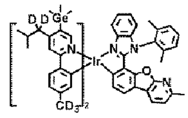
1340

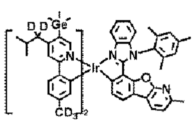
1341

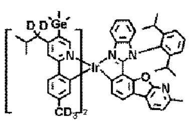
1342

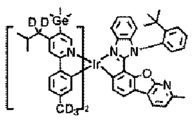
1343

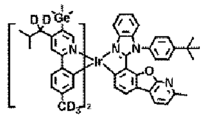
1344

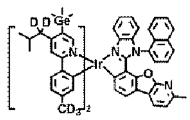
1345

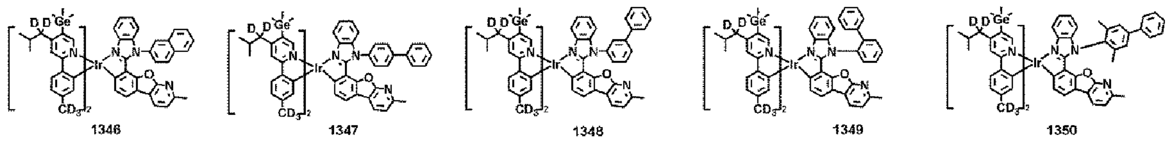
1346 1347 1348 1349 1350

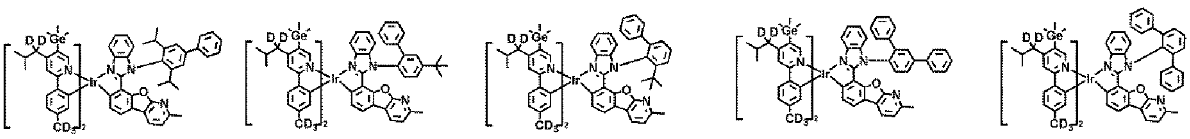
1351 1352 1353 1354 1355

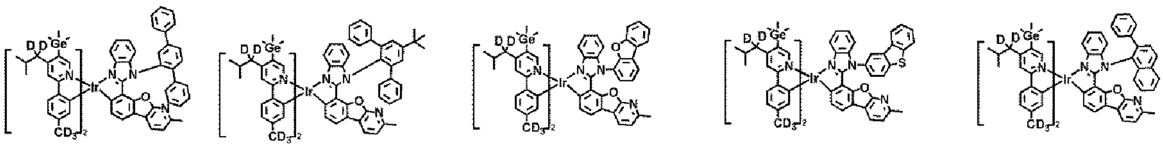
1356 1357 1358 1359 1360

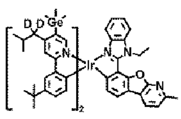
1361
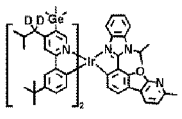
1362
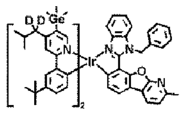
1363
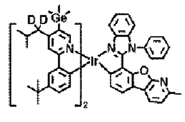
1364
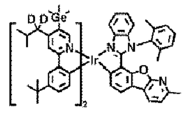
1365

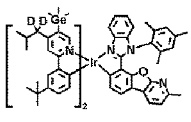
1366
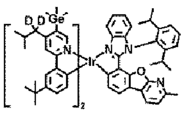
1367
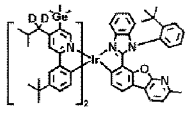
1368
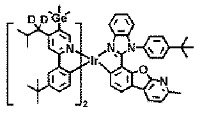
1369
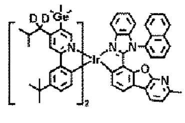
1370

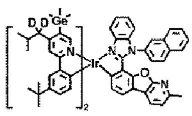
1371
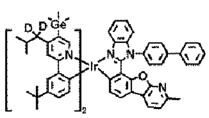
1372
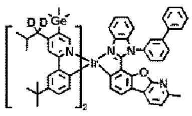
1373
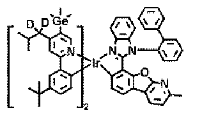
1374
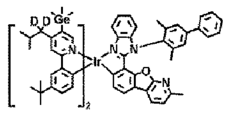
1375

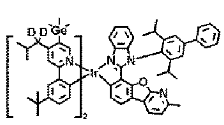
1376
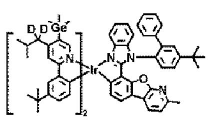
1377
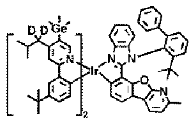
1378
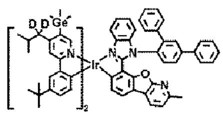
1379
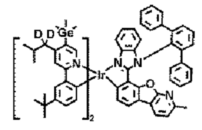
1380

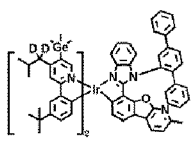
1381
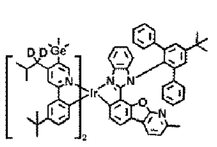
1382
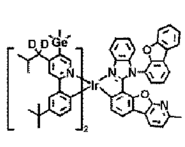
1383
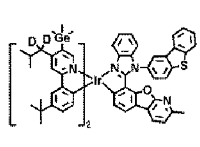
1384
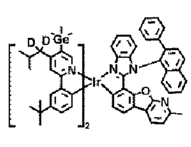
1385

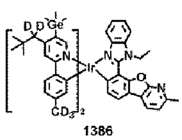
1386
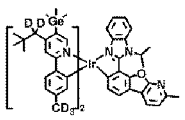
1387
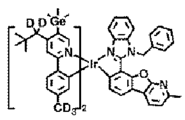
1388
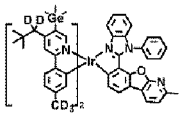
1389
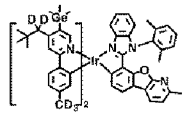
1390

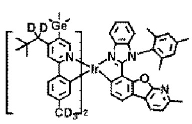
1391
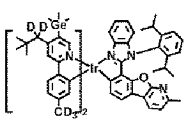
1392
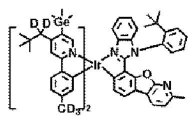
1393
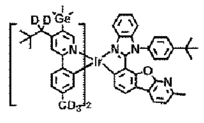
1394
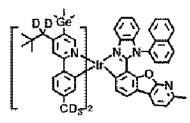
1395

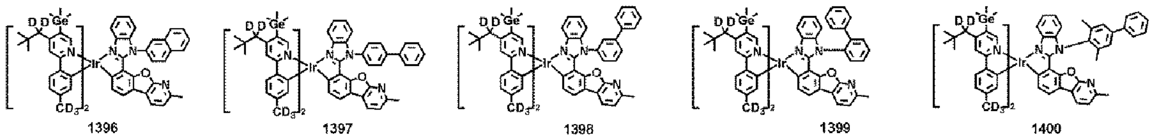
1396 1397 1398 1399 1400

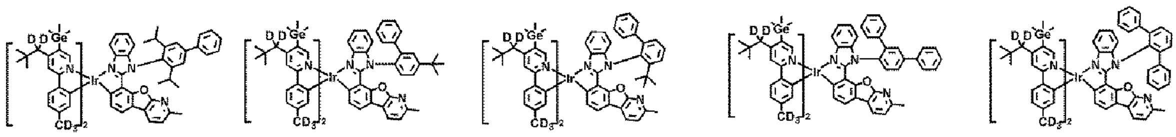
1401 1402 1403 1404 1405

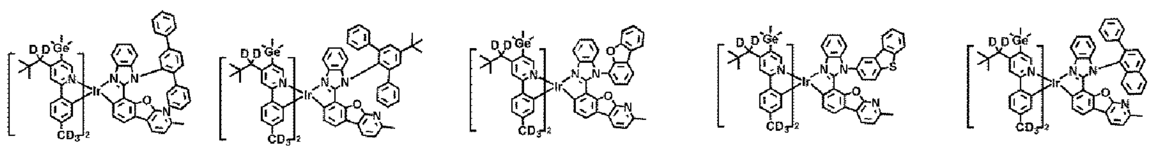
1406 1407 1408 1409 1410

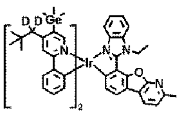
1411
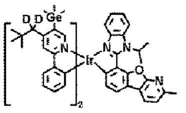
1412
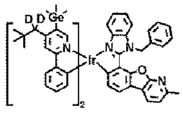
1413
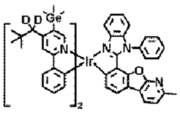
1414
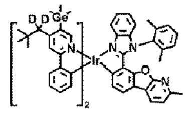
1415
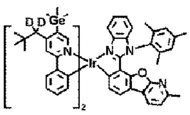
1416
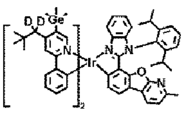
1417
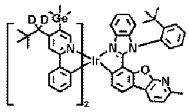
1418
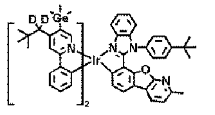
1419
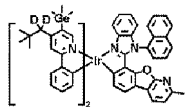
1420
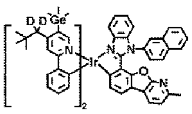
1421
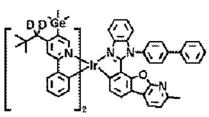
1422
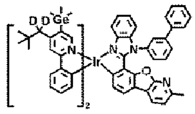
1423
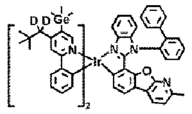
1424
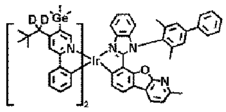
1425
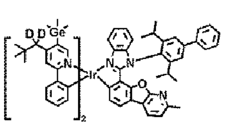
1426
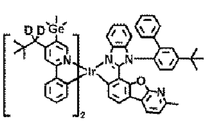
1427
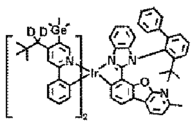
1428
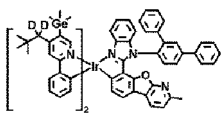
1429
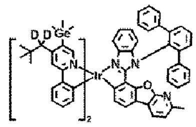
1430
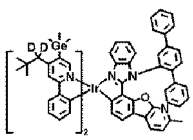
1431
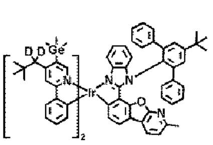
1432
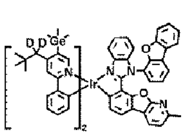
1433
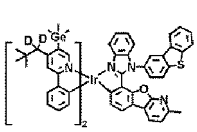
1434
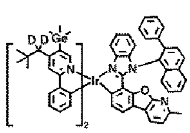
1435
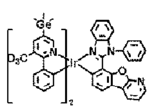
1436
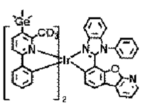
1437
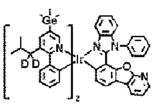
1438
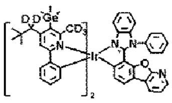
1439
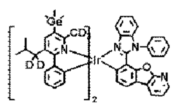
1440
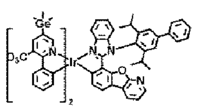
1441
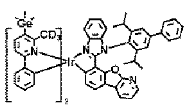
1442
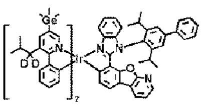
1443
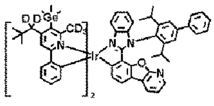
1444
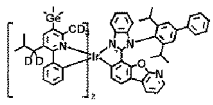
1445
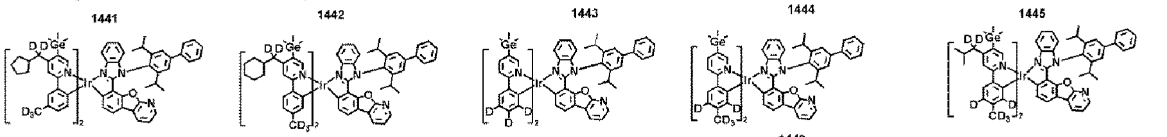
1446 1447 1448 1449 1450
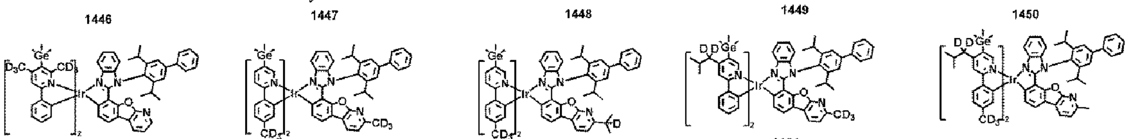
1451 1452 1453 1454 1455
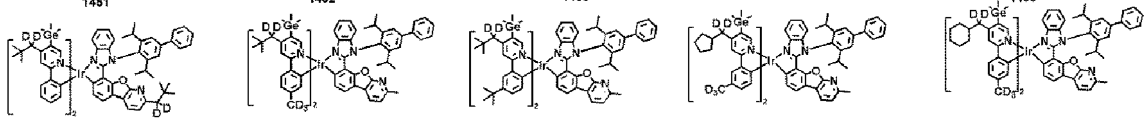
1456 1457 1458 1459 1460

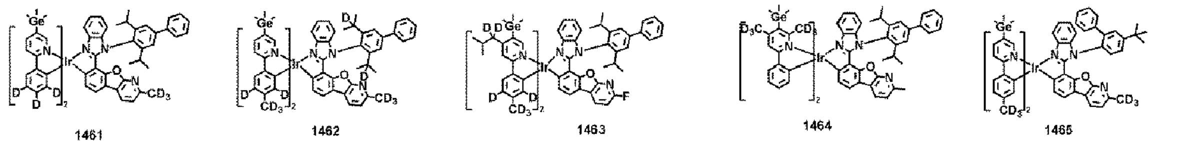

1461 1462 1463 1464 1465

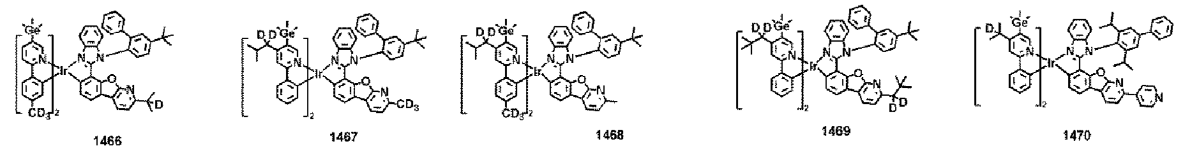

1466 1467 1468 1469 1470

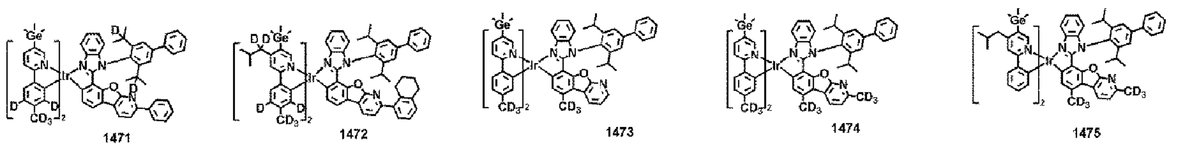

1471 1472 1473 1474 1475

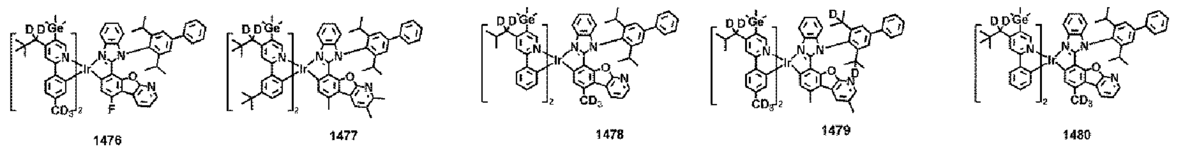

1476 1477 1478 1479 1480

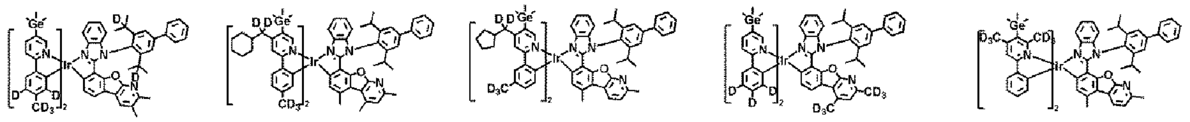

1481 1482 1483 1484 1485

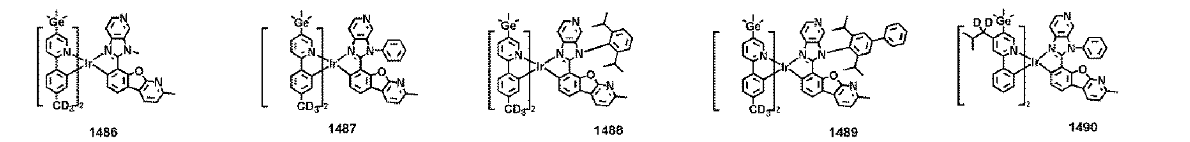

1486 1487 1488 1489 1490

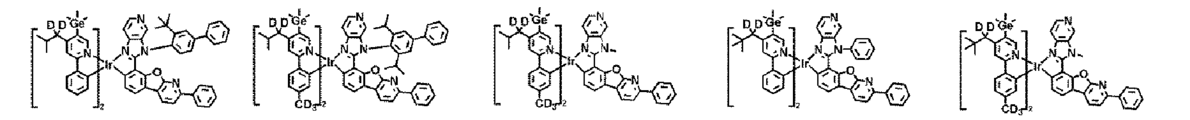

1491 1492 1493 1494 1495

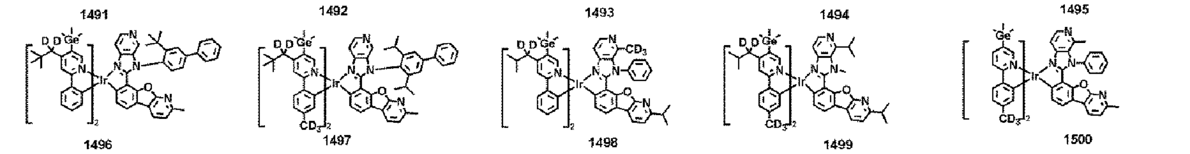

1496 1497 1498 1499 1500

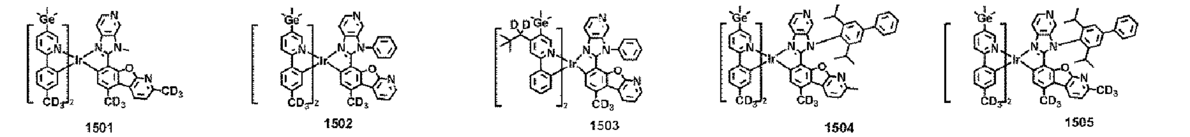

1501 1502 1503 1504 1505

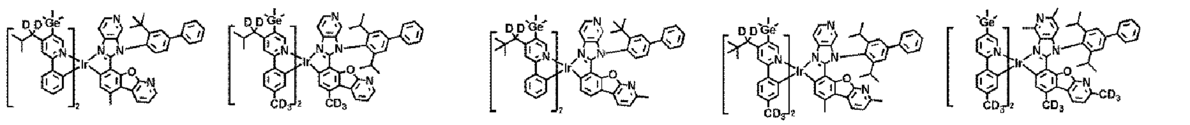

1506 1507 1508 1509 1510

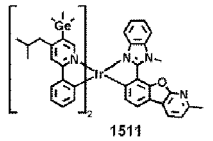
1511
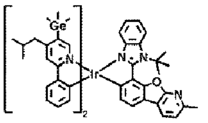
1512
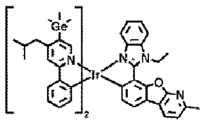
1513
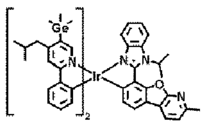
1514
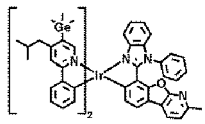
1515

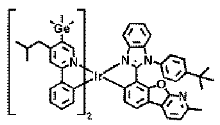
1516
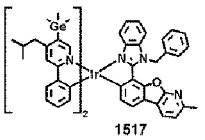
1517
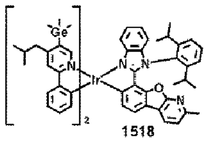
1518
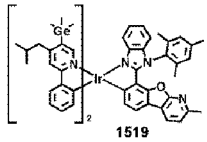
1519
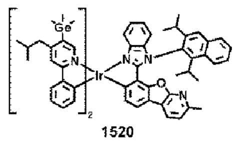
1520

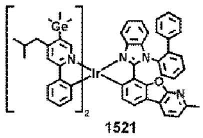
1521
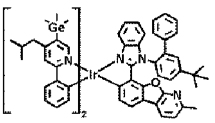
1522
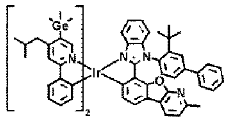
1523
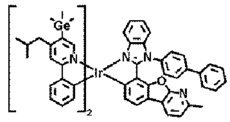
1524
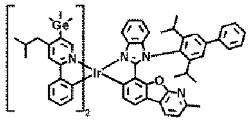
1525

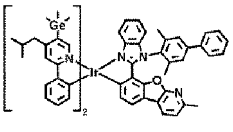
1526
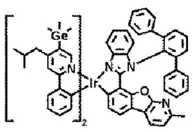
1527
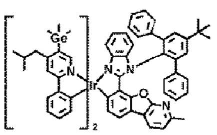
1528
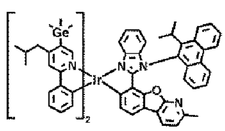
1529
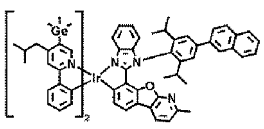
1530

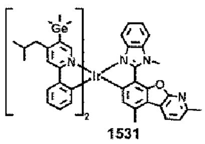
1531
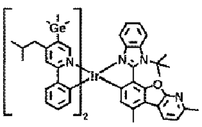
1532
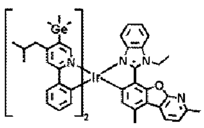
1533
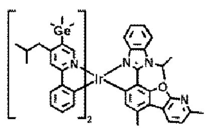
1534
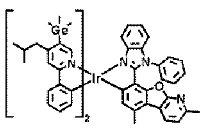
1535

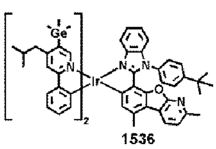
1536
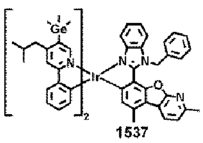
1537
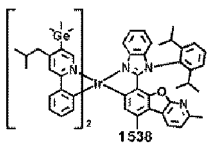
1538
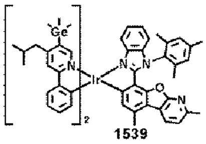
1539
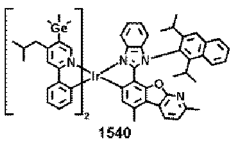
1540

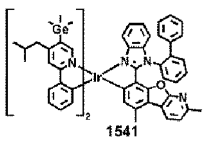
1541
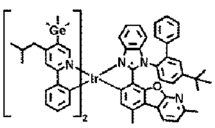
1542
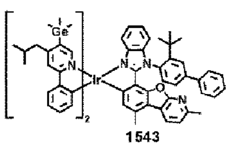
1543
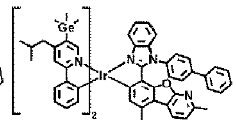
1544
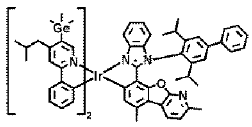
1545

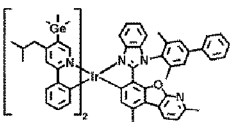
1546
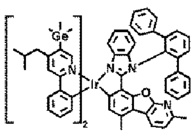
1547
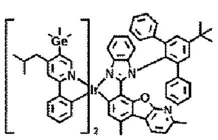
1548
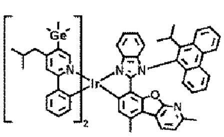
1549
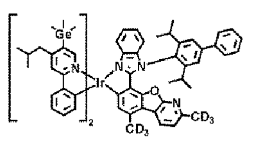
1550

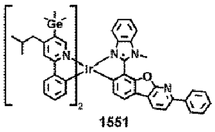
1551
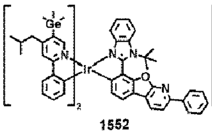
1552
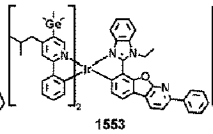
1553
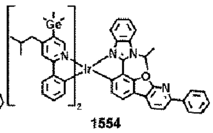
1554
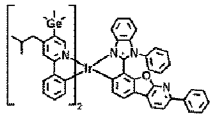
1555

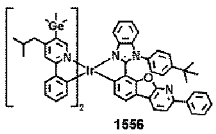
1556
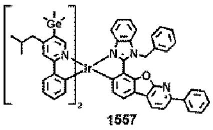
1557
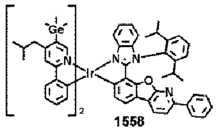
1558
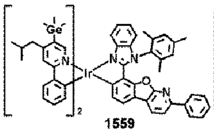
1559
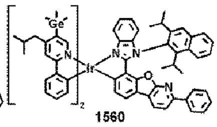
1560

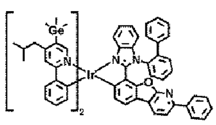
1561
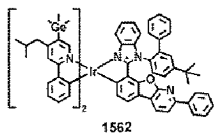
1562
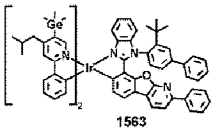
1563
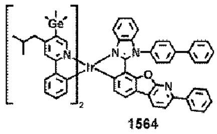
1564
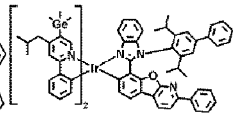
1565

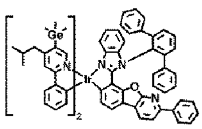
1566
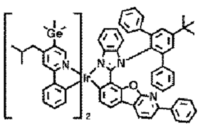
1567
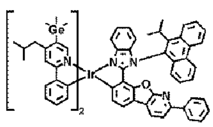
1568
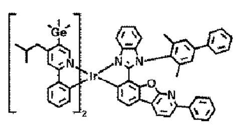
1569
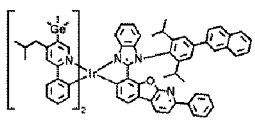
1570

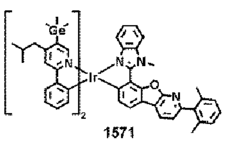
1571
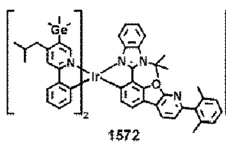
1572
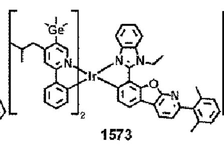
1573
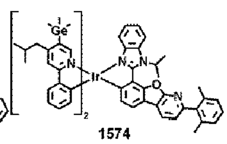
1574
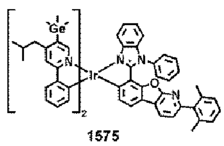
1575

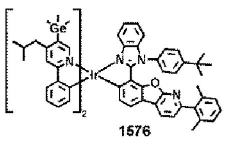
1576
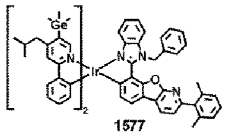
1577
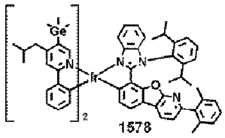
1578
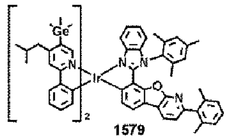
1579
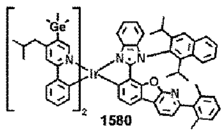
1580

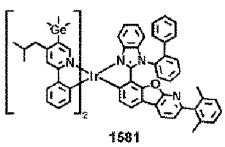
1581
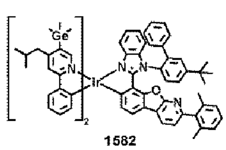
1582
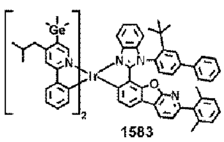
1583
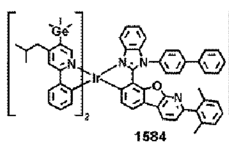
1584
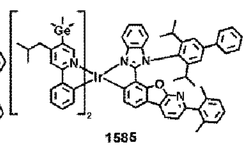
1585

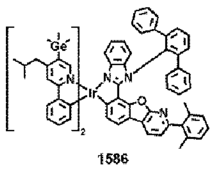
1586
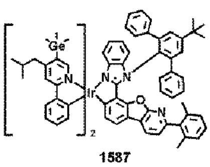
1587
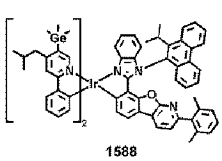
1588
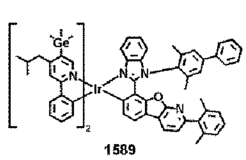
1589
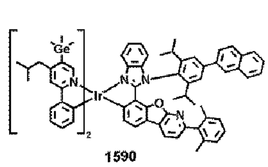
1590

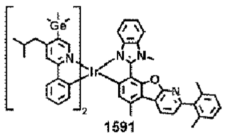
1591
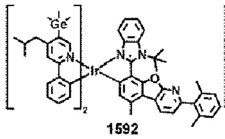
1592
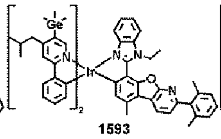
1593
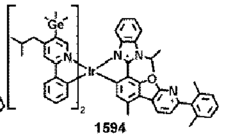
1594
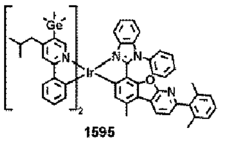
1595
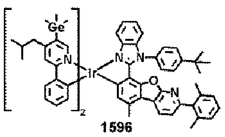
1596
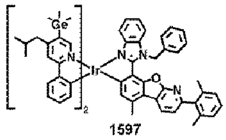
1597
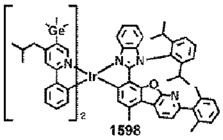
1598
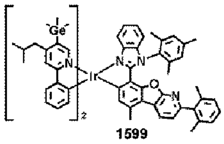
1599
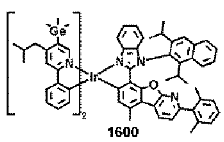
1600
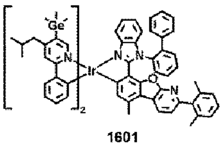
1601
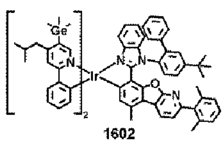
1602
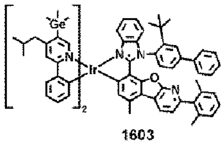
1603
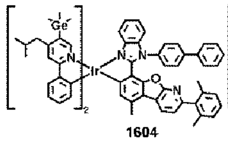
1604
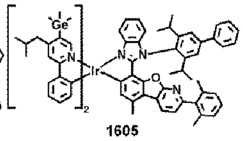
1605
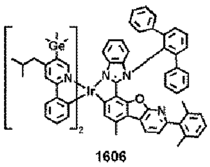
1606
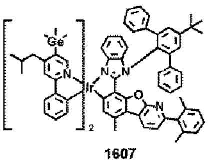
1607
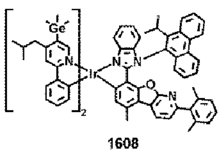
1608
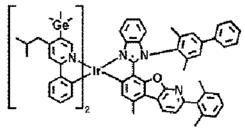
1609
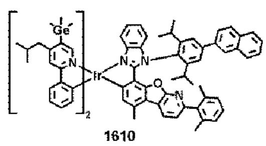
1610
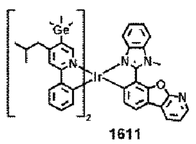
1611
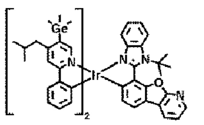
1612
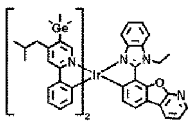
1613
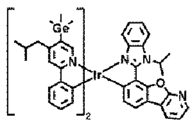
1614
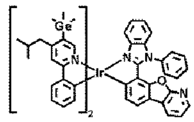
1615
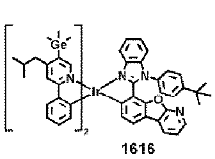
1616
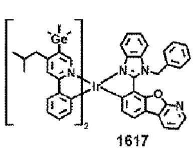
1617
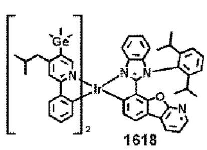
1618
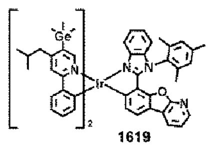
1619
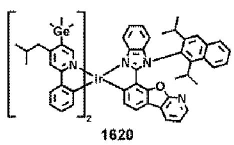
1620
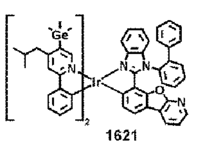
1621
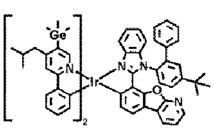
1622
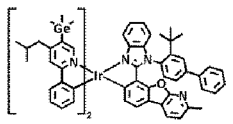
1623
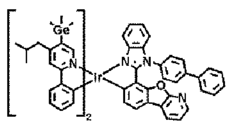
1624
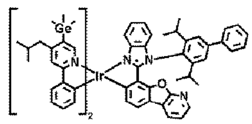
1625
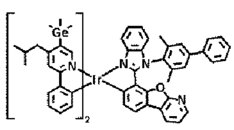
1626
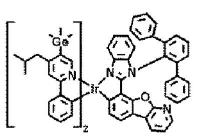
1627
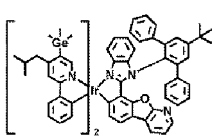
1628
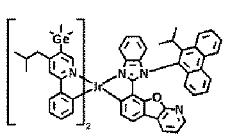
1629
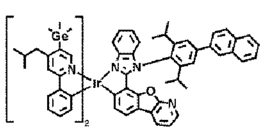
1630

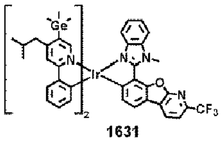
1631
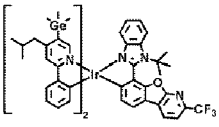
1632
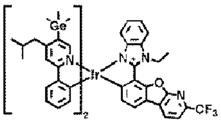
1633
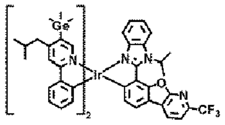
1634
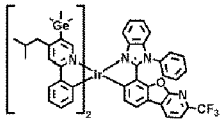
1635
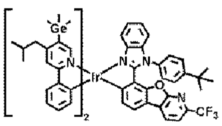
1636
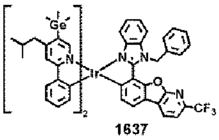
1637
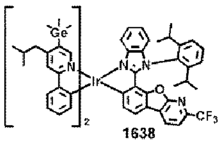
1638
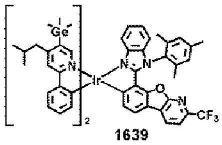
1639
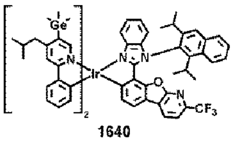
1640
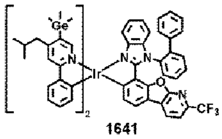
1641
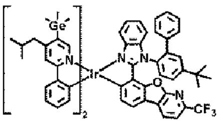
1642
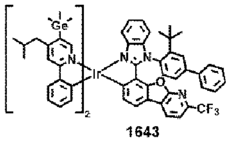
1643
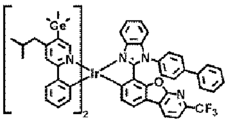
1644
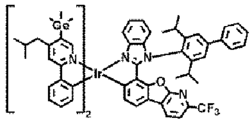
1645
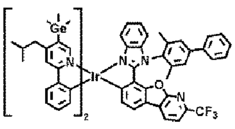
1646
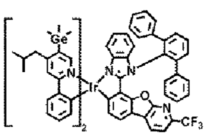
1647
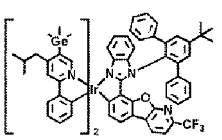
1648
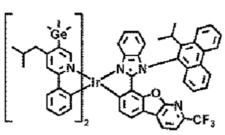
1649
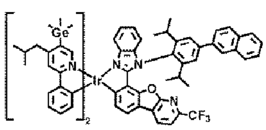
1650
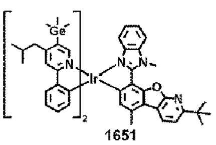
1651
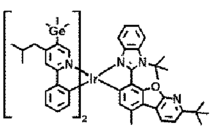
1652
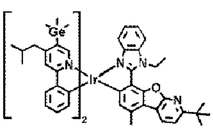
1653
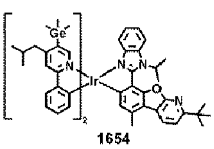
1654
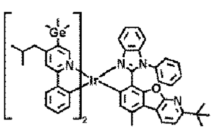
1655
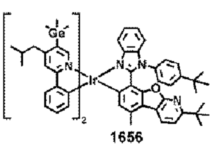
1656
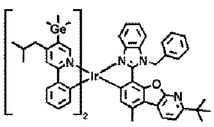
1657
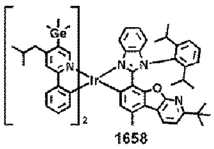
1658
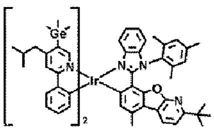
1659
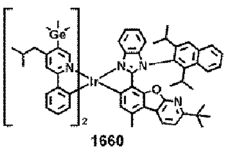
1660
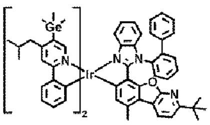
1661
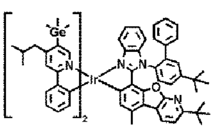
1662
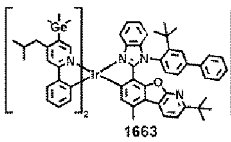
1663
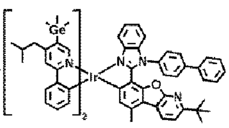
1664
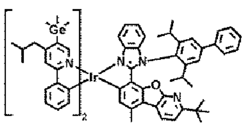
1665
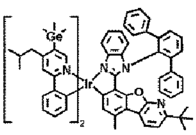
1666
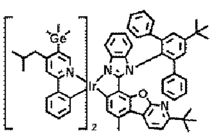
1667
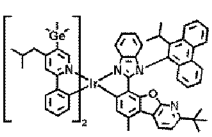
1668
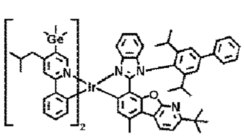
1669
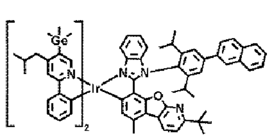
1670

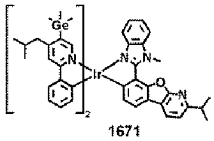
1671
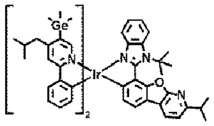
1672
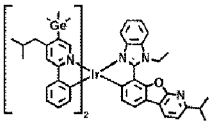
1673
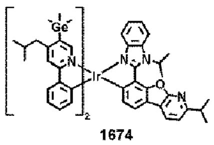
1674
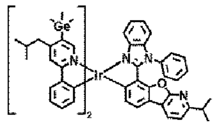
1675
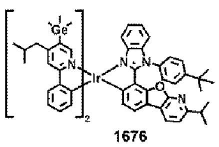
1676
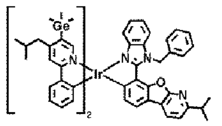
1677
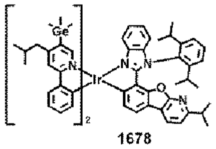
1678
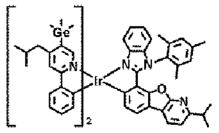
1679
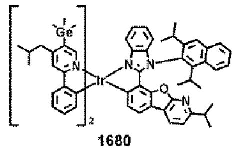
1680
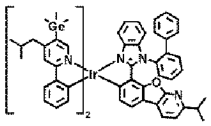
1681
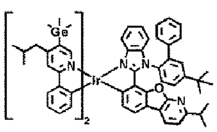
1682
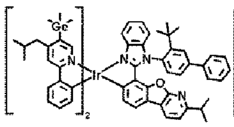
1683
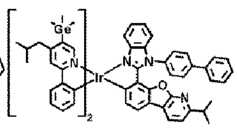
1684
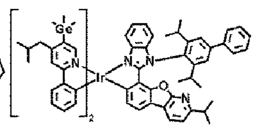
1685
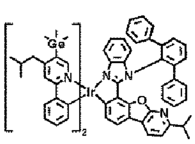
1686
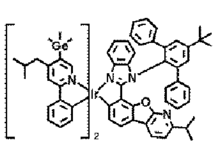
1687
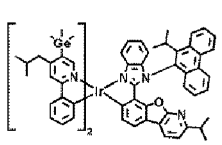
1688
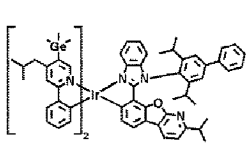
1689
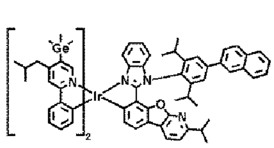
1690
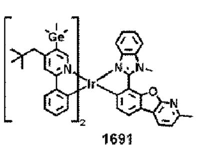
1691
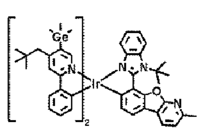
1692
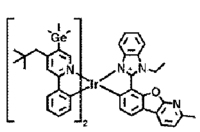
1693
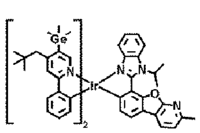
1694
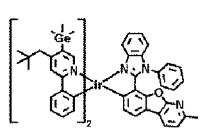
1695
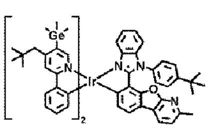
1696
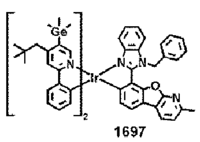
1697
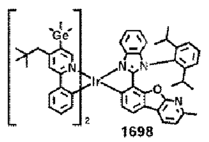
1698
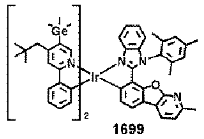
1699
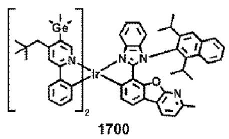
1700
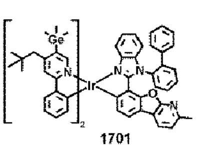
1701
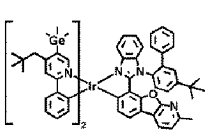
1702
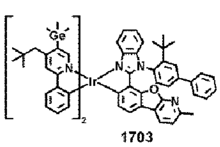
1703
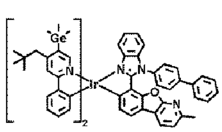
1704
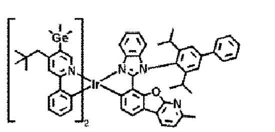
1705
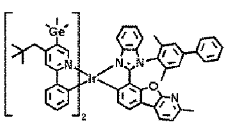
1706
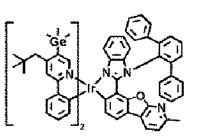
1707
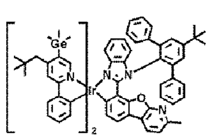
1708
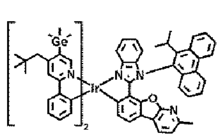
1709
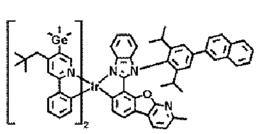
1710

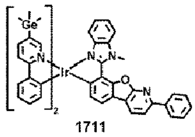
1711
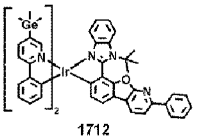
1712
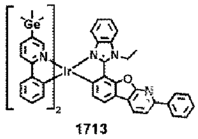
1713
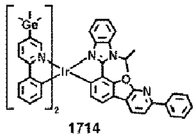
1714
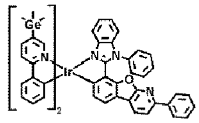
1715
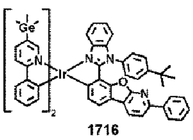
1716
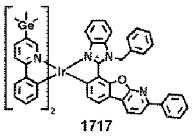
1717
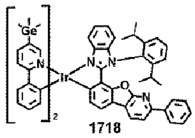
1718
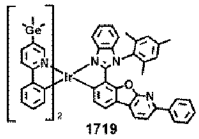
1719
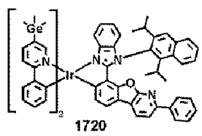
1720
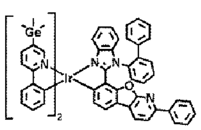
1721
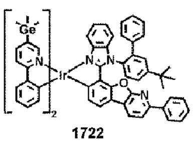
1722
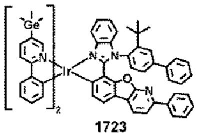
1723
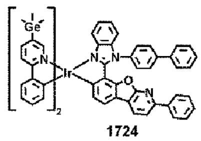
1724
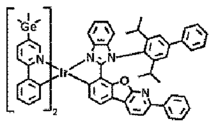
1725
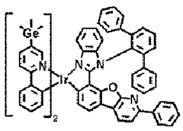
1726
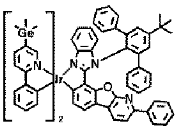
1727
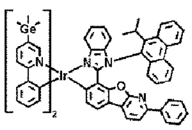
1728
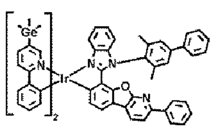
1729
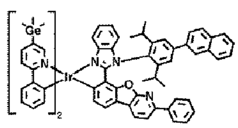
1730
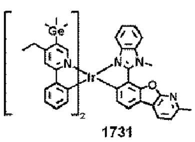
1731
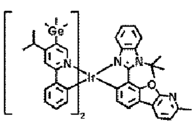
1732
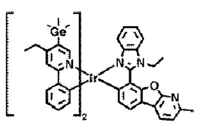
1733
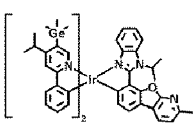
1734
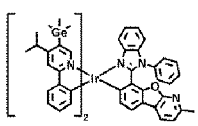
1735
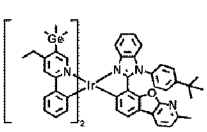
1736
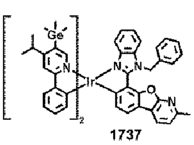
1737
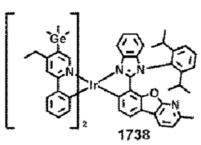
1738
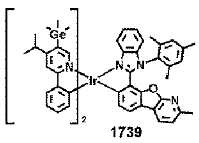
1739
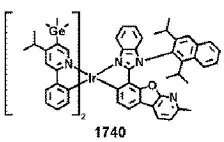
1740
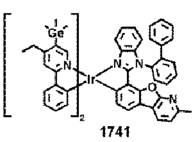
1741
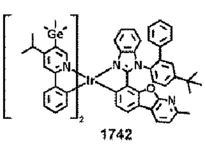
1742
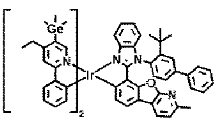
1743
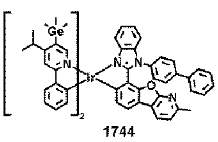
1744
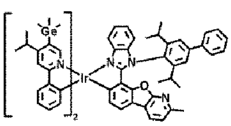
1745
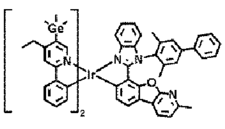
1746
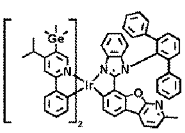
1747
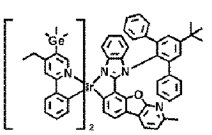
1748
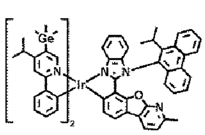
1749
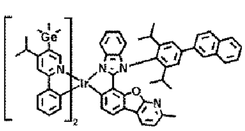
1750

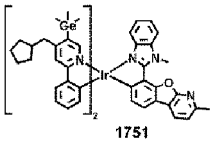
1751
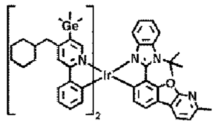
1752
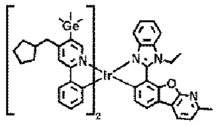
1753
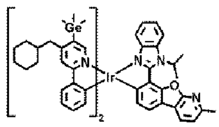
1754
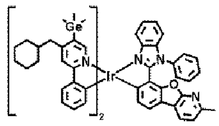
1755

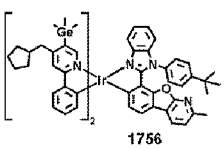
1756
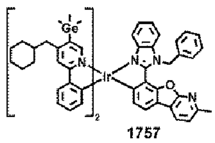
1757
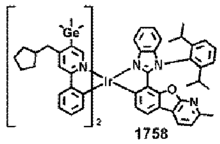
1758
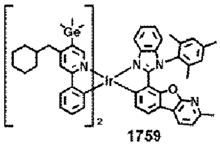
1759
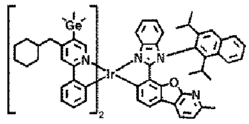
1760

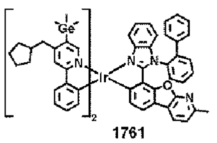
1761
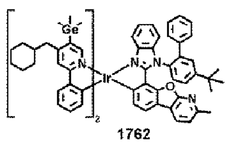
1762
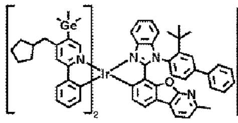
1763
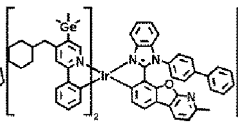
1764
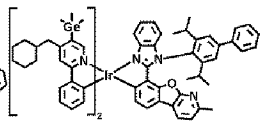
1765

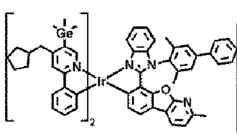
1766
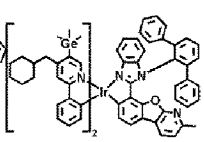
1767
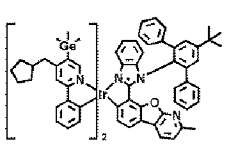
1768
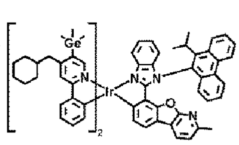
1769
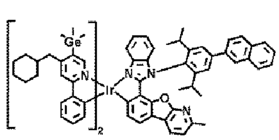
1770

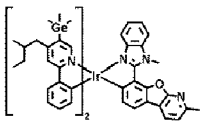
1771
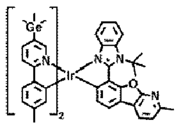
1772
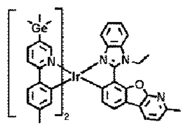
1773
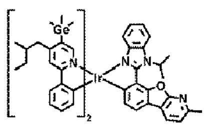
1774
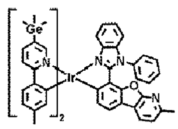
1775

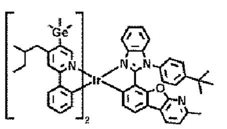
1776
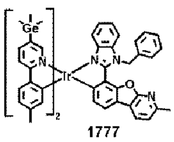
1777
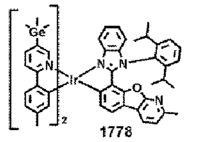
1778
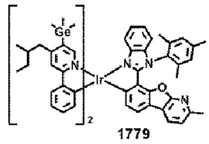
1779
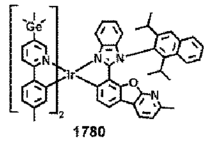
1780

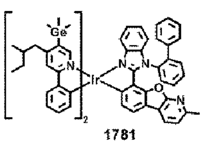
1781
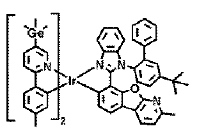
1782
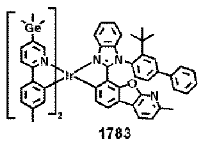
1783
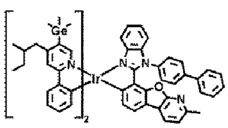
1784
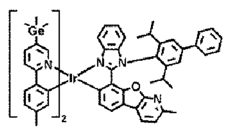
1785

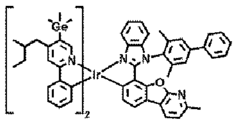
1786
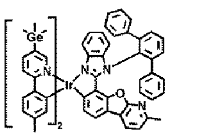
1787
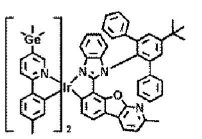
1788
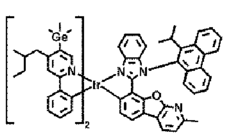
1789
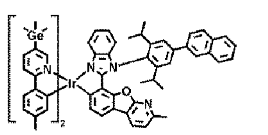
1790

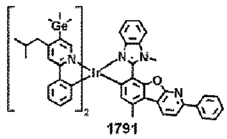
1791

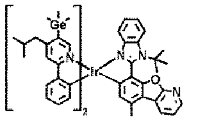
1792

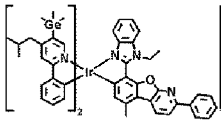
1793

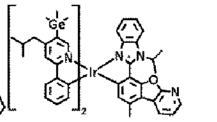
1794

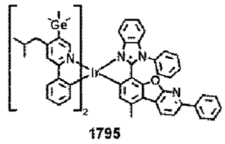
1795

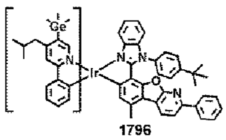
1796

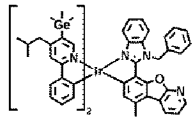
1797

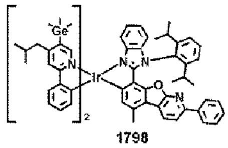
1798

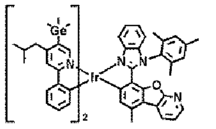
1799

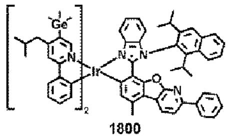
1800

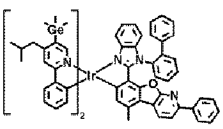
1801

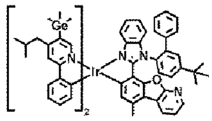
1802

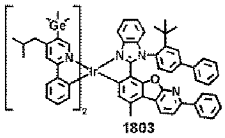
1803

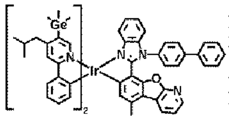
1804

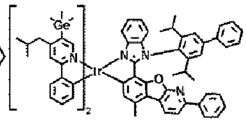
1805

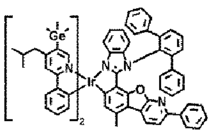
1806

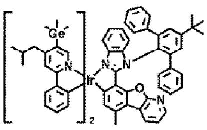
1807

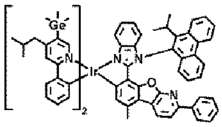
1808

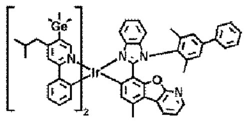
1809

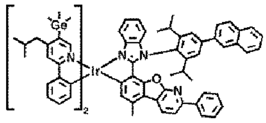
1810

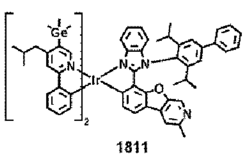
1811

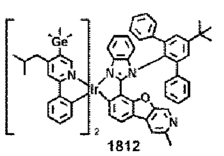
1812

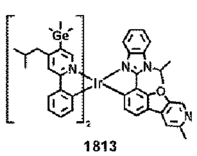
1813

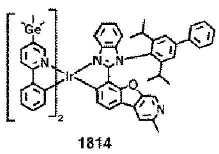
1814

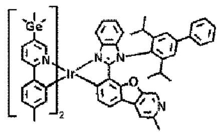
1815

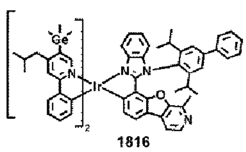
1816

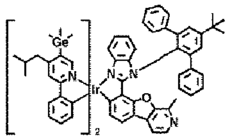
1817

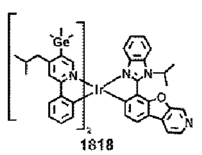
1818

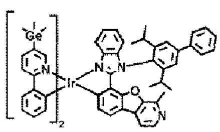
1819

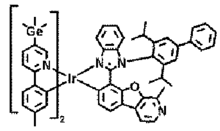
1820

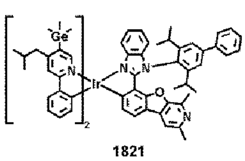
1821

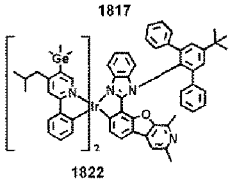
1822

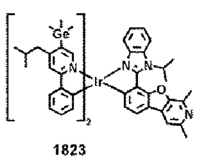
1823

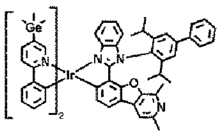
1824

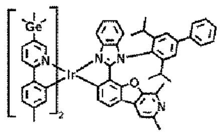
1825

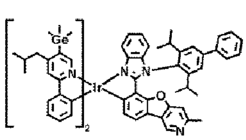
1826

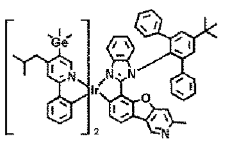
1827

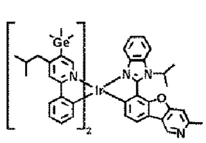
1828

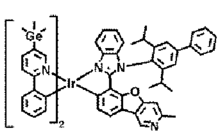
1829

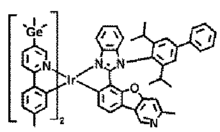
1830

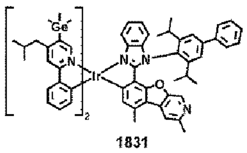
1831
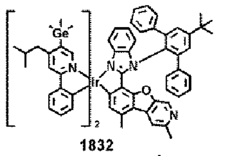
1832
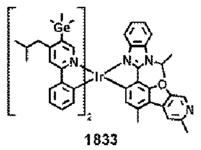
1833
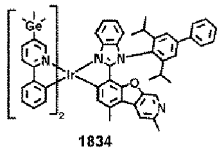
1834
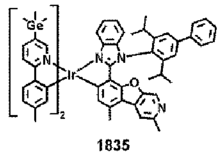
1835
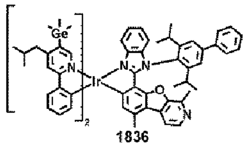
1836
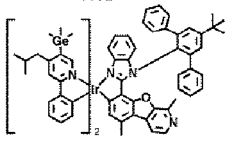
1837
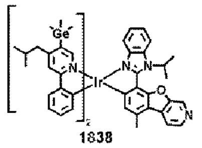
1838
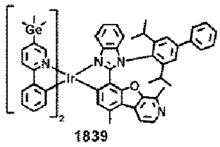
1839
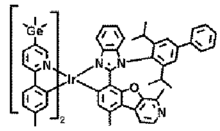
1840
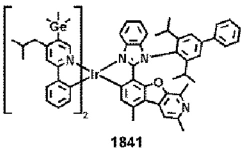
1841
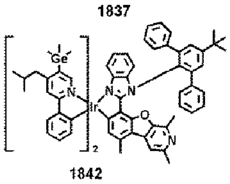
1842
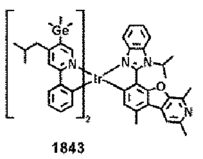
1843
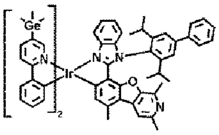
1844
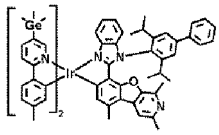
1845
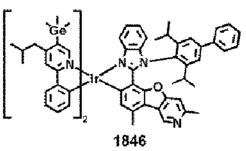
1846
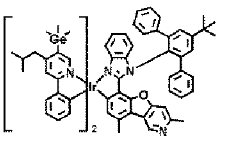
1847
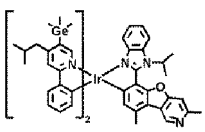
1848
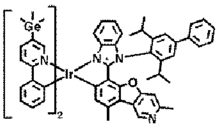
1849
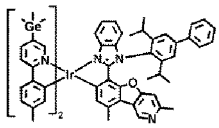
1850
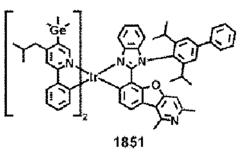
1851
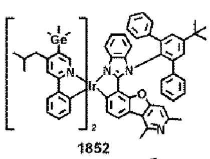
1852
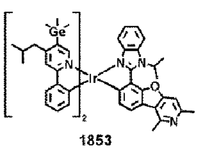
1853
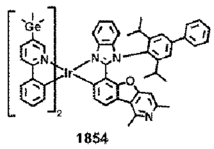
1854
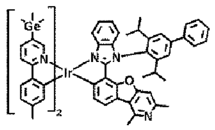
1855
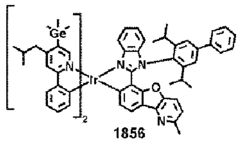
1856
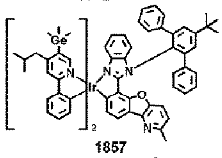
1857
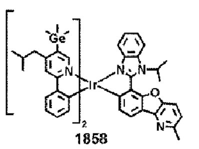
1858
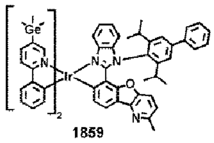
1859
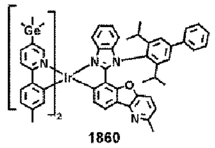
1860
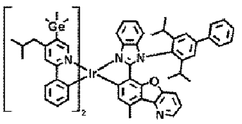
1861
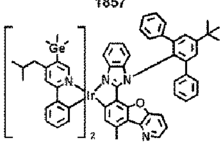
1862
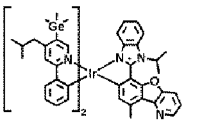
1863
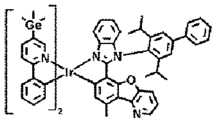
1864
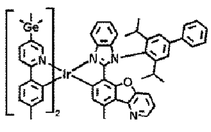
1865
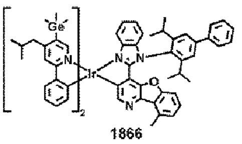
1866
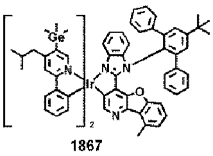
1867
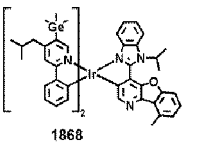
1868
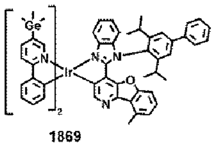
1869
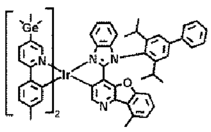
1870

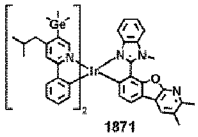
1871

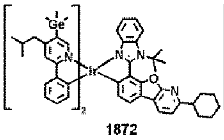
1872

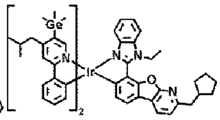
1873

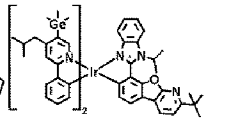
1874

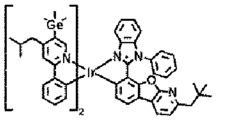
1875

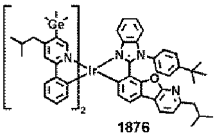
1876

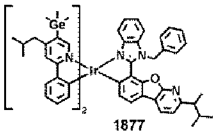
1877

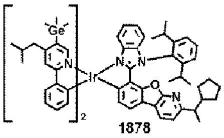
1878

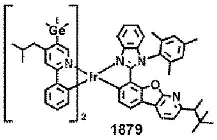
1879

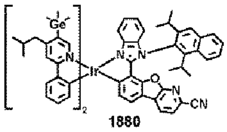
1880

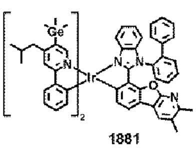
1881

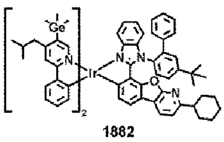
1882

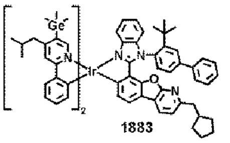
1883

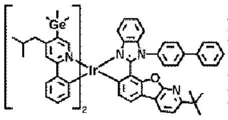
1884

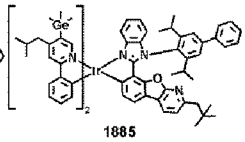
1885

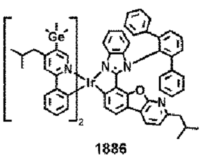
1886

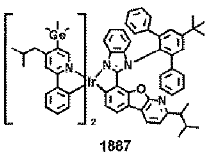
1887

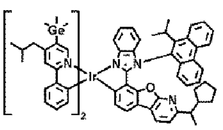
1888

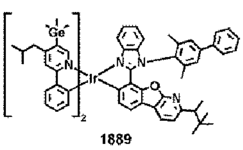
1889

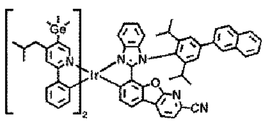
1890

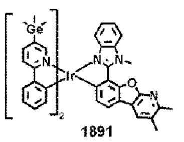
1891

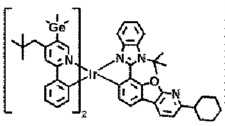
1892

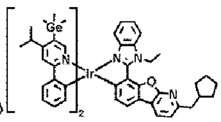
1893

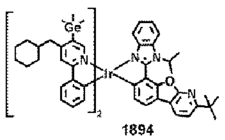
1894

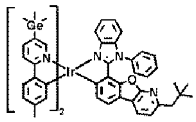
1895

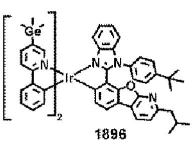
1896

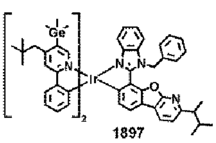
1897

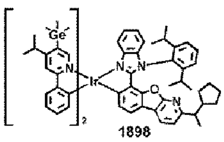
1898

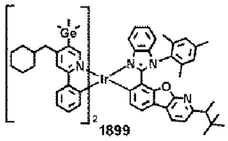
1899

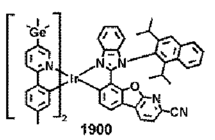
1900

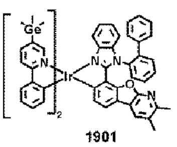
1901

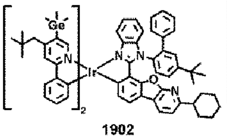
1902

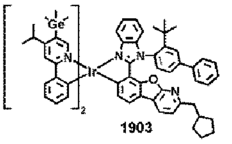
1903

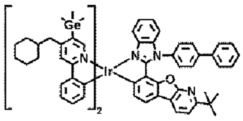
1904

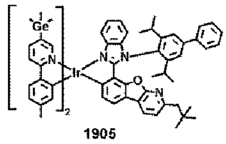
1905

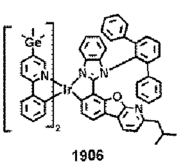
1906

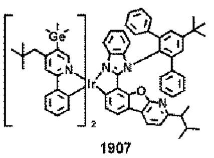
1907

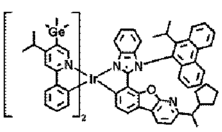
1908

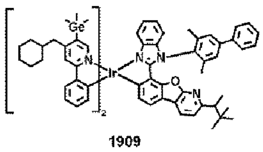
1909

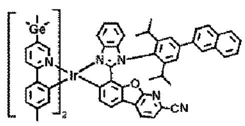
1910

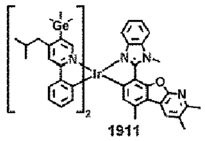
1911
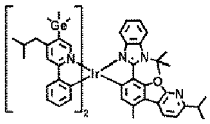
1912
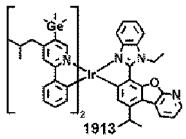
1913
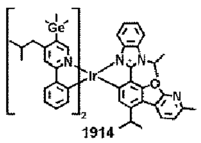
1914
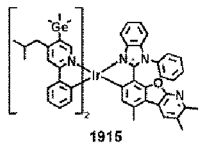
1915

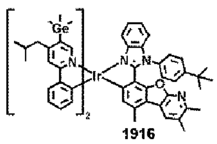
1916
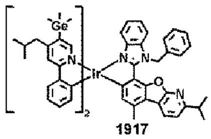
1917
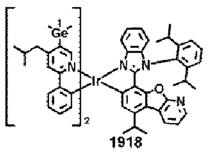
1918
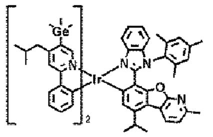
1919
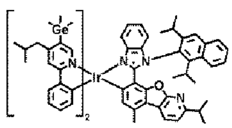
1920

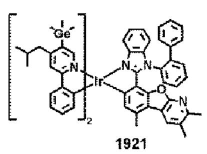
1921
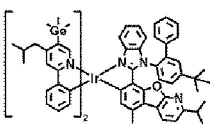
1922
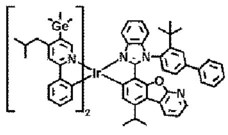
1923
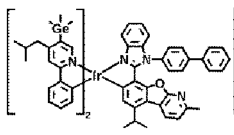
1924
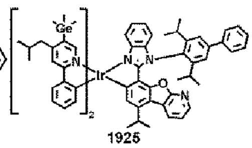
1925

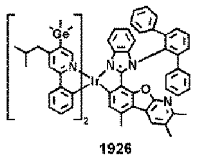
1926
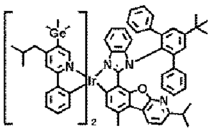
1927
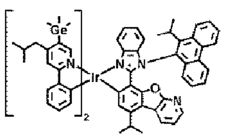
1928
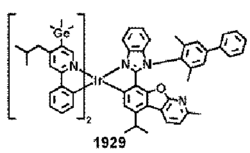
1929
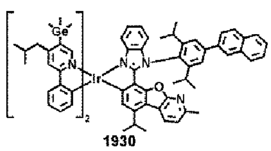
1930

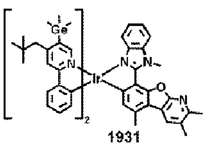
1931
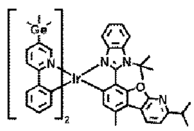
1932
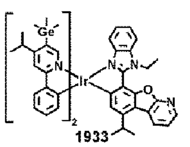
1933
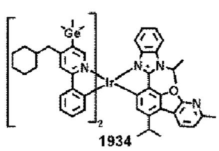
1934
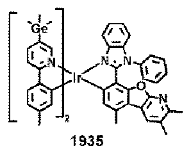
1935

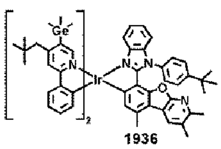
1936
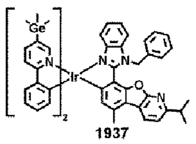
1937
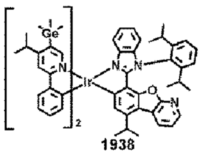
1938
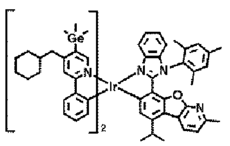
1939
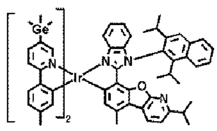
1940

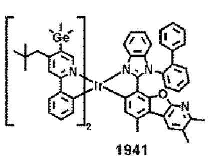
1941
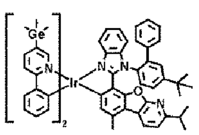
1942
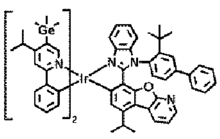
1943
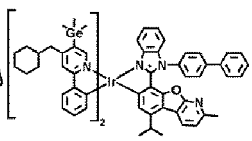
1944
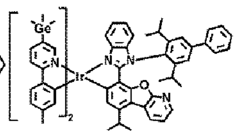
1945

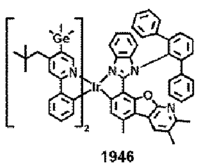
1946
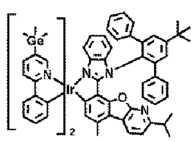
1947
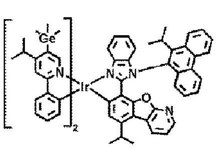
1948
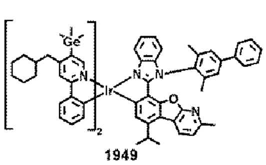
1949
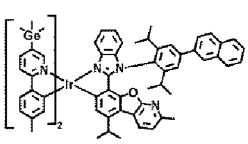
1950

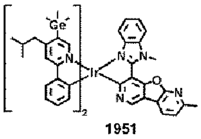
1951
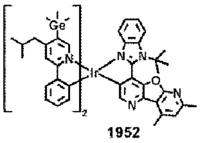
1952
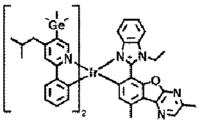
1953
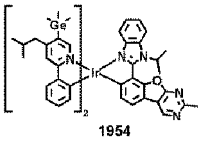
1954
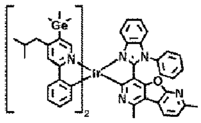
1955
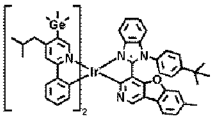
1956
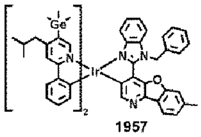
1957
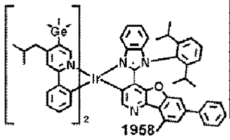
1958
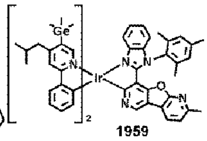
1959
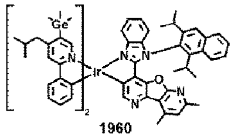
1960
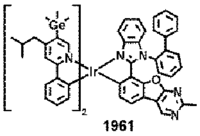
1961
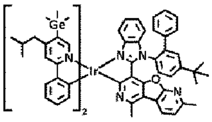
1962
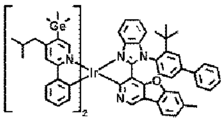
1963
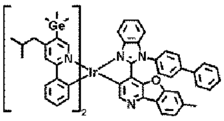
1964
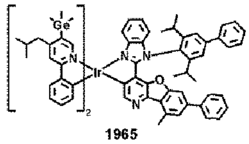
1965
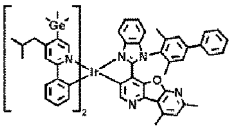
1966
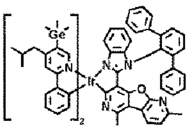
1967
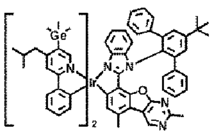
1968
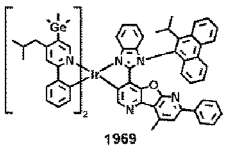
1969
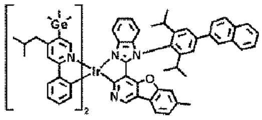
1970
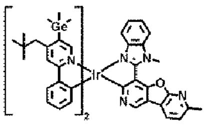
1971
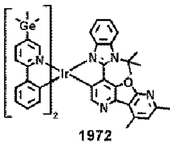
1972
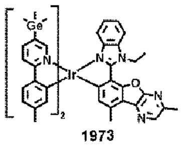
1973
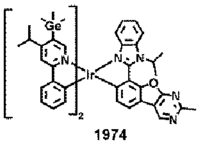
1974
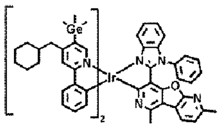
1975
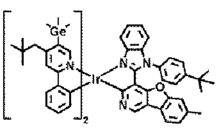
1976
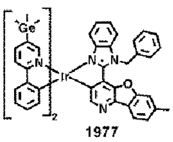
1977
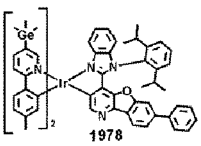
1978
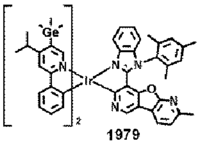
1979
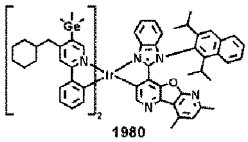
1980
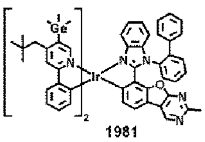
1981
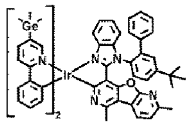
1982
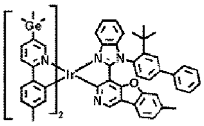
1983
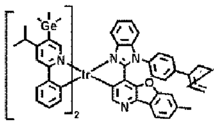
1984
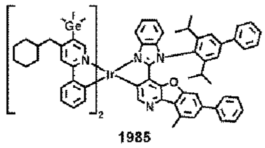
1985
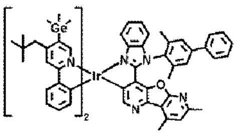
1986
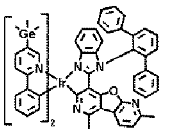
1987
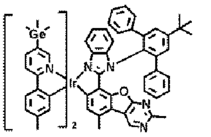
1988
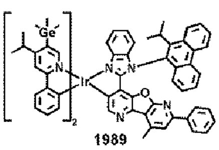
1989
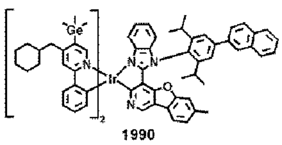
1990

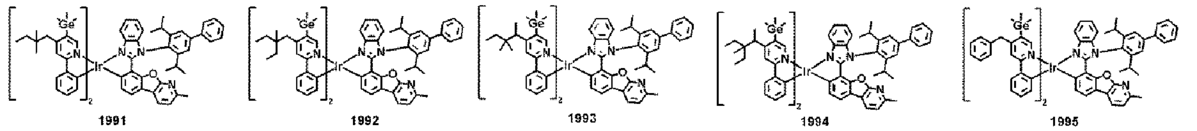

1991 1992 1993 1994 1995

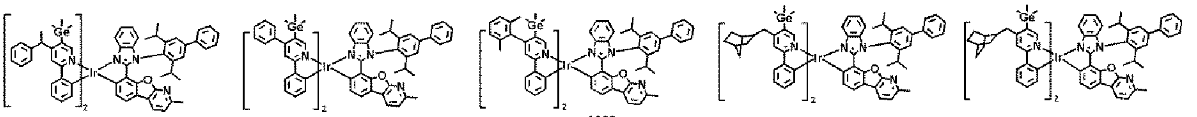

1996 1997 1998 1999 2000

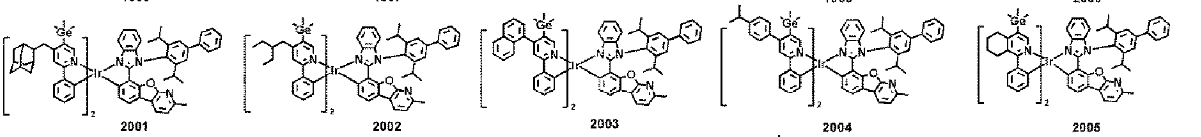

2001 2002 2003 2004 2005

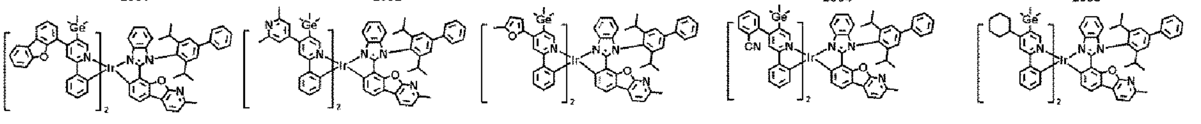

2006 2007 2008 2009 2010

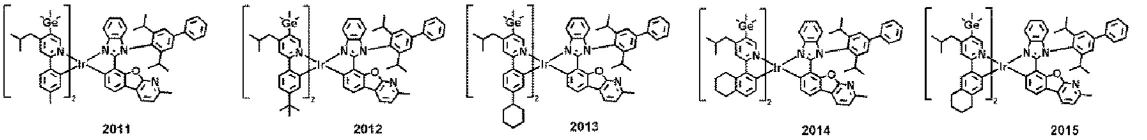

2011 2012 2013 2014 2015

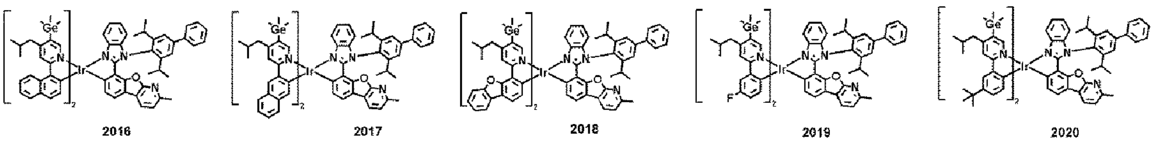

2016 2017 2018 2019 2020

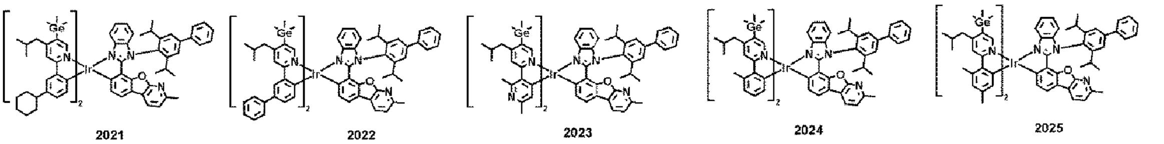

2021 2022 2023 2024 2025

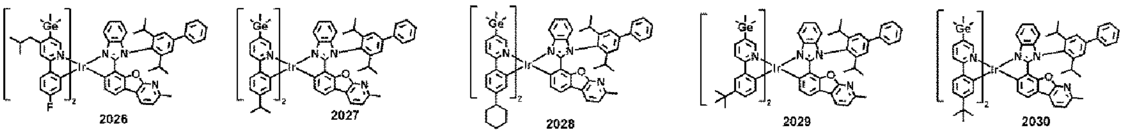

2026 2027 2028 2029 2030

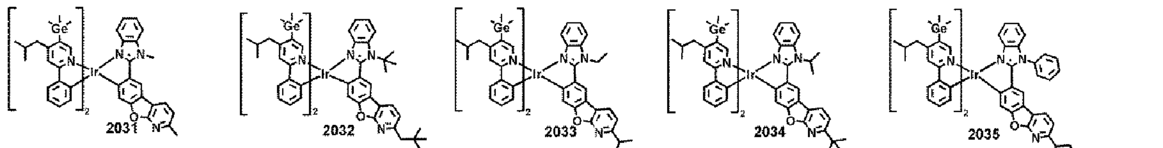

2031 2032 2033 2034 2035

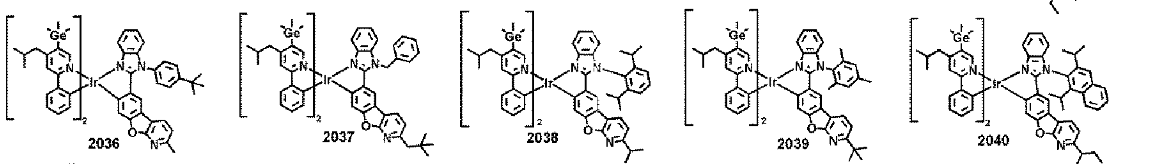

2036 2037 2038 2039 2040

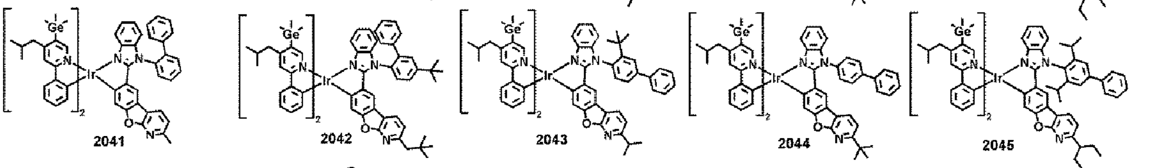

2041 2042 2043 2044 2045

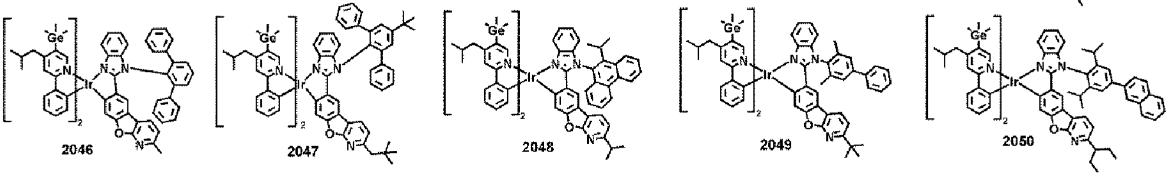

2046 2047 2048 2049 2050

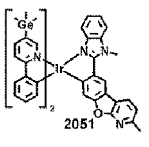
2051
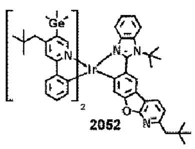
2052
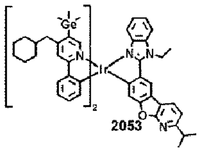
2053
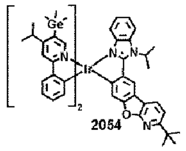
2054
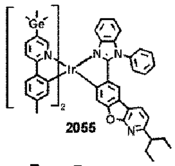
2055
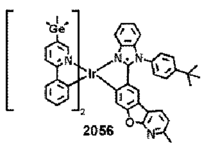
2056
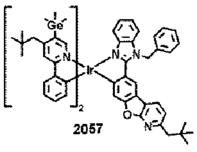
2057
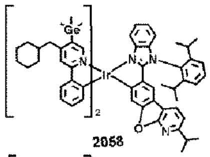
2058
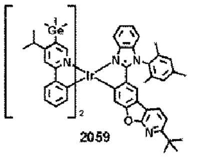
2059
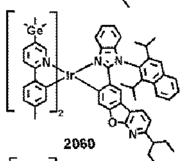
2060
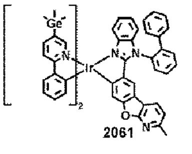
2061
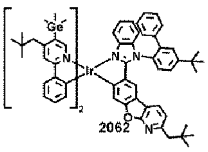
2062
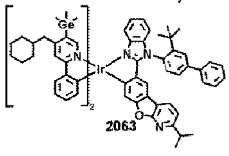
2063
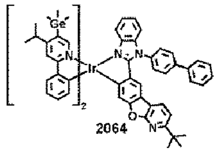
2064
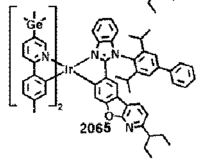
2065
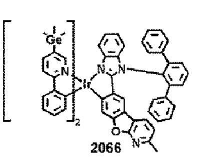
2066
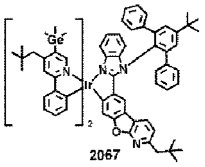
2067
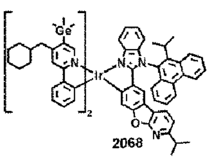
2068
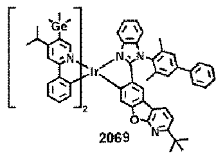
2069
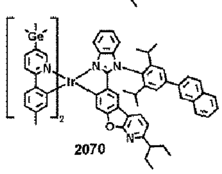
2070
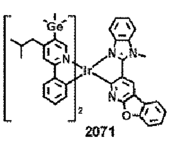
2071
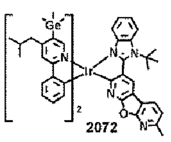
2072
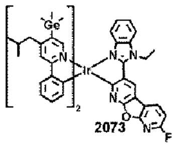
2073
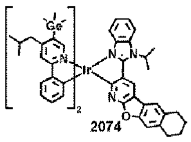
2074
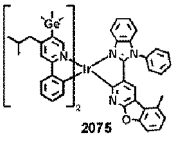
2075
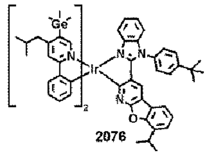
2076
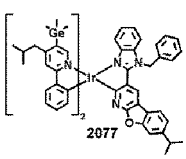
2077
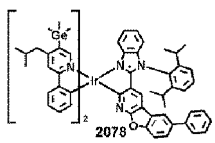
2078
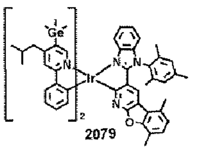
2079
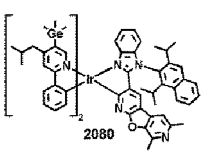
2080
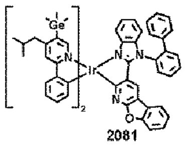
2081
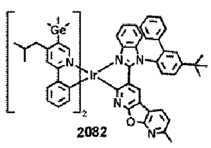
2082
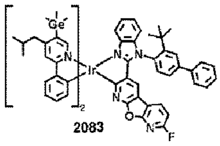
2083
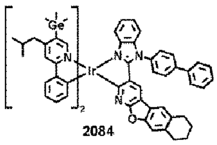
2084
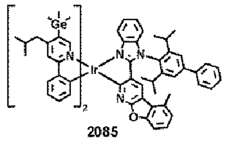
2085
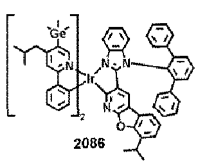
2086
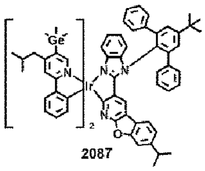
2087
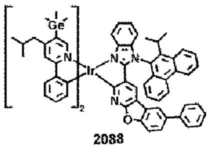
2088
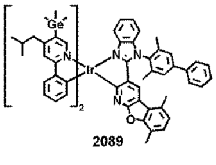
2089
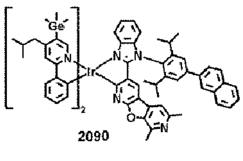
2090

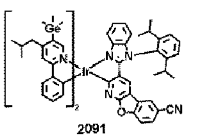
2091

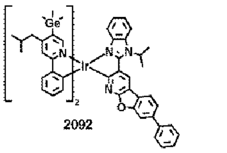
2092

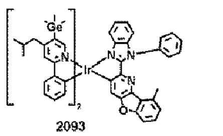
2093

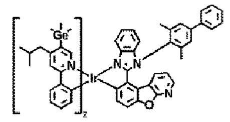
2094

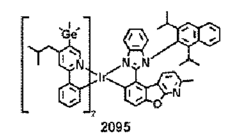
2095

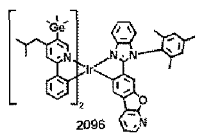
2096

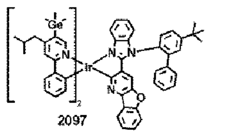
2097

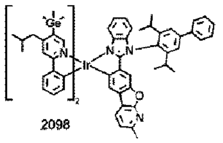
2098

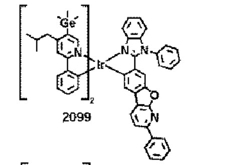
2099

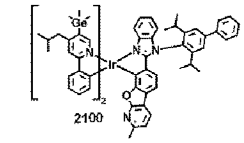
2100

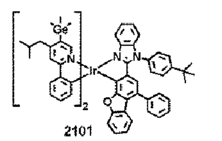
2101

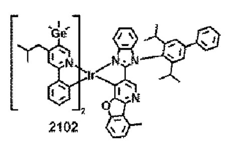
2102

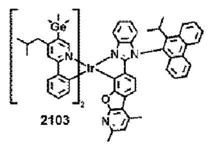
2103

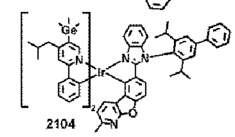
2104

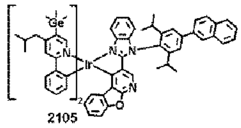
2105

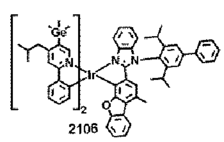
2106

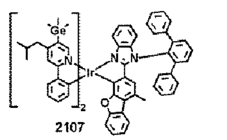
2107

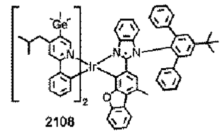
2108

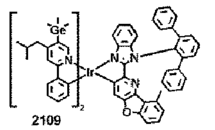
2109

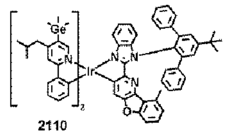
2110

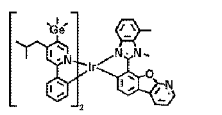
2111

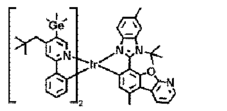
2112

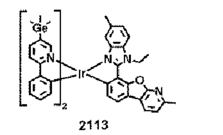
2113

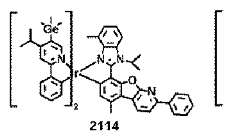
2114

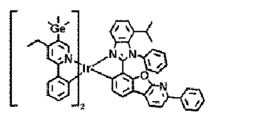
2115

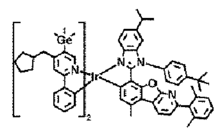
2116

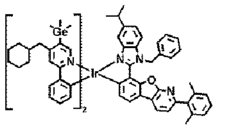
2117

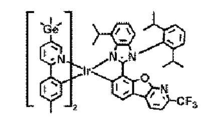
2118

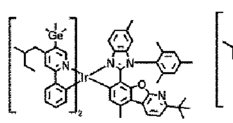
2119

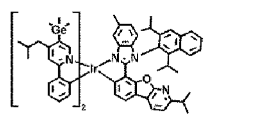
2120

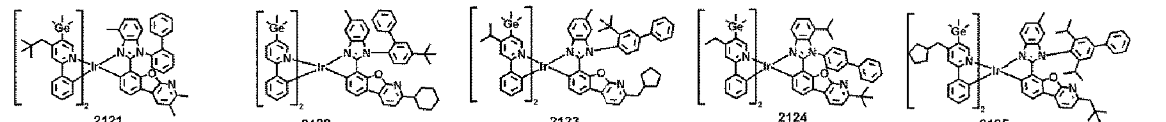
2121 2122 2123 2124 2125

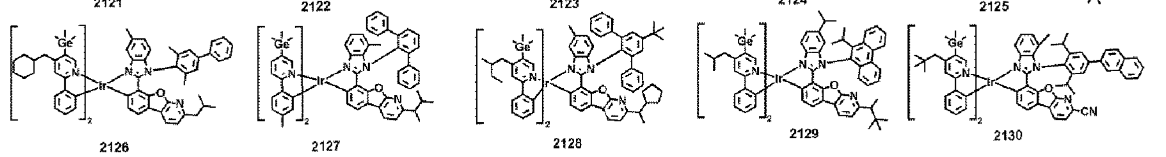
2126 2127 2128 2129 2130

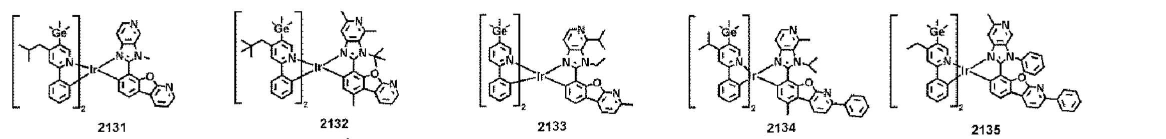
2131 2132 2133 2134 2135

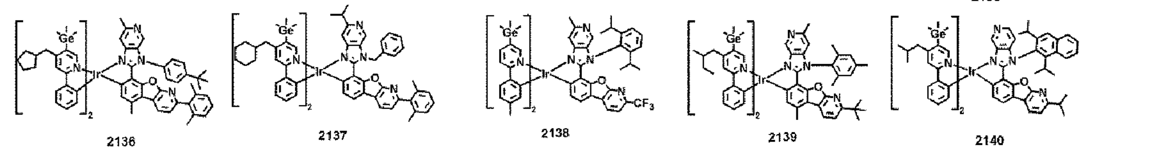
2136 2137 2138 2139 2140

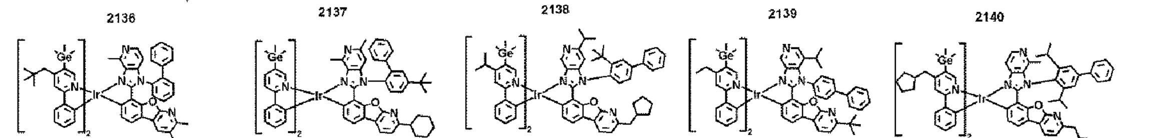
2141 2142 2143 2144 2145

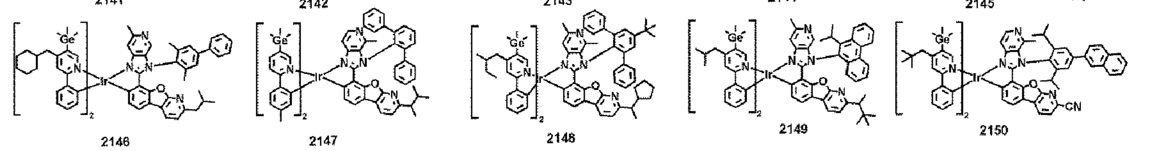
2146 2147 2148 2149 2150

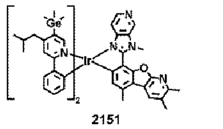
2151
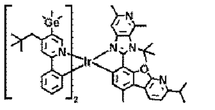
2152
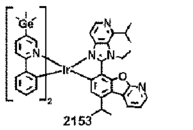
2153
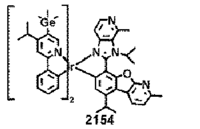
2154
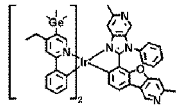
2155

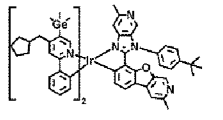
2156
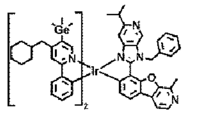
2157
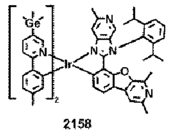
2158
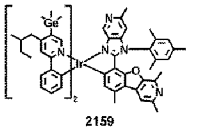
2159
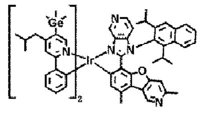
2160

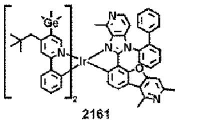
2161
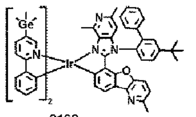
2162
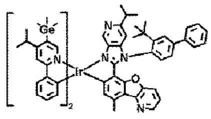
2163
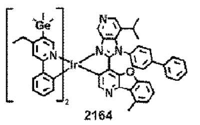
2164
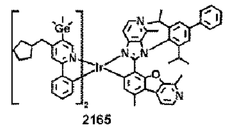
2165

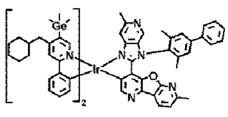
2166
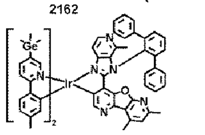
2167
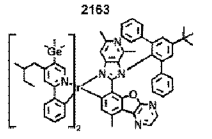
2168
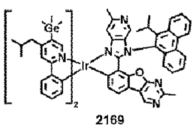
2169
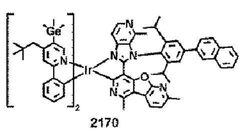
2170

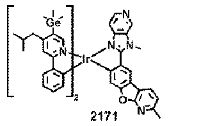
2171
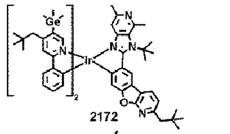
2172
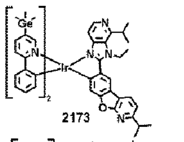
2173
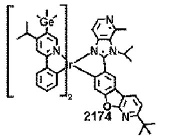
2174
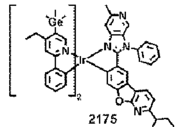
2175

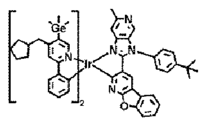
2176
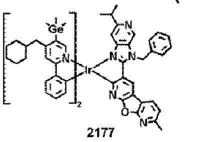
2177
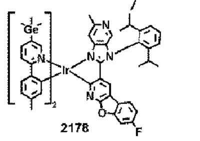
2178
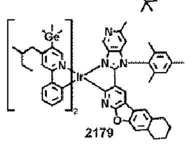
2179
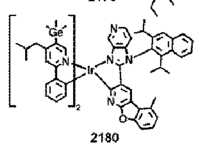
2180

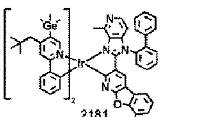
2181
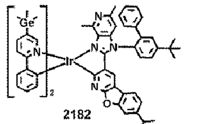
2182
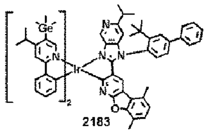
2183
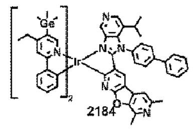
2184
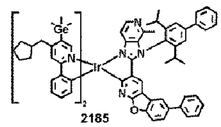
2185

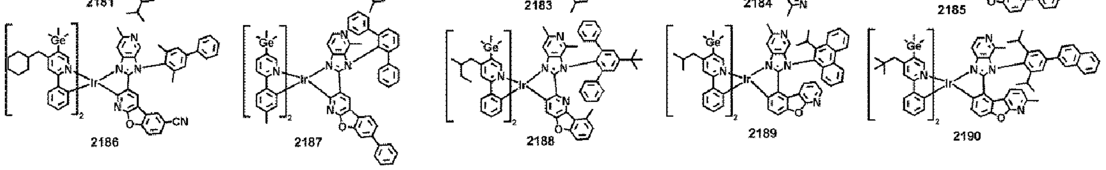
2186 2187 2188 2189 2190

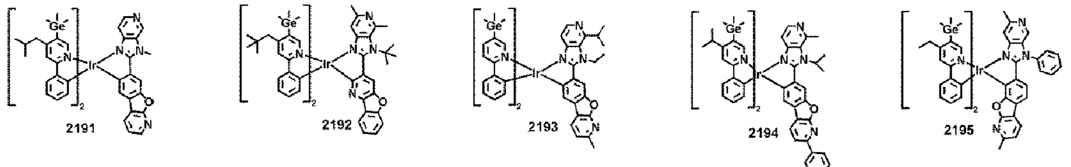
2191 2192 2193 2194 2195

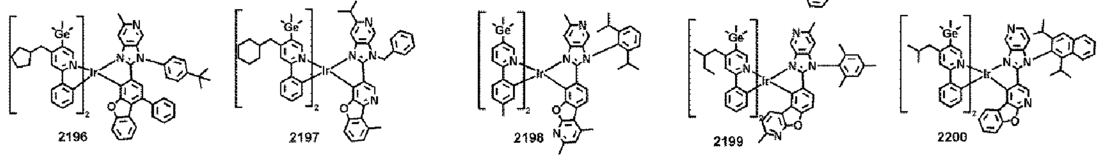
2196 2197 2198 2199 2200

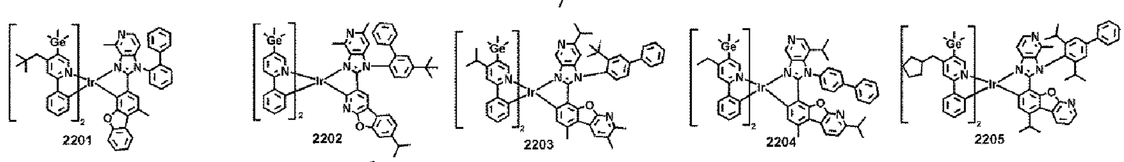
2201 2202 2203 2204 2205

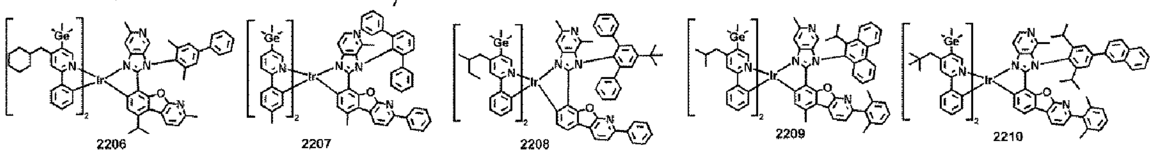
2206 2207 2208 2209 2210

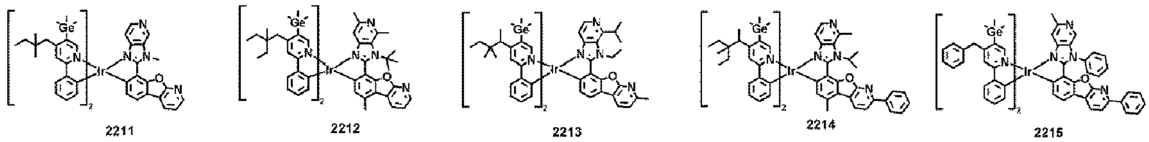

2211 2212 2213 2214 2215

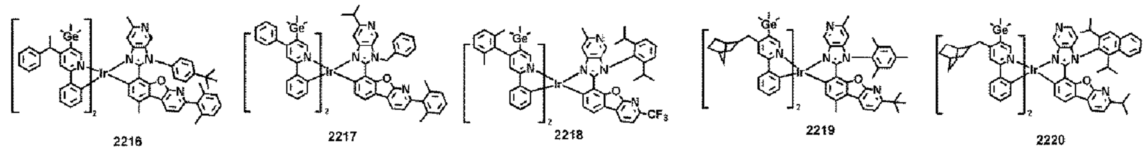

2216 2217 2218 2219 2220

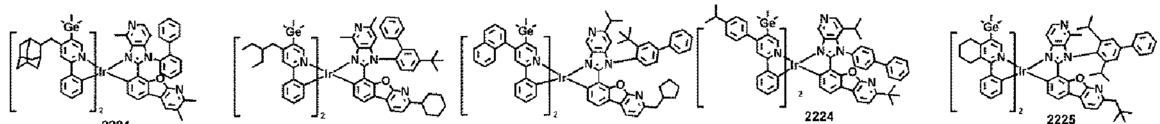

2221 2222 2223 2224 2225

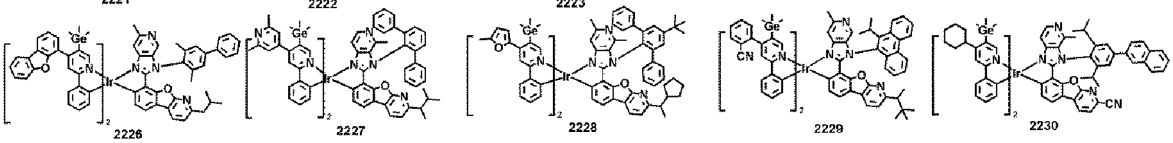

2226 2227 2228 2229 2230

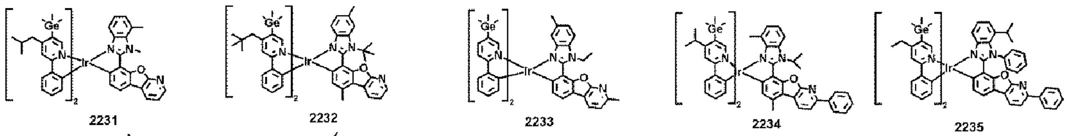

2231 2232 2233 2234 2235

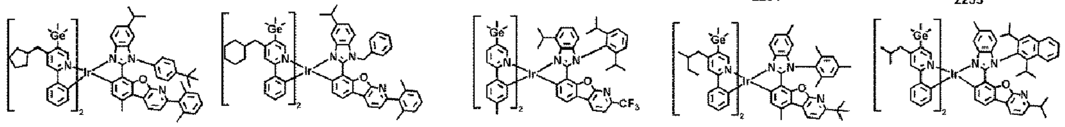

2236 2237 2238 2239 2240

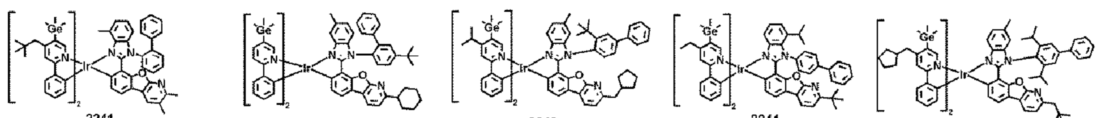

2241 2242 2243 2244 2245

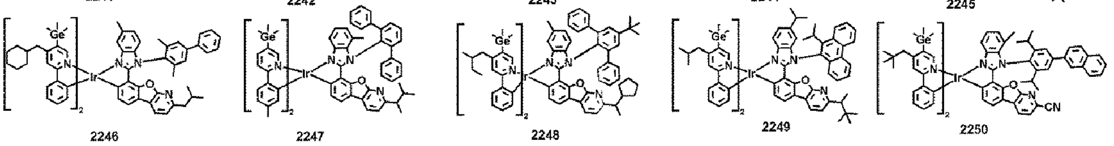

2246 2247 2248 2249 2250

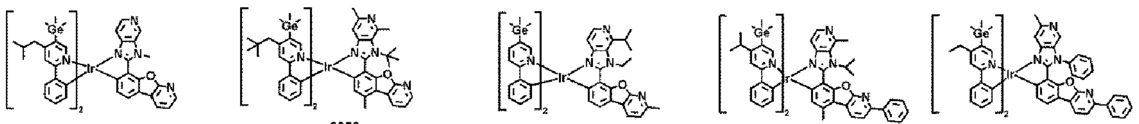

2251 2252 2253 2254 2255

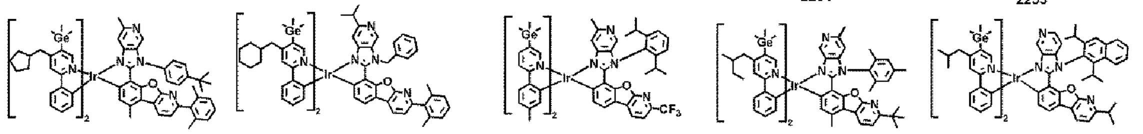

2256 2257 2258 2259 2260

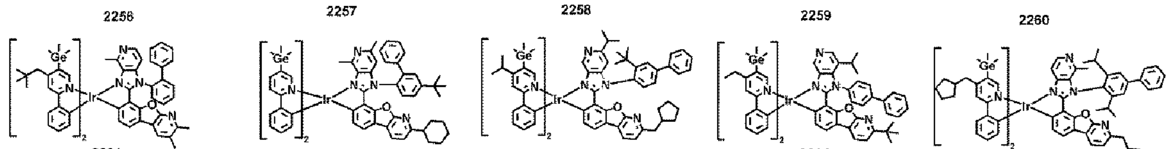

2261 2262 2263 2264 2265

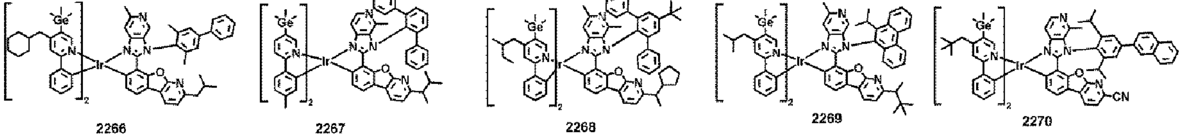

2266 2267 2268 2269 2270

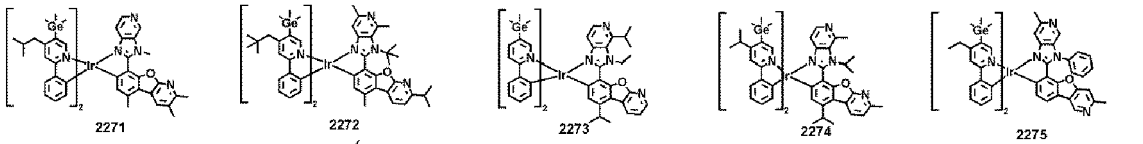
2271 2272 2273 2274 2275

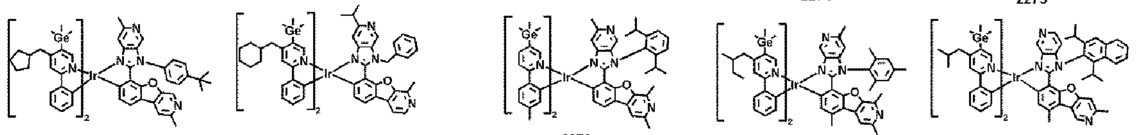
2276 2277 2278 2279 2280

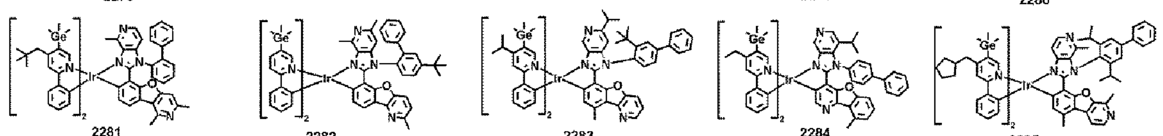
2281 2282 2283 2284 2285

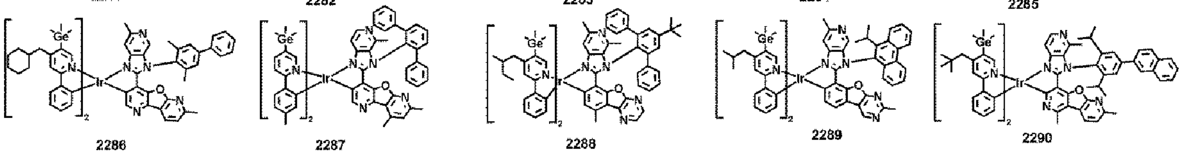
2286 2287 2288 2289 2290

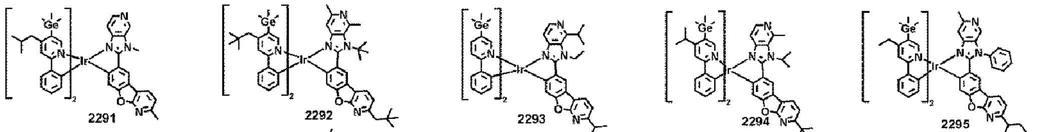
2291 2292 2293 2294 2295

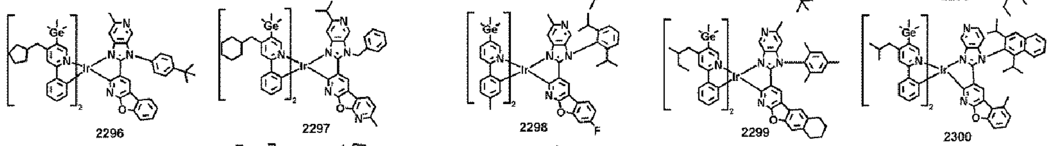
2296 2297 2298 2299 2300

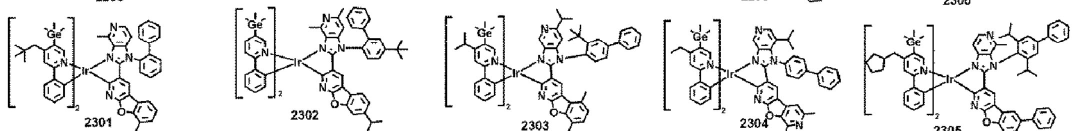
2301 2302 2303 2304 2305

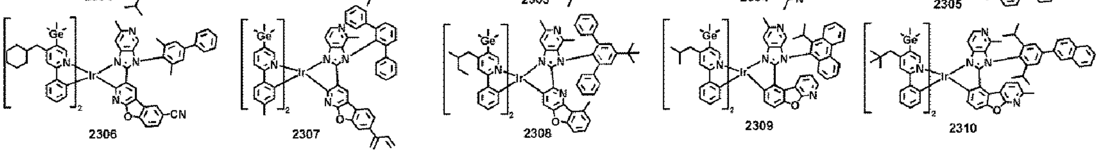
2306 2307 2308 2309 2310

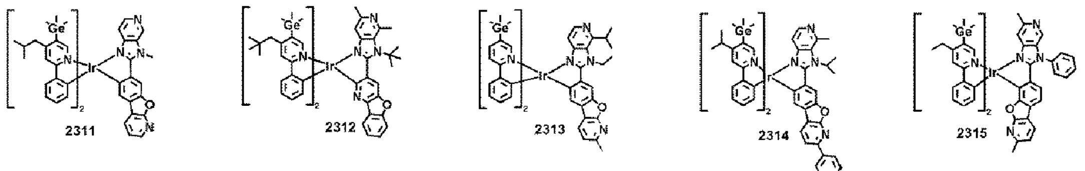
2311 2312 2313 2314 2315

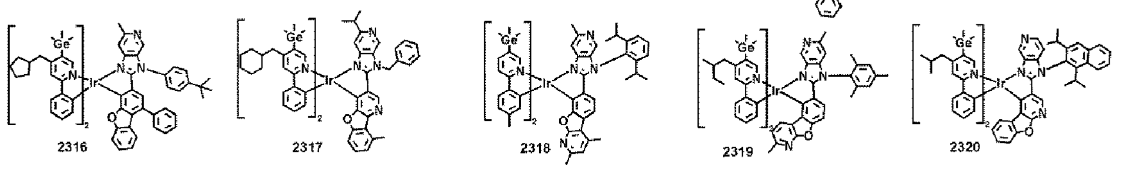
2316 2317 2318 2319 2320

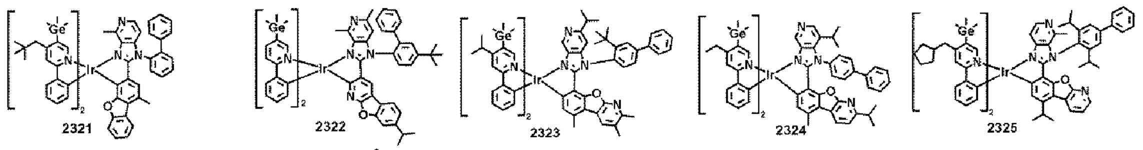
2321 2322 2323 2324 2325

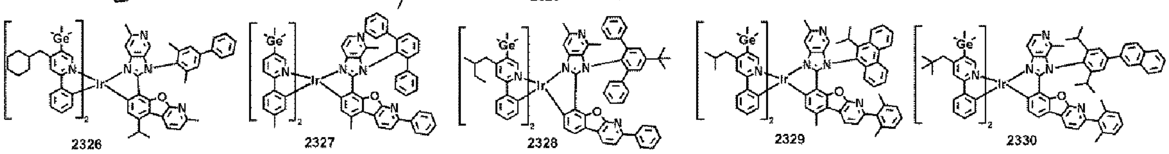
2326 2327 2328 2329 2330

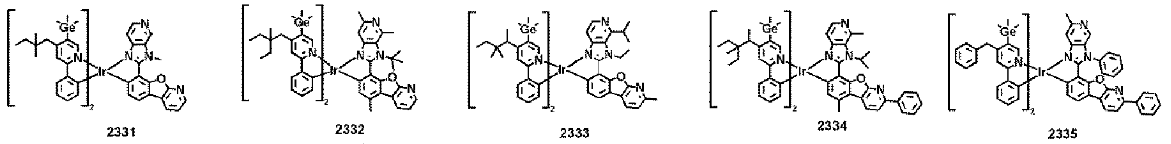

2331 2332 2333 2334 2335

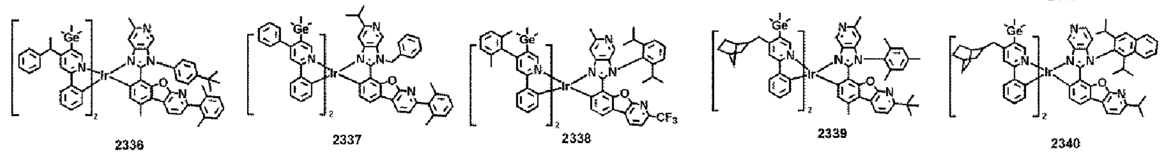

2336 2337 2338 2339 2340

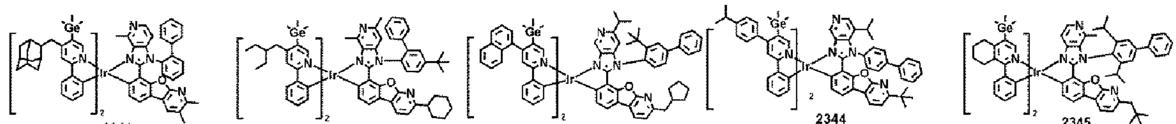

2341 2342 2343 2344 2345

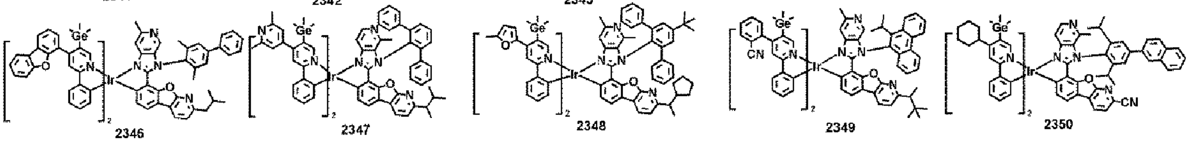

2346 2347 2348 2349 2350

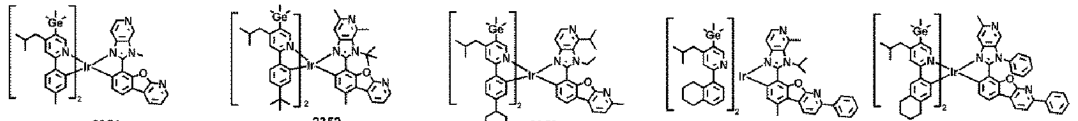

2351 2352 2353 2354 2355

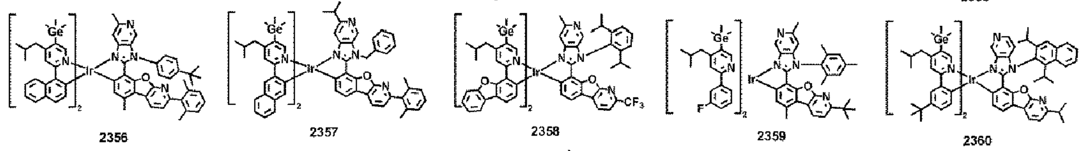

2356 2357 2358 2359 2360

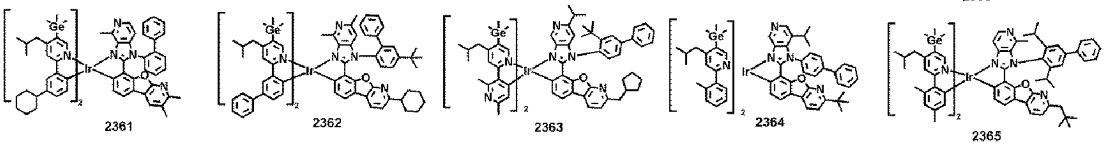

2361 2362 2363 2364 2365

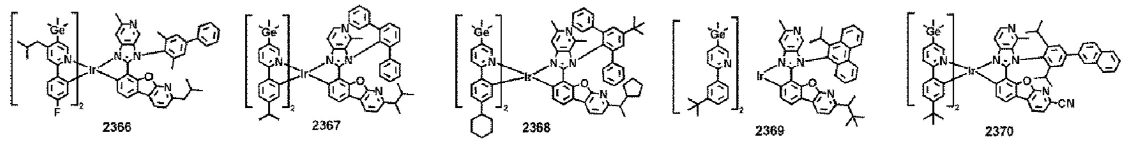

2366 2367 2368 2369 2370

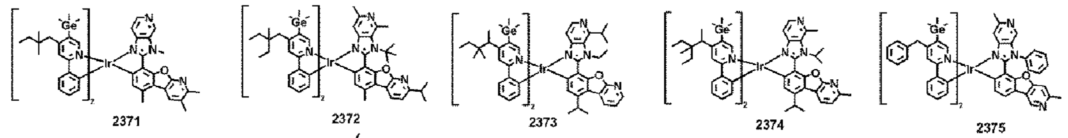

2371 2372 2373 2374 2375

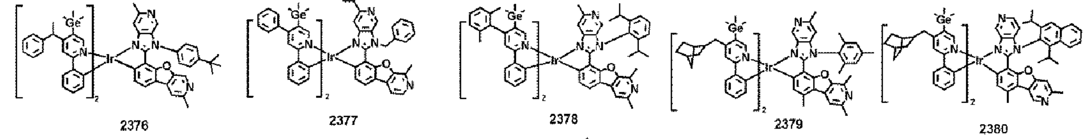

2376 2377 2378 2379 2380

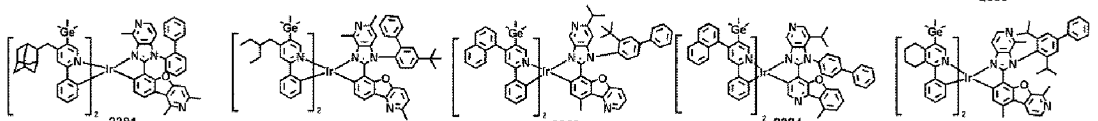

2381 2382 2383 2384 2385

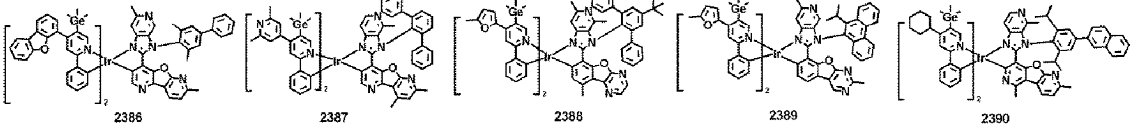

2386 2387 2388 2389 2390

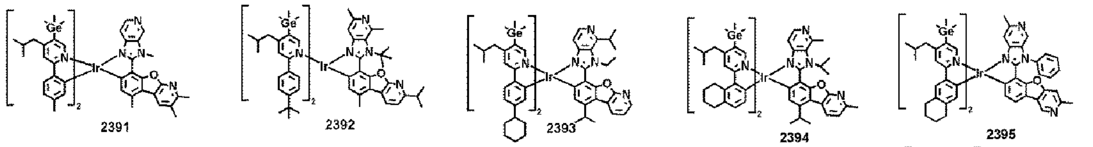

2391 2392 2393 2394 2395

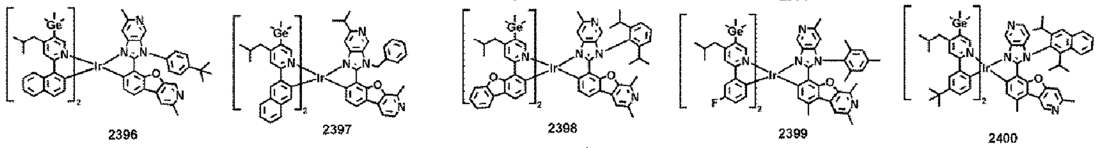

2396 2397 2398 2399 2400

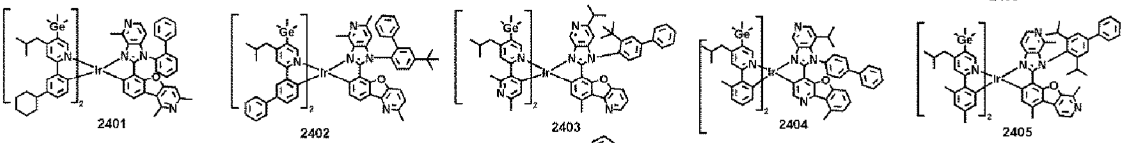

2401 2402 2403 2404 2405

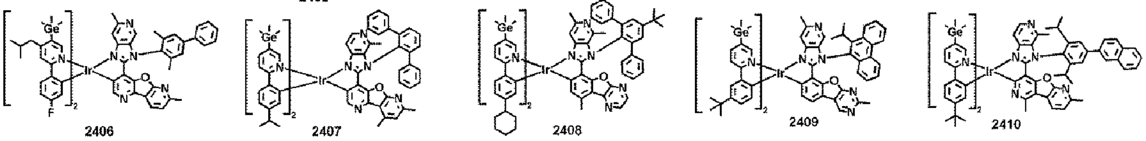

2406 2407 2408 2409 2410

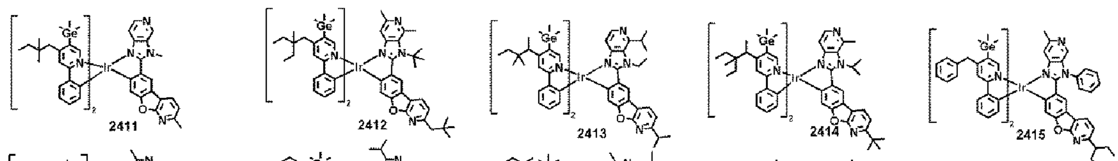

2411 2412 2413 2414 2415

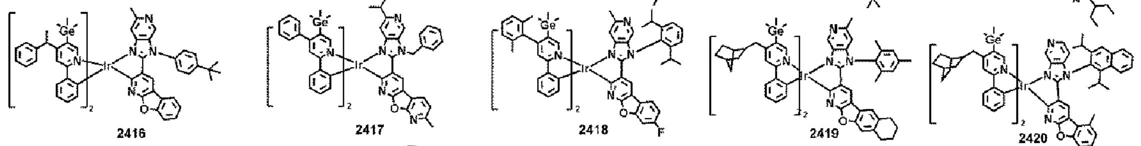

2416 2417 2418 2419 2420

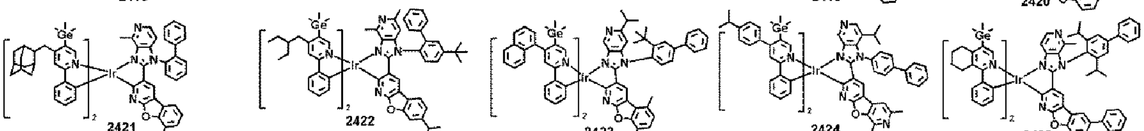

2421 2422 2423 2424 2425

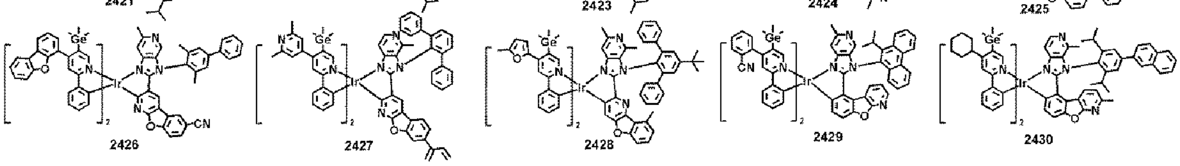

2426 2427 2428 2429 2430

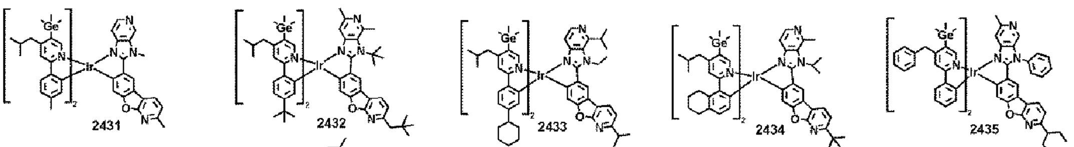

2431 2432 2433 2434 2435

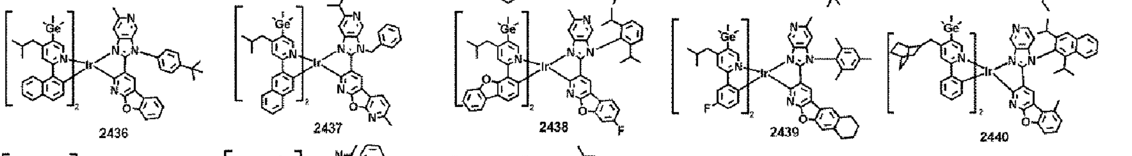

2436 2437 2438 2439 2440

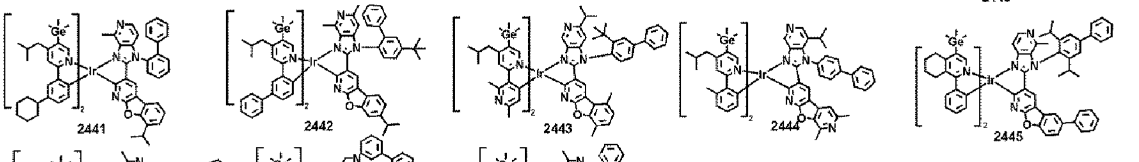

2441 2442 2443 2444 2445

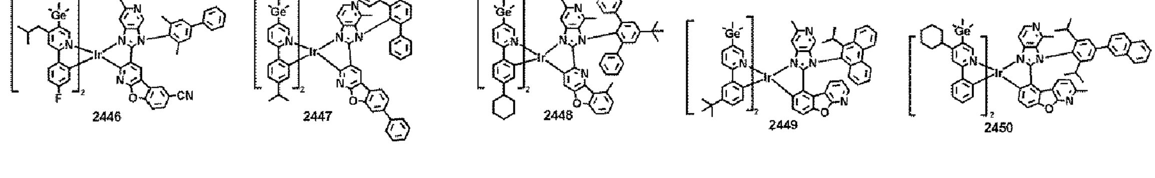

2446 2447 2448 2449 2450

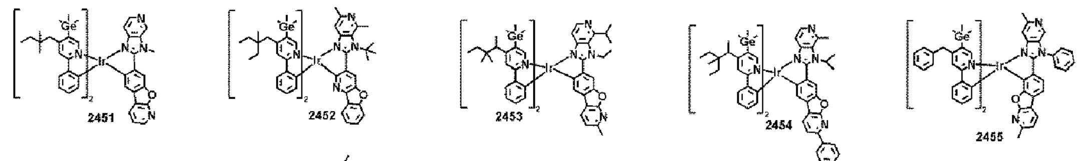

2451 2452 2453 2454 2455

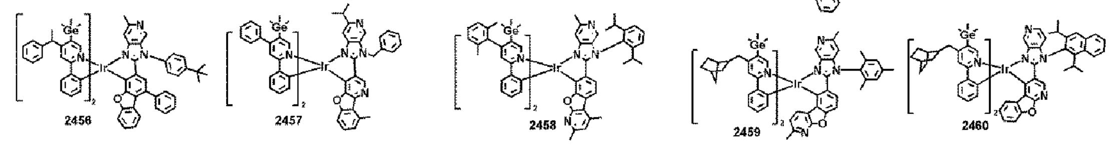

2456 2457 2458 2459 2460

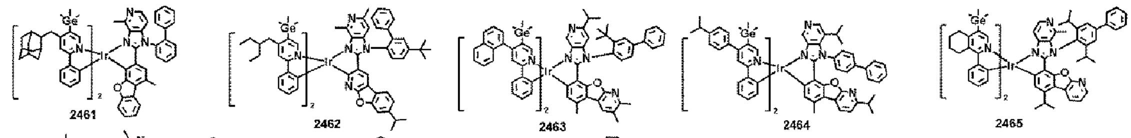

2461 2462 2463 2464 2465

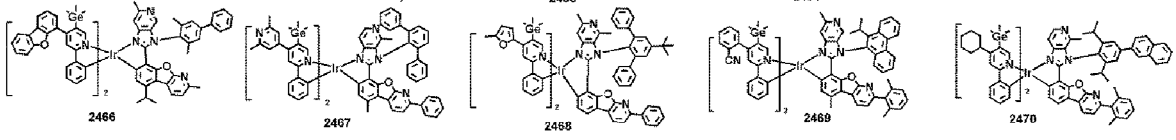

2466 2467 2468 2469 2470

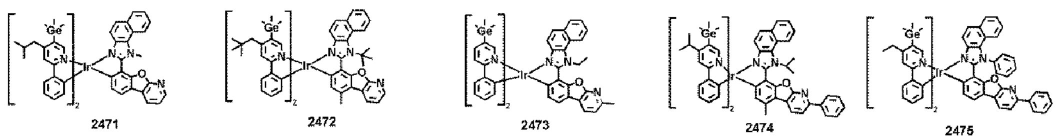

2471 2472 2473 2474 2475

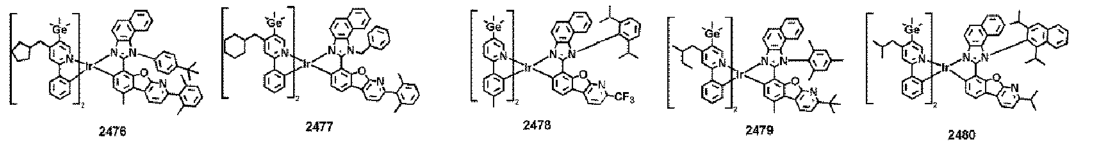

2476 2477 2478 2479 2480

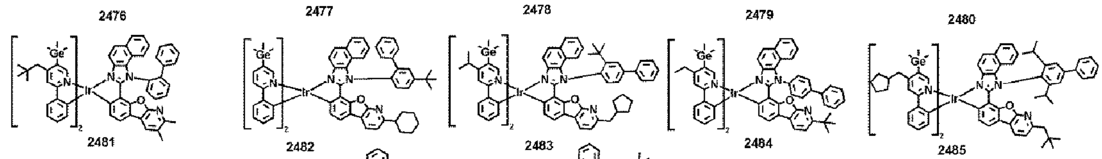

2481 2482 2483 2484 2485

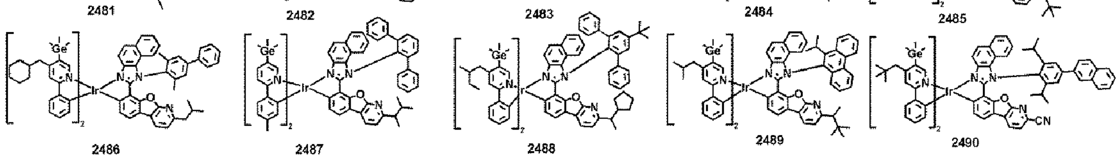

2486 2487 2488 2489 2490

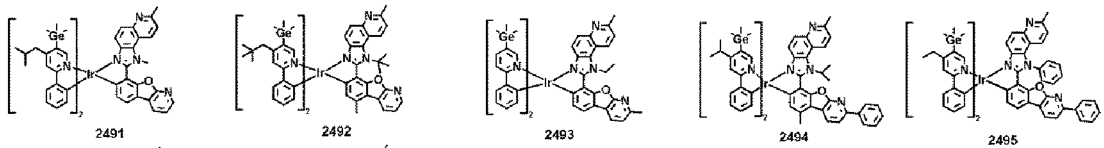

2491 2492 2493 2494 2495

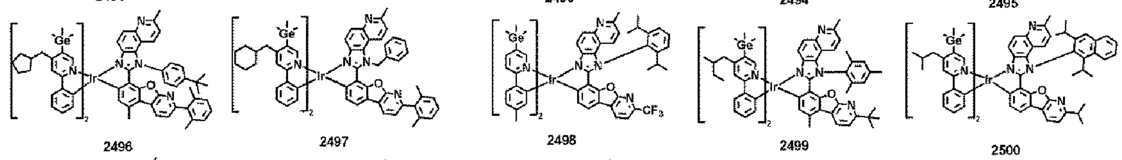

2496 2497 2498 2499 2500

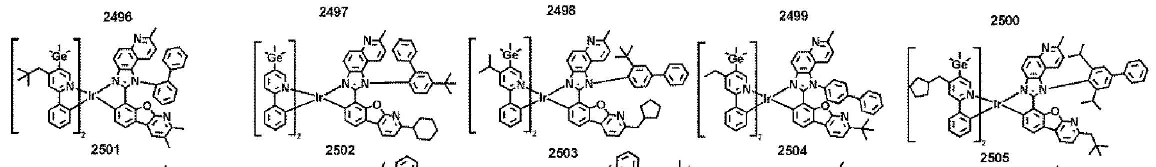

2501 2502 2503 2504 2505

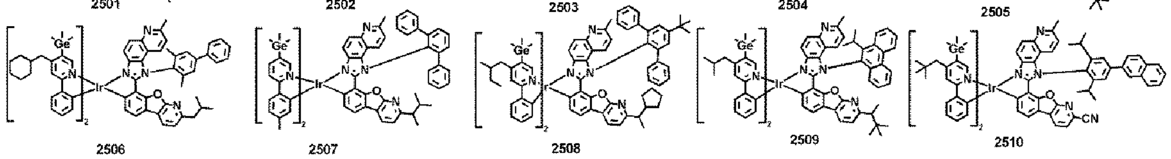

2506 2507 2508 2509 2510

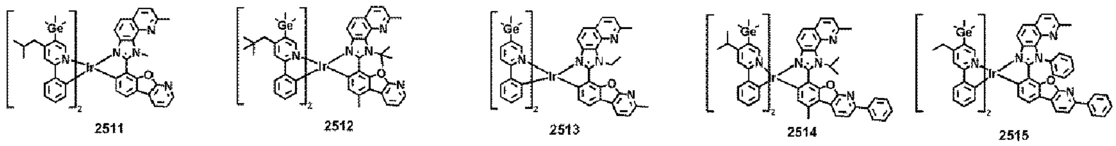

2511 2512 2513 2514 2515

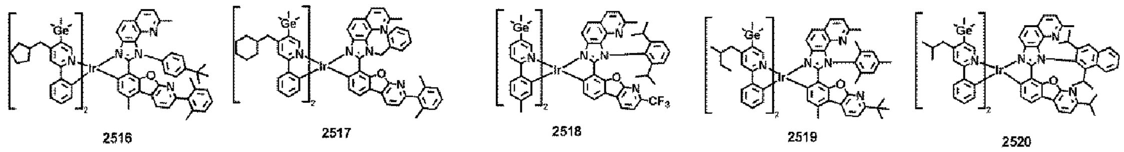

2516 2517 2518 2519 2520

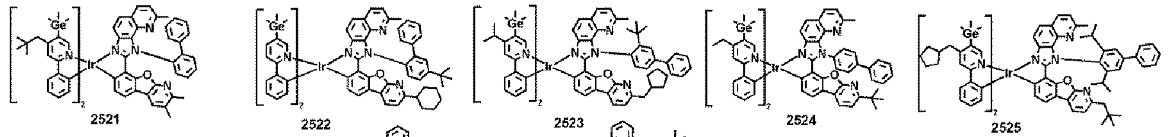

2521 2522 2523 2524 2525

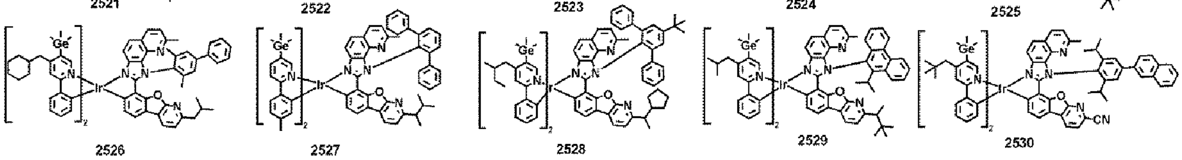

2526 2527 2528 2529 2530

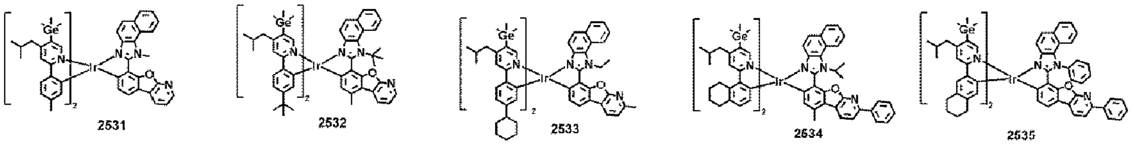

2531 2532 2533 2534 2535

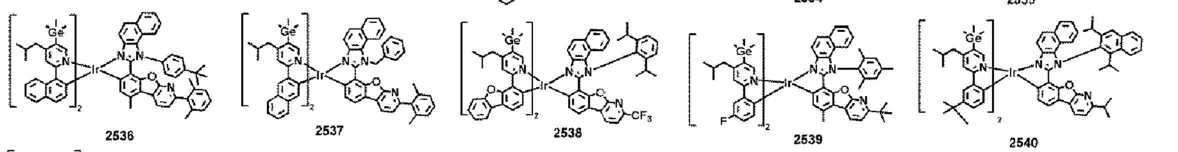

2536 2537 2538 2539 2540

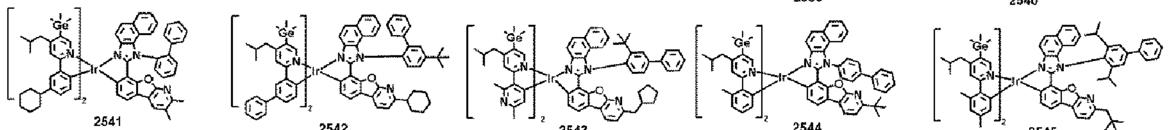

2541 2542 2543 2544 2545

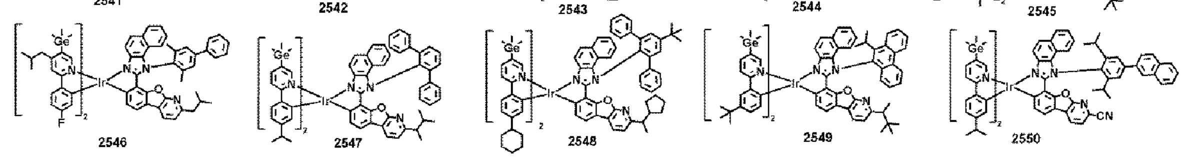

2546 2547 2548 2549 2550

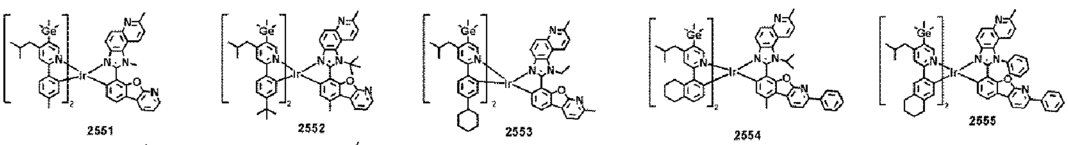

2551 2552 2553 2554 2555

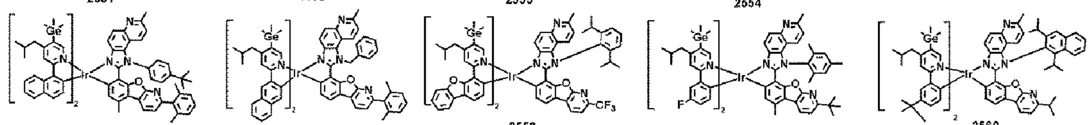

2556 2557 2558 2559 2560

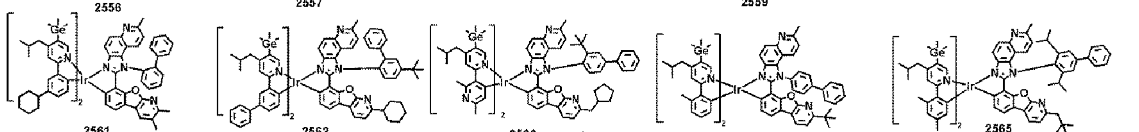

2561 2562 2563 2564 2565

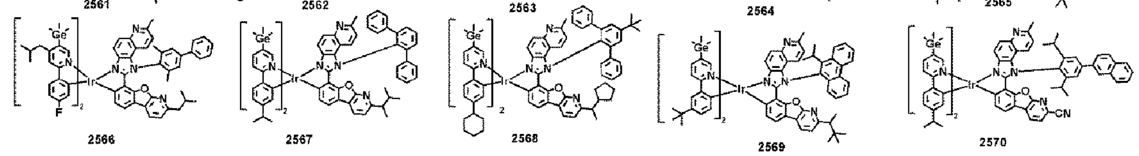

2566 2567 2568 2569 2570

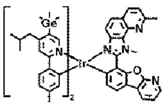
2571
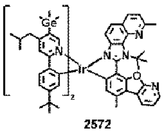
2572
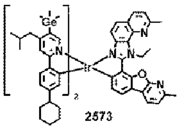
2573
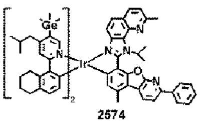
2574
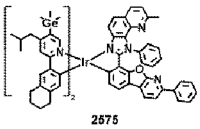
2575
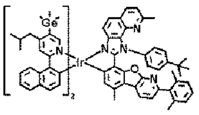
2576
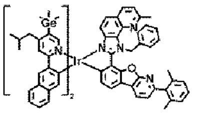
2577
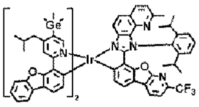
2578
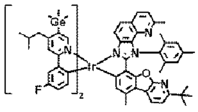
2579
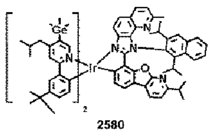
2580
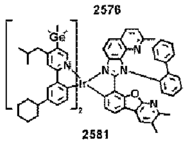
2581
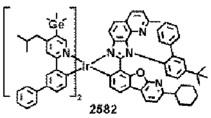
2582
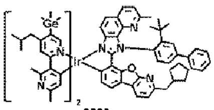
2583
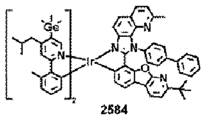
2584
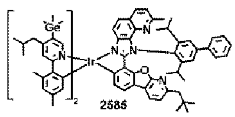
2585
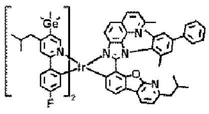
2586
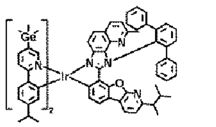
2587
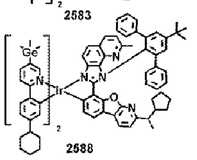
2588
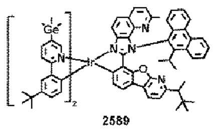
2589
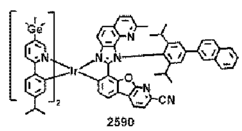
2590
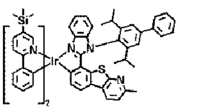
2591
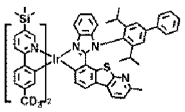
2592
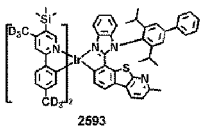
2593
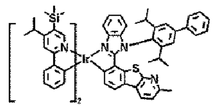
2594
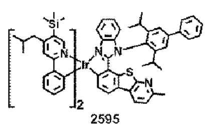
2595
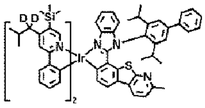
2596
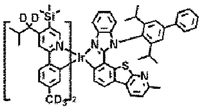
2597
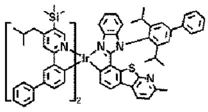
2598
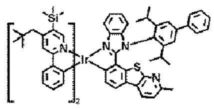
2599
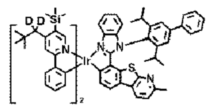
2600
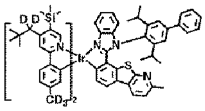
2601
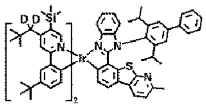
2602
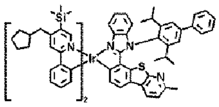
2603
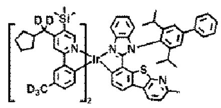
2604
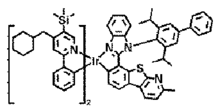
2605
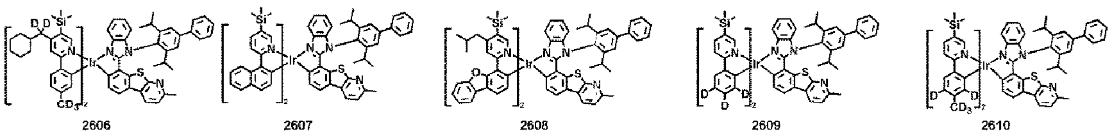
2606 2607 2608 2609 2610
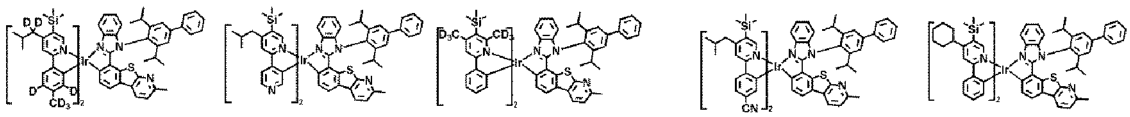
2611 2612 2613 2614 2615

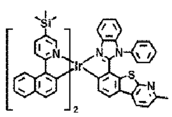 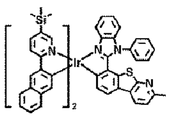 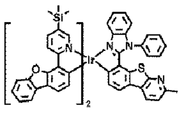 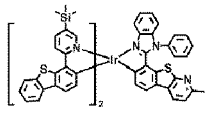 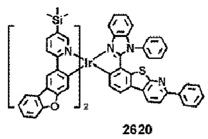

2616 2617 2618 2619 2620

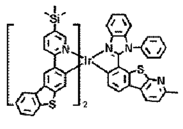 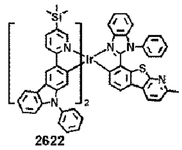 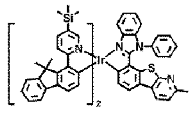 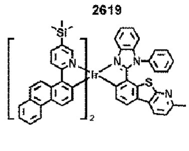 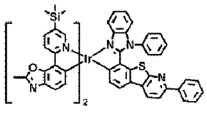

2621 2622 2623 2624 2625

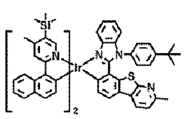 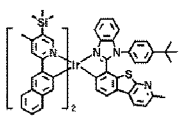 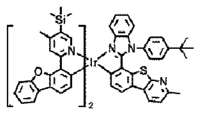 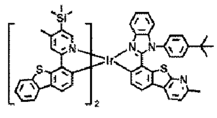 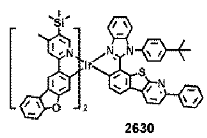

2626 2627 2628 2629 2630

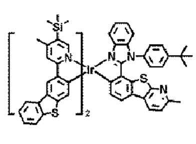 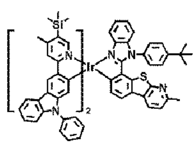 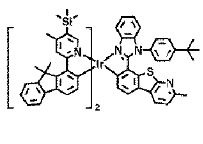 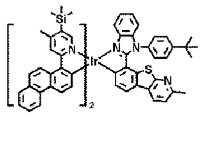 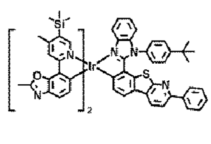

2631 2632 2633 2634 2635

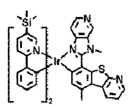 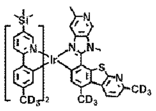 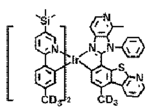 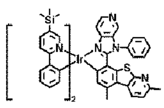 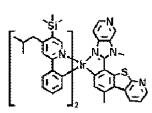

2636 2637 2638 2639 2640

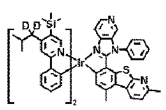 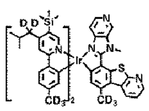 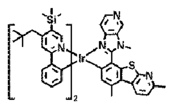 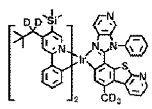 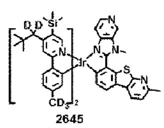

2641 2642 2643 2644 2645

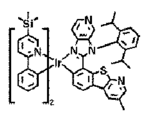 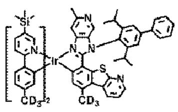 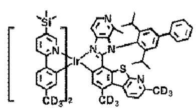 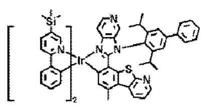 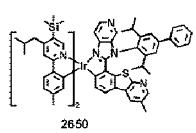

2646 2647 2648 2649 2650

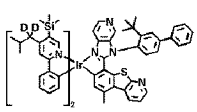 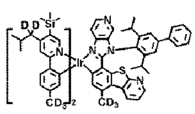 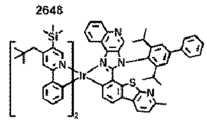 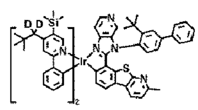 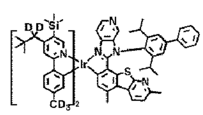

2651 2652 2653 2651 2655

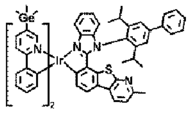
2656
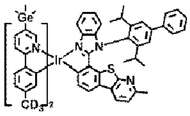
2657
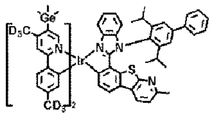
2658
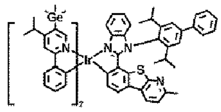
2659
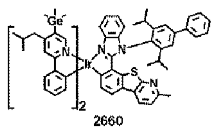
2660
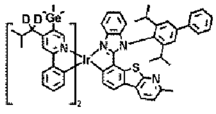
2661
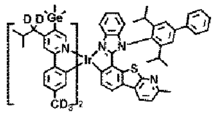
2662
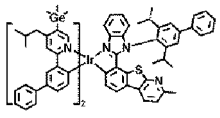
2663
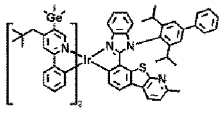
2664
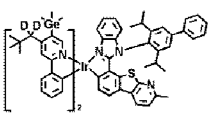
2665
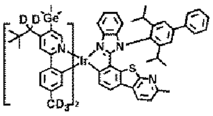
2666
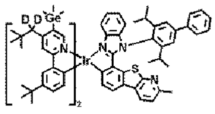
2667
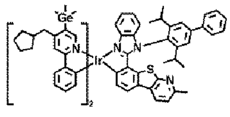
2668
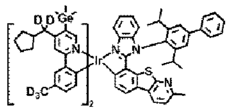
2669
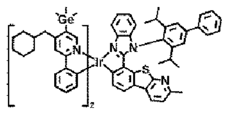
2670
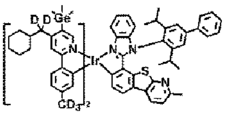
2671
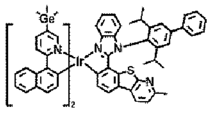
2672
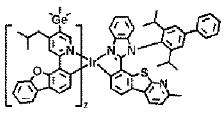
2673
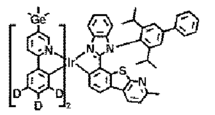
2674
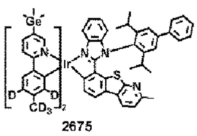
2675
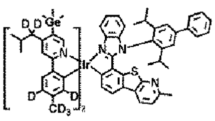
2676
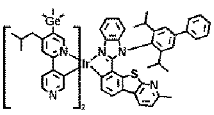
2677
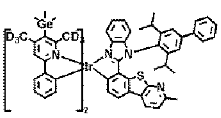
2678
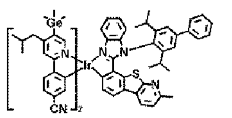
2679
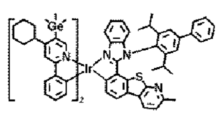
2680
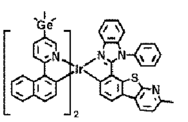
2681
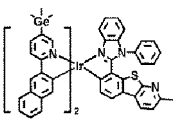
2682
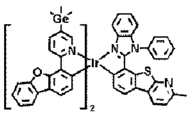
2683
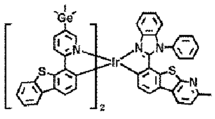
2684
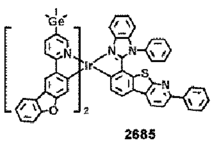
2685
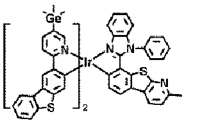
2686
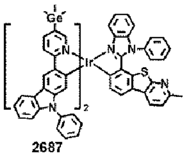
2687
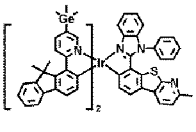
2688
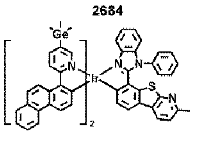
2689
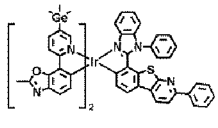
2690
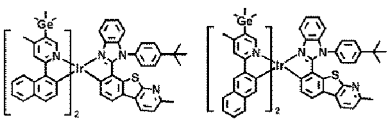
2691
2692
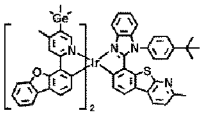
2693
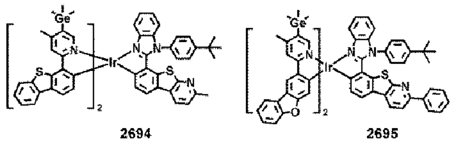
2694
2695
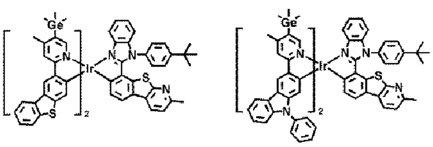
2696
2697
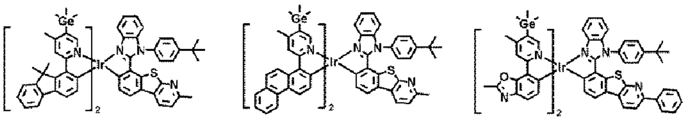
2698
2699
2700

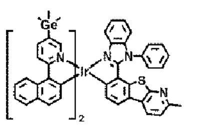
2701

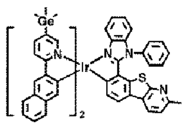
2702

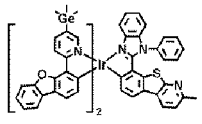
2703

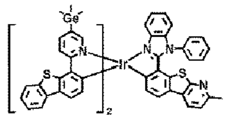
2704

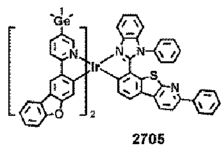
2705

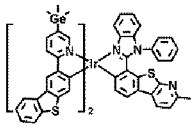
2706

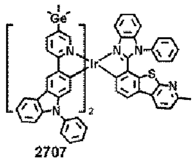
2707

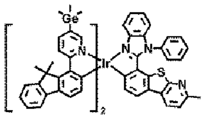
2708

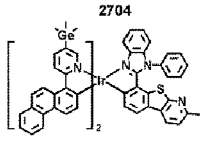
2709

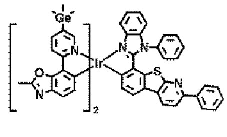
2710

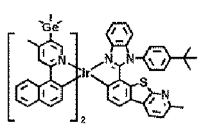
2711

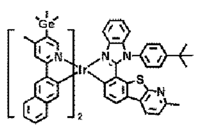
2712

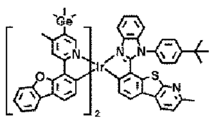
2713

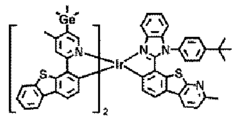
2714

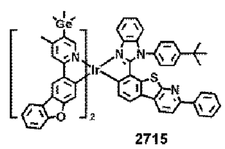
2715

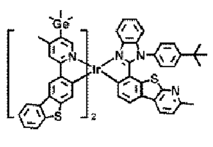
2716

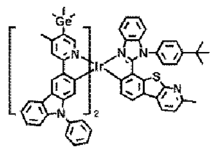
2717

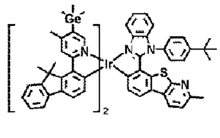
2718

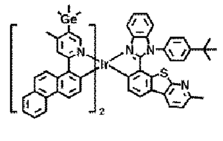
2719

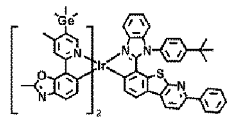
2720

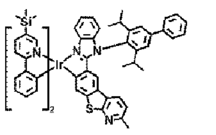
2721

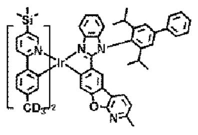
2722

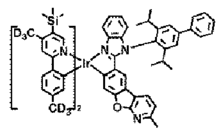
2723

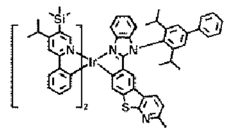
2724

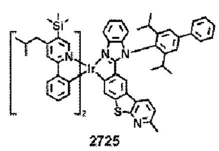
2725

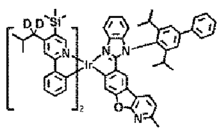
2725

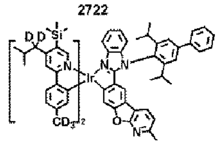
2727

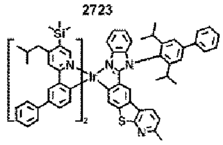
2728

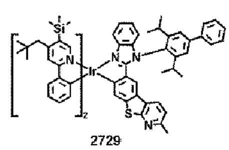
2729

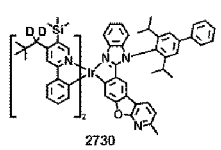
2730

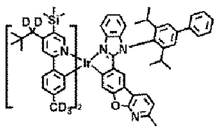
2731

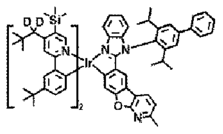
2732

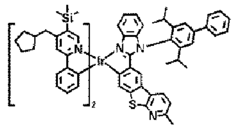
2733

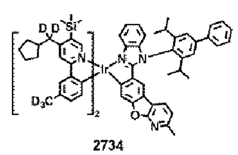
2734

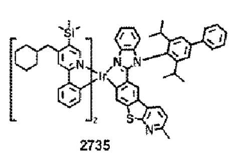
2735

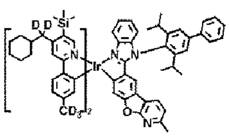
2736

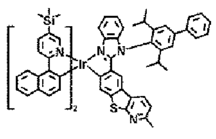
2737

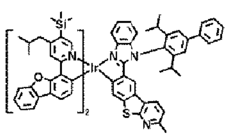
2738

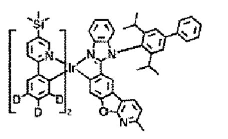
2739

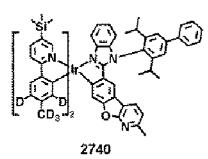
2740

2741

2742

2743

2744

2745

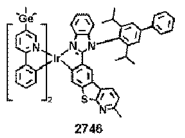
2746
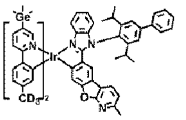
2747
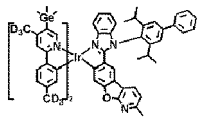
4748
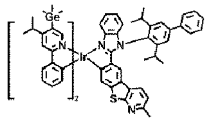
2749
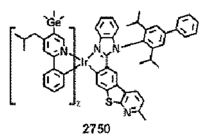
2750

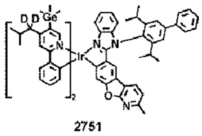
2751
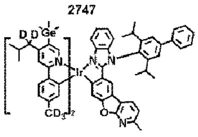
2752
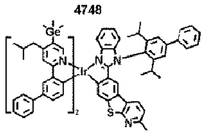
2753
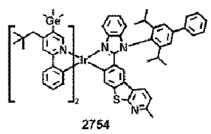
2754
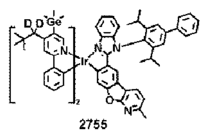
2755

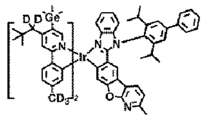
2756
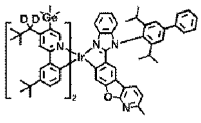
2757
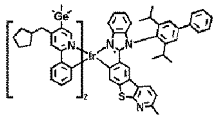
2758
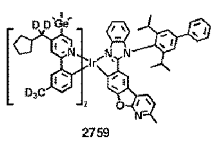
2759
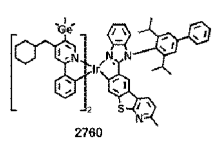
2760

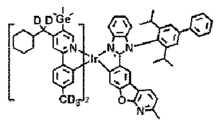
2761
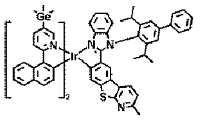
2762
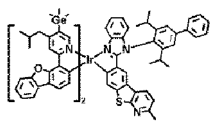
2763
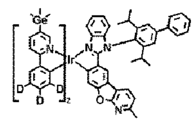
2764
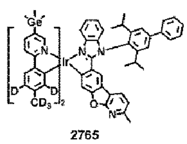
2765

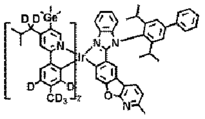
2766
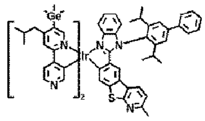
2767
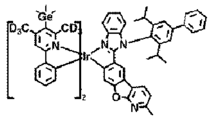
2768
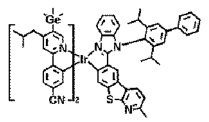
2769
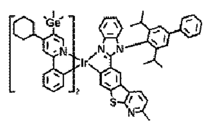
2770

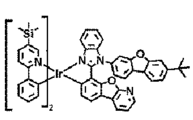
2771
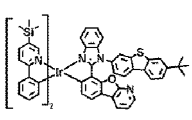
2772
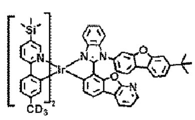
2773
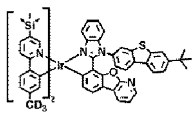
2774
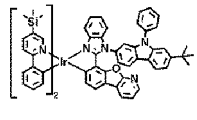
2775

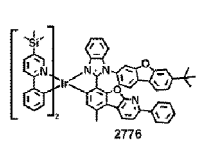
2776
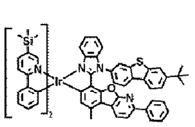
2777
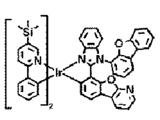
2778
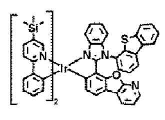
2779
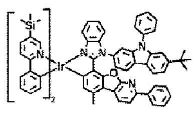
2780

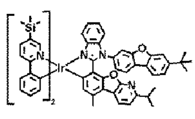
2781
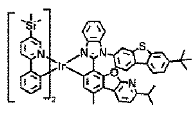
2782
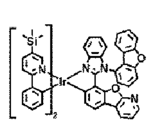
2783
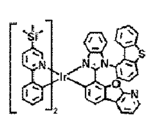
2784
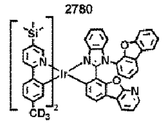
2785

2786
2787
2788
2789
2790

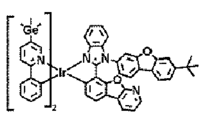
2791

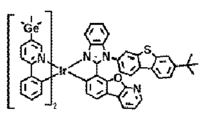
2792

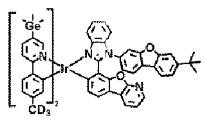
2793

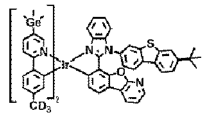
2794

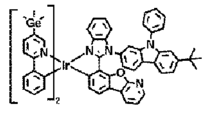
2795

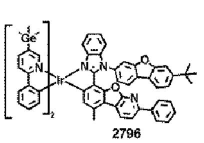
2796

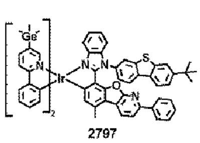
2797

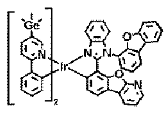
2798

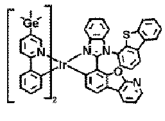
2799

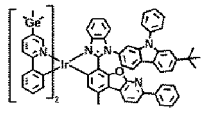
2800

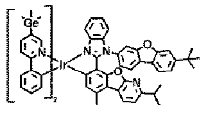
2801

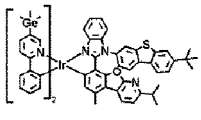
2802

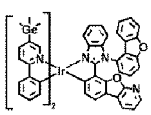
2803

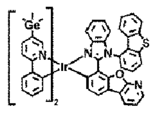
2804

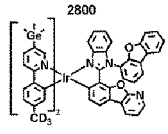
2805

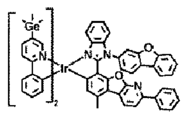
2806

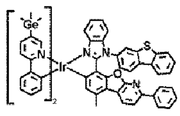
2807

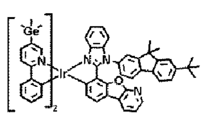
2808

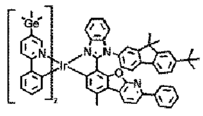
2809

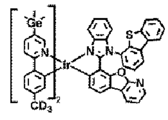
2810

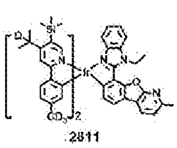
2811

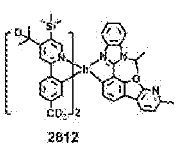
2812

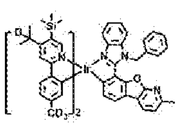
2813

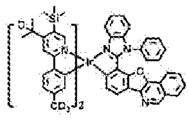
2814

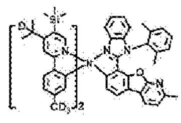
2815

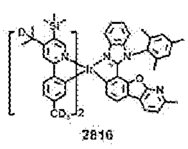
2816

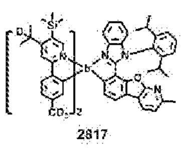
2817

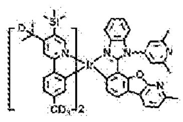
2818

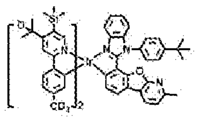
2819

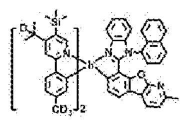
2820

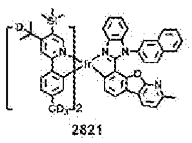
2821

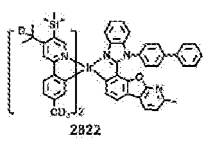
2822

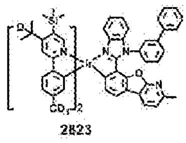
2823

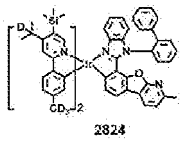
2824

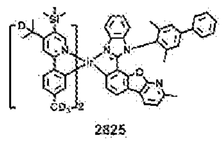
2825

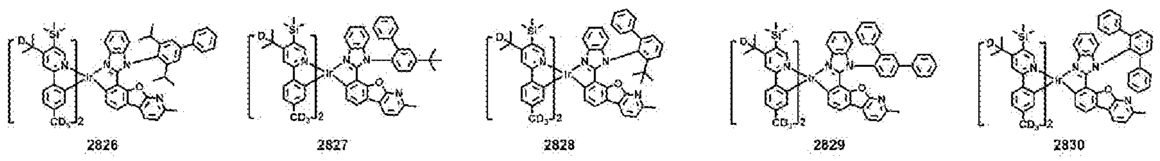
2826 2827 2828 2829 2830

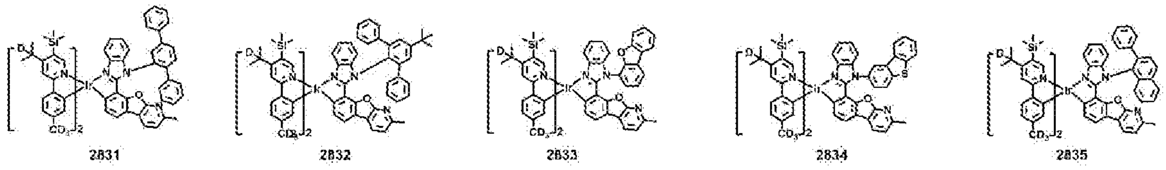
2831 2832 2833 2834 2835

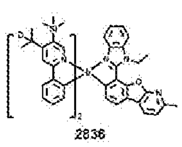
2836
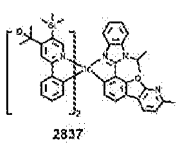
2837
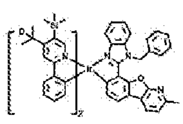
2838
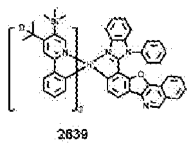
2839
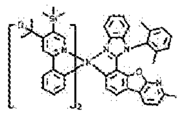
2840

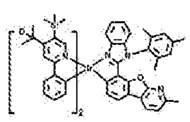
2841
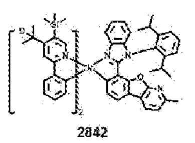
2842
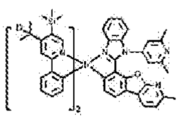
2843
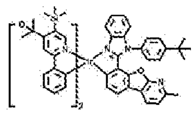
2844
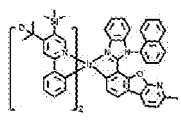
2845

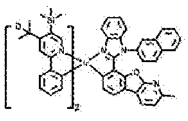
2846
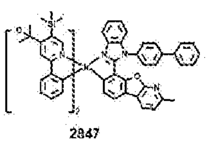
2847
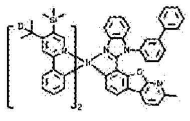
2848
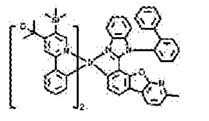
2849
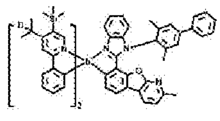
2850

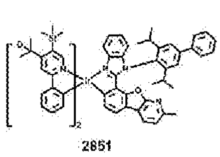
2851
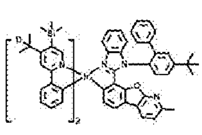
2852
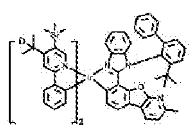
2853
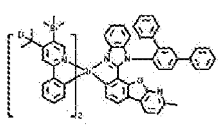
2854
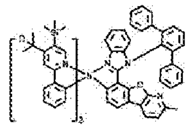
2855

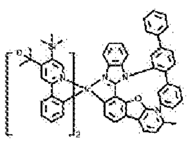
2856
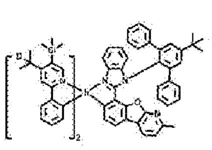
2857
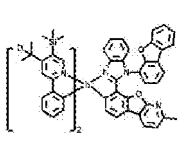
2858
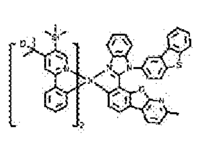
2859
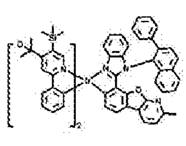
2860

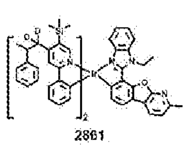
2861
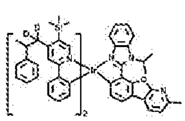
2862
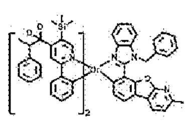
2863
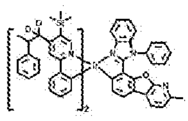
2864
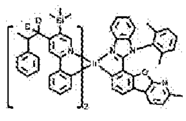
2865

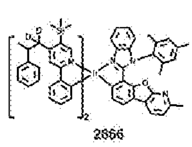
2866
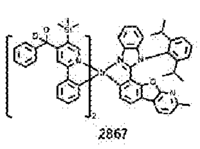
2867
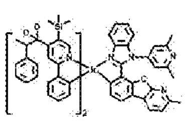
2868
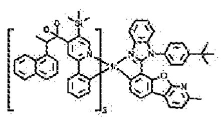
2869
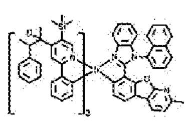
2870

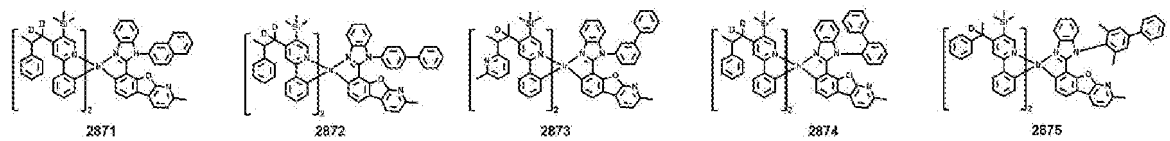
2871 2872 2873 2874 2875

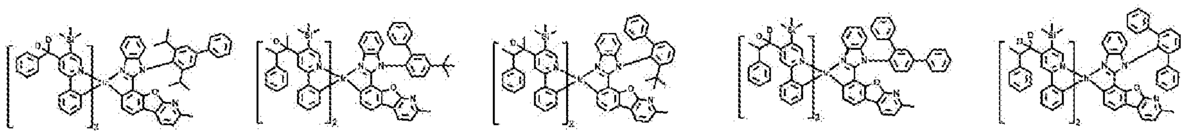
2876 2877 2878 2879 2880

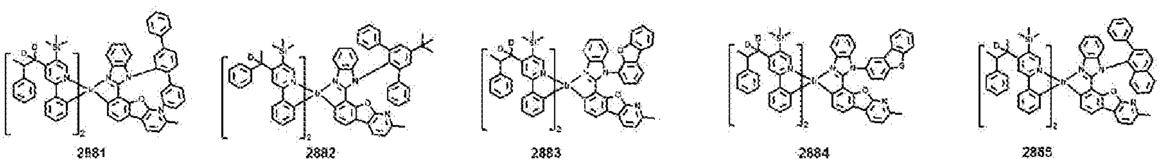
2881 2882 2883 2884 2885

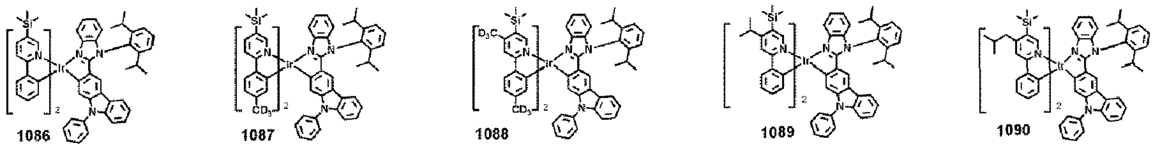

1086 1087 1088 1089 1090

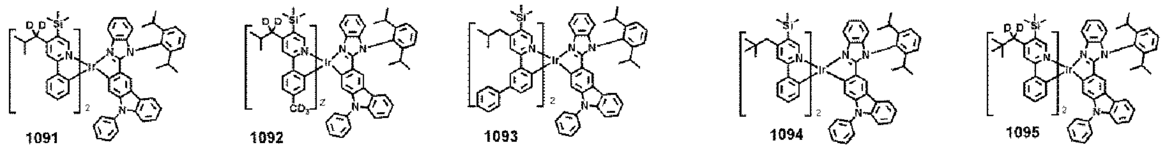

1091 1092 1093 1094 1095

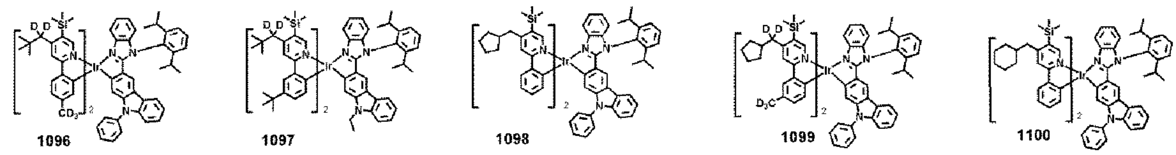

1096 1097 1098 1099 1100

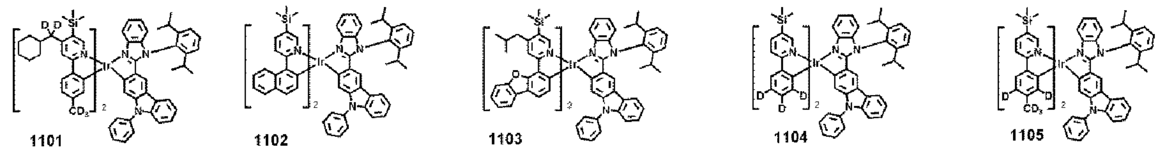

1101 1102 1103 1104 1105

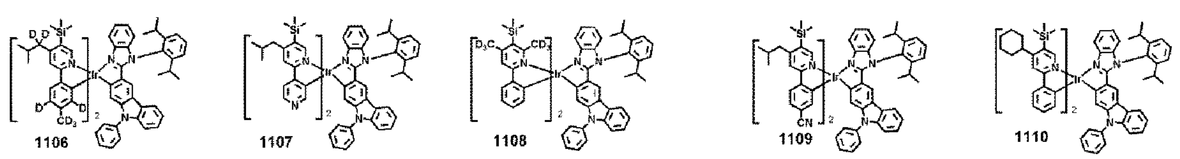

1106 1107 1108 1109 1110

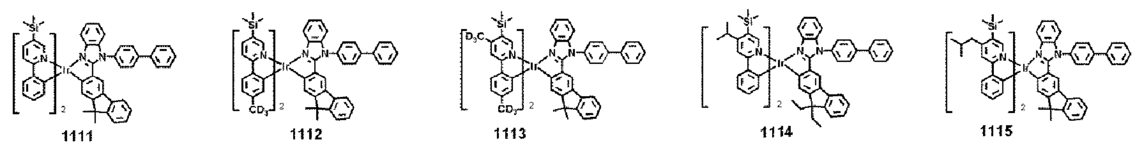

1111 1112 1113 1114 1115

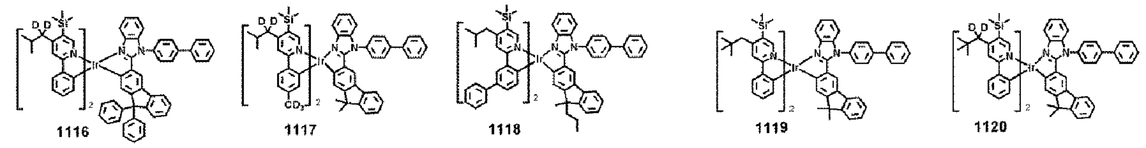

1116 1117 1118 1119 1120

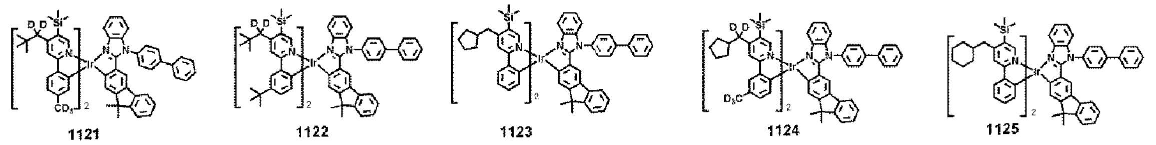

1121 1122 1123 1124 1125

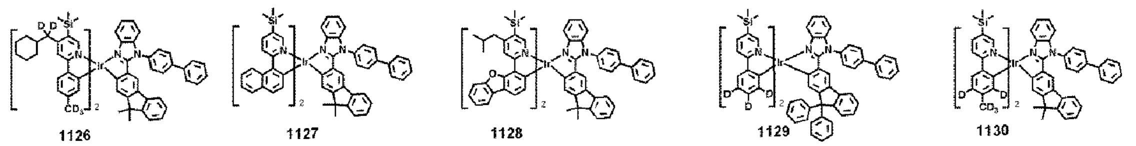

1126 1127 1128 1129 1130

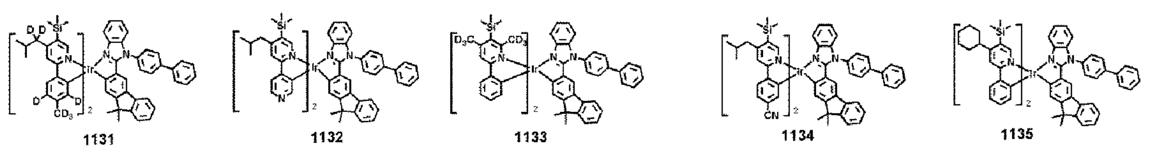

1131 1132 1133 1134 1135

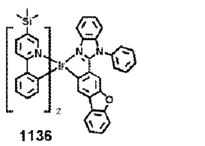
1136
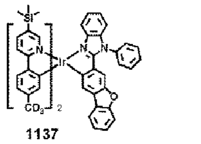
1137
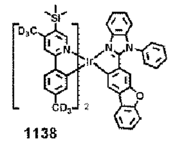
1138
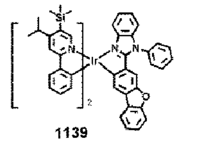
1139
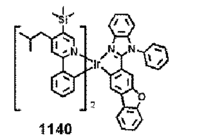
1140
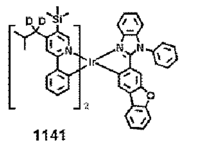
1141
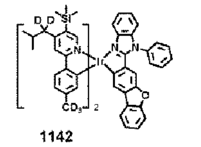
1142
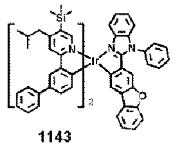
1143
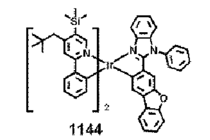
1144
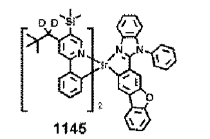
1145
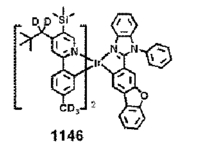
1146
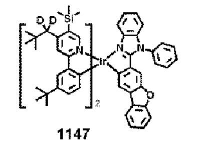
1147
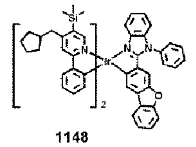
1148
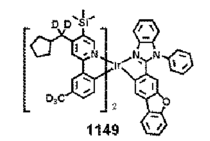
1149
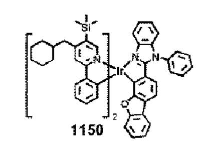
1150
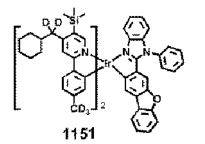
1151
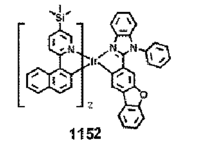
1152
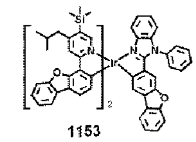
1153
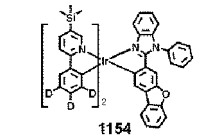
1154
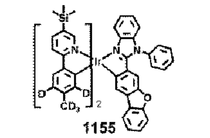
1155
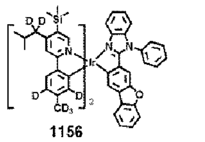
1156
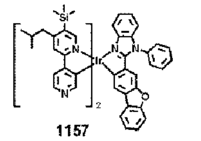
1157
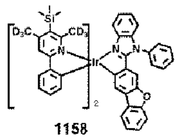
1158
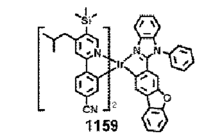
1159
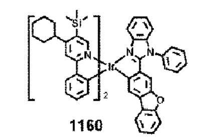
1160
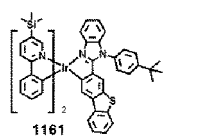
1161
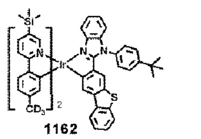
1162
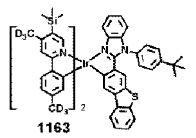
1163
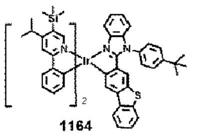
1164
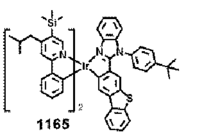
1165
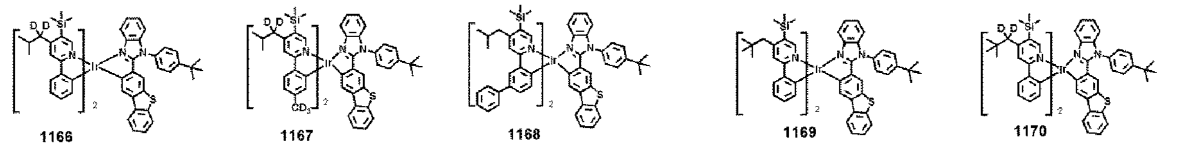
1166 1167 1168 1169 1170
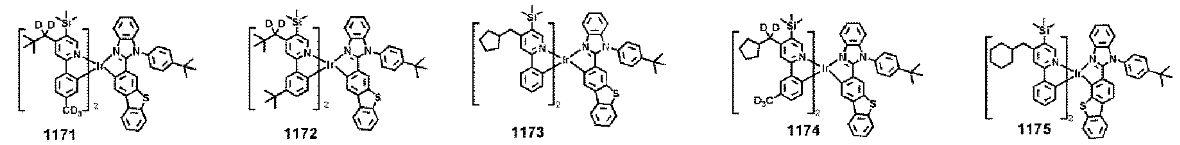
1171 1172 1173 1174 1175
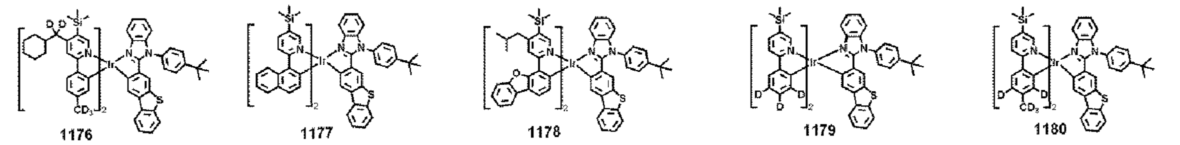
1176 1177 1178 1179 1180
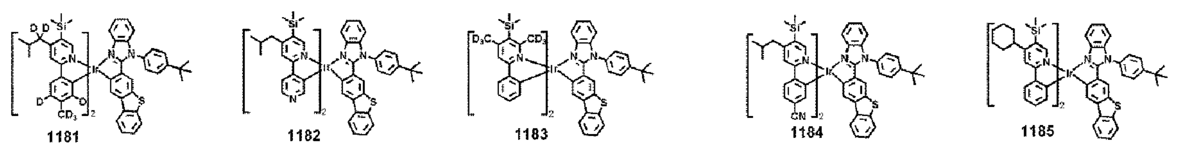
1181 1182 1183 1184 1185

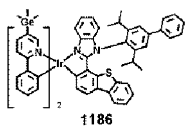
1186

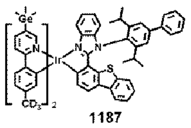
1187

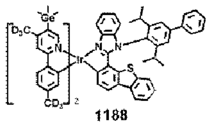
1188

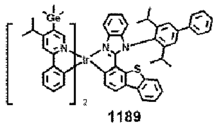
1189

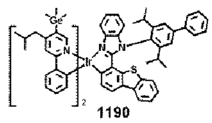
1190

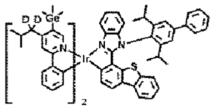
1191

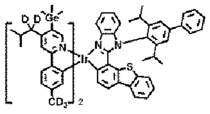
1192

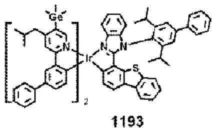
1193

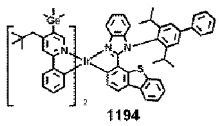
1194

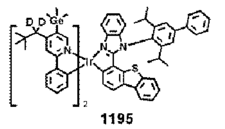
1195

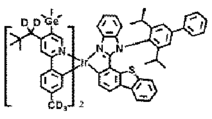
1196

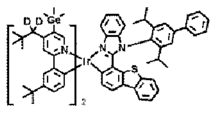
1197

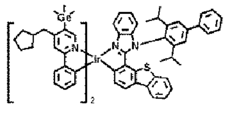
1198

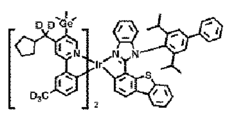
1199

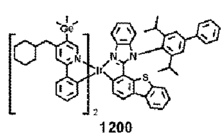
1200

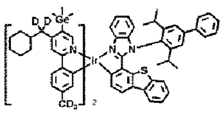
1201

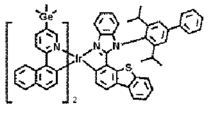
1202

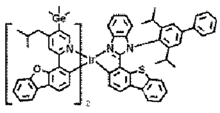
1203

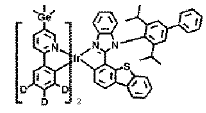
1204

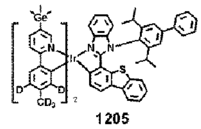
1205

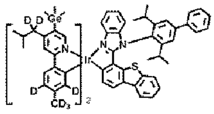
1206

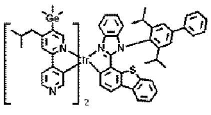
1207

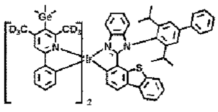
1208

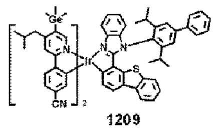
1209

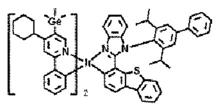
1210

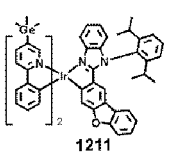
1211

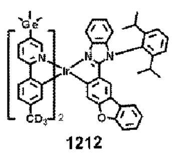
1212

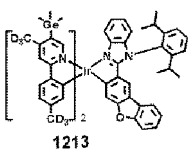
1213

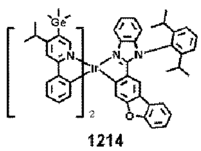
1214

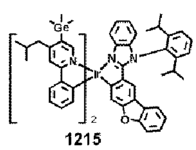
1215

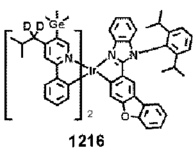
1216

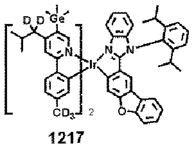
1217

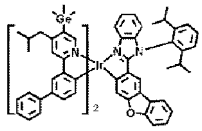
1218

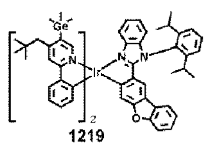
1219

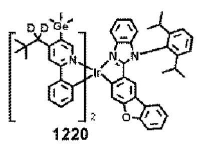
1220

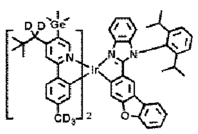
1221

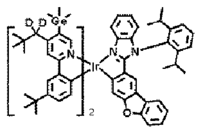
1222

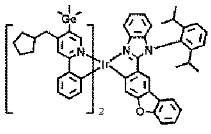
1223

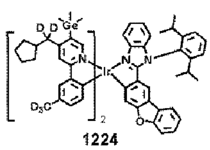
1224

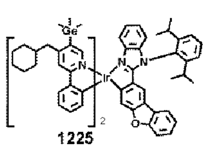
1225

1226

1227

1228

1229

1230

1231

1232

1233

1234

1235

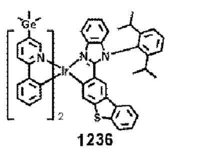
1236
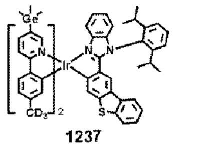
1237
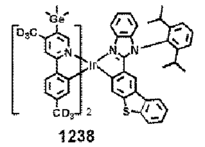
1238
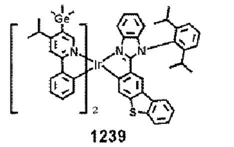
1239
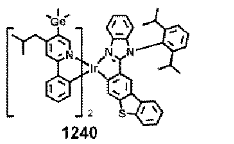
1240
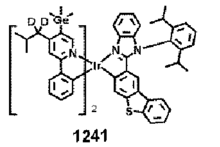
1241
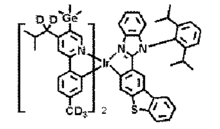
1242
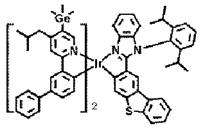
1243
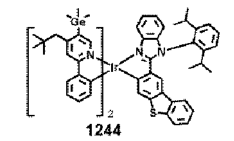
1244
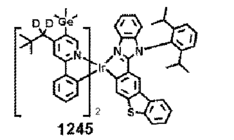
1245
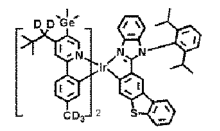
1246
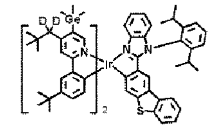
1247
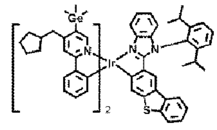
1248
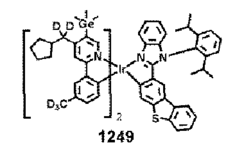
1249
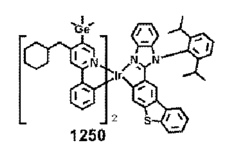
1250
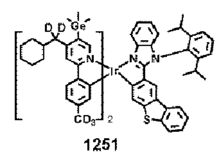
1251
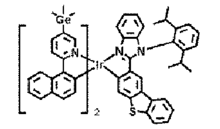
1252
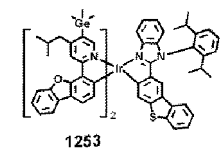
1253
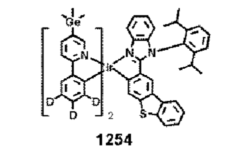
1254
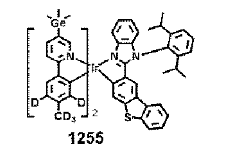
1255
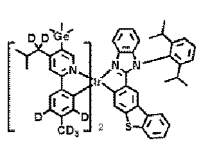
1256
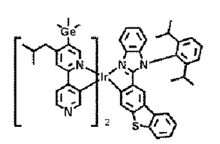
1257
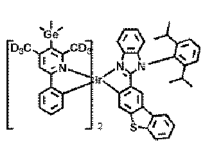
1258
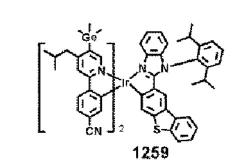
1259
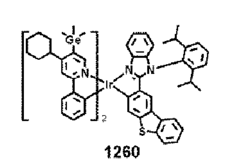
1260
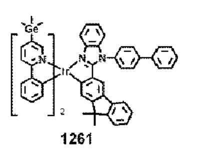
1261
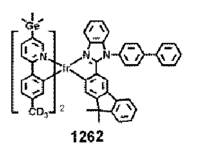
1262
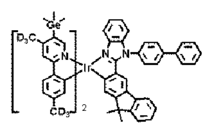
1263
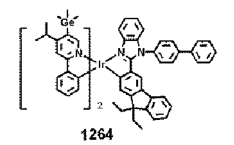
1264
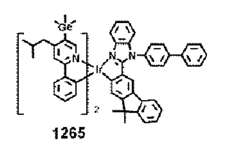
1265
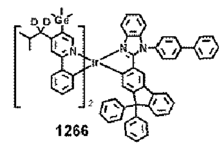
1266
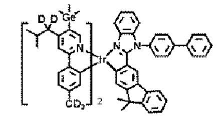
1267
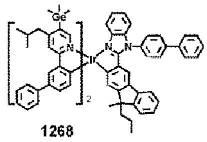
1268
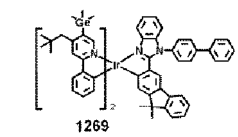
1269
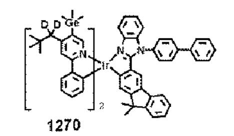
1270
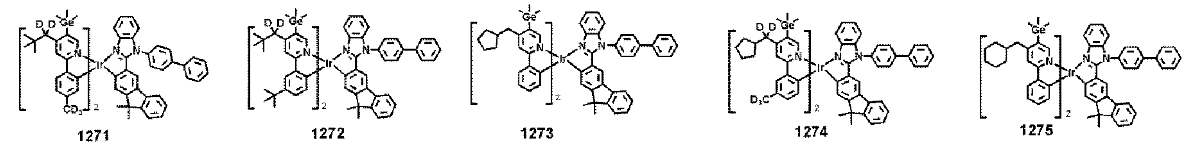
1271 1272 1273 1274 1275
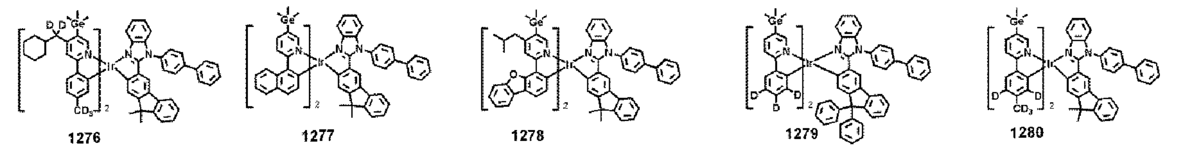
1276 1277 1278 1279 1280
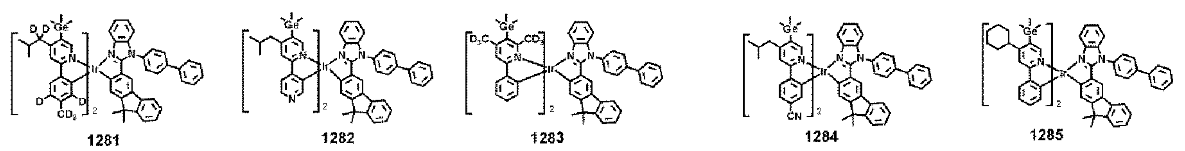
1281 1282 1283 1284 1285

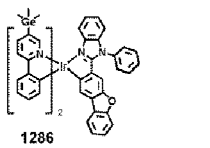
1286
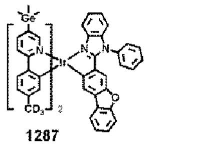
1287
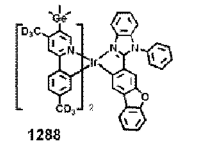
1288
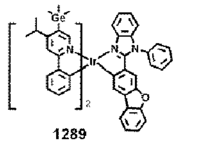
1289
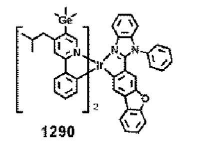
1290
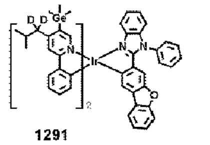
1291
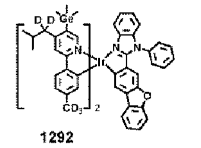
1292
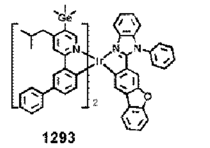
1293
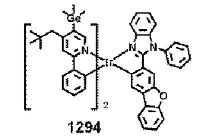
1294
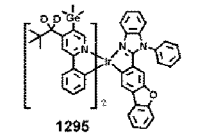
1295
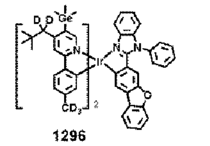
1296
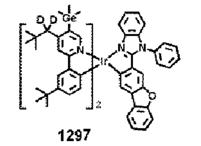
1297
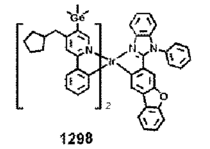
1298
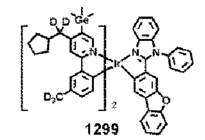
1299
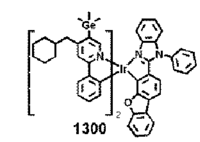
1300
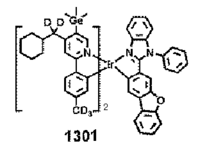
1301
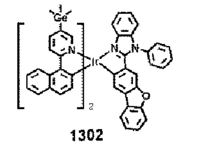
1302
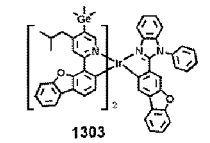
1303
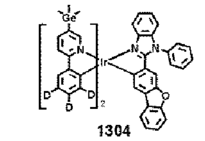
1304
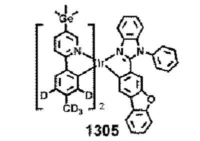
1305
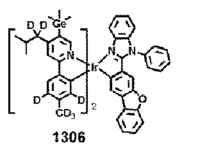
1306
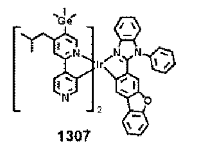
1307
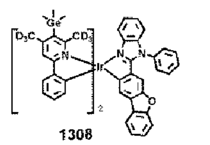
1308
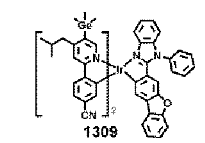
1309
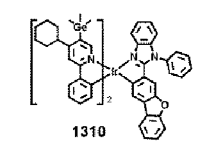
1310
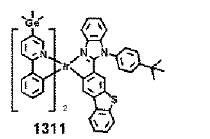
1311
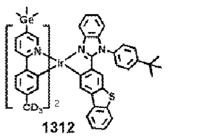
1312
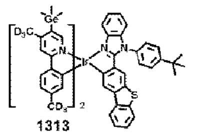
1313
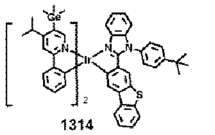
1314
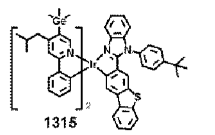
1315
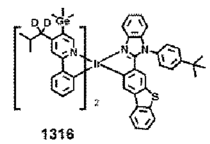
1316
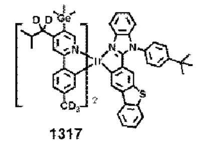
1317
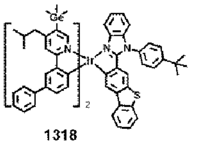
1318
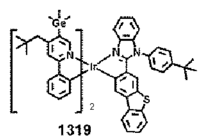
1319
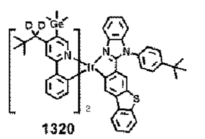
1320
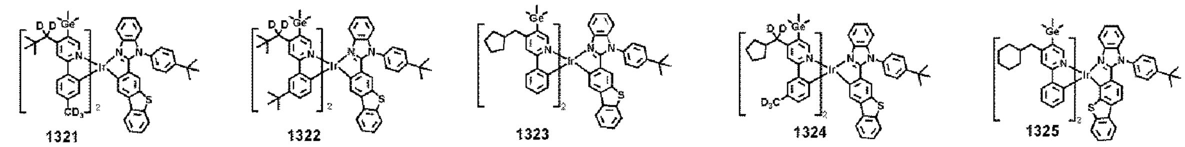
1321 1322 1323 1324 1325
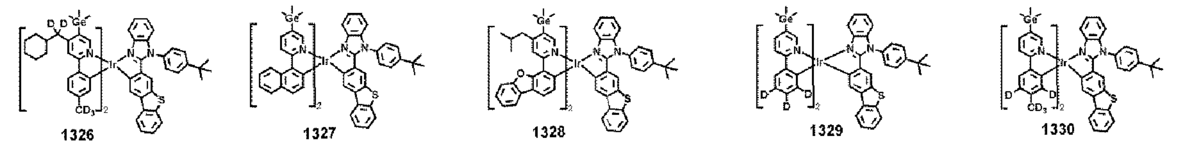
1326 1327 1328 1329 1330
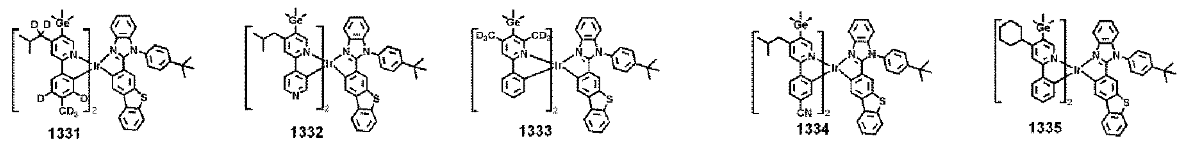
1331 1332 1333 1334 1335

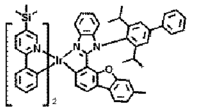
1336
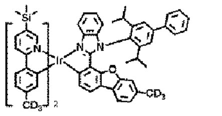
1337
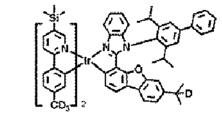
1338
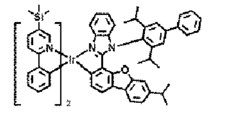
1339
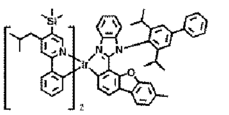
1340

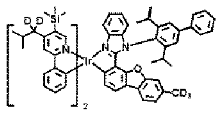
1341
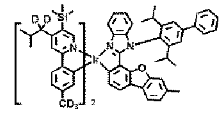
1342
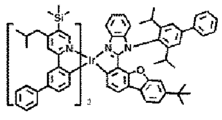
1343
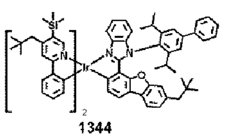
1344
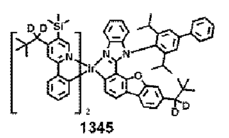
1345

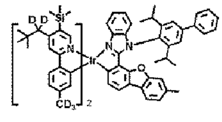
1346
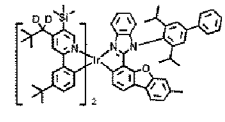
1347
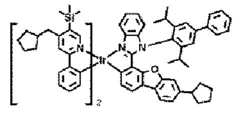
1348
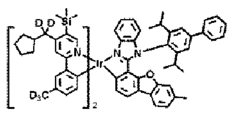
1349
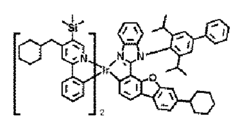
1350

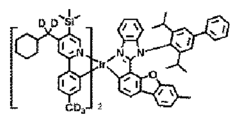
1351
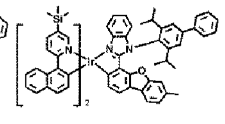
1352
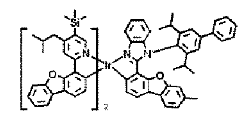
1353
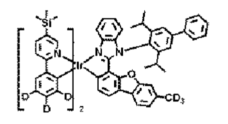
1354
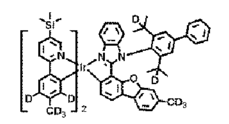
1355

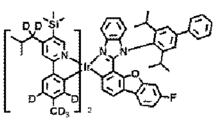
1356
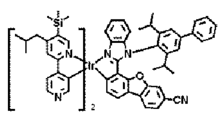
1357
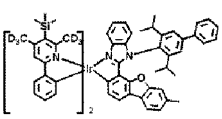
1358
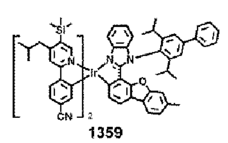
1359
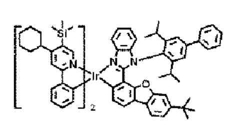
1360

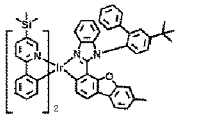
1361
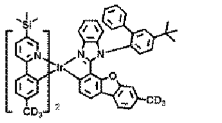
1362
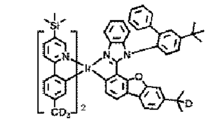
1363
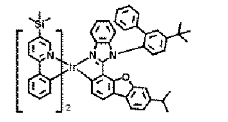
1364
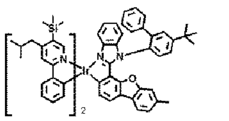
1365

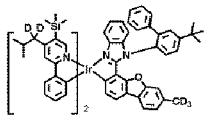
1366
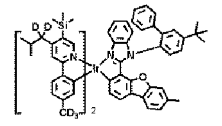
1367
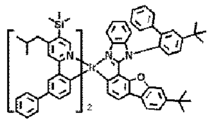
1368
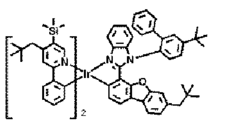
1369
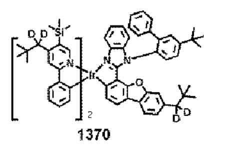
1370

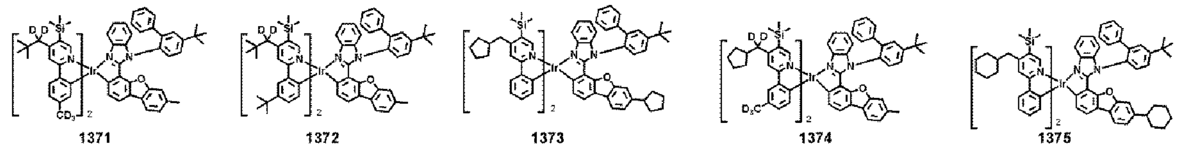
1371
1372
1373
1374
1375

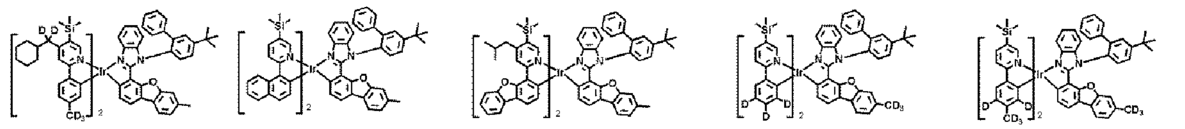
1376
1377
1378
1379
1380

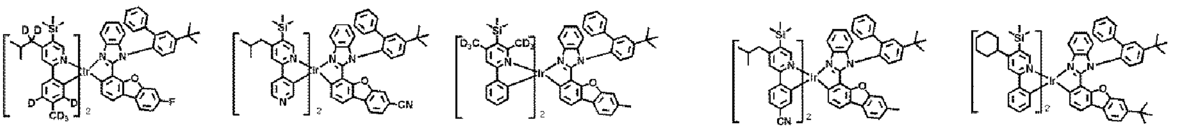
1381
1382
1383
1384
1385

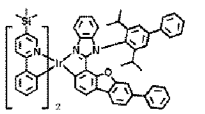
1386
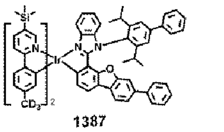
1387
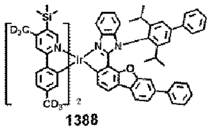
1388
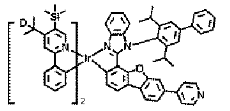
1389
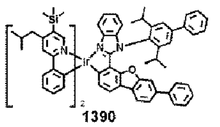
1390

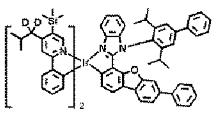
1391
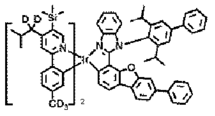
1392
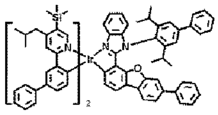
1393
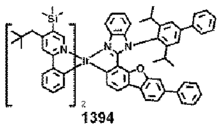
1394
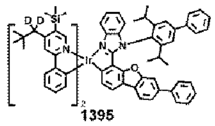
1395

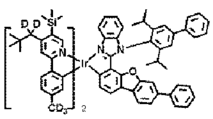
1396
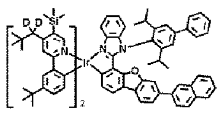
1397
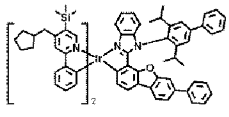
1398
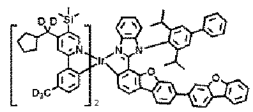
1399
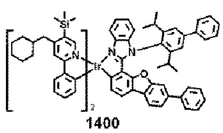
1400

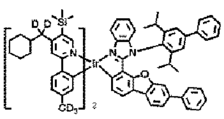
1401
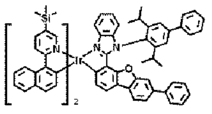
1402
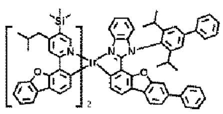
1403
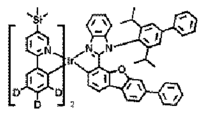
1404
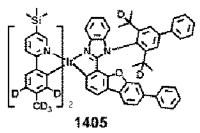
1405

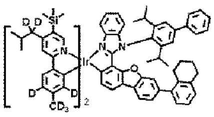
1406
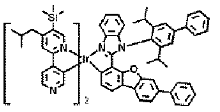
1407
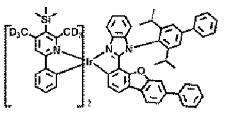
1408
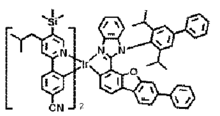
1409
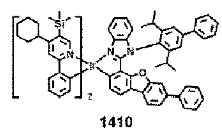
1410

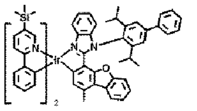
1411
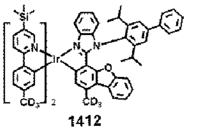
1412
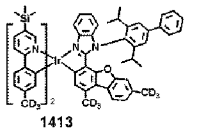
1413
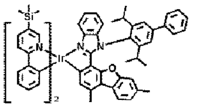
1414
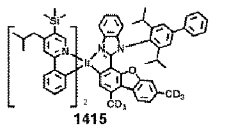
1415

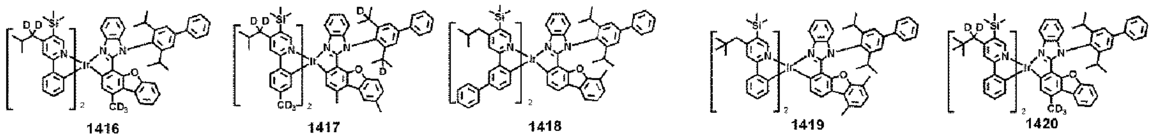
1416 1417 1418 1419 1420

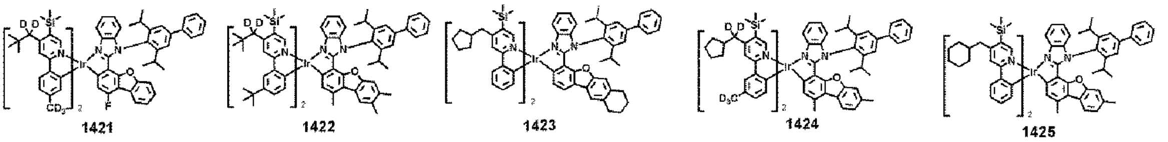
1421 1422 1423 1424 1425

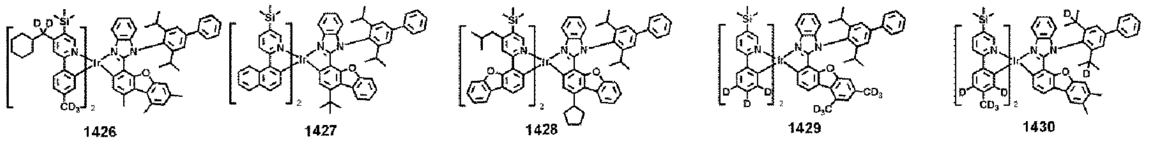
1426 1427 1428 1429 1430

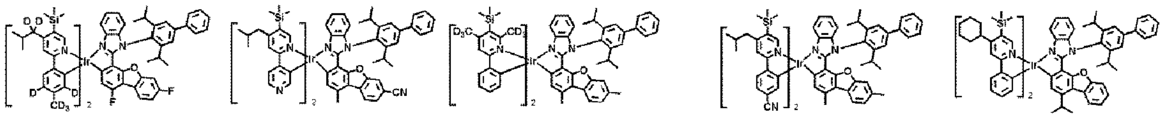
1431 1432 1433 1434 1435

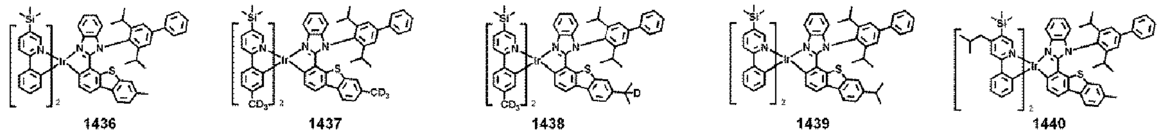
1436 1437 1438 1439 1440

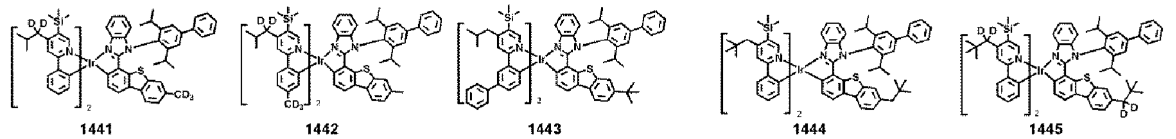
1441 1442 1443 1444 1445

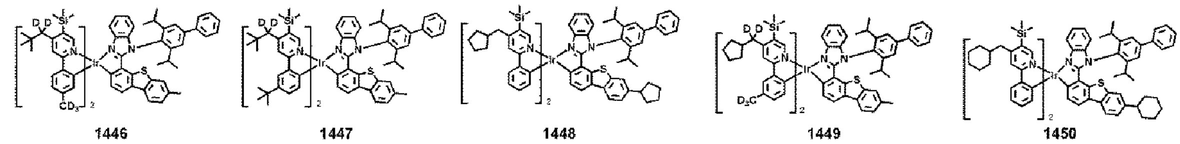
1446 1447 1448 1449 1450

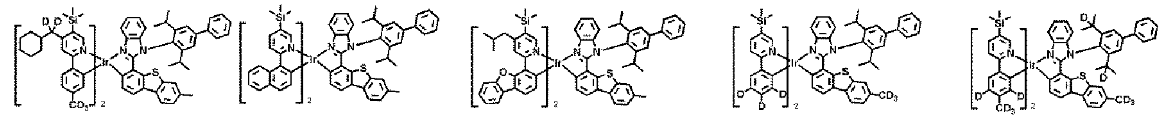
1451 1452 1453 1454 1455

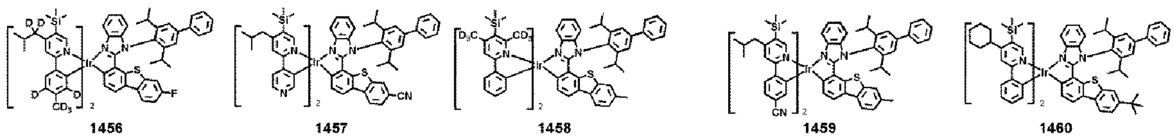
1456 1457 1458 1459 1460

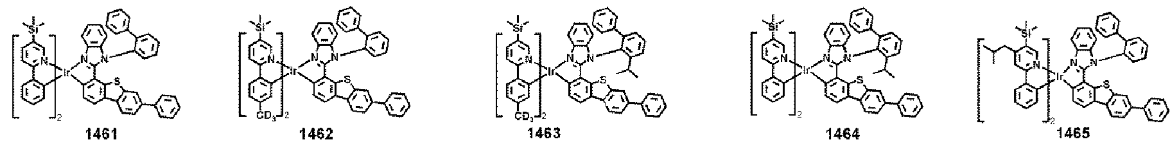
1461 1462 1463 1464 1465

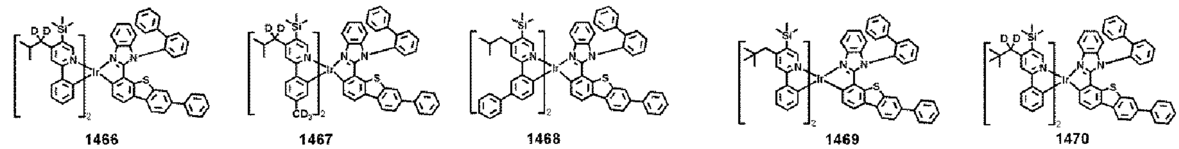
1466 1467 1468 1469 1470

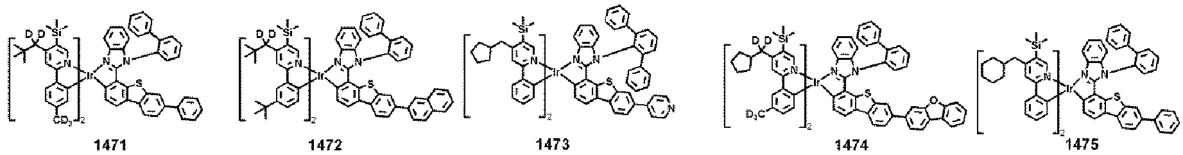
1471 1472 1473 1474 1475

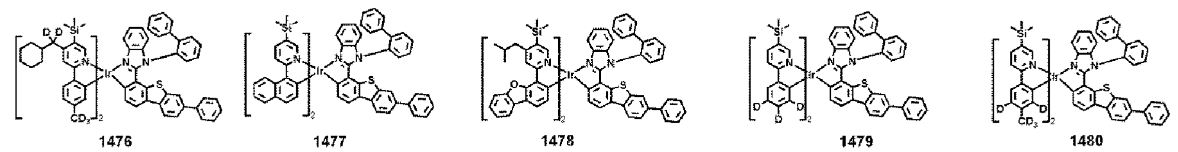
1476 1477 1478 1479 1480

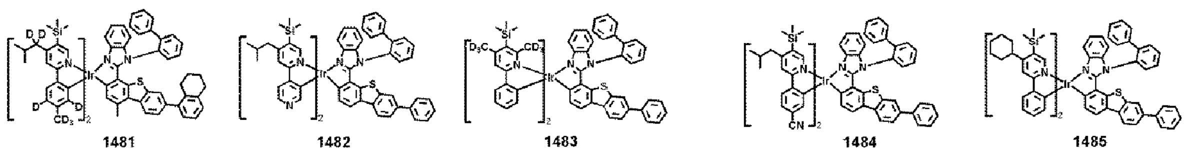
1481 1482 1483 1484 1485

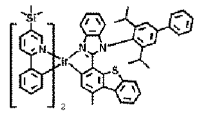
1486

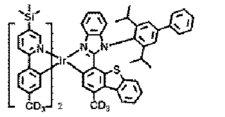
1487

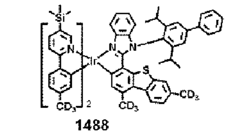
1488

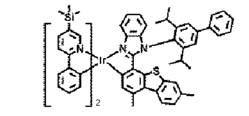
1489

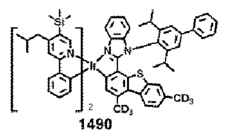
1490

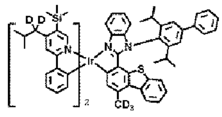
1491

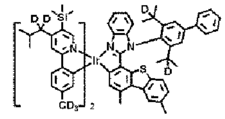
1492

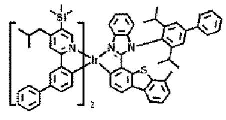
1493

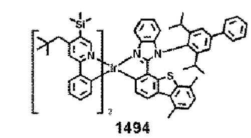
1494

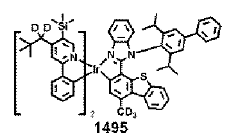
1495

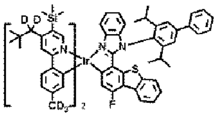
1496

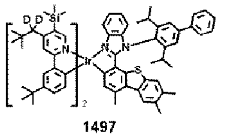
1497

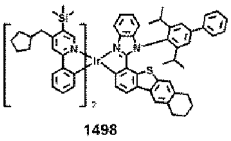
1498

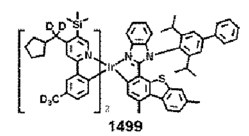
1499

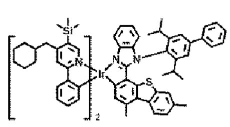
1500

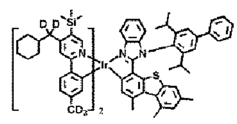
1501

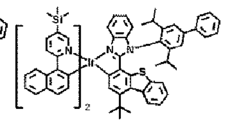
1502

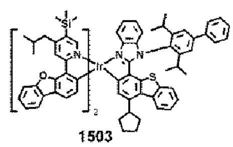
1503

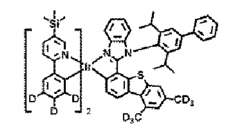
1504

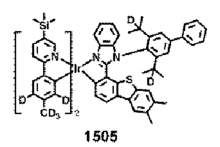
1505

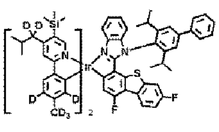
1506

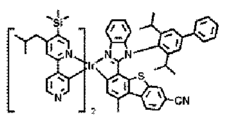
1507

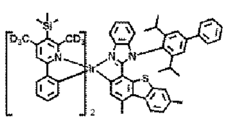
1508

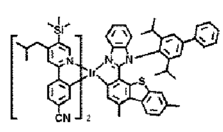
1509

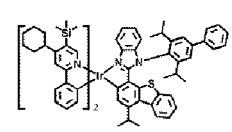
1510

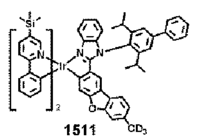
1511

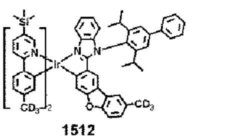
1512

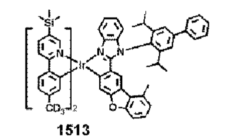
1513

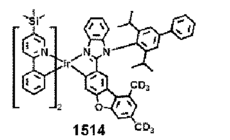
1514

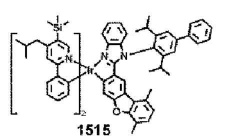
1515

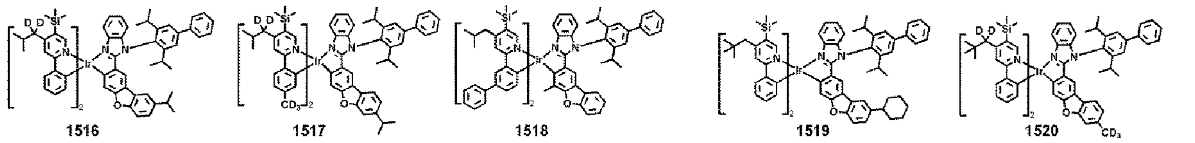
1516 1517 1518 1519 1520

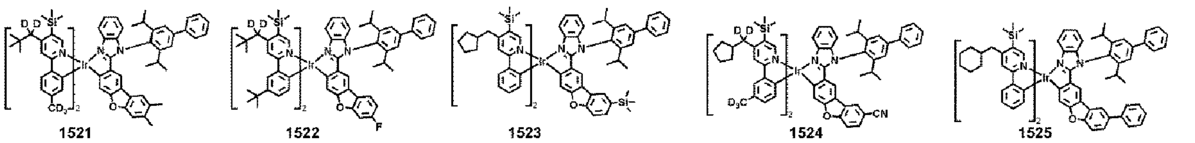
1521 1522 1523 1524 1525

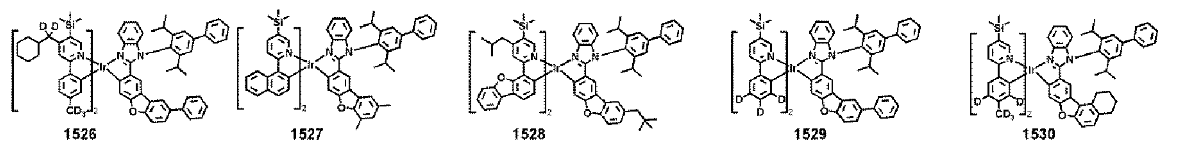
1526 1527 1528 1529 1530

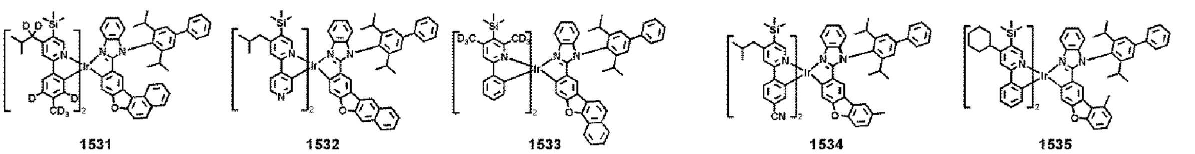
1531 1532 1533 1534 1535

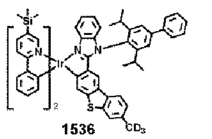
1536
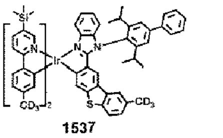
1537
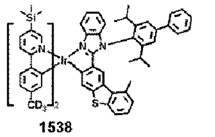
1538
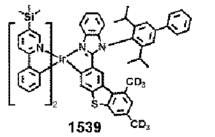
1539
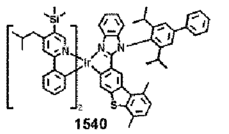
1540
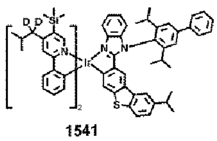
1541
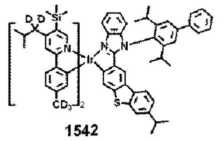
1542
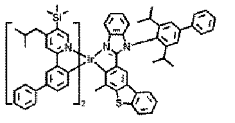
1543
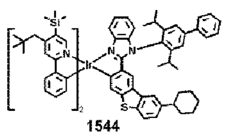
1544
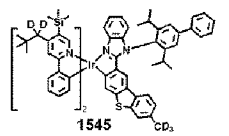
1545
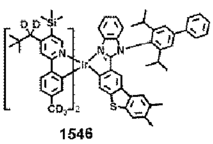
1546
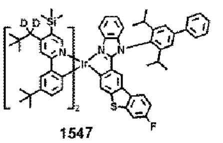
1547
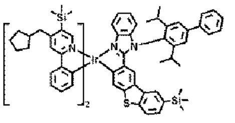
1548
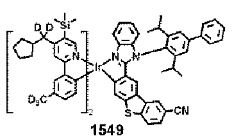
1549
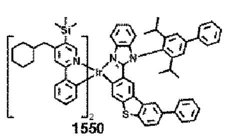
1550
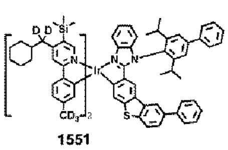
1551
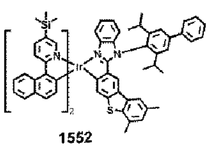
1552
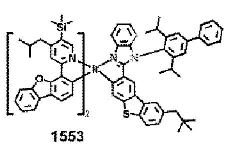
1553
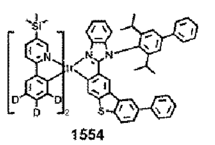
1554
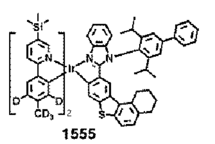
1555
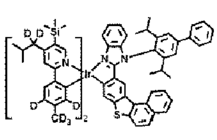
1556
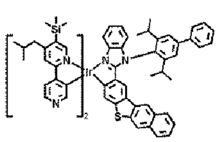
1557
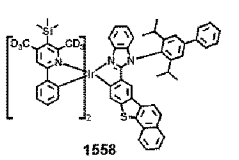
1558
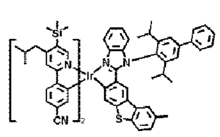
1559
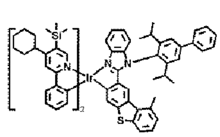
1560
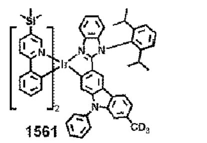
1561
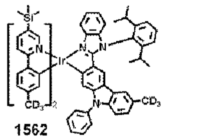
1562
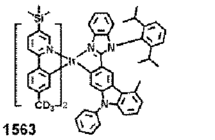
1563
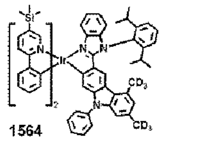
1564
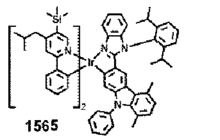
1565
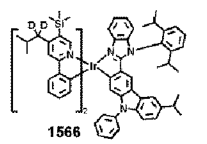
1566
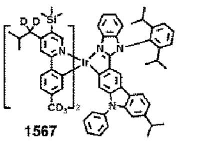
1567
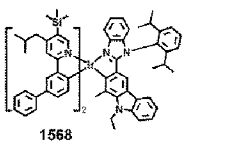
1568
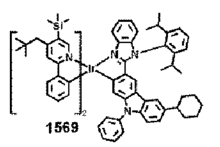
1569
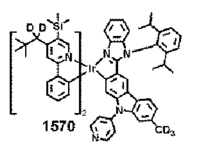
1570
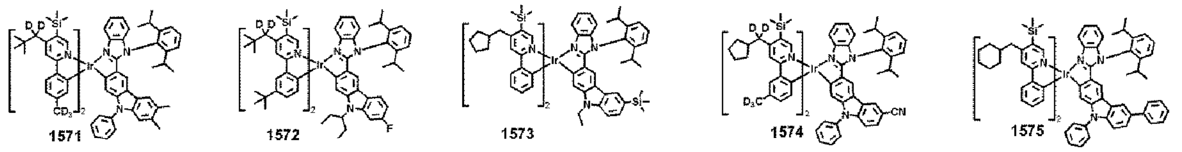
1571 1572 1573 1574 1575
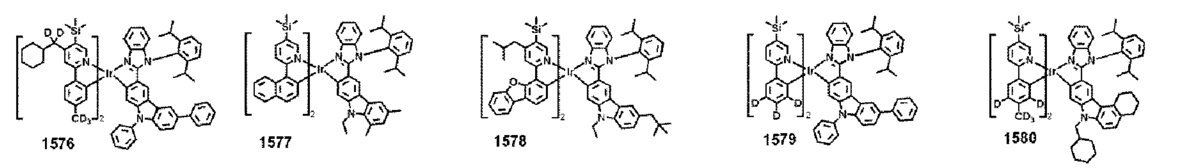
1576 1577 1578 1579 1580
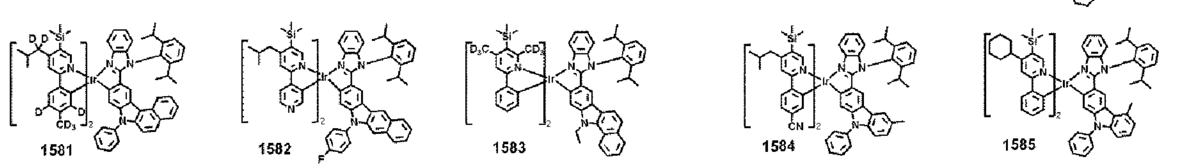
1581 1582 1583 1584 1585

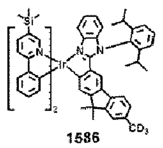
1586
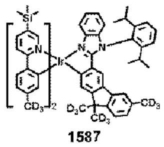
1587
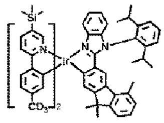
1588
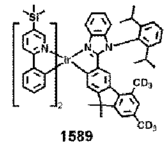
1589
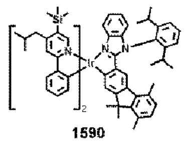
1590
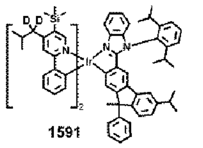
1591
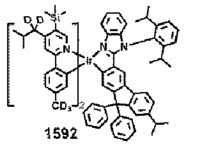
1592
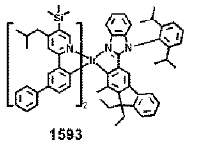
1593
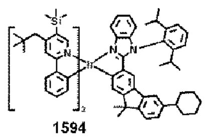
1594
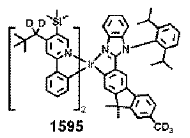
1595
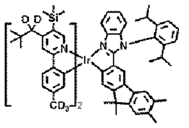
1596
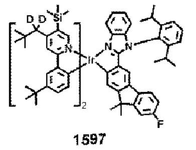
1597
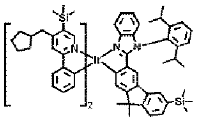
1598
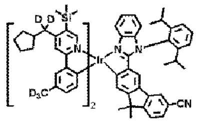
1599
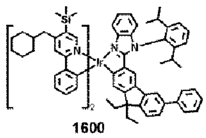
1600
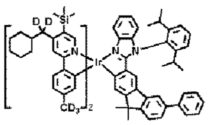
1601
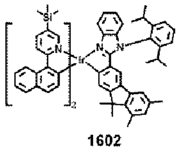
1602
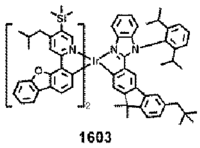
1603
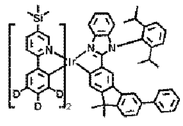
1604
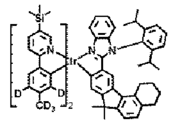
1605
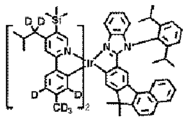
1606
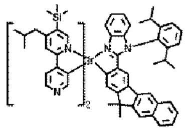
1607
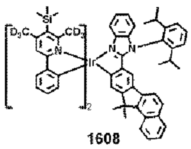
1608
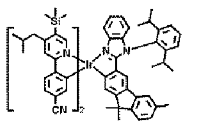
1609
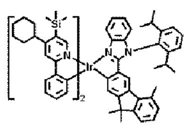
1610
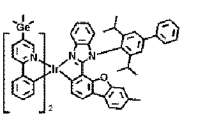
1611
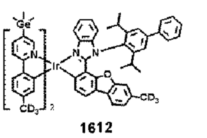
1612
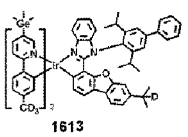
1613
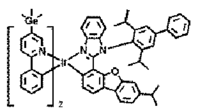
1614
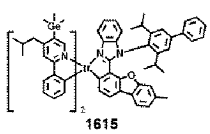
1615
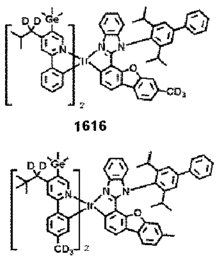
1616
1621
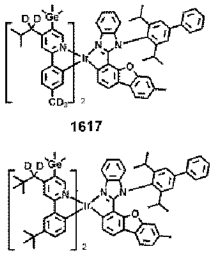
1617
1622
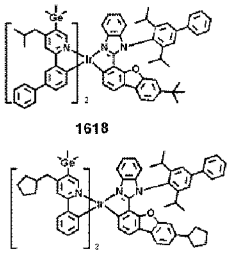
1618
1623
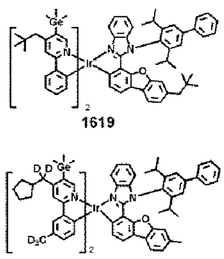
1619
1624
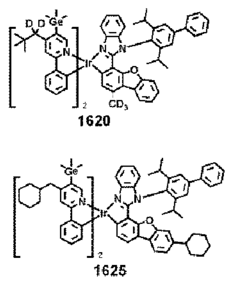
1620
1625
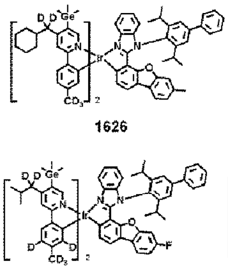
1626
1631
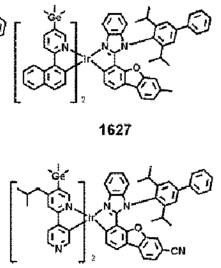
1627
1632
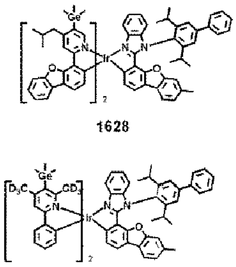
1628
1633
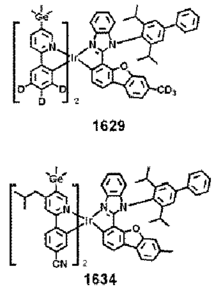
1629
1634
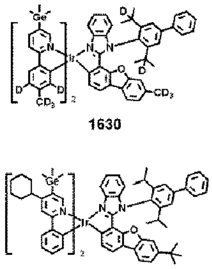
1630
1635

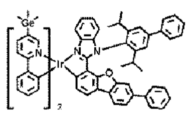
1636
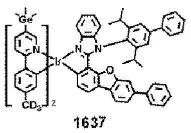
1637
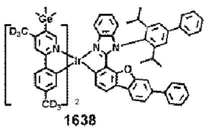
1638
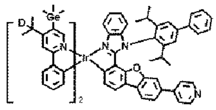
1639
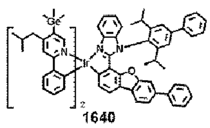
1640

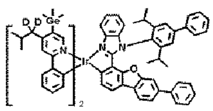
1641
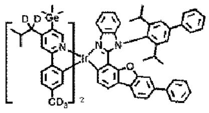
1642
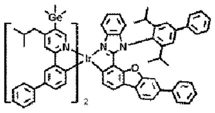
1643
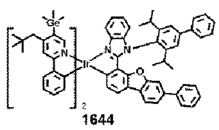
1644
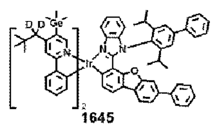
1645

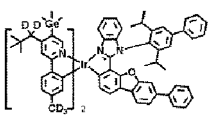
1646
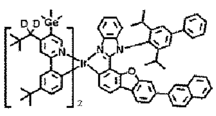
1647
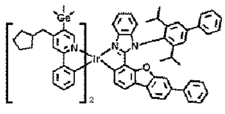
1648
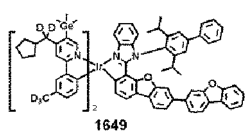
1649
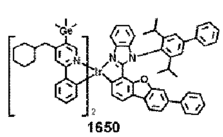
1650

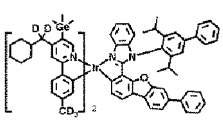
1651
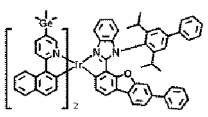
1652
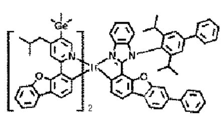
1653
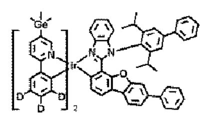
1654
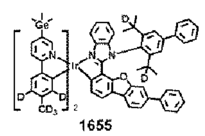
1655

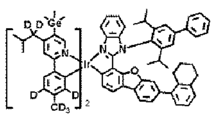
1656
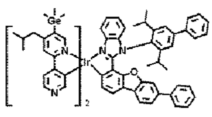
1657
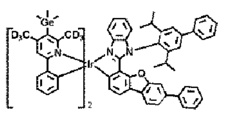
1658
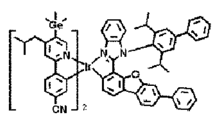
1659
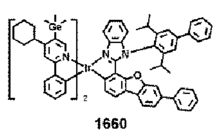
1660

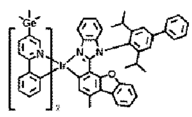
1661
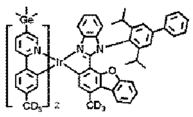
1662
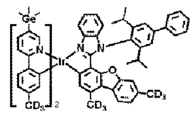
1663
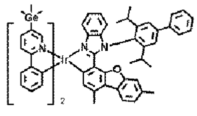
1664
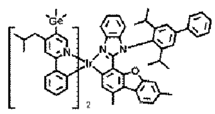
1665

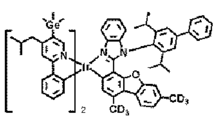
1666
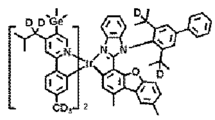
1667
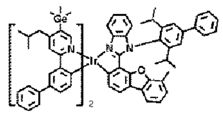
1668
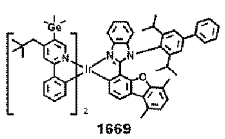
1669
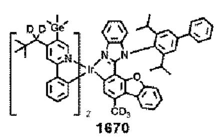
1670

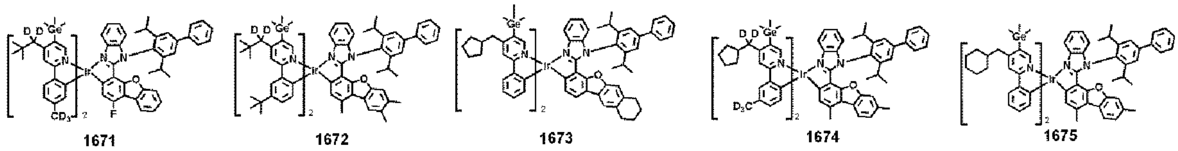
1671
1672
1673
1674
1675

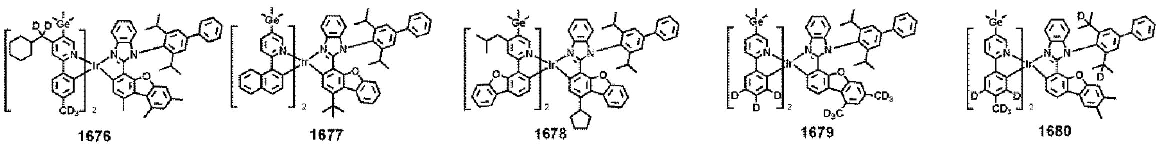
1676
1677
1678
1679
1680

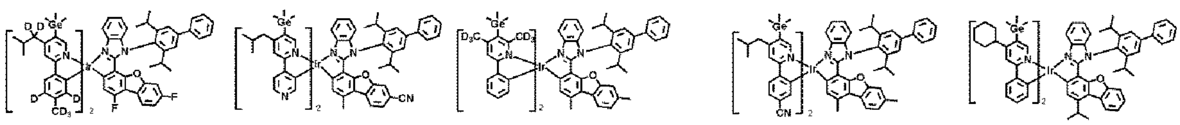
1681
1682
1683
1684
1685

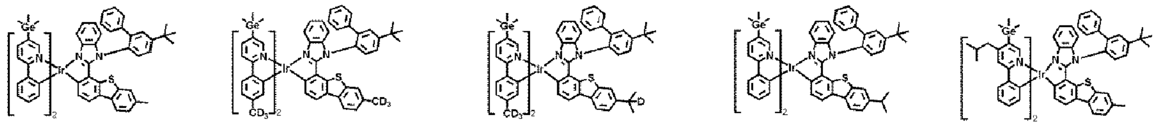
1686 1687 1688 1689 1690

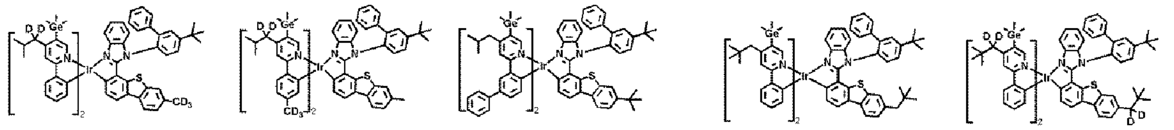
1691 1692 1693 1694 1695

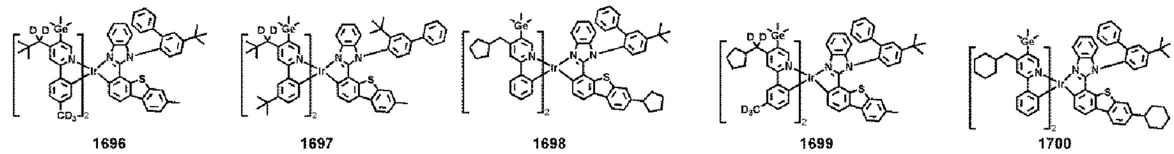
1696 1697 1698 1699 1700

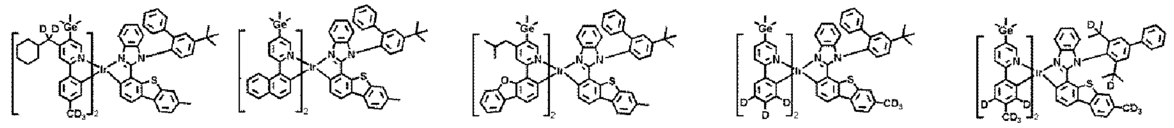
1701 1702 1703 1704 1705

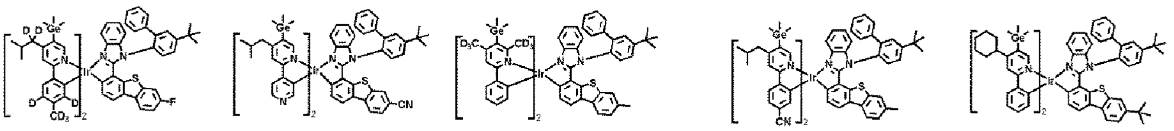
1706 1707 1708 1709 1710

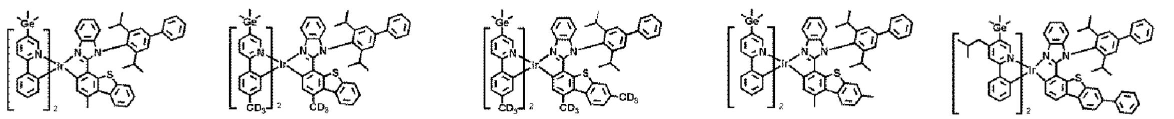
1711 1712 1713 1714 1715

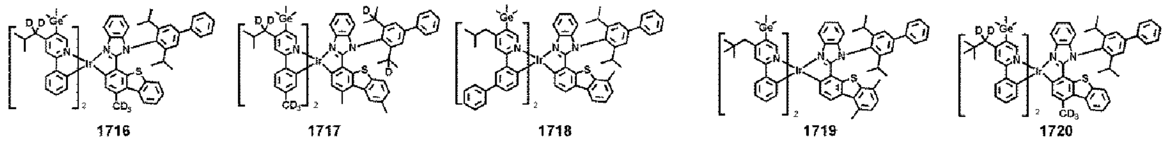
1716 1717 1718 1719 1720

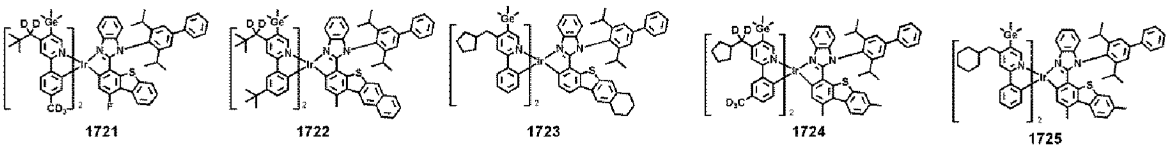
1721 1722 1723 1724 1725

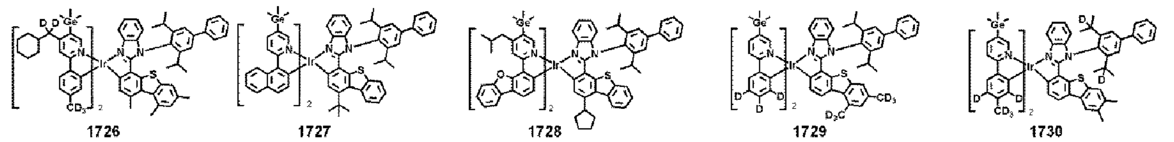
1726 1727 1728 1729 1730

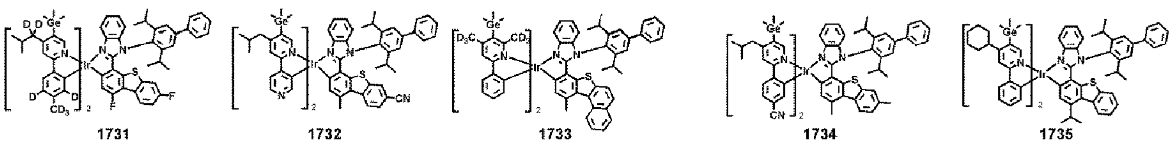
1731 1732 1733 1734 1735

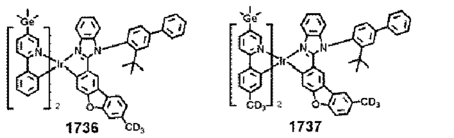
1736
1737
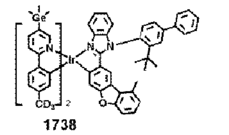
1738
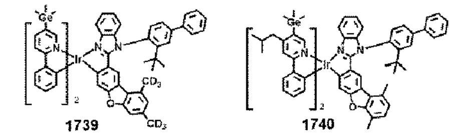
1739
1740
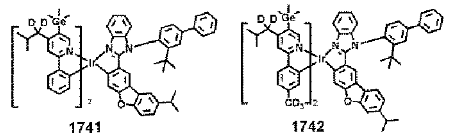
1741
1742
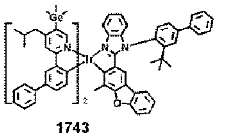
1743
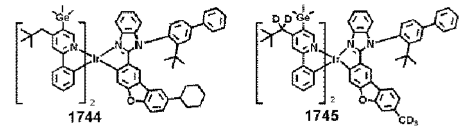
1744
1745
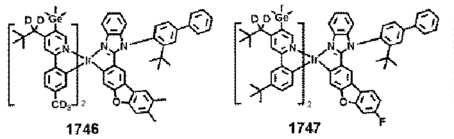
1746
1747
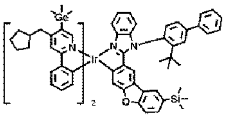
1748
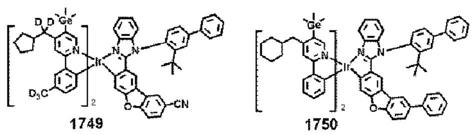
1749
1750
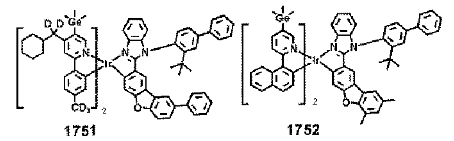
1751
1752
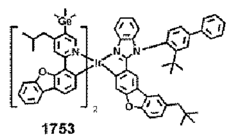
1753
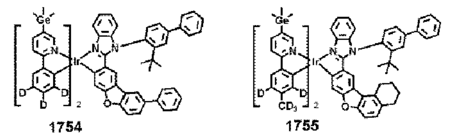
1754
1755
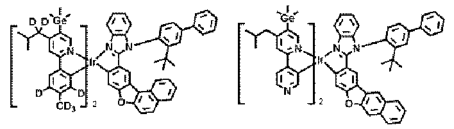
1756
1757
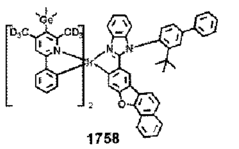
1758
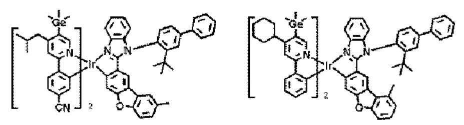
1759
1760
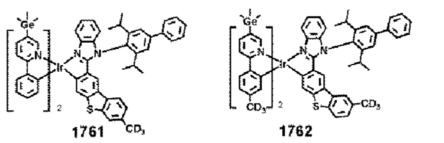
1761
1762
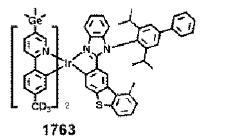
1763
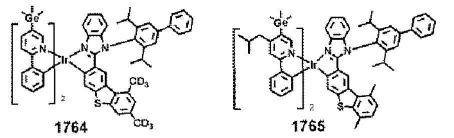
1764
1765
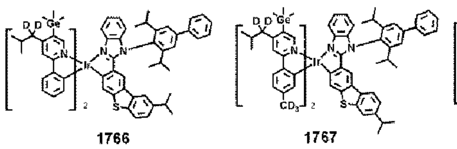
1766
1767
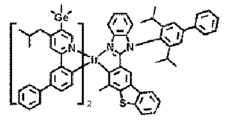
1768
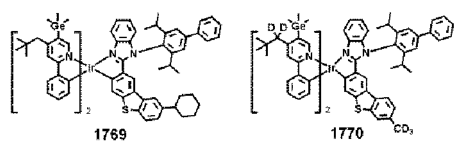
1769
1770
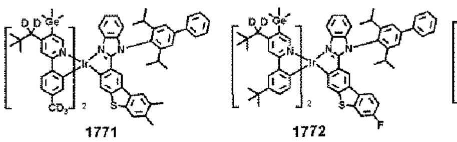
1771
1772
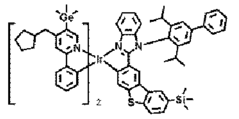
1773
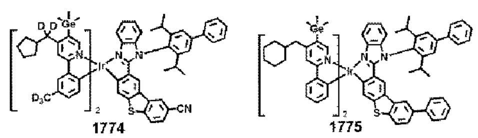
1774
1775
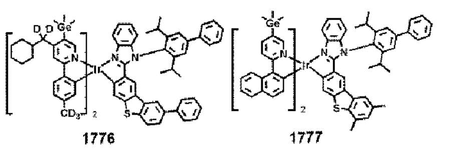
1776
1777
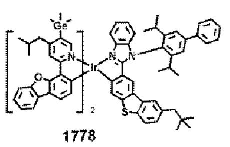
1778
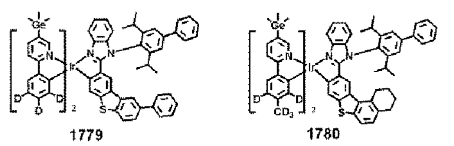
1779
1780
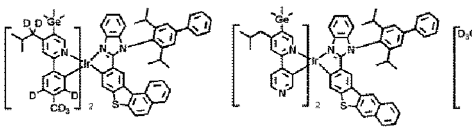
1781
1782
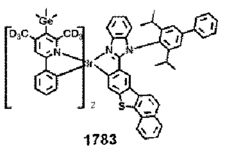
1783
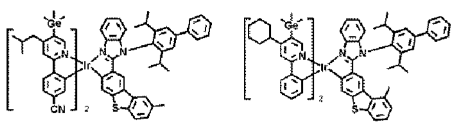
1784
1785

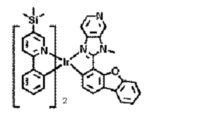
1786
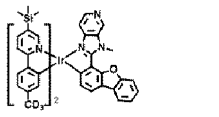
1787
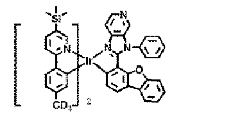
1788
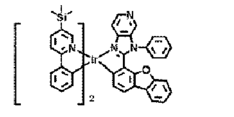
1789
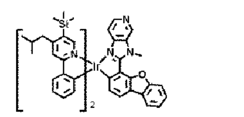
1790

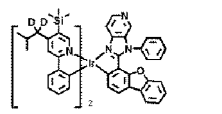
1791
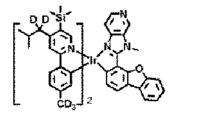
1792
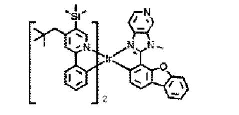
1793
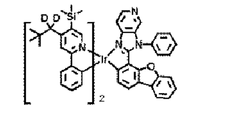
1794
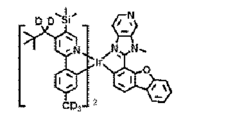
1795

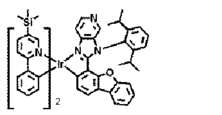
1796
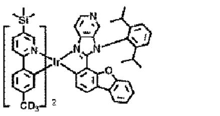
1797
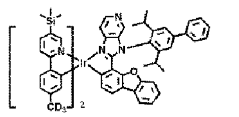
1798
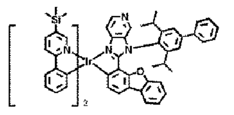
1799
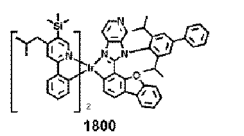
1800

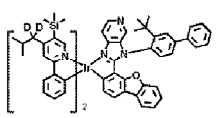
1801
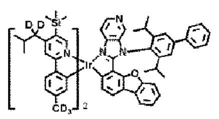
1802
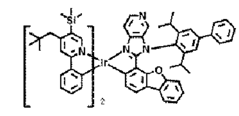
1803
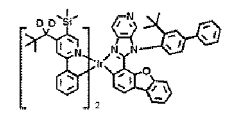
1804
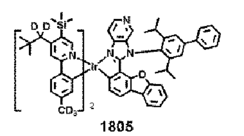
1805

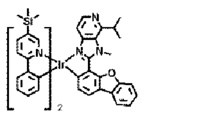
1806
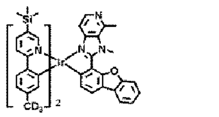
1807
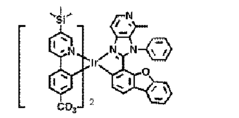
1808
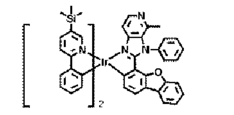
1809
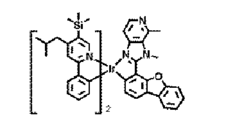
1810

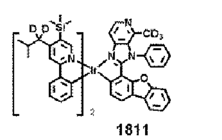
1811
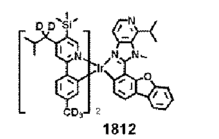
1812
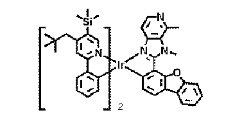
1813
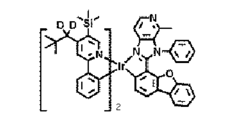
1814
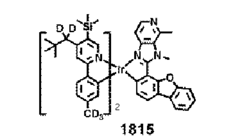
1815

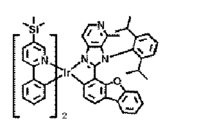
1816
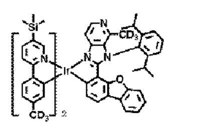
1817
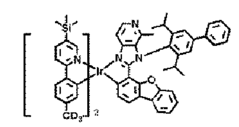
1818
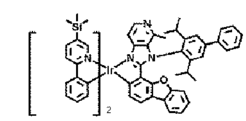
1819
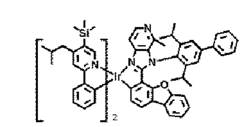
1820

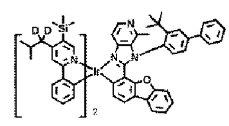
1821
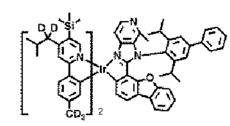
1822
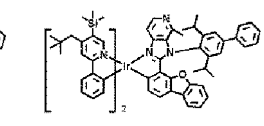
1823
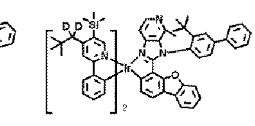
1824
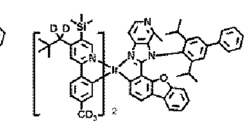
1825

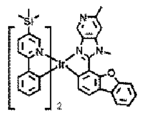
1826

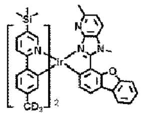
1827

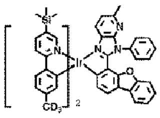
1828

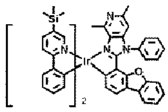
1829

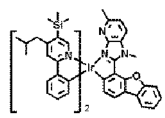
1830

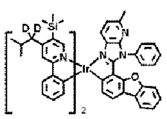
1831

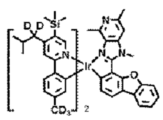
1832

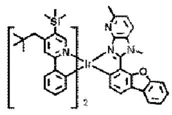
1833

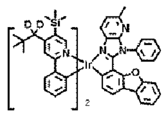
1834

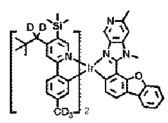
1835

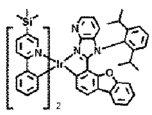
1836

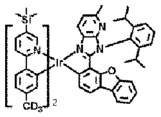
1837

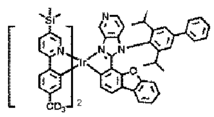
1838

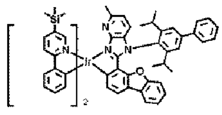
1839

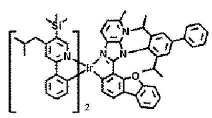
1840

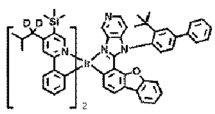
1841

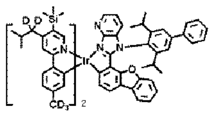
1842

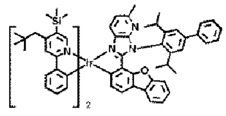
1843

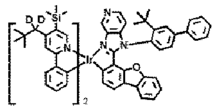
1844

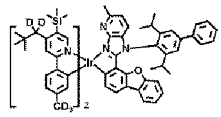
1845

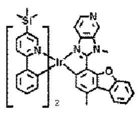
1846

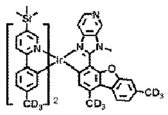
1847

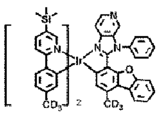
1848

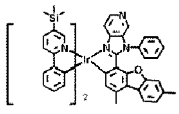
1849

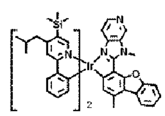
1850

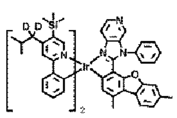
1851

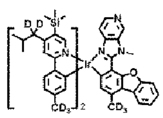
1852

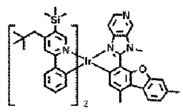
1853

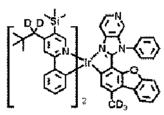
1854

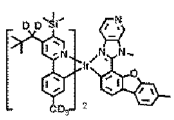
1855

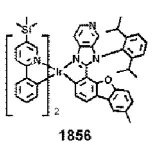
1856

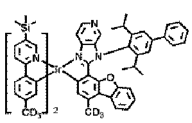
1857

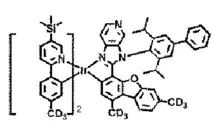
1858

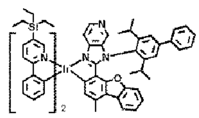
1859

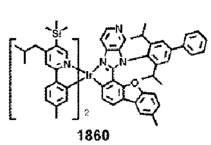
1860

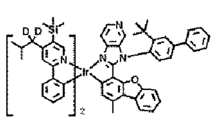
1861

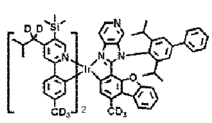
1862

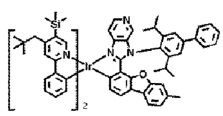
1863

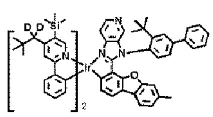
1864

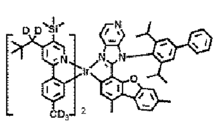
1865

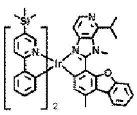
1866

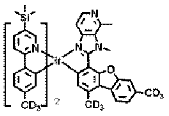
1867

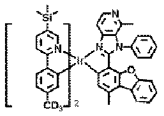
1868

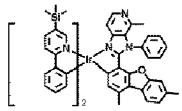
1869

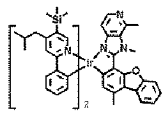
1870

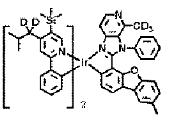
1871

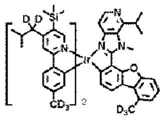
1872

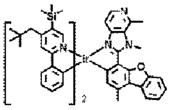
1873

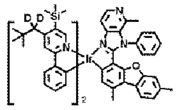
1874

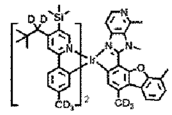
1875

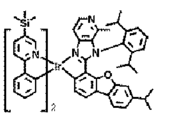
1876

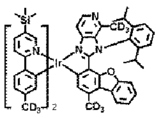
1877

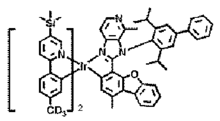
1878

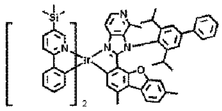
1879

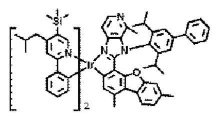
1880

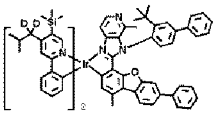
1881

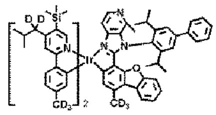
1882

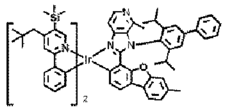
1883

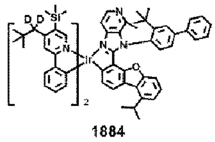
1884

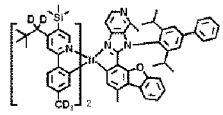
1885

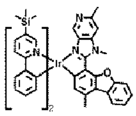
1886

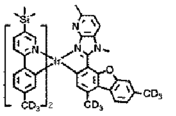
1887

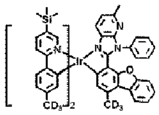
1888

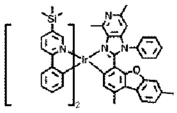
1889

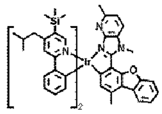
1890

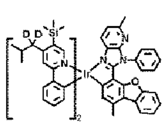
1891

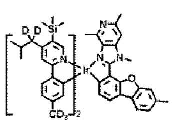
1892

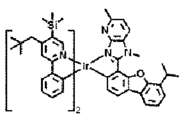
1893

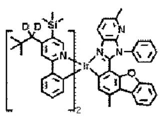
1894

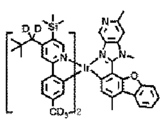
1895

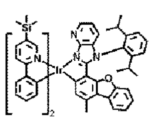
1896

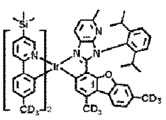
1897

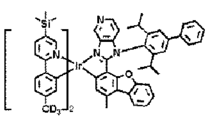
1898

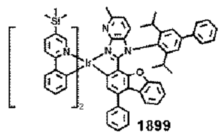
1899

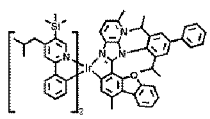
1900

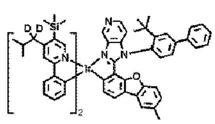
1901

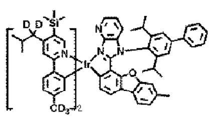
1902

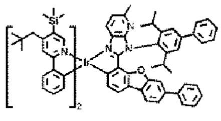
1903

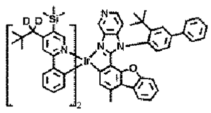
1904

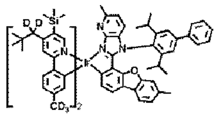
1905

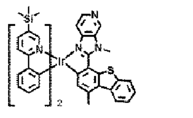
1906

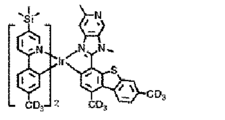
1907

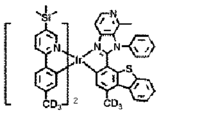
1908

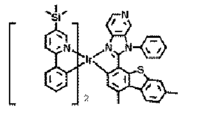
1909

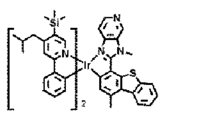
1910

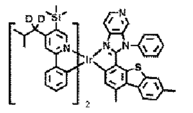
1911

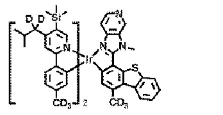
1912

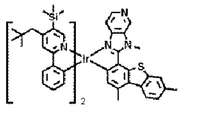
1913

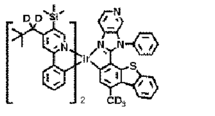
1914

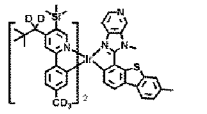
1915

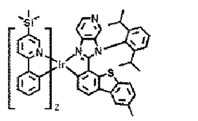
1916

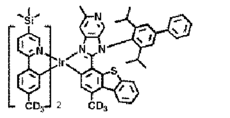
1917

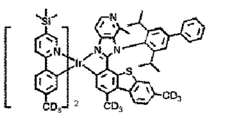
1918

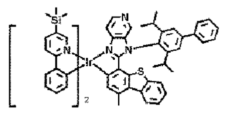
1919

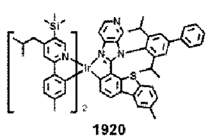
1920

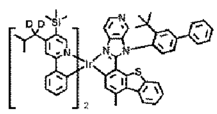
1921

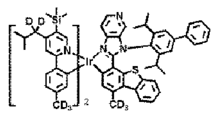
1922

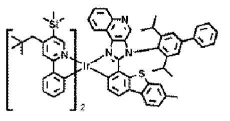
1923

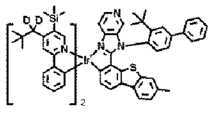
1924

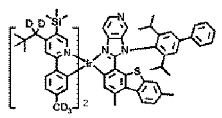
1925

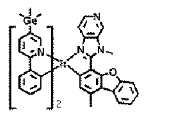
1926

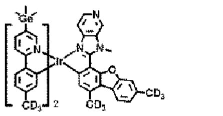
1927

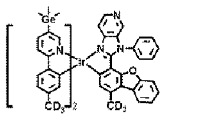
1928

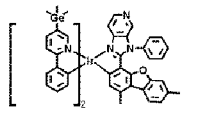
1929

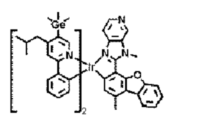
1930

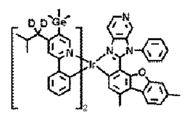
1931

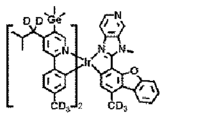
1932

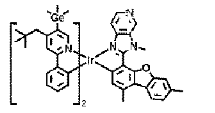
1933

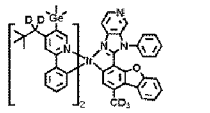
1934

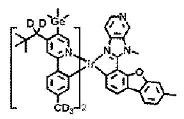
1935

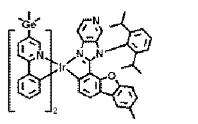
1936

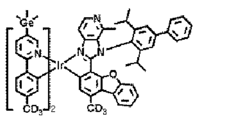
1937

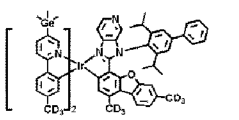
1938

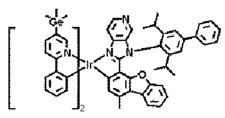
1939

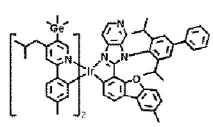
1940

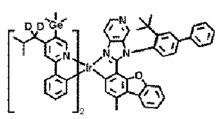
1941

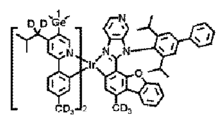
1942

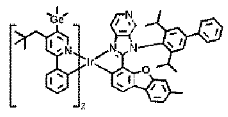
1943

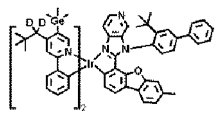
1944

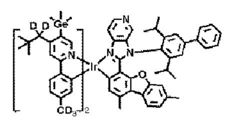
1945

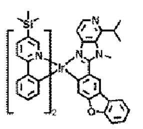
1946

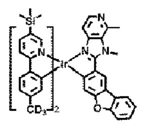
1947

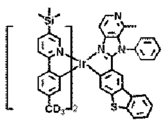
1948

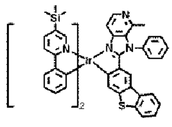
1949

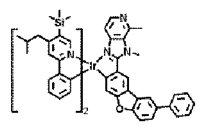
1950

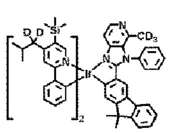
1951

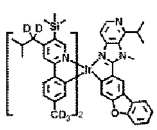
1952

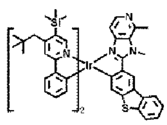
1953

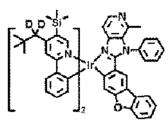
1954

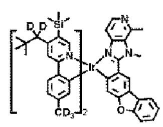
1955

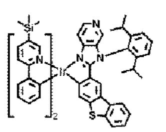
1956

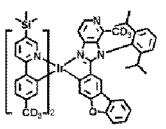
1957

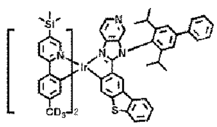
1958

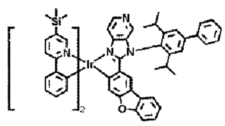
1959

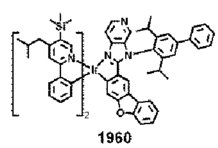
1960

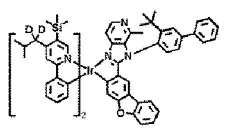
1961

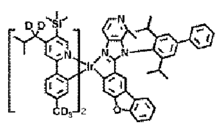
1962

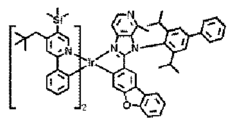
1963

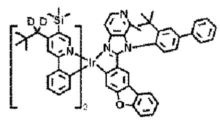
1964

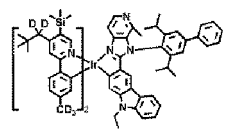
1965

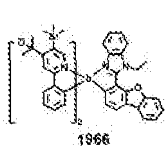
1966

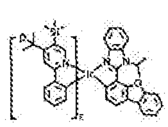
1967

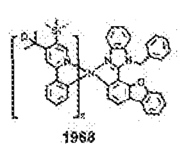
1968

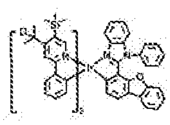
1969

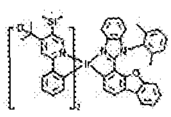
1970

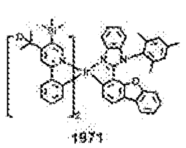
1971

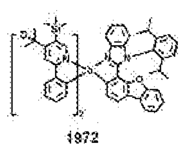
1972

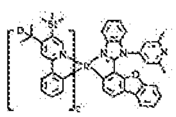
1973

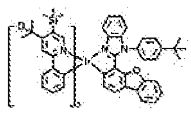
1974

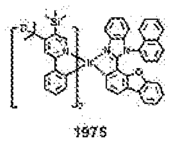
1975

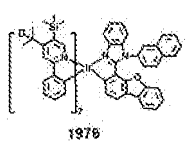
1976

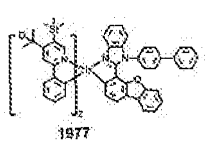
1977

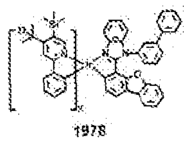
1978

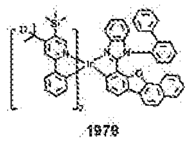
1979

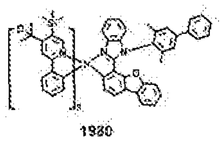
1980

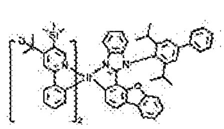
1981

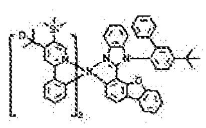
1982

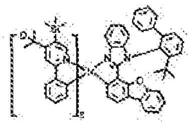
1983

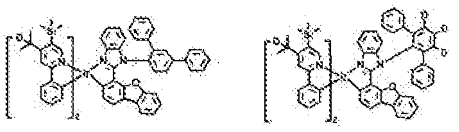
1984

1985

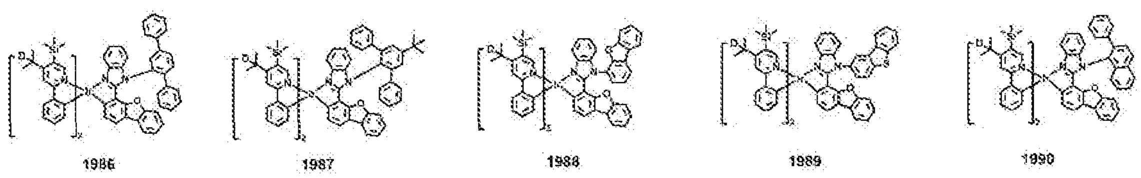
1986

1987

1988

1989

1990

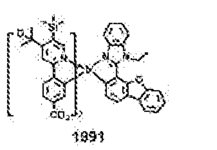
1991
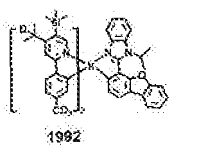
1992
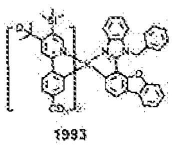
1993
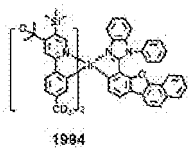
1994
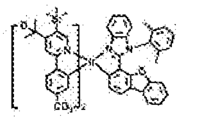
1995

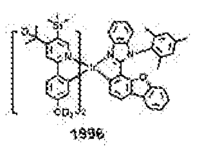
1996
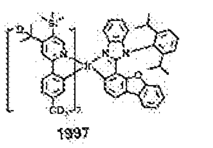
1997
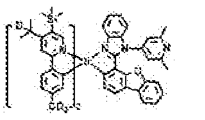
1998
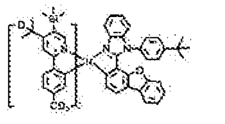
1999
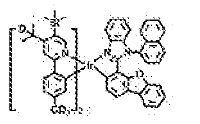
2000

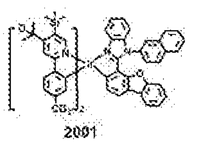
2001
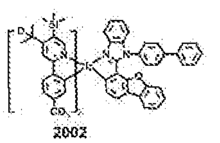
2002
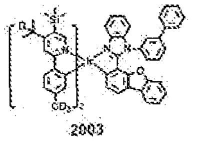
2003
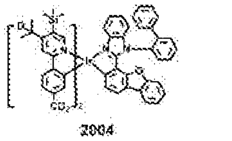
2004
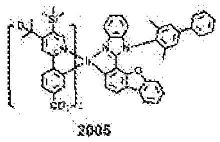
2005

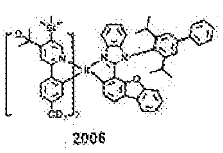
2006
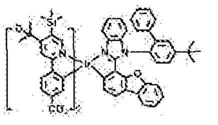
2007
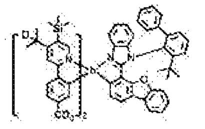
2008
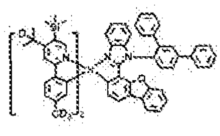
2009
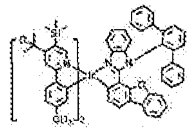
2010

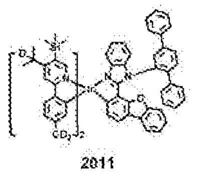
2011
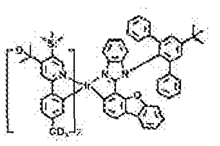
2012
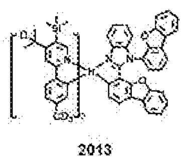
2013
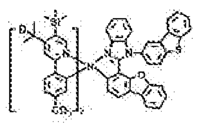
2014
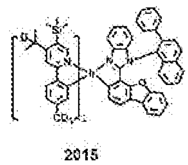
2015

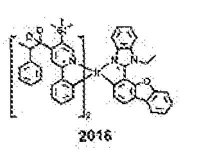
2016
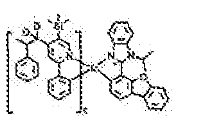
2017
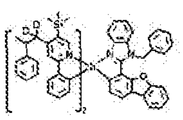
2018
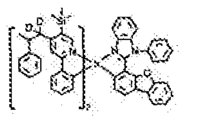
2019
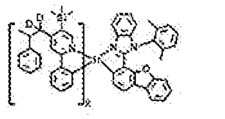
2020

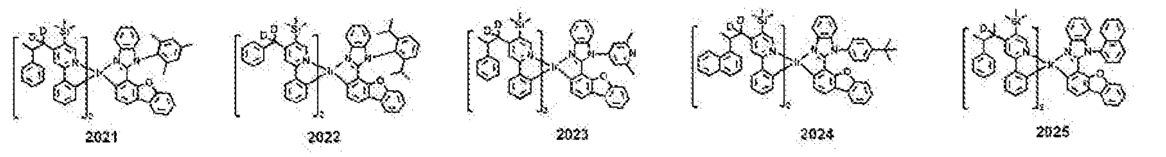
2021
2022
2023
2024
2025

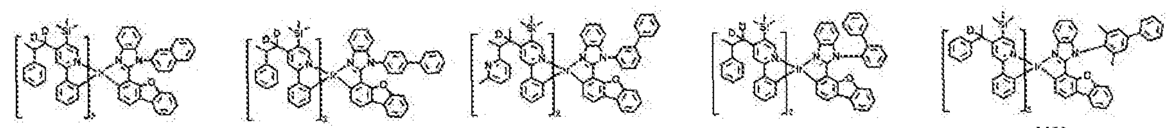
2026
2027
2028
2029
2030

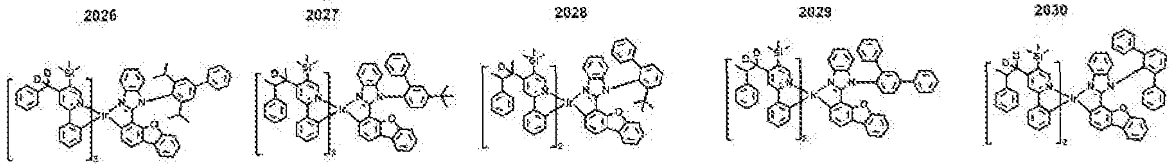
2031
2032
2033
2034
2035

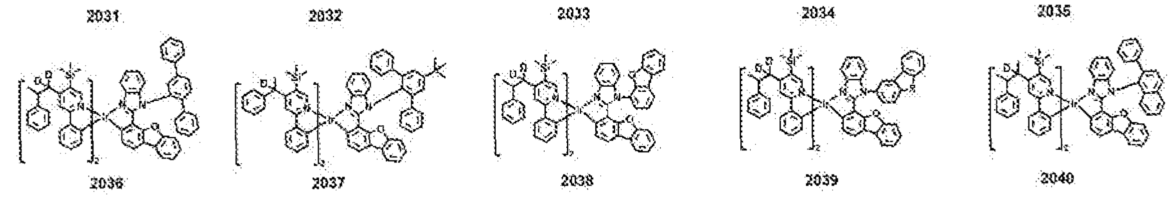
2036
2037
2038
2039
2040

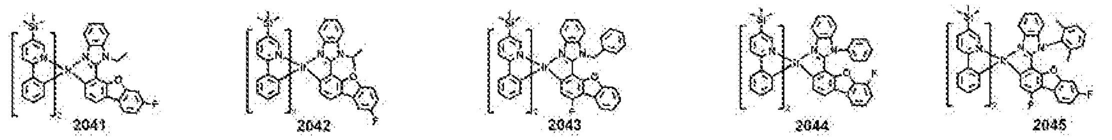

2041 2042 2043 2044 2045

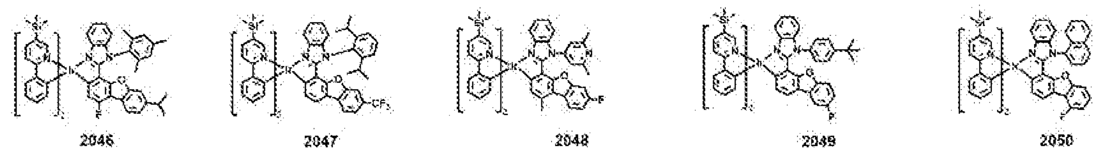

2046 2047 2048 2049 2050

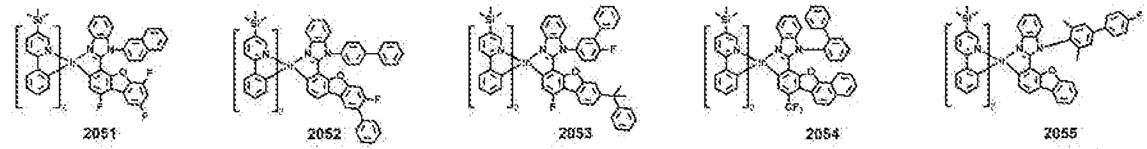

2051 2052 2053 2054 2055

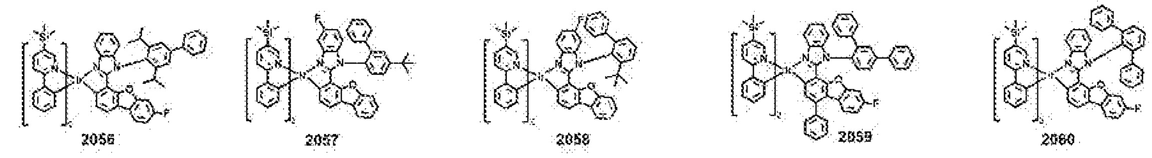

2056 2057 2058 2059 2060

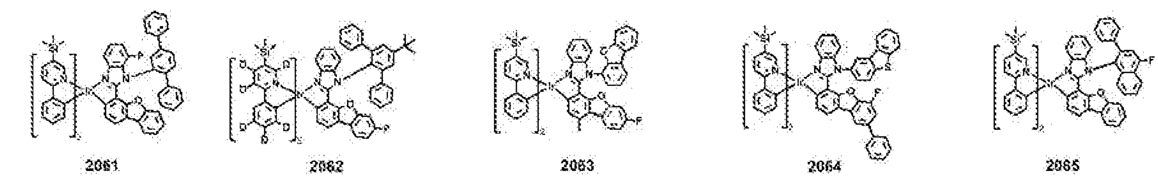

2061 2062 2063 2064 2065

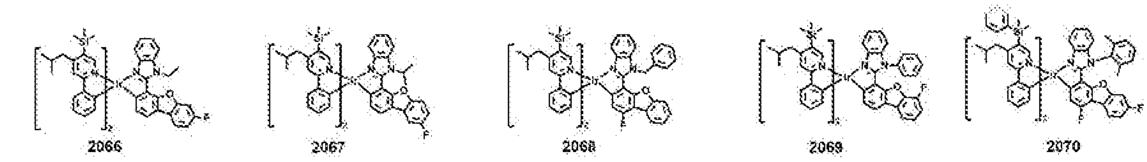

2066 2067 2068 2069 2070

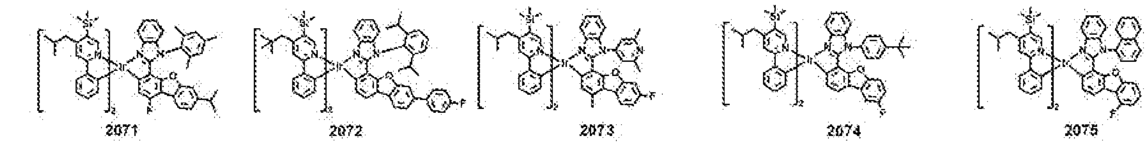

2071 2072 2073 2074 2075

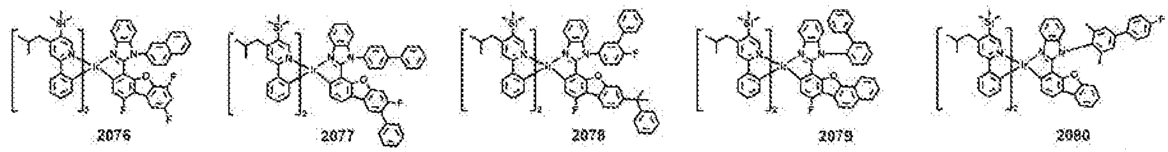

2076 2077 2078 2079 2080

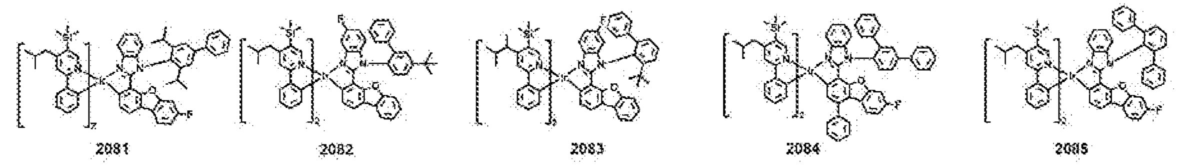

2081 2082 2083 2084 2085

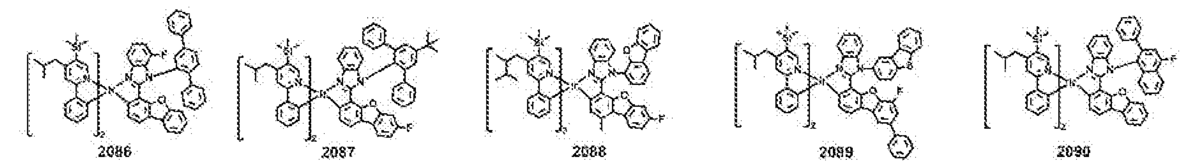

2086 2087 2088 2089 2090

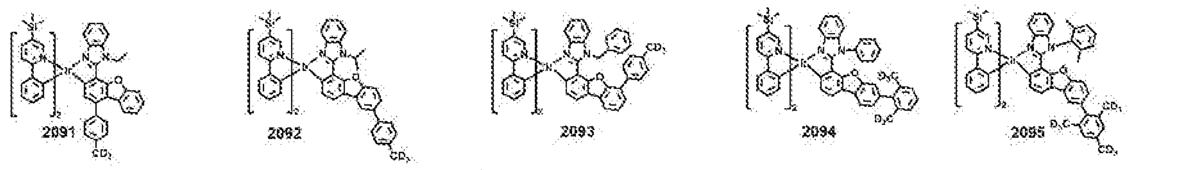
2091 2092 2093 2094 2095

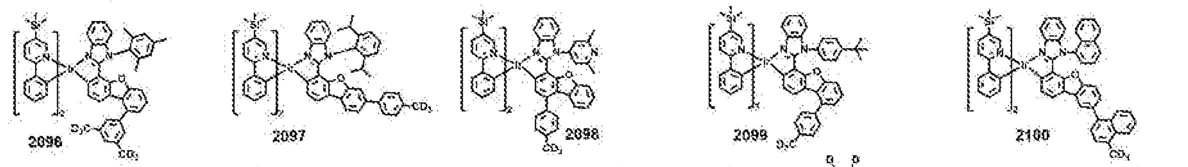
2096 2097 2098 2099 2100

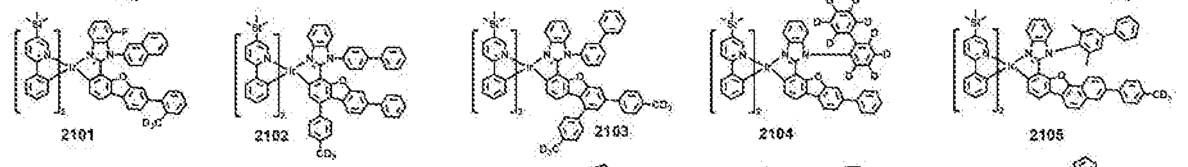
2101 2102 2103 2104 2105

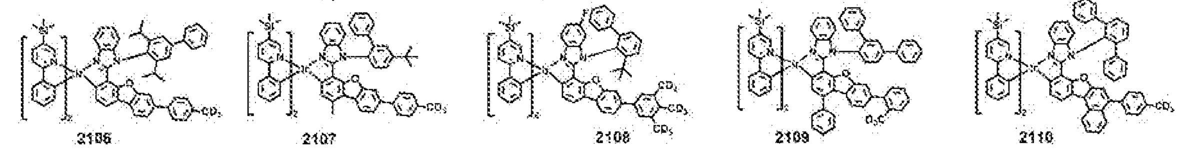
2106 2107 2108 2109 2110

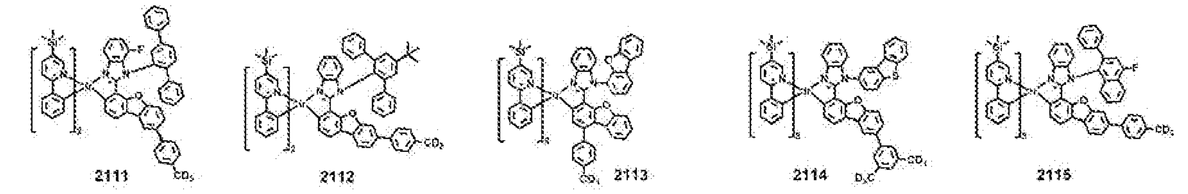
2111 2112 2113 2114 2115

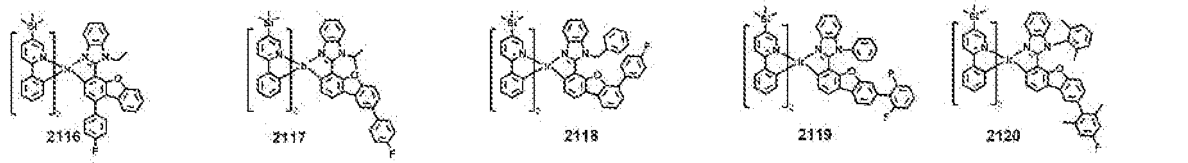
2116 2117 2118 2119 2120

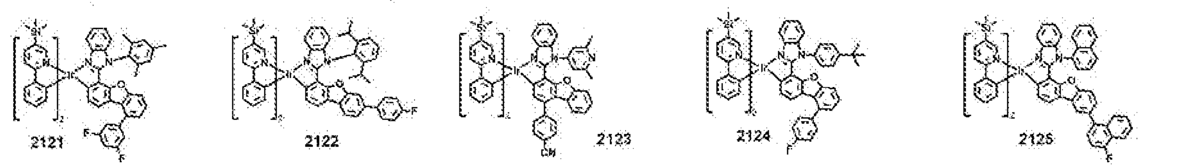
2121 2122 2123 2124 2125

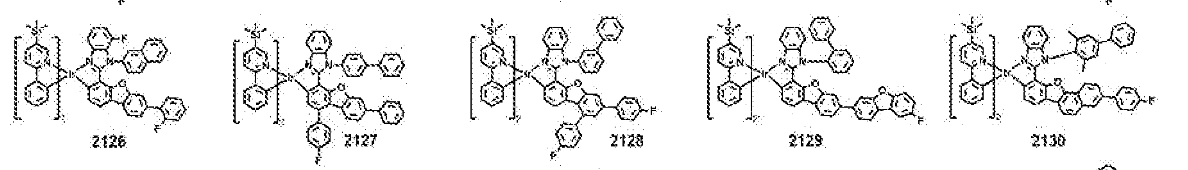
2126 2127 2128 2129 2130

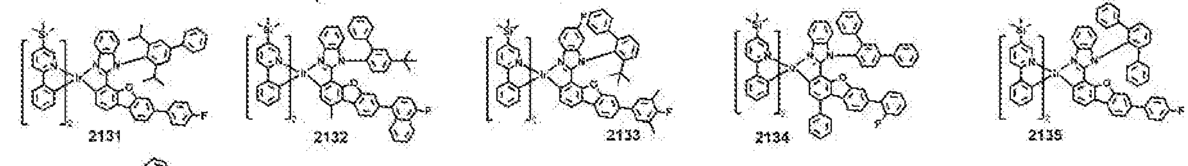
2131 2132 2133 2134 2135

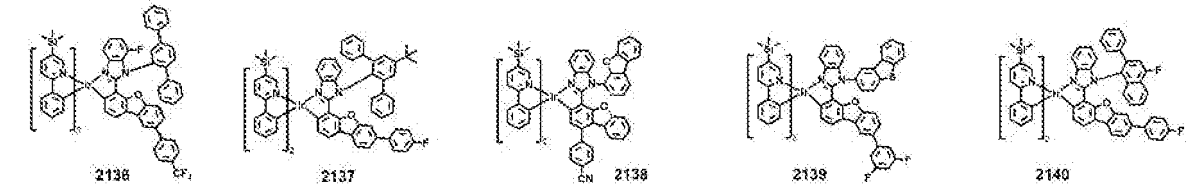
2136 2137 2138 2139 2140

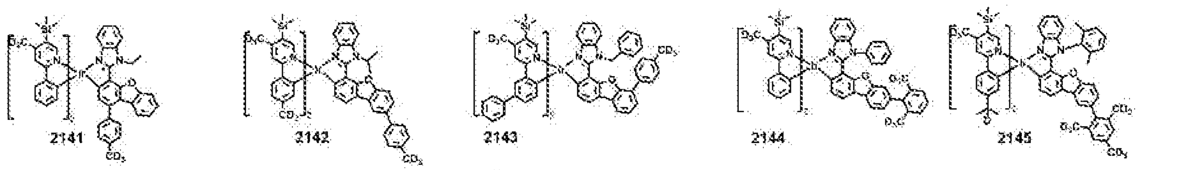
2141 2142 2143 2144 2145

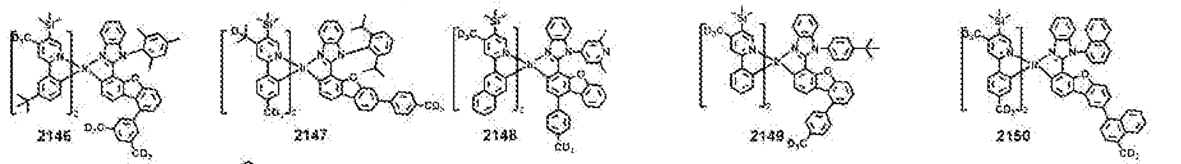
2146 2147 2148 2149 2150

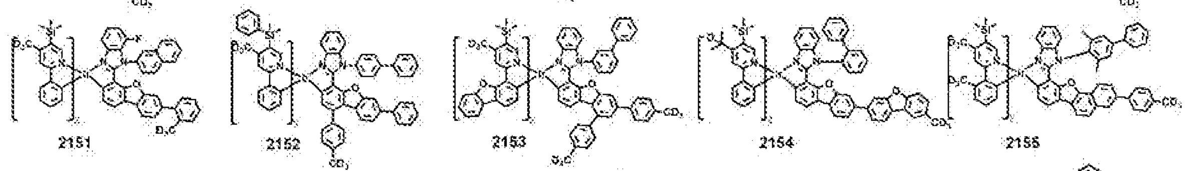
2151 2152 2153 2154 2155

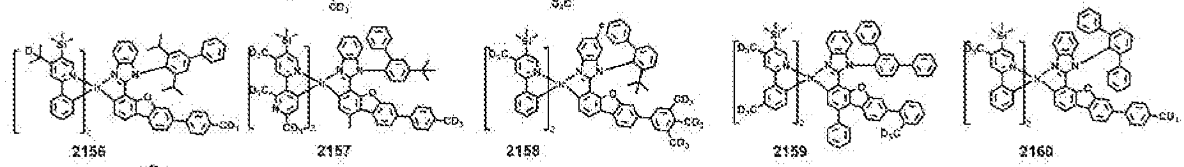
2156 2157 2158 2159 2160

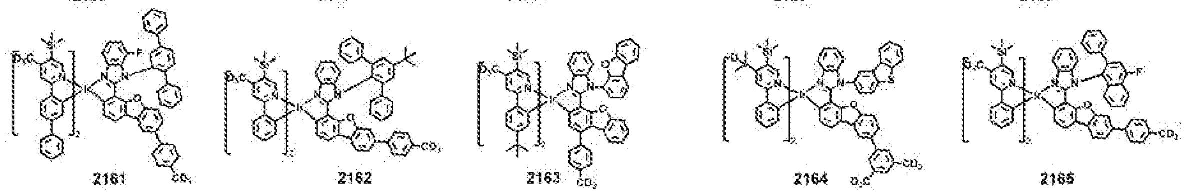
2161 2162 2163 2164 2165

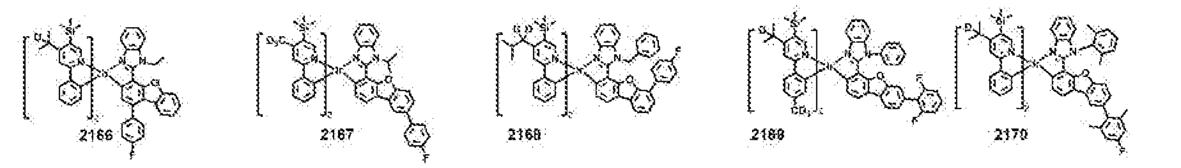
2166 2167 2168 2169 2170

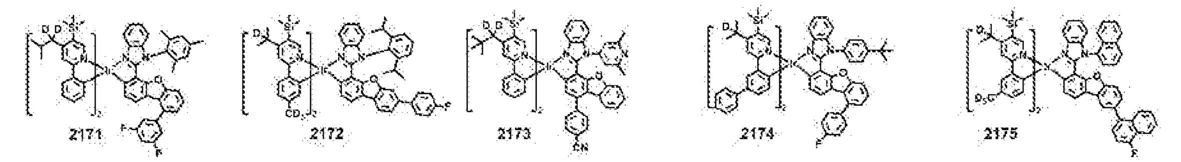
2171 2172 2173 2174 2175

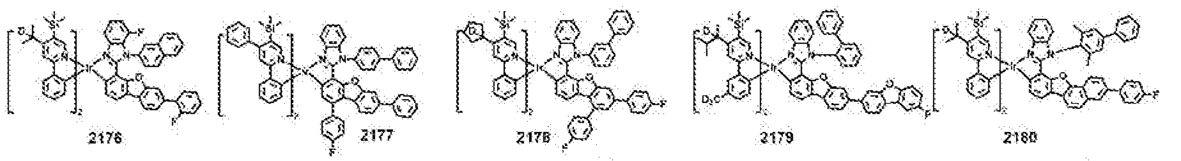
2176 2177 2178 2179 2180

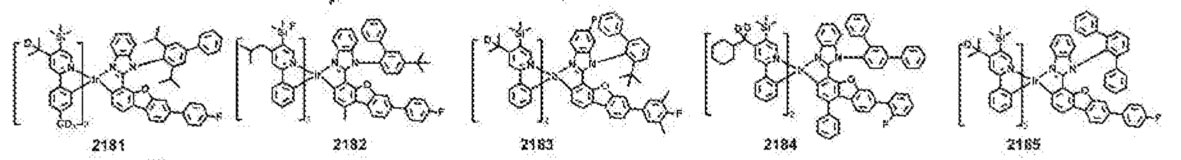
2181 2182 2183 2184 2185

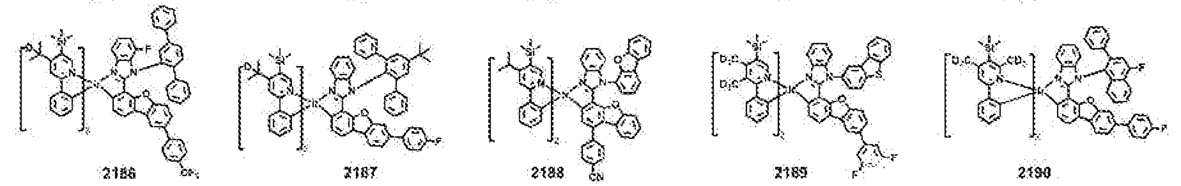
2186 2187 2188 2189 2190

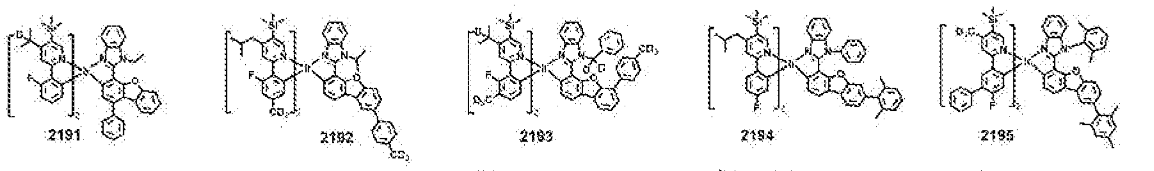

2191 2192 2193 2194 2195

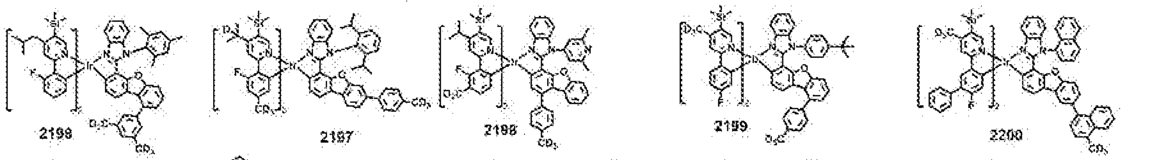

2196 2197 2198 2199 2200

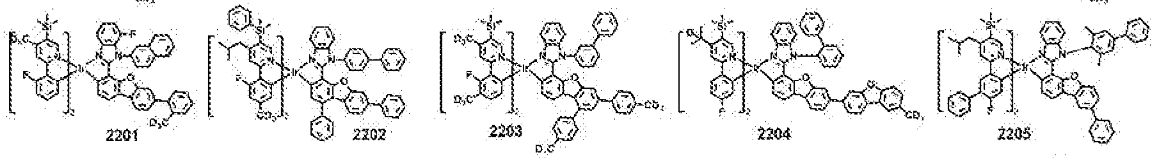

2201 2202 2203 2204 2205

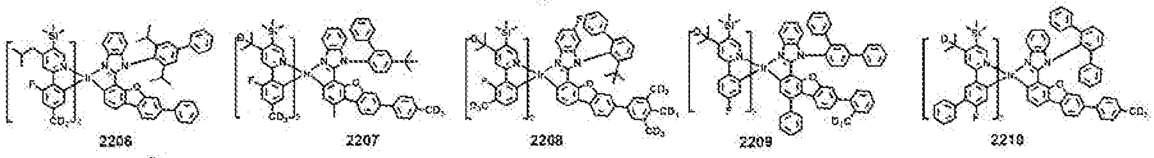

2206 2207 2208 2209 2210

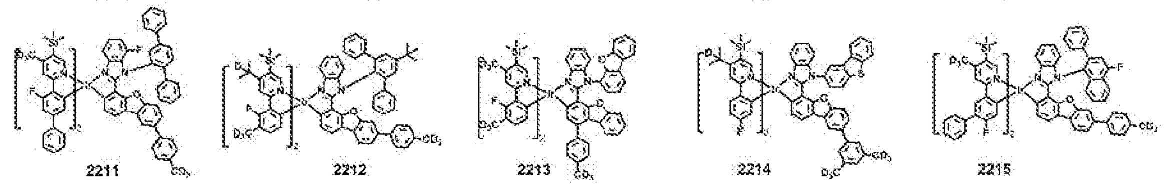

2211 2212 2213 2214 2215

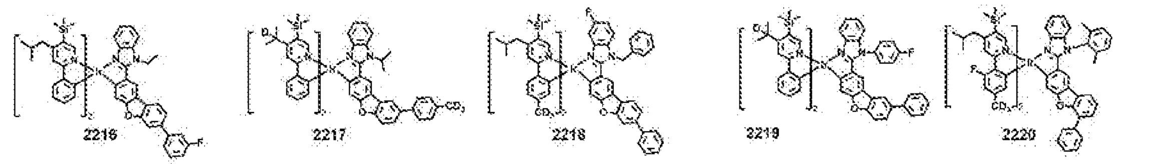

2216 2217 2218 2219 2220

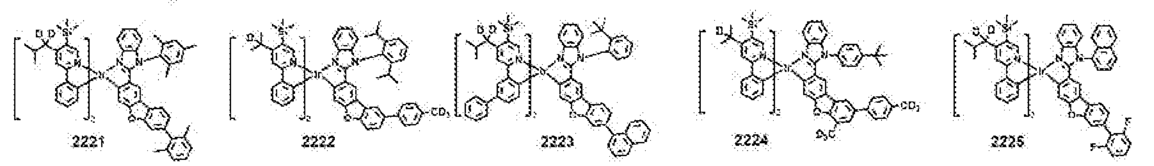

2221 2222 2223 2224 2225

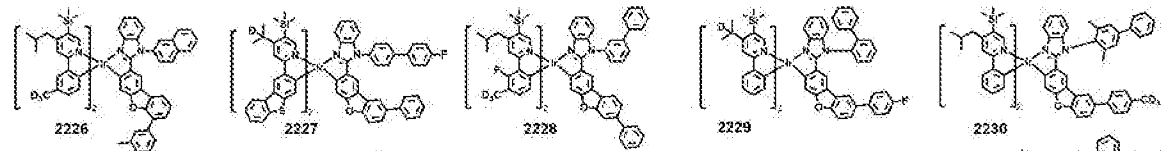

2226 2227 2228 2229 2230

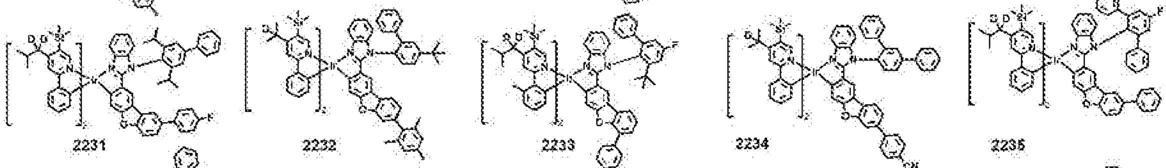

2231 2232 2233 2234 2235

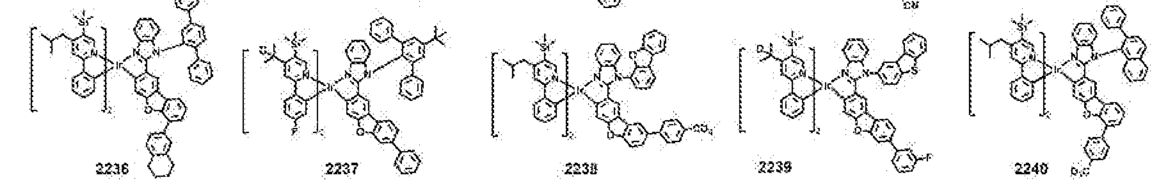

2236 2237 2238 2239 2240

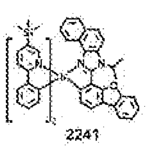
2241
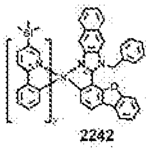
2242
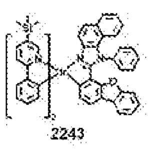
2243
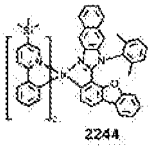
2244
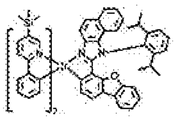
2245
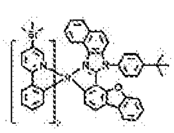
2246
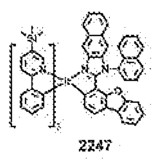
2247
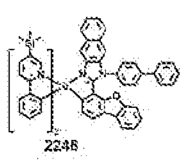
2248
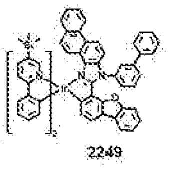
2249
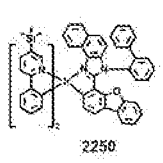
2250
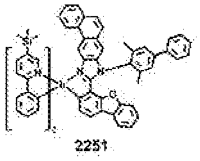
2251
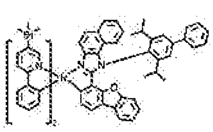
2252
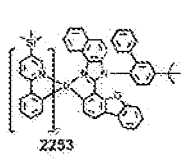
2253
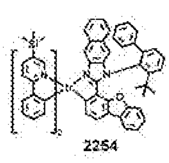
2254
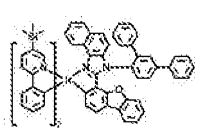
2255
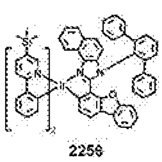
2256
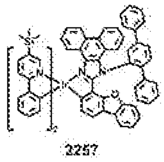
2257
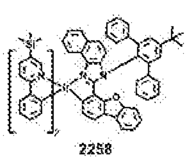
2258
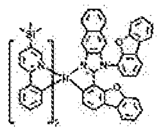
2259
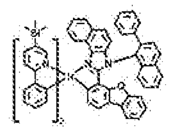
2260
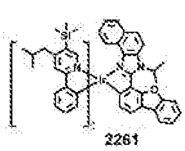
2261
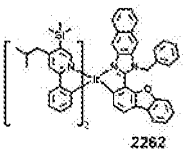
2262
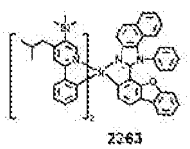
2263
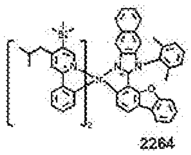
2264
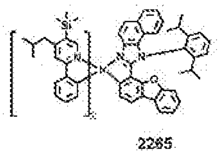
2265
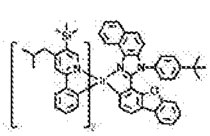
2266
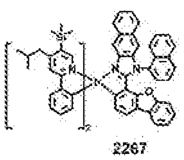
2267
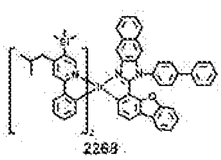
2268
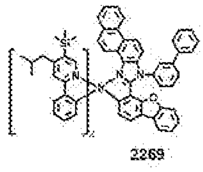
2269
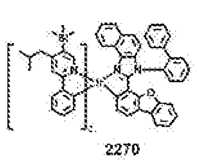
2270
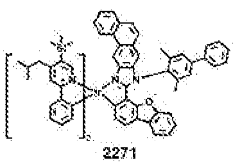
2271
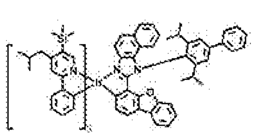
2272
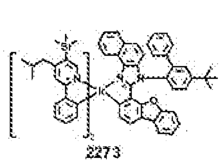
2273
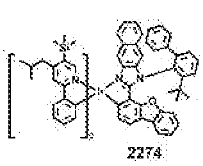
2274
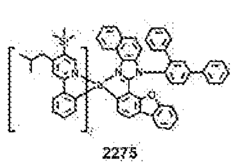
2275
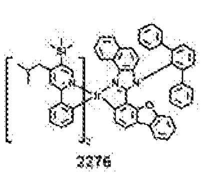
2276
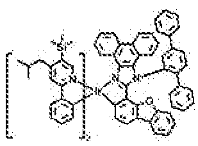
2277
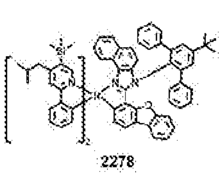
2278
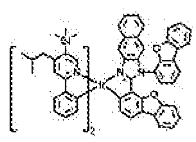
2279
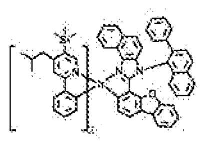
2280

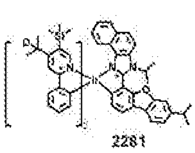
2281
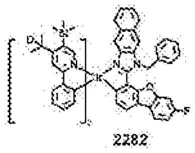
2282
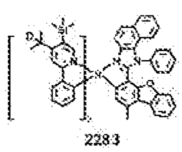
2283
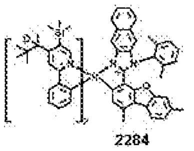
2284
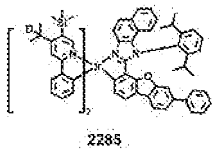
2285

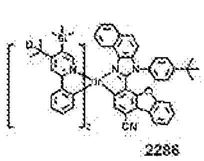
2286
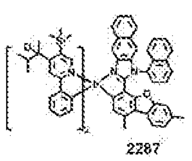
2287
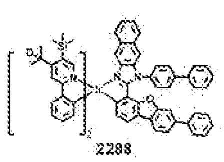
2288
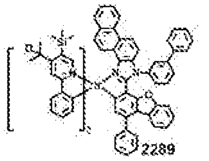
2289
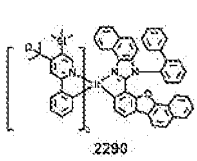
2290

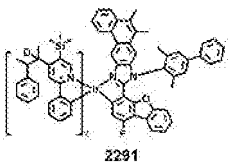
2291
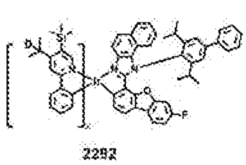
2292
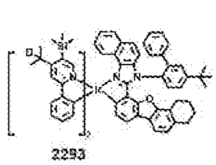
2293
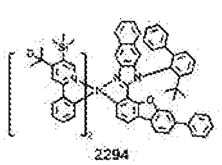
2294
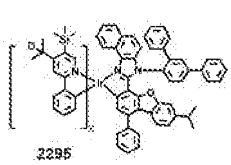
2295

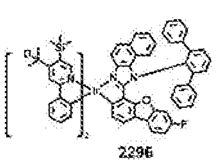
2296
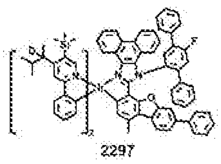
2297
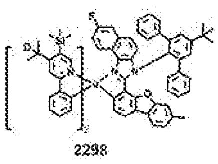
2298
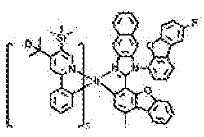
2299
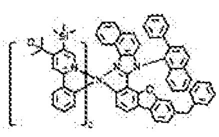
2300

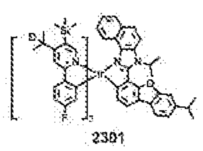
2301
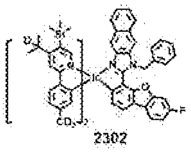
2302
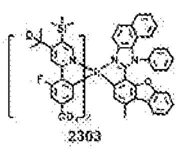
2303
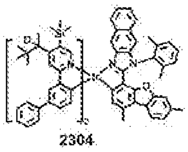
2304
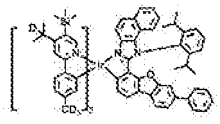
2305

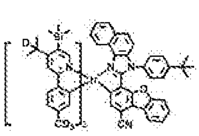
2306
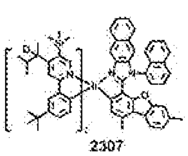
2307
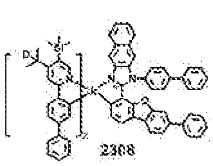
2308
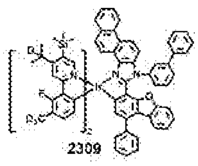
2309
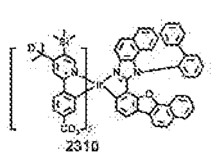
2310

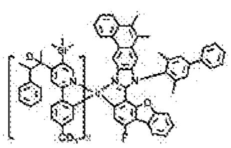
2311
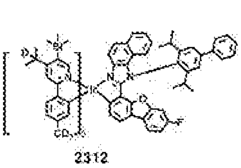
2312
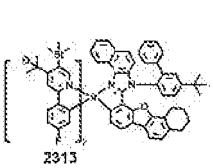
2313
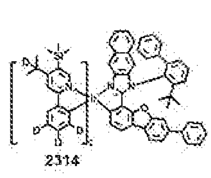
2314
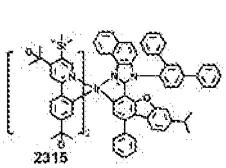
2315

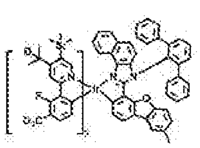
2316
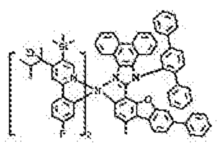
2317
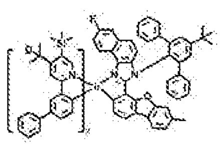
2318
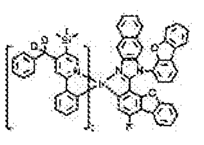
2319
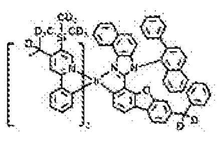
2320

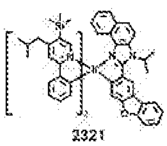
2321
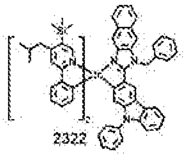
2322
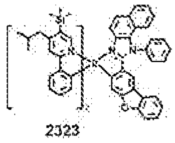
2323
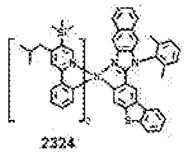
2324
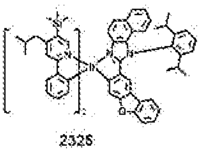
2325

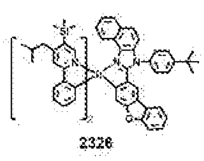
2326
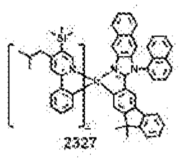
2327
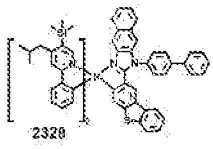
2328
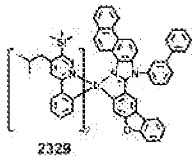
2329
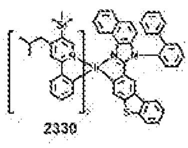
2330

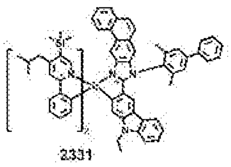
2331
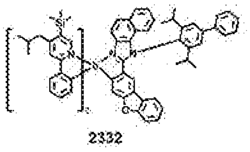
2332
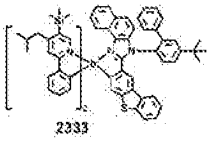
2333
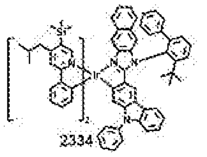
2334
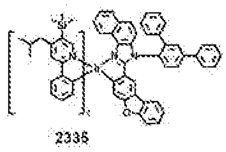
2335

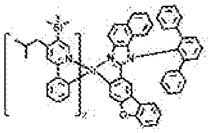
2336
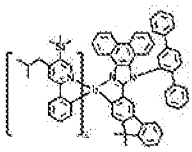
2337
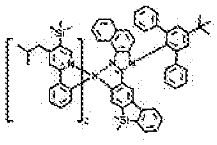
2338
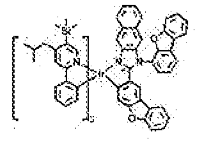
2339
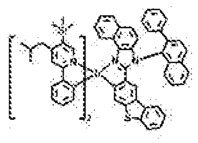
2340

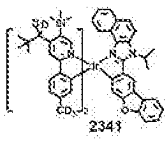
2341
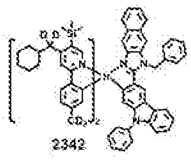
2342
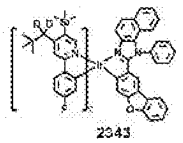
2343
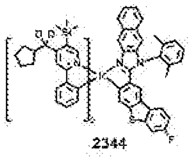
2344
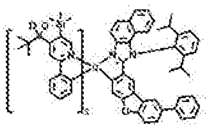
2345

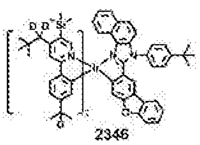
2346
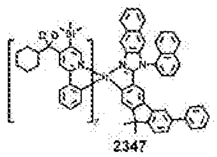
2347
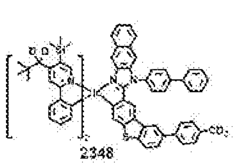
2348
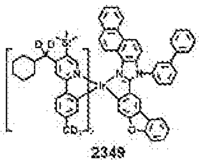
2349
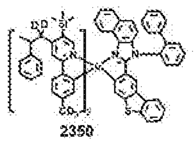
2350

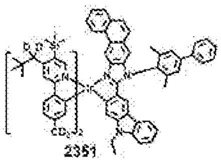
2351
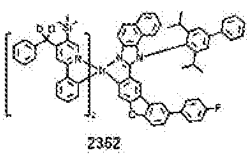
2352
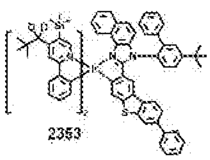
2353
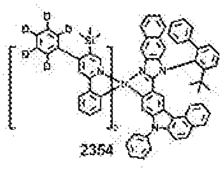
2354
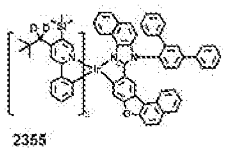
2355

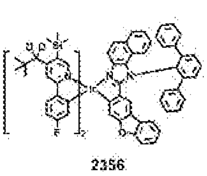
2356
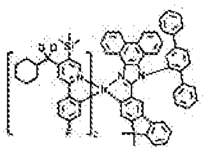
2357
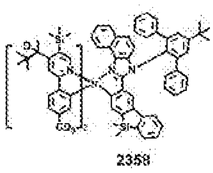
2358
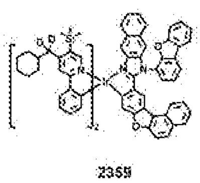
2359
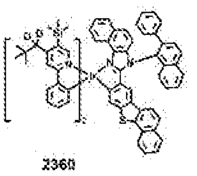
2360

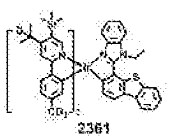
2361
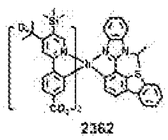
2362
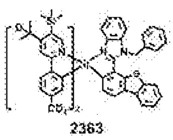
2363
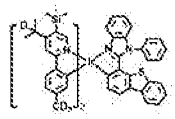
2364
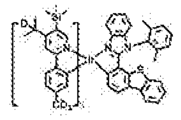
2365
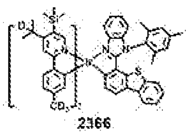
2366
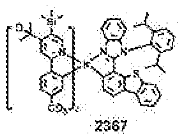
2367
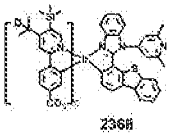
2368
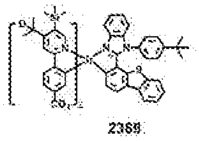
2369
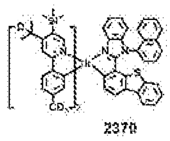
2370
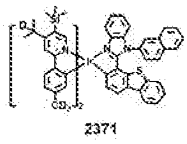
2371
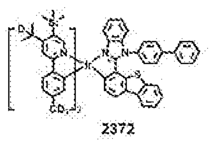
2372
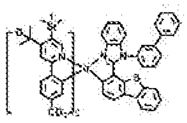
2373
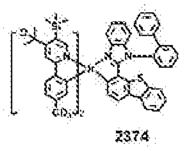
2374
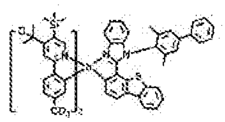
2375
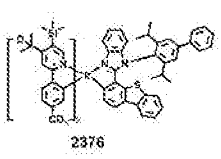
2376
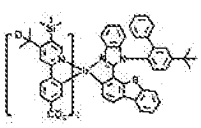
2377
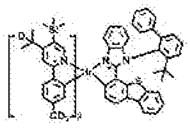
2378
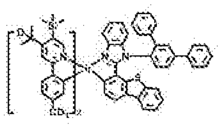
2379
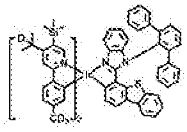
2380
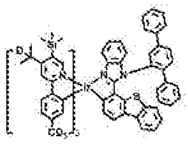
2381
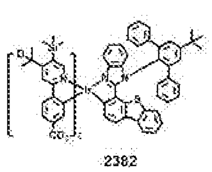
2382
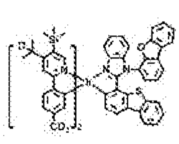
2383
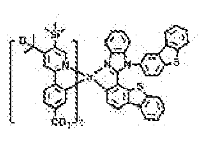
2384
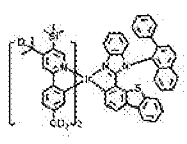
2385
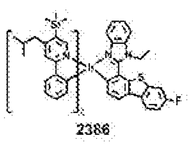
2386
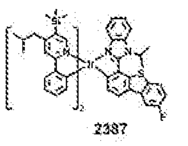
2387
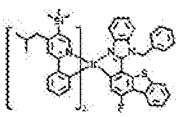
2388
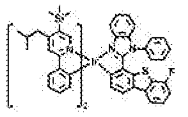
2389
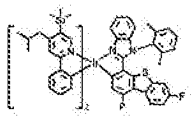
2390
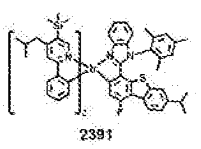
2391
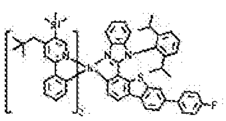
2392
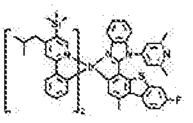
2393
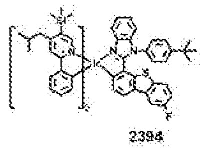
2394
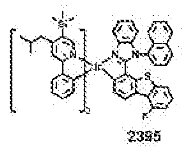
2395
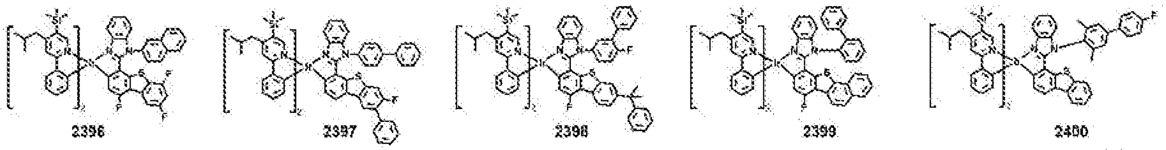
2396 2397 2398 2399 2400
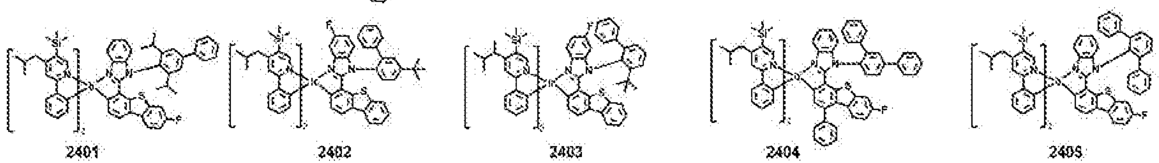
2401 2402 2403 2404 2405
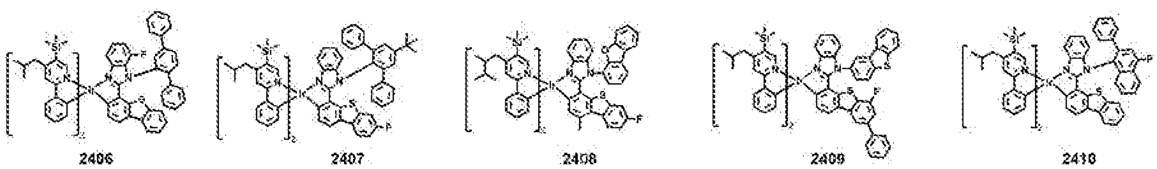
2406 2407 2408 2409 2410

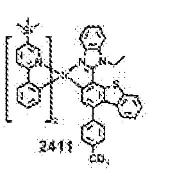
2411

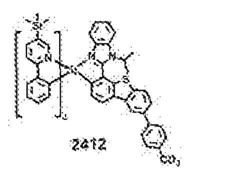
2412

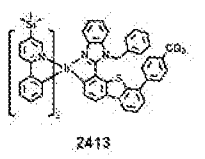
2413

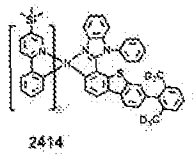
2414

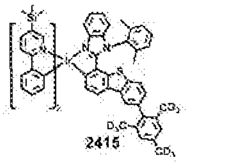
2415

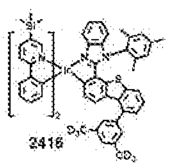
2416

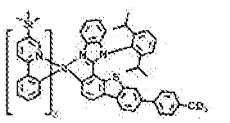
2417

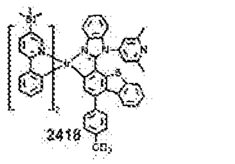
2418

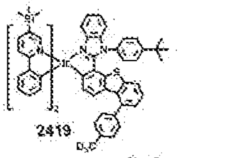
2419

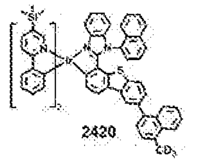
2420

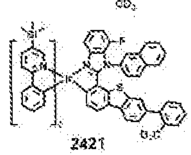
2421

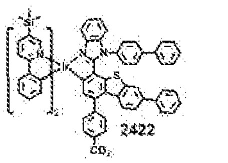
2422

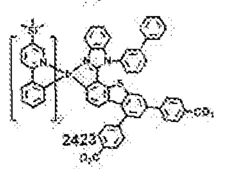
2423

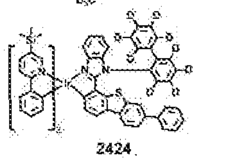
2424

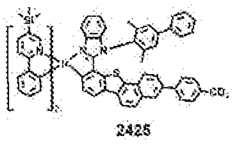
2425

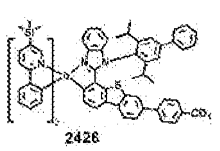
2426

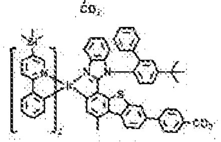
2427

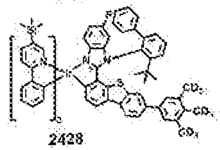
2428

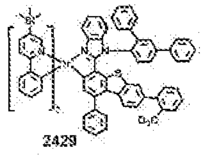
2429

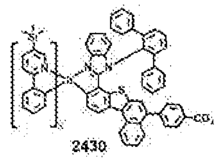
2430

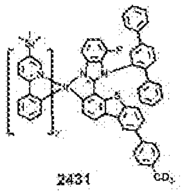
2431

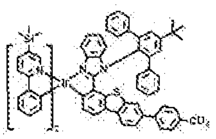
2432

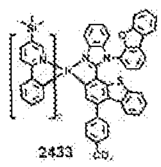
2433

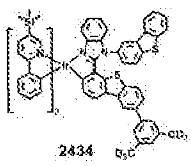
2434

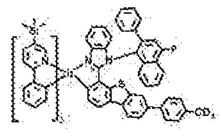
2435

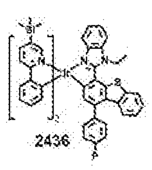
2436

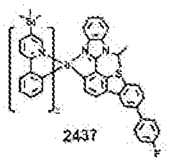
2437

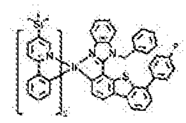
2438

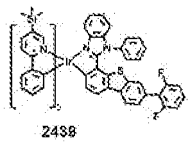
2439

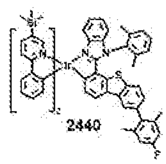
2440

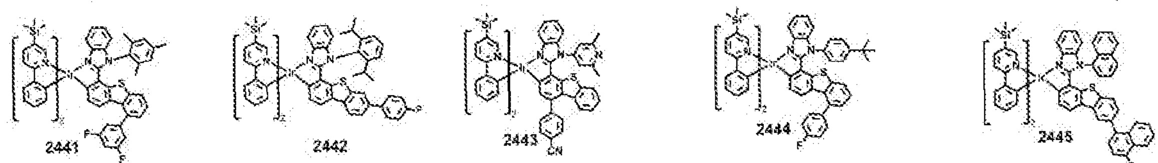
2441 2442 2443 2444 2445

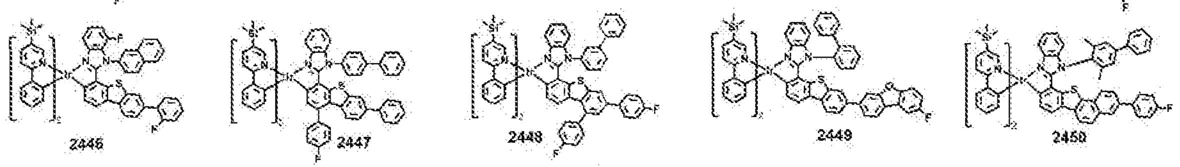
2446 2447 2448 2449 2450

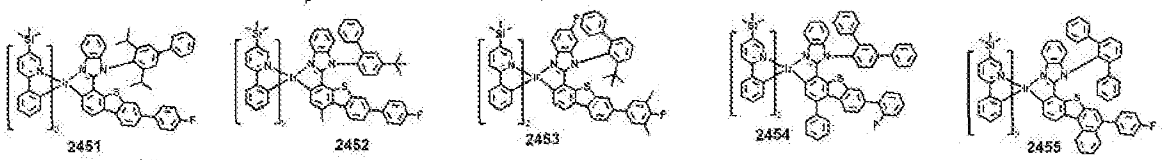
2451 2452 2453 2454 2455

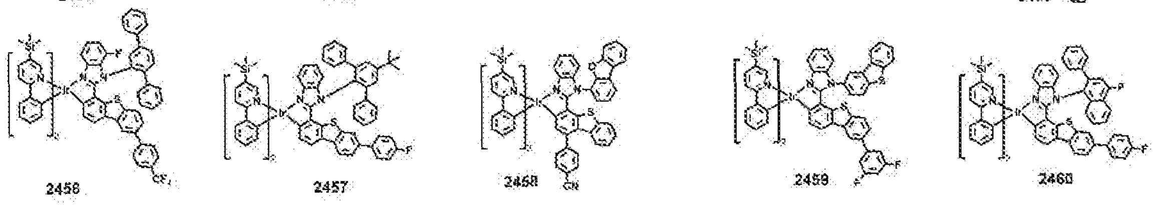
2456 2457 2458 2459 2460

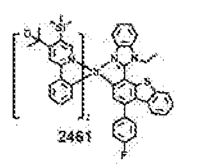
2461

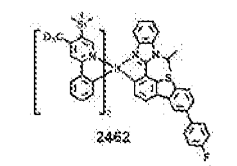
2462

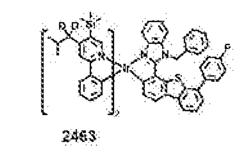
2463

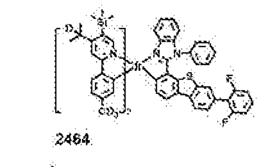
2464

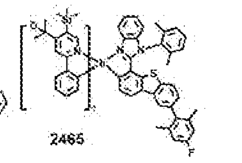
2465

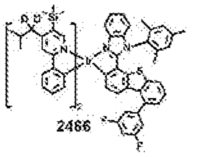
2466

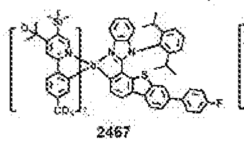
2467

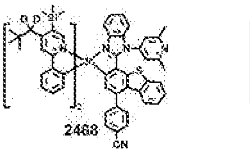
2468

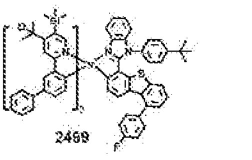
2469

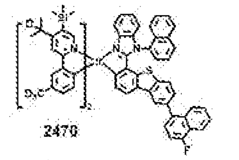
2470

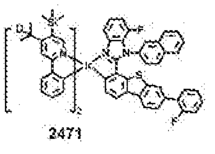
2471

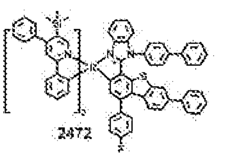
2472

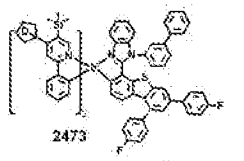
2473

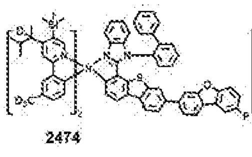
2474

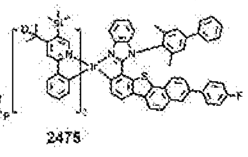
2475

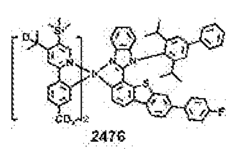
2476

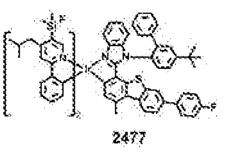
2477

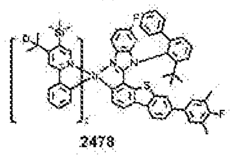
2478

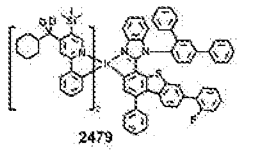
2479

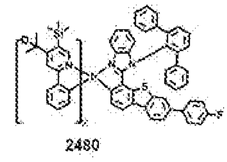
2480

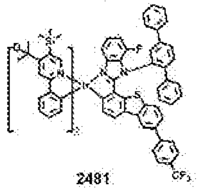
2481

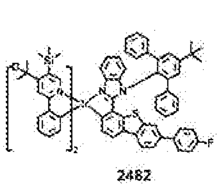
2482

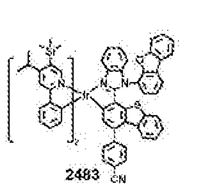
2483

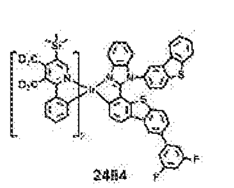
2484

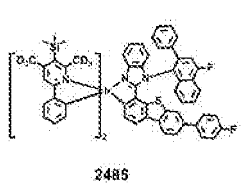
2485

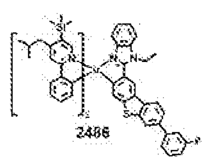
2486

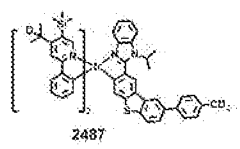
2487

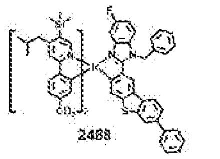
2488

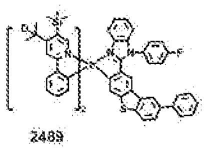
2489

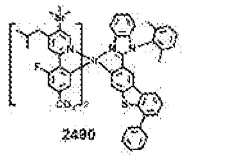
2490

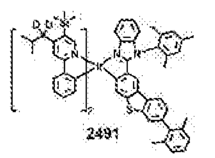
2491

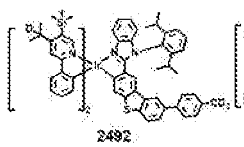
2492

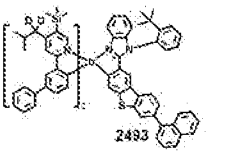
2493

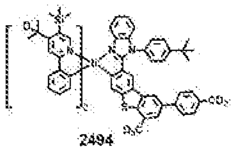
2494

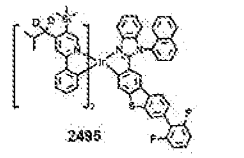
2495

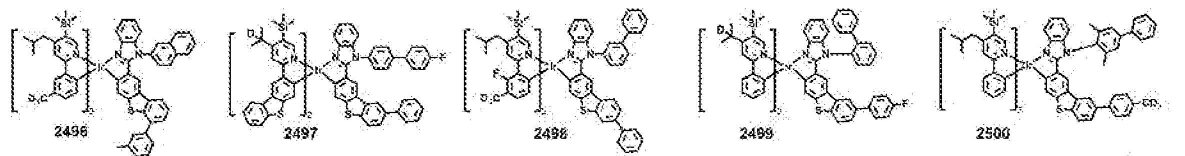
2496 2497 2498 2499 2500

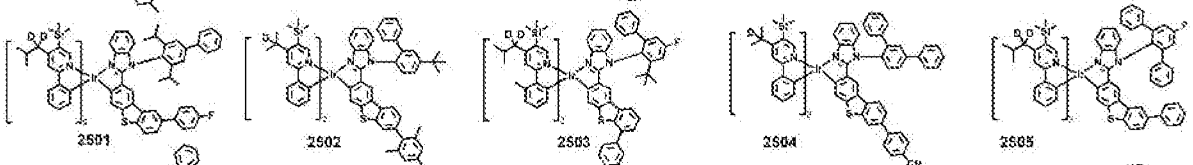
2501 2502 2503 2504 2505

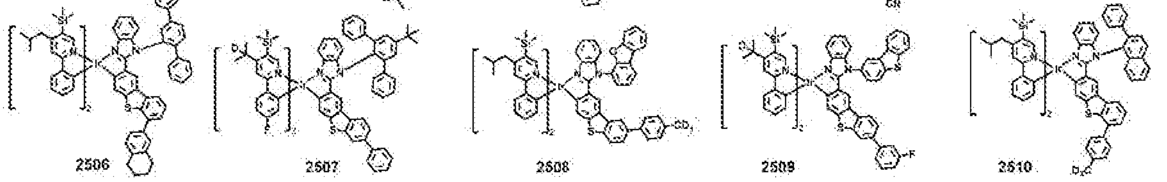
2506 2507 2508 2509 2510

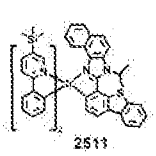
2511
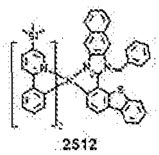
2512
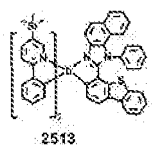
2513
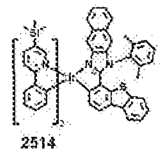
2514
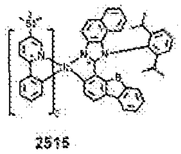
2515

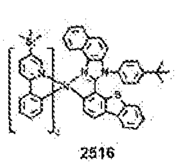
2516
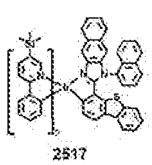
2517
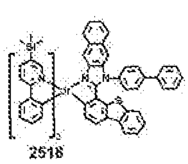
2518
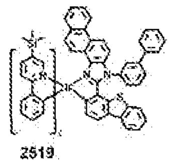
2519
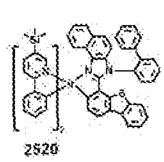
2520

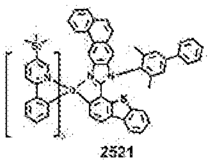
2521
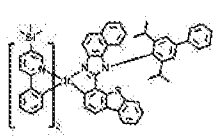
2522
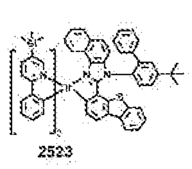
2523
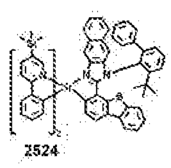
2524
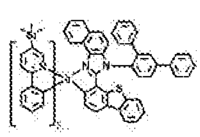
2525

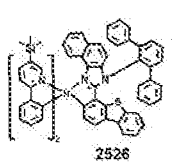
2526
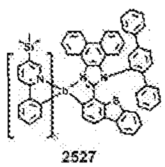
2527
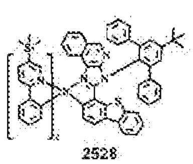
2528
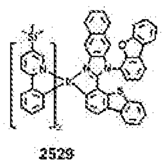
2529
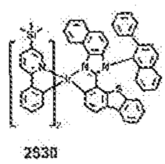
2530

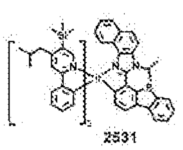
2531
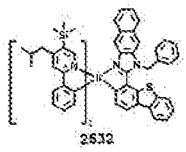
2532
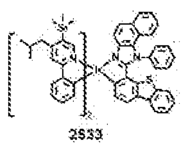
2533
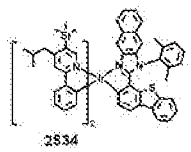
2534
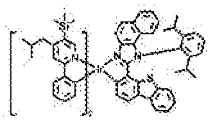
2535

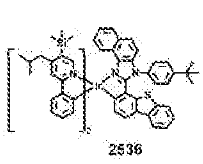
2536
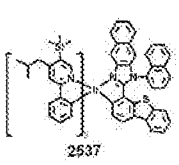
2537
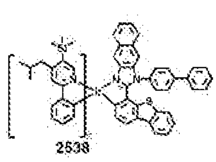
2538
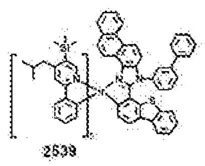
2539
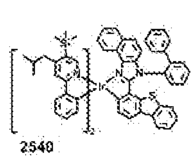
2540

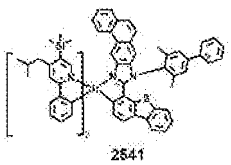
2541
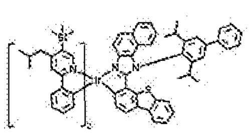
2542
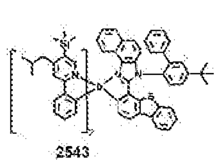
2543
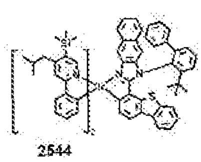
2544
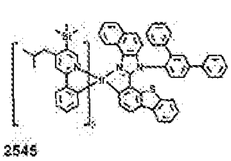
2545

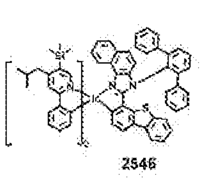
2546
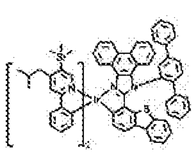
2547
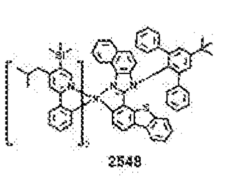
2548
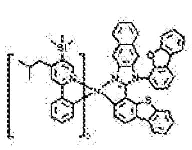
2549
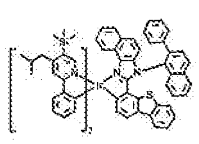
2550

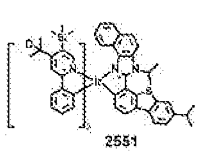
2551
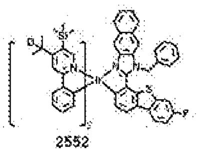
2552
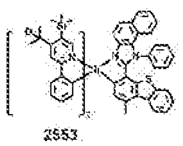
2553
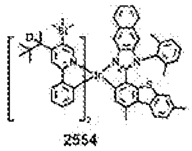
2554
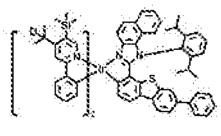
2555

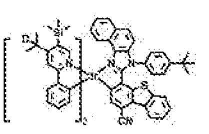
2556
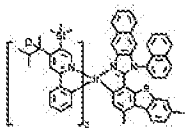
2557
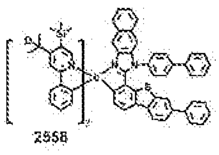
2558
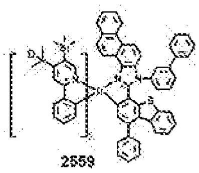
2559
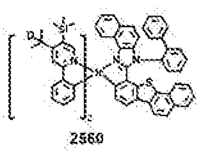
2560

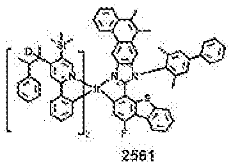
2561
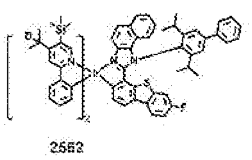
2562
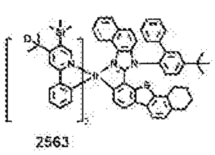
2563
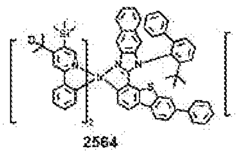
2564
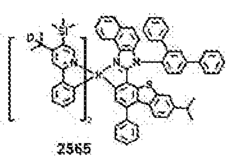
2565

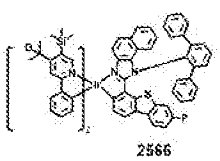
2566
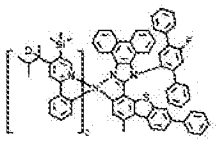
2567
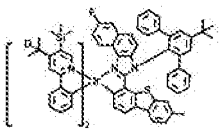
2568
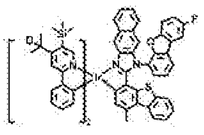
2569
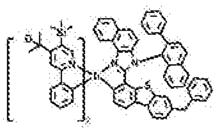
2570

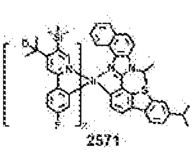
2571
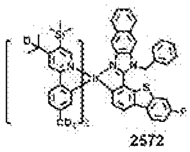
2572
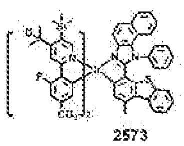
2573
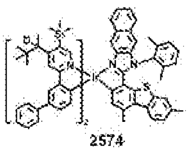
2574
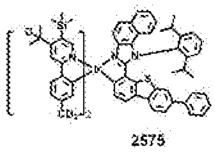
2575

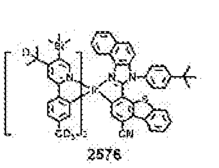
2576
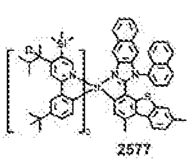
2577
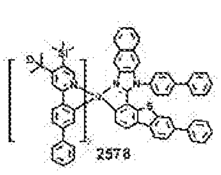
2578
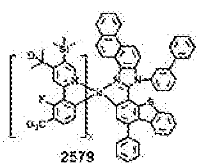
2579
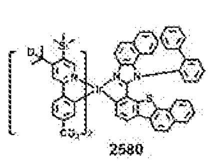
2580

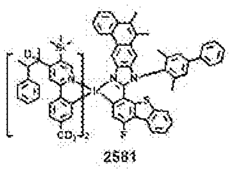
2581
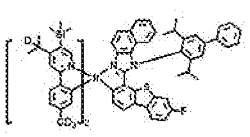
2582
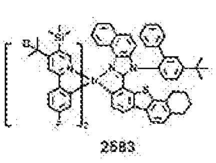
2583
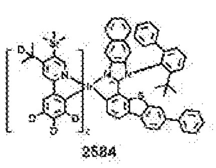
2584
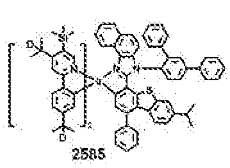
2585

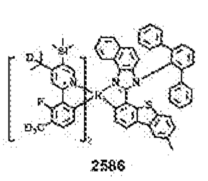
2586
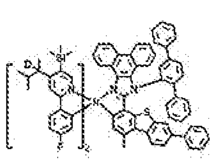
2587
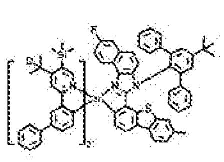
2588
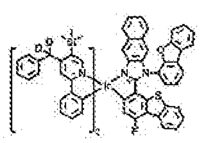
2589
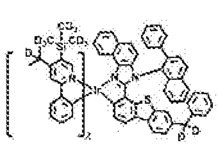
2590

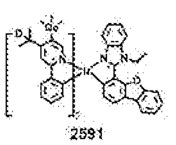
2591

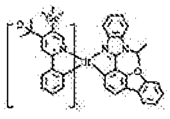
2592

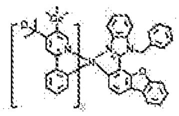
2593

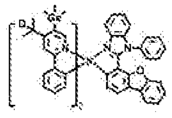
2594

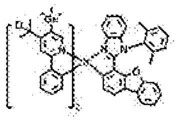
2595

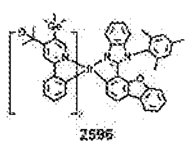
2596

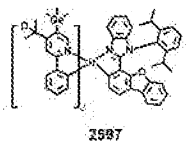
2597

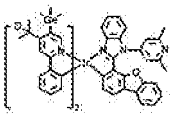
2598

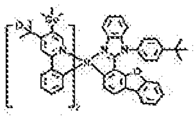
2599

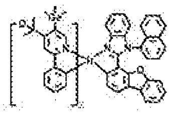
2600

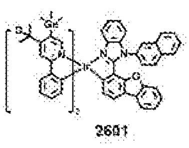
2601

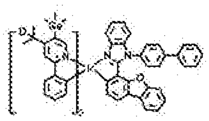
2602

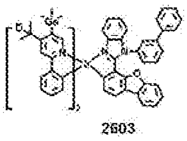
2603

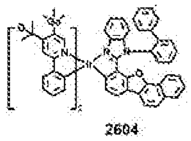
2604

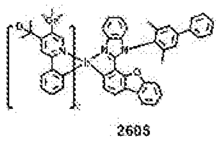
2605

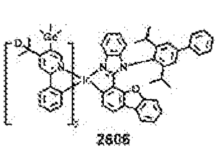
2606

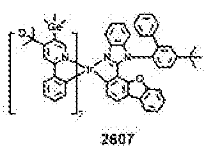
2607

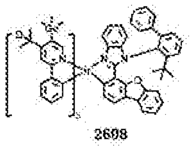
2608

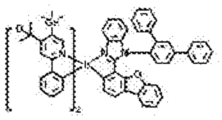
2609

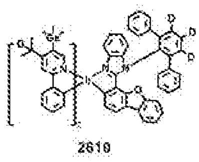
2610

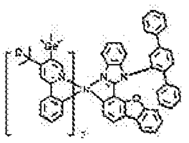
2611

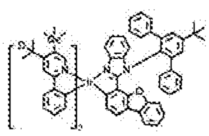
2612

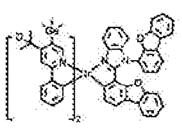
2613

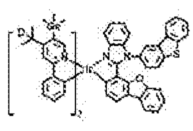
2614

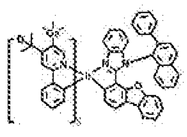
2615

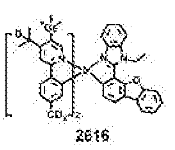
2616

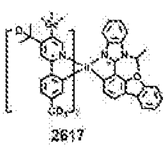
2617

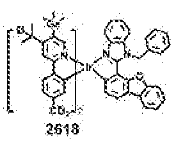
2618

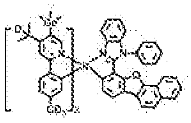
2619

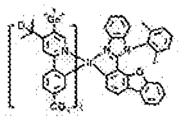
2620

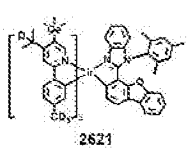
2621

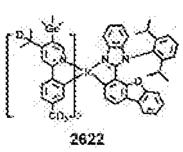
2622

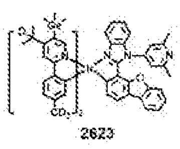
2623

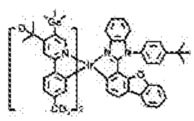
2624

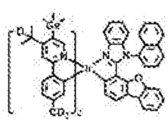
2625

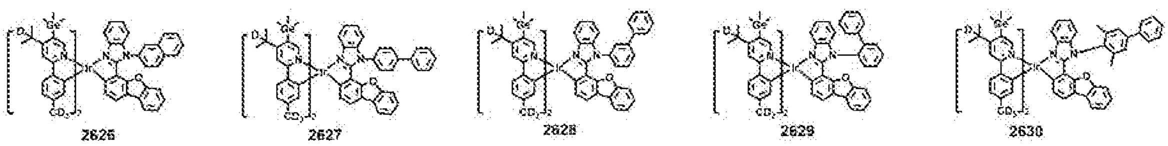
2626 2627 2628 2629 2630

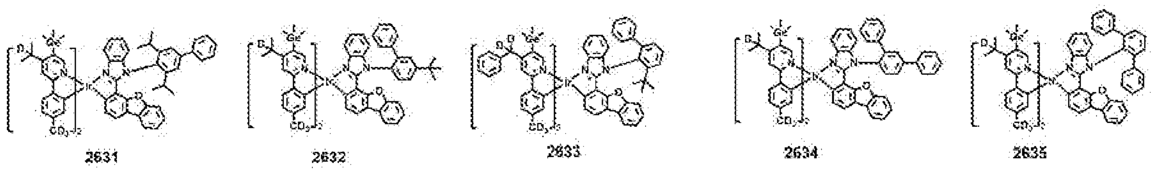
2631 2632 2633 2634 2635

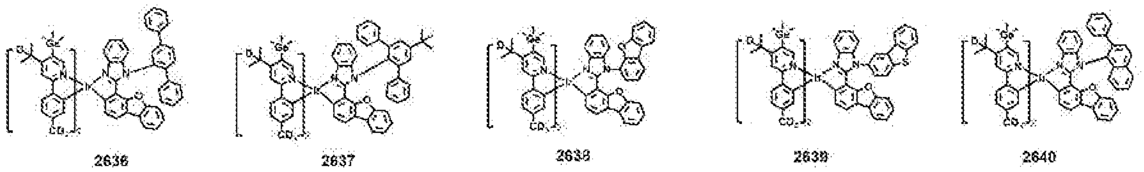
2636 2637 2638 2639 2640

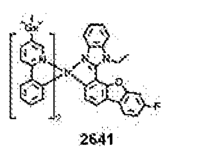
2641

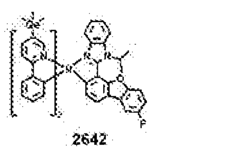
2642

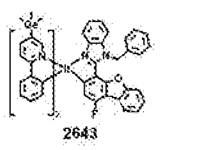
2643

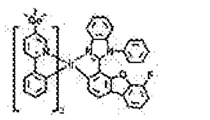
2644

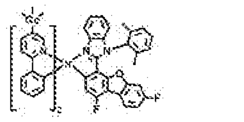
2645

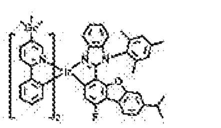
2646

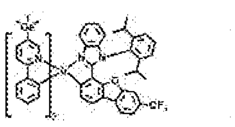
2647

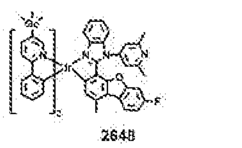
2648

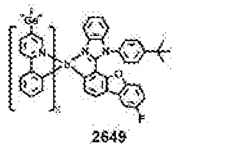
2649

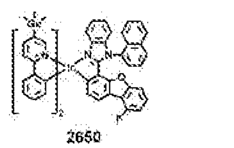
2650

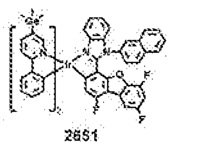
2651

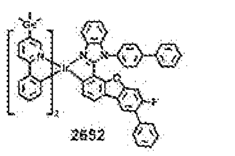
2652

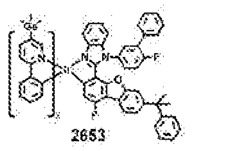
2653

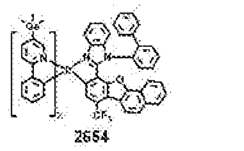
2654

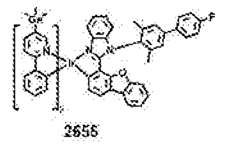
2655

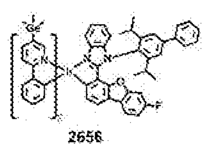
2656

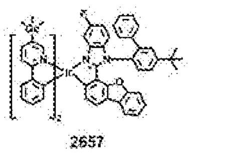
2657

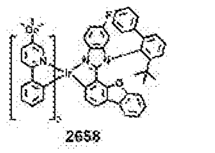
2658

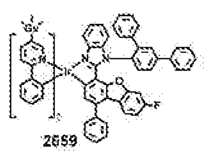
2659

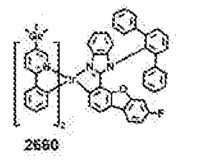
2660

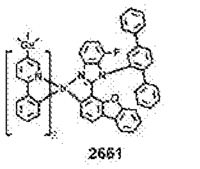
2661

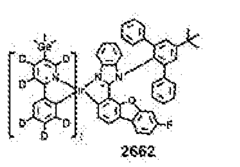
2662

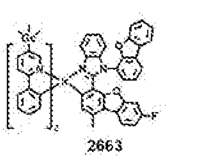
2663

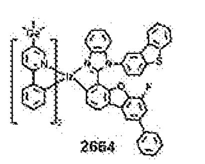
2664

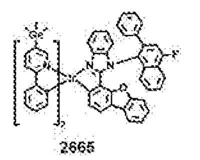
2665

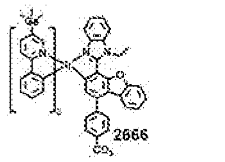
2666

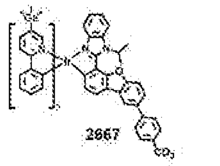
2667

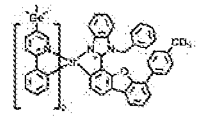
2668

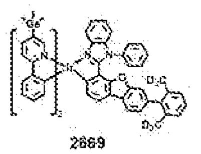
2669

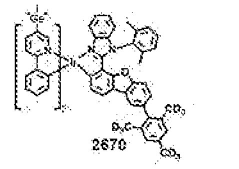
2670

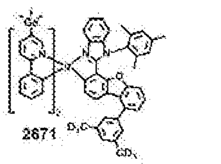
2671

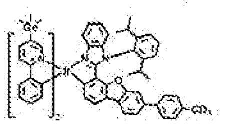
2672

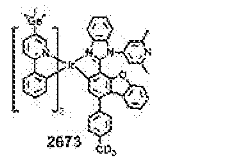
2673

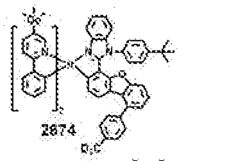
2674

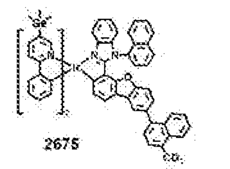
2675

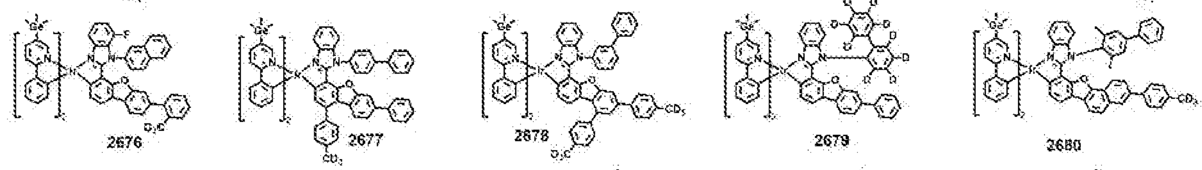
2676 2677 2678 2679 2680

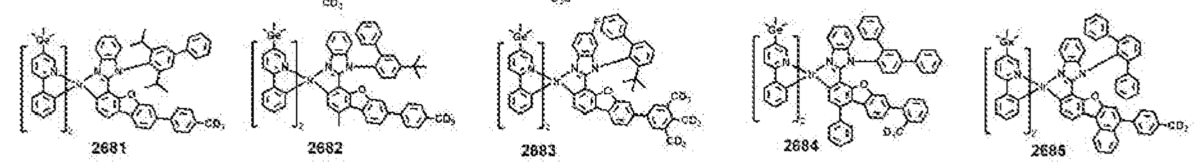
2681 2682 2683 2684 2685

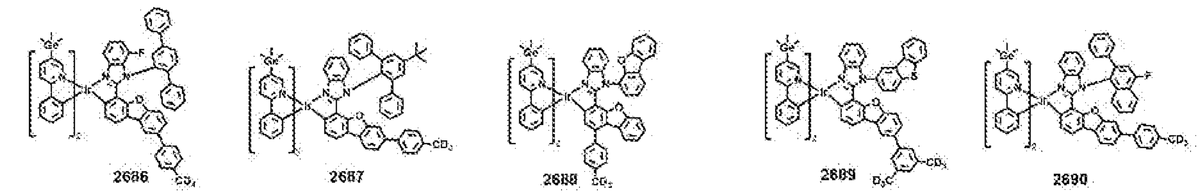
2686 2687 2688 2689 2690

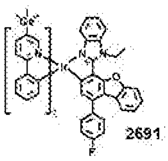
2691
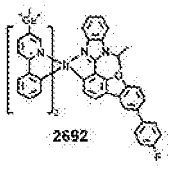
2692
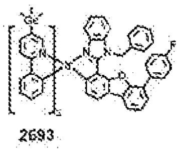
2693
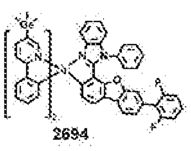
2694
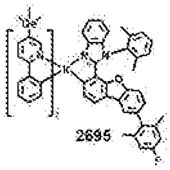
2695
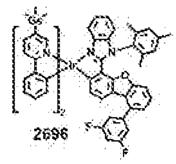
2696
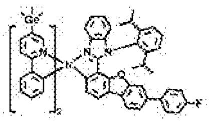
2697
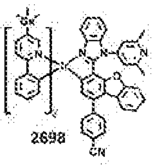
2698
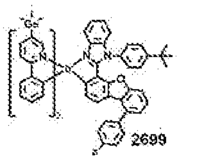
2699
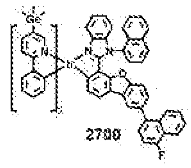
2700
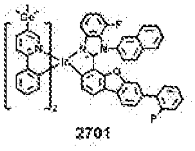
2701
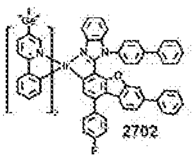
2702
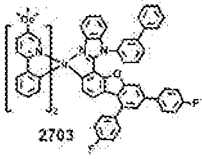
2703
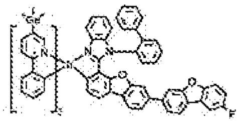
2704
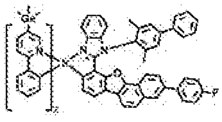
2705
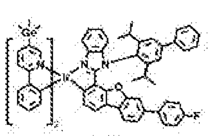
2706
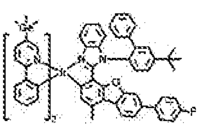
2707
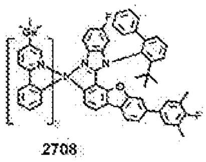
2708
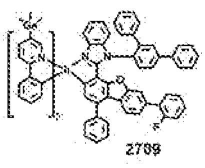
2709
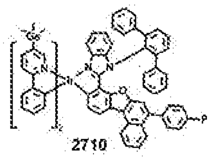
2710
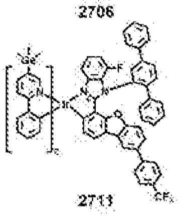
2711
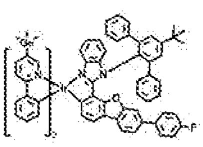
2712
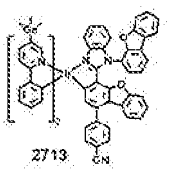
2713
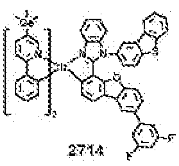
2714
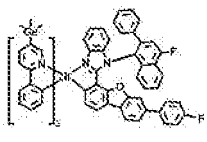
2715
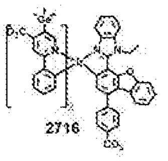
2716
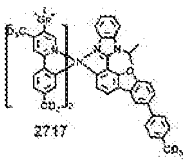
2717
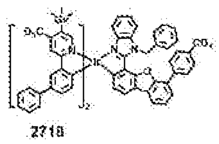
2718
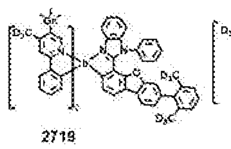
2719
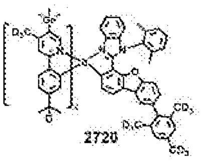
2720
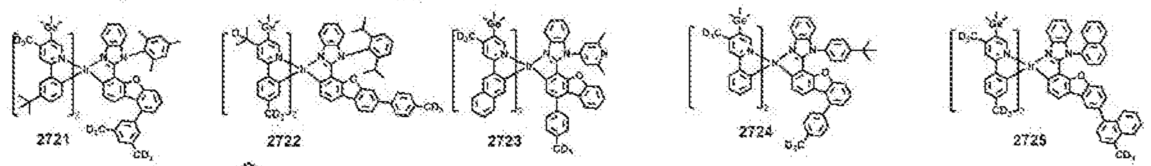
2721 2722 2723 2724 2725
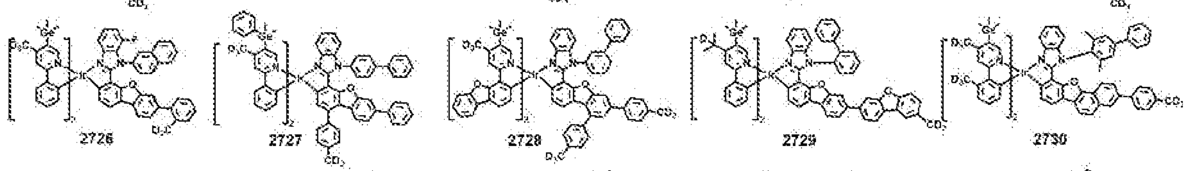
2726 2727 2728 2729 2730
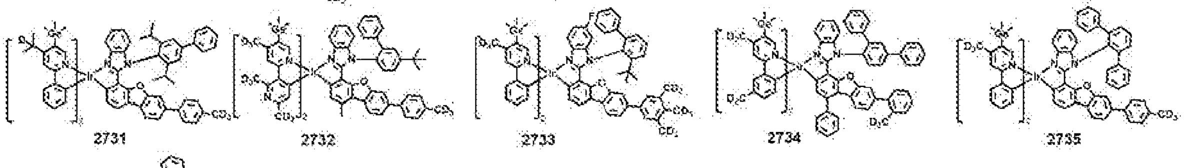
2731 2732 2733 2734 2735
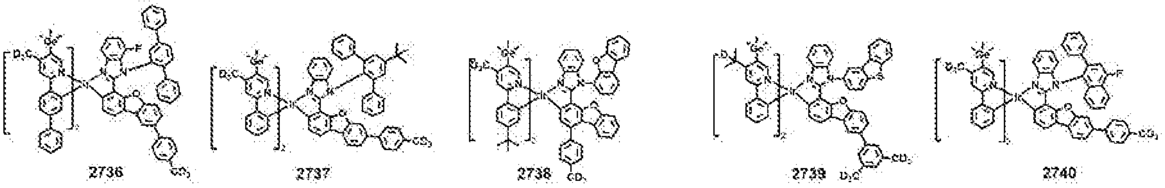
2736 2737 2738 2739 2740

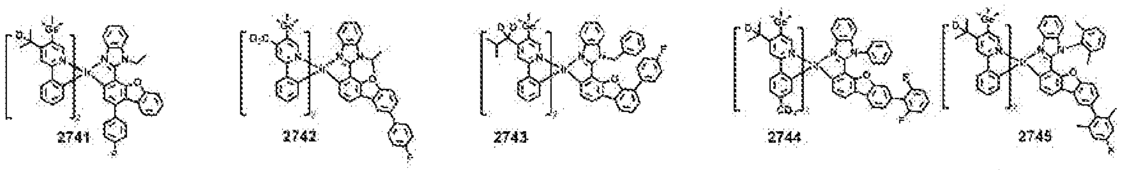
2741 2742 2743 2744 2745

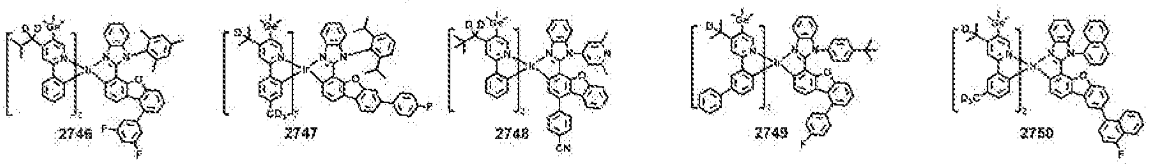
2746 2747 2748 2749 2750

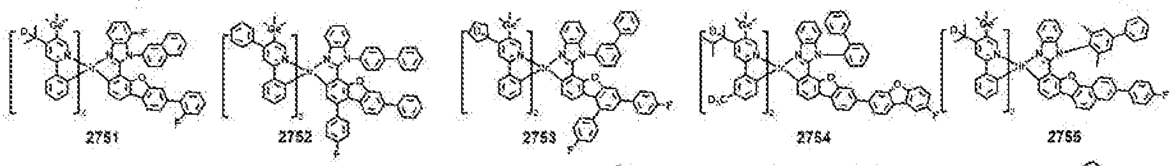
2751 2752 2753 2754 2755

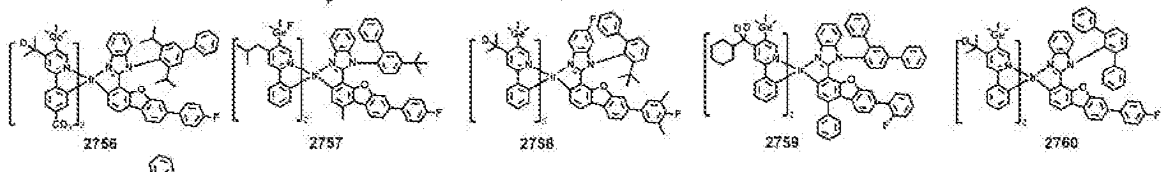
2756 2757 2758 2759 2760

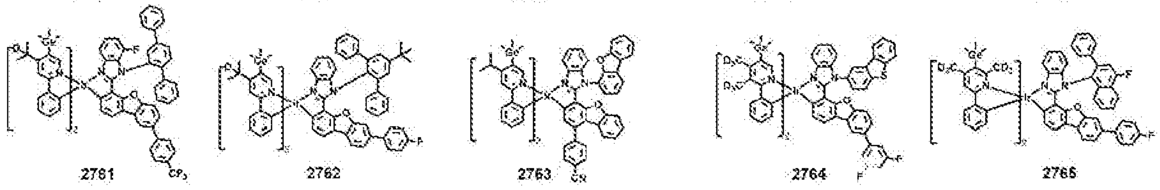
2761 2762 2763 2764 2765

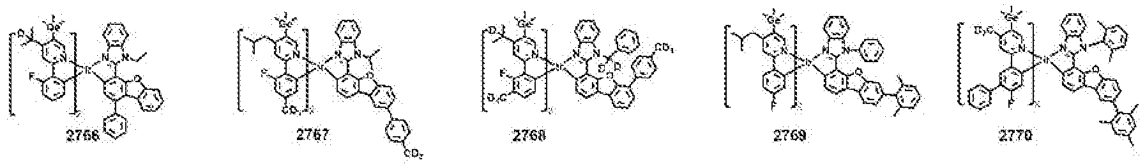
2766 2767 2768 2769 2770

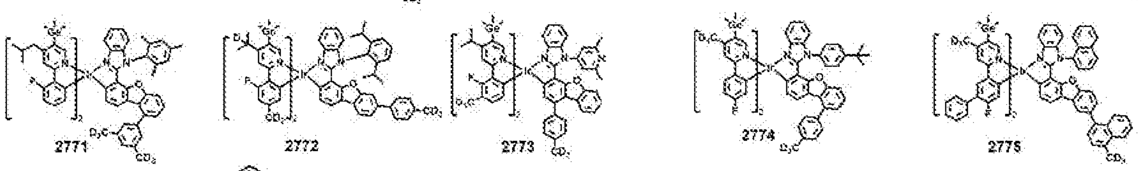
2771 2772 2773 2774 2775

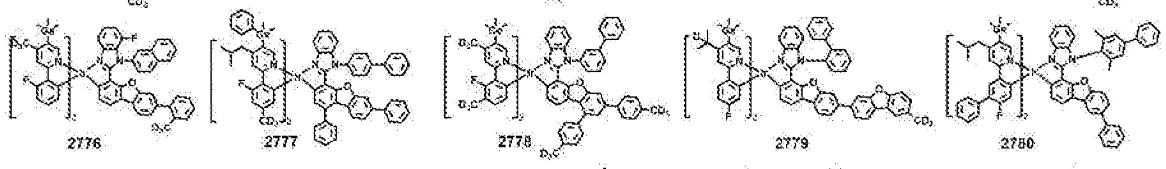
2776 2777 2778 2779 2780

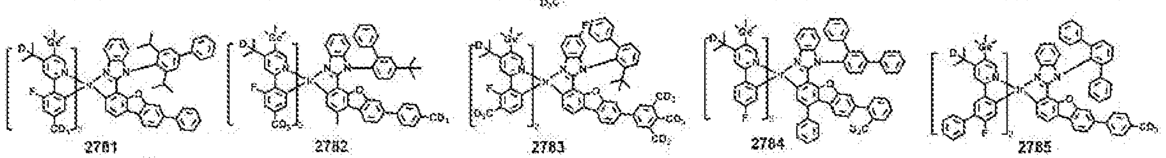
2781 2782 2783 2784 2785

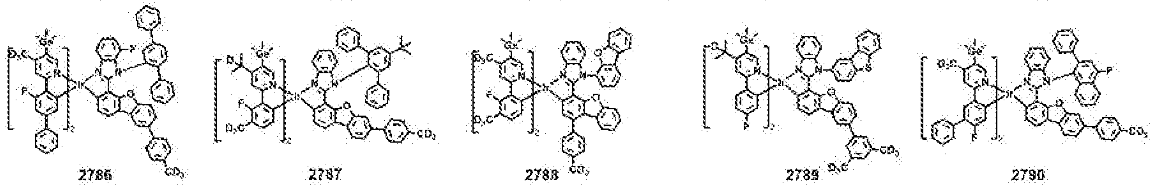
2786 2787 2788 2789 2790

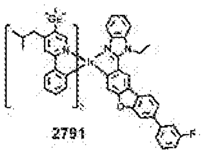
2791
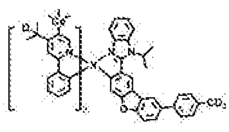
2792
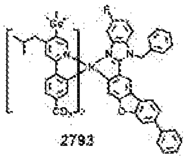
2793
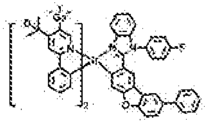
2794
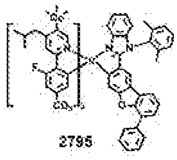
2795
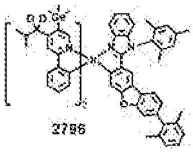
2796
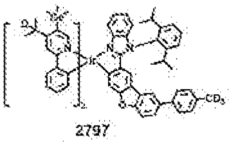
2797
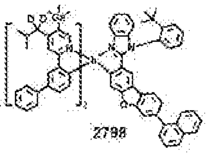
2798
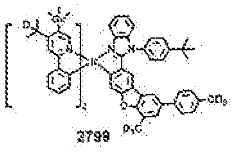
2799
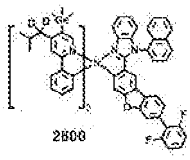
2800
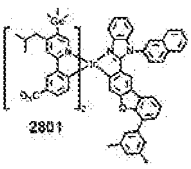
2801
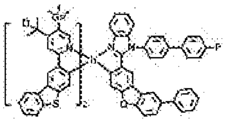
2802
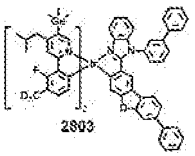
2803
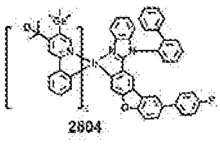
2804
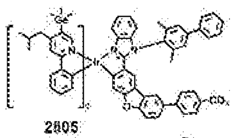
2805
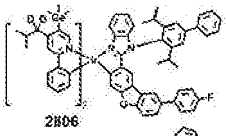
2806
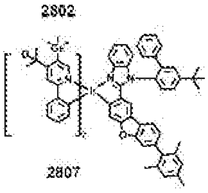
2807
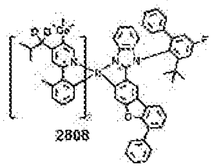
2808
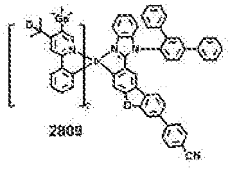
2809
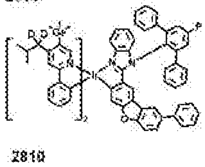
2810
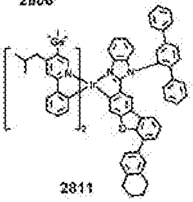
2811
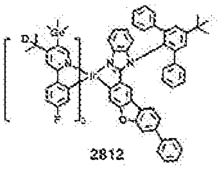
2812
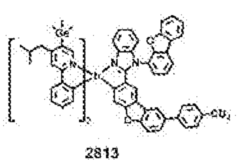
2813
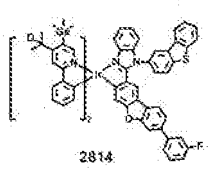
2814
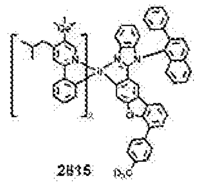
2815
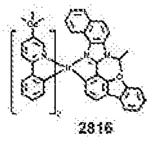
2816
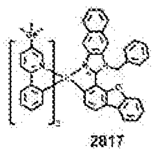
2817
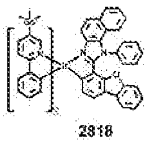
2818
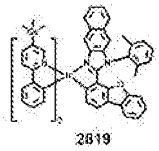
2819
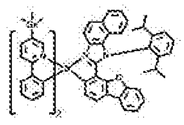
2820
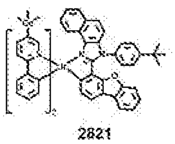
2821
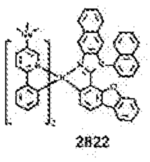
2822
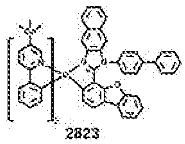
2823
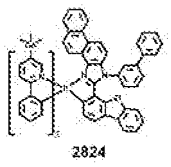
2824
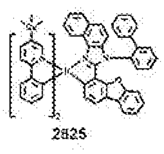
2825
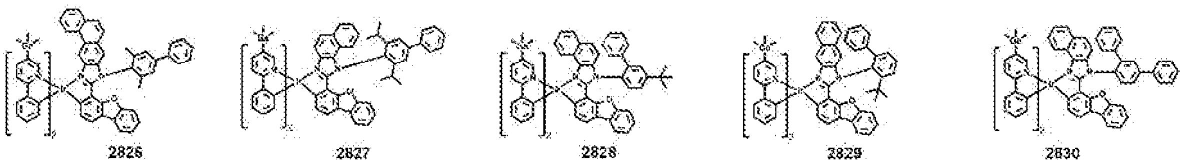
2826 2827 2828 2829 2830
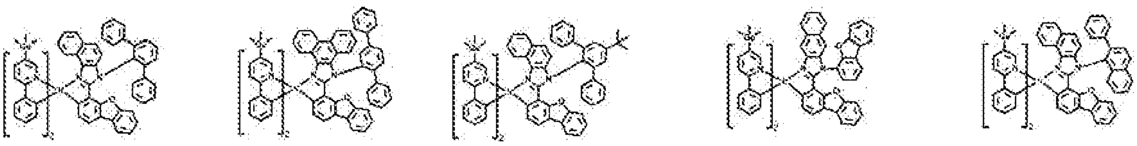
2831 2832 2833 2834 2835

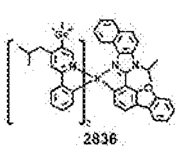
2836
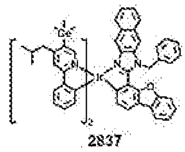
2837
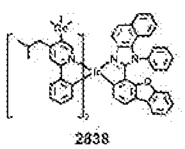
2838
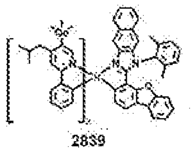
2839
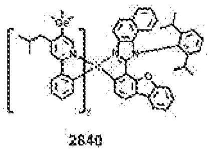
2840

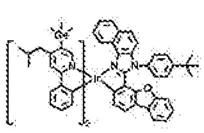
2841
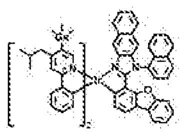
2842
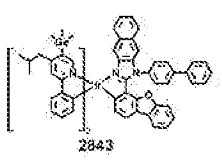
2843
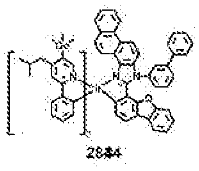
2844
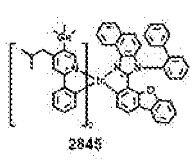
2845

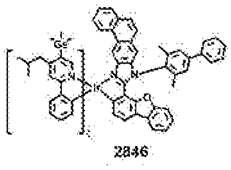
2846
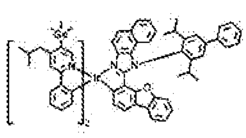
2847
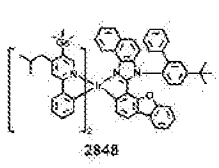
2848
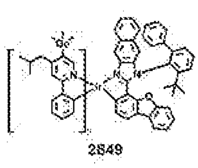
2849
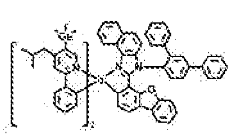
2850

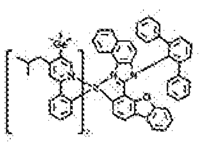
2851
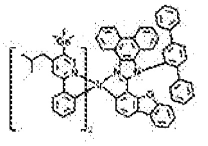
2852
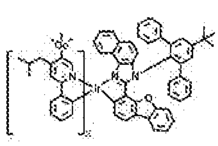
2853
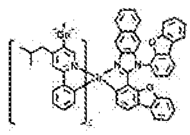
2854
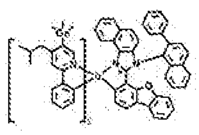
2855

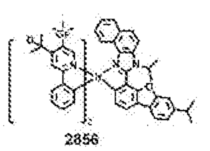
2856
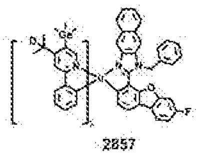
2857
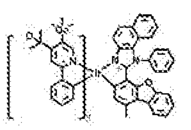
2858
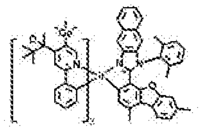
2859
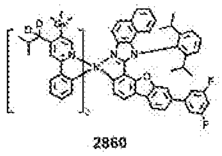
2860

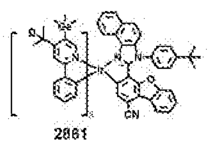
2861
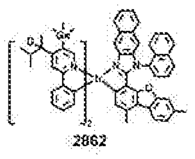
2862
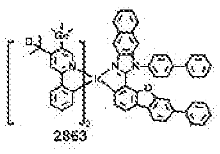
2863
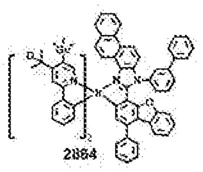
2864
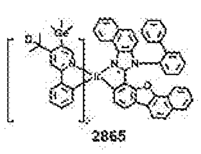
2865

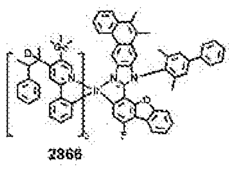
2866
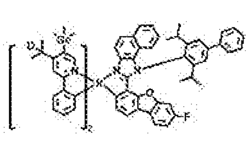
2867
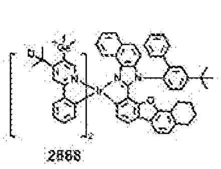
2868
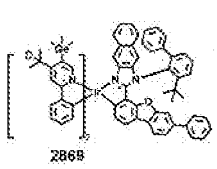
2869
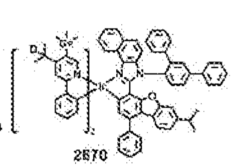
2870

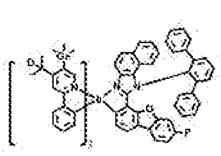
2871
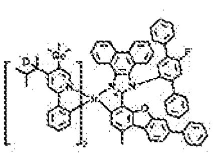
2872
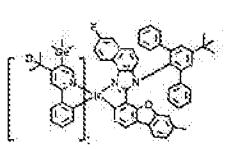
2873
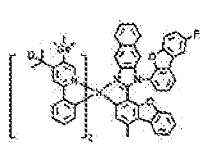
2874
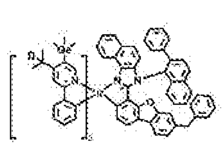
2875

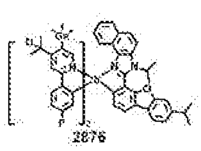
2876

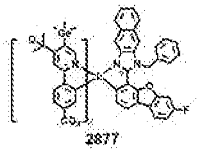
2877

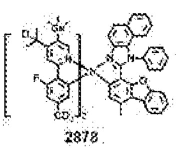
2878

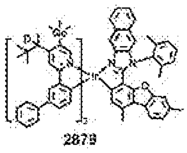
2879

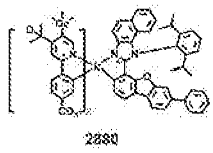
2880

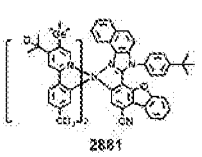
2881

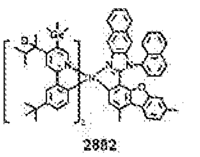
2882

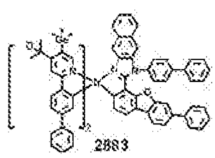
2883

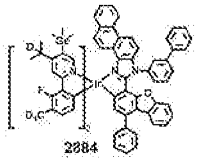
2884

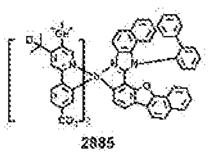
2885

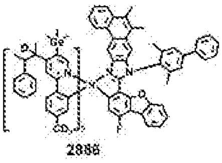
2886

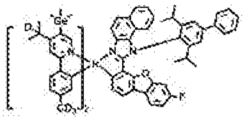
2887

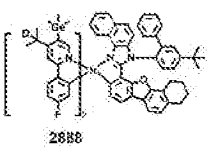
2888

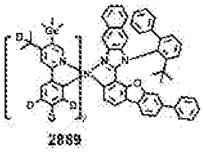
2889

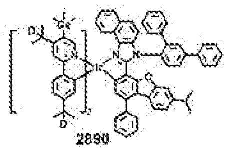
2890

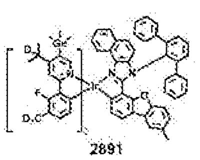
2891

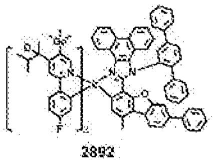
2892

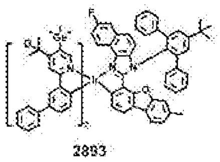
2893

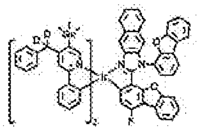
2894

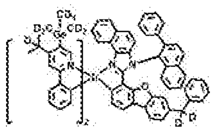
2895

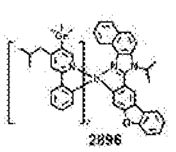
2896

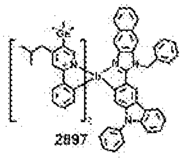
2897

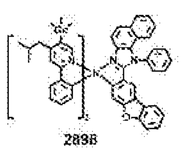
2898

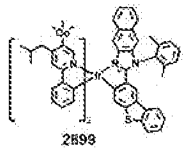
2899

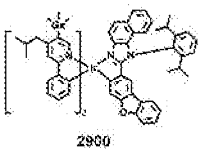
2900

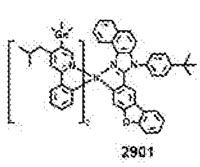
2901

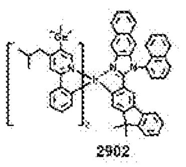
2902

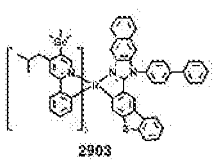
2903

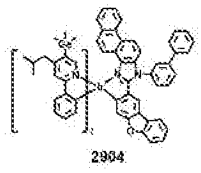
2904

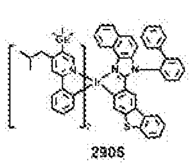
2905

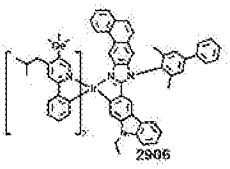
2906

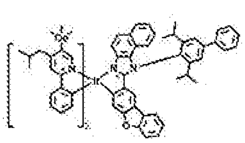
2907

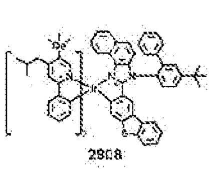
2908

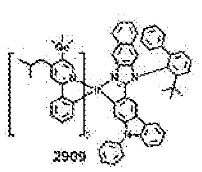
2909

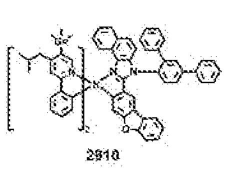
2910

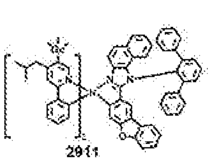
2911

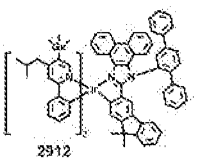
2912

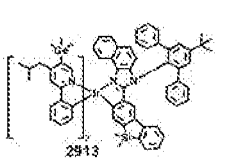
2913

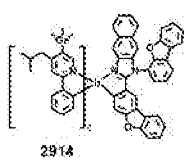
2914

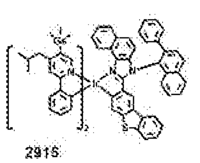
2915

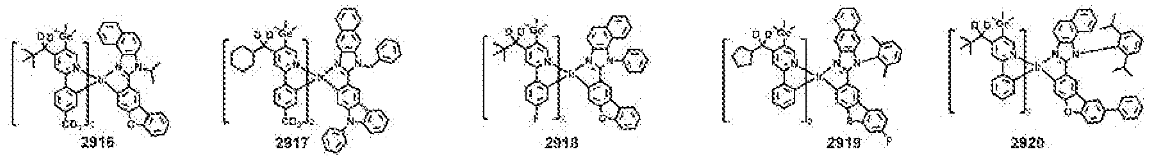

2916 2917 2918 2919 2920

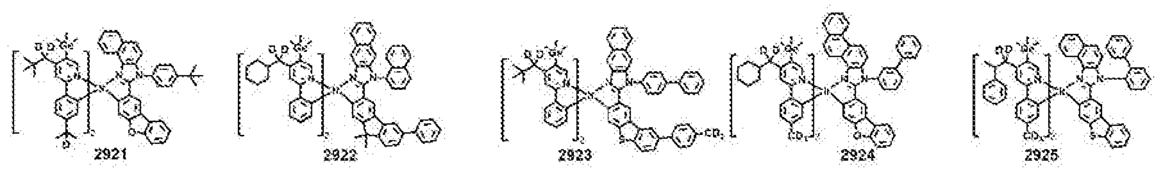

2921 2922 2923 2924 2925

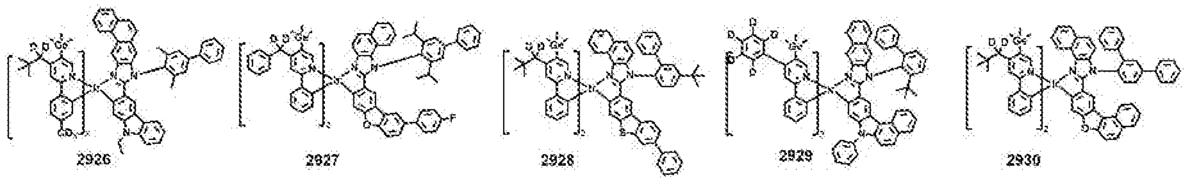

2926 2927 2928 2929 2930

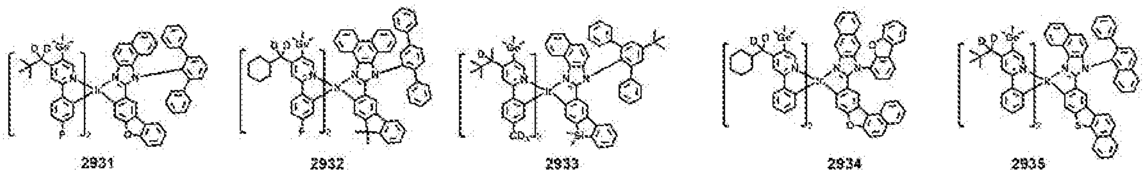

2931 2932 2933 2934 2935

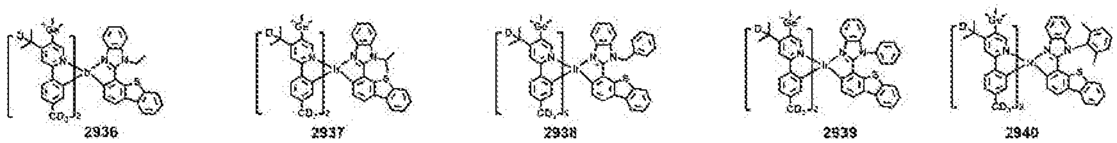

2936 2937 2938 2939 2940

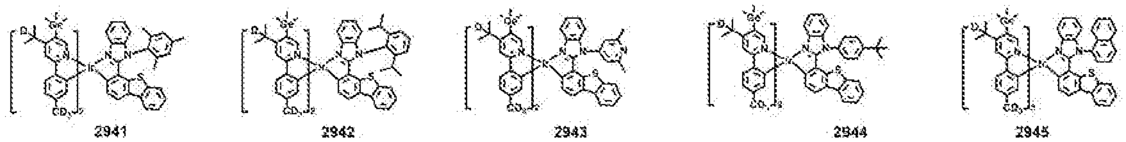

2941 2942 2943 2944 2945

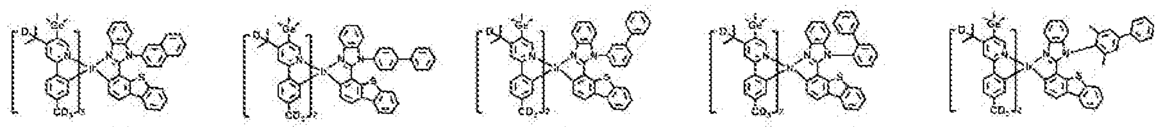

2946 2947 2948 2949 2950

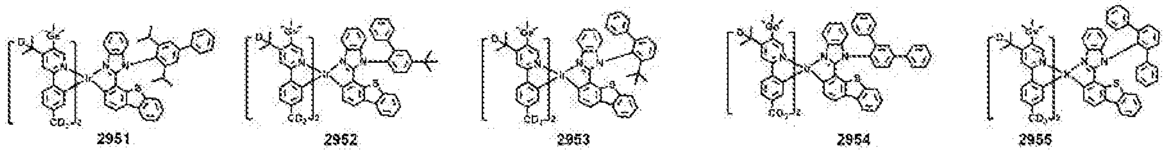

2951 2952 2953 2954 2955

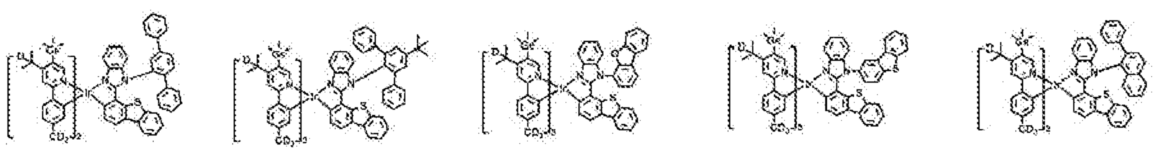

2956 2957 2958 2959 2960

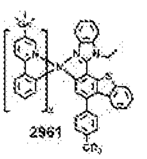
2961
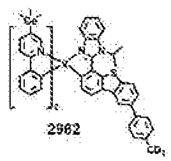
2962
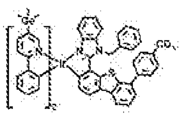
2963
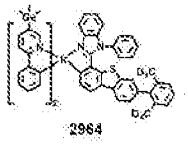
2964
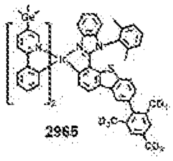
2965
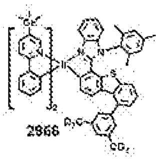
2966
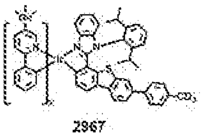
2967
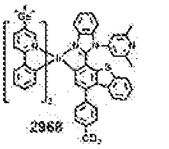
2968
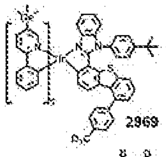
2969
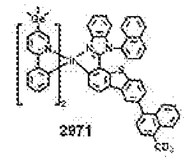
2971
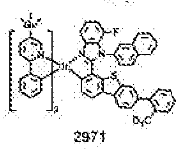
2971
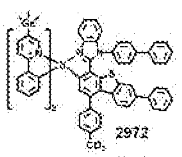
2972
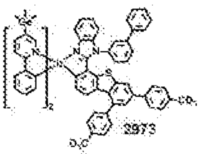
2973
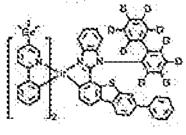
2974
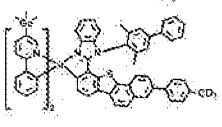
2975
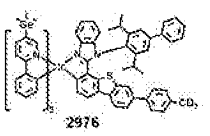
2976
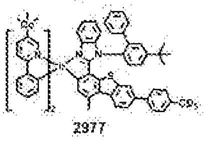
2977
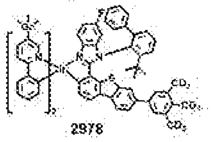
2978
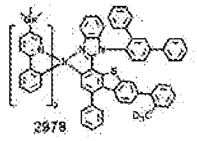
2978
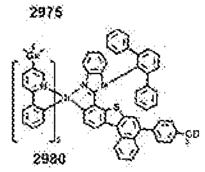
2980
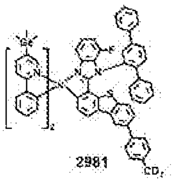
2981
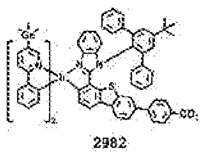
2982
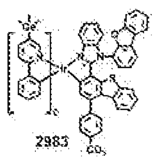
2983
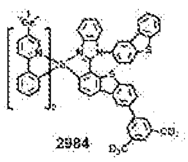
2984
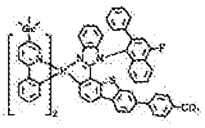
2985
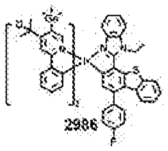
2986
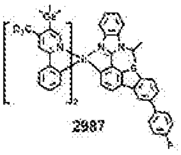
2987
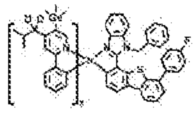
2988
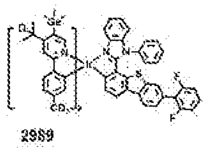
2989
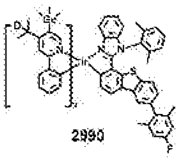
2990
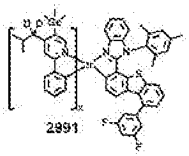
2991
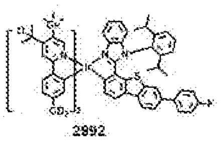
2992
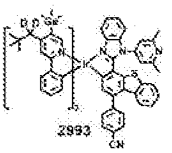
2993
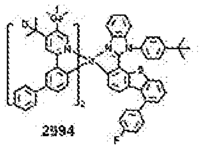
2994
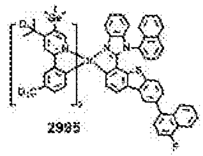
2995
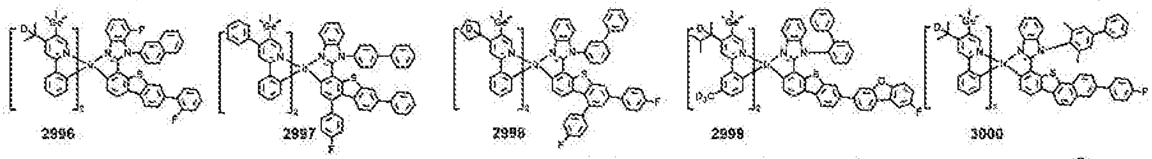
2996 2997 2998 2999 3000
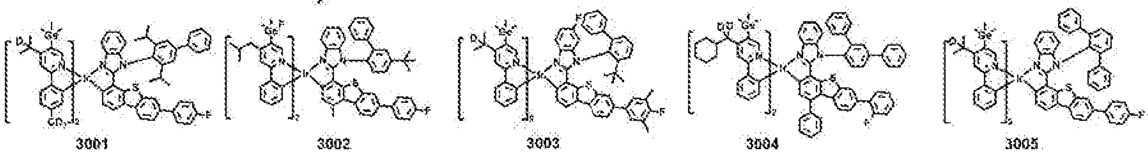
3001 3002 3003 3004 3005
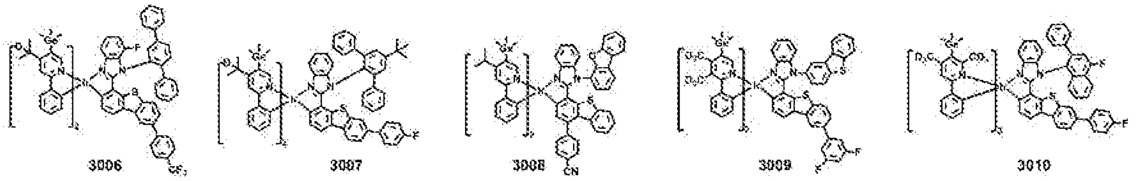
3006 3007 3008 3009 3010

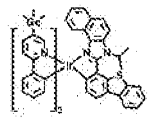
3011
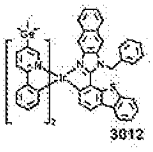
3012
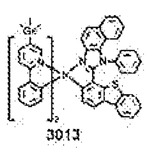
3013
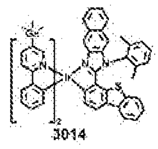
3014
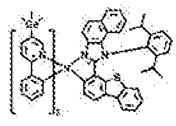
3015

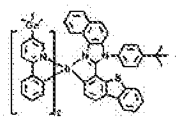
3016
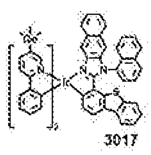
3017
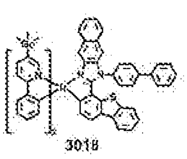
3018
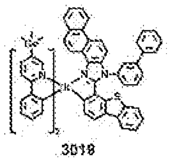
3019
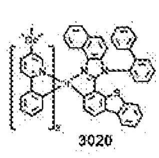
3020

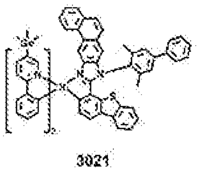
3021
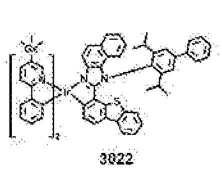
3022
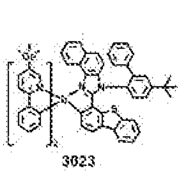
3023
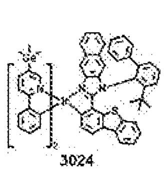
3024
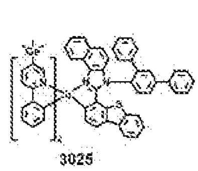
3025

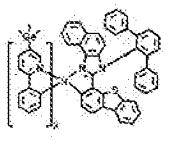
3026
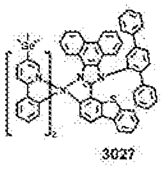
3027
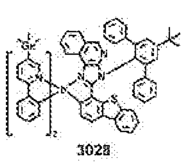
3028
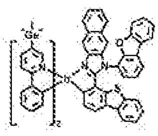
3029
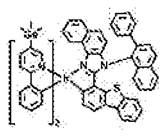
3030

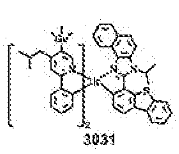
3031
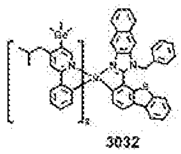
3032
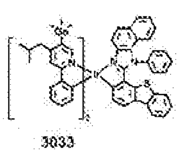
3033
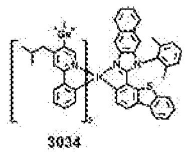
3034
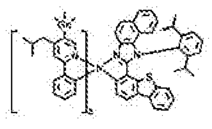
3035

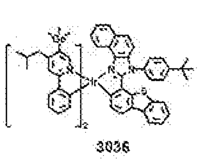
3036
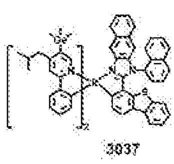
3037
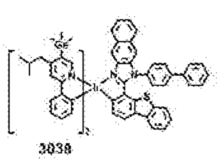
3038
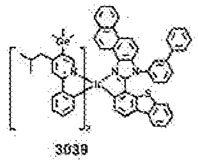
3039
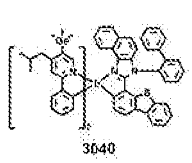
3040

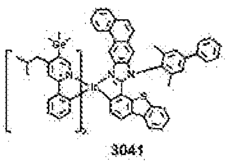
3041
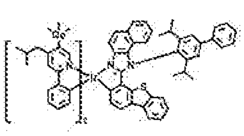
3042
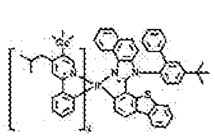
3043
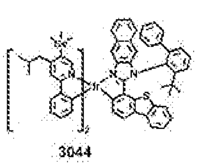
3044
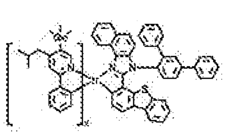
3045

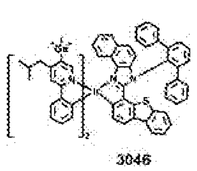
3046
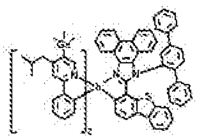
3047
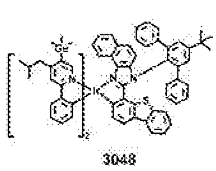
3048
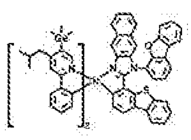
3049
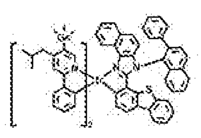
3050

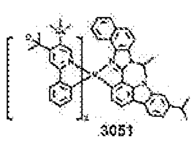
3051
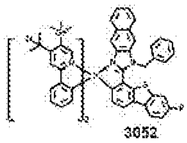
3052
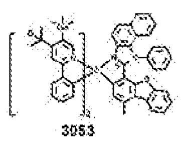
3053
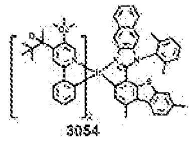
3054
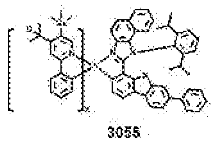
3055
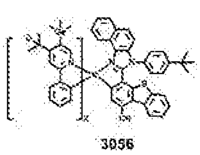
3056
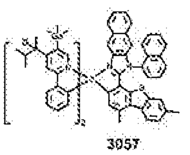
3057
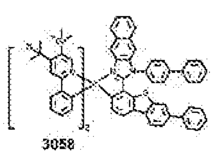
3058
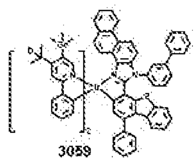
3059
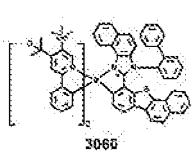
3060
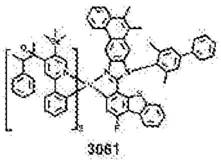
3061
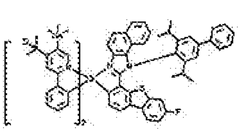
3062
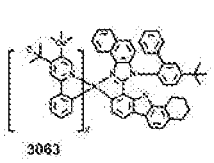
3063
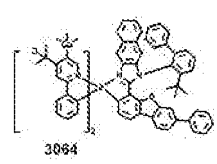
3064
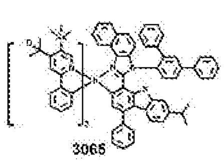
3065
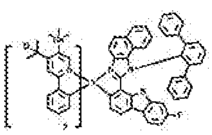
3066
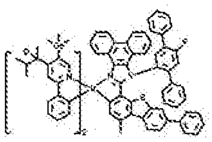
3067
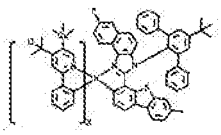
3068
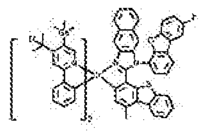
3069
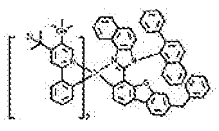
3070
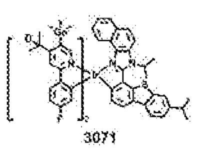
3071
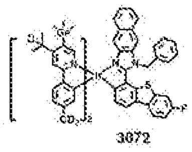
3072
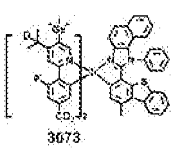
3073
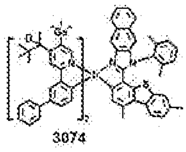
3074
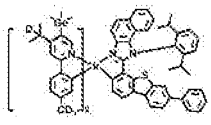
3075
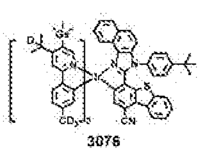
3076
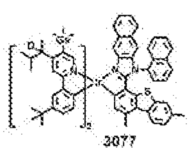
3077
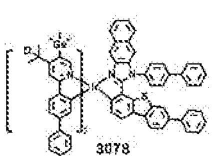
3078
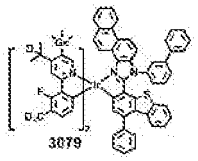
3079
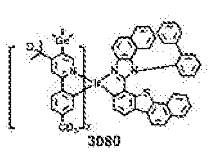
3080
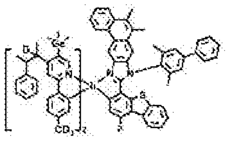
3081
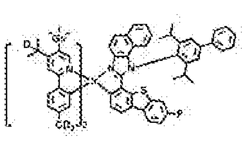
3082
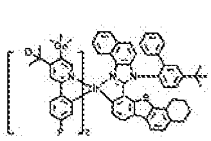
3083
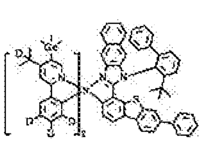
3084
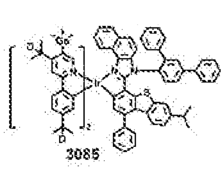
3085
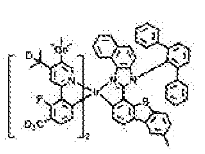
3086
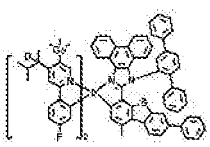
3087
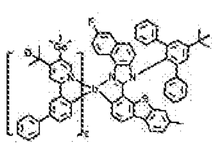
3088
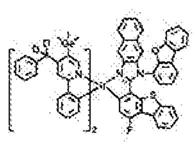
3089
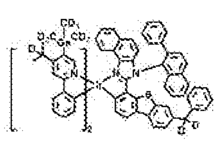
3090

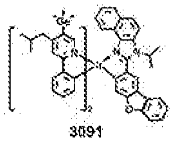
3091
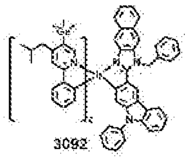
3092
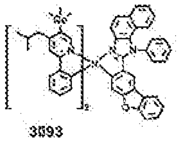
3093
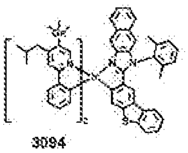
3094
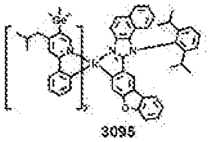
3095

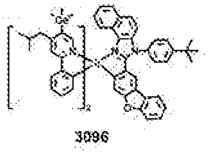
3096
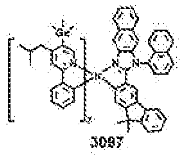
3097
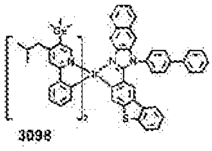
3098
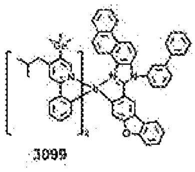
3099
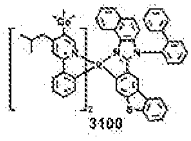
3100

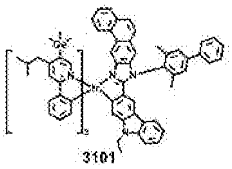
3101
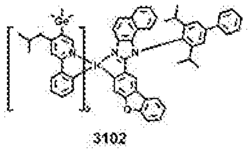
3102
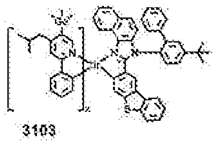
3103
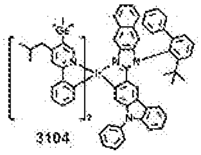
3104
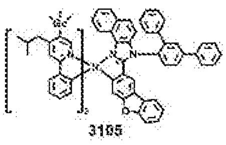
3105

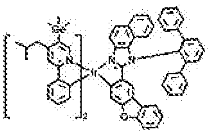
3106
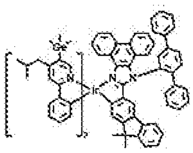
3107
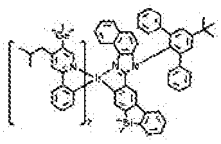
3108
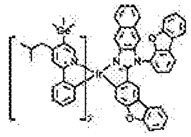
3109
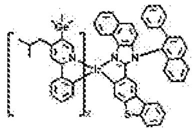
3110

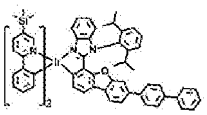
3111
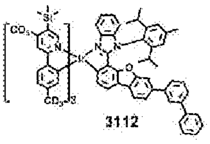
3112
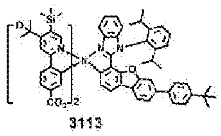
3113
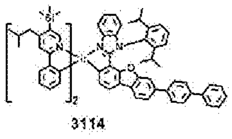
3114
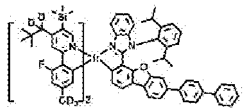
3115

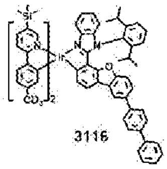
3116
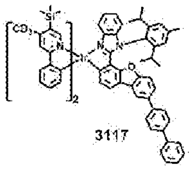
3117
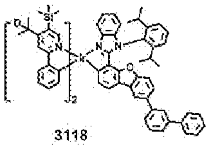
3118
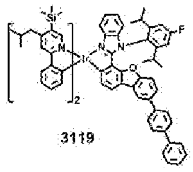
3119
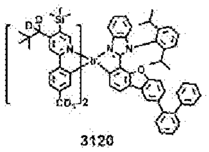
3120

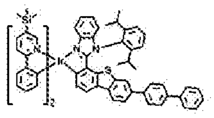
3121
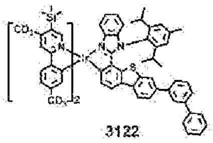
3122
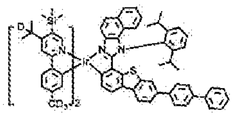
3123
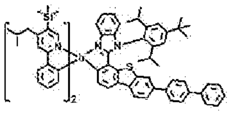
3124
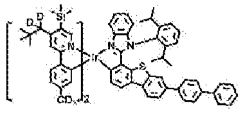
3125

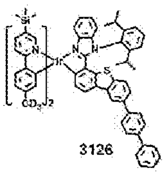
3126
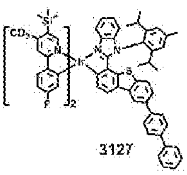
3127
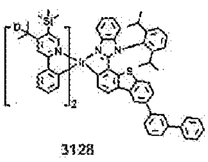
3128
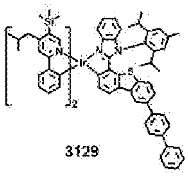
3129
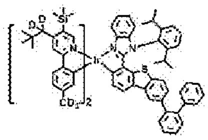
3130

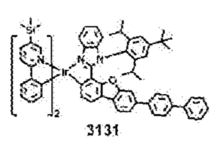
3131
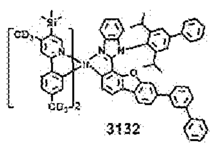
3132
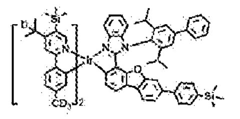
3133
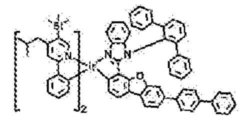
3134
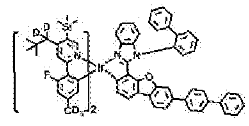
3135

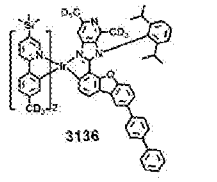
3136
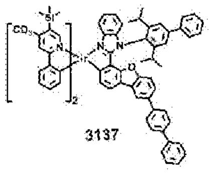
3137
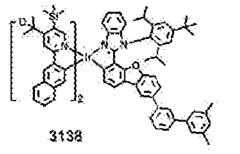
3138
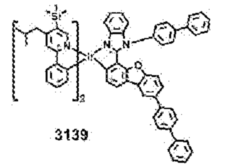
3139
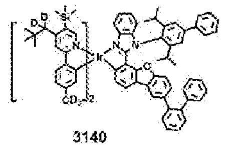
3140

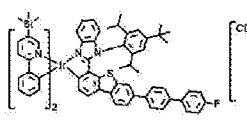
3141
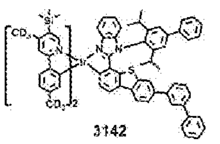
3142
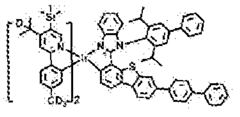
3143
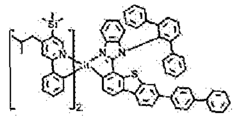
3144
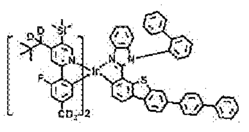
3145

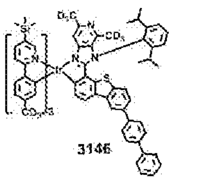
3146
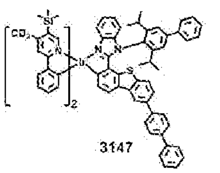
3147
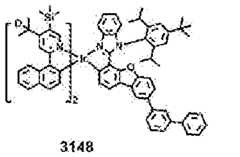
3148
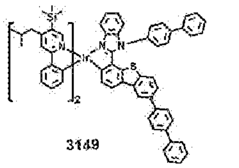
3149
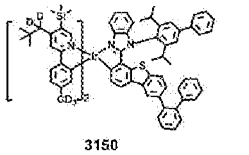
3150

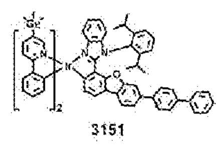
3151
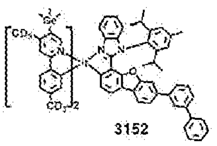
3152
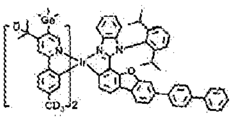
3153
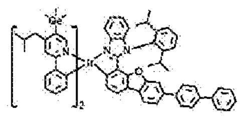
3154
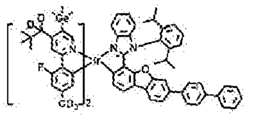
3155

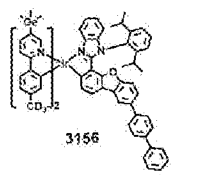
3156
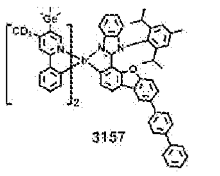
3157
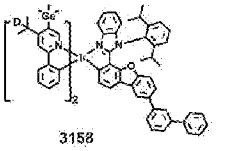
3158
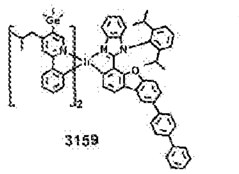
3159
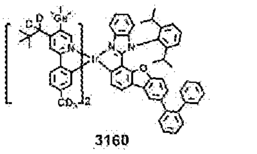
3160

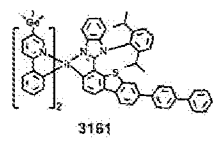
3161
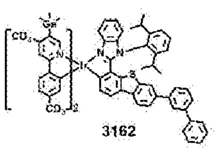
3162
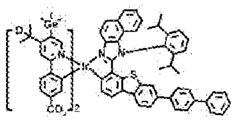
3163
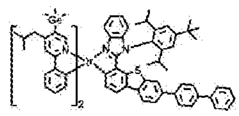
3164
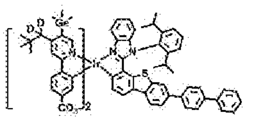
3165

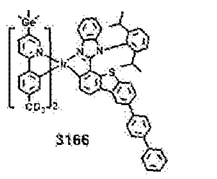
3166
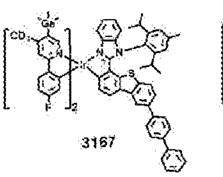
3167
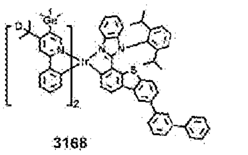
3168
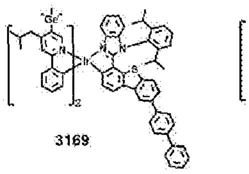
3169
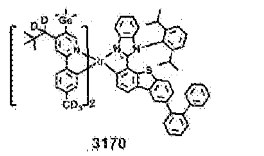
3170

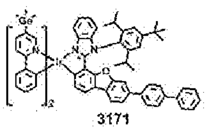
3171
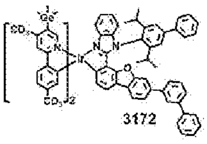
3172
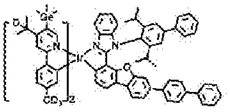
3173
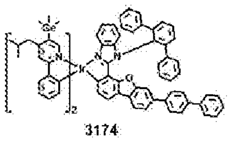
3174
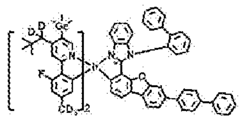
3175

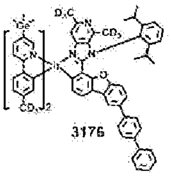
3176
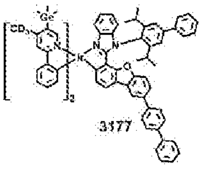
3177
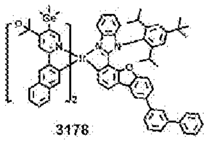
3178
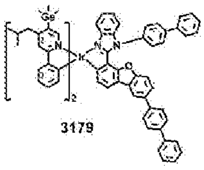
3179
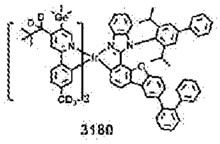
3180

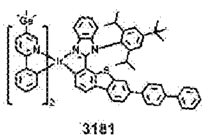
3181
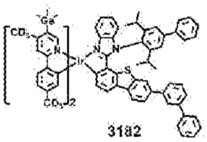
3182
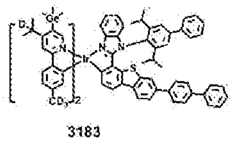
3183
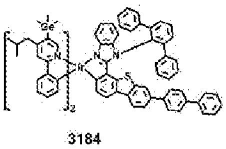
3184
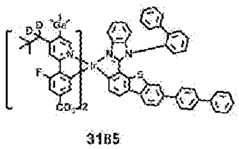
3185

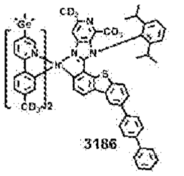
3186
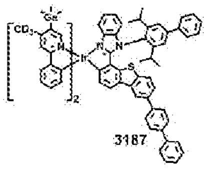
3187
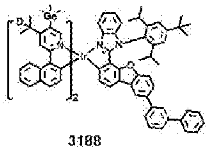
3188
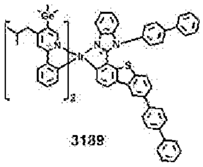
3189
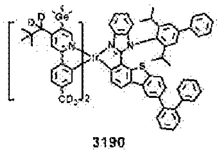
3190

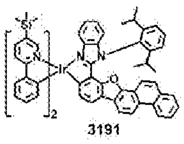
3191
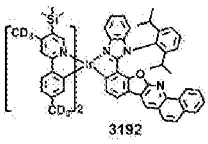
3192
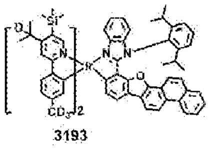
3193
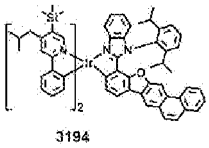
3194
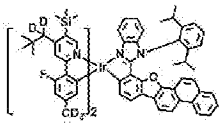
3195

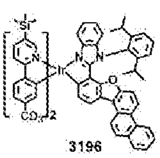
3196
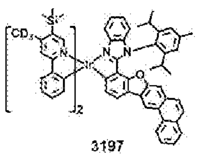
3197
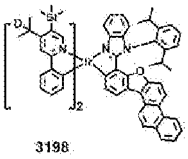
3198
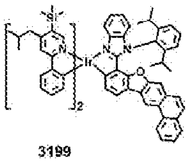
3199
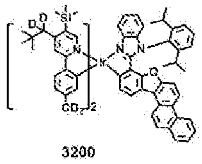
3200

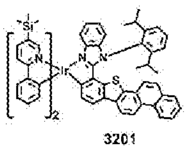
3201
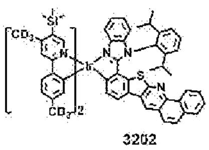
3202
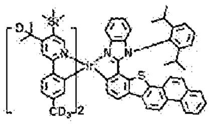
3203
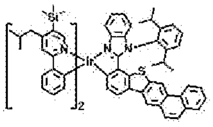
3204
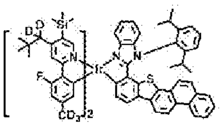
3205

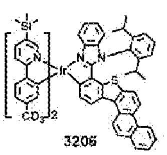
3206
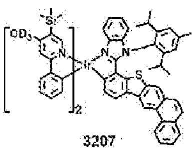
3207
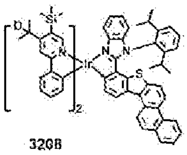
3208
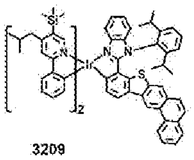
3209
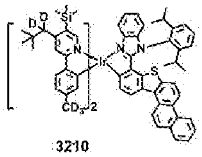
3210

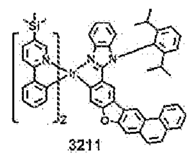
3211
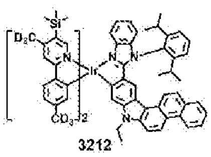
3212
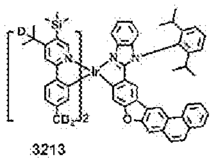
3213
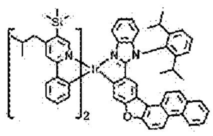
3214
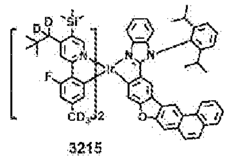
3215

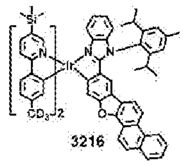
3216
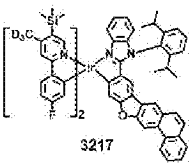
3217
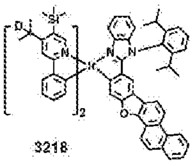
3218
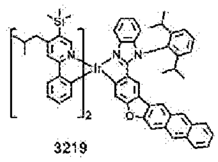
3219
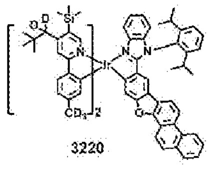
3220

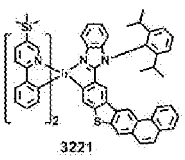
3221
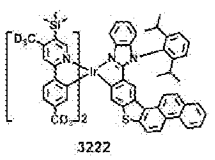
3222
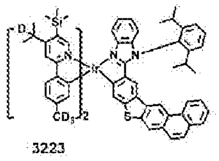
3223
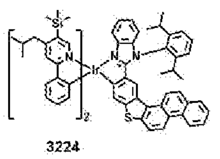
3224
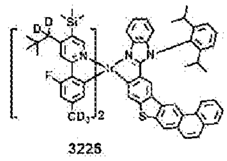
3225

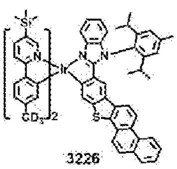
3226
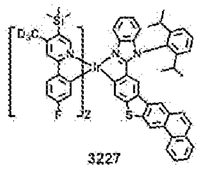
3227
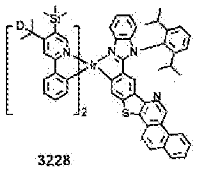
3228
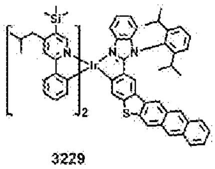
3229
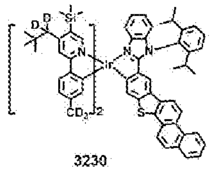
3230

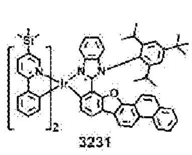
3231
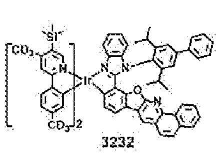
3232
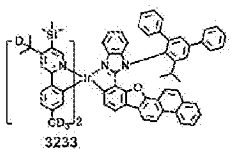
3233
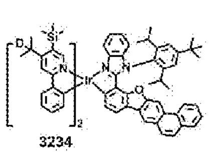
3234
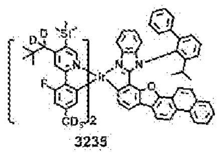
3235

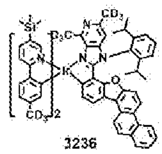
3236
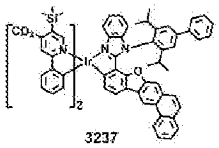
3237
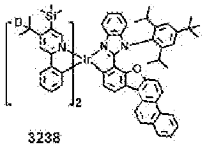
3238
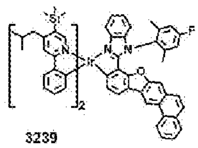
3239
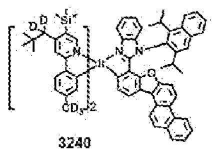
3240

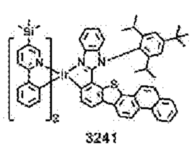
3241
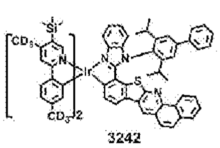
3242
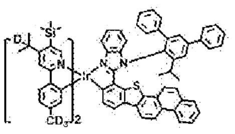
3243
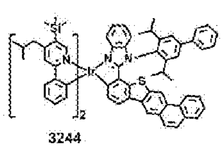
3244
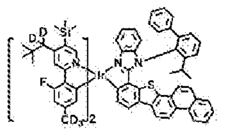
3245

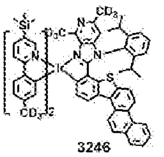
3246
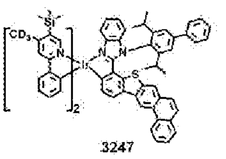
3247
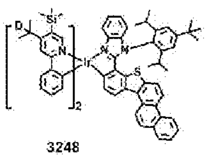
3248
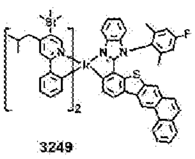
3249
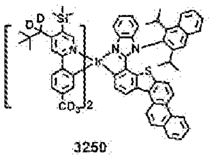
3250

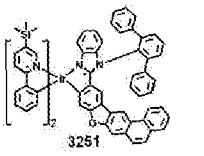
3251
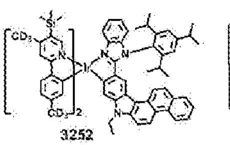
3252
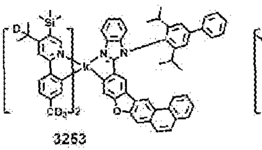
3253
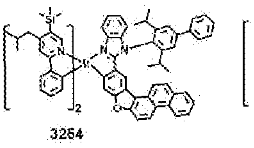
3254
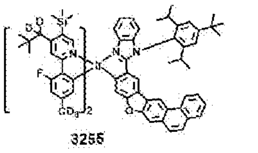
3255
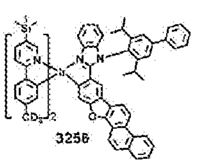
3256
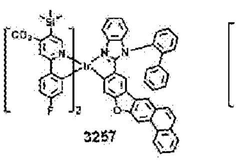
3257
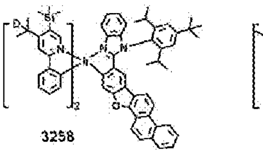
3258
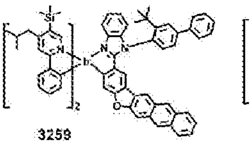
3259
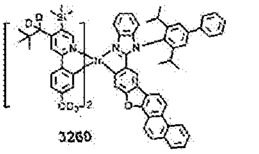
3260
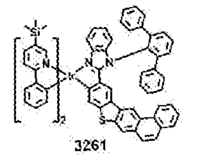
3261
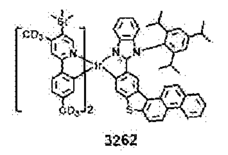
3262
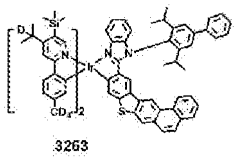
3263
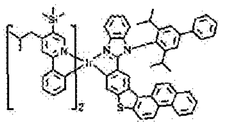
3264
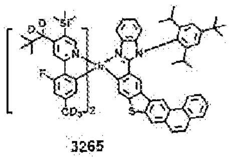
3265
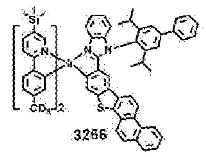
3266
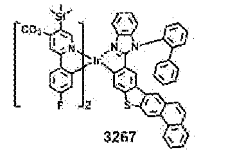
3267
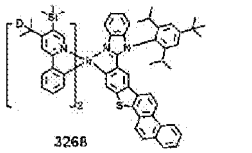
3268
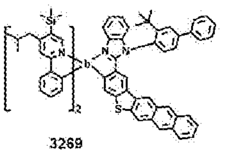
3269
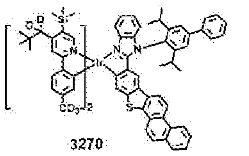
3270
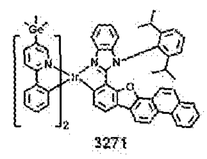
3271
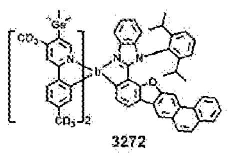
3272
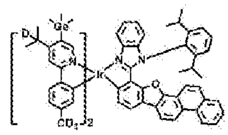
3273
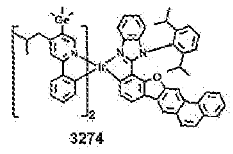
3274
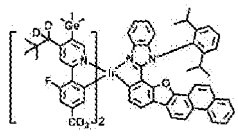
3275
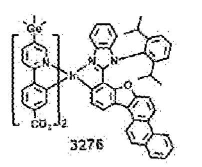
3276
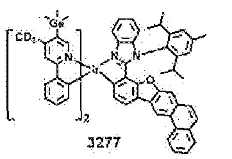
3277
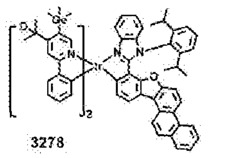
3278
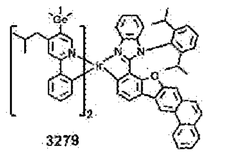
3279
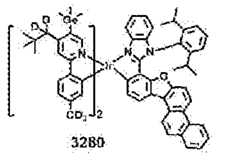
3280
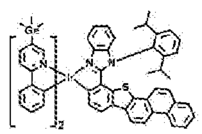
3281
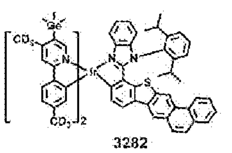
3282
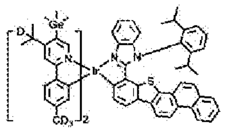
3283
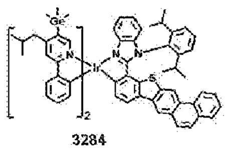
3284
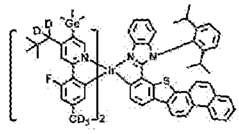
3285
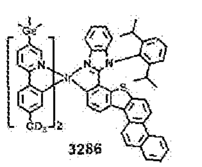
3286
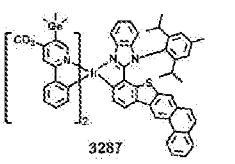
3287
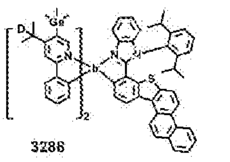
3288
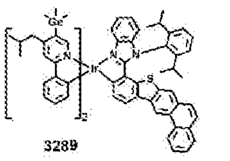
3289
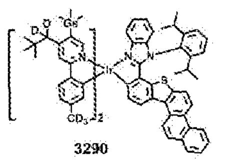
3290

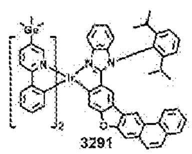
3291
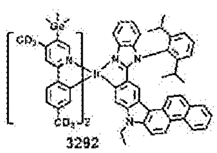
3292
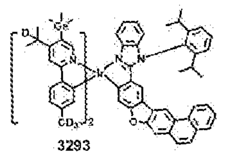
3293
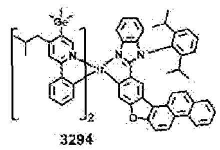
3294
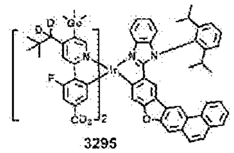
3295

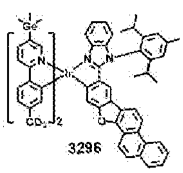
3296
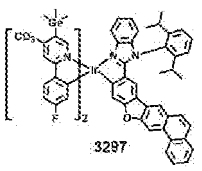
3297
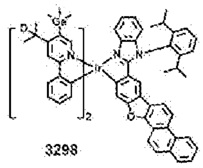
3298
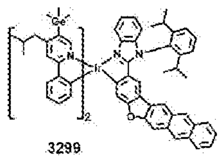
3299
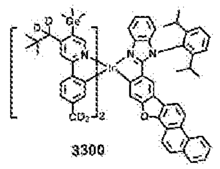
3300

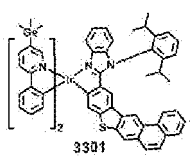
3301
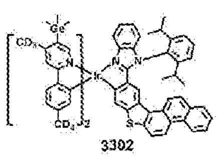
3302
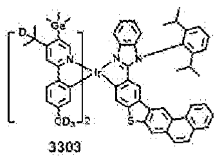
3303
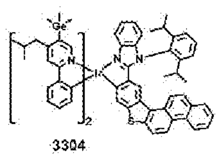
3304
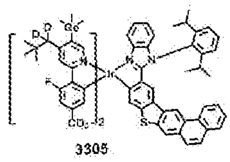
3305

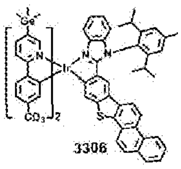
3306
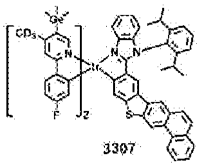
3307
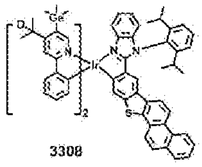
3308
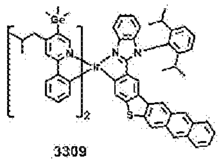
3309
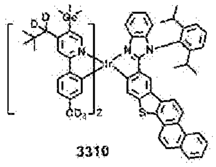
3310

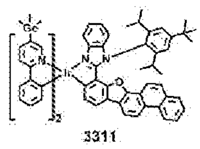
3311
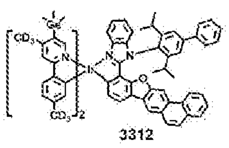
3312
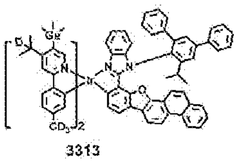
3313
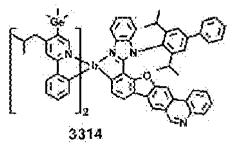
3314
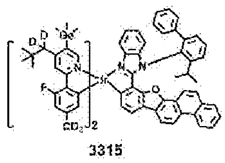
3315

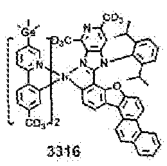
3316
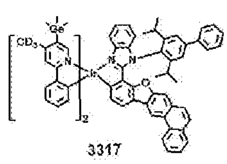
3317
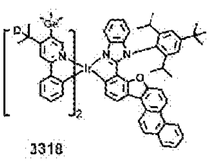
3318
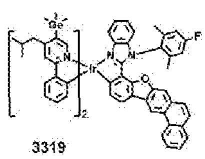
3319
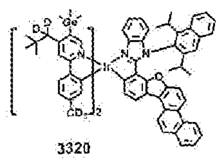
3320

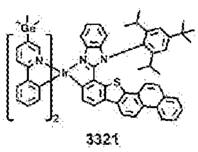
3321
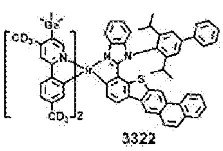
3322
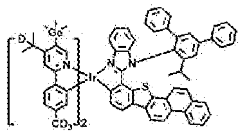
3323
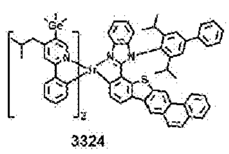
3324
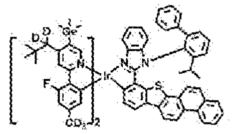
3325

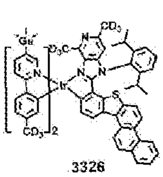
3326
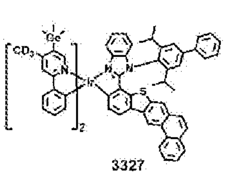
3327
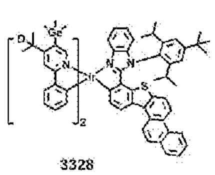
3328
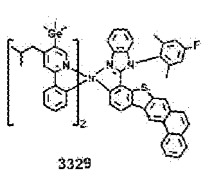
3329
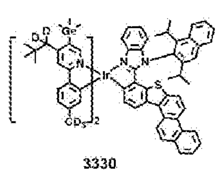
3330

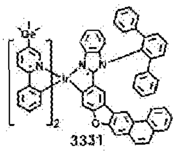
3331
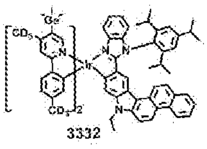
3332
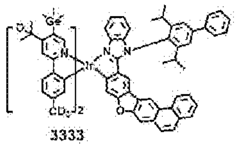
3333
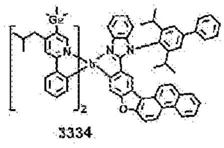
3334
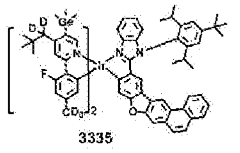
3335

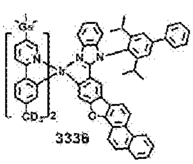
3336
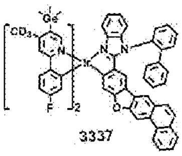
3337
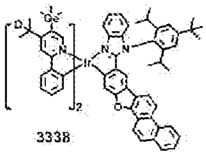
3338
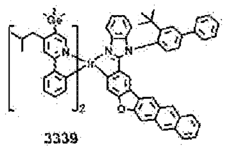
3339
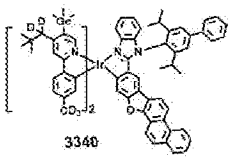
3340

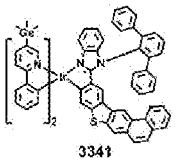
3341
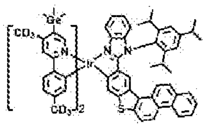
3342
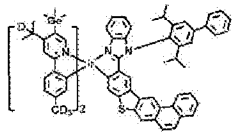
3343
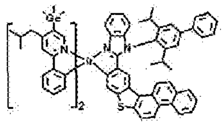
3344
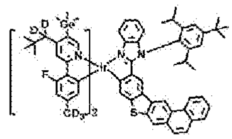
3345

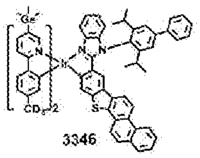
3346
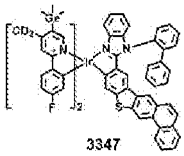
3347
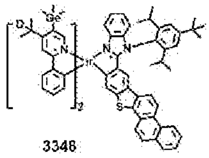
3348
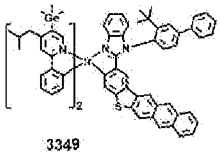
3349
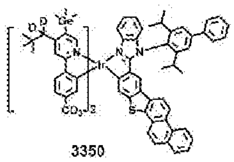
3350

## Group 1-4

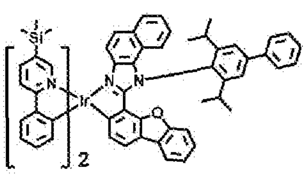
1
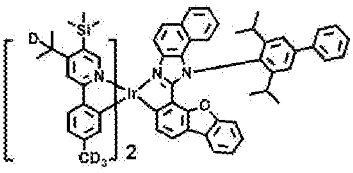
2
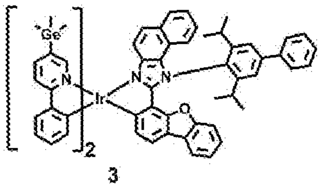
3

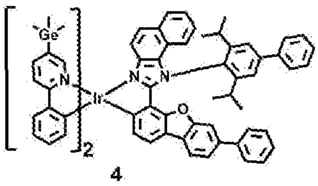
4
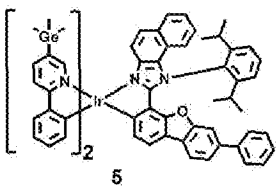
5
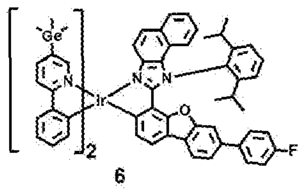
6

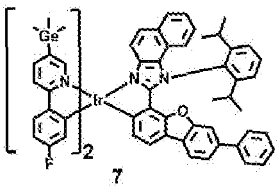
7
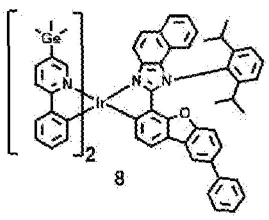
8
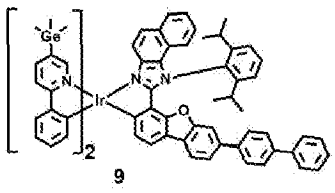
9

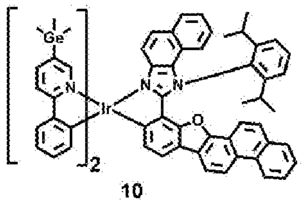

10

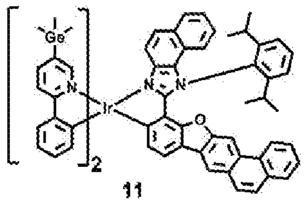

11

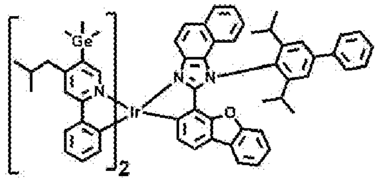

12

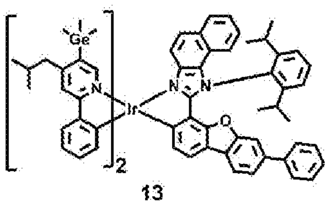

13

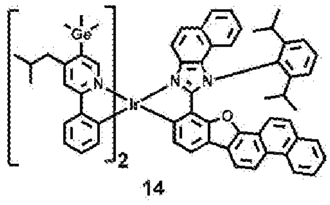

14

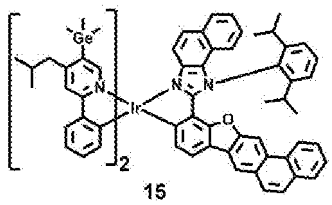

15

Group 1-5

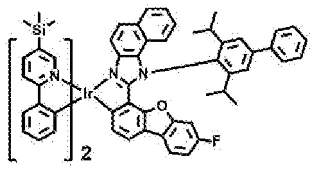

1

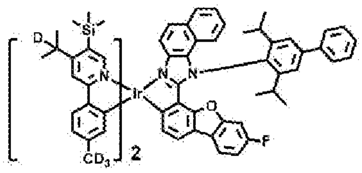

2

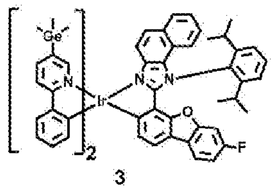

3

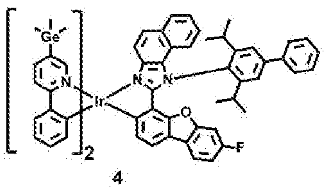

4

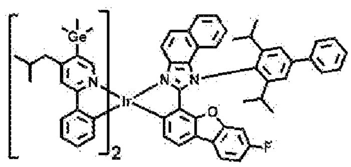

5

## Group 1-6

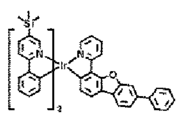
1

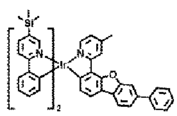
2

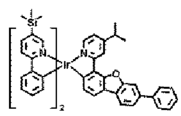
3

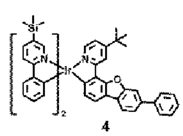
4

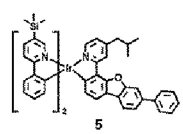
5

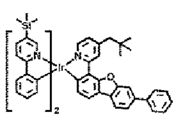
6

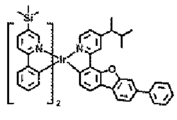
7

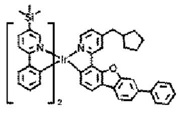
8

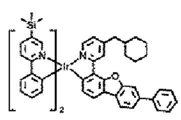
9

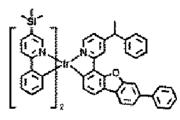
10

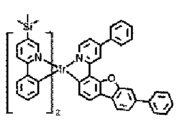
11

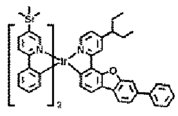
12

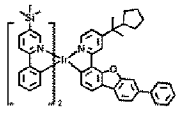
13

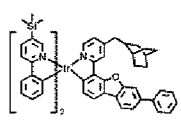
14

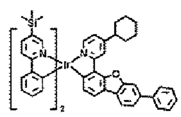
15

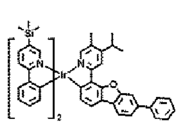
16

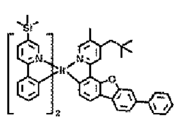
17

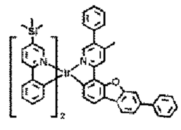
18

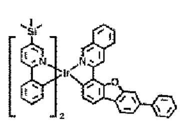
19

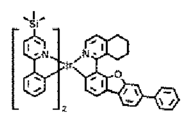
20

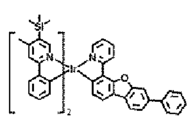
21

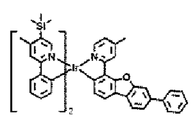
22

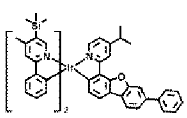
23

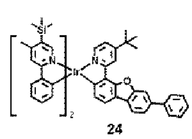
24

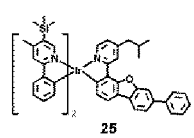
25

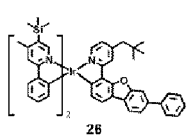
26

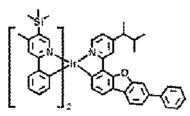
27

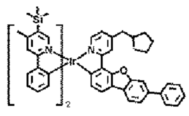
28

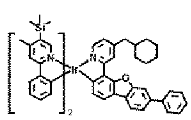
29

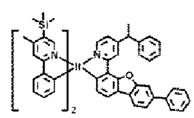
30

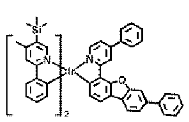
31

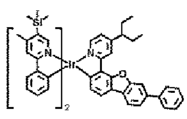
32

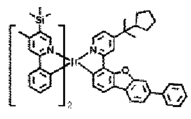
33

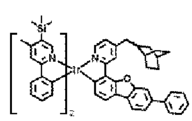
34

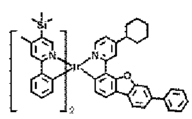
35

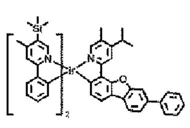
36

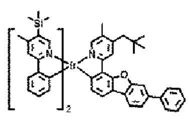
37

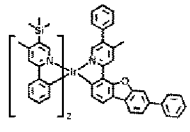
38

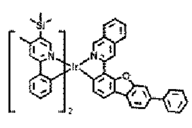
39

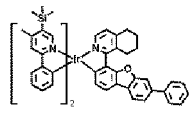
40

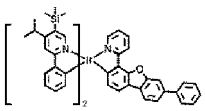
41
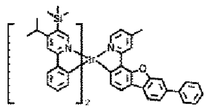
42
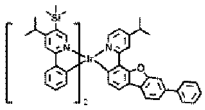
43
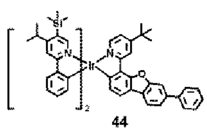
44
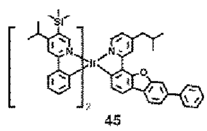
45

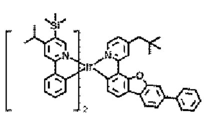
46
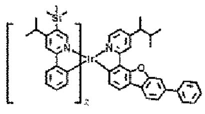
47
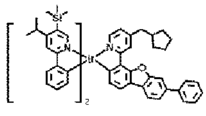
48
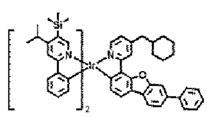
49
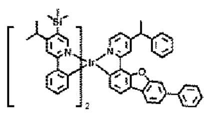
50

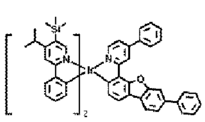
51
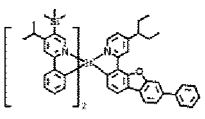
52
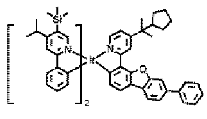
53
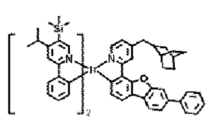
54
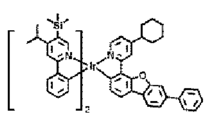
55

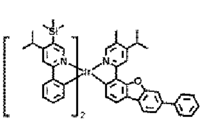
56
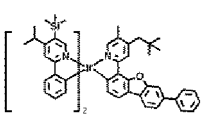
57
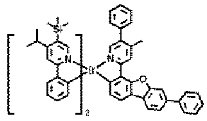
58
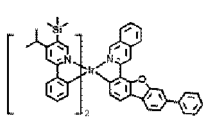
59
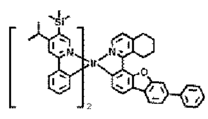
60

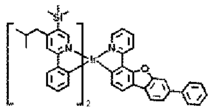
61
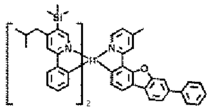
62
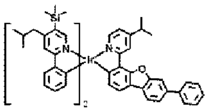
63
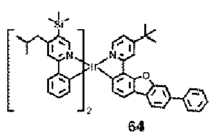
64
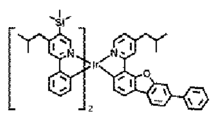
65

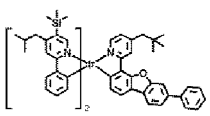
66
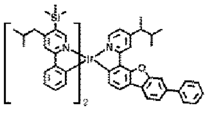
67
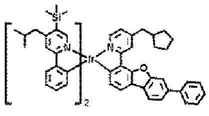
68
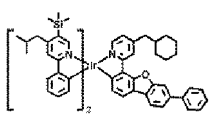
69
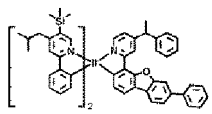
70

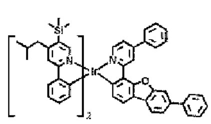
71
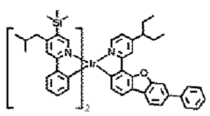
72
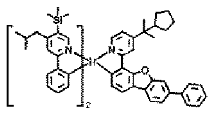
73
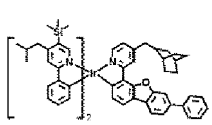
74
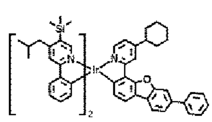
75

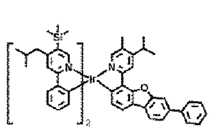
76
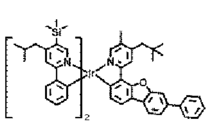
77
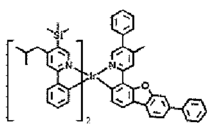
78
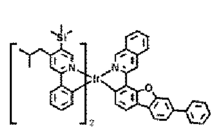
79
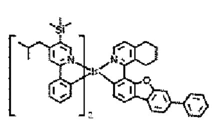
80

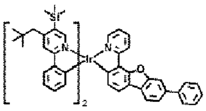
81
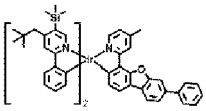
82
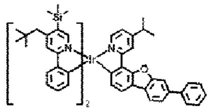
83
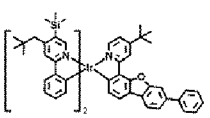
84
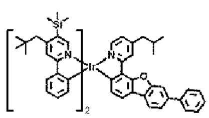
85
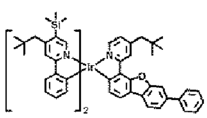
86
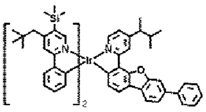
87
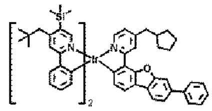
88
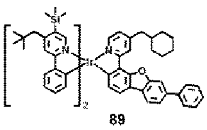
89
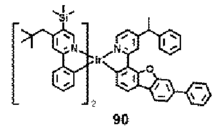
90
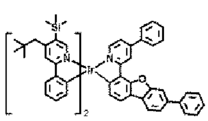
91
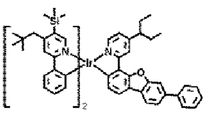
92
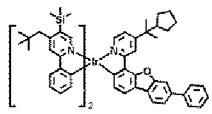
93
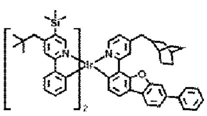
94
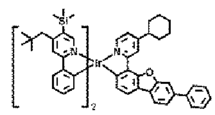
95
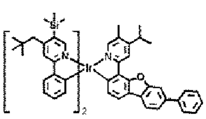
96
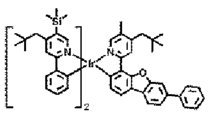
97
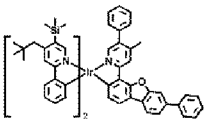
98
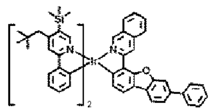
99
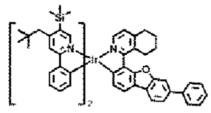
100
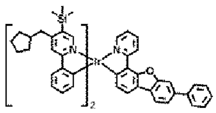
101
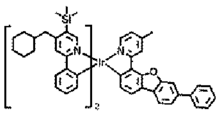
102
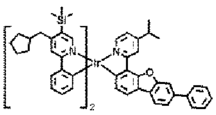
103
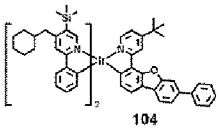
104
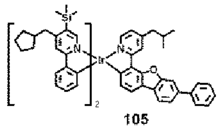
105
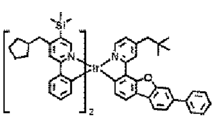
106
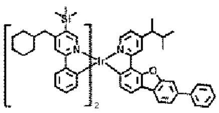
107
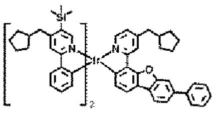
108
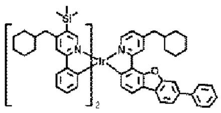
109
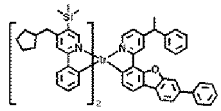
110
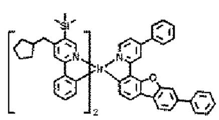
111
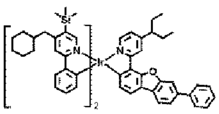
112
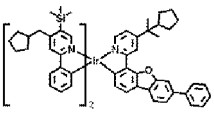
113
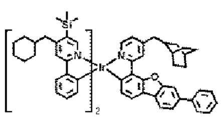
114
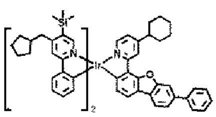
115
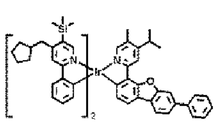
116
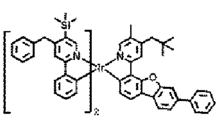
117
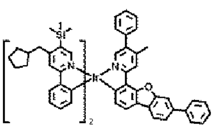
118
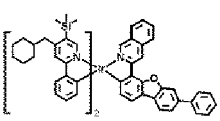
119
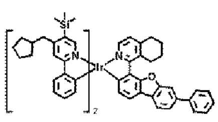
120

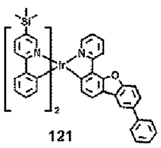
121

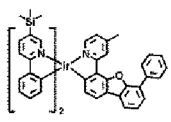
122

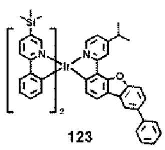
123

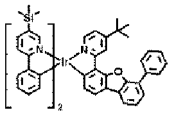
124

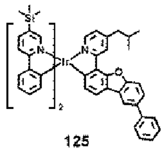
125

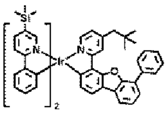
126

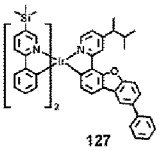
127

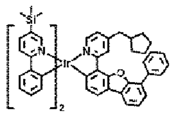
128

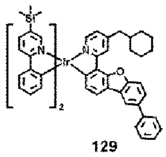
129

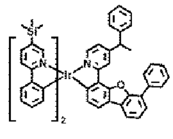
130

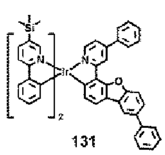
131

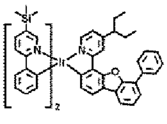
132

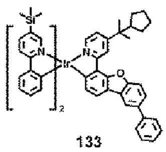
133

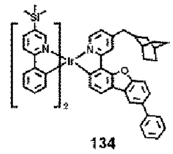
134

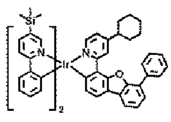
135

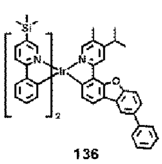
136

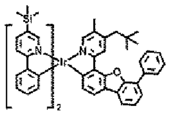
137

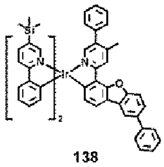
138

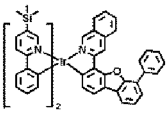
139

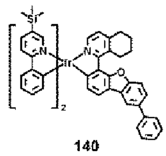
140

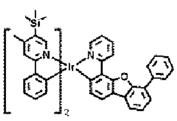
141

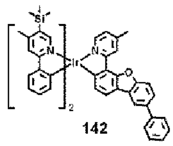
142

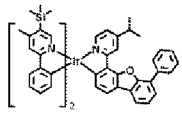
143

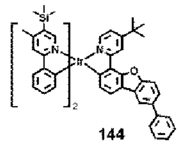
144

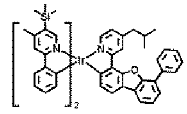
145

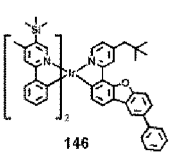
146

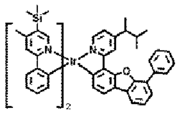
147

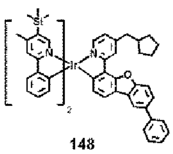
148

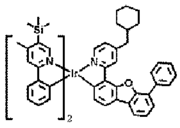
148

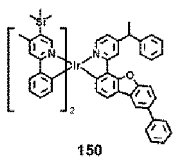
150

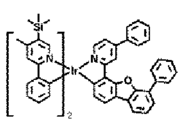
151

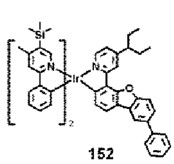
152

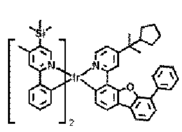
153

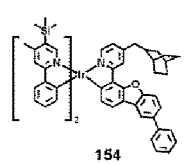
154

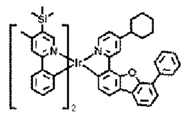
155

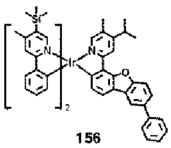
156

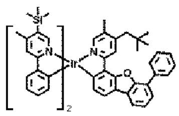
157

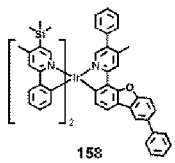
158

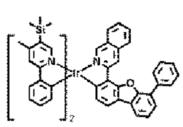
159

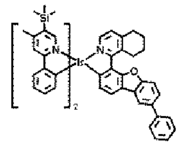
160

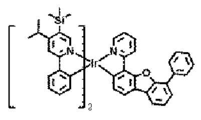
161
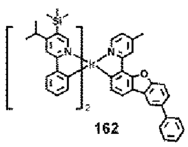
162
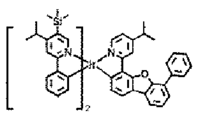
163
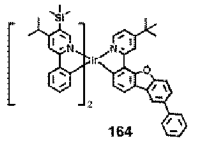
164
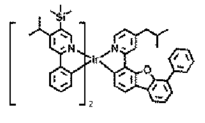
165

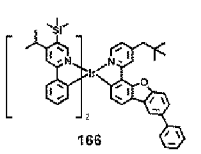
166
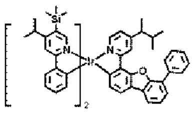
167
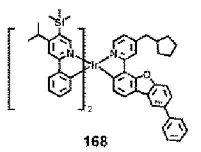
168
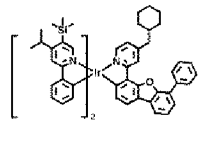
169
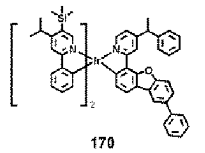
170

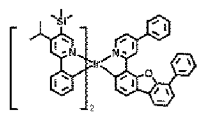
171
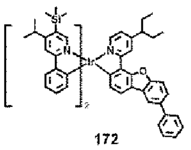
172
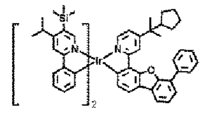
173
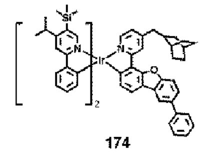
174
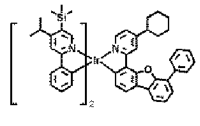
175

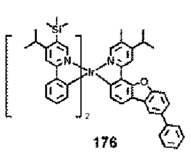
176
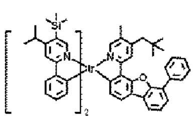
177
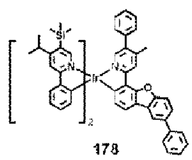
178
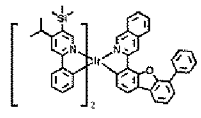
179
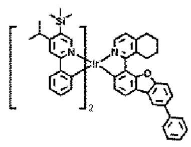
180

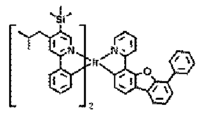
181
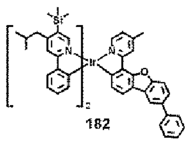
182
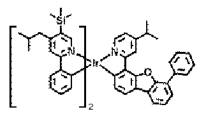
183
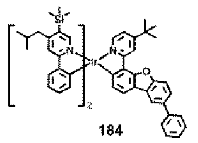
184
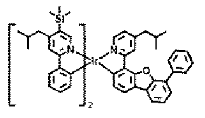
185

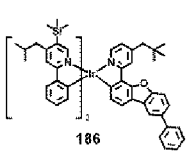
186
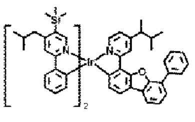
187
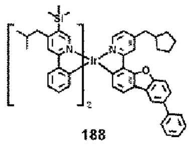
188
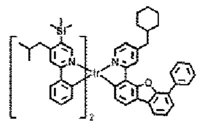
189
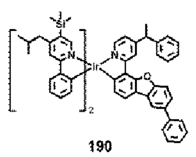
190

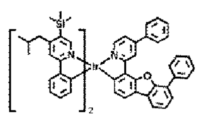
191
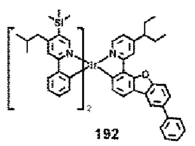
192
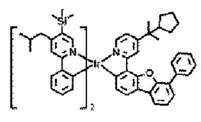
193
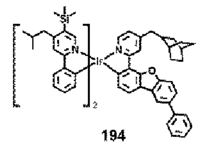
194
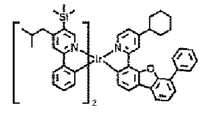
195

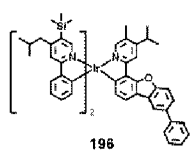
196
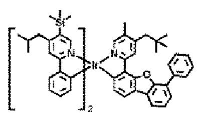
197
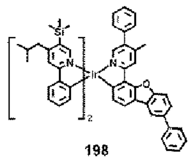
198
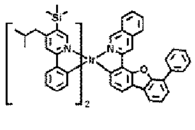
199
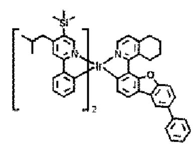
200

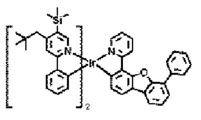
201
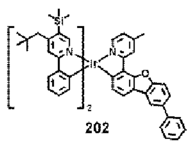
202
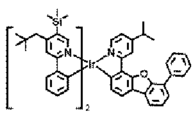
203
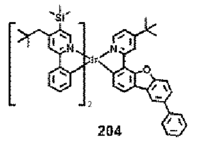
204
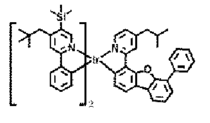
205

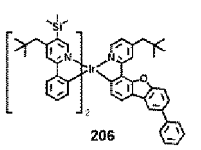
206
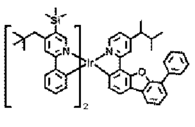
207
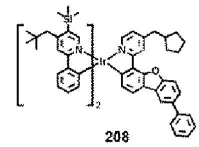
208
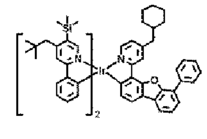
209
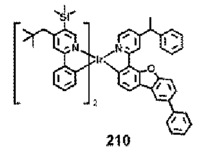
210

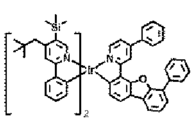
211
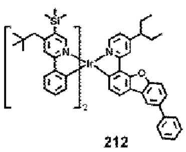
212
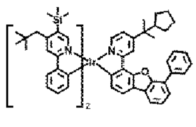
213
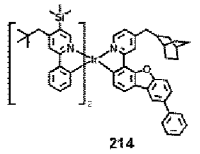
214
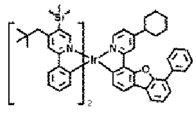
215

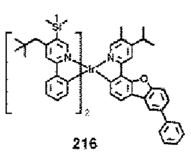
216
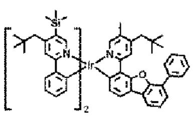
217
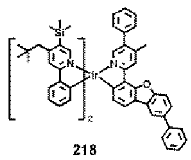
218
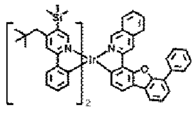
219
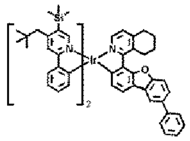
220

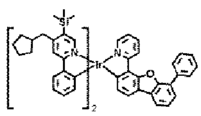
221
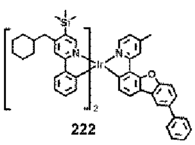
222
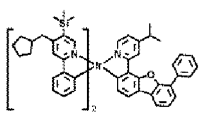
223
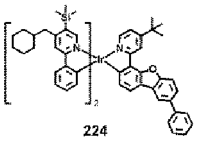
224
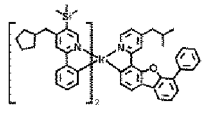
225

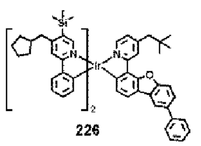
226
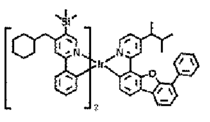
227
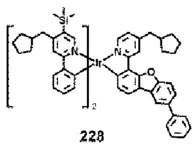
228
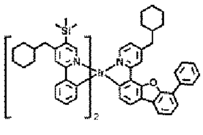
229
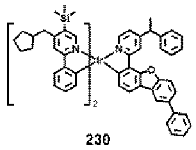
230

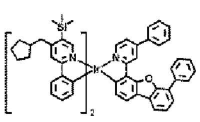
231
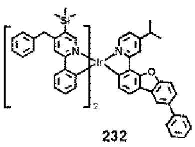
232
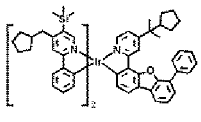
233
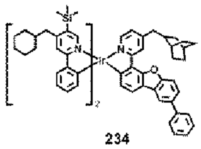
234
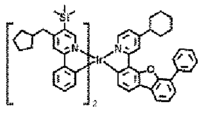
235

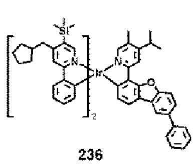
236
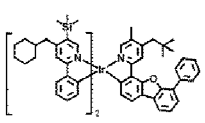
237
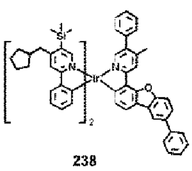
238
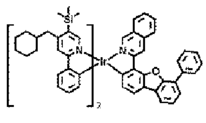
239
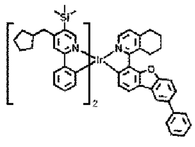
240

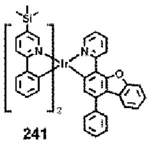
241
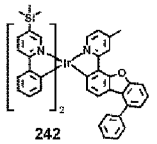
242
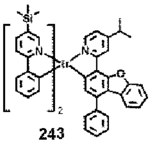
243
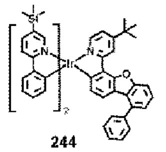
244
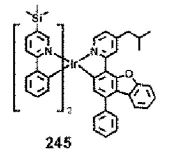
245
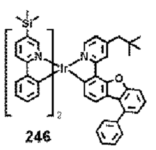
246
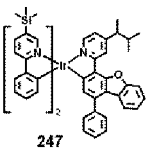
247
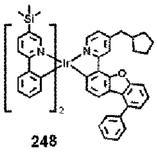
248
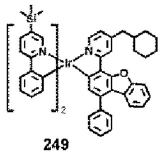
249
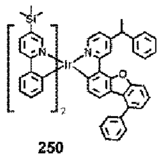
250
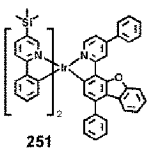
251
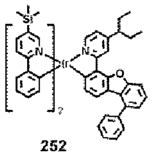
252
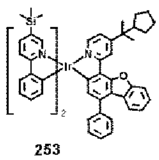
253
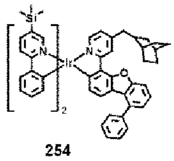
254
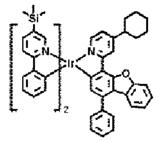
255
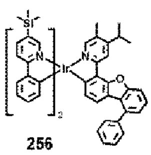
256
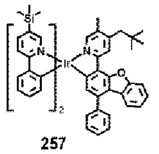
257
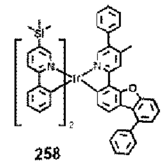
258
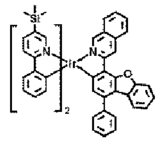
259
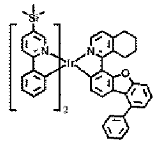
260
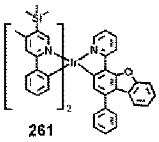
261
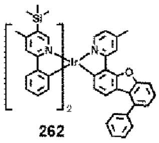
262
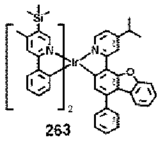
263
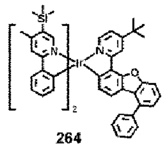
264
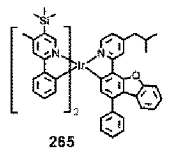
265
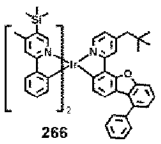
266
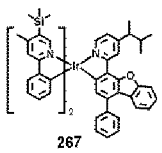
267
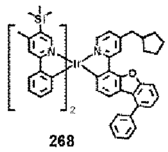
268
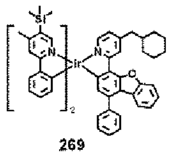
269
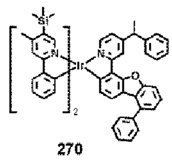
270
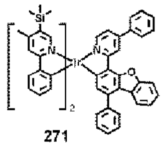
271
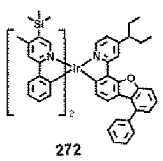
272
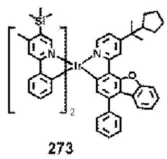
273
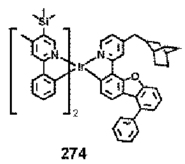
274
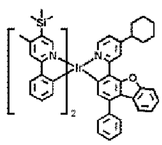
275
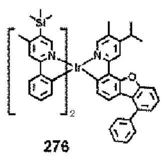
276
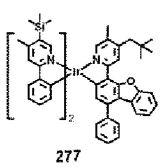
277
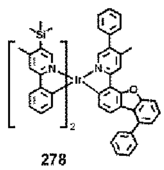
278
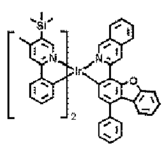
279
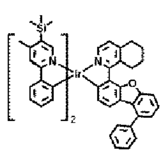
280

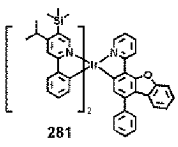
281

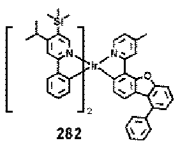
282

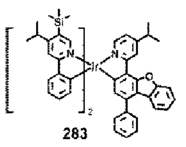
283

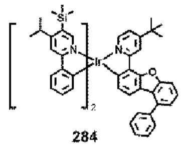
284

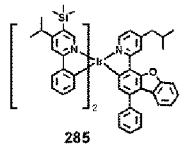
285

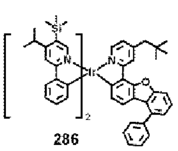
286

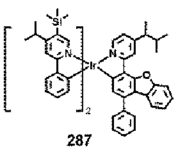
287

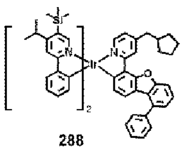
288

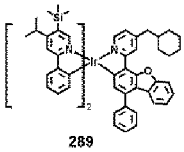
289

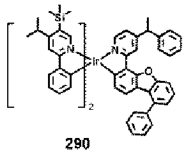
290

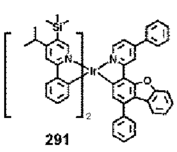
291

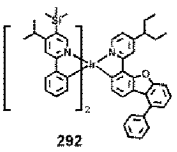
292

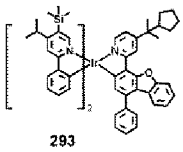
293

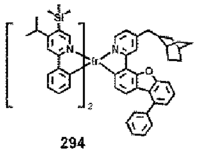
294

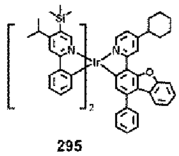
295

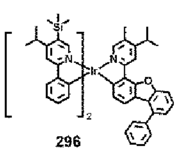
296

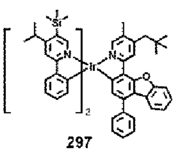
297

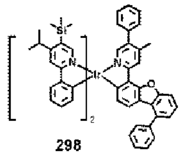
298

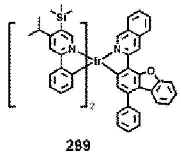
299

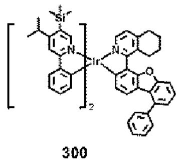
300

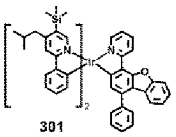
301

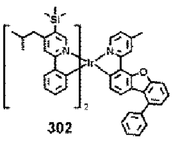
302

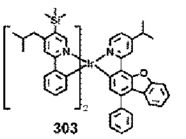
303

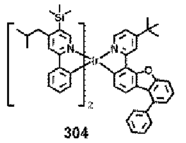
304

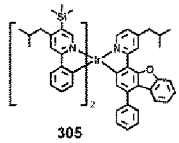
305

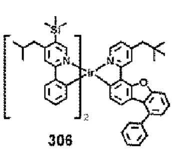
306

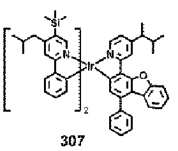
307

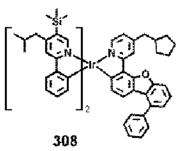
308

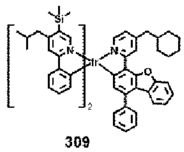
309

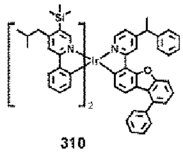
310

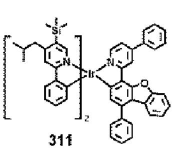
311

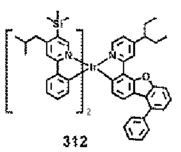
312

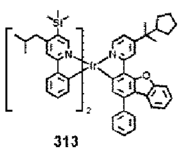
313

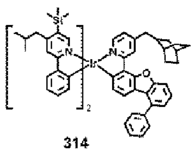
314

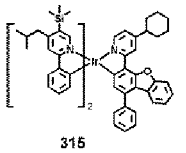
315

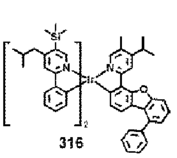
316

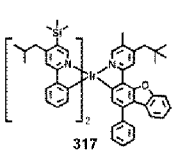
317

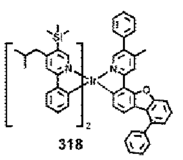
318

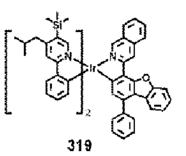
319

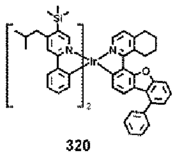
320

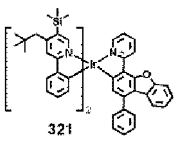
321
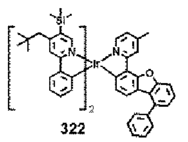
322
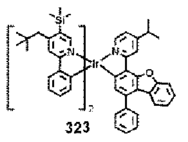
323
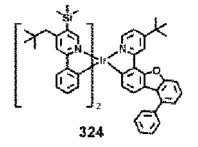
324
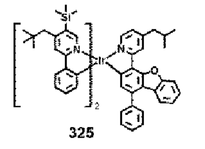
325

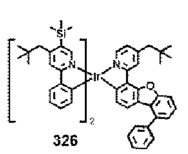
326
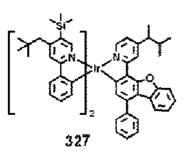
327
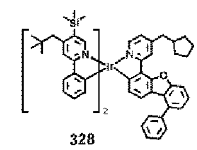
328
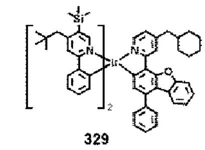
329
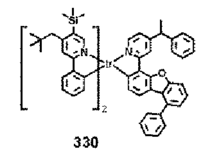
330

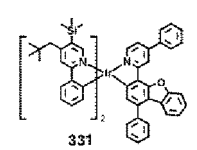
331
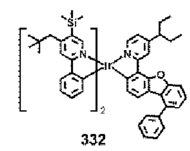
332
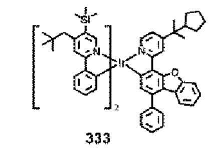
333
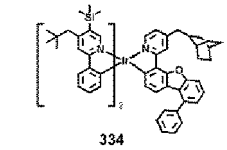
334
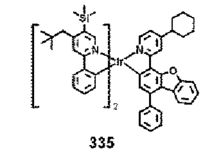
335

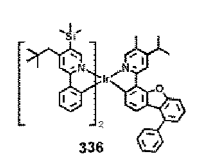
336
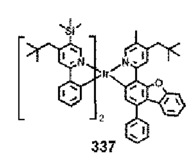
337
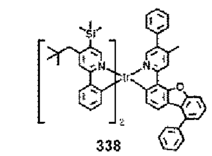
338
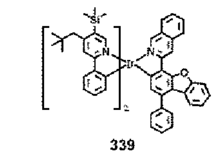
339
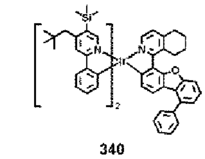
340

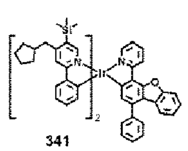
341
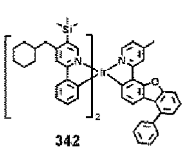
342
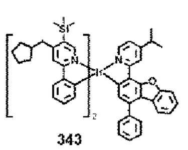
343
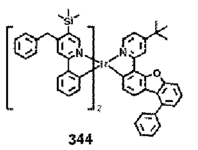
344
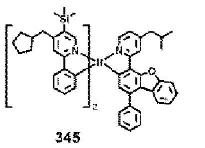
345

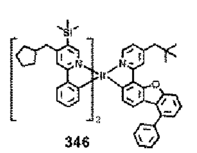
346
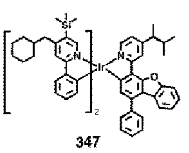
347
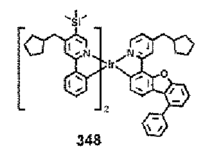
348
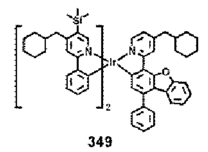
349
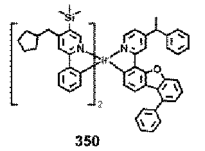
350

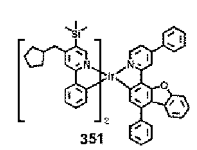
351
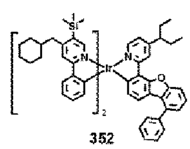
352
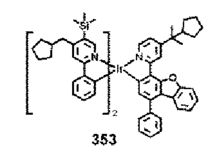
353
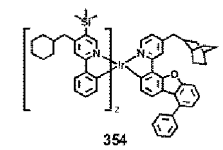
354
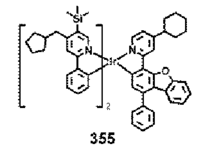
355

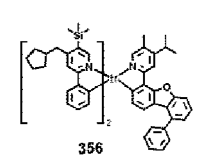
356
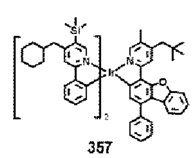
357
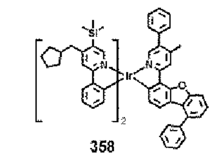
358
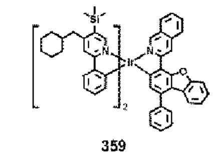
359
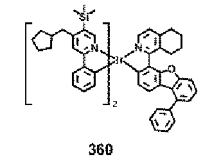
360

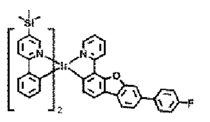
361

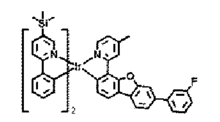
362

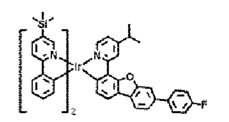
363

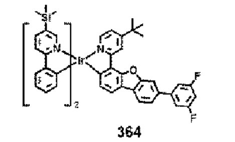
364

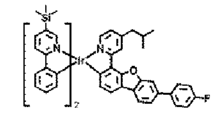
365

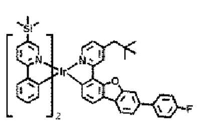
366

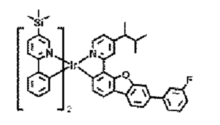
367

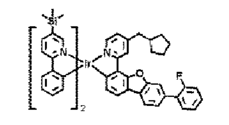
368

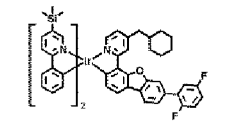
369

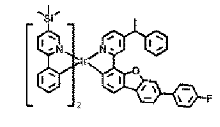
370

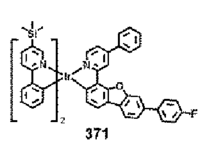
371

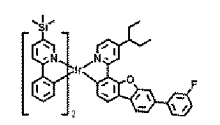
372

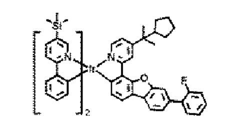
373

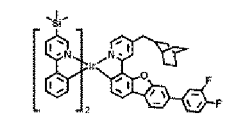
374

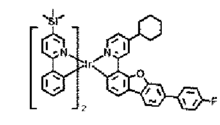
375

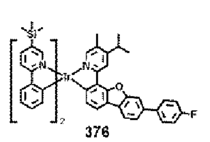
376

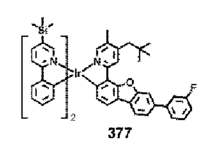
377

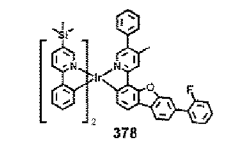
378

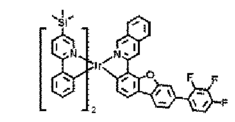
379

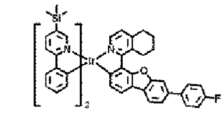
380

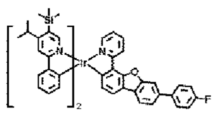
381

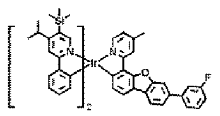
382

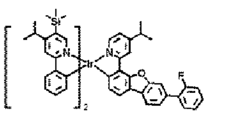
383

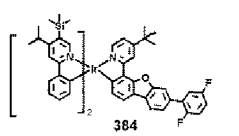
384

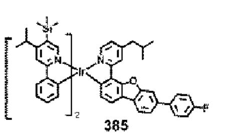
385

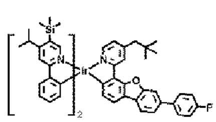
386

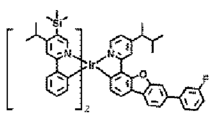
387

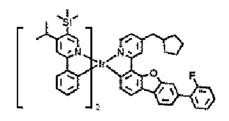
388

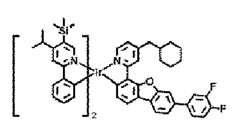
389

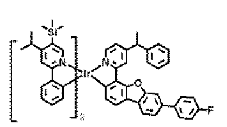
390

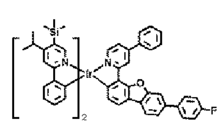
391

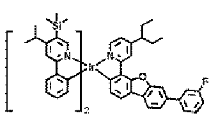
392

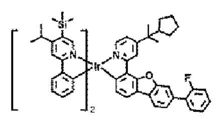
393

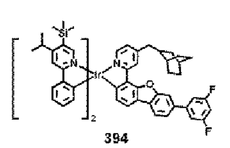
394

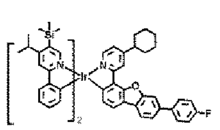
395

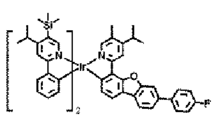
396

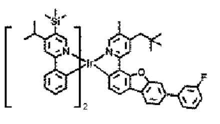
397

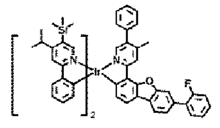
398

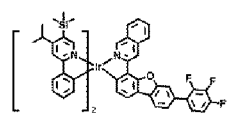
399

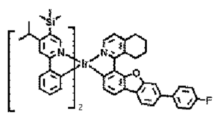
400

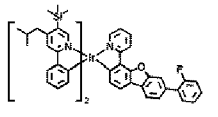
401

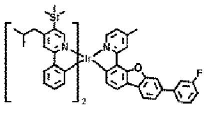
402

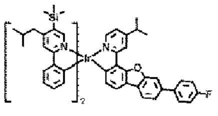
403

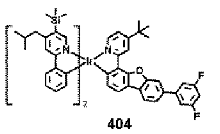
404

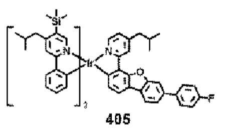
405

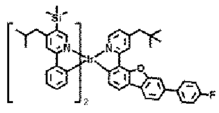
406

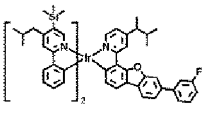
407

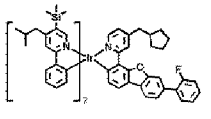
408

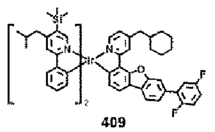
409

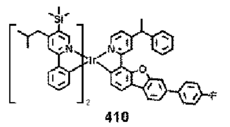
410

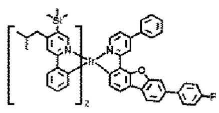
411

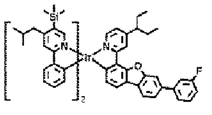
412

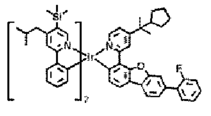
413

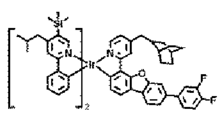
414

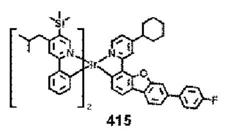
415

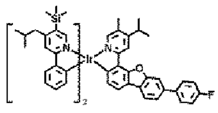
416

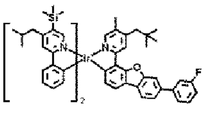
417

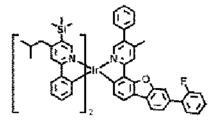
418

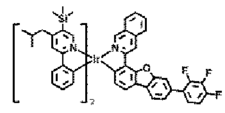
419

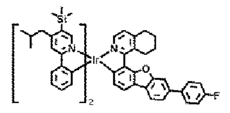
420

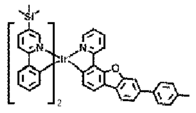
421

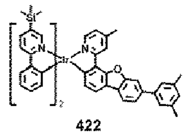
422

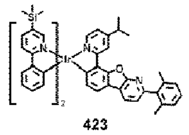
423

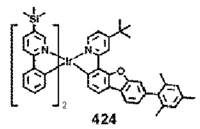
424

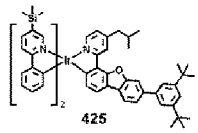
425

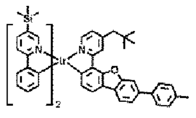
426

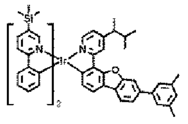
427

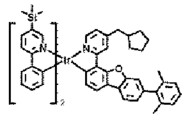
428

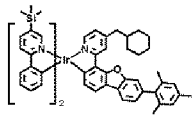
429

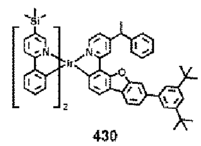
430

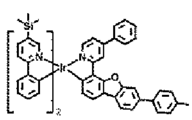
431

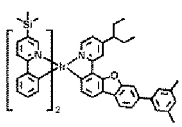
432

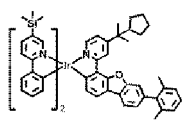
433

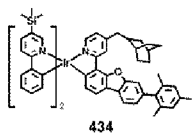
434

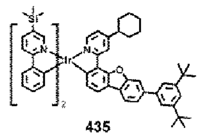
435

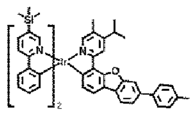
436

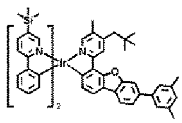
437

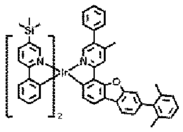
438

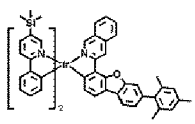
439

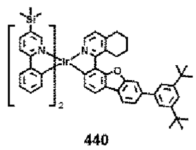
440

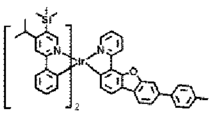 441 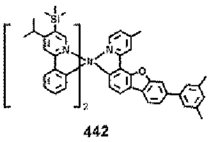 442 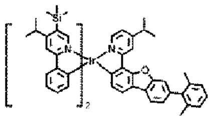 443 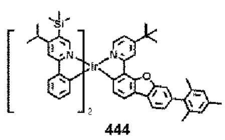 444 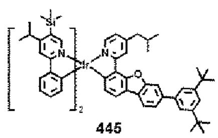 445

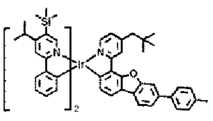 446 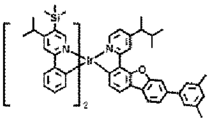 447 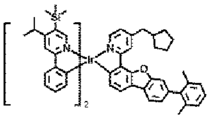 448 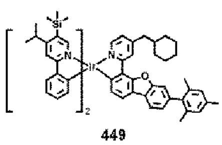 449 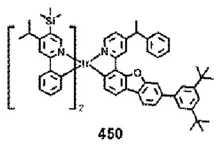 450

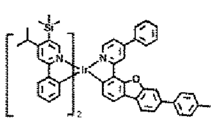 451 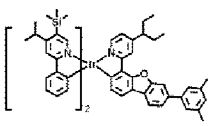 452 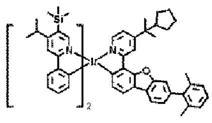 453 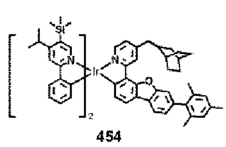 454 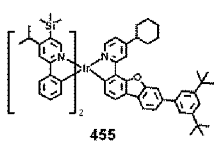 455

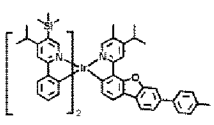 456 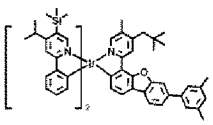 457 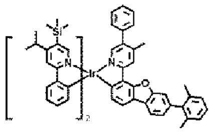 458 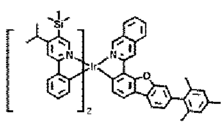 459 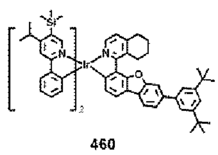 460

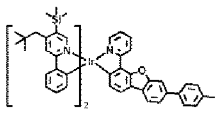 461 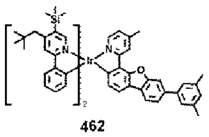 462 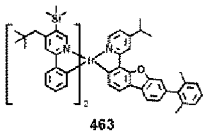 463 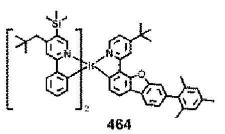 464 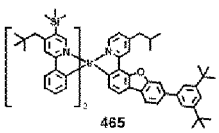 465

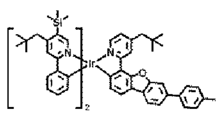 466 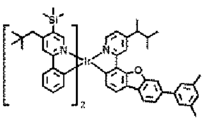 467 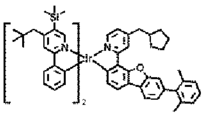 468 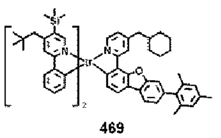 469 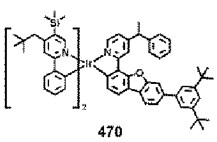 470

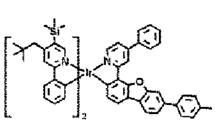 471 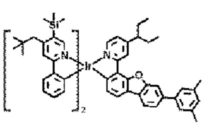 472 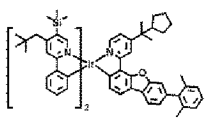 473 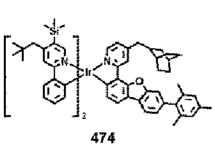 474 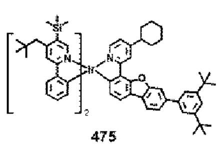 475

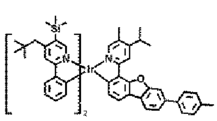 476 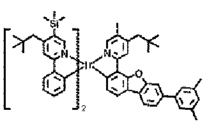 477 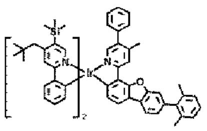 478 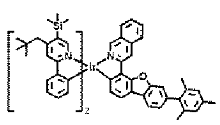 479 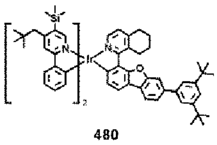 480

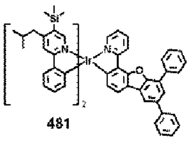
481

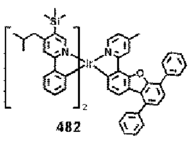
482

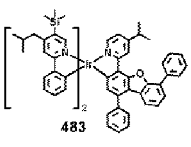
483

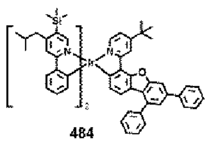
484

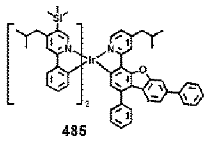
485

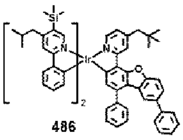
486

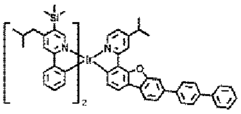
487

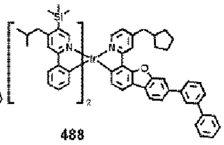
488

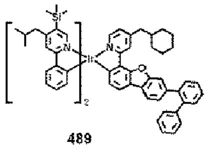
489

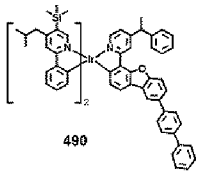
490

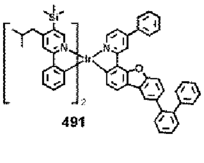
491

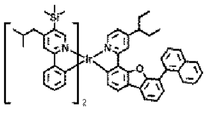
492

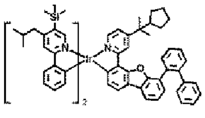
493

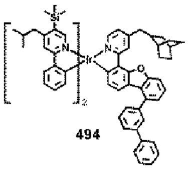
494

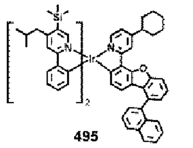
495

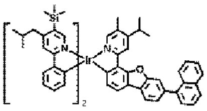
496

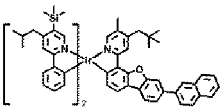
497

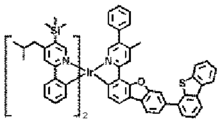
498

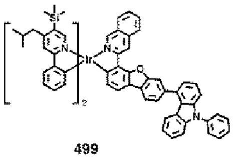
499

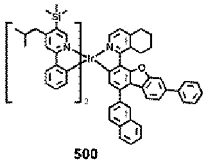
500

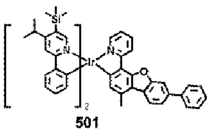
501

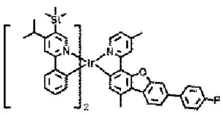
502

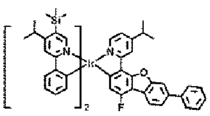
503

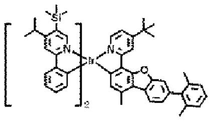
504

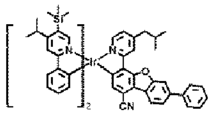
505

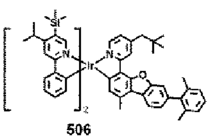
506

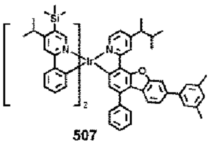
507

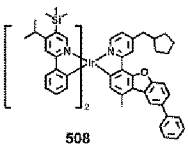
508

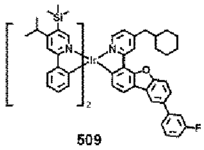
509

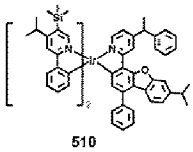
510

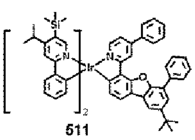
511

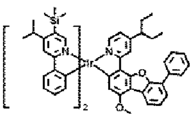
512

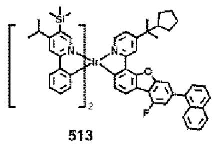
513

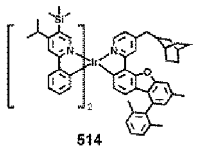
514

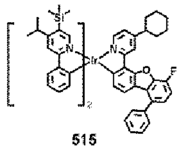
515

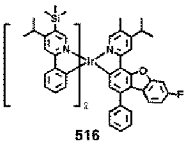
516

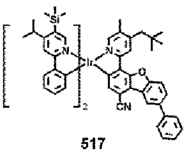
517

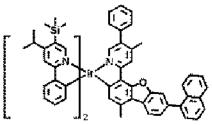
518

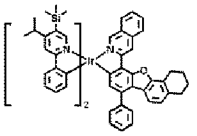
519

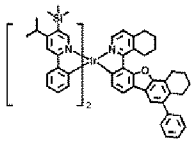
520

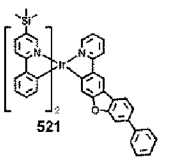
521

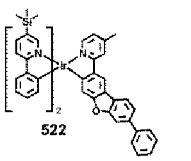
522

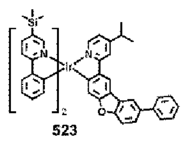
523

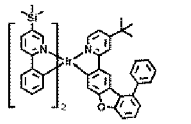
524

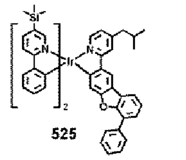
525

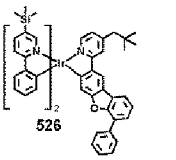
526

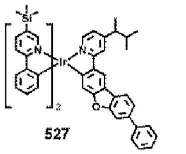
527

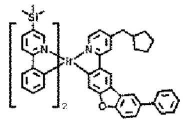
528

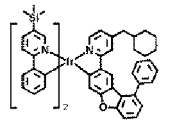
529

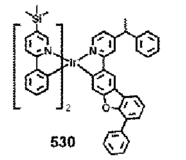
530

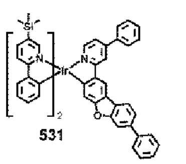
531

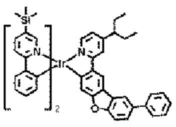
532

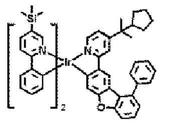
533

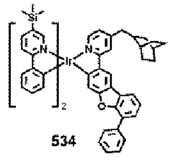
534

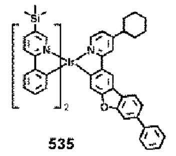
535

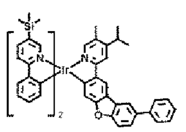
536

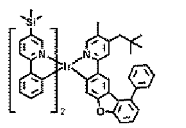
537

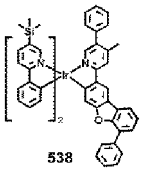
538

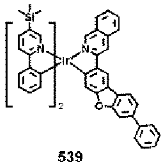
539

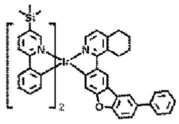
540

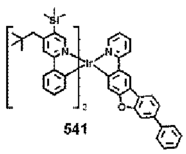
541

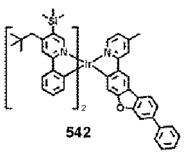
542

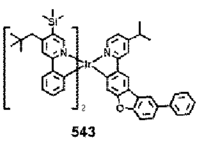
543

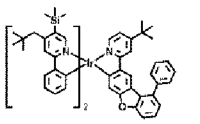
544

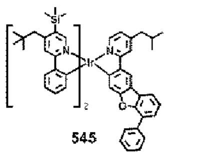
545

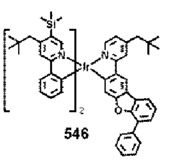
546

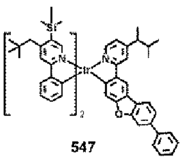
547

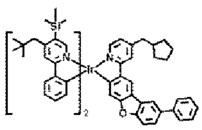
548

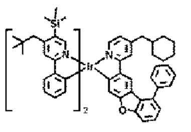
549

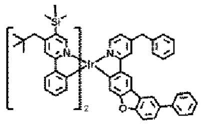
550

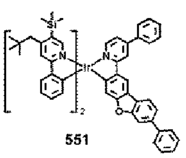
551

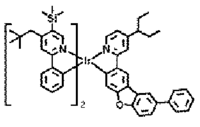
552

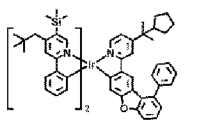
553

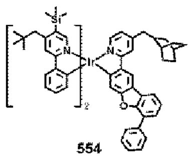
554

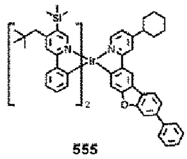
555

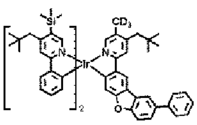
556

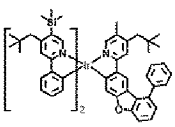
557

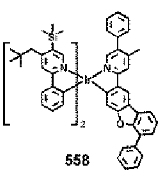
558

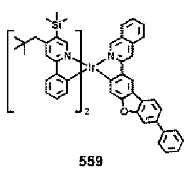
559

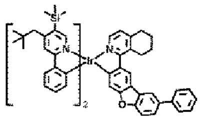
560

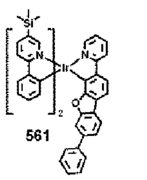
561
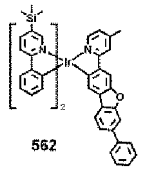
562
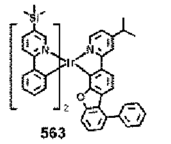
563
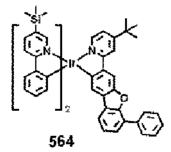
564
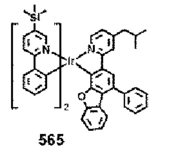
565

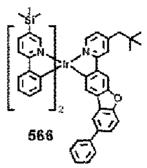
566
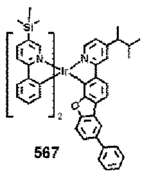
567
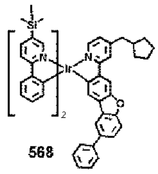
568
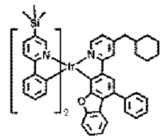
569
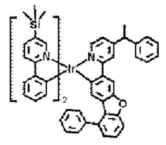
570

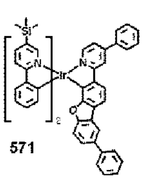
571
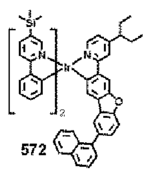
572
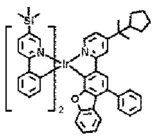
573
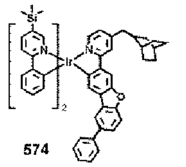
574
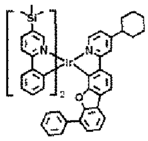
575

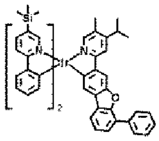
576
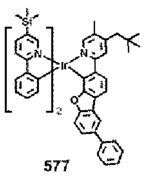
577
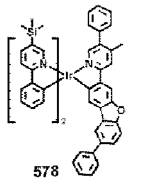
578
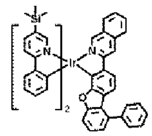
579
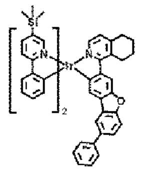
580

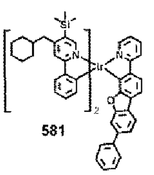
581
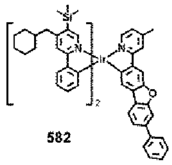
582
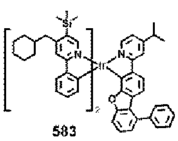
583
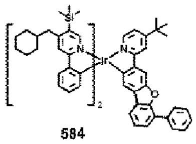
584
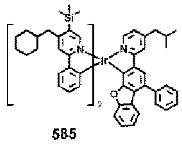
585

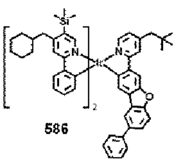
586
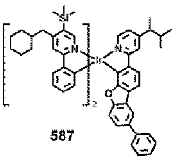
587
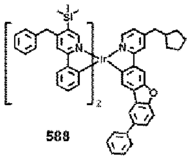
588
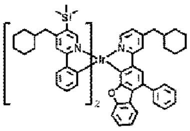
589
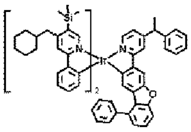
590

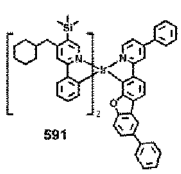
591
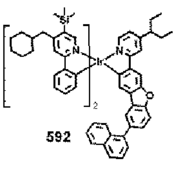
592
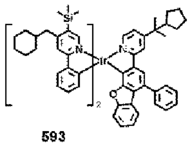
593
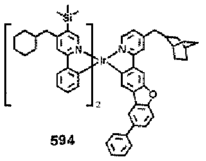
594
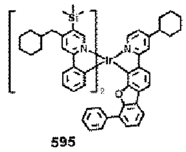
595

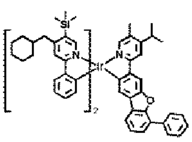
596
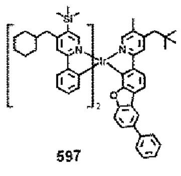
597
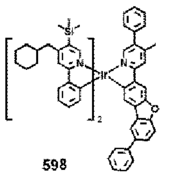
598
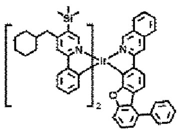
599
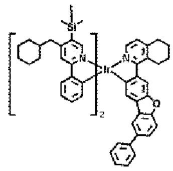
600

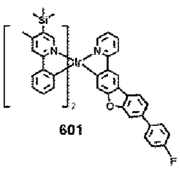
601

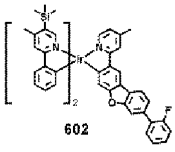
602

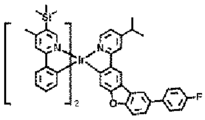
603

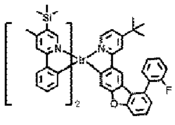
604

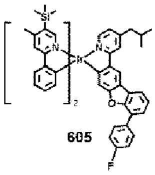
605

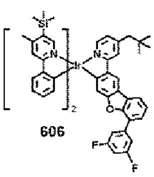
606

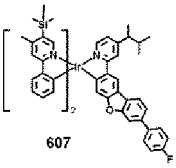
607

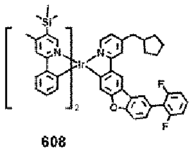
608

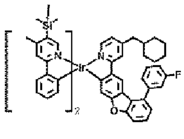
609

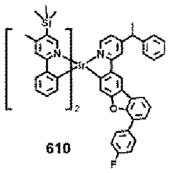
610

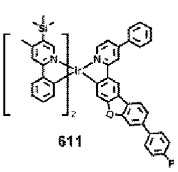
611

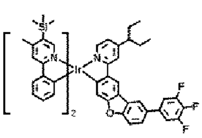
612

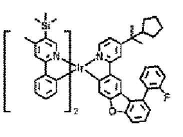
613

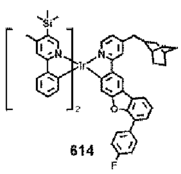
614

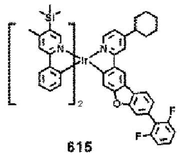
615

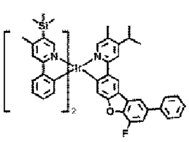
616

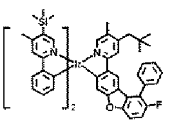
617

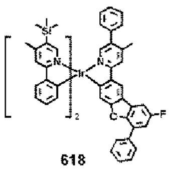
618

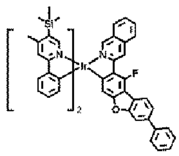
619

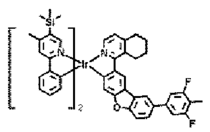
620

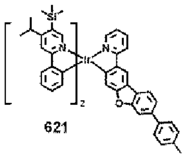
621

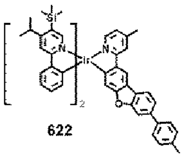
622

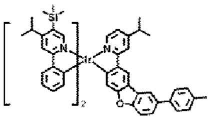
623

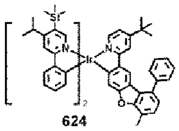
624

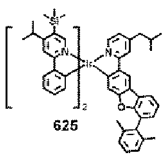
625

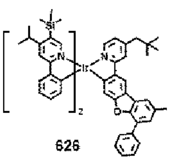
626

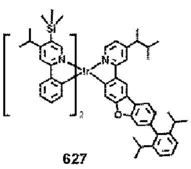
627

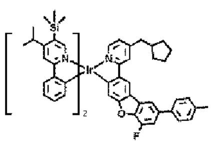
628

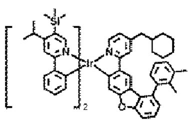
629

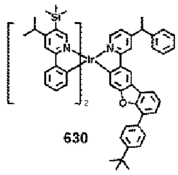
630

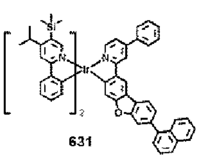
631

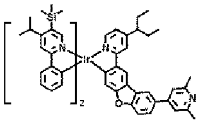
632

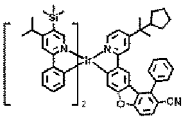
633

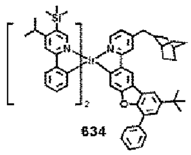
634

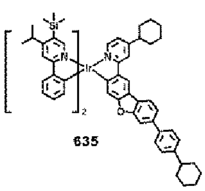
635

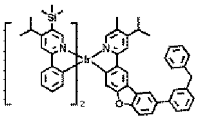
636

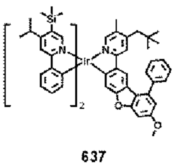
637

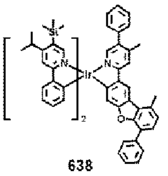
638

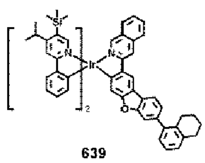
639

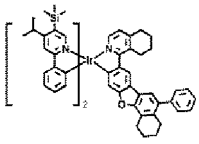
640

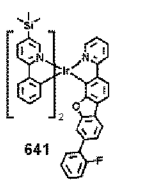
641
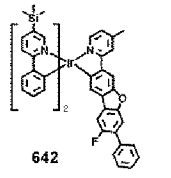
642
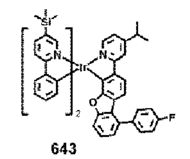
643
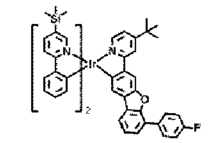
644
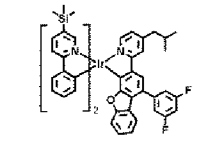
645
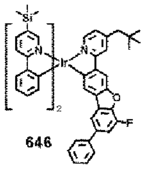
646
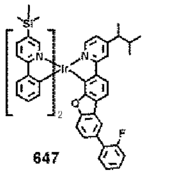
647
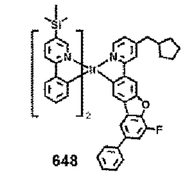
648
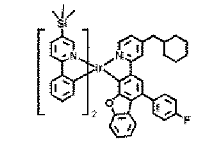
649
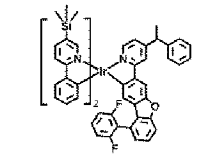
650
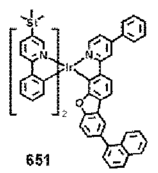
651
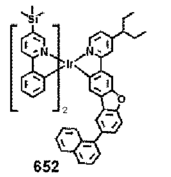
652
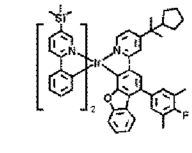
653
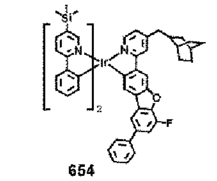
654
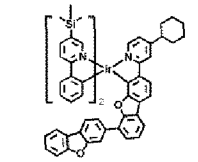
655
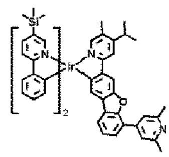
656
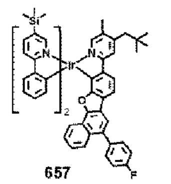
657
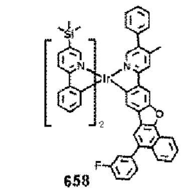
658
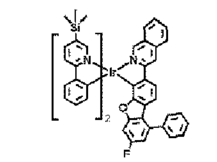
659
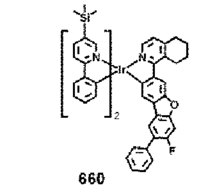
660
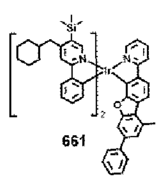
661
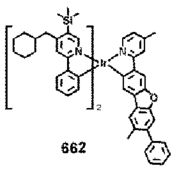
662
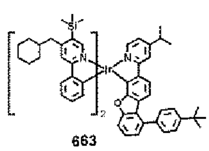
663
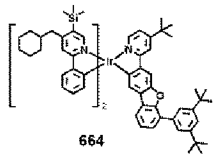
664
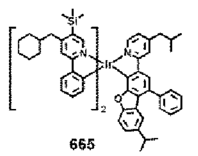
665
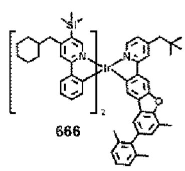
666
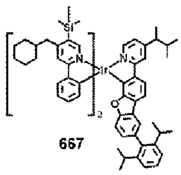
667
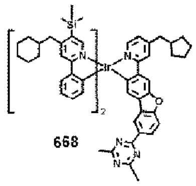
668
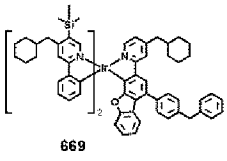
669
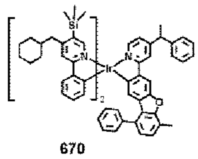
670
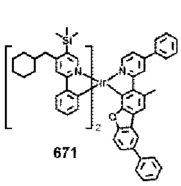
671
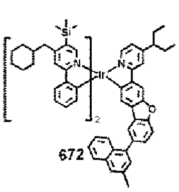
672
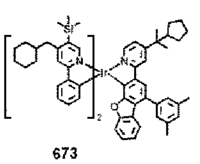
673
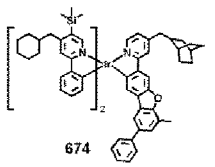
674
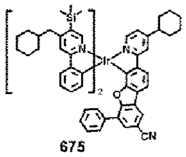
675
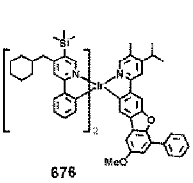
676
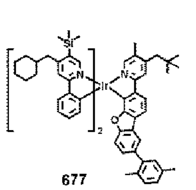
677
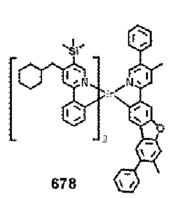
678
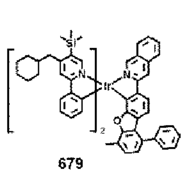
679
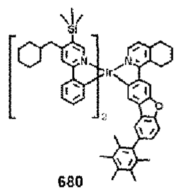
680

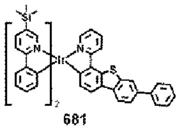
681

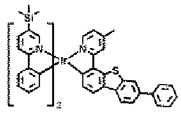
682

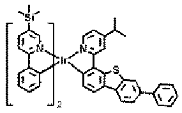
683

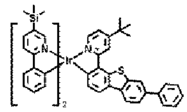
684

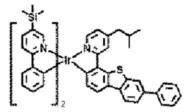
685

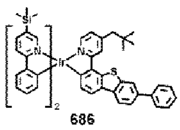
686

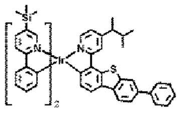
687

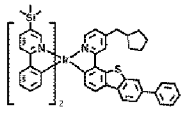
688

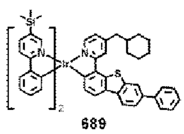
689

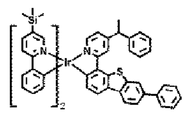
690

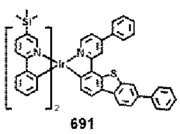
691

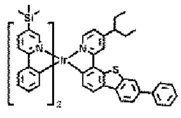
692

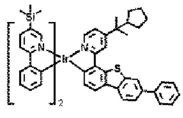
693

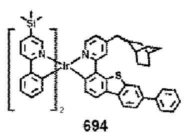
694

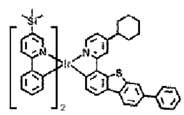
695

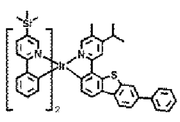
696

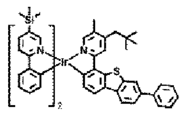
697

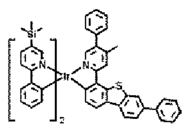
698

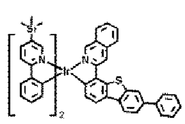
699

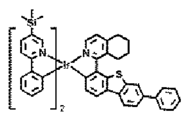
700

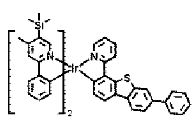
701

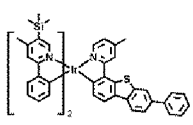
702

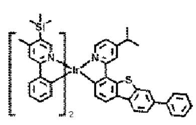
703

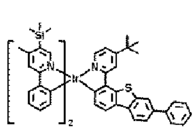
704

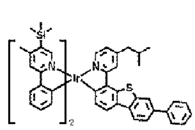
705

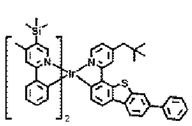
706

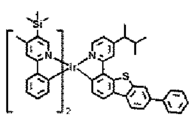
707

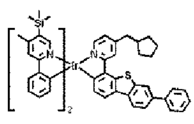
708

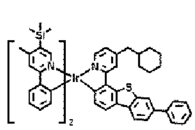
709

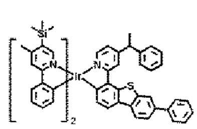
710

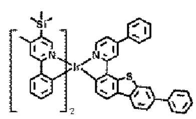
711

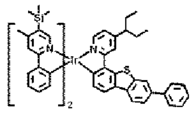
712

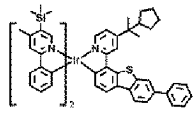
713

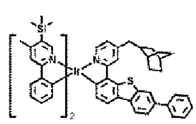
714

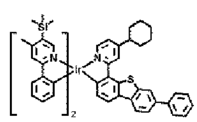
715

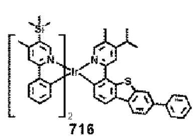
716

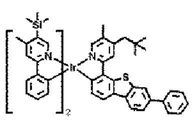
717

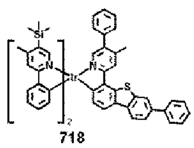
718

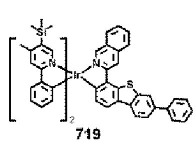
719

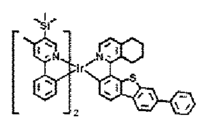
720

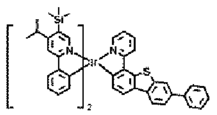 721 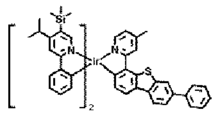 722 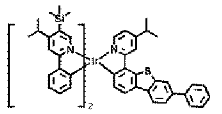 723 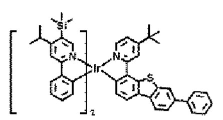 724 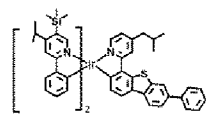 725

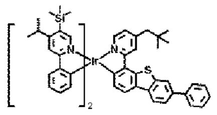 726 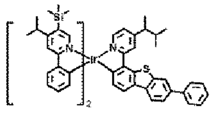 727 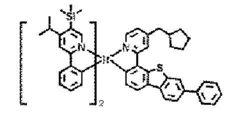 728 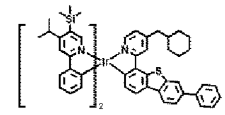 729 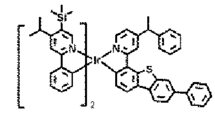 730

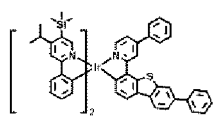 731 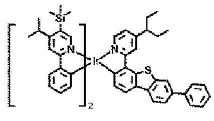 732 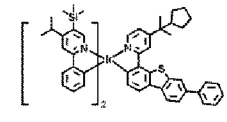 733 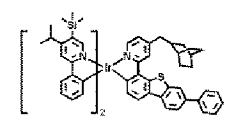 734 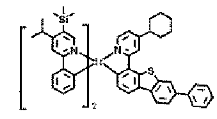 735

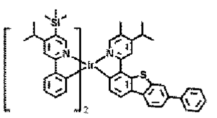 736 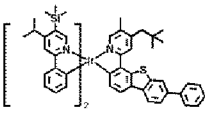 737 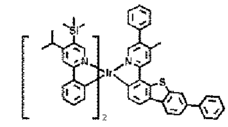 738 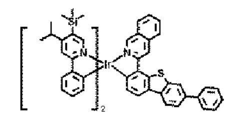 739 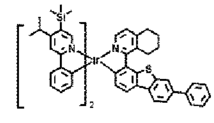 740

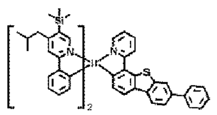 741 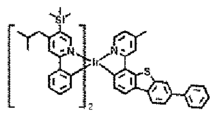 742 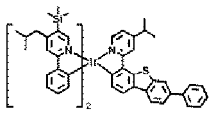 743 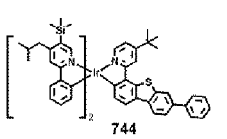 744 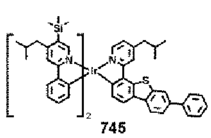 745

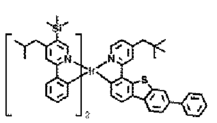 746 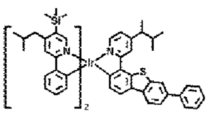 747 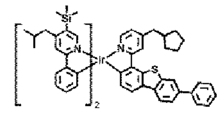 748 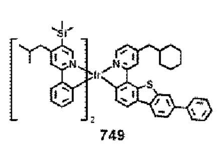 749 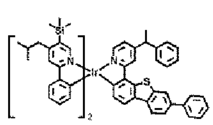 750

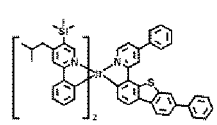 751 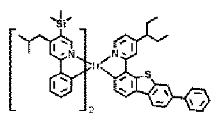 752 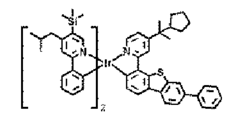 753 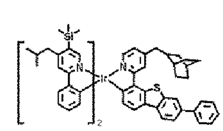 754 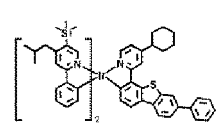 755

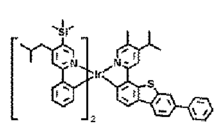 756 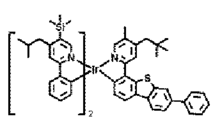 757 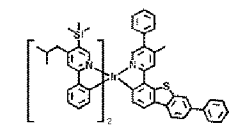 758 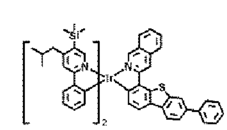 759 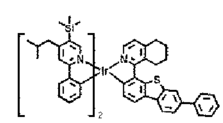 760

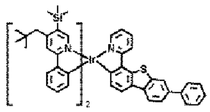
761
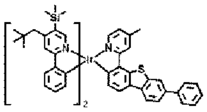
762
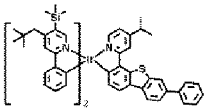
763
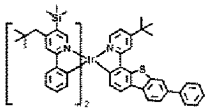
764
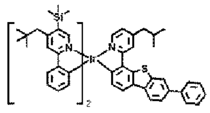
765
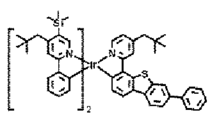
766
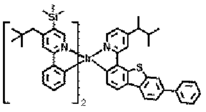
767
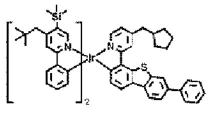
768
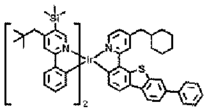
769
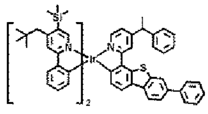
770
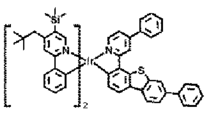
771
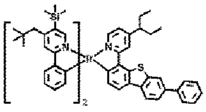
772
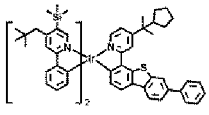
773
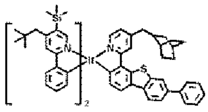
774
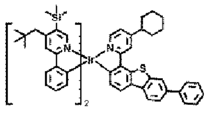
775
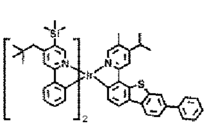
776
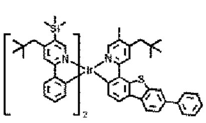
777
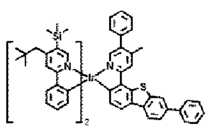
778
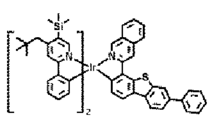
779
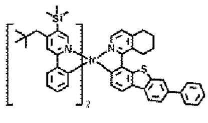
780
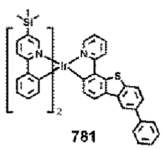
781
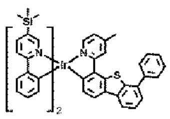
782
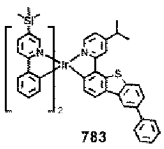
783
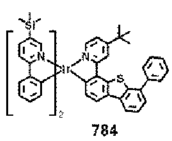
784
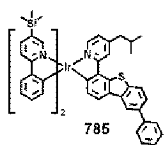
785
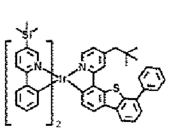
786
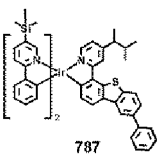
787
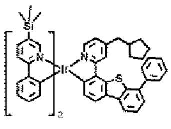
788
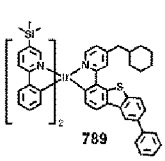
789
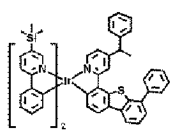
790
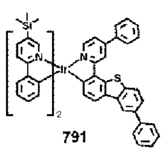
791
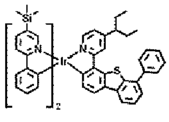
792
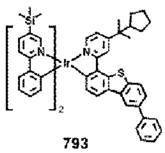
793
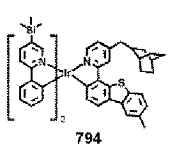
794
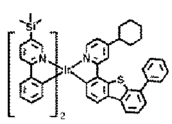
795
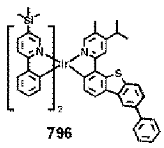
796
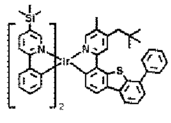
797
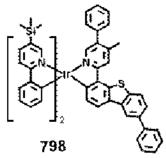
798
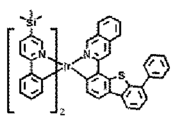
799
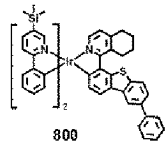
800

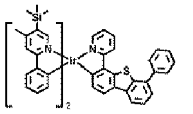
801
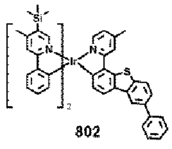
802
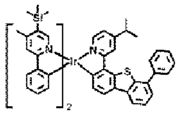
803
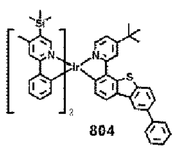
804
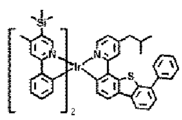
805

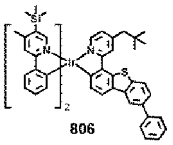
806
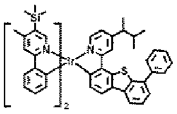
807
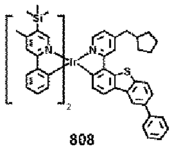
808
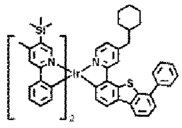
809
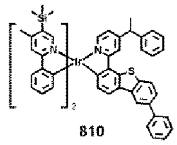
810

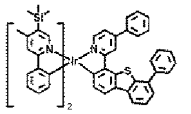
811
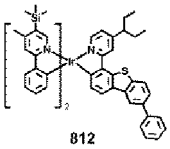
812
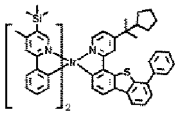
813
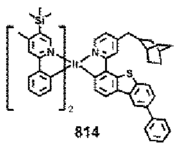
814
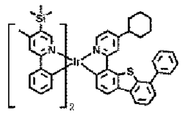
815

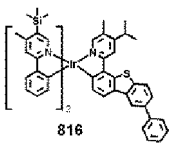
816
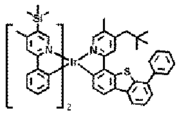
817
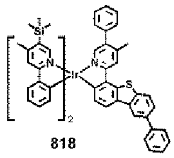
818
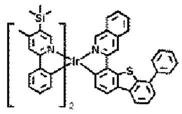
819
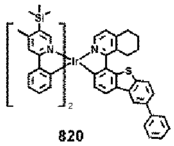
820

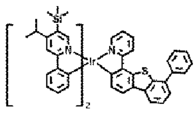
821
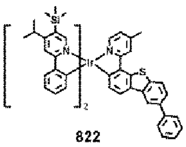
822
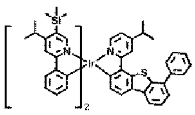
823
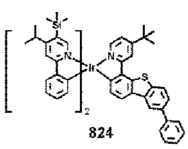
824
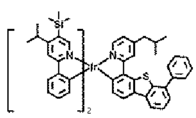
825

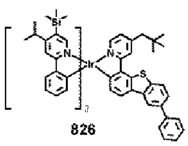
826
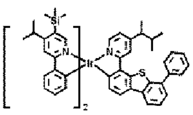
827
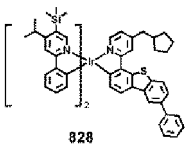
828
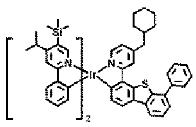
829
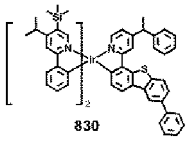
830

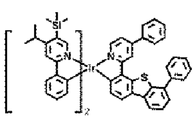
831
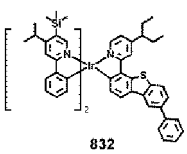
832
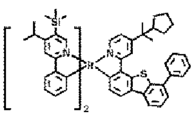
833
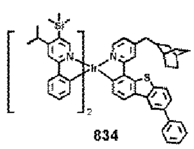
834
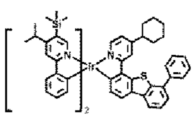
835

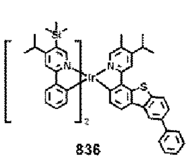
836
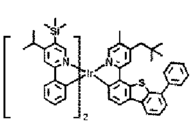
837
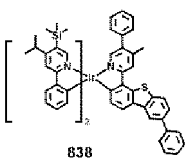
838
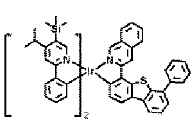
839
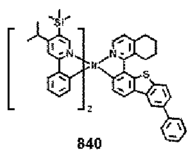
840

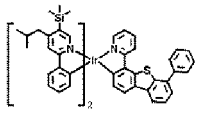
841
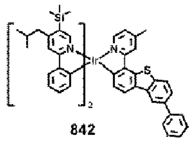
842
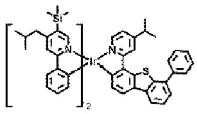
843
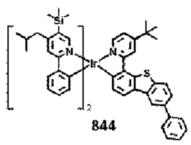
844
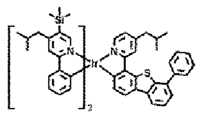
845

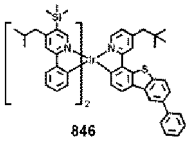
846
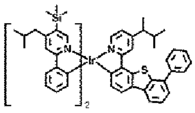
847
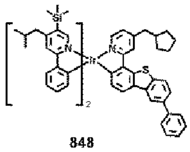
848
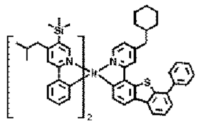
849
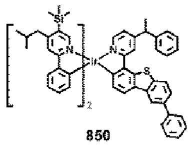
850

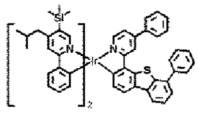
851
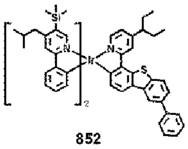
852
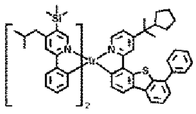
853
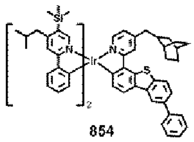
854
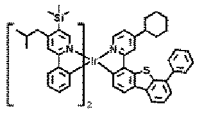
855

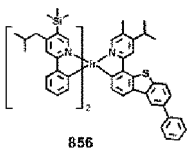
856
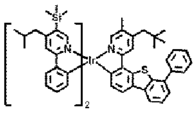
857
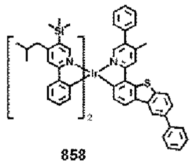
858
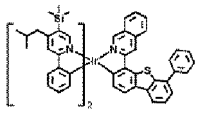
859
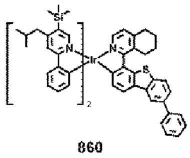
860

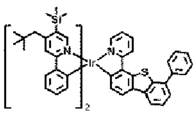
861
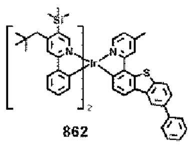
862
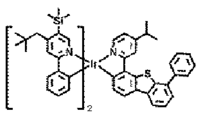
863
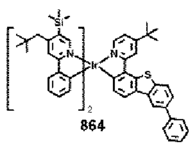
864
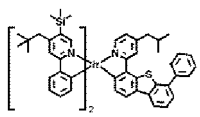
865

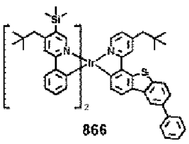
866
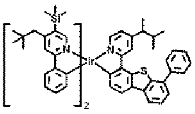
867
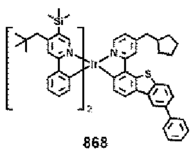
868
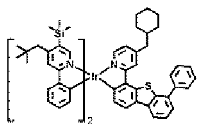
869
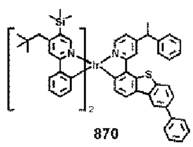
870

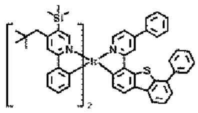
871
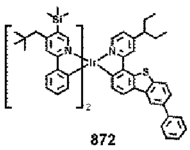
872
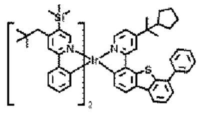
873
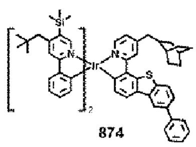
874
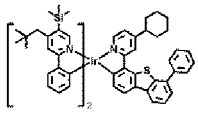
875

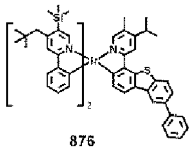
876
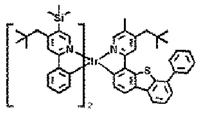
877
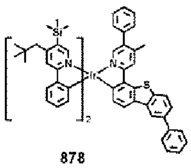
878
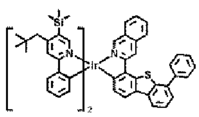
879
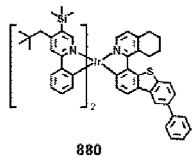
880

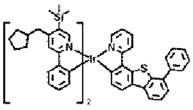
881
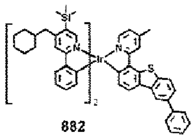
882
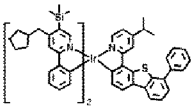
883
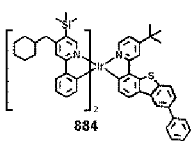
884
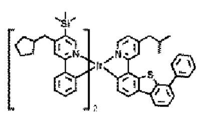
885

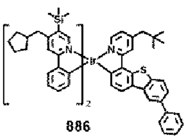
886
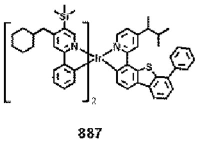
887
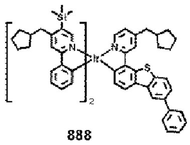
888
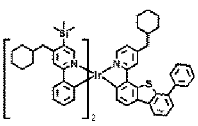
889
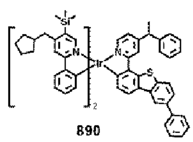
890

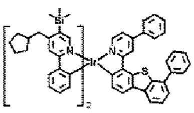
891
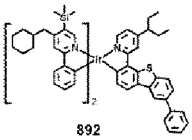
892
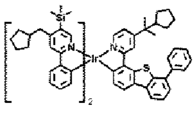
893
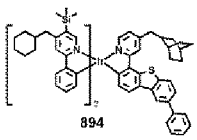
894
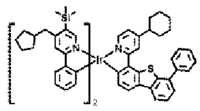
895

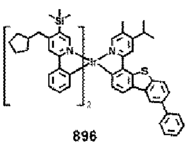
896
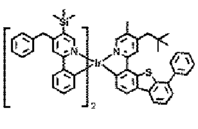
897
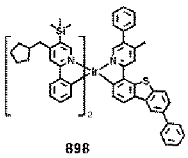
898
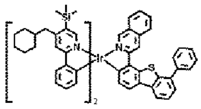
899
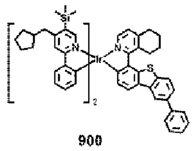
900

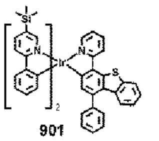
901
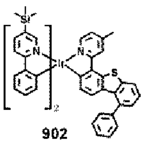
902
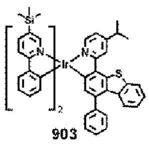
903
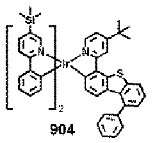
904
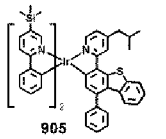
905

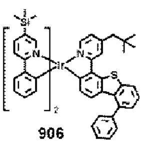
906
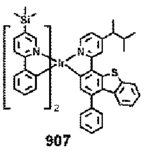
907
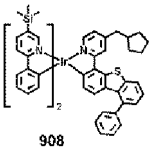
908
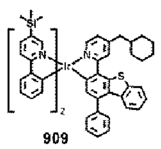
909
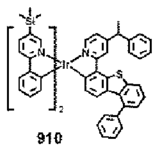
910

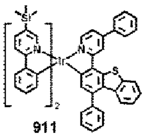
911
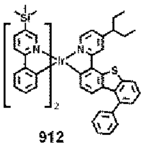
912
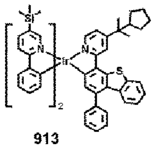
913
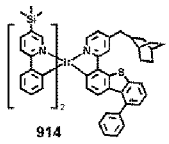
914
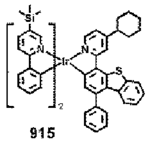
915

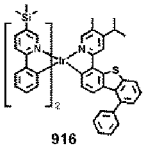
916
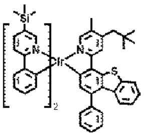
917
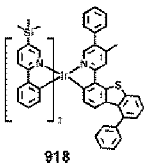
918
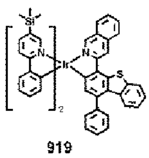
919
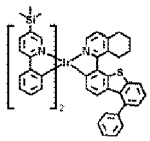
920

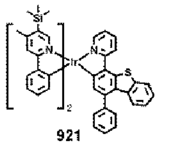
921
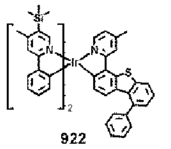
922
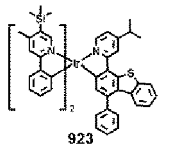
923
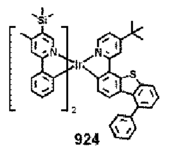
924
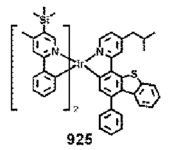
925

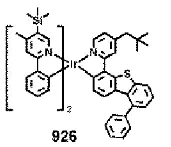
926
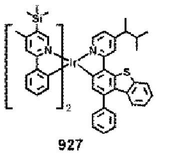
927
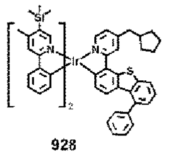
928
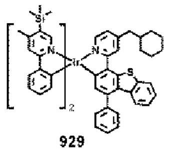
929
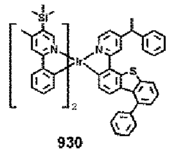
930

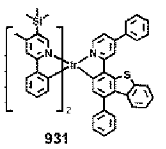
931
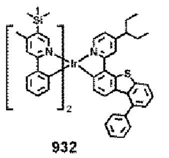
932
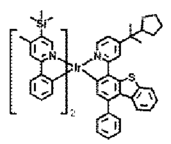
933
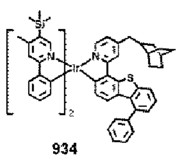
934
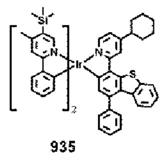
935

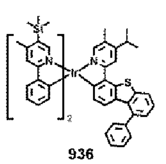
936
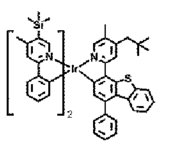
937
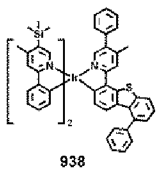
938
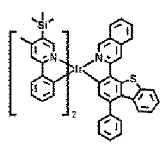
939
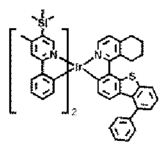
940

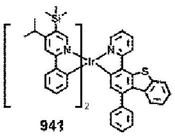
941
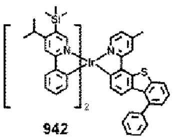
942
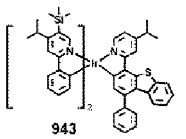
943
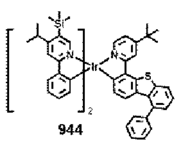
944
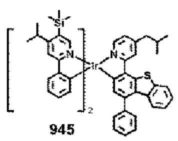
945

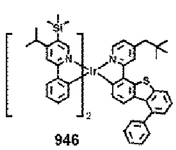
946
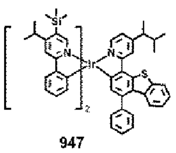
947
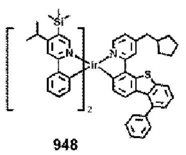
948
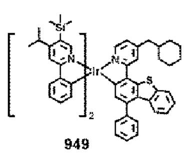
949
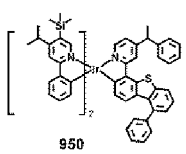
950

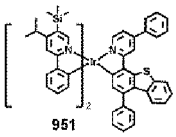
951
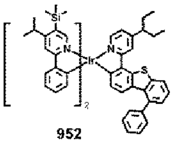
952
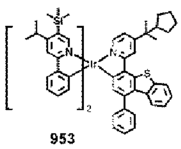
953
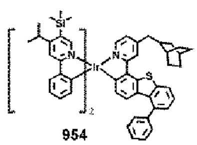
954
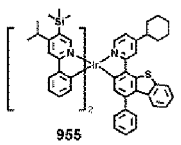
955

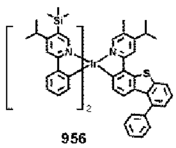
956
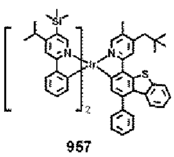
957
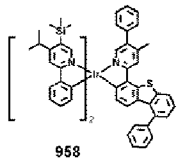
958
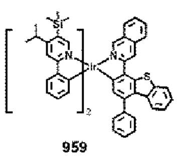
959
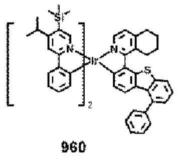
960

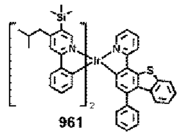
961
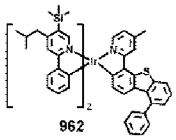
962
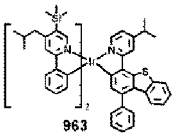
963
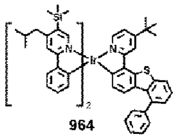
964
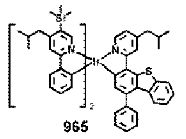
965

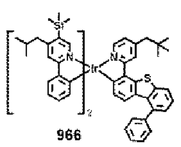
966
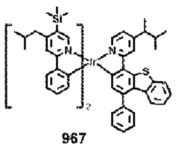
967
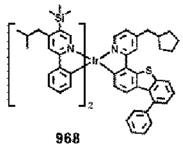
968
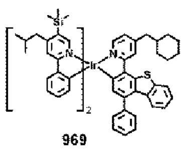
969
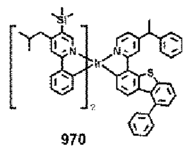
970

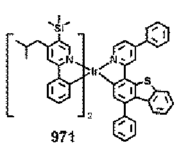
971
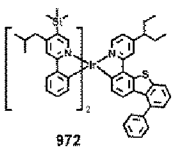
972
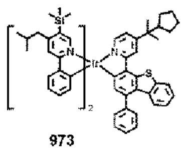
973
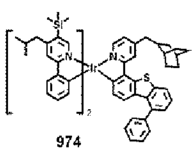
974
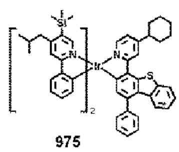
975

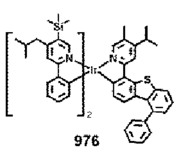
976
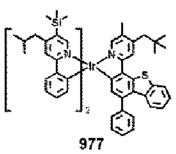
977
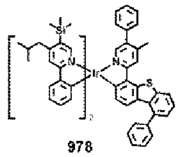
978
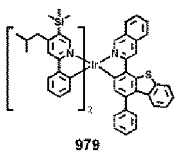
979
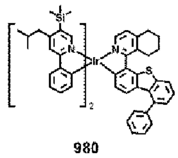
980

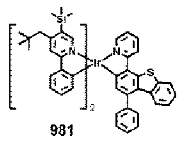
981
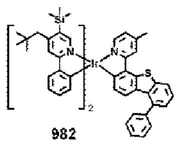
982
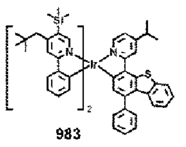
983
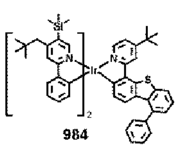
984
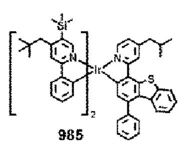
985

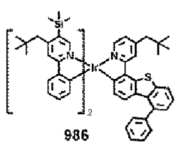
986
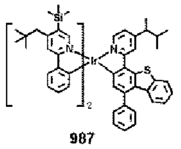
987
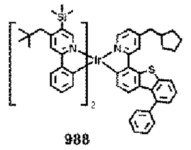
988
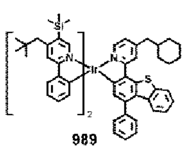
989
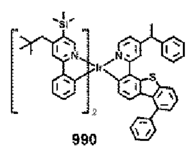
990

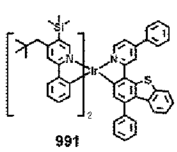
991
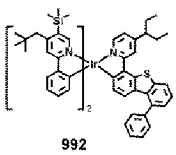
992
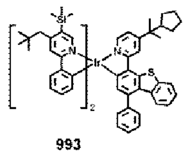
993
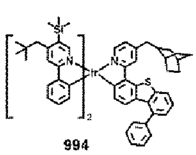
994
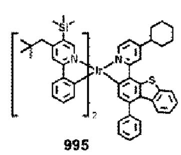
995

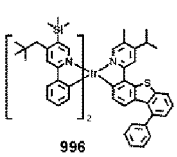
996
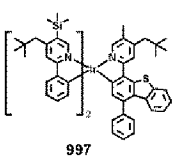
997
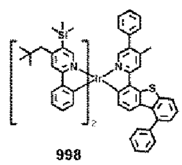
998
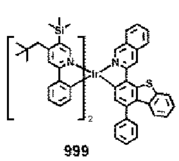
999
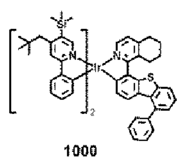
1000

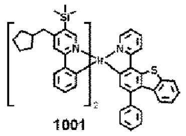
1001

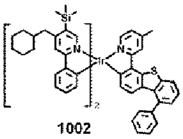
1002

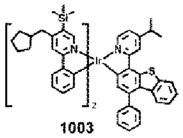
1003

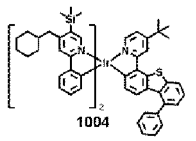
1004

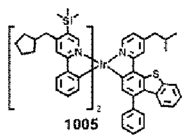
1005

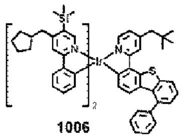
1006

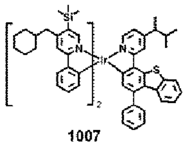
1007

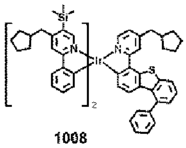
1008

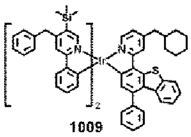
1009

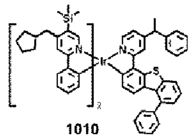
1010

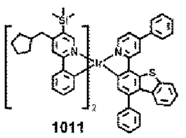
1011

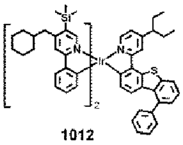
1012

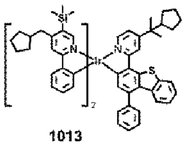
1013

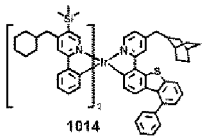
1014

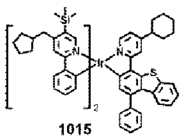
1015

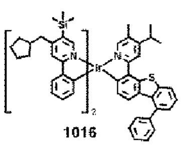
1016

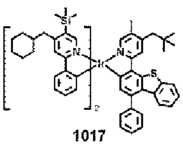
1017

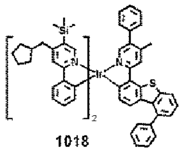
1018

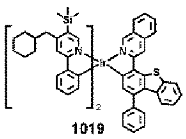
1019

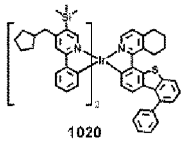
1020

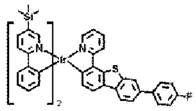
1021

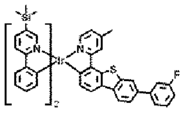
1022

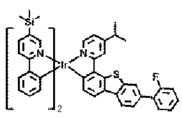
1023

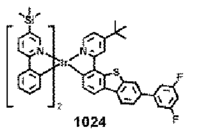
1024

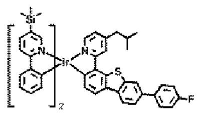
1025

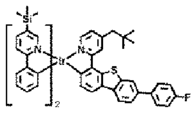
1026

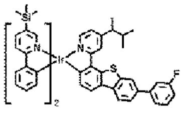
1027

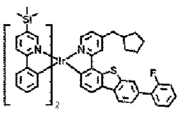
1028

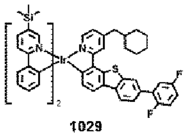
1029

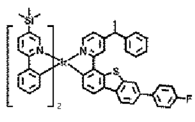
1030

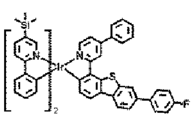
1031

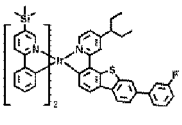
1032

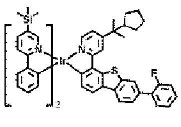
1033

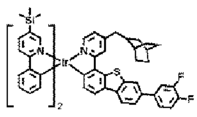
1034

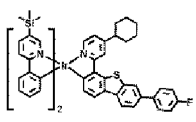
1035

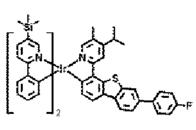
1036

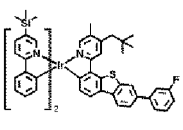
1037

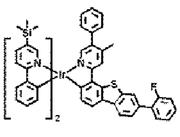
1038

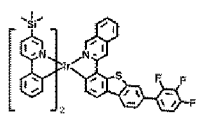
1039

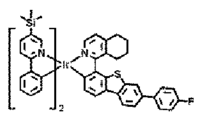
1040

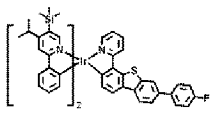
1041
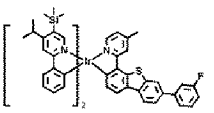
1042
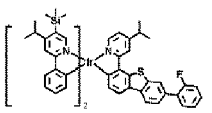
1043
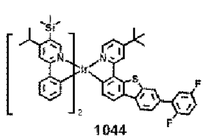
1044
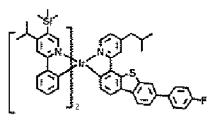
1045
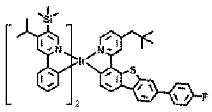
1046
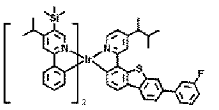
1047
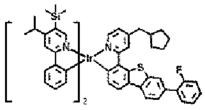
1048
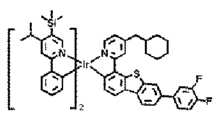
1049
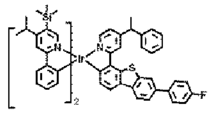
1050
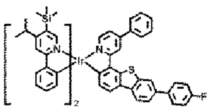
1051
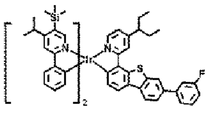
1052
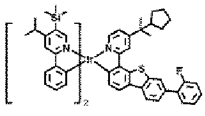
1053
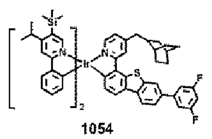
1054
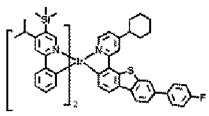
1055
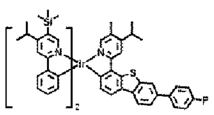
1056
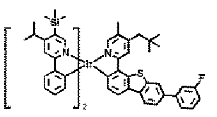
1057
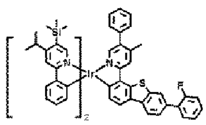
1058
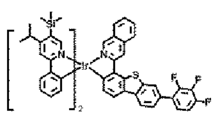
1059
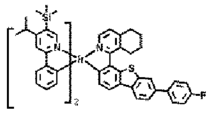
1060
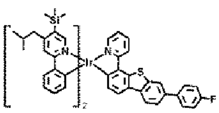
1061
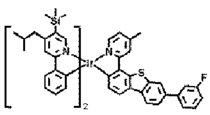
1062
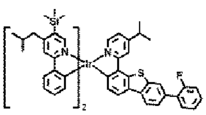
1063
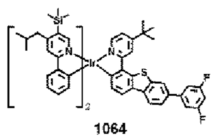
1064
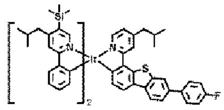
1065
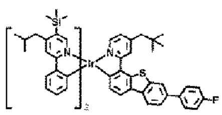
1066
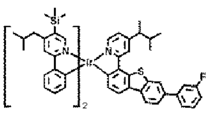
1067
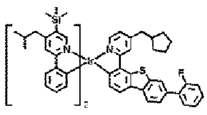
1068
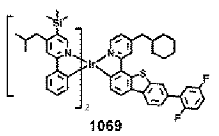
1069
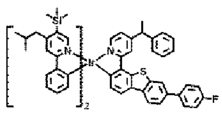
1070
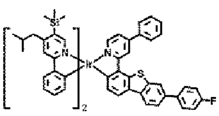
1071
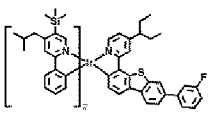
1072
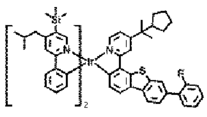
1073
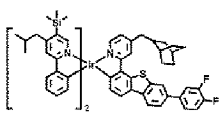
1074
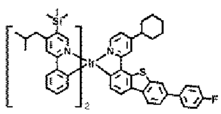
1075
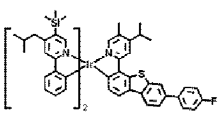
1076
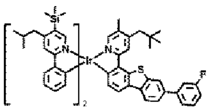
1077
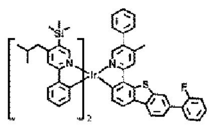
1078
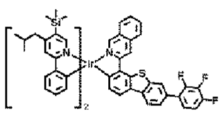
1079
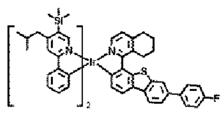
1080

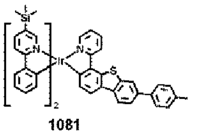
1081
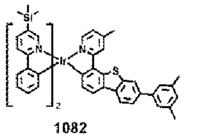
1082
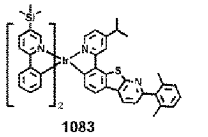
1083
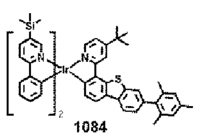
1084
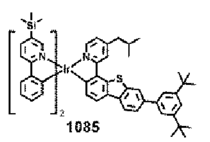
1085

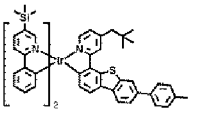
1086
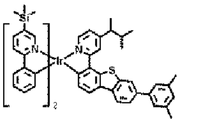
1087
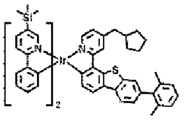
1088
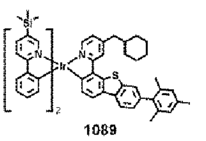
1089
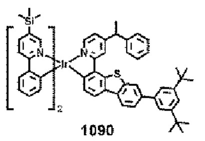
1090

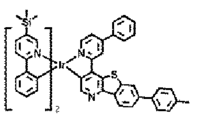
1091
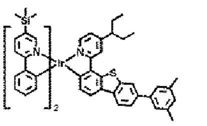
1092
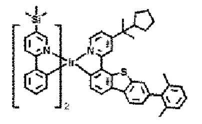
1093
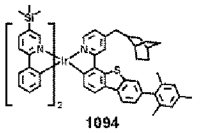
1094
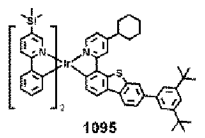
1095

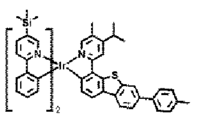
1096
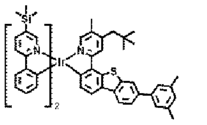
1097
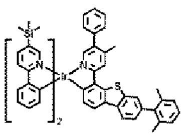
1098
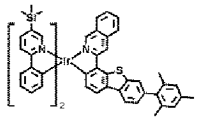
1099
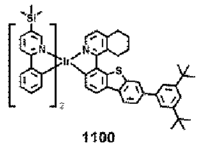
1100

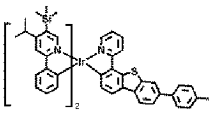
1101
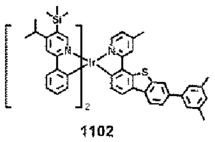
1102
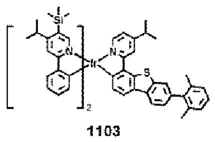
1103
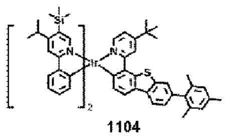
1104
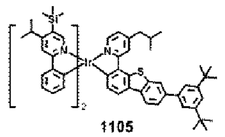
1105

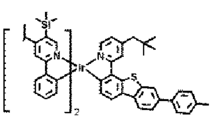
1106
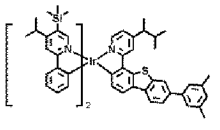
1107
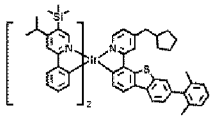
1108
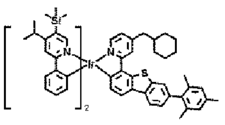
1109
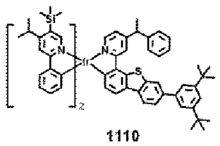
1110

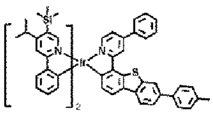
1111
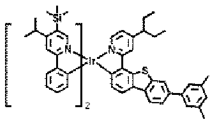
1112
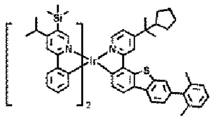
1113
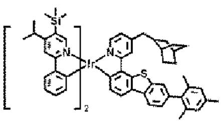
1114
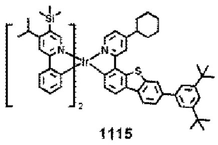
1115

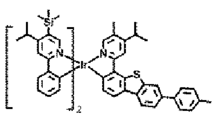
1116
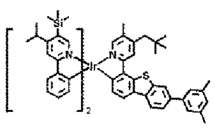
1117
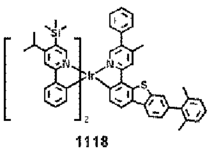
1118
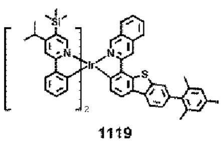
1119
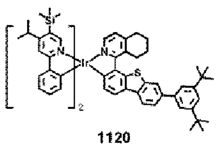
1120

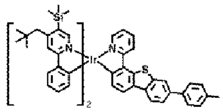

1121

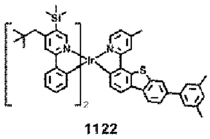

1122

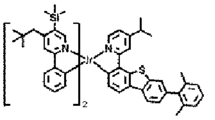

1123

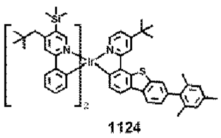

1124

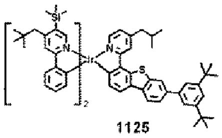

1125

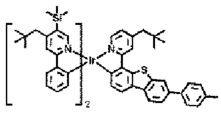

1126

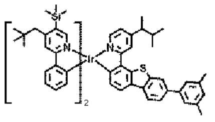

1127

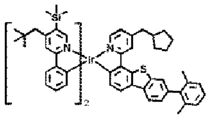

1128

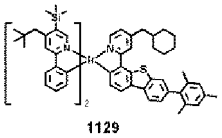

1129

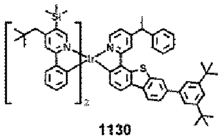

1130

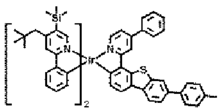

1131

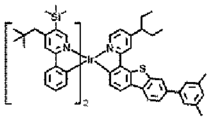

1132

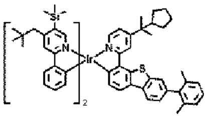

1133

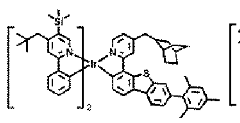

1134

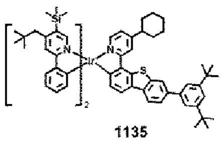

1135

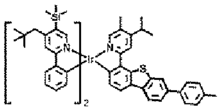

1136

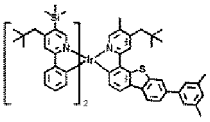

1137

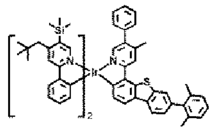

1138

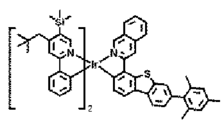

1139

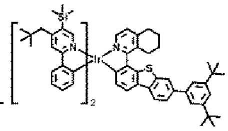

1140

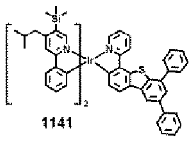

1141

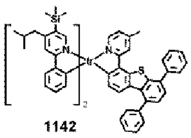

1142

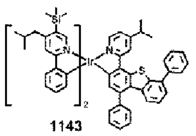

1143

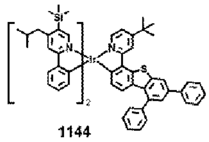

1144

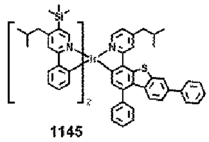

1145

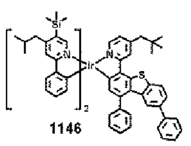

1146

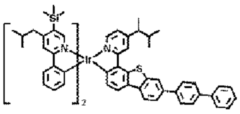

1147

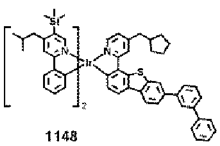

1148

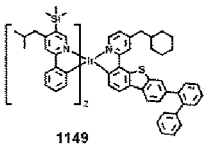

1149

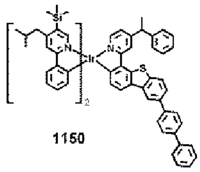

1150

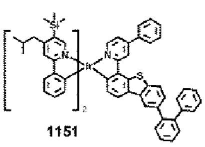

1151

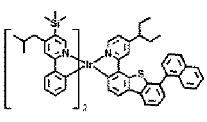

1152

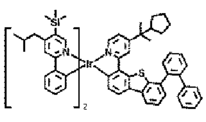

1153

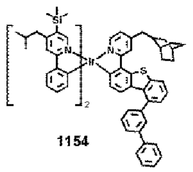

1154

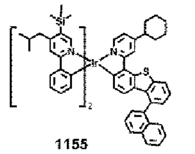

1155

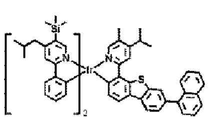

1156

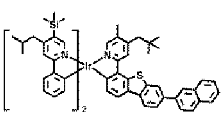

1157

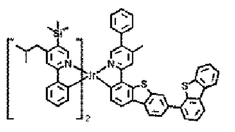

1158

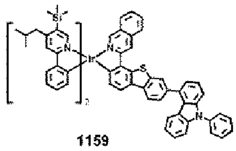

1159

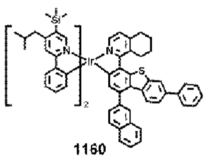

1160

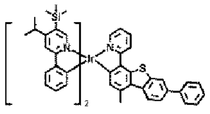
1161
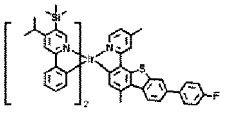
1162
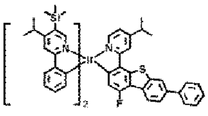
1163
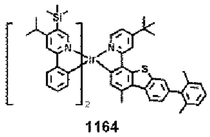
1164
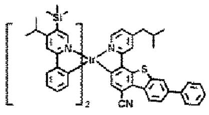
1165

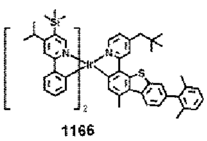
1166
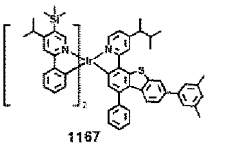
1167
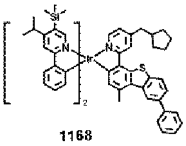
1168
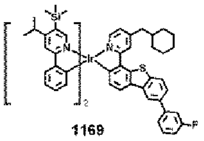
1169
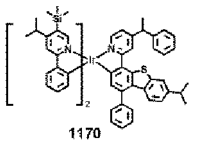
1170

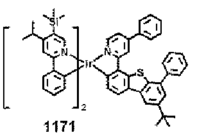
1171
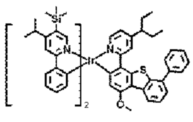
1172
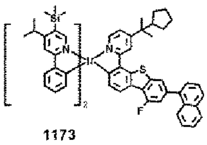
1173
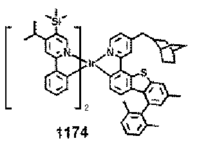
1174
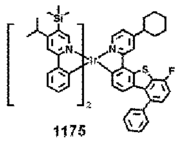
1175

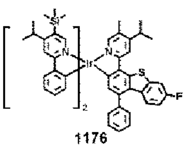
1176
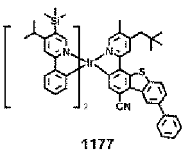
1177
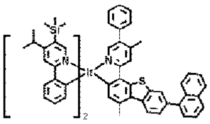
1178
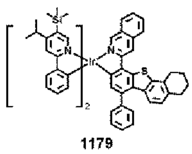
1179
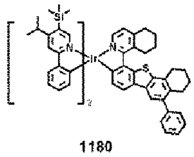
1180

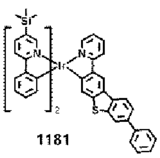
1181
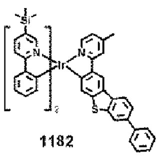
1182
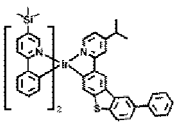
1183
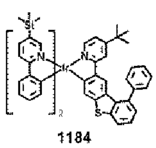
1184
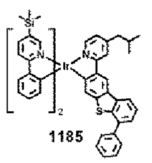
1185

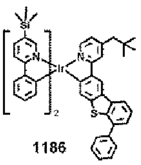
1186
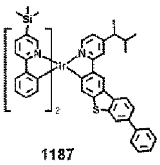
1187
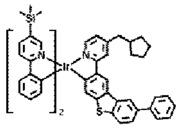
1188
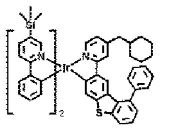
1189
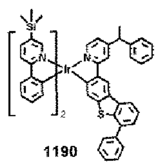
1190

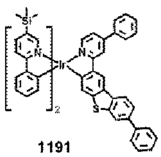
1191
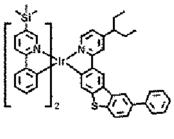
1192
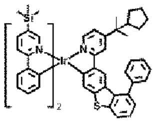
1193
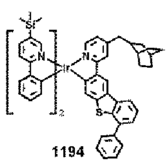
1194
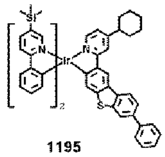
1195

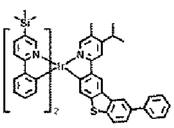
1196
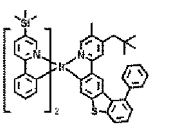
1197
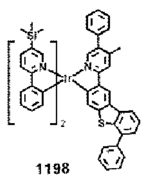
1198
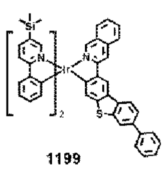
1199
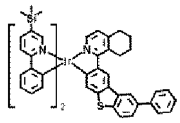
1200

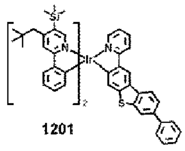
1201

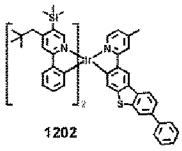
1202

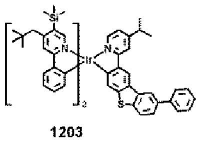
1203

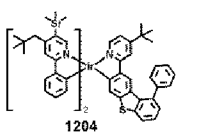
1204

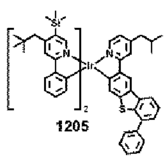
1205

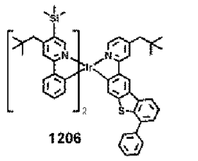
1206

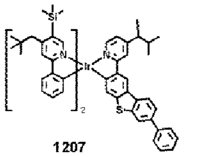
1207

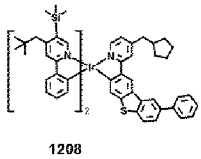
1208

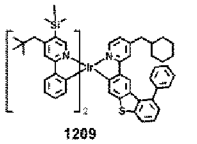
1209

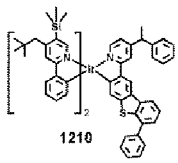
1210

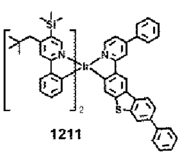
1211

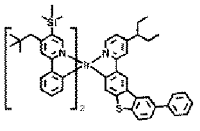
1212

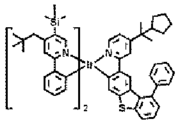
1213

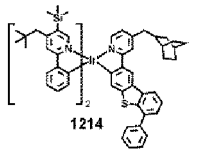
1214

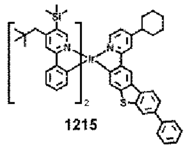
1215

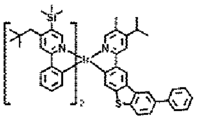
1216

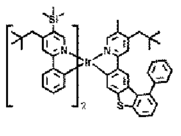
1217

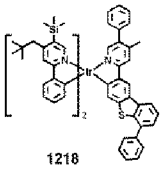
1218

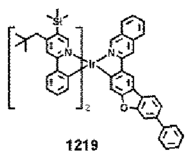
1219

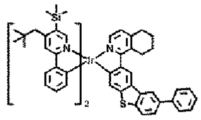
1220

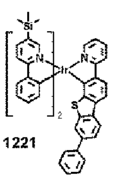
1221

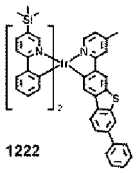
1222

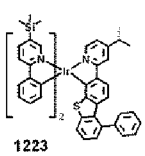
1223

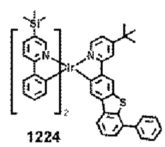
1224

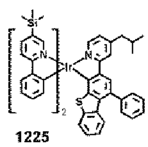
1225

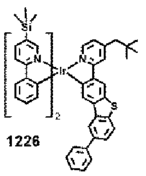
1226

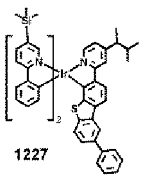
1227

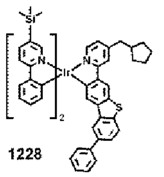
1228

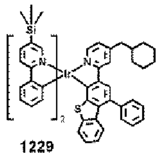
1229

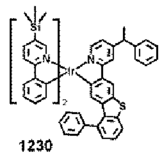
1230

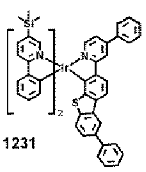
1231

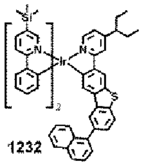
1232

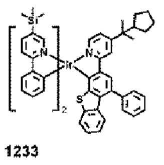
1233

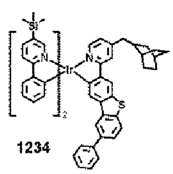
1234

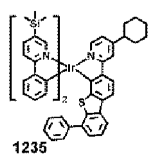
1235

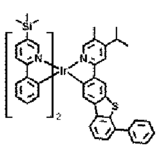
1236

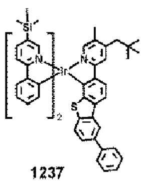
1237

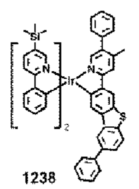
1238

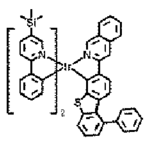
1239

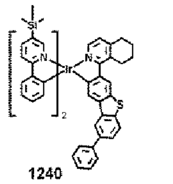
1240

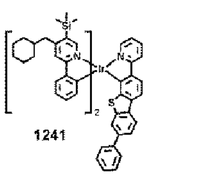
1241
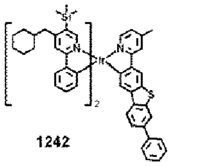
1242
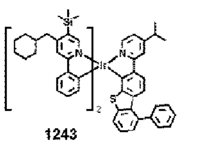
1243
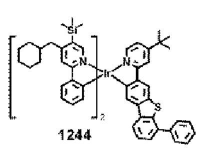
1244
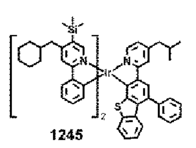
1245
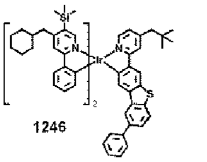
1246
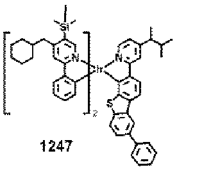
1247
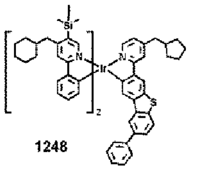
1248
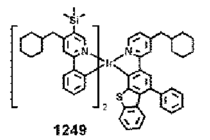
1249
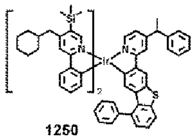
1250
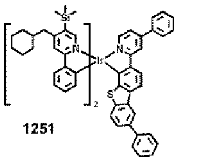
1251
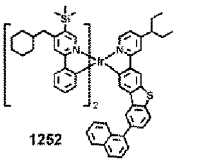
1252
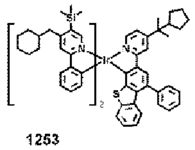
1253
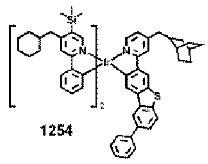
1254
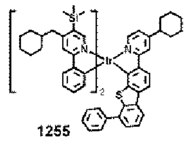
1255
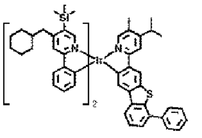
1256
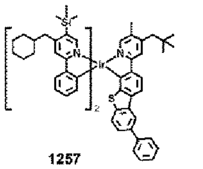
1257
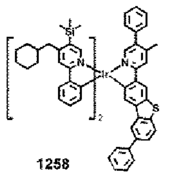
1258
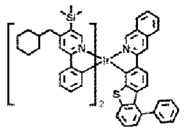
1259
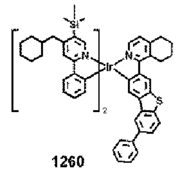
1260
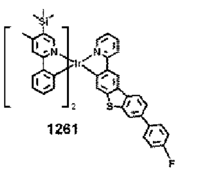
1261
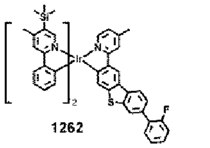
1262
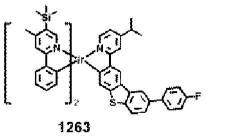
1263
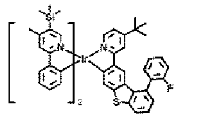
1264
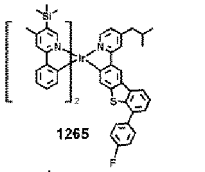
1265
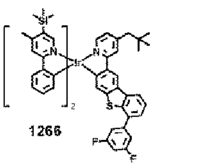
1266
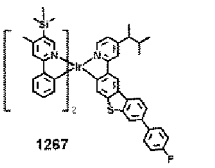
1267
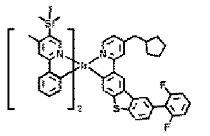
1268
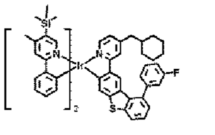
1269
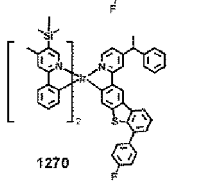
1270
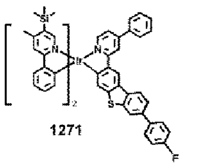
1271
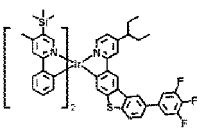
1272
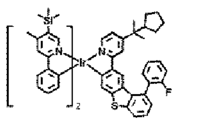
1273
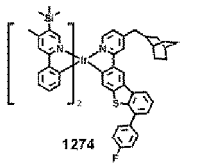
1274
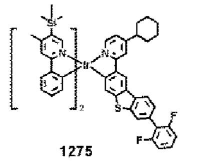
1275
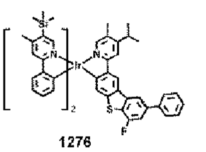
1276
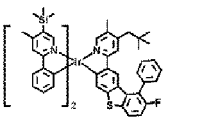
1277
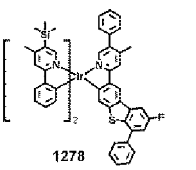
1278
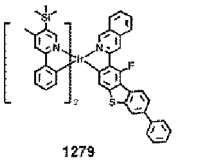
1279
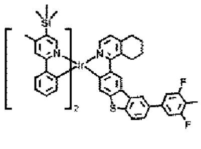
1280

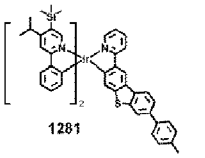
1281
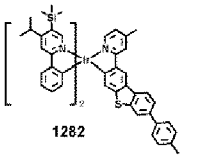
1282
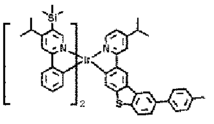
1283
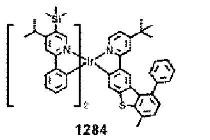
1284
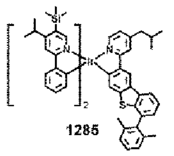
1285
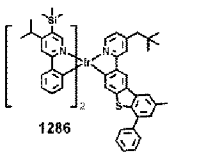
1286
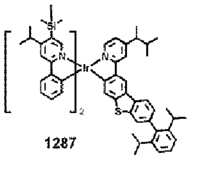
1287
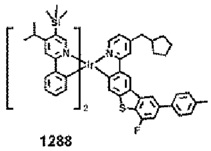
1288
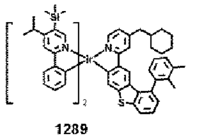
1289
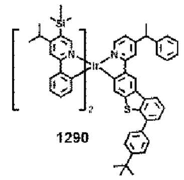
1290
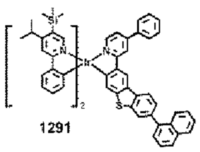
1291
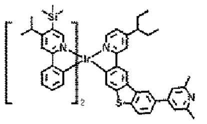
1292
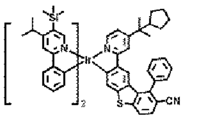
1293
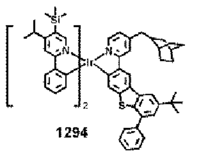
1294
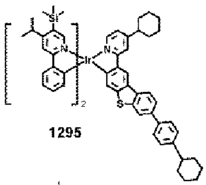
1295
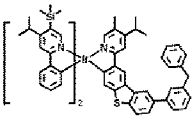
1296
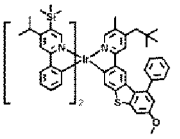
1297
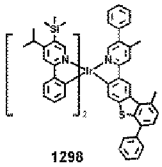
1298
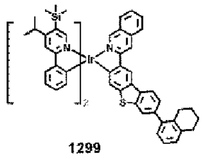
1299
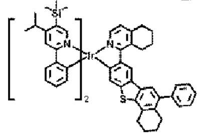
1300
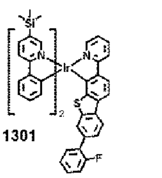
1301
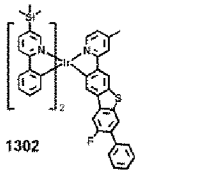
1302
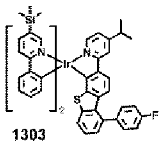
1303
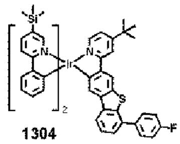
1304
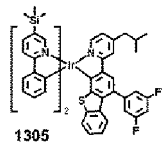
1305
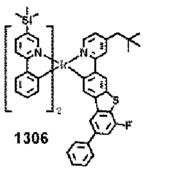
1306
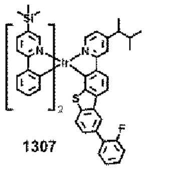
1307
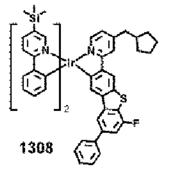
1308
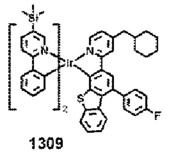
1309
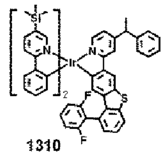
1310
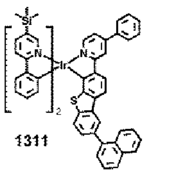
1311
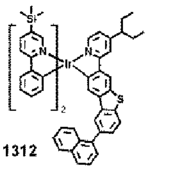
1312
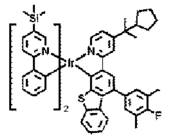
1313
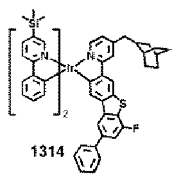
1314
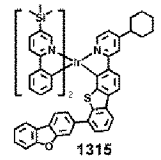
1315
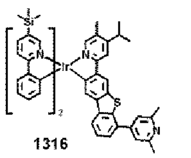
1316
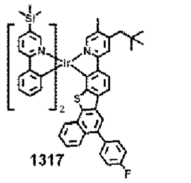
1317
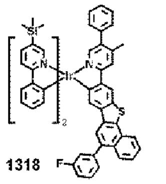
1318
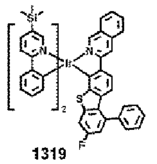
1319
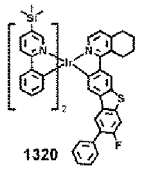
1320

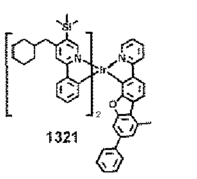
1321
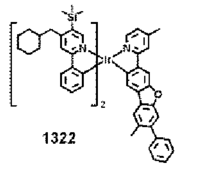
1322
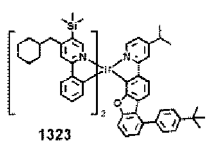
1323
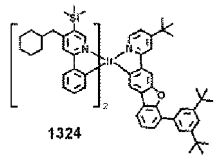
1324
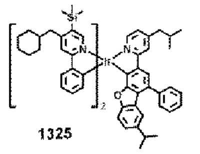
1325
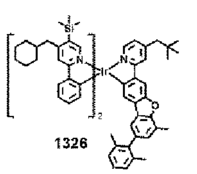
1326
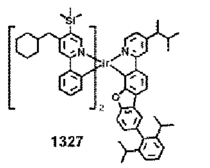
1327
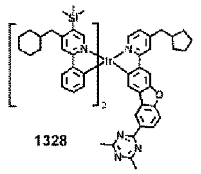
1328
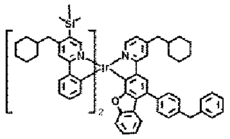
1329
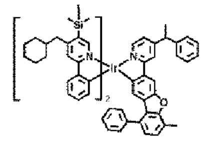
1330
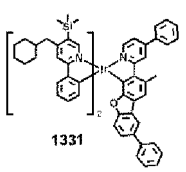
1331
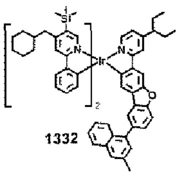
1332
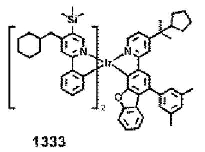
1333
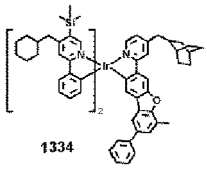
1334
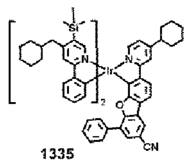
1335
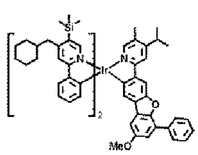
1336
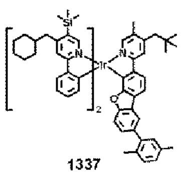
1337
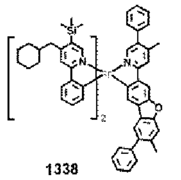
1338
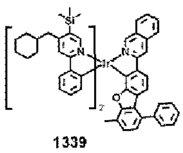
1339
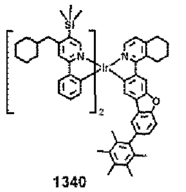
1340
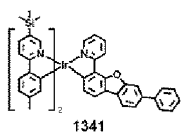
1341
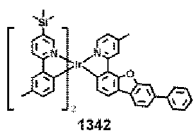
1342
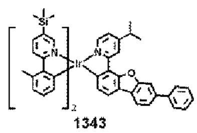
1343
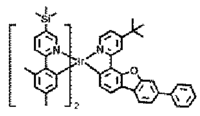
1344
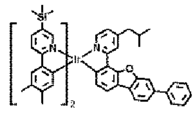
1345
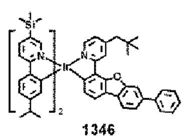
1346
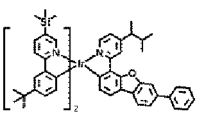
1347
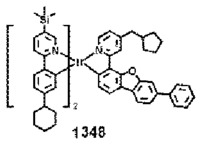
1348
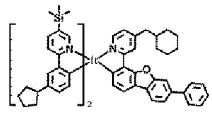
1349
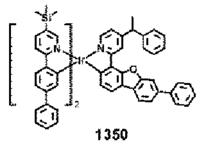
1350
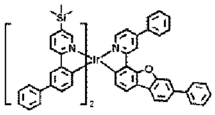
1351
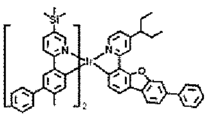
1352
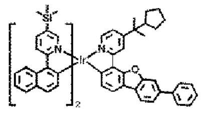
1353
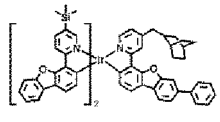
1354
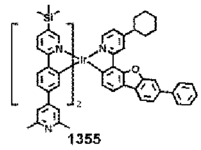
1355
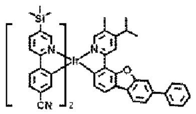
1356
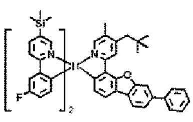
1357
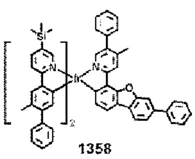
1358
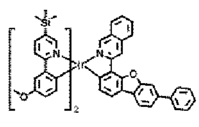
1359
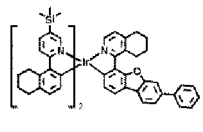
1360

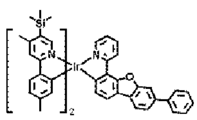
1361
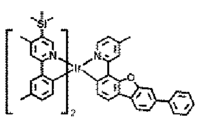
1362
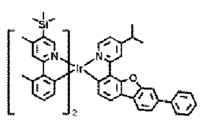
1363
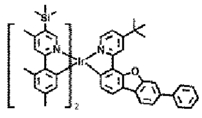
1364
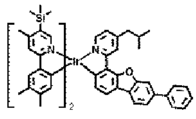
1365

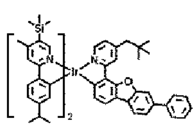
1366
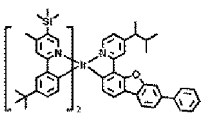
1367
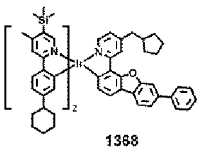
1368
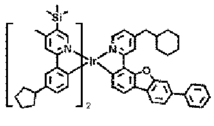
1369
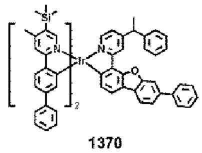
1370

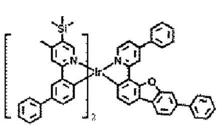
1371
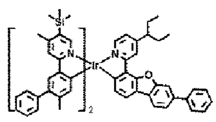
1372
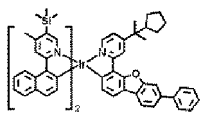
1373
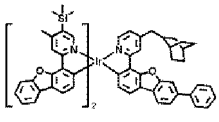
1374
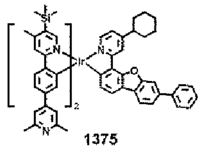
1375

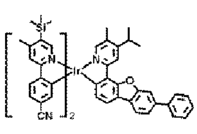
1376
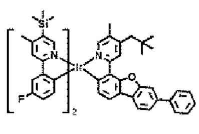
1377
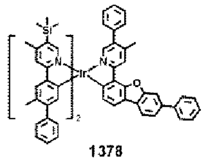
1378
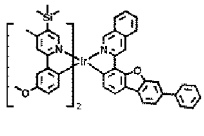
1379
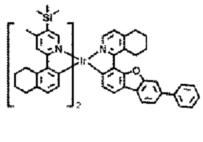
1380

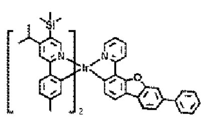
1381
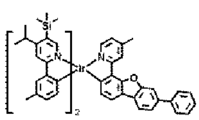
1382
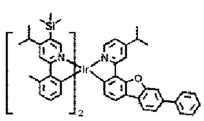
1383
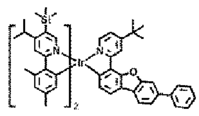
1384
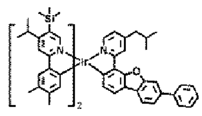
1385

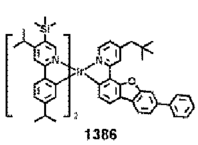
1386
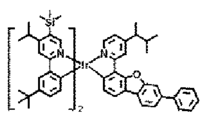
1387
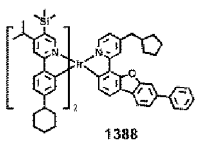
1388
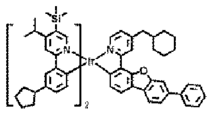
1389
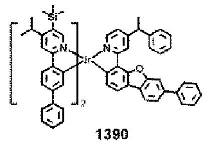
1390

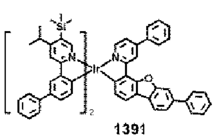
1391
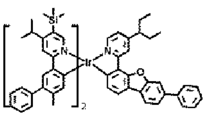
1392
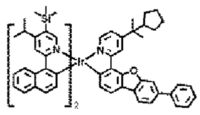
1393
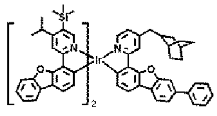
1394
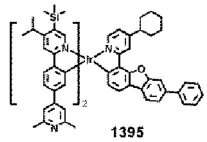
1395

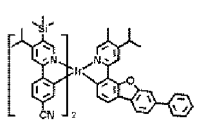
1396
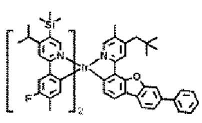
1397
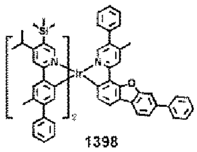
1398
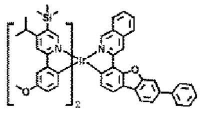
1399
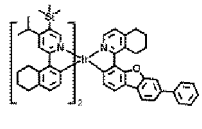
1400

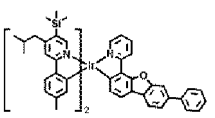
1401
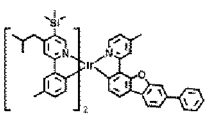
1402
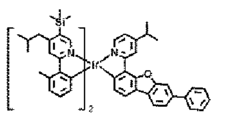
1403
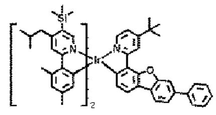
1404
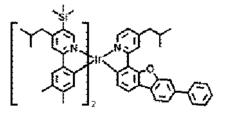
1405

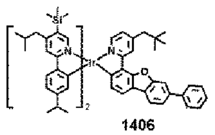
1406
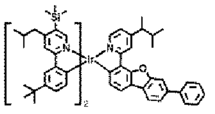
1407
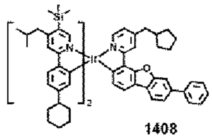
1408
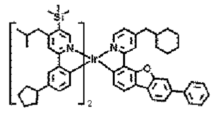
1409
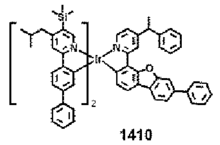
1410

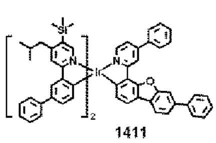
1411
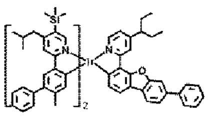
1412
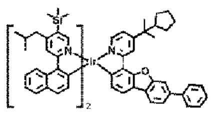
1413
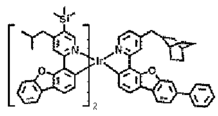
1414
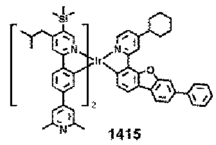
1415

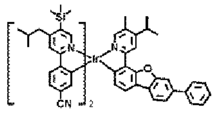
1416
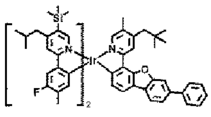
1417
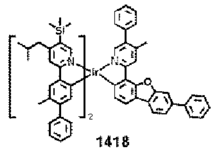
1418
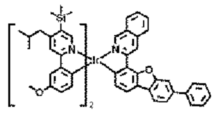
1419
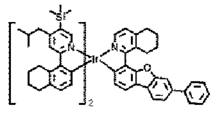
1420

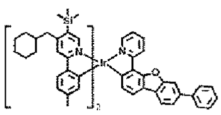
1421
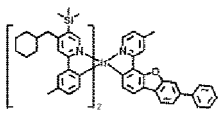
1422
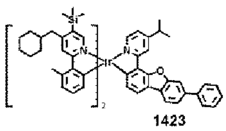
1423
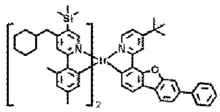
1424
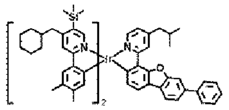
1425

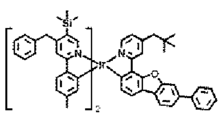
1426
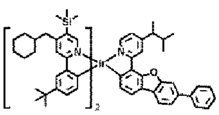
1427
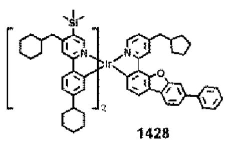
1428
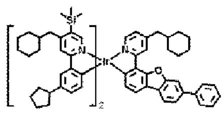
1429
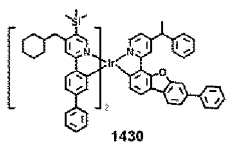
1430

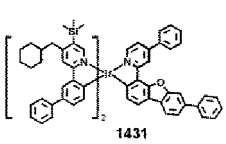
1431
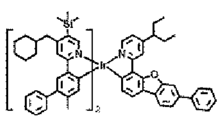
1432
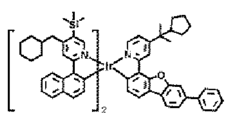
1433
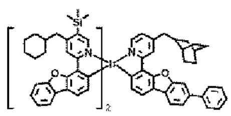
1434
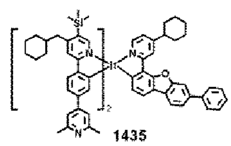
1435

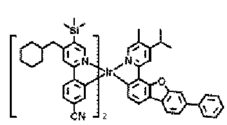
1436
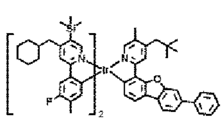
1437
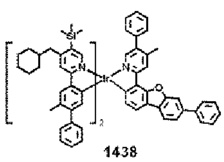
1438
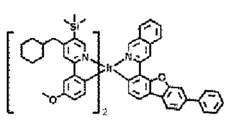
1439
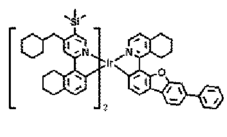
1440

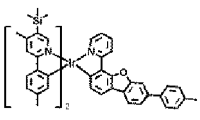
1441
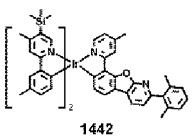
1442
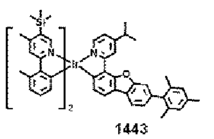
1443
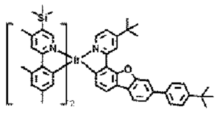
1444
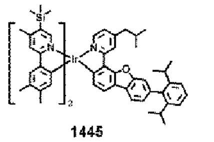
1445
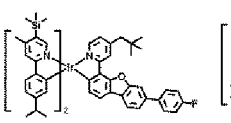
1446
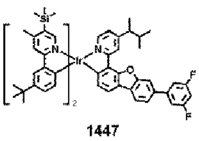
1447
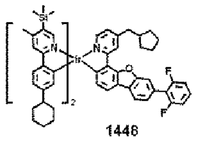
1448
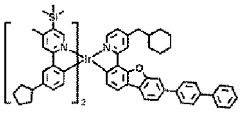
1449
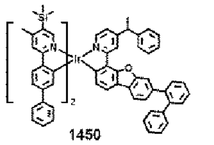
1450
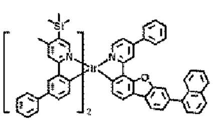
1451
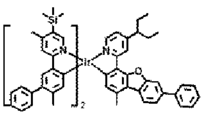
1452
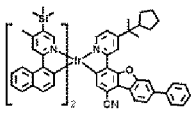
1453
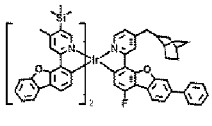
1454
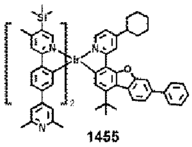
1455
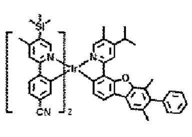
1456
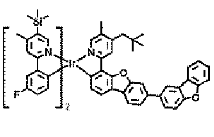
1457
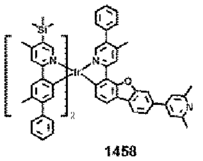
1458
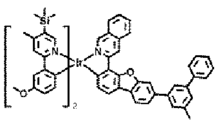
1459
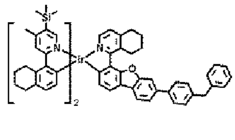
1460
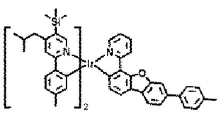
1461
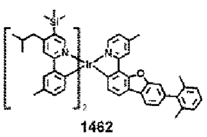
1462
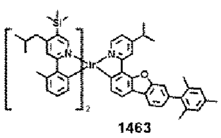
1463
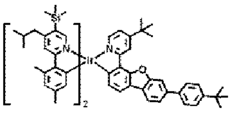
1464
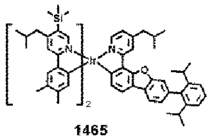
1465
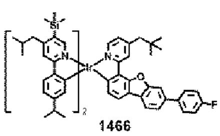
1466
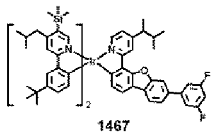
1467
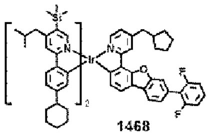
1468
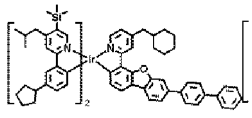
1469
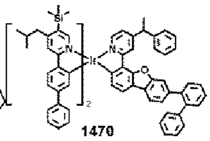
1470
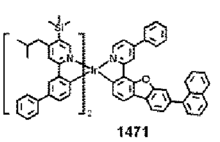
1471
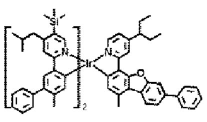
1472
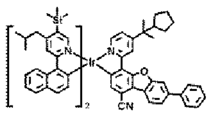
1473
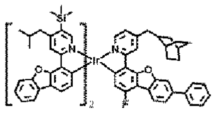
1474
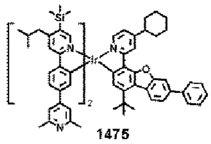
1475
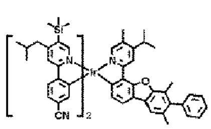
1476
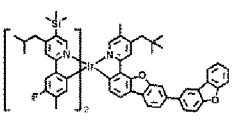
1477
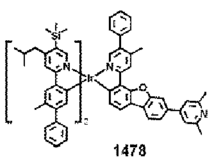
1478
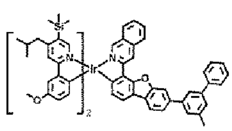
1479
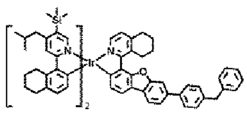
1480

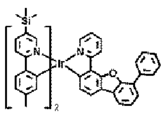
1481

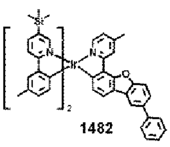
1482

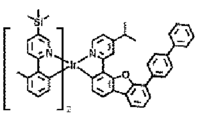
1483

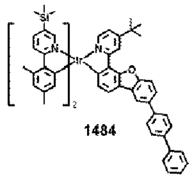
1484

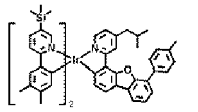
1485

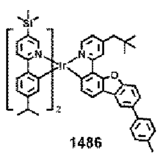
1486

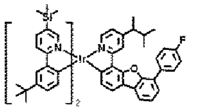
1487

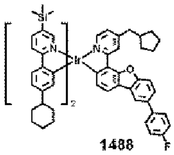
1488

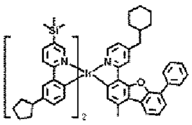
1489

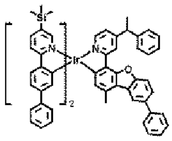
1490

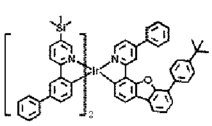
1491

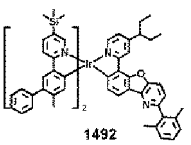
1492

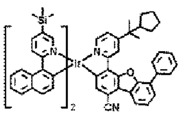
1493

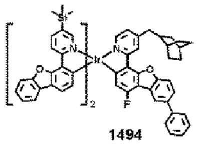
1494

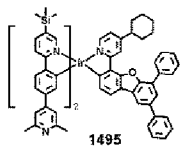
1495

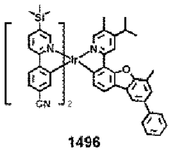
1496

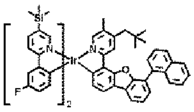
1497

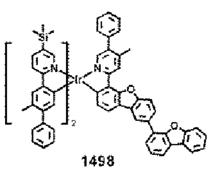
1498

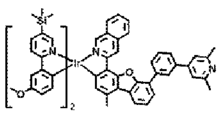
1499

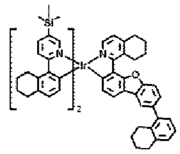
1500

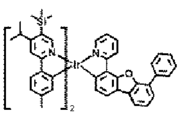
1501

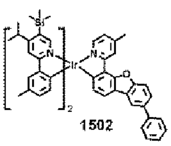
1502

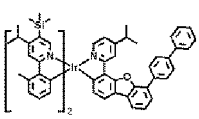
1503

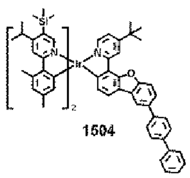
1504

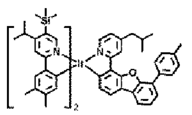
1505

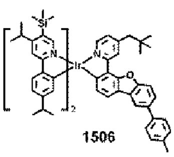
1506

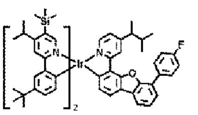
1507

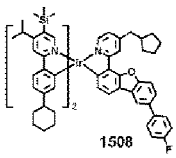
1508

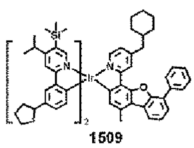
1509

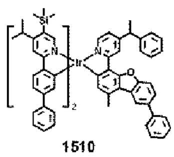
1510

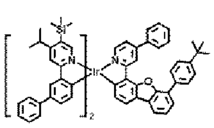
1511

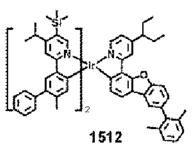
1512

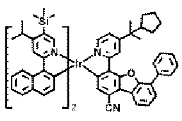
1513

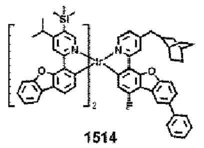
1514

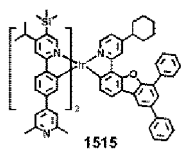
1515

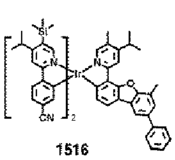
1516

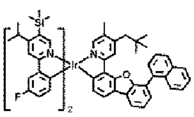
1517

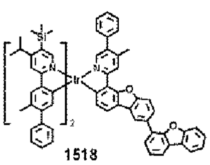
1518

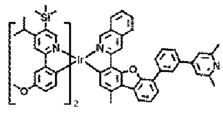
1519

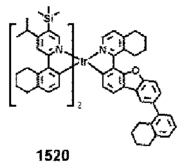
1520

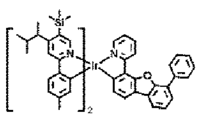
1521

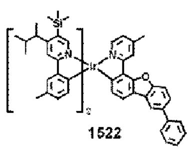
1522

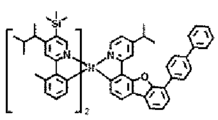
1523

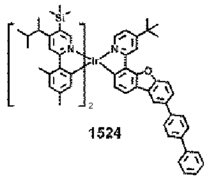
1524

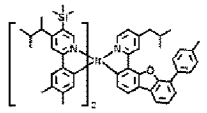
1525

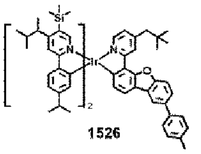
1526

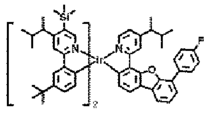
1527

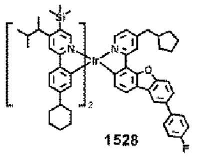
1528

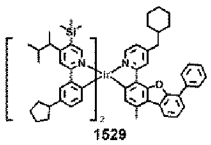
1529

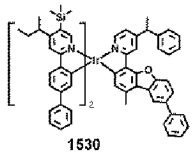
1530

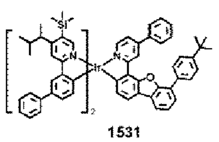
1531

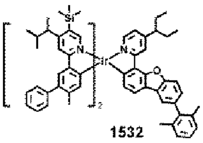
1532

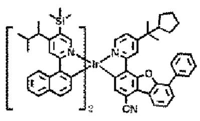
1533

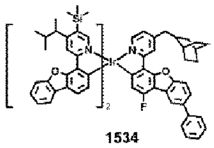
1534

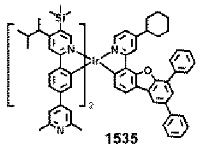
1535

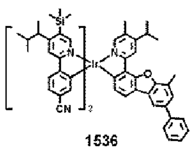
1536

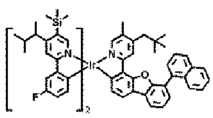
1537

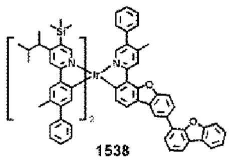
1538

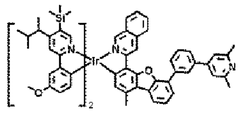
1539

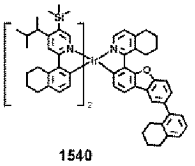
1540

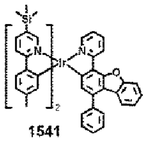
1541

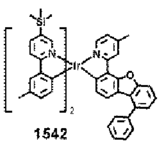
1542

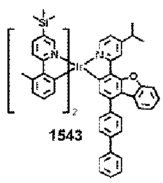
1543

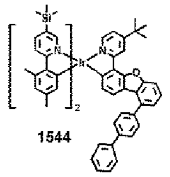
1544

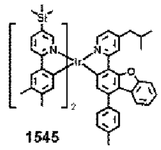
1545

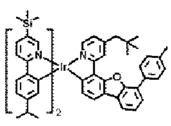
1546

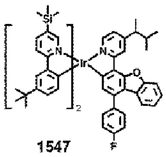
1547

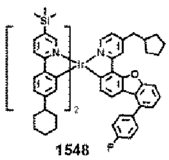
1548

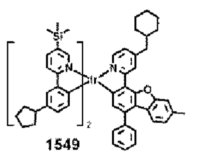
1549

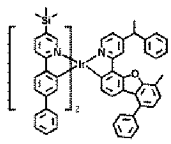
1550

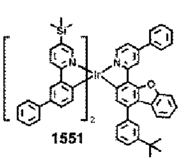
1551

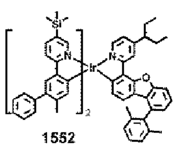
1552

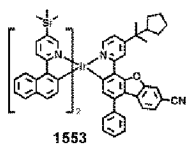
1553

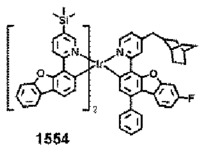
1554

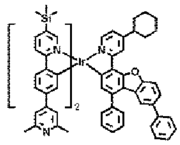
1555

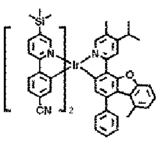
1556

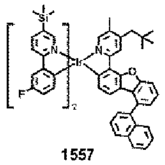
1557

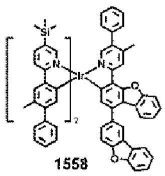
1558

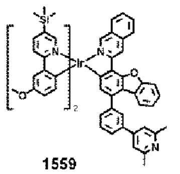
1559

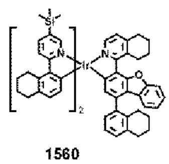
1560

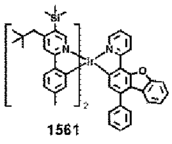
1561
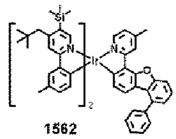
1562
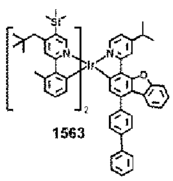
1563
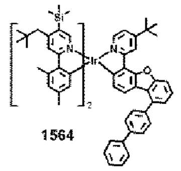
1564
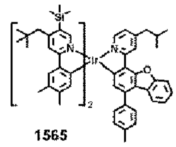
1565
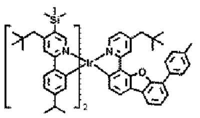
1566
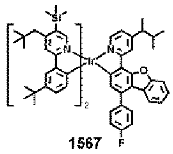
1567
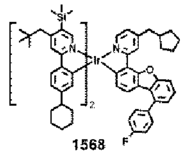
1568
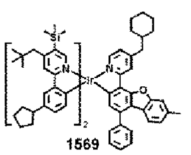
1569
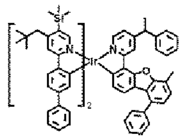
1570
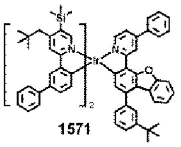
1571
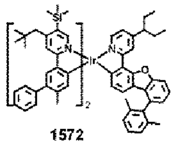
1572
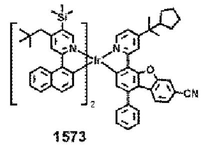
1573
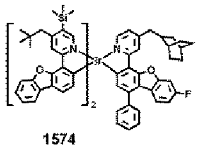
1574
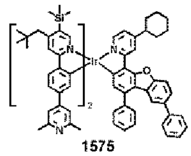
1575
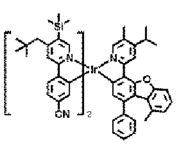
1576
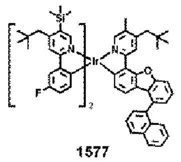
1577
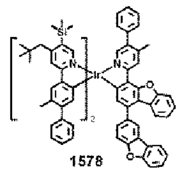
1578
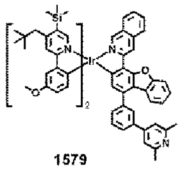
1579
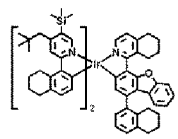
1580
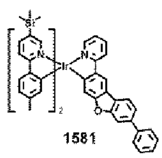
1581
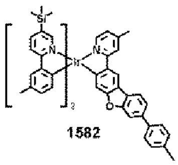
1582
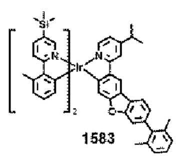
1583
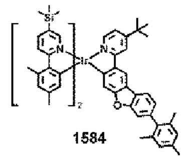
1584
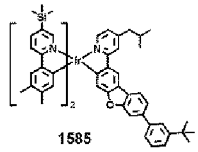
1585
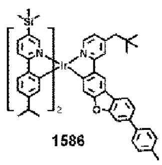
1586
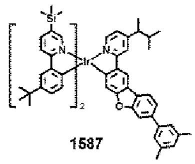
1587
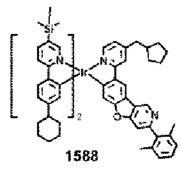
1588
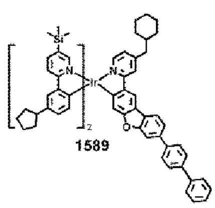
1589
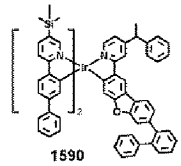
1590
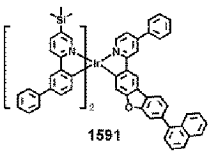
1591
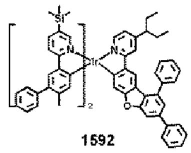
1592
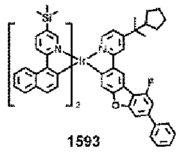
1593
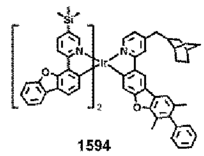
1594
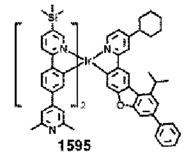
1595
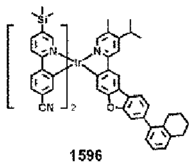
1596
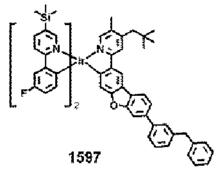
1597
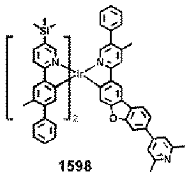
1598
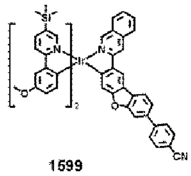
1599
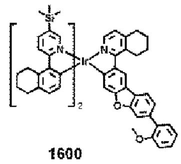
1600

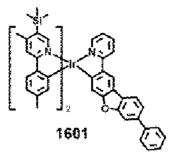
1601
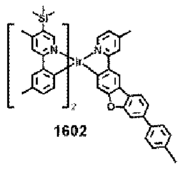
1602
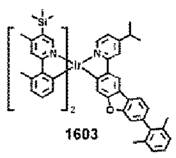
1603
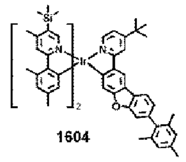
1604
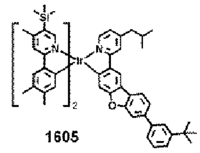
1605
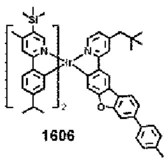
1606
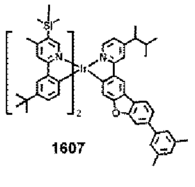
1607
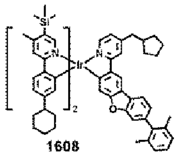
1608
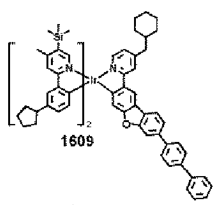
1609
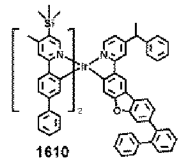
1610
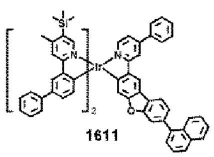
1611
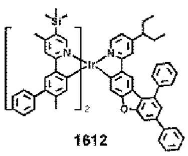
1612
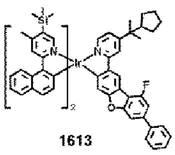
1613
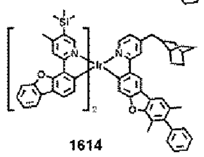
1614
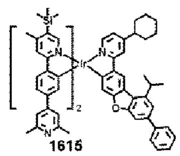
1615
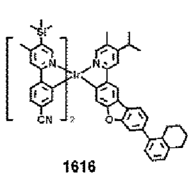
1616
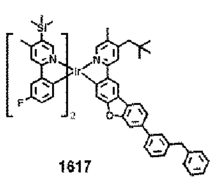
1617
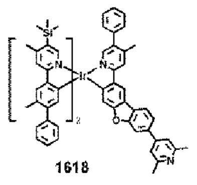
1618
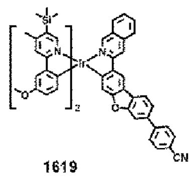
1619
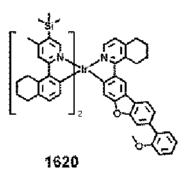
1620
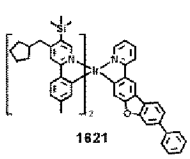
1621
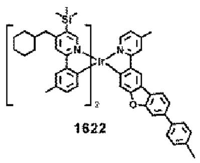
1622
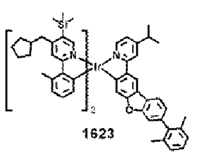
1623
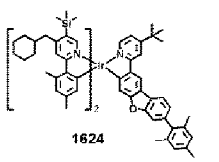
1624
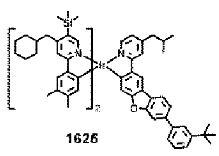
1625
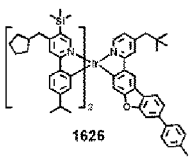
1626
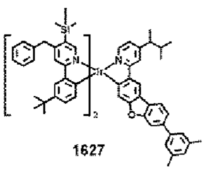
1627
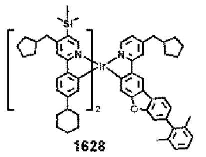
1628
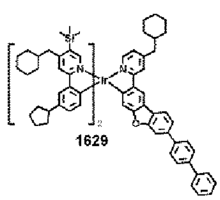
1629
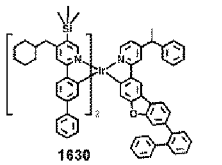
1630
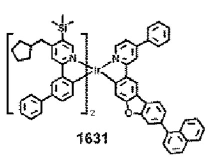
1631
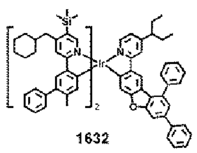
1632
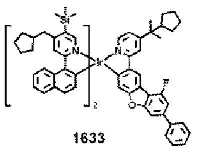
1633
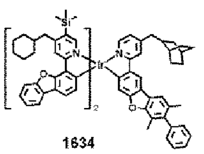
1634
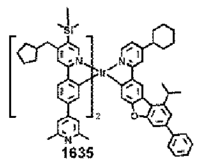
1635
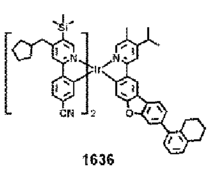
1636
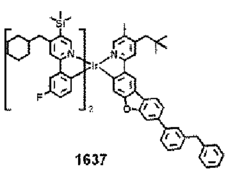
1637
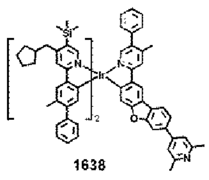
1638
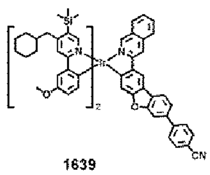
1639
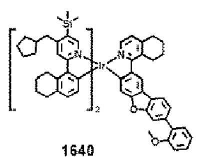
1640

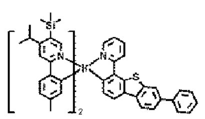
1641
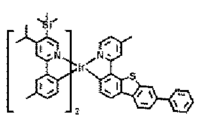
1642
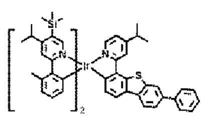
1643
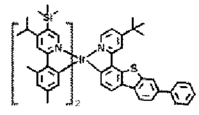
1644
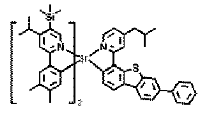
1645
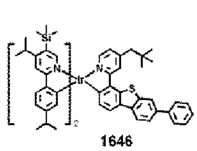
1646
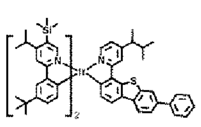
1647
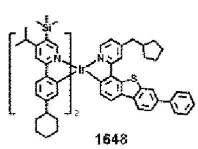
1648
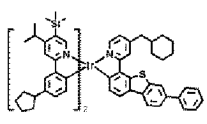
1649
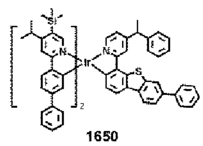
1650
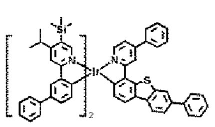
1651
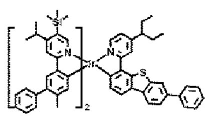
1652
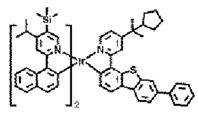
1653
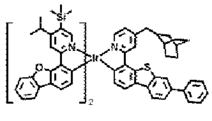
1654
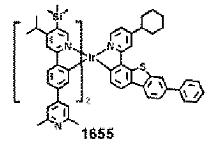
1655
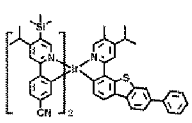
1656
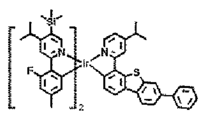
1657
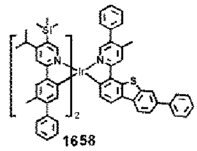
1658
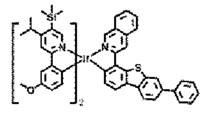
1659
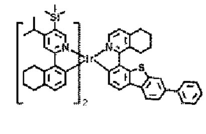
1660
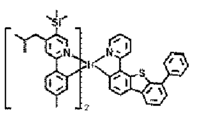
1661
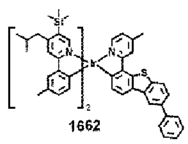
1662
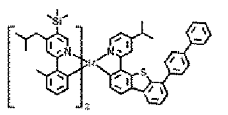
1663
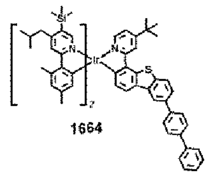
1664
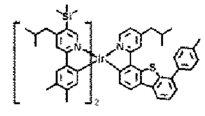
1665
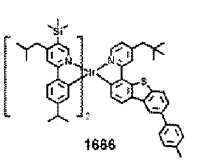
1666
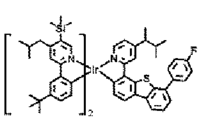
1667
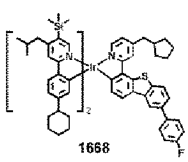
1668
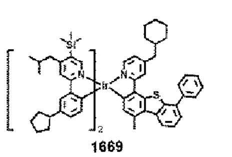
1669
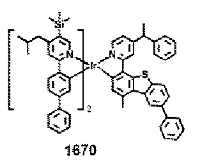
1670
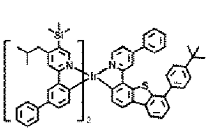
1671
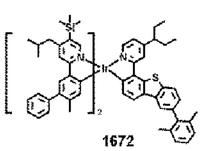
1672
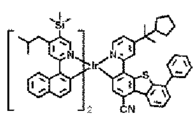
1673
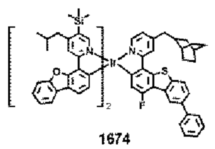
1674
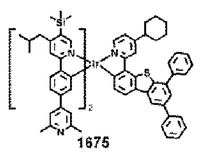
1675
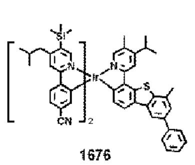
1676
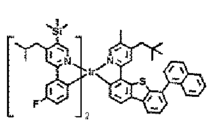
1677
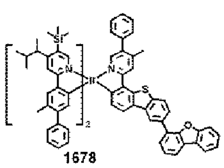
1678
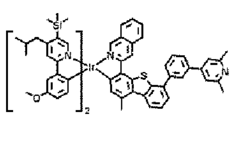
1679
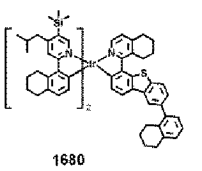
1680

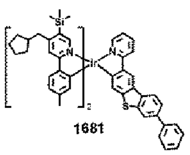
1681

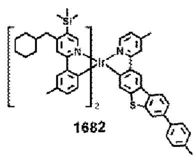
1682

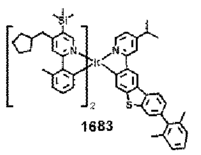
1683

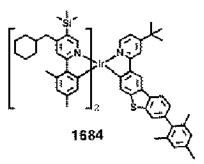
1684

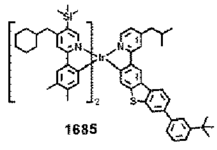
1685

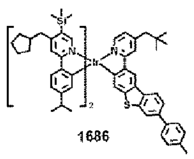
1686

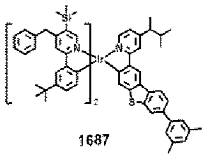
1687

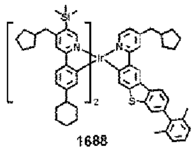
1688

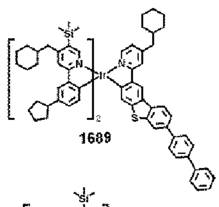
1689

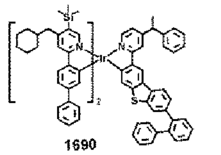
1690

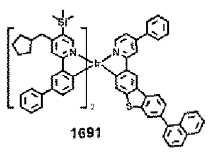
1691

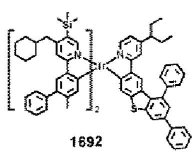
1692

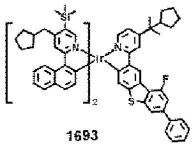
1693

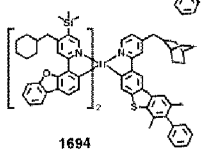
1694

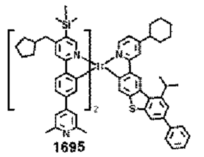
1695

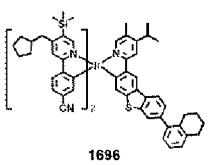
1696

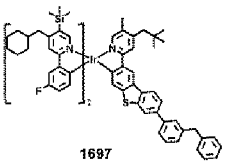
1697

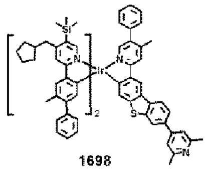
1698

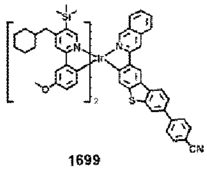
1699

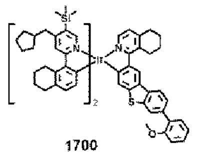
1700

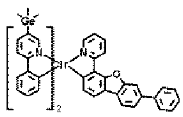
1701

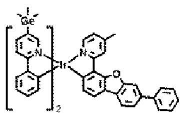
1702

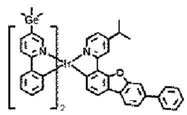
1703

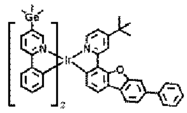
1704

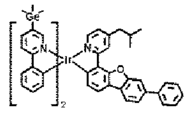
1705

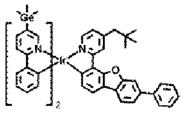
1706

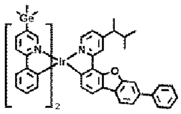
1707

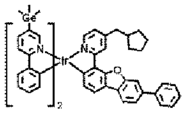
1708

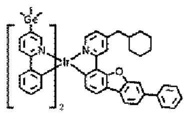
1709

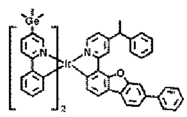
1710

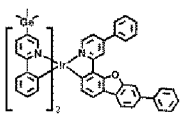
1711

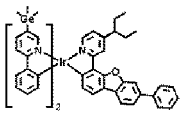
1712

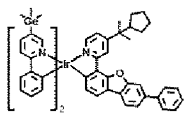
1713

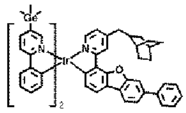
1714

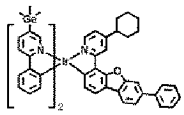
1715

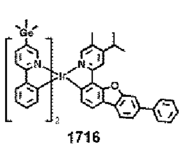
1716

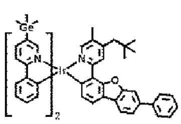
1717

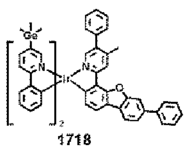
1718

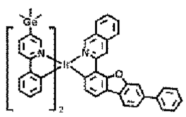
1719

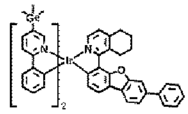
1720

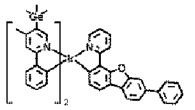
1721
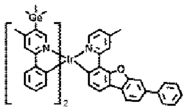
1722
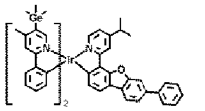
1723
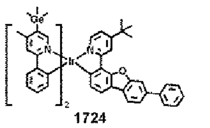
1724
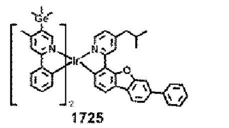
1725

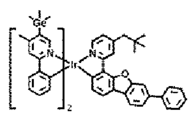
1726
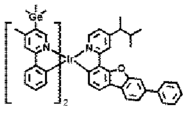
1727
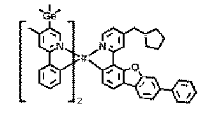
1728
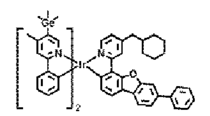
1729
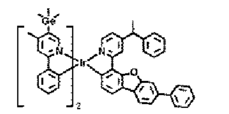
1730

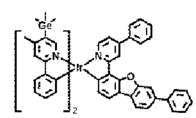
1731
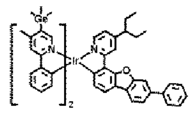
1732
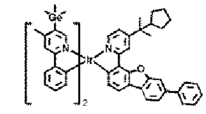
1733
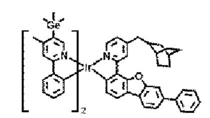
1734
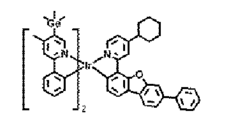
1735

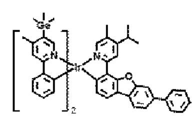
1736
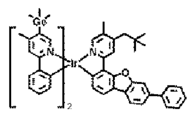
1737
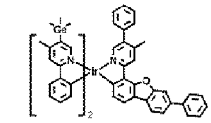
1738
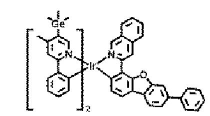
1739
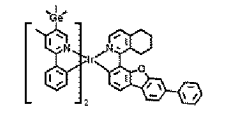
1740

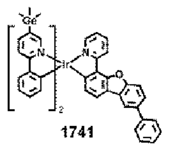
1741
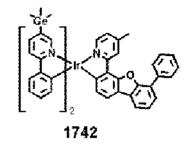
1742
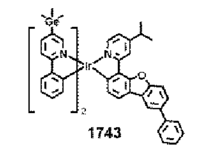
1743
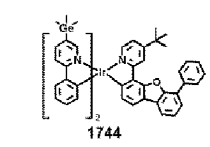
1744
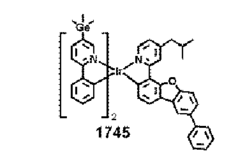
1745

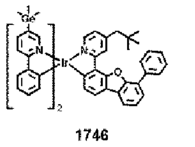
1746
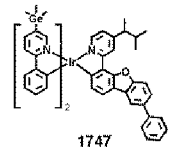
1747
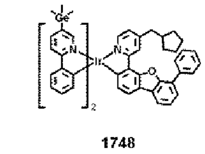
1748
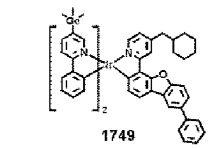
1749
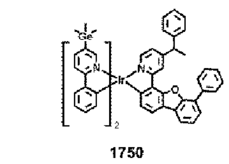
1750

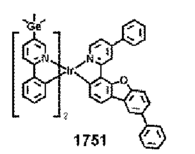
1751
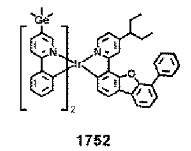
1752
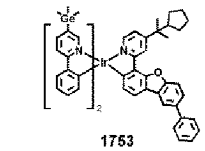
1753
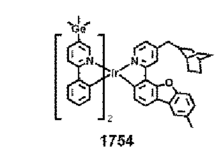
1754
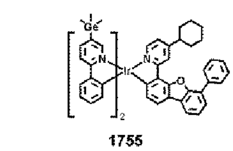
1755

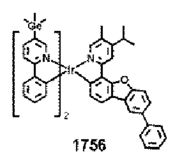
1756
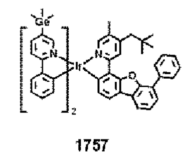
1757
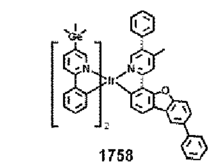
1758
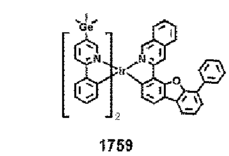
1759
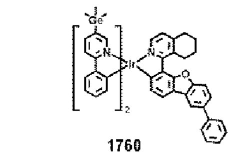
1760

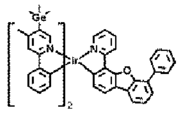
1761
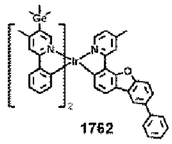
1762
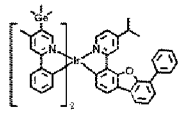
1763
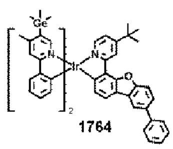
1764
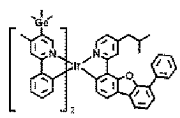
1765
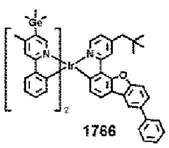
1766
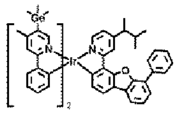
1767
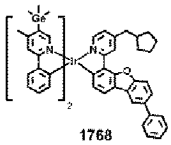
1768
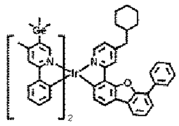
1769
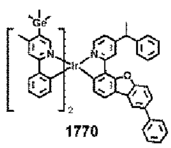
1770
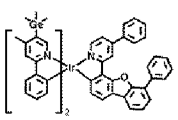
1771
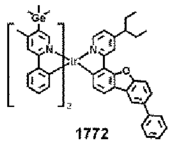
1772
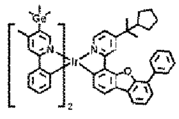
1773
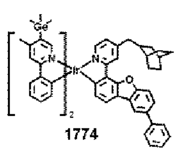
1774
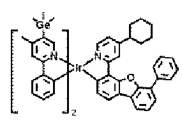
1775
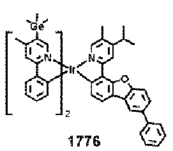
1776
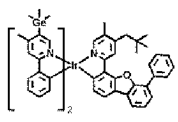
1777
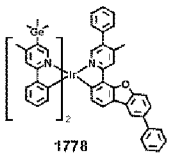
1778
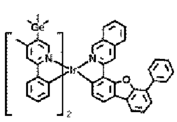
1779
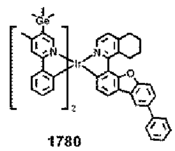
1780
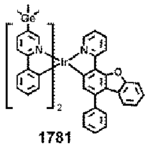
1781
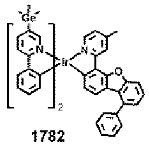
1782
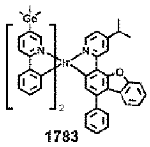
1783
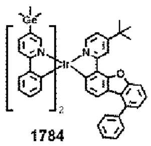
1784
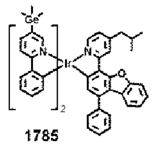
1785
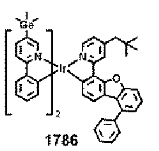
1786
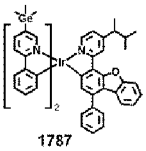
1787
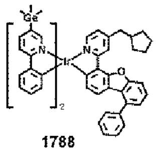
1788
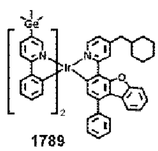
1789
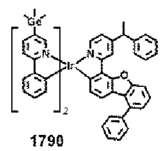
1790
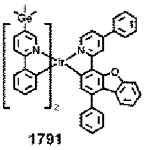
1791
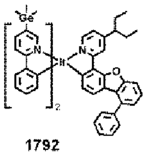
1792
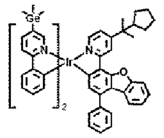
1793
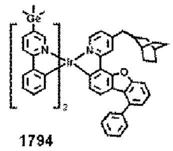
1794
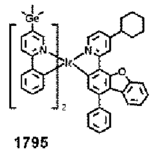
1795
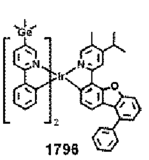
1796
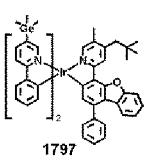
1797
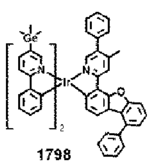
1798
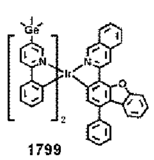
1799
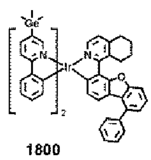
1800

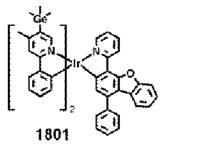
1801
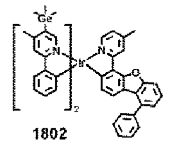
1802
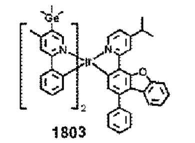
1803
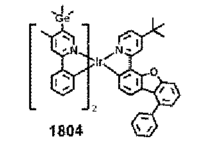
1804
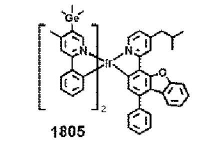
1805
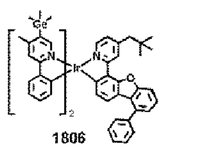
1806
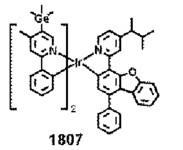
1807
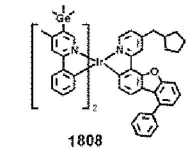
1808
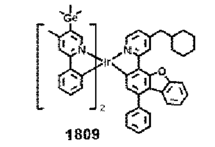
1809
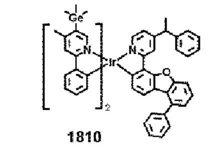
1810
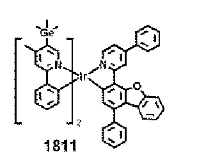
1811
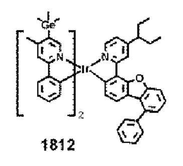
1812
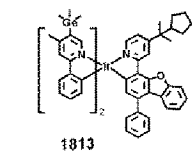
1813
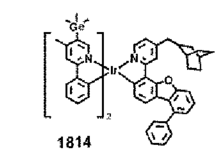
1814
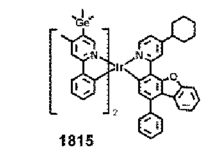
1815
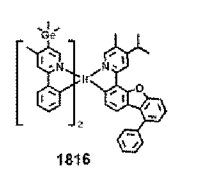
1816
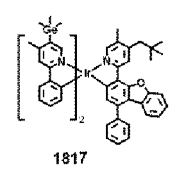
1817
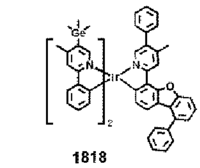
1818
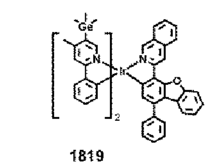
1819
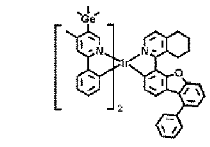
1820
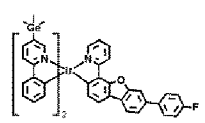
1821
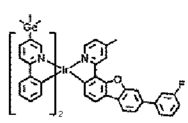
1822
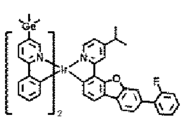
1823
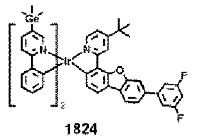
1824
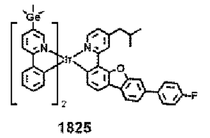
1825
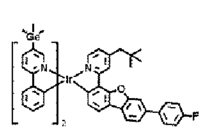
1826
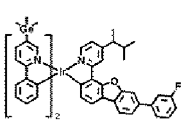
1827
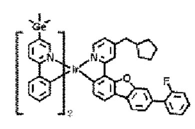
1828
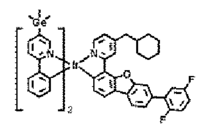
1829
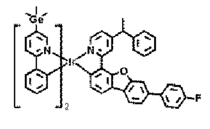
1830
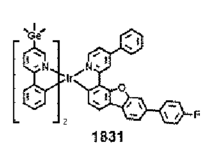
1831
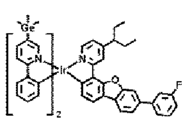
1832
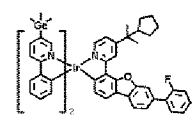
1833
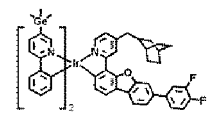
1834
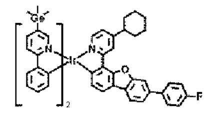
1835
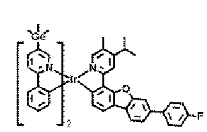
1836
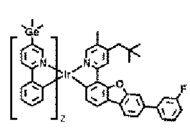
1837
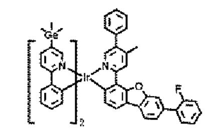
1838
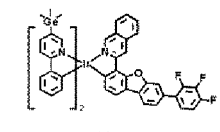
1839
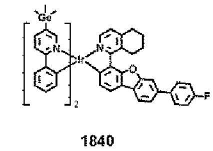
1840

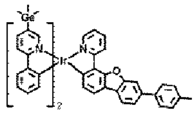
1841
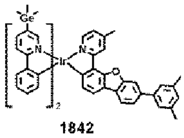
1842
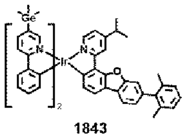
1843
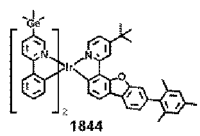
1844
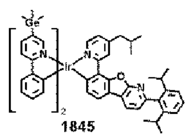
1845

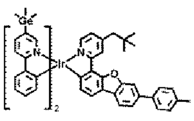
1846
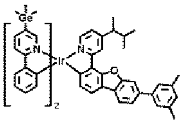
1847
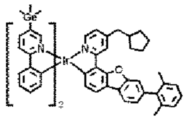
1848
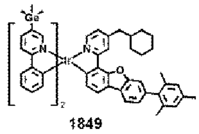
1849
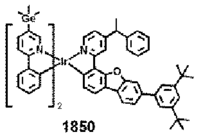
1850

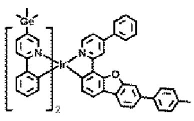
1851
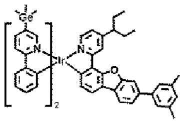
1852
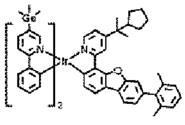
1853
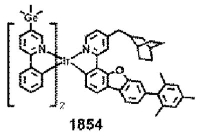
1854
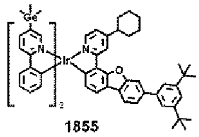
1855

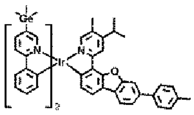
1856
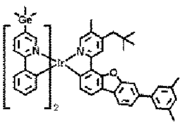
1857
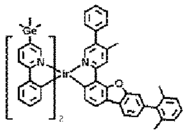
1858
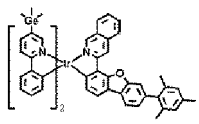
1859
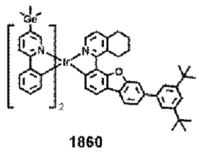
1860

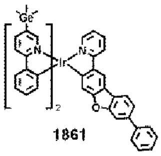
1861
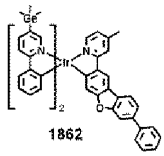
1862
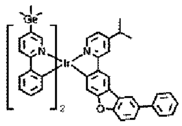
1863
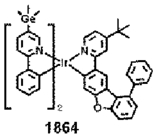
1864
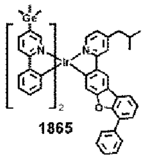
1865

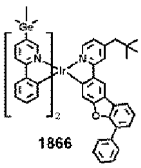
1866
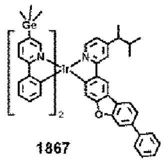
1867
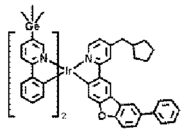
1868
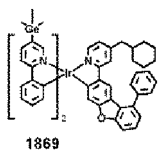
1869
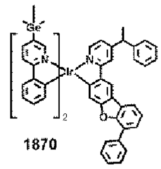
1870

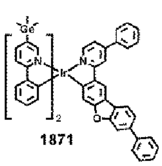
1871
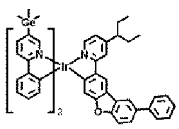
1872
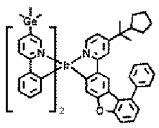
1873
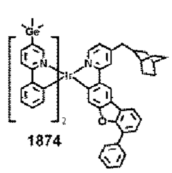
1874
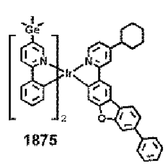
1875

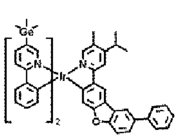
1876
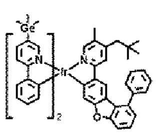
1877
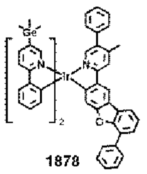
1878
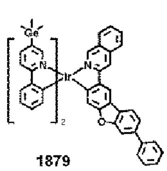
1879
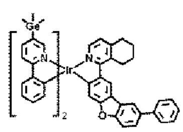
1880

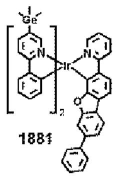
1881
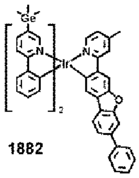
1882
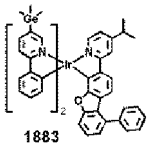
1883
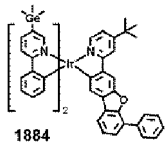
1884
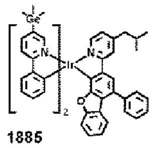
1885
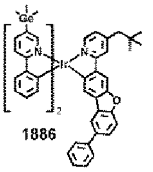
1886
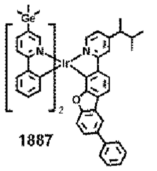
1887
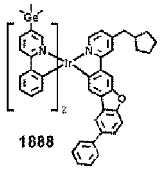
1888
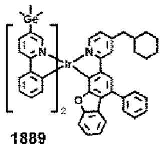
1889
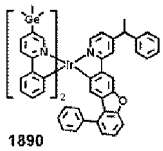
1890
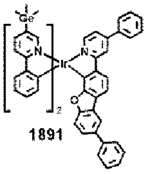
1891
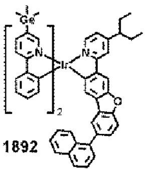
1892
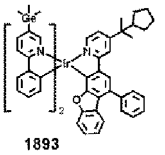
1893
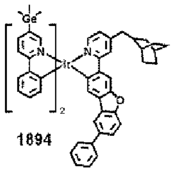
1894
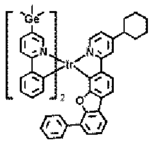
1895
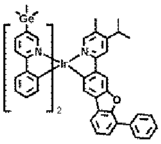
1896
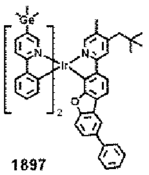
1897
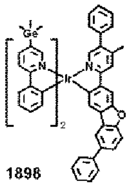
1898
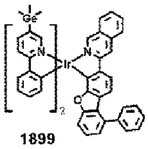
1899
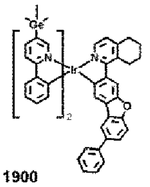
1900
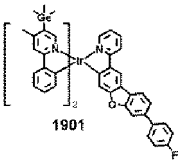
1901
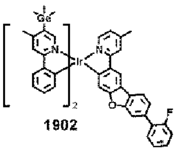
1902
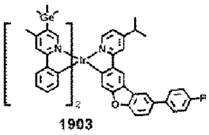
1903
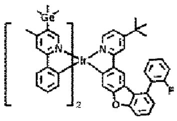
1904
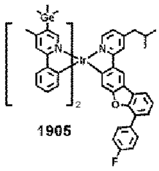
1905
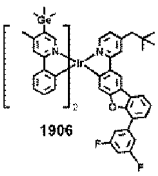
1906
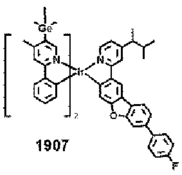
1907
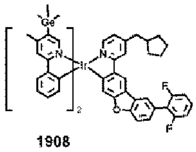
1908
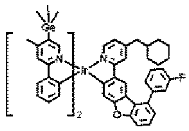
1909
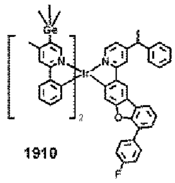
1910
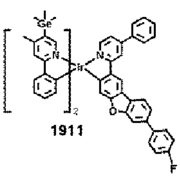
1911
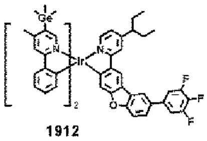
1912
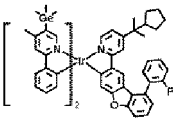
1913
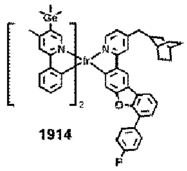
1914
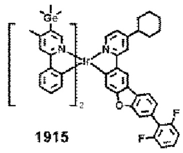
1915
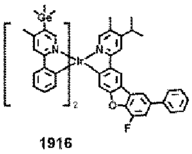
1916
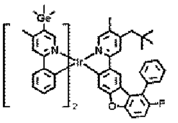
1917
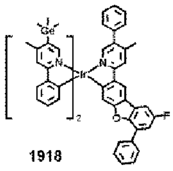
1918
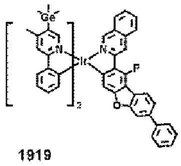
1919
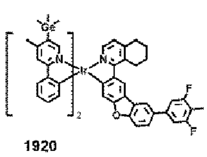
1920

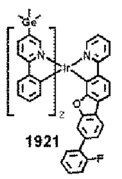
1921

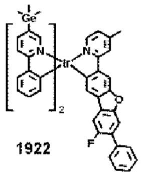
1922

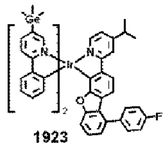
1923

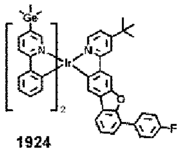
1924

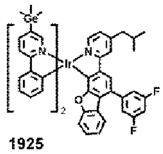
1925

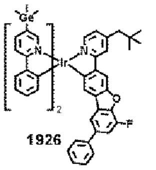
1926

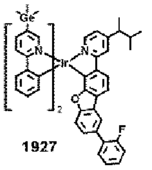
1927

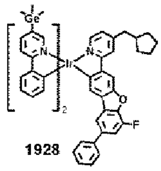
1928

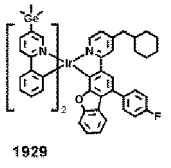
1929

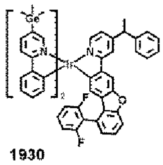
1930

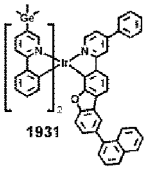
1931

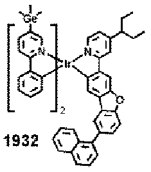
1932

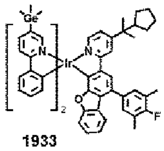
1933

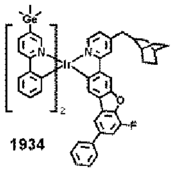
1934

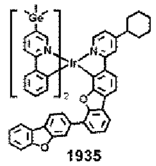
1935

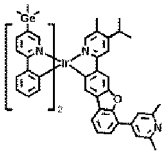
1936

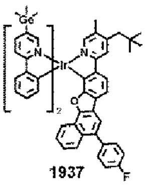
1937

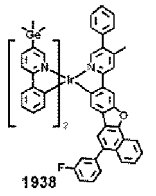
1938

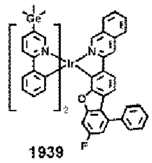
1939

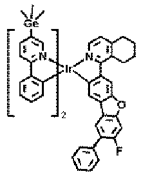
1940

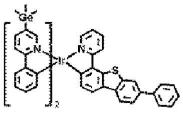
1941

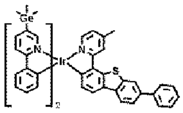
1942

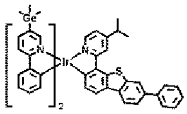
1943

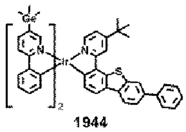
1944

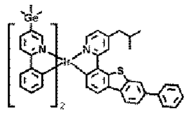
1945

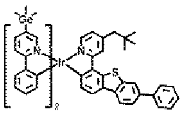
1946

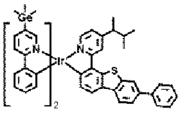
1947

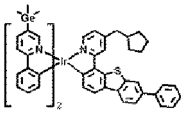
1948

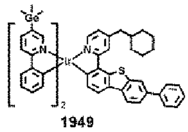
1949

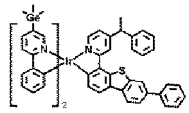
1950

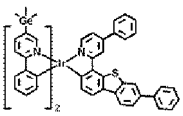
1951

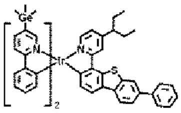
1952

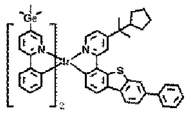
1953

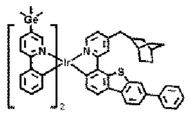
1954

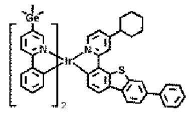
1955

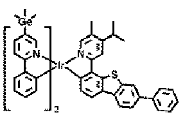
1956

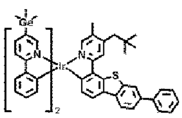
1957

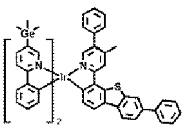
1958

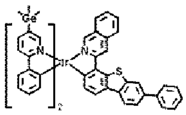
1959

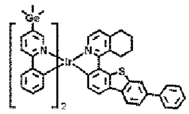
1960

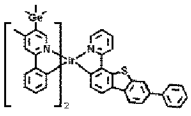
1961

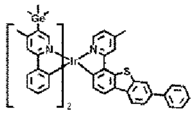
1962

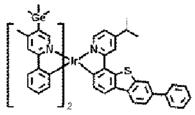
1963

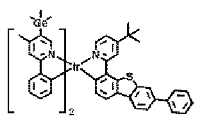
1964

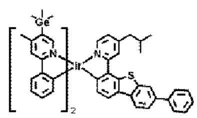
1965

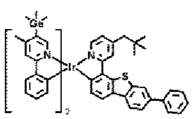
1966

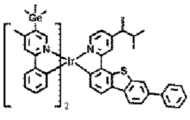
1967

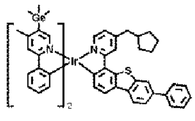
1968

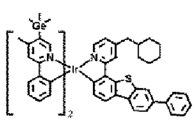
1969

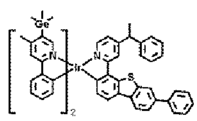
1970

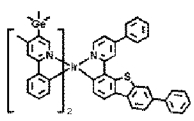
1971

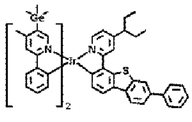
1972

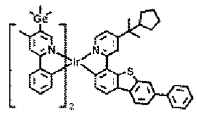
1973

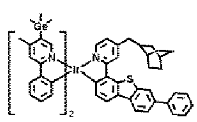
1974

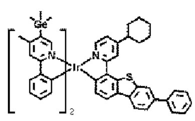
1975

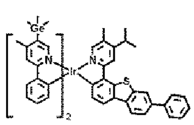
1976

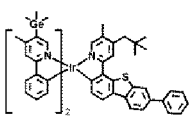
1977

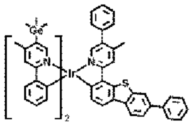
1978

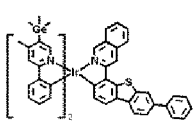
1979

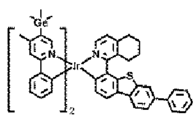
1980

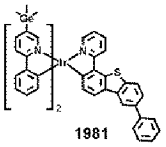
1981

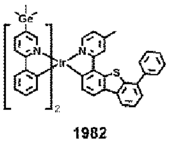
1982

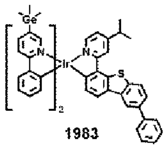
1983

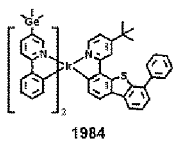
1984

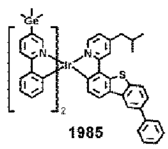
1985

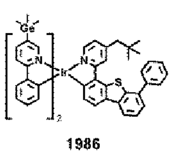
1986

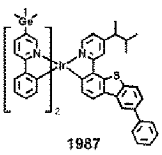
1987

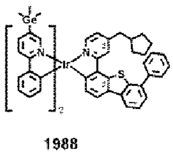
1988

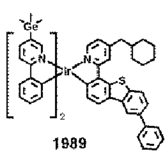
1989

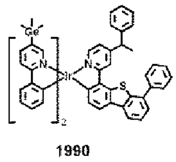
1990

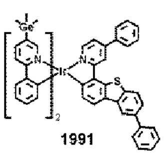
1991

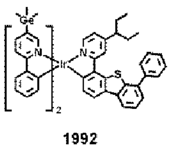
1992

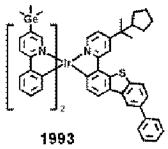
1993

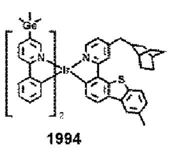
1994

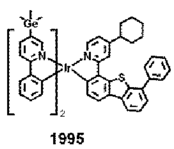
1995

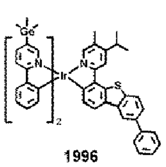
1996

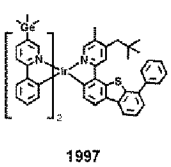
1997

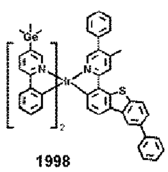
1998

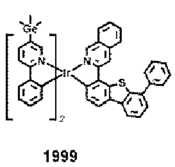
1999

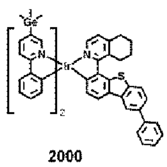
2000

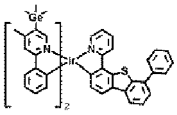
2001

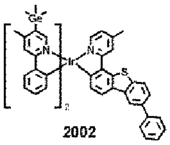
2002

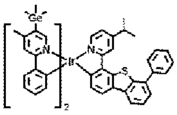
2003

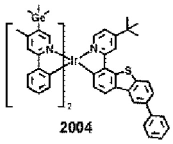
2004

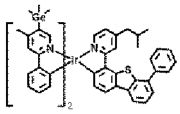
2005

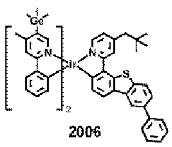
2006

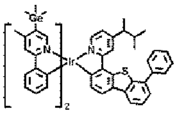
2007

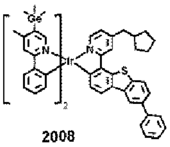
2008

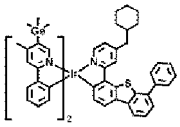
2009

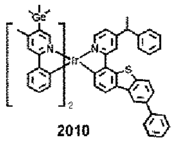
2010

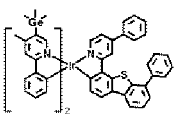
2011

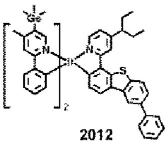
2012

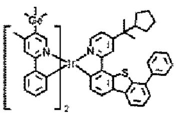
2013

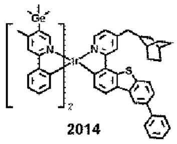
2014

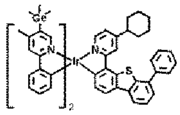
2015

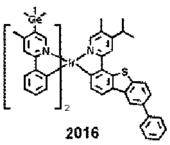
2016

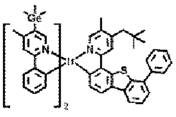
2017

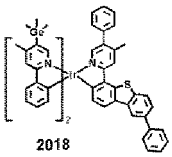
2018

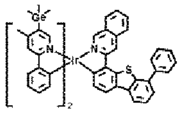
2019

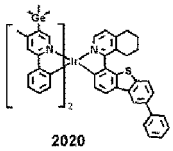
2020

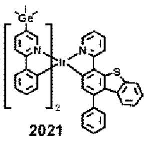
2021

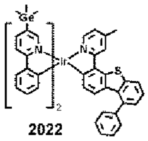
2022

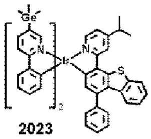
2023

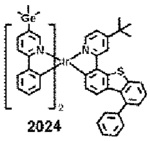
2024

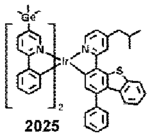
2025

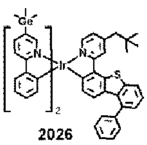
2026

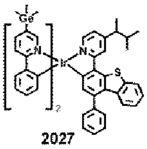
2027

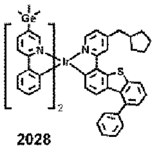
2028

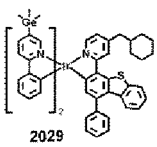
2029

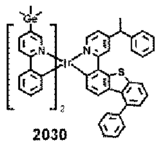
2030

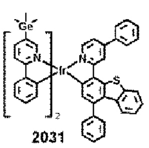
2031

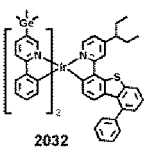
2032

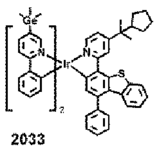
2033

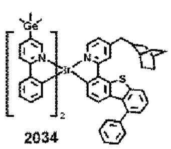
2034

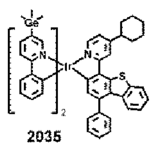
2035

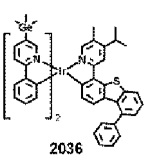
2036

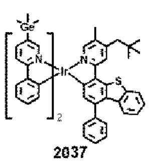
2037

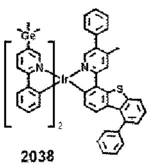
2038

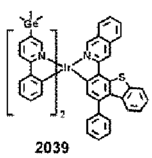
2039

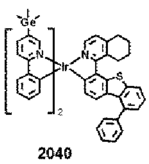
2040

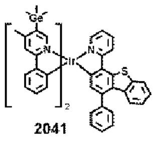
2041
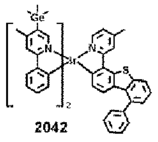
2042
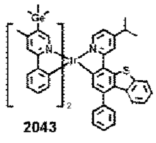
2043
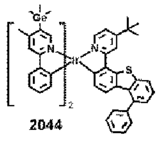
2044
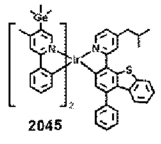
2045
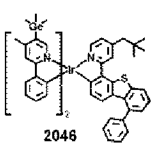
2046
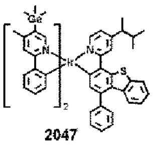
2047
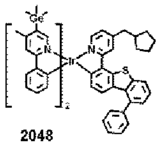
2048
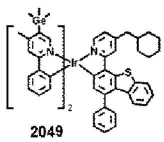
2049
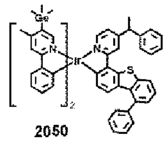
2050
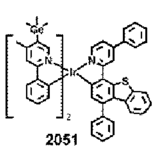
2051
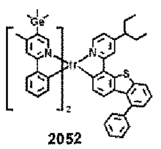
2052
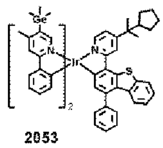
2053
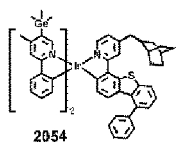
2054
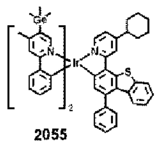
2055
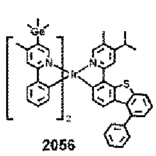
2056
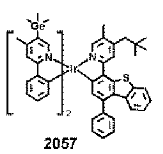
2057
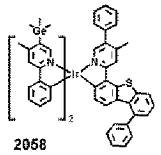
2058
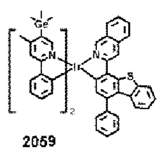
2059
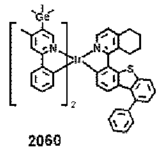
2060
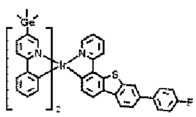
2061
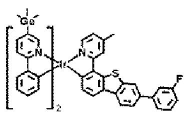
2062
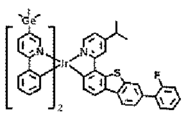
2063
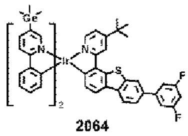
2064
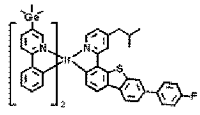
2065
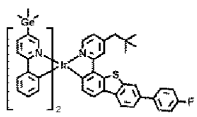
2066
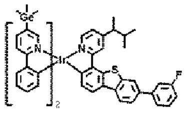
2067
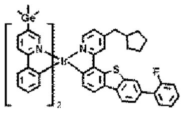
2068
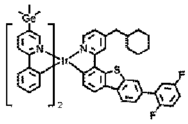
2069
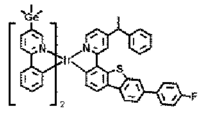
2070
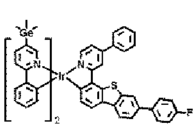
2071
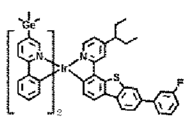
2072
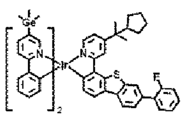
2073
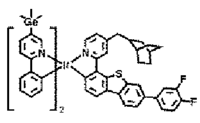
2074
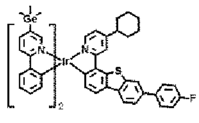
2075
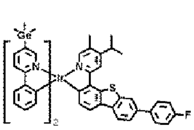
2076
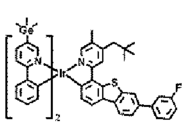
2077
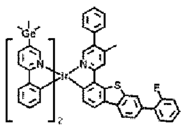
2078
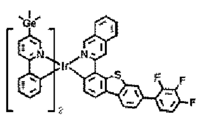
2079
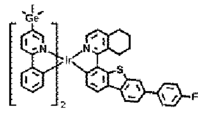
2080

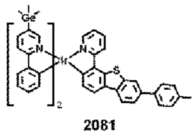
2081

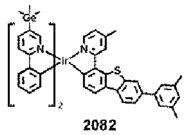
2082

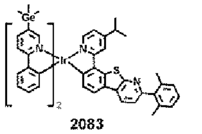
2083

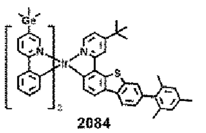
2084

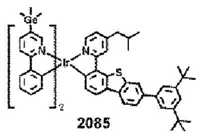
2085

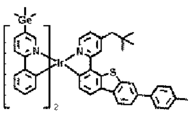
2086

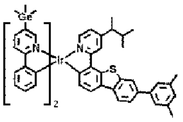
2087

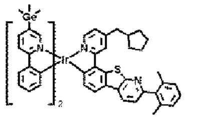
2088

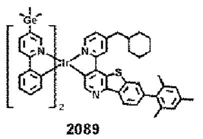
2089

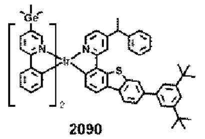
2090

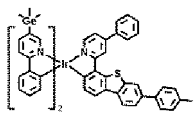
2091

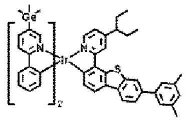
2092

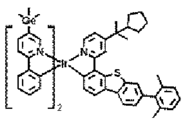
2093

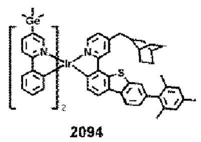
2094

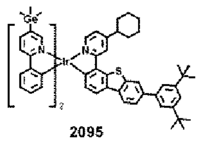
2095

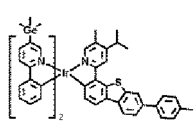
2096

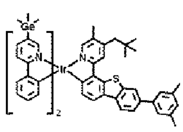
2097

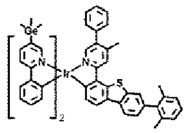
2098

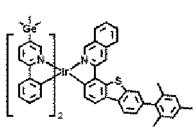
2099

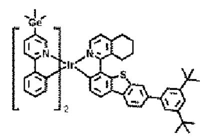
2100

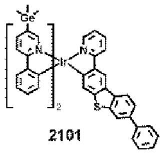
2101

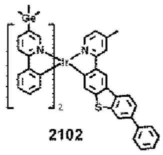
2102

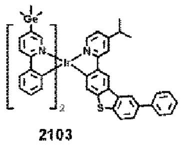
2103

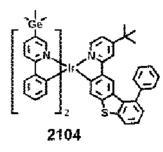
2104

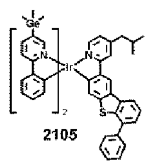
2105

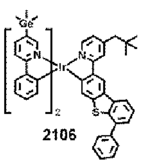
2106

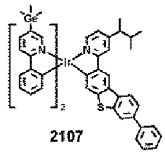
2107

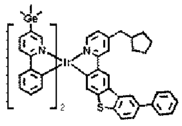
2108

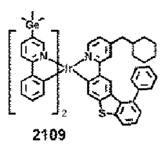
2109

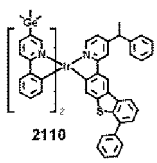
2110

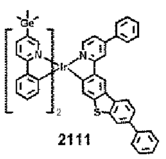
2111

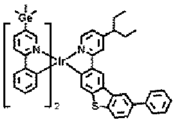
2112

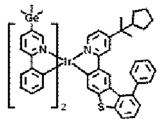
2113

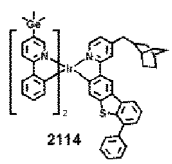
2114

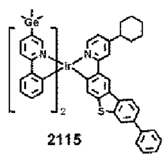
2115

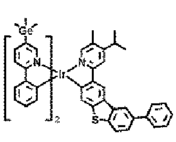
2116

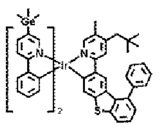
2117

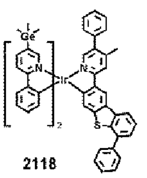
2118

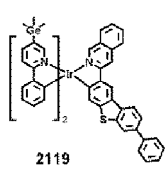
2119

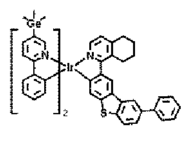
2120

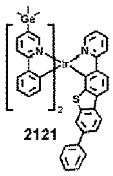
2121
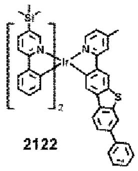
2122
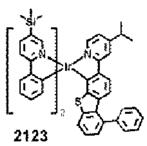
2123
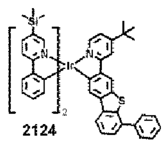
2124
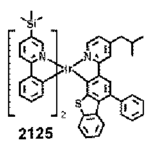
2125
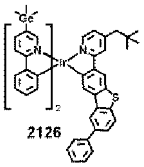
2126
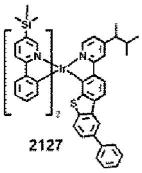
2127
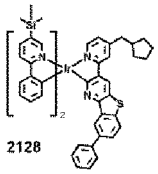
2128
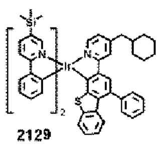
2129
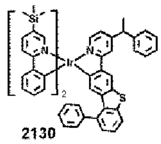
2130
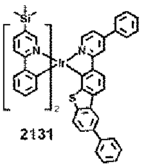
2131
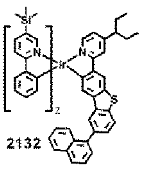
2132
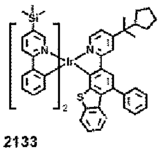
2133
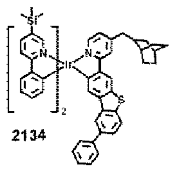
2134
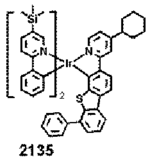
2135
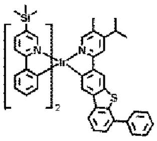
2136
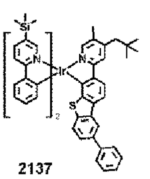
2137
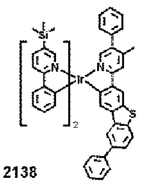
2138
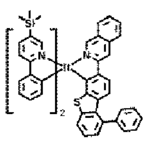
2139
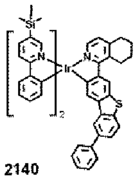
2140
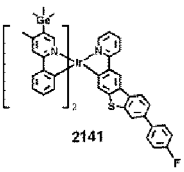
2141
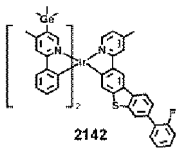
2142
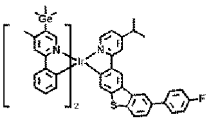
2143
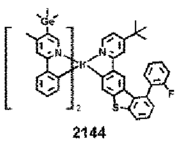
2144
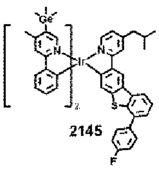
2145
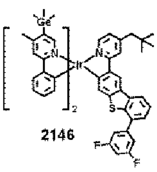
2146
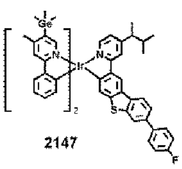
2147
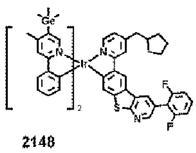
2148
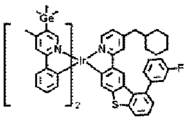
2149
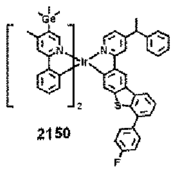
2150
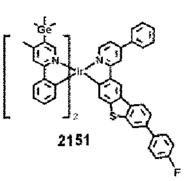
2151
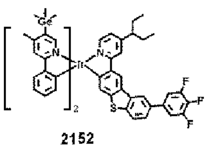
2152
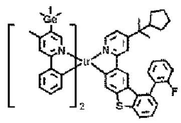
2153
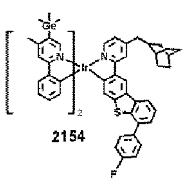
2154
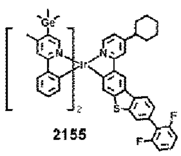
2155
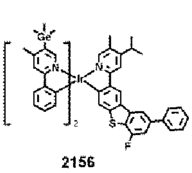
2156
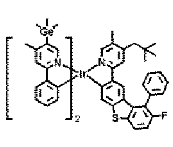
2157
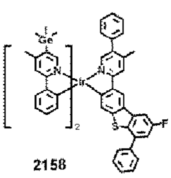
2158
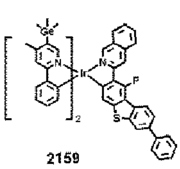
2159
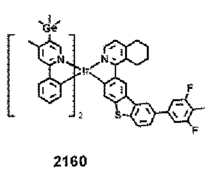
2160

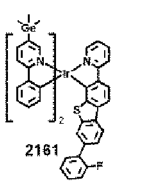
2161

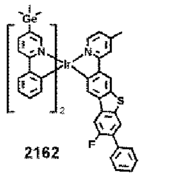
2162

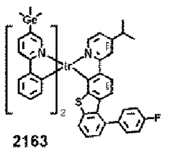
2163

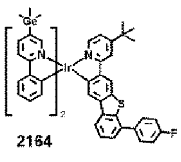
2164

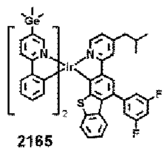
2165

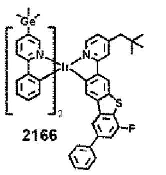
2166

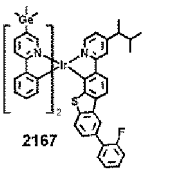
2167

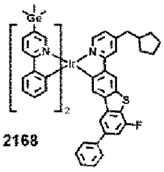
2168

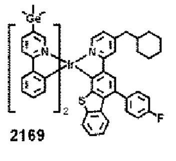
2169

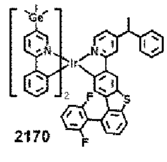
2170

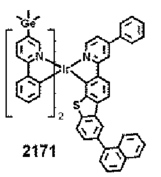
2171

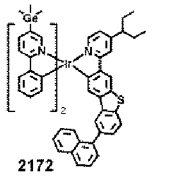
2172

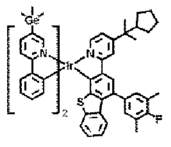
2173

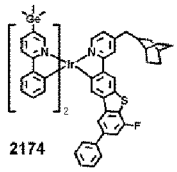
2174

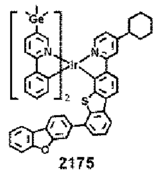
2175

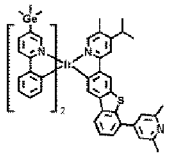
2176

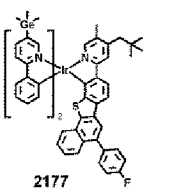
2177

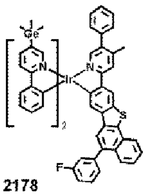
2178

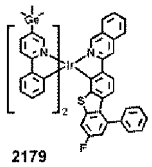
2179

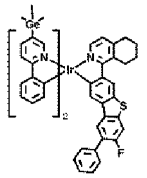
2180

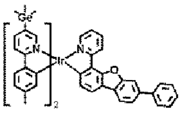
2181

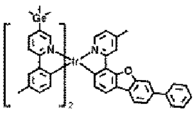
2182

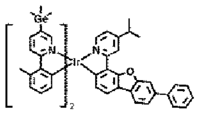
2183

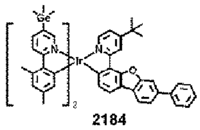
2184

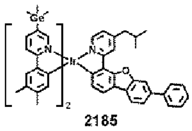
2185

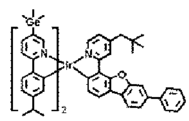
2186

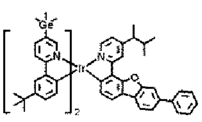
2187

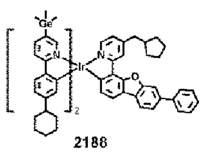
2188

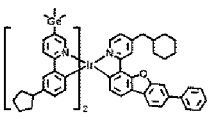
2189

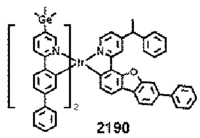
2190

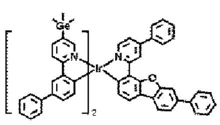
2191

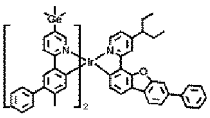
2192

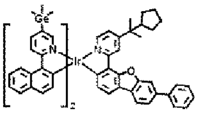
2193

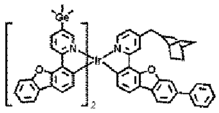
2194

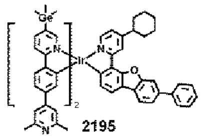
2195

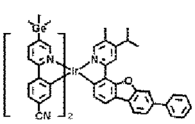
2196

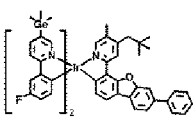
2197

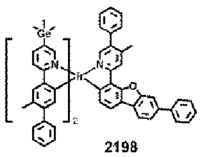
2198

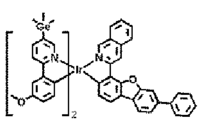
2199

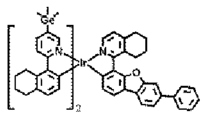
2200

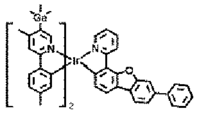
2201

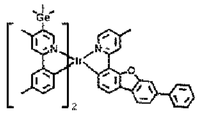
2202

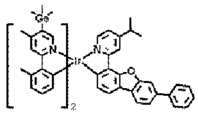
2203

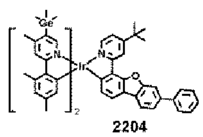
2204

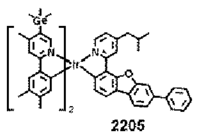
2205

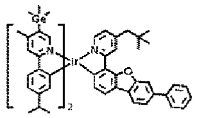
2206

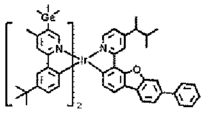
2207

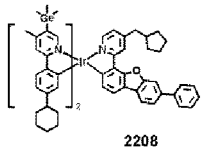
2208

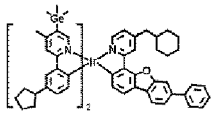
2209

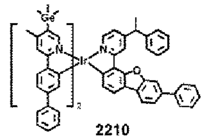
2210

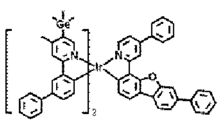
2211

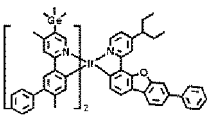
2212

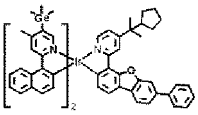
2213

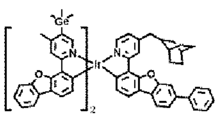
2214

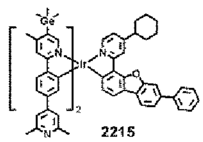
2215

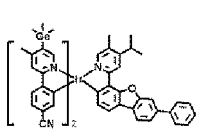
2216

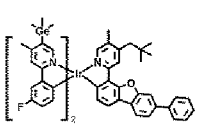
2217

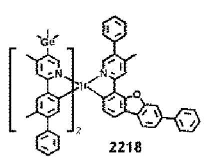
2218

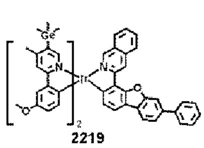
2219

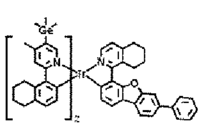
2220

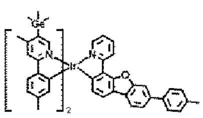
2221

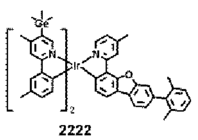
2222

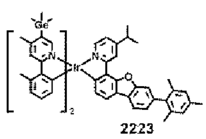
2223

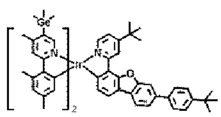
2224

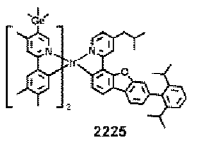
2225

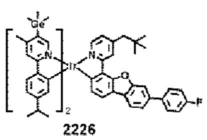
2226

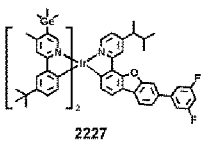
2227

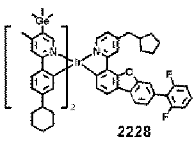
2228

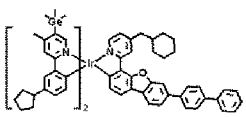
2229

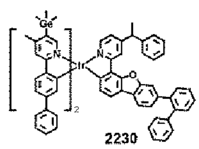
2230

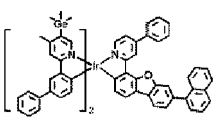
2231

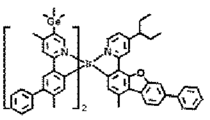
2232

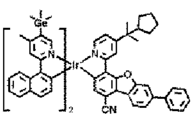
2233

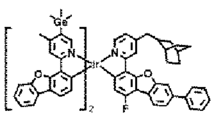
2234

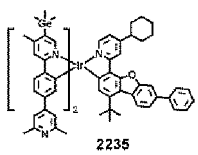
2235

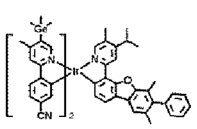
2236

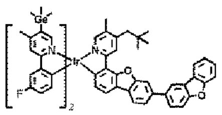
2237

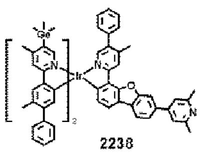
2238

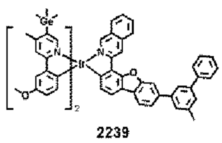
2239

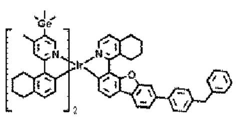
2240

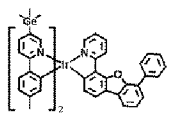
2241
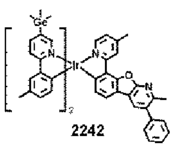
2242
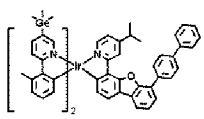
2243
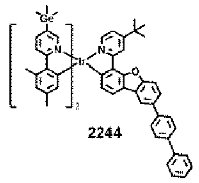
2244
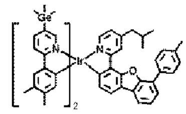
2245

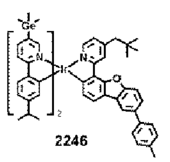
2246
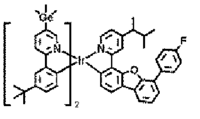
2247
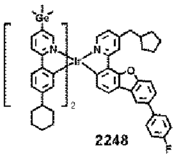
2248
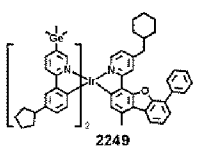
2249
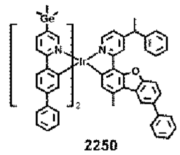
2250

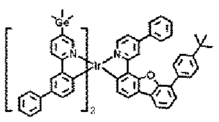
2251
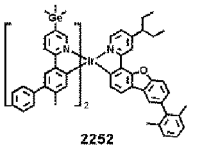
2252
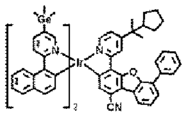
2253
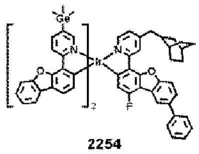
2254
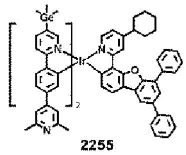
2255

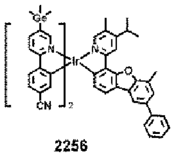
2256
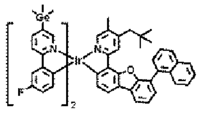
2257
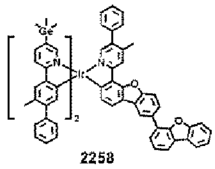
2258
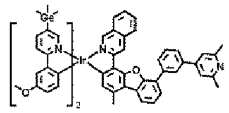
2259
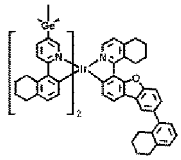
2260

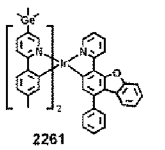
2261
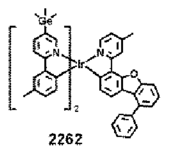
2262
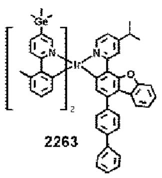
2263
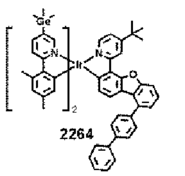
2264
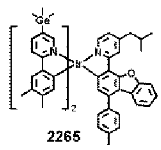
2265

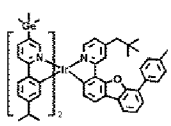
2266
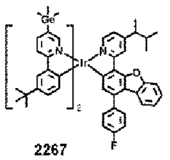
2267
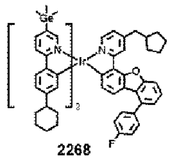
2268
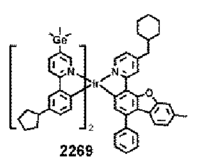
2269
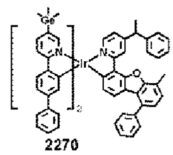
2270

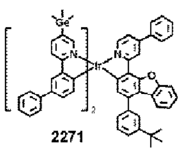
2271
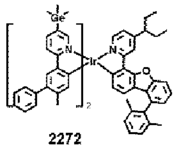
2272
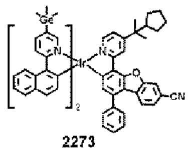
2273
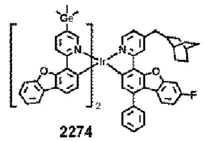
2274
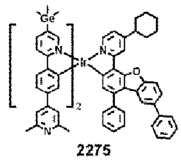
2275

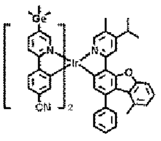
2276
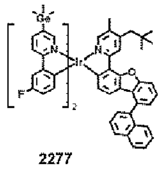
2277
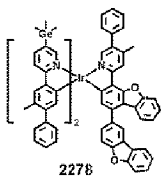
2278
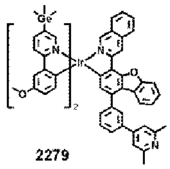
2279
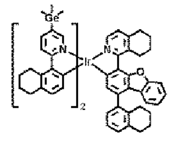
2280

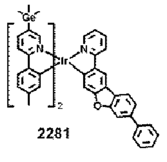
2281

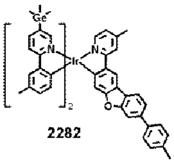
2282

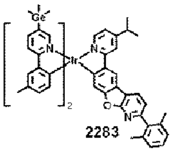
2283

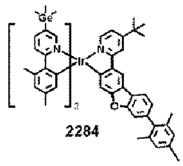
2284

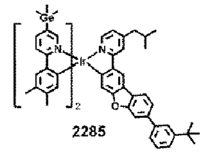
2285

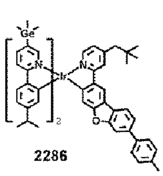
2286

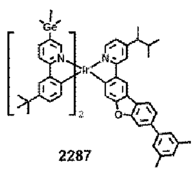
2287

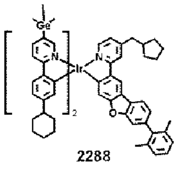
2288

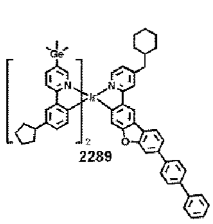
2289

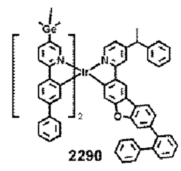
2290

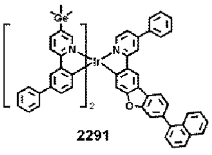
2291

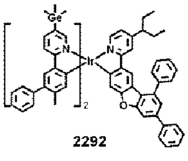
2292

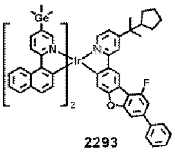
2293

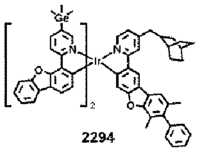
2294

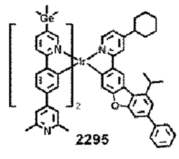
2295

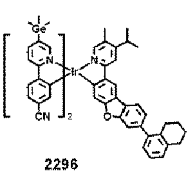
2296

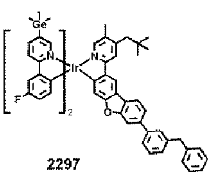
2297

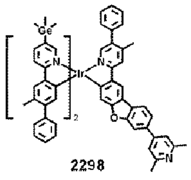
2298

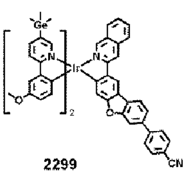
2299

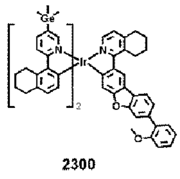
2300

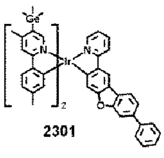
2301

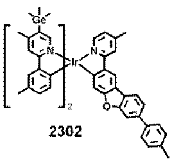
2302

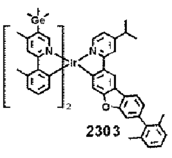
2303

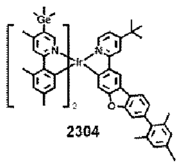
2304

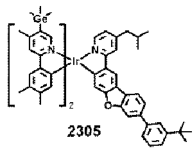
2305

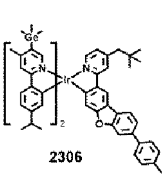
2306

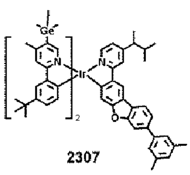
2307

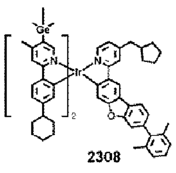
2308

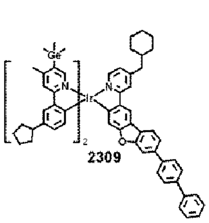
2309

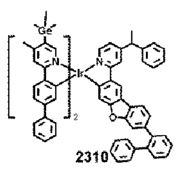
2310

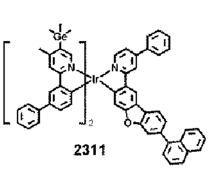
2311

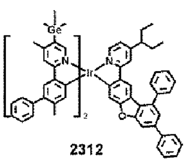
2312

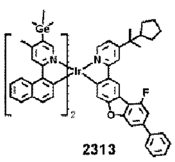
2313

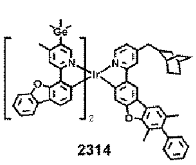
2314

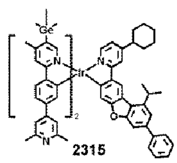
2315

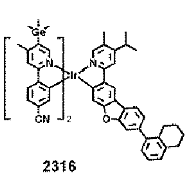
2316

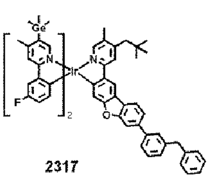
2317

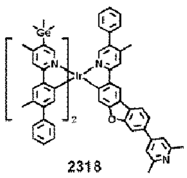
2318

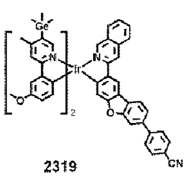
2319

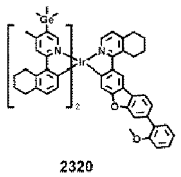
2320

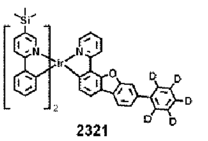
2321
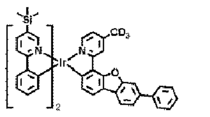
2322
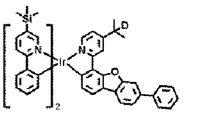
2323
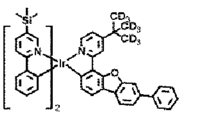
2324
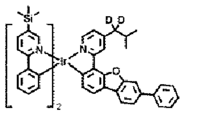
2325

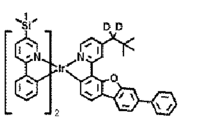
2326
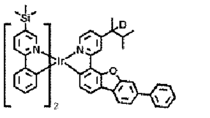
2327
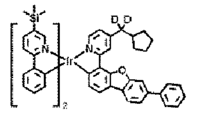
2328
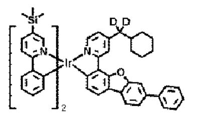
2329
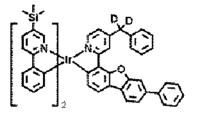
2330

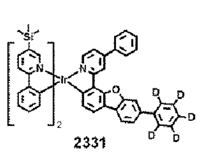
2331
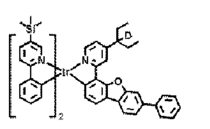
2332
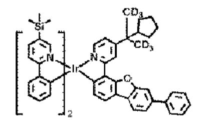
2333
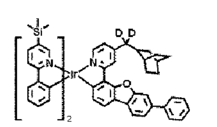
2334
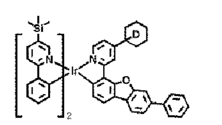
2335

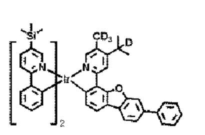
2336
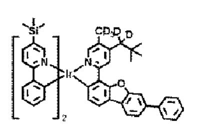
2337
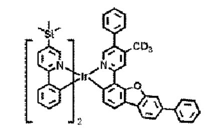
2338
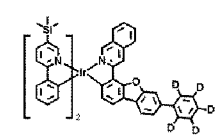
2339
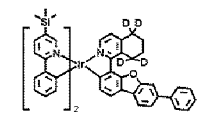
2340

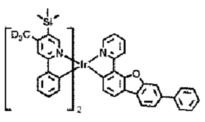
2341
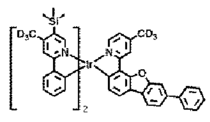
2342
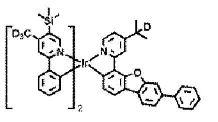
2343
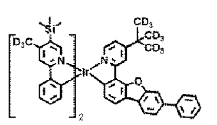
2344
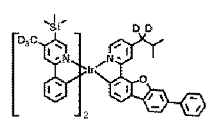
2345

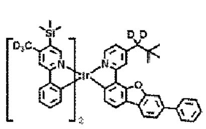
2346
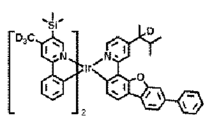
2347
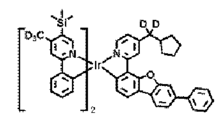
2348
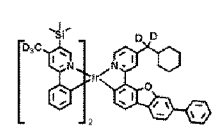
2349
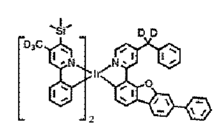
2350

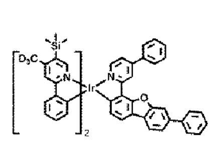
2351
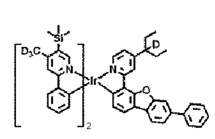
2352
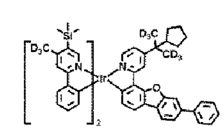
2353
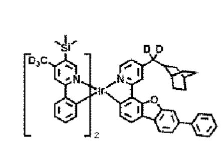
2354
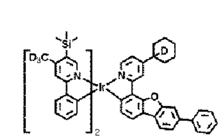
2355

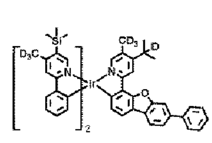
2356
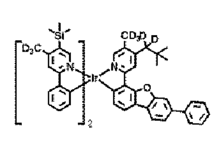
2357
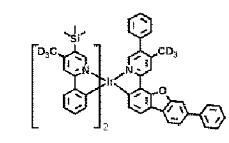
2358
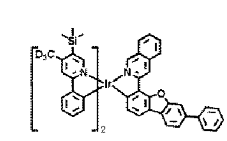
2359
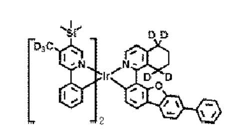
2360

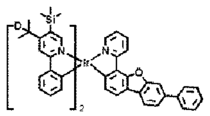
2361
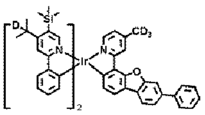
2362
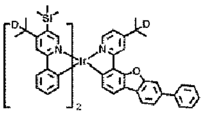
2363
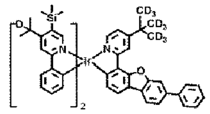
2364
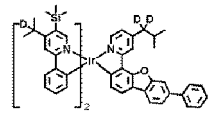
2365
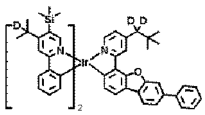
2366
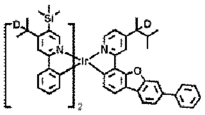
2367
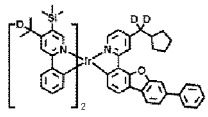
2368
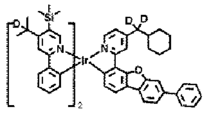
2369
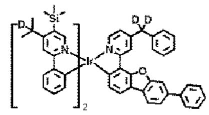
2370
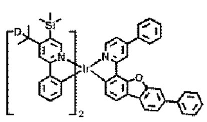
2371
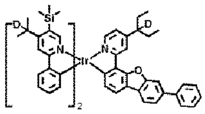
2372
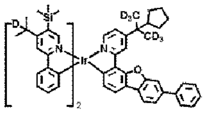
2373
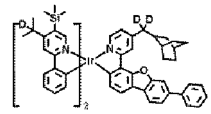
2374
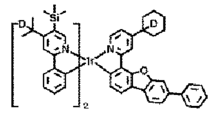
2375
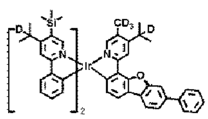
2376
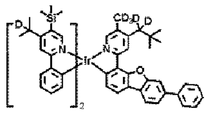
2377
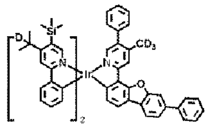
2378
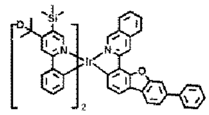
2379
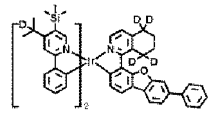
2380
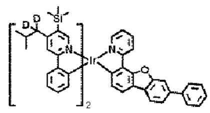
2381
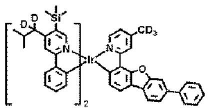
2382
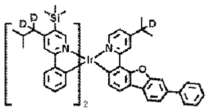
2383
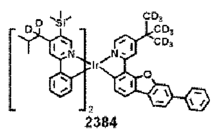
2384
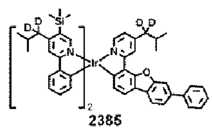
2385
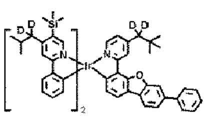
2386
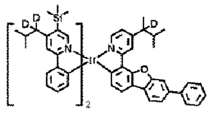
2387
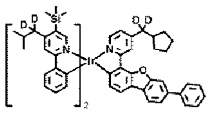
2388
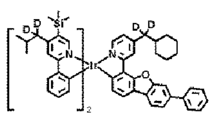
2389
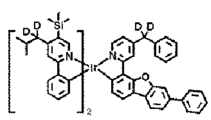
2390
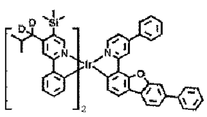
2391
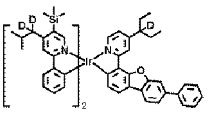
2392
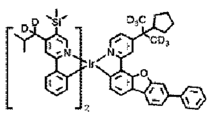
2393
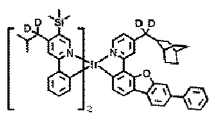
2394
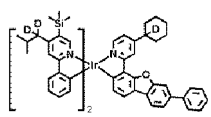
2395
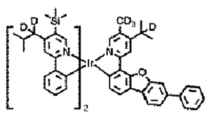
2396
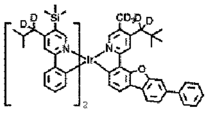
2397
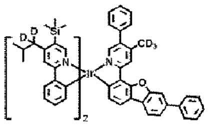
2398
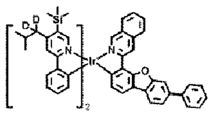
2399
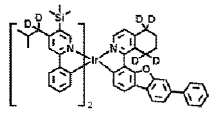
2400

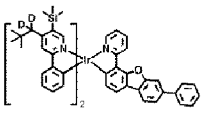
2401
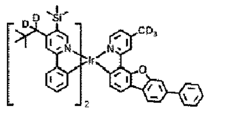
2402
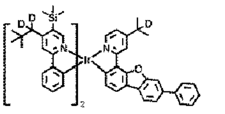
2403
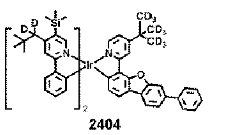
2404
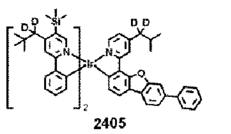
2405

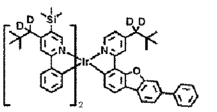
2406
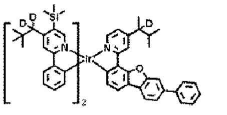
2407
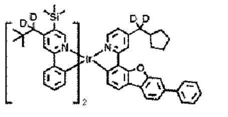
2408
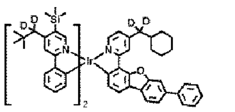
2409
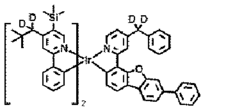
2410

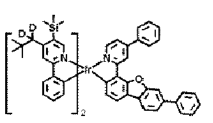
2411
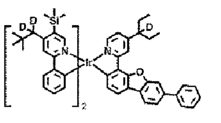
2412
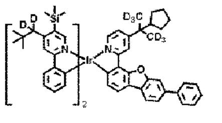
2413
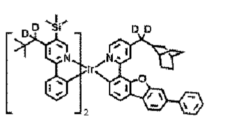
2414
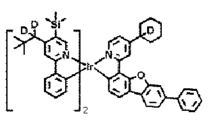
2415

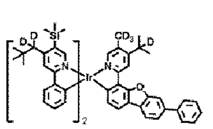
2416
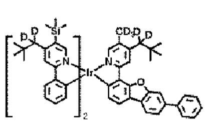
2417
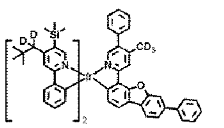
2418
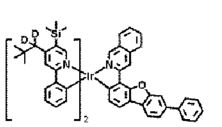
2419
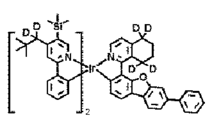
2420

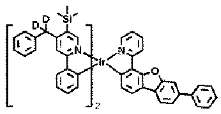
2421
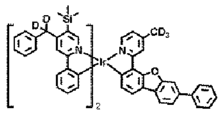
2422
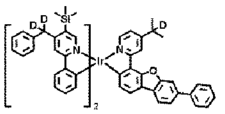
2423
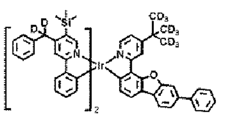
2424
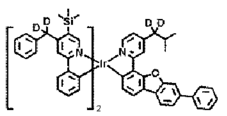
2425

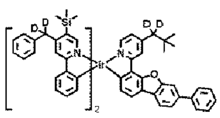
2426
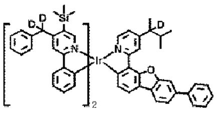
2427
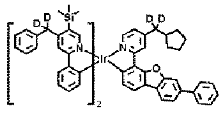
2428
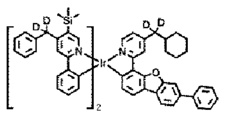
2429
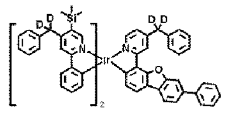
2430

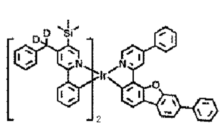
2431
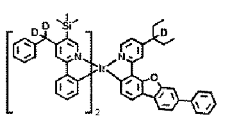
2432
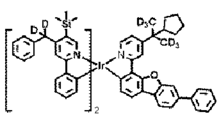
2433
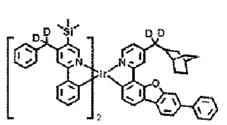
2434
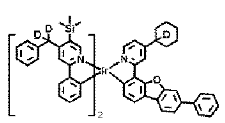
2435

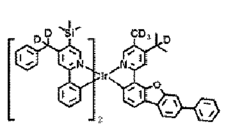
2436
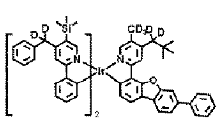
2437
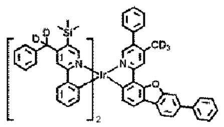
2438
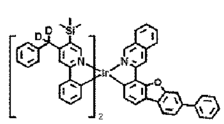
2439
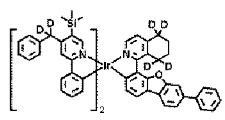
2440

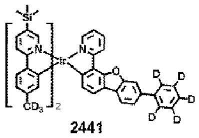
2441

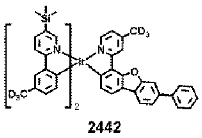
2442

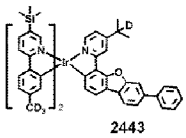
2443

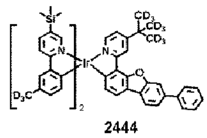
2444

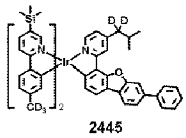
2445

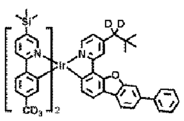
2446

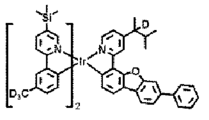
2447

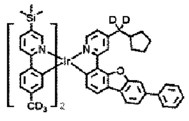
2448

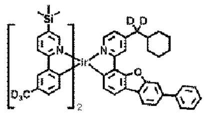
2449

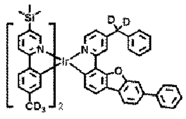
2450

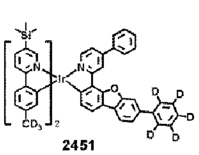
2451

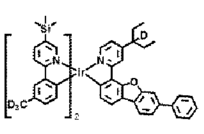
2452

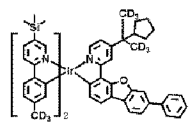
2453

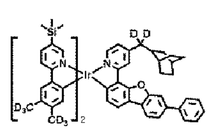
2454

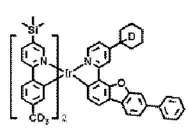
2455

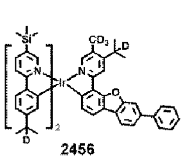
2456

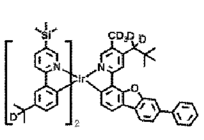
2457

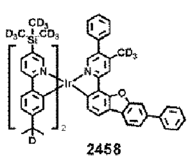
2458

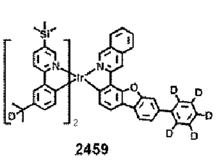
2459

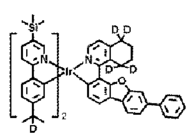
2460

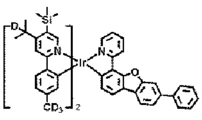
2461

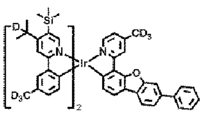
2462

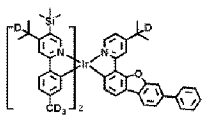
2463

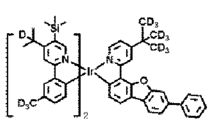
2464

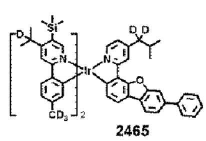
2465

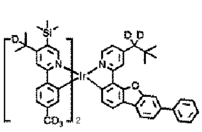
2466

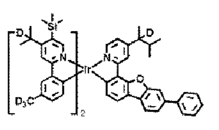
2467

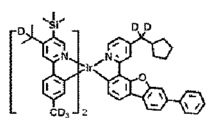
2468

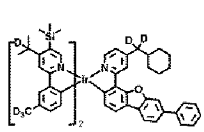
2469

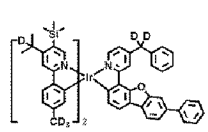
2470

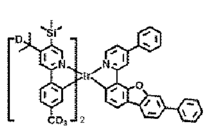
2471

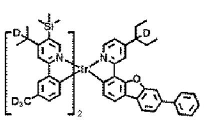
2472

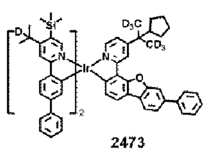
2473

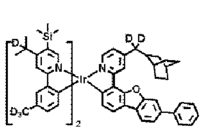
2474

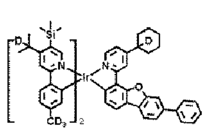
2475

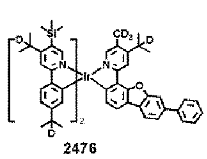
2476

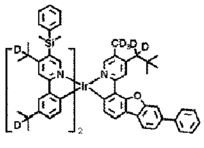
2477

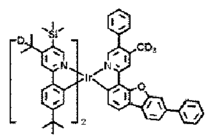
2478

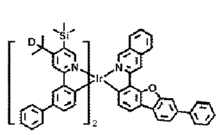
2479

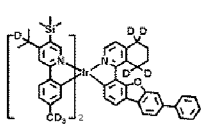
2480

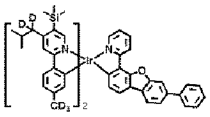
2481
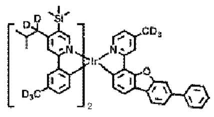
2482
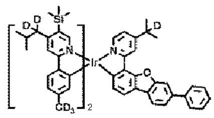
2483
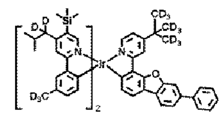
2484
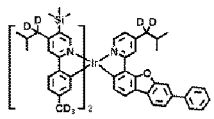
2485

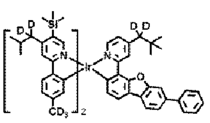
2486
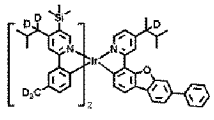
2487
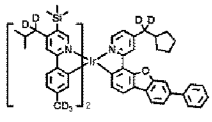
2488
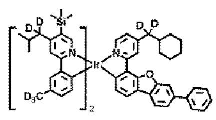
2489
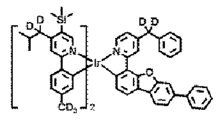
2490

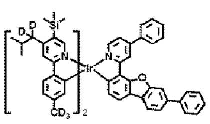
2491
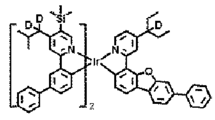
2492
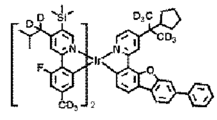
2493
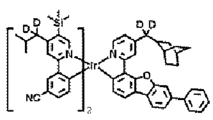
2494
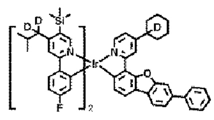
2495

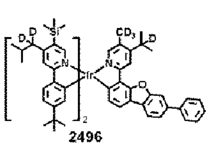
2496
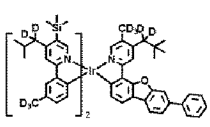
2497
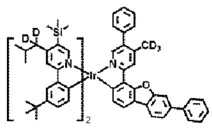
2498
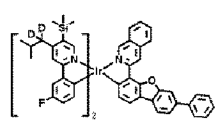
2499
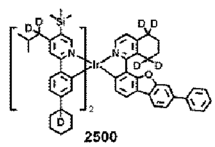
2500

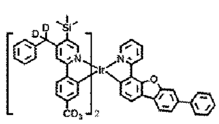
2501
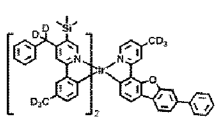
2502
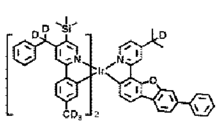
2503
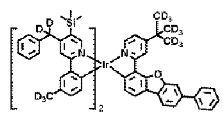
2504
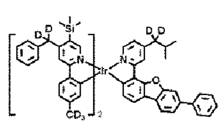
2505

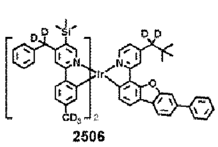
2506
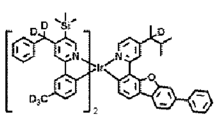
2507
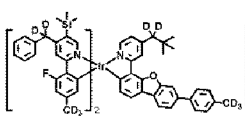
2508
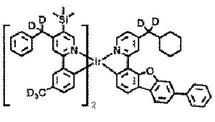
2509
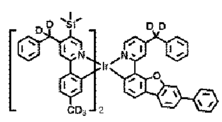
2510

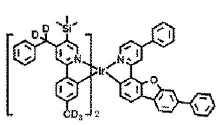
2511
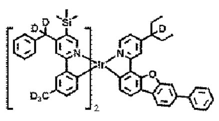
2512
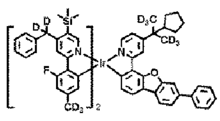
2513
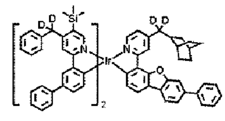
2514
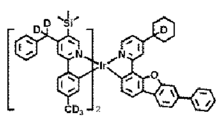
2515

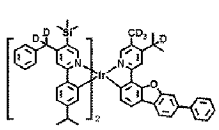
2516
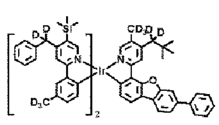
2517
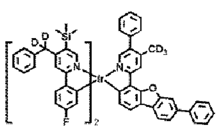
2518
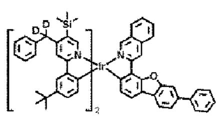
2519
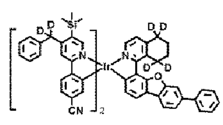
2520

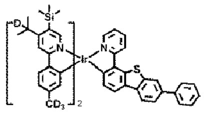
2521
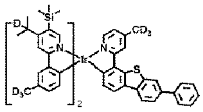
2522
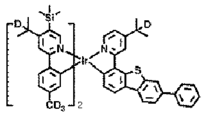
2523
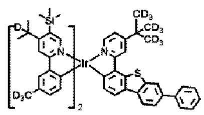
2524
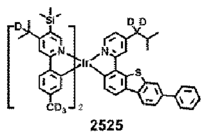
2525

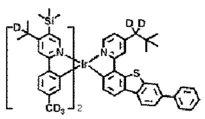
2526
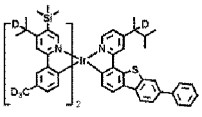
2527
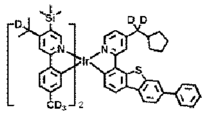
2528
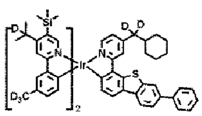
2529
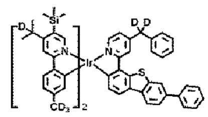
2530

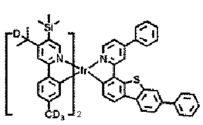
2531
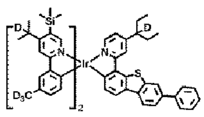
2532
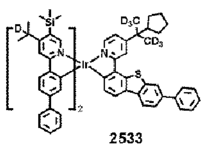
2533
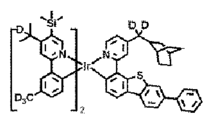
2534
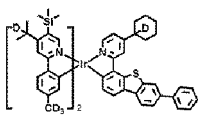
2535

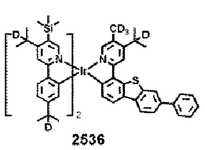
2536
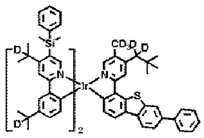
2537
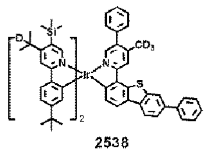
2538
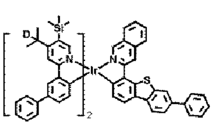
2539
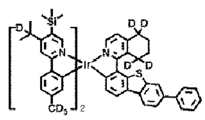
2540

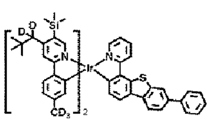
2541
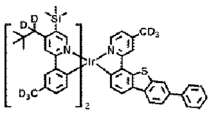
2542
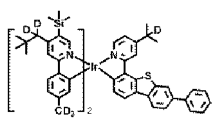
2543
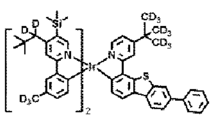
2544
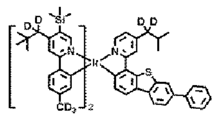
2545

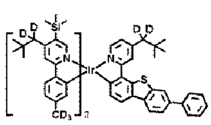
2546
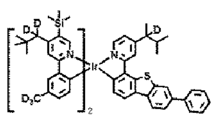
2547
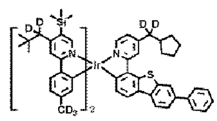
2548
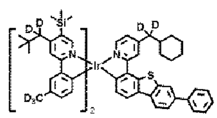
2549
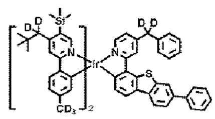
2550

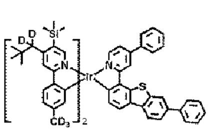
2551
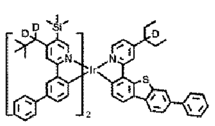
2552
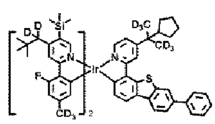
2553
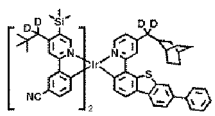
2554
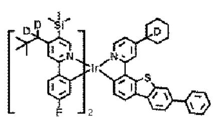
2555

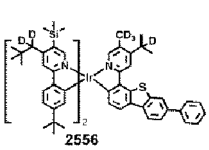
2556
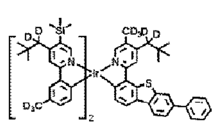
2557
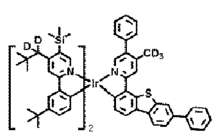
2558
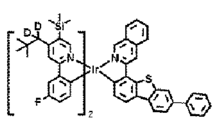
2559
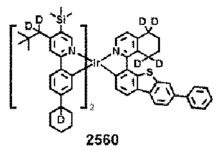
2560

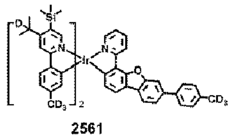
2561
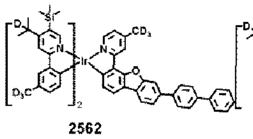
2562
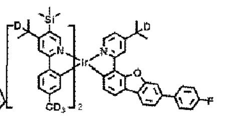
2563
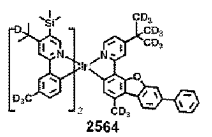
2564
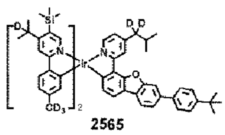
2565

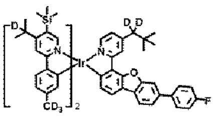
2566
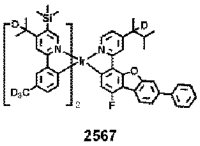
2567
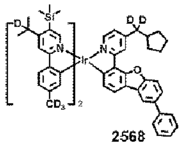
2568
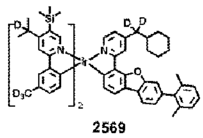
2569
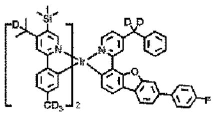
2570

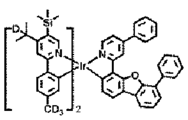
2571
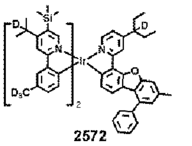
2572
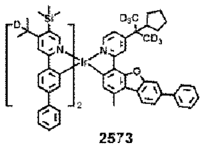
2573
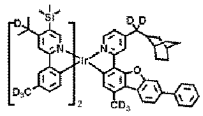
2574
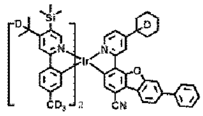
2575

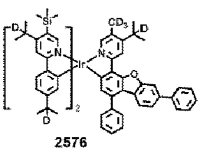
2576
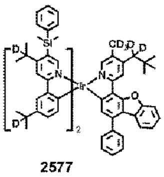
2577
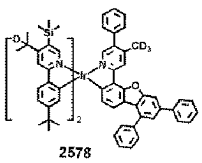
2578
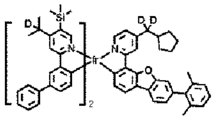
2579
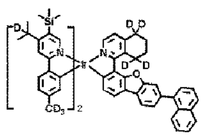
2580

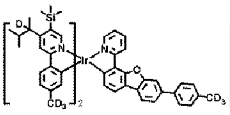
2581
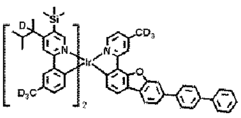
2582
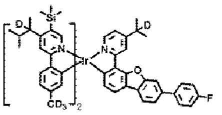
2583
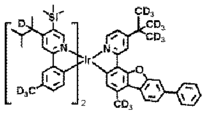
2584
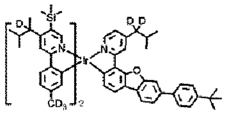
2585

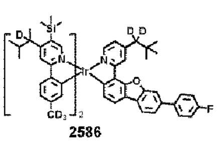
2586
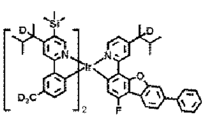
2587
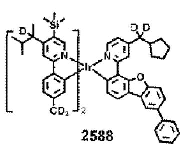
2588
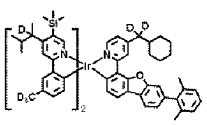
2589
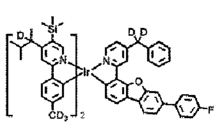
2590

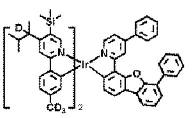
2591
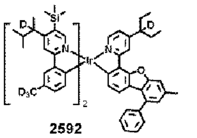
2592
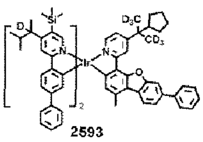
2593
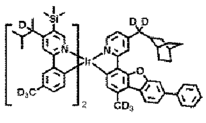
2594
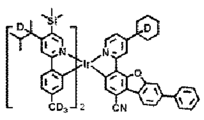
2595

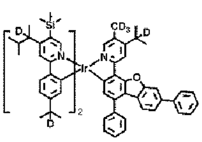
2596
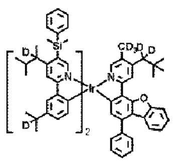
2597
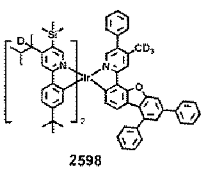
2598
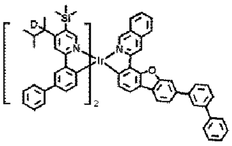
2599
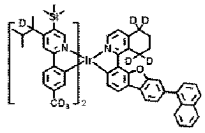
2600

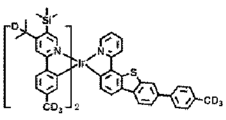
2601
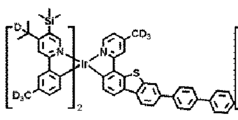
2602
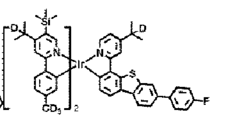
2603
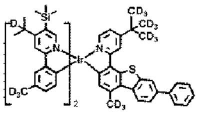
2604
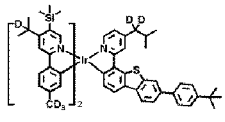
2605

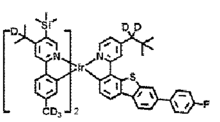
2606
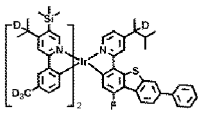
2607
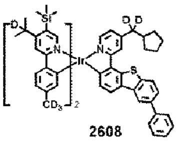
2608
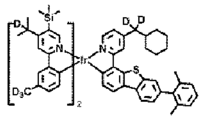
2609
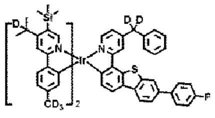
2610

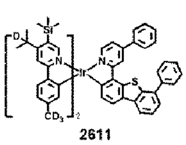
2611
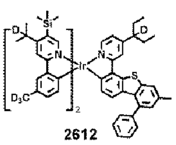
2612
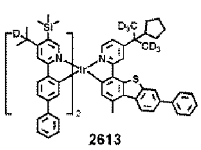
2613
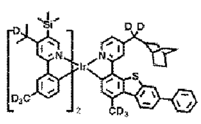
2614
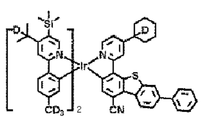
2615

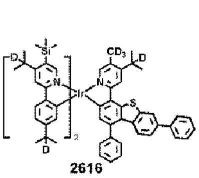
2616
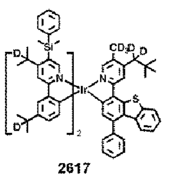
2617
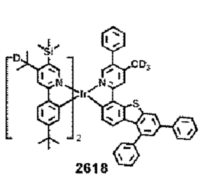
2618
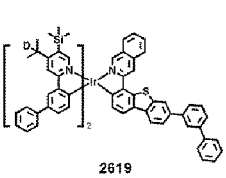
2619
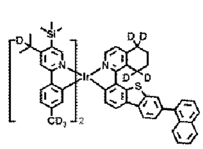
2620

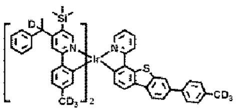
2621
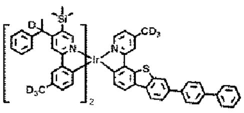
2622
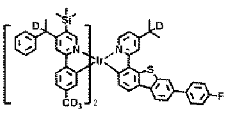
2623
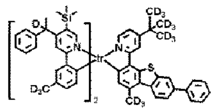
2624
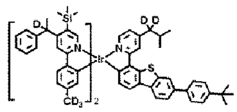
2625

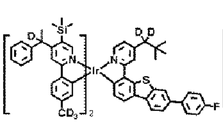
2626
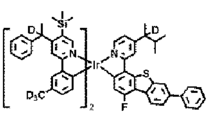
2627
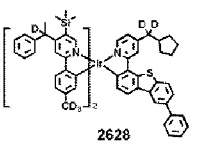
2628
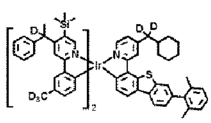
2629
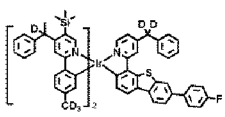
2630

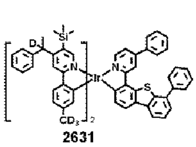
2631
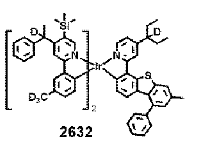
2632
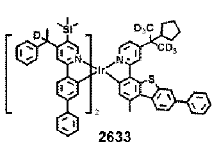
2633
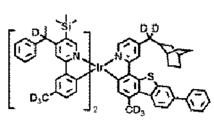
2634
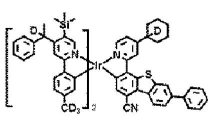
2635

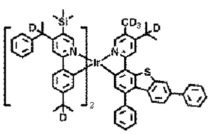
2636
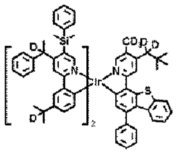
2637
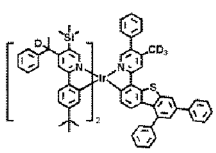
2638
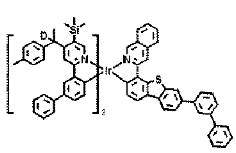
2639
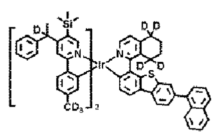
2640

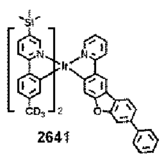
2641
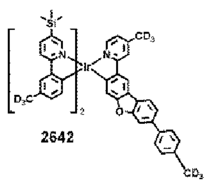
2642
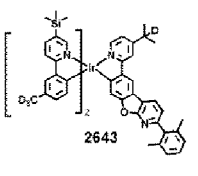
2643
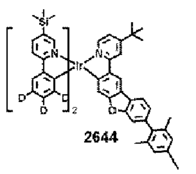
2644
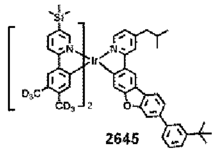
2645
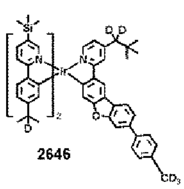
2646
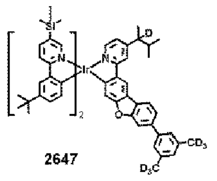
2647
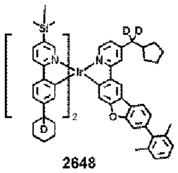
2648
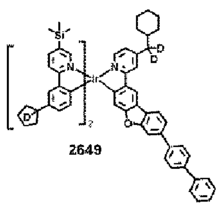
2649
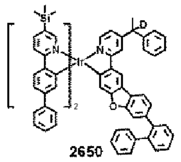
2650
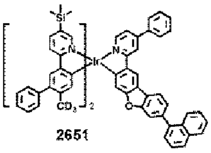
2651
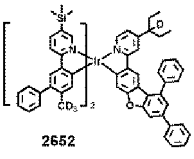
2652
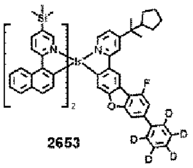
2653
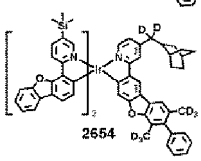
2654
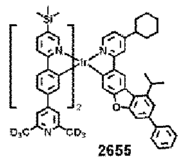
2655
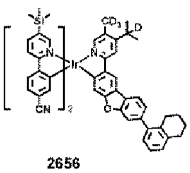
2656
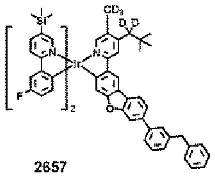
2657
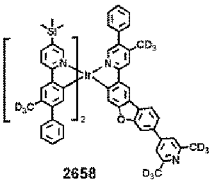
2658
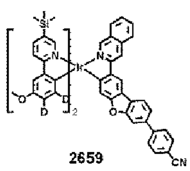
2659
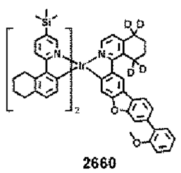
2660
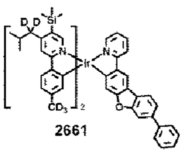
2661
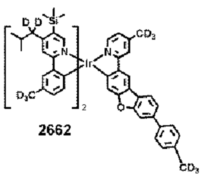
2662
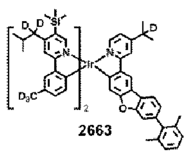
2663
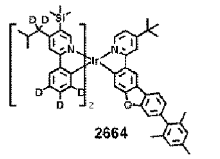
2664
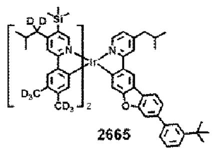
2665
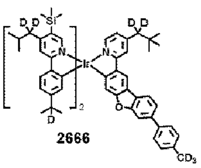
2666
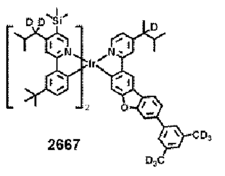
2667
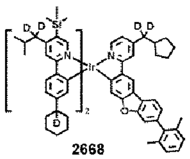
2668
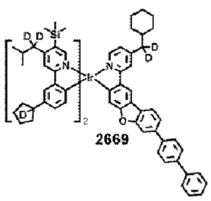
2669
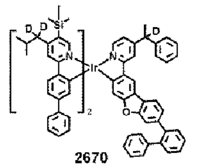
2670
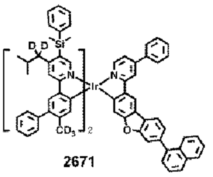
2671
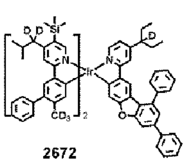
2672
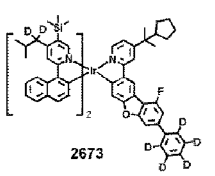
2673
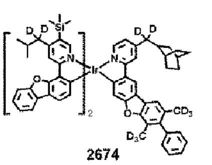
2674
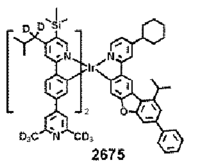
2675
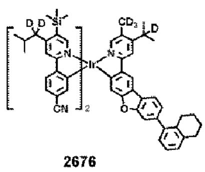
2676
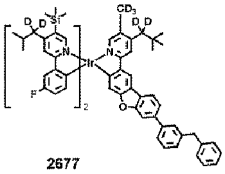
2677
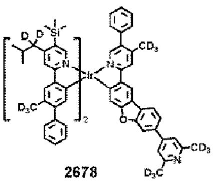
2678
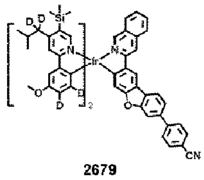
2679
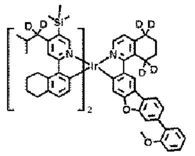
2680

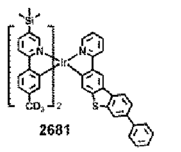
2681

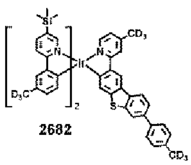
2682

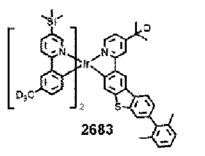
2683

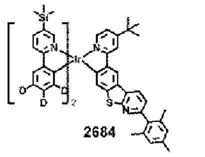
2684

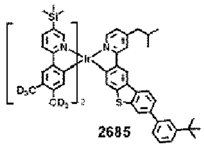
2685

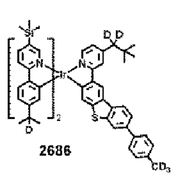
2686

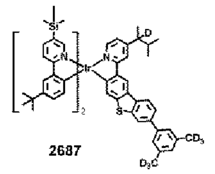
2687

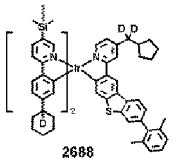
2688

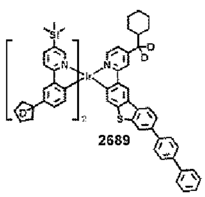
2689

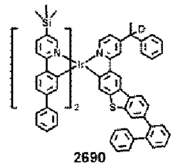
2690

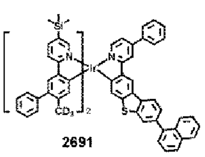
2691

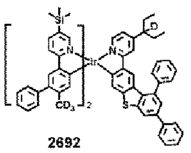
2692

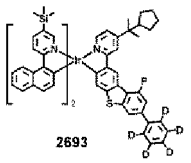
2693

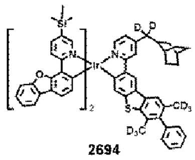
2694

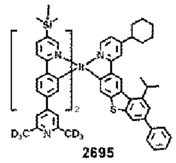
2695

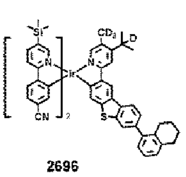
2696

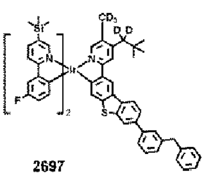
2697

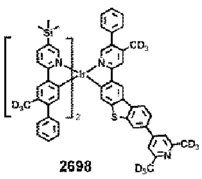
2698

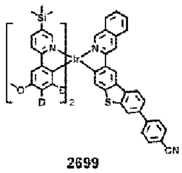
2699

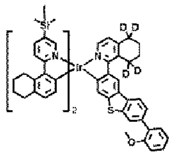
2700

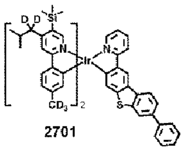
2701

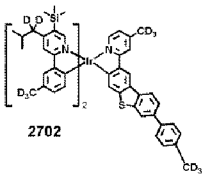
2702

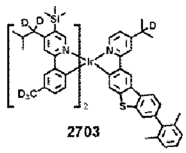
2703

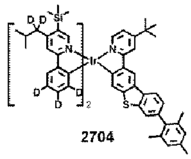
2704

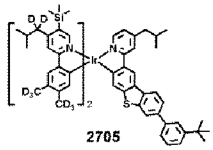
2705

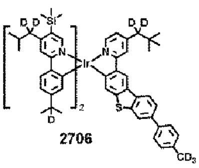
2706

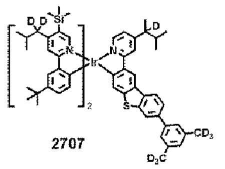
2707

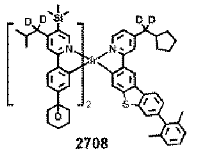
2708

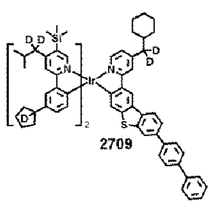
2709

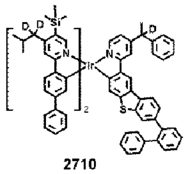
2710

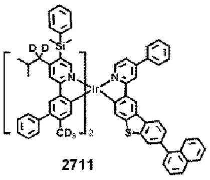
2711

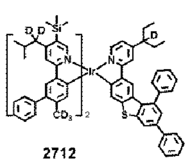
2712

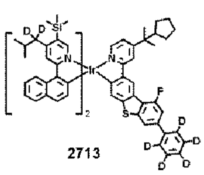
2713

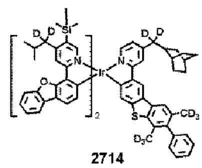
2714

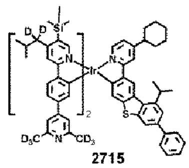
2715

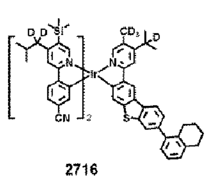
2716

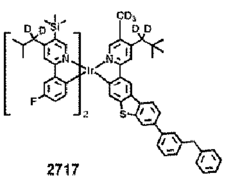
2717

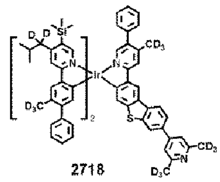
2718

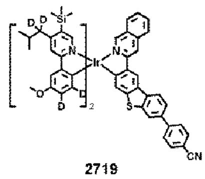
2719

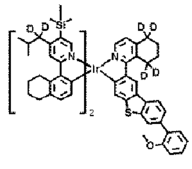
2720

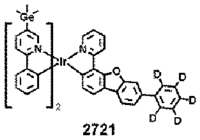
2721

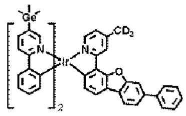
2722

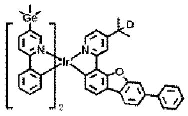
2723

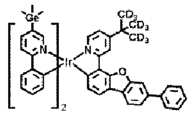
2724

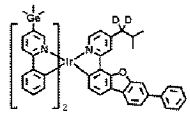
2725

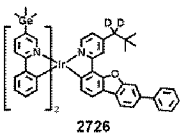
2726

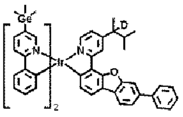
2727

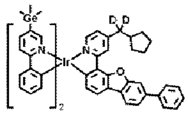
2728

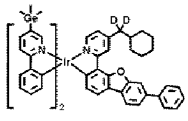
2729

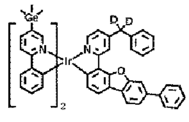
2730

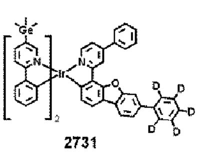
2731

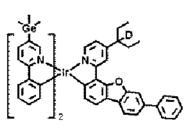
2732

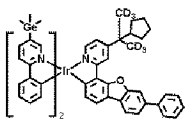
2733

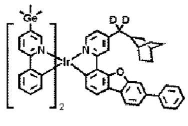
2734

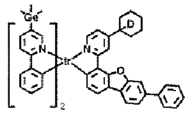
2735

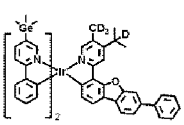
2736

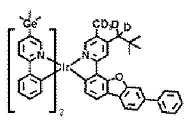
2737

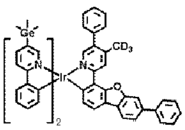
2738

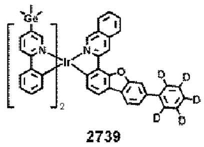
2739

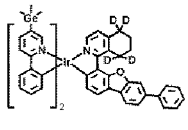
2740

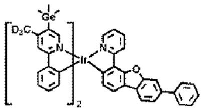
2741

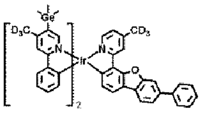
2742

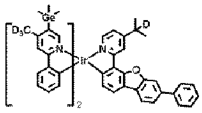
2743

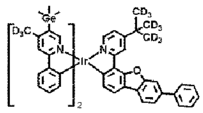
2744

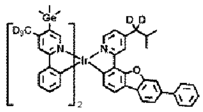
2745

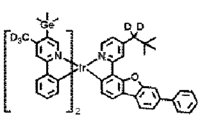
2746

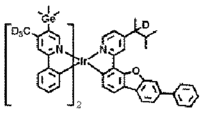
2747

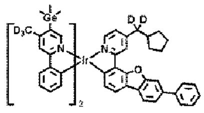
2748

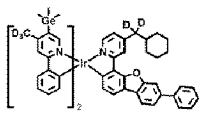
2749

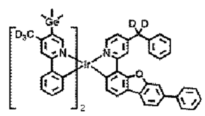
2750

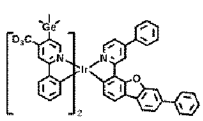
2751

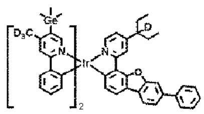
2752

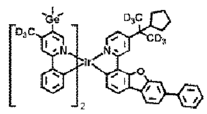
2753

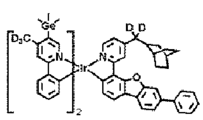
2754

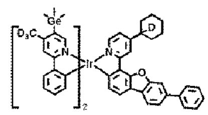
2755

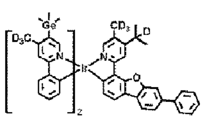
2756

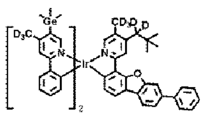
2757

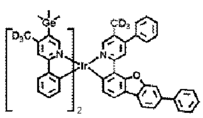
2758

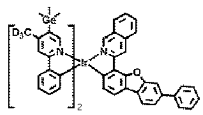
2759

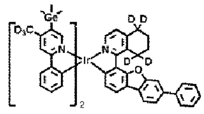
2760

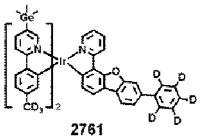
2761
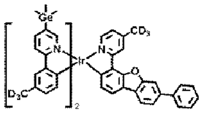
2762
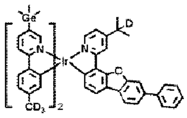
2763
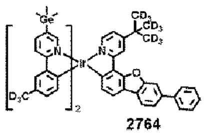
2764
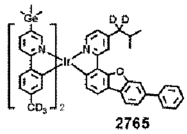
2765
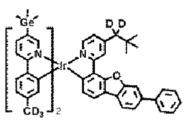
2766
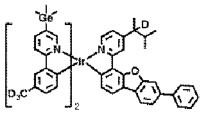
2767
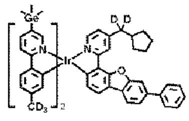
2768
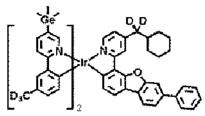
2769
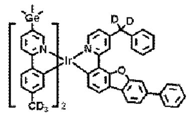
2770
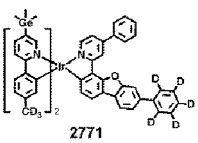
2771
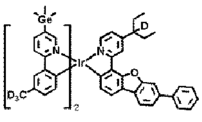
2772
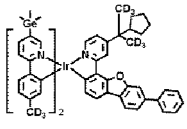
2773
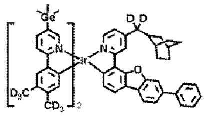
2774
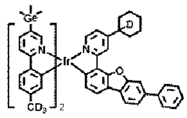
2775
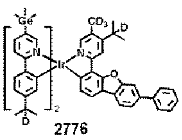
2776
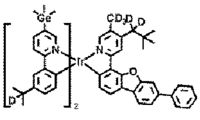
2777
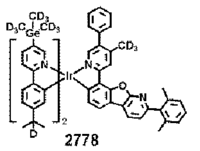
2778
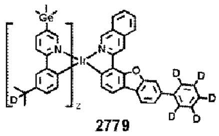
2779
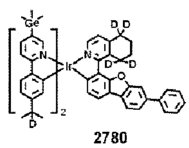
2780
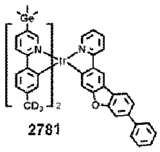
2781
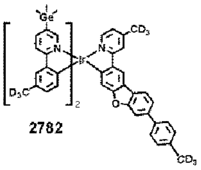
2782
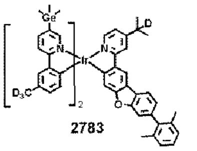
2783
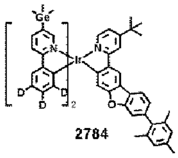
2784
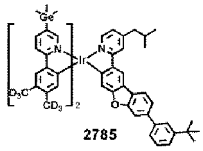
2785
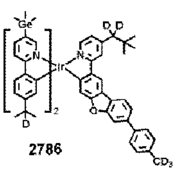
2786
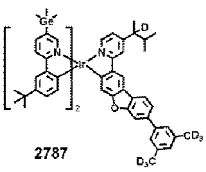
2787
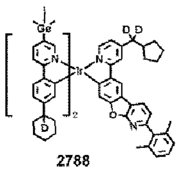
2788
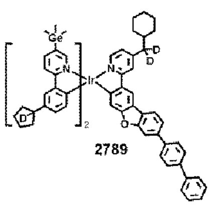
2789
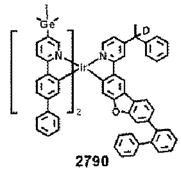
2790
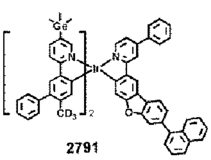
2791
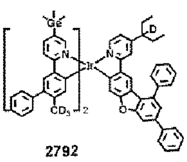
2792
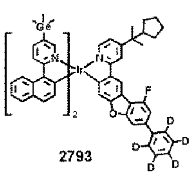
2793
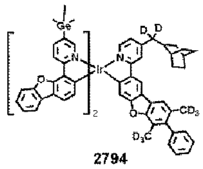
2794
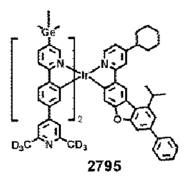
2795
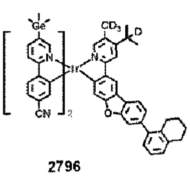
2796
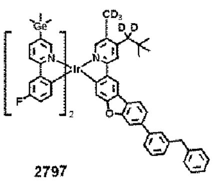
2797
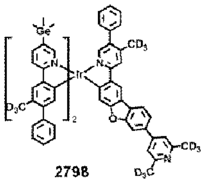
2798
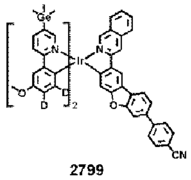
2799
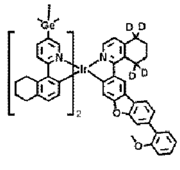
2800

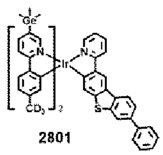
2801

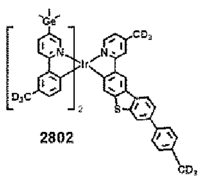
2802

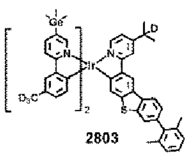
2803

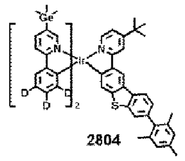
2804

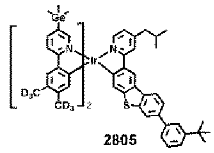
2805

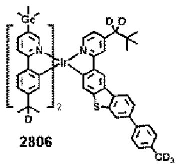
2806

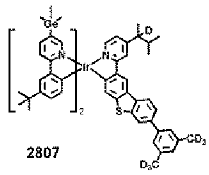
2807

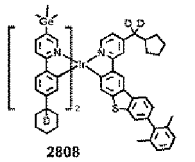
2808

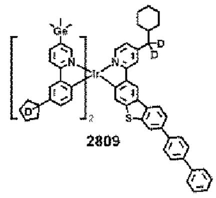
2809

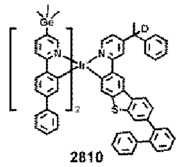
2810

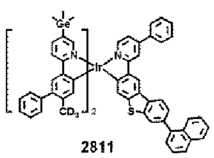
2811

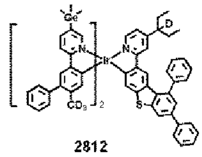
2812

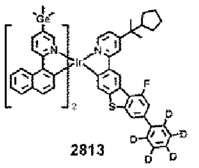
2813

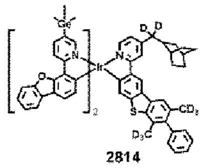
2814

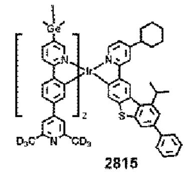
2815

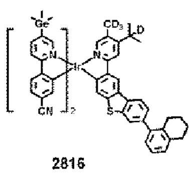
2816

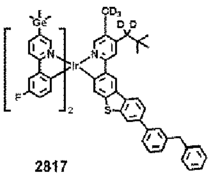
2817

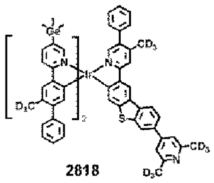
2818

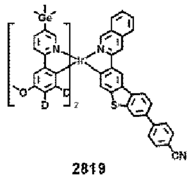
2819

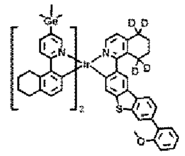
2820

## Group 1-7

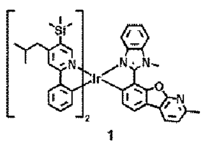
1

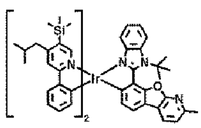
2

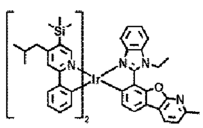
3

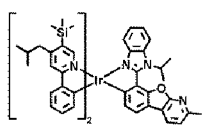
4

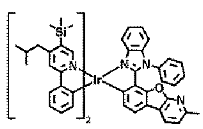
5

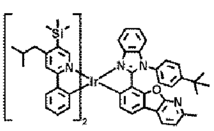
6

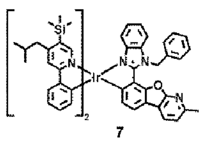
7

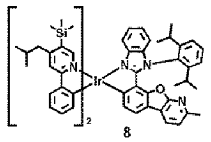
8

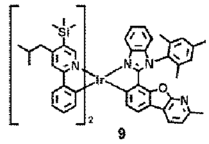
9

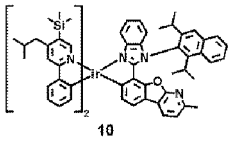
10

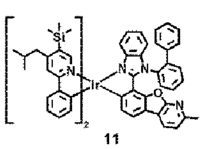
11

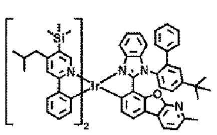
12

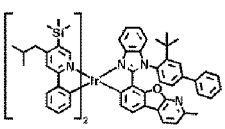
13

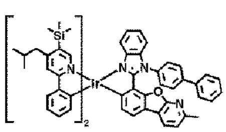
14

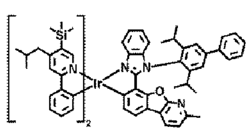
15

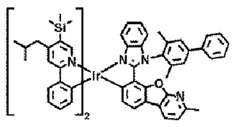
16

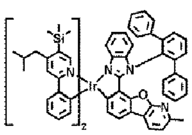
17

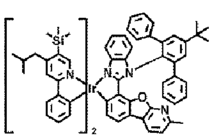
18

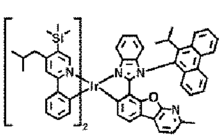
19

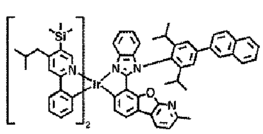
20

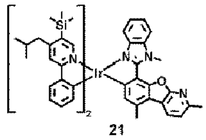
21
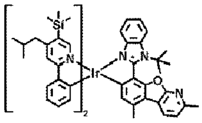
22
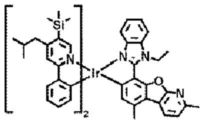
23
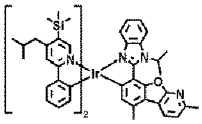
24
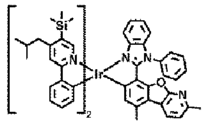
25

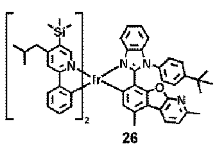
26
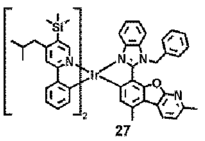
27
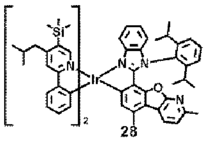
28
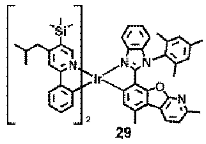
29
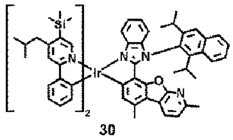
30

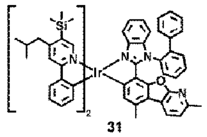
31
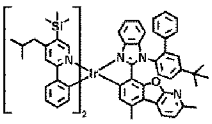
32
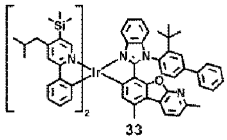
33
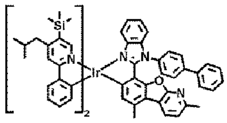
34
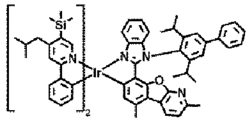
35

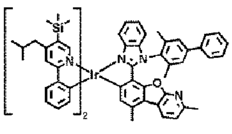
36
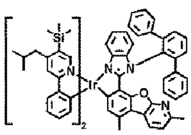
37
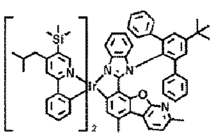
38
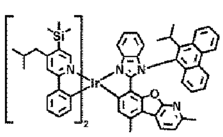
39
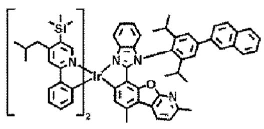
40

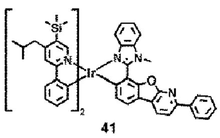
41
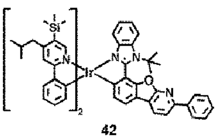
42
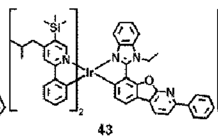
43
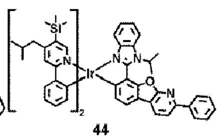
44
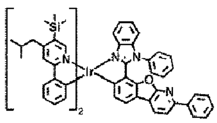
45

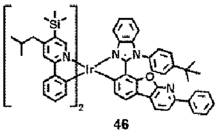
46
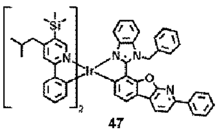
47
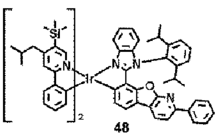
48
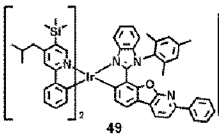
49
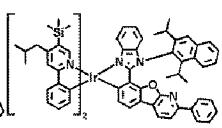
50

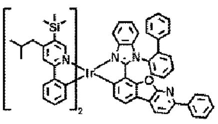
51
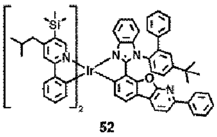
52
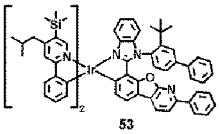
53
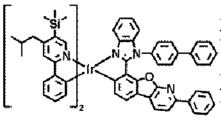
54
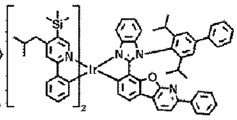
55

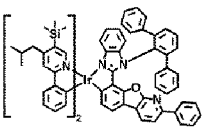
56
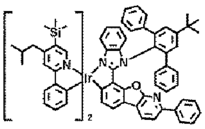
57
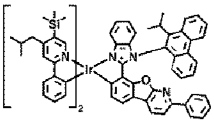
58
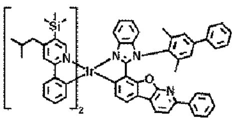
59
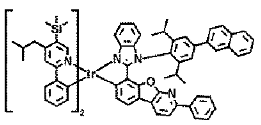
60

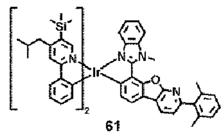
61
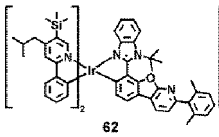
62
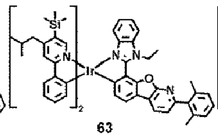
63
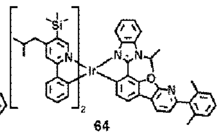
64
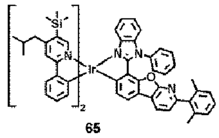
65
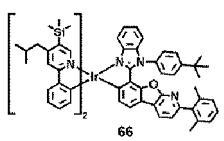
66
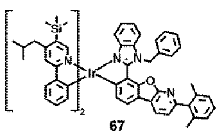
67
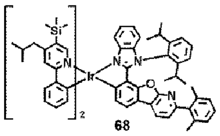
68
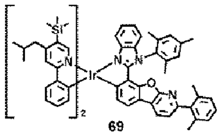
69
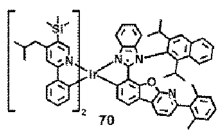
70
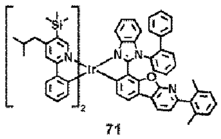
71
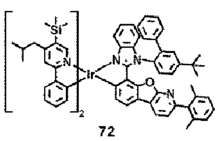
72
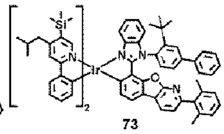
73
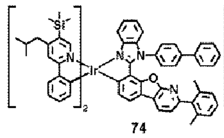
74
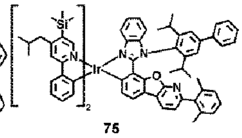
75
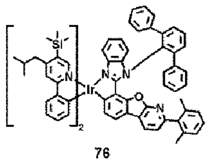
76
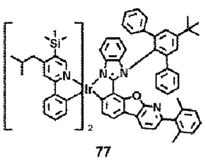
77
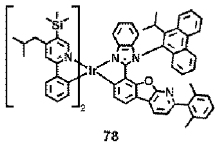
78
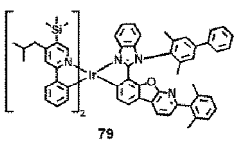
79
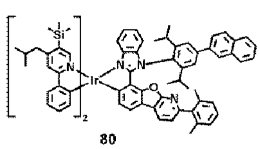
80
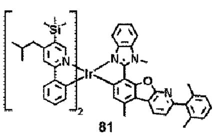
81
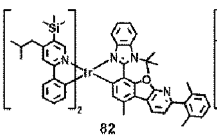
82
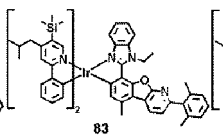
83
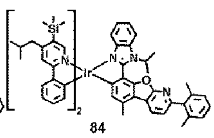
84
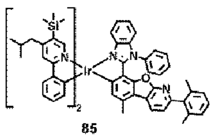
85
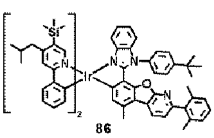
86
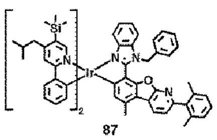
87
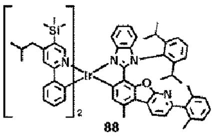
88
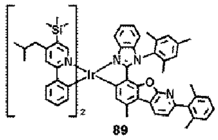
89
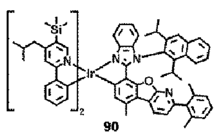
90
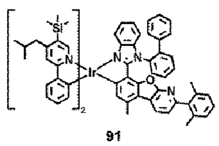
91
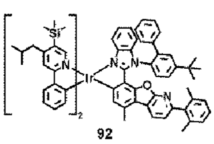
92
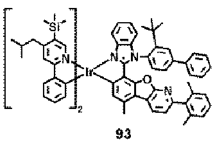
93
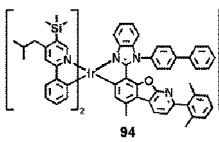
94
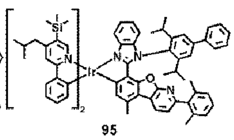
95
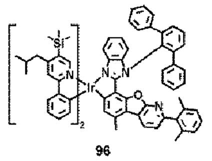
96
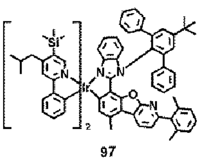
97
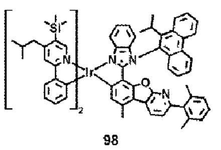
98
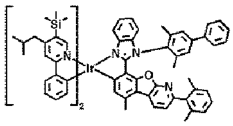
99
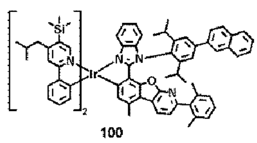
100

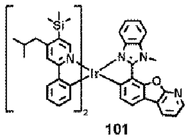
101
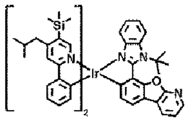
102
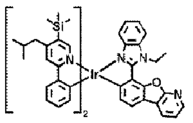
103
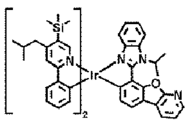
104
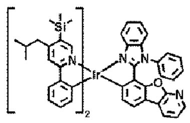
105

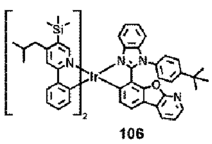
106
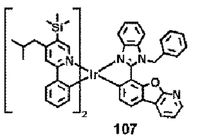
107
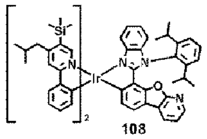
108
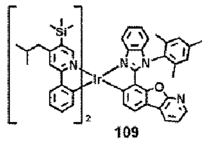
109
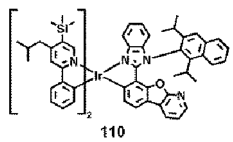
110

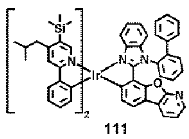
111
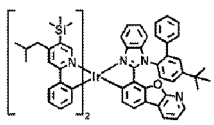
112
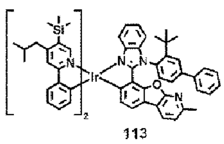
113
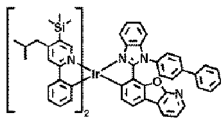
114
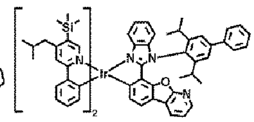
115

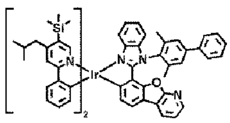
116
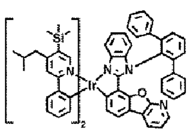
117
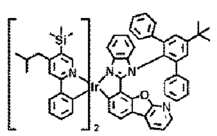
118
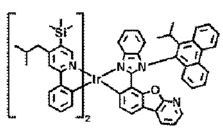
119
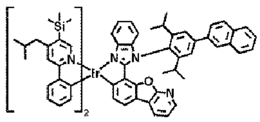
120

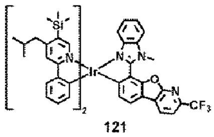
121
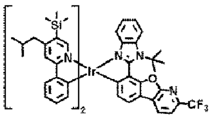
122
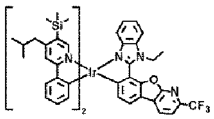
123
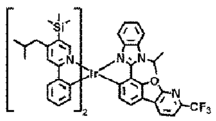
124
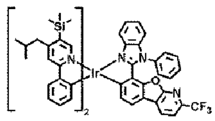
125

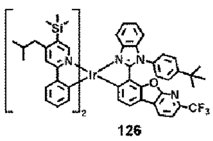
126
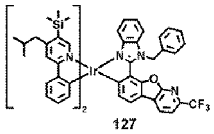
127
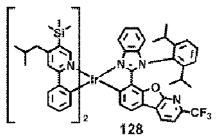
128
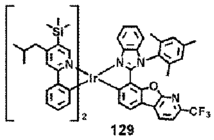
129
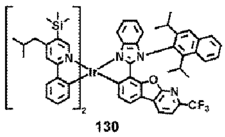
130

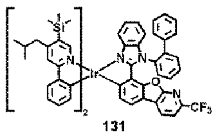
131
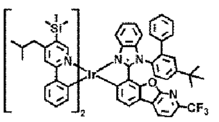
132
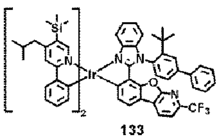
133
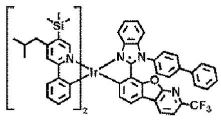
134
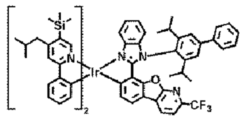
135

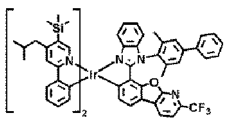
136
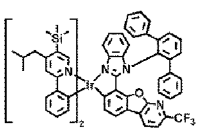
137
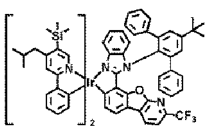
138
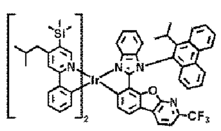
139
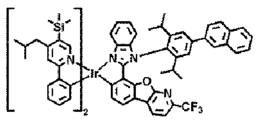
140

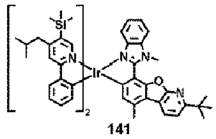
141
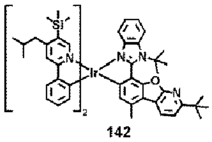
142
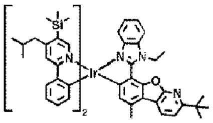
143
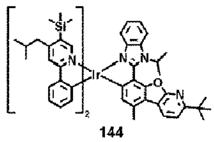
144
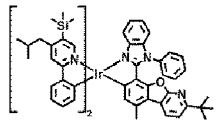
145
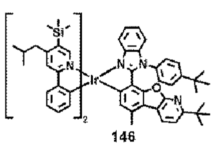
146
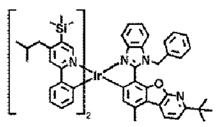
147
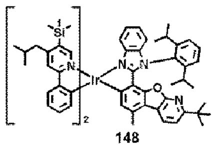
148
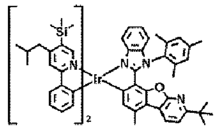
149
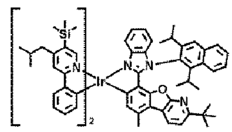
150
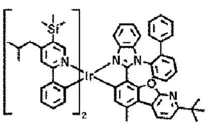
151
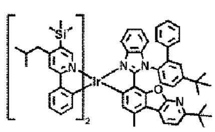
152
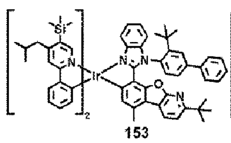
153
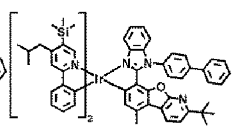
154
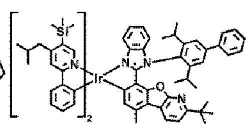
155
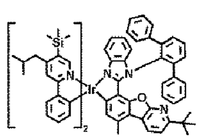
156
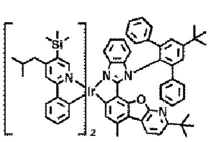
157
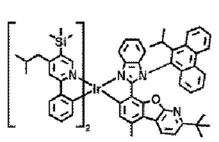
158
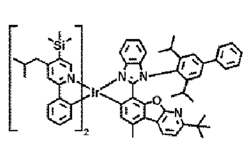
159
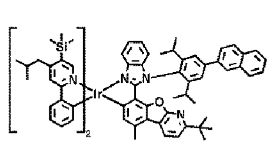
160
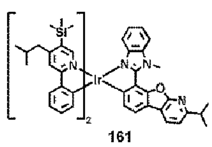
161
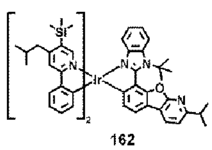
162
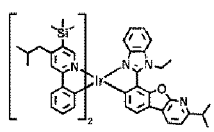
163
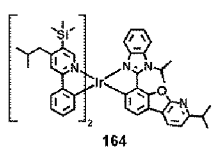
164
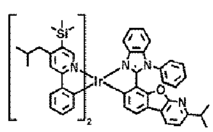
165
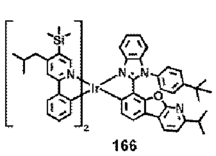
166
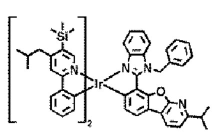
167
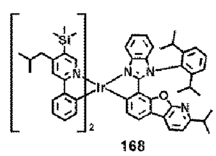
168
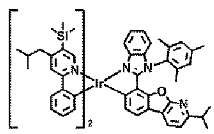
169
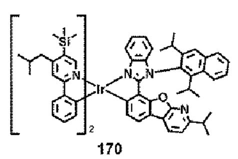
170
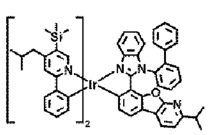
171
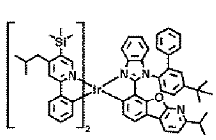
172
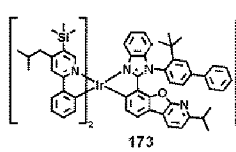
173
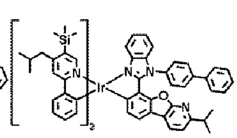
174
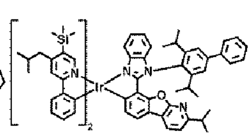
175
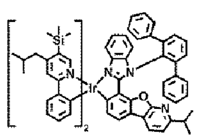
176
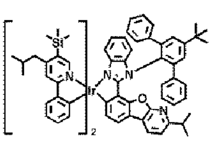
177
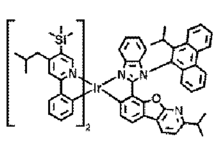
178
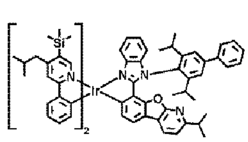
179
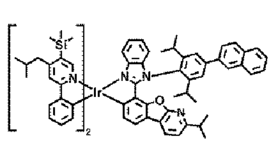
180

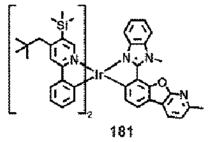
181
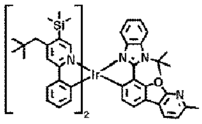
182
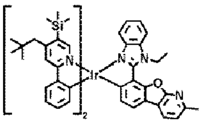
183
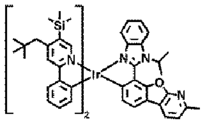
184
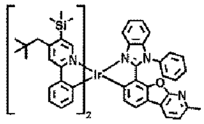
185

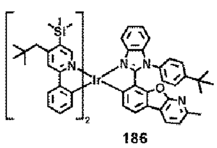
186
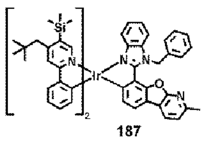
187
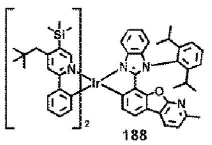
188
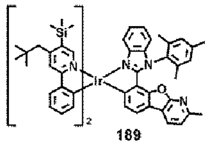
189
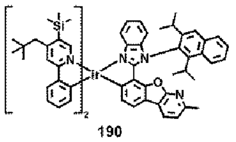
190

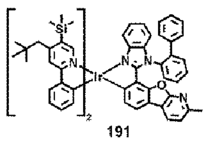
191
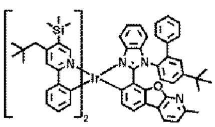
192
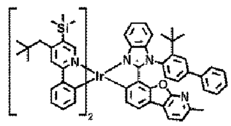
193
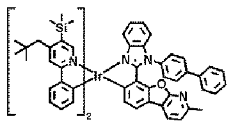
194
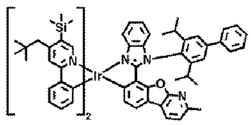
195

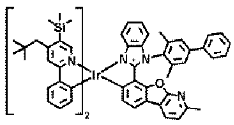
196
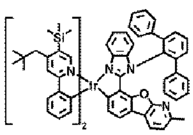
197
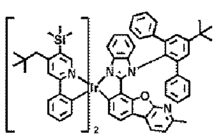
198
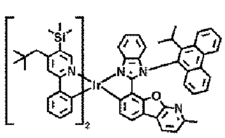
199
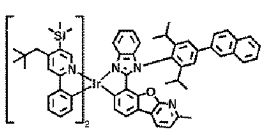
200

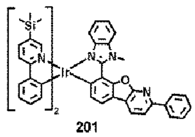
201
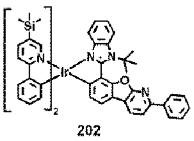
202
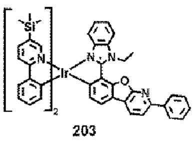
203
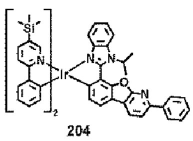
204
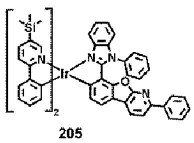
205

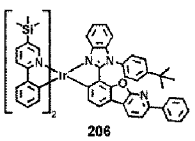
206
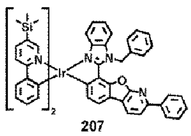
207
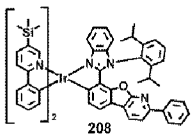
208
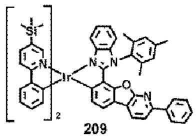
209
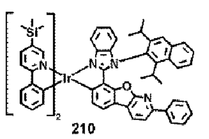
210

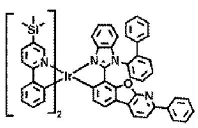
211
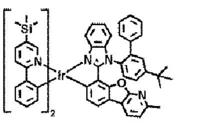
212
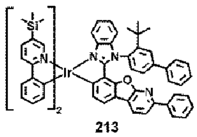
213
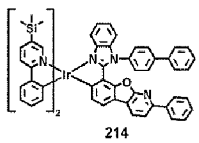
214
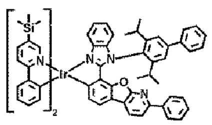
215

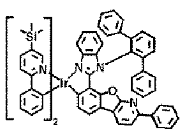
216
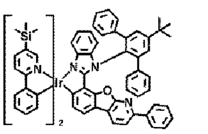
217
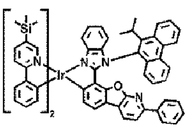
218
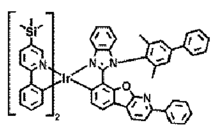
219
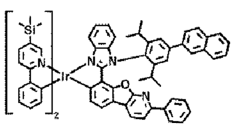
220

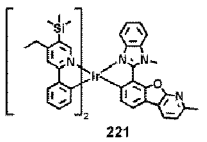
221
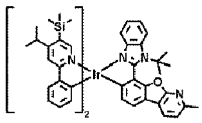
222
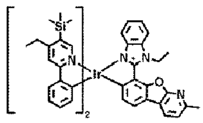
223
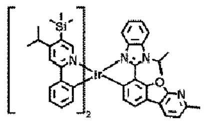
224
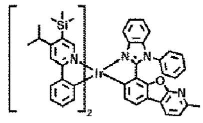
225
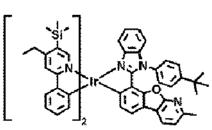
226
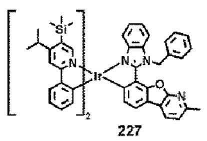
227
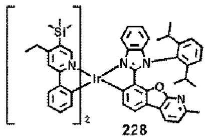
228
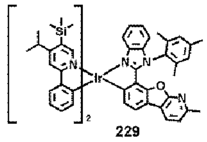
229
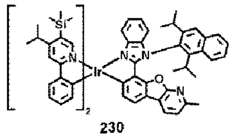
230
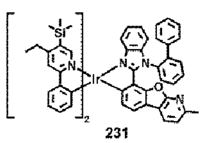
231
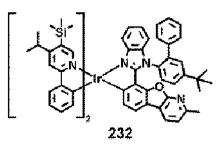
232
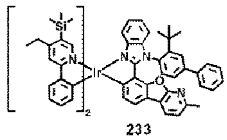
233
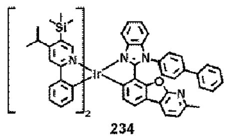
234
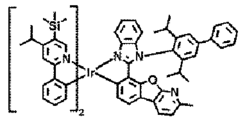
235
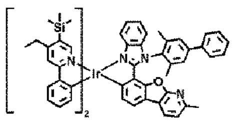
236
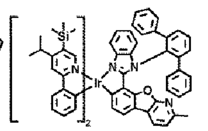
237
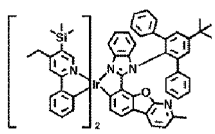
238
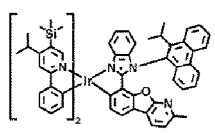
239
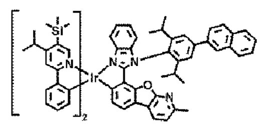
240
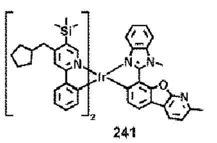
241
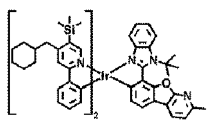
242
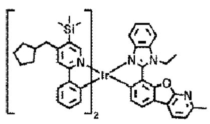
243
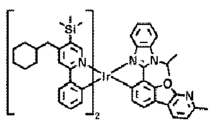
244
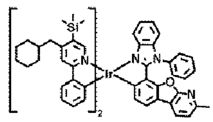
245
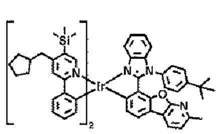
246
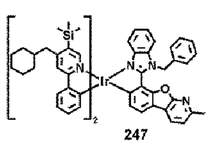
247
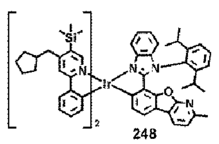
248
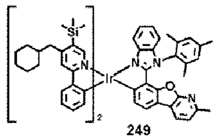
249
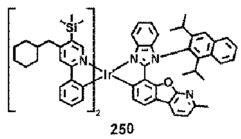
250
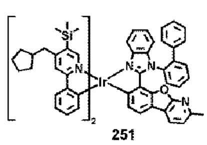
251
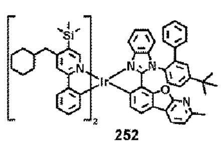
252
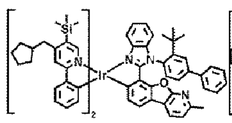
253
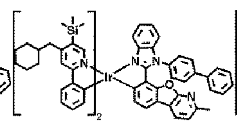
254
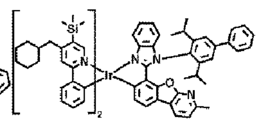
255
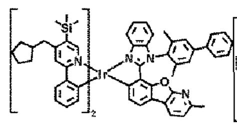
256
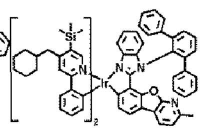
257
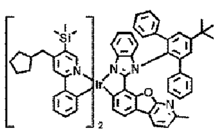
258
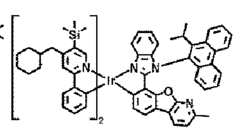
259
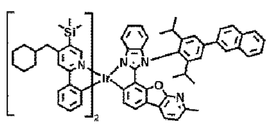
260

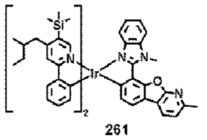
261
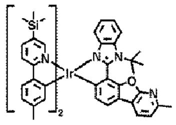
262
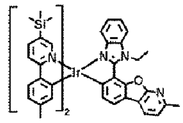
263
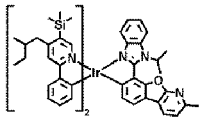
264
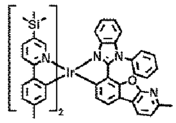
265

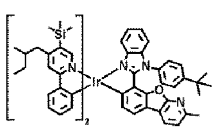
266
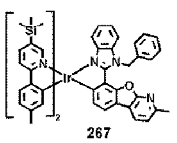
267
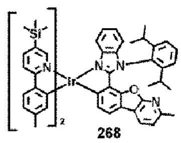
268
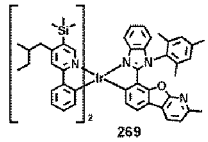
269
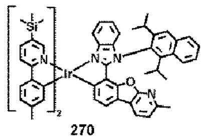
270

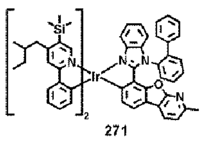
271
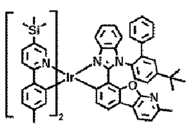
272
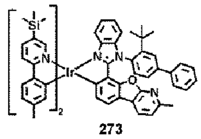
273
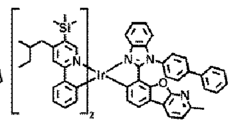
274
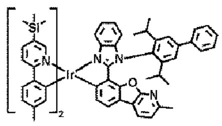
275

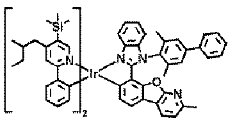
276
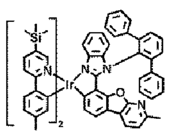
277
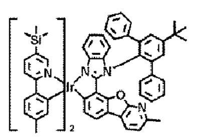
278
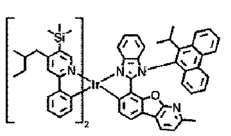
279
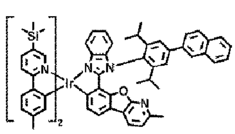
280

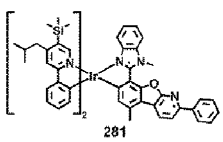
281
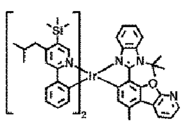
282
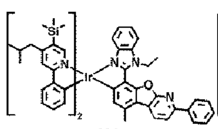
283
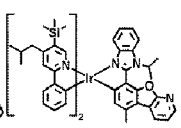
284
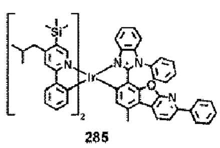
285

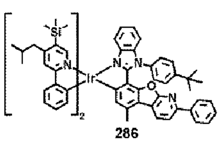
286
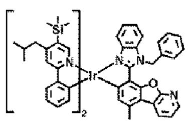
287
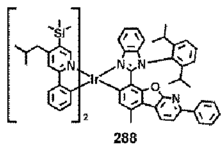
288
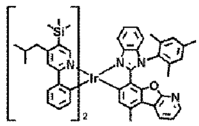
289
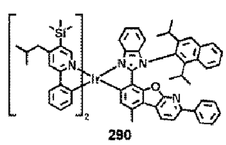
290

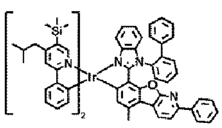
291
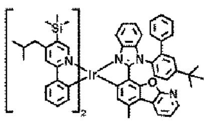
292
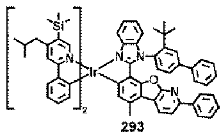
293
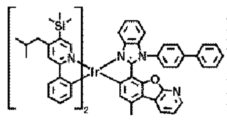
294
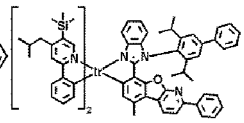
295

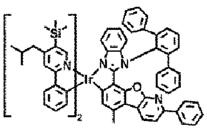
296
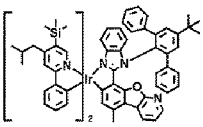
297
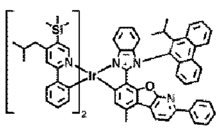
298
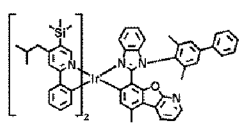
299
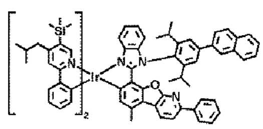
300

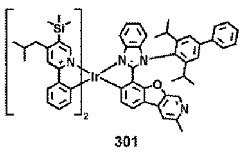
301
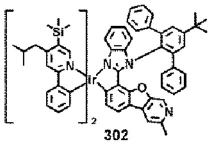
302
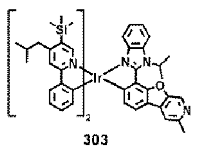
303
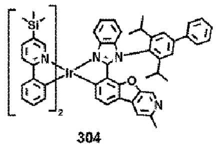
304
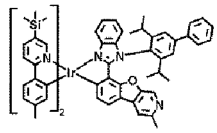
305
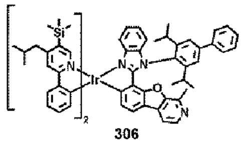
306
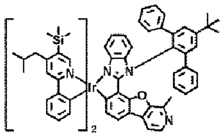
307
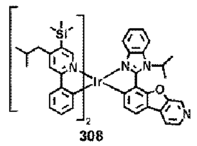
308
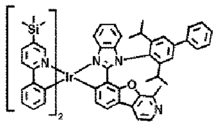
309
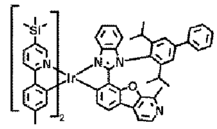
310
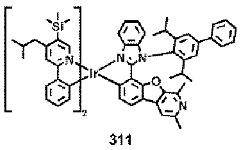
311
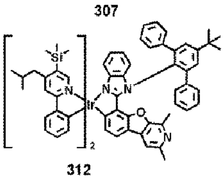
312
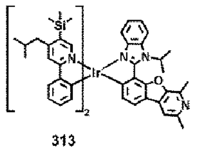
313
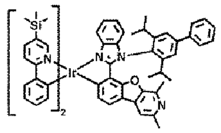
314
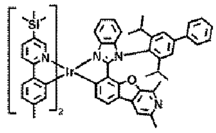
315
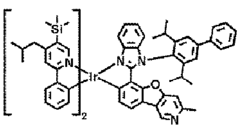
316
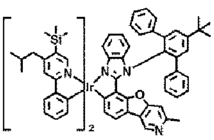
317
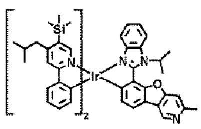
318
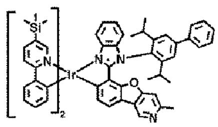
319
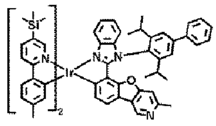
320
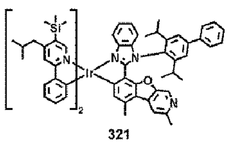
321
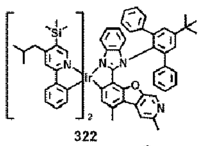
322
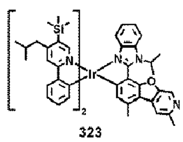
323
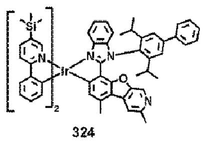
324
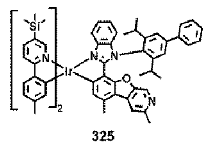
325
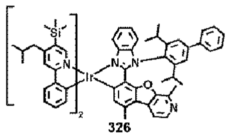
326
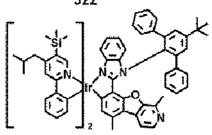
327
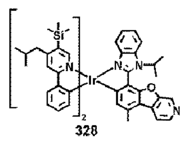
328
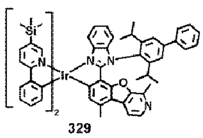
329
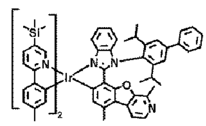
330
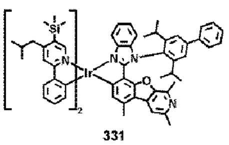
331
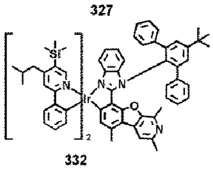
332
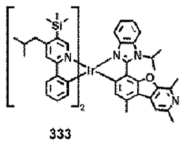
333
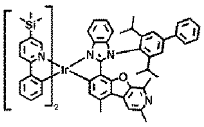
334
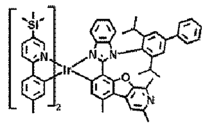
335
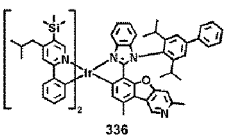
336
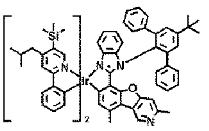
337
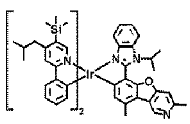
338
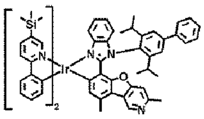
339
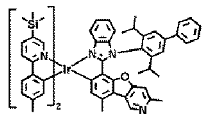
340

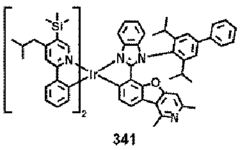
341
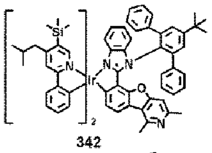
342
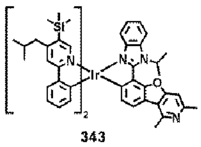
343
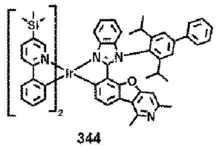
344
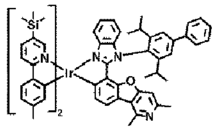
345
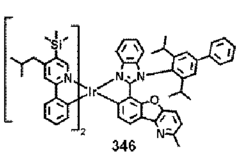
346
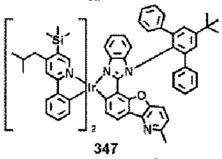
347
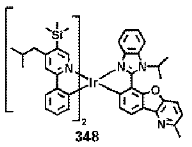
348
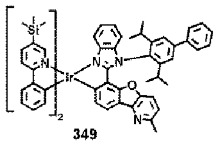
349
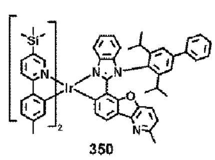
350
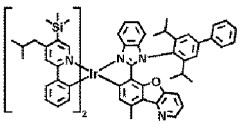
351
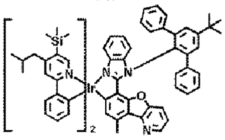
352
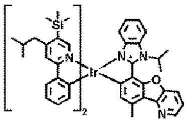
353
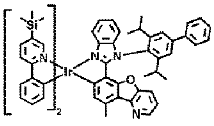
354
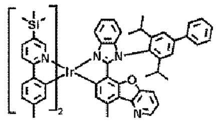
355
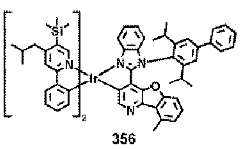
356
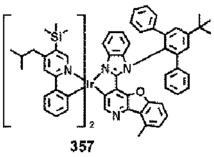
357
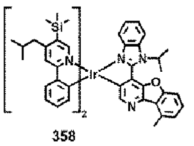
358
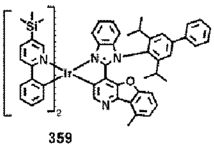
359
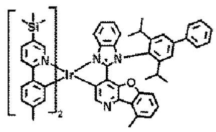
360
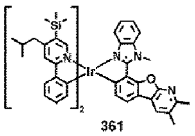
361
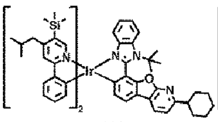
362
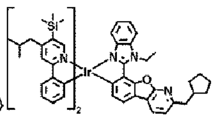
363
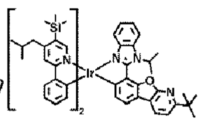
364
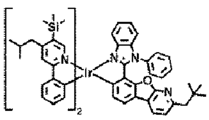
365
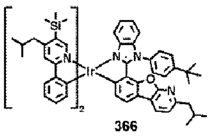
366
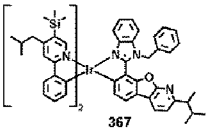
367
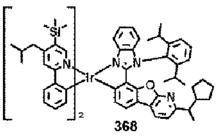
368
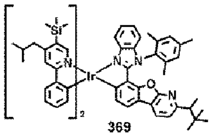
369
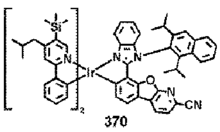
370
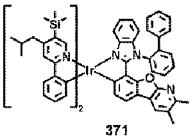
371
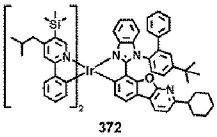
372
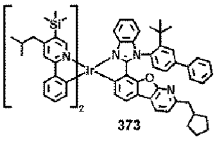
373
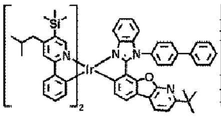
374
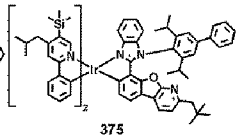
375
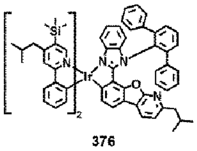
376
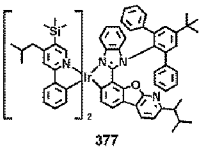
377
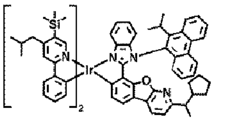
378
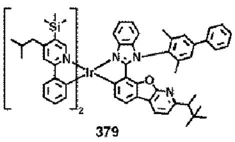
379
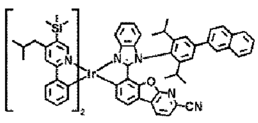
380

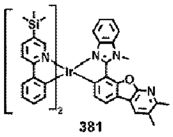
381
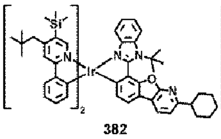
382
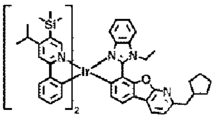
383
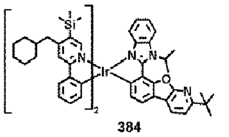
384
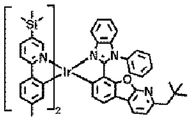
385
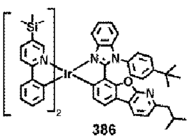
386
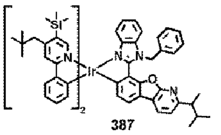
387
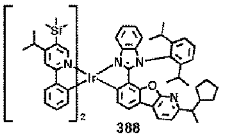
388
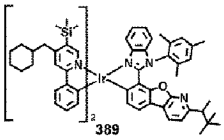
389
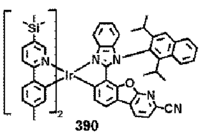
390
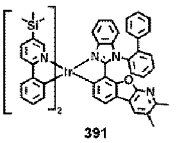
391
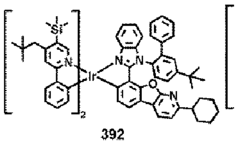
392
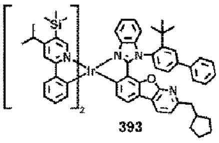
393
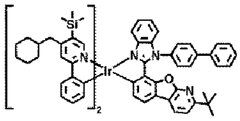
394
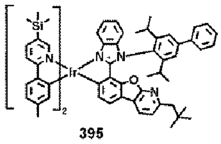
395
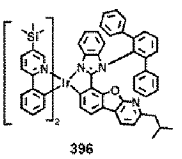
396
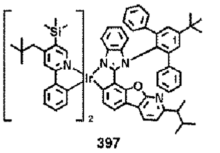
397
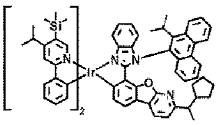
398
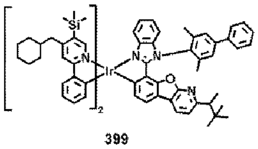
399
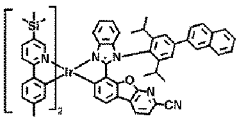
400
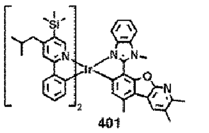
401
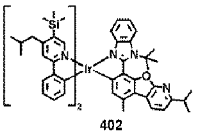
402
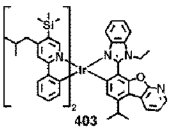
403
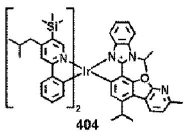
404
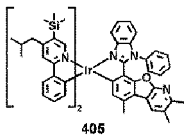
405
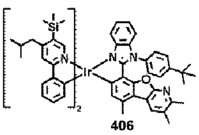
406
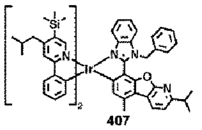
407
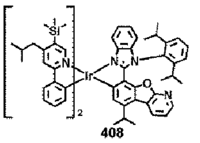
408
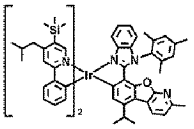
409
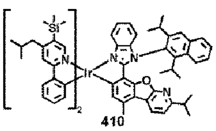
410
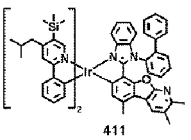
411
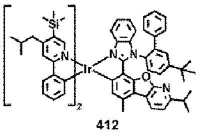
412
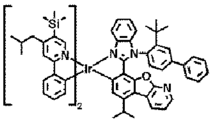
413
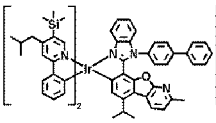
414
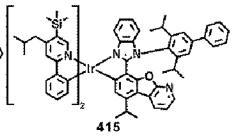
415
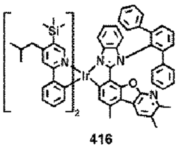
416
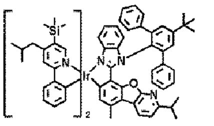
417
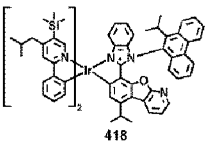
418
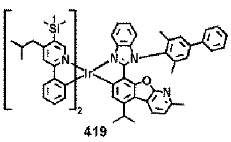
419
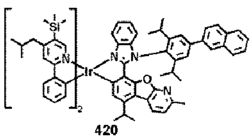
420

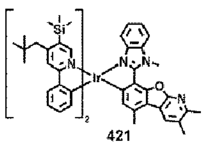
421
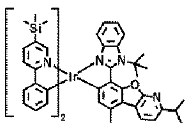
422
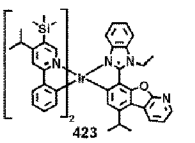
423
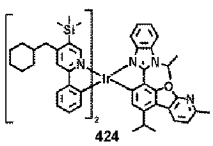
424
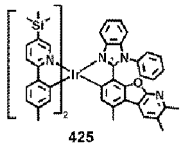
425
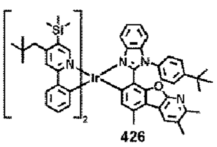
426
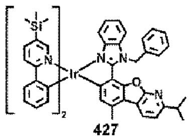
427
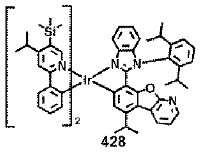
428
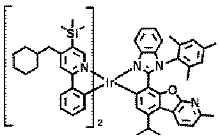
429
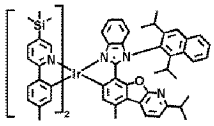
430
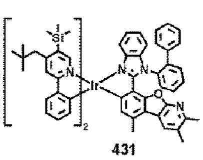
431
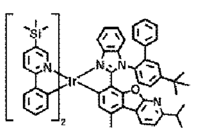
432
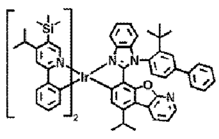
433
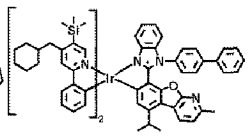
434
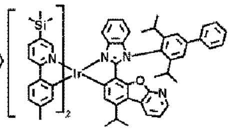
435
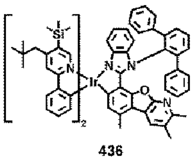
436
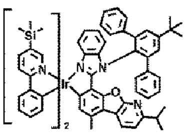
437
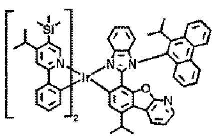
438
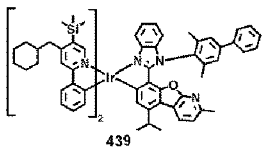
439
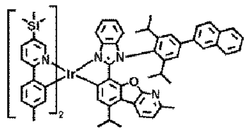
440
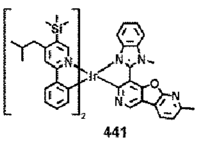
441
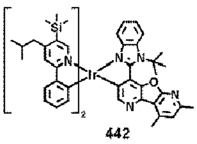
442
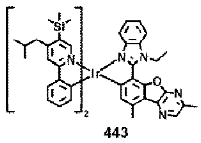
443
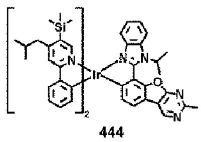
444
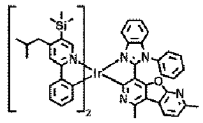
445
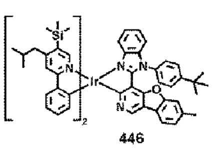
446
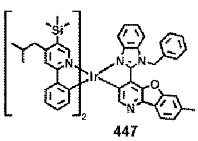
447
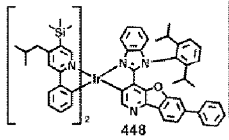
448
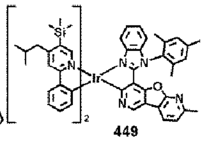
449
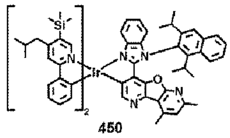
450
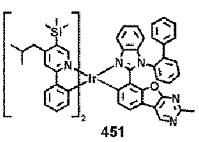
451
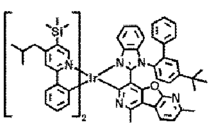
452
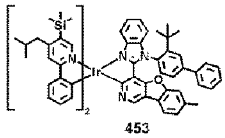
453
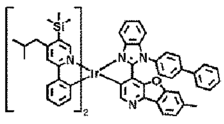
454
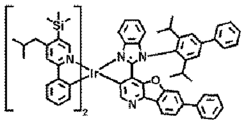
455
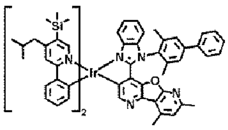
456
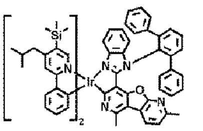
457
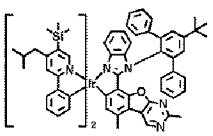
458
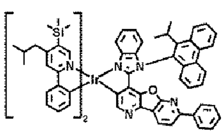
459
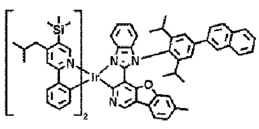
460

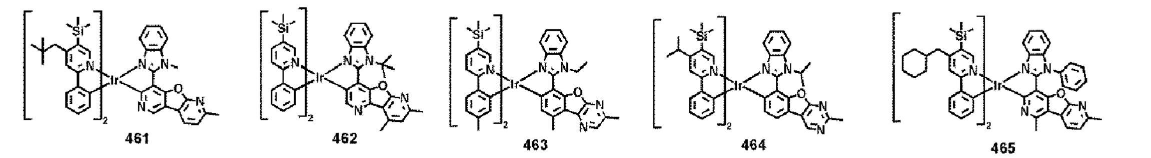
461 462 463 464 465

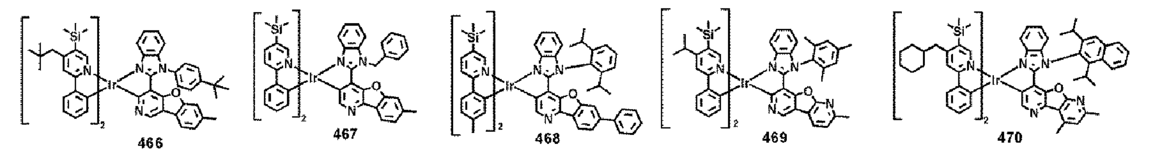
466 467 468 469 470

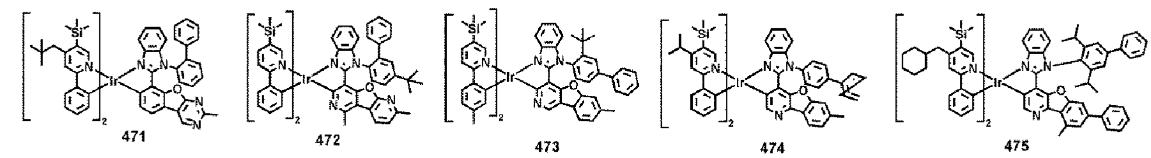
471 472 473 474 475

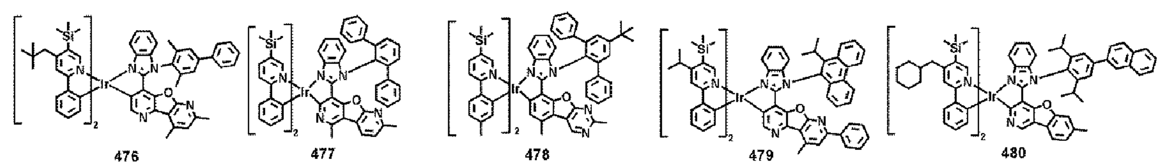
476 477 478 479 480

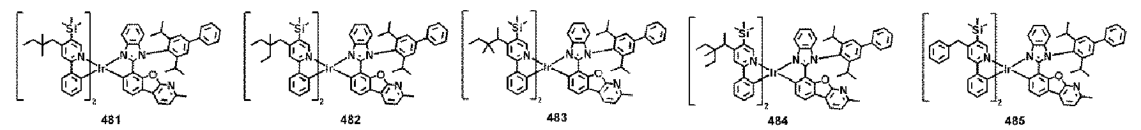
481 482 483 484 485

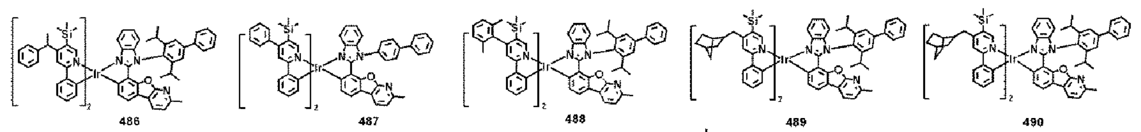
486 487 488 489 490

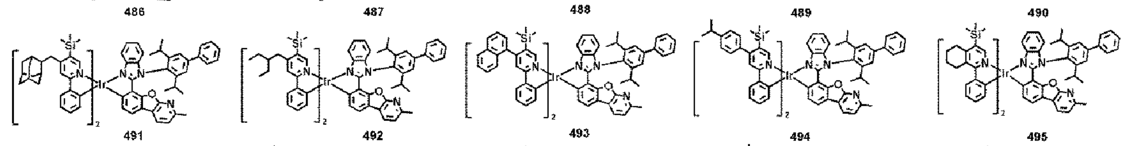
491 492 493 494 495

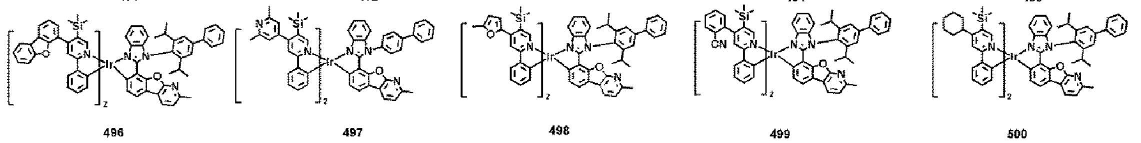
496 497 498 499 500

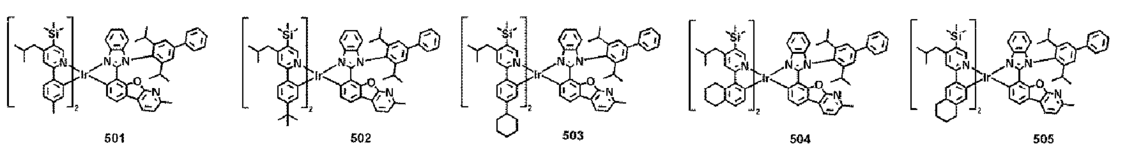
501 502 503 504 505

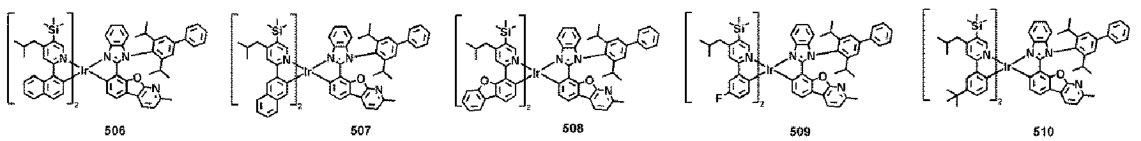
506 507 508 509 510

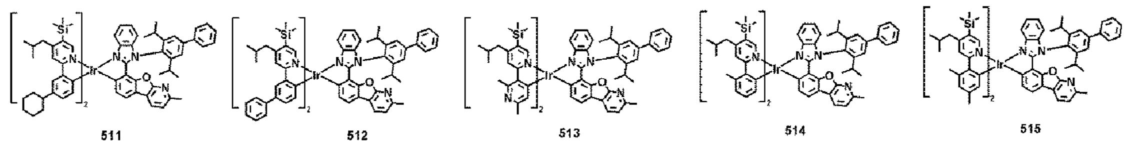
511 512 513 514 515

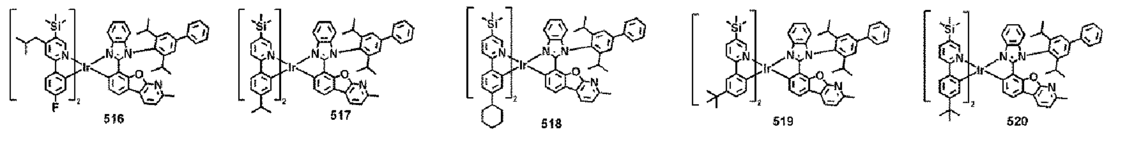
516 517 518 519 520

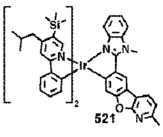
521
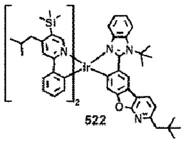
522
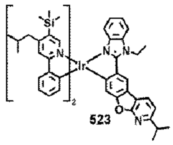
523
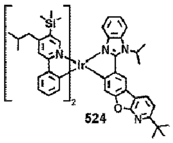
524
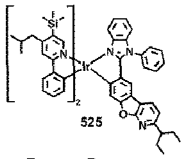
525

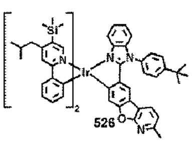
526
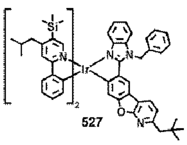
527
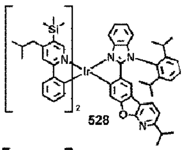
528
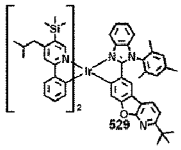
529
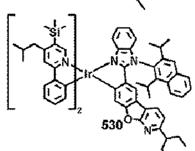
530

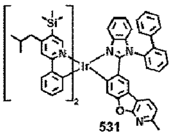
531
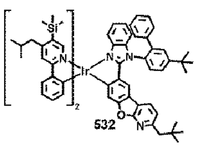
532
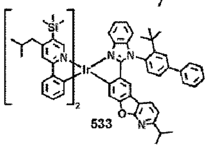
533
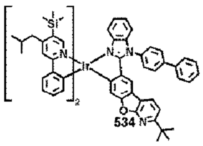
534
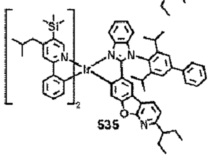
535

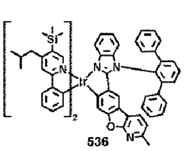
536
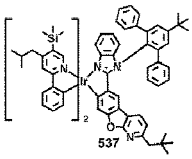
537
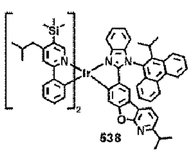
538
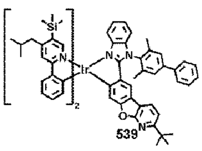
539
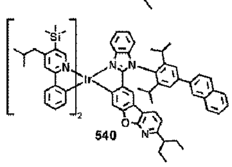
540

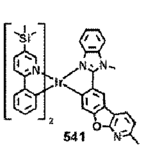
541
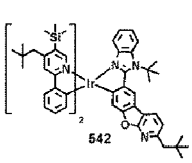
542
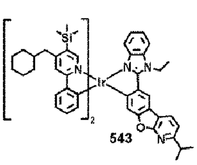
543
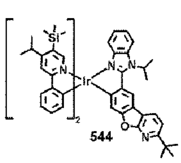
544
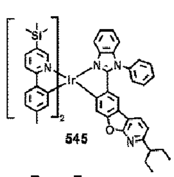
545

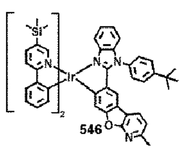
546
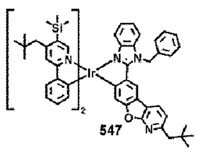
547
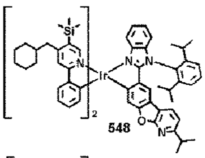
548
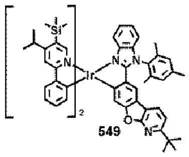
549
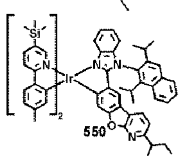
550

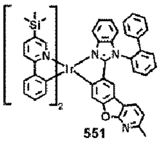
551
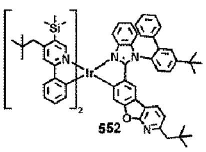
552
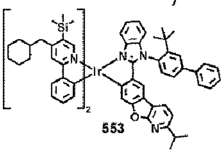
553
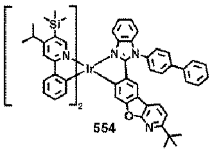
554
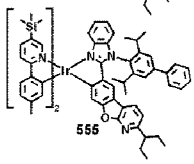
555

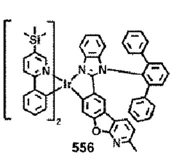
556
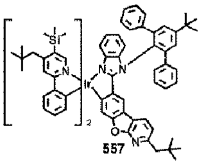
557
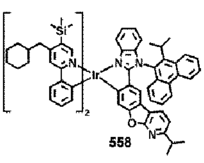
558
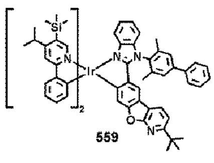
559
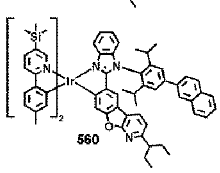
560

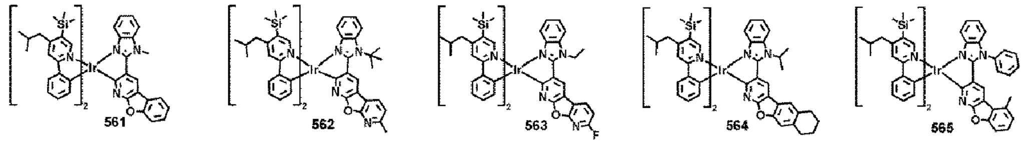

561 562 563 564 565

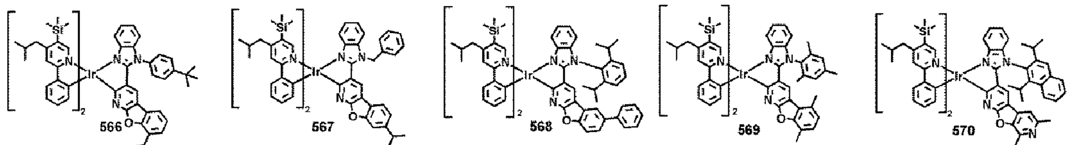

566 567 568 569 570

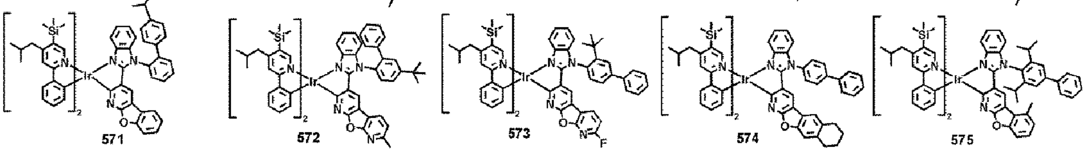

571 572 573 574 575

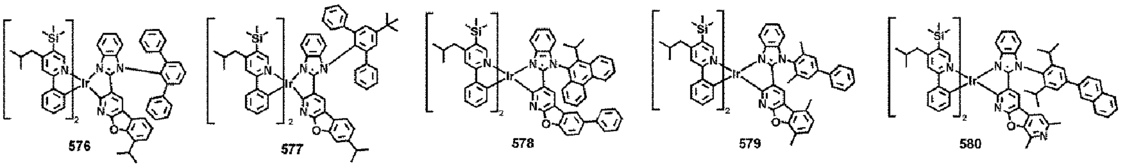

576 577 578 579 580

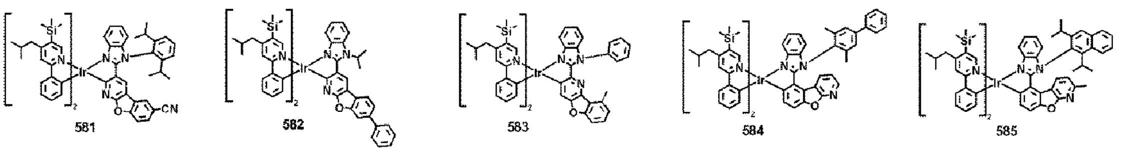

581 582 583 584 585

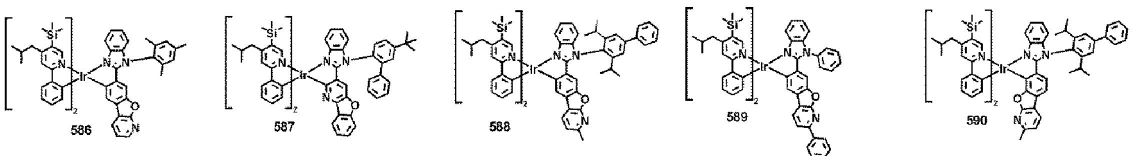

586 587 588 589 590

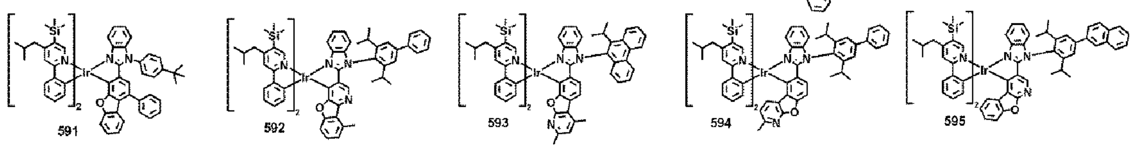

591 592 593 594 595

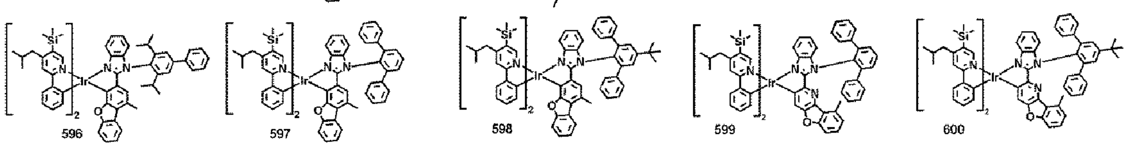

596 597 598 599 600

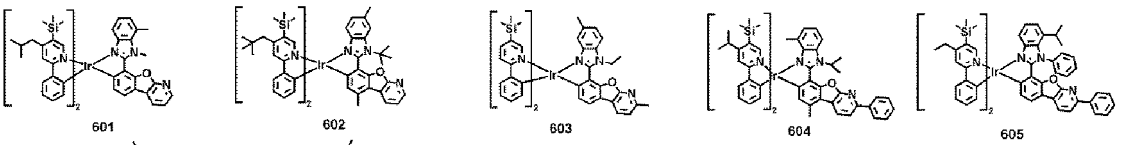

601 602 603 604 605

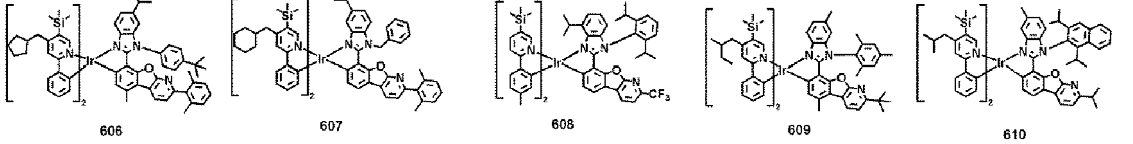

606 607 608 609 610

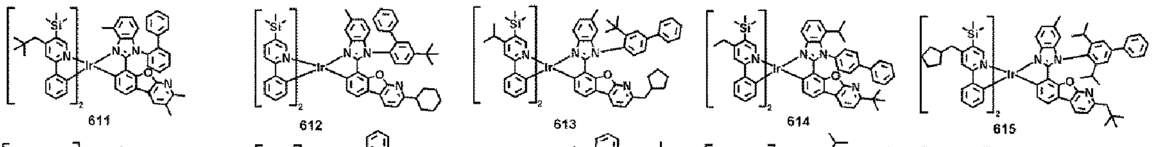

611 612 613 614 615

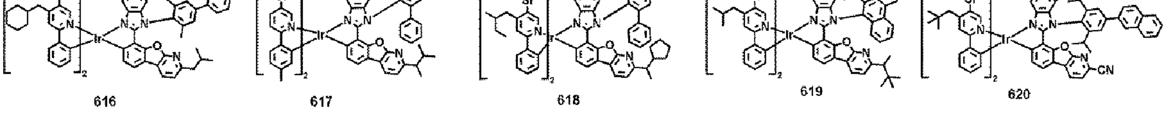

616 617 618 619 620

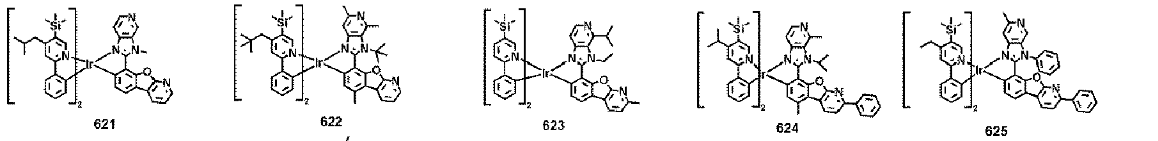
621 622 623 624 625

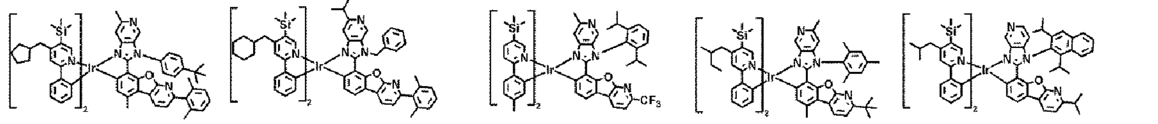
626 627 628 629 630

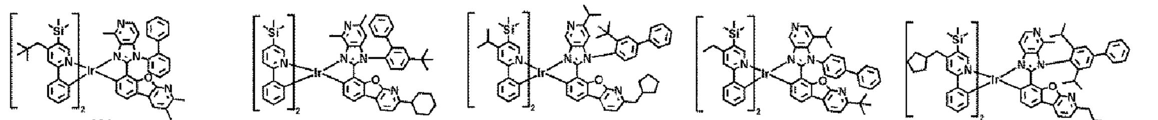
631 632 633 634 635

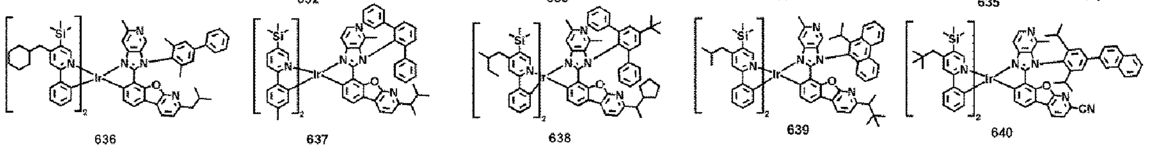
636 637 638 639 640

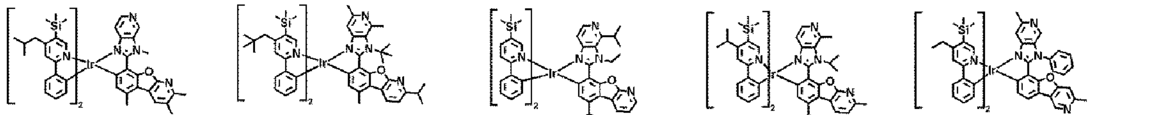
641 642 643 644 645

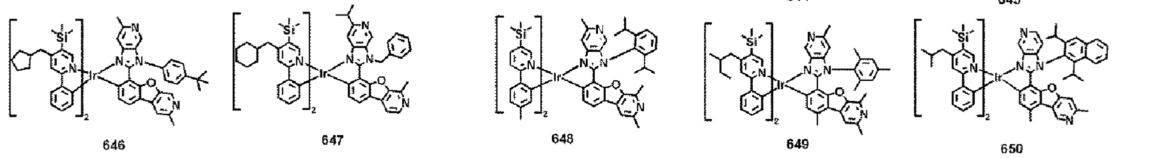
646 647 648 649 650

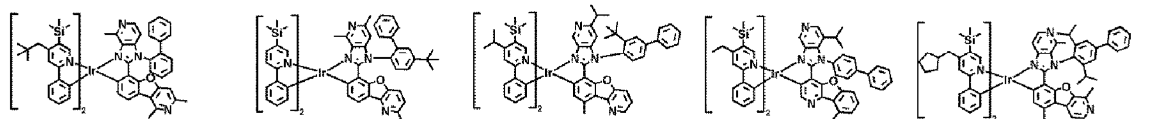
651 652 653 654 655

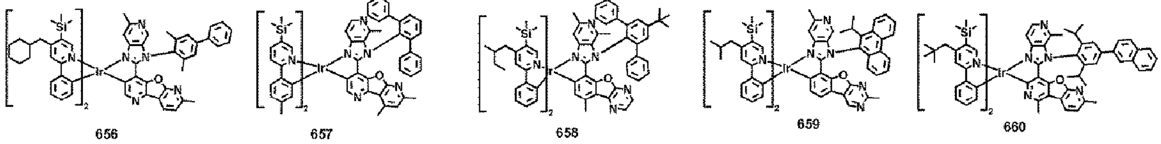
656 657 658 659 660

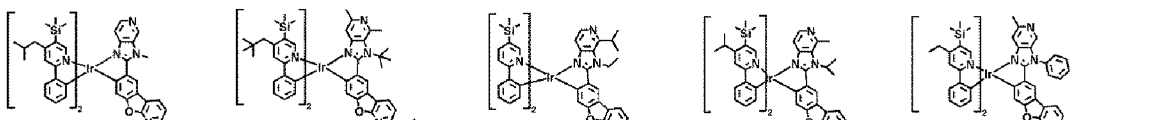
661 662 663 664 665

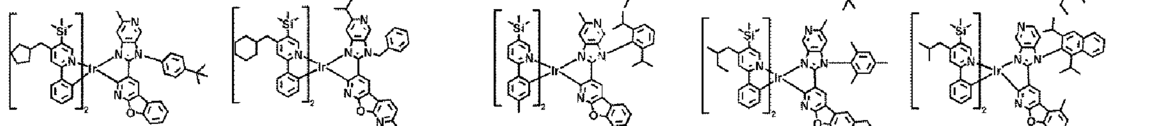
666 667 668 669 670

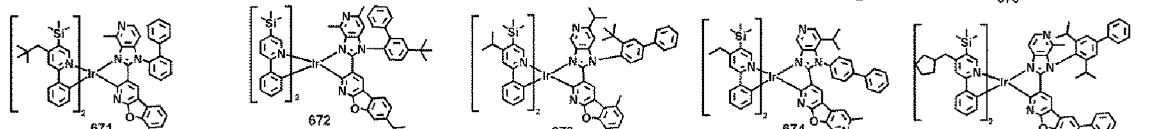
671 672 673 674 675

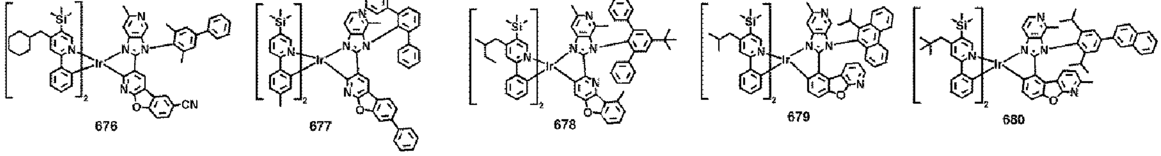
676 677 678 679 680

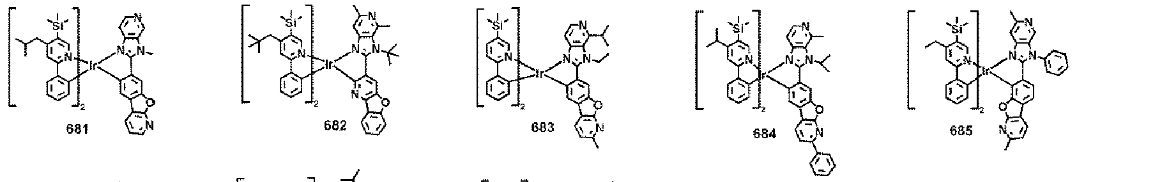

681 682 683 684 685

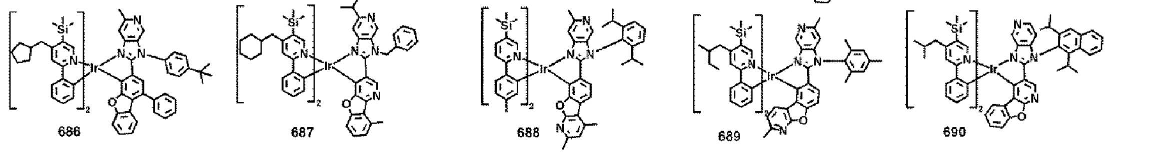

686 687 688 689 690

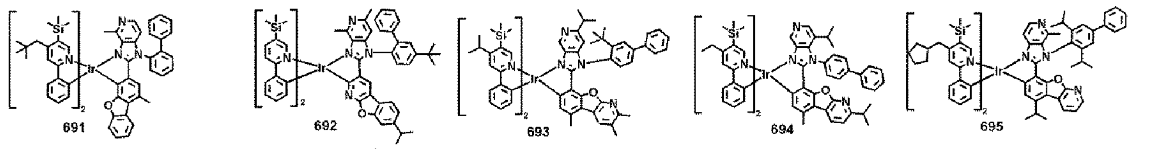

691 692 693 694 695

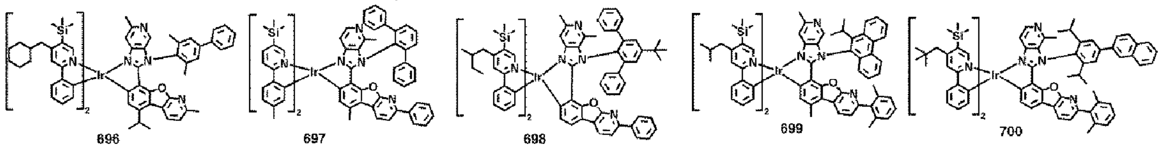

696 697 698 699 700

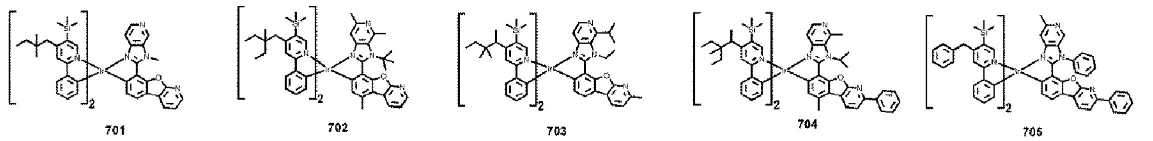

701 702 703 704 705

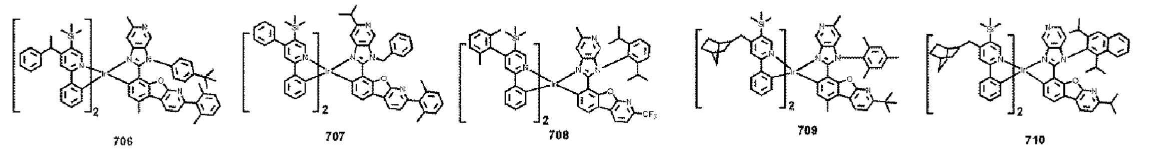

706 707 708 709 710

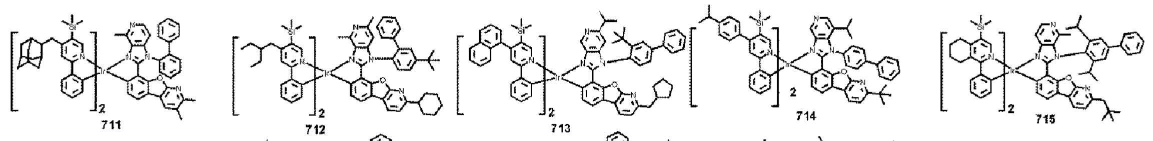

711 712 713 714 715

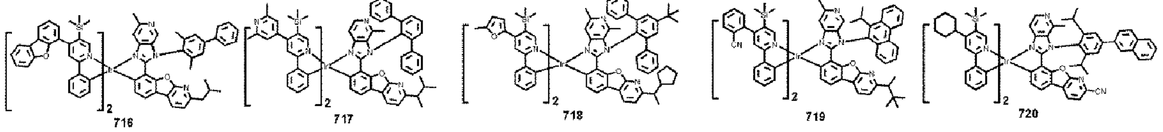

716 717 718 719 720

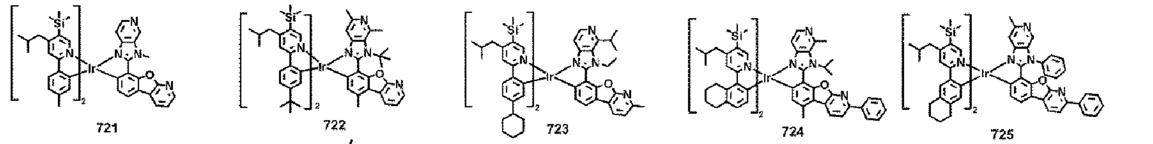

721 722 723 724 725

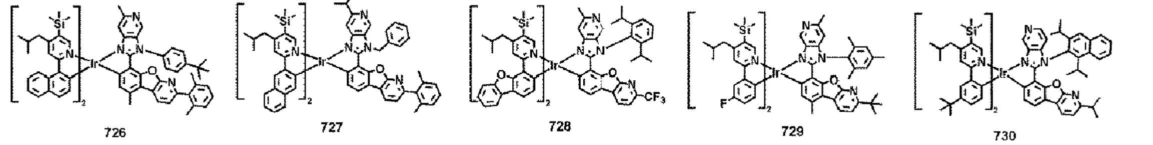

726 727 728 729 730

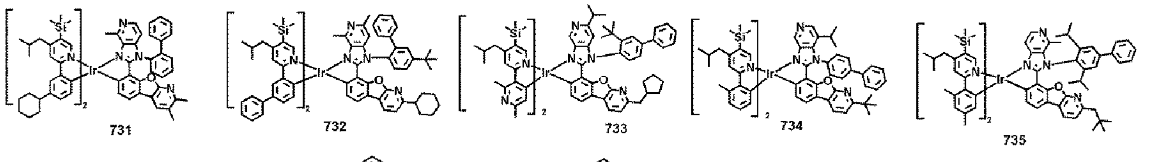

731 732 733 734 735

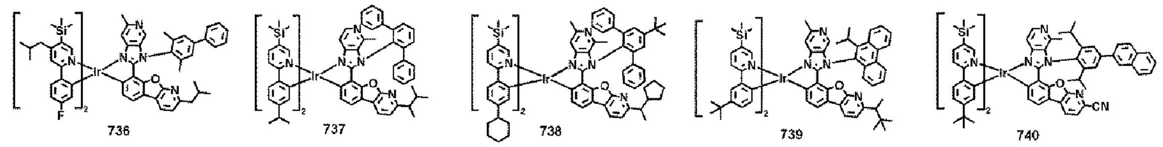

736 737 738 739 740

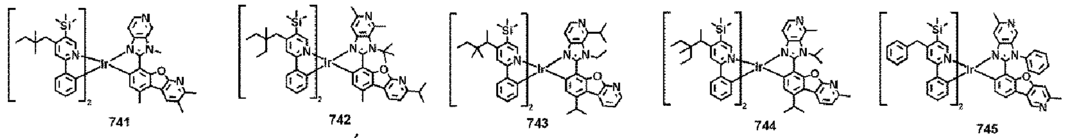
741 742 743 744 745

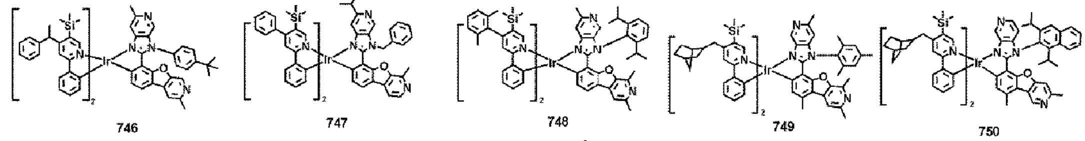
746 747 748 749 750

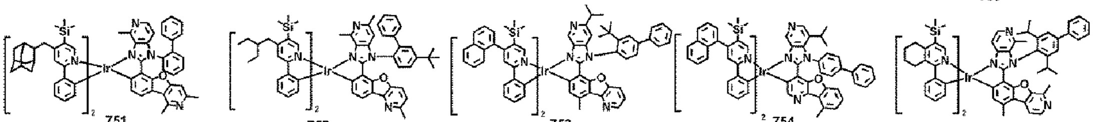
751 752 753 754 755

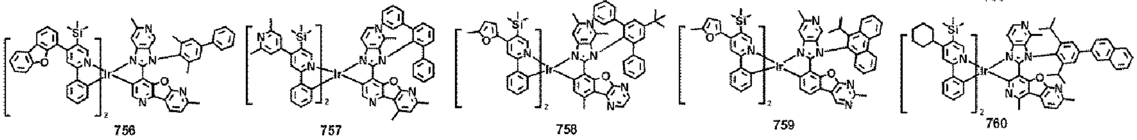
756 757 758 759 760

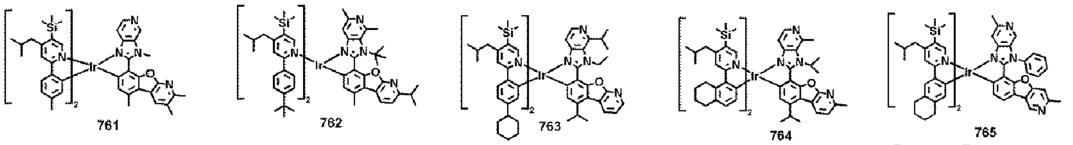
761 762 763 764 765

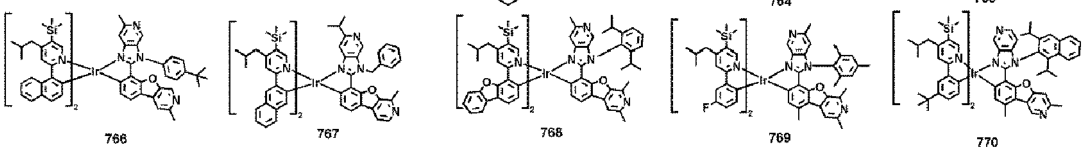
766 767 768 769 770

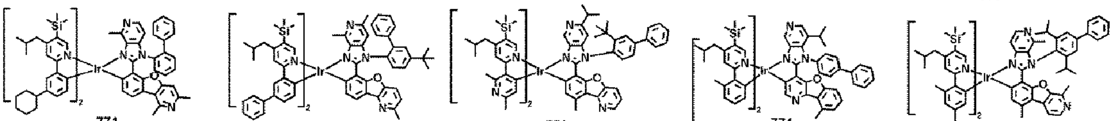
771 772 773 774 775

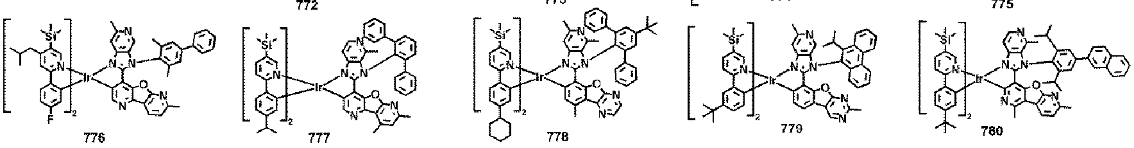
776 777 778 779 780

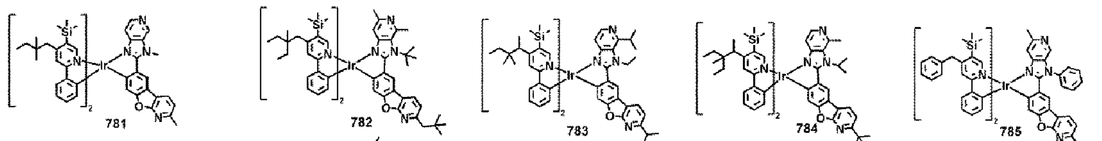
781 782 783 784 785

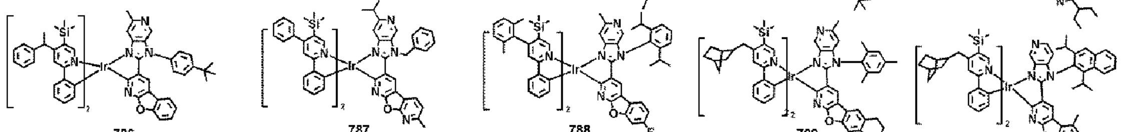
786 787 788 789 790

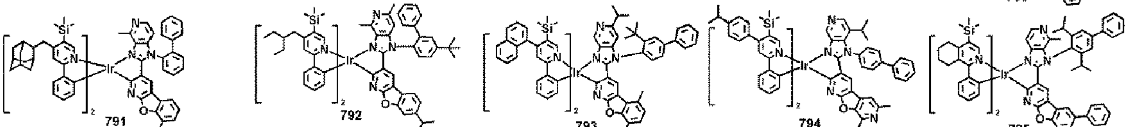
791 792 793 794 795

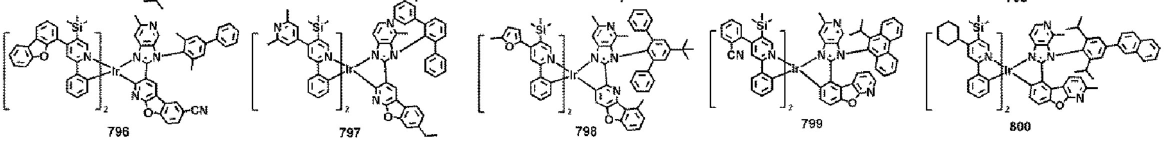
796 797 798 799 800

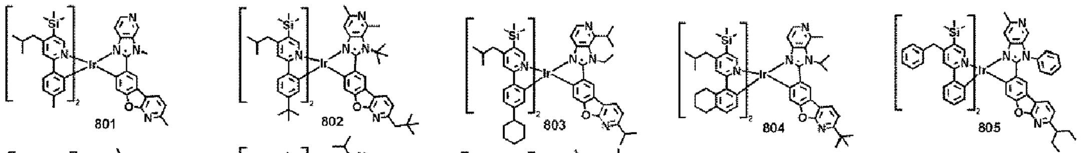
801 802 803 804 805

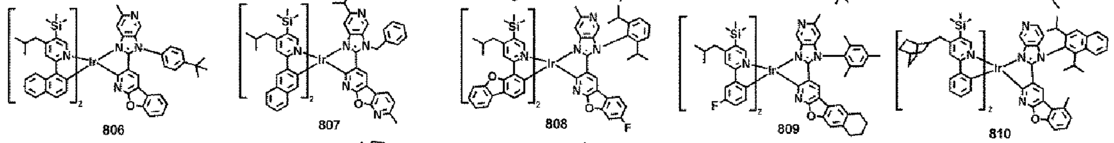
806 807 808 809 810

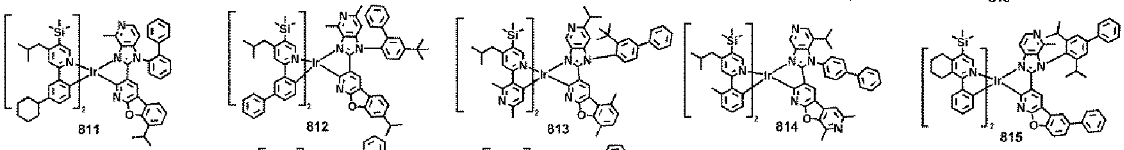
811 812 813 814 815

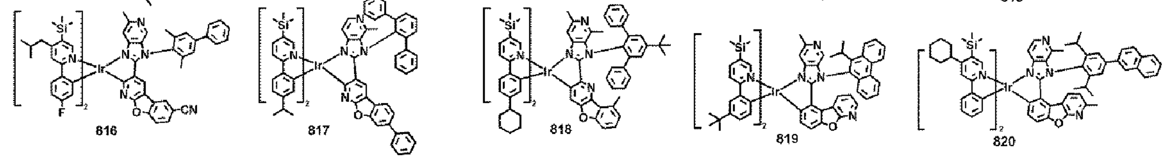
816 817 818 819 820

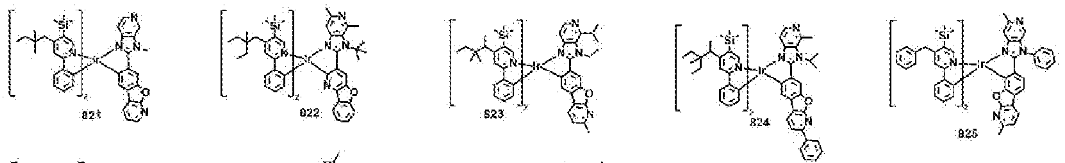
821 822 823 824 825

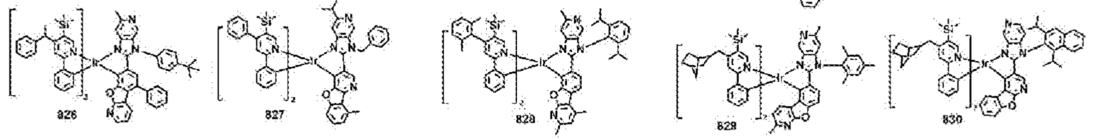
826 827 828 829 830

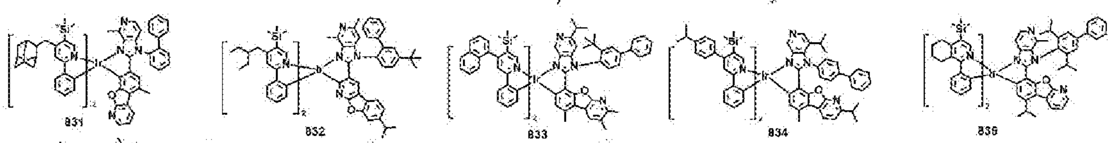
831 832 833 834 835

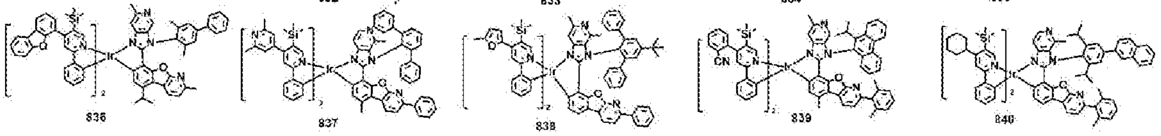
836 837 838 839 840

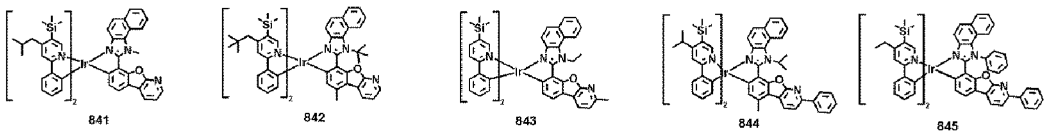
841 842 843 844 845

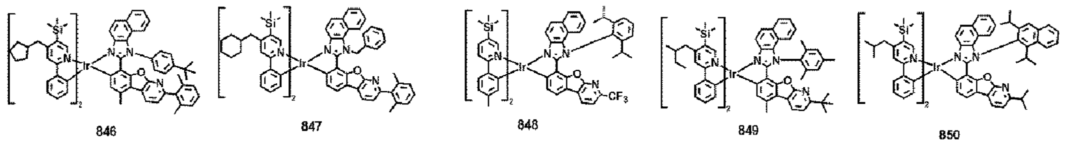
846 847 848 849 850

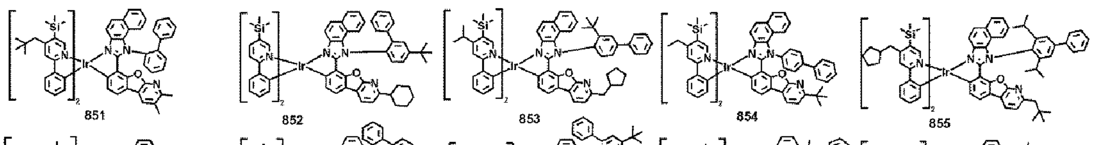
851 852 853 854 855

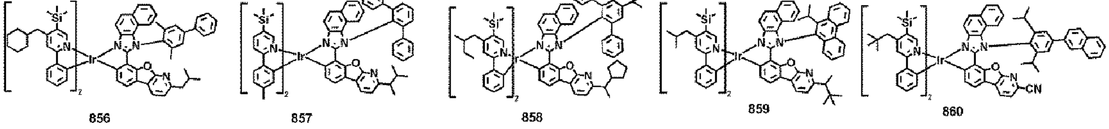
856 857 858 859 860

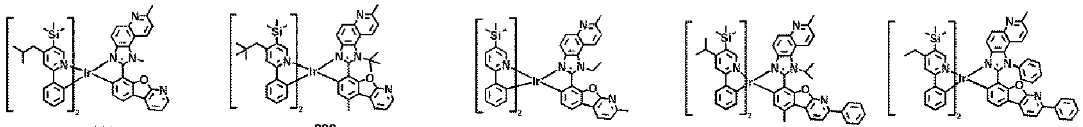
861 862 863 864 865
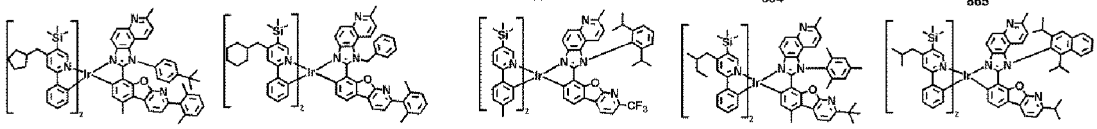
866 867 868 869 870
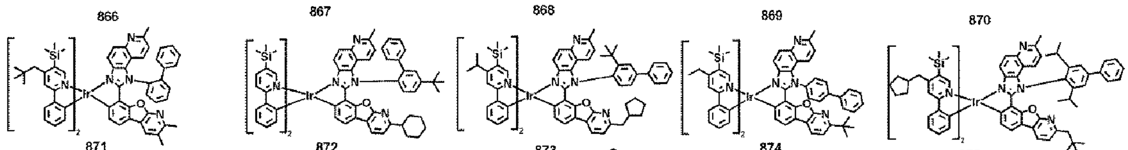
871 872 873 874 875
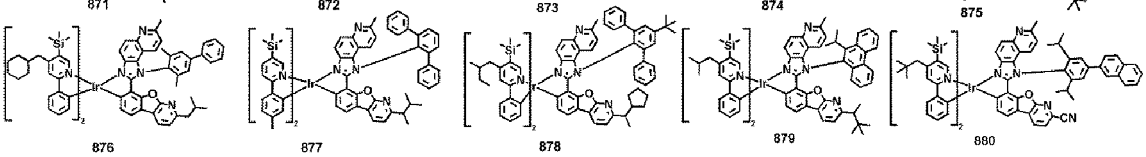
876 877 878 879 880
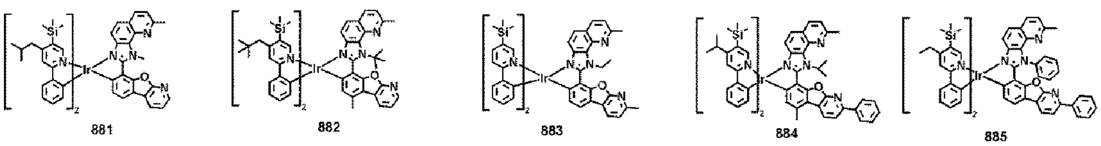
881 882 883 884 885
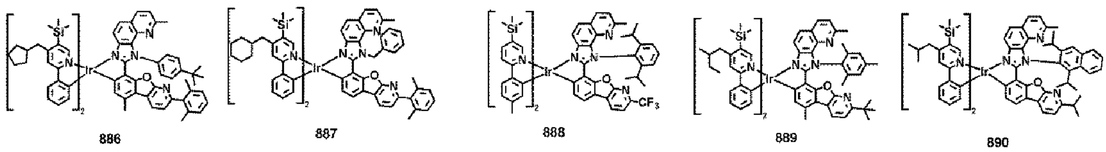
886 887 888 889 890
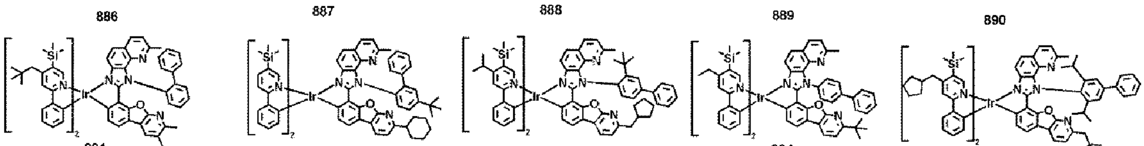
891 892 893 894 895
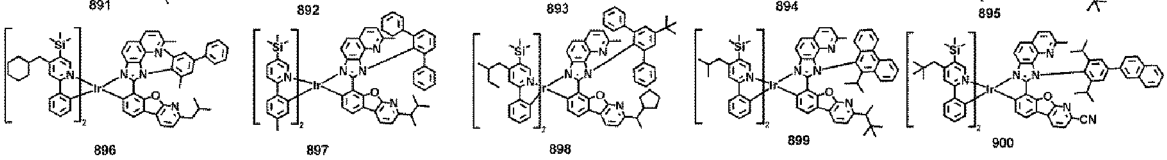
896 897 898 899 900
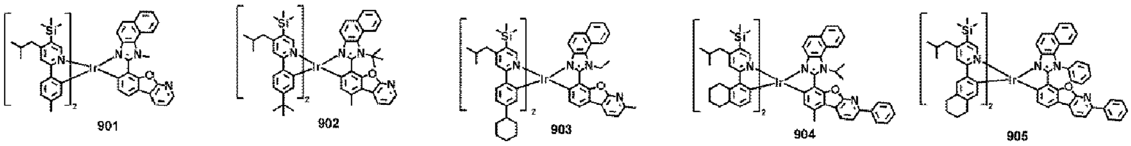
901 902 903 904 905
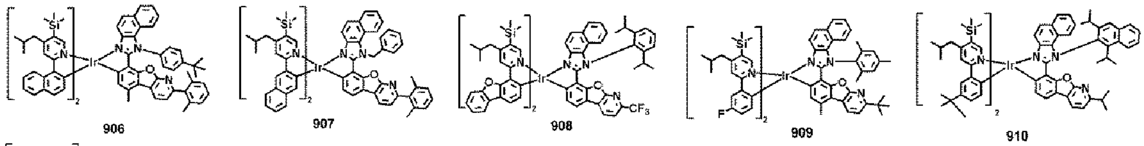
906 907 908 909 910
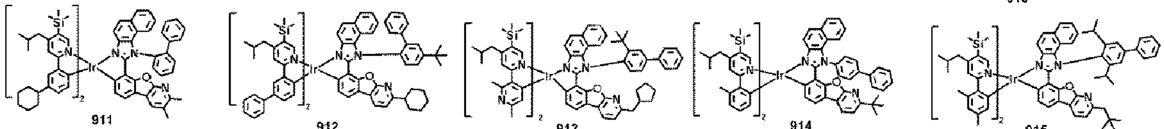
911 912 913 914 915
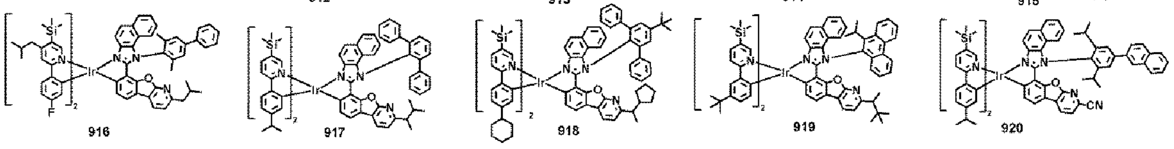
916 917 918 919 920

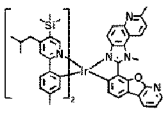
921
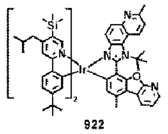
922
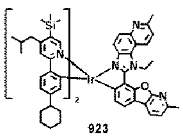
923
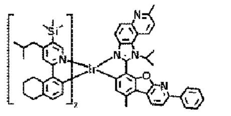
924
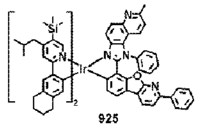
925
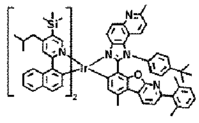
926
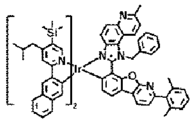
927
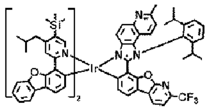
928
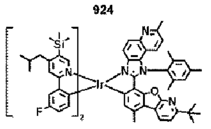
929
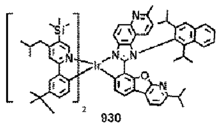
930
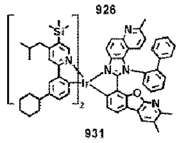
931
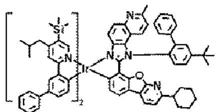
932
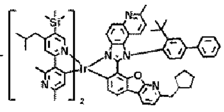
933
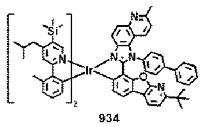
934
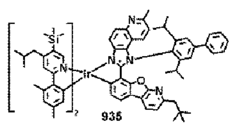
935
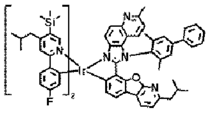
936
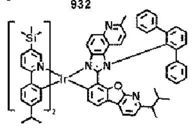
937
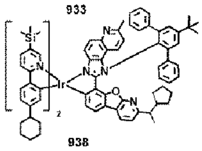
938
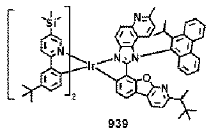
939
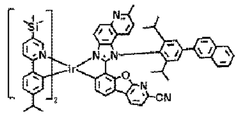
940
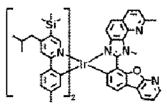
941
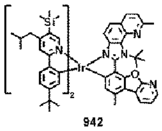
942
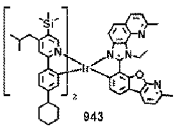
943
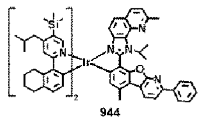
944
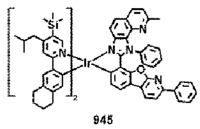
945
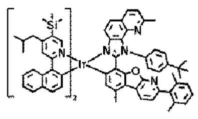
946
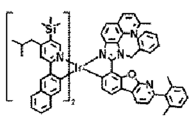
947
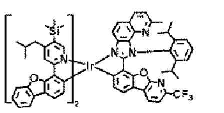
948
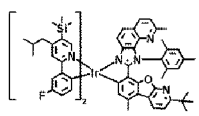
949
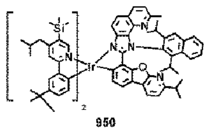
950
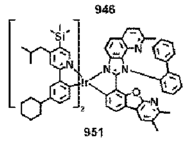
951
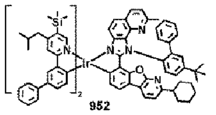
952
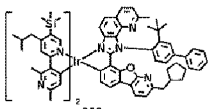
953
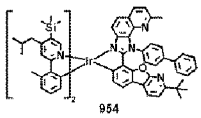
954
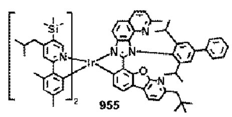
955
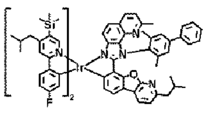
956
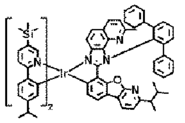
957
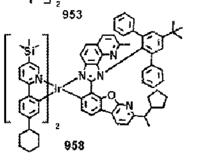
958
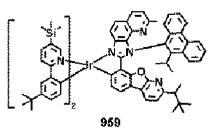
959
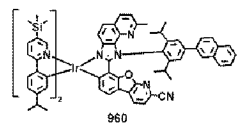
960

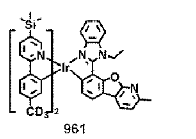
961
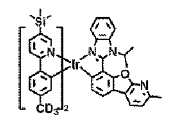
962
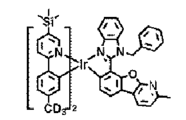
963
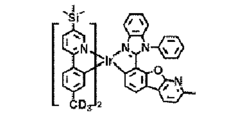
964
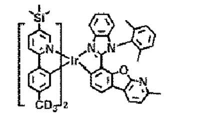
965
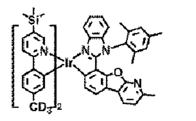
966
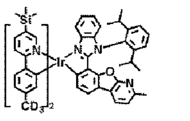
967
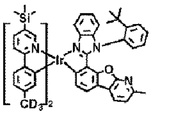
968
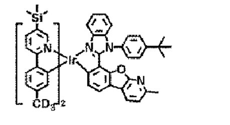
969
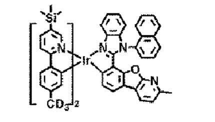
970
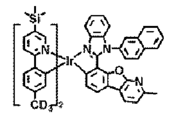
971
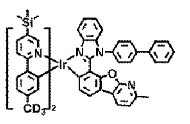
972
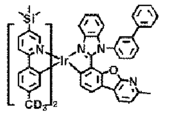
973
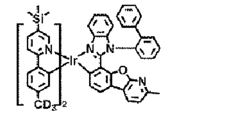
974
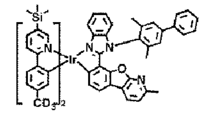
975
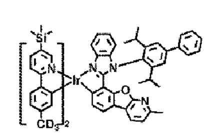
976
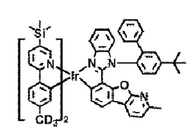
977
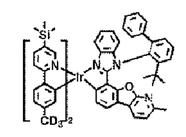
978
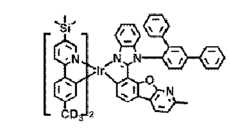
979
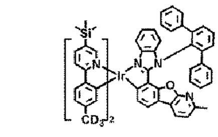
980
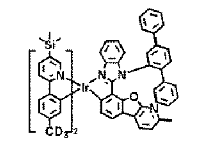
981
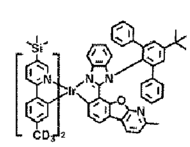
982
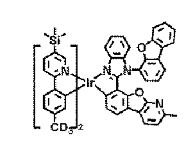
983
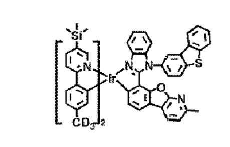
984
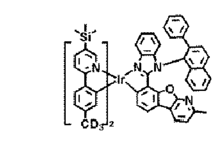
985
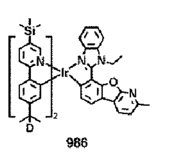
986
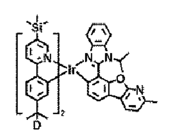
987
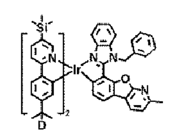
988
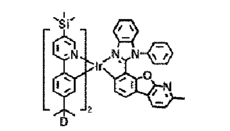
989
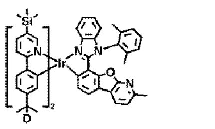
990
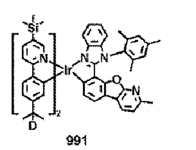
991
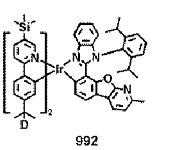
992
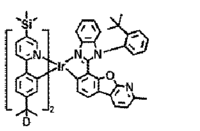
993
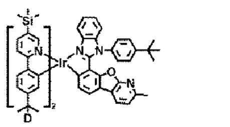
994
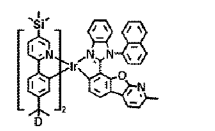
995
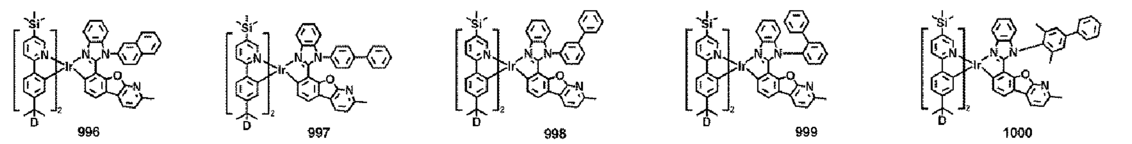
996 997 998 999 1000
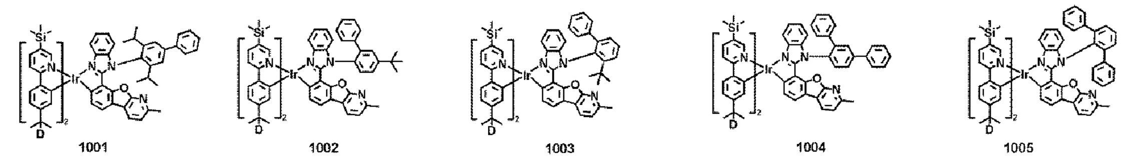
1001 1002 1003 1004 1005
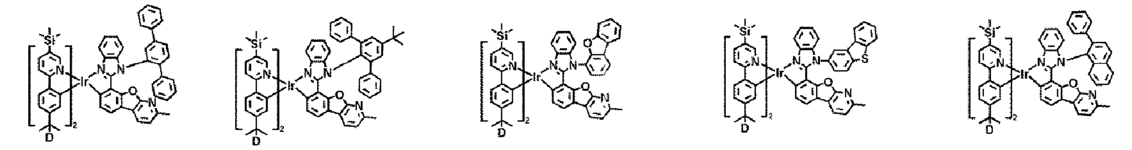
1006 1007 1008 1009 1010

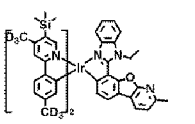

1011

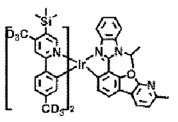

1012

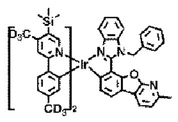

1013

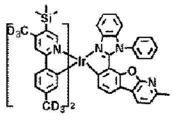

1014

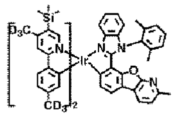

1015

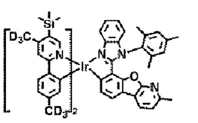

1016

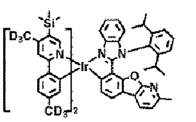

1017

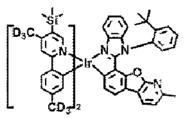

1018

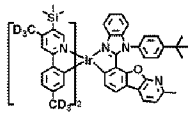

1019

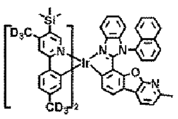

1020

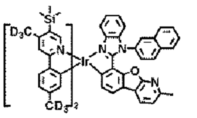

1021

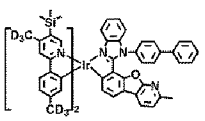

1022

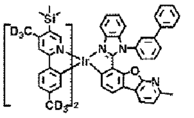

1023

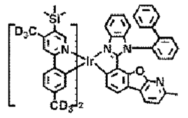

1024

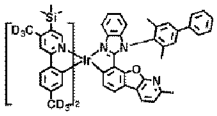

1025

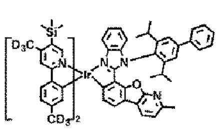

1026

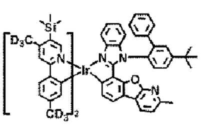

1027

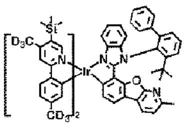

1028

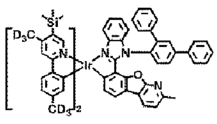

1029

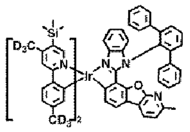

1030

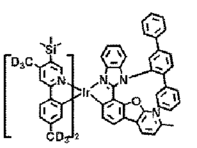

1031

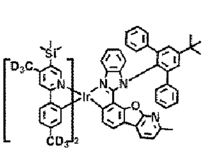

1032

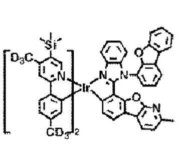

1033

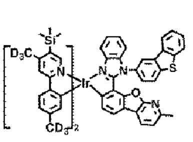

1034

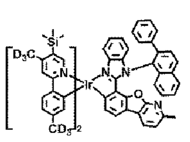

1035

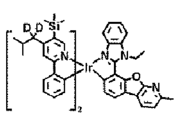

1036

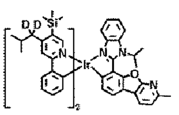

1037

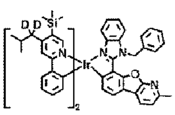

1038

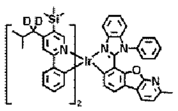

1039

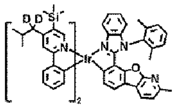

1040

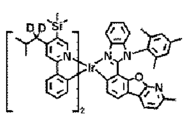

1041

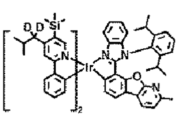

1042

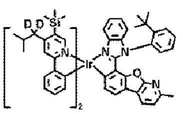

1043

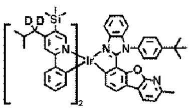

1044

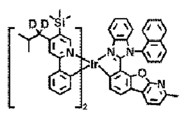

1045

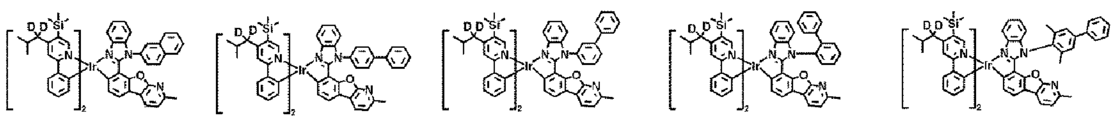

1046

1047

1048

1049

1050

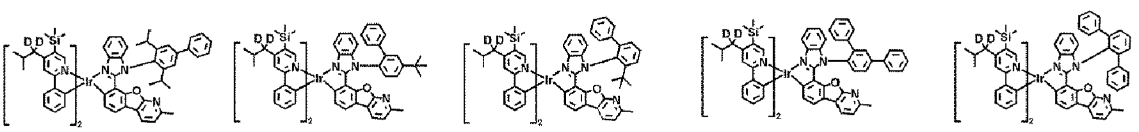

1051

1052

1053

1054

1055

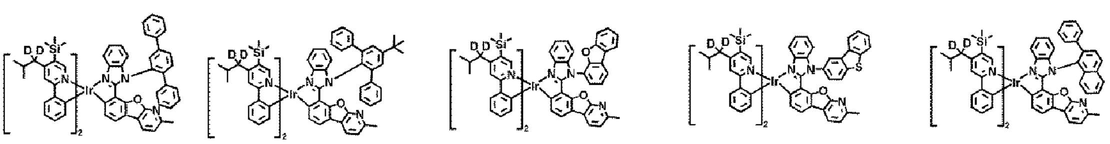

1056

1057

1058

1059

1060

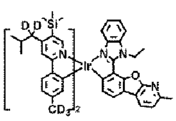
1061

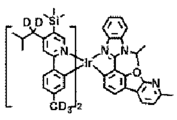
1062

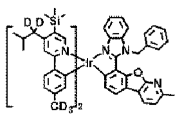
1063

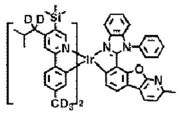
1064

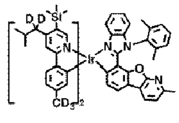
1065

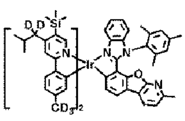
1066

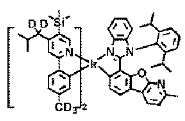
1067

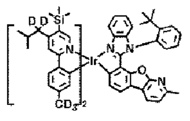
1068

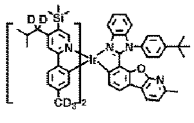
1069

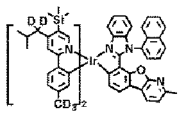
1070

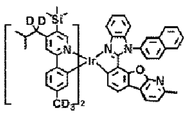
1071

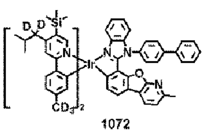
1072

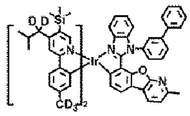
1073

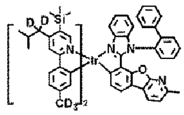
1074

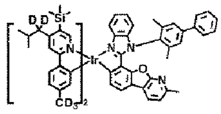
1075

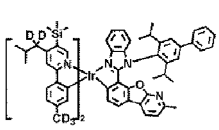
1076

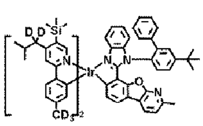
1077

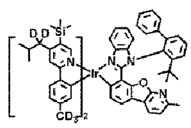
1078

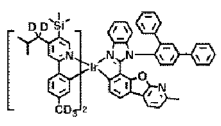
1079

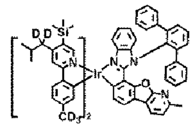
1080

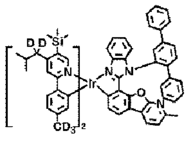
1081

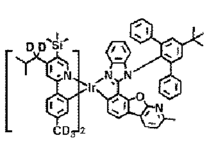
1082

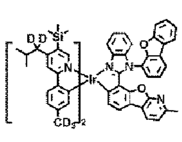
1083

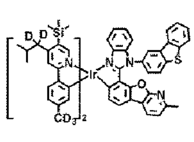
1084

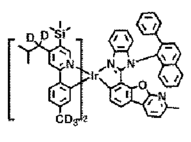
1085

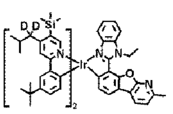
1086

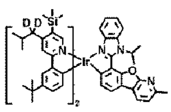
1087

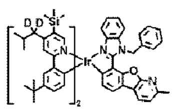
1088

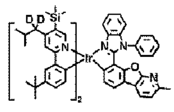
1089

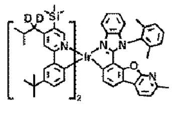
1090

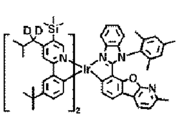
1091

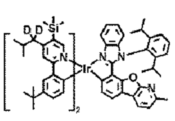
1092

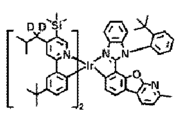
1093

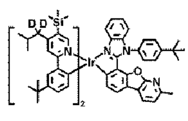
1094

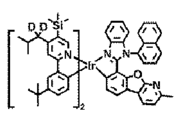
1095

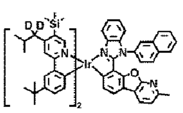
1096

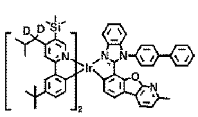
1097

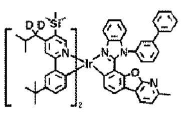
1098

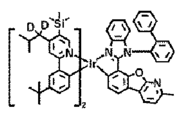
1099

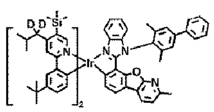
1100

1101

1102

1103

1104

1105

1106

1107

1108

1109

1110

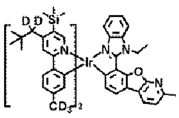
1111
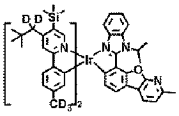
1112
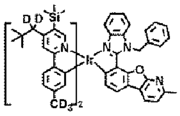
1113
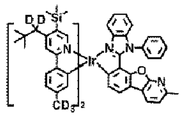
1114
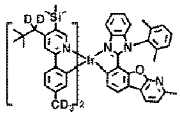
1115
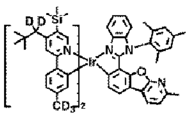
1116
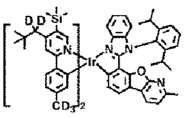
1117
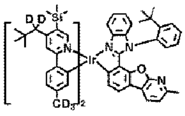
1118
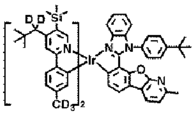
1119
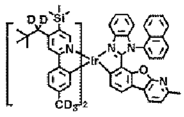
1120
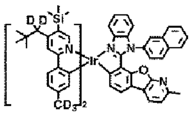
1121
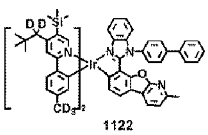
1122
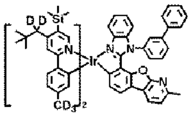
1123
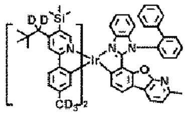
1124
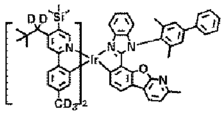
1125
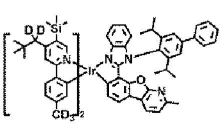
1126
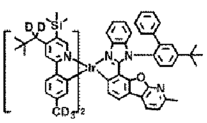
1127
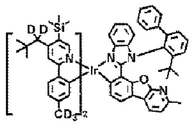
1128
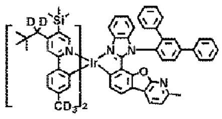
1129
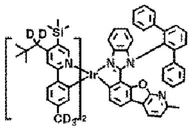
1130
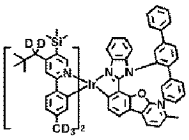
1131
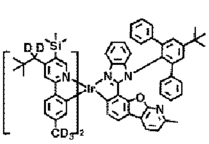
1132
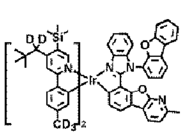
1133
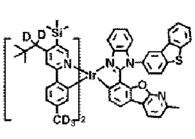
1134
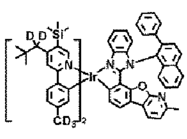
1135
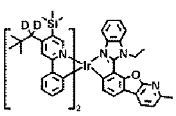
1136
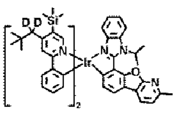
1137
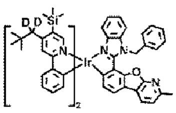
1138
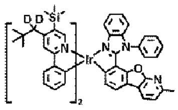
1139
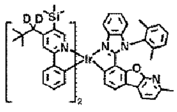
1140
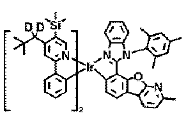
1141
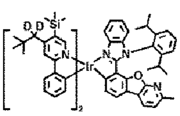
1142
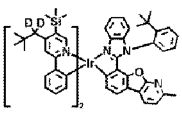
1143
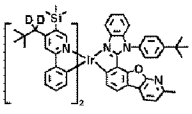
1144
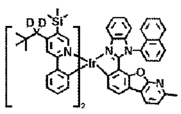
1145
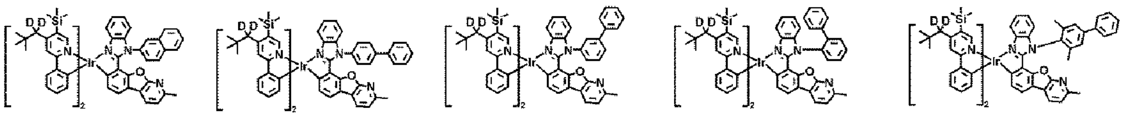
1146 1147 1148 1149 1150
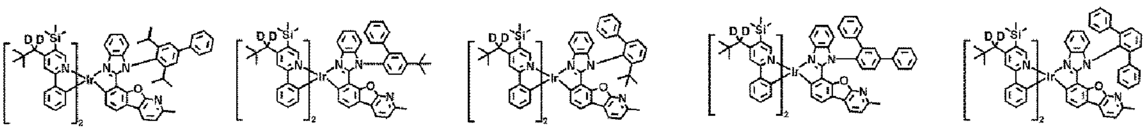
1151 1152 1153 1154 1155
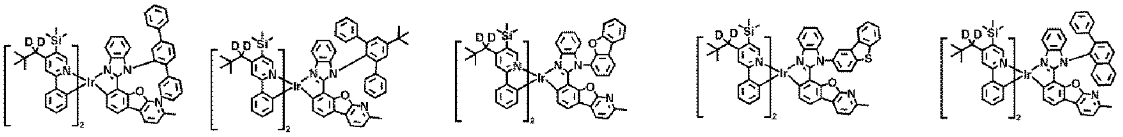
1156 1157 1158 1159 1160

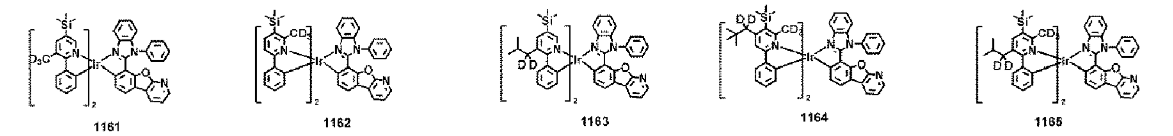
1161 1162 1163 1164 1165

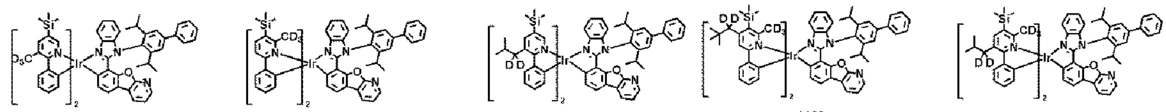
1166 1167 1168 1169 1170

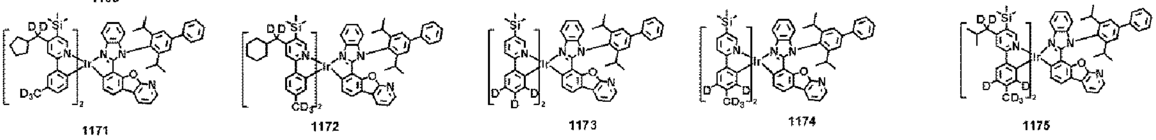
1171 1172 1173 1174 1175

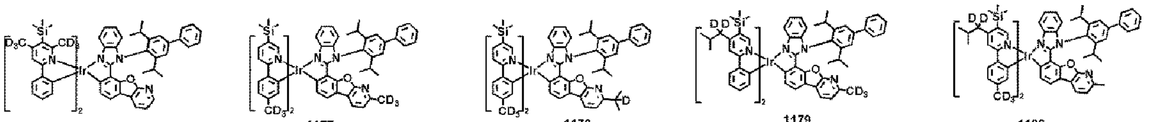
1176 1177 1178 1179 1180

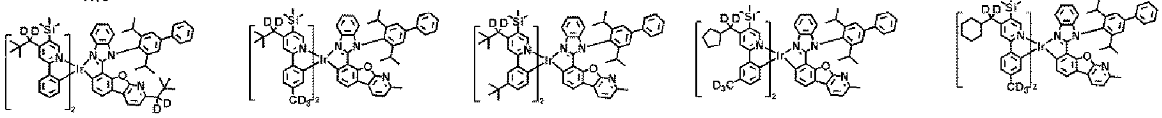
1181 1182 1183 1184 1185

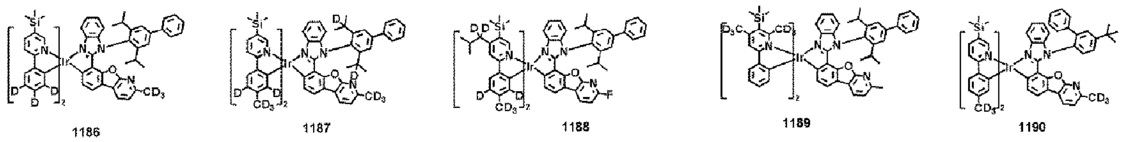
1186 1187 1188 1189 1190

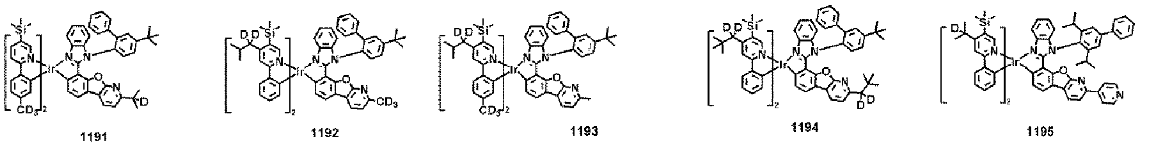
1191 1192 1193 1194 1195

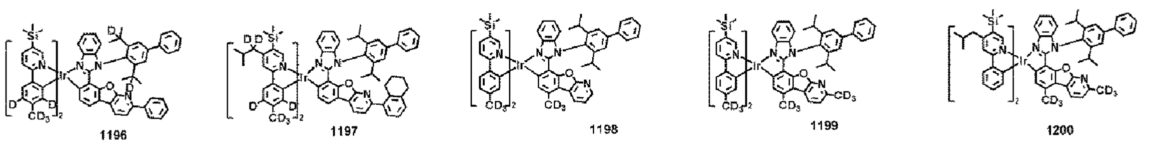
1196 1197 1198 1199 1200

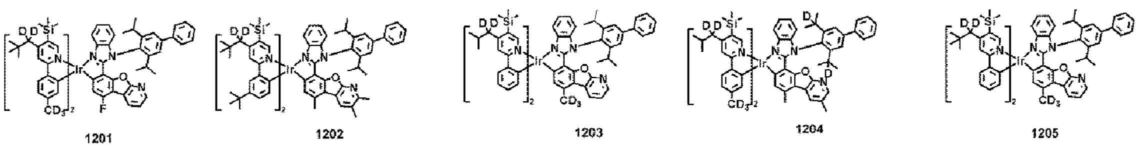
1201 1202 1203 1204 1205

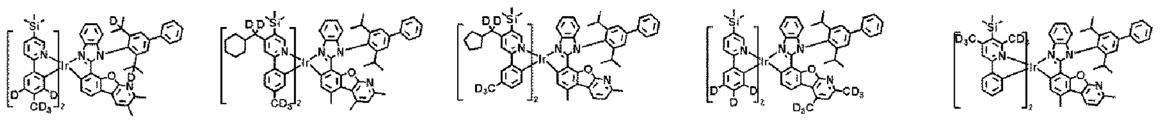
1206 1207 1208 1209 1210

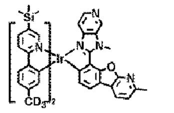
1211

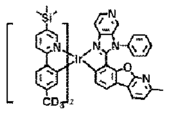
1212

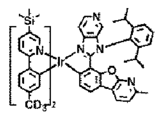
1213

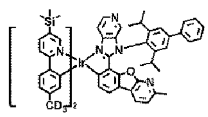
1214

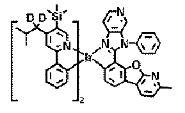
1215

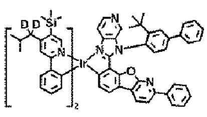
1216

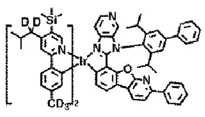
1217

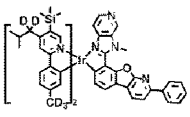
1218

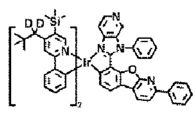
1219

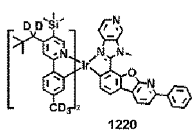
1220

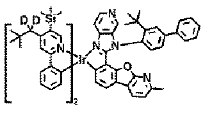
1221

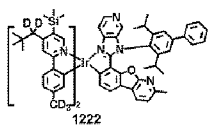
1222

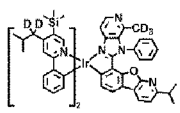
1223

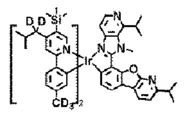
1224

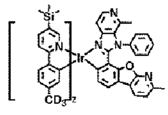
1225

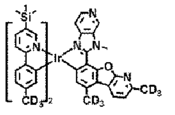
1226

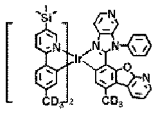
1227

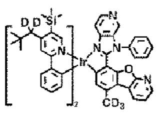
1228

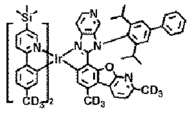
1229

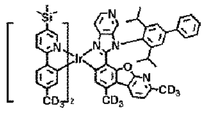
1230

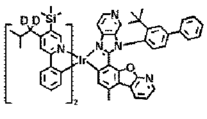
1231

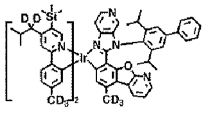
1232

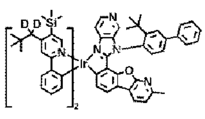
1233

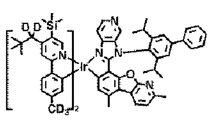
1234

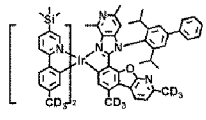
1235

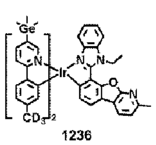
1236

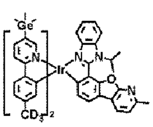
1237

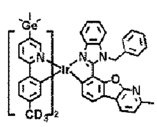
1238

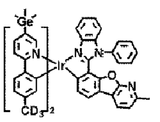
1239

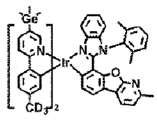
1240

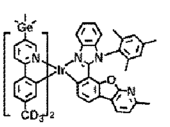
1241

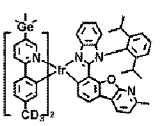
1242

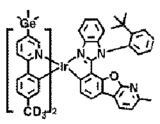
1243

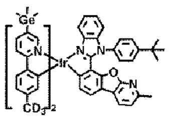
1244

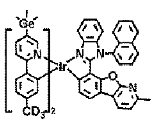
1245

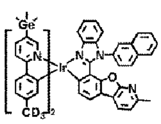
1246

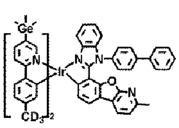
1247

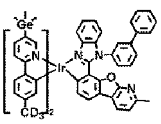
1248

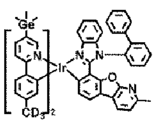
1249

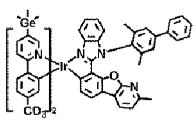
1250

1251

1252

1253

1254

1255

1256

1257

1258

1259

1260

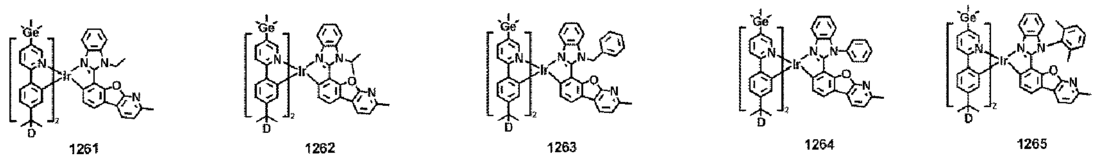
1261 1262 1263 1264 1265

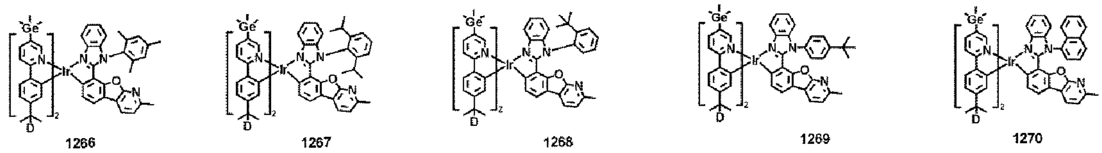
1266 1267 1268 1269 1270

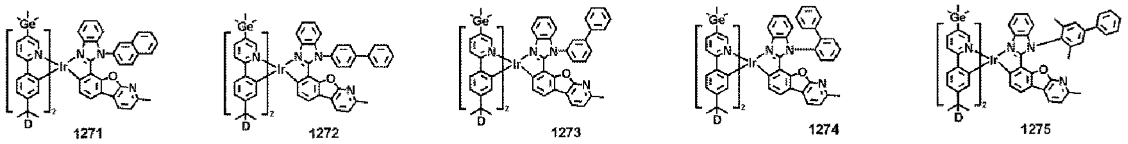
1271 1272 1273 1274 1275

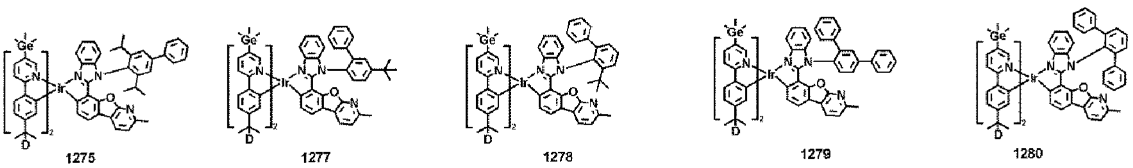
1275 1277 1278 1279 1280

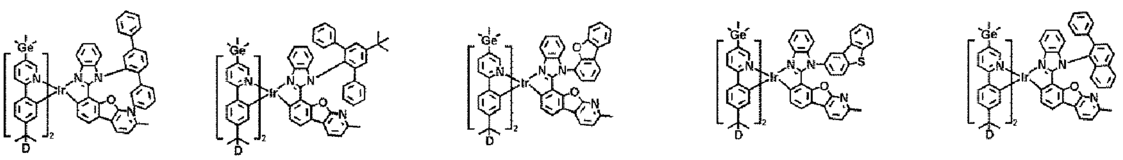
1281 1282 1283 1284 1285

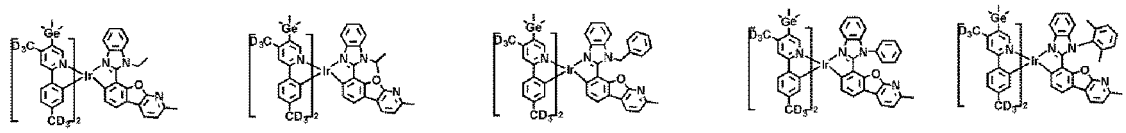
1286 1287 1288 1289 1290

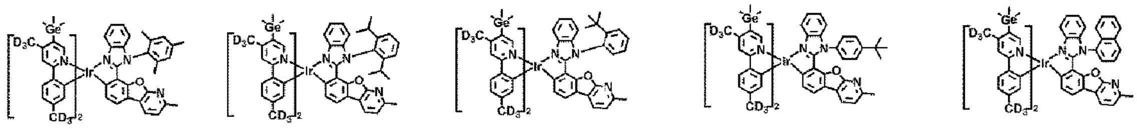
1291 1292 1293 1294 1295

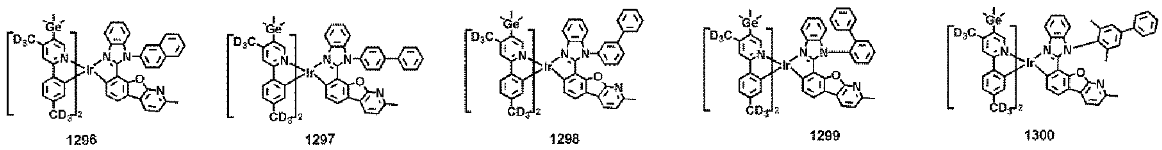
1296 1297 1298 1299 1300

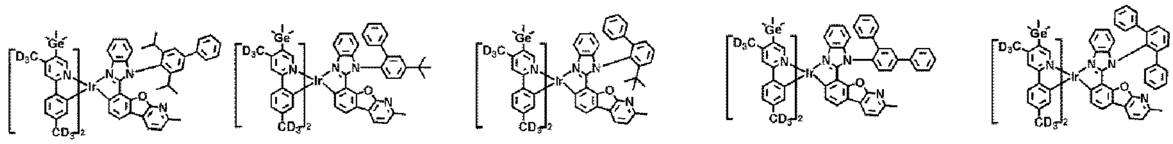
1301 1302 1303 1304 1305

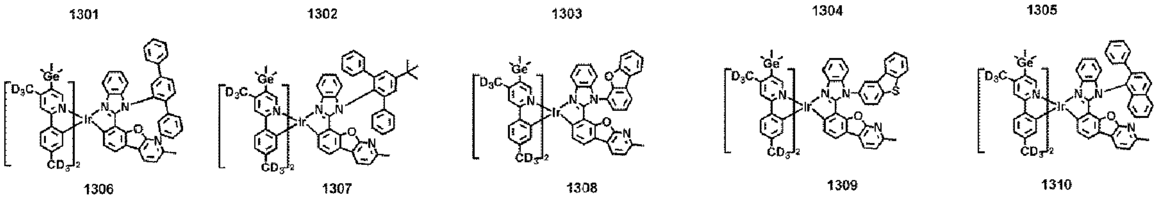
1306 1307 1308 1309 1310

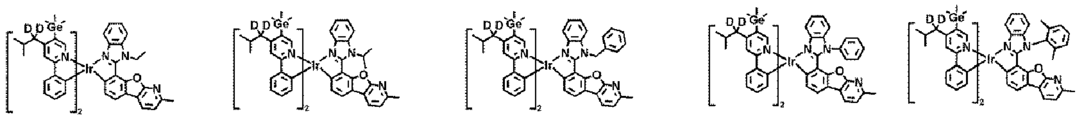
1311 1312 1313 1314 1315

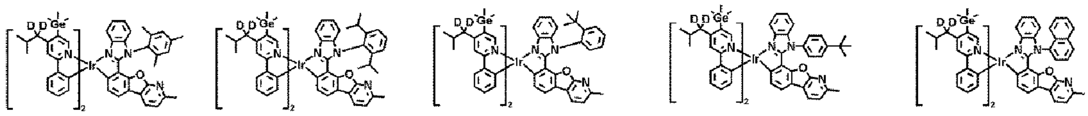
1316 1317 1318 1319 1320

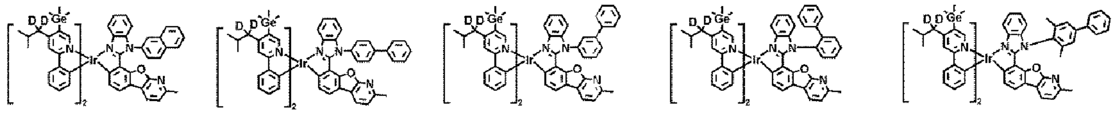
1321 1322 1323 1324 1325

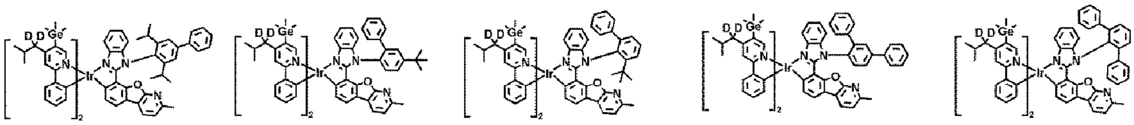
1326 1327 1328 1329 1330

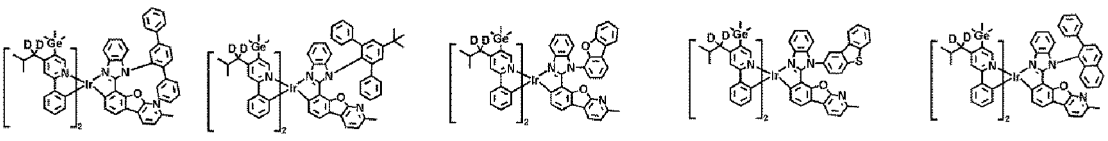
1331 1332 1333 1334 1335

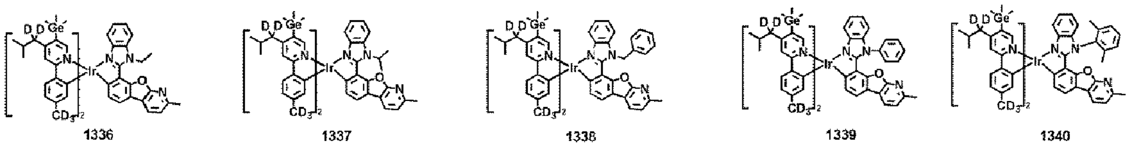
1336 1337 1338 1339 1340

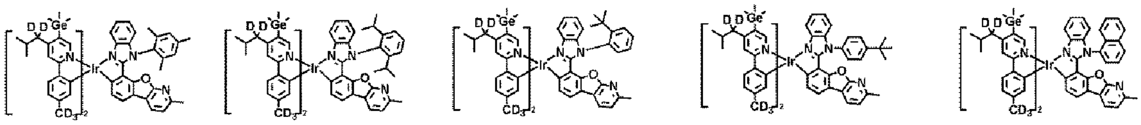
1341 1342 1343 1344 1345

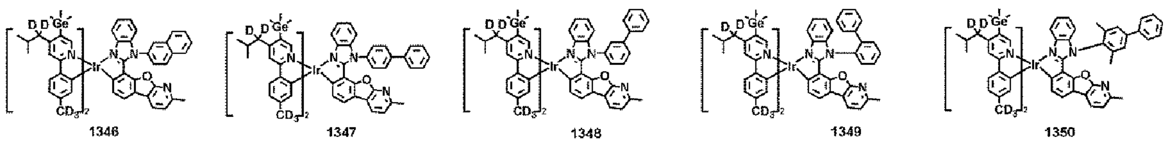
1346 1347 1348 1349 1350

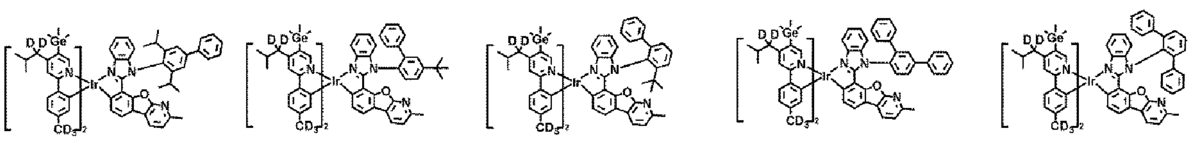
1351 1352 1353 1354 1355

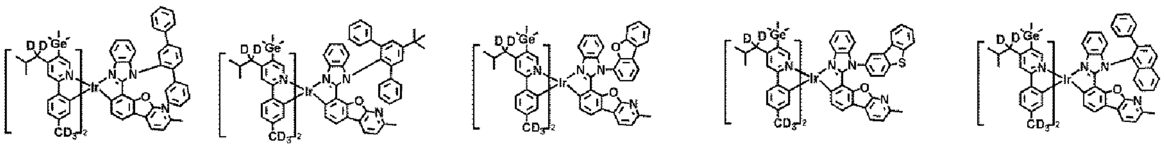
1356 1357 1358 1359 1360

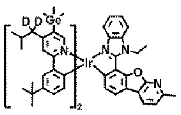
1361
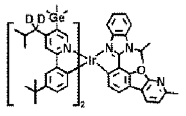
1362
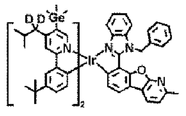
1363
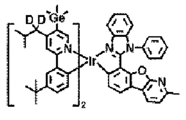
1364
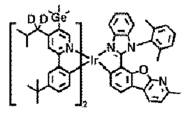
1365

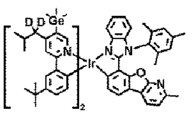
1366
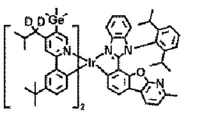
1367
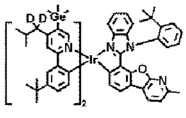
1368
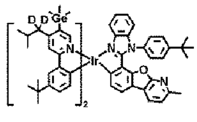
1369
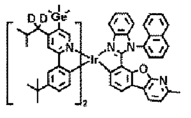
1370

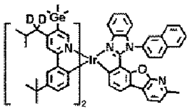
1371
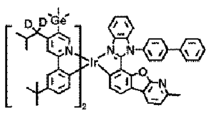
1372
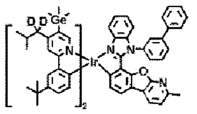
1373
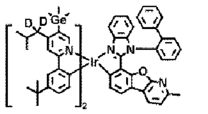
1374
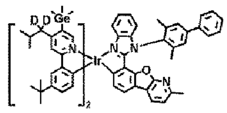
1375

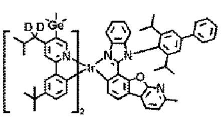
1376
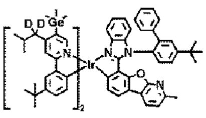
1377
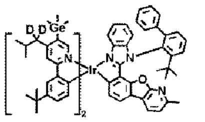
1378
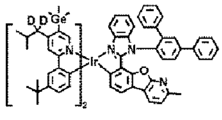
1379
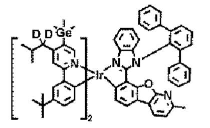
1380

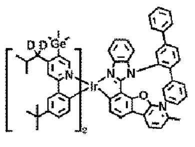
1381
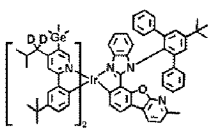
1382
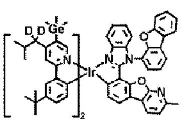
1383
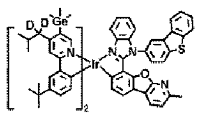
1384
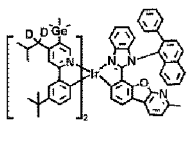
1385

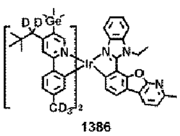
1386
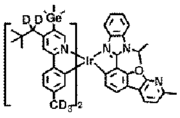
1387
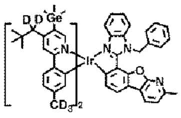
1388
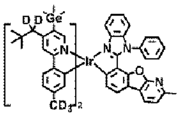
1389
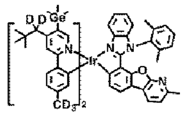
1390

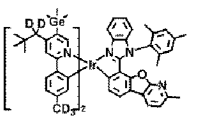
1391
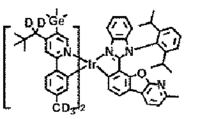
1392
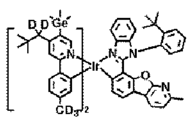
1393
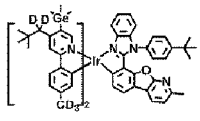
1394
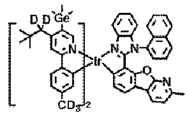
1395

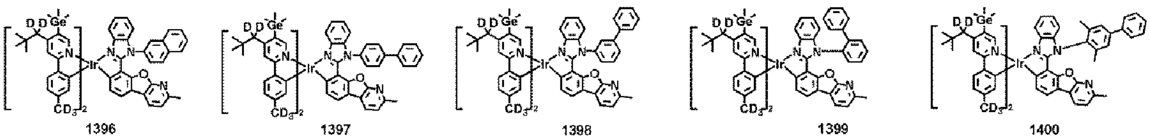
1396 1397 1398 1399 1400

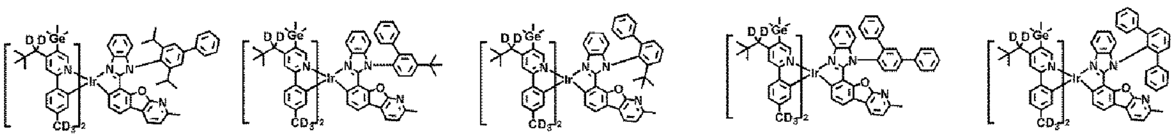
1401 1402 1403 1404 1405

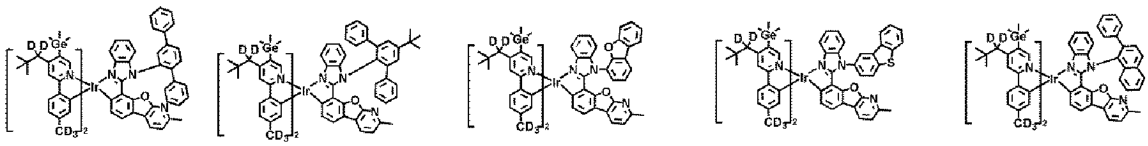
1406 1407 1408 1409 1410

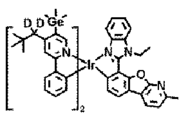
1411
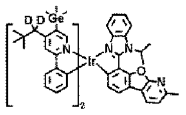
1412
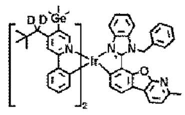
1413
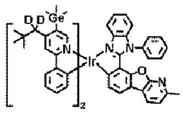
1414
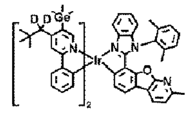
1415
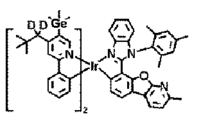
1416
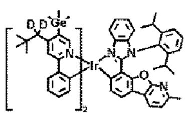
1417
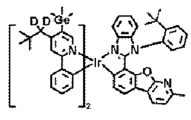
1418
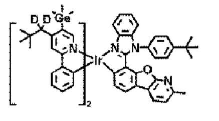
1419
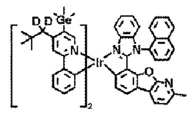
1420
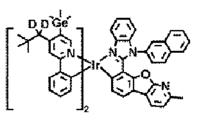
1421
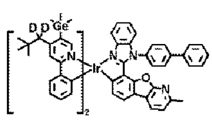
1422
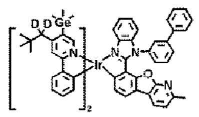
1423
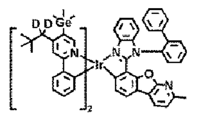
1424
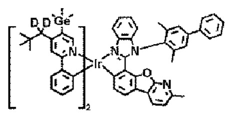
1425
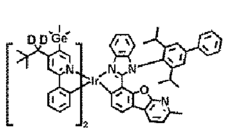
1426
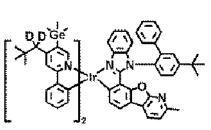
1427
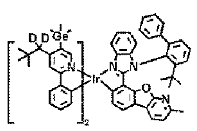
1428
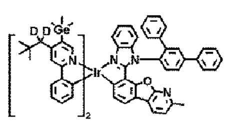
1429
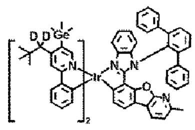
1430
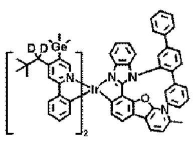
1431
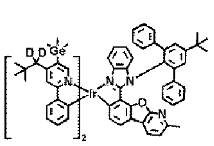
1432
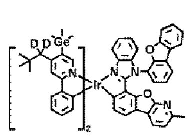
1433
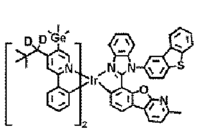
1434
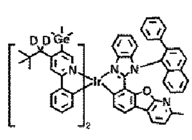
1435
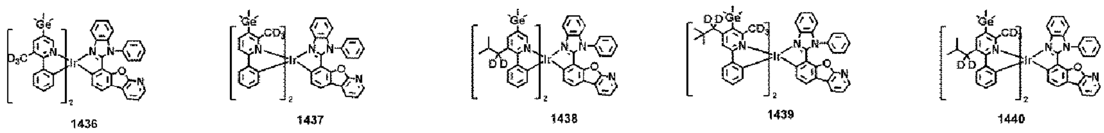
1436 1437 1438 1439 1440
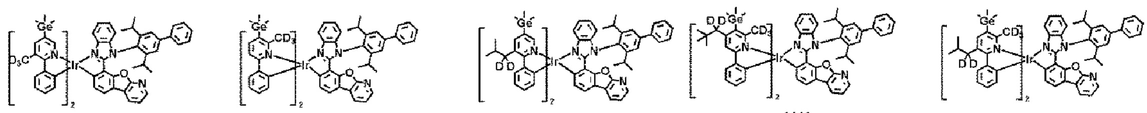
1441 1442 1443 1444 1445
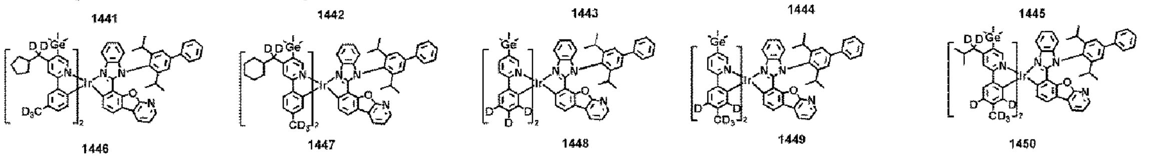
1446 1447 1448 1449 1450
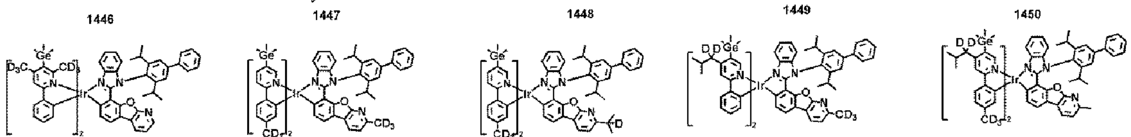
1451 1452 1453 1454 1455
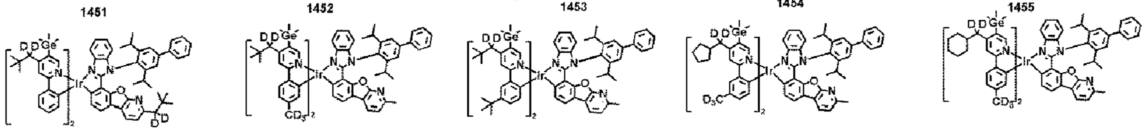
1456 1457 1458 1459 1460

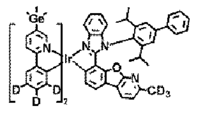
1461
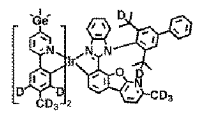
1462
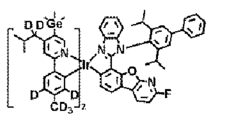
1463
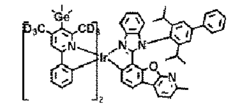
1464
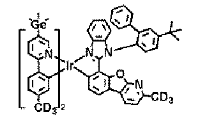
1465
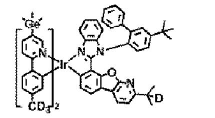
1466
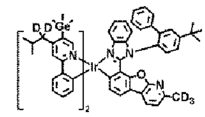
1467
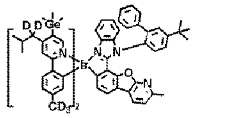
1468
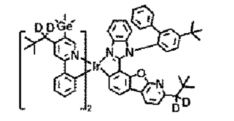
1469
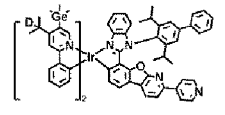
1470
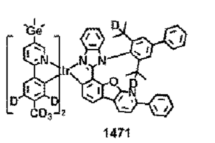
1471
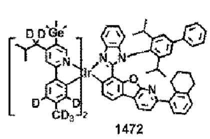
1472
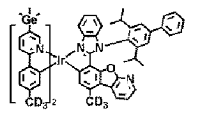
1473
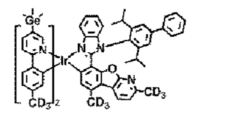
1474
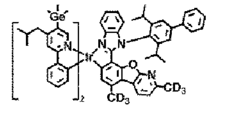
1475
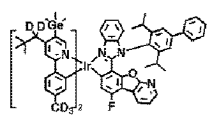
1476
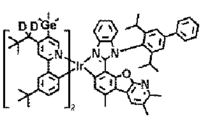
1477
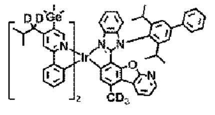
1478
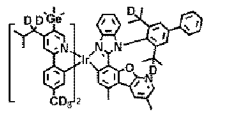
1479
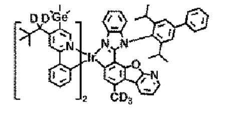
1480
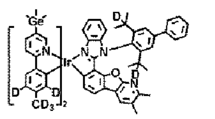
1481
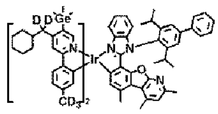
1482
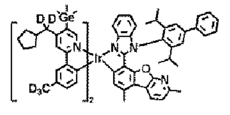
1483
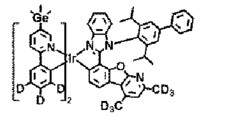
1484
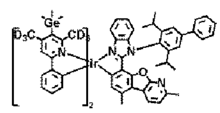
1485
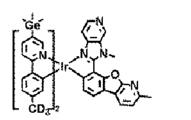
1486
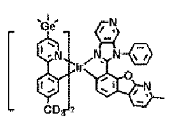
1487
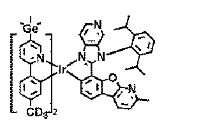
1488
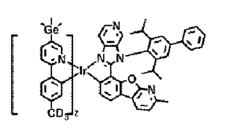
1489
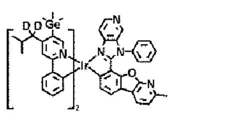
1490
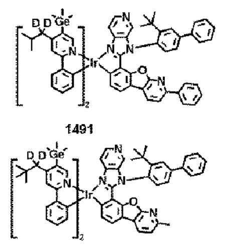
1491
1496
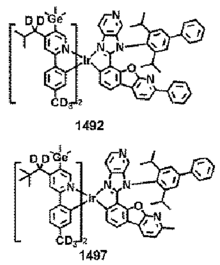
1492
1497
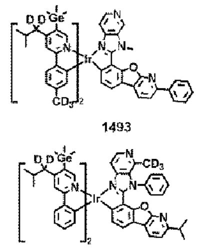
1493
1498
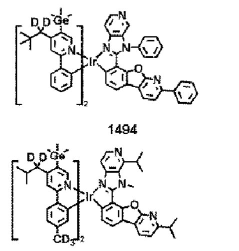
1494
1499
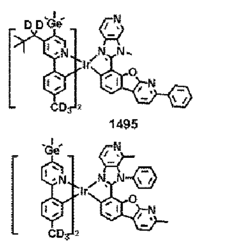
1495
1500
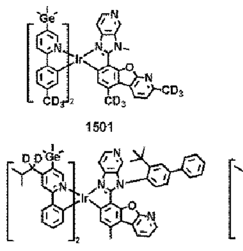
1501
1506
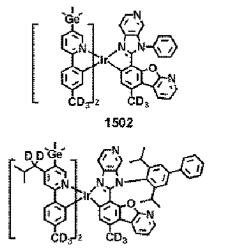
1502
1507
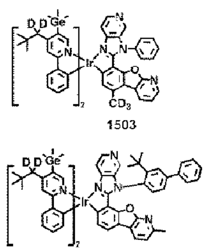
1503
1508
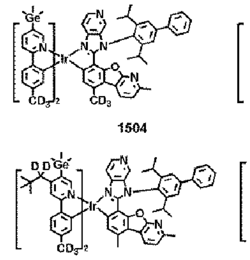
1504
1509
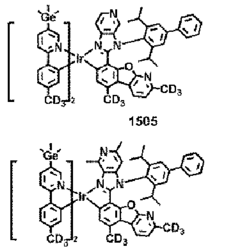
1505
1510

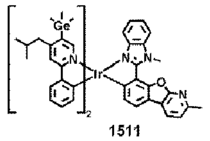
1511
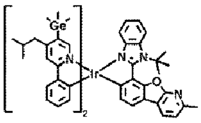
1512
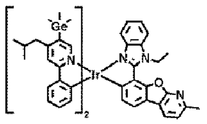
1513
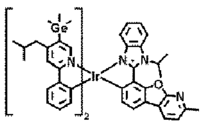
1514
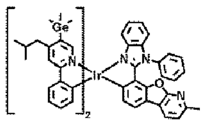
1515

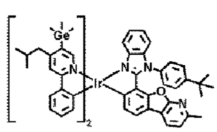
1516
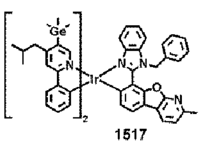
1517
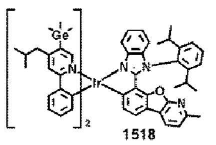
1518
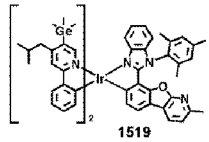
1519
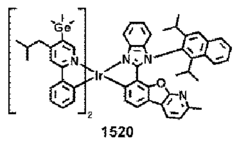
1520

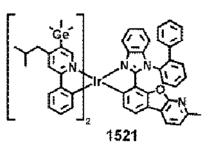
1521
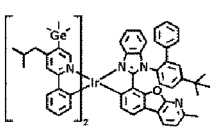
1522
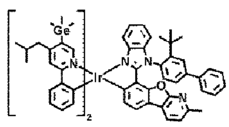
1523
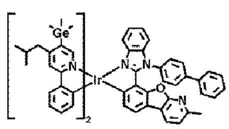
1524
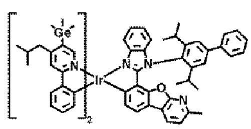
1525

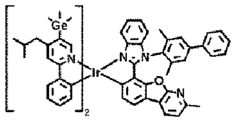
1526
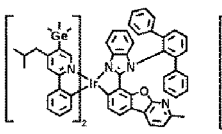
1527
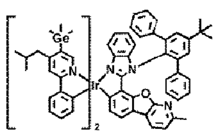
1528
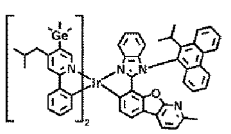
1529
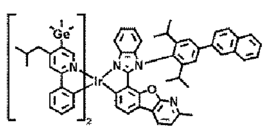
1530

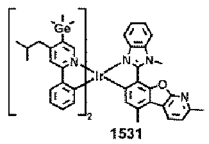
1531
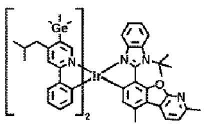
1532
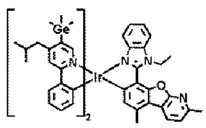
1533
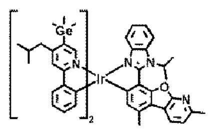
1534
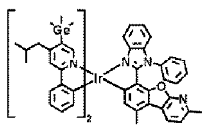
1535

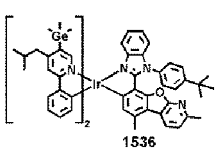
1536
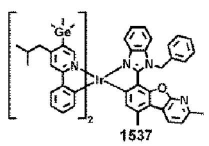
1537
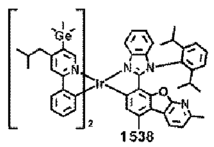
1538
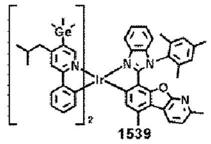
1539
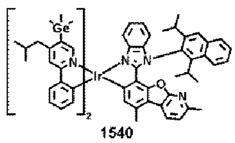
1540

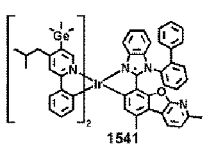
1541
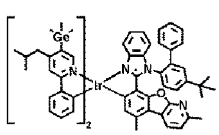
1542
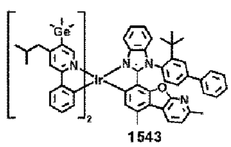
1543
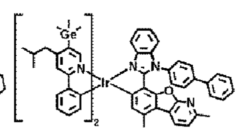
1544
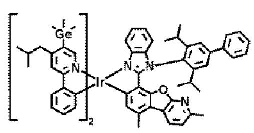
1545

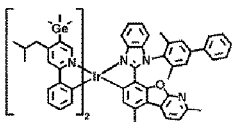
1546
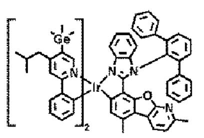
1547
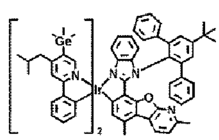
1548
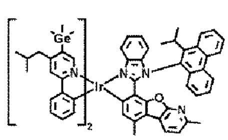
1549
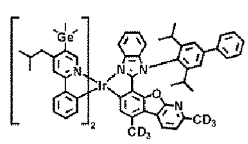
1550

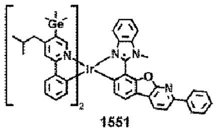
1551
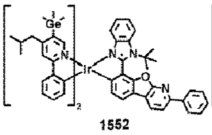
1552
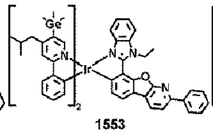
1553
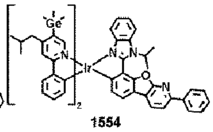
1554
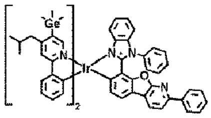
1555

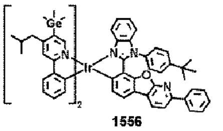
1556
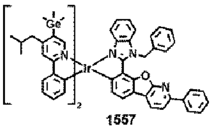
1557
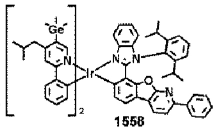
1558
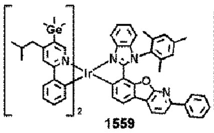
1559
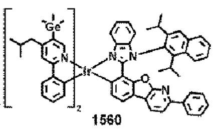
1560

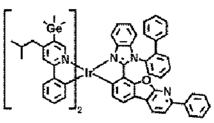
1561
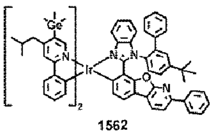
1562
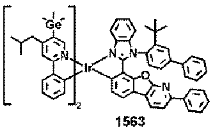
1563
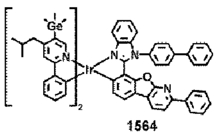
1564
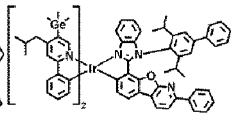
1565

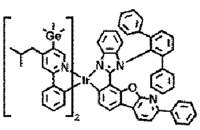
1566
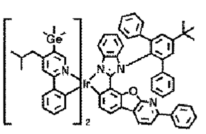
1567
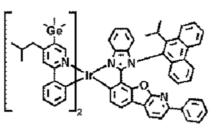
1568
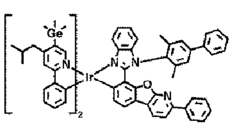
1569
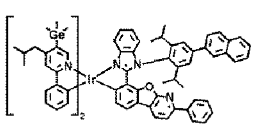
1570

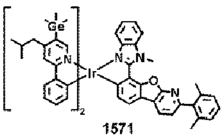
1571
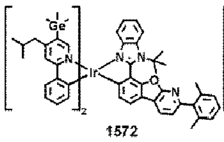
1572
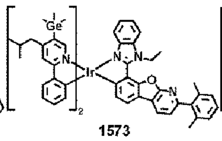
1573
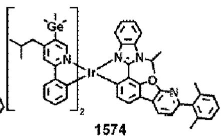
1574
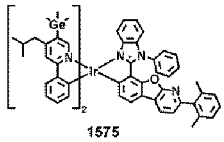
1575

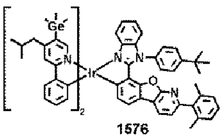
1576
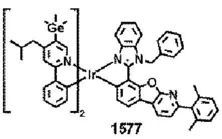
1577
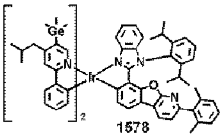
1578
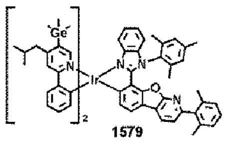
1579
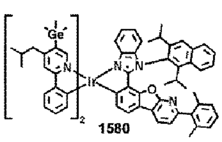
1580

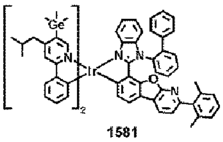
1581
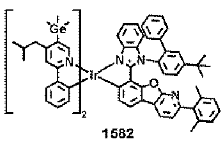
1582
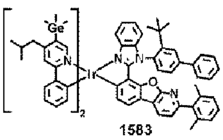
1583
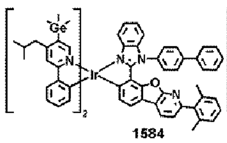
1584
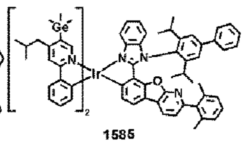
1585

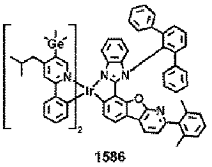
1586
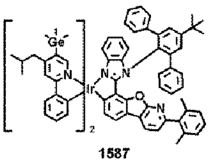
1587
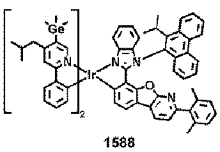
1588
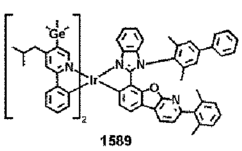
1589
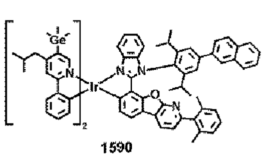
1590

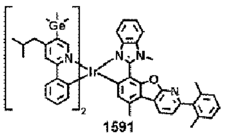
1591
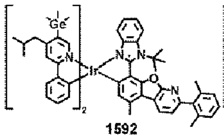
1592
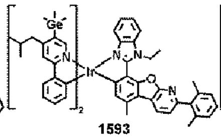
1593
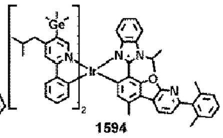
1594
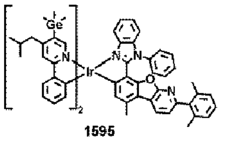
1595

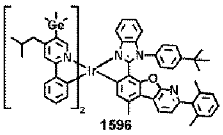
1596
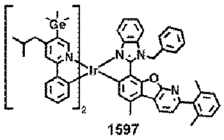
1597
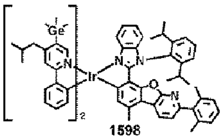
1598
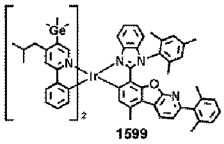
1599
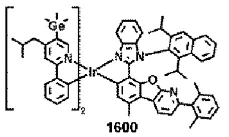
1600

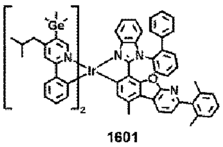
1601
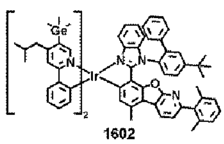
1602
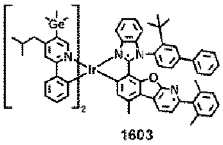
1603
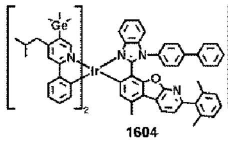
1604
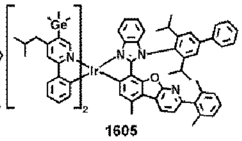
1605

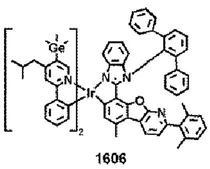
1606
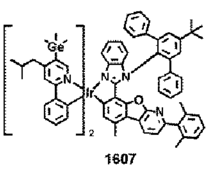
1607
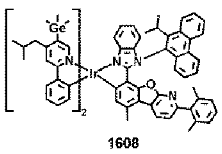
1608
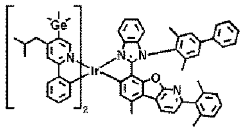
1609
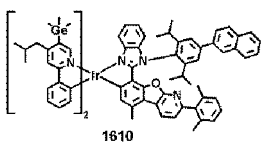
1610

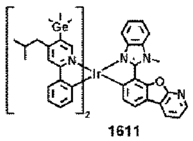
1611
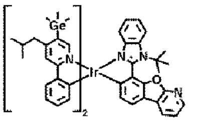
1612
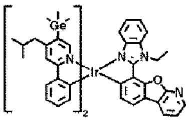
1613
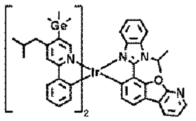
1614
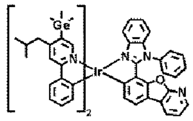
1615

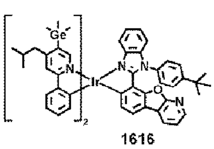
1616
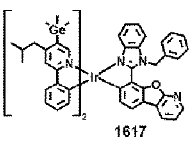
1617
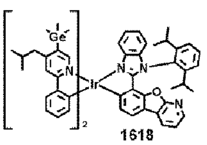
1618
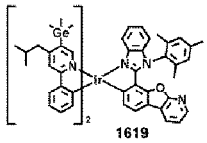
1619
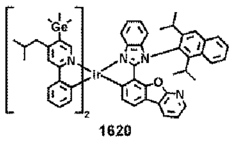
1620

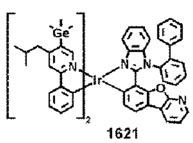
1621
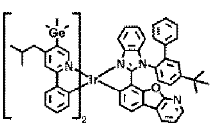
1622
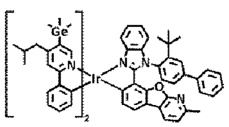
1623
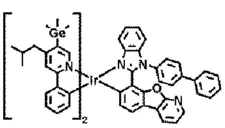
1624
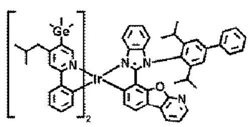
1625

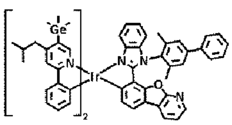
1626
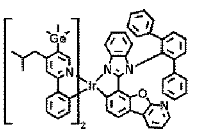
1627
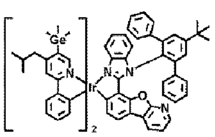
1628
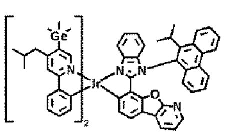
1629
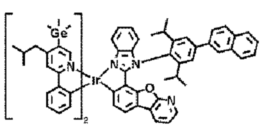
1630

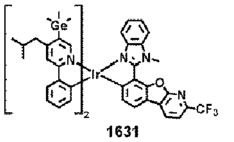
1631
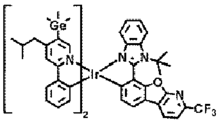
1632
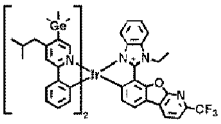
1633
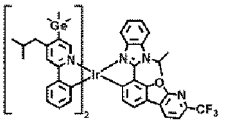
1634
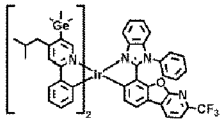
1635

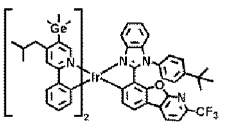
1636
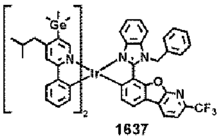
1637
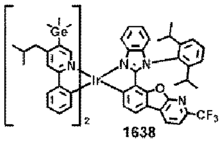
1638
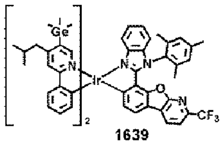
1639
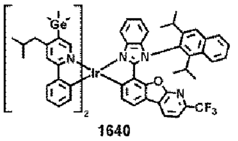
1640

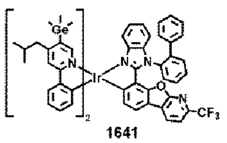
1641
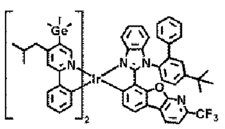
1642
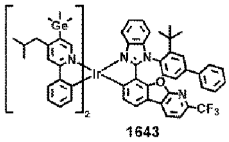
1643
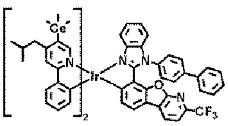
1644
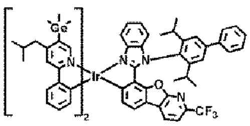
1645

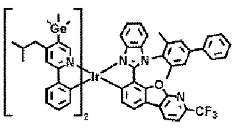
1646
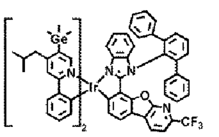
1647
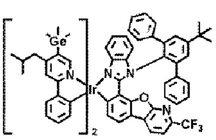
1648
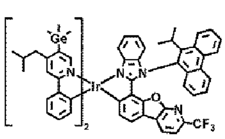
1649
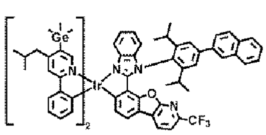
1650

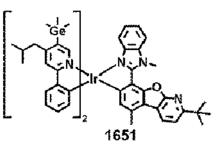
1651
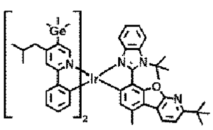
1652
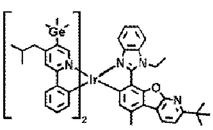
1653
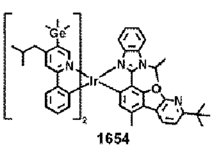
1654
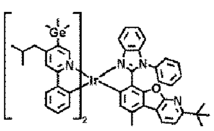
1655

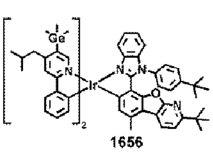
1656
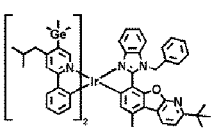
1657
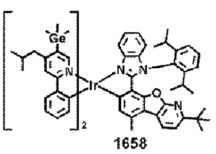
1658
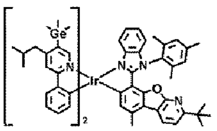
1659
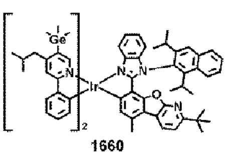
1660

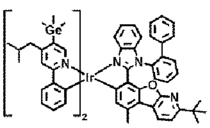
1661
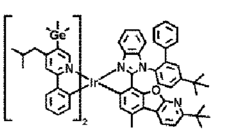
1662
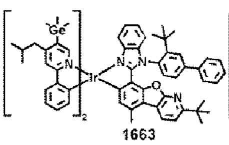
1663
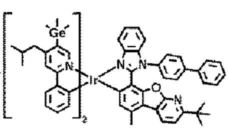
1664
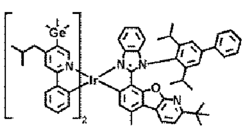
1665

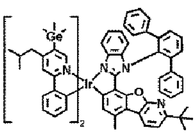
1666
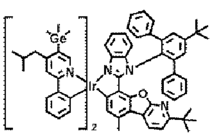
1667
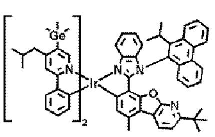
1668
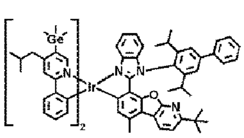
1669
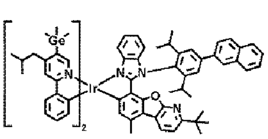
1670

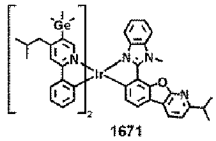
1671
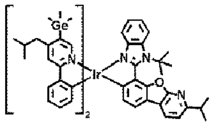
1672
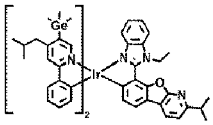
1673
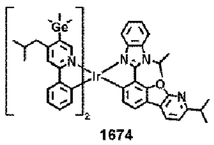
1674
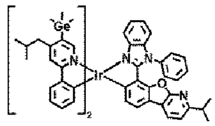
1675
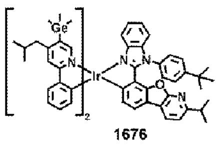
1676
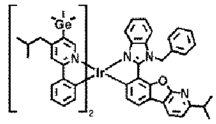
1677
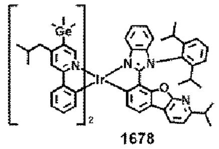
1678
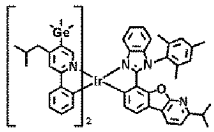
1679
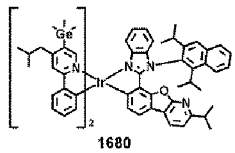
1680
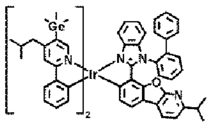
1681
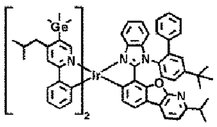
1682
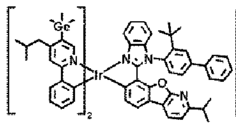
1683
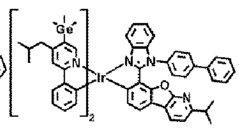
1684
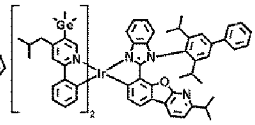
1685
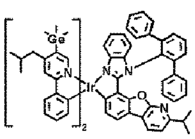
1686
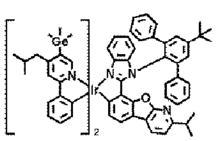
1687
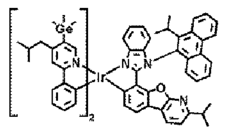
1688
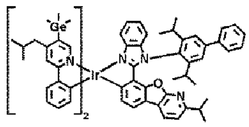
1689
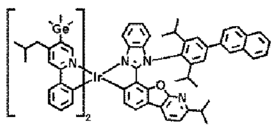
1690
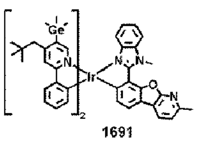
1691
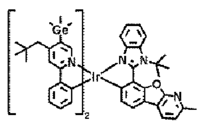
1692
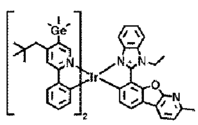
1693
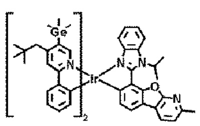
1694
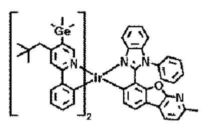
1695
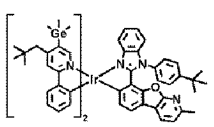
1696
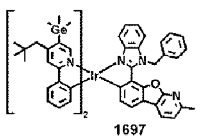
1697
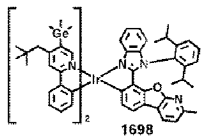
1698
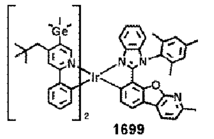
1699
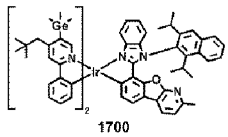
1700
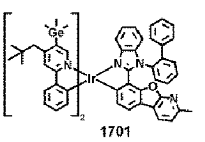
1701
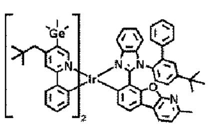
1702
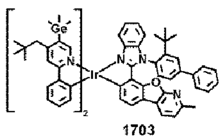
1703
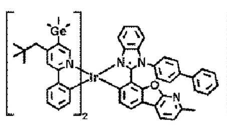
1704
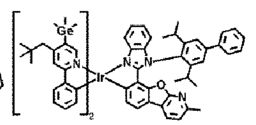
1705
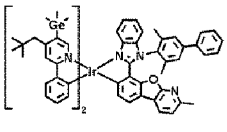
1706
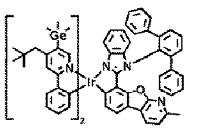
1707
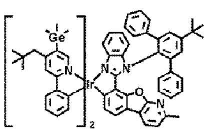
1708
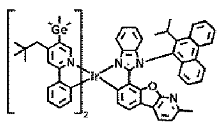
1709
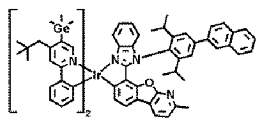
1710

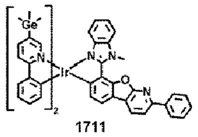
1711
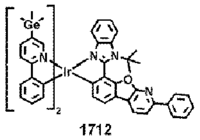
1712
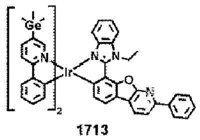
1713
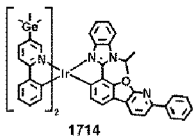
1714
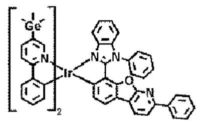
1715

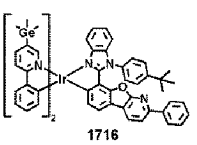
1716
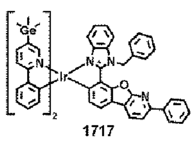
1717
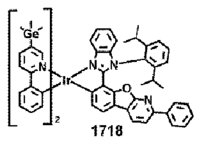
1718
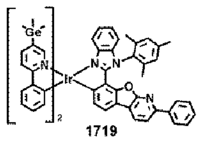
1719
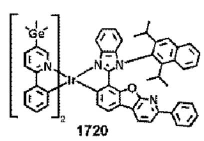
1720

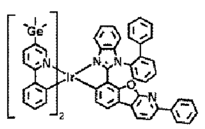
1721
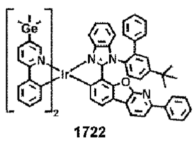
1722
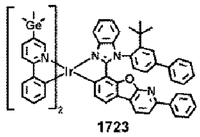
1723
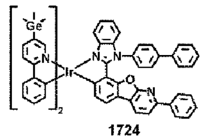
1724
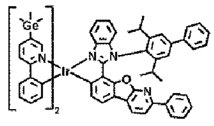
1725

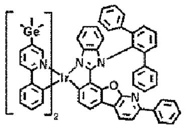
1726
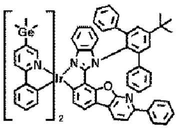
1727
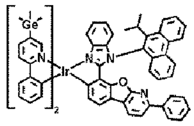
1728
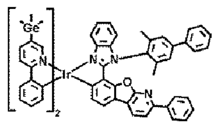
1729
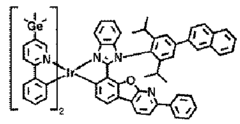
1730

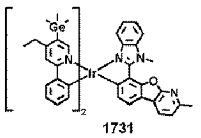
1731
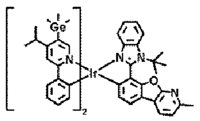
1732
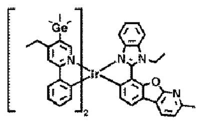
1733
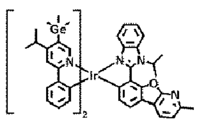
1734
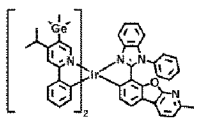
1735

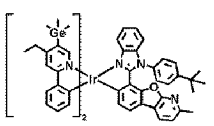
1736
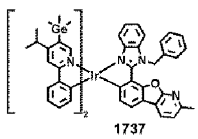
1737
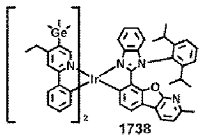
1738
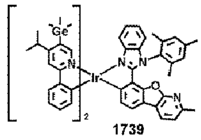
1739
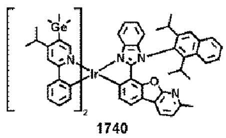
1740

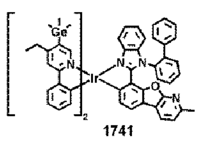
1741
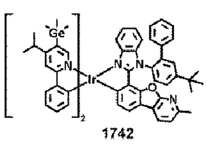
1742
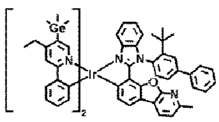
1743
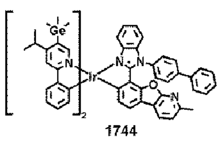
1744
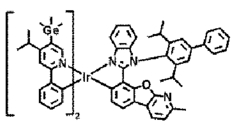
1745

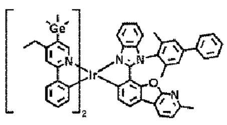
1746
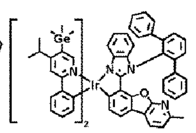
1747
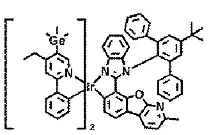
1748
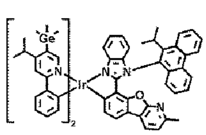
1749
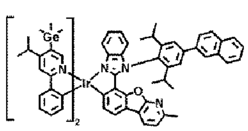
1750

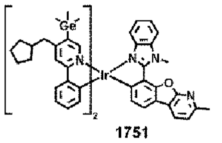
1751

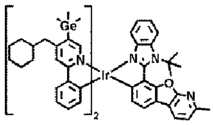
1752

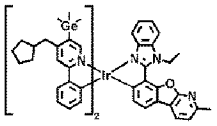
1753

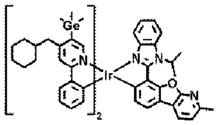
1754

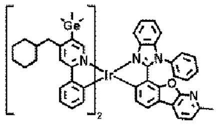
1755

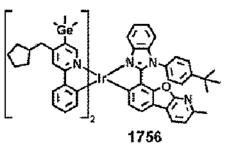
1756

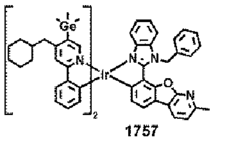
1757

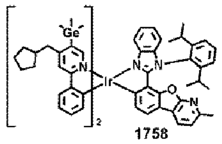
1758

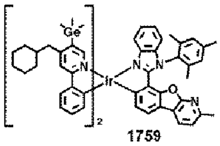
1759

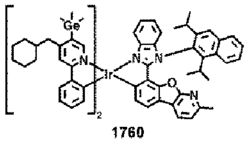
1760

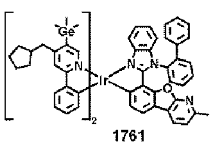
1761

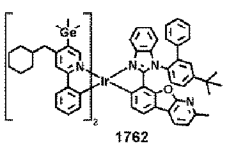
1762

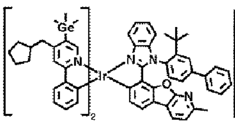
1763

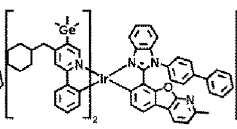
1764

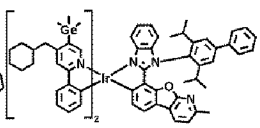
1765

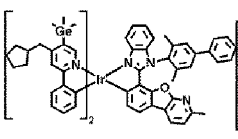
1766

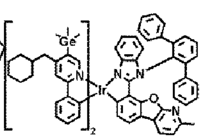
1767

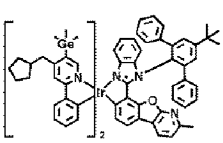
1768

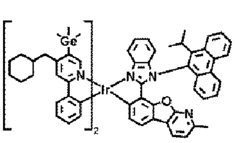
1769

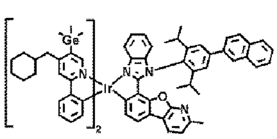
1770

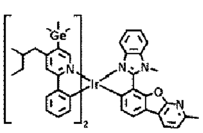
1771

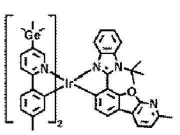
1772

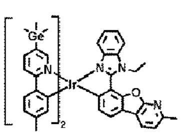
1773

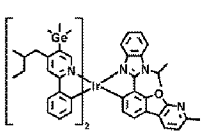
1774

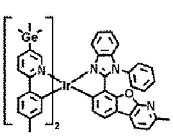
1775

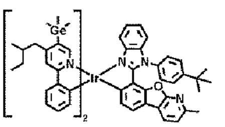
1776

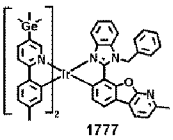
1777

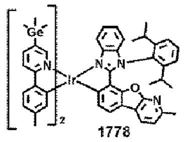
1778

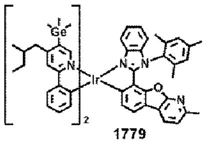
1779

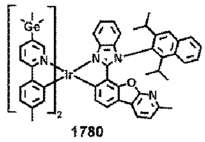
1780

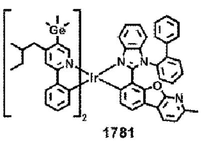
1781

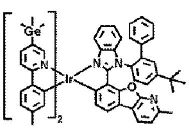
1782

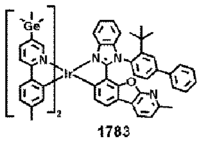
1783

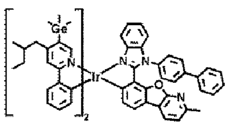
1784

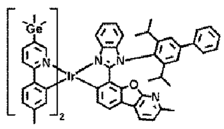
1785

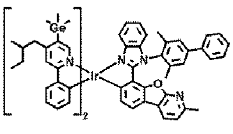
1786

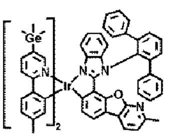
1787

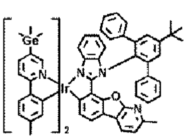
1788

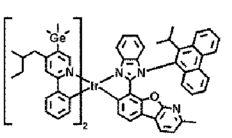
1789

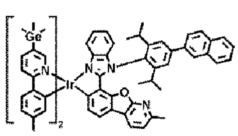
1790

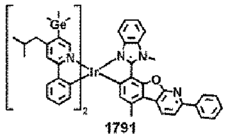
1791
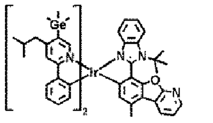
1792
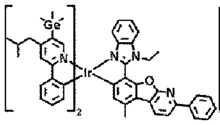
1793
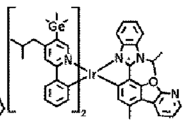
1794
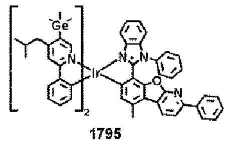
1795
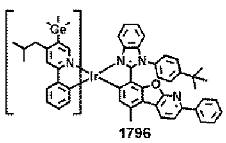
1796
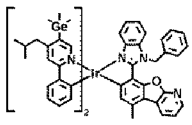
1797
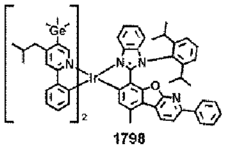
1798
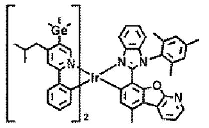
1799
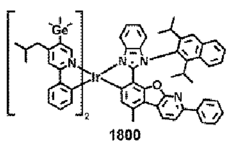
1800
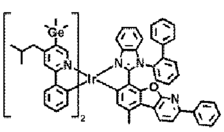
1801
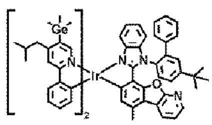
1802
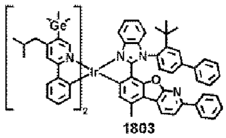
1803
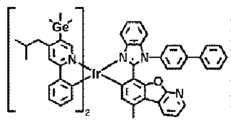
1804
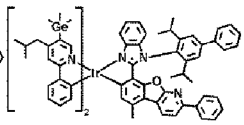
1805
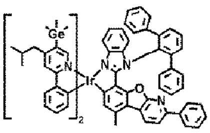
1806
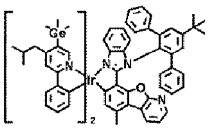
1807
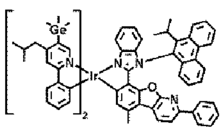
1808
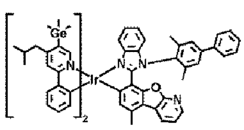
1809
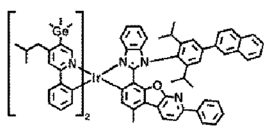
1810
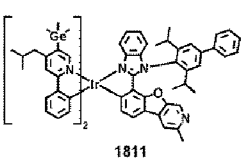
1811
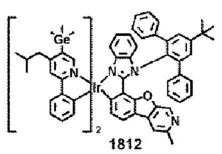
1812
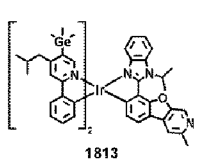
1813
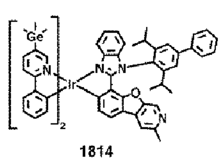
1814
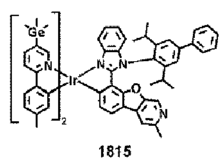
1815
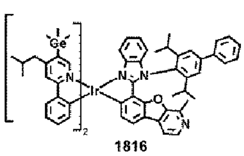
1816
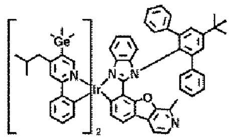
1817
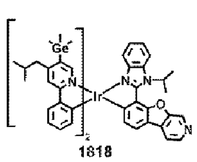
1818
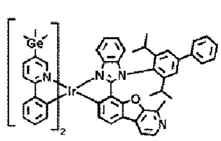
1819
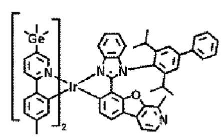
1820
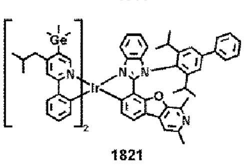
1821
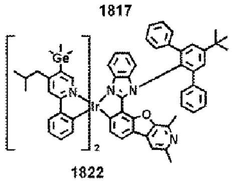
1822
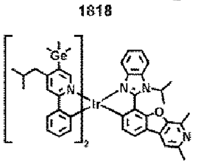
1823
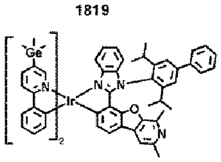
1824
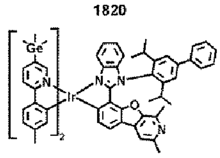
1825
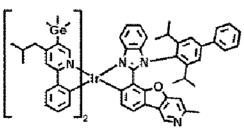
1826
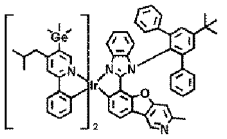
1827
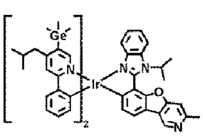
1828
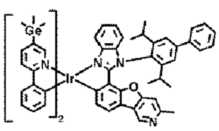
1829
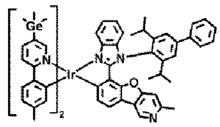
1830

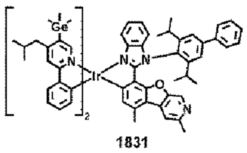
1831
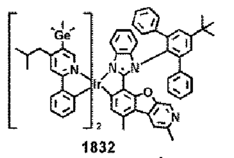
1832
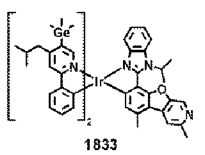
1833
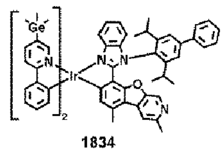
1834
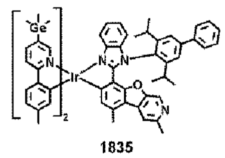
1835

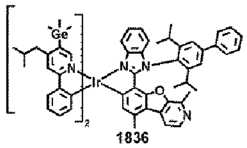
1836
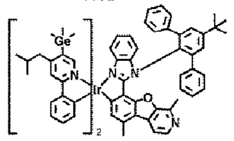
1837
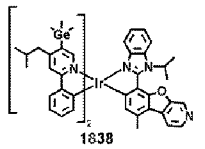
1838
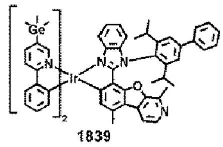
1839
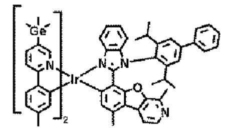
1840

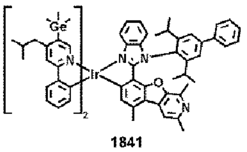
1841
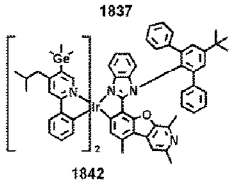
1842
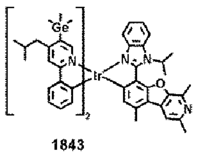
1843
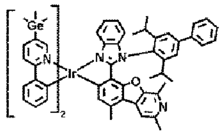
1844
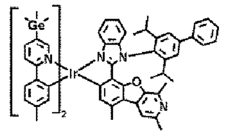
1845

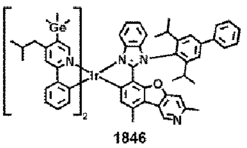
1846
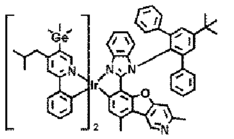
1847
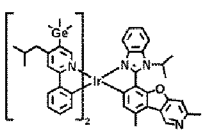
1848
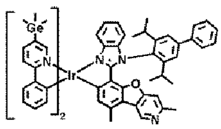
1849
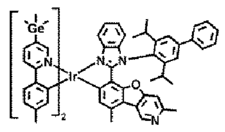
1850

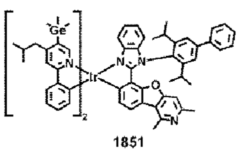
1851
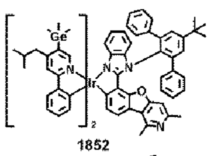
1852
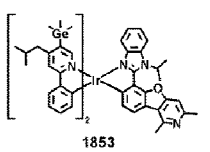
1853
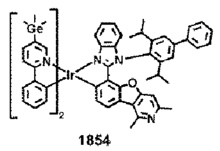
1854
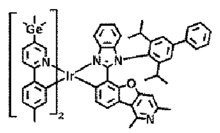
1855

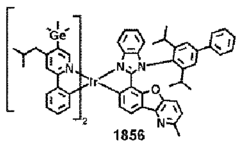
1856
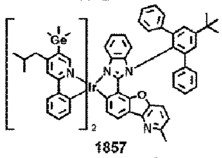
1857
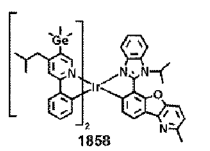
1858
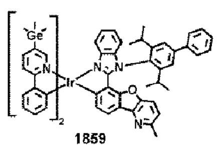
1859
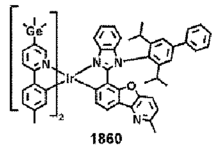
1860

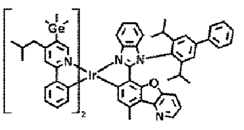
1861
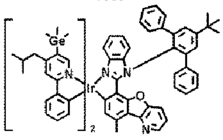
1862
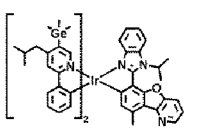
1863
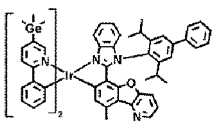
1864
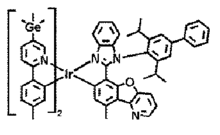
1865

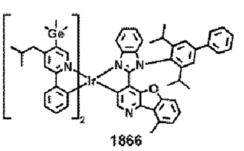
1866
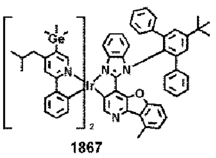
1867
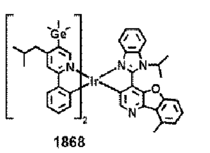
1868
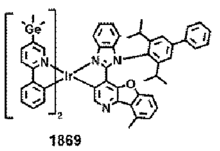
1869
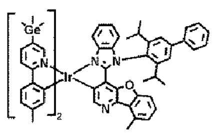
1870

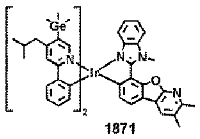
1871

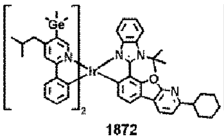
1872

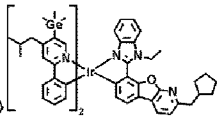
1873

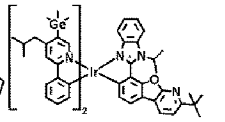
1874

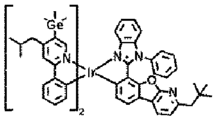
1875

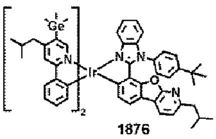
1876

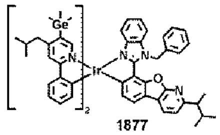
1877

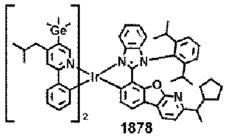
1878

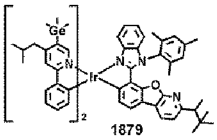
1879

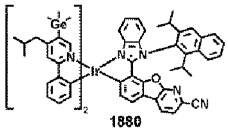
1880

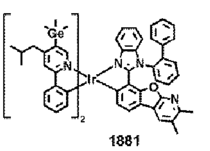
1881

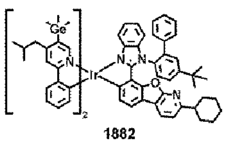
1882

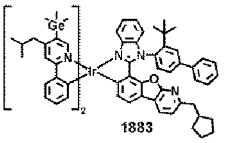
1883

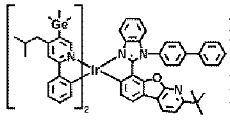
1884

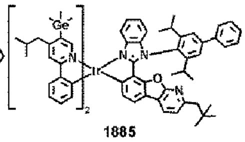
1885

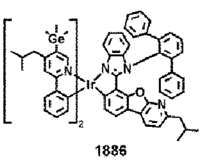
1886

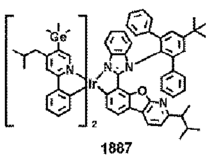
1887

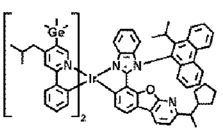
1888

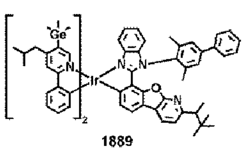
1889

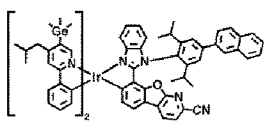
1890

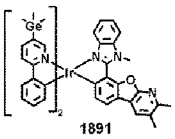
1891

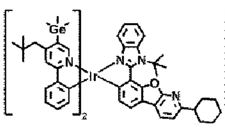
1892

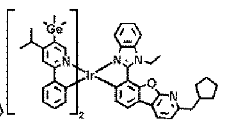
1893

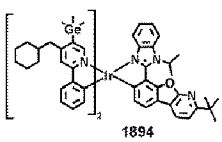
1894

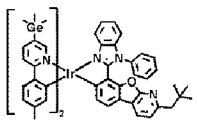
1895

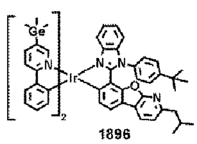
1896

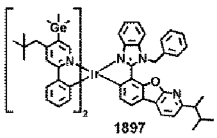
1897

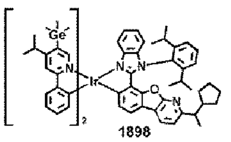
1898

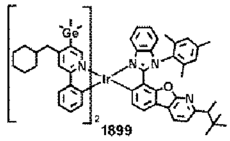
1899

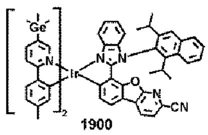
1900

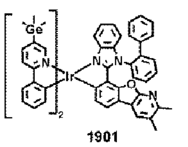
1901

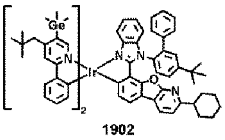
1902

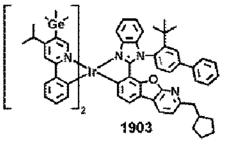
1903

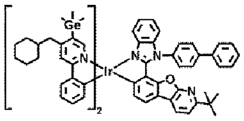
1904

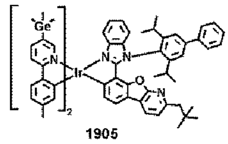
1905

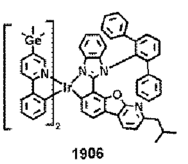
1906

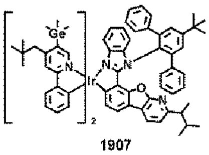
1907

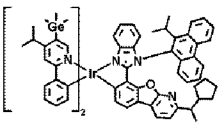
1908

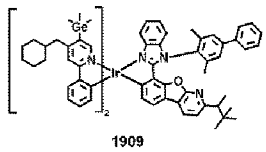
1909

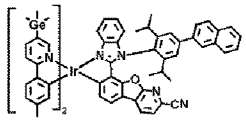
1910

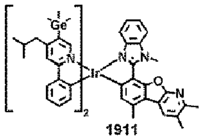
1911

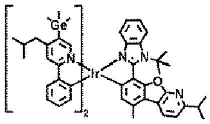
1912

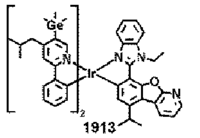
1913

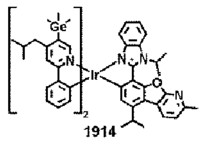
1914

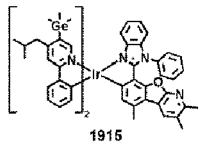
1915

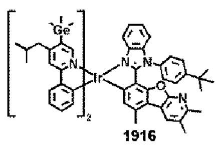
1916

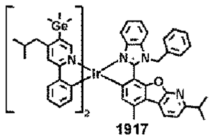
1917

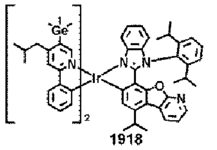
1918

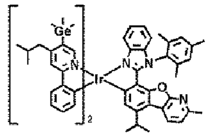
1919

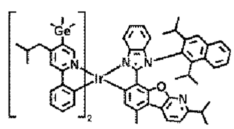
1920

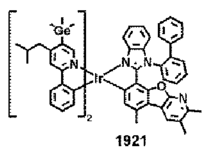
1921

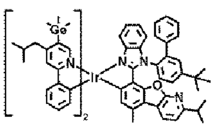
1922

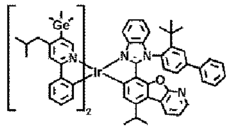
1923

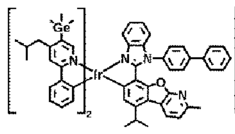
1924

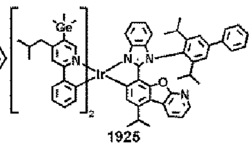
1925

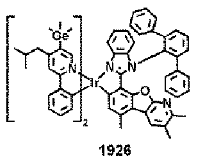
1926

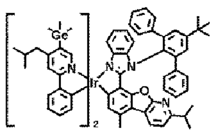
1927

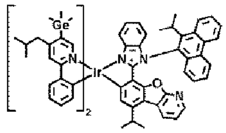
1928

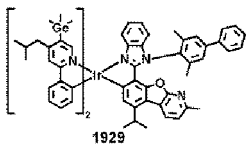
1929

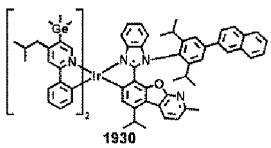
1930

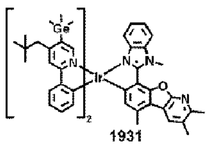
1931

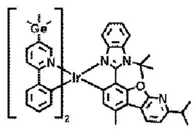
1932

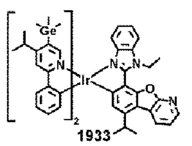
1933

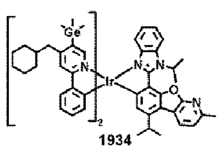
1934

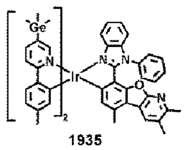
1935

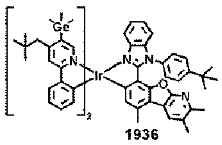
1936

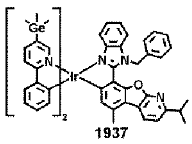
1937

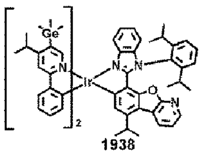
1938

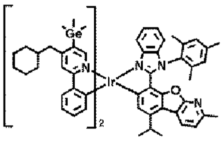
1939

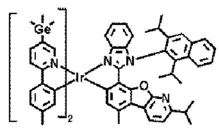
1940

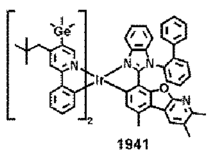
1941

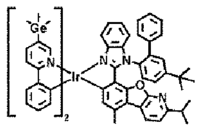
1942

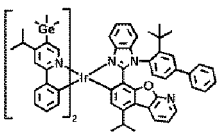
1943

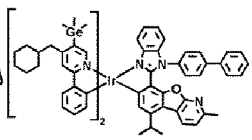
1944

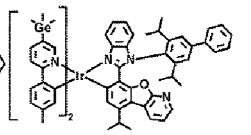
1945

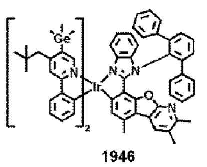
1946

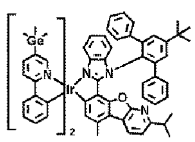
1947

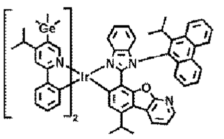
1948

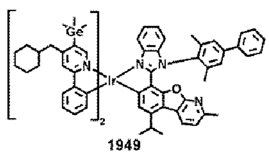
1949

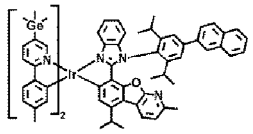
1950

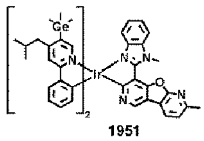
1951
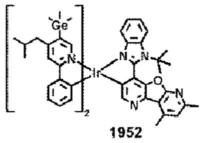
1952
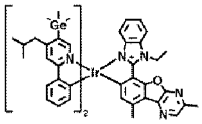
1953
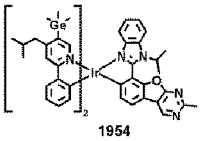
1954
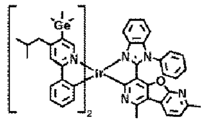
1955

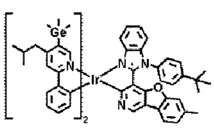
1956
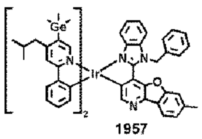
1957
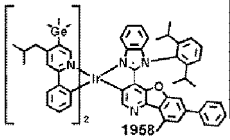
1958
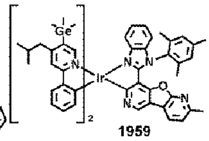
1959
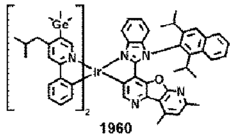
1960

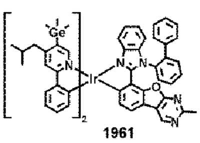
1961
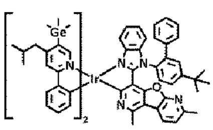
1962
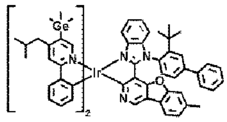
1963
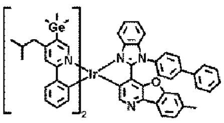
1964
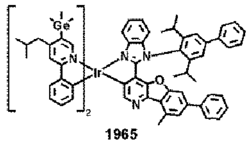
1965

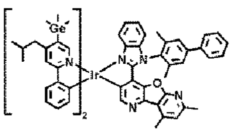
1966
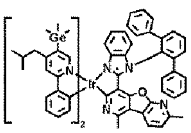
1967
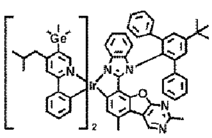
1968
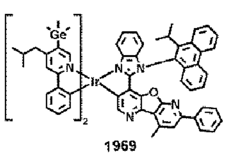
1969
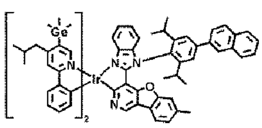
1970

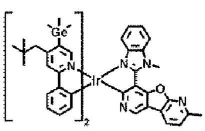
1971
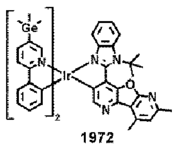
1972
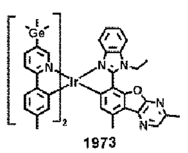
1973
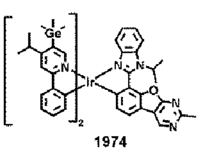
1974
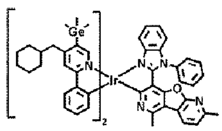
1975

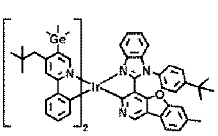
1976
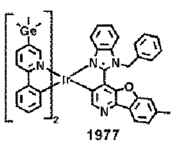
1977
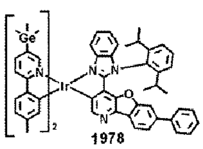
1978
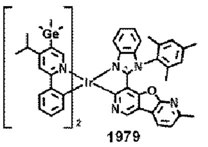
1979
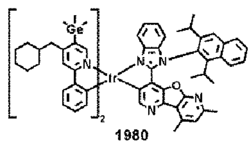
1980

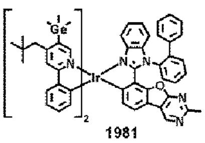
1981
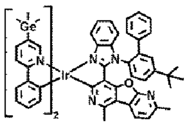
1982
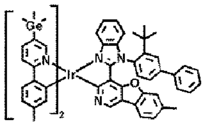
1983
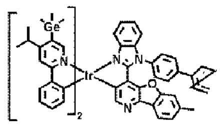
1984
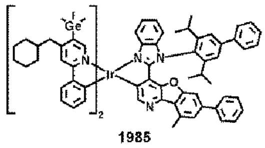
1985

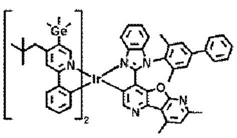
1986
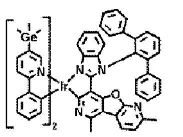
1987
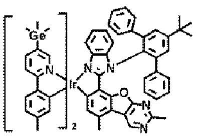
1988
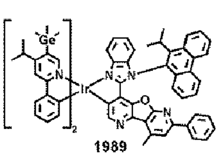
1989
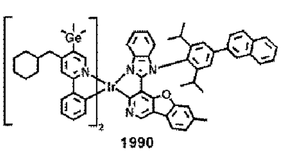
1990

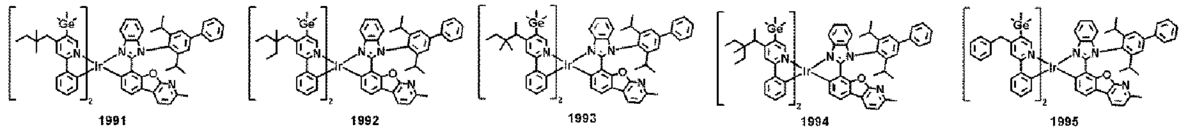

1991 1992 1993 1994 1995

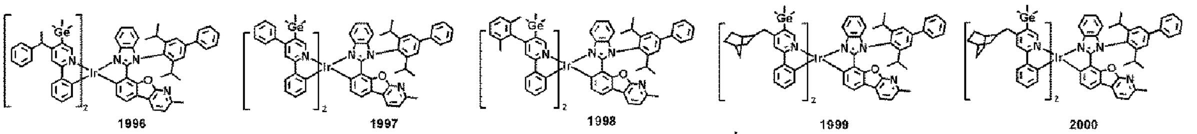

1996 1997 1998 1999 2000

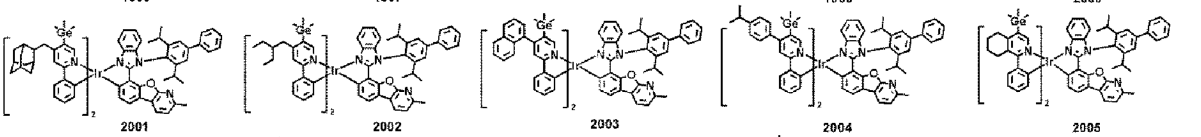

2001 2002 2003 2004 2005

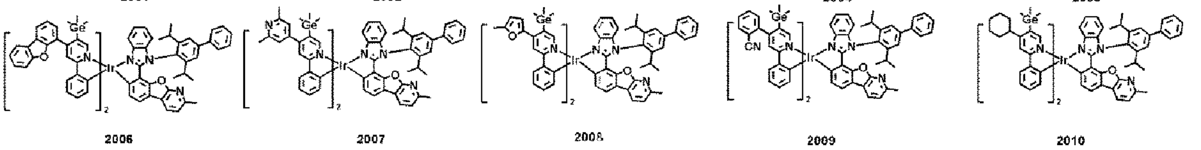

2006 2007 2008 2009 2010

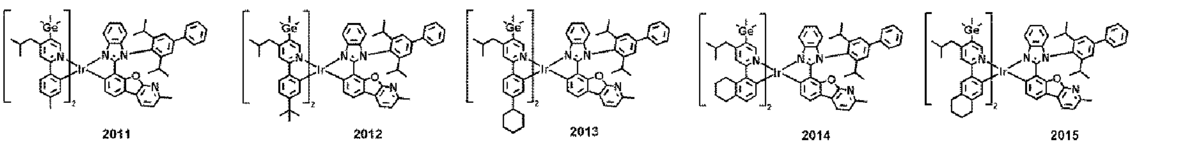

2011 2012 2013 2014 2015

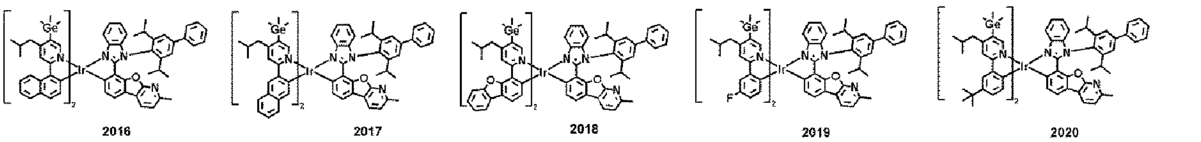

2016 2017 2018 2019 2020

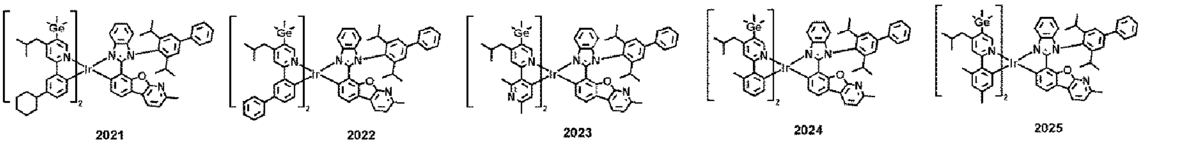

2021 2022 2023 2024 2025

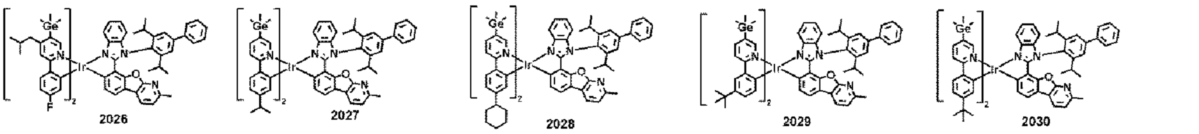

2026 2027 2028 2029 2030

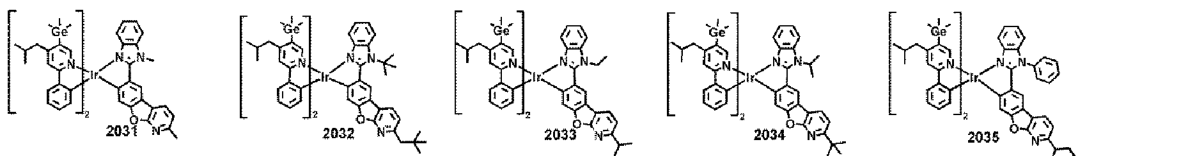

2031 2032 2033 2034 2035

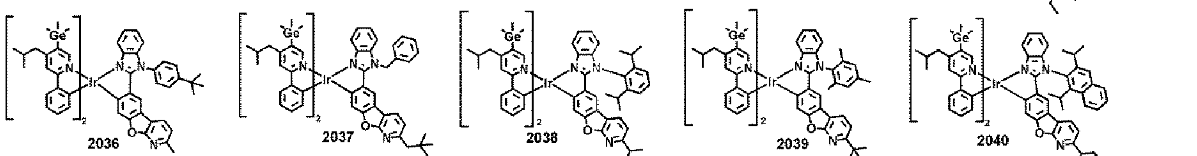

2036 2037 2038 2039 2040

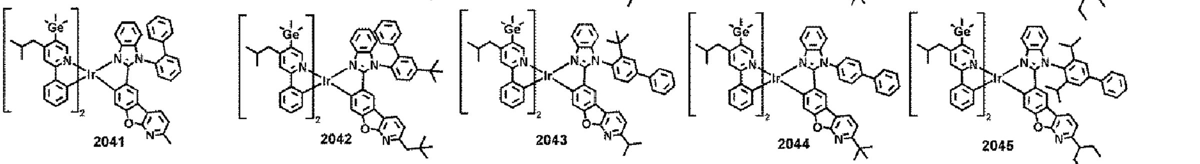

2041 2042 2043 2044 2045

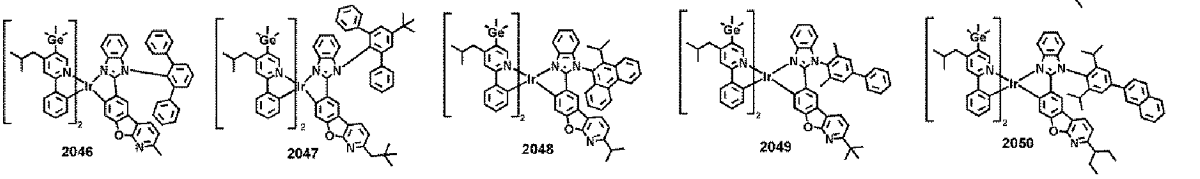

2046 2047 2048 2049 2050

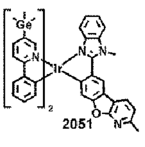
2051
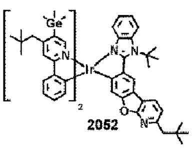
2052
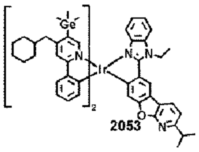
2053
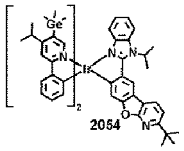
2054
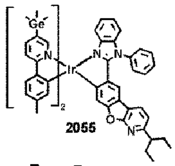
2055
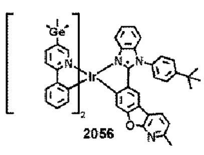
2056
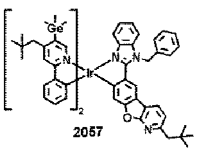
2057
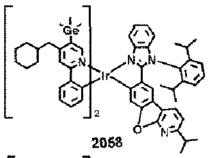
2058
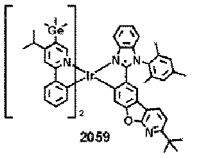
2059
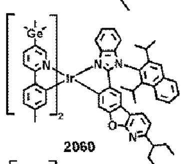
2060
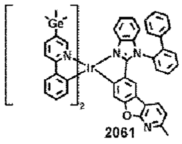
2061
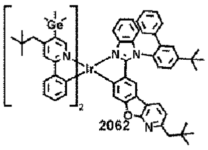
2062
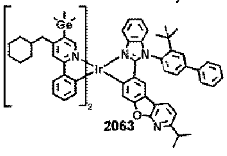
2063
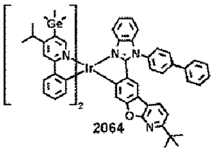
2064
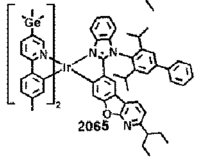
2065
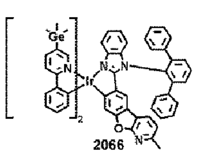
2066
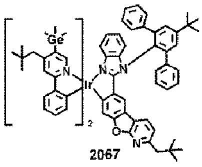
2067
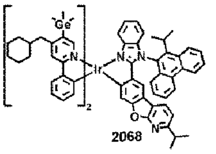
2068
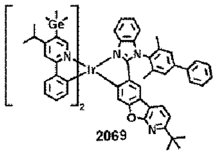
2069
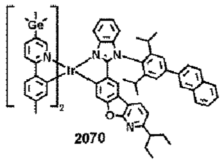
2070
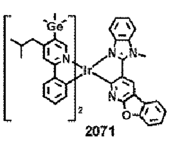
2071
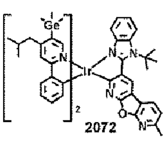
2072
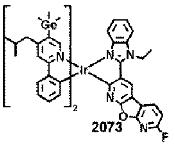
2073
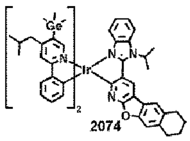
2074
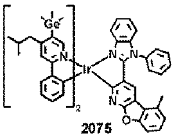
2075
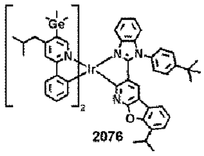
2076
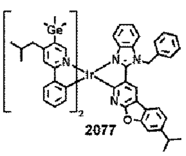
2077
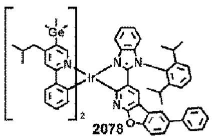
2078
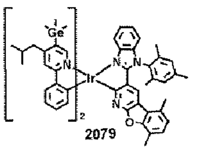
2079
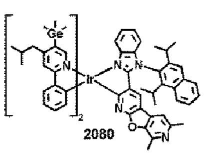
2080
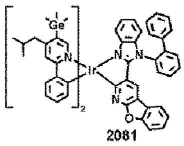
2081
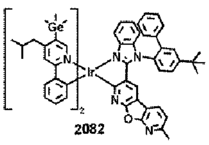
2082
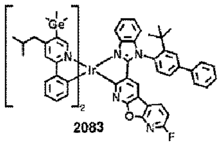
2083
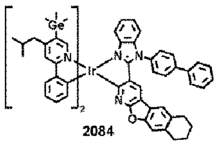
2084
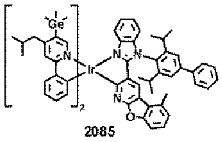
2085
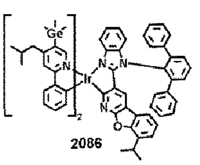
2086
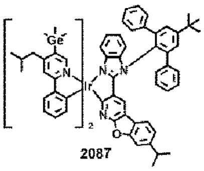
2087
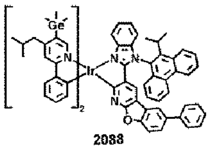
2088
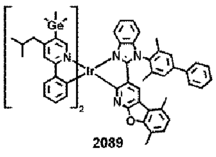
2089
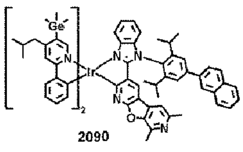
2090

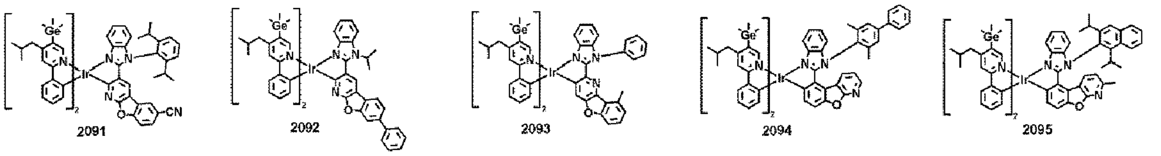
2091 2092 2093 2094 2095

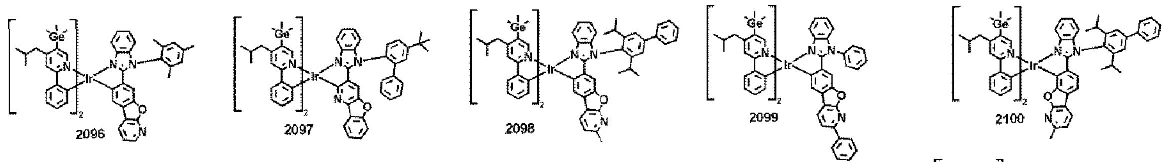
2096 2097 2098 2099 2100

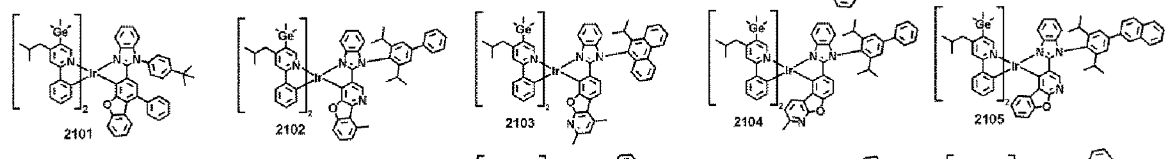
2101 2102 2103 2104 2105

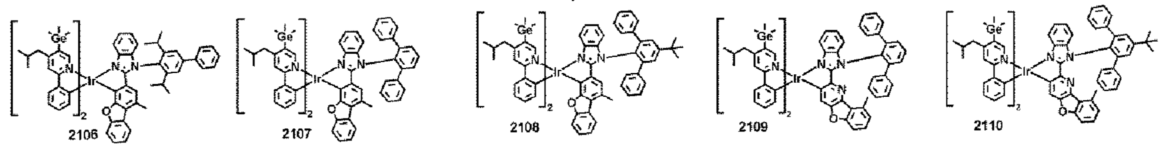
2106 2107 2108 2109 2110

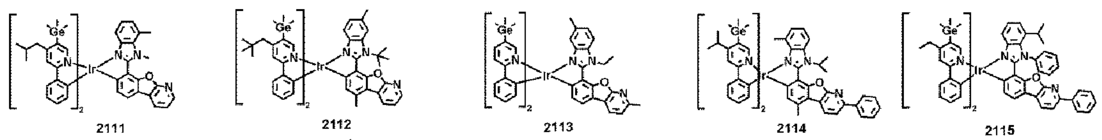
2111 2112 2113 2114 2115

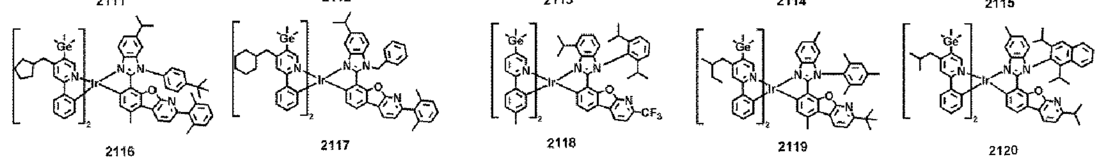
2116 2117 2118 2119 2120

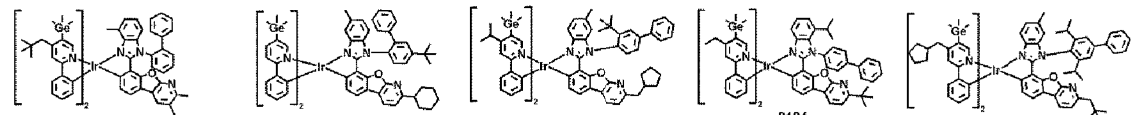
2121 2122 2123 2124 2125

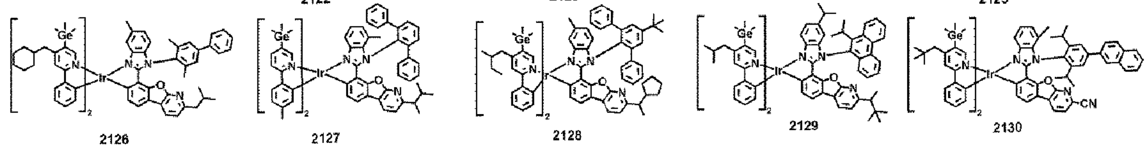
2126 2127 2128 2129 2130

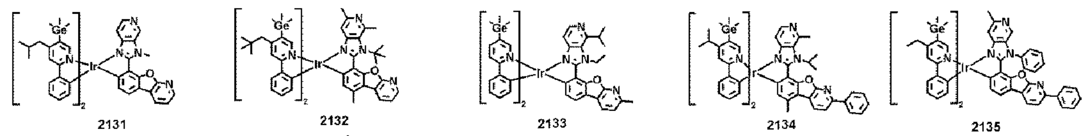
2131 2132 2133 2134 2135

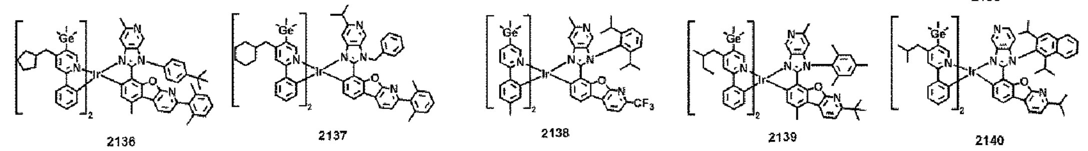
2136 2137 2138 2139 2140

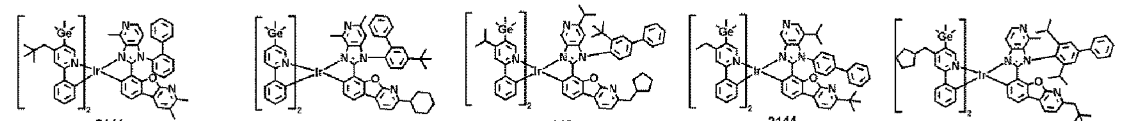
2141 2142 2143 2144 2145

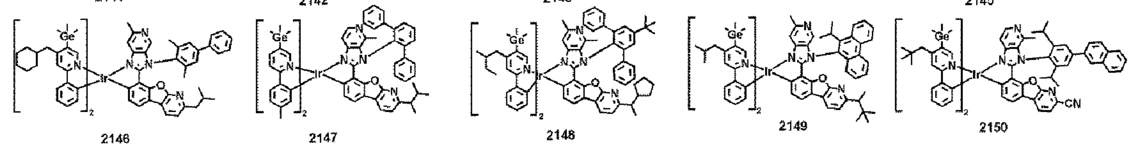
2146 2147 2148 2149 2150

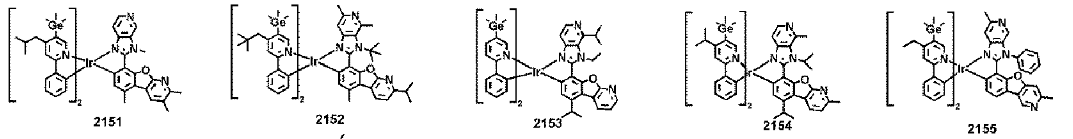

2151 2152 2153 2154 2155

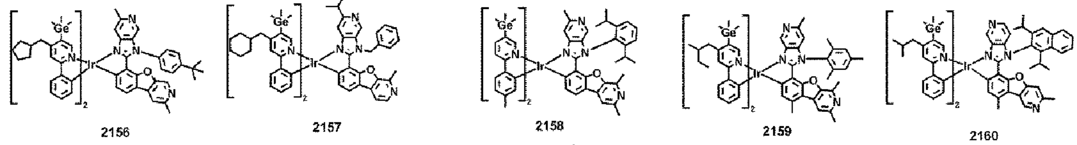

2156 2157 2158 2159 2160

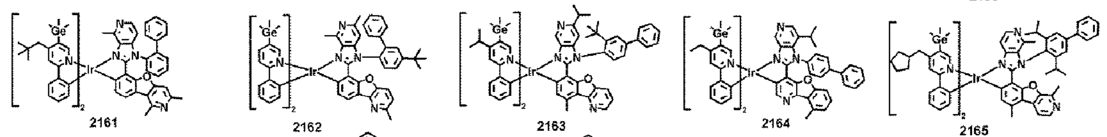

2161 2162 2163 2164 2165

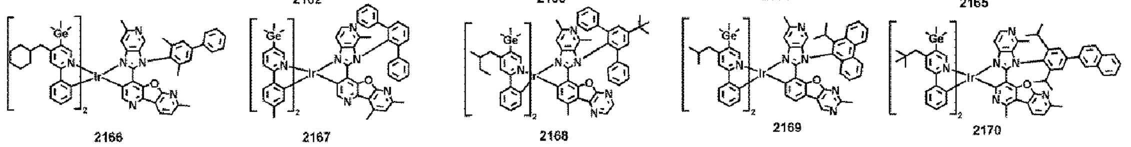

2166 2167 2168 2169 2170

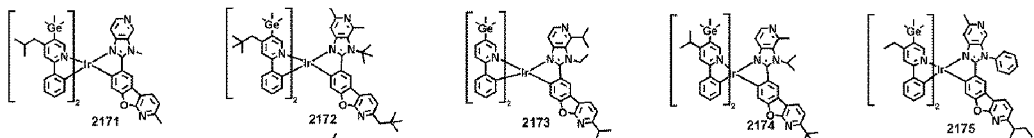

2171 2172 2173 2174 2175

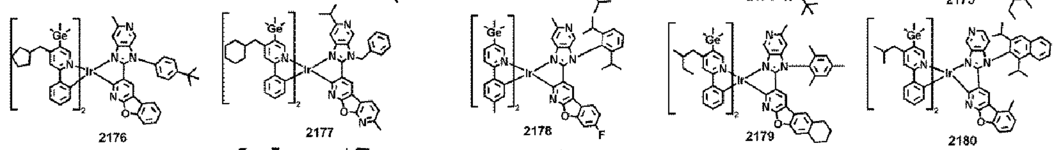

2176 2177 2178 2179 2180

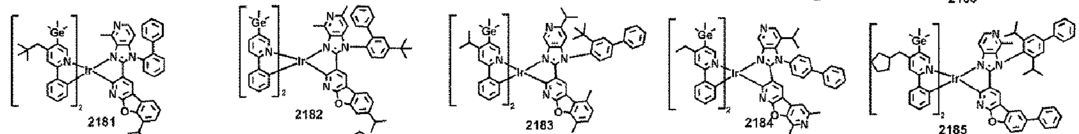

2181 2182 2183 2184 2185

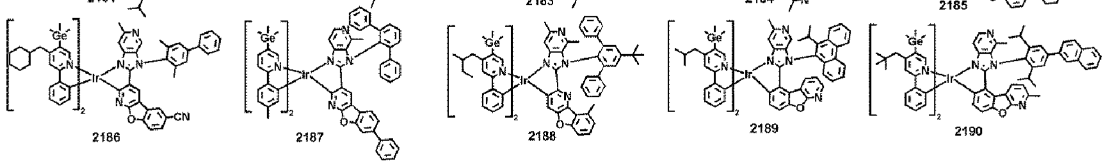

2186 2187 2188 2189 2190

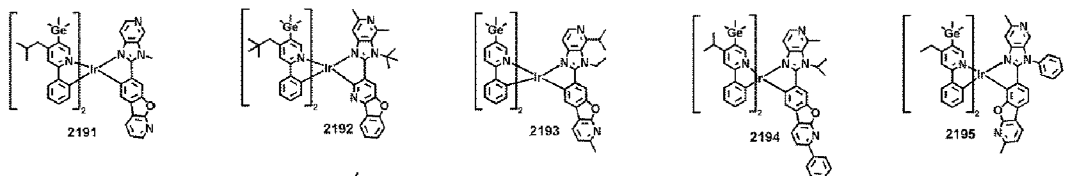

2191 2192 2193 2194 2195

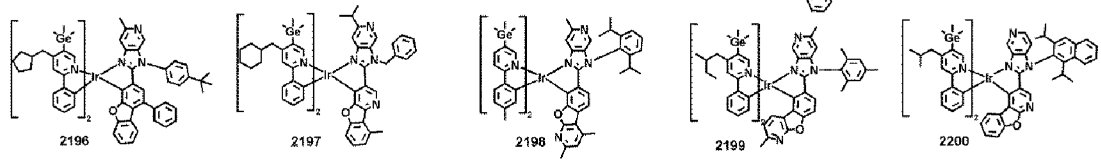

2196 2197 2198 2199 2200

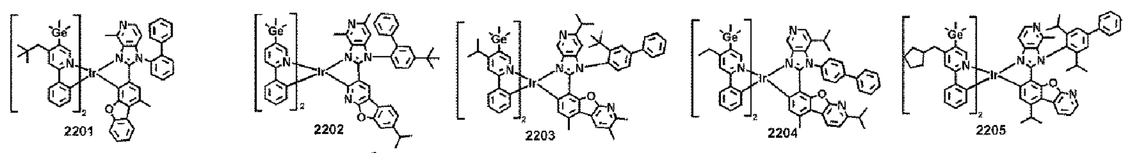

2201 2202 2203 2204 2205

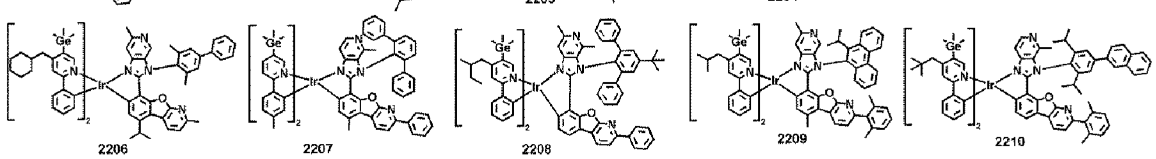

2206 2207 2208 2209 2210

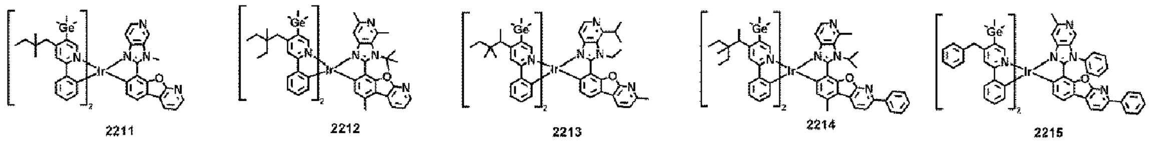

2211 2212 2213 2214 2215

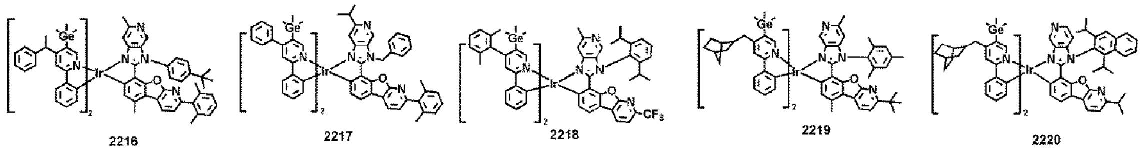

2216 2217 2218 2219 2220

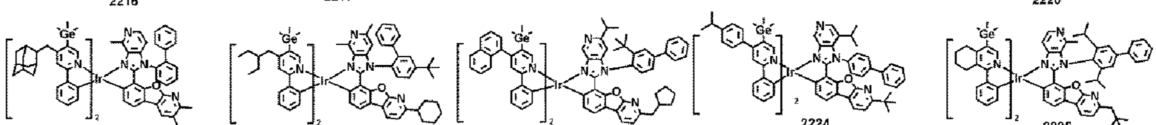

2221 2222 2223 2224 2225

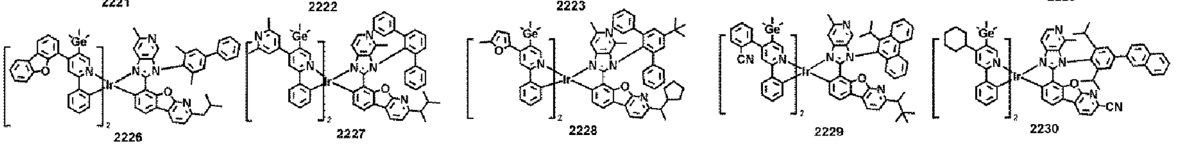

2226 2227 2228 2229 2230

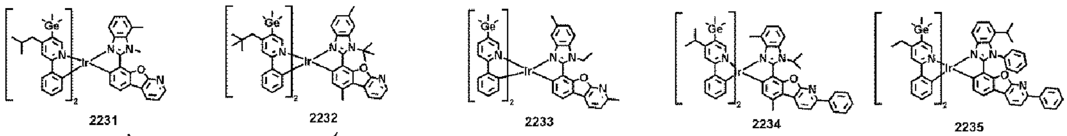

2231 2232 2233 2234 2235

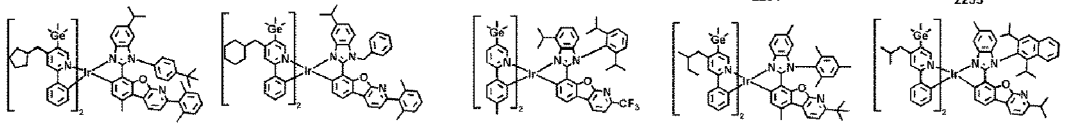

2236 2237 2238 2239 2240

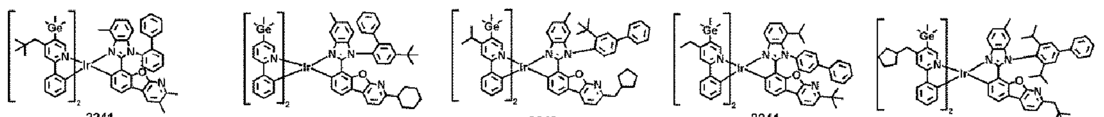

2241 2242 2243 2244 2245

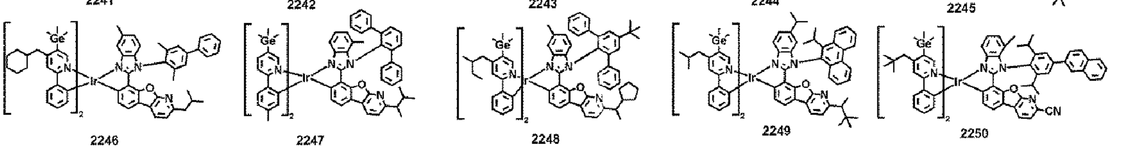

2246 2247 2248 2249 2250

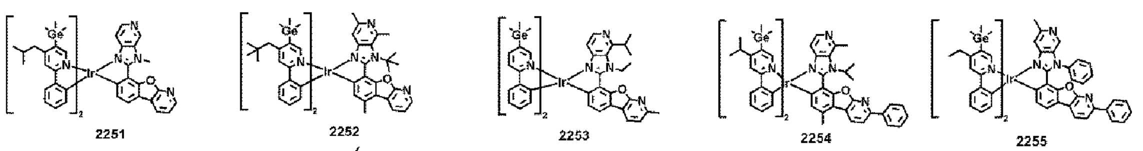

2251 2252 2253 2254 2255

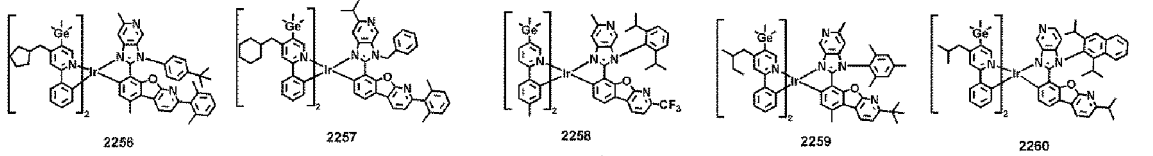

2256 2257 2258 2259 2260

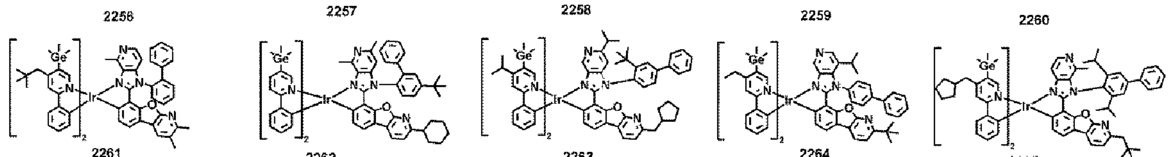

2261 2262 2263 2264 2265

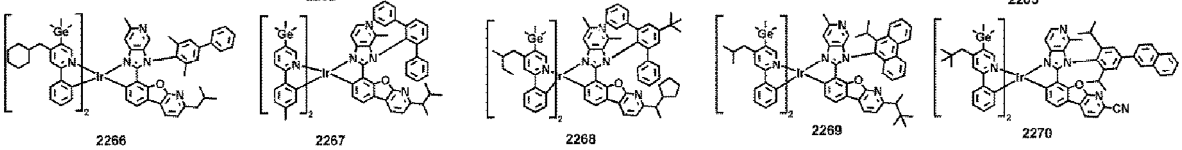

2266 2267 2268 2269 2270

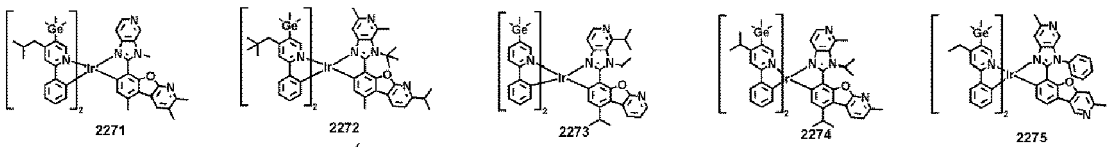
2271 2272 2273 2274 2275
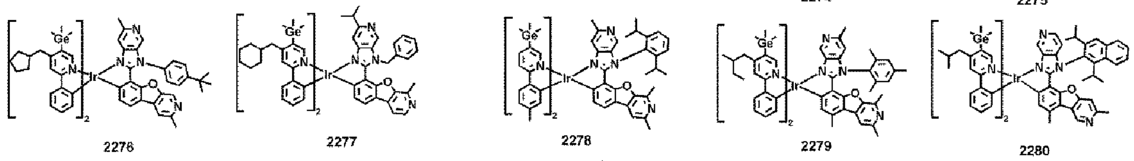
2276 2277 2278 2279 2280
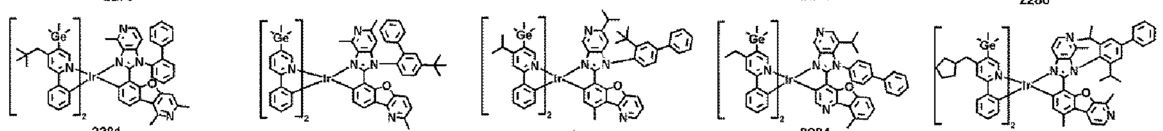
2281 2282 2283 2284 2285
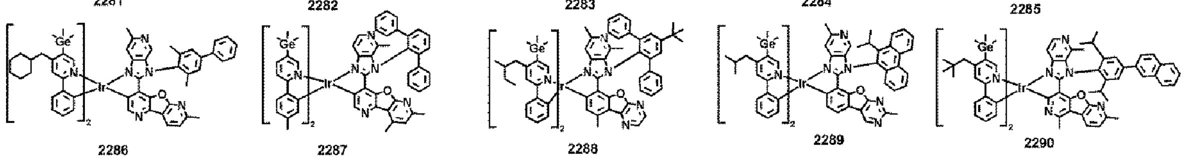
2286 2287 2288 2289 2290
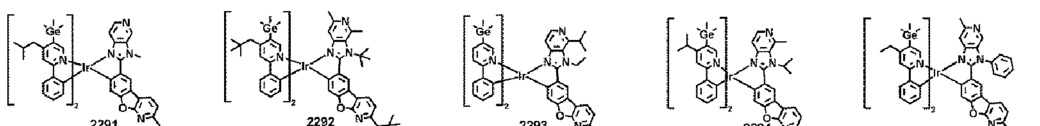
2291 2292 2293 2294 2295
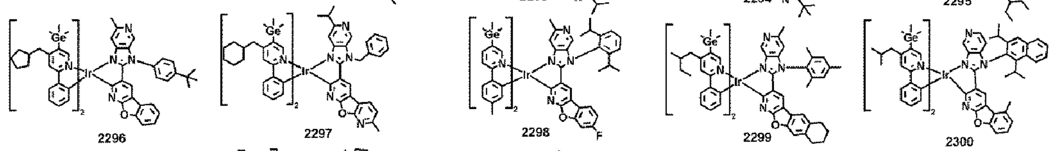
2296 2297 2298 2299 2300
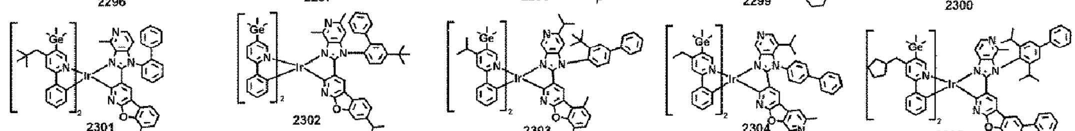
2301 2302 2303 2304 2305
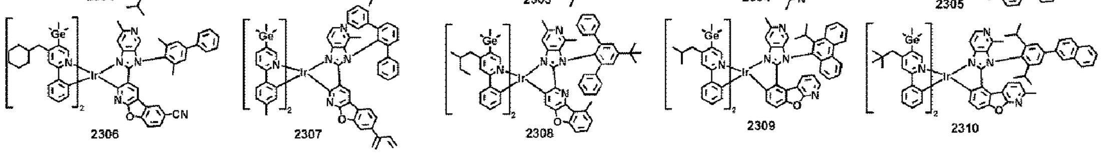
2306 2307 2308 2309 2310
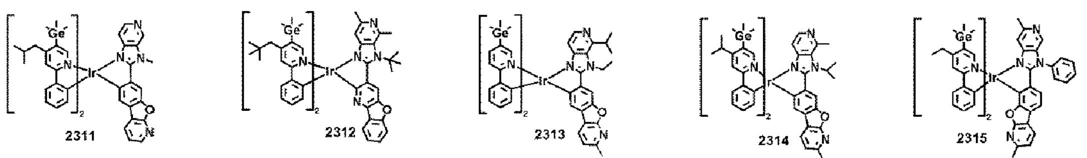
2311 2312 2313 2314 2315
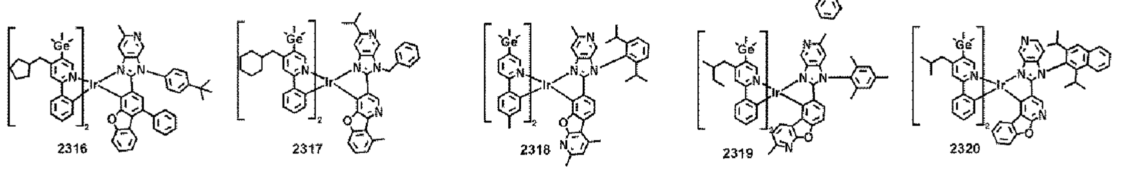
2316 2317 2318 2319 2320
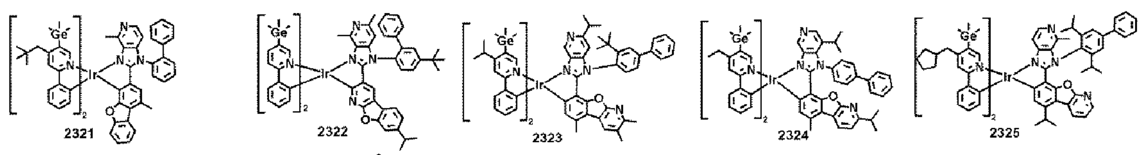
2321 2322 2323 2324 2325
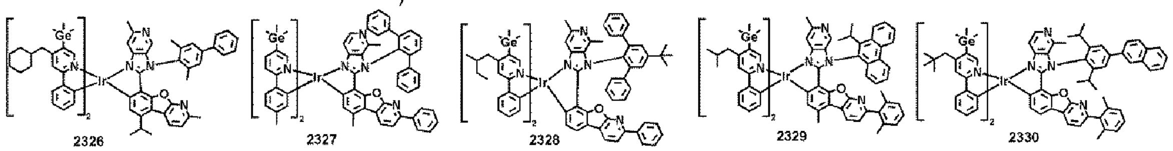
2326 2327 2328 2329 2330

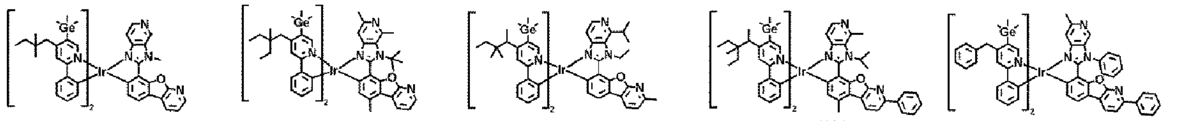
2331 2332 2333 2334 2335

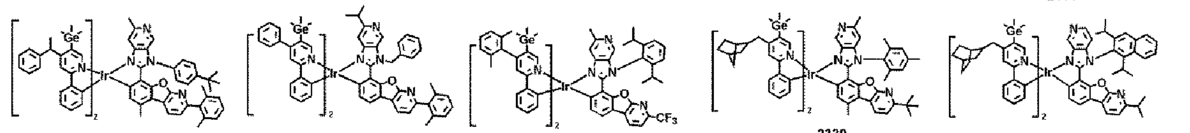
2336 2337 2338 2339 2340

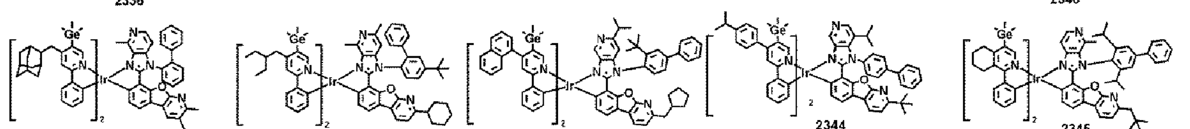
2341 2342 2343 2344 2345

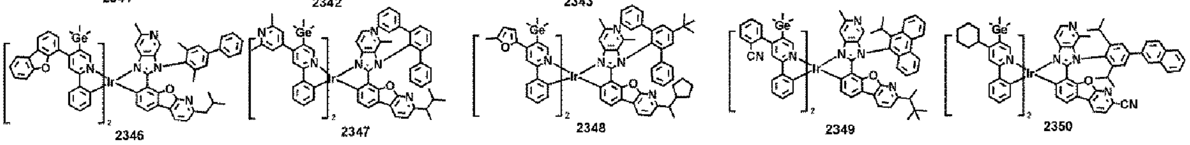
2346 2347 2348 2349 2350

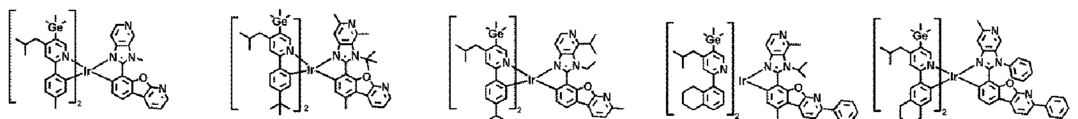
2351 2352 2353 2354 2355

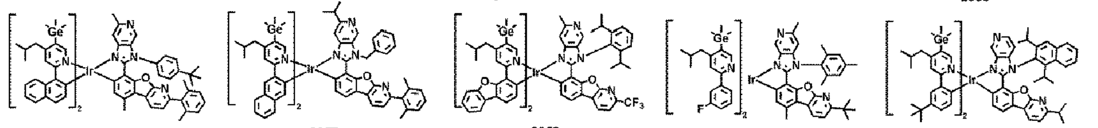
2356 2357 2358 2359 2360

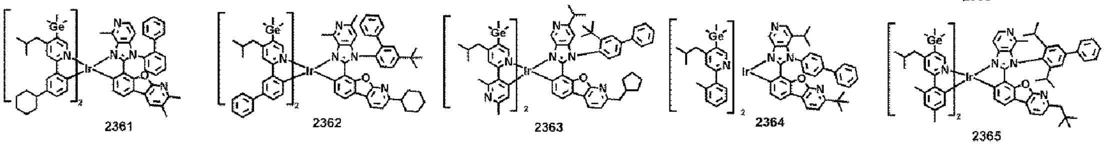
2361 2362 2363 2364 2365

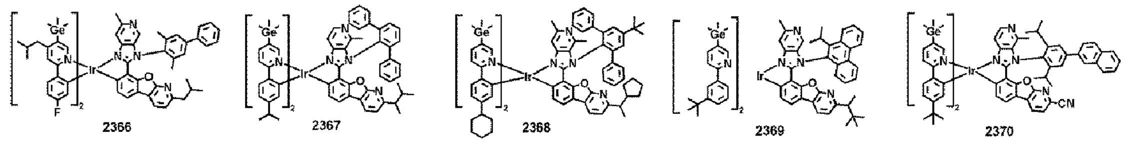
2366 2367 2368 2369 2370

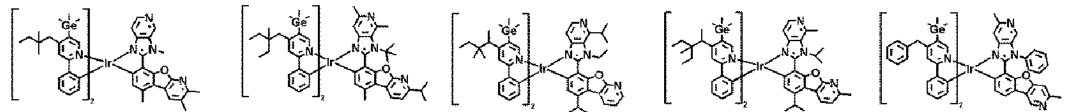
2371 2372 2373 2374 2375

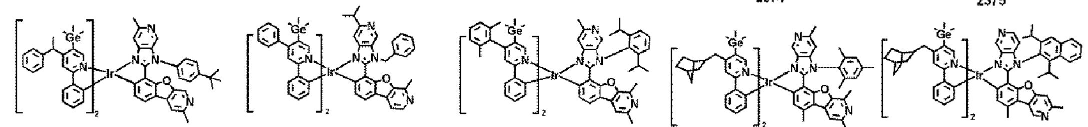
2376 2377 2378 2379 2380

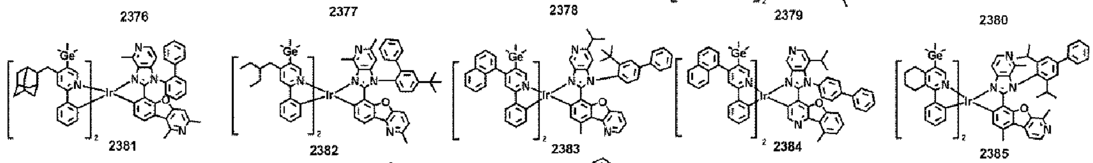
2381 2382 2383 2384 2385

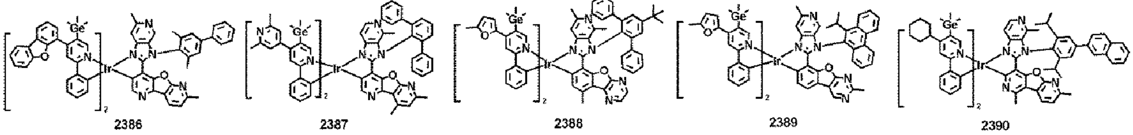
2386 2387 2388 2389 2390

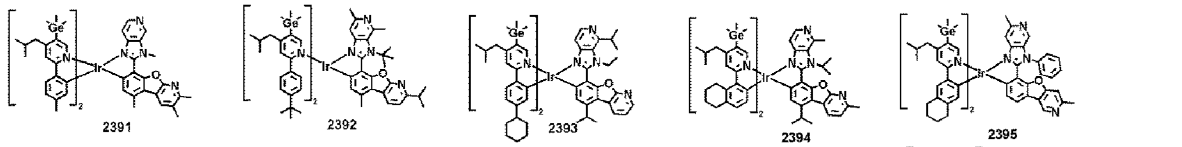

2391 2392 2393 2394 2395

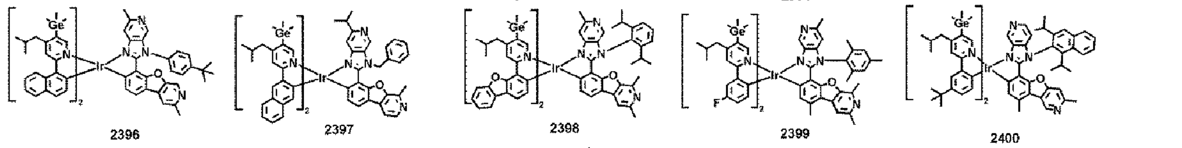

2396 2397 2398 2399 2400

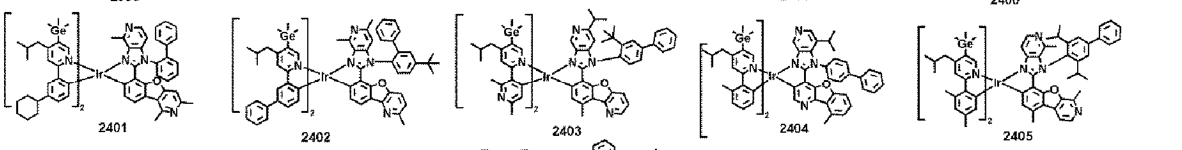

2401 2402 2403 2404 2405

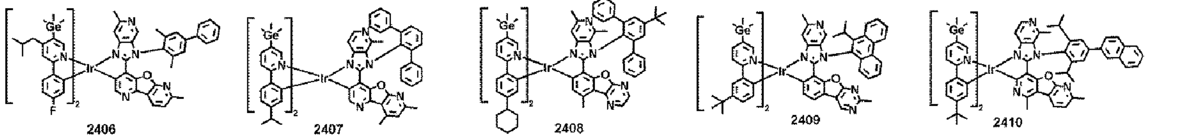

2406 2407 2408 2409 2410

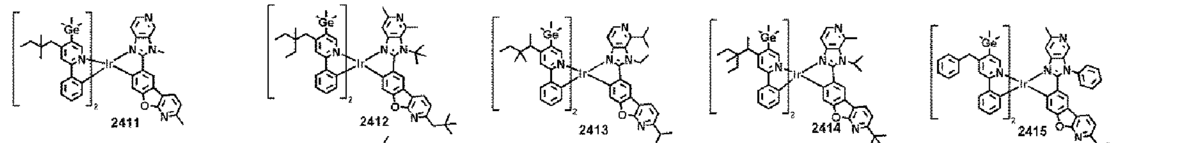

2411 2412 2413 2414 2415

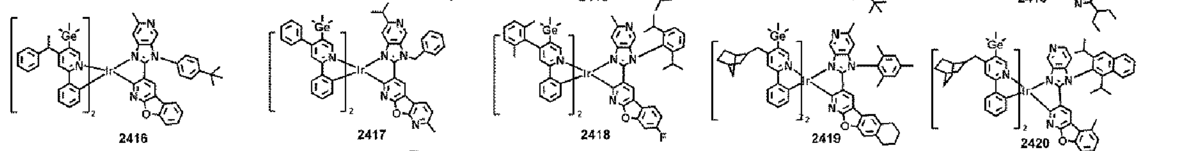

2416 2417 2418 2419 2420

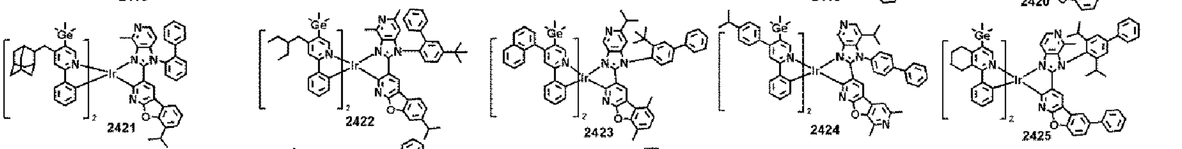

2421 2422 2423 2424 2425

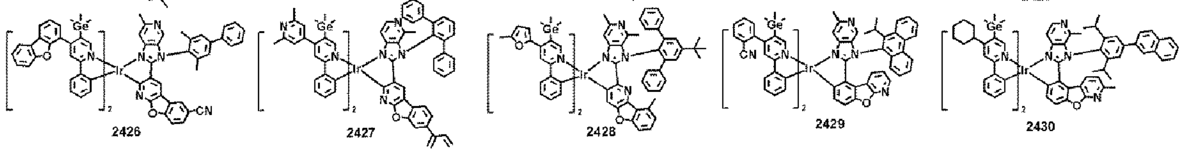

2426 2427 2428 2429 2430

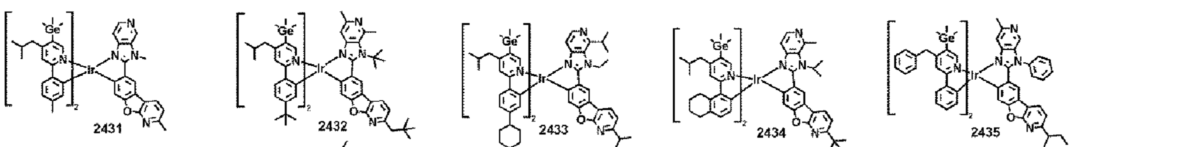

2431 2432 2433 2434 2435

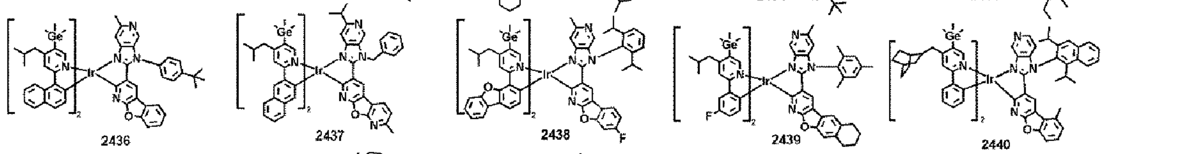

2436 2437 2438 2439 2440

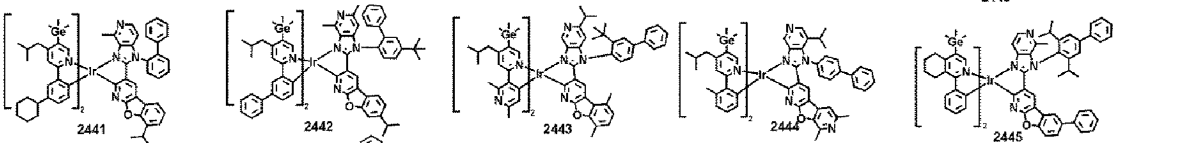

2441 2442 2443 2444 2445

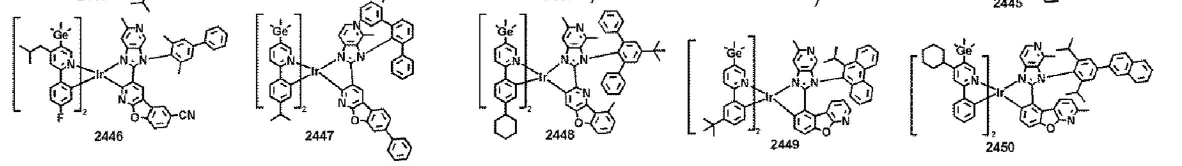

2446 2447 2448 2449 2450

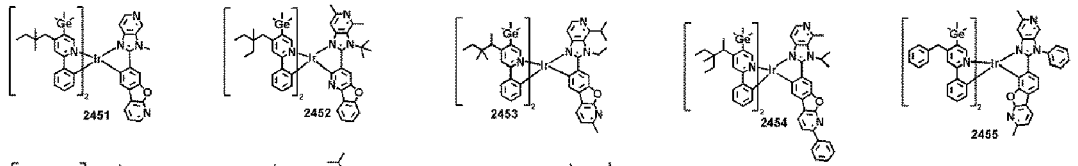
2451 2452 2453 2454 2455

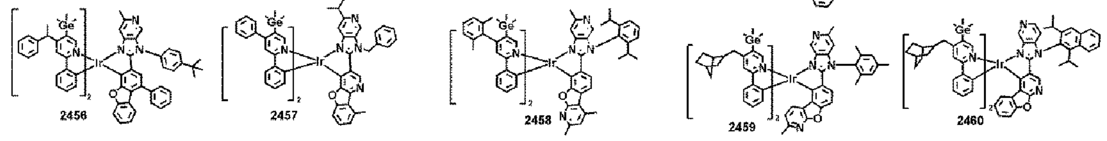
2456 2457 2458 2459 2460

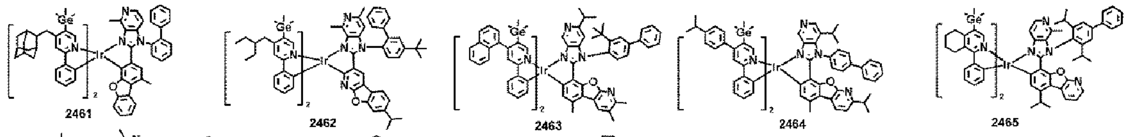
2461 2462 2463 2464 2465

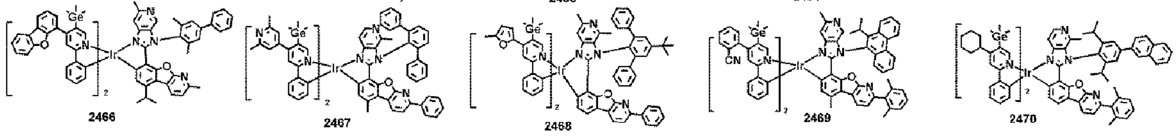
2466 2467 2468 2469 2470

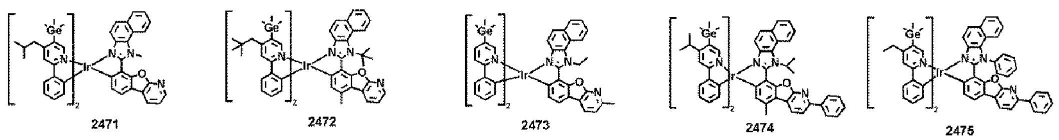
2471 2472 2473 2474 2475

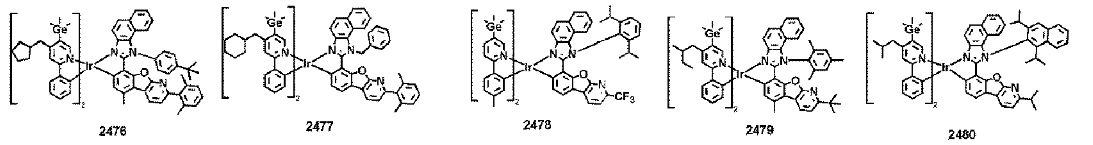
2476 2477 2478 2479 2480

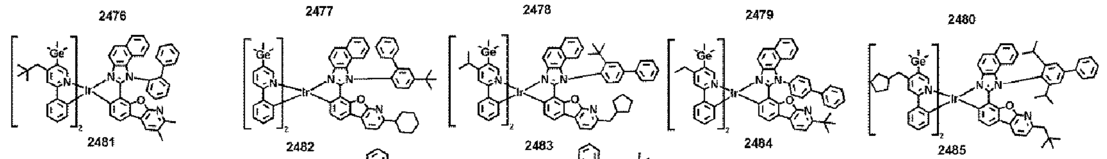
2481 2482 2483 2484 2485

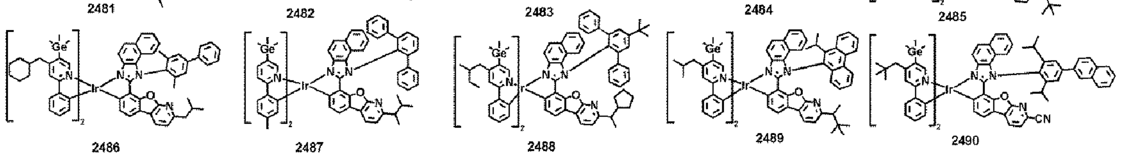
2486 2487 2488 2489 2490

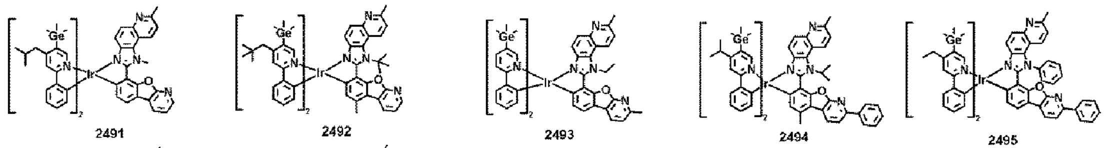
2491 2492 2493 2494 2495

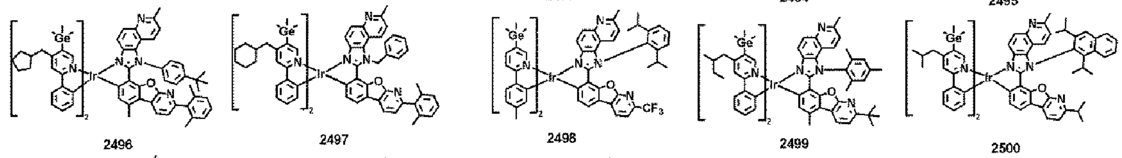
2496 2497 2498 2499 2500

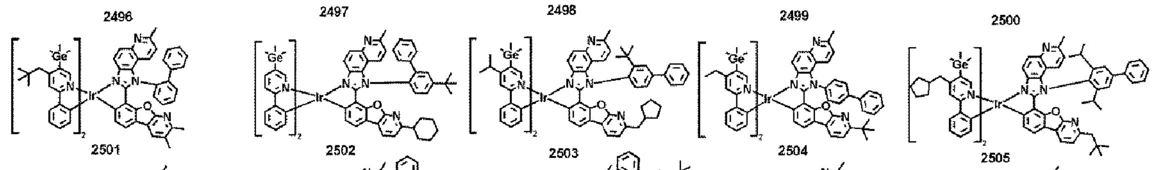
2501 2502 2503 2504 2505

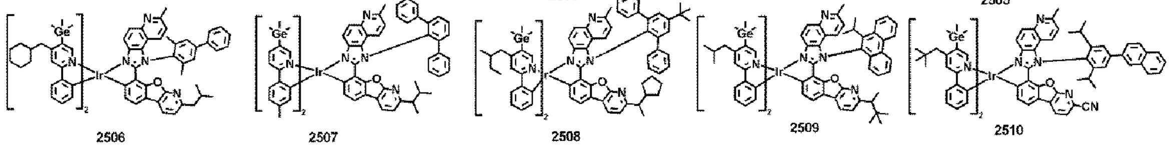
2506 2507 2508 2509 2510

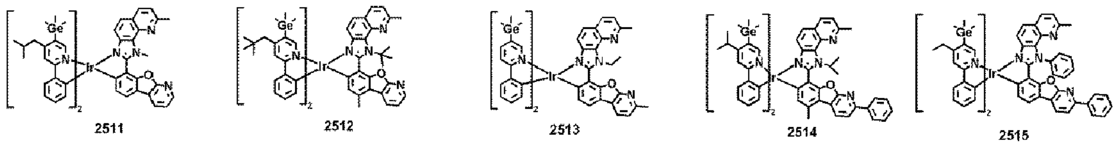

2511 2512 2513 2514 2515

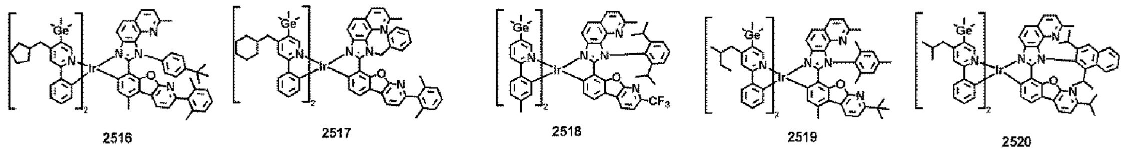

2516 2517 2518 2519 2520

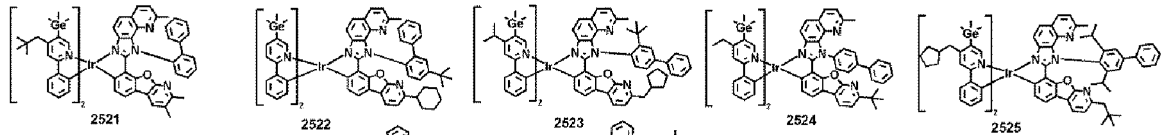

2521 2522 2523 2524 2525

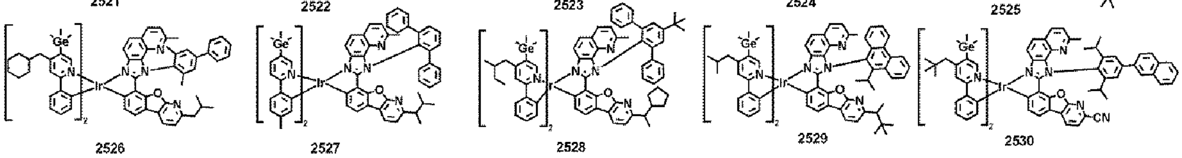

2526 2527 2528 2529 2530

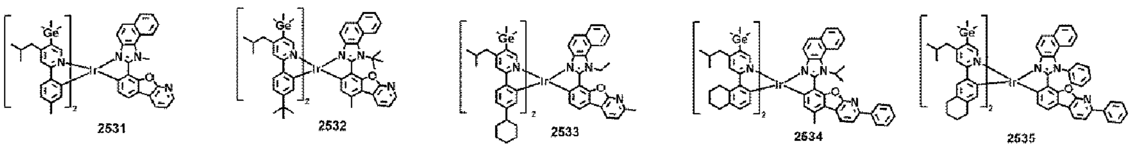

2531 2532 2533 2534 2535

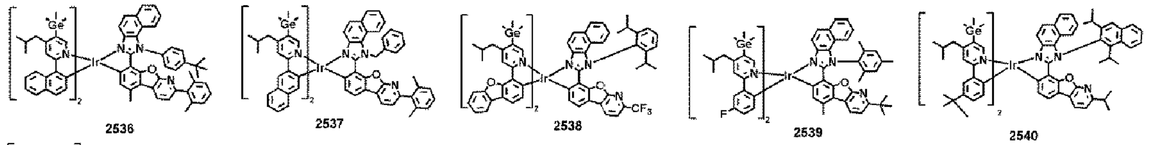

2536 2537 2538 2539 2540

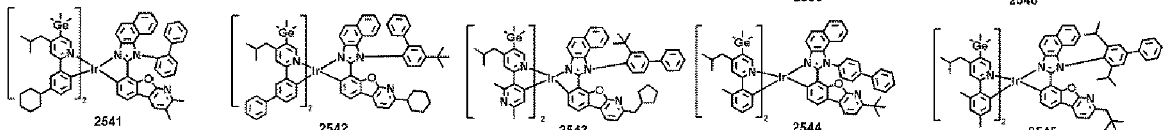

2541 2542 2543 2544 2545

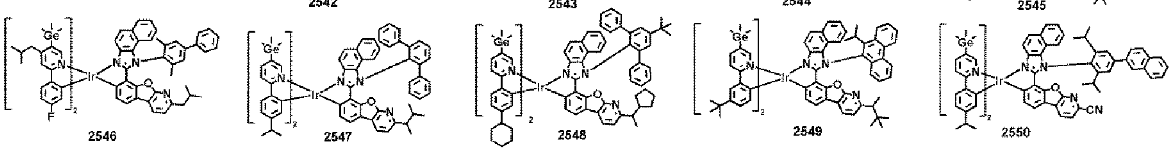

2546 2547 2548 2549 2550

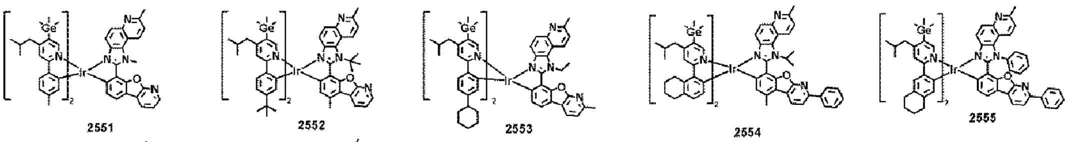

2551 2552 2553 2554 2555

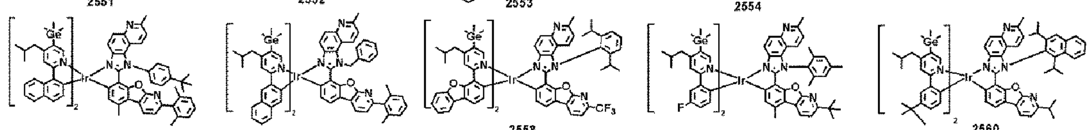

2556 2557 2558 2559 2560

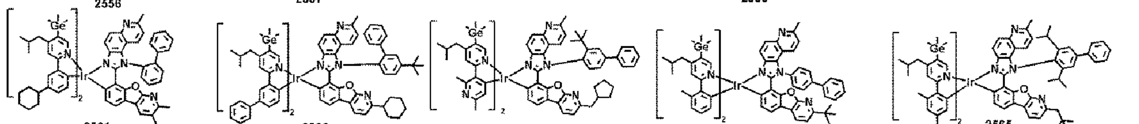

2561 2562 2563 2564 2565

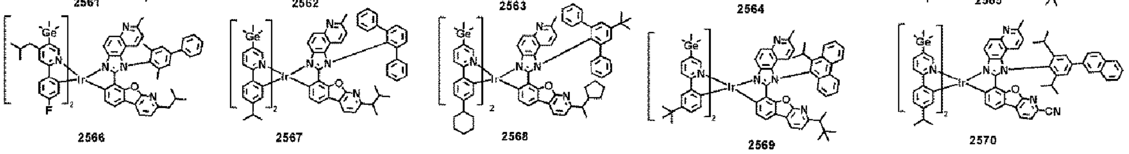

2566 2567 2568 2569 2570

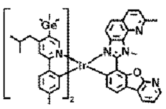
2571

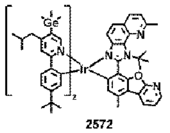
2572

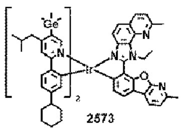
2573

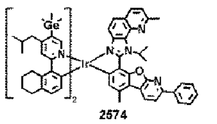
2574

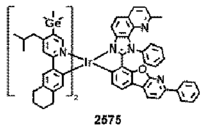
2575

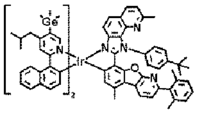
2576

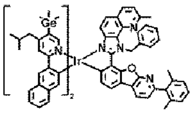
2577

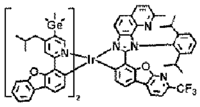
2578

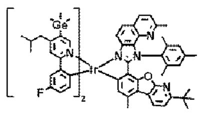
2579

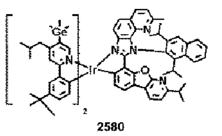
2580

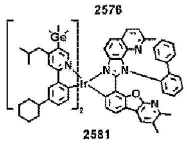
2581

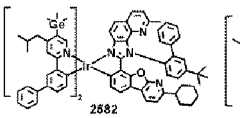
2582

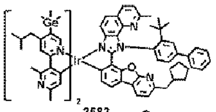
2583

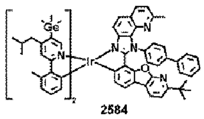
2584

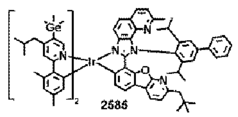
2585

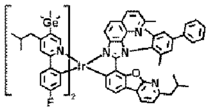
2586

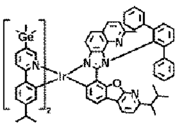
2587

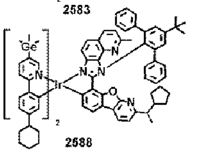
2588

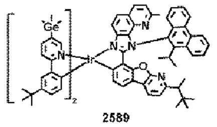
2589

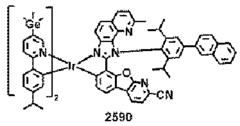
2590

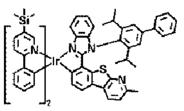
2591

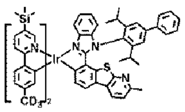
2592

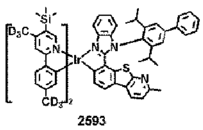
2593

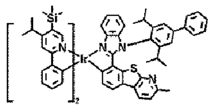
2594

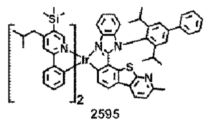
2595

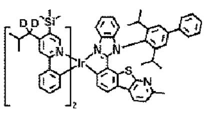
2596

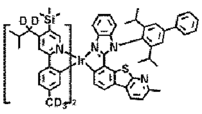
2597

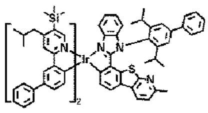
2598

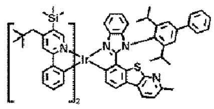
2599

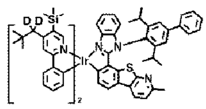
2600

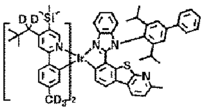
2601

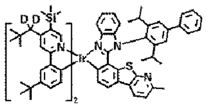
2602

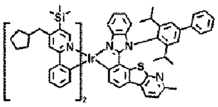
2603

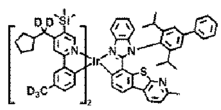
2604

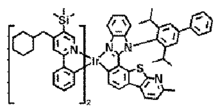
2605

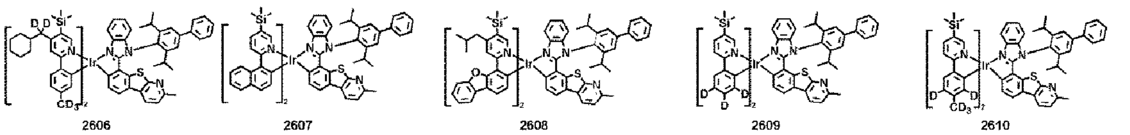
2606

2607

2608

2609

2610

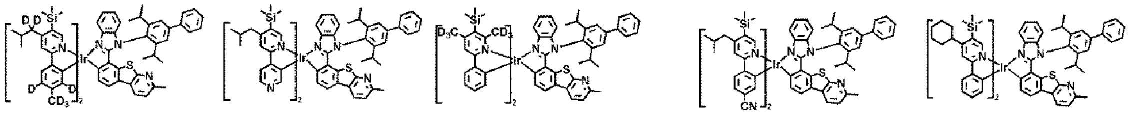
2611

2612

2613

2614

2615

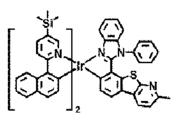 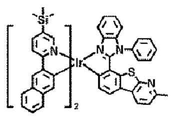 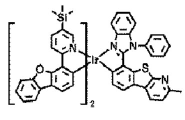 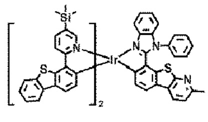 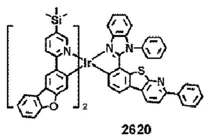

2616 2617 2618 2619 2620

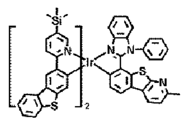 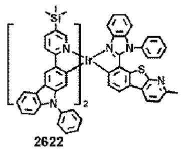 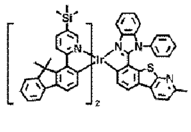 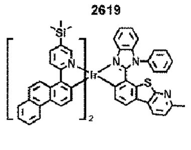 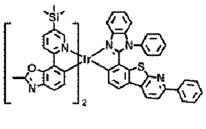

2621 2622 2623 2624 2625

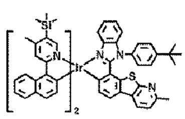 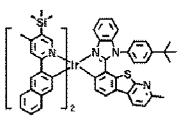 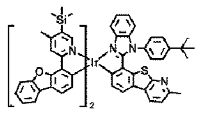 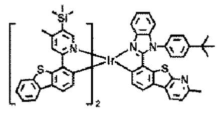 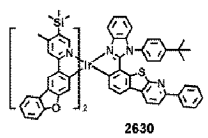

2626 2627 2628 2629 2630

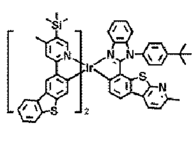 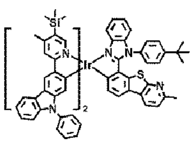 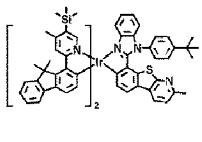 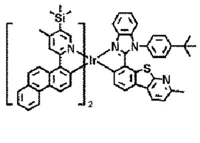 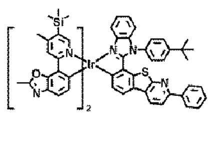

2631 2632 2633 2634 2635

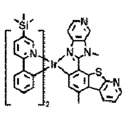 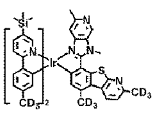 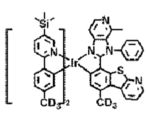 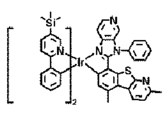 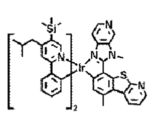

2636 2637 2638 2639 2640

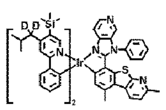 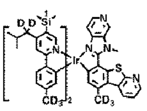 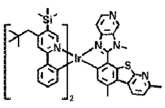 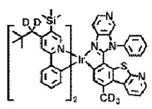 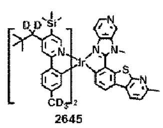

2641 2642 2643 2644 2645

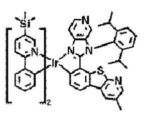 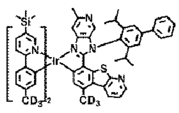 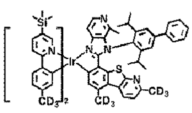 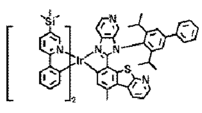 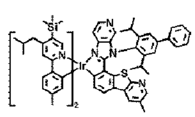

2646 2647 2648 2649 2650

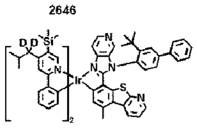 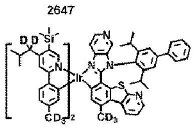 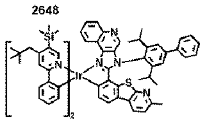 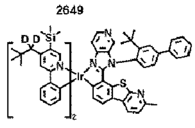 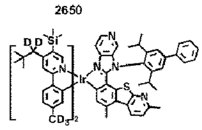

2651 2652 2653 2651 2655

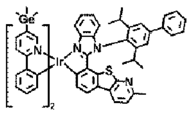
2656
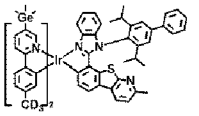
2657
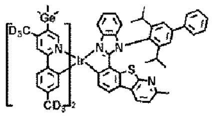
2658
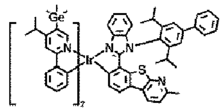
2659
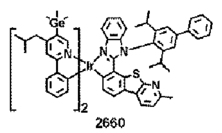
2660

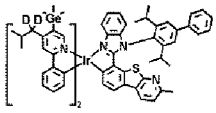
2661
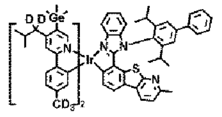
2662
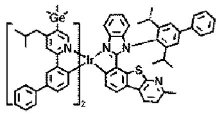
2663
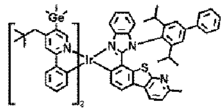
2664
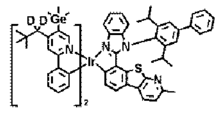
2665

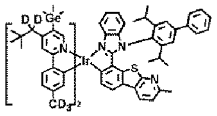
2666
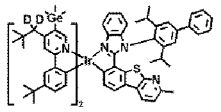
2667
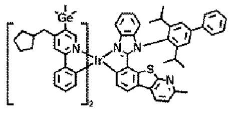
2668
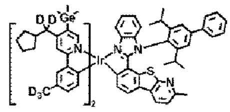
2669
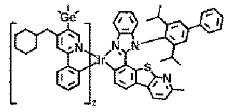
2670

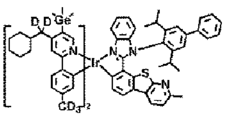
2671
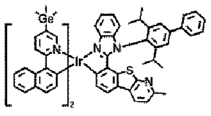
2672
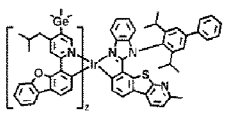
2673
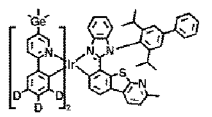
2674
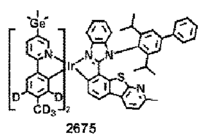
2675

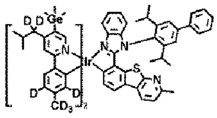
2676
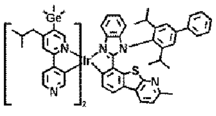
2677
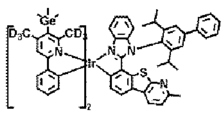
2678
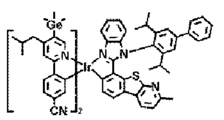
2679
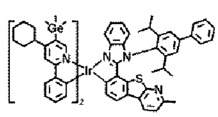
2680

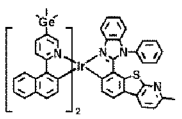
2681
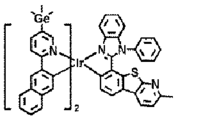
2682
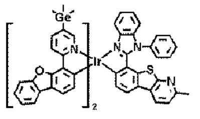
2683
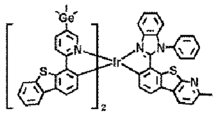
2684
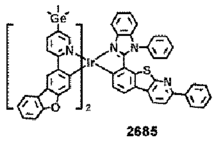
2685

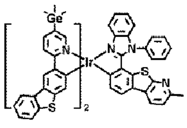
2686
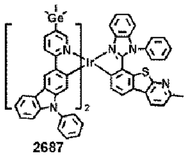
2687
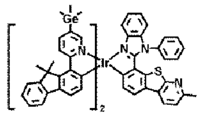
2688
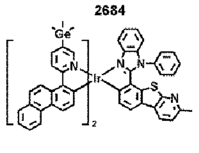
2689
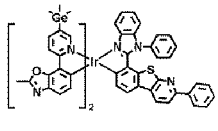
2690

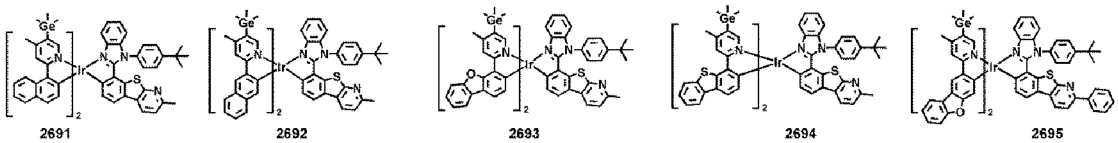
2691 2692 2693 2694 2695

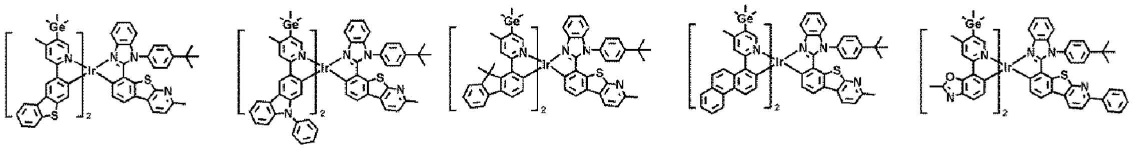
2696 2697 2698 2699 2700

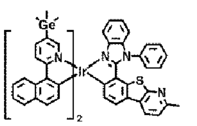
2701

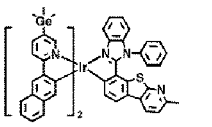
2702

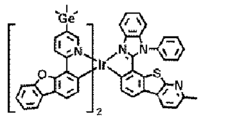
2703

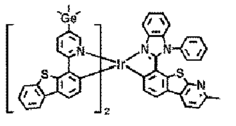
2704

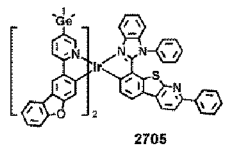
2705

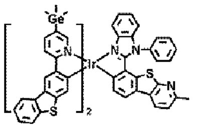
2706

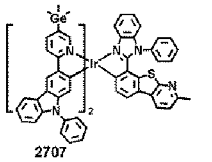
2707

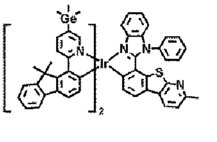
2708

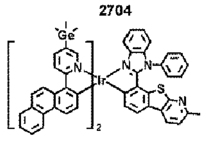
2709

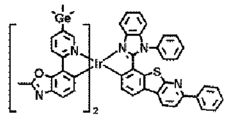
2710

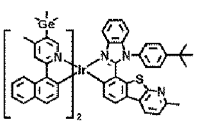
2711

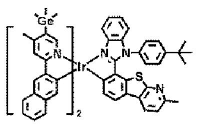
2712

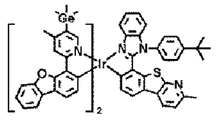
2713

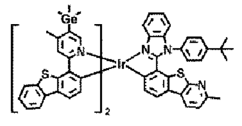
2714

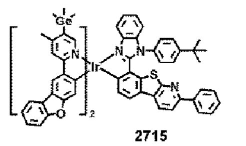
2715

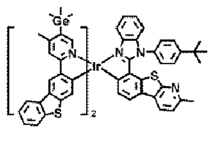
2716

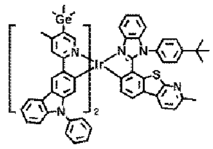
2717

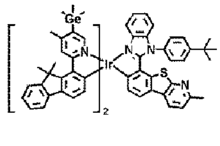
2718

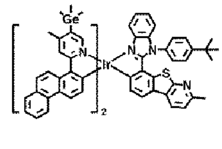
2719

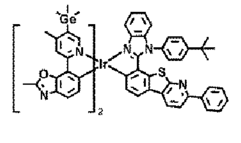
2720

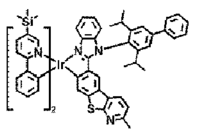
2721

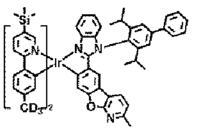
2722

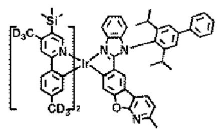
2723

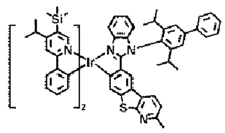
2724

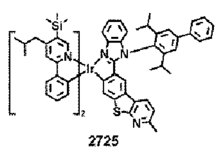
2725

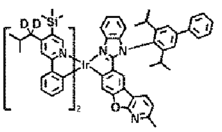
2725

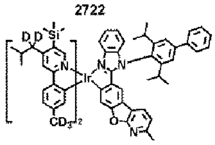
2727

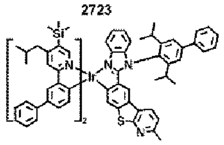
2728

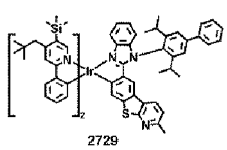
2729

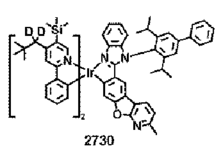
2730

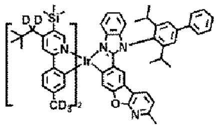
2731

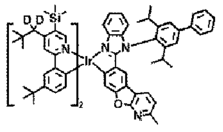
2732

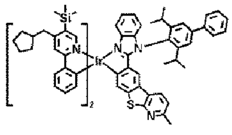
2733

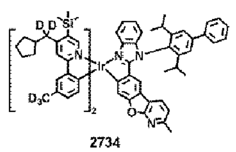
2734

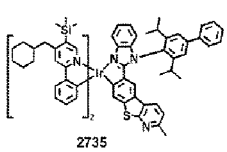
2735

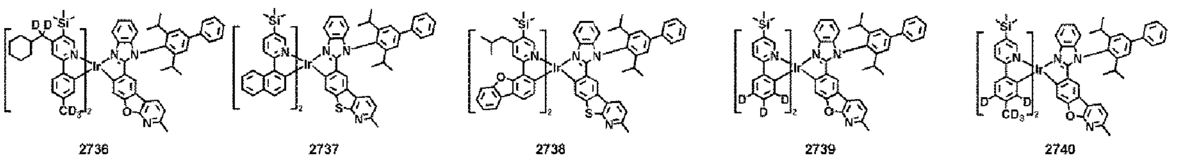
2736 2737 2738 2739 2740

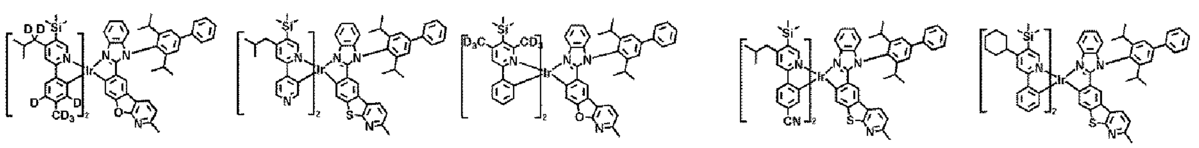
2741 2742 2743 2744 2745

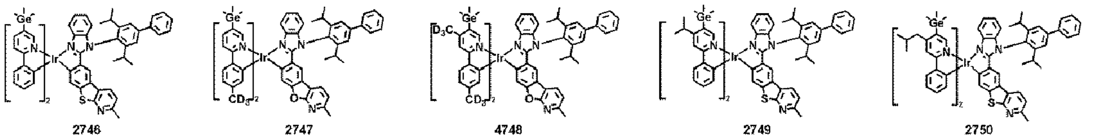

2746 2747 4748 2749 2750

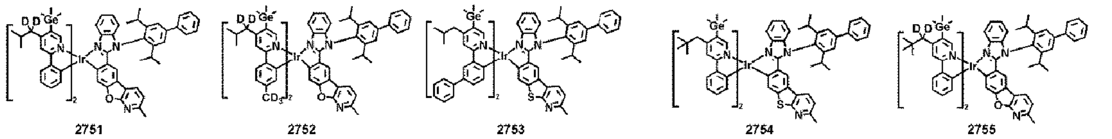

2751 2752 2753 2754 2755

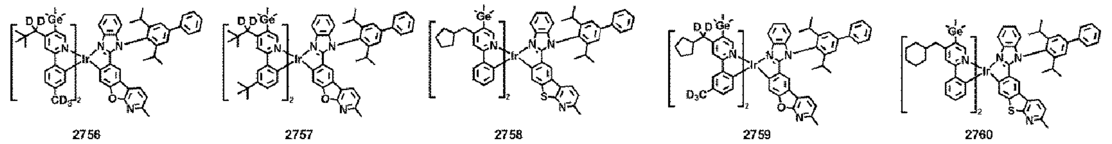

2756 2757 2758 2759 2760

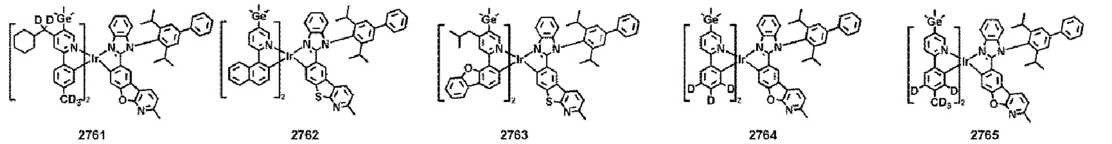

2761 2762 2763 2764 2765

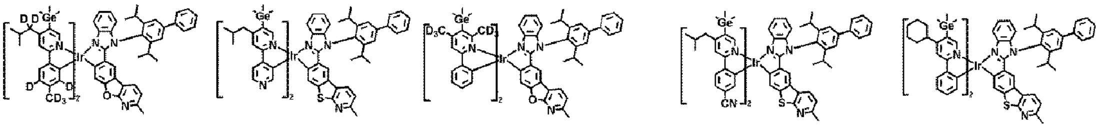

2766 2767 2768 2769 2770

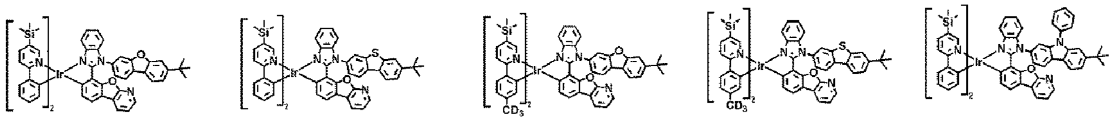

2771 2772 2773 2774 2775

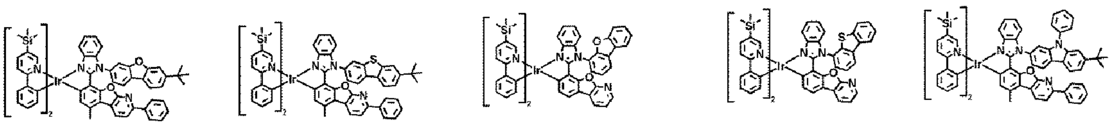

2776 2777 2778 2779 2780

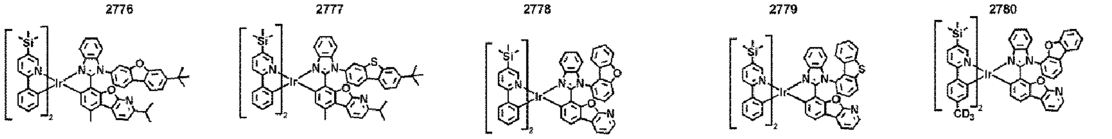

2781 2782 2783 2784 2785

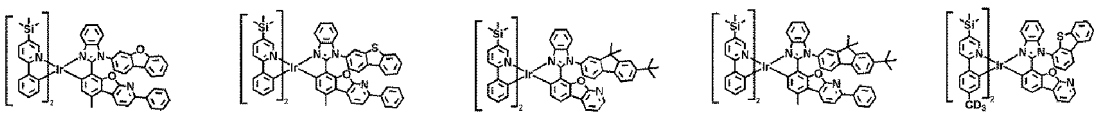

2786 2787 2788 2789 2790

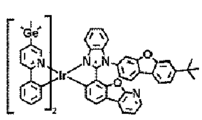
2791
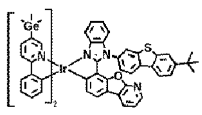
2792
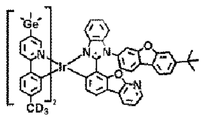
2793
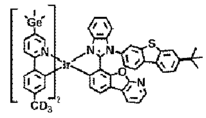
2794
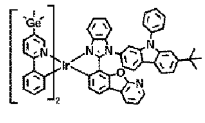
2795

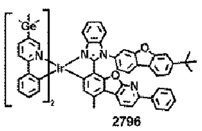
2796
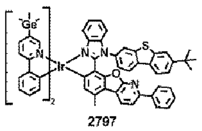
2797
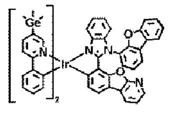
2798
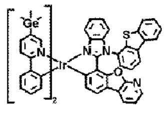
2799
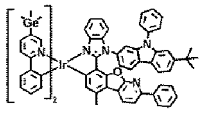
2800

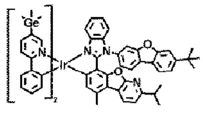
2801
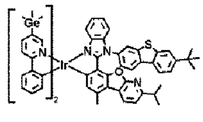
2802
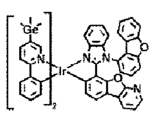
2803
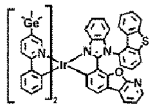
2804
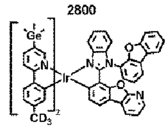
2805

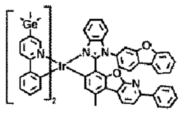
2806
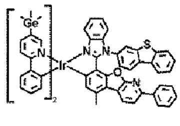
2807
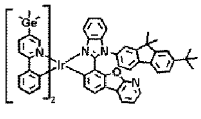
2808
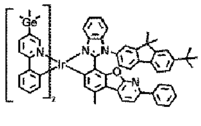
2809
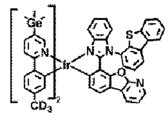
2810

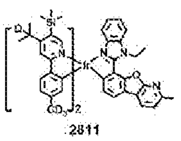
2811
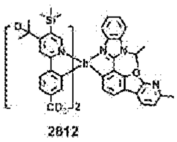
2812
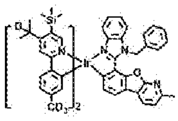
2813
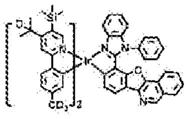
2814
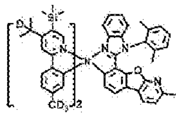
2815

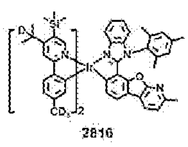
2816
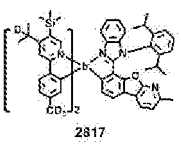
2817
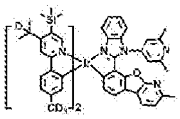
2818
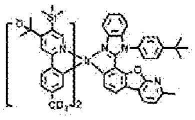
2819
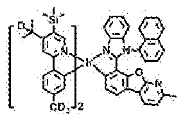
2820

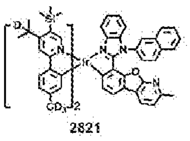
2821
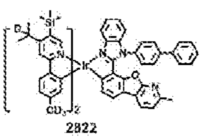
2822
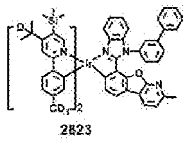
2823
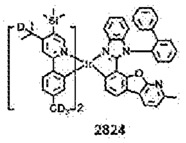
2824
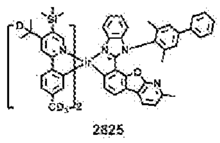
2825

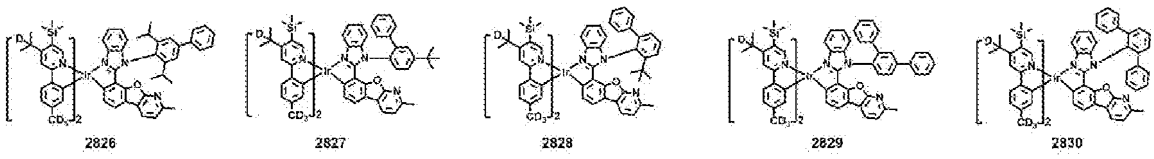
2826
2827
2828
2829
2830

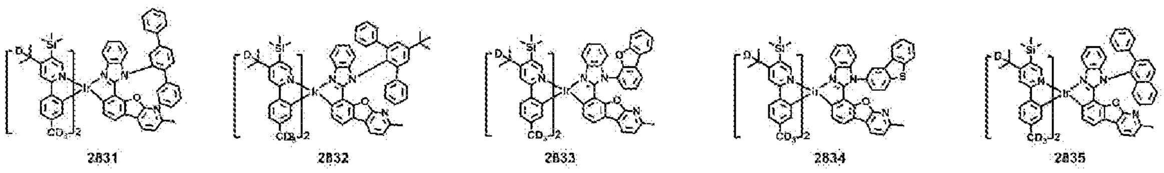
2831
2832
2833
2834
2835

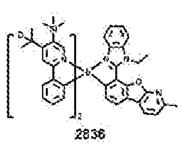

2836

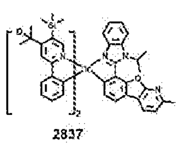

2837

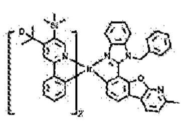

2838

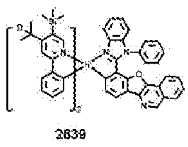

2839

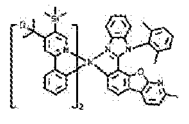

2840

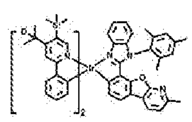

2841

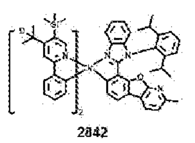

2842

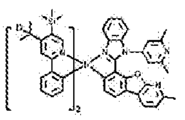

2843

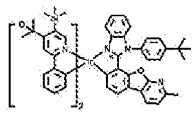

2844

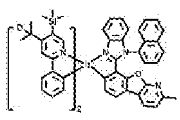

2845

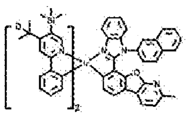

2846

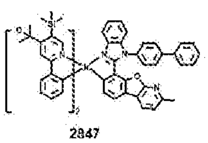

2847

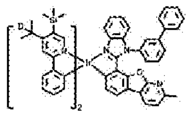

2848

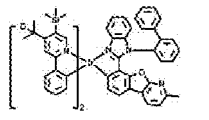

2849

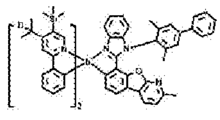

2850

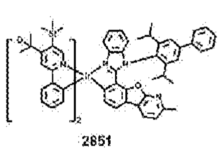

2851

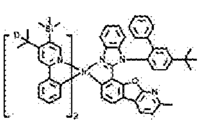

2852

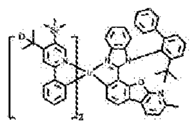

2853

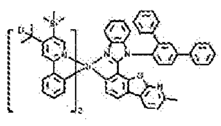

2854

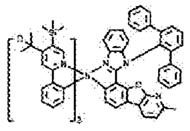

2855

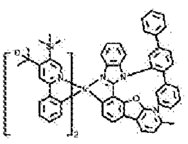

2856

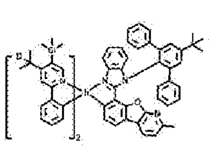

2857

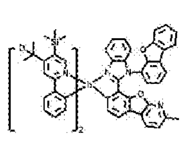

2858

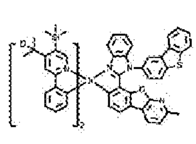

2859

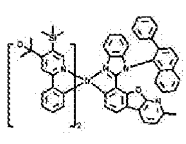

2860

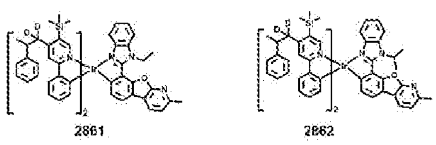

2861

2862

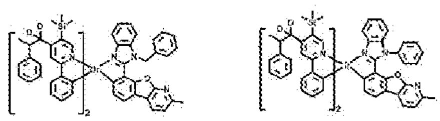

2863

2864

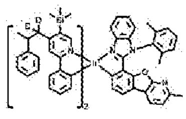

2865

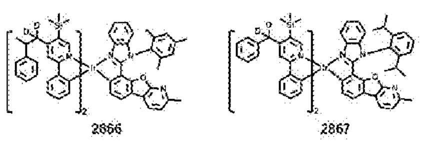

2866

2867

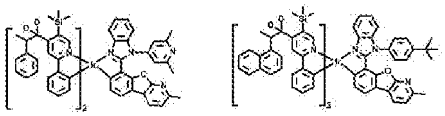

2868

2869

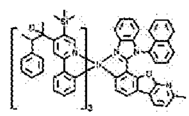

2870

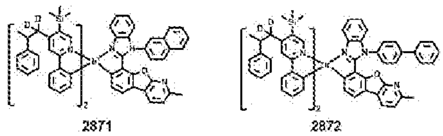

2871

2872

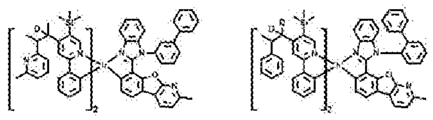

2873

2874

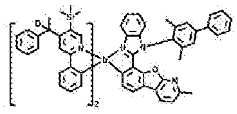

2875

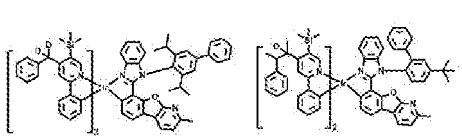

2876

2877

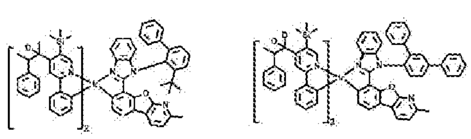

2878

2879

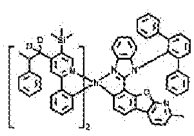

2880

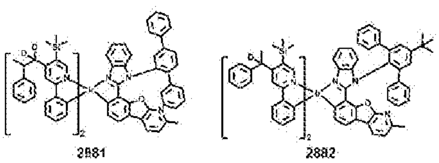

2881

2882

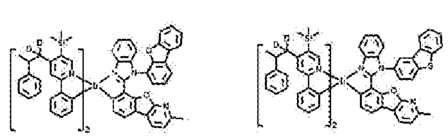

2883

2884

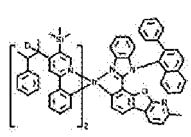

2885

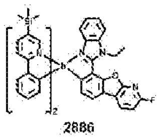
2886
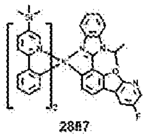
2887
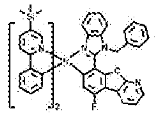
2888
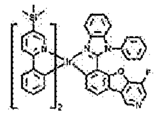
2889
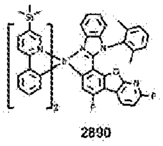
2890
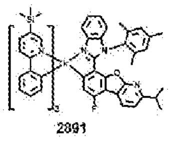
2891
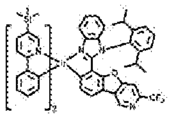
2892
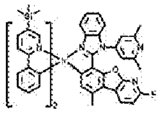
2893
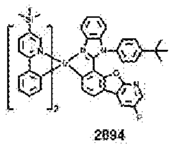
2894
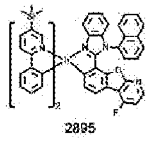
2895
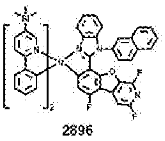
2896
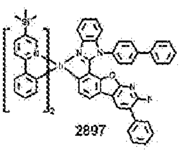
2897
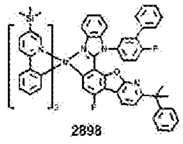
2898
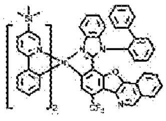
2899
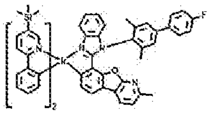
2900
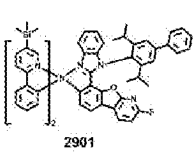
2901
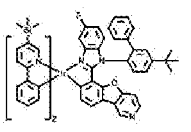
2902
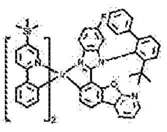
2903
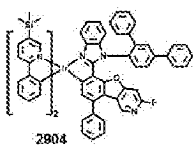
2904
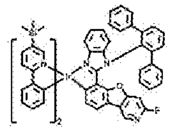
2905
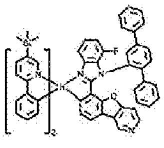
2906
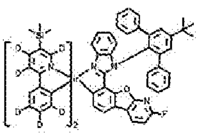
2907
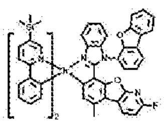
2908
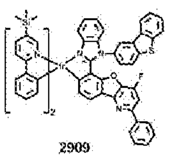
2909
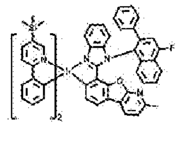
2910
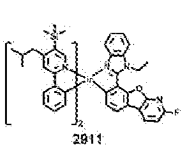
2911
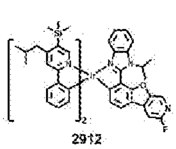
2912
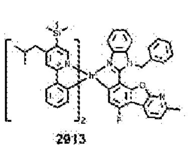
2913
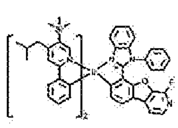
2914
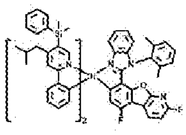
2915
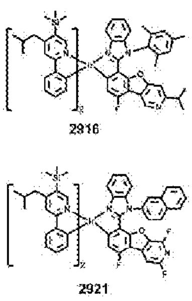
2916
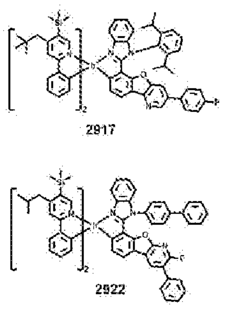
2917
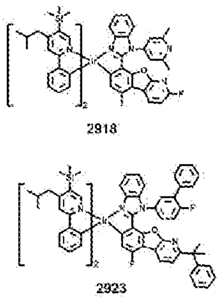
2918
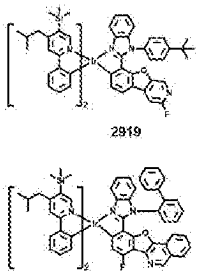
2919
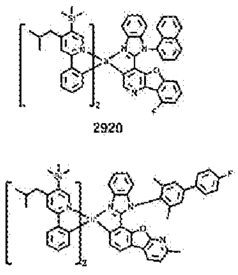
2920
2921
2922
2923
2924
2925
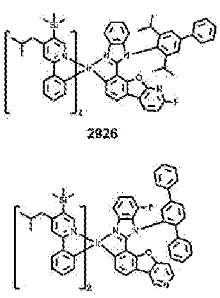
2926
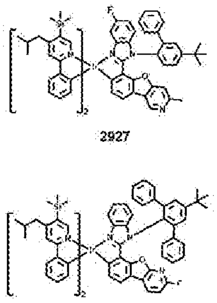
2927
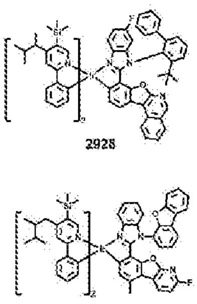
2928
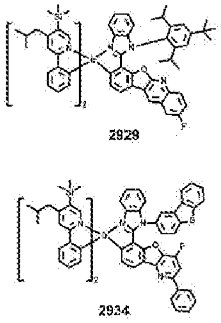
2929
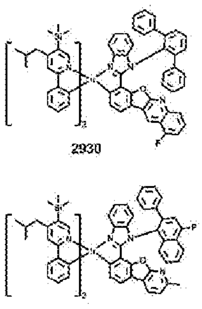
2930
2931
2932
2933
2934
2935

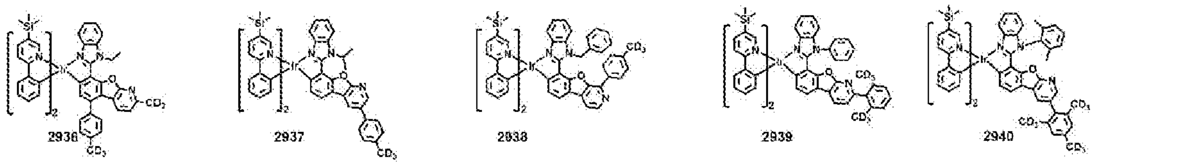

2936 2937 2938 2939 2940

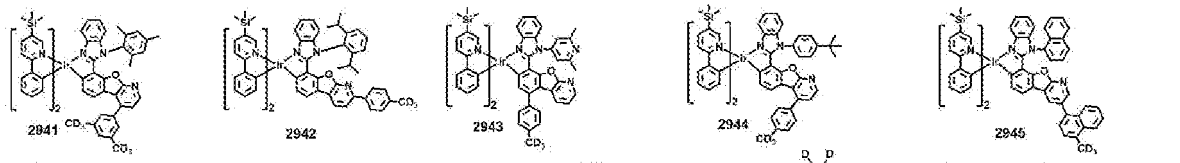

2941 2942 2943 2944 2945

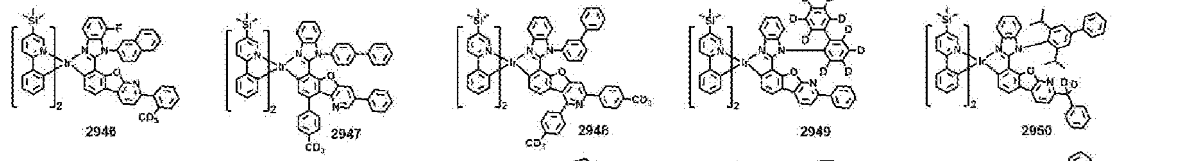

2946 2947 2948 2949 2950

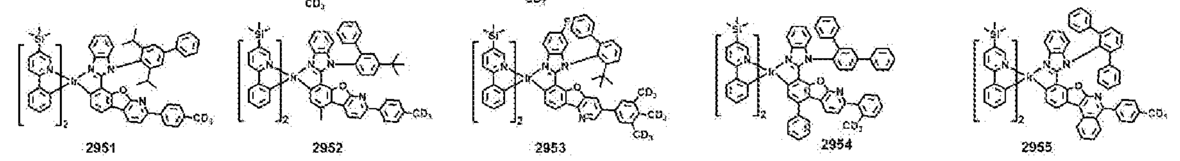

2951 2952 2953 2954 2955

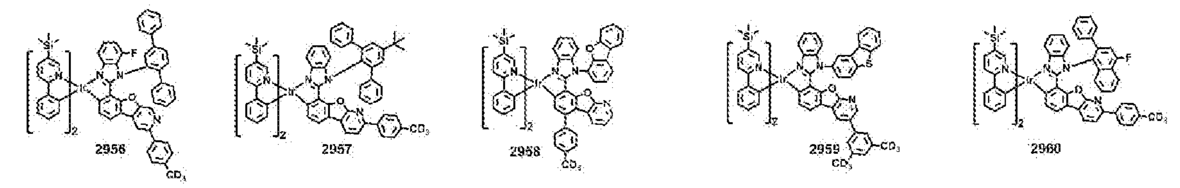

2956 2957 2958 2959 2960

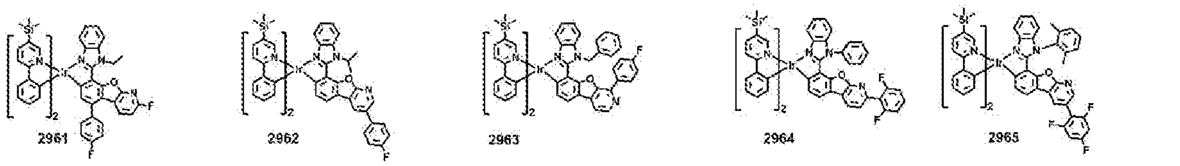

2961 2962 2963 2964 2965

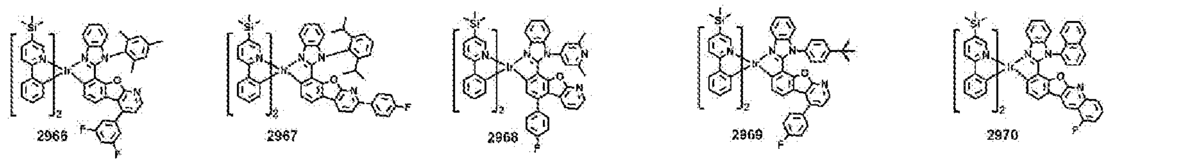

2966 2967 2968 2969 2970

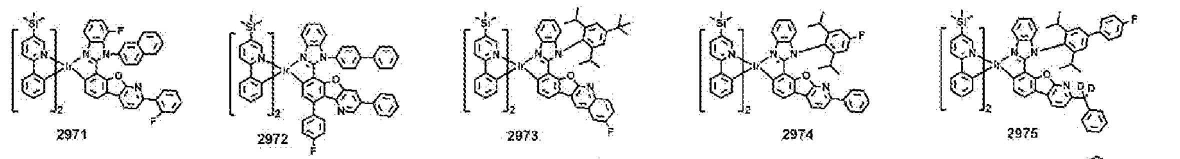

2971 2972 2973 2974 2975

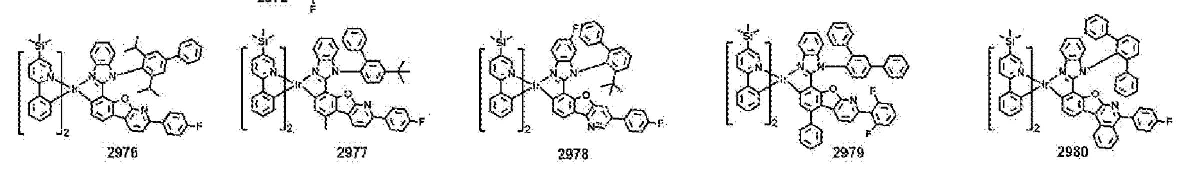

2976 2977 2978 2979 2980

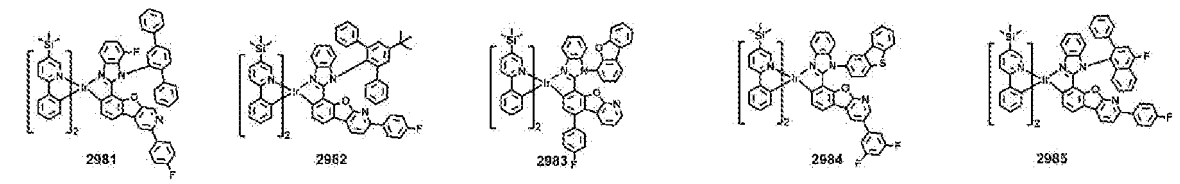

2981 2982 2983 2984 2985

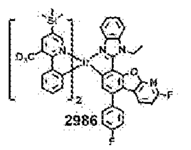
2986
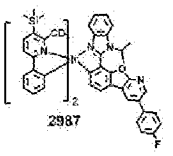
2987
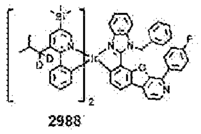
2988
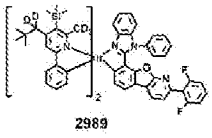
2989
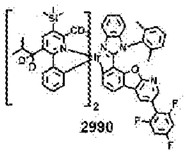
2990
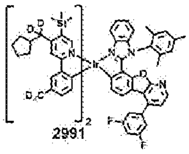
2991
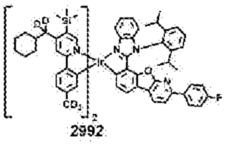
2992
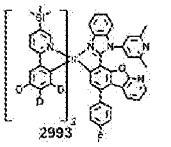
2993
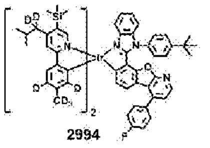
2994
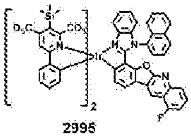
2995
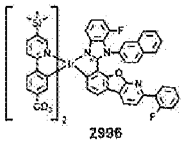
2996
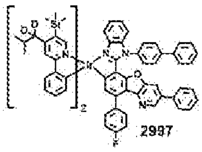
2997
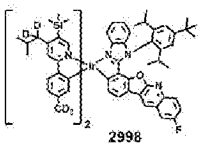
2998
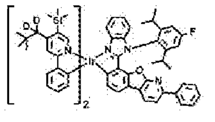
2999
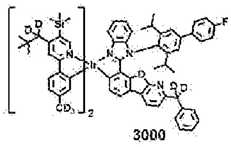
3000
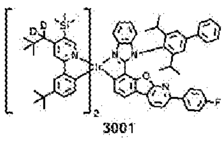
3001
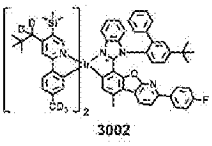
3002
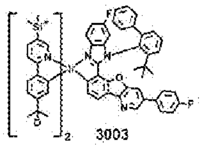
3003
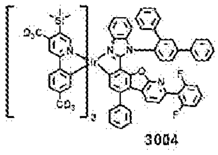
3004
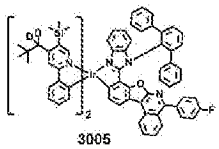
3005
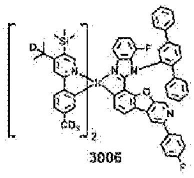
3006
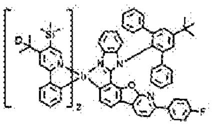
3007
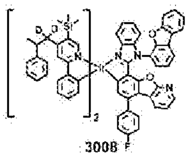
3008
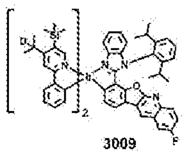
3009
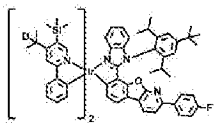
3010
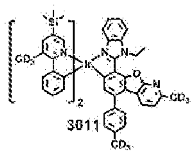
3011
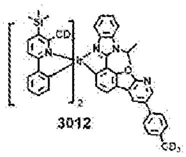
3012
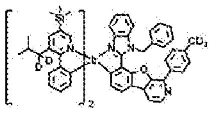
3013
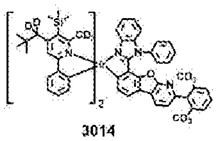
3014
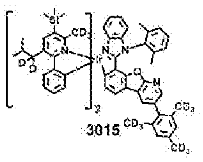
3015
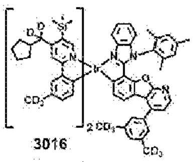
3016
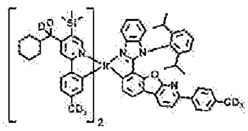
3017
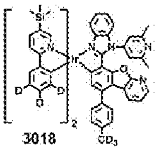
3018
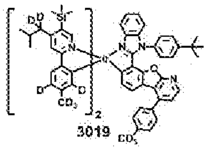
3019
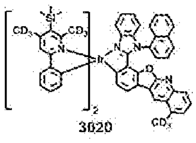
3020
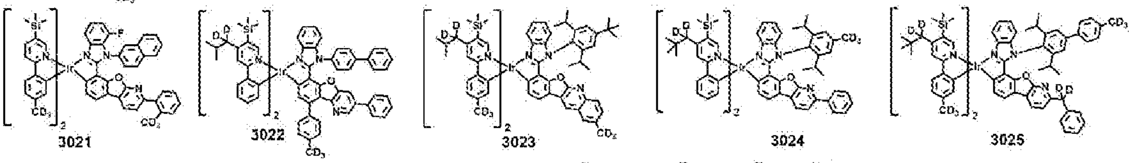
3021 3022 3023 3024 3025
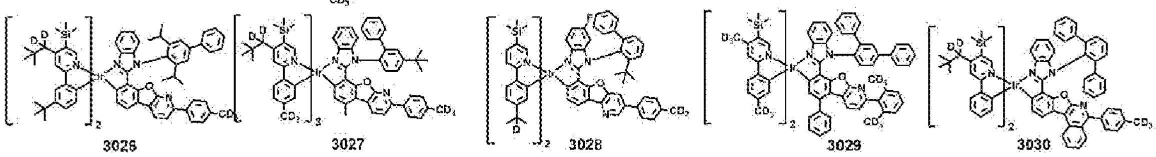
3026 3027 3028 3029 3030
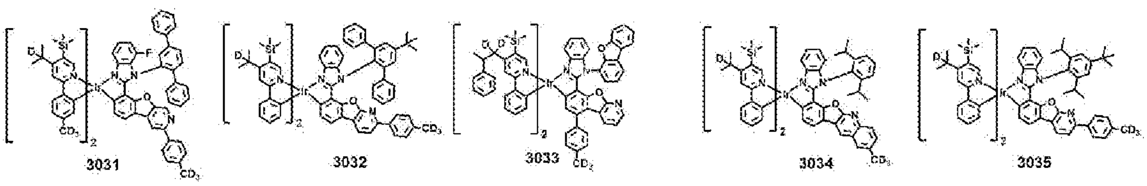
3031 3032 3033 3034 3035

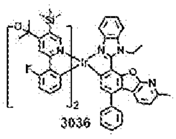
3036

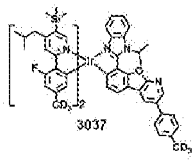
3037

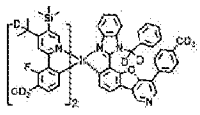
3038

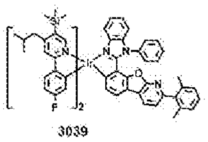
3039

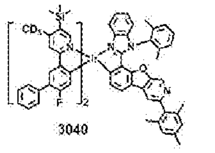
3040

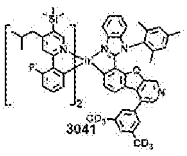
3041

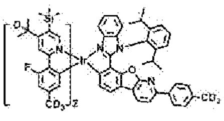
3042

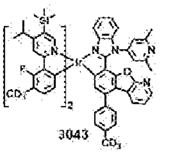
3043

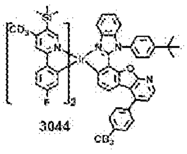
3044

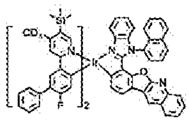
3045

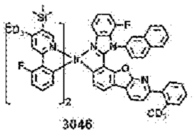
3046

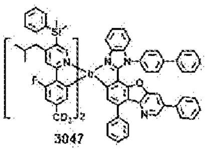
3047

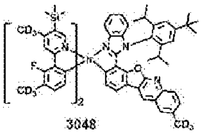
3048

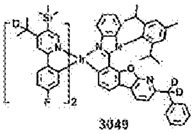
3049

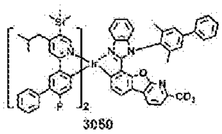
3050

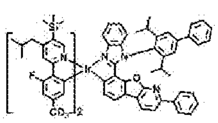
3051

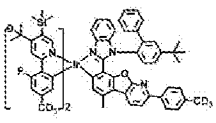
3052

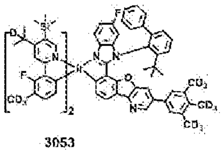
3053

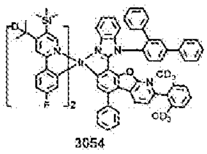
3054

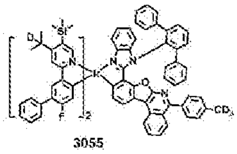
3055

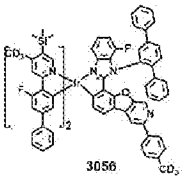
3056

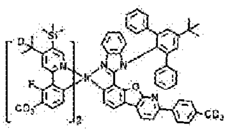
3057

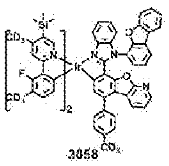
3058

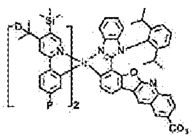
3059

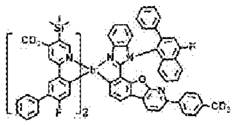
3060

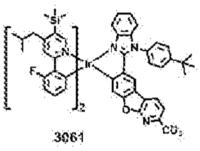
3061

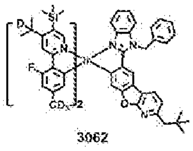
3062

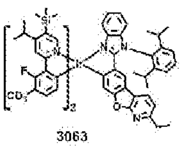
3063

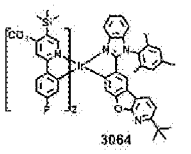
3064

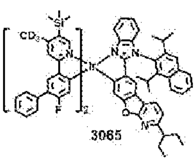
3065

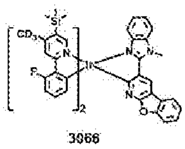
3066

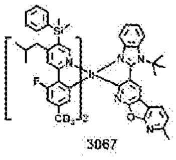
3067

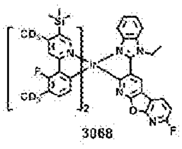
3068

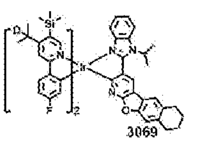
3069

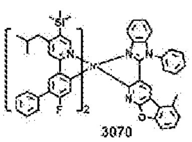
3070

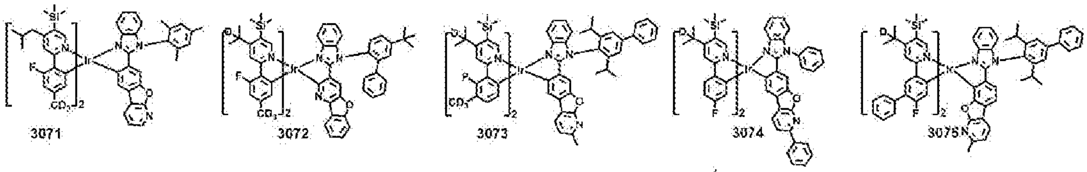
3071 3072 3073 3074 3075

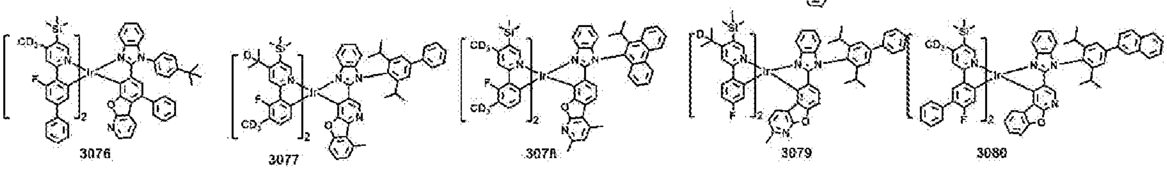
3076 3077 3078 3079 3080

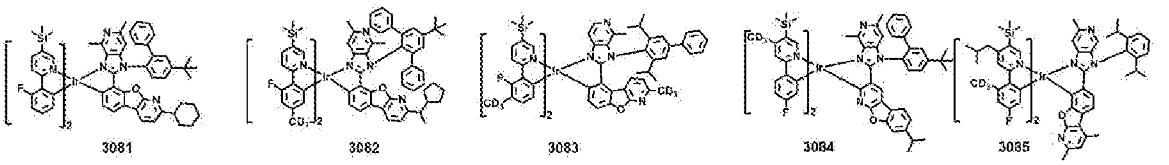
3081 3082 3083 3084 3085

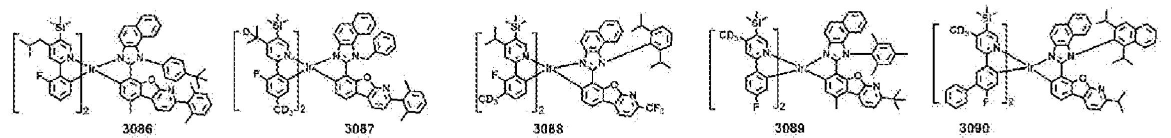

3086 3087 3088 3089 3090

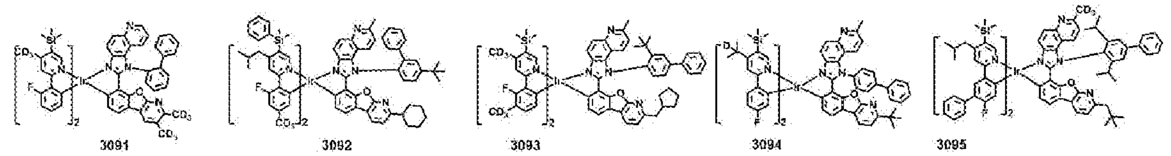

3091 3092 3093 3094 3095

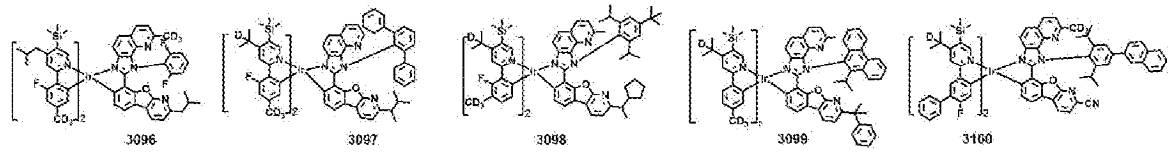

3096 3097 3098 3099 3100

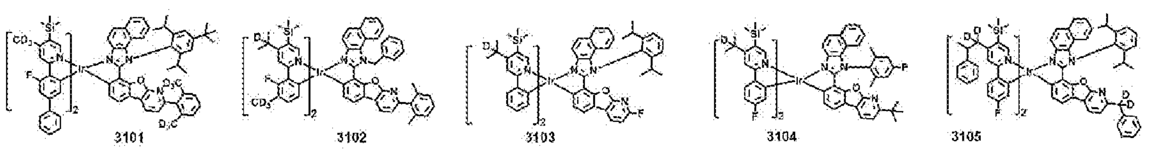

3101 3102 3103 3104 3105

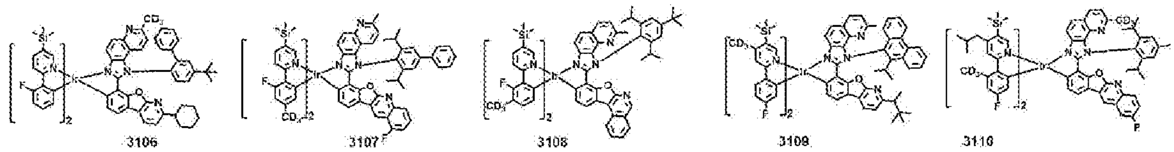

3106 3107 3108 3109 3110

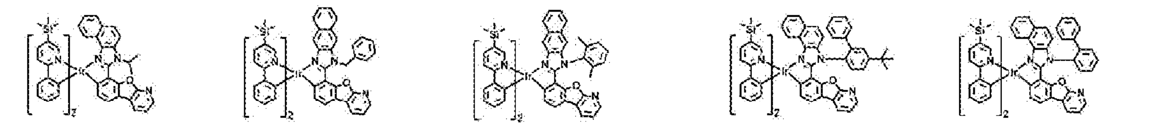

3111 3112 3113 3114 3115

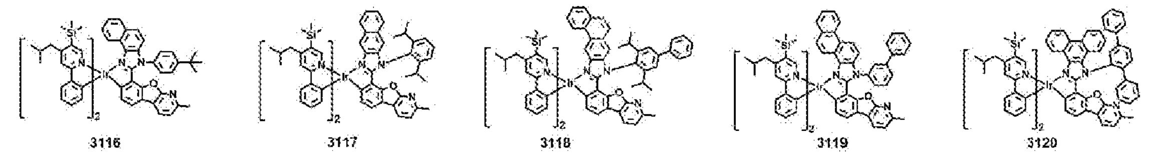

3116 3117 3118 3119 3120

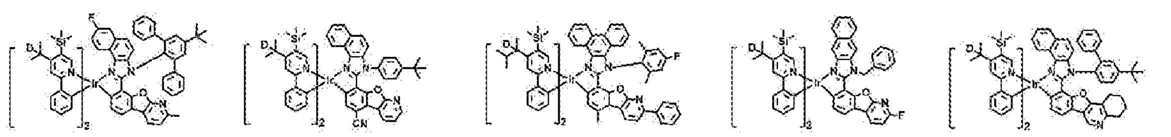

3121 3122 3123 3124 3125

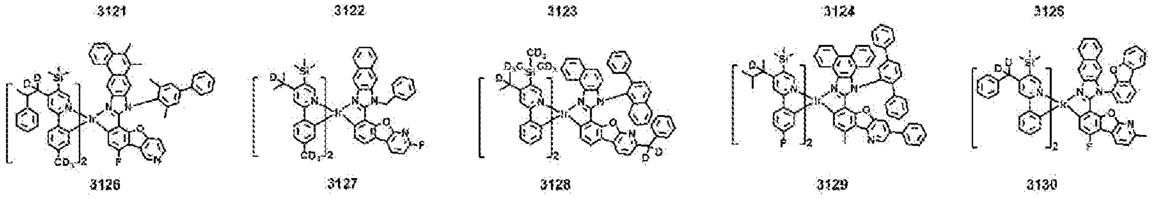

3126 3127 3128 3129 3130

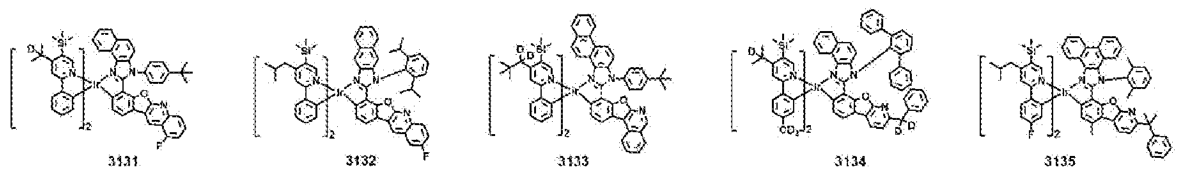

3131 3132 3133 3134 3135

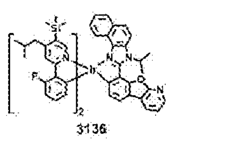
3136
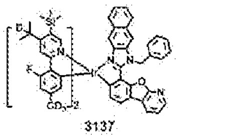
3137
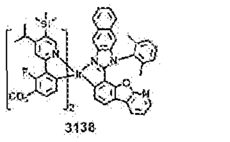
3138
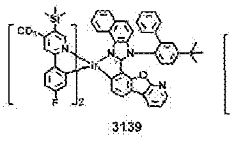
3139
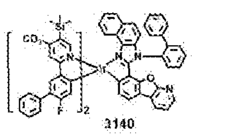
3140
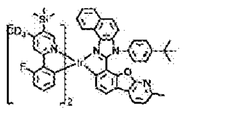
3141
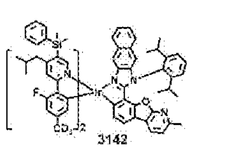
3142
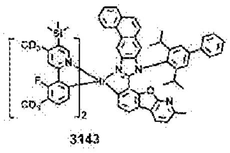
3143
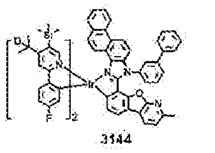
3144
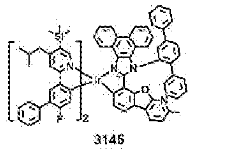
3145
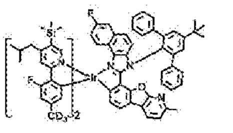
3146
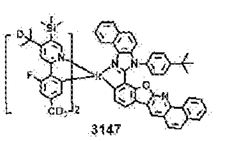
3147
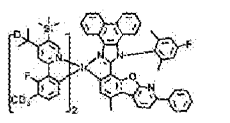
3148
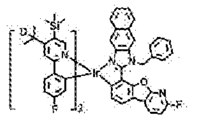
3149
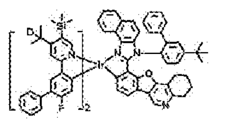
3150
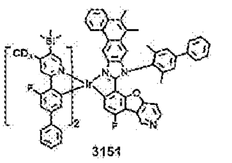
3151
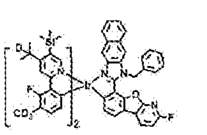
3152
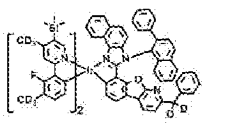
3153
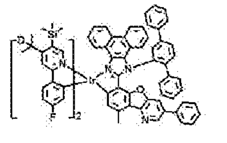
3154
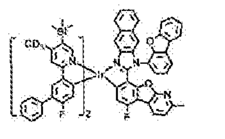
3155
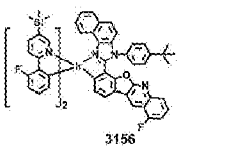
3156
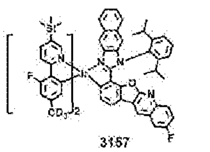
3157
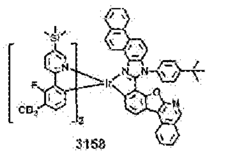
3158
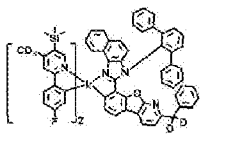
3159
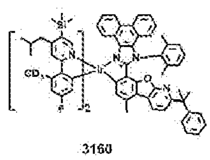
3160
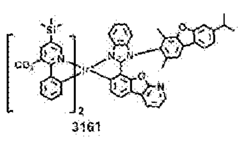
3161
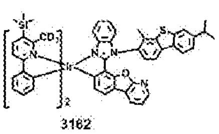
3162
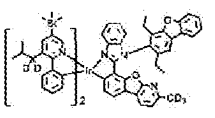
3163
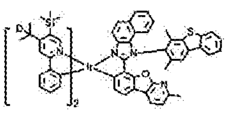
3164
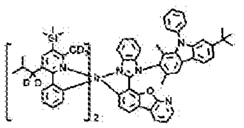
3165
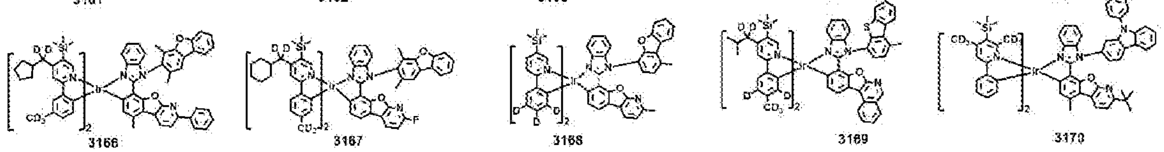
3166 3167 3168 3169 3170
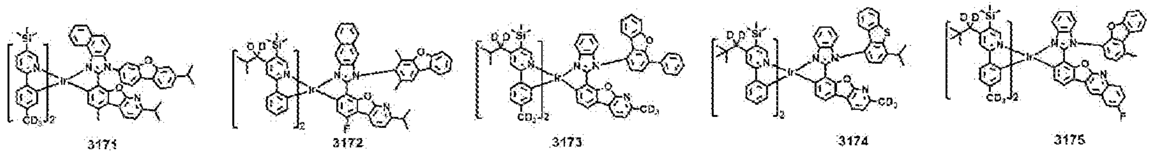
3171 3172 3173 3174 3175
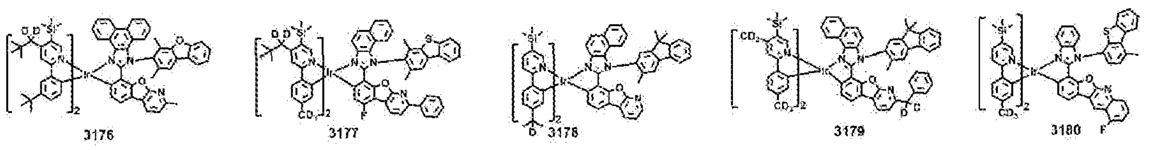
3176 3177 3178 3179 3180
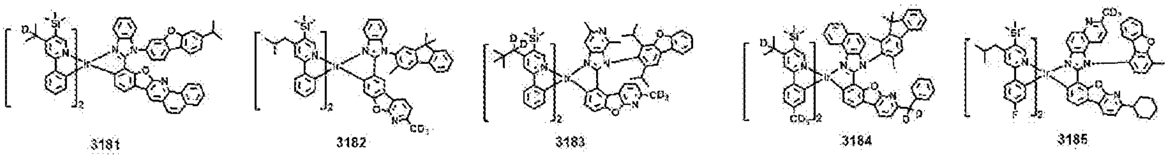
3181 3182 3183 3184 3185

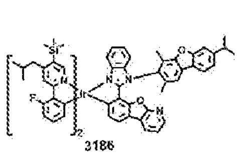
3186
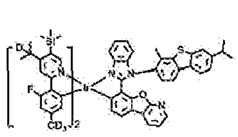
3187
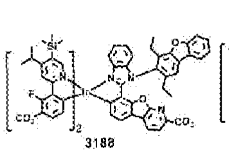
3188
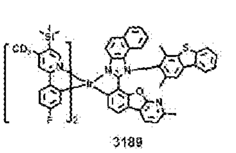
3189
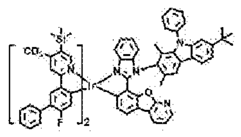
3190
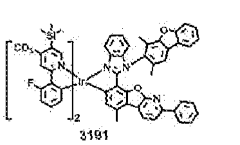
3191
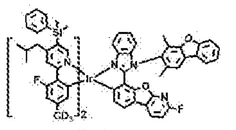
3192
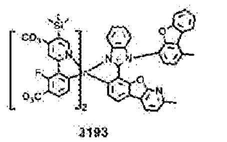
3193
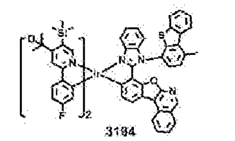
3194
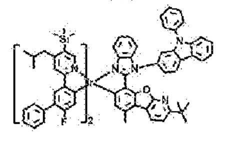
3195
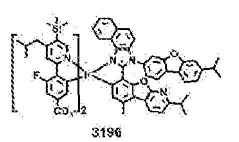
3196
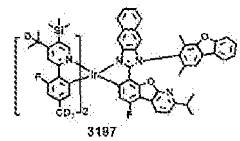
3197
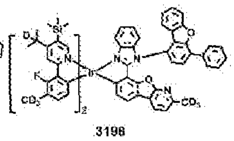
3198
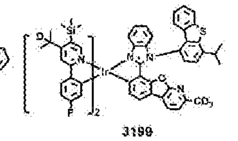
3199
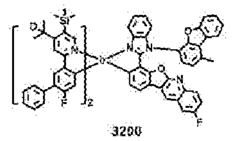
3200
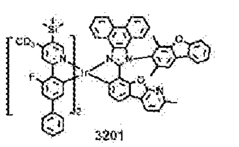
3201
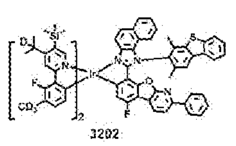
3202
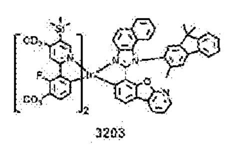
3203
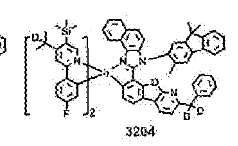
3204
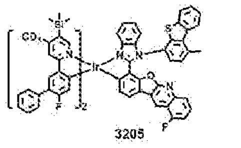
3205
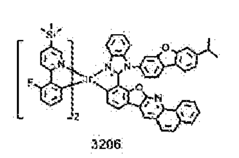
3206
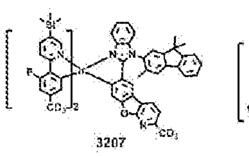
3207
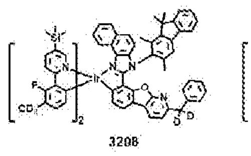
3208
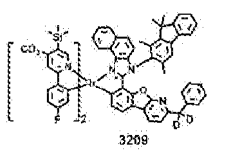
3209
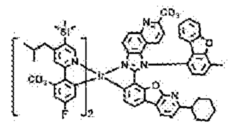
3210
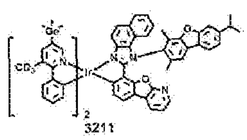
3211
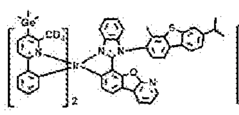
3212
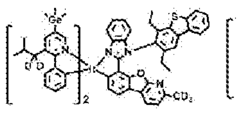
3213
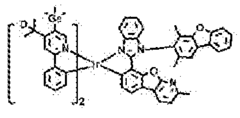
3214
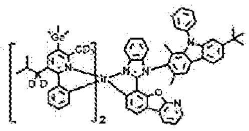
3215
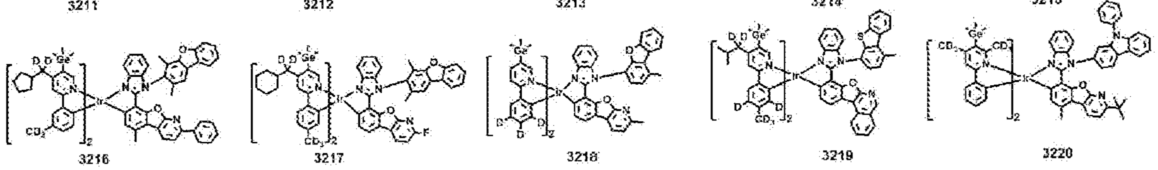
3216 3217 3218 3219 3220
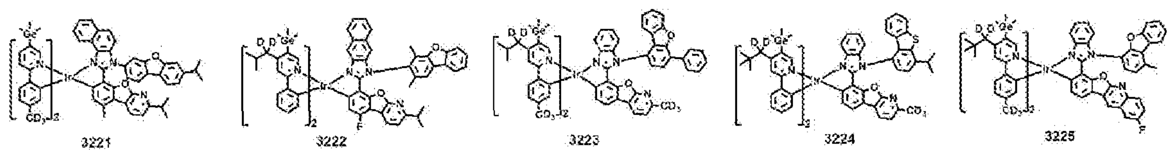
3221 3222 3223 3224 3225
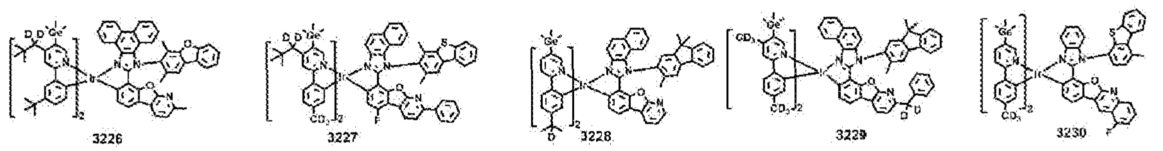
3226 3227 3228 3229 3230
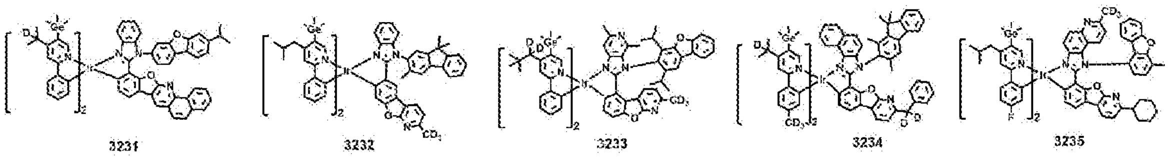
3231 3232 3233 3234 3235

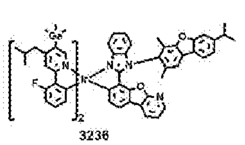
3236
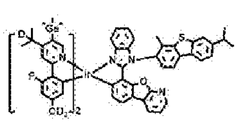
3237
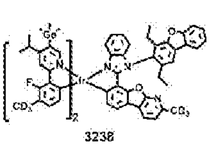
3238
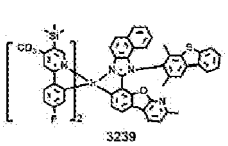
3239
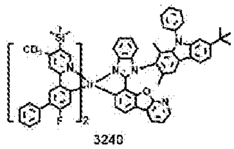
3240
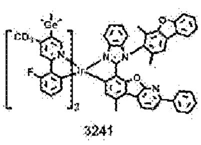
3241
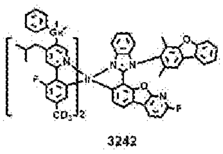
3242
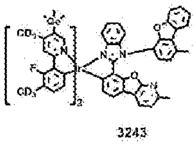
3243
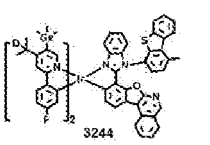
3244
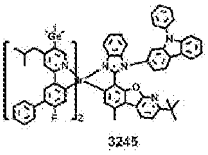
3245
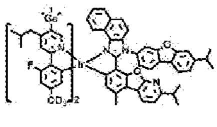
3246
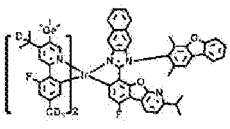
3247
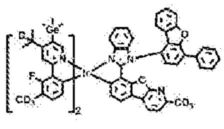
3248
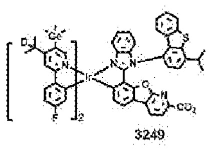
3249
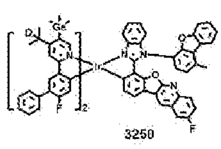
3250
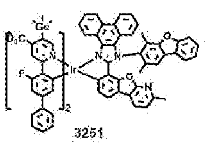
3251
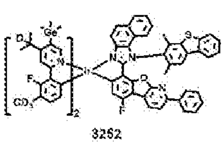
3252
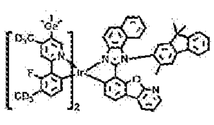
3253
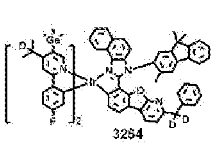
3254
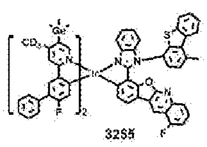
3255
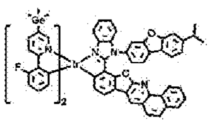
3256
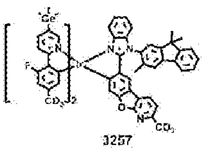
3257
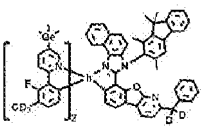
3258
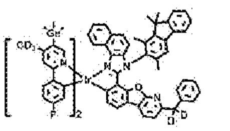
3259
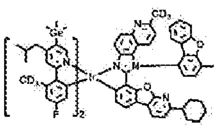
3260
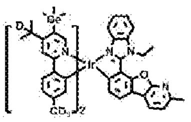
3261
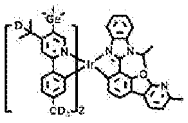
3262
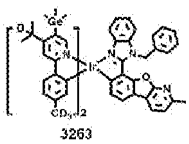
3263
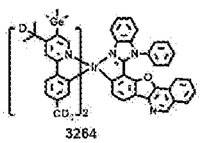
3264
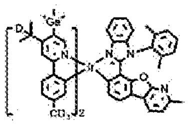
3265
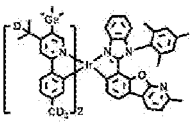
3266
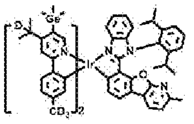
3267
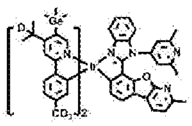
3268
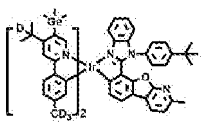
3269
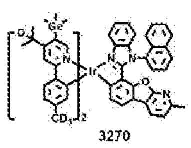
3270
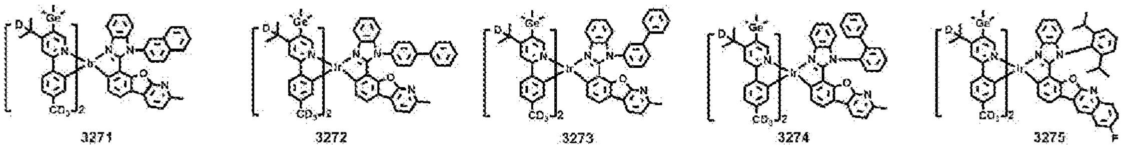
3271 3272 3273 3274 3275
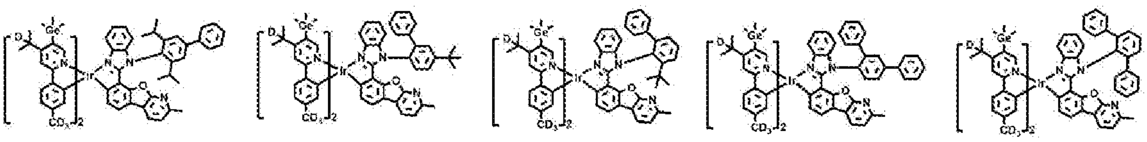
3276 3277 3278 3279 3280
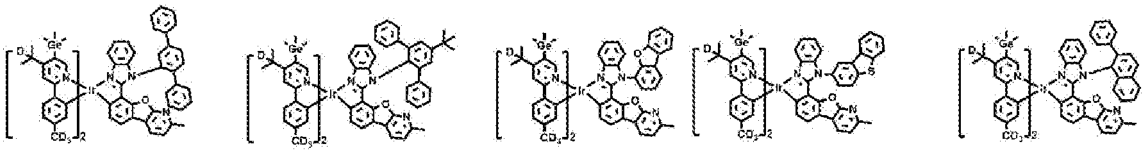
3281 3282 3283 3284 3285

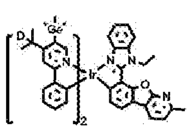
3286
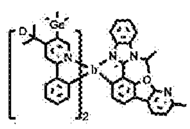
3287
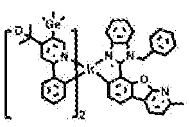
3288
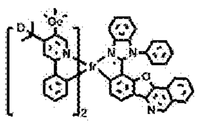
3289
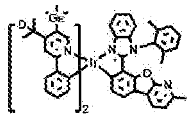
3290
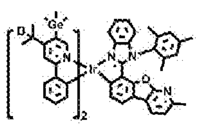
3291
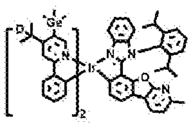
3292
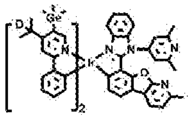
3293
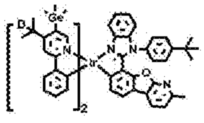
3294
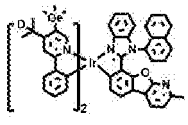
3295
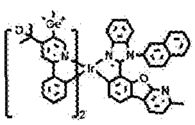
3296
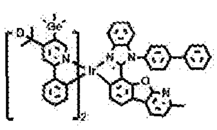
3297
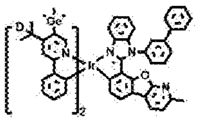
3298
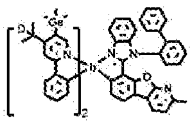
3299
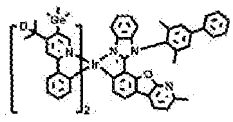
3300
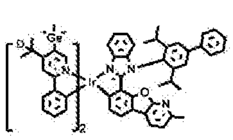
3301
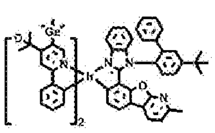
3302
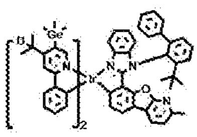
3303
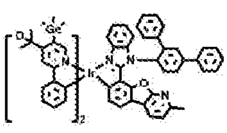
3304
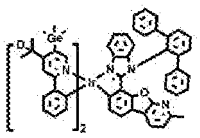
3305
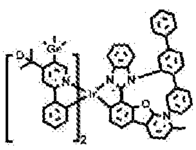
3306
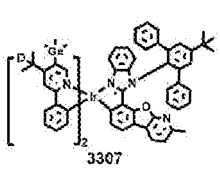
3307
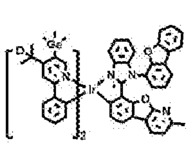
3308
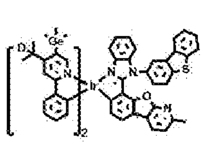
3309
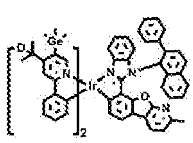
3310
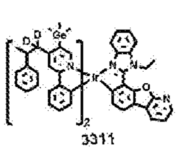
3311
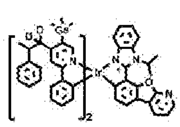
3312
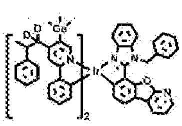
3313
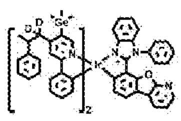
3314
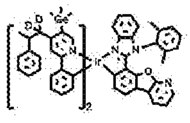
3315
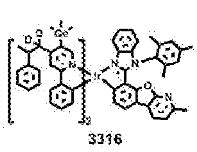
3316
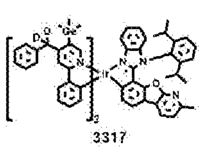
3317
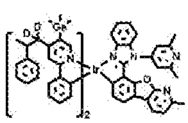
3318
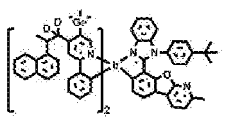
3319
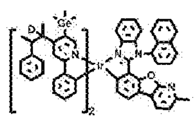
3320
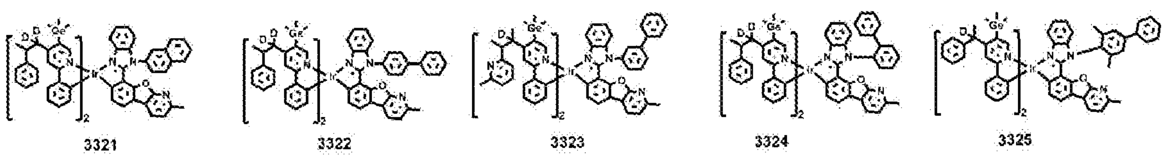
3321 3322 3323 3324 3325
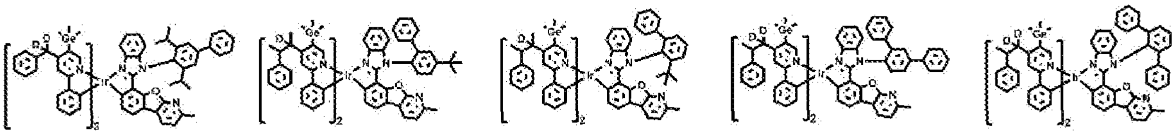
3326 3327 3328 3329 3330
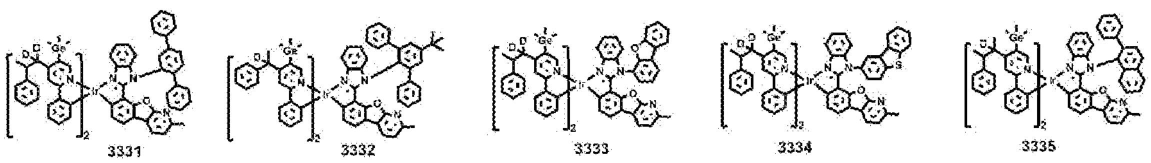
3331 3332 3333 3334 3335

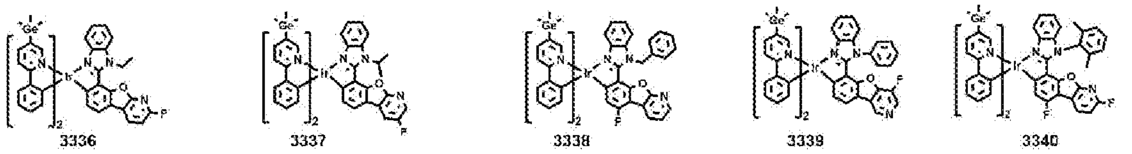

3336 3337 3338 3339 3340

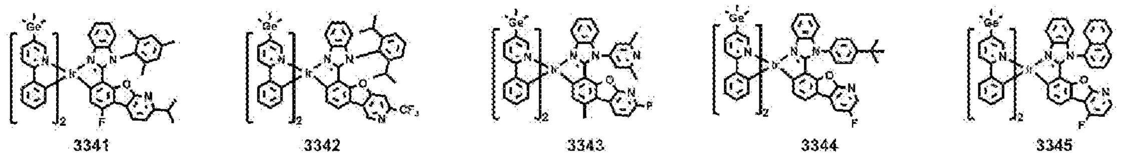

3341 3342 3343 3344 3345

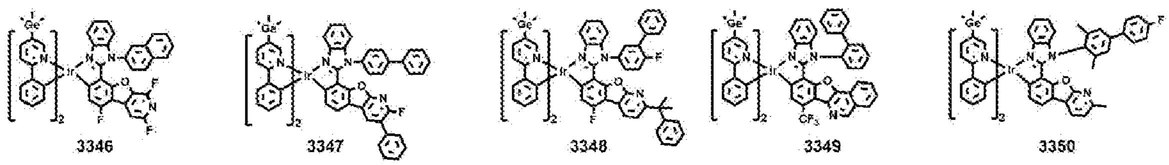

3346 3347 3348 3349 3350

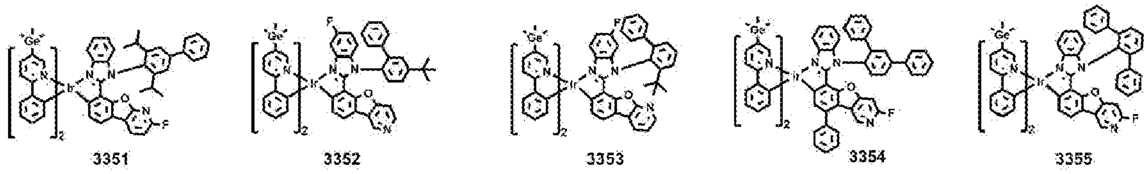

3351 3352 3353 3354 3355

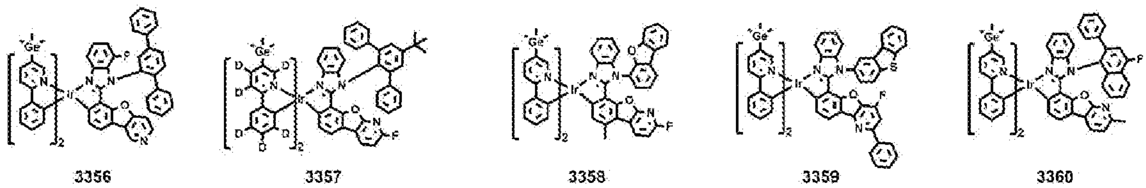

3356 3357 3358 3359 3360

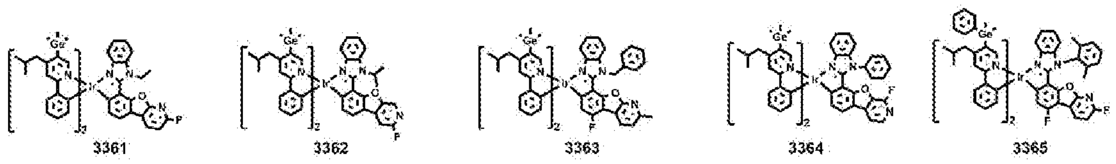

3361 3362 3363 3364 3365

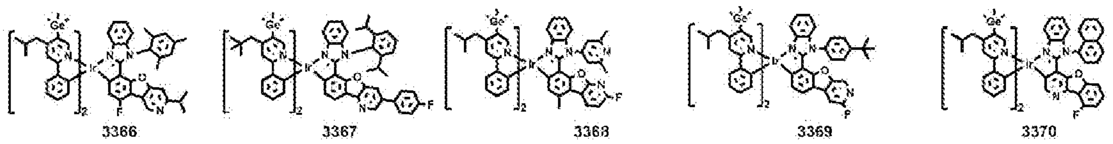

3366 3367 3368 3369 3370

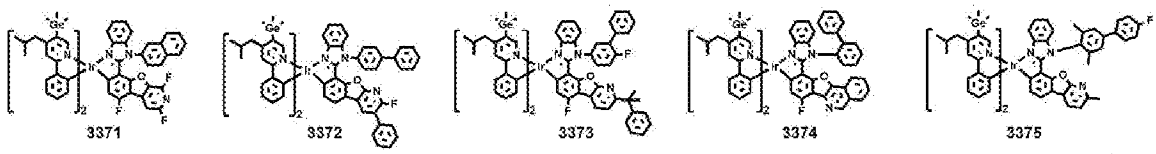

3371 3372 3373 3374 3375

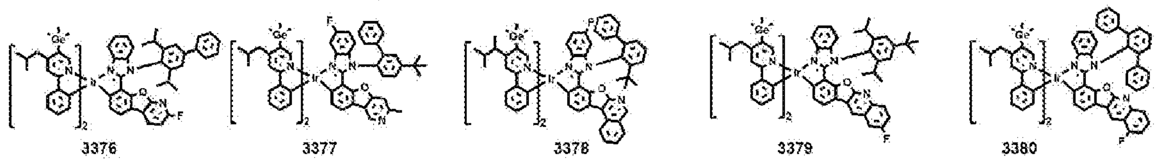

3376 3377 3378 3379 3380

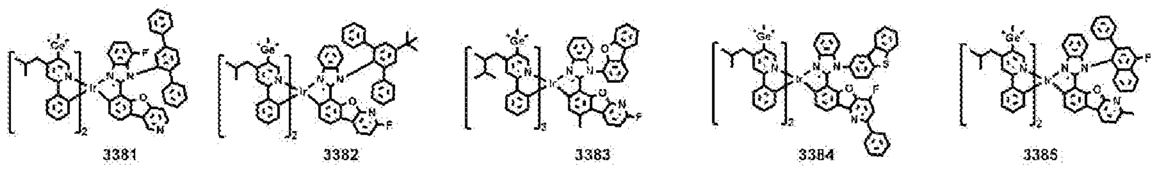

3381 3382 3383 3384 3385

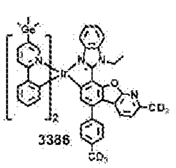
3386

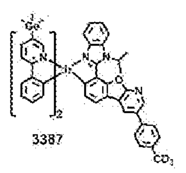
3387

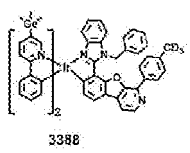
3388

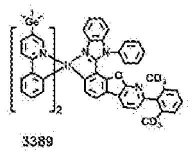
3389

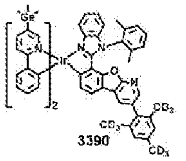
3390

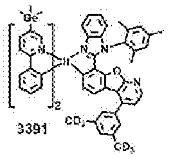
3391

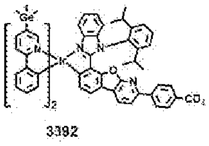
3392

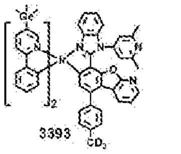
3393

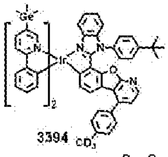
3394

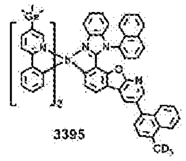
3395

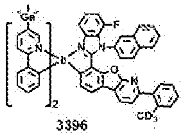
3396

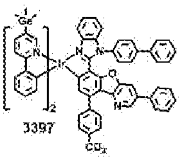
3397

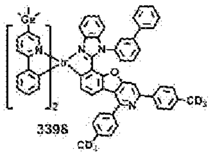
3398

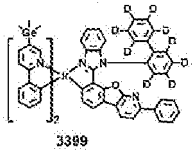
3399

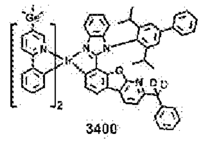
3400

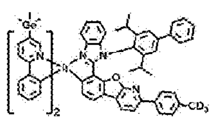
3401

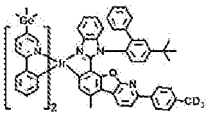
3402

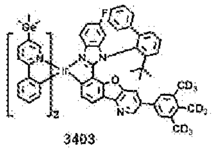
3403

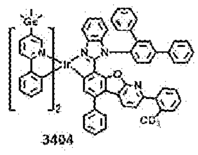
3404

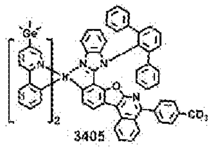
3405

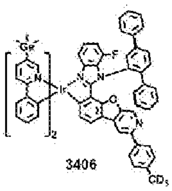
3406

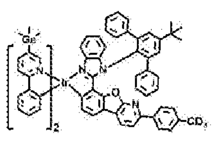
3407

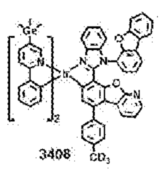
3408

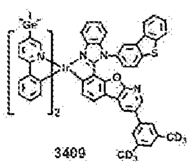
3409

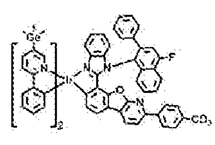
3410

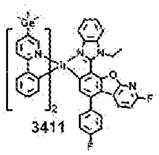
3411

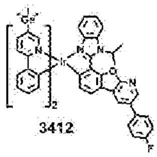
3412

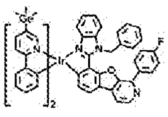
3413

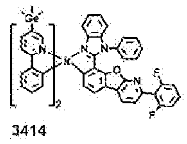
3414

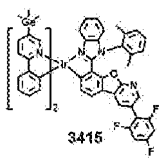
3415

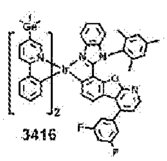
3416

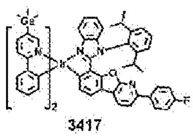
3417

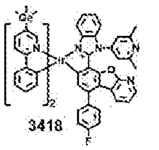
3418

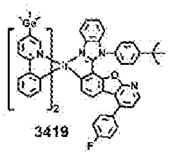
3419

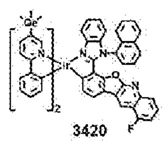
3420

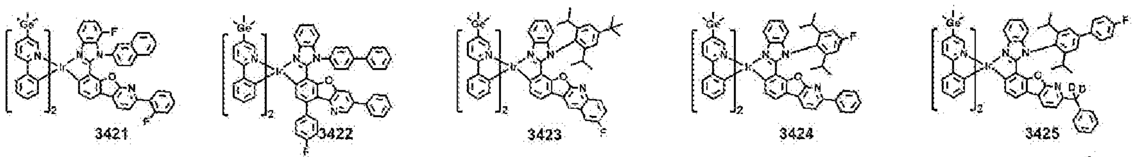
3421 3422 3423 3424 3425

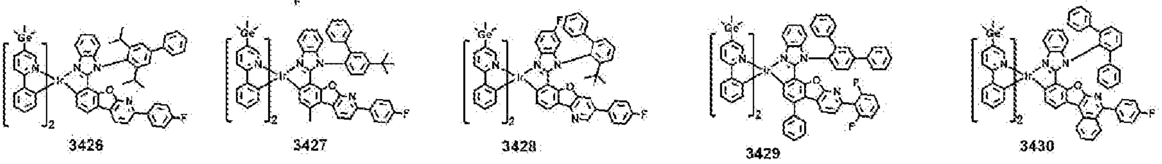
3426 3427 3428 3429 3430

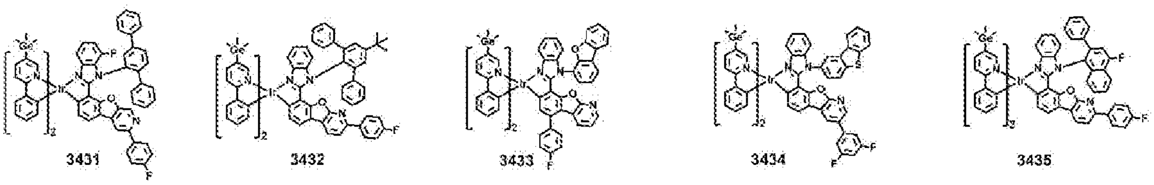
3431 3432 3433 3434 3435

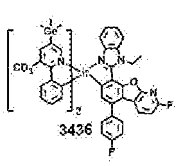
3436
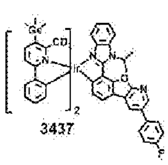
3437
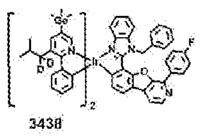
3438
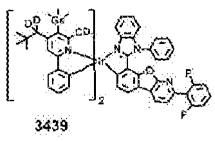
3439
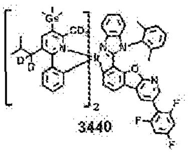
3440
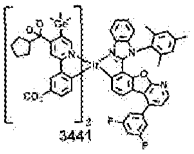
3441
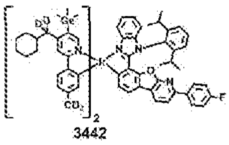
3442
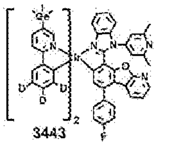
3443
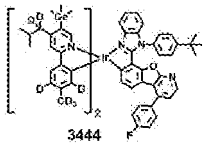
3444
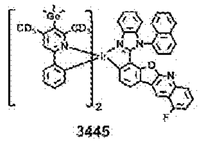
3445
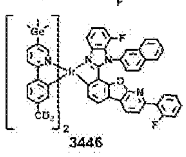
3446
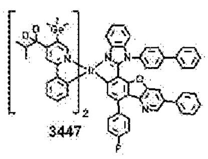
3447
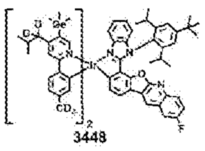
3448
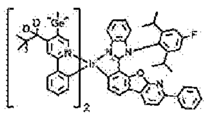
3449
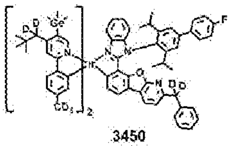
3450
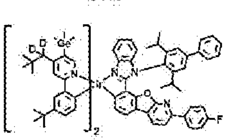
3451
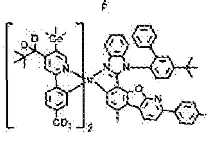
3452
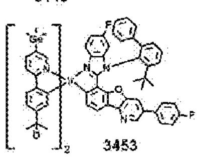
3453
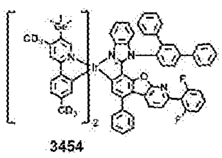
3454
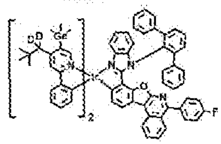
3455
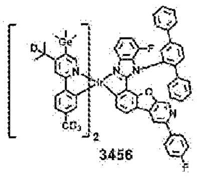
3456
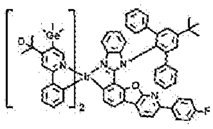
3457
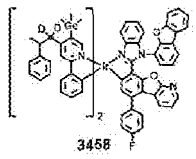
3458
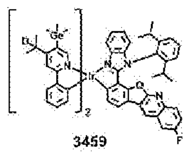
3459
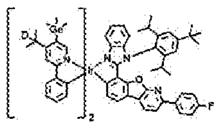
3460
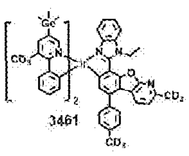
3461
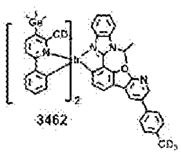
3462
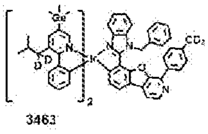
3463
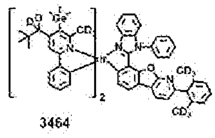
3464
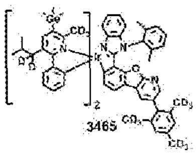
3465
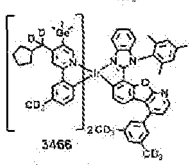
3466
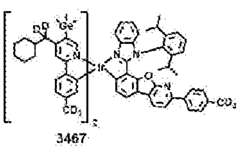
3467
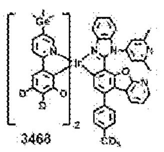
3468
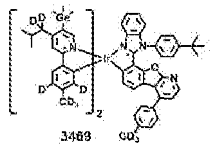
3469
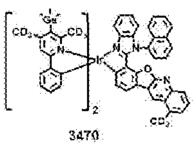
3470
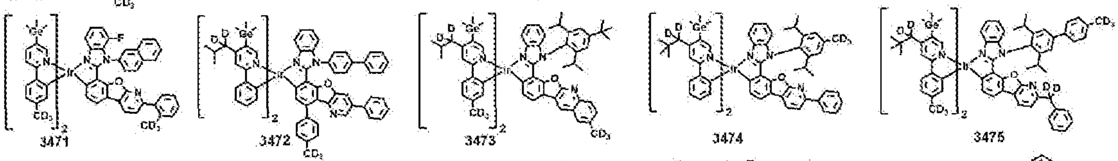
3471 3472 3473 3474 3475
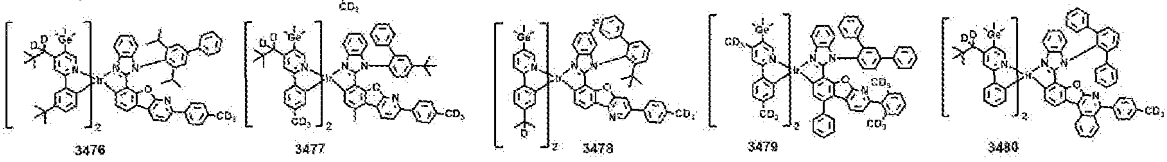
3476 3477 3478 3479 3480
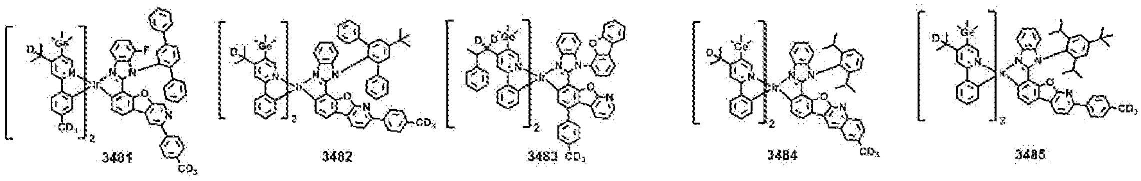
3481 3482 3483 3484 3485

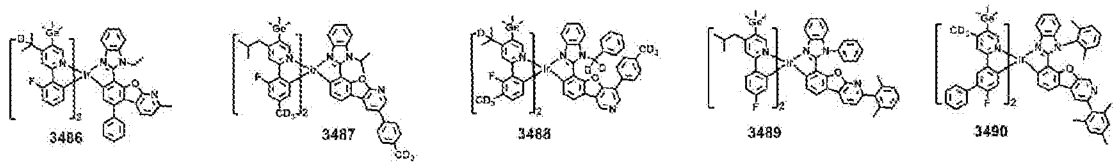

3486 3487 3488 3489 3490

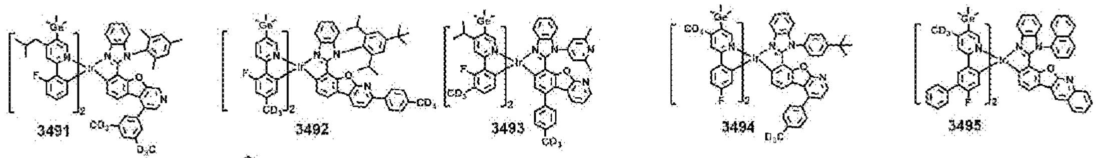

3491 3492 3493 3494 3495

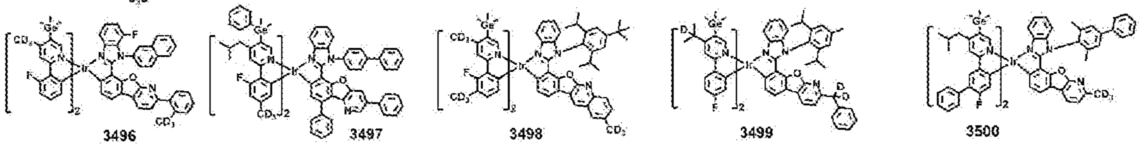

3496 3497 3498 3499 3500

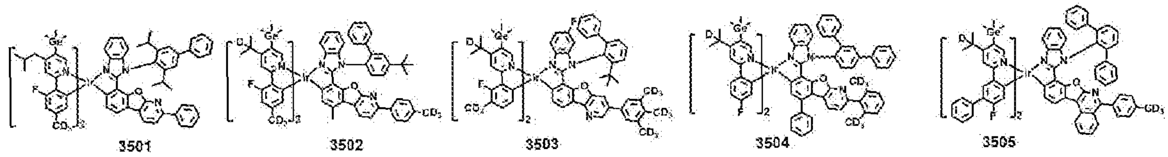

3501 3502 3503 3504 3505

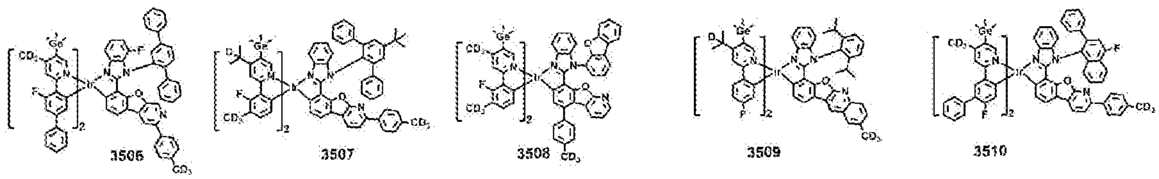

3506 3507 3508 3509 3510

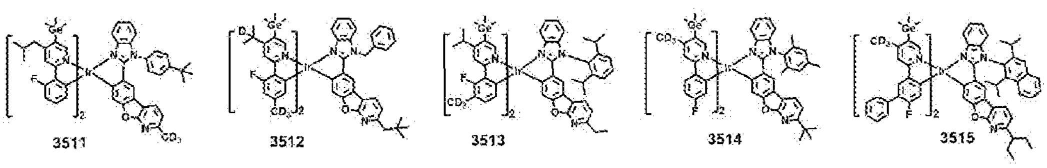

3511 3512 3513 3514 3515

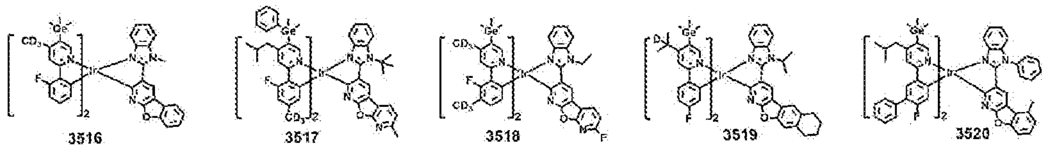

3516 3517 3518 3519 3520

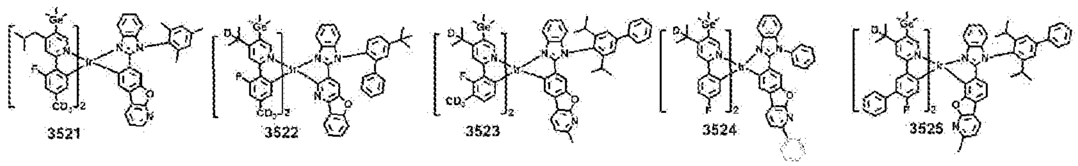

3521 3522 3523 3524 3525

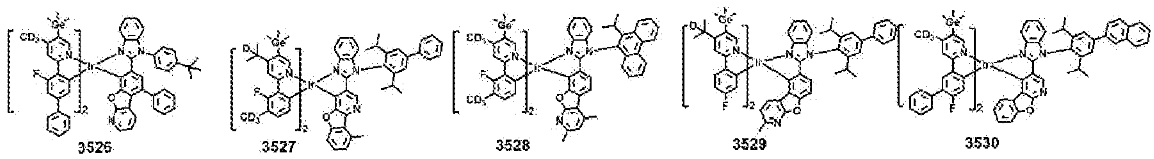

3526 3527 3528 3529 3530

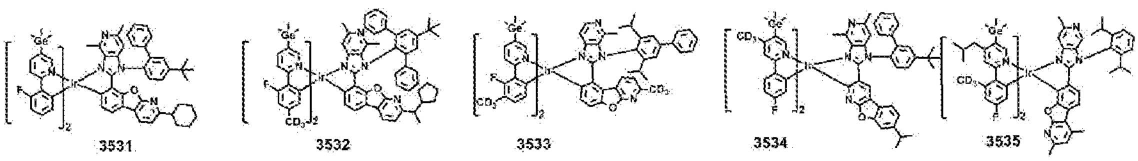

3531 3532 3533 3534 3535

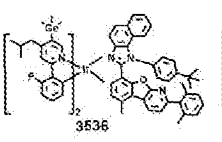
3536
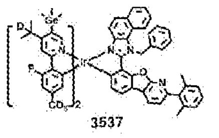
3537
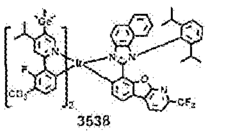
3538
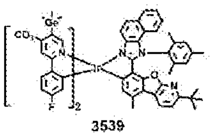
3539
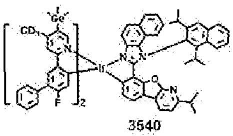
3540
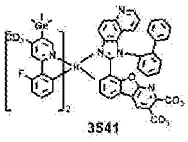
3541
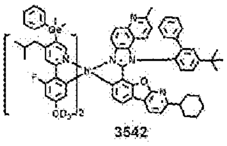
3542
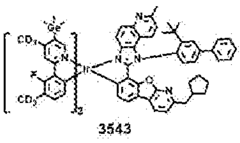
3543
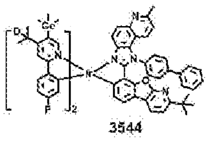
3544
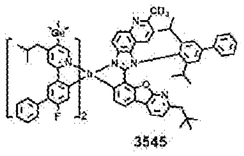
3545
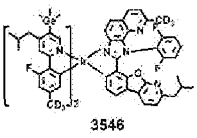
3546
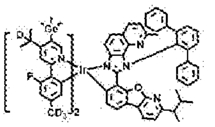
3547
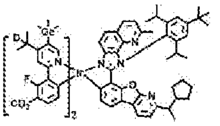
3548
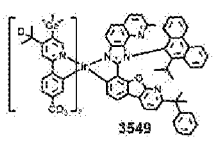
3549
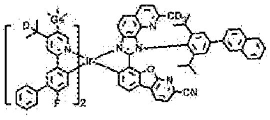
3550
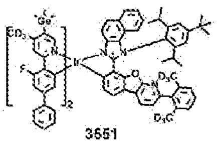
3551
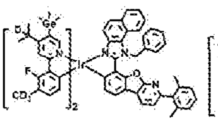
3552
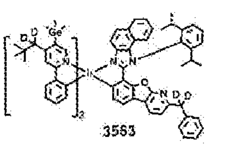
3553
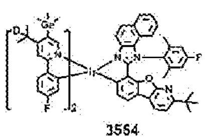
3554
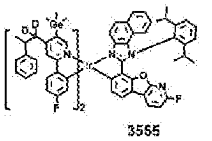
3555
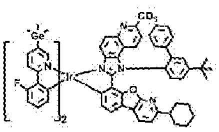
3556
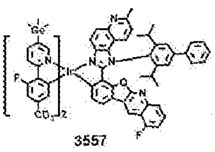
3557
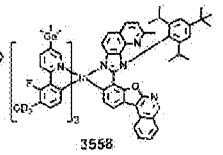
3558
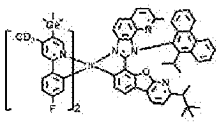
3559
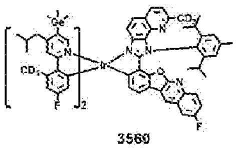
3560
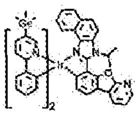
3561
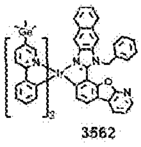
3562
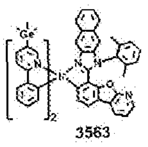
3563
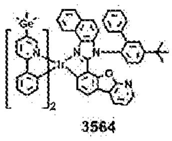
3564
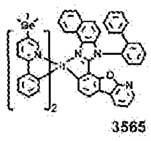
3565
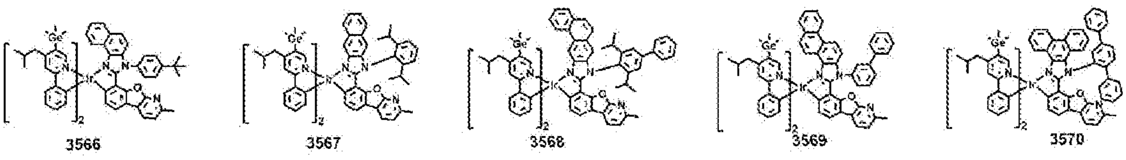
3566 3567 3568 3569 3570
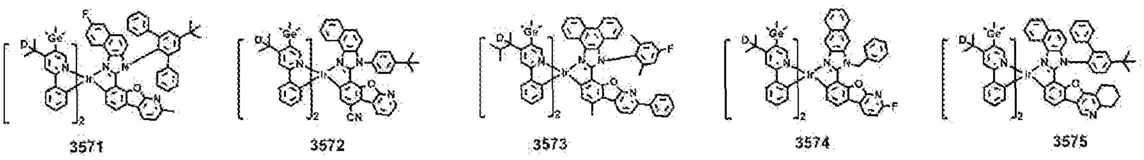
3571 3572 3573 3574 3575
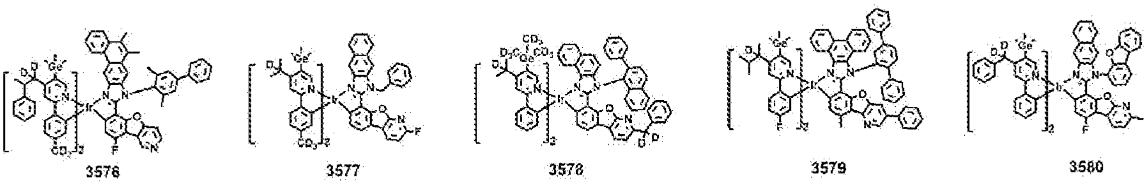
3576 3577 3578 3579 3580
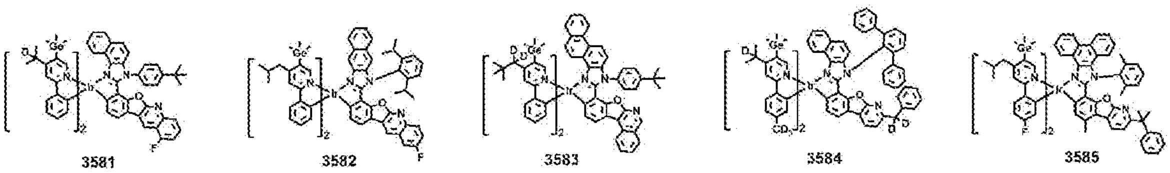
3581 3582 3583 3584 3585

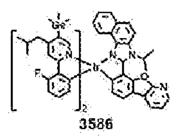
3586

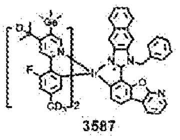
3587

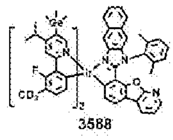
3588

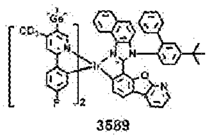
3589

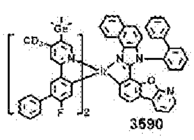
3590

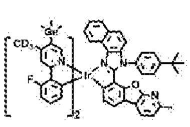
3591

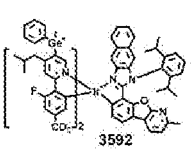
3592

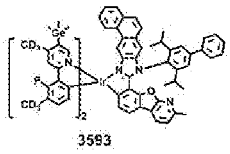
3593

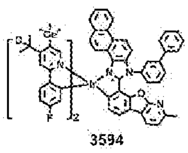
3594

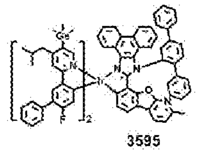
3595

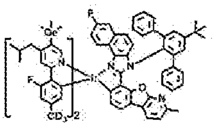
3596

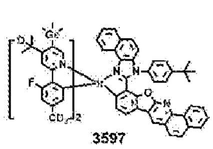
3597

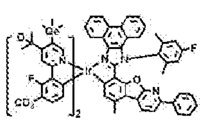
3598

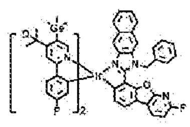
3599

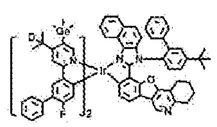
3600

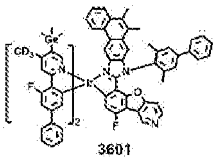
3601

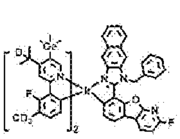
3602

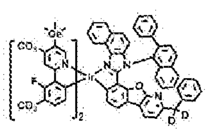
3603

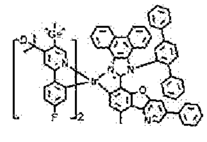
3604

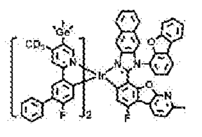
3605

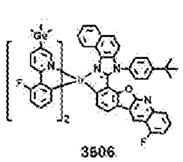
3606

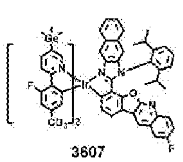
3607

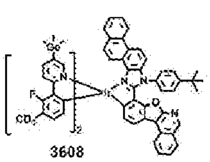
3608

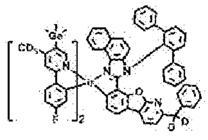
3609

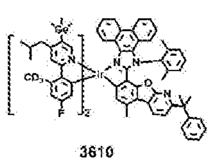
3610

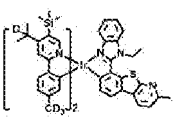
3611

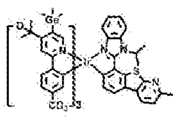
3612

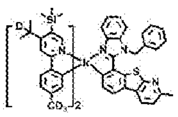
3613

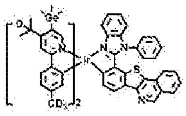
3614

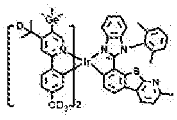
3615

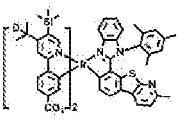
3616

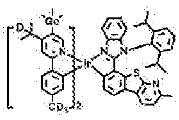
3617

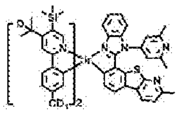
3618

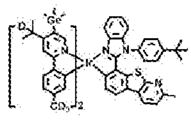
3619

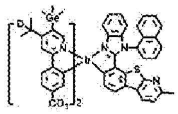
3620

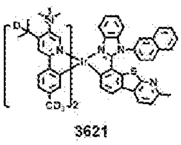
3621

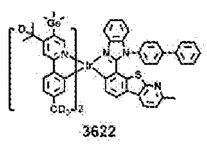
3622

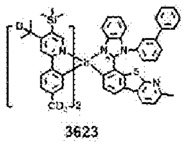
3623

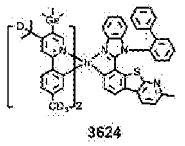
3624

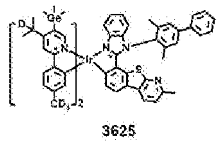
3625

3626

3627

3628

3629

3630

3631

3632

3633

3634

3635

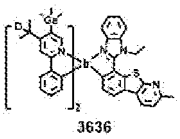
3636
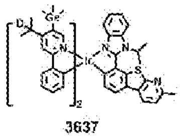
3637
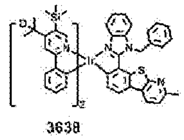
3638
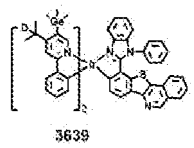
3639
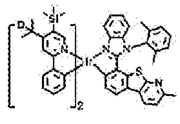
3640
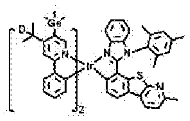
3641
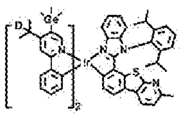
3642
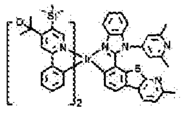
3643
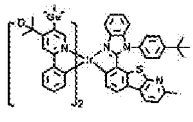
3644
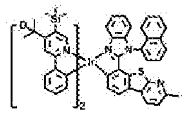
3645
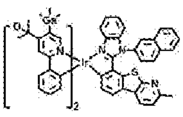
3646
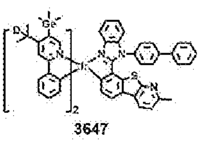
3647
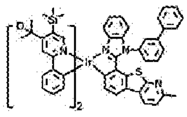
3648
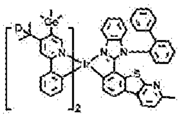
3649
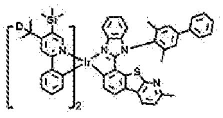
3650
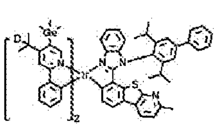
3651
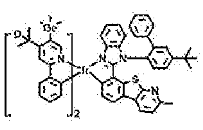
3652
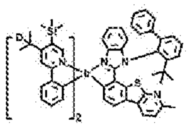
3653
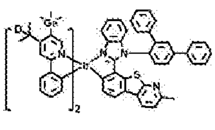
3654
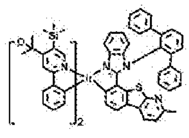
3655
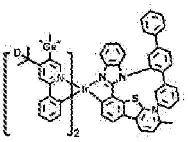
3656
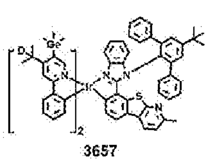
3657
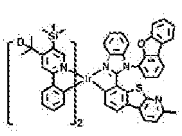
3658
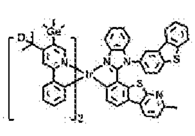
3659
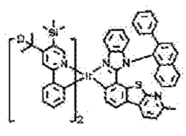
3660
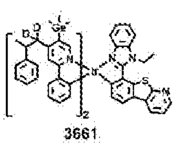
3661
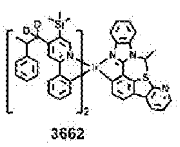
3662
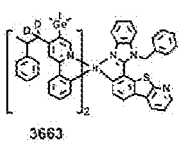
3663
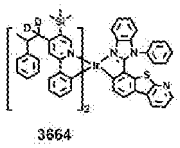
3664
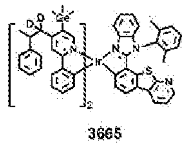
3665
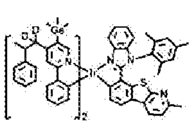
3666
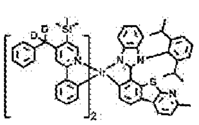
3667
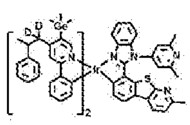
3668
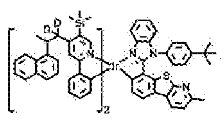
3669
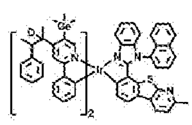
3670
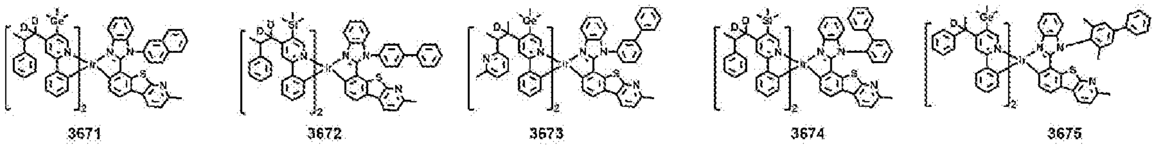
3671
3672
3673
3674
3675
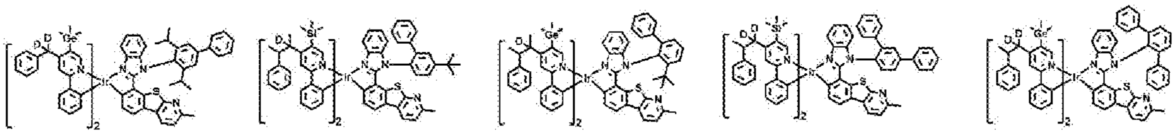
3676
3677
3678
3679
3680
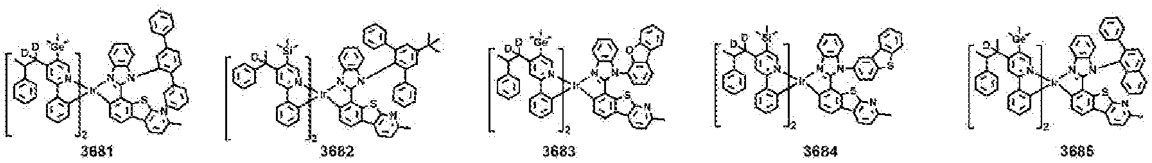
3681
3682
3683
3684
3685

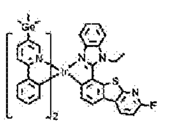
3686
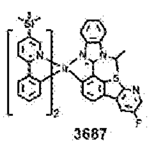
3687
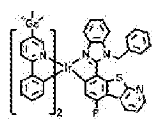
3688
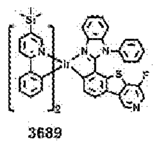
3689
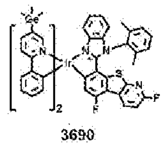
3690

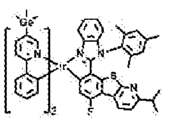
3691
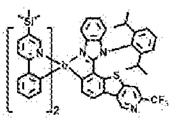
3692
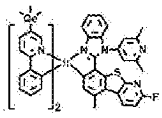
3693
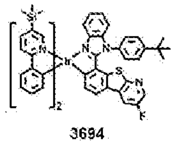
3694
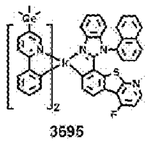
3695

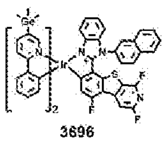
3696
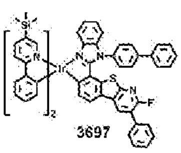
3697
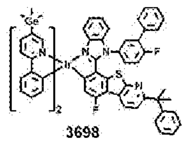
3698
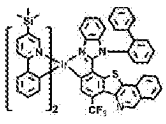
3699
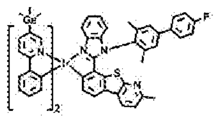
3700

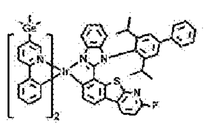
3701
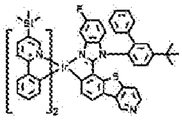
3702
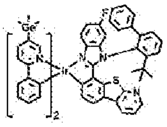
3703
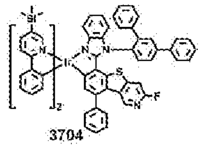
3704
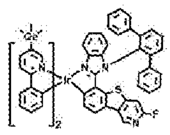
3705

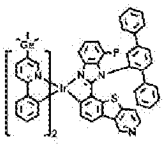
3706
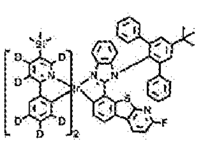
3707
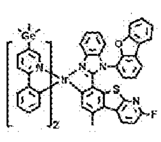
3708
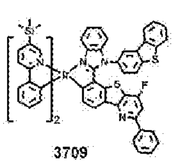
3709
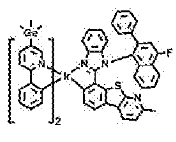
3710

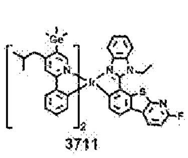
3711
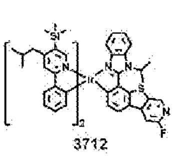
3712
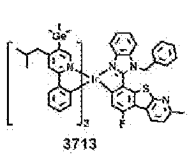
3713
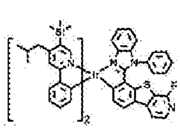
3714
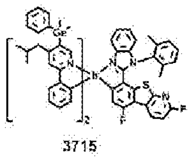
3715

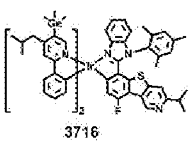
3716
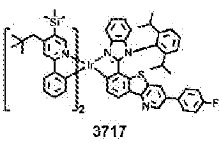
3717
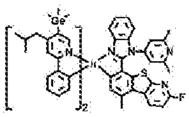
3718
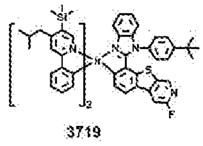
3719
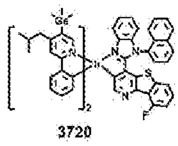
3720

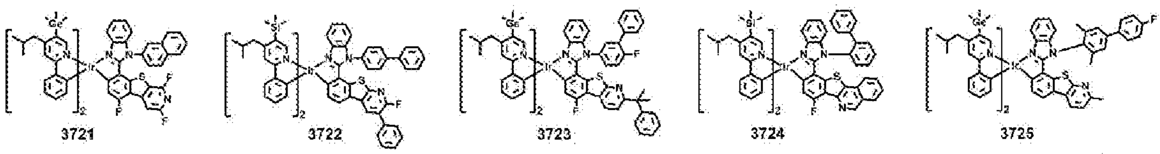
3721
3722
3723
3724
3725

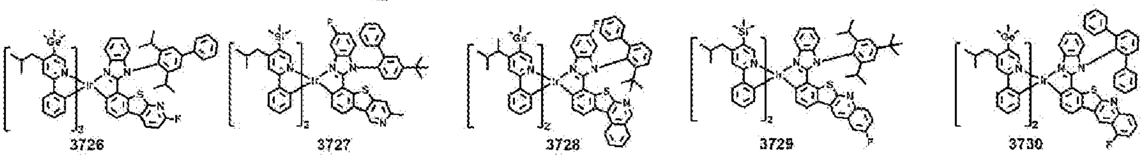
3726
3727
3728
3729
3730

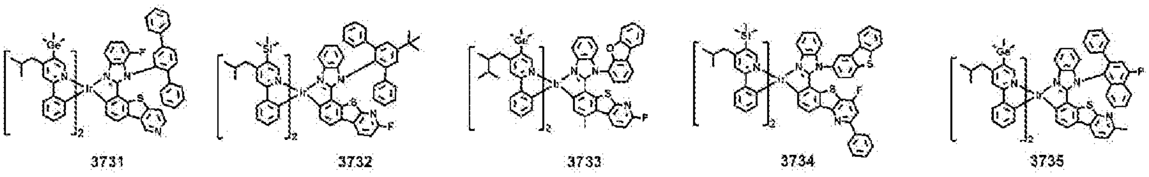
3731
3732
3733
3734
3735

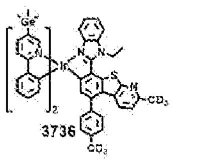
3736
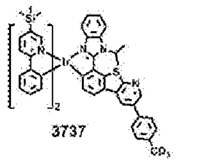
3737
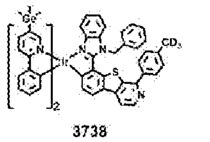
3738
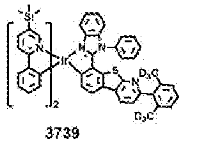
3739
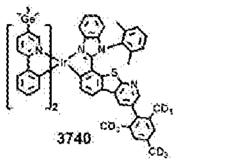
3740
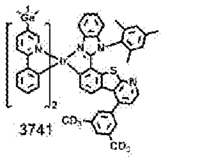
3741
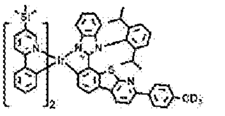
3742
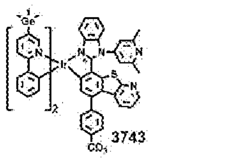
3743
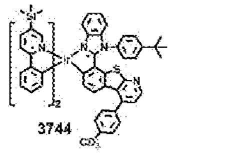
3744
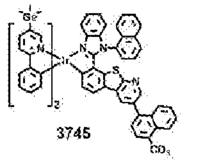
3745
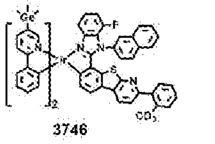
3746
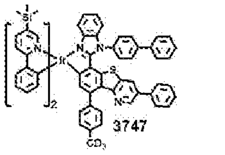
3747
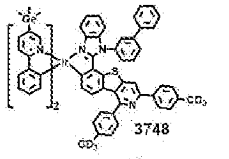
3748
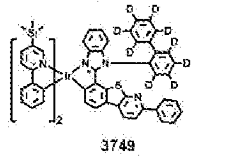
3749
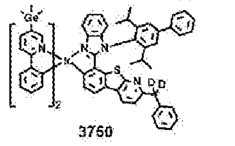
3750
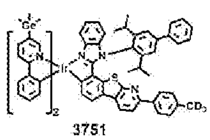
3751
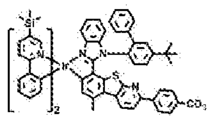
3752
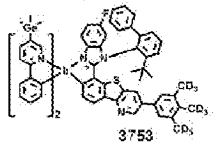
3753
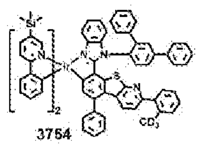
3754
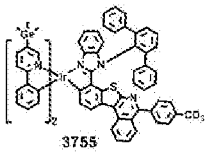
3755
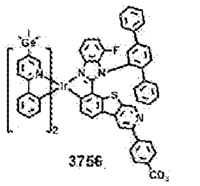
3756
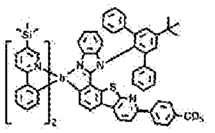
3757
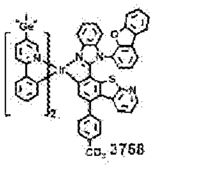
3758
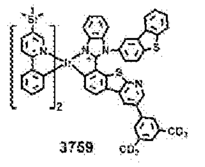
3759
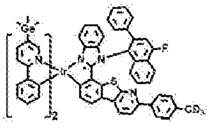
3760
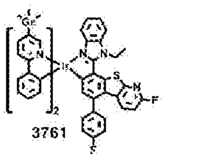
3761
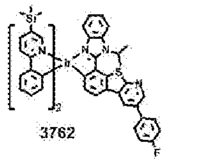
3762
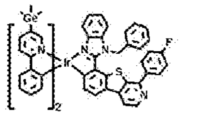
3763
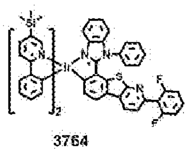
3764
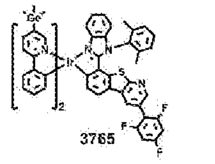
3765
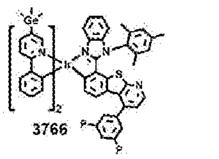
3766
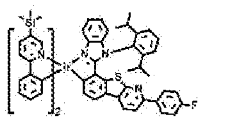
3767
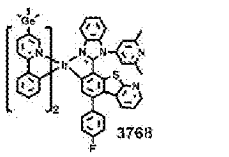
3768
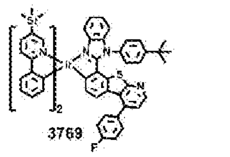
3769
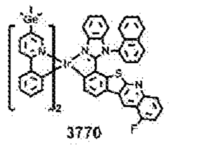
3770
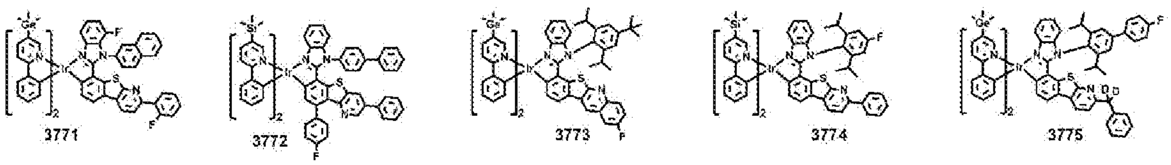
3771 3772 3773 3774 3775
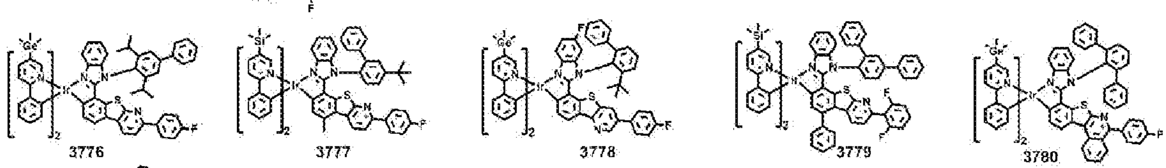
3776 3777 3778 3779 3780
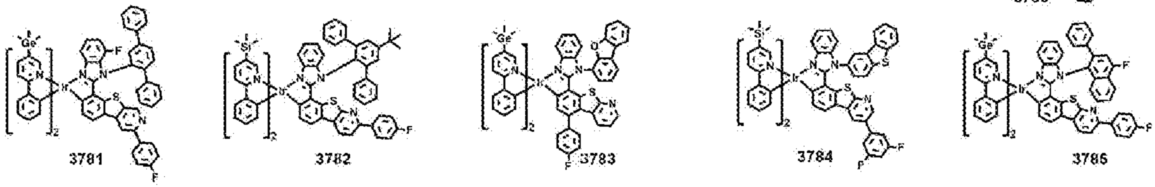
3781 3782 3783 3784 3785

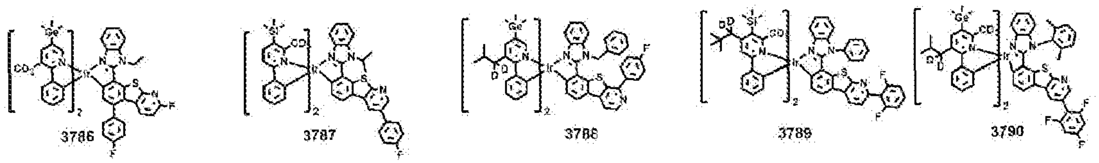
3786 3787 3788 3789 3790

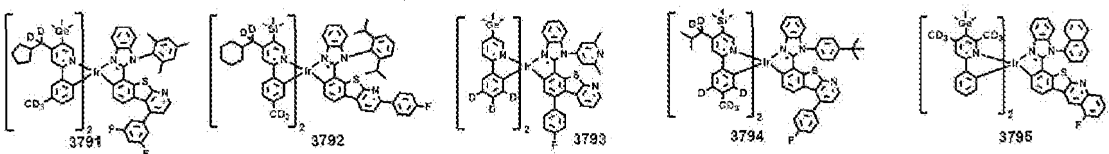
3791 3792 3793 3794 3795

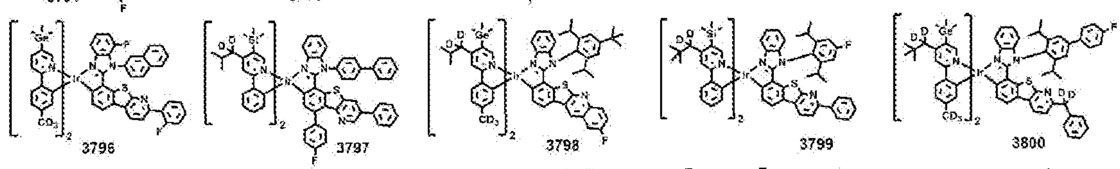
3796 3797 3798 3799 3800

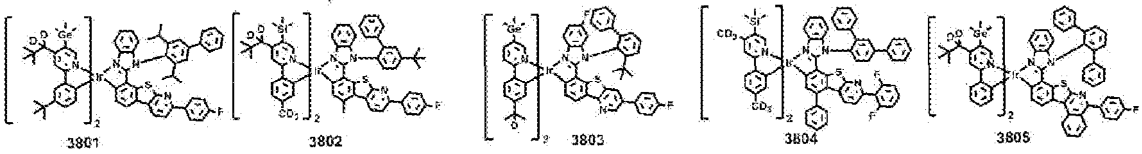
3801 3802 3803 3804 3805

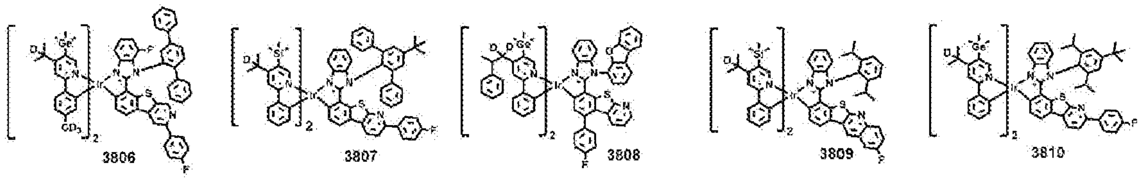
3806 3807 3808 3809 3810

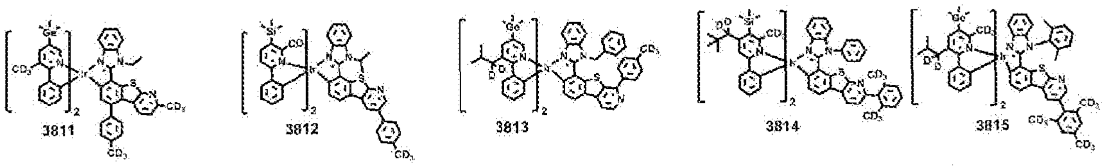
3811 3812 3813 3814 3815

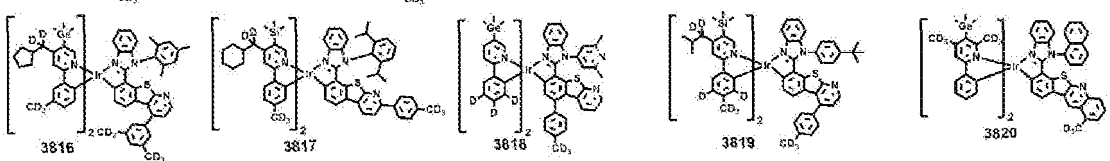
3816 3817 3818 3819 3820

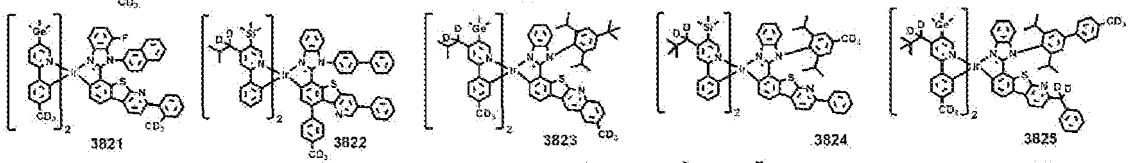
3821 3822 3823 3824 3825

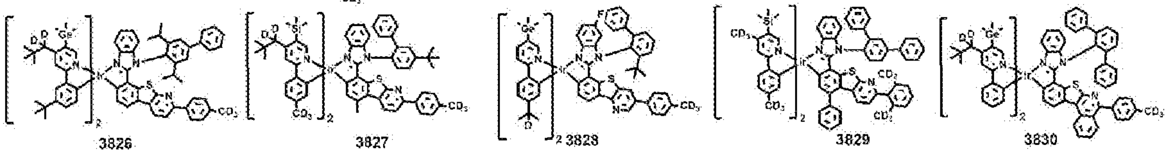
3826 3827 3828 3829 3830

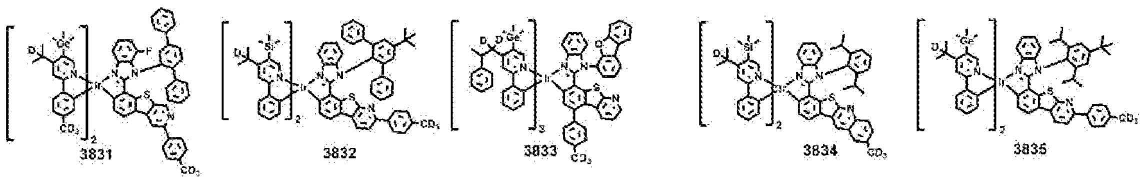
3831 3832 3833 3834 3835

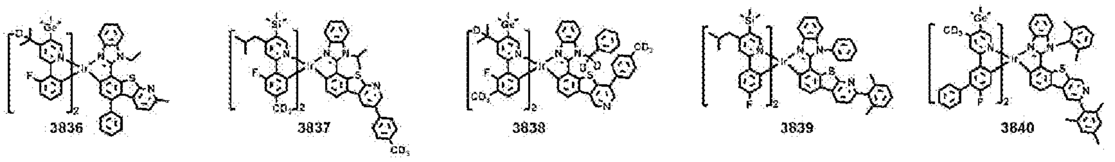

3836 3837 3838 3839 3840

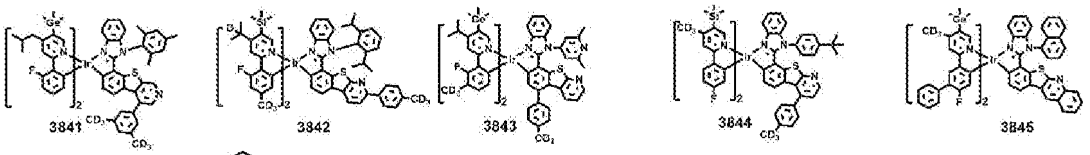

3841 3842 3843 3844 3845

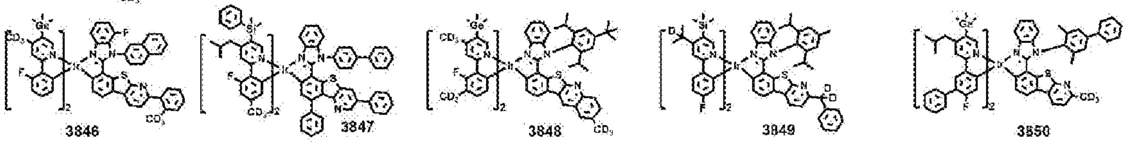

3846 3847 3848 3849 3850

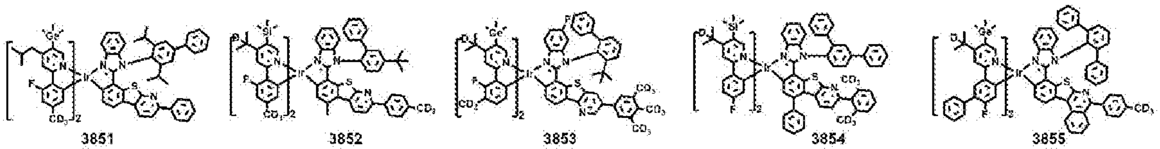

3851 3852 3853 3854 3855

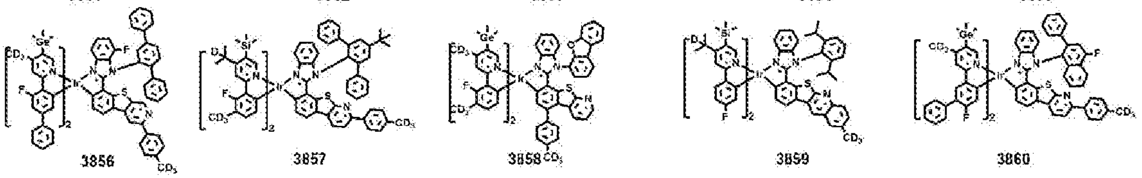

3856 3857 3858 3859 3860

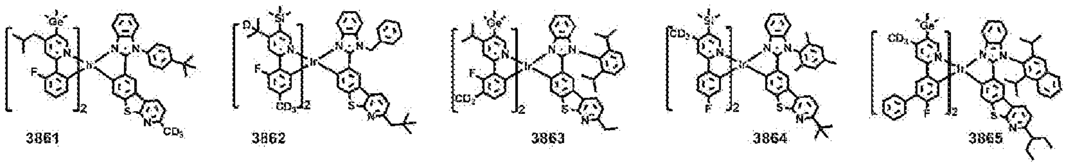

3861 3862 3863 3864 3865

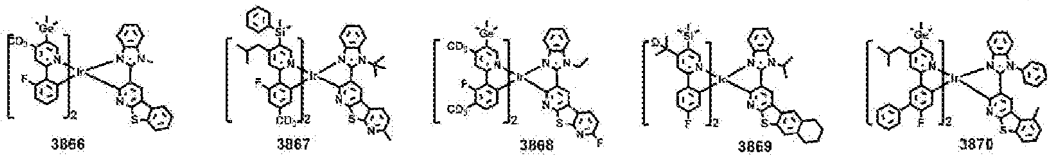

3866 3867 3868 3869 3870

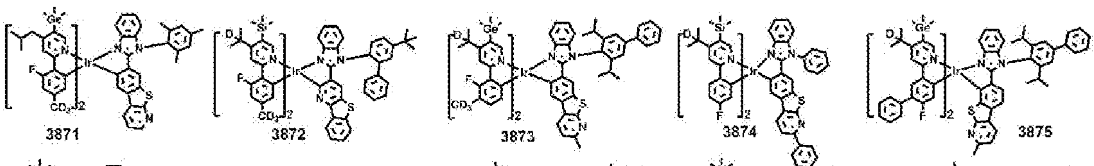

3871 3872 3873 3874 3875

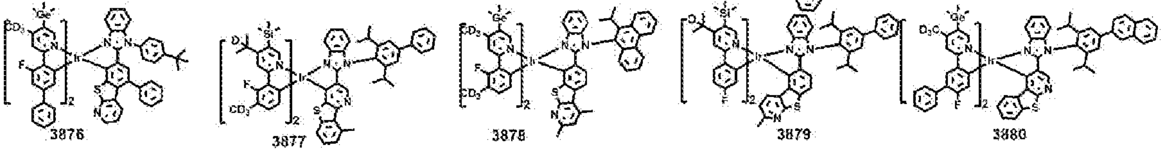

3876 3877 3878 3879 3880

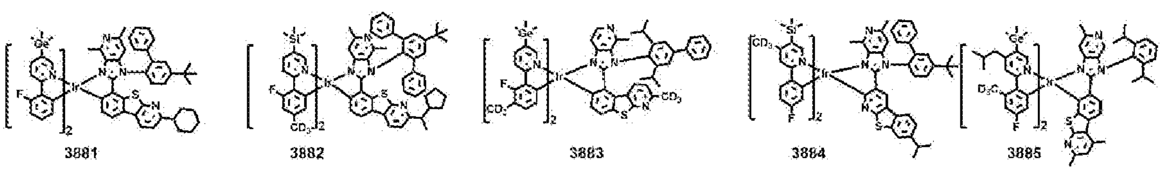

3881 3882 3883 3884 3885

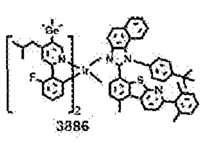
3886
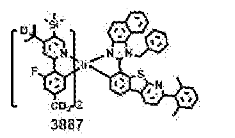
3887
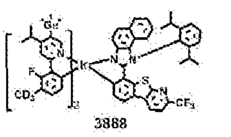
3888
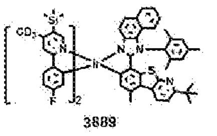
3889
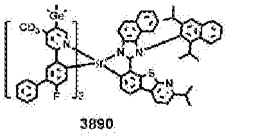
3890
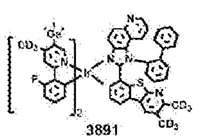
3891
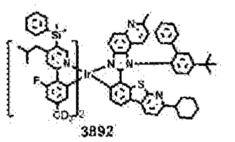
3892
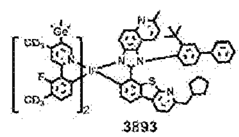
3893
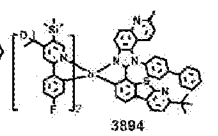
3894
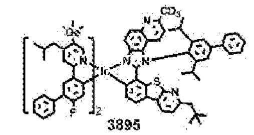
3895
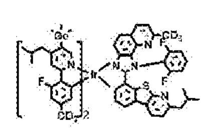
3896
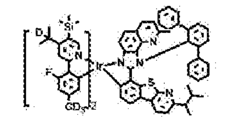
3897
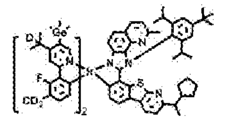
3898
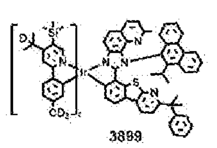
3899
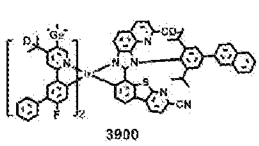
3900
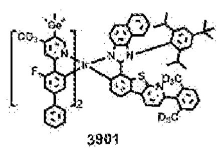
3901
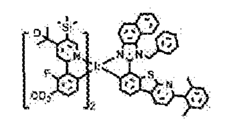
3902
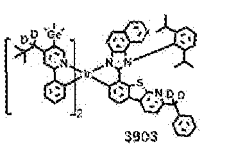
3903
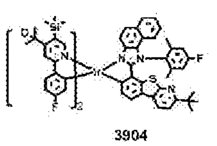
3904
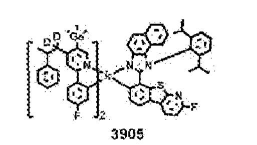
3905
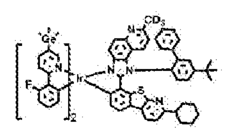
3906
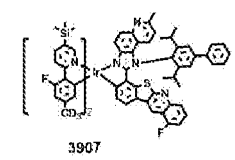
3907
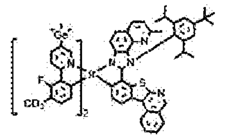
3908
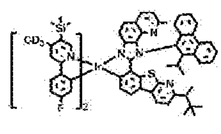
3909
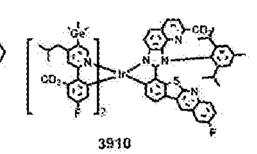
3910
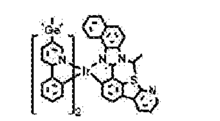
3911
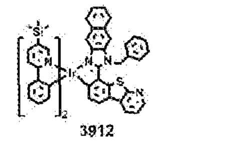
3912
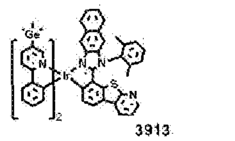
3913
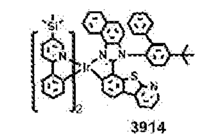
3914
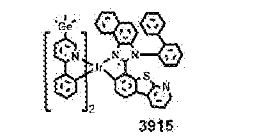
3915
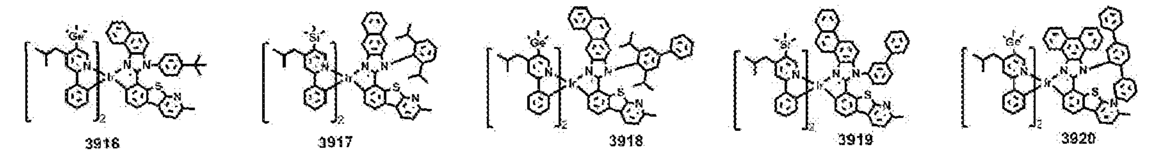
3916 3917 3918 3919 3920
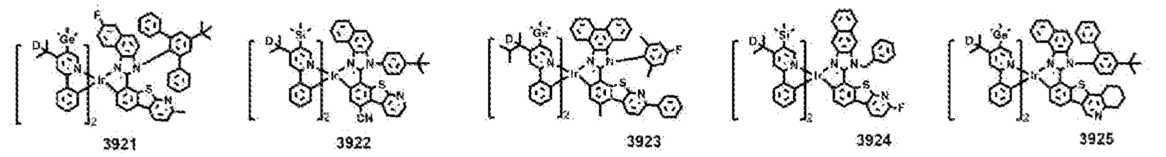
3921 3922 3923 3924 3925
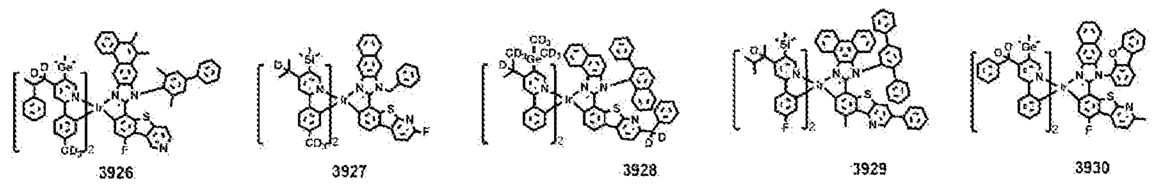
3926 3927 3928 3929 3930
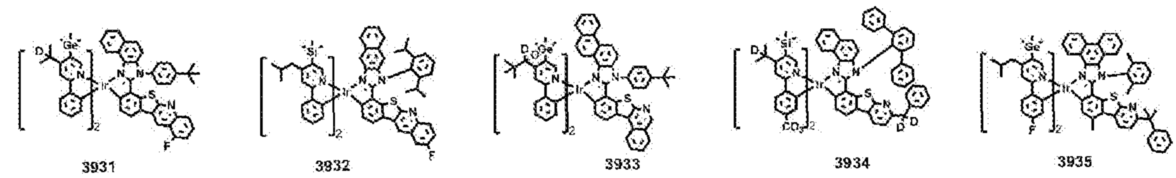
3931 3932 3933 3934 3935

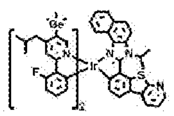
3936
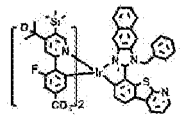
3937
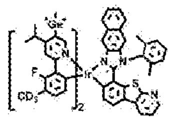
3938
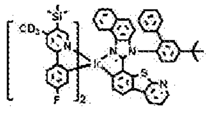
3939
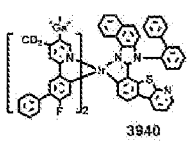
3940
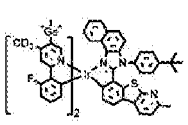
3941
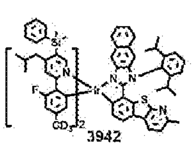
3942
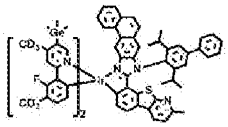
3943
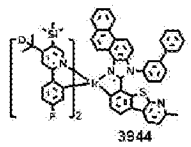
3944
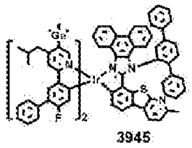
3945
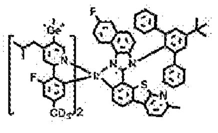
3946
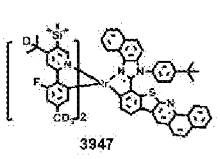
3947
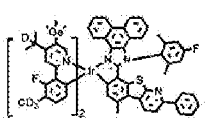
3948
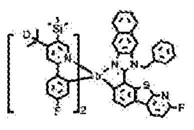
3949
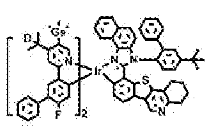
3950
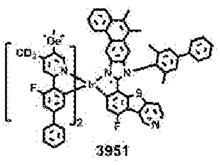
3951
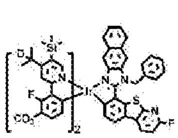
3952
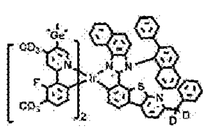
3953
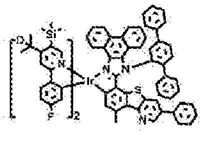
3954
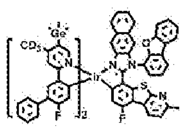
3955
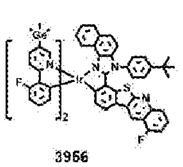
3956
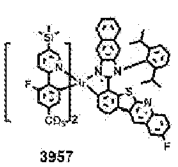
3957
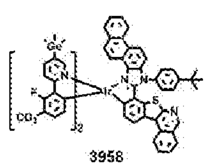
3958
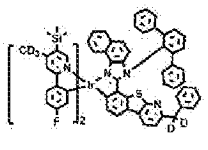
3959
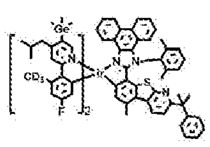
3960
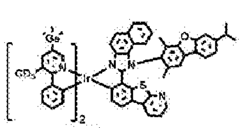
3961
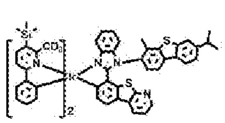
3962
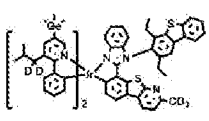
3963
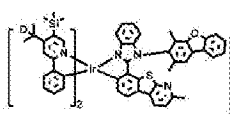
3964
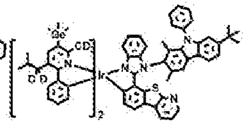
3965
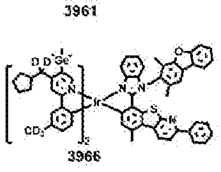
3966
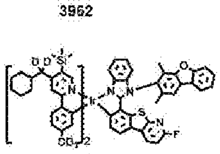
3967
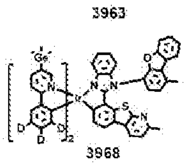
3968
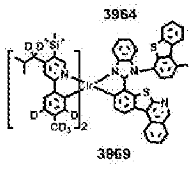
3969
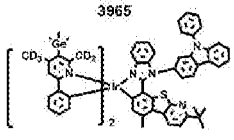
3970
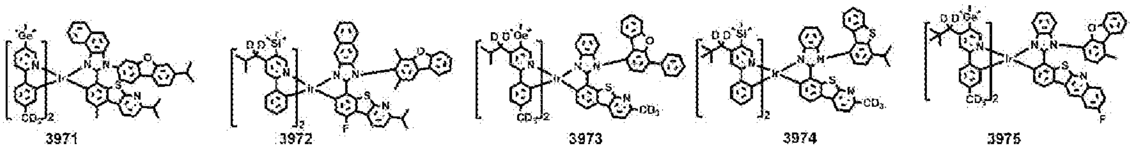
3971 3972 3973 3974 3975
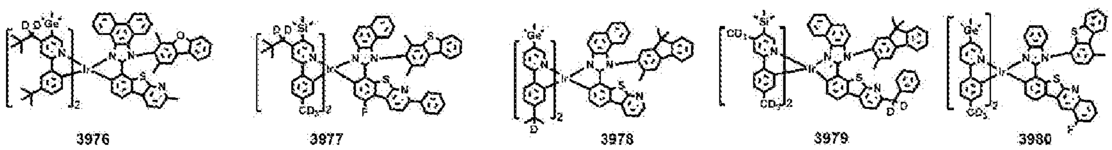
3976 3977 3978 3979 3980
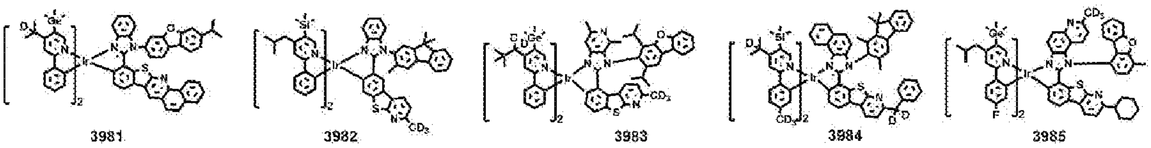
3981 3982 3983 3984 3985

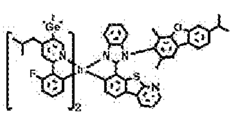
3986
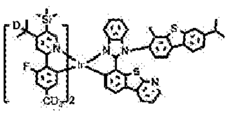
3987
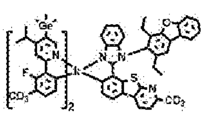
3988
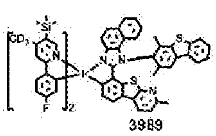
3989
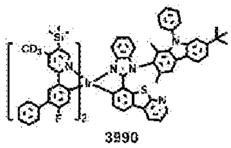
3990

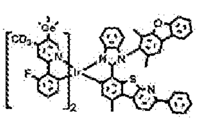
3991
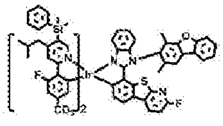
3992
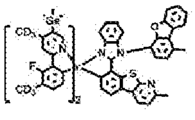
3993
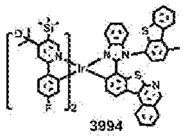
3994
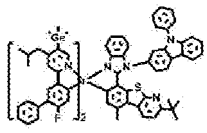
3995

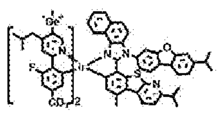
3996
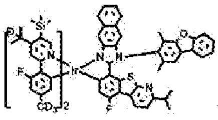
3997
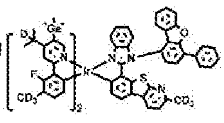
3998
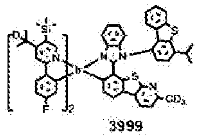
3999
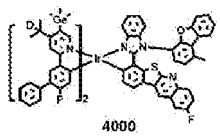
4000

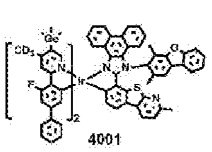
4001
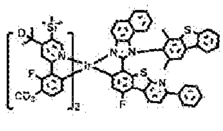
4002
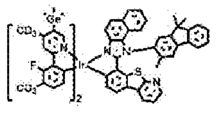
4003
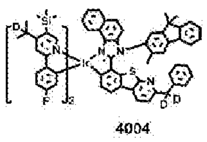
4004
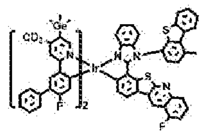
4005

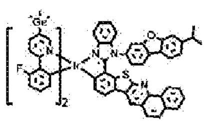
4006
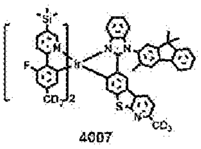
4007
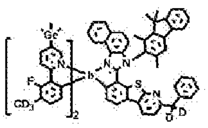
4008
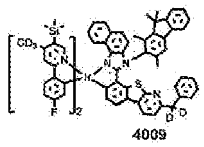
4009
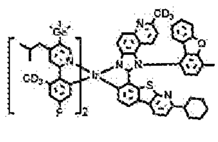
4010

## Group G1-8

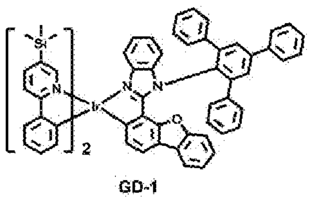
GD-1
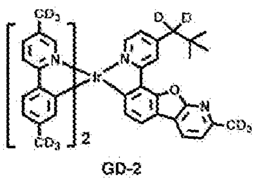
GD-2

.

In one or more embodiments, the first compound and the second compound may each independently be one of compounds of Groups R1-1 to R1-8:

## Group R1-1

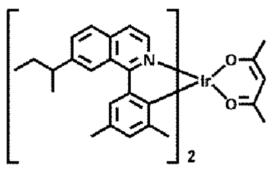
1
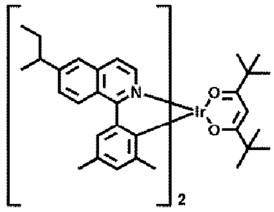
2
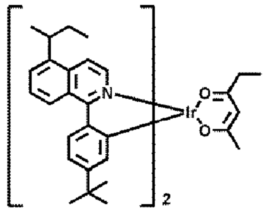
3
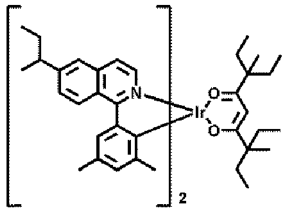
4

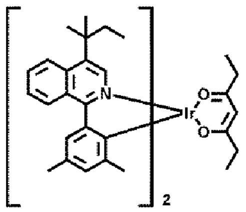
5
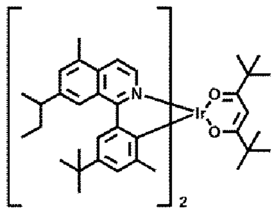
6
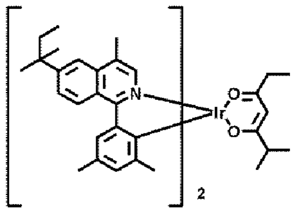
7
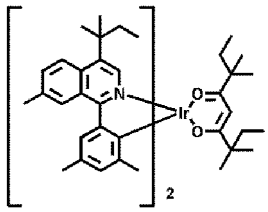
8

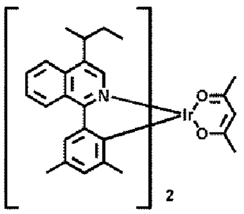
9
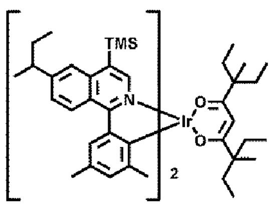
10
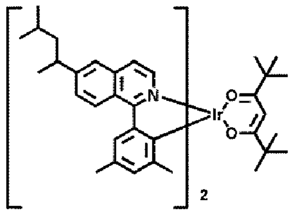
11
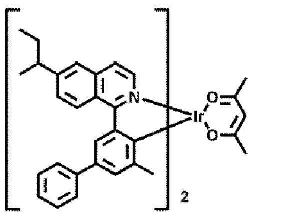
12

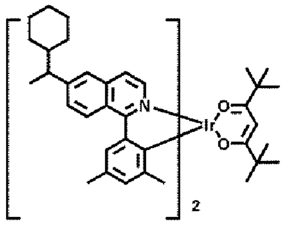
13
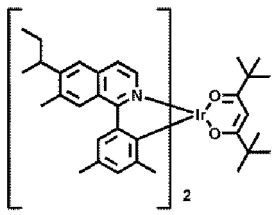
14
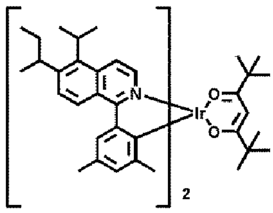
15
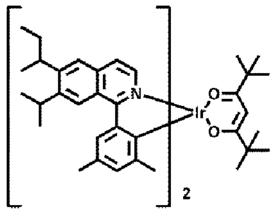
16

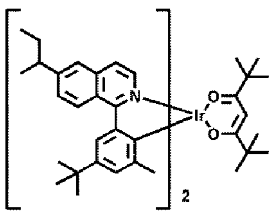
17
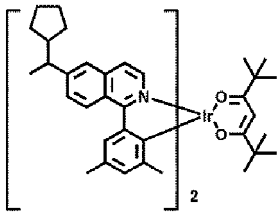
18
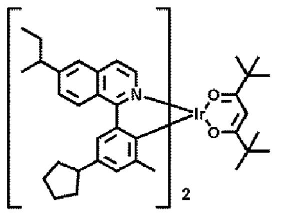
19
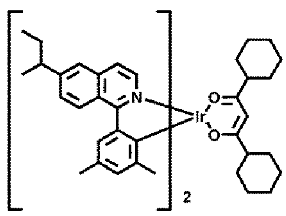
20

## Group R1-2

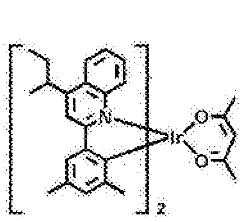

1

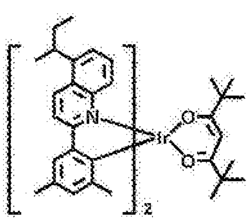

2

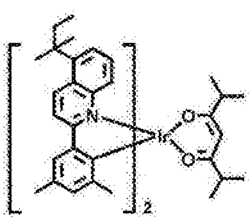

3

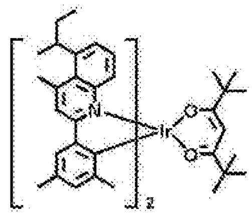

4

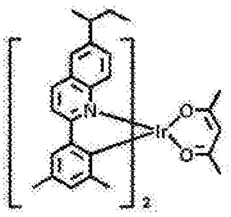

5

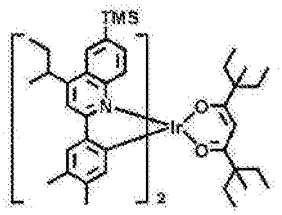

6

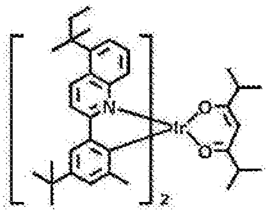

7

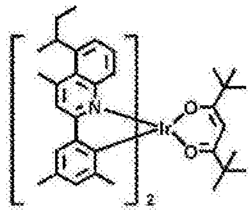

8

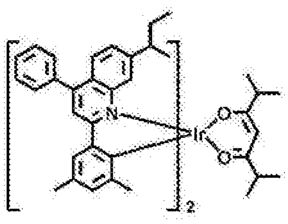

9

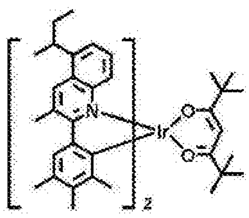

10

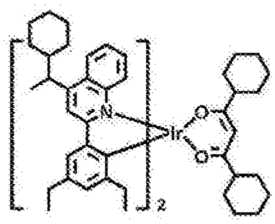

11

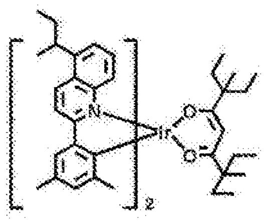

12

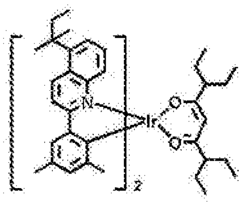

13

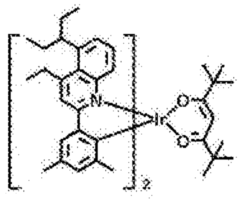

14

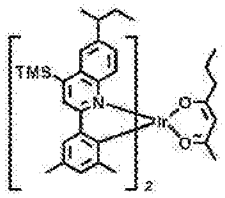

15

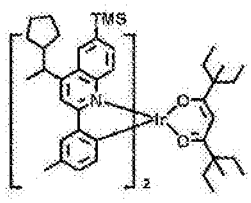

16

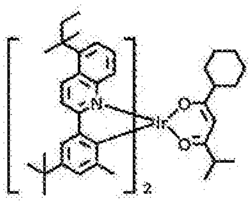

17

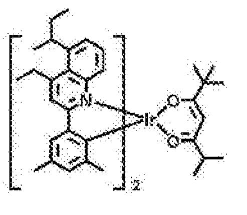

18

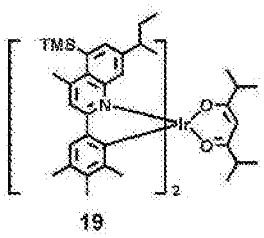

19

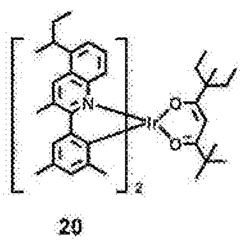

20

Group R1-3

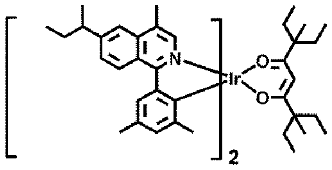

1

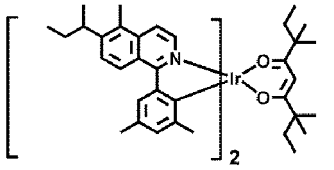

2

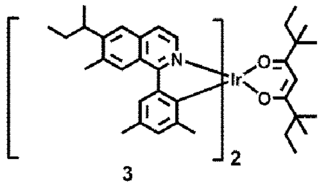

3

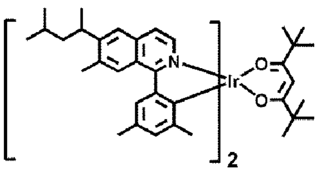

4

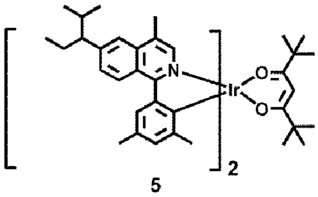

5

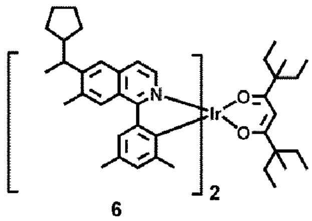

6

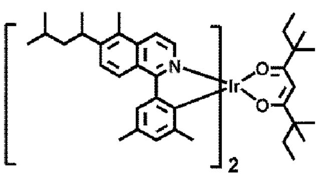

7

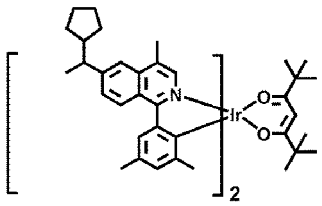

8

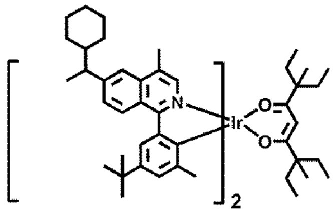

9

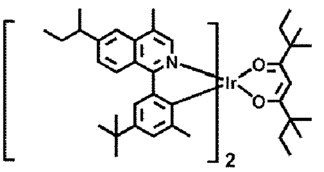

10

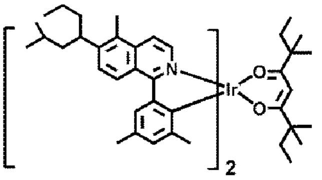

11

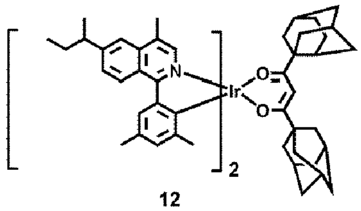

12

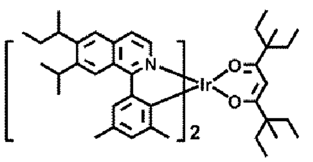

13

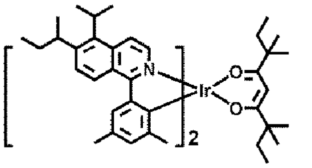

14

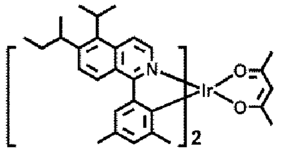

15

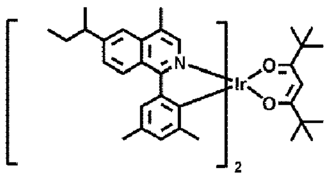

16

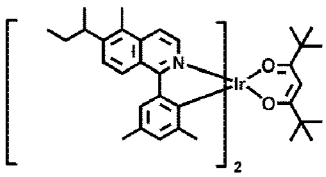

17

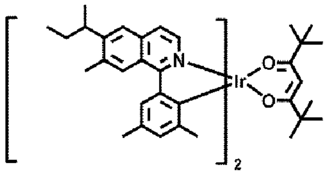

18

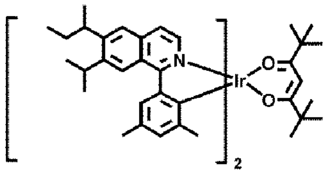

19

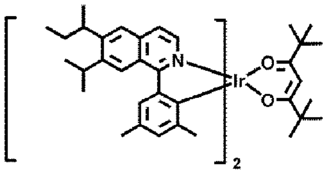

20

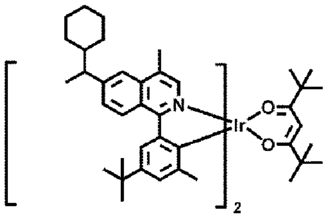

21

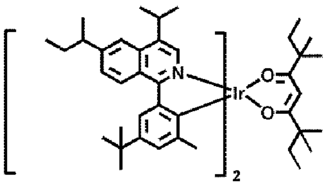

22

## Group R1-4

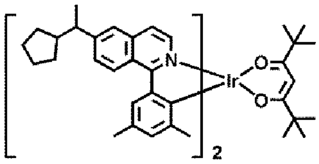

1

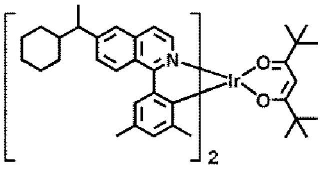

2

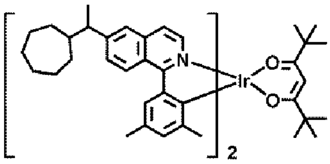

3

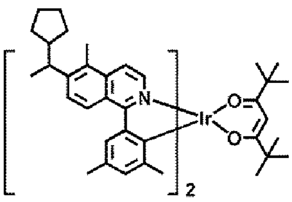

4

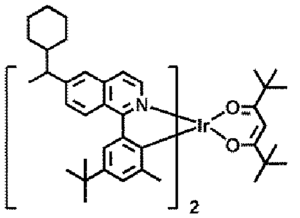

5

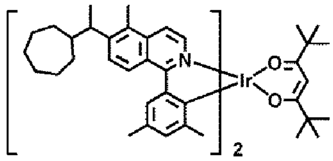

6

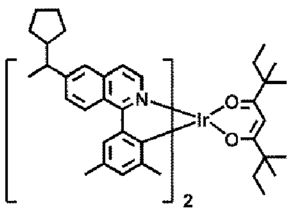

7

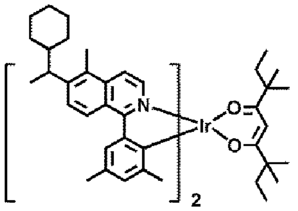

8

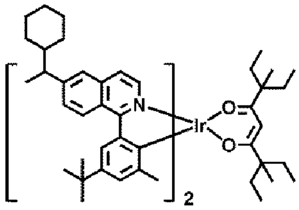

9

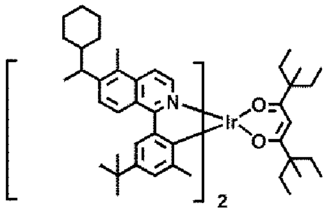

10

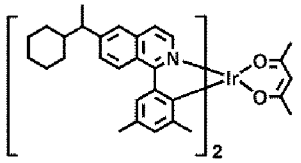

11

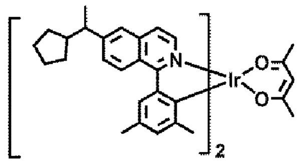

12

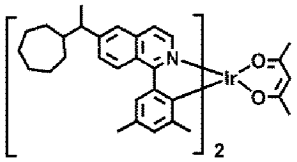

13

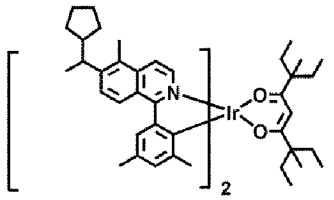

14

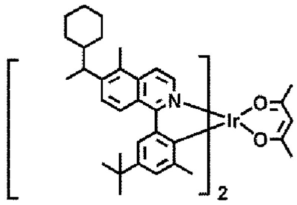

15

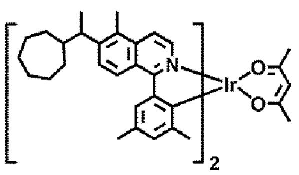

16

## Group R1-5

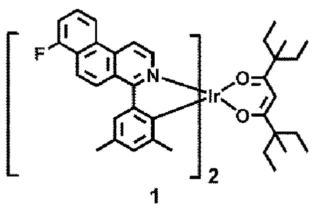

1

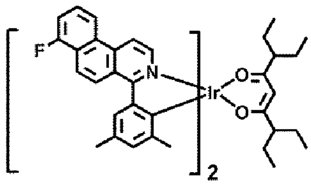

2

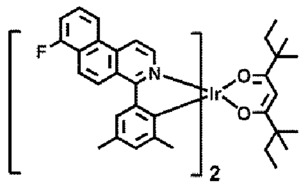

3

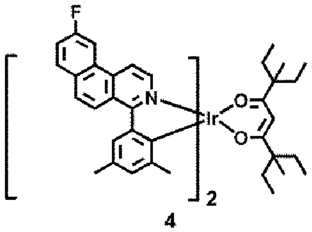

4

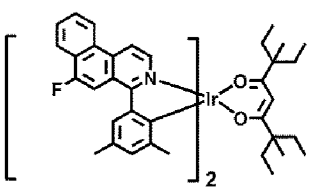

5

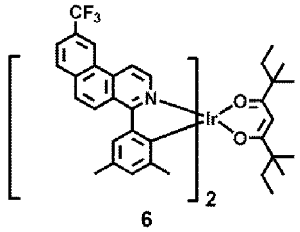

6

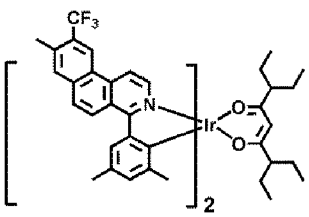

7

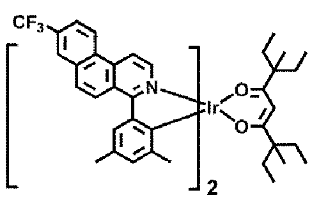

8

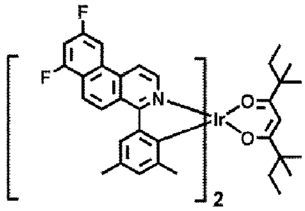

9

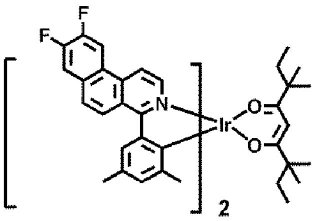
10

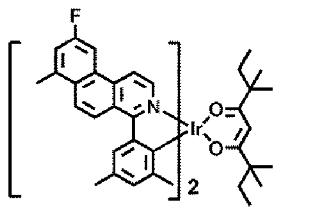
11

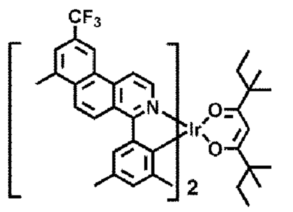
12

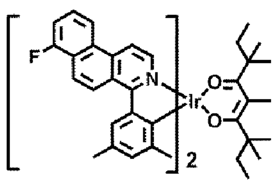
13

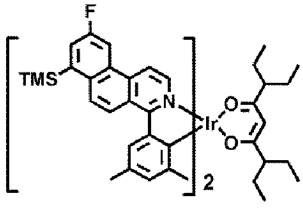
14

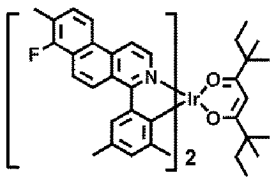
15

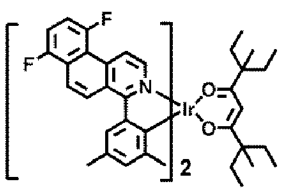
16

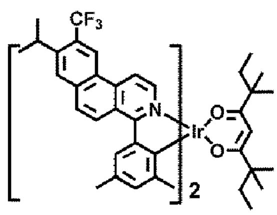
17

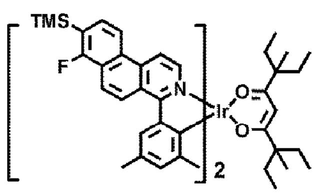
18

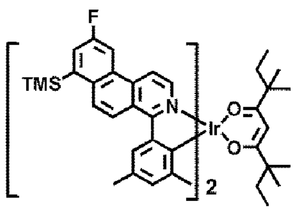
19

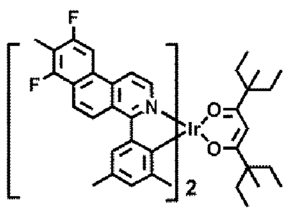
20

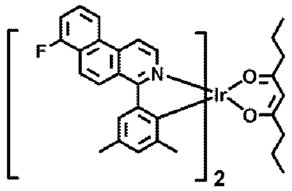
21

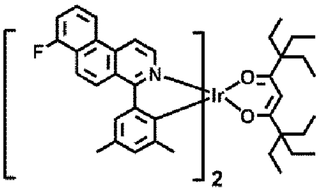
22

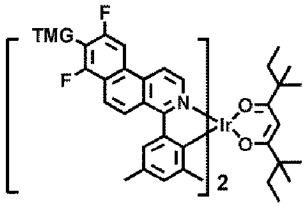
23

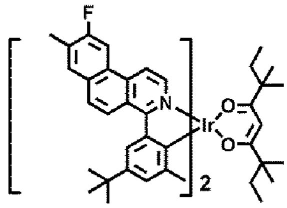
24

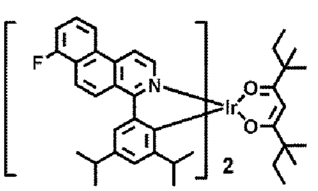
25

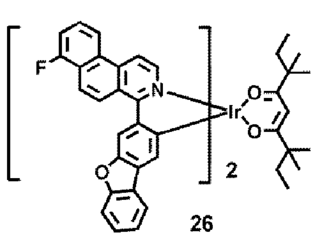
26

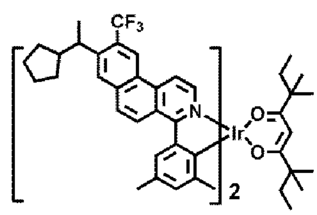
27

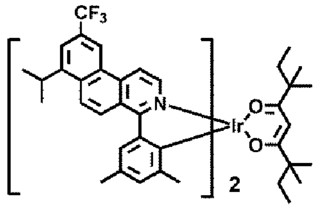

28

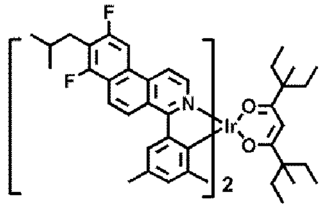

29

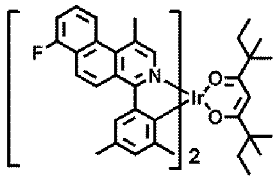

30

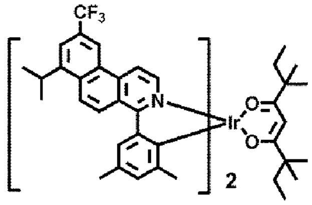

28

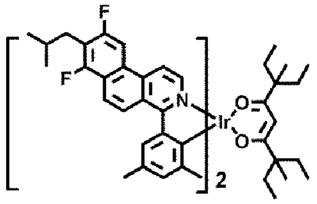

29

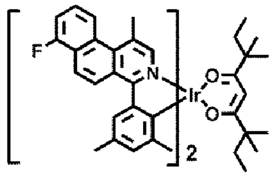

30

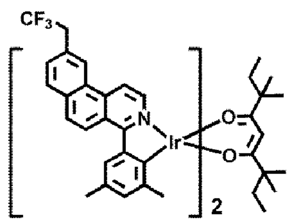

31

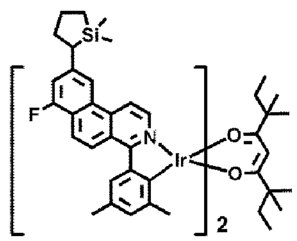

32

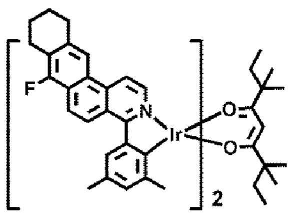

33

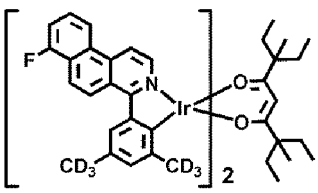

34

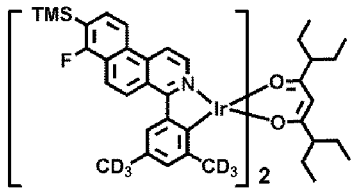

35

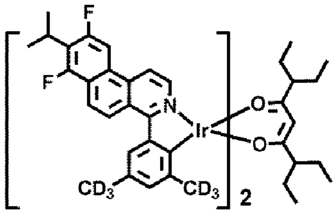

36

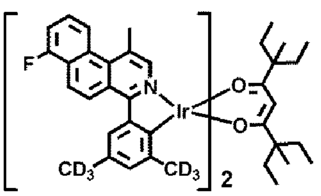

37

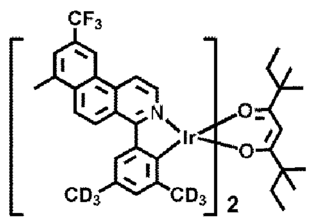

38

Group R1-6

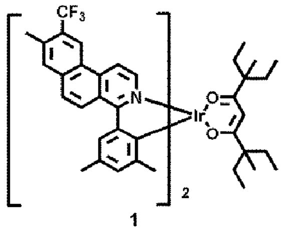
1

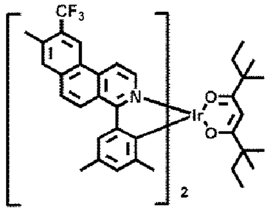
2

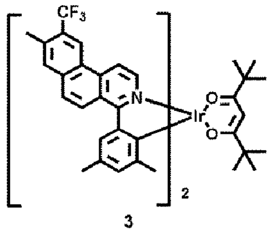
3

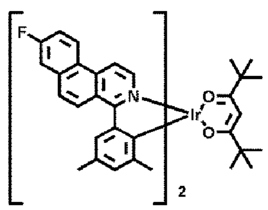
4

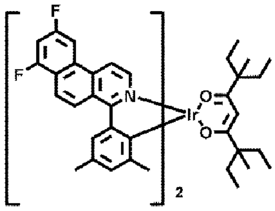
5

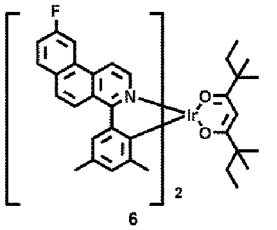
6

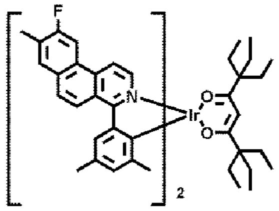
7

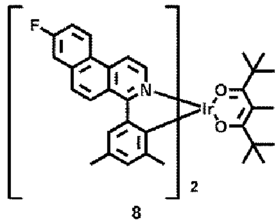
8

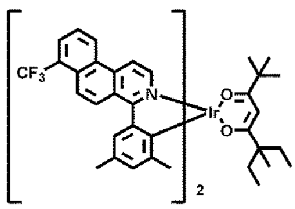
9

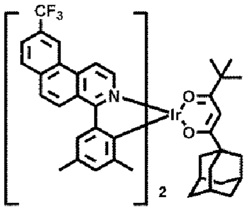
10

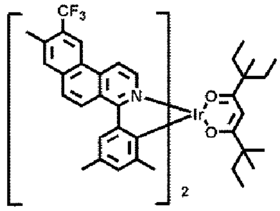
11

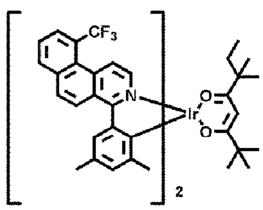
12

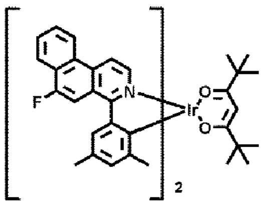
13

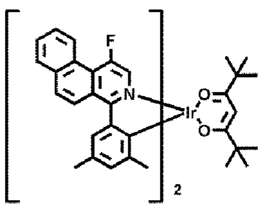
14

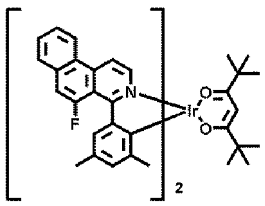
15

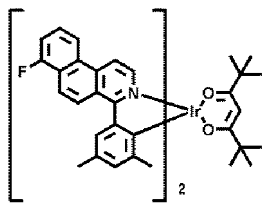
16

Group R1-7

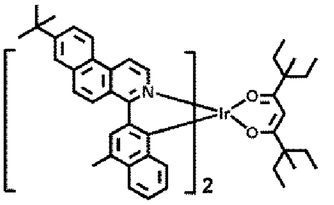

1

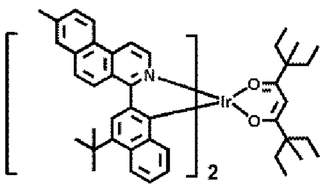

2

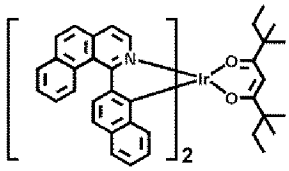

3

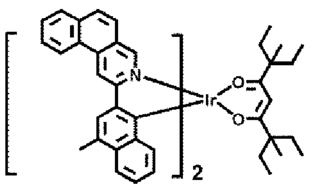

4

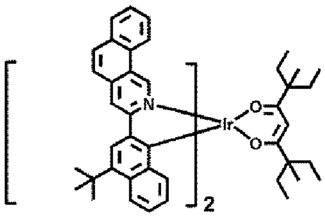

5

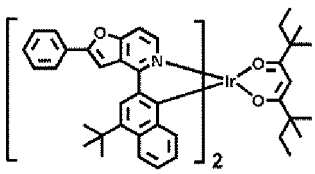

6

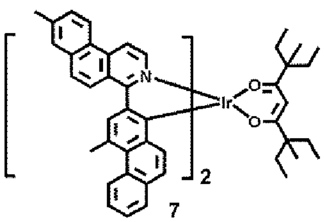

7

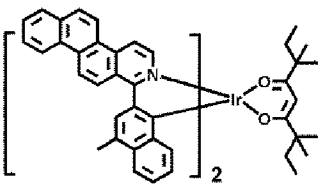

8

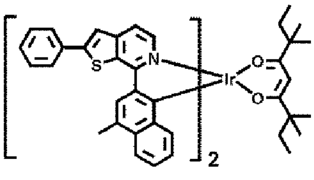

9

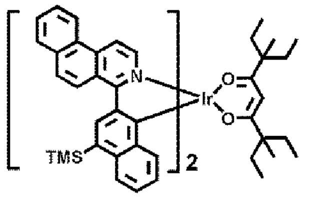

10

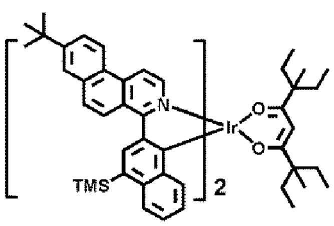

11

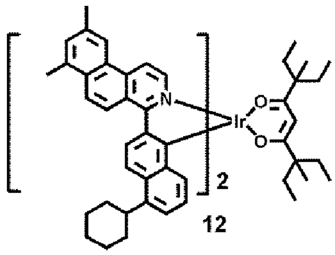

12

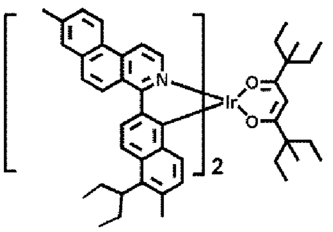

13

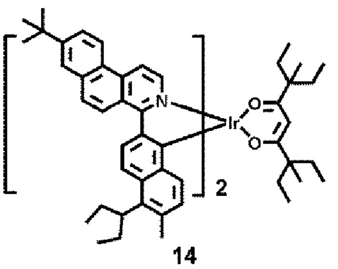

14

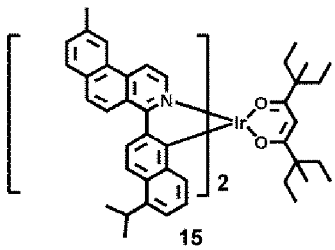

15

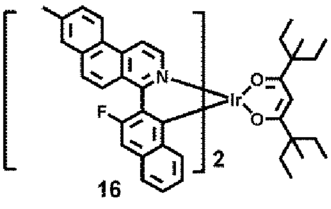

16

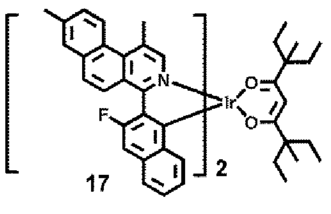

17

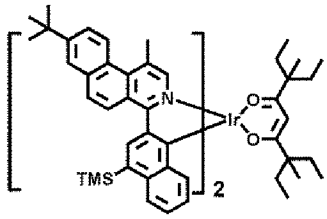

18

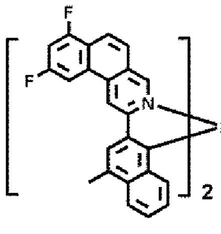

19

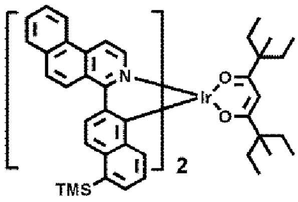

20

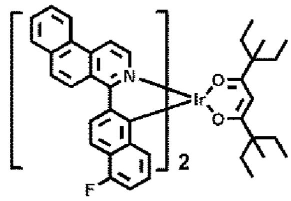

21

Group R1-8

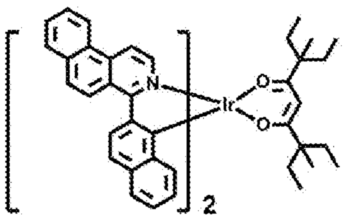

RD-1

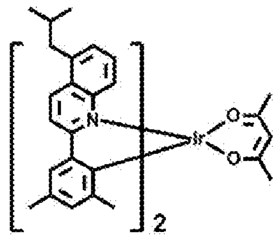

RD-2

.

The composition as described above may emit light having excellent luminescence efficiency and lifespan (for example, blue light, green light, or red light). Accordingly, a layer including the composition, a light-emitting device including the composition, and an electronic apparatus including the light-emitting device may be provided.

According to another aspect, provided is a layer including the composition as described above.

In an embodiment, the layer may emit light having an emission peak wavelength in a range of about 480 nm to about 580 nm, for example, about 500 nm to about 570 nm.

In an embodiment, the layer may emit green light, yellowish green light, or yellow light.

In one or more embodiments, the layer may emit light having an emission peak wavelength in a range of about 510 nm to about 540 nm.

In one or more embodiments, the layer may emit light having an emission peak wavelength in a range of about 540 nm to about 570 nm.

In one or more embodiments, the layer may emit light having an emission peak wavelength in a range of about 570 nm to about 650 nm.

In an embodiment, the layer may emit red light.

In one or more embodiments, the layer may emit light having an emission peak wavelength in a range of about 400 nm to about 500 nm.

In an embodiment, the layer may emit blue light.

In one or more embodiments, the layer may not emit white light.

A weight ratio of the first compound to the second compound included in the layer may be in a range of about 90:10 to about 10:90, about 80:20 to about 20:80, about 70:30 to about 30:70, or about 60:40 to about 40:60.

In an embodiment, the weight ratio of the first compound to the second compound may be about 50:50, that is, 1:1.

The layer may be formed i) by co-deposition of the first compound and the second compound, or ii) by using a first mixture including the first compound and the second compound.

In one or more embodiments, the layer may include a host and a dopant, the host may not include a transition metal, and the dopant may include the composition including the first compound and the second compound. The layer may be formed i) by co-deposition of the host and the dopant, or ii) by using a second mixture including the host and the dopant.

A weight of the host in the layer may be greater than a weight of the dopant.

In an embodiment, a weight ratio of the host to the dopant in the layer may be in a range of about 99:1 to about 55:45, about 97:3 to about 60:40, or about 95:5 to about 70:30.

The host in the layer may include a hole-transporting compound, an electron-transporting compound, a bipolar compound, or a combination thereof.

According to another aspect, provided is a light-emitting device including a first electrode; a second electrode; and an organic layer including an emission layer located between the first electrode and the second electrode, wherein the organic layer includes the composition as described above.

Since the light-emitting device includes the composition including the first compound and the second compound

as described above, the light-emitting device may have excellent driving voltage, excellent external quantum efficiency, and excellent lifespan characteristics. In addition, the light-emitting device may have an excellent side luminance ratio.

In an embodiment, the emission layer in the organic layer of the light-emitting device may include the composition including the first compound and the second compound.

In one or more embodiments, the emission layer may include a host and a dopant, the host may not include a transition metal, and the dopant may include the composition.

The host in the emission layer may include a hole-transporting compound, an electron-transporting compound, a bipolar compound, or a combination thereof.

In an embodiment, the host may include a hole-transporting compound and an electron-transporting compound, and the hole-transporting compound and the electron-transporting compound may be different from each other.

The emission layer may be formed by co-deposition of the host and the dopant, or by using a second mixture including the host and the dopant.

The emission layer may emit third light having a third spectrum, and λP(EML) indicates an emission peak wavelength (nm) in the third spectrum. In an embodiment, λP(EML) may be evaluated from an electroluminescence spectrum of the light-emitting device.

Fourth light having a fourth spectrum may be extracted to the outside of the light-emitting device through the first electrode and/or the second electrode of the light-emitting device, and λP(OLED) indicates an emission peak wavelength (nm) in the fourth spectrum. In an embodiment, λP(OLED) may be evaluated from an electroluminescence spectrum of the light-emitting device.

In an embodiment, λP(EML) and AP(OLED) may each independently be in a range of about 500 nm to about 570 nm.

In one or more embodiments, λP(EML) and λP(OLED) may each independently be in a range of about 510 nm to about 540 nm.

In one or more embodiments, λP(EML) and AP(OLED) may each independently be in a range of about 540 nm to about 570 nm.

In one or more embodiments, the third light and the fourth light may each be green light, yellowish green light, or yellow light.

In one or more embodiments, λP(EML) and AP(OLED) may each independently be in a range of about 570 nm to about 650 nm.

In one or more embodiments, the third light and the fourth light may each be red light.

In one or more embodiments, λP(EML) and λP(OLED) may each independently be in a range of about 400 nm to about 500 nm.

In one or more embodiments, the third light and the fourth light may each be blue light.

In one or more embodiments, the third light and the fourth light may not be white light.

In one or more embodiments, the third spectrum i) may include a main emission peak having λP(EML) in a range of about 500 nm to about 570 nm, and ii) may not include an additional emission peak having an emission peak wavelength greater than or equal to AP(EML) + 50 nm, or less than or equal to λP(EML) - 50 nm.

In one or more embodiments, the third spectrum i) may include a main emission peak having λP(EML) in a range of about 500 nm to about 570 nm, and ii) may not include an additional emission peak having an emission peak wavelength of red light and/or blue light region.

In one or more embodiments, the fourth spectrum i) may include a main emission peak having λP(OLED) in a range of about 500 nm to about 570 nm, and ii) may not include an additional emission peak having an emission peak wavelength greater than or equal to AP(OLED) + 50 nm, or less than or equal to AP(OLED) - 50 nm.

In one or more embodiments, the fourth spectrum i) may include a main emission peak having λP(OLED) in a range of about 500 nm to about 570 nm, and ii) may not include an additional emission peak having an emission peak wavelength of red light and/or blue light region.

In one or more embodiments, the third spectrum i) may include a main emission peak having λP(EML) in a range of about 570 nm to about 650 nm, and ii) may not include an additional emission peak having an emission peak wavelength greater than or equal to AP(EML) + 50 nm, or less than or equal to λP(EML) - 50 nm.

In one or more embodiments, the third spectrum i) may include a main emission peak having AP(EML) in a range of about 570 nm to about 650 nm, and ii) may not include an additional emission peak having an emission peak wavelength of green light and/or blue light region.

In one or more embodiments, the fourth spectrum i) may include a main emission peak having AP(OLED) in a range of about 570 nm to about 650 nm, and ii) may not include an additional emission peak having an emission peak wavelength greater than or equal to λP(OLED) + 50 nm, or less than or equal to λP(OLED) - 50 nm.

In one or more embodiments, the fourth spectrum i) may include a main emission peak having λP(OLED) in a range of about 570 nm to about 650 nm, and ii) may not include an additional emission peak having an emission peak wavelength of green light and/or blue light region.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode may be an anode, the second electrode may be a cathode, the organic layer may further include a hole transport region located between the first electrode and the emission layer and an electron transport region located between the emission layer and the second electrode, the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

The FIGURE is a schematic cross-sectional view of an organic light-emitting device 10 according to an embodiment. Hereinafter, the structure and manufacturing method of the organic light-emitting device 10 according to an embodiment of the present disclosure will be described in connection with the FIGURE. The organic light-emitting device 10 has a structure in which a first electrode 11, an organic layer 15, and a second electrode 19 are sequentially stacked.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

In an embodiment, the first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. In an embodiment, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer, or a hole transport layer. In one or more embodiments, the hole transport region may have a hole injection layer/hole transport layer structure, or a hole injection layer/hole transport layer/electron blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (L-B) deposition.

When the hole injection layer is formed by vacuum deposition, the deposition conditions may vary according to a material that is used to form the hole injection layer, and a structure and thermal properties of the hole injection layer. For example, a deposition temperature may be from about 100°C to about 500°C, a vacuum pressure may be from about $10^{-8}$ torr to about $10^{-3}$ torr, and a deposition rate may be from about 0.01 angstroms per second (Å/sec) to about 100 Å/sec.

When the hole injection layer is formed using spin coating, the coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C.

The conditions for forming the hole transport layer and the electron blocking layer may be similar to the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino)-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

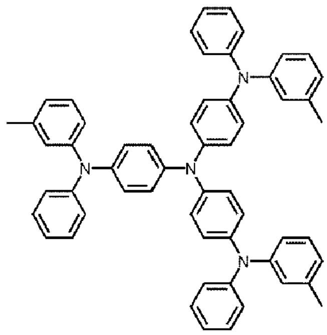

m-MTDATA

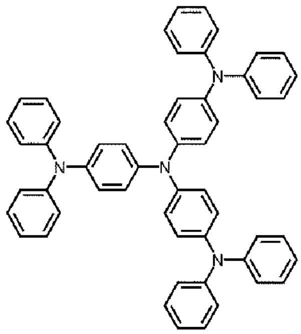

TDATA

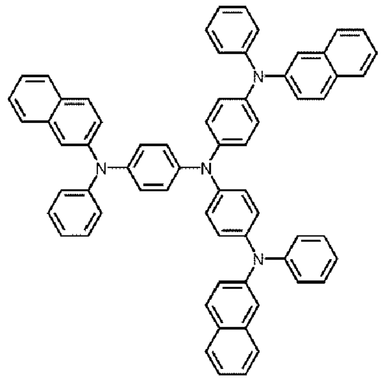

2-TNATA

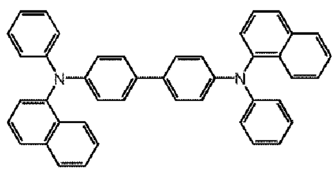

NPB

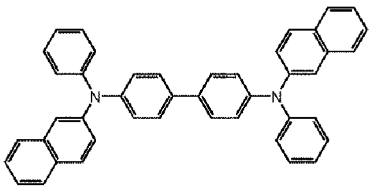

β-NPB

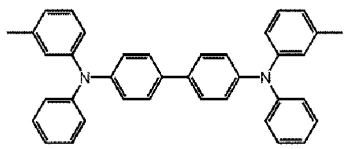

TPD

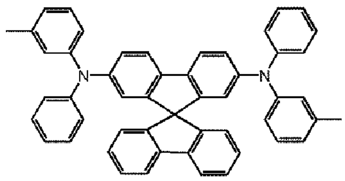

Spiro-TPD

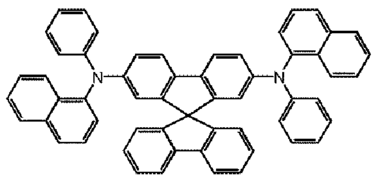

Spiro-NPB

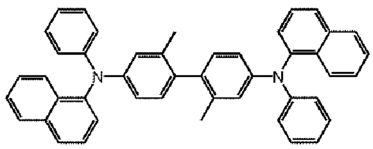

methylated NPB

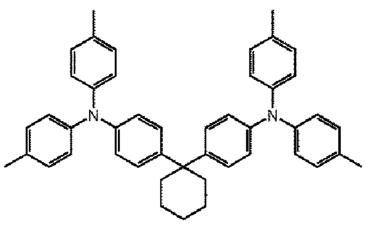

TAPC

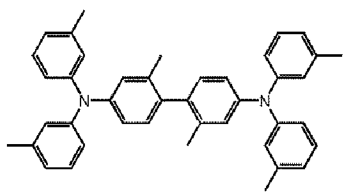

HMTPD

Formula 201

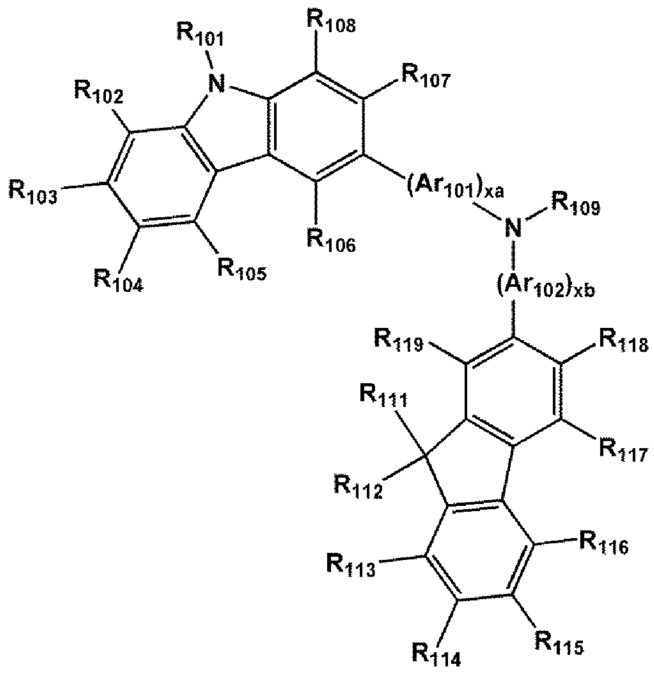

Formula 202

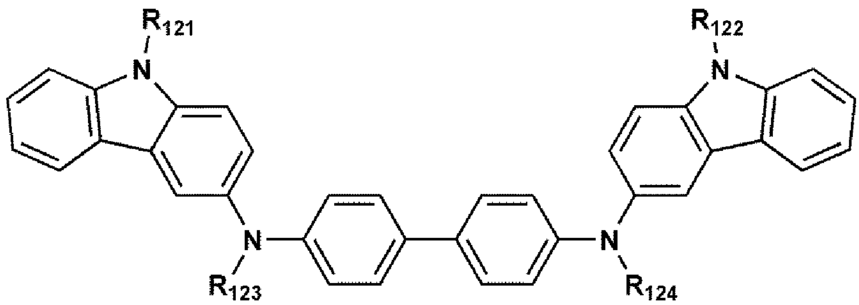

.

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, a hydroxyl group, a cyano group, a nitro group, an amino group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. In an embodiment, xa may be 1, and xb may be 0.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, a hydroxyl group, a cyano group, a nitro group, an amino group, a $C_1$-$C_{10}$ alkyl group (for example, a methyl group, an ethyl group, a propyl group, a butyl group, a pentyl group, a hexyl group, or the like), a $C_1$-$C_{10}$ alkoxy group (for example, a methoxy group, an ethoxy group, a propoxy group, a butoxy group, a pentoxy group, or the like), or a $C_1$-$C_{10}$ alkylthio group;

a $C_1$-$C_{10}$ alkyl group, a $C_1$-$C_{10}$ alkoxy group, or a $C_1$-$C_{60}$ alkylthio group, each unsubstituted or substituted with at least

one of deuterium, -F, -Cl, -Br, -I, a hydroxyl group, a cyano group, a nitro group, an amino group, or a combination thereof; or

a phenyl group, a naphthyl group, an anthracenyl group, a fluorenyl group, or a pyrenyl group, each unsubstituted or substituted with at least one of deuterium, -F, -Cl, -Br, -I, a hydroxyl group, a cyano group, a nitro group, an amino group, a $C_1$-$C_{10}$ alkyl group, a $C_1$-$C_{10}$ alkoxy group, a $C_1$-$C_{10}$ alkylthio group, or a combination thereof.

$R_{109}$ in Formula 201 may be a phenyl group, a naphthyl group, an anthracenyl group, or a pyridinyl group, each unsubstituted or substituted with at least one of deuterium, -F, -Cl, -Br, -I, a hydroxyl group, a cyano group, a nitro group, an amino group, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one embodiment, the compound represented by Formula 201 may be represented by Formula 201A:

Formula 201A

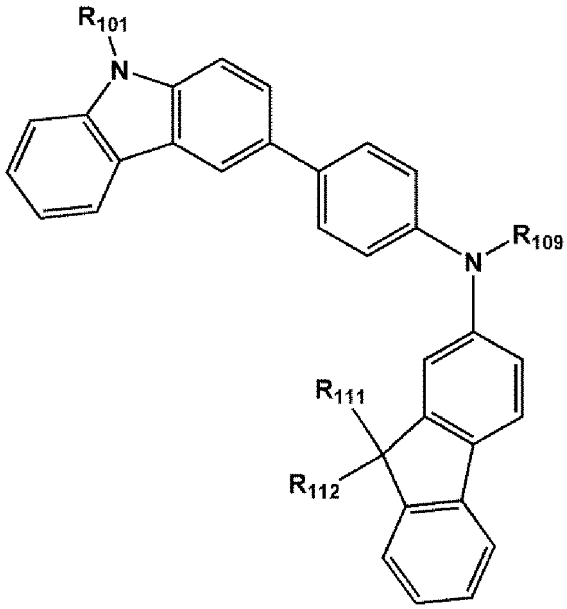

wherein, in Formula 201A, $R_{101}$, $R_{111}$, $R_{112}$, and $R_{109}$ are as described hereinabove.

In an embodiment, the hole transport region may include one of Compounds HT1 to HT21 or a combination thereof:

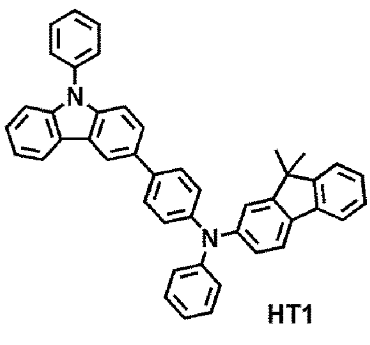

HT1

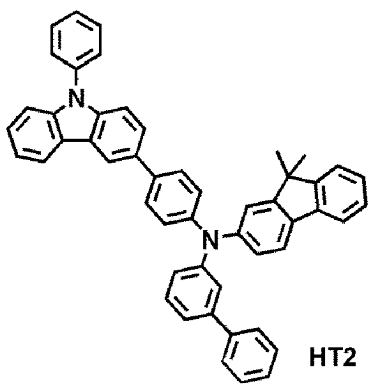

HT2

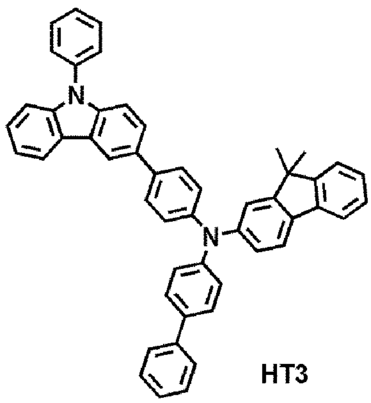

HT3

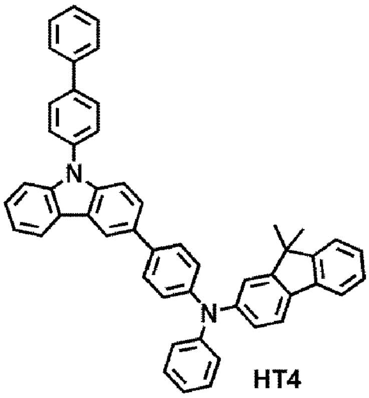
HT4

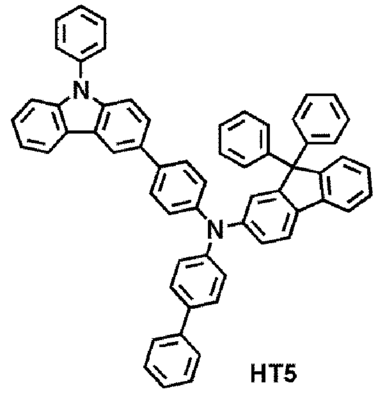
HT5

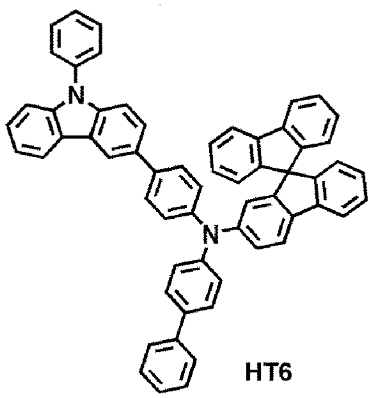
HT6

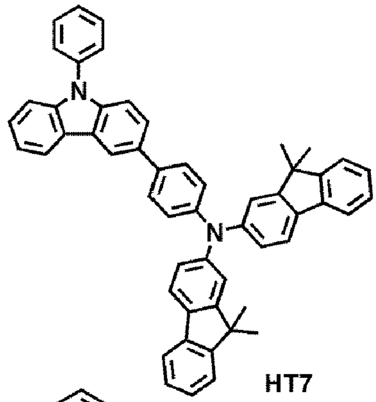
HT7

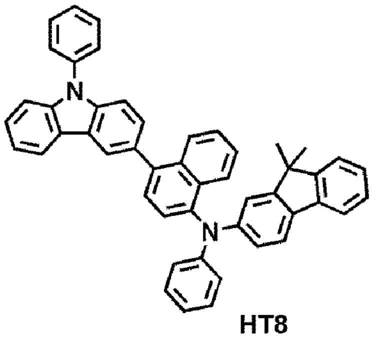
HT8

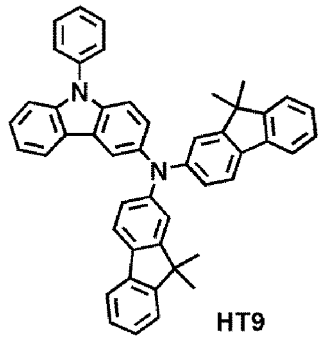
HT9

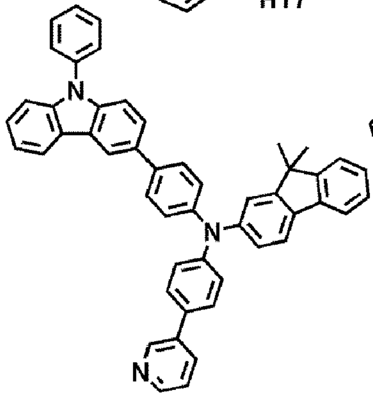
HT10

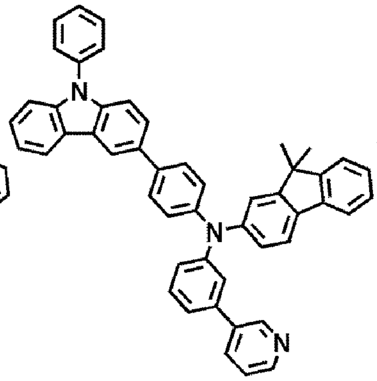
HT11

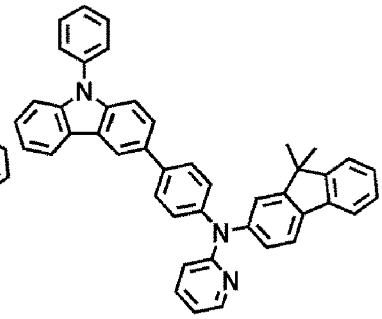
HT12

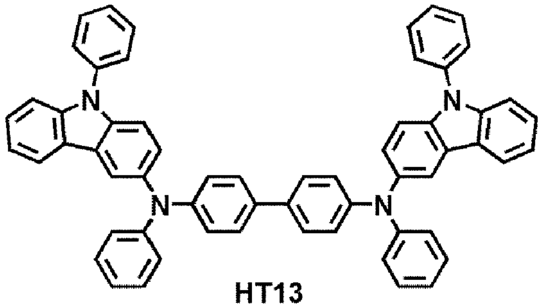
HT13

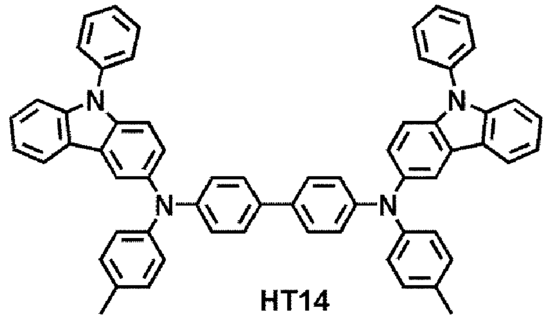
HT14

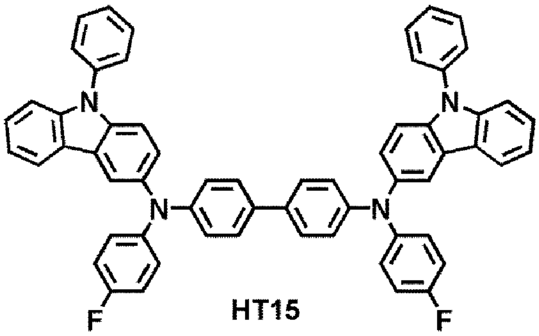

HT15

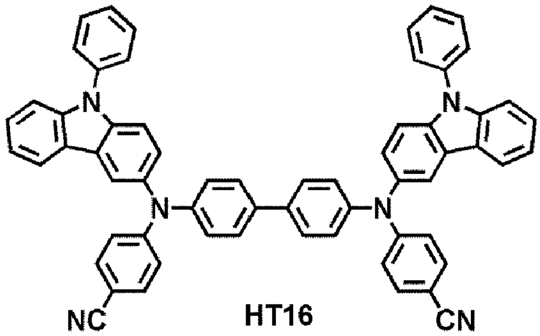

HT16

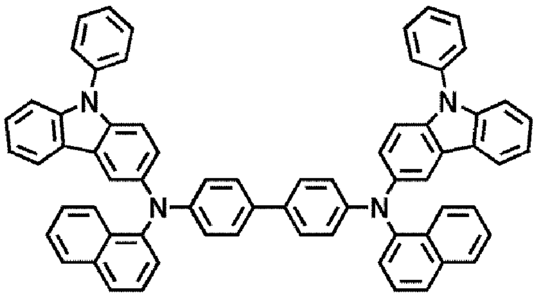

HT17

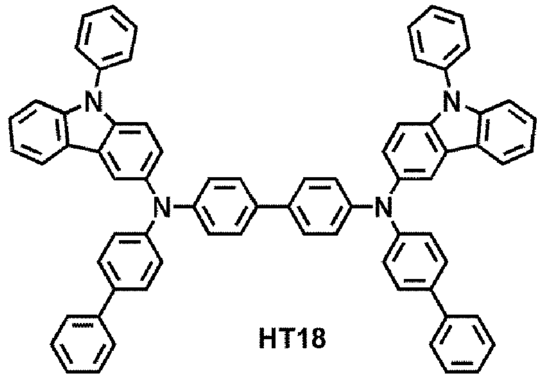

HT18

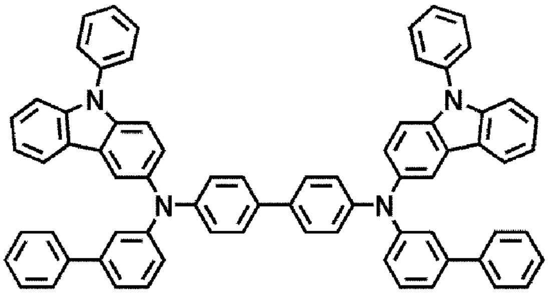

HT19

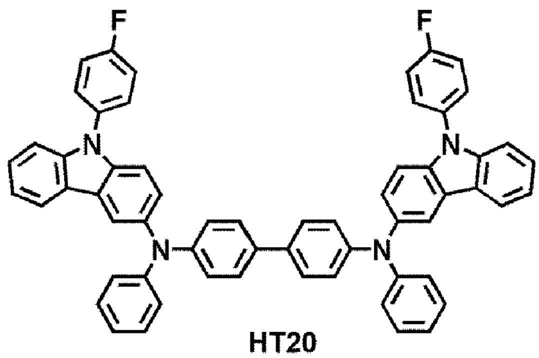

HT20

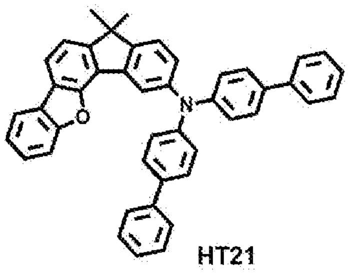

HT21

A thickness of the hole transport region may be in a range of about 100 Å to about 10,000 Å, for example, about 100 Å to about 1,000 Å. When the hole transport region includes a hole injection layer, a hole transport layer, an electron blocking layer, or a combination thereof, the thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole-transporting characteristics may be obtained without a substantial increase in driving voltage.

The hole transport region may further include, in addition to these materials, a charge-generation material to improve conductivity. The charge-generation material may be homogeneously or non-homogeneously dispersed in the

hole transport region.

The charge-generation material may be, for example, a p-dopant. The p-dopant may be a quinone derivative, a metal oxide, a cyano group-containing compound, or a combination thereof. In an embodiment, the p-dopant may be: a quinone derivative such as tetracyanoquinodimethane (TCNQ), 2,3,5,6-tetrafluoro-tetracyano-1,4-benzoquinonedimethane (F4-TCNQ), or F6-TCNNQ; a metal oxide, such as tungsten oxide or molybdenum oxide; a cyano group-containing compound, such as Compound HT-D1; or a combination thereof:

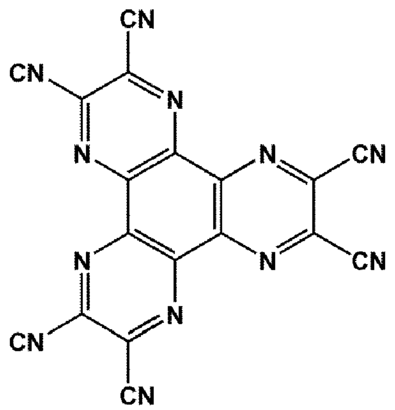

HT-D1

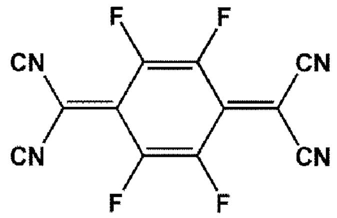

F4-TCNQ

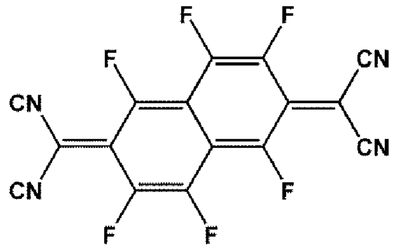

F6-TCNNQ

.

The hole transport region may further include a buffer layer.

The buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for forming the electron blocking layer may include a material that is used in the hole transport region as described above, a host material described below, or a combination thereof. In an embodiment, when the hole transport region includes an electron blocking layer, mCP described below, Compound H-H1, or a combination thereof may be used as the material for forming the electron blocking layer.

Then, an emission layer may be formed on the hole transport region by vacuum deposition, spin coating, casting, LB deposition, or the like. When the emission layer is formed by vacuum deposition or spin coating, deposition or coating conditions may be similar to those applied in forming the hole injection layer although the deposition or coating conditions may vary according to a material used to form the emission layer.

The emission layer may include the composition including the first compound and the second compound as described herein. In one or more embodiments, the emission layer may include a layer including the composition including the first compound and the second compound as described herein.

In an embodiment, the emission layer may include a host and a dopant, the host may not include a transition metal, and the dopant may include the composition including the first compound and the second compound as described herein.

The host may include 1,3,5-tri(1-phenyl-1H-benzo[d]imidazol-2-yl)phenyl (TPBi), 3-tert-butyl-9,10-di(naphth-2-yl)anthracene (TBADN), 9,10-di(naphthalene-2-yl)anthracene (ADN ; also referred to as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H-H1, Compound H-H2, Compound H52, or a combination thereof:

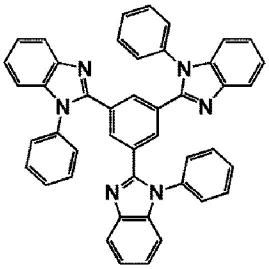

TPBi

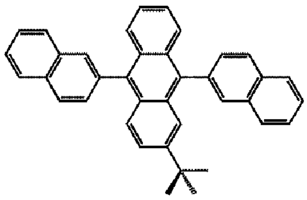

TBADN

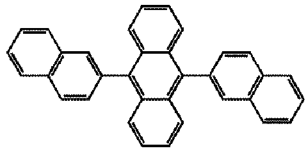

ADN

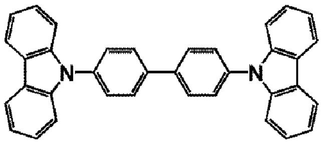

CBP

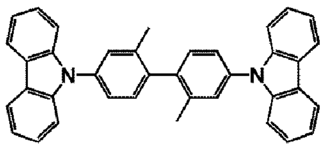

CDBP

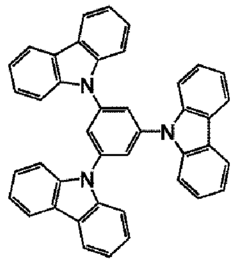

TCP

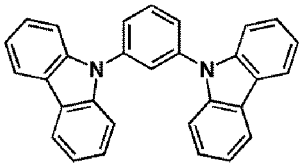

mCP

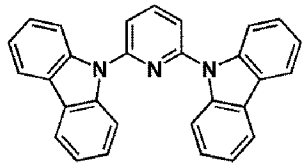

H50

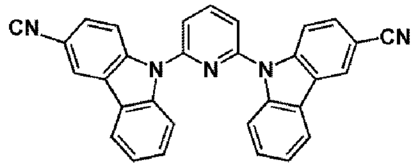

H51

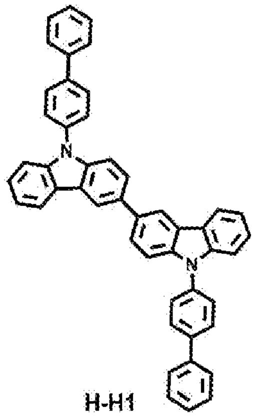

H-H1

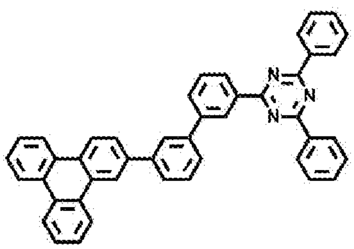

H-H2

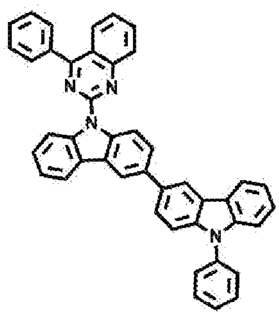

H52

.

When the organic light-emitting device is a full-color organic light-emitting device, the emission layer may be patterned into a red emission layer, a green emission layer, and/or a blue emission layer.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

An electron transport region may be located on the emission layer.

The electron transport region may include a hole blocking layer, an electron transport layer, an electron injection layer, or a combination thereof.

In an embodiment, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which

constitute the electron transport region may be understood by referring to the conditions for forming the hole injection layer.

When the electron transport region includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (Balq), or a combination thereof:

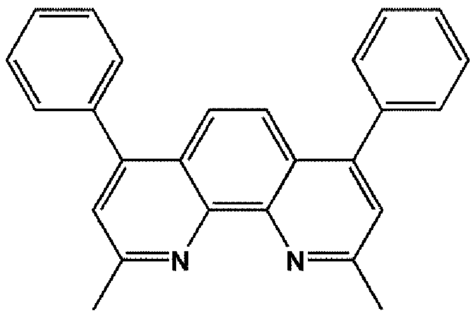

BCP

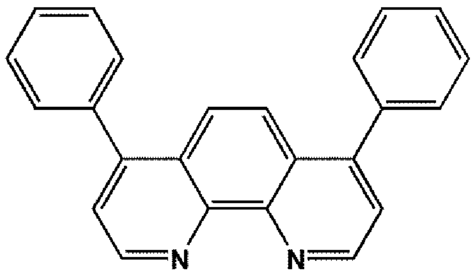

Bphen

.

A thickness of the hole blocking layer may be in a range of about 20 Å to about 1,000 Å, for example, about 30 Å to about 600 Å. When the thickness of the hole blocking layer is within the range described above, excellent hole blocking characteristics may be obtained without a substantial increase in driving voltage.

The electron transport layer may include BCP, 4,7-diphenyl-1,10-phenanthroline (Bphen), TPBi, tris(8-hydroxyquinolino)aluminum ($Alq_3$), Balq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

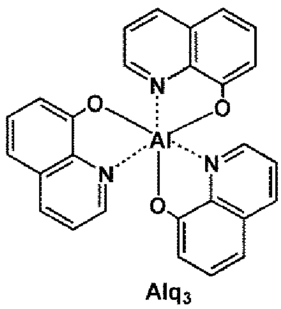

$Alq_3$

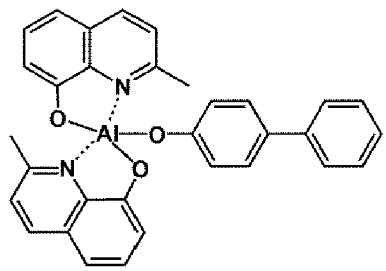

BAlq

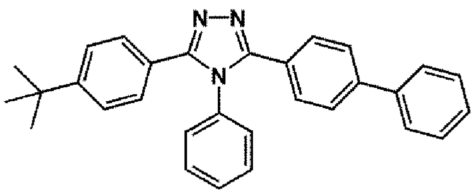

TAZ

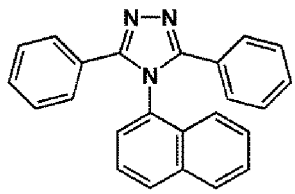

NTAZ

.

In one or more embodiments, the electron transport layer may include one of Compounds ET1 to ET25 or a combination thereof:

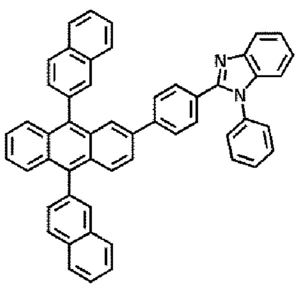

ET1

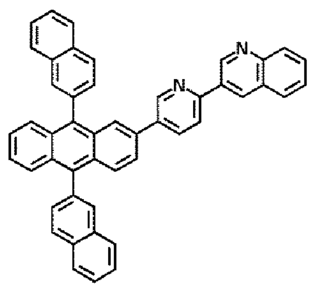

ET2

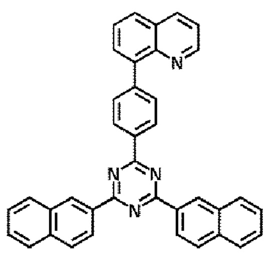

ET3

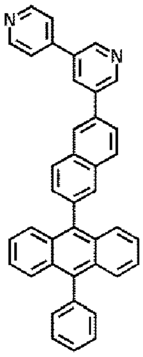

ET4

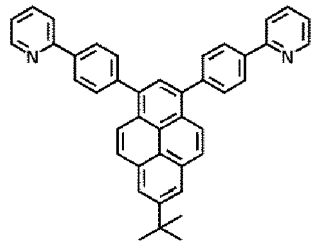

ET5

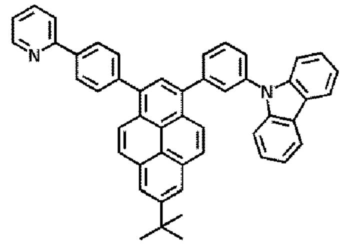

ET6

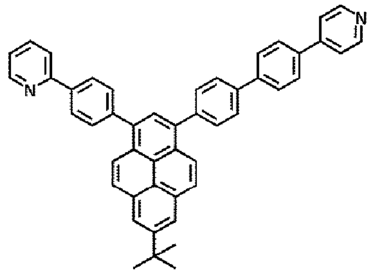

ET7

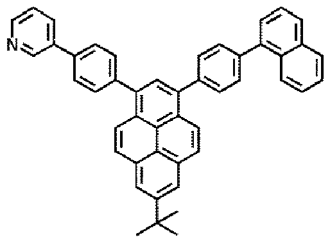

ET8

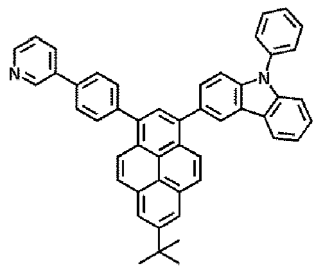

ET9

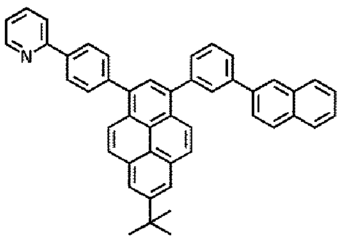

ET10

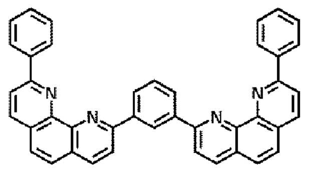

ET11

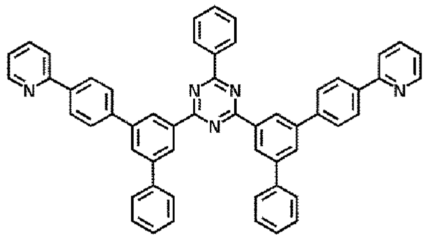

ET12

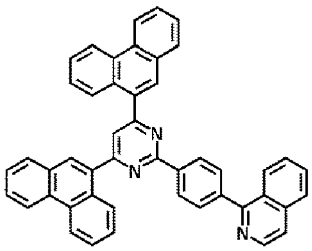

ET13

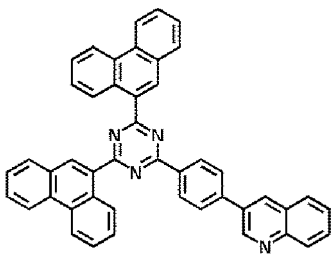

ET14

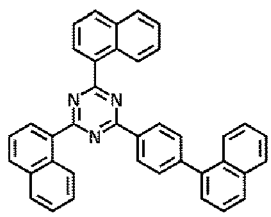

ET15

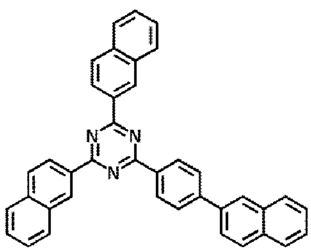

ET16

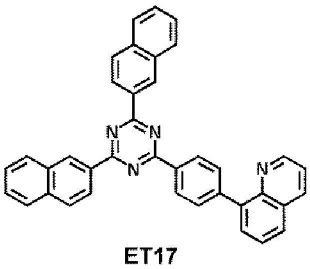

ET17

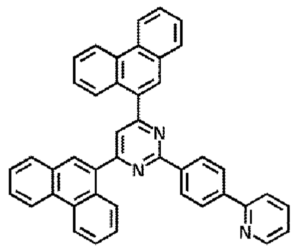

ET18

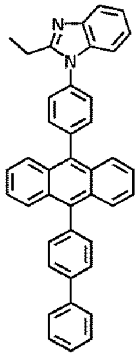
ET19

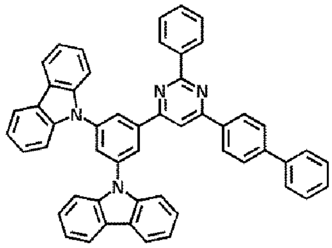
ET20

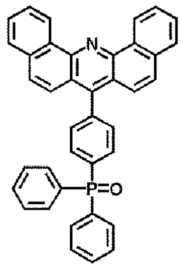
ET21

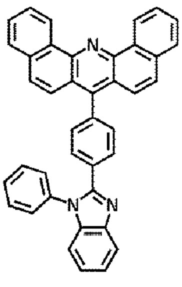
ET22

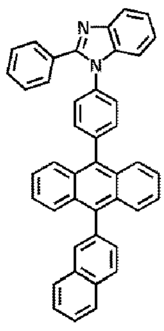
ET23

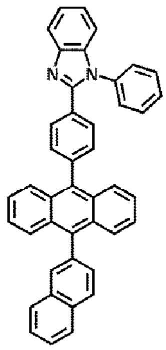
ET24

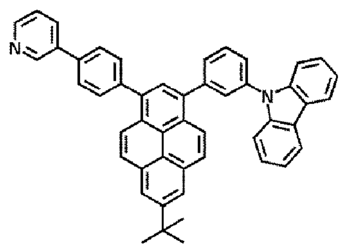
ET25

.

A thickness of the electron transport layer may be in a range of about 100 Å to about 1,000 Å, for example, about 150 Å to about 500 Å. When the thickness of the electron transport layer is within the range described above, satisfactory electron transporting characteristics may be obtained without a substantial increase in driving voltage.

The electron transport layer may further include, in addition to the materials as described above, a metal-containing material.

The metal-containing material may include a Li complex. The Li complex may include, for example, Compound ET-D1 or ET-D2:

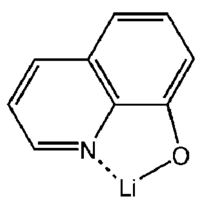
ET-D1

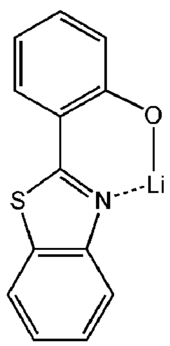
ET-D2

.

In addition, the electron transport region may include an electron injection layer that facilitates injection of electrons from the second electrode 19.

The electron injection layer may include LiF, NaCl, CsF, $Li_2O$, BaO, Compound ET-D1, Compound ET-D2, or a combination thereof.

A thickness of the electron injection layer may be in a range of about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 19 may be located on the organic layer 15. The second electrode 19 may be a cathode. A material for forming the second electrode 19 may be a metal, an alloy, an electrically conductive compound, or a

combination thereof, each of which has a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

In an embodiment, the composition, the layer including the composition, and the emission layer in the light-emitting device including the composition may not include the following compounds of Group A and 1,3-bis(N-carbazolyl) benzene (mCP):

Group A

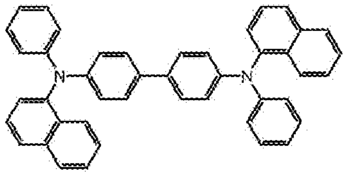

NPB

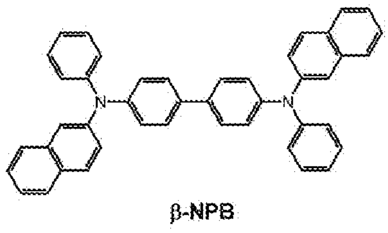

β-NPB

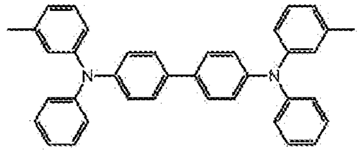

TPD

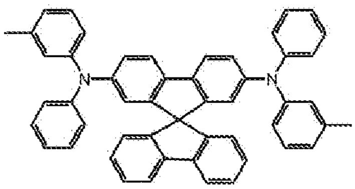

Spiro-TPD

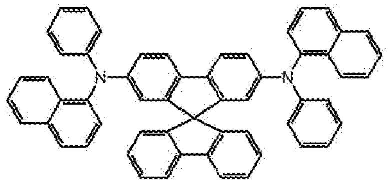

Spiro-NPB

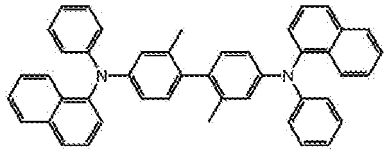

methylated NPB

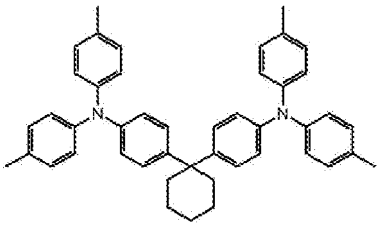

TAPC

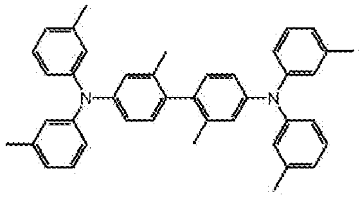

HMTPD

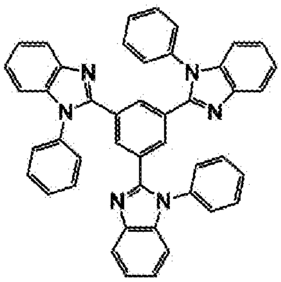

TPBi

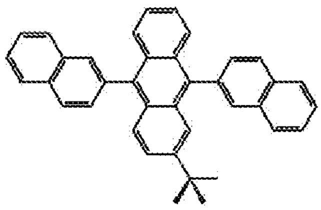

TBADN

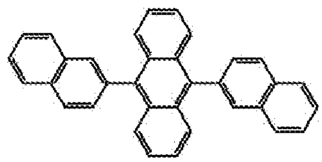

ADN

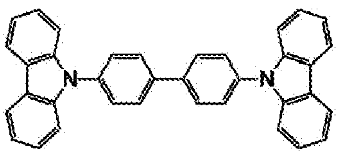

CBP

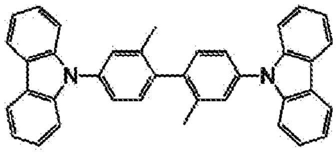

CDBP

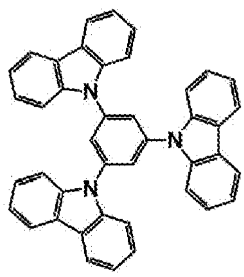

TCP

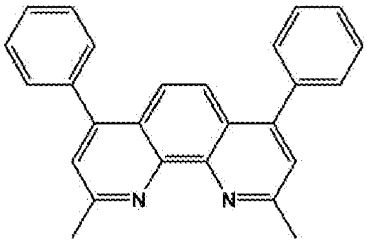

BCP

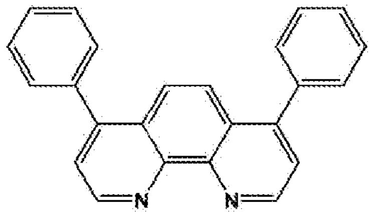

Bphen

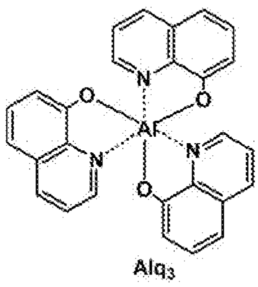

$Alq_3$

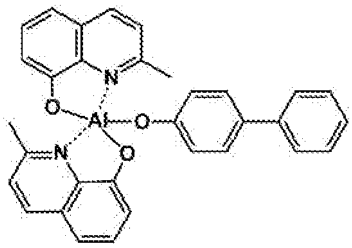

BAlq

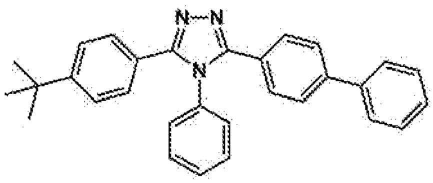

TAZ

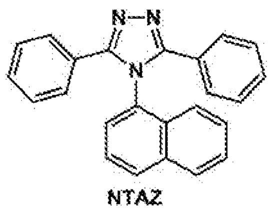

NTAZ

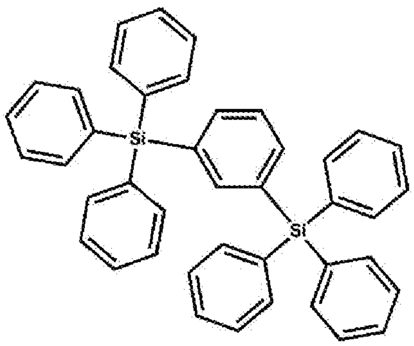

m-bis-(triphenylsilyl)benzene

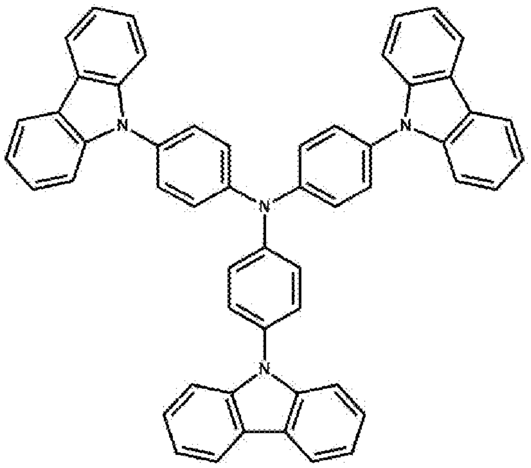

TCTA(4,4',4''-tris(carbazol-9-yl)triphenylamine)

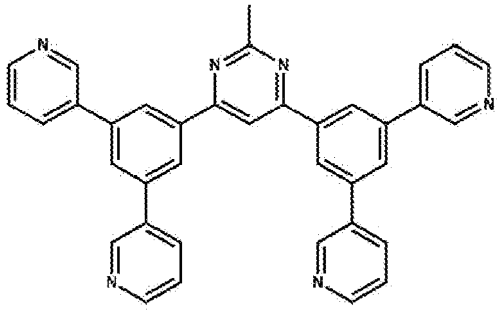

B3PYMPM(4,6-bis(3,5-di(pyridine-3-yl)phenyl)-2-methylpyrimidine)

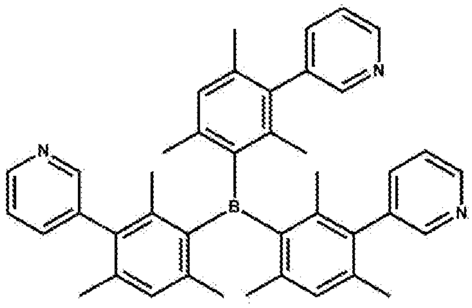

3TPYMB(tris(2,4,6-trimethyl-3-(pyridine-3-yl)phenyl)borane)

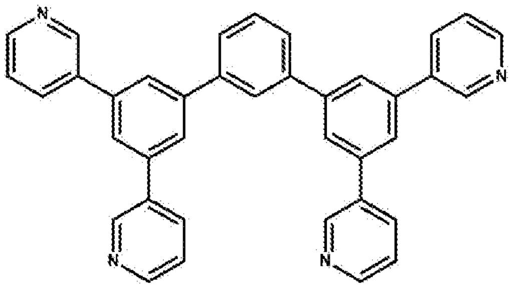

BmPyPhB(1,3-bis[3,5-di(pyridine-3-yl)phenyl]benzene)

Hereinbefore, the organic light-emitting device has been described with reference to the FIGURE, but embodiments of the present disclosure are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, and the like.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used here refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. In an embodiment, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by -$OA_{101}$ (wherein $A_{101}$ is the $C_1$-$C_{60}$ alkyl group), and examples thereof include a methoxy group, an ethoxy group, a propoxy group, a butoxy group, and a pentoxy group.

The term "$C_1$-$C_{60}$ alkylthio group" as used herein refers to a monovalent group having the formula of -$SA_{101}$ (wherein $A_{101}$ is the $C_1$-$C_{60}$ alkyl group).

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1] heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a saturated cyclic group that includes at least one heteroatom selected from N, O, P, Si, S, Se, Ge, and B as a ring-forming atom and 1 to 10 carbon atoms, and the term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group may include a silolanyl group, a silinanyl group, a tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, S, Se, Ge, and B as a ring-forming atom, 1 to 10 carbon atoms, and at least one carbon-carbon double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The "$C_7$-$C_{60}$ alkyl aryl group" as used herein refers to a $C_6$-$C_{60}$ aryl group substituted with at least one $C_1$-$C_{60}$ alkyl group. The "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group having at least one heteroatom selected from N, O, P, Si, S, Se, Ge, and B as a ring-forming atom and a cyclic aromatic system having 1 to 60 carbon atoms, and the term "$C_1$-$C_{60}$ heteroarylene group" as used herein refers to a divalent group having at least one heteroatom selected from N, O, P, Si, S, Se, Ge, and B as a ring-forming atom and a cyclic aromatic system having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein indicates $-OA_{102}$ (wherein $A_{102}$ indicates the $C_6$-$C_{60}$ aryl group), and the term "$C_6$-$C_{60}$ arylthio group" as used herein indicates $-SA_{103}$ (wherein $A_{103}$ indicates the $C_6$-$C_{60}$ aryl group).

The term "$C_1$-$C_{60}$ heteroaryloxy group" as used herein indicates $-OA_{102'}$ (wherein $A_{102'}$ indicates the $C_1$-$C_{60}$ heteroaryl group), and the term "$C_1$-$C_{60}$ heteroarylthio group" as used herein indicates $-SA_{103'}$ (wherein $A_{103'}$ indicates the $C_1$-$C_{60}$ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The $C_1$-$C_{30}$ heterocyclic group may be a monocyclic group or a polycyclic group. The "$C_1$-$C_{30}$ heterocyclic group (unsubstituted or substituted with at least one $R_{10a}$)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{10a}$).

In one or more embodiments, examples of the "$C_5$-$C_{30}$ carbocyclic group" and "$C_1$-$C_{30}$ heterocyclic group" used herein include i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,

the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated $C_1$-$C_{60}$ alkyl group (or a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group (-F). In an embodiment, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or, a fluorinated $C_1$-$C_{20}$ alkyl group, or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group, or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen included therein is not substituted with a fluoro group.

The terms "deuterated $C_1$-$C_{60}$ alkyl group (or a deuterated $C_1$-$C_{20}$ alkyl group or the like)", "deuterated $C_3$-$C_{10}$ cycloalkyl group", "deuterated $C_1$-$C_1$o heterocycloalkyl group," and "deuterated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. In an embodiment, the "deuterated $C_1$ alkyl group (that is, the deuterated methyl group)" may include $-CD_3$, $-CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl) 'X' group" as used herein refers to a 'X' group substituted with at least one $C_1$-$C_{20}$ alkyl group. In an embodiment, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of a ($C_1$ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an

azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

A substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or a combination thereof.

$Q_1$ to $Q_9$, $Q_{11}$ to $Q_{19}$, $Q_{21}$ to $Q_{29}$, and $Q_{31}$ to $Q_{39}$ used herein may each independently be: hydrogen, deuterium,-F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, a $C_1$-$C_{60}$ alkyl group, a $C_6$-$C_{60}$ aryl group, or a combination thereof.

In an embodiment, $Q_1$ to $Q_9$, $Q_{11}$ to $Q_{19}$, $Q_{21}$ to $Q_{29}$, and $Q_{31}$ to $Q_{39}$ used herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$,

$-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

Hereinafter, a compound and an organic light-emitting device according to embodiments are described in detail with reference to Synthesis Examples and Examples. However, the organic light-emitting device is not limited thereto. The wording "B was used instead of A" used in describing Synthesis Examples means that an amount of A used was identical to an amount of B used, in terms of a molar equivalent.

Examples

Synthesis Example 1 (Synthesis of Compound GD-1)

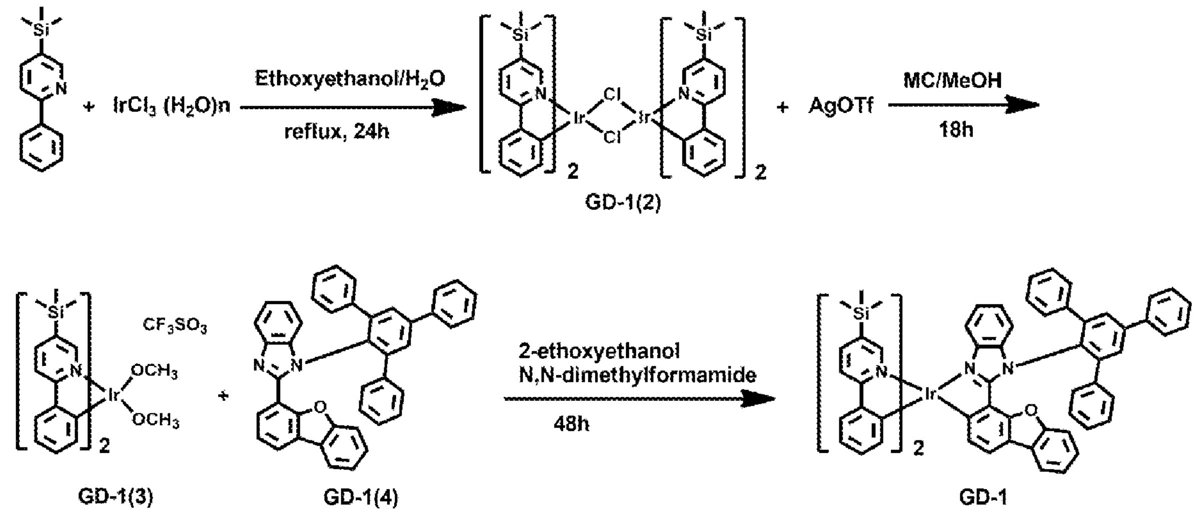


Synthesis of Compound GD-1(2)

2-phenyl-5-(trimethylsilyl)pyridine (4.21 grams (g), 18.5 millimoles (mmol)) and iridium chloride hydrate ($IrCl_3(H_2O)_n$, n=3) (2.96 g, 8.40 mmol) were mixed with 30 milliliters (mL) of 2-ethoxyethanol and 10 mL of deionized (DI) water and then stirred under reflux for 24 hours, and then, the temperature was lowered to room temperature. The resulting solid was separated by filtration, washed sufficiently with water, methanol, and hexane, in this stated order, and then dried in a vacuum oven to obtain 5.22 g (yield of 87 %) of Compound GD-1(2).

Synthesis of Compound GD-1(3)

Compound GD-1(2) (2.28 g, 1.68 mmol) was mixed with 60 mL of methylene chloride (MC), and then, silver trifluoromethanesulfonate (AgOTf) (0.86 g, 3.36 mmol) was added thereto after being mixed with 20 mL of methanol (MeOH). Thereafter, the mixture was stirred for 18 hours at room temperature while light was blocked with aluminum foil, and then filtered through Celite to remove the resulting solid, and the filtrate was subjected to reduced pressure to obtain a resultant (Compound GD-1(3)), which was used in the next reaction without an additional purification process.

Synthesis of Compound GD-1

Compound GD-1(3) (2.66 g, 2.98 mmol) and Compound GD-1(4) (2-(dibenzo[b,d]furan-4-yl)-1-(5'-phenyl-[1,1':3',1"-terphenyl]-4'-yl)-1H-benzo[d]imidazole) (1.79 g, 2.99 mmol) were mixed with 30 mL of 2-ethoxyethanol and 30 mL of N,N-dimethylformamide and then stirred under reflux for 48 hours, and then, the temperature was lowered to room temperature. The obtained mixture was subjected to reduced pressure to obtain a solid, on which column chromatography (eluent: ethyl acetate (EA) and hexanes) was performed to obtain 1.12 g (yield of 30 %) of Compound

GD-1.

High resolution mass spectrometry (HRMS) using matrix assisted laser desorption ionization (MALDI) (HRMS (MALDI)) calcd for $C_{71}H_{59}IrN_4OSI_2$: m/z 1234.66 Found: 1234.66.

Synthesis Example 2 (Synthesis of Compound GD-2)

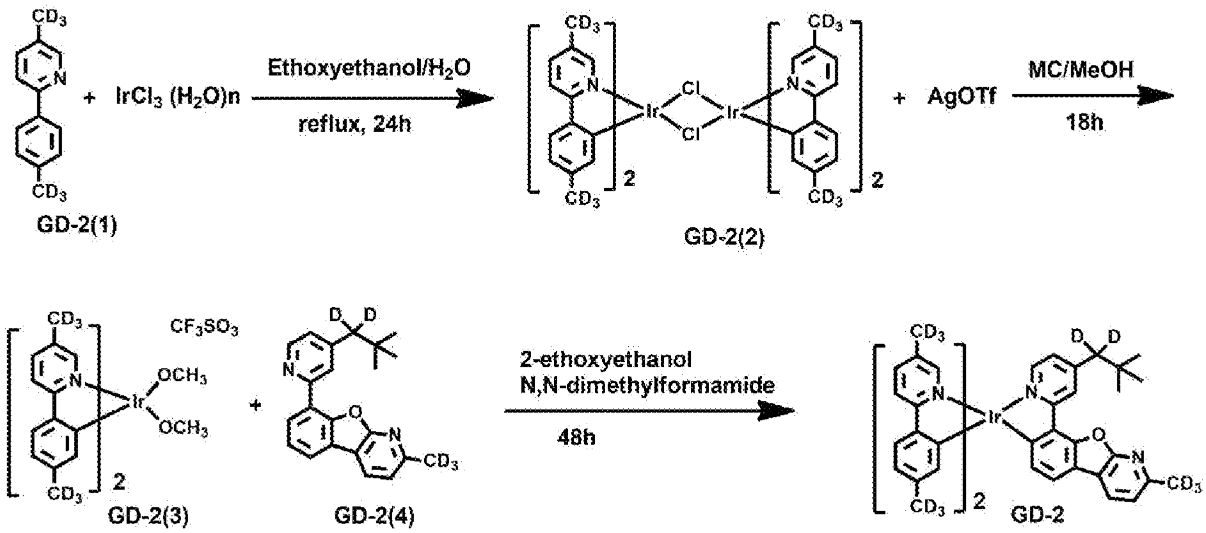


GD-2(1) GD-2(2) GD-2(3) GD-2(4) GD-2

Synthesis of Compound GD-2(2)

4.30 g (yield of 82 %) of Compound GD-2(2) was obtained in a similar manner as used to obtain Compound GD-1(2) of Synthesis Example 1, except that Compound GD-2(1) (5-(methyl-d3)-2-(p-tolyl-d3)pyridine) was used instead of 2-phenyl-5-(trimethylsilyl)pyridine.

Synthesis of Compound GD-2(3)

Compound GD-2(3) was obtained in a similar manner as used to obtain Compound GD-1(3) of Synthesis Example 1, except that Compound GD-2(2) was used instead of Compound GD-1(2). Compound GD-2(3) obtained was used in the next reaction without an additional purification process.

Synthesis of Compound GD-2

1.45 g (yield of 39 %) of Compound GD-2 was obtained in a similar manner as used to obtain Compound GD-1 of Synthesis Example 1, except that Compound GD-2(3) was used instead of Compound GD-1(3), and Compound GD-2(4) was used instead of Compound GD-1(4).

HRMS (MALDI) calcd for $C_{48}H_{28}D_{17}IrN_4O$: m/z 904.43 Found: 904.43.

Synthesis Example 3 (Synthesis of Compound RD-1)

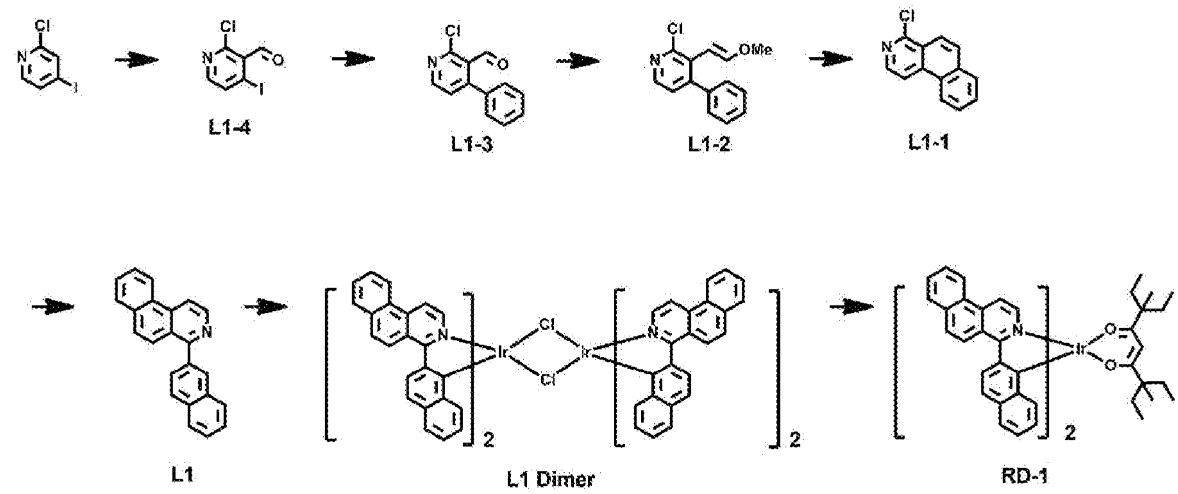

L1-4 L1-3 L1-2 L1-1

L1 L1 Dimer RD-1

Synthesis of Intermediate L1-4

5 g (20.9 mmol) of 2-chloro-4-iodopyridine was dissolved in 50 mL of anhydrous THF, and then, 12.5 mL (25 mmol) of 2.0 M lithium diisopropylamide (in THF) was slowly added dropwise thereto at a temperature of -78°C. After about 3 hours, 2.5 mL (32 mmol) of ethyl formate was slowly added dropwise thereto, followed by stirring at room temperature for 18 hours. When the reaction was completed, water and ethyl acetate were added to the reaction mixture and an extraction process was performed thereon, and the obtained organic layer was dried using magnesium sulfate and distilled under reduced pressure. The resultant was purified by liquid chromatography to obtain Intermediate L1-4.

Synthesis of Intermediate L1-3

1.9 g (7.2 mmol) of Intermediate L1-4 was dissolved in 60 mL of acetonitrile and 15 mL of water, and then, 0.4 g (0.5 mmol) of $PdCl_2(PPh_3)_2$, 7.2 mmol of phenylboronic acid, and 2.5 g (18.0 mmol) of $K_2CO_3$ were added thereto, followed by refluxing while heating at a temperature of 80°C for 18 hours. When the reaction was completed, the reaction mixture was concentrated under reduced pressure, dichloromethane and water were added thereto, followed by extraction, and the obtained organic layer was dried using magnesium sulfate and distilled under reduced pressure. The resultant was purified by liquid chromatography to obtain Intermediate L1-3.

Synthesis of Intermediate L1-2

5.4 g (15.8 mmol) of (methoxymethyl)triphenylphosphonium chloride was dissolved in 50 mL of anhydrous ethyl ether, and then, 16 mL of 1.0 M potassium tert-butoxide solution was added dropwise thereto. After stirring at room temperature for about 1 hour, 1.5 g (6.3 mmol) of Intermediate L1-3 dissolved in 30 mL of anhydrous THF was slowly added dropwise thereto, followed by stirring at room temperature for 18 hours. When the reaction was completed, water and ethyl acetate were added to the reaction mixture and an extraction process was performed thereon, and the obtained organic layer was dried using magnesium sulfate and distilled under reduced pressure. The resultant was purified by liquid chromatography to obtain Intermediate L1-2.

Synthesis of Intermediate L1-1

1.4 g (5.1 mmol) of Intermediate L1-2 was dissolved in 40 mL of dichloromethane, and 3.0 mL of methanesulfonic acid was slowly added dropwise thereto, followed by stirring at room temperature for about 18 hours. After the reaction was completed, an extraction process was performed thereon after adding a saturated aqueous hydrogen carbonate solution thereto, and the obtained organic layer was dried using magnesium sulfate and distilled under reduced pressure. The resultant was purified by liquid chromatography to obtain Intermediate L1-1.

Synthesis of Intermediate L1

1.0 g (4.1 mmol) of Intermediate L1-1 was dissolved in 40 mL of THF and 10 mL of water, and then, 1.6 g (6.2 mmol) of 4,4,5,5-tetramethyl-2-(naphthalen-2-yl)-1,3,2-dioxaborolane, 0.09 g (0.4 mmol) of palladium acetate ($Pd(OAc)_2$), 0.35 g (0.82 mmol) of Sphos, and 1.4 g (10.3 mmol) of $K_2CO_3$ were added thereto, followed by refluxing

while heating for one day. After the reaction was completed, an extraction process was performed thereon after adding ethyl acetate and water thereto, and the obtained organic layer was dried using magnesium sulfate and distilled under reduced pressure. The resultant was purified by liquid chromatography to obtain Intermediate L1.

Synthesis of Intermediate L1 Dimer

1.05 g (3.4 mmol) of Intermediate L1 and 0.6 g (1.6 mmol) of iridium chloride were mixed with 40 mL of ethoxyethanol and 15 mL of distilled water, followed by refluxing while heating for 24 hours. After the reaction was completed, the temperature was lowered to room temperature, and the solid produced therefrom was filtered and washed sufficiently in the order of water/methanol/hexane. The obtained solid was dried in a vacuum oven to obtain Intermediate L1 Dimer.

Synthesis of Compound RD-1

Intermediate L1 Dimer (0.63 mmol), 0.9 g (4.5 mmol) of 3,7-diethyl-3,7-dimethylnonane-4,6-dione, and 0.48 g (4.5 mmol) of $Na_2CO_3$ were mixed with 40 mL of ethoxyethanol and then stirred at a temperature of 90°C for 24 hours to proceed a reaction. After the reaction was completed, the temperature was lowered to room temperature, and the solid produced therefrom was filtered and purified by liquid chromatography to obtain 0.008 g (yield of 30%) of Compound RD-1. Liquid chromatography-mass spectrometry (LC-MS) m/z = 1042.40 $(M+H)^+$.

Evaluation Example 1

On a quartz substrate, compounds shown in Table 1 were vacuum-deposited at a vacuum pressure of $10^{-7}$ torr at a weight ratio shown in Table 1 to manufacture Films G-1, G-2, G-1C, G-2C, R-1, R-2, R-1C, R-2C, R-1D, and R-2D each having a thickness of 40 nm.

Subsequently, the photoluminescence emission peak wavelength ($\lambda_{max}$, nm) and photoluminescence quantum yield (PLQY, %) of each of Films G-1, G-2, G-1C, G-2C, R-1, R-2, R-1C, R-2C, R-1D, and R-2D was measured using a Quantaurus-QY Absolute PL quantum yield spectrometer (equipped with a xenon light source, a monochromator, a photonic multichannel analyzer, and an integrating sphere, and using PLQY measurement software (manufactured by Hamamatsu Photonics, Ltd., Shizuoka, Japan)). In the measurement, the excitation wavelength was scanned at intervals of 10 nm from 320 nm to 380 nm, and a spectrum measured at the excitation wavelength of 320 nm among the scanned wavelengths was adopted. Accordingly, the photoluminescence emission wavelength ($\lambda_{max}$) and photoluminescence quantum yield (PLQY) of each of Compounds GD-1, GD-2, GD-1C, GD-2C, RD-1, RD-2, RD-1C, RD-2C, RD-1D, and RD-2D included in Films G-1, G-2, G-1C, G-2C, R-1, R-2, R-1C, R-2C, R-1D, and R-2D were evaluated, and the results are shown in Tables 2 and 3.

Table 1

| Film no. | Film composition (weight ratio) |
|---|---|
| G-1 | H-H1 : H-H2 : GD-1 (47.5:47.5:5) |
| G-2 | H-H1 : H-H2 : GD-2 (47.5:47.5:5) |
| G-1C | H-H1 : H-H2 : GD-1C (47.5:47.5 :5) |
| G-2C | H-H1 : H-H2 : GD-2C (47.5:47.5 :5) |
| R-1 | H52 : RD-1 (98:2) |
| R-2 | H52 : RD-2 (98:2) |
| R-1C | H52 : RD-1C (98:2) |
| R-2C | H52 : RD-2C (98:2) |
| R-1D | H52 : RD-1D (98:2) |
| R-2D | H52 : RD-2D (98:2) |

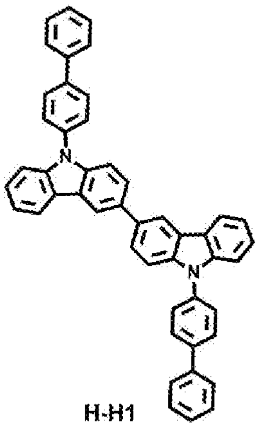

H-H1

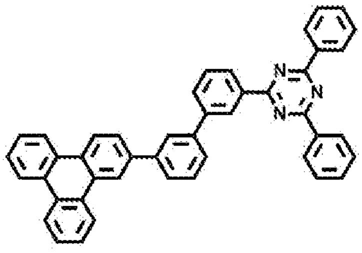

H-H2

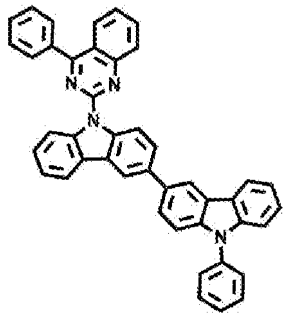

H52

Evaluation Example 2

The photoluminescence spectrum of each of Films G-1, G-2, G-1C, G-2C, R-1, R-2, R-1C, R-2C, R-1D, and R-2D was evaluated at room temperature by using TRPL measurement system FluoTime 300 manufactured by PicoQuant and a pumping source PLS340 manufactured by PicoQuant (excitation wavelength = 340 nm, spectral width = 20 nm), and then, the wavelength of main peak of the spectrum was determined. PLS340 repeated the measure of the number of photons emitted from each film at the main peak by a photon pulse (pulse width = 500 picoseconds) applied to each film according to the time, based on time-correlated single photon counting (TCSPC), thereby obtaining a sufficiently fittable TRPL curve. One or more exponential decay functions were fitted to the result obtained therefrom, thereby obtaining $T_{decay}$(Ex), that is, decay time, of each of Films G-1, G-2, G-1C, G-2C, R-1, R-2, R-1C, R-2C, R-1D, and R-2D, and radiative decay rates calculated therefrom are shown in Tables 2 and 3. A function for fitting is as shown in Equation 20, and from among $T_{decay}$ values obtained from each exponential decay function used for fitting, the largest $T_{decay}$ was obtained as $T_{decay}$ (Ex). In this regard, the same measurement was performed during the same measurement time as that for obtaining TRPL curve in the dark state (in which pumping signals entering a film are blocked) to obtain a baseline or a background signal curve for use as a baseline for fitting.

Equation 20

$$f(t) = \sum_{i=1}^{n} A_i \, exp\left(-t/T_{decay,i}\right)$$

Evaluation Example 3

The photoluminescence (emission intensity) at each angle of each of Films G-1, G-2, G-1C, G-2C, R-1, R-2, R-1C, R-2C, R-1D, and R-2D was measured from -150° to +150° by using Luxol-OLED/analyzer LOA-100 manufactured by CoCoLink Inc., and then, the horizontal orientation ratio of each of Compounds GD-1, GD-2, GD-1C, GD-2C, RD-1, RD-2, RD-1C, RD-2C, RD-1D, and RD-2D were calculated by using a fitting program of the analyzer, and the results are shown in Tables 2 and 3.

Evaluation Example 4

The HOMO energy levels of Compounds GD-1, GD-2, GD-1C, GD-2C, RD-1, RD-2, RD-1C, RD-2C, RD-1D, and RD-2D were evaluated by using a photoelectron spectrometer (manufactured by RIKEN KEIKI Co., Ltd.: AC3) under atmospheric pressure, and the results are shown in Tables 2 and 3.

Table 2

| Compound No. | $\lambda_{max}$ (nm) | PLQY (%) | Radiative decay rate ($s^{-1}$) | Horizontal orientation ratio (%) | HOMO (eV) |
|---|---|---|---|---|---|
| GD-1 | 530 | 91.4% | $8.35 \times 10^5$ | 88% | -5.34 |

(continued)

| Compound No. | $\lambda_{max}$ (nm) | PLQY (%) | Radiative decay rate ($s^{-1}$) | Horizontal orientation ratio (%) | HOMO (eV) |
|---|---|---|---|---|---|
| GD-2 | 525 | 91.2% | $7.31 \times 10^5$ | 77% | -5.25 |
| GD-1C | 516 | 79.1% | $8.64 \times 10^5$ | 67% | -5.35 |
| GD-2C | 433 | 50.2% | $2.50 \times 10^5$ | 68% | -5.51 |

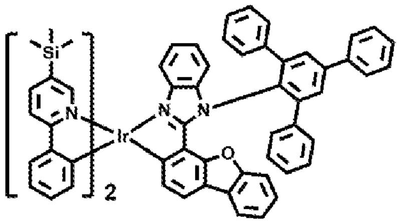

GD-1

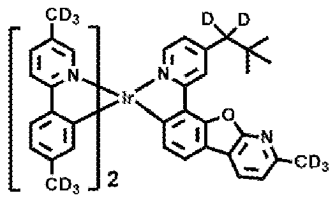

GD-2

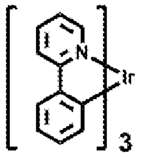

GD-1C

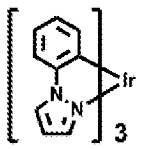

GD-2C

Table 3

| Compound No. | $\lambda_{max}$ (nm) | PLQY (%) | Radiative decay rate ($s^{-1}$) | Horizontal orientation ratio (%) | HOMO (eV) |
|---|---|---|---|---|---|
| RD-1 | 634 | 70% | $6.03 \times 10^5$ | 90% | -5.37 |
| RD-2 | 618 | 56% | $5.61 \times 10^5$ | 86% | -5.35 |
| RD-1C | 618 | 72.7% | $6.61 \times 10^5$ | 79% | -5.39 |
| RD-2C | 520 | 70.5% | $5.56 \times 10^5$ | 71% | -5.41 |
| RD-1D | 592 | 69.2% | $6.71 \times 10^5$ | 77% | -5.48 |
| RD-2D | 584 | 65.4% | $5.59 \times 10^5$ | 78% | -5.51 |

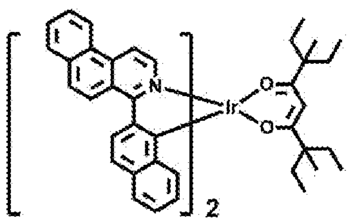

RD-1

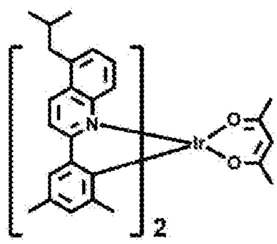

RD-2

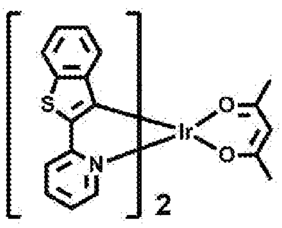

RD-1C

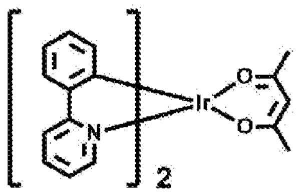

RD-2C

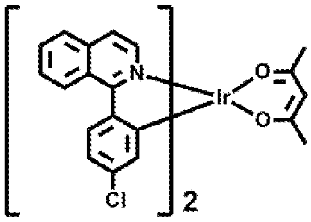

RD-1D

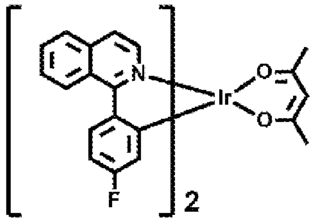

RD-2D

Manufacture of OLED G-1

An ITO (as an anode)-patterned glass substrate was cut to a size of 50 mm x 50 mm x 0.5 mm, sonicated with isopropyl alcohol and pure water, each for 5 minutes, and then cleaned by exposure to ultraviolet rays and ozone for 30 minutes. The resultant glass substrate was loaded onto a vacuum deposition apparatus.

HT3 and F6-TCNNQ were vacuum-deposited on the anode at a weight ratio of 98 : 2 to form a hole injection layer having a thickness of 100 Å, and then, HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Subsequently, a host and a dopant were co-deposited at the weight ratio shown in Table 4 on the electron blocking layer to form an emission layer having a thickness of 400 Å. As the host, H-H1 and H-H2 were used at a weight ratio of 5 : 5, and as the dopant, the first compound and the second compound shown in Table 4 were used at a weight ratio of 1 : 1.

Thereafter, ET3 and ET-D1 were co-deposited at a volume ratio of 50 : 50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of OLED G-1.

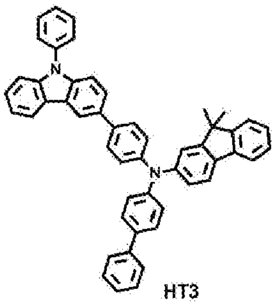

HT3

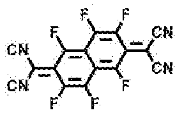

F6-TCNNQ

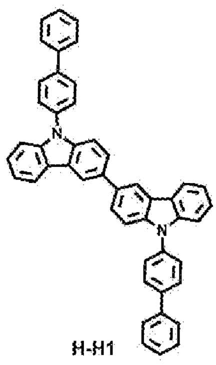

H-H1

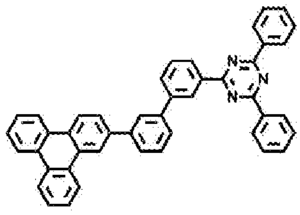

H-H2

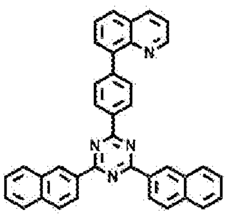

ET3

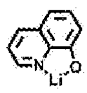

ET-D1

Manufacture of OLEDs G-A to G-C

OLEDs G-A to G-C were manufactured in a similar manner as used to manufacture OLED G-1, except that, in forming an emission layer, for use as a dopant, corresponding compounds shown in Table 4 were used instead of the first compound and the second compound of OLED G-1.

Evaluation Example 5

The driving voltage (V), emission peak wavelength $\lambda_{max}$ (nm), maximum value of external quantum efficiency (Max EQE, %), and lifespan ($LT_{97}$, hr) of each of OLEDs G-1 and G-A to G-C were evaluated, and the results are shown in Table 4. A current-voltage meter (Keithley 2400) and a luminance meter (Minolta Cs-1000A) were used as an apparatus for evaluation, and the lifespan ($T_{97}$, relative % at 16,000 candela per square meter (cd/$m^2$) or nit) were obtained by measuring the amount of time (hours, hr) that elapsed until luminance was reduced to 97% of the initial luminance of 100%, and the results are expressed as a relative value (%).

Table 4

| | Dopant in emission layer | | Weight ratio of host to dopant in emission layer | Driving voltage (V) | $\lambda_{max}$ (nm) | Max EQE (relative value, %) | $LT_{97}$ (relative value, %) |
|---|---|---|---|---|---|---|---|
| | First compound | Second compound | | | | | |
| OLED G-1 | GD-1 | GD-2 | 90:10 | 4.30 | 530 | 98 | 140 |
| OLED G-A | GD-1 | | 95:5 | 4.29 | 530 | 100 | 100 |
| OLED G-B | GD-2 | | 95:5 | 4.36 | 525 | 89 | 25 |
| OLED G-C | GD-1C | GD-2C | 90:10 | 5.4 | 516 | 42 | < 10 |

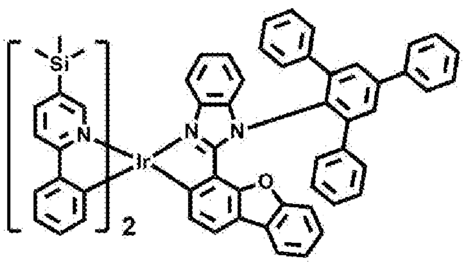

GD-1

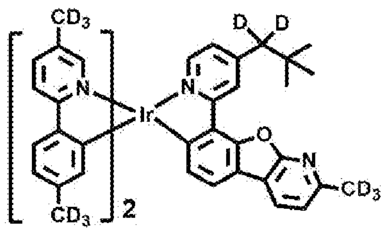

GD-2

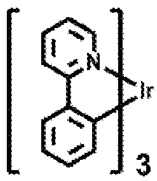

GD-1C

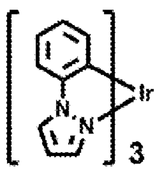

GD-2C

Referring to Table 4, it was confirmed that OLED G-1 emitted green light and, as compared with each of OLEDs G-A to G-C, had an improved or equivalent driving voltage, improved or equivalent external quantum efficiency, and improved lifespan characteristics.

Manufacture of OLED R-1

As an anode, an ITO-patterned glass substrate was cut to a size of 50 mm x 50 mm x 0.5 mm, sonicated with isopropyl alcohol, and pure water each for 5 minutes, and then cleaned by exposure to ultraviolet rays and ozone for 30 minutes. Then, the ITO-patterned glass substrate was provided to a vacuum deposition apparatus.

HT3 and F6-TCNNQ were co-deposited by vacuum on the ITO anode at a weight ratio of 98:2 to form a hole injection layer having a thickness of 100 Å, and HT3 was vacuum-deposited on the hole injection layer to form a hole transport layer having a thickness of 1,350 Å, and then, HT21 was vacuum-deposited on the hole transport layer to form an electron blocking layer having a thickness of 300 Å.

Subsequently, a host and a dopant were co-deposited at the weight ratio shown in Table 5 on the electron blocking layer to form an emission layer having a thickness of 400 Å. H52 was used as the host, and as the dopant, the first compound and the second compound shown in Table 5 were used at a weight ratio of 1 : 1.

Thereafter, ET3 and ET-D1 were co-deposited at a volume ratio of 50:50 on the emission layer to form an electron

transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of OLED R-1.

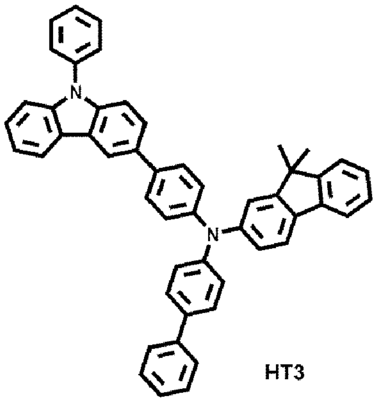
HT3

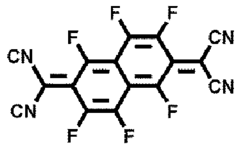
F6-TCNNQ

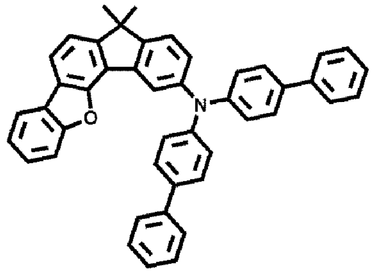
HT21

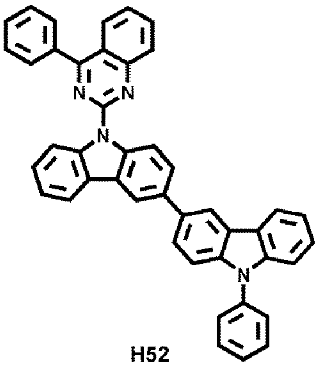
H52

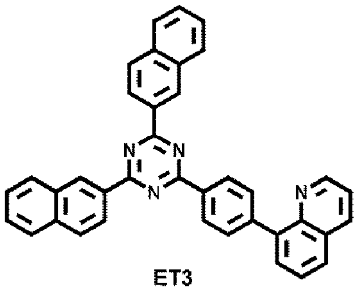
ET3

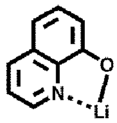
ET-D1

Manufacture of OLEDs R-A to R-D

OLEDs R-A to R-D were manufactured in a similar manner as used to manufacture OLED R-1, except that, in forming an emission layer, for use as a dopant, corresponding compounds shown in Table 5 were used instead of the first compound and the second compound of OLED R-1.

Evaluation Example 6

The driving voltage (V), emission peak wavelength $\lambda_{max}$ (nm), maximum value of external quantum efficiency (Max EQE, relative %), and lifespan ($LT_{97}$, hr) of each of OLEDs R-1 and R-A to R-D were evaluated, and the results are shown in Table 5. A current-voltage meter (Keithley 2400) and a luminance meter (Minolta Cs-1000A) were used as an apparatus for evaluation, and the lifespan ($T_{97}$, relative % at 7,000 cd/m$^2$ or nit) were obtained by measuring the amount of time (hr) that elapsed until luminance was reduced to 97% of the initial luminance of 100%, and the results are expressed as a relative value (%).

Table 5

| | Dopant in emission layer | | Weight ratio of host to dopant in emission layer | Driving voltage (V) | $\lambda_{max}$ (nm) | Max EQE (%) | $LT_{97}$ (relative value, %) |
|---|---|---|---|---|---|---|---|
| | First compound | Second compound | | | | | |
| OLED R-1 | RD-1 | RD-2 | 98:2 | 3.10 | 631 | 104 | 141 |
| OLED R-A | RD-1 | | 98::2 | 3.09 | 634 | 100 | 100 |
| OLED R-B | RD-2 | | 98:2 | 3.13 | 618 | 99 | 117 |
| OLED R-C | RD-1C | RD-2C | 98:2 | 3.03 | 618 | 82 | <10 |

(continued)

| | Dopant in emission layer | | Weight ratio of host to dopant in emission layer | Driving voltage (V) | $\lambda_{max}$ (nm) | Max EQE (%) | $LT_{97}$ (relative value, %) |
|---|---|---|---|---|---|---|---|
| | First compound | Second compound | | | | | |
| OLED R-D | RD-1D | RD-2D | 98:2 | 3.01 | 592 | 85 | <10 |

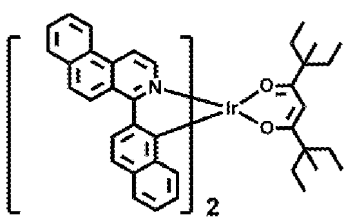

RD-1

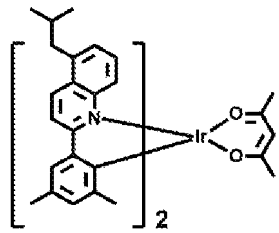

RD-2

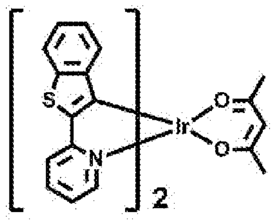

RD-1C

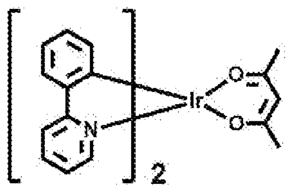

RD-2C

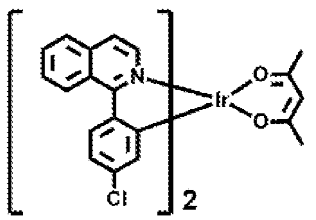

RD-1D

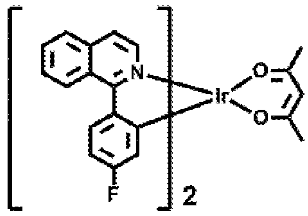

RD-2D

Referring to Table 5, it was confirmed that OLED R-1 emitted red light and, as compared with each of OLEDs R-A to R-D, has an improved or equivalent driving voltage, improved external quantum efficiency, and improved lifespan characteristics.

An electronic device, for example, a light-emitting device, using the composition may have an improved driving voltage, improved external quantum efficiency, and improved lifespan characteristics.

It should be understood that the one or more exemplary embodiments described in detail herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

**1.** A composition, comprising a first compound and a second compound, wherein

the first compound is an organometallic compound represented by Formula 1,
the second compound is an organometallic compound represented by Formula 2,
the first compound and the second compound are different from each other,

the first compound and the second compound are each not tris[2-phenylpyridine]iridium,
$|\lambda P(Ir1) - \lambda P(Ir2)|$ is in a range of 0 nanometers to 30 nanometers, wherein $|\lambda P(Ir1) - \lambda P(Ir2)|$ indicates an absolute value of $\lambda P(Ir1) - \lambda P(Ir2)$, and
at least one of Expressions 1 to 4 is satisfied,
**characterized in that** the first compound and the second compound are each a heteroleptic compound,

Expression 1

$$\lambda P(Ir1) > \lambda P(Ir2)$$

Expression 2

$$PLQY(Ir1) > PLQY(Ir2)$$

Expression 3

$$k_r(Ir1) > k_r(Ir2)$$

Expression 4

$$HOR(Ir1) > HOR(Ir2)$$

wherein, in $|\lambda P(Ir1) - \lambda P(Ir2)|$ and Expressions 1 to 4,
$\lambda P(Ir1)$ indicates an emission peak wavelength of the first compound,
$\lambda P(Ir2)$ indicates an emission peak wavelength of the second compound,
$\lambda P(Ir1)$ and $\lambda P(Ir2)$ are evaluated from photoluminescence spectra measured for each of a first film and a second film,
PLQY(Ir1) indicates a photoluminescence quantum yield of the first compound,
PLQY(Ir2) indicates a photoluminescence quantum yield of the second compound,
PLQY(Ir1) and PLQY(Ir2) are measured for each of the first film and the second film,
$k_r(Ir1)$ indicates a radiative decay rate of the first compound,
$k_r(Ir2)$ indicates a radiative decay rate of the second compound,
$k_r(Ir1)$ and $k_r(Ir2)$ are evaluated from photoluminescence spectra and time-resolved photoluminescence spectra measured for each of the first film and the second film,
HOR(Ir1) indicates a horizontal orientation ratio of the first compound,
HOR(Ir2) indicates a horizontal orientation ratio of the second compound, and
HOR(Ir1) and HOR(Ir2) are evaluated from emission intensity measured for each of the first film and the second film ,
wherein the first film is a film comprising the first compound, and
the second film is a film comprising the second compound,

Formula 1 $Ir(L_{11})_{n11}(L_{12})_{n12}(L_{13})_{n13}$

Formula 2 $Ir(L_{21})_{n21}(L_{22})_{n22}(L_{23})_{n23}$

wherein, in Formulae 1 and 2,
$L_{11}$ and $L_{21}$ are each independently:

a bidentate ligand bonded to iridium (Ir) of Formula 1 or Formula 2 via two nitrogen atoms;
a bidentate ligand bonded to Ir of Formula 1 or Formula 2 via a nitrogen atom and a carbon atom; or
a bidentate ligand bonded to Ir of Formula 1 or Formula 2 via two carbon atoms,

$L_{12}$, $L_{13}$, $L_{22}$, and $L_{23}$ are each independently:

a bidentate ligand bonded to Ir of Formula 1 or Formula 2 via two nitrogen atoms;
a bidentate ligand bonded to Ir of Formula 1 or Formula 2 via a nitrogen atom and a carbon atom;
a bidentate ligand bonded to Ir of Formula 1 or Formula 2 via two carbon atoms; or

a bidentate ligand bonded to Ir of Formula 1 or Formula 2 via two oxygen atoms,

n11 and n12 are each independently 1 or 2,
n13 is 0 or 1,
the sum of n11, n12, and n13 is 3,
n21 and n22 are each independently 1 or 2,
n23 is 0 or 1, and
the sum of n21, n22, and n23 is 3,
wherein Formula 1 and Formula 2 satisfy Condition 1:

Condition 1
When a) $L_{11}$ is a bidentate ligand bonded to Ir of Formula 1 via a nitrogen atom and a carbon atom; b) $L_{11}$ comprises ring $A_1$ bonded to Ir of Formula 1 via a nitrogen atom, and ring $A_2$ bonded to Ir of Formula 1 via a carbon atom; c) $L_{21}$ is a bidentate ligand bonded to Ir of Formula 2 via a nitrogen atom and a carbon atom; d) $L_{21}$ comprises ring $A_5$ bonded to Ir of Formula 2 via a nitrogen atom, and ring $A_6$ bonded to Ir of Formula 2 via a carbon atom; e) $L_{12}$ and $L_{22}$ are each a bidentate ligand bonded to Ir of Formula 1 or Formula 2 via two oxygen atoms; f) n11 and n21 are each 2; and g) n12 and n22 are each 1,
ring $A_1$ and ring $A_5$ are different from each other.

**2.** The composition of claim 1, wherein Expression 1 is satisfied; and/or

wherein at least one of Expressions 2 to 4 is satisfied; and/or
wherein Expression 5 is further satisfied:

Expression 5

$$\mathrm{HOMO(Ir1)} < \mathrm{HOMO(Ir2)}$$

wherein, in Expression 5,
HOMO(Ir1) indicates a highest occupied molecular orbital (HOMO) energy level of the first compound,
HOMO(Ir2) indicates a HOMO energy level of the second compound, and
HOMO(Ir1) and HOMO(Ir2) are each a negative value measured by using a photoelectron spectrometer under atmospheric pressure; and/or
wherein
|HOMO(Ir1) - HOMO(Ir2)| is in a range of 0.02 electron volts to 0.30 electron volts,
HOMO(Ir1) indicates a HOMO energy level of the first compound,
HOMO(Ir2) indicates a HOMO energy level of the second compound,
|HOMO(Ir1) - HOMO(Ir2)| indicates an absolute value of (HOMO(Ir1) - HOMO(Ir2)), and
HOMO(Ir1) and HOMO(Ir2) are each a negative value measured by using a photoelectron spectrometer under atmospheric pressure.

**3.** The composition of claims 1 or 2, wherein λP(Ir1) and λP(Ir2) are each in a range of 500 nanometers to 570 nanometers.

**4.** The composition of any of claims 1-3, wherein Expression 1 is satisfied, and

i) λP(Ir1) is in a range of 520 nanometers to 540 nanometers, and λP(Ir2) is in a range of 500 nanometers to 530 nanometers, or
ii) λP(Ir1) is in a range of 550 nanometers to 570 nanometers, and λP(Ir2) is in a range of 540 nanometers to 560 nanometers.

**5.** The composition of claims 3 or 4, wherein $L_{11}$, $L_{12}$, $L_{13}$, $L_{21}$, $L_{22}$, and $L_{23}$ are each a bidentate ligand bonded to Ir of Formula 1 or Formula 2 via a nitrogen atom and a carbon atom.

**6.** The composition of claims 1 or 2, wherein λP(Ir1) and λP(Ir2) are each in a range of 570 nanometers to 650 nanometers.

**7.** The composition of claims 1, 2 or 6, wherein

Expression 1 is satisfied,
λP(Ir1) is in a range of 620 nanometers to 650 nanometers, and
λP(Ir2) is in a range of 570 nanometers to 630 nanometers.

**8.** The composition of claims 6 or 7, wherein

$L_{11}$, $L_{13}$, $L_{21}$, and $L_{23}$ are each a bidentate ligand bonded to Ir of Formula 1 or Formula 2 via a nitrogen atom and a carbon atom,
$L_{12}$ and $L_{22}$ are each a bidentate ligand bonded to Ir of Formula 1 or Formula 2 via two oxygen atoms, and n12 and n22 are each 1;
preferably wherein
$L_{11}$ comprises ring $A_1$ bonded to Ir of Formula 1 via a nitrogen atom,
$L_{21}$ comprises ring $A_5$ bonded to Ir of Formula 2 via a nitrogen atom, and
ring $A_1$ and ring $A_5$ are each a polycyclic group having 6 to 60 carbon atoms.

**9.** The composition of claims 1 or 2, wherein λP(Ir1) and λP(Ir2) are each in a range of 400 nanometers to 500 nanometers.

**10.** The composition of claim 1, 2 or 9, wherein

Expression 1 is satisfied,
λP(Ir1) is in a range of 470 nanometers to 500 nanometers, and
λP(Ir2) is in a range of 430 nanometers to 480 nanometers.

**11.** The composition of any of claims 1-10, wherein at least one of Conditions A to D is satisfied:

Condition A
$L_{11}$ and $L_{12}$ of Formula 1 are different from each other;
Condition B
$L_{21}$ and $L_{22}$ of Formula 2 are different from each other;
Condition C
$L_{11}$ of Formula 1 and $L_{21}$ of Formula 2 are different from each other; and
Condition D
$L_{12}$ of Formula 1 and $L_{22}$ of Formula 2 are different from each other.

**12.** The composition of any of claims 1-11, wherein

$L_{11}$ is a ligand represented by Formula 1-1,
$L_{12}$ is a ligand represented by Formula 1-2 or 1-3,
$L_{13}$ is a ligand represented by Formula 1-1, 1-2, or 1-3,
$L_{21}$ is a ligand represented by Formula 2-1,
$L_{22}$ is a ligand represented by Formula 2-2 or 2-3, and
$L_{23}$ is a ligand represented by Formula 2-1, 2-2, or 2-3:

Formula 1-1

Formula 1-2

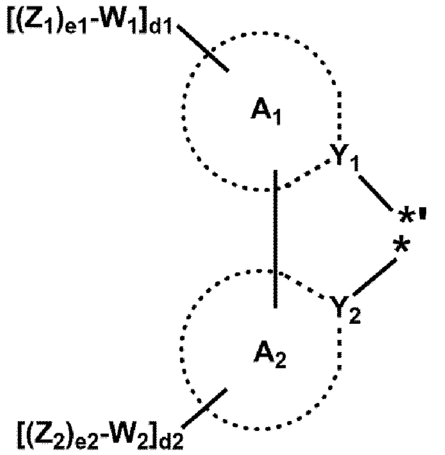

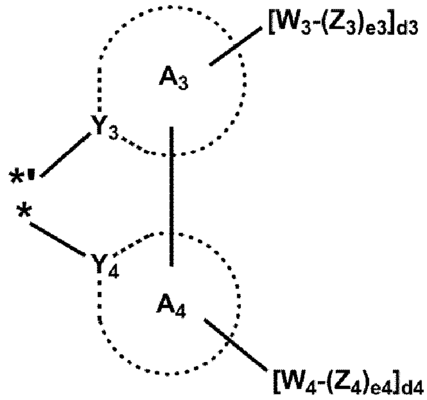

Formula 1-3

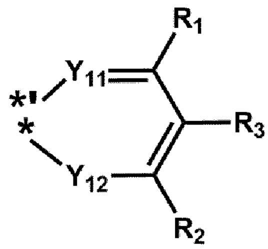

Formula 2-1

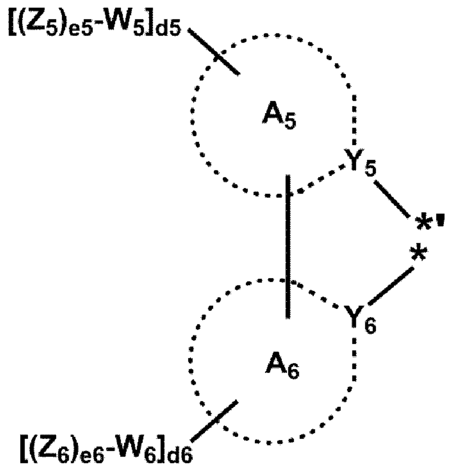

Formula 2-2

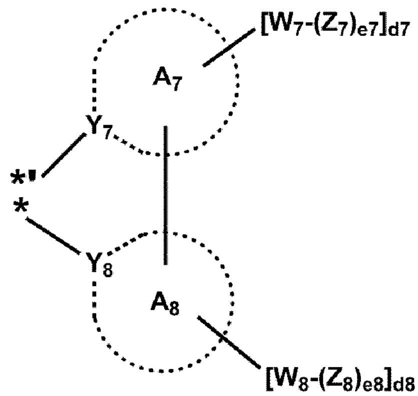

Formula 2-3

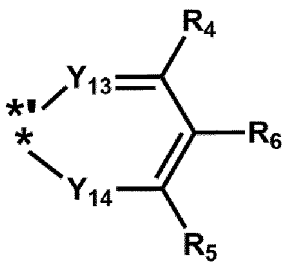

wherein, in Formulae 1-1 to 1-3 and 2-1 to 2-3,

$Y_1$ to $Y_8$ are each independently C or N,

$Y_{11}$ to $Y_{14}$ are each O,

ring $A_1$ to ring $A_8$ are each independently a $C_5$-$C_{30}$ carbocyclic group or a $C_1$-$C_{30}$ heterocyclic group,

$W_1$ to $W_8$ are each independently a single bond, a $C_1$-$C_{20}$ alkylene group unsubstituted or substituted with at least one $R_{10a}$, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

$Z_1$ to $Z_8$ and $R_1$ to $R_6$ are each independently hydrogen, deuterium, -F, -Cl, - Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$),

e1 to e8 and d1 to d8 are each independently an integer from 0 to 20,

i) two or more of a plurality of $Z_1$(s), ii) two or more of a plurality of $Z_2$(s), iii) two or more of a plurality of $Z_3$(s), iv) two or more of a plurality of $Z_4$(s), v) two or more of a plurality of $Z_5$(s), vi) two or more of a plurality of $Z_6$(s), vii) two or more of a plurality of $Z_7$(s), viii) two or more of a plurality of $Z_8$(s), ix) two or more of $R_1$ to $R_3$, and x) at least one of $R_4$ to $R_6$ are optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$R_{10a}$ is as described in connection with $Z_1$,

* and *' in Formulae 1-1 to 1-3 and 2-1 to 2-3 each indicate a binding site to Ir in Formulae 1 and 2, and

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{11}$)($Q_{12}$), - Si($Q_{13}$)($Q_{14}$)($Q_{15}$), -Ge($Q_{13}$)($Q_{14}$)($Q_{15}$), -B($Q_{16}$)($Q_{17}$), -P(=O)($Q_{18}$)($Q_{19}$), -P($Q_{18}$)($Q_{19}$), or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -$CD_3$, -$CD_2H$, -$CDH_2$, -$CF_3$, - $CF_2H$, -$CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl

group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{21}$)($Q_{22}$), -Si($Q_{23}$)($Q_{24}$)($Q_{25}$), -Ge($Q_{23}$)($Q_{24}$)($Q_{25}$), - B($Q_{26}$)($Q_{27}$), -P(=O)($Q_{28}$)($Q_{29}$), -P($Q_{28}$)($Q_{29}$), or a combination thereof;

-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), - P(=O)($Q_{38}$)($Q_{39}$), or -P($Q_{38}$)($Q_{39}$); or

a combination thereof,

wherein $Q_1$ to $Q_9$, $Q_{11}$ to $Q_{19}$, $Q_{21}$ to $Q_{29}$, and $Q_{31}$ to $Q_{39}$ are each independently: hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, a $C_1$-$C_{60}$ alkyl group, a $C_6$-$C_{60}$ aryl group, or a combination thereof.

**13.** A layer, comprising the composition of any of claims 1-12.

**14.** A light-emitting device (10), comprising:

a first electrode (11);
a second electrode (19); and
an organic layer (15) located between the first electrode and the second electrode and comprising an emission layer,
wherein the organic layer comprises the composition of any of claims 1-12;
preferably wherein the emission layer comprises the composition.

**15.** An electronic apparatus, comprising the light-emitting device of claim 14.

## Patentansprüche

**1.** Zusammensetzung, umfassend eine erste Verbindung und eine zweite Verbindung, wobei die erste Verbindung eine organometallische Verbindung dargestellt durch Formel 1 ist, die zweite Verbindung eine organometallische Verbindung dargestellt durch Formel 2 ist, sich die erste Verbindung und die zweite Verbindung voneinander unterscheiden,

die erste Verbindung und die zweite Verbindung jeweils nicht tris[2-Phenylpyridin]iridium sind,
|λP(Ir1) - λP(Ir2)| in einer Spanne von 0 Nanometern bis 30 Nanometern ist, wobei |λP(Ir1) - λP(Ir2)| einen Absolutwert von λP(Ir1) - λP(Ir2) angibt, und
zumindest einer der Ausdrücke 1 bis 4 erfüllt ist,
**dadurch gekennzeichnet, dass** die erste Verbindung und die zweite Verbindung jeweils eine heteroleptische Verbindung sind,

Ausdruck 1

$$\lambda P(Ir1) > \lambda P(Ir2)$$

Ausdruck 2

$$PLQY(Ir1) > PLQY(Ir2)$$

Ausdruck 3

$$k_r(Ir1) > k_r(Ir2)$$

Ausdruck 4

$$HOR(Ir1) > HOR(Ir2),$$

wobei in |λP(Ir1) - λP(Ir2)| und Ausdruck 1 bis 4
λP(Ir1) eine Emissionsspitzenwellenlänge der ersten Verbindung angibt,
λP(Ir2) eine Emissionsspitzenwellenlänge der zweiten Verbindung angibt,
λP(Ir1) und λP(Ir2) aus Photolumineszenzspektren evaluiert werden, die für jedes von einem ersten Film und einem zweiten Film gemessen werden,
PLQY(Ir1) eine Photolumineszenzquantenausbeute der ersten Verbindung angibt,
PLQY(Ir2) eine Photolumineszenzquantenausbeute der zweiten Verbindung angibt,
PLQY(Ir1) und PLQY(Ir2) für jedes von dem ersten Film und dem zweiten Film gemessen werden,
$k_r$(Ir1) eine Strahlungszerfallrate der ersten Verbindung angibt,
$k_r$(Ir2) eine Strahlungszerfallrate der zweiten Verbindung angibt,
$k_r$(Ir1) und $k_r$(Ir2) aus Photolumineszenzspektren und zeitaufgelösten Photolumineszenzspektren evaluiert werden, die für jedes von dem ersten Film und dem zweiten Film gemessen werden,
HOR(Ir1) ein horizontales Ausrichtungsverhältnis der ersten Verbindung angibt,
HOR(Ir2) ein horizontales Ausrichtungsverhältnis der zweiten Verbindung angibt und HOR(Ir1) und HOR(Ir2) aus Emissionsintensität evaluiert werden, die für jedes von dem ersten Film und dem zweiten Film gemessen wird,
wobei der erste Film ein Film ist, der die erste Verbindung umfasst, und
der zweite Film ein Film ist, der die zweite Verbindung umfasst,

Formel 1 $Ir(L_{11})_{n11}(L_{12})_{n12}(L_{13})_{n13}$

Formel 2 $Ir(L_{21})_{n21}(L_{22})_{n22}(L_{23})_{n23}$,

wobei in Formel 1 und 2
$L_{11}$ und $L_{21}$ jeweils unabhängig wie folgt sind:

ein zweizähniger Ligand, der an Iridium (Ir) der Formel 1 oder Formel 2 über zwei Stickstoffatome gebunden ist;
ein zweizähniger Ligand, der an Ir der Formel 1 oder Formel 2 über ein Stickstoffatom und ein Kohlenstoffatom gebunden ist; oder
ein zweizähniger Ligand, der an Ir der Formel 1 oder Formel 2 über zwei Kohlenstoffatome gebunden ist,
$L_{12}$, $L_{13}$, $L_{22}$ und $L_{23}$ jeweils unabhängig wie folgt sind:
ein zweizähniger Ligand, der an Ir der Formel 1 oder Formel 2 über zwei Stickstoffatome gebunden ist;
ein zweizähniger Ligand, der an Ir der Formel 1 oder Formel 2 über ein Stickstoffatom und ein Kohlenstoffatom gebunden ist;
ein zweizähniger Ligand, der an Ir der Formel 1 oder Formel 2 über zwei Kohlenstoffatome gebunden ist; oder
ein zweizähniger Ligand, der an Ir der Formel 1 oder Formel 2 über zwei Sauerstoffatome gebunden ist,
n11 und n12 jeweils unabhängig 1 oder 2 sind,
n13 0 oder 1 ist,
die Summe von n11, n12 und n13 3 ist,
n21 und n22 jeweils unabhängig 1 oder 2 sind,
n23 0 oder 1 ist und
die Summe von n21, n22 und n23 3 ist,
wobei Formel 1 und Formel 2 Bedingung 1 erfüllen:
Bedingung 1
wenn a) $L_{11}$ ein zweizähniger Ligand gebunden an Ir der Formel 1 über ein Stickstoffatom und ein Kohlenstoffatom ist; b) $L_{11}$ Ring $A_1$ gebunden an Ir der Formel 1 über ein Stickstoffatom und Ring $A_2$ gebunden an Ir der Formel 1 über ein Kohlenstoffatom umfasst; c) $L_{21}$ ein zweizähniger Ligand gebunden an Ir der Formel 2 über ein Stickstoffatom und ein Kohlenstoffatom ist; d) $L_{21}$ Ring $A_5$ gebunden an Ir der Formel 2 über ein

Stickstoffatom und Ring $A_6$ gebunden an Ir der Formel 2 über ein Kohlenstoffatom umfasst; e) $L_{12}$ und $L_{22}$ jeweils ein zweizähniger Ligand gebunden an Ir der Formel 1 oder Formel 2 über zwei Sauerstoffatome sind; f) n11 und n21 jeweils 2 sind; und g) n12 und n22 jeweils 1 sind, sich Ring $A_1$ und Ring $A_5$ voneinander unterscheiden.

**2.** Zusammensetzung nach Anspruch 1, wobei Ausdruck 1 erfüllt ist; und/oder

wobei zumindest einer von Ausdruck 2 bis 4 erfüllt ist; und/oder
wobei Ausdruck 5 ferner erfüllt ist:

Ausdruck 5

$$\mathrm{HOMO(Ir1)} < \mathrm{HOMO(Ir2)},$$

wobei in Ausdruck 5
HOMO(Ir1) ein Energieniveau des höchsten besetzten Molekülorbitals (HOMO) der ersten Verbindung angibt,
HOMO(Ir2) ein HOMO-Energieniveau der zweiten Verbindung angibt und
HOMO(Ir1) und HOMO(Ir2) jeweils ein negativer Wert gemessen durch Verwenden eines Photoelektronenspektrometers unter Atmosphärendruck sind; und/oder
wobei
|HOMO(Ir1) - HOMO(Ir2)| in einer Spanne von 0,02 Elektronenvolt bis 0,30 Elektronenvolt ist,
HOMO(Ir1) ein HOMO-Energieniveau der ersten Verbindung angibt,
HOMO(Ir2) ein HOMO-Energieniveau der zweiten Verbindung angibt,
|HOMO(Ir1) - HOMO(Ir2)| einen Absolutwert von (HOMO(Ir1) - HOMO(Ir2)) angibt und
HOMO(Ir1) und HOMO(Ir2) jeweils ein negativer Wert gemessen durch Verwenden eines Photoelektronenspektrometers unter Atmosphärendruck sind.

**3.** Zusammensetzung nach Anspruch 1 oder 2, wobei λP(Ir1) und λP(Ir2) jeweils in einer Spanne von 500 Nanometern bis 570 Nanometern sind.

**4.** Zusammensetzung nach einem der Ansprüche 1-3, wobei Ausdruck 1 erfüllt ist und

i) λP(Ir1) in einer Spanne von 520 Nanometern bis 540 Nanometern ist und λP(Ir2) in einer Spanne von 500 Nanometern bis 530 Nanometern ist oder
ii) λP(Ir1) in einer Spanne von 550 Nanometern bis 570 Nanometern ist und λP(Ir2) in einer Spanne von 540 Nanometern bis 560 Nanometern ist.

**5.** Zusammensetzung nach Anspruch 3 oder 4, wobei $L_{11}$, $L_{12}$, $L_{13}$, $L_{21}$, $L_{22}$ und $L_{23}$ jeweils ein zweizähniger Ligand gebunden an Ir der Formel 1 oder Formel 2 über ein Stickstoffatom und ein Kohlenstoffatom sind.

**6.** Zusammensetzung nach Anspruch 1 oder 2, wobei λP(Ir1) und λP(Ir2) jeweils in einer Spanne von 570 Nanometern bis 650 Nanometern sind.

**7.** Zusammensetzung nach Anspruch 1, 2 oder 6, wobei

Ausdruck 1 erfüllt ist,
λP(Ir1) in einer Spanne von 620 Nanometern bis 650 Nanometern ist und
λP(Ir2) in einer Spanne von 570 Nanometern bis 630 Nanometern ist.

**8.** Zusammensetzung nach Anspruch 6 oder 7, wobei

$L_{11}$, $L_{13}$, $L_{21}$ und $L_{23}$ jeweils ein zweizähniger Ligand gebunden an Ir der Formel 1 oder Formel 2 über ein Stickstoffatom und ein Kohlenstoffatom sind,
$L_{12}$ und $L_{22}$ jeweils ein zweizähniger Ligand gebunden an Ir der Formel 1 oder Formel 2 über zwei Sauerstoffatome sind und
n12 und n22 jeweils 1 sind;
wobei bevorzugt
$L_{11}$ Ring $A_1$ gebunden an Ir der Formel 1 über ein Stickstoffatom umfasst,

$L_{21}$ Ring $A_5$ gebunden an Ir der Formel 2 über ein Stickstoffatom umfasst und Ring $A_1$ und Ring $A_5$ jeweils eine polycyclische Gruppe mit 6 bis 60 Kohlenstoffatomen sind.

**9.** Zusammensetzung nach Anspruch 1 oder 2, wobei λP(Ir1) und λP(Ir2) jeweils in einer Spanne von 400 Nanometern bis 500 Nanometern sind.

**10.** Zusammensetzung nach Anspruch 1, 2 oder 9, wobei

Ausdruck 1 erfüllt ist,
λP(Ir1) in einer Spanne von 470 Nanometern bis 500 Nanometern ist und
λP(Ir2) in einer Spanne von 430 Nanometern bis 480 Nanometern ist.

**11.** Zusammensetzung nach einem der Ansprüche 1-10, wobei zumindest eine der Bedingungen A bis D erfüllt ist:

Bedingung A
$L_{11}$ und $L_{12}$ der Formel 1 unterscheiden sich voneinander;
Bedingung B
$L_{21}$ und $L_{22}$ der Formel 2 unterscheiden sich voneinander;
Bedingung C
$L_{11}$ der Formel 1 und $L_{21}$ der Formel 2 unterscheiden sich voneinander; und
Bedingung D
$L_{12}$ der Formel 1 und $L_{22}$ der Formel 2 unterscheiden sich voneinander.

**12.** Zusammensetzung nach einem der Ansprüche 1-11, wobei

$L_{11}$ ein Ligand dargestellt durch Formel 1-1 ist,
$L_{12}$ ein Ligand dargestellt durch Formel 1-2 oder 1-3 ist,
$L_{13}$ ein Ligand dargestellt durch Formel 1-1, 1-2 oder 1-3 ist,
$L_{21}$ ein Ligand dargestellt durch Formel 2-1 ist,
$L_{22}$ ein Ligand dargestellt durch Formel 2-2 oder 2-3 ist und
$L_{23}$ ein Ligand dargestellt durch Formel 2-1, 2-2 oder 2-3 ist:

Formel 1-1

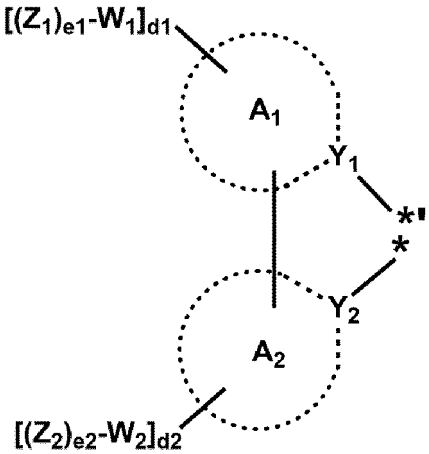

Formel 1-2

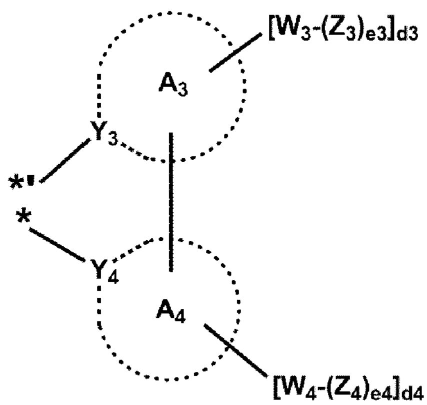

Formel 1-3

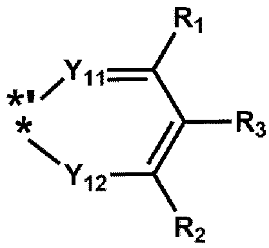

Formel 2-1

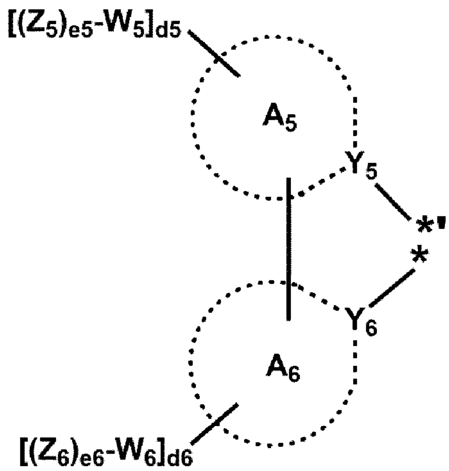

Formel 2-2

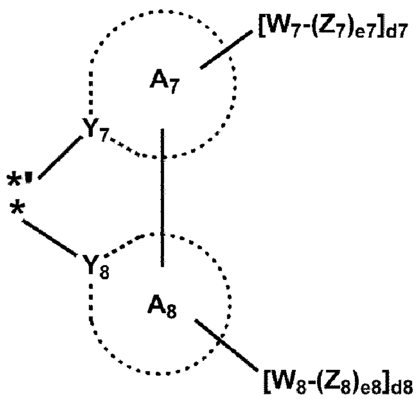

Formel 2-3

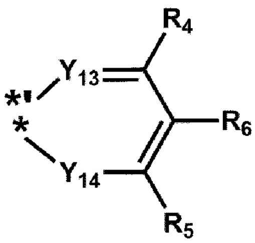

,

wobei in Formel 1-1 bis 1-3 und 2-1 bis 2-3

$Y_1$ bis $Y_8$ jeweils unabhängig C oder N sind,

$Y_{11}$ bis $Y_{14}$ jeweils O sind,

Ring $A_1$ bis Ring $A_8$ jeweils unabhängig eine carbocyclische $C_5$-$C_{30}$-Gruppe oder eine heterocyclische $C_1$-$C_{30}$-Gruppe sind,

$W_1$ bis $W_8$ jeweils unabhängig eine Einfachbindung, eine $C_1$-$C_{20}$-Alkylengruppe, unsubstituiert oder substituiert mit zumindest einem $R_{10a}$, eine carbocyclische $C_5$-$C_{30}$-Gruppe, unsubstituiert oder substituiert mit zumindest einem $R_{10a}$, oder eine heterocyclische $C_1$-$C_{30}$-Gruppe, unsubstituiert oder substituiert mit zumindest einem $R_{10a}$, sind,

$Z_1$ bis $Z_8$ und $R_1$ bis $R_6$ jeweils unabhängig Wasserstoff, Deuterium, -F, -Cl, -Br, -I, $-SF_5$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenyl-

gruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_7$-$C_{60}$-Alkylarylgruppe, eine substituierte oder unsubstituierte $C_7$-$C_{60}$-Arylalkylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte $C_2$-$C_{60}$-Alkylheteroarylgruppe, eine substituierte oder unsubstituierte $C_2$-$C_{60}$-Heteroarylalkylgruppe, eine substituierte oder unsubstituierte $C_1$-$C_{60}$-Heteroaryloxygruppe, eine substituierte oder unsubstituierte $C_1$-$C_{60}$-Heteroarylthiogruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, $-N(Q_1)(Q_2)$, - $Si(Q_3)(Q_4)(Q_5)$, $-Ge(Q_3)(Q_4)(Q_5)$, $-B(Q_6)(Q_7)$, $-P(=O)(Q_8)(Q_9)$ oder $-P(Q_8)(Q_9)$ sind,

e1 bis e8 und d1 bis d8 jeweils unabhängig eine ganze Zahl von 0 bis 20 sind,

i) zwei oder mehr aus einer Vielzahl von $Z_1$(s), ii) zwei oder mehr aus einer Vielzahl von $Z_2$(s), iii) zwei oder mehr aus einer Vielzahl von $Z_3$(s), iv) zwei oder mehr aus einer Vielzahl von $Z_4$(s), v) zwei oder mehr aus einer Vielzahl von $Z_5$(s), vi) zwei oder mehr aus einer Vielzahl von $Z_6$(s), vii) zwei oder mehr aus einer Vielzahl von $Z_7$(s), viii) zwei oder mehr aus einer Vielzahl von $Z_8$(s), ix) zwei oder mehr aus $R_1$ bis $R_3$, und x) zumindest eines von $R_4$ bis $R_6$ optional miteinander verknüpft sind, um eine carbocyclische $C_5$-$C_{30}$-Gruppe, unsubstituiert oder substituiert mit zumindest einem $R_{10a}$, oder eine heterocyclische $C_1$-$C_{30}$-Gruppe, unsubstituiert oder substituiert mit zumindest einem $R_{10a}$, zu bilden,

$R_{10a}$ wie in Verbindung mit $Z_1$ beschrieben ist,

* und *' in Formel 1-1 bis 1-3 und 2-1 bis 2-3 jeweils eine Bindungsstelle an Ir in Formel 1 und 2 angeben und zumindest ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_1$-$C_{60}$-Alkylthiogruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_7$-$C_{60}$-Alkylarylgruppe, der substituierten $C_7$-$C_{60}$-Arylalkylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten $C_2$-$C_{60}$-Alkylheteroarylgruppe, der substituierten $C_2$-$C_{60}$-Heteroarylalkylgruppe, der substituierten $C_1$-$C_{60}$-Heteroaryloxygruppe, der substituierten $C_1$-$C_{60}$-Heteroarylthiogruppe, der substituierten monovalenten nichtaromatischen kondensierten polycyclischen Gruppe und der substituierten monovalenten nichtaromatischen kondensierten heteropolycyclischen Gruppe wie folgt ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe oder eine $C_1$-$C_{60}$-Alkylthiogruppe;

eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe oder eine $C_1$-$C_{60}$-Alkylthiogruppe, jeweils substituiert mit zumindest einem von Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_2$-$C_{60}$-Alkylheteroarylgruppe, einer $C_1$-$C_{60}$-Heteroaryloxygruppe, einer $C_1$-$C_{60}$-Heteroarylthiogruppe, einer monovalenten nichtaromatischen kondensierten polycyclischen Gruppe, einer monovalenten nichtaromatischen kondensierten heteropolycyclischen Gruppe, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$ oder einer Kombination davon;

eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_7$-$C_{60}$-Alkylarylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_2$-$C_{60}$-Alkylheteroarylgruppe, eine $C_1$-$C_{60}$-Heteroaryloxygruppe, eine $C_1$-$C_{60}$-Heteroarylthiogruppe, eine monovalente nichtaromatische kondensierte polycyclische Gruppe oder eine monovalente nichtaromatische kondensierte heteropolycyclische Gruppe, jeweils unsubstituiert oder substituiert mit zumindest einem von Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_1$-$C_{60}$-Alkylthiogruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_7$-$C_{60}$-Arylalkylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_2$-$C_{60}$-Alkylheteroarylgruppe, einer $C_2$-$C_{60}$-Heteroarylalkylgruppe, einer $C_1$-$C_{60}$-Heteroaryloxygruppe, einer $C_1$-$C_{60}$-Heteroarylthiogruppe, einer monovalenten nichtaromatischen kondensierten polycyclischen Gruppe, einer monovalenten nichtaromatischen kondensierten heteropolycyclischen Gruppe, $-N(Q_{21})(Q_{22})$, $-Si(Q_{23})(Q_{24})(Q_{25})$, - $Ge(Q_{23})(Q_{24})(Q_{25})$, $-B(Q_{26})(Q_{27})$, $-P(=O)(Q_{28})(Q_{29})$, $-P(Q_{28})(Q_{29})$ oder einer Kom-

bination davon;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ oder $-P(Q_{38})(Q_{39})$; oder eine Kombination davon,
wobei $Q_1$ bis $Q_9$, $Q_{11}$ bis $Q_{19}$, $Q_{21}$ bis $Q_{29}$ und $Q_{31}$ bis $Q_{39}$ jeweils unabhängig wie folgt sind: Wasserstoff, Deuterium, -F, -Cl, -Br, -I, $-SF_5$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_1$-$C_{60}$-Alkylthiogruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_7$-$C_{60}$-Alkylarylgruppe, eine $C_7$-$C_{60}$-Arylalkylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_2$-$C_{60}$-Alkylheteroarylgruppe, eine $C_2$-$C_{60}$-Heteroarylalkylgruppe, eine $C_1$-$C_{60}$-Heteroaryloxygruppe, eine $C_1$-$C_{60}$-Heteroarylthiogruppe, eine monovalente nichtaromatische kondensierte polycyclische Gruppe oder eine monovalente nichtaromatische kondensierte heteropolycyclische Gruppe, jeweils unsubstituiert oder substituiert mit zumindest einem von Deuterium, einer $C_1$-$C_{60}$-Alkylgruppe, einer $C_6$-$C_{60}$-Arylgruppe oder einer Kombination davon.

**13.** Schicht, umfassend die Zusammensetzung nach einem der Ansprüche 1-12.

**14.** Lichtemittierende Vorrichtung (10), umfassend:

eine erste Elektrode (11);
eine zweite Elektrode (19); und
eine organische Schicht (15), die sich zwischen der ersten Elektrode und der zweiten Elektrode befindet und eine Emissionsschicht umfasst,
wobei die organische Schicht die Zusammensetzung nach einem der Ansprüche 1-12 umfasst;
wobei bevorzugt die Emissionsschicht die Zusammensetzung umfasst.

**15.** Elektronisches Gerät, umfassend die lichtemittierende Vorrichtung nach Anspruch 14.

## Revendications

**1.** Composition, comprenant un premier composé et un second composé, dans laquelle le premier composé est un composé organométallique représenté par la Formule 1,

le second composé est un composé organométallique représenté par la Formule 2,
le premier composé et le second composé sont différents l'un de l'autre,
le premier composé et le second composé ne sont pas chacun le tris[2-phénylpyridine]iridium,
$|\lambda P(Ir1) - \lambda P(Ir2)|$ est comprise dans une plage de 0 nanomètre à 30 nanomètres, dans laquelle $|\lambda P(Ir1) - \lambda P(Ir2)|$ indique une valeur absolue de $\lambda P(Ir1) - \lambda P(Ir2)$, et
au moins l'une des Expressions 1 à 4 est satisfaite,
**caractérisée en ce que** le premier composé et le second composé sont chacun un composé hétéroléptique,

Expression 1

$$\lambda P(Ir1) > \lambda P(Ir2)$$

Expression 2

$$PLQY(Ir1) > PLQY(Ir2)$$

Expression 3

$$k_r(Ir1) > k_r(Ir2)$$

Expression 4

$$HOR(Ir1) > HOR(Ir2)$$

dans laquelle, dans $|\lambda P(Ir1) - \lambda P(Ir2)|$ et les Expressions 1 à 4,
$\lambda P(Ir1)$ indique une longueur d'onde de pic d'émission du premier composé,
$\lambda P(Ir2)$ indique une longueur d'onde de pic d'émission du second composé,
$\lambda P(Ir1)$ et $\lambda P(Ir2)$ sont évaluées à partir de spectres de photoluminescence mesurés pour chacun d'un premier film et d'un second film,
PLQY(Ir1) indique un rendement quantique de photoluminescence du premier composé,
PLQY(Ir2) indique un rendement quantique de photoluminescence du second composé,
PLQY(Ir1) et PLQY(Ir2) sont mesurés pour chacun du premier film et du second film,
$k_r(Ir1)$ indique un taux de désintégration radiative du premier composé,
$k_r(Ir2)$ indique un taux de désintégration radiative du second composé,
$k_r(Ir1)$ et $k_r(Ir2)$ sont évalués à partir de spectres de photoluminescence et de spectres de photoluminescence résolue en temps mesurés pour chacun du premier film et du second film,
HOR(Ir1) indique un rapport d'orientation horizontale du premier composé,
HOR(Ir2) indique un rapport d'orientation horizontale du second composé, et
HOR(Ir1) et HOR(Ir2) sont évalués à partir de l'intensité d'émission mesurée pour chacun du premier film et du second film,
dans laquelle le premier film est un film comprenant le premier composé, et
le second film est un film comprenant le second composé,

Formule 1 $\quad Ir(L_{11})_{n11}(L_{12})_{n12}(L_{13})_{n13}$

Formule 2 $\quad Ir(L_{21})_{n21} (L_{22})_{n22}(L_{23})_{n23}$

dans laquelle, dans les Formules 1 et 2,
$L_{11}$ et $L_{21}$ sont chacun indépendamment :

un ligand bidenté lié à l'iridium (Ir) de la Formule 1 ou de la Formule 2 par l'intermédiaire de deux atomes d'azote ;
un ligand bidenté lié à l'Ir de la Formule 1 ou de la Formule 2 par l'intermédiaire d'un atome d'azote et d'un atome de carbone ; ou
un ligand bidenté lié à l'Ir de la Formule 1 ou de la Formule 2 par l'intermédiaire de deux atomes de carbone,

$L_{12}$, $L_{13}$, $L_{22}$ et $L_{23}$ sont chacun indépendamment :

un ligand bidenté lié à l'Ir de la Formule 1 ou de la Formule 2 par l'intermédiaire de deux atomes d'azote ;
un ligand bidenté lié à l'Ir de la Formule 1 ou de la Formule 2 par l'intermédiaire d'un atome d'azote et d'un atome de carbone ;
un ligand bidenté lié à l'Ir de la Formule 1 ou de la Formule 2 par l'intermédiaire de deux atomes de carbone ; ou
un ligand bidenté lié à l'Ir de la Formule 1 ou de la Formule 2 par l'intermédiaire de deux atomes d'oxygène,
n11 et n12 valent chacun indépendamment 1 ou 2,
n13 vaut 0 ou 1,
la somme de n11, n12 et n13 vaut 3,
n21 et n22 valent chacun indépendamment 1 ou 2,
n23 vaut 0 ou 1, et
la somme de n21, n22 et n23 vaut 3,
dans laquelle la Formule 1 et la Formule 2 satisfont la Condition 1 :

Condition 1

lorsque a) $L_{11}$ est un ligand bidenté lié à l'Ir de la Formule 1 par l'intermédiaire d'un atome d'azote et d'un atome de carbone ; b) $L_{11}$ comprend le cycle $A_1$ lié à l'Ir de la Formule 1 par l'intermédiaire d'un atome d'azote, et le cycle $A_2$ lié à l'Ir de la Formule 1 par l'intermédiaire d'un atome de carbone ; c) $L_{21}$ est un ligand bidenté lié à l'Ir de la Formule 2 par l'intermédiaire d'un atome d'azote et d'un atome de carbone ; d) $L_{21}$ comprend le cycle $A_5$ lié à l'Ir de la Formule 2 par l'intermédiaire d'un atome d'azote, et le cycle $A_6$ lié à l'Ir de la Formule 2 par l'intermédiaire d'un atome de carbone ; e) $L_{12}$ et $L_{22}$ sont chacun un ligand bidenté lié à l'Ir de la Formule 1 ou de la Formule 2 par l'intermédiaire de deux atomes d'oxygène ; f) n11 et n21 valent chacun 2 ; et g) n12 et n22 valent chacun 1,

le cycle $A_1$ et le cycle $A_5$ sont différents l'un de l'autre.

**2.** Composition de la revendication 1, dans laquelle l'Expression 1 est satisfaite ; et/ou

dans laquelle au moins l'une des Expressions 2 à 4 est satisfaite ; et/ou

dans laquelle l'Expression 5 est en outre satisfaite :

Expression 5

$$\mathrm{HOMO(Ir1)} < \mathrm{HOMO(Ir2)}$$

dans laquelle, dans l'Expression 5,

HOMO(Ir1) indique un niveau d'énergie de la plus haute orbitale moléculaire occupée (HOMO) du premier composé,

HOMO(Ir2) indique un niveau d'énergie HOMO du second composé, et

HOMO(Ir1) et HOMO(Ir2) sont chacun une valeur négative mesurée à l'aide d'un spectromètre photoélectronique sous pression atmosphérique ; et/ou

dans laquelle

|HOMO(Ir1) - HOMO(Ir2)| est comprise dans une plage de 0,02 électronvolt à 0,30 électronvolt,

HOMO(Ir1) indique un niveau d'énergie HOMO du premier composé,

HOMO(Ir2) indique un niveau d'énergie HOMO du second composé,

|HOMO(Ir1) - HOMO(Ir2)| indique une valeur absolue de (HOMO(Ir1) - HOMO(Ir2)), et

HOMO(Ir1) et HOMO(Ir2) sont chacun une valeur négative mesurée à l'aide d'un spectromètre photoélectronique sous pression atmosphérique.

**3.** Composition de l'une des revendications 1 ou 2, dans laquelle $\lambda$P(Ir1) et $\lambda$P(Ir2) sont comprises chacune dans une plage de 500 nanomètres à 570 nanomètres.

**4.** Composition de l'une quelconque des revendications 1 à 3, dans laquelle l'Expression 1 est satisfaite, et

i) $\lambda$P(Ir1) est comprise dans une plage de 520 nanomètres à 540 nanomètres, et $\lambda$P(Ir2) est comprise dans une plage de 500 nanomètres à 530 nanomètres, ou

ii) $\lambda$P(Ir1) est comprise dans une plage de 550 nanomètres à 570 nanomètres, et $\lambda$P(Ir2) est comprise dans une plage de 540 nanomètres à 560 nanomètres.

**5.** Composition de l'une des revendications 3 ou 4, dans laquelle $L_{11}$, $L_{12}$, $L_{13}$, $L_{21}$, $L_{22}$, et $L_{23}$ sont chacun un ligand bidenté lié à l'Ir de la Formule 1 ou de la Formule 2 par l'intermédiaire d'un atome d'azote et d'un atome de carbone.

**6.** Composition de l'une des revendications 1 ou 2, dans laquelle $\lambda$P(Ir1) et $\lambda$P(Ir2) sont comprises chacune dans une plage de 570 nanomètres à 650 nanomètres.

**7.** Composition de l'une des revendications 1, 2 ou 6, dans laquelle

l'Expression 1 est satisfaite,

$\lambda$P(Ir1) est comprise dans une plage de 620 nanomètres à 650 nanomètres, et

$\lambda$P(Ir2) est comprise dans une plage de 570 nanomètres à 630 nanomètres.

**8.** Composition de l'une des revendications 6 ou 7, dans laquelle

$L_{11}$, $L_{13}$, $L_{21}$ et $L_{23}$ sont chacun un ligand bidenté lié à l'Ir de la Formule 1 ou de la Formule 2 par l'intermédiaire d'un atome d'azote et d'un atome de carbone,
$L_{12}$ et $L_{22}$ sont chacun un ligand bidenté lié à l'Ir de la Formule 1 ou de la Formule 2 par l'intermédiaire de deux atomes d'oxygène, et
n12 et n22 valent chacun 1 ;
de préférence dans laquelle
$L_{11}$ comprend le cycle $A_1$ lié à l'Ir de la Formule 1 par l'intermédiaire d'un atome d'azote,
$L_{21}$ comprend le cycle $A_5$ lié à l'Ir de la Formule 2 par l'intermédiaire d'un atome d'azote, et
le cycle $A_1$ et le cycle $A_5$ sont chacun un groupe polycyclique possédant 6 à 60 atomes de carbone.

**9.** Composition de l'une des revendications 1 ou 2, dans laquelle λP(Ir1) et λP(Ir2) sont comprises chacune dans une plage de 400 nanomètres à 500 nanomètres.

**10.** Composition de l'une des revendications 1, 2 ou 9, dans laquelle

l'Expression 1 est satisfaite,
λP(Ir1) est comprise dans une plage de 470 nanomètres à 500 nanomètres, et
λP(Ir2) est comprise dans une plage de 430 nanomètres à 480 nanomètres.

**11.** Composition de l'une quelconque des revendications 1 à 10, dans laquelle au moins l'une des Conditions A à D est satisfaite :

Condition A
$L_{11}$ et $L_{12}$ de la Formule 1 sont différents l'un de l'autre ;
Condition B
$L_{21}$ et $L_{22}$ de la Formule 2 sont différents l'un de l'autre ;
Condition C
$L_{11}$ de la Formule 1 et $L_{21}$ de la Formule 2 sont différents l'un de l'autre ; et
Condition D
$L_{12}$ de la Formule 1 et $L_{22}$ de la Formule 2 sont différents l'un de l'autre.

**12.** Composition de l'une quelconque des revendications 1 à 11, dans laquelle

$L_{11}$ est un ligand représenté par la Formule 1-1,
$L_{12}$ est un ligand représenté par la Formule 1-2 ou 1-3,
$L_{13}$ est un ligand représenté par la Formule 1-1, 1-2 ou 1-3,
$L_{21}$ est un ligand représenté par la Formule 2-1,
$L_{22}$ est un ligand représenté par la Formule 2-2 ou 2-3, et
$L_{23}$ est un ligand représenté par la Formule 2-1, 2-2 ou 2-3 :

Formule 1-1

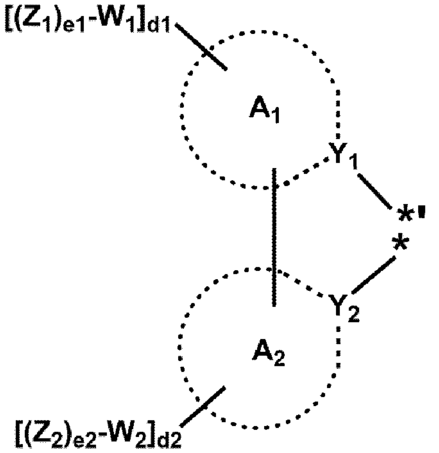

Formule 1-2

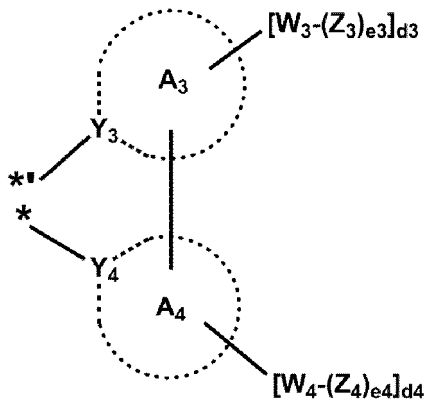

Formule 1-3

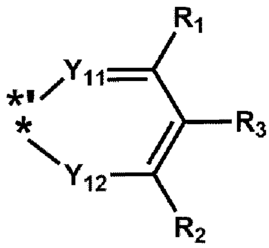

Formule 2-1

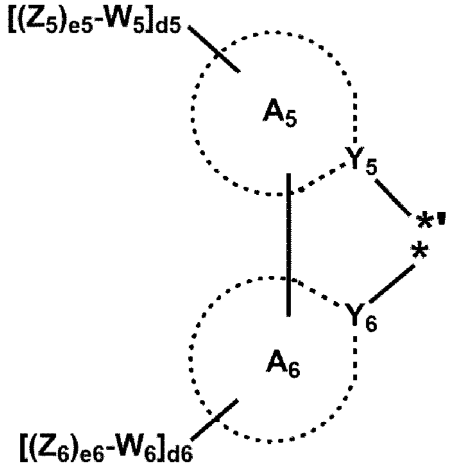

Formule 2-2

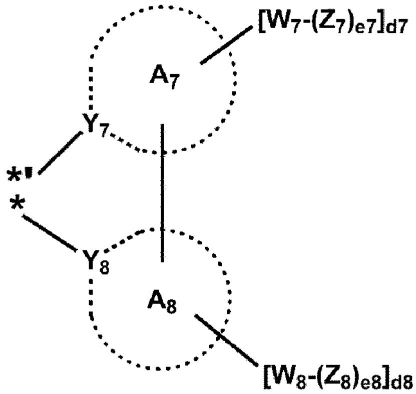

Formule 2-3

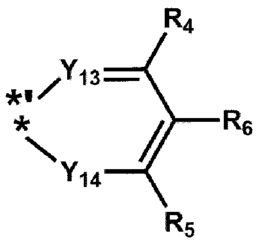

dans laquelle, dans les Formules 1-1 à 1-3 et 2-1 à 2-3,

$Y_1$ à $Y_8$ sont chacun indépendamment C ou N,

$Y_{11}$ à $Y_{14}$ sont chacun O,

les cycles $A_1$ à $A_8$ sont chacun indépendamment un groupe carbocyclique en $C_5$-$C_{30}$ ou un groupe hétérocyclique en $C_1$-$C_{30}$,

$W_1$ à $W_8$ sont chacun indépendamment une liaison simple, un groupe alkylène en $C_1$-$C_{20}$ non substitué ou substitué par au moins un $R_{10a}$, un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$,

$Z_1$ à $Z_8$ et $R_1$ à $R_6$ sont chacun indépendamment un hydrogène, un deutérium, -F, -Cl, -Br, -I, $-SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alcoxy en $C_1$-$C_{60}$ substitué ou non substitué, un groupe alkylthio en $C_1$-$C_{60}$ substitué ou non substitué, un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe alkylaryle en $C_7$-$C_{60}$ substitué ou non substitué, un groupe arylalkyle en $C_7$-$C_{60}$ substitué ou non

substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe alkylhétéroaryle en $C_2$-$C_{60}$ substitué ou non substitué, un groupe hétéroarylalkyle en $C_2$-$C_{60}$ substitué ou non substitué, un groupe hétéroaryloxy en $C_1$-$C_{60}$ substitué ou non substitué, un groupe hétéroarylthio en $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ ou $-P(Q_8)(Q_9)$,

e1 à e8 et d1 à d8 sont chacun indépendamment un nombre entier de 0 à 20,

i) deux d'une pluralité de $Z_1$ ou plus, ii) deux d'une pluralité de $Z_2$ ou plus, iii) deux d'une pluralité de $Z_3$ ou plus, iv) deux d'une pluralité de $Z_4$ ou plus, v) deux d'une pluralité de $Z_5$ ou plus, vi) deux d'une pluralité de $Z_6$ ou plus, vii) deux d'une pluralité de $Z_7$ ou plus, viii) deux d'une pluralité de $Z_8$ ou plus, ix) deux de $R_1$ à $R_3$ ou plus, et x) au moins l'un de $R_4$ à $R_6$ sont éventuellement liés les uns aux autres pour former un groupe carbocyclique en $C_5$-$C_{30}$ non substitué ou substitué par au moins un $R_{10a}$ ou un groupe hétérocyclique en $C_1$-$C_{30}$ non substitué ou substitué par au moins un $R_{10a}$,

$R_{10a}$ est tel que décrit en relation avec $Z_1$,

* et *' dans les Formules 1-1 à 1-3 et 2-1 à 2-3 indiquent chacun un site de liaison à l'Ir dans les Formules 1 et 2, et au moins un substituant du groupe alkyle en $C_1$-$C_{60}$ substitué, du groupe alcényle en $C_2$-$C_{60}$ substitué, du groupe alcynyle en $C_2$-$C_{60}$ substitué, du groupe alcoxy en $C_1$-$C_{60}$ substitué, du groupe alkylthio en $C_1$-$C_{60}$ substitué, du groupe cycloalkyle en $C_3$-$C_{10}$ substitué, du groupe hétérocycloalkyle en $C_1$-$C_{10}$ substitué, du groupe cycloalcényle en $C_3$-$C_{10}$ substitué, du groupe hétérocycloalcényle en $C_1$-$C_{10}$ substitué, du groupe aryle en $C_6$-$C_{60}$ substitué, du groupe alkylaryle en $C_7$-$C_{60}$ substitué, du groupe arylalkyle en $C_7$-$C_{60}$ substitué, du groupe aryloxy en $C_6$-$C_{60}$ substitué, du groupe arylthio en $C_6$-$C_{60}$ substitué, du groupe hétéroaryle en $C_1$-$C_{60}$ substitué, du groupe alkylhétéroaryle en $C_2$-$C_{60}$ substitué, du groupe hétéroarylalkyle en $C_2$-$C_{60}$ substitué, du groupe hétéroaryloxy en $C_1$-$C_{60}$ substitué, du groupe hétéroarylthio en $C_1$-$C_{60}$ substitué, du groupe polycyclique condensé non aromatique monovalent substitué et du groupe hétéropolycyclique condensé non aromatique monovalent substitué est :

un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$ ou un groupe alkylthio en $C_1$-$C_{60}$ ;

un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$ ou un groupe alkylthio en $C_1$-$C_{60}$, chacun étant substitué par au moins l'un parmi un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe alkylaryle en $C_7$-$C_{60}$, un groupe aryloxy en $C_6$-$C_{60}$, un groupe arylthio en $C_6$-$C_{60}$, un groupe hétéroaryle en $C_1$-$C_{60}$, un groupe alkylhétéroaryle en $C_2$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$ ou une combinaison de ceux-ci ;

un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe alkylaryle en $C_7$-$C_{60}$, un groupe aryloxy en $C_6$-$C_{60}$, un groupe arylthio en $C_6$-$C_{60}$, un groupe hétéroaryle en $C_1$-$C_{60}$, un groupe alkylhétéroaryle en $C_2$-$C_{60}$, un groupe hétéroaryloxy en $C_1$-$C_{60}$, un groupe hétéroarylthio en $C_1$-$C_{60}$, un groupe polycyclique condensé non aromatique monovalent ou un groupe hétéropolycyclique condensé non aromatique monovalent, chacun étant non substitué ou substitué par au moins l'un parmi un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe alkylthio en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe alkylaryle en $C_7$-$C_{60}$, un groupe arylalkyle en $C_7$-$C_{60}$, un groupe aryloxy en $C_6$-$C_{60}$, un groupe arylthio en $C_6$-$C_{60}$, un groupe hétéroaryle en $C_1$-$C_{60}$, un groupe alkylhétéroaryle en $C_2$-$C_{60}$, un groupe hétéroarylalkyle en $C_2$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$ ou une combinaison de ceux-ci ;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ ou $-P(Q_{38})(Q_{39})$ ; ou une combinaison de ceux-ci,

dans laquelle $Q_1$ à $Q_9$, $Q_{11}$ à $Q_{19}$, $Q_{21}$ à $Q_{29}$, et $Q_{31}$ à $Q_{39}$ sont chacun indépendamment : un hydrogène, un deutérium, -F, -Cl, -Br, -I, $-SF_5$, un groupe hydroxyle, un groupe cyano, un groupe nitro, un groupe amino, un

groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe alkylthio en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe alkylaryle en $C_7$-$C_{60}$, un groupe arylalkyle en $C_7$-$C_{60}$, un groupe aryloxy en $C_6$-$C_{60}$, un groupe arylthio en $C_6$-$C_{60}$, un groupe hétéroaryle en $C_1$-$C_{60}$, un groupe alkylhétéroaryle en $C_2$-$C_{60}$, un groupe hétéroarylalkyle en $C_2$-$C_{60}$, un groupe hétéroaryloxy en $C_1$ -$C_{60}$, un groupe hétéroarylthio en $C_1$-$C_{60}$, un groupe polycyclique condensé non aromatique monovalent, ou un groupe hétéropolycyclique condensé non aromatique monovalent, chacun étant non substitué ou substitué par au moins l'un parmi un deutérium, un groupe alkyle en Ci-$C_{60}$, un groupe aryle en $C_6$-$C_{60}$, ou une combinaison de ceux-ci.

**13.** Couche comprenant la composition de l'une quelconque des revendications 1 à 12.

**14.** Dispositif électroluminescent (10), comprenant :

une première électrode (11) ;
une seconde électrode (19) ; et
une couche organique (15) située entre la première électrode et la seconde électrode et comprenant une couche d'émission,
dans lequel la couche organique comprend la composition de l'une quelconque des revendications 1 à 12 ;
de préférence, dans lequel la couche d'émission comprend la composition.

**15.** Appareil électronique, comprenant le dispositif électroluminescent de la revendication 14.

# FIGURE

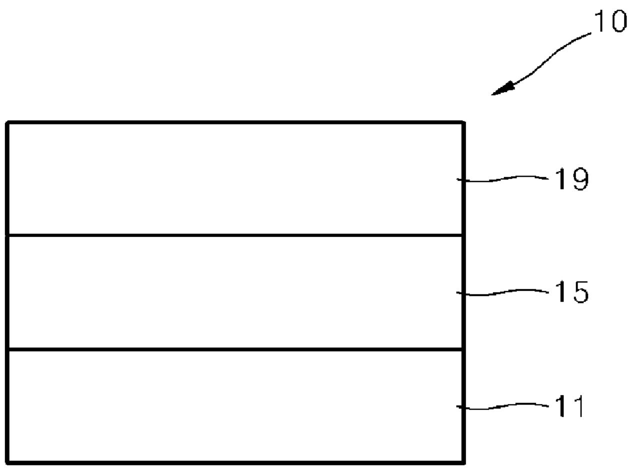

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003068465 B